# EUROPEAN PATENT SPECIFICATION

(11) **EP 4 254 527 B1**
(45) Date of publication and mention of the grant of the patent: **30.07.2025**
(21) Application number: 22784928.8
(22) Date of filing: 05.04.2022
(51) Int. Cl.: H10K 85/60, H10K 50/11, C09K 11/06

(54) **ORGANIC LIGHT EMITTING DEVICE**
ORGANISCHE LICHTEMITTIERENDE VORRICHTUNG
DISPOSITIF ÉLECTROLUMINESCENT ORGANIQUE

(30) Priority: 05.04.2021 KR 20210044137
(43) Date of publication of application: 04.10.2023
(73) Proprietor: LG Chem, Ltd., Seoul 07336 (KR)
(72) Inventor: KIM, Minjun, Daejeon 34122 (KR); LEE, Dong Hoon, Daejeon 34122 (KR); SUH, Sang Duk, Daejeon 34122 (KR); KIM, Young Seok, Daejeon 34122 (KR); KIM, Donghee, Daejeon 34122 (KR)
(74) Representative: Hoffmann Eitle
(86) International application number: PCT/KR2022/004904
(87) International publication number: WO 2022/216019

(56) References cited:
- EP-A1- 3 722 294
- WO-A1-2020/080693
- KR-A- 20140 006 201
- KR-A- 20150 093 181
- KR-A- 20170 016 701
- KR-A- 20200 043 269
- KR-A- 20200 100 972
- KR-A- 20200 100 972

## Description

### [TECHNICAL FIELD]

### Cross-reference to Related Application(s)

This application claims the benefit of Korean Patent Application No. 10-2021-0044137 filed on April 5, 2021 in the Korean Intellectual Property Office.

The present disclosure relates to an organic light emitting device.

### [BACKGROUND OF ART]

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer interposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer, and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

There is a continuing need for the development of new materials for the organic materials used in the organic light emitting devices as described above.

### [PRIOR ART LITERATURE]

(Patent Literature 1) Korean Unexamined Patent Publication No. 10-2000-0051826
(Patent Literature 2) EP 3 722 294 A1
(Patent Literature 3) KR 2020 0100972 A
(Patent Literature 4) WO 2020/080693 A1 Patent Literature 2 - Patent Literature 4 disclose organic light-emitting devices comprising compounds useful as host materials in the light-emitting layer.

### [DETAILED DESCRIPTION OF THE INVENTION]

### [Technical Problem]

The present disclosure relates to an organic light emitting device having improved driving voltage, efficiency, and lifespan.

### [Technical Solution]

In the present disclosure, there is provided an organic light emitting device including an anode; a cathode; and a light emitting layer that is provided between the anode and the cathode,
wherein the light emitting layer includes a compound represented by the following Chemical Formula 1 and a compound represented by the following Chemical Formula 2: 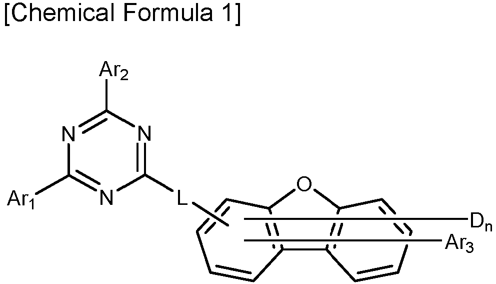 in the Chemical Formula 1,
L is a single bond; or substituted or unsubstituted C₆₋₆₀ arylene;
Ar₁ and Ar₂ are each independently substituted or unsubstituted C₆₋₆₀ aryl; or substituted or unsubstituted C₂₋₆₀ heteroaryl containing at least one selected from the group consisting of N, O and S,
Ar₃ is hydrogen; deuterium; substituted or unsubstituted C₆₋₆₀ aryl; or substituted or unsubstituted C₂₋₆₀ heteroaryl containing at least one selected from the group consisting of N, O and S,
D is deuterium, and
n is an integer of 0 to 6, 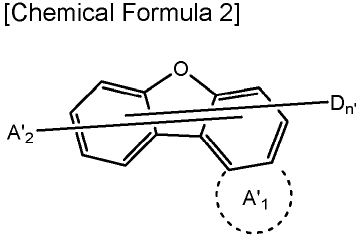 in the Chemical Formula 2,
   A'₁ is represented by the following Chemical Formula 2-a, 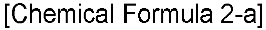 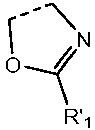 in the Chemical Formula 2-a,
   the dotted line is fused with an adjacent ring,
   R'₁ is Ar'₁; or a substituent represented by the following Chemical Formula 2-b, and
   Ar'₁ is substituted or unsubstituted C₆₋₆₀ aryl; or substituted or unsubstituted C₂₋₆₀ heteroaryl containing at least one heteroatom selected from the group consisting of N, O and S, and 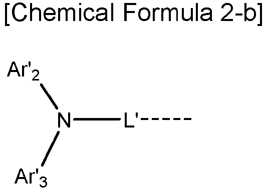 in the Chemical Formula 2-b,
      L' is a single bond; or substituted or unsubstituted C₆₋₆₀ arylene;
      Ar'₂ and Ar'₃ are each independently hydrogen; deuterium; substituted or unsubstituted C₆₋₆₀ aryl; or substituted or unsubstituted C₂₋₆₀ heteroaryl containing at least one heteroatom selected from the group consisting of N, O and S,
      when R'₁ is Ar'₁, A'₂ is a substituent represented by the Chemical Formula 2-b,
      when R'₁ is a substituent represented by the Chemical Formula 2-b, A'₂ is hydrogen; or deuterium,
      D is deuterium, and
      n' is an integer of 0 to 5.

### [ADVANTAGEOUS EFFECTS]

The above-described organic light emitting device has excellent driving voltage, efficiency, and lifespan.

### [BRIEF DESCRIPTION OF THE DRAWINGS]

FIG. 1 shows an example of an organic light emitting device including a substrate 1, an anode 2, a light emitting layer 3, and a cathode 4.
FIG. 2 shows an example of an organic light emitting device including a substrate 1, an anode 2, a hole injection layer 5, a hole transport layer 6, a light emitting layer 3, an electron transport layer 7, an electron injection layer 8, and a cathode 4.
FIG. 3 shows an example of an organic light emitting device including a substrate 1, an anode 2, a hole injection layer 5, a hole transport layer 6, an electron blocking layer 9, a light emitting layer 3, a hole blocking layer 10, an electron injection and transport layer 11, and a cathode 4.

### [DETAILED DESCRIPTION OF THE EMBODIMENTS]

Hereinafter, embodiments of the present disclosure will be described in more detail to facilitate understanding of the invention.

As used herein, the notation 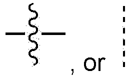 means a bond linked to another substituent group.

As used herein, the term "substituted or unsubstituted" means being unsubstituted or substituted with one or more substituents selected from the group consisting of deuterium; a halogen group; a nitrile group; a nitro group; a hydroxyl group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; and a heterocyclic group containing at least one of N, O and S atoms, or being unsubstituted or substituted with a substituent in which two or more substituents of the above-exemplified substituents are connected. For example, "a substituent in which two or more substituents are connected" may be a biphenyl group. Namely, a biphenyl group may be an aryl group, or it may also be interpreted as a substituent in which two phenyl groups are connected.

In the present disclosure, the carbon number of a carbonyl group is not particularly limited, but is preferably 1 to 40. Specifically, the carbonyl group may be a group having the following structural formulae, but is not limited thereto.

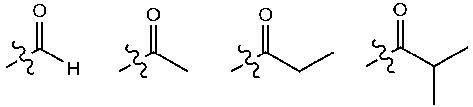

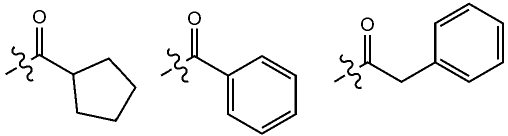

In the present disclosure, an ester group may have a structure in which oxygen of the ester group is substituted by a straight-chain, branched-chain, or cyclic alkyl group having 1 to 25 carbon atoms, or an aryl group having 6 to 25 carbon atoms.

Specifically, the ester group may be a group having the following structural formulae, but is not limited thereto.

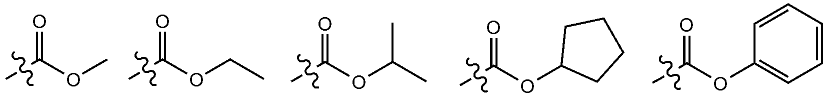

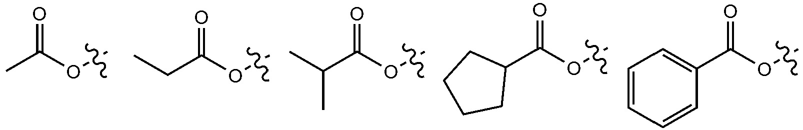

In the present disclosure, the carbon number of an imide group is not particularly limited, but is preferably 1 to 25. Specifically, the imide group may be a group having the following structural formulae, but is not limited thereto.

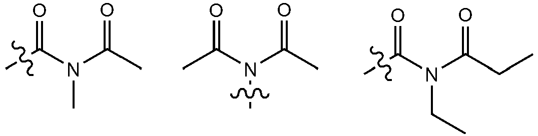

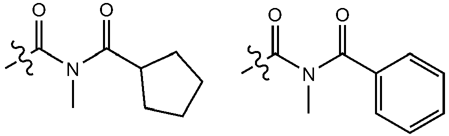

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present disclosure, a boron group specifically includes a trimethylboron group, a triethylboron group, a t-butyldimethylboron group, a triphenylboron group, a phenylboron group, and the like, but is not limited thereto.

**In** the present disclosure, examples of a halogen group include fluorine, chlorine, bromine, or iodine.

**In** the present disclosure, the alkyl group may be straight-chain, or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethylpropyl, isohexyl, 2-methylpentyl, 4-methylhexyl, 5-methylhexyl, and the like, but are not limited thereto.

**In** the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The monocyclic aryl group includes a phenyl group, a biphenyl group, a terphenyl group and the like, but is not limited thereto. The polycyclic aryl group includes a naphthyl group, an anthracenyl group, a phenanthryl group, a pyrenyl group, a perylenyl group, a chrysenyl group, a fluorenyl group or the like, but is not limited thereto.

In the present disclosure, a fluorenyl group may be substituted, and two substituents may be bonded to each other to form a spiro structure. In the case where the fluorenyl group is substituted, 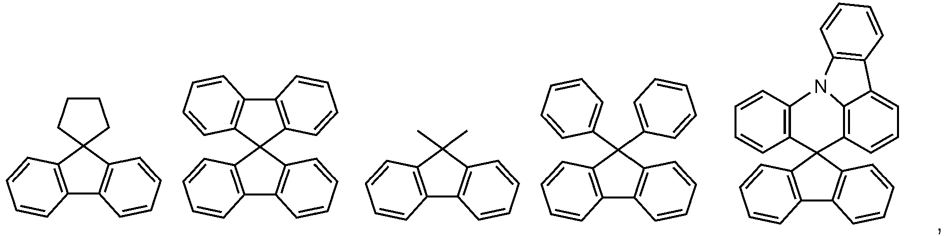 and the like can be formed. However, the structure is not limited thereto.

In the present disclosure, a heterocyclic group is a heterocyclic group containing at least one heteroatom of O, **N,** Si and S as a heterogeneous element, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group, and the arylamine group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can apply the aforementioned description of the heterocyclic group. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heterocyclic group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heterocyclic group can be applied, except that the heterocycle is not a monovalent group but formed by combining two substituent groups.

The present disclosure will be described in detail for each configuration.

### Anode and Cathode

The anode and cathode used in the present disclosure refer to electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SnO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Light emitting layer

The light emitting layer used in the present disclosure refers to a layer capable of emitting light in a visible ray region by combining holes and electrons transferred from the anode and the cathode. In general, the light emitting layer includes a host material and a dopant material, and in the present disclosure, the compound represented by the Chemical Formula 1 and the compound represented by the Chemical Formula 2 are included as hosts.

In each of the compound represented by the Chemical Formula 1 and the compound represented by the Chemical Formula 2, at least one hydrogen may be substituted with deuterium. That is, n in the Chemical Formula 1 may be an integer of 1 or more, and at least one substituent of L and Ar₁ to Ar₃ may be substituted with deuterium. In addition, n' in the Chemical Formula 2 may be an integer of 1 or more, and at least one substituent of L' and Ar'₁ to Ar'₃ may be substituted with deuterium.

The Chemical Formula 1 may be represented by the following Chemical Formula 1-1 depending on the bonding position of dibenzofuran and triazine: 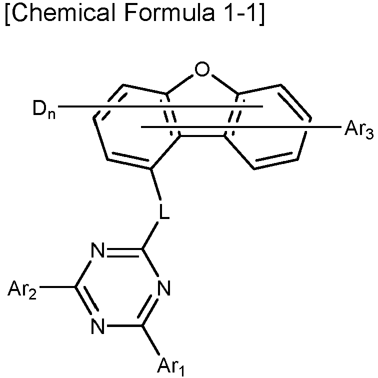 in the Chemical Formula 1-1, L,Ar₁ to Ar₃, D, and n are as defined in Chemical Formula 1.

Preferably, L is a single bond; or substituted or unsubstituted C₆₋₂₀ arylene, Ar₁ and Ar₂ are each independently substituted or unsubstituted C₆₋₂₀ aryl; or substituted or unsubstituted C₂₋₂₀ heteroaryl containing at least one selected from the group consisting of N, O and S, and Ar₃ is substituted or unsubstituted C₆₋₂₀ aryl; or substituted or unsubstituted C₂₋₂₀ heteroaryl containing at least one selected from the group consisting of N, O and S.

Preferably, L is a single bond; phenylene; or naphthalenediyl.

Preferably, Ar₁ and Ar₂ are each independently phenyl; biphenylyl; terphenylyl; naphthyl; phenanthrenyl; (phenyl)naphthyl; (naphthyl)phenyl; (naphthyl)naphthyl; dibenzofuranyl; or dibenzothiophenyl.

Preferably, Ar₃ is hydrogen; phenyl; biphenylyl; terphenylyl; naphthyl; phenanthrenyl; (phenyl)naphthyl; (naphthyl)phenyl; fluoranthenyl; triphenylenyl; dibenzofuranyl; dibenzothiophenyl; benzonaphthofuranyl; or benzonaphthothiophenyl.

In the above, (naphthyl)phenyl means phenyl substituted with one naphthyl; (phenyl)naphthyl means naphthyl substituted with one phenyl; and (naphthyl)naphthyl means naphthyl substituted with one naphthyl.

In the above, benzonaphthofuranyl is specifically a monovalent substituent derived from benzo[b]naphtho[2,1-d]furan ( 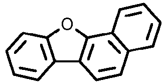 ), benzo[b]naphtho[1,2-d] furan( 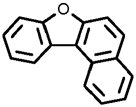 ), or benzo[h]naphtho[2,3-d]furan ( 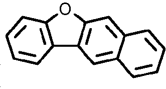 ).

In addition, benzonaphthothiophenyl is specifically a monovalent substituent derived from benzo[b]naphtho[2,1-d]thiophene ( 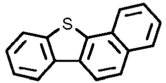 ), benzo[b]naphtho[1,2-d]thiophene ( 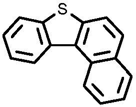 ), or benzo[b]naphtho[2,3-d]thiophene ( 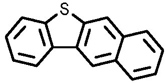 ).

In one embodiment, L is a single bond; phenylene; or naphthalenediyl, Ar₁ and Ar₂ are each independently phenyl; biphenylyl; terphenylyl; naphthyl; phenanthrenyl; (phenyl)naphthyl; (naphthyl)phenyl; (naphthyl)naphthyl; dibenzofuranyl; or dibenzothiophenyl.

In one embodiment, Ar₁ and Ar₂ are each independently phenyl; biphenylyl; terphenylyl; naphthyl; phenanthrenyl; (phenyl)naphthyl; (naphthyl)phenyl; (naphthyl)naphthyl; dibenzofuranyl; or dibenzothiophenyl, and Ar₃ is hydrogen; phenyl; biphenylyl; terphenylyl; naphthyl; phenanthrenyl; (phenyl)naphthyl; (naphthyl)phenyl; fluoranthenyl; triphenylenyl; dibenzofuranyl; dibenzothiophenyl; benzonaphthofuranyl; or benzonaphthothiophenyl.

In one embodiment, L is a single bond; phenylene; or naphthalenediyl, and Ar₃ is hydrogen; phenyl; biphenylyl; terphenylyl; naphthyl; phenanthrenyl; (phenyl)naphthyl; (naphthyl)phenyl; fluoranthenyl; triphenylenyl; dibenzofuranyl; dibenzothiophenyl; benzonaphthofuranyl; or benzonaphthothiophenyl.

In one embodiment, L is a single bond; phenylene; or naphthalenediyl, Ar₁ and Ar₂ are each independently phenyl; biphenylyl; terphenylyl; naphthyl; phenanthrenyl; (phenyl)naphthyl; (naphthyl)phenyl; (naphthyl)naphthyl; dibenzofuranyl; or dibenzothiophenyl, and Ar₃ is hydrogen; phenyl; biphenylyl; terphenylyl; naphthyl; phenanthrenyl; (phenyl)naphthyl; (naphthyl)phenyl; fluoranthenyl; triphenylenyl; dibenzofuranyl; dibenzothiophenyl; benzonaphthofuranyl; or benzonaphthothiophenyl.

Representative examples of the compound represented by the Chemical Formula 1 are as follows:

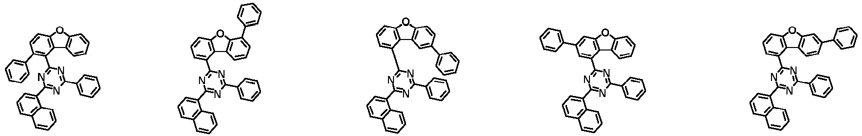

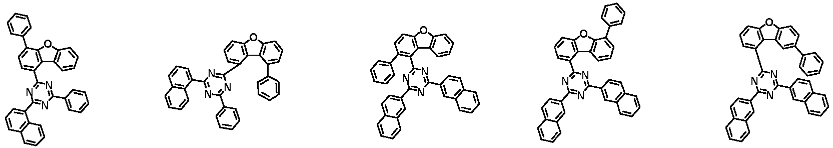

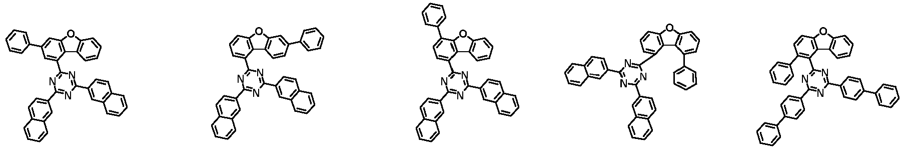

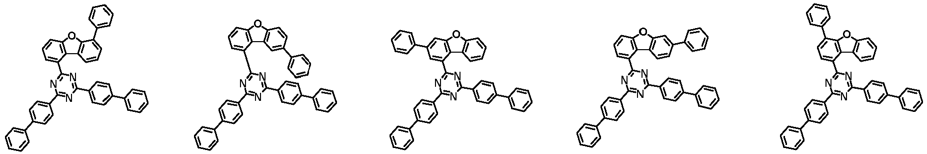

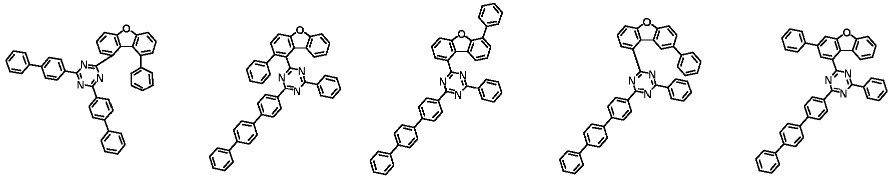

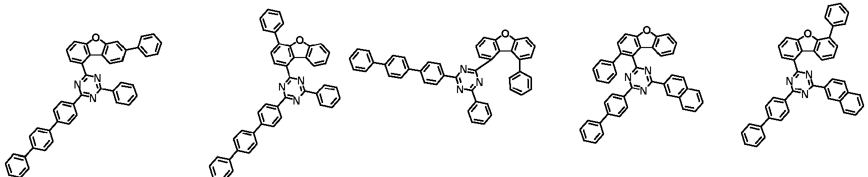

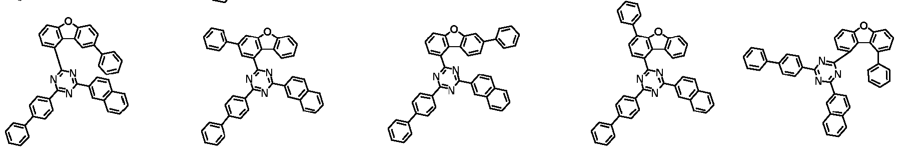

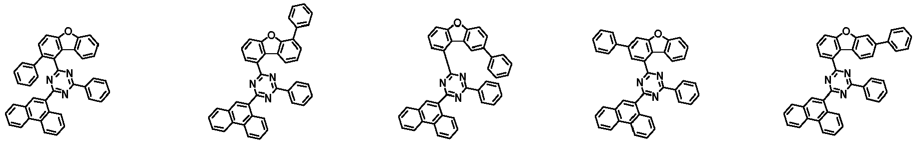

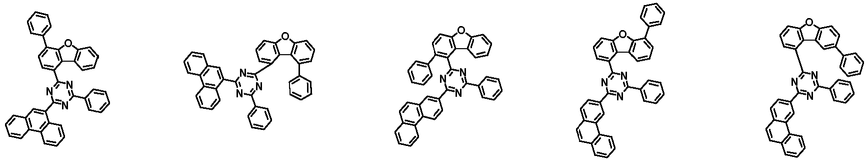

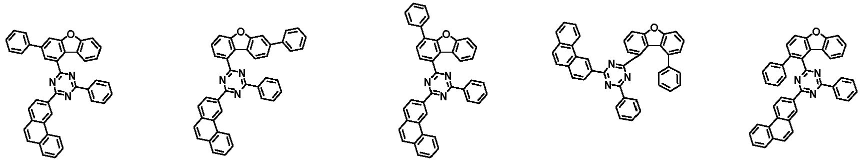

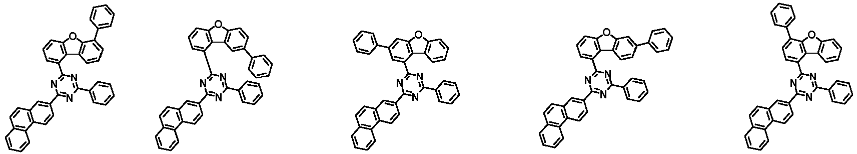

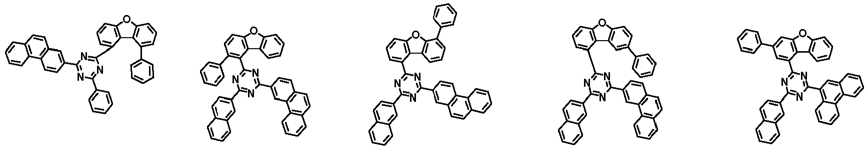

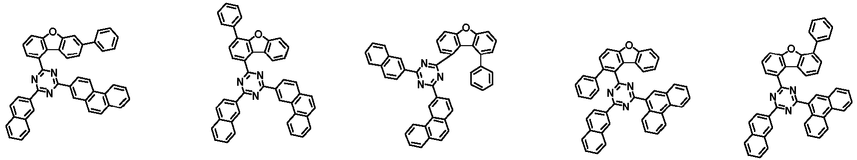

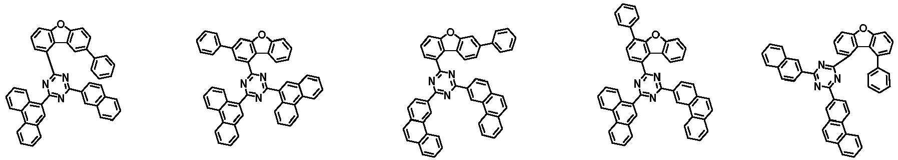

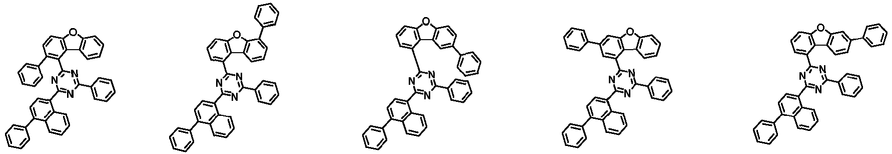

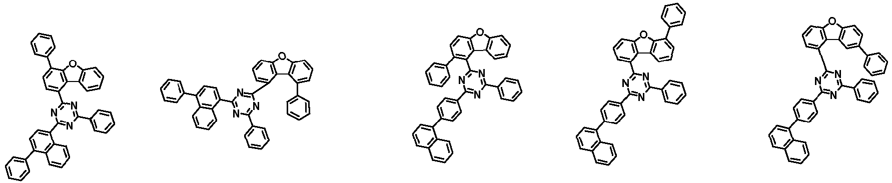

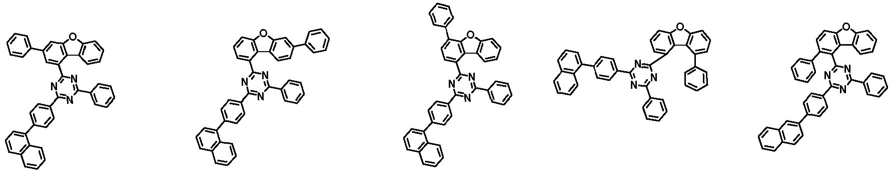

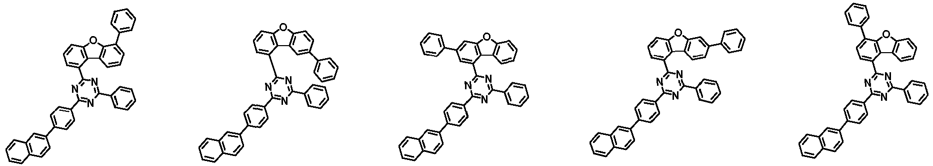

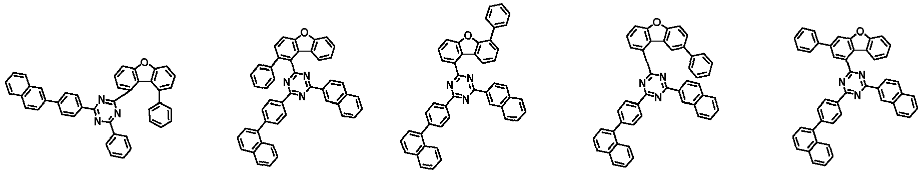

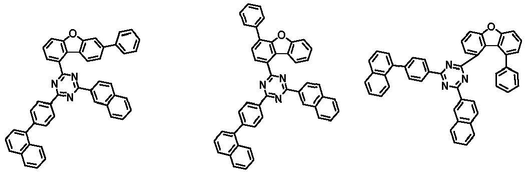

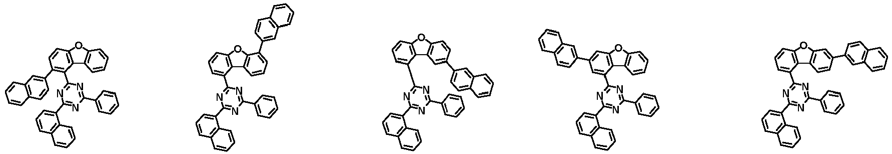

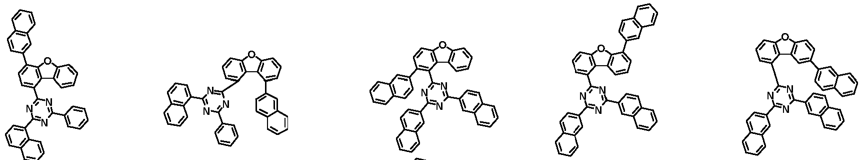

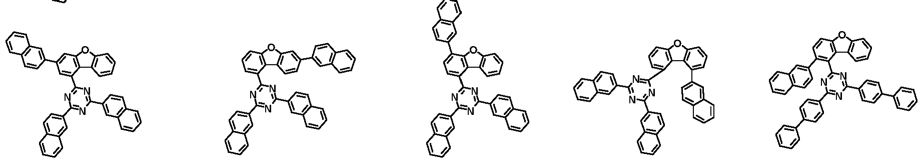

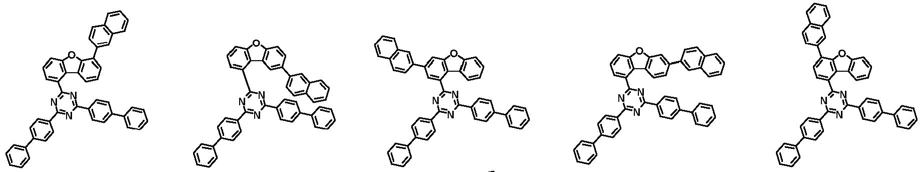

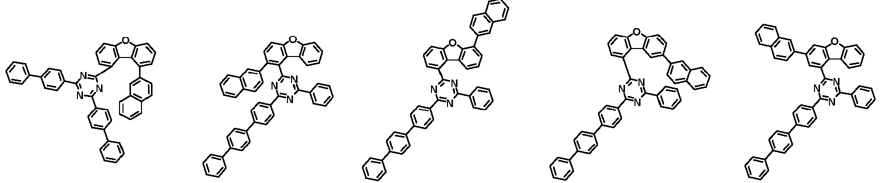

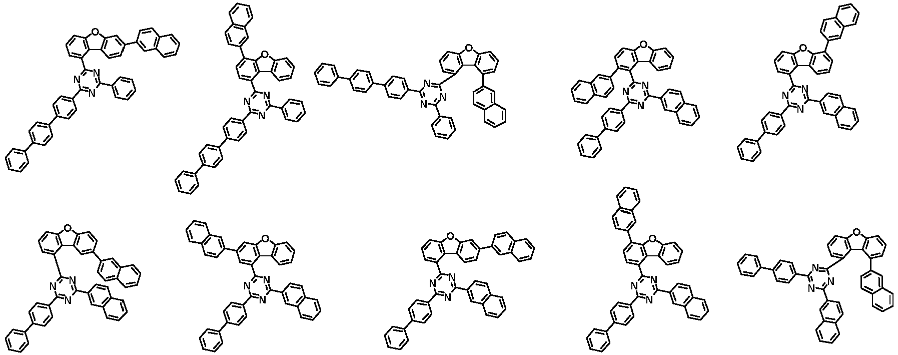

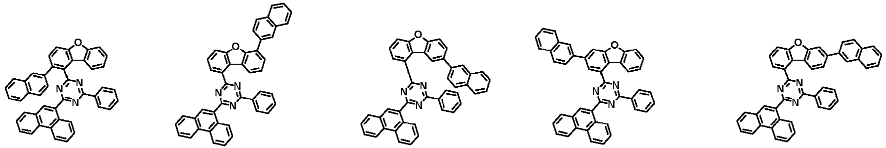

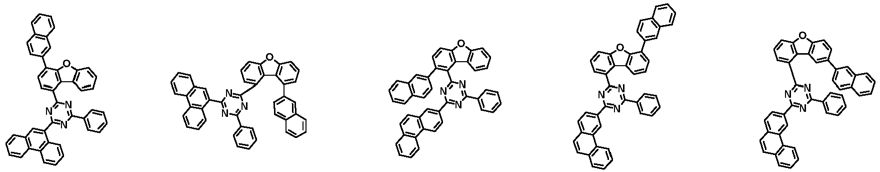

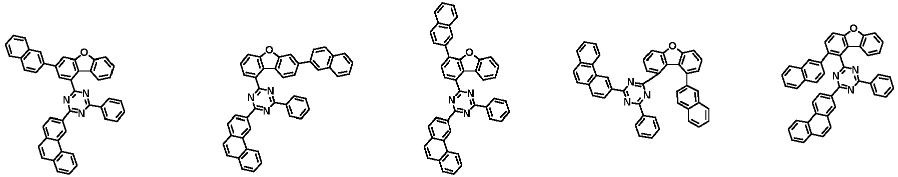

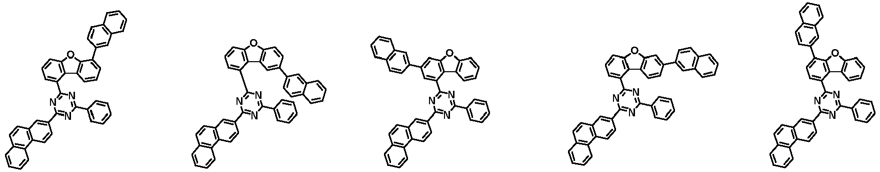

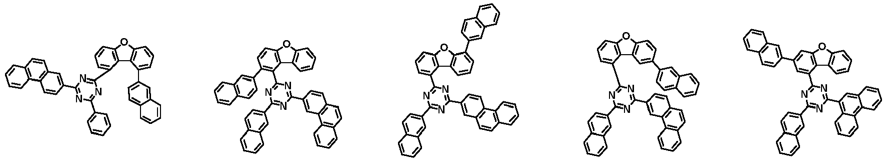

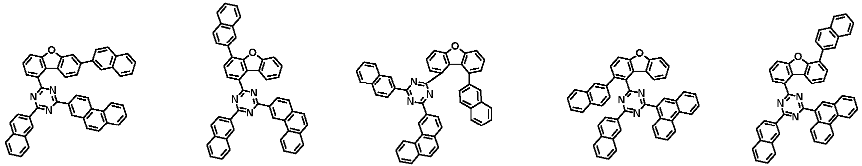

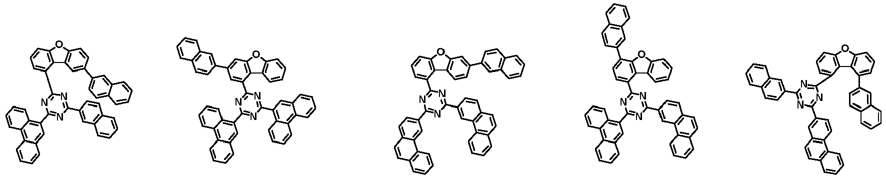

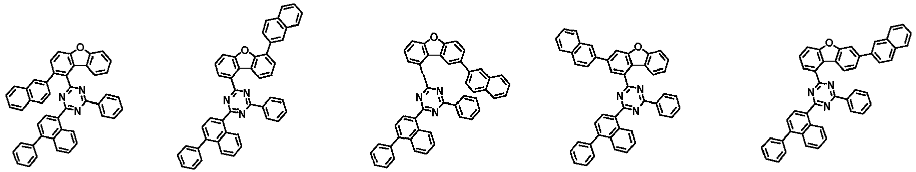

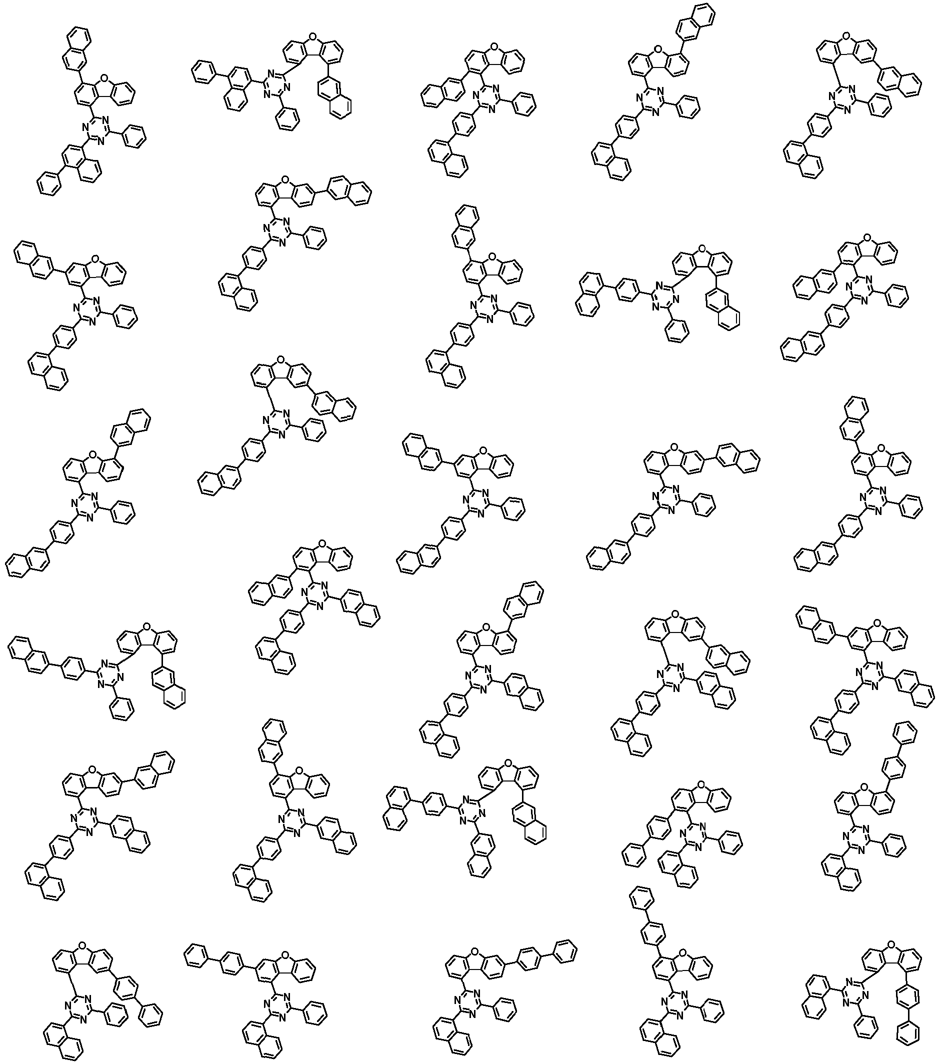

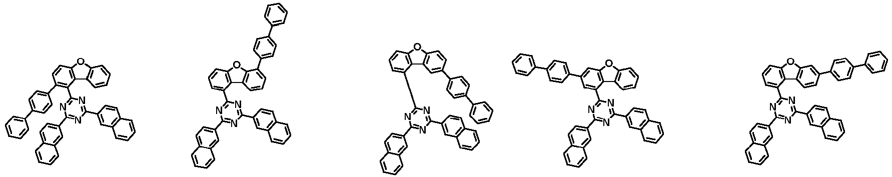

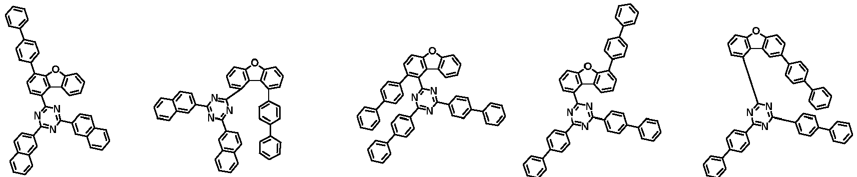

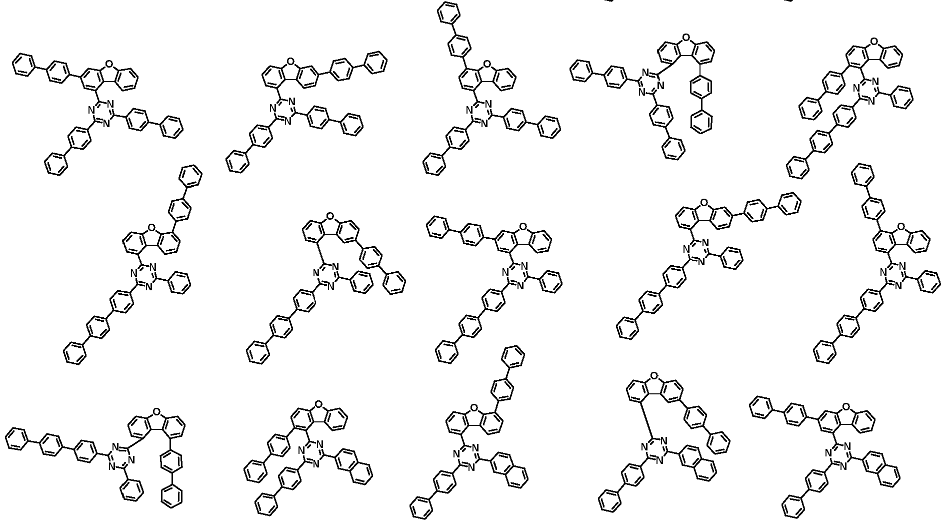

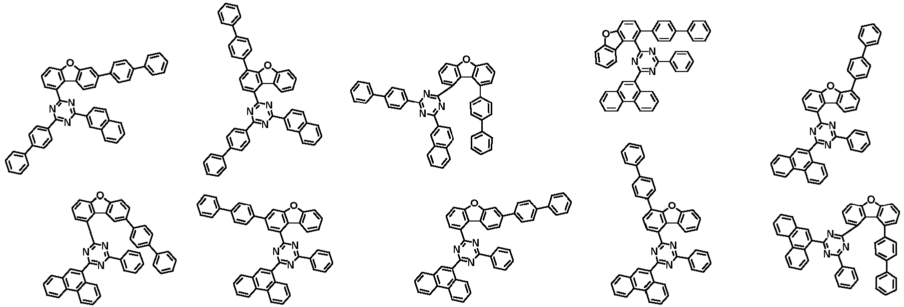

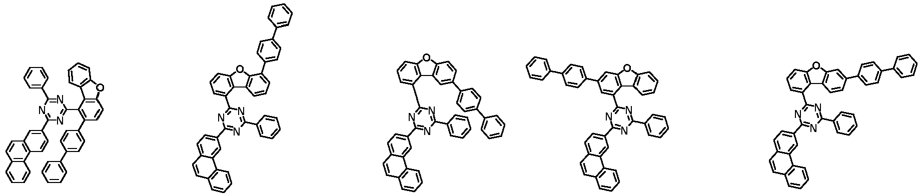

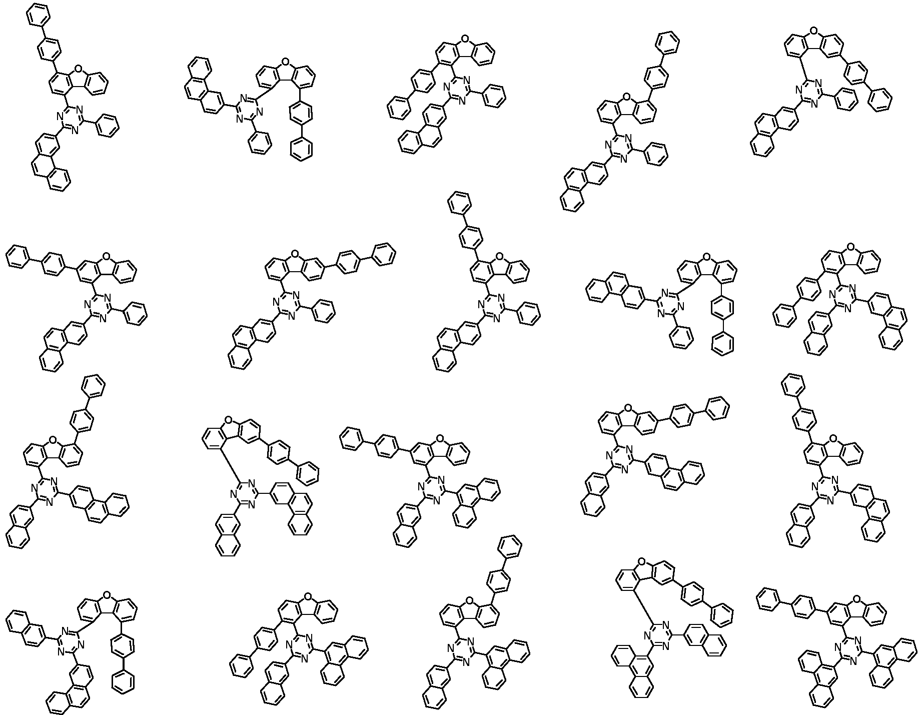

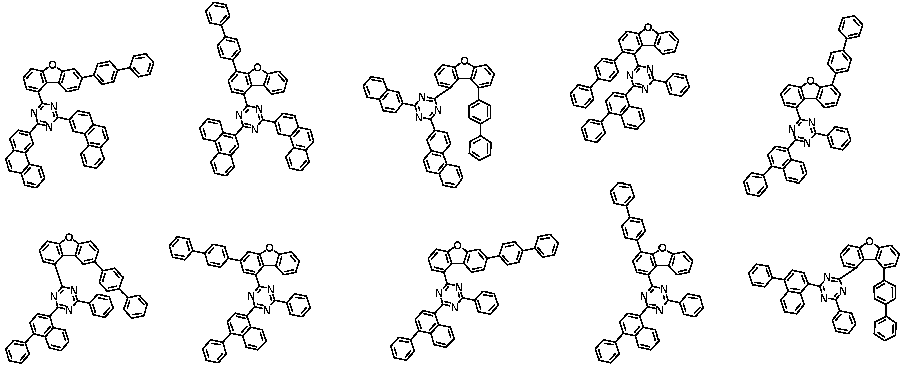

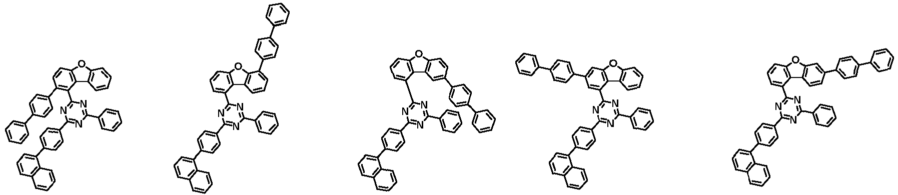

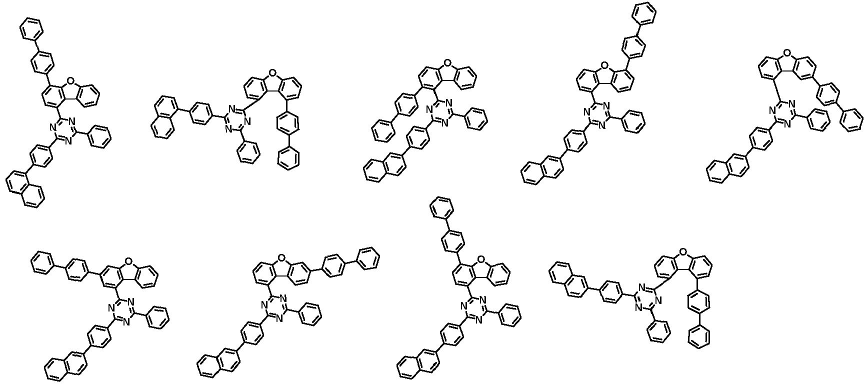

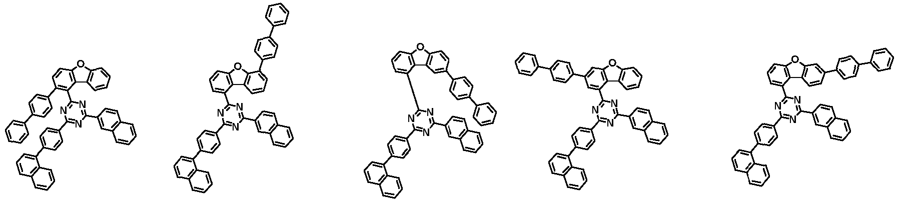

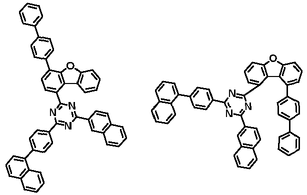

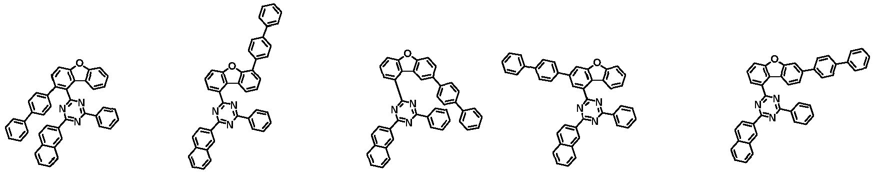

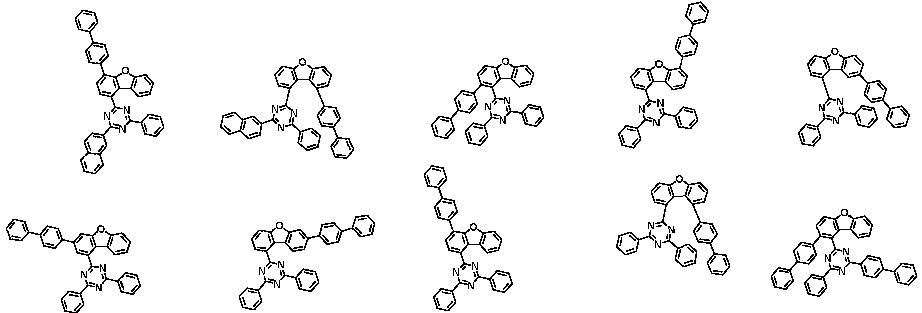

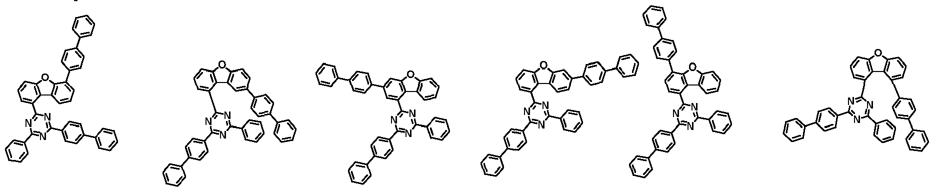

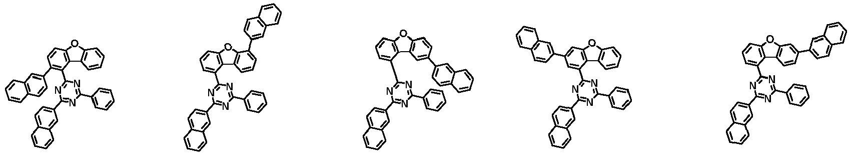

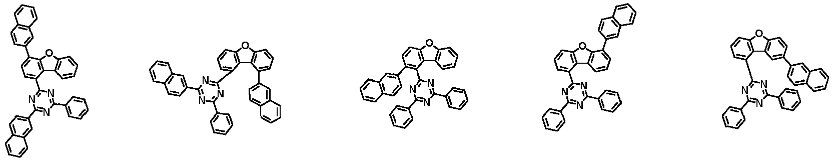

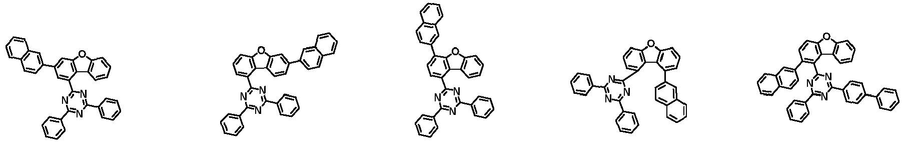

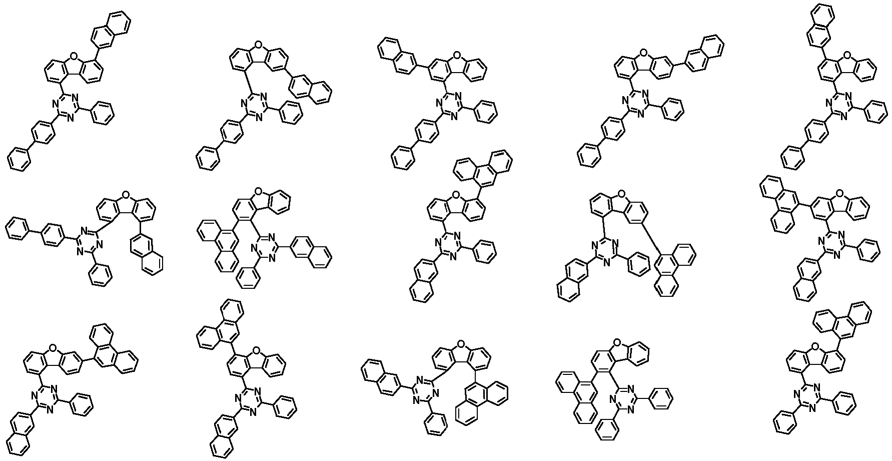

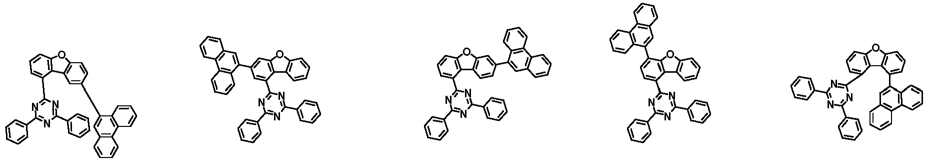

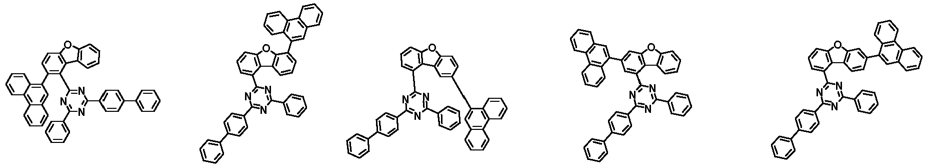

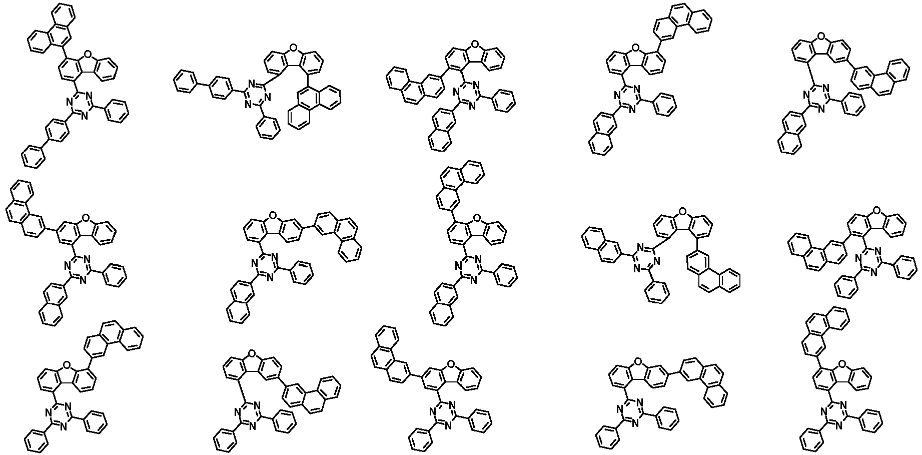

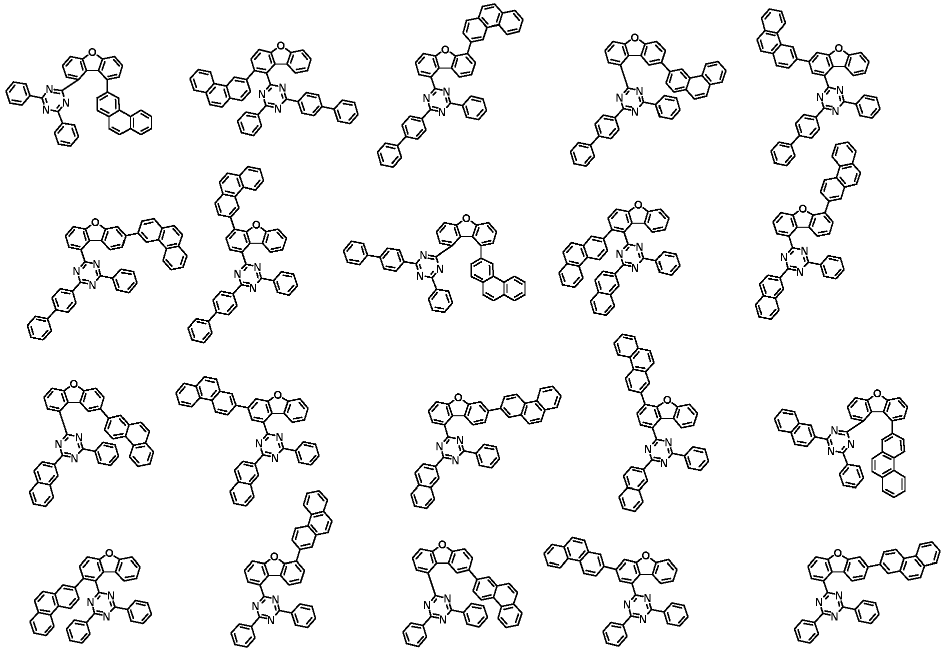

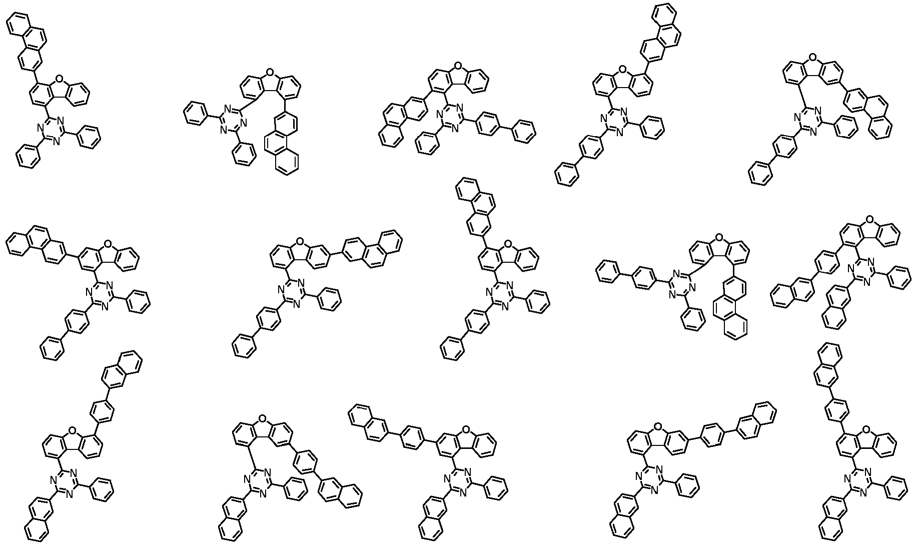

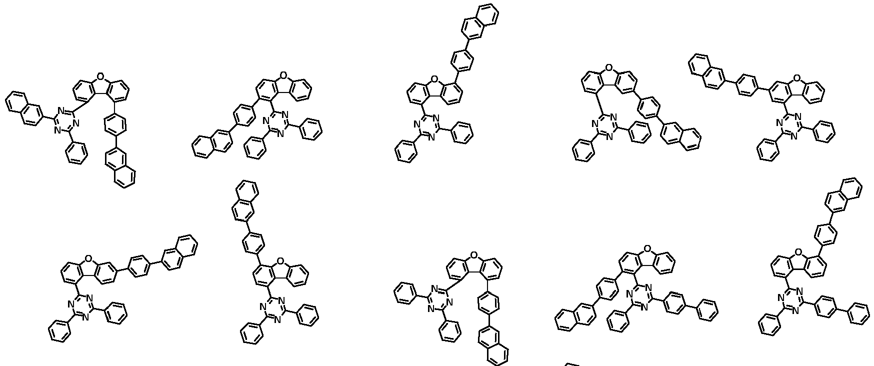

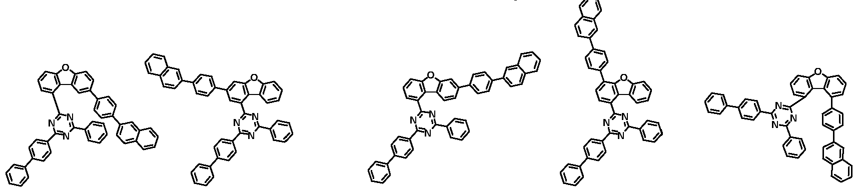

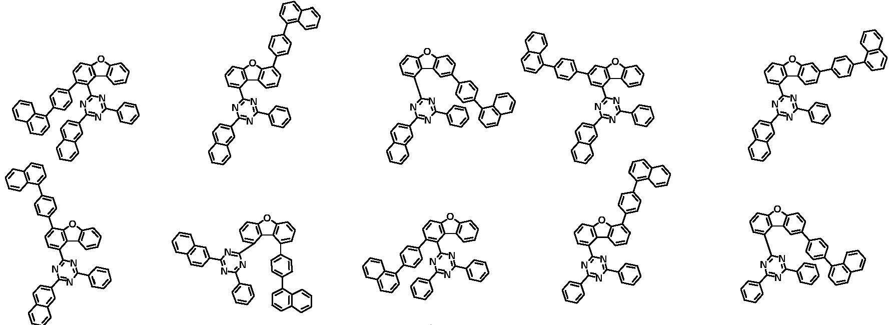

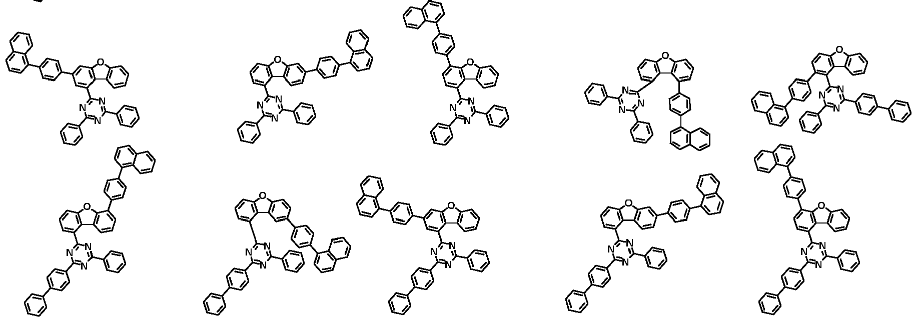

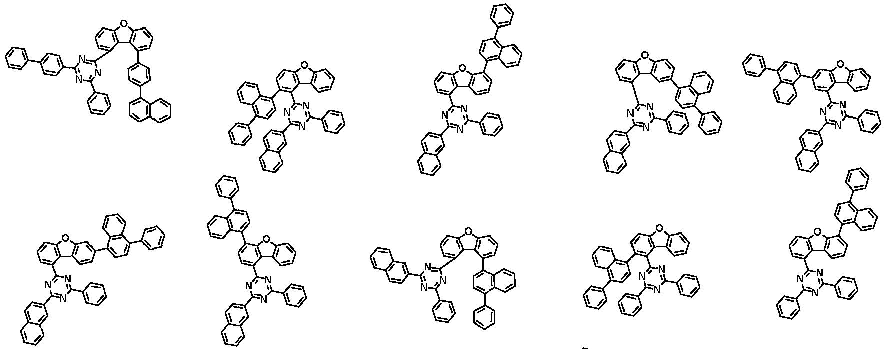

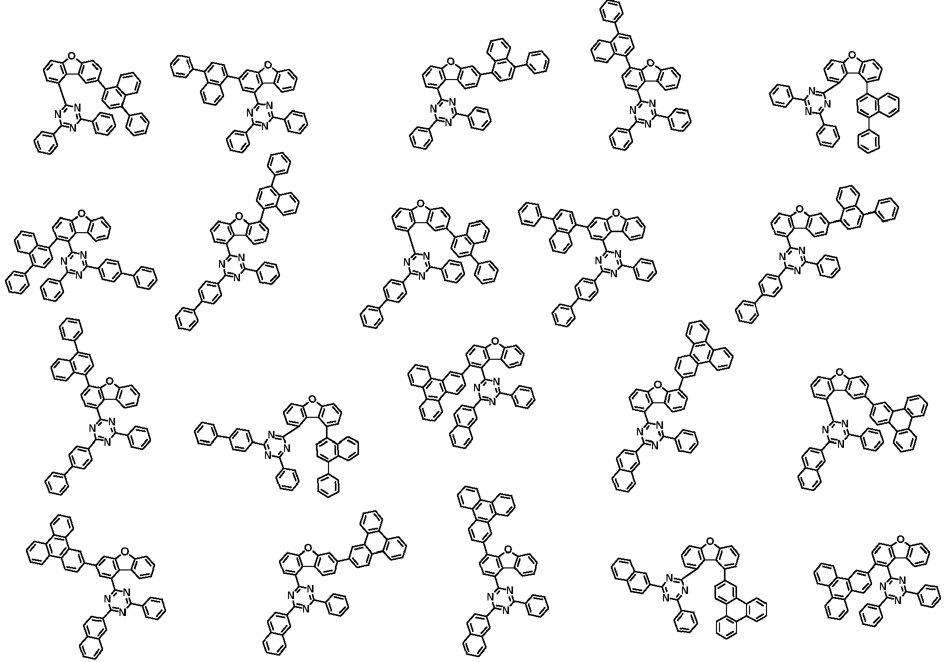

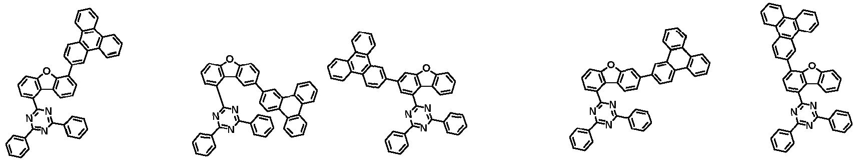

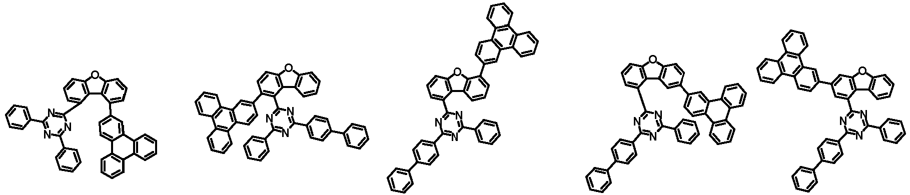

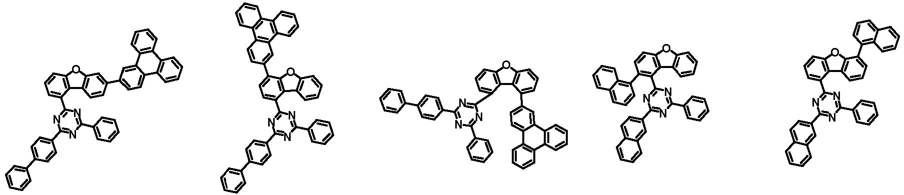

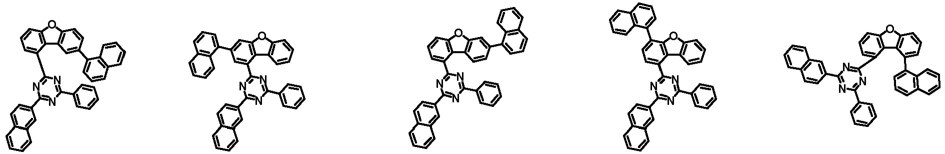

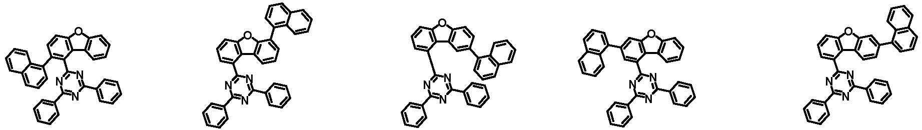

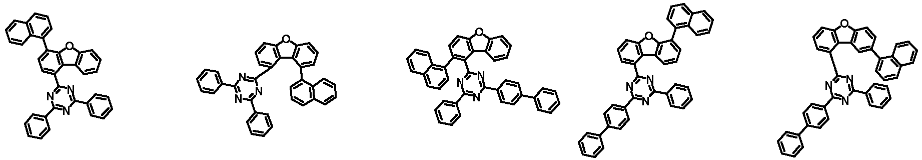

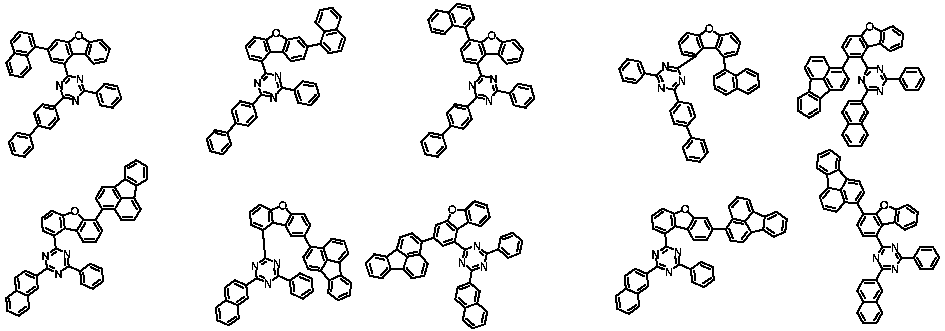

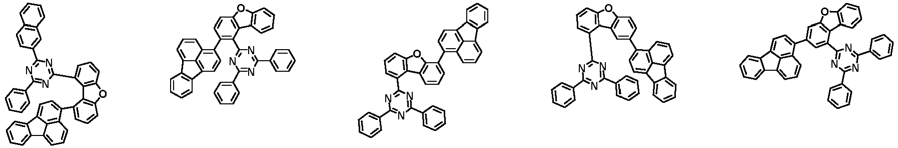

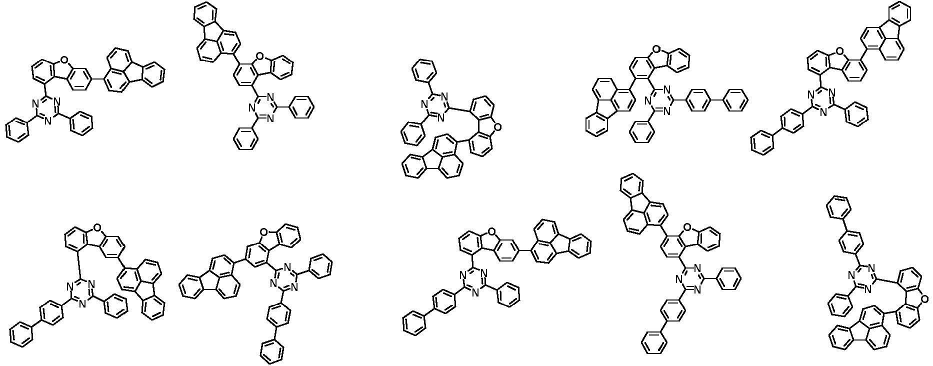

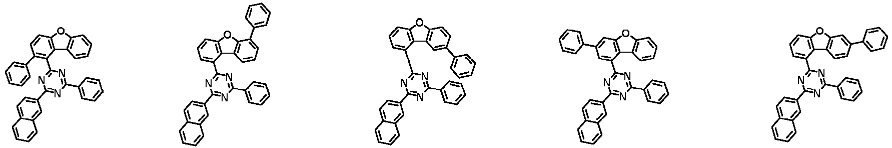

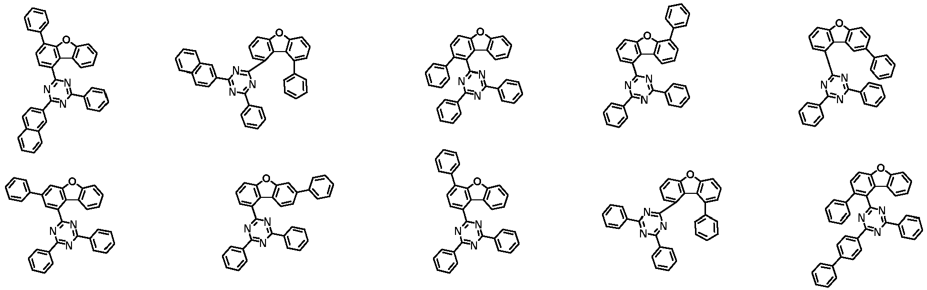

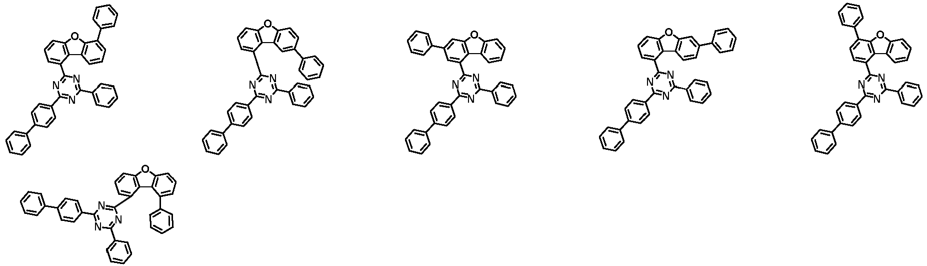

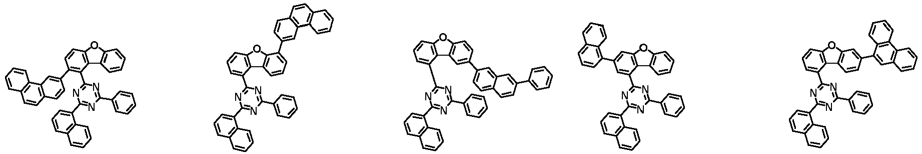

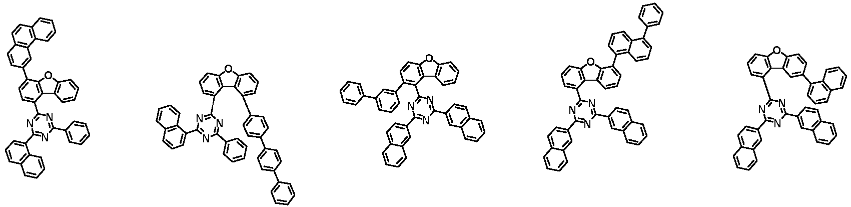

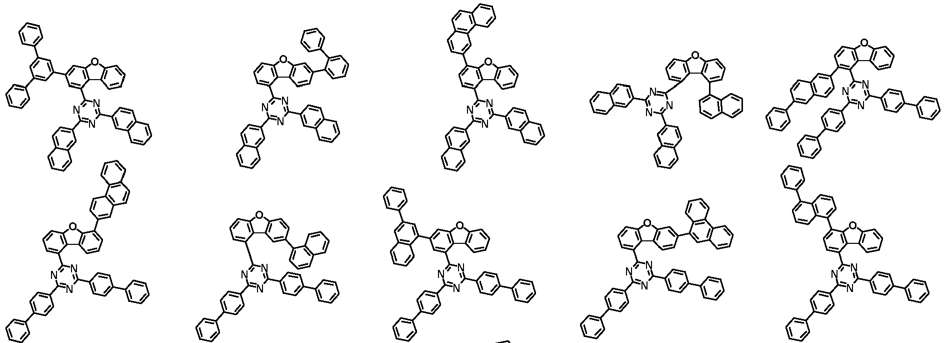

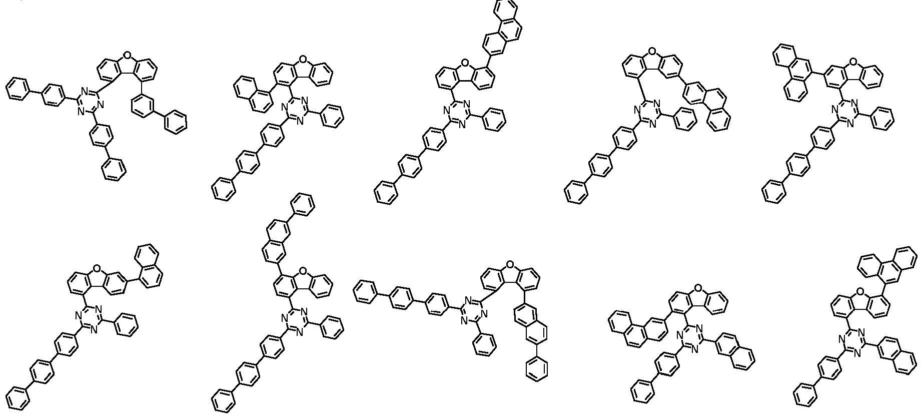

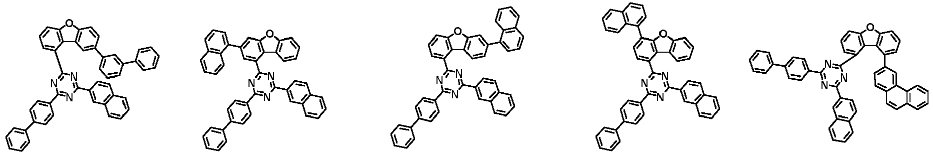

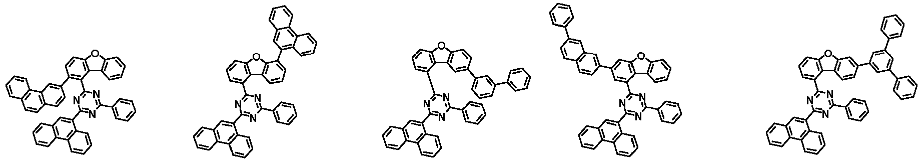

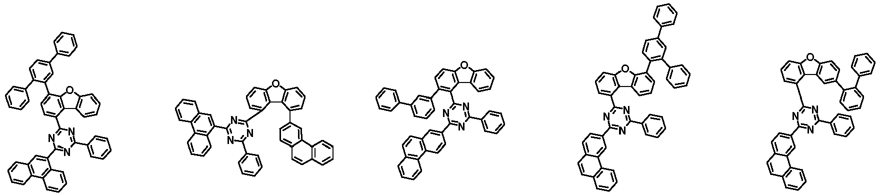

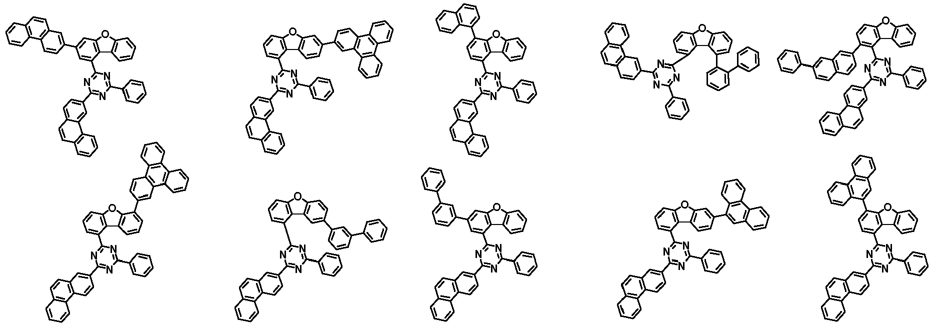

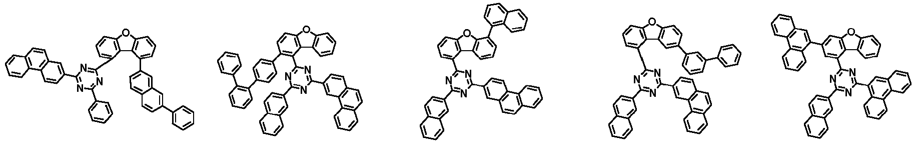

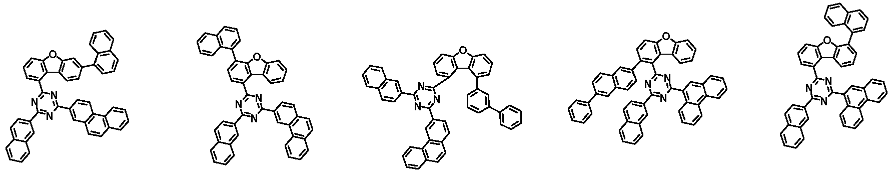

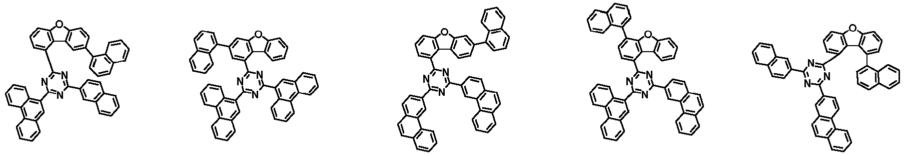

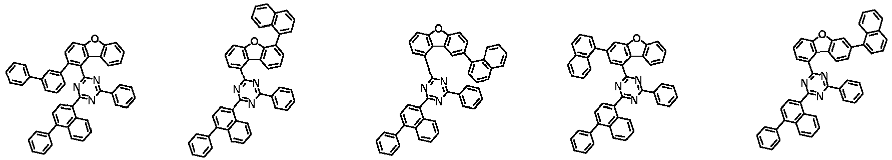

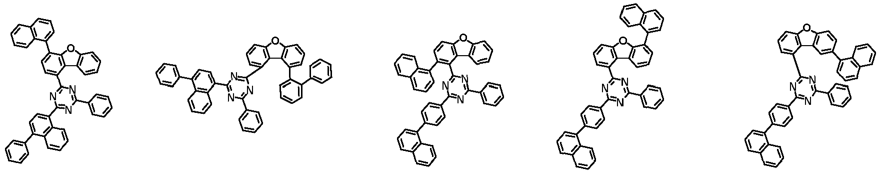

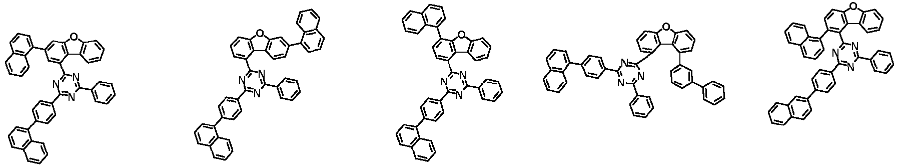

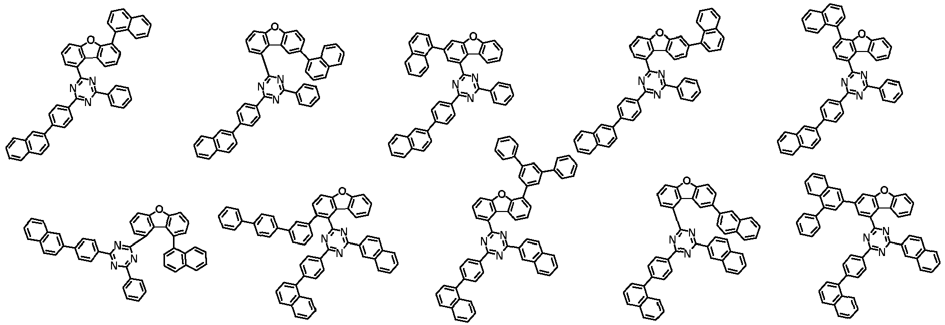

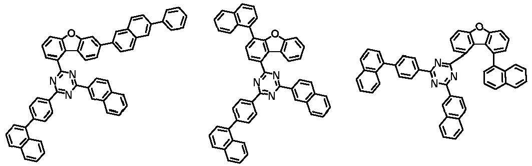

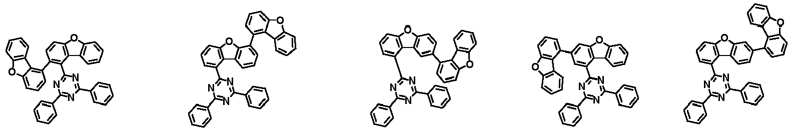

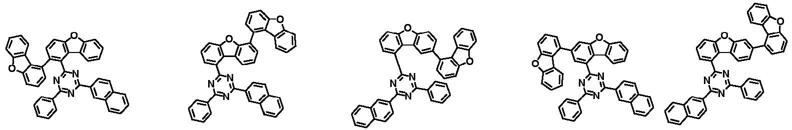

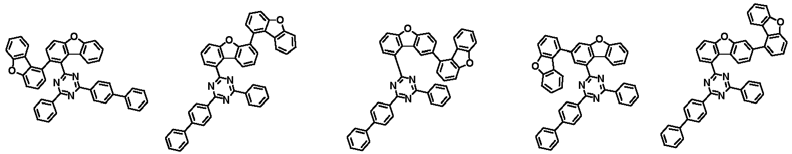

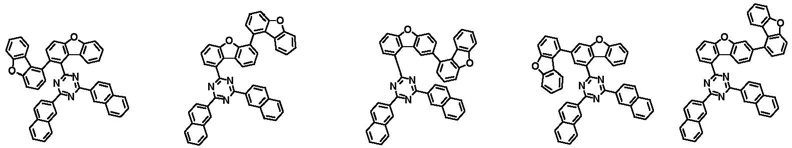

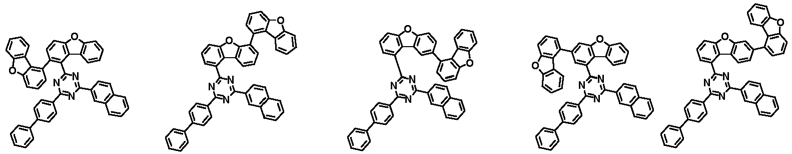

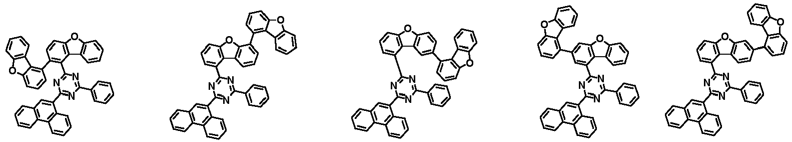

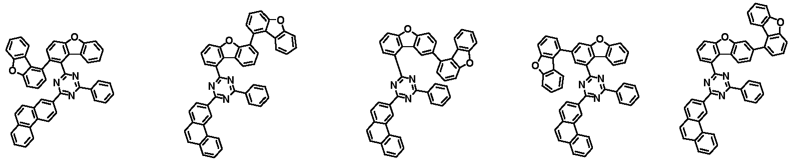

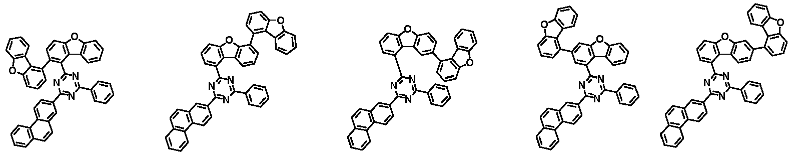

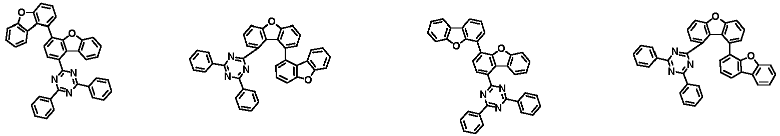

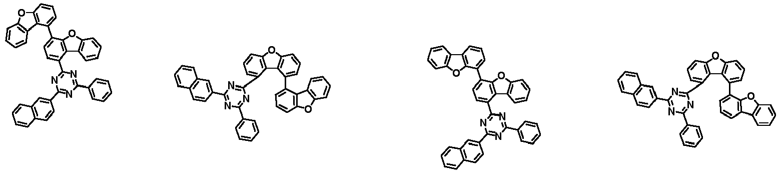

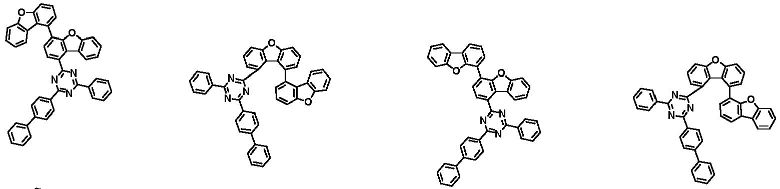

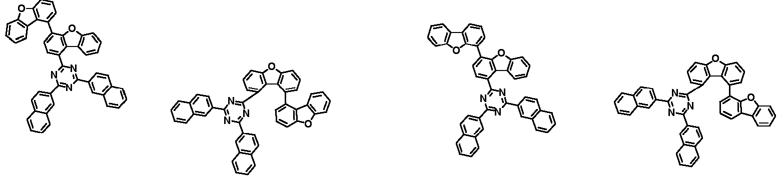

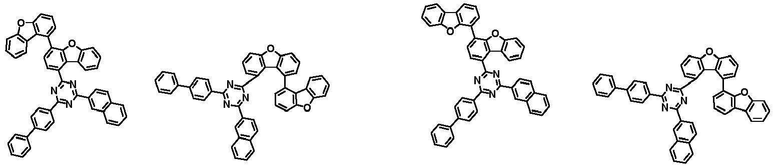

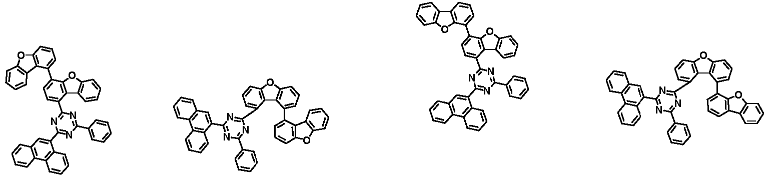

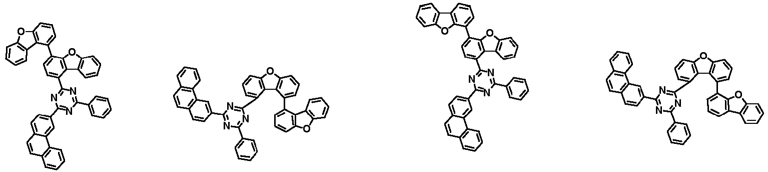

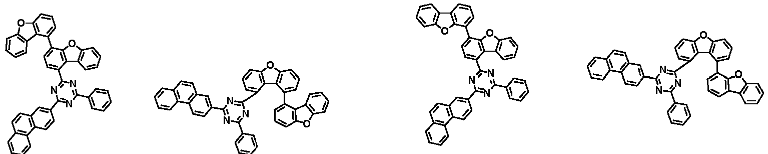

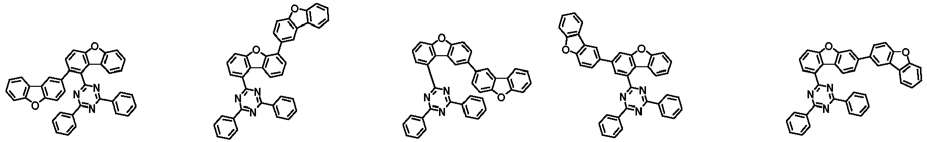

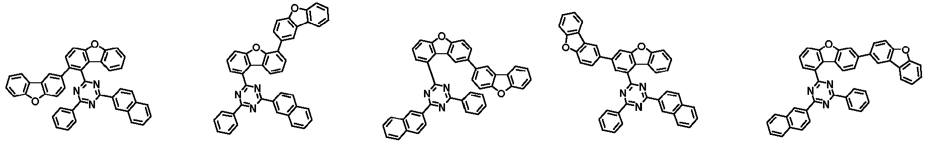

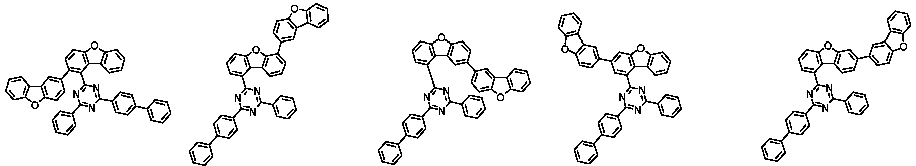

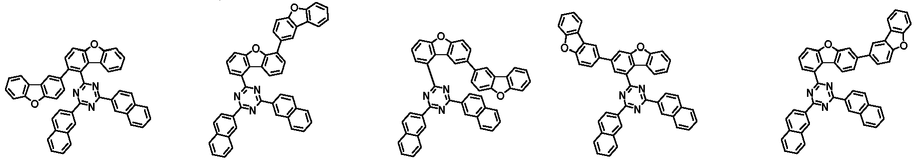

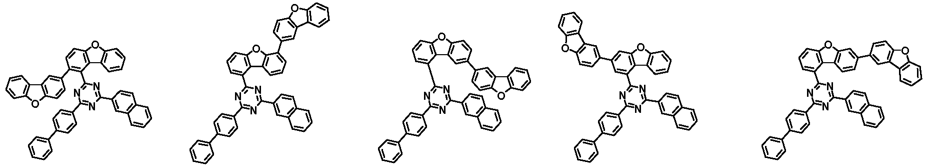

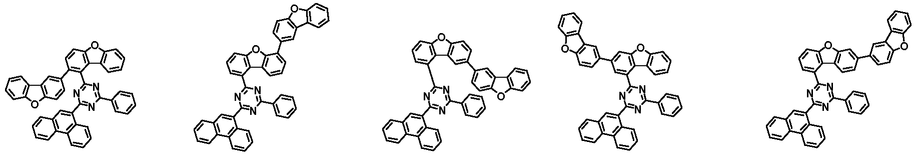

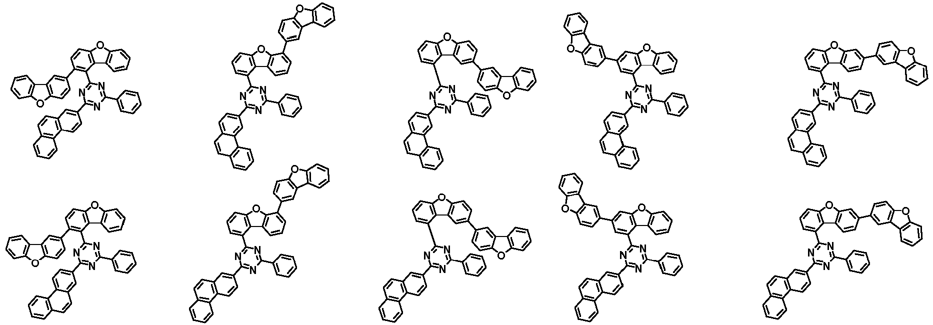

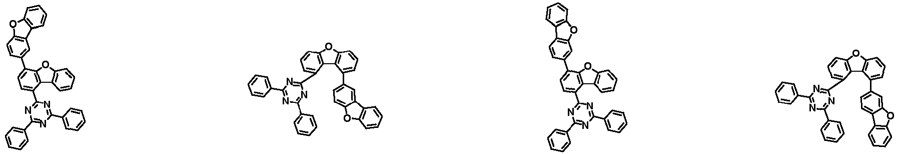

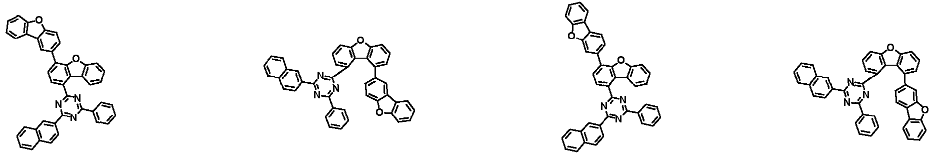

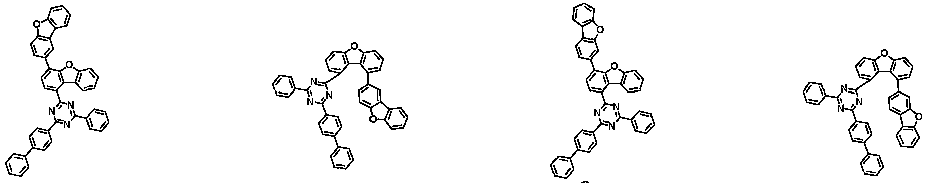

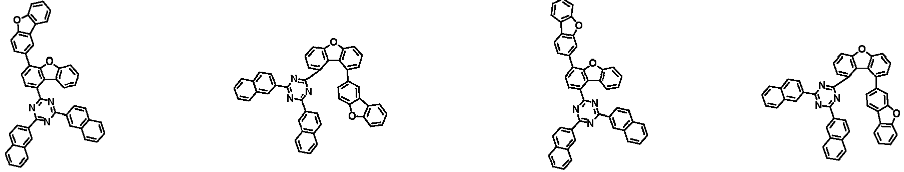

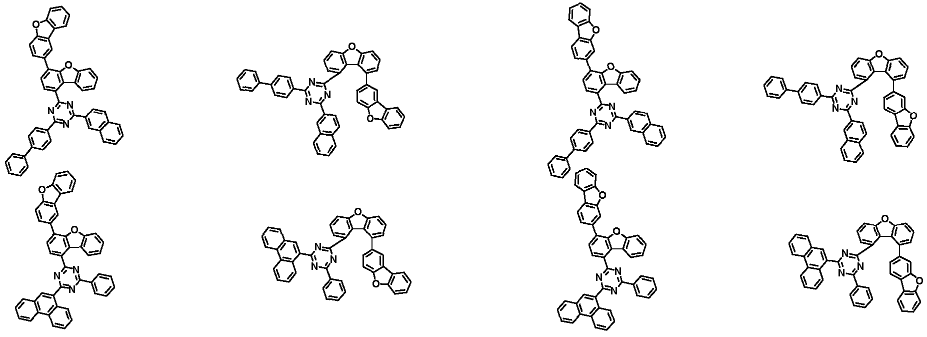

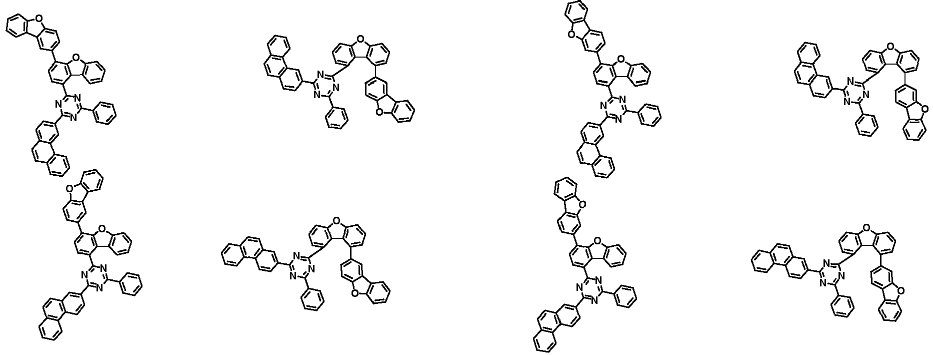

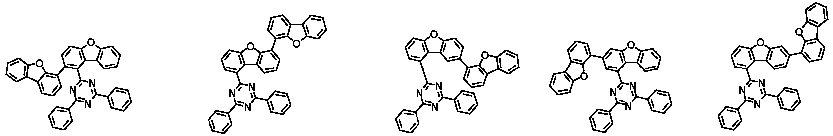

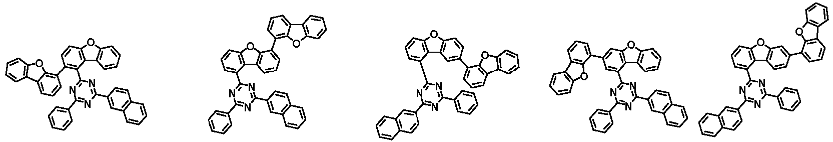

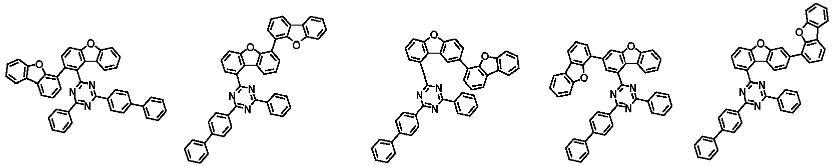

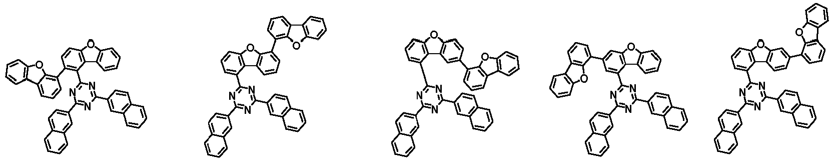

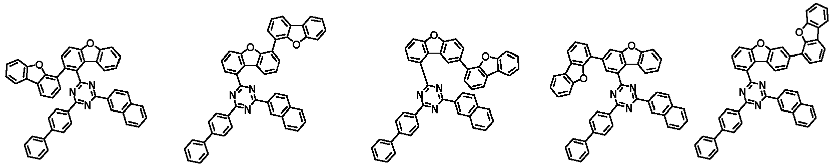

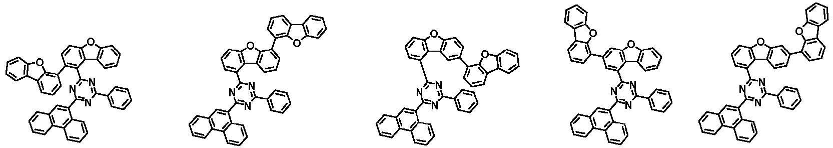

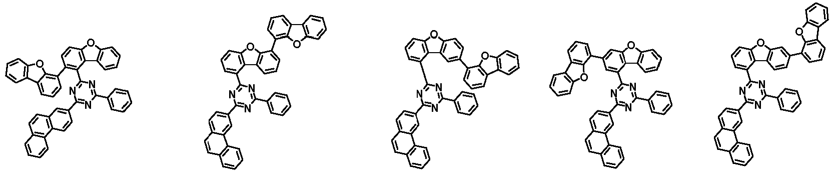

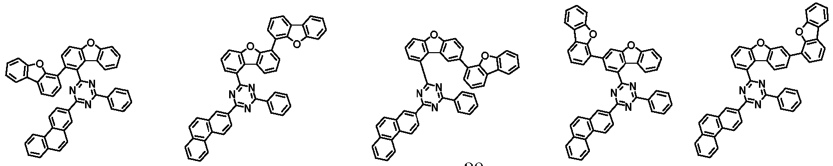

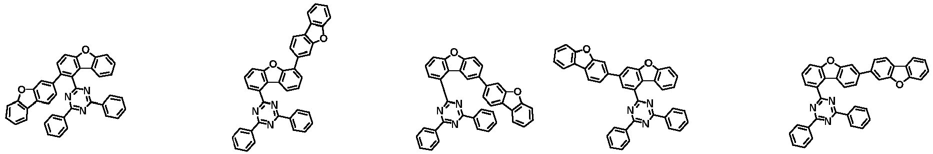

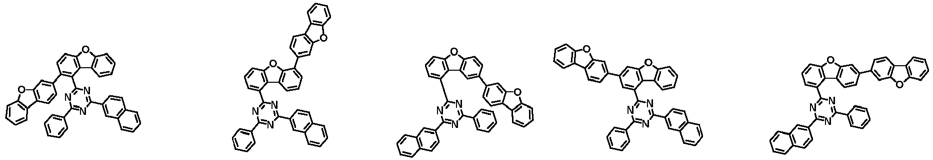

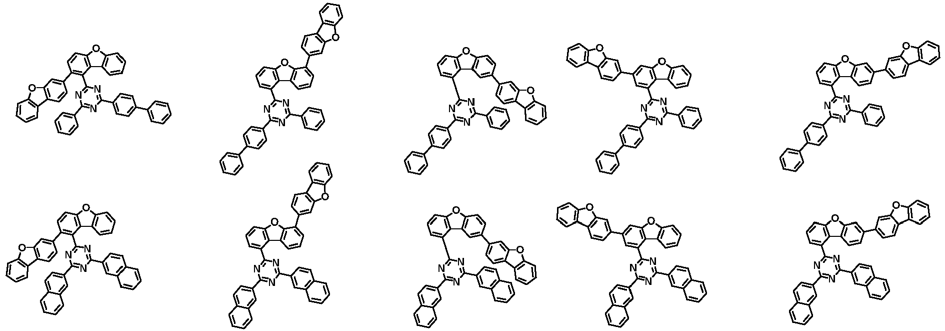

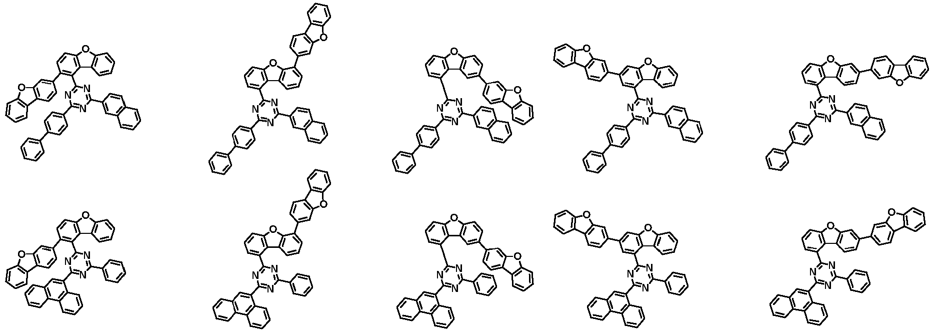

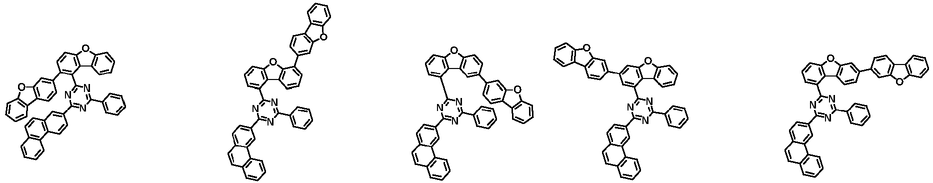

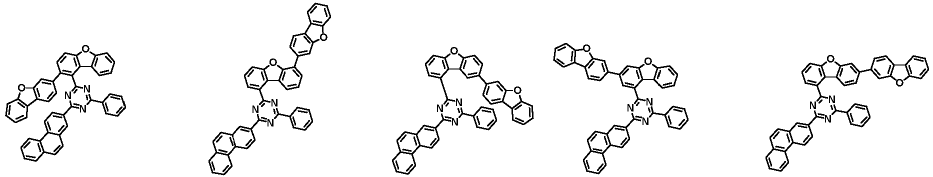

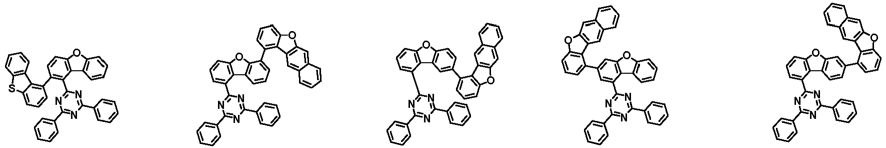

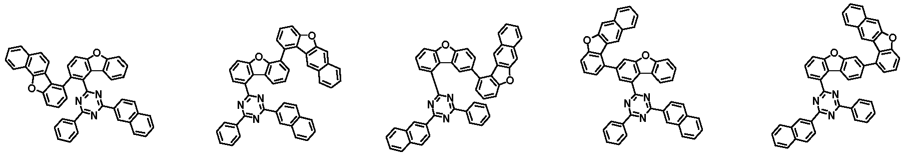

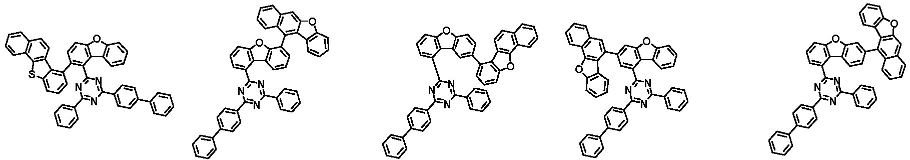

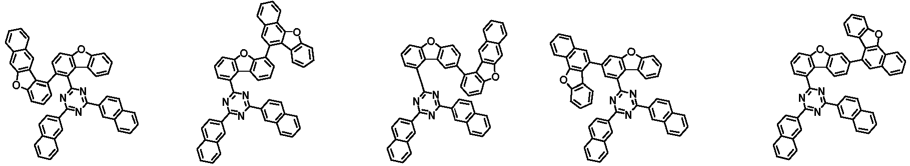

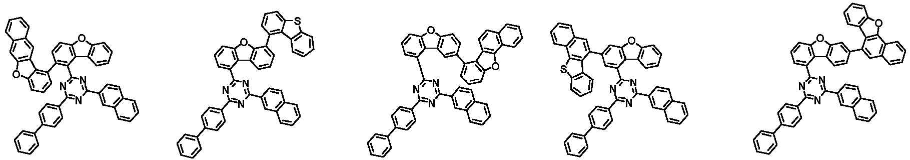

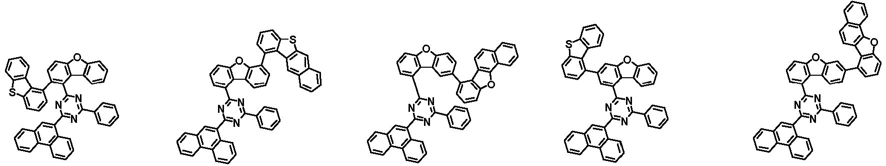

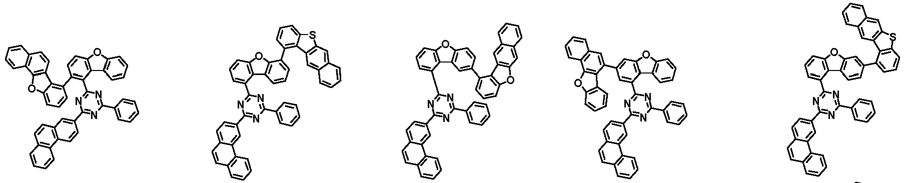

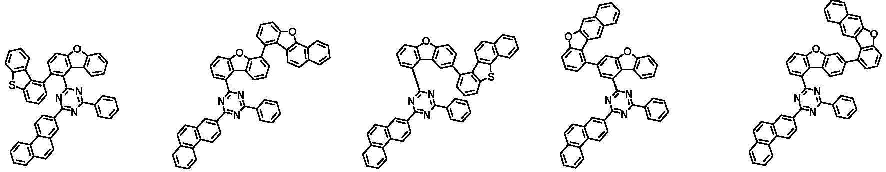

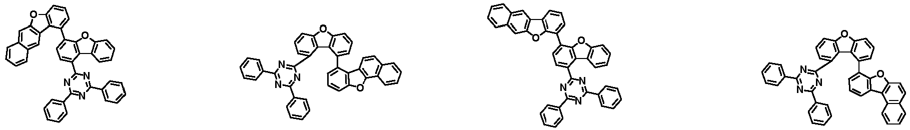

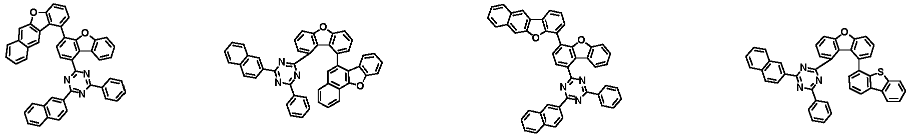

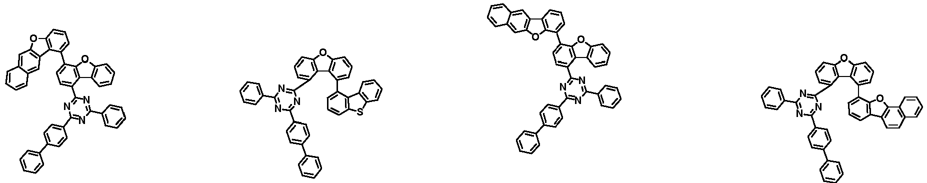

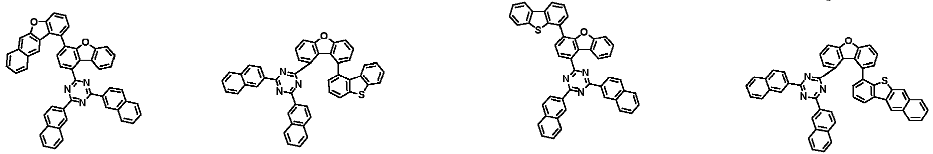

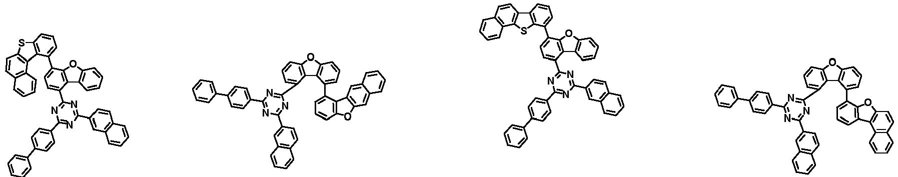

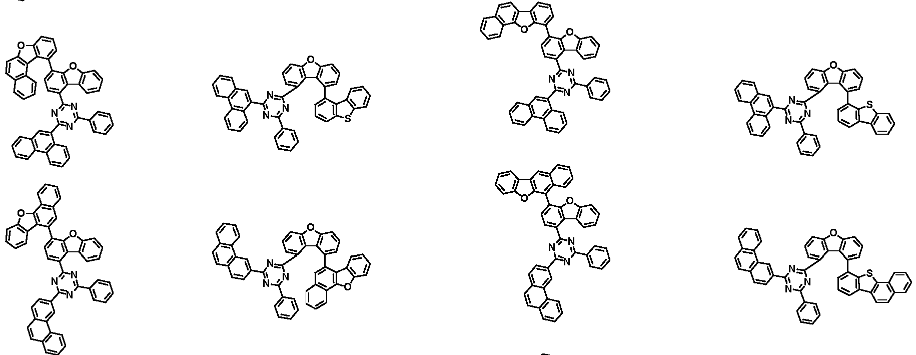

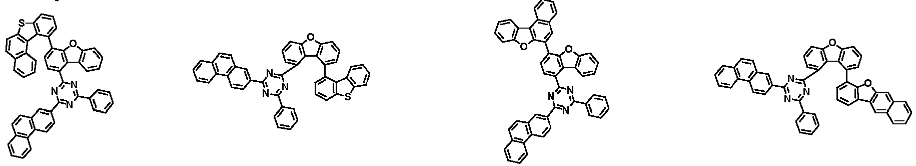

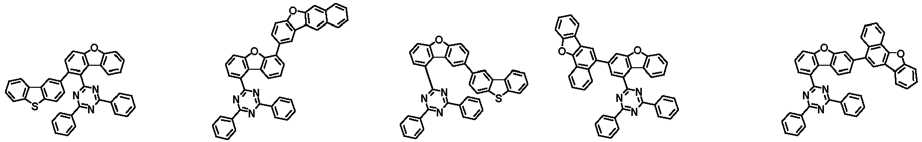

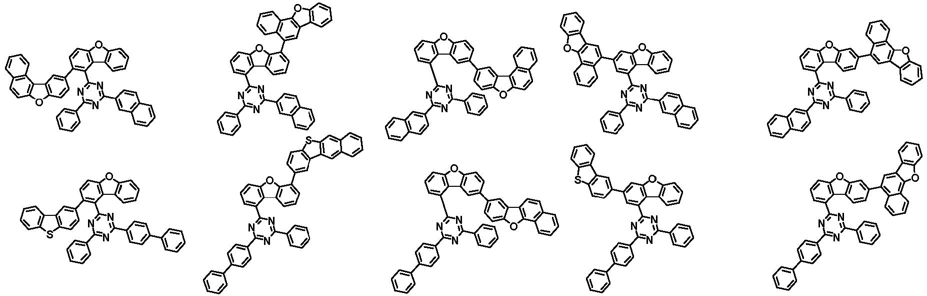

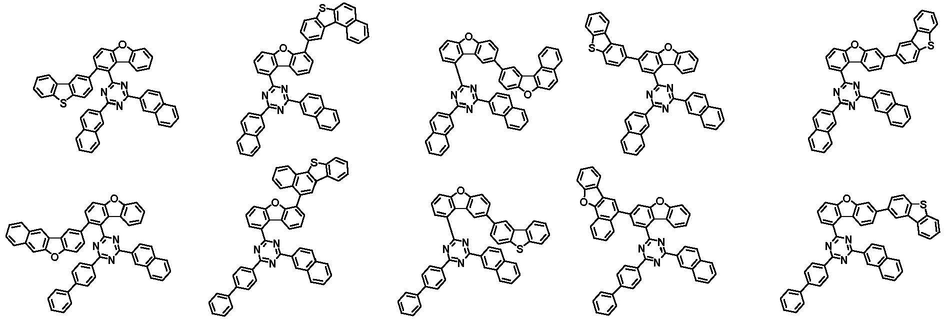

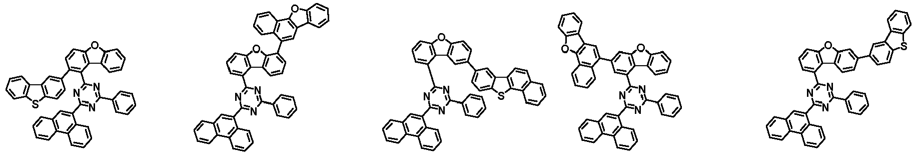

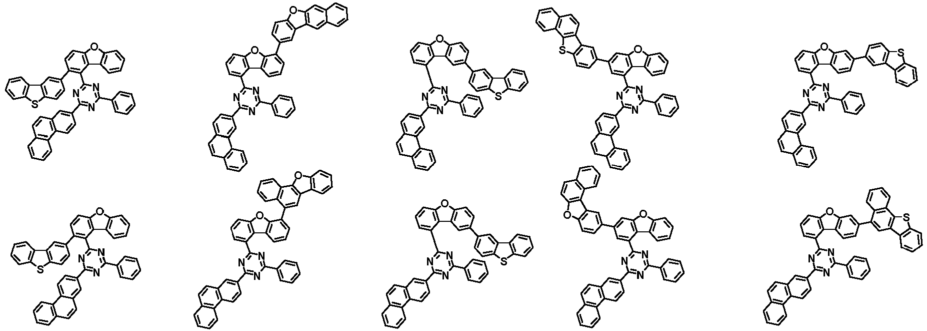

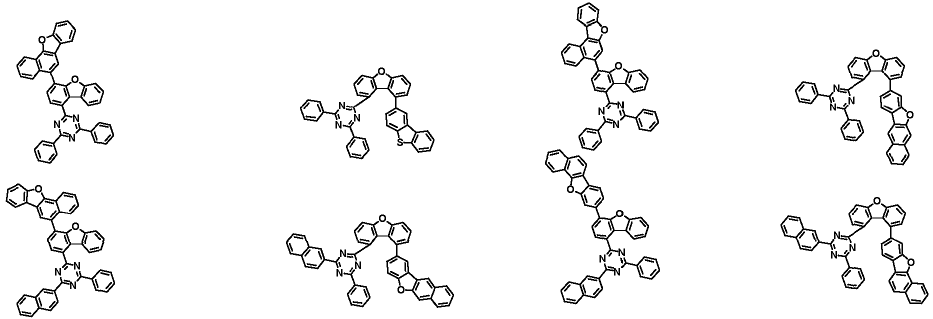

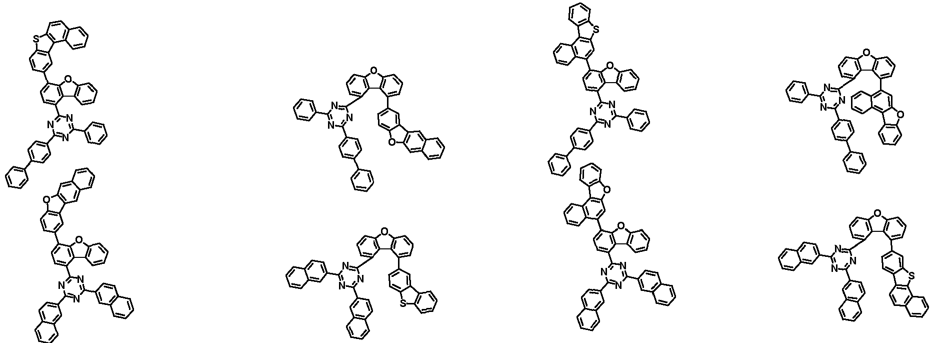

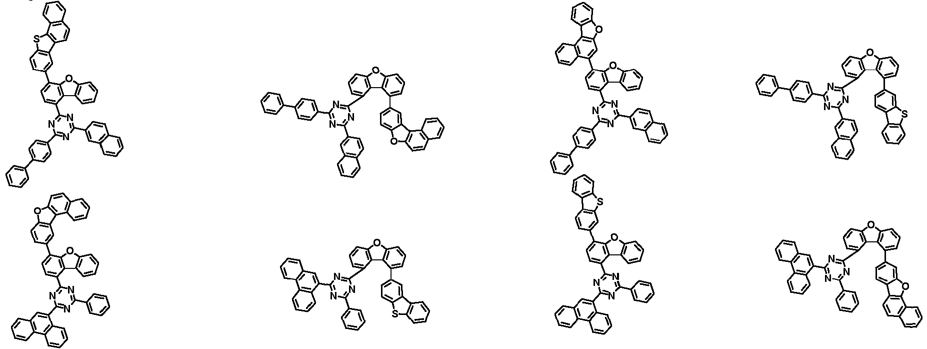

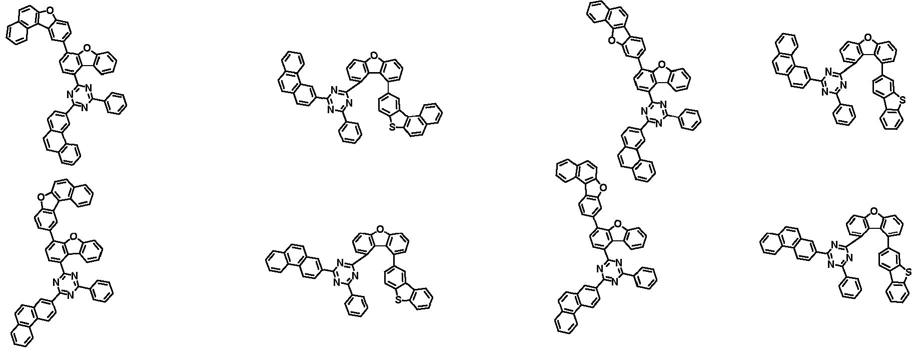

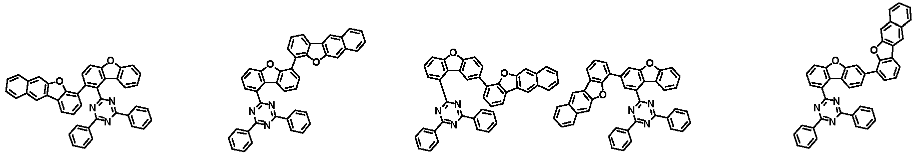

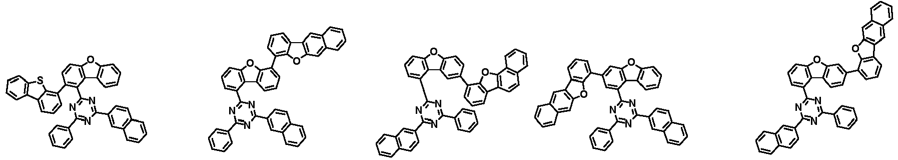

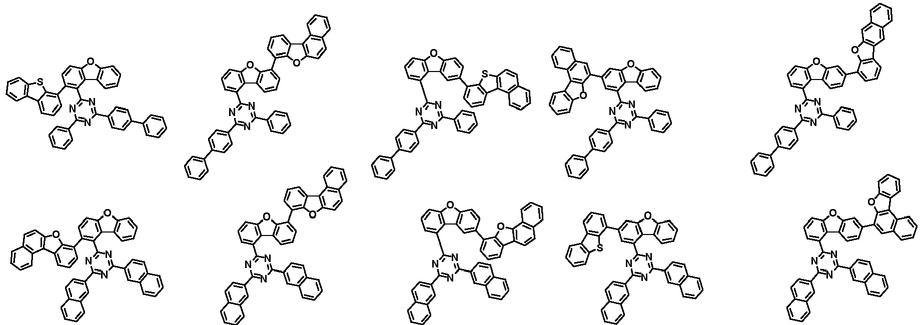

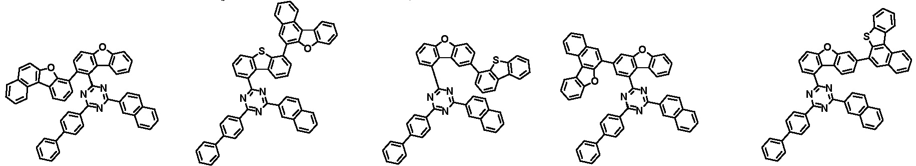

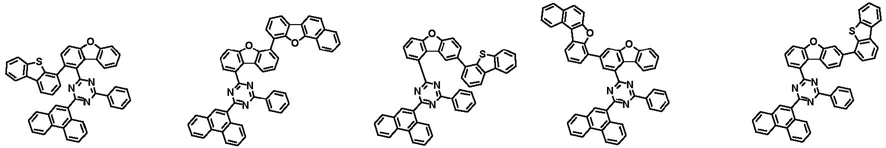

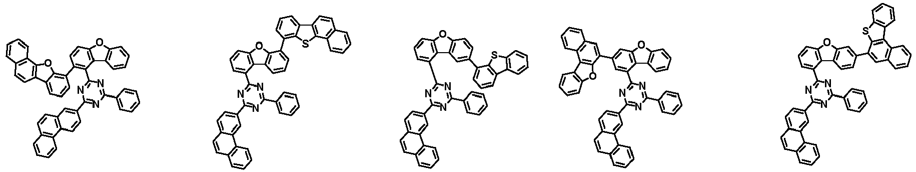

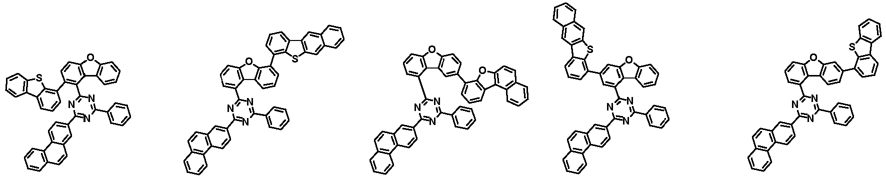

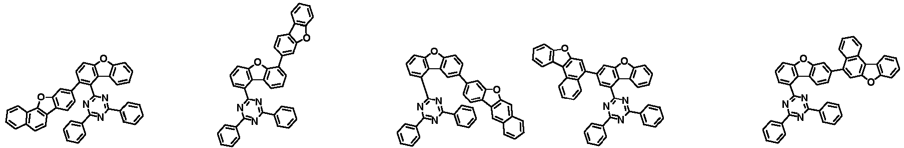

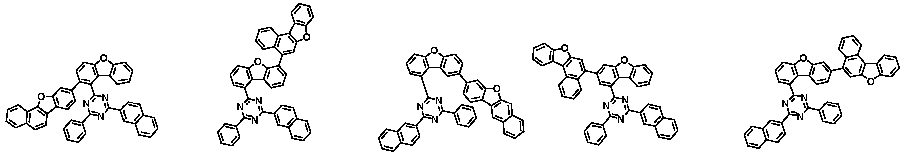

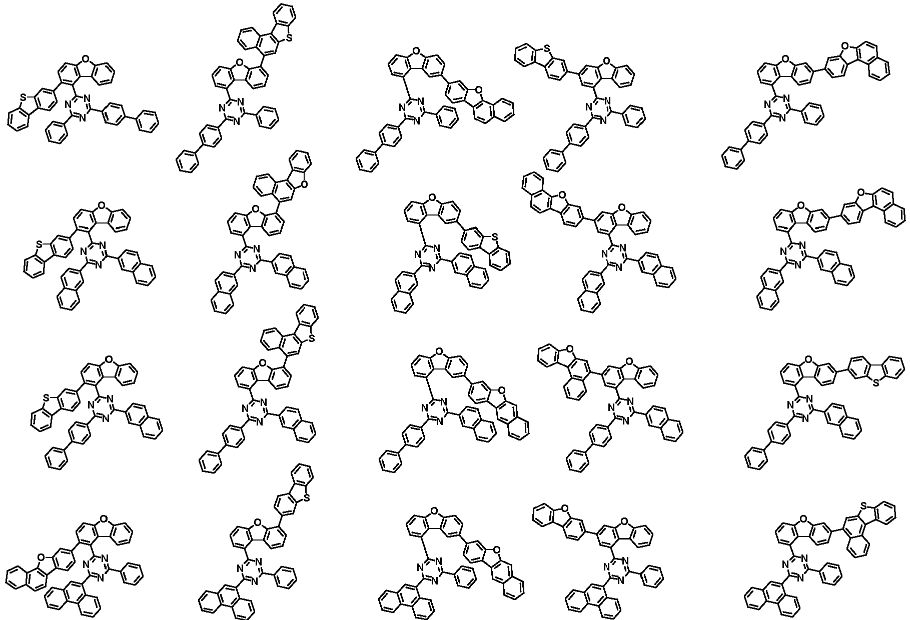

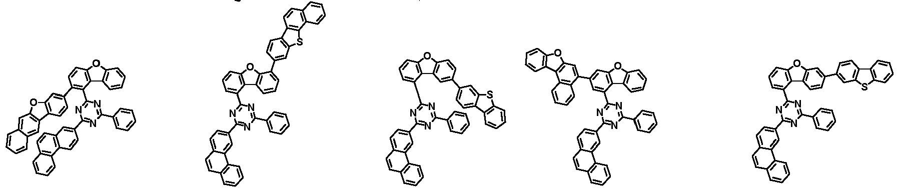

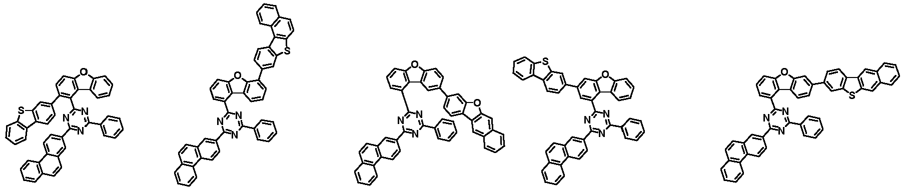

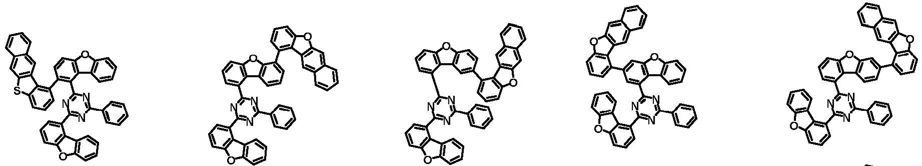

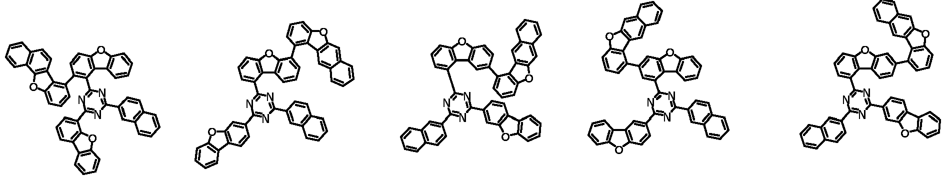

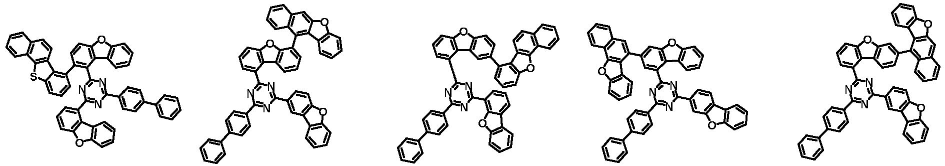

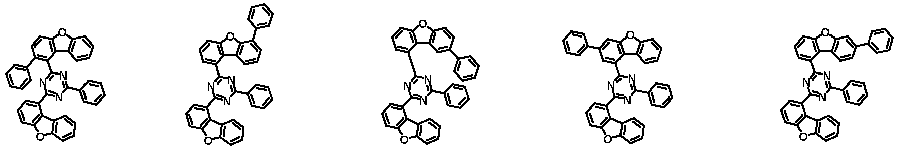

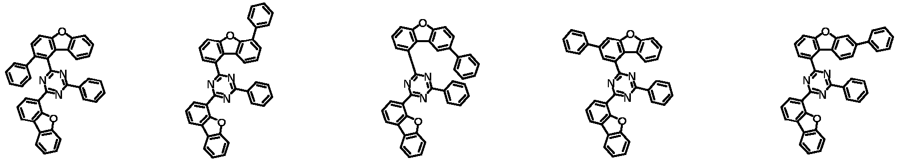

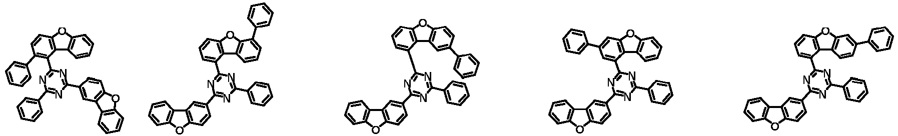

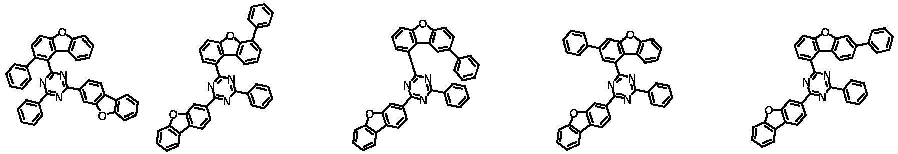

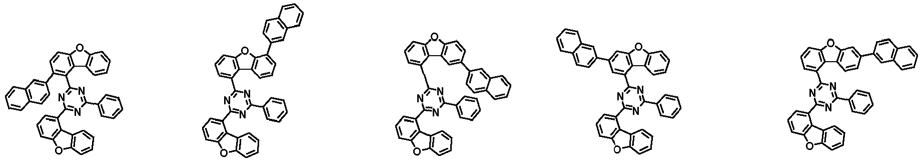

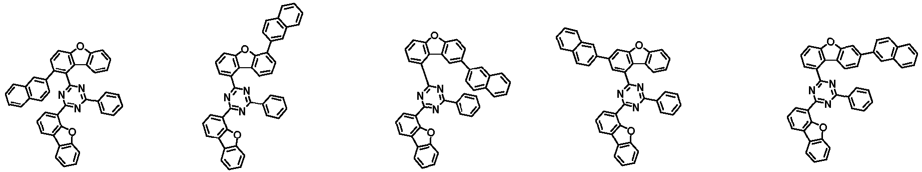

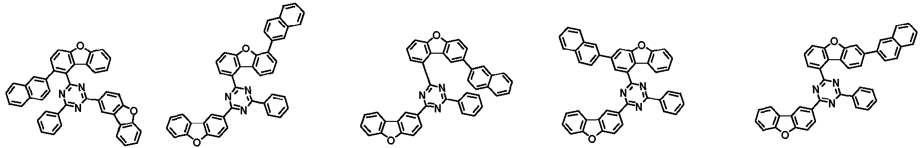

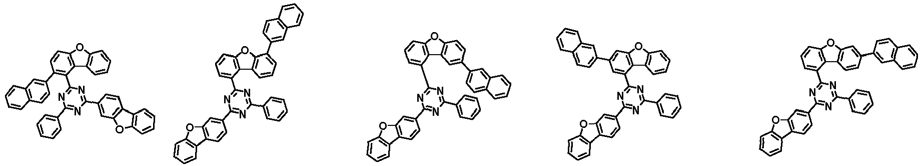

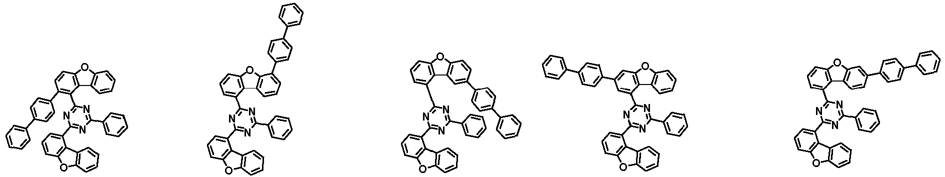

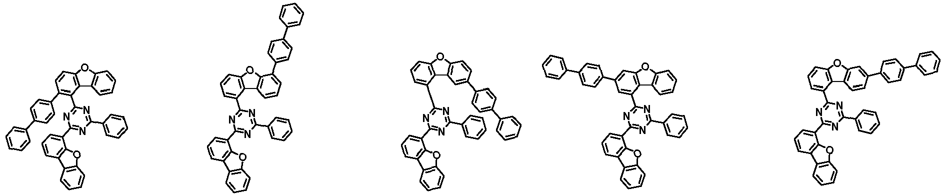

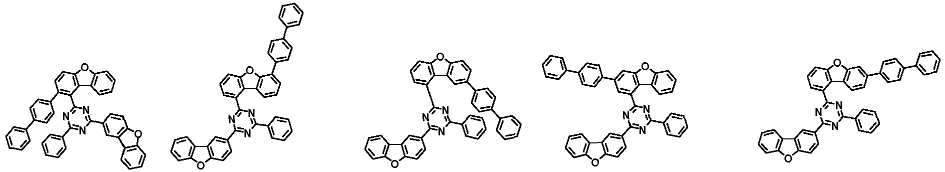

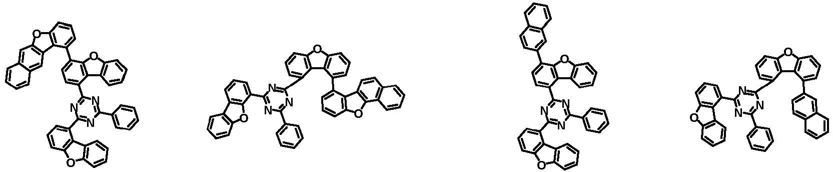

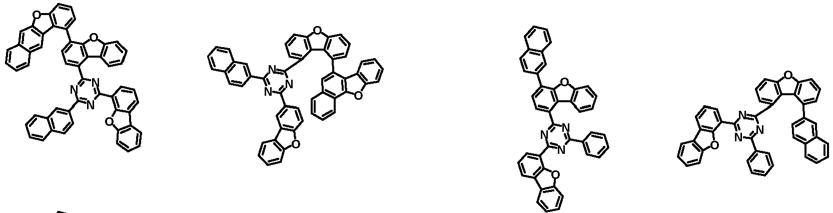

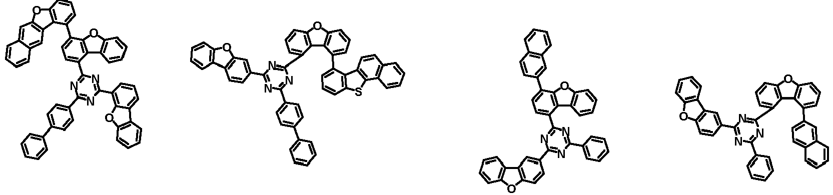

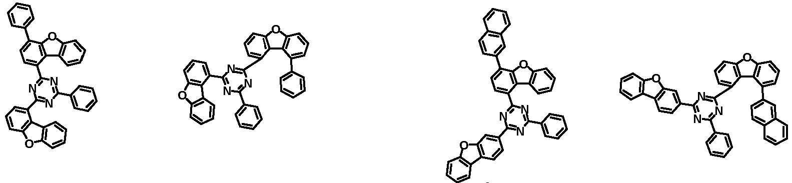

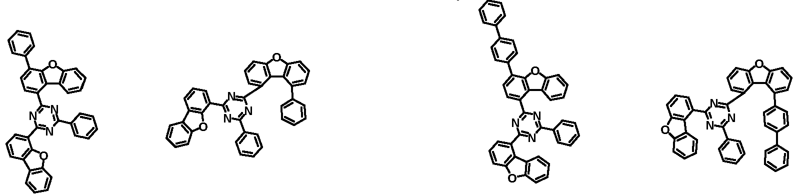

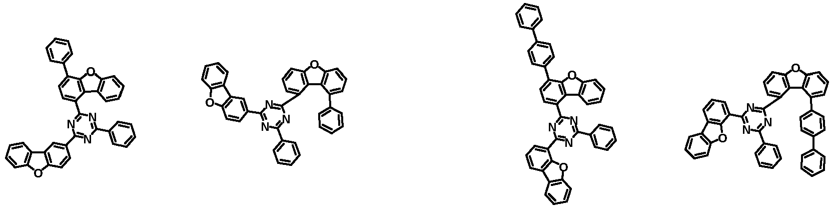

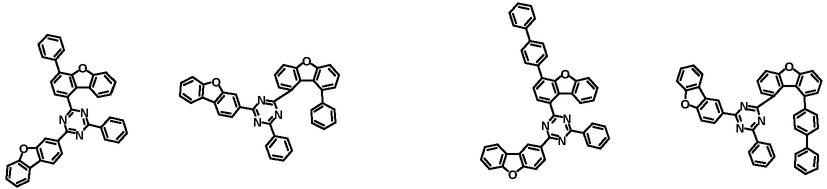

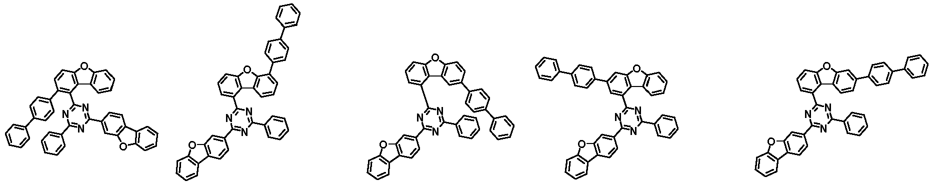

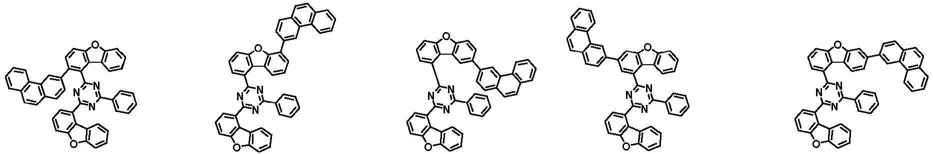

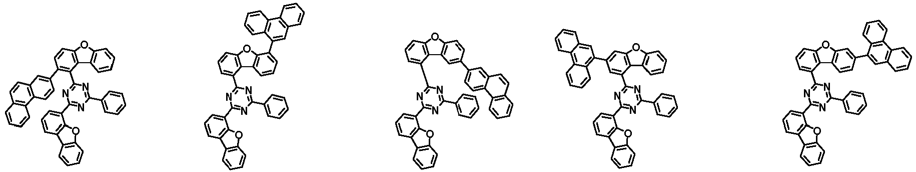

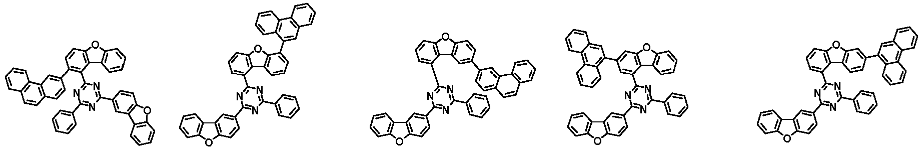

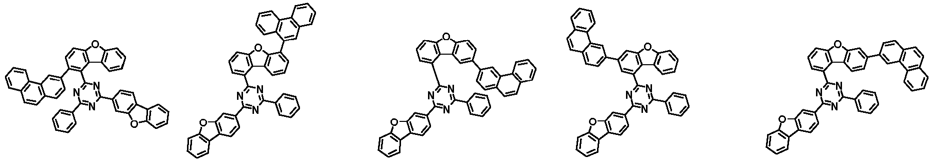

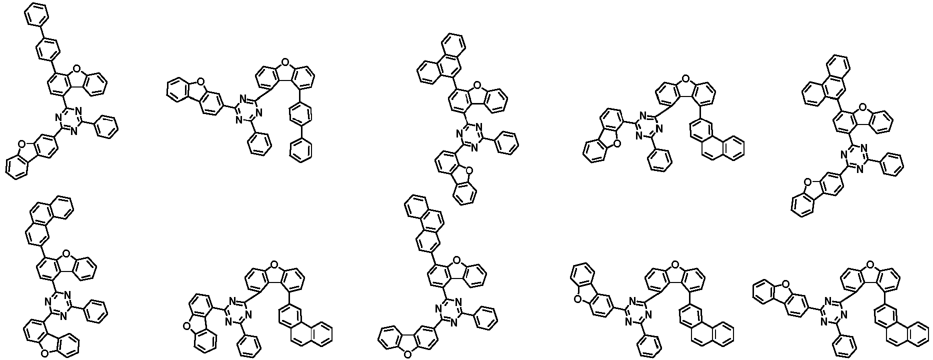

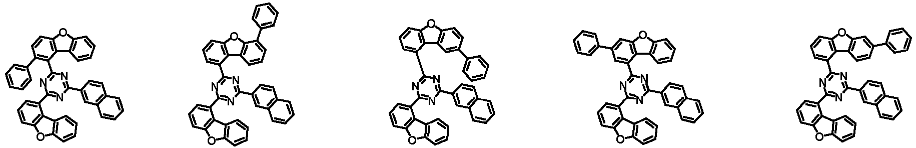

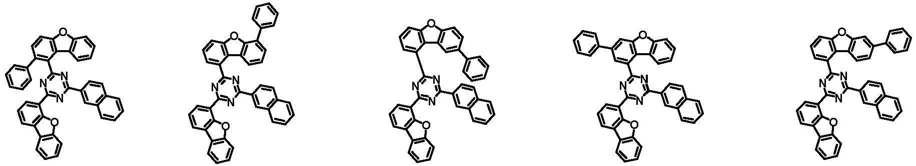

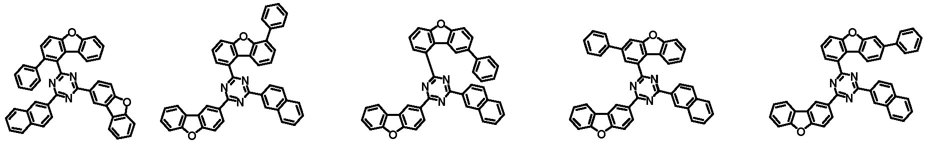

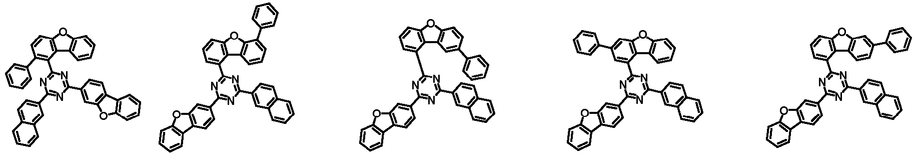

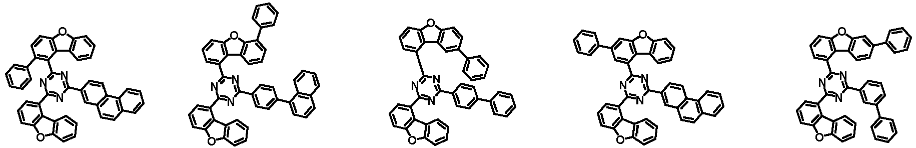

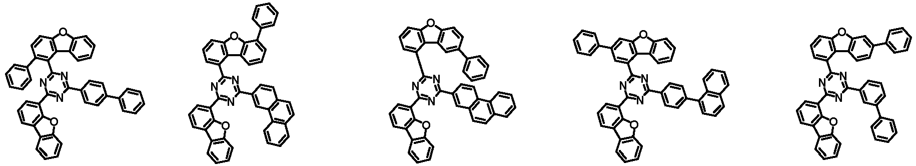

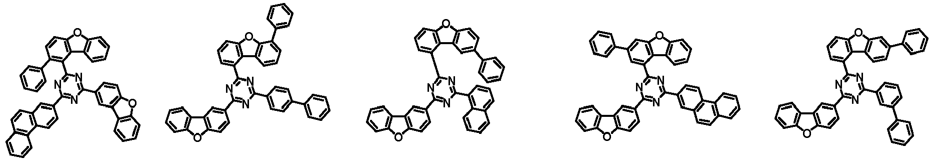

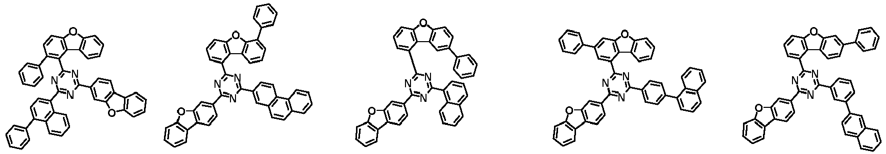

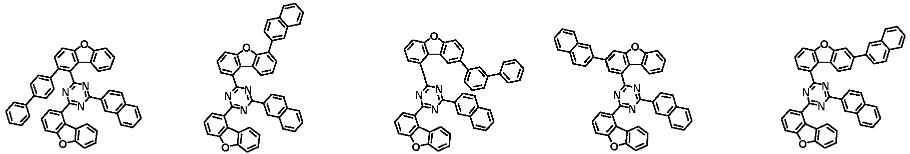

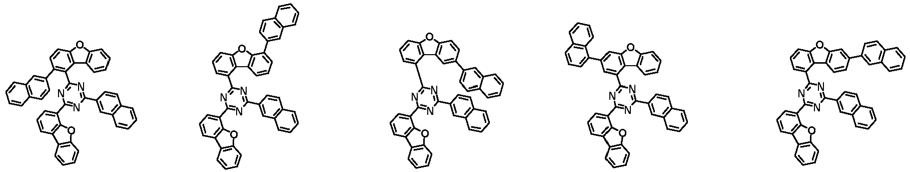

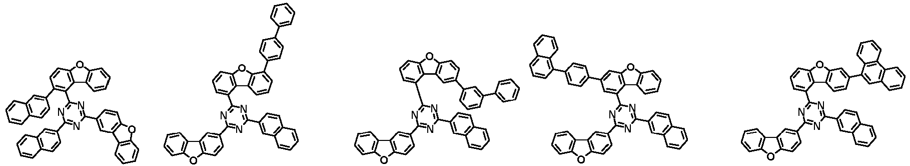

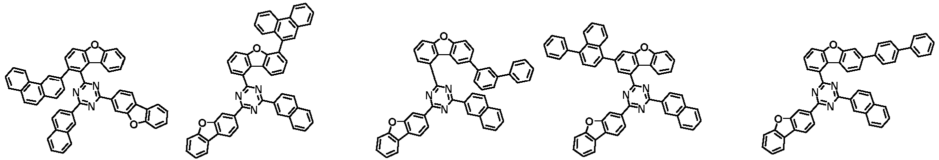

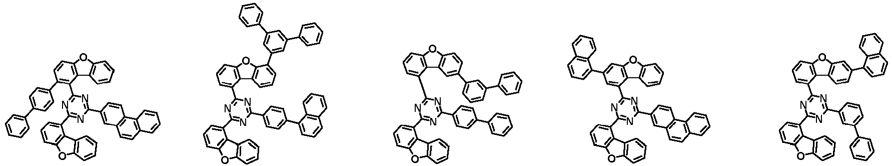

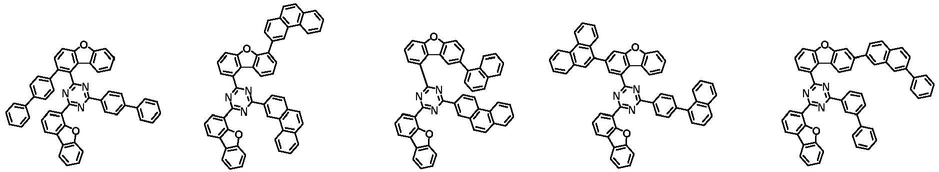

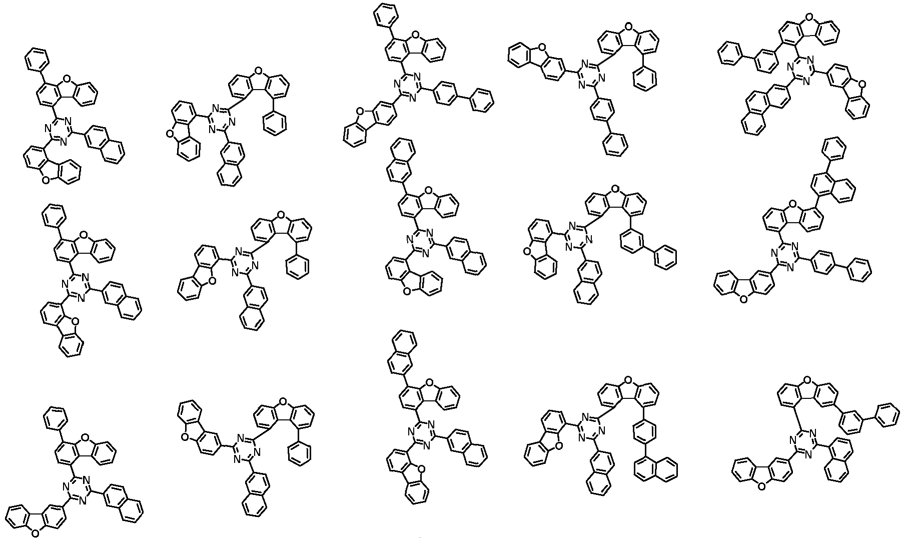

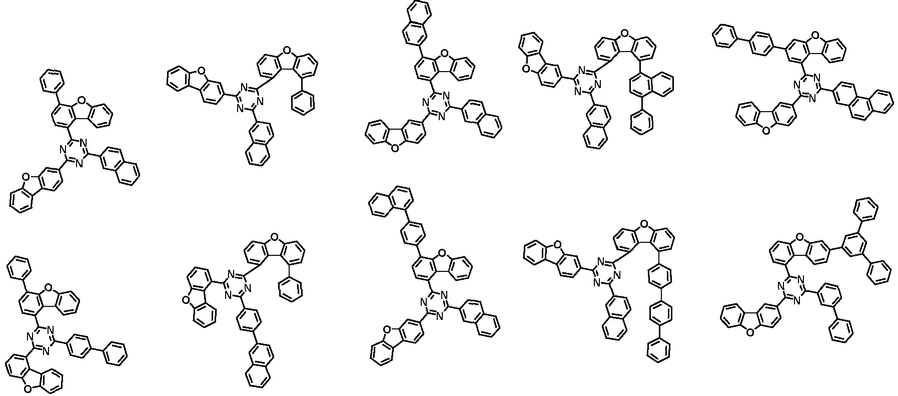

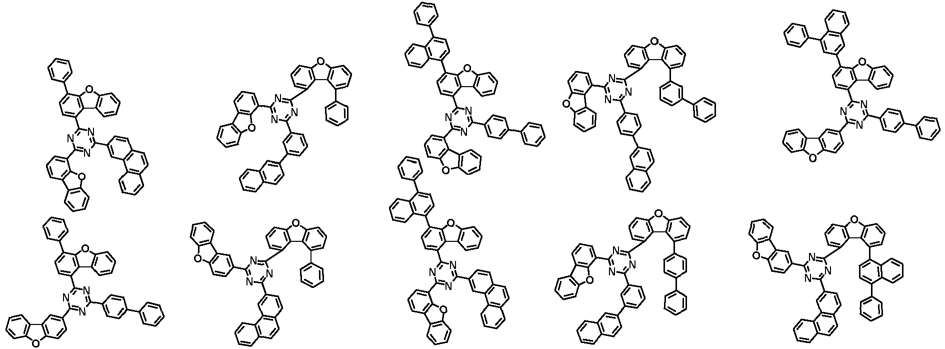

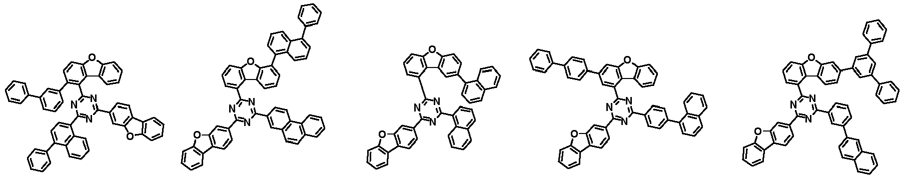

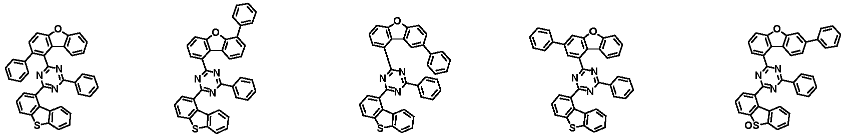

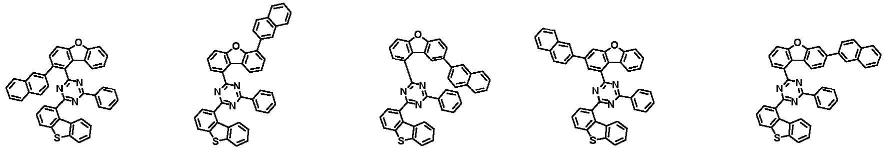

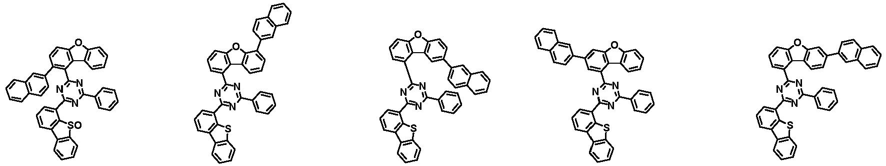

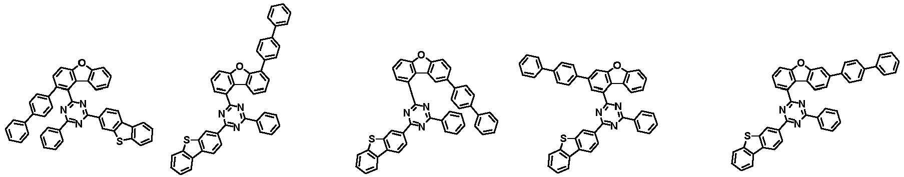

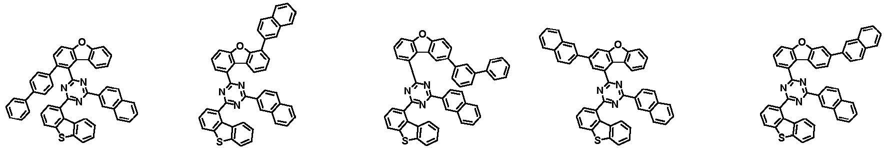

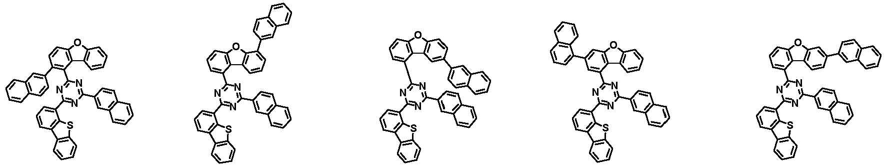

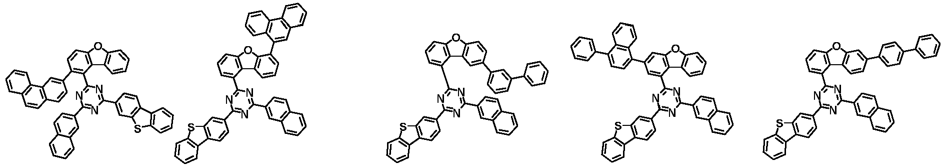

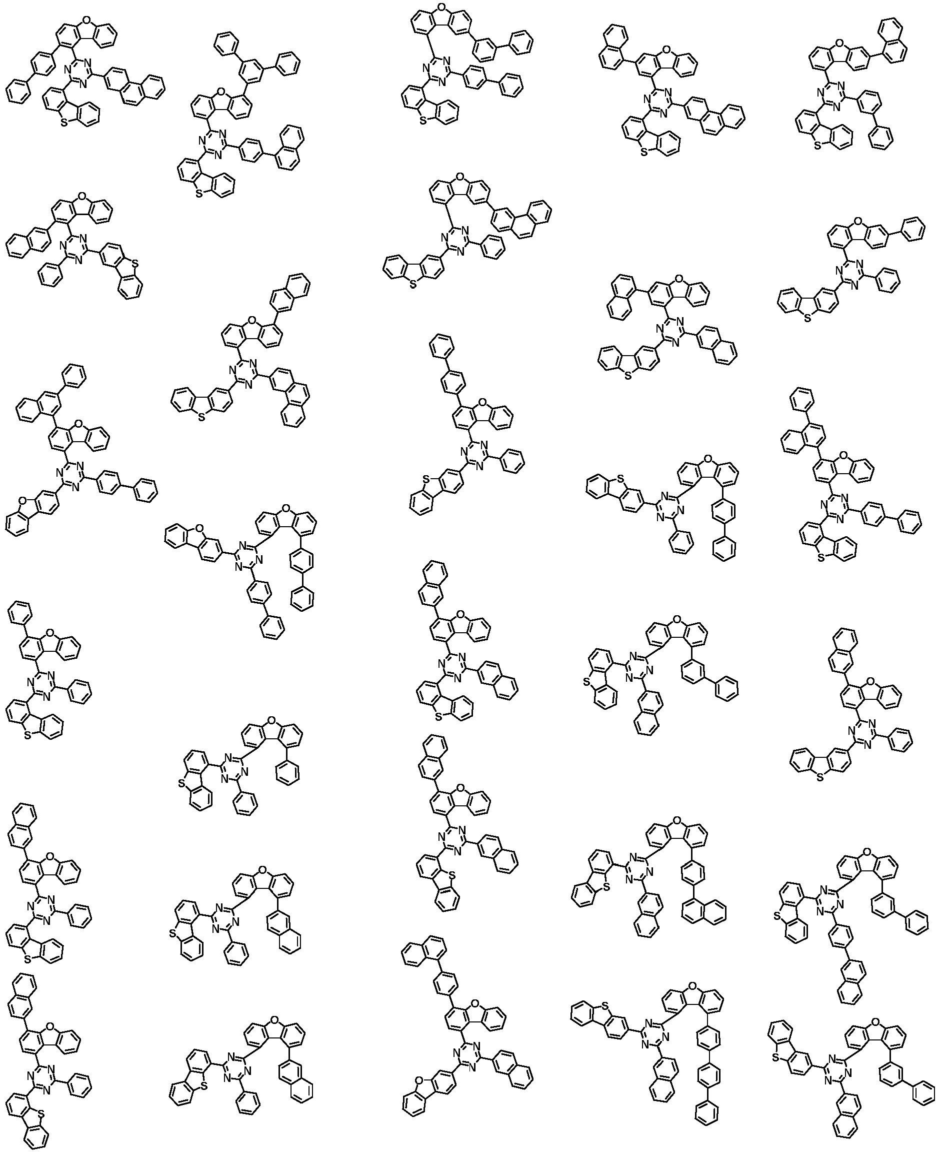

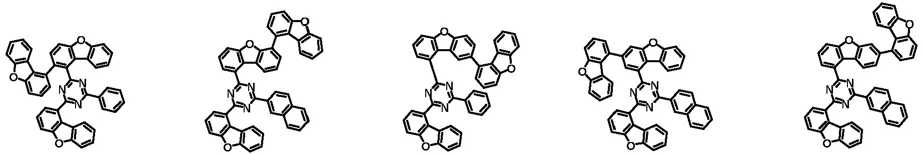

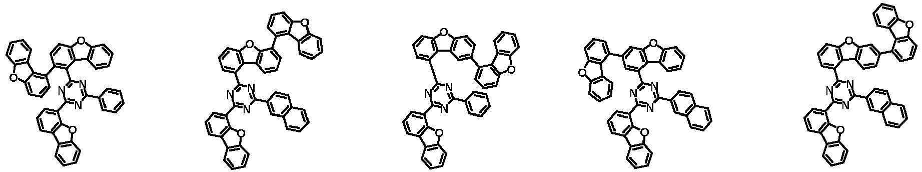

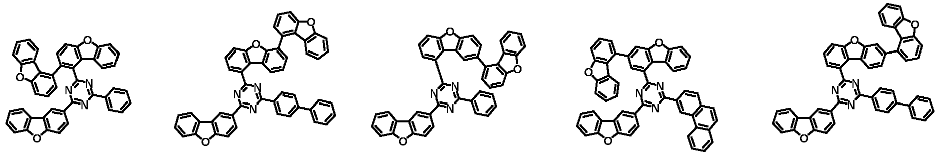

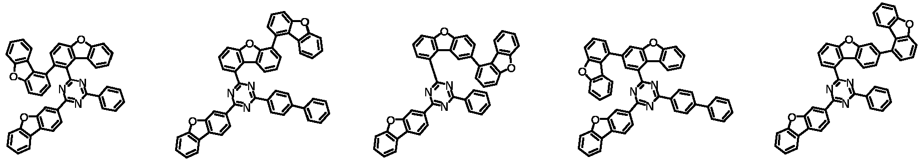

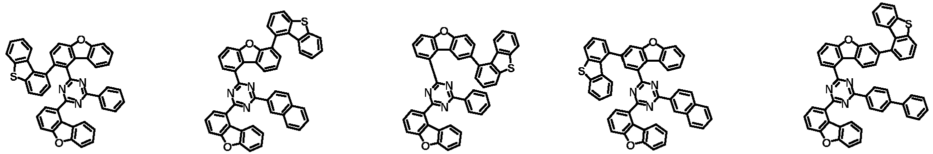

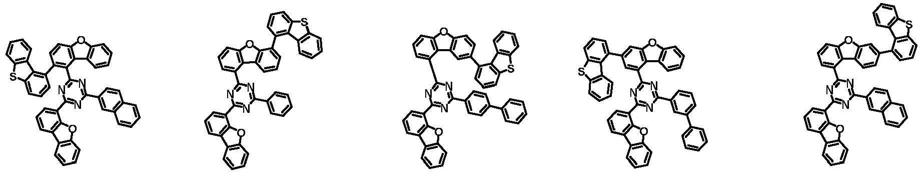

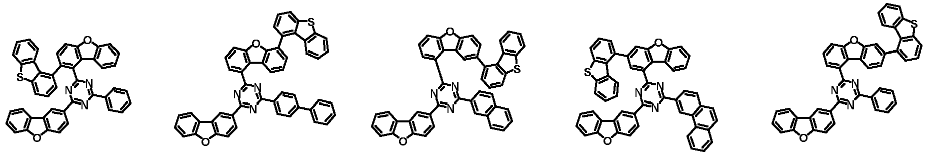

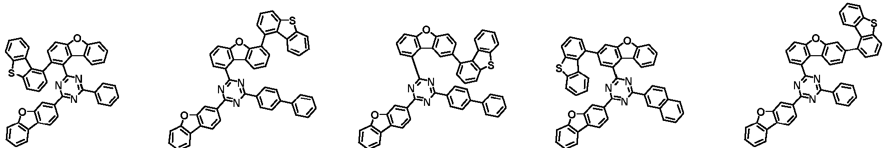

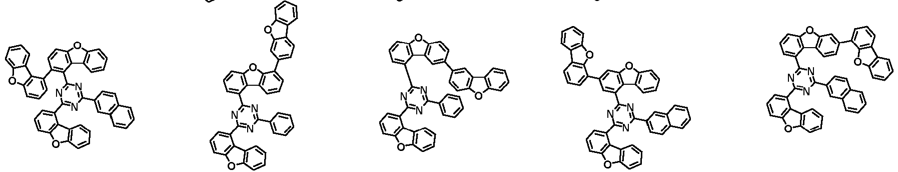

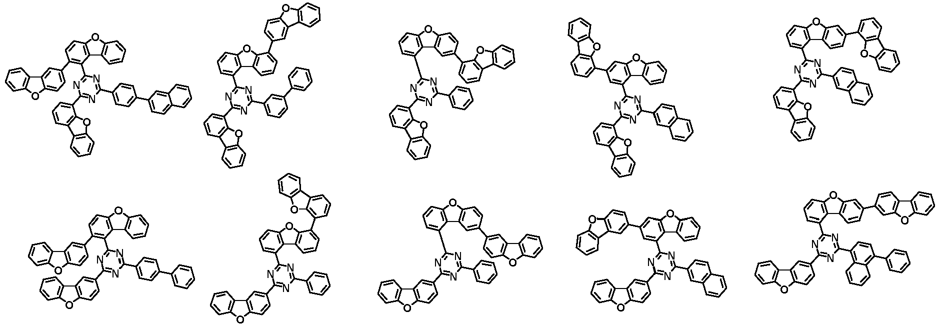

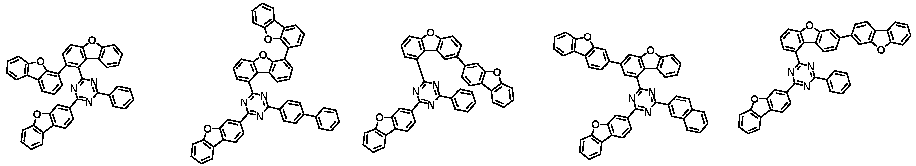

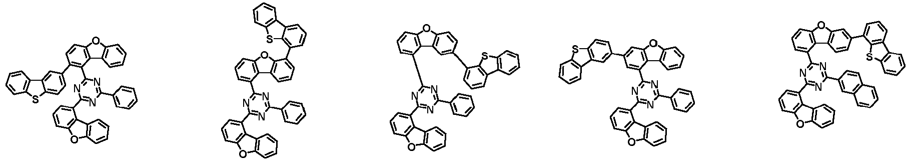

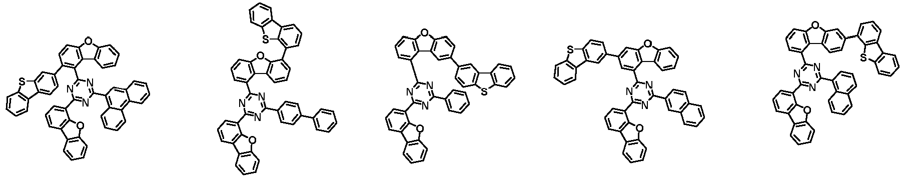

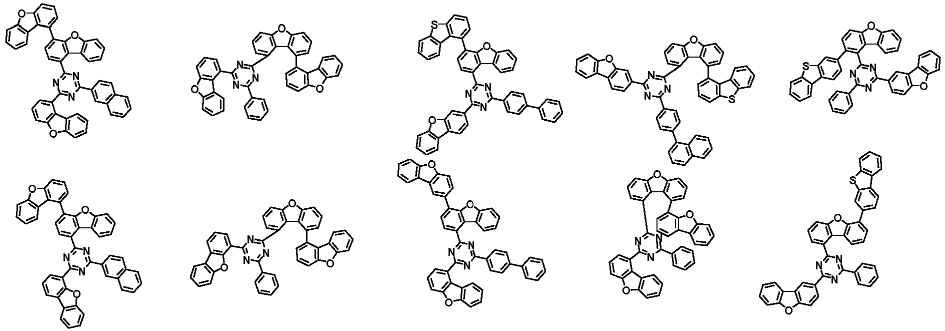

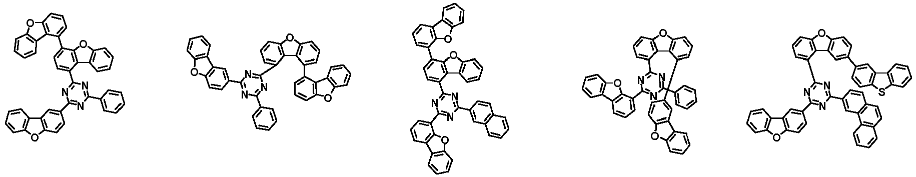

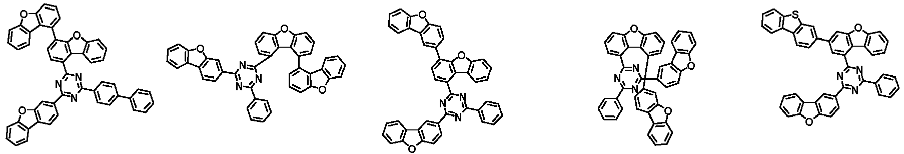

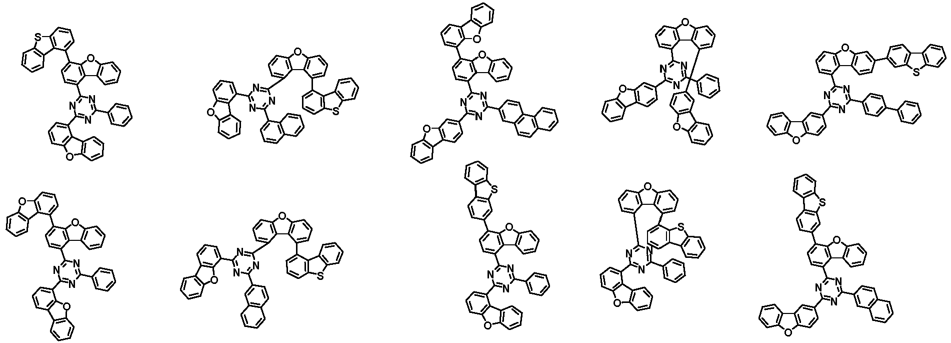

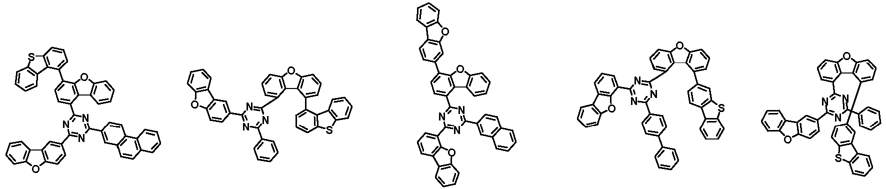

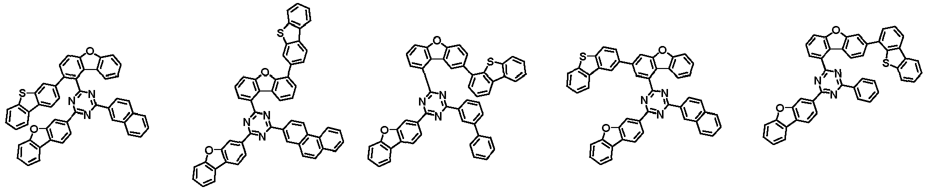

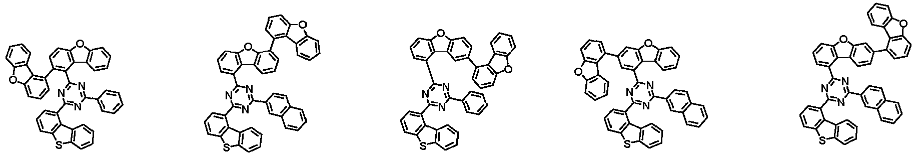

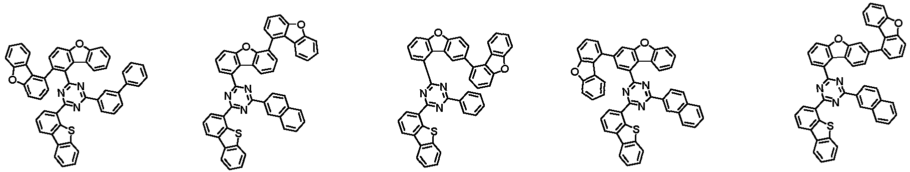

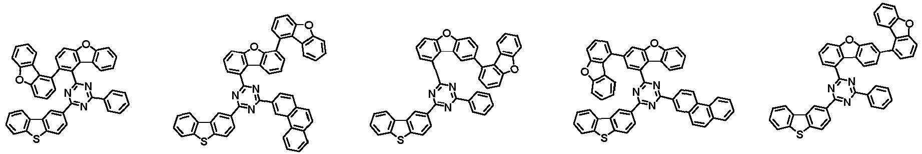

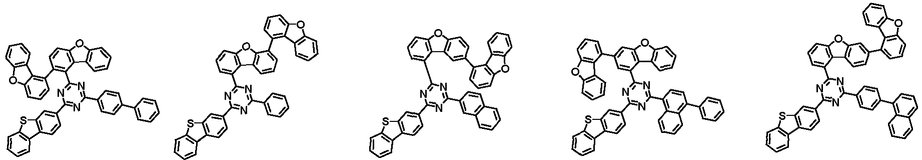

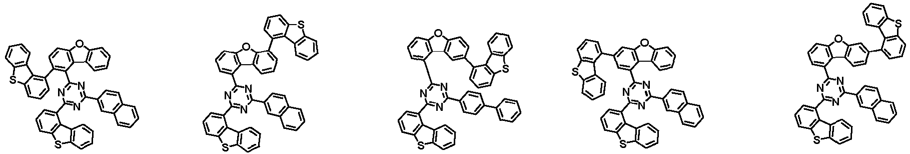

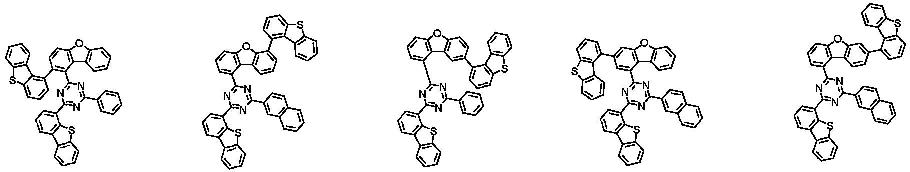

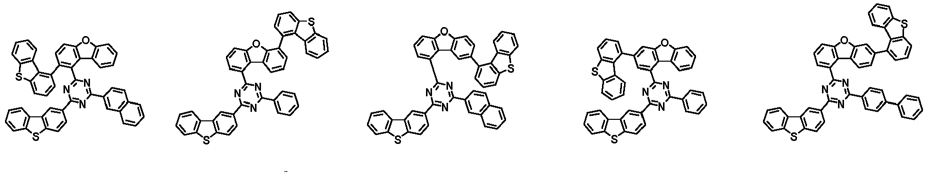

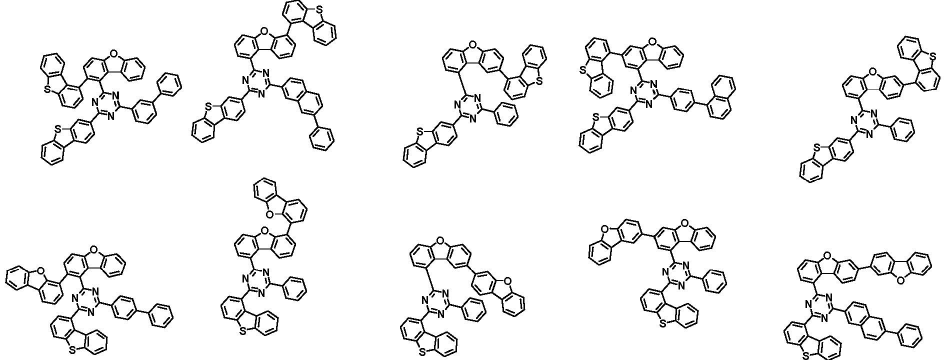

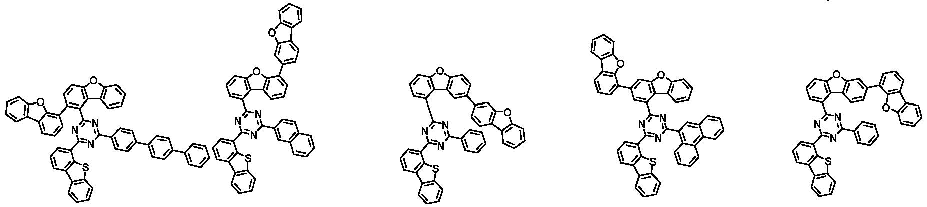

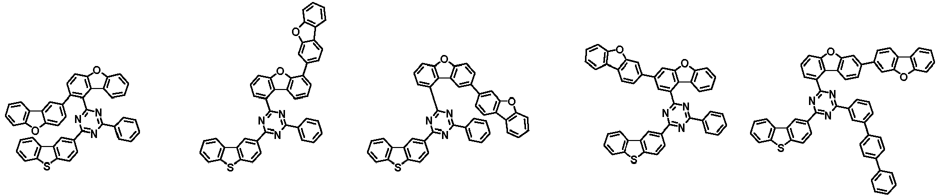

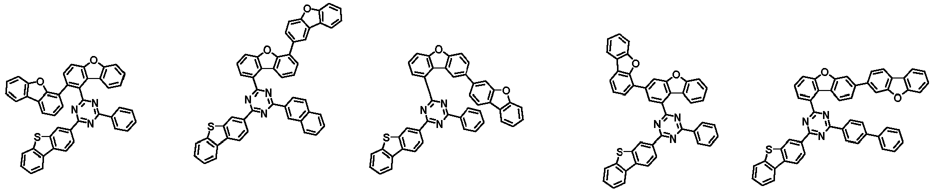

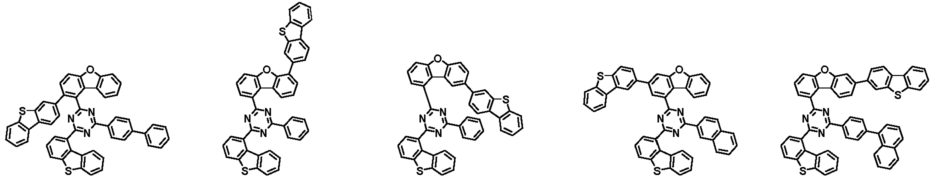

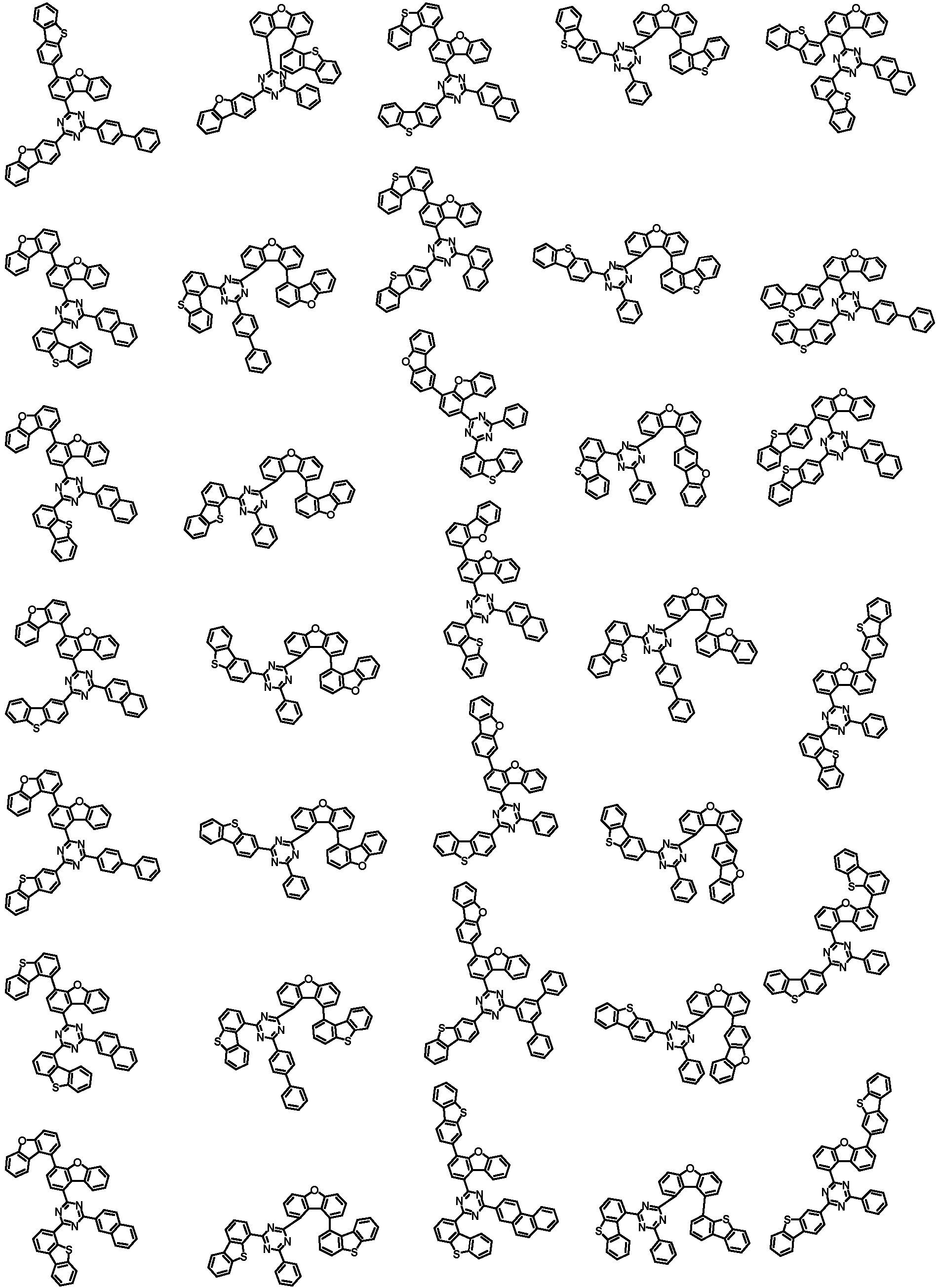

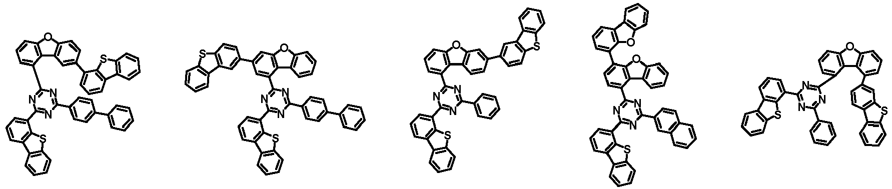

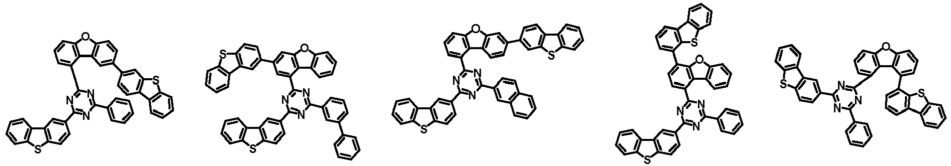

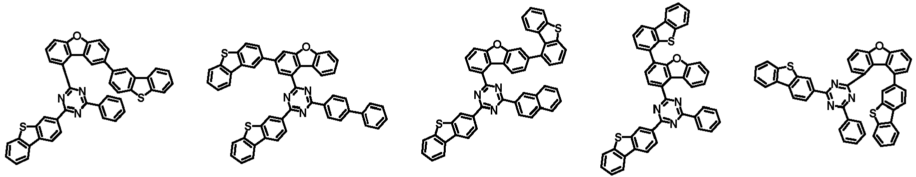

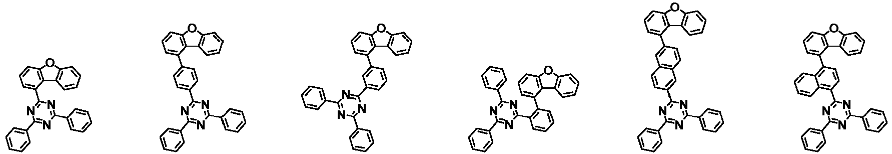

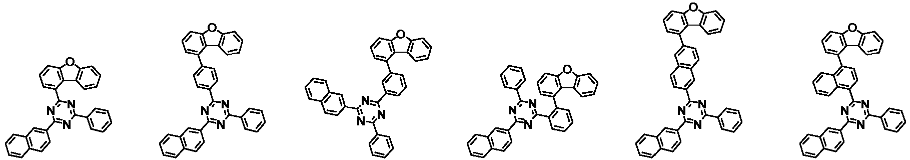

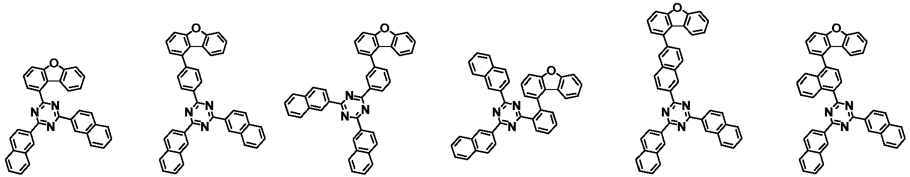

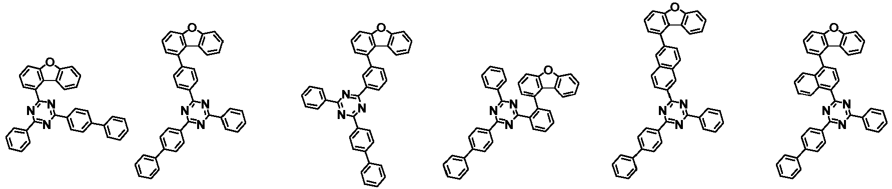

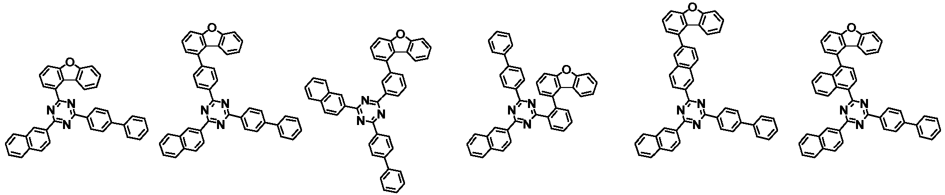

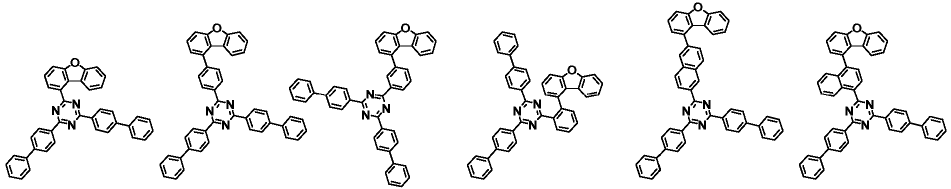

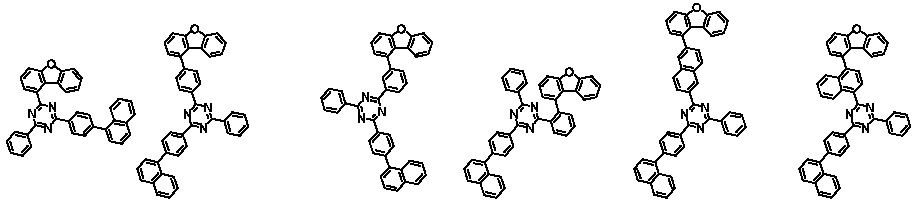

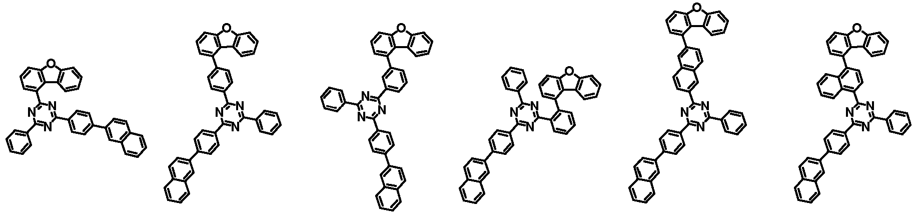

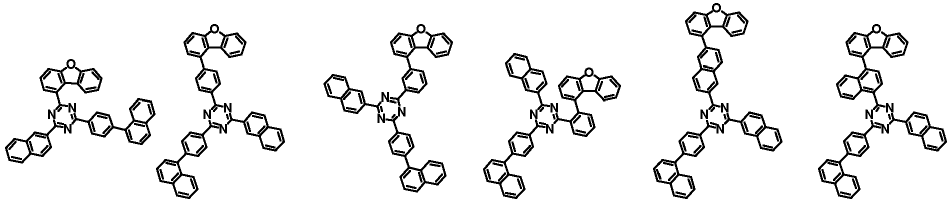

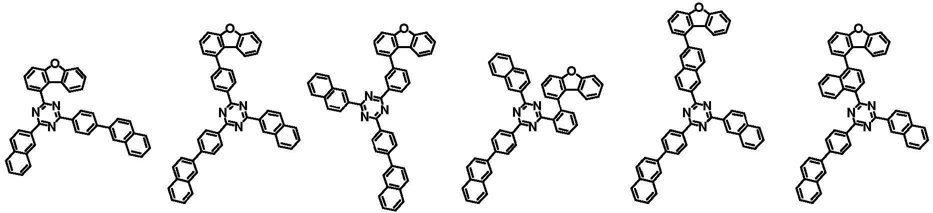

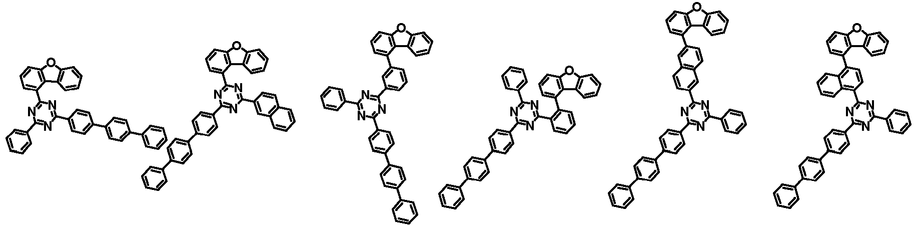

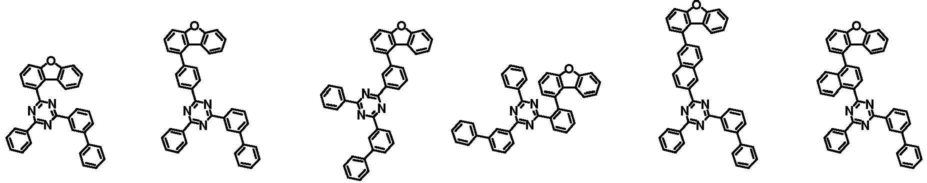

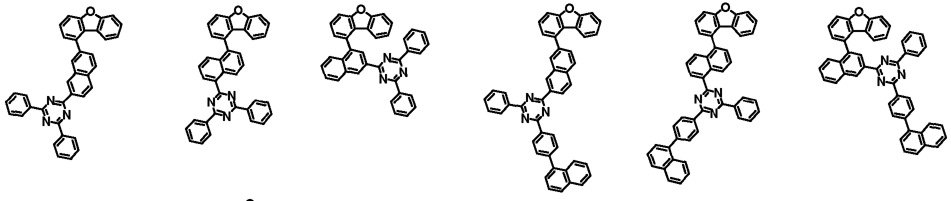

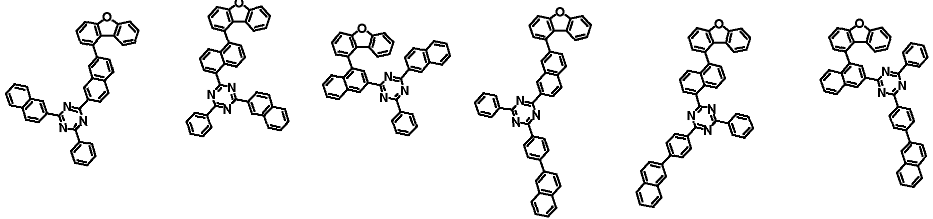

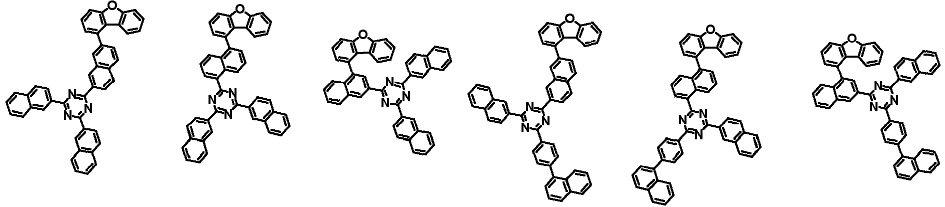

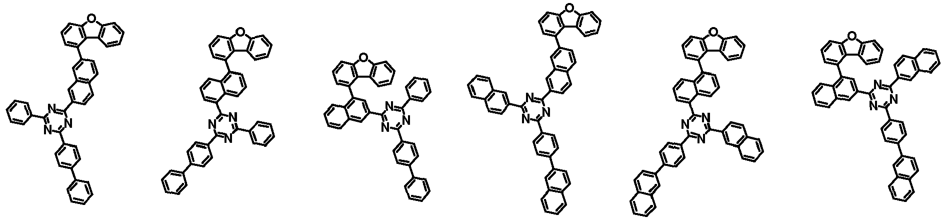

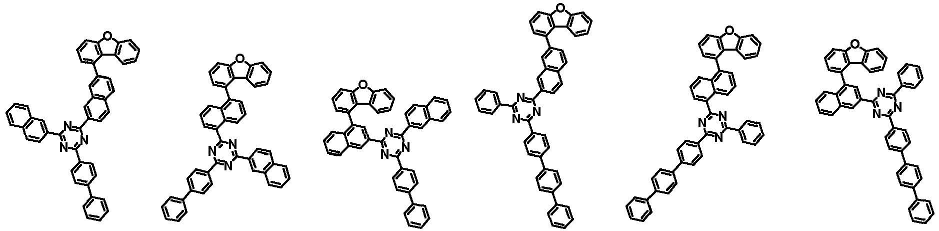

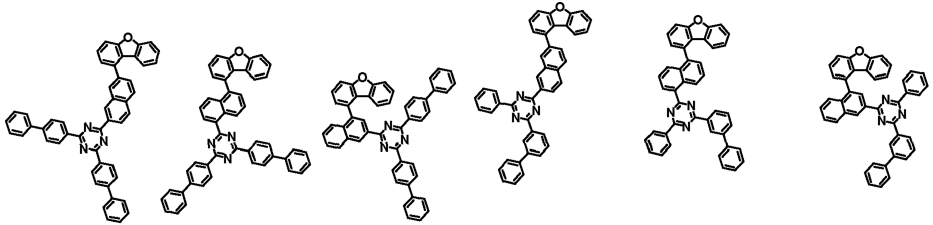

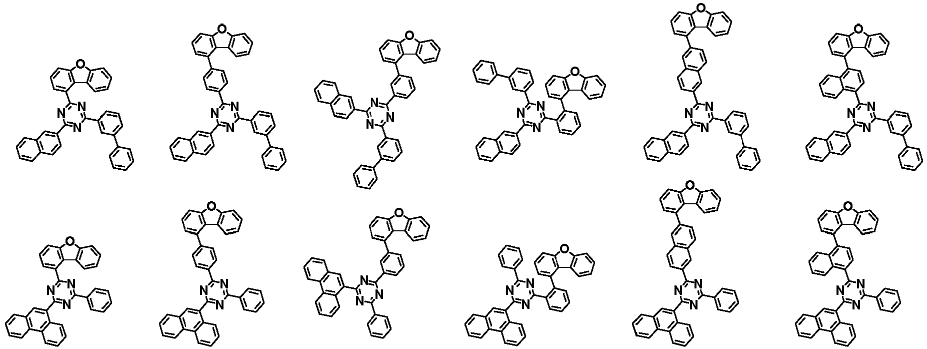

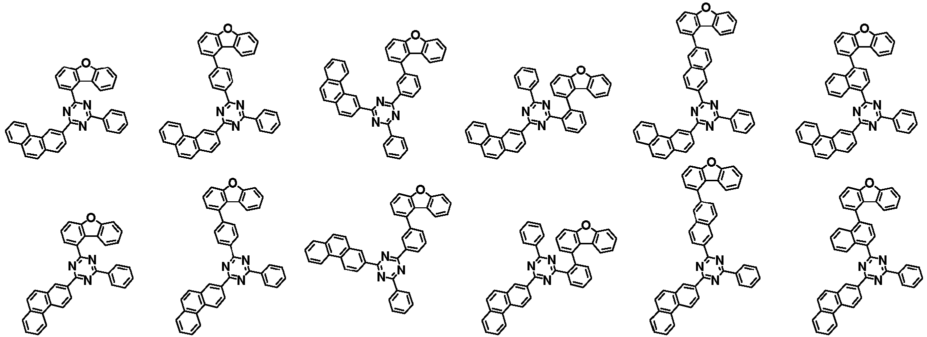

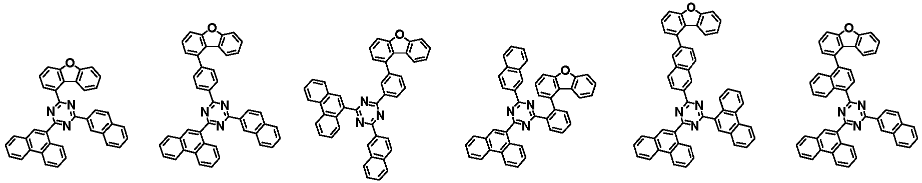

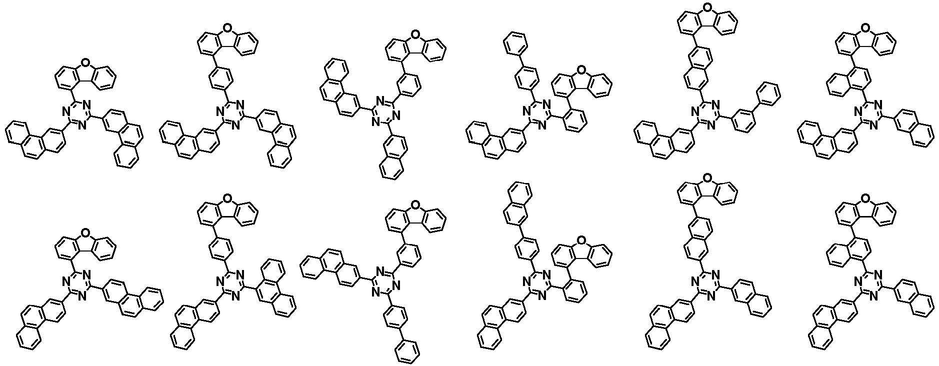

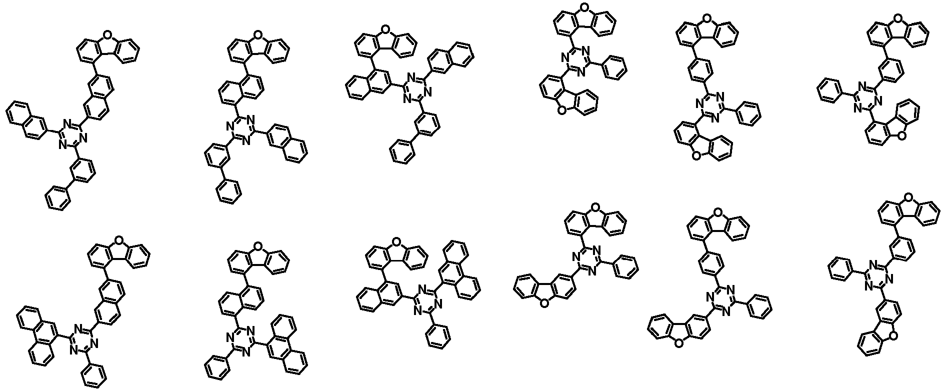

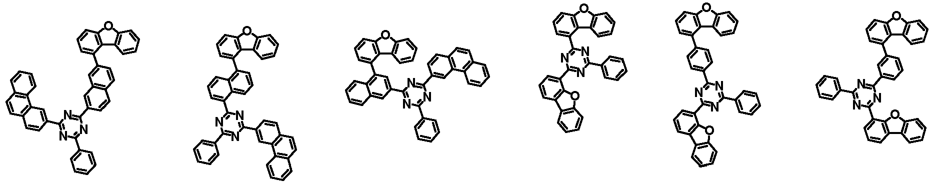

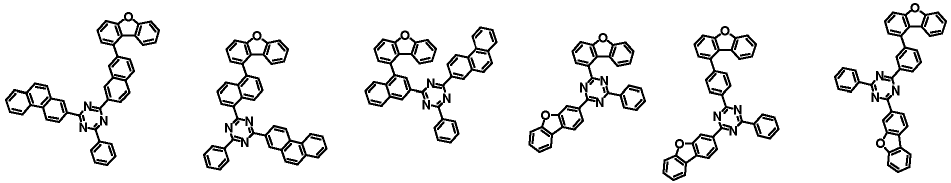

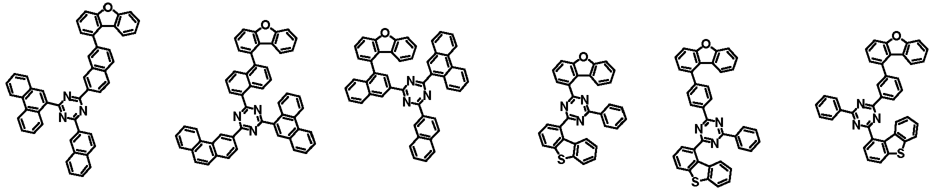

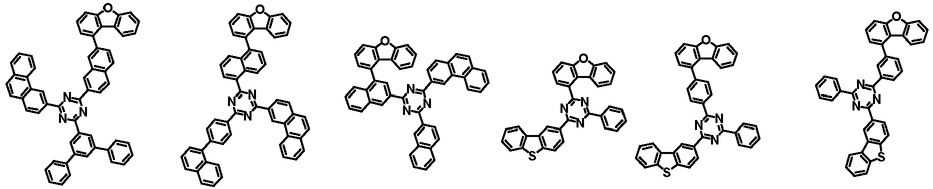

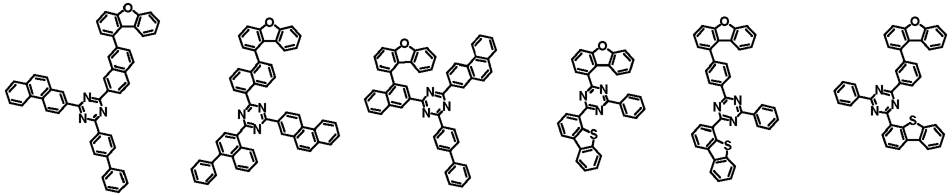

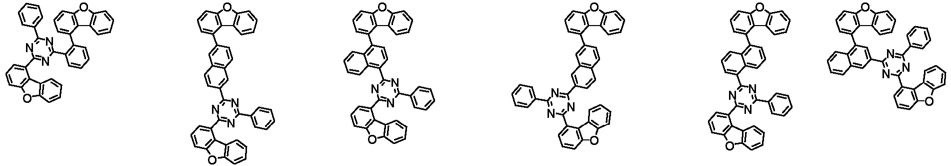

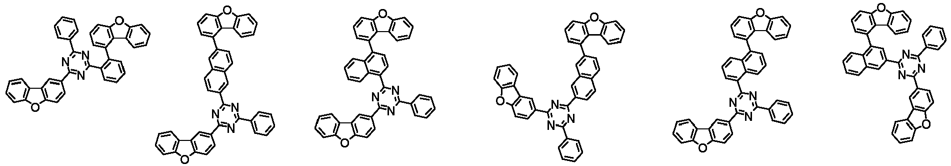

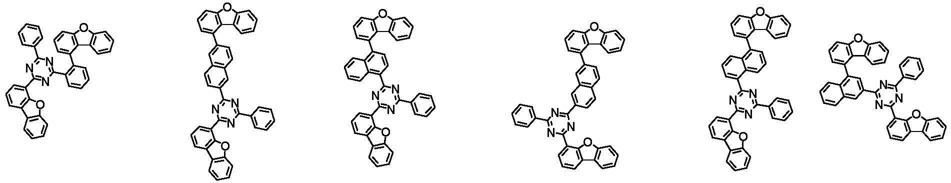

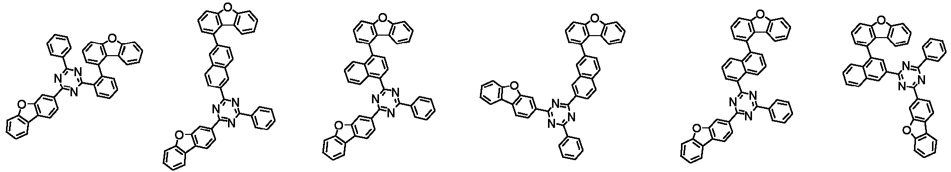

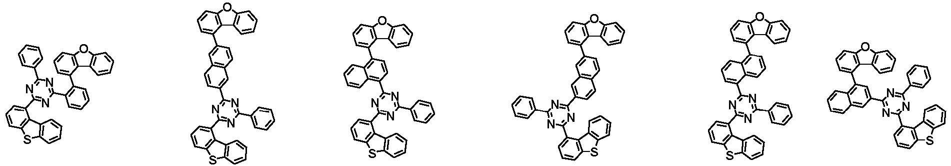

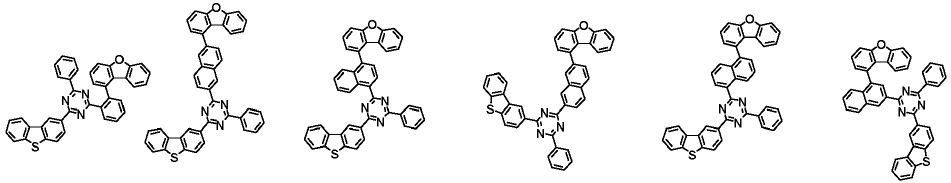

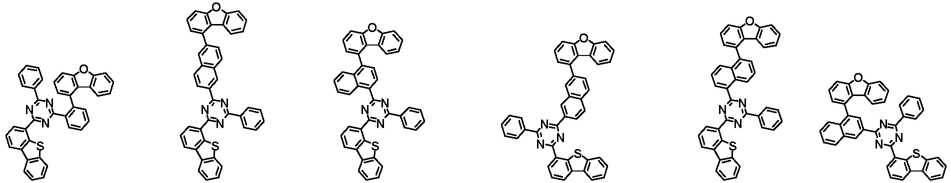

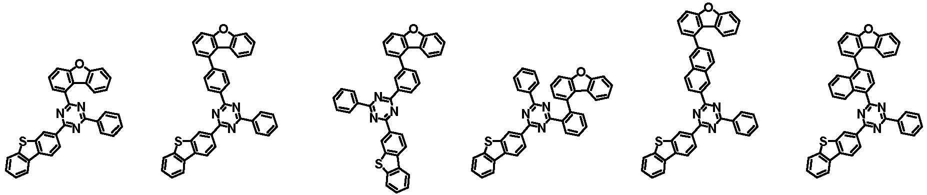

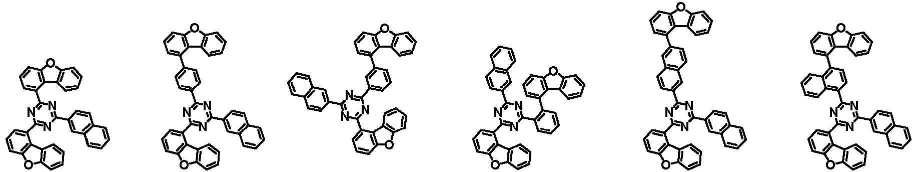

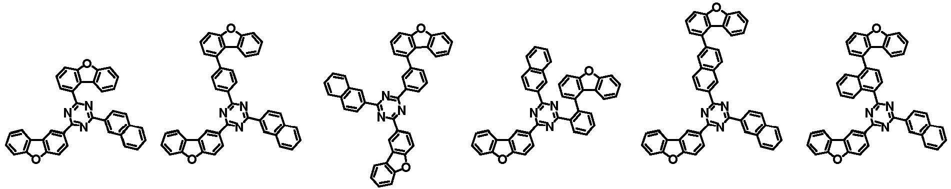

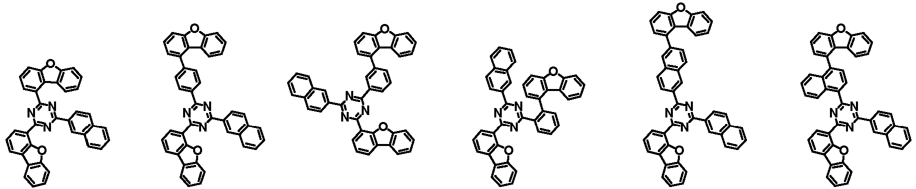

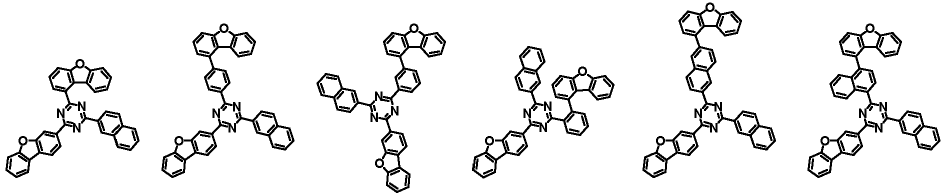

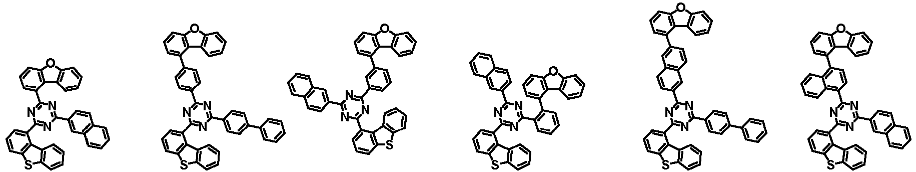

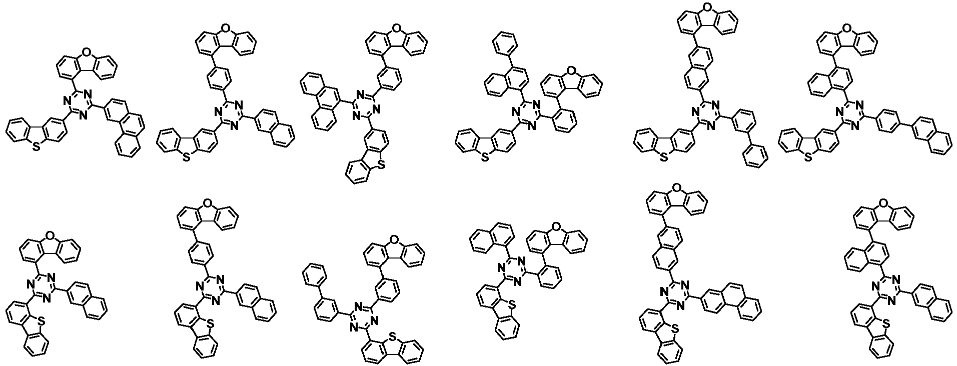

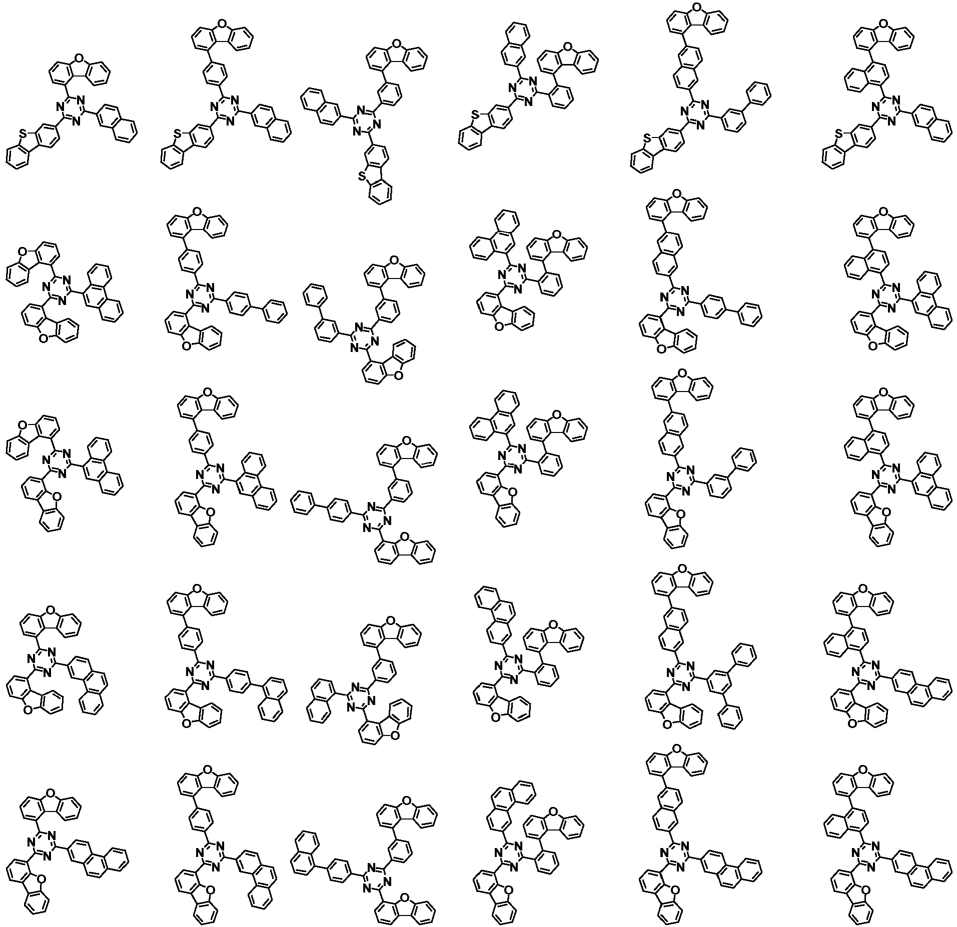

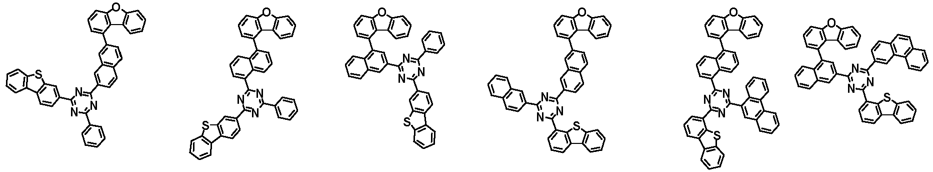

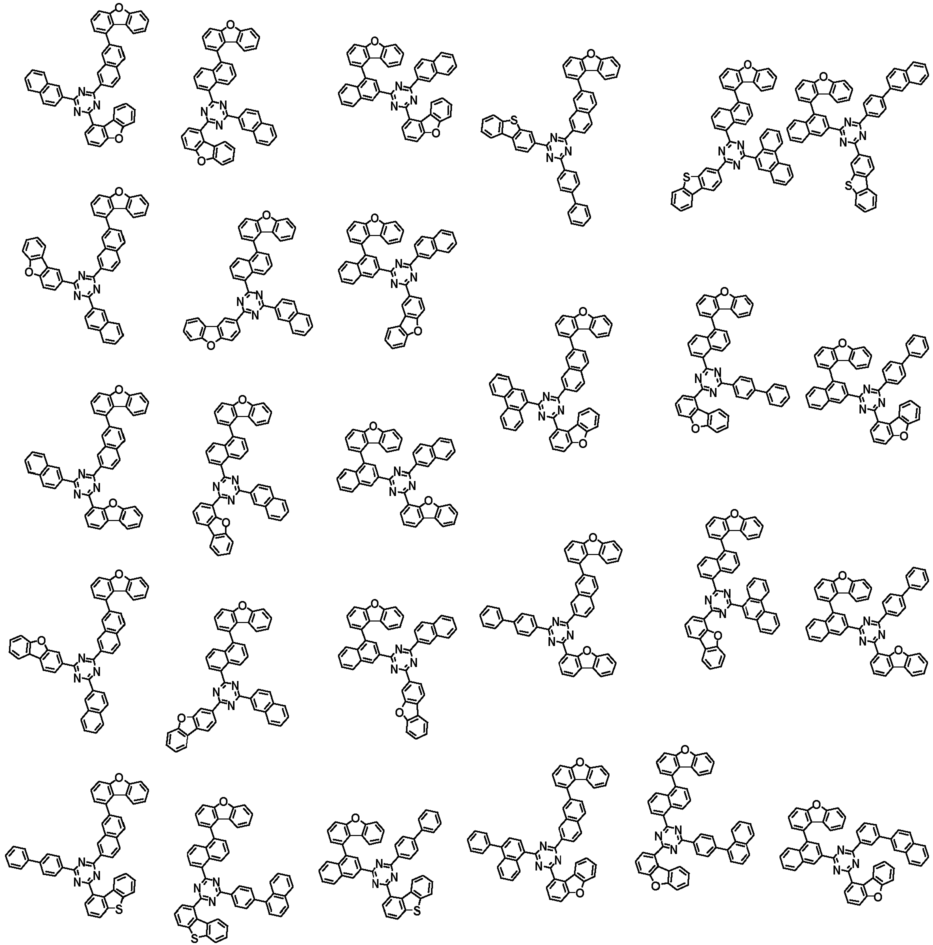

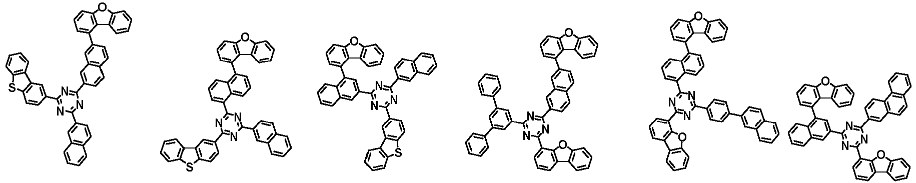

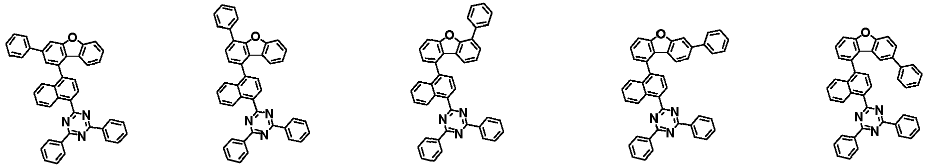

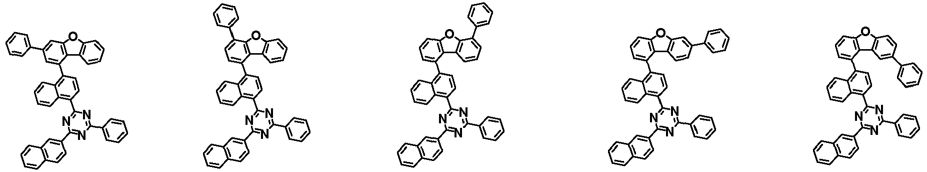

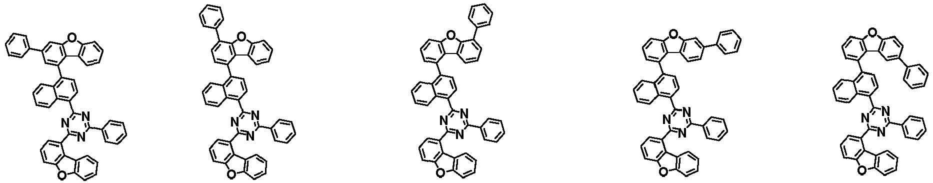

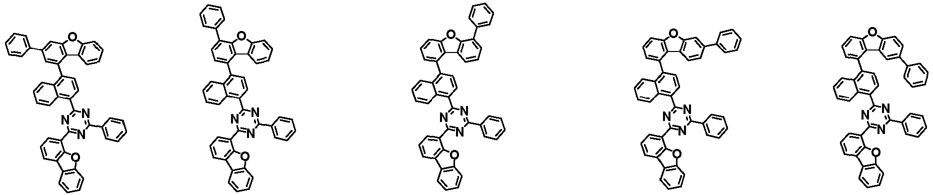

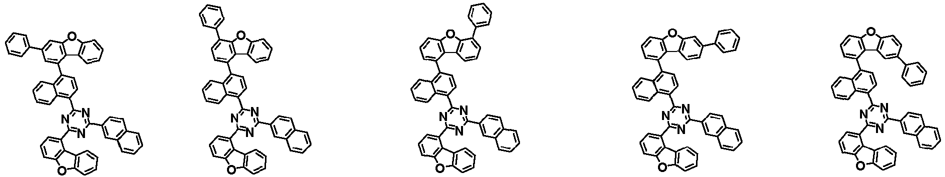

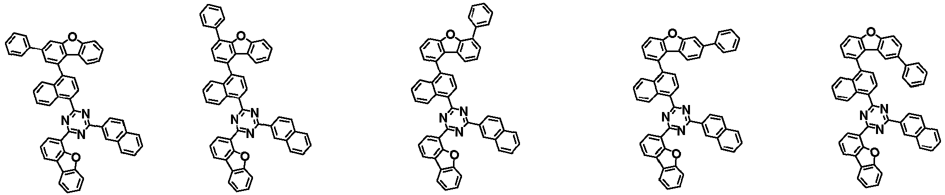

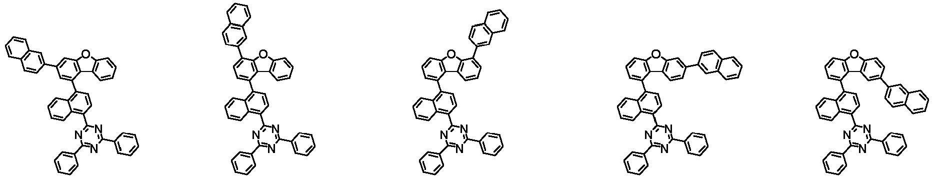

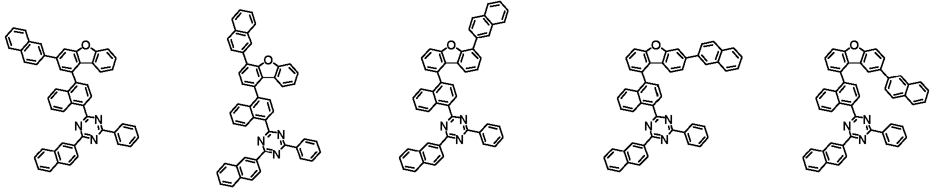

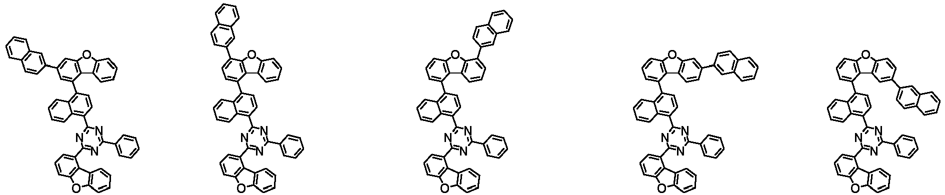

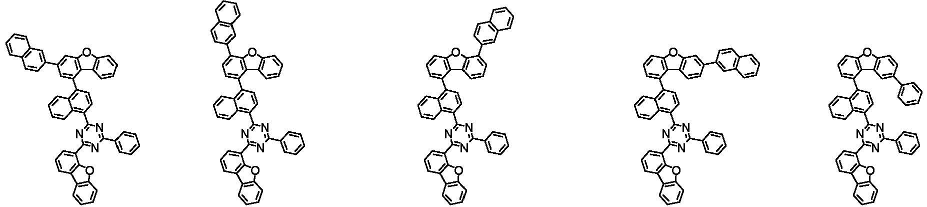

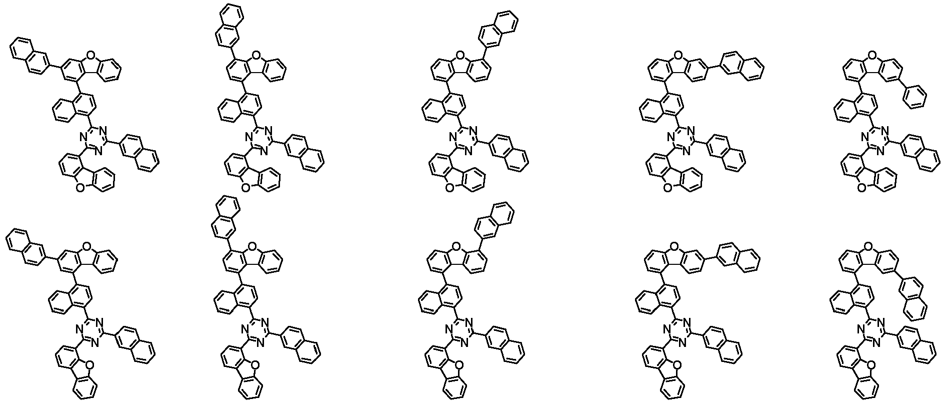

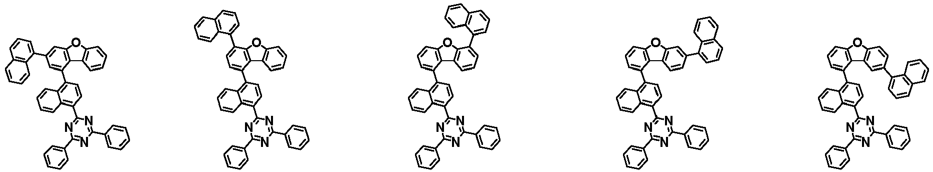

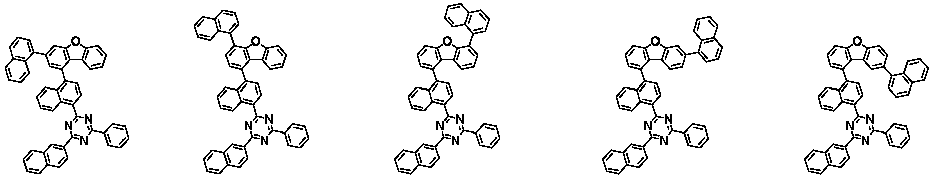

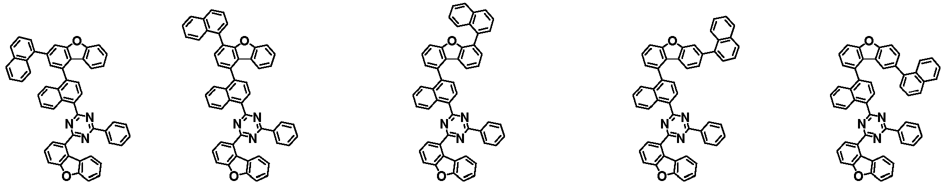

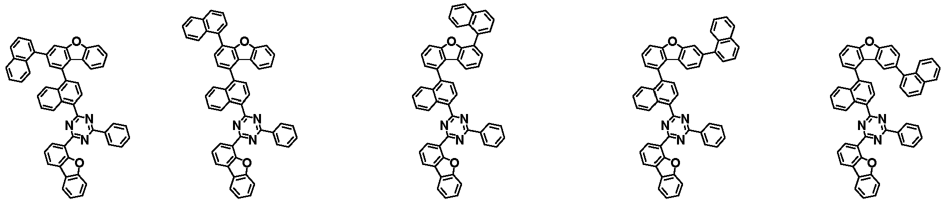

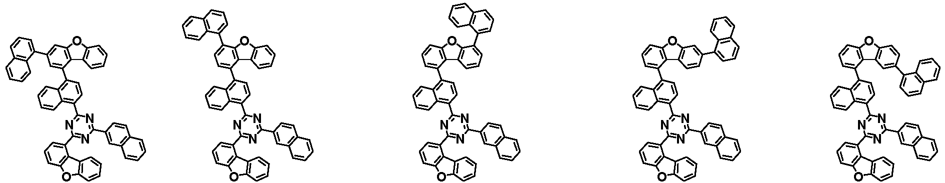

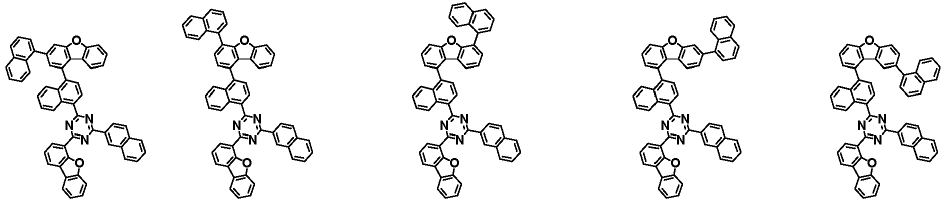

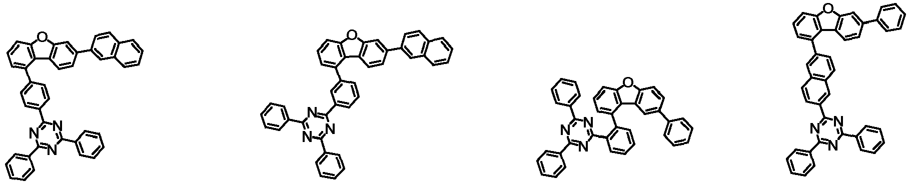

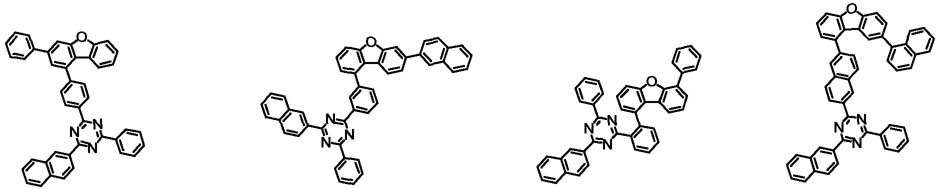

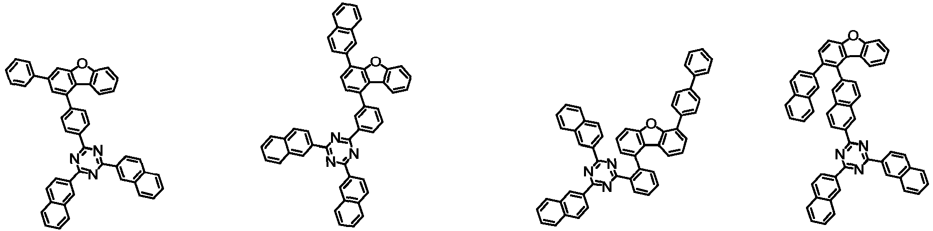

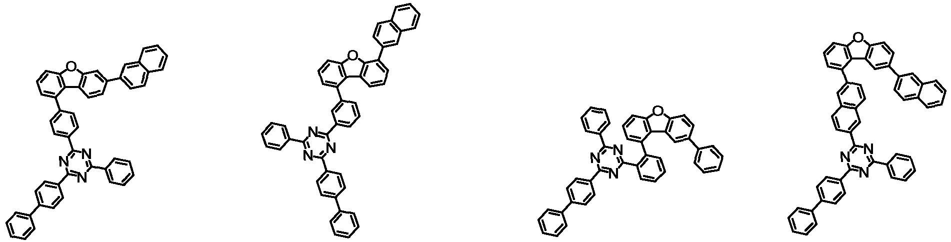

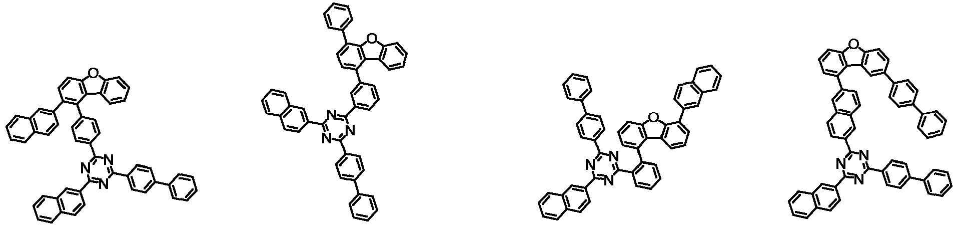

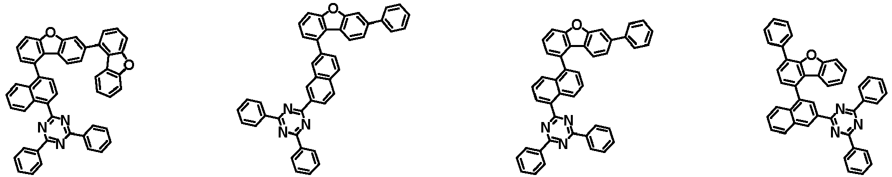

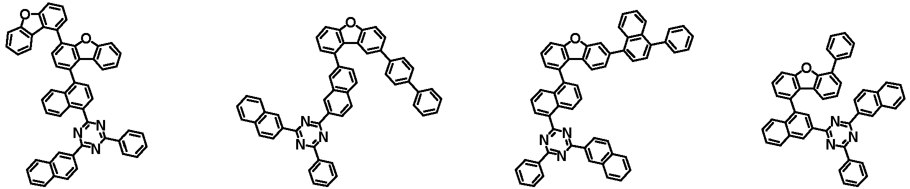

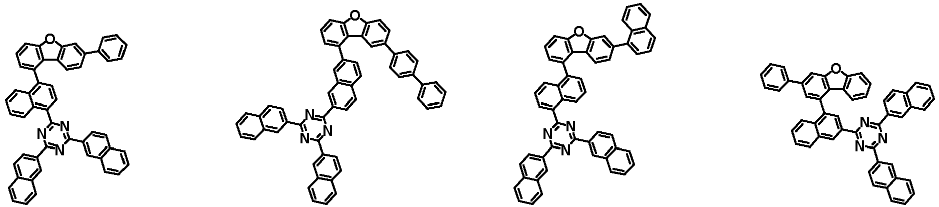

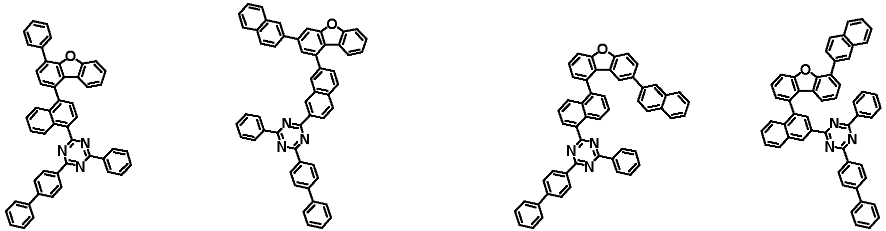

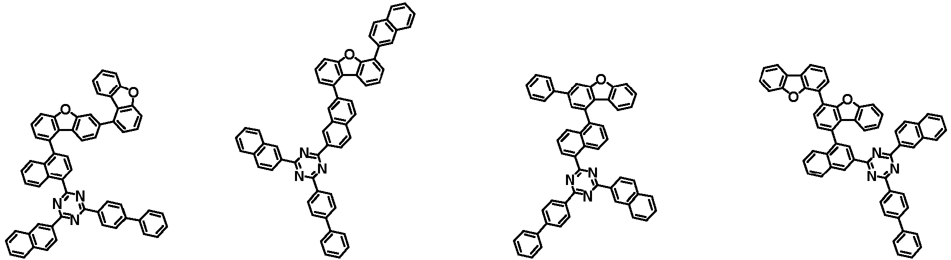

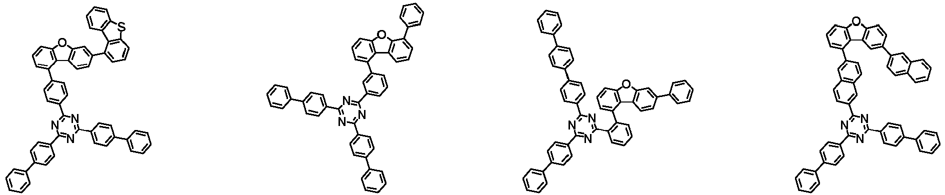

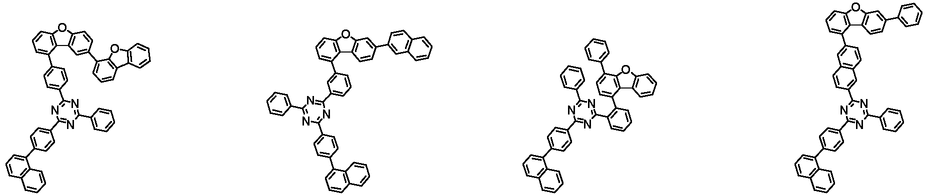

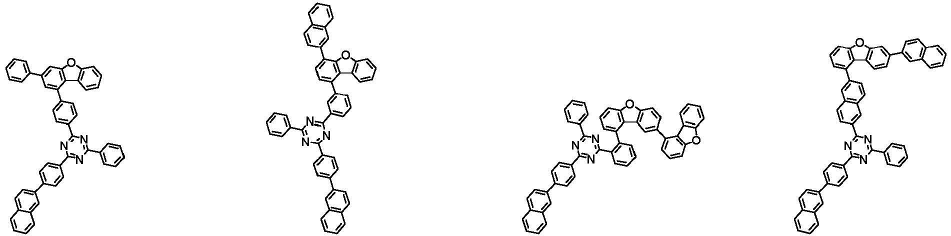

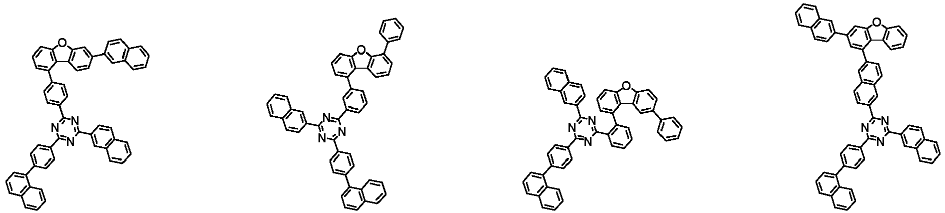

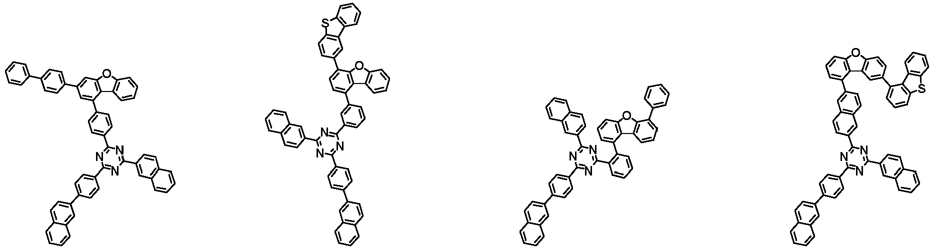

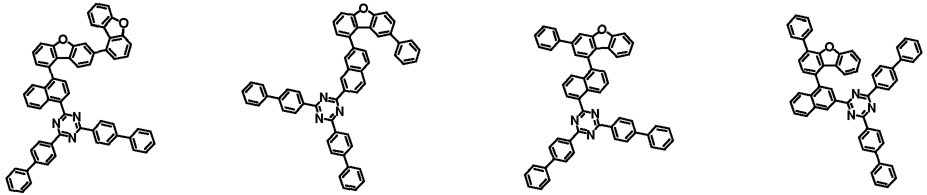

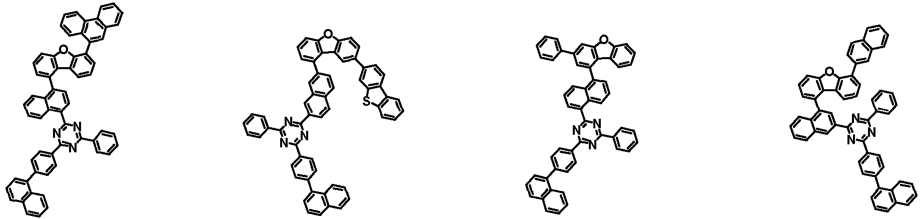

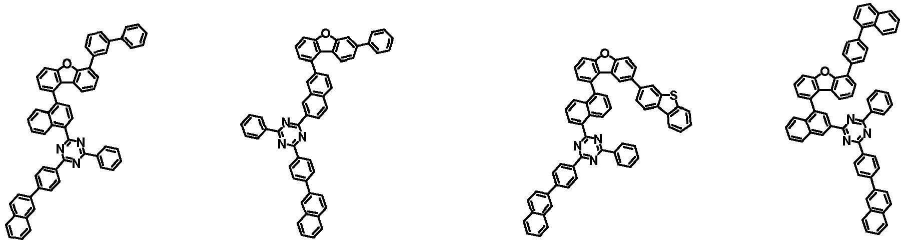

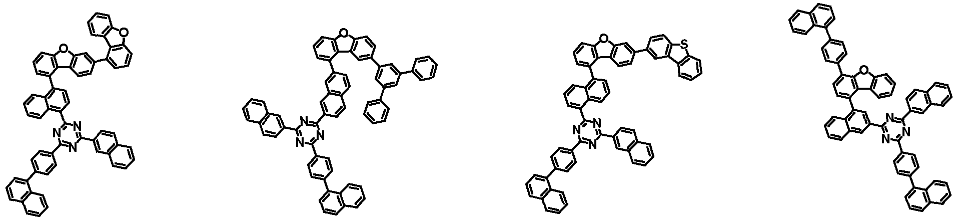

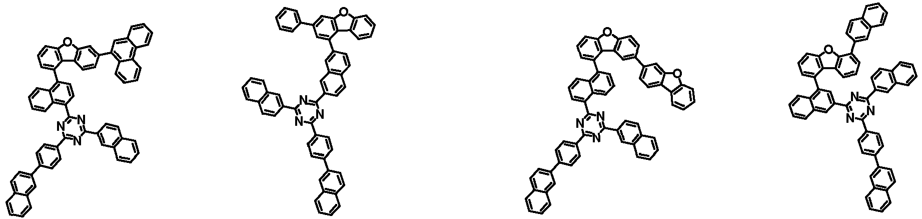

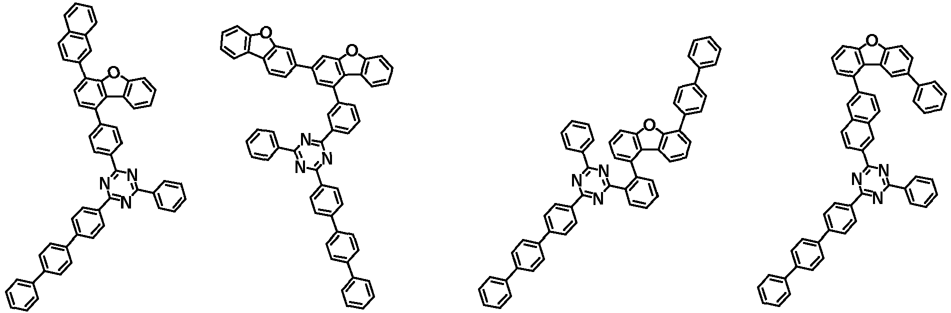

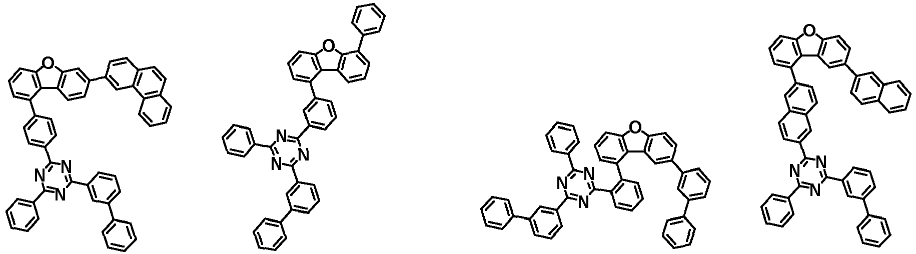

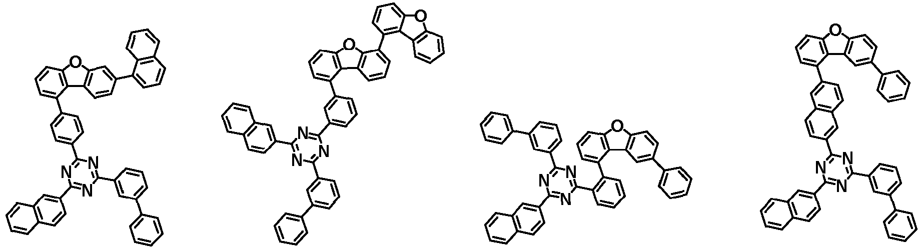

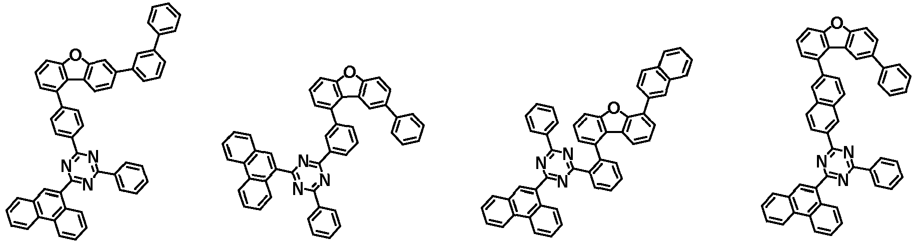

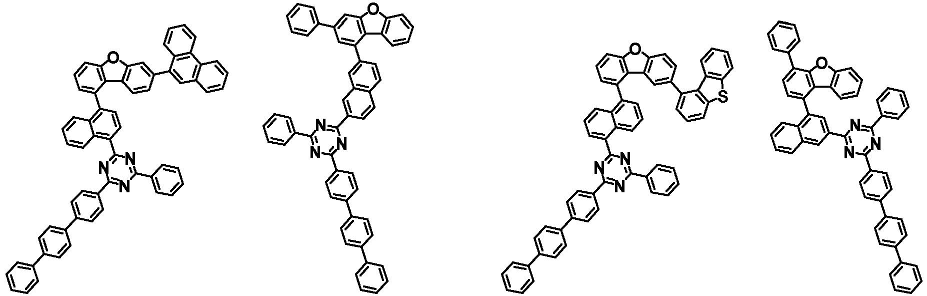

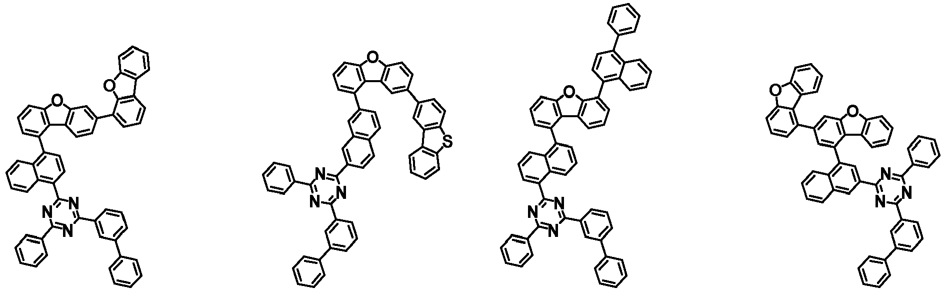

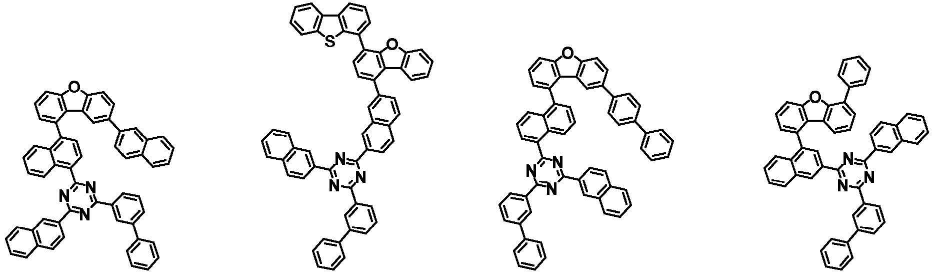

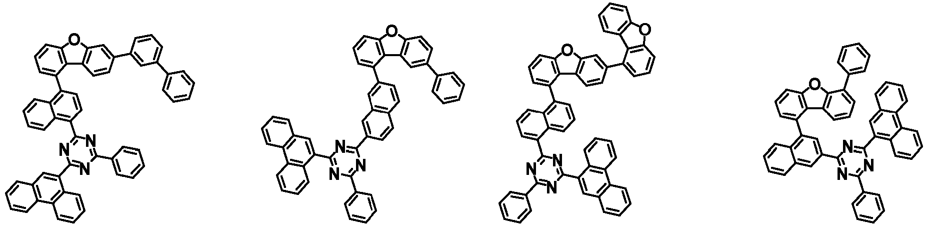

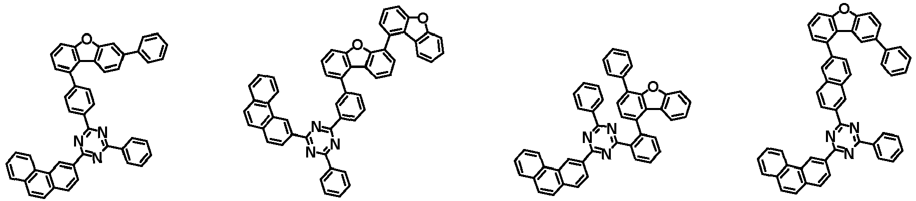

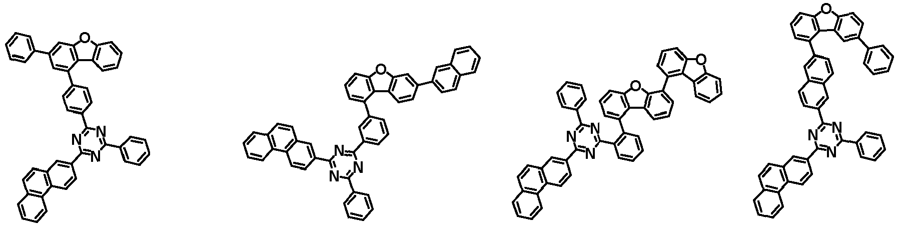

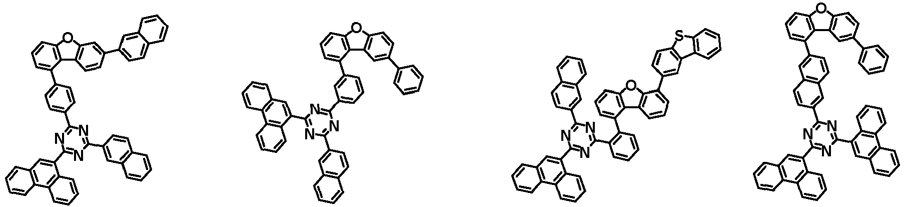

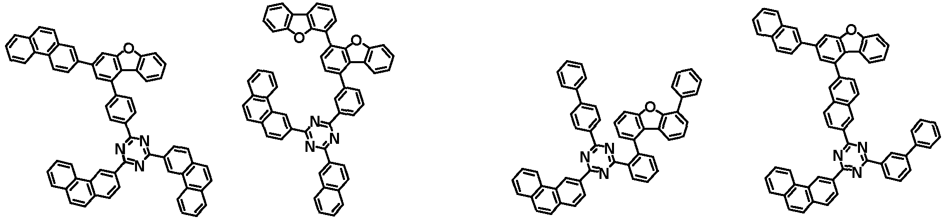

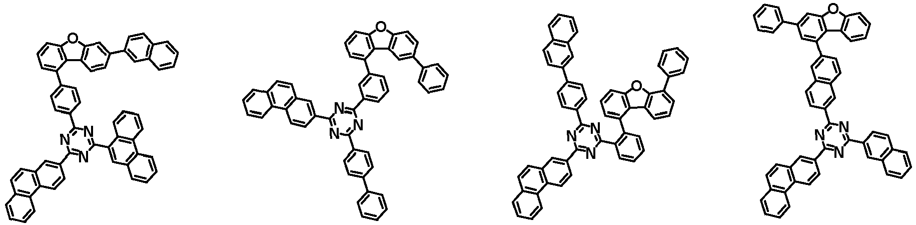

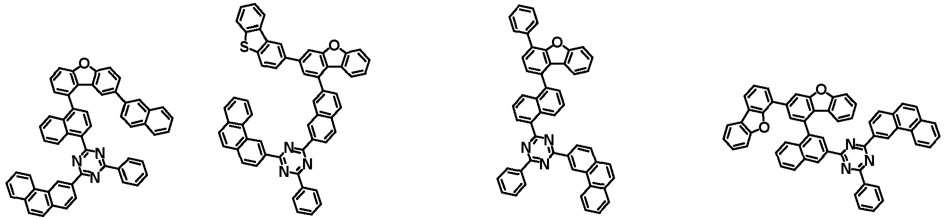

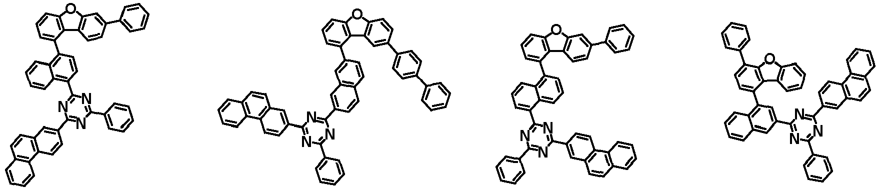

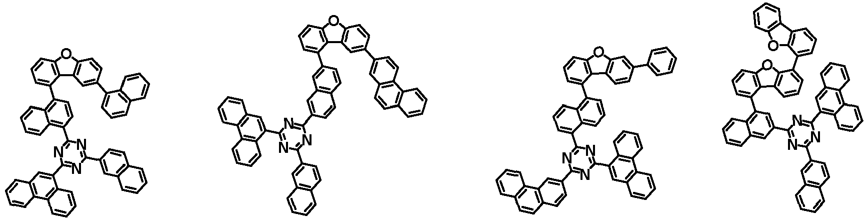

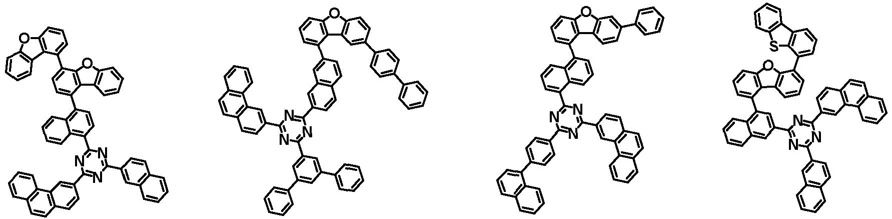

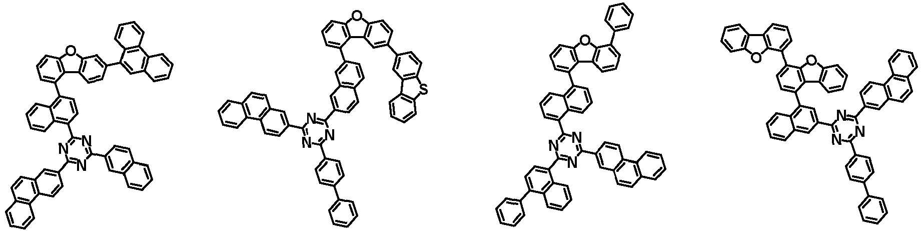

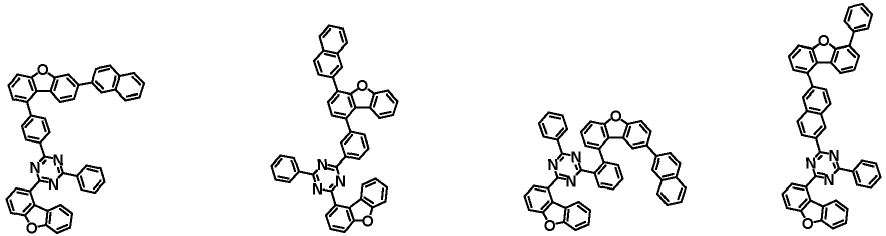

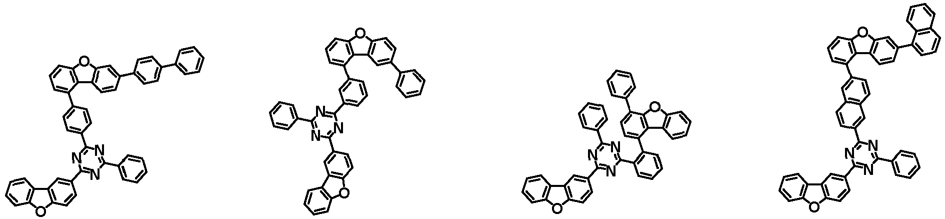

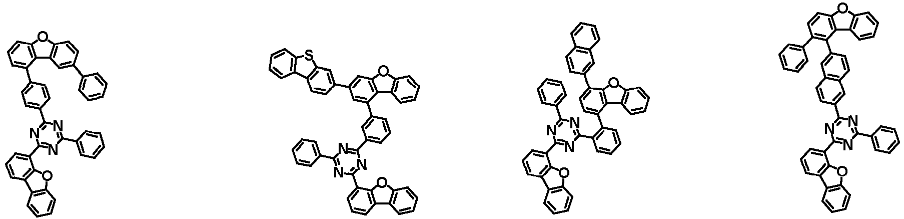

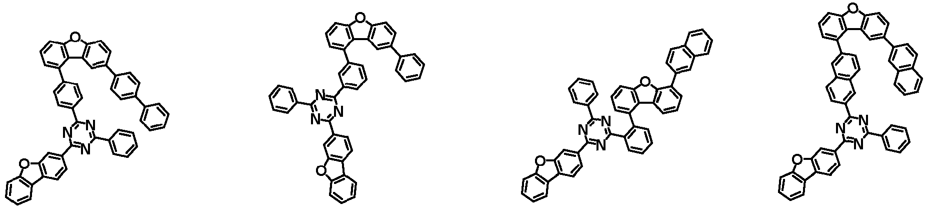

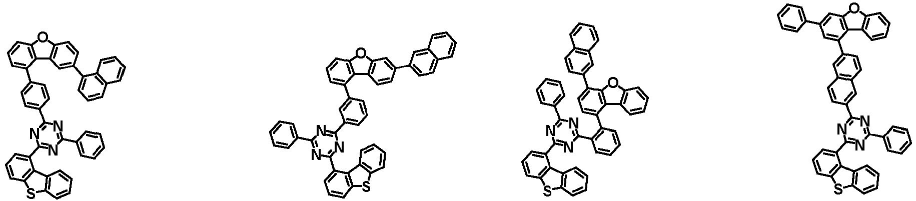

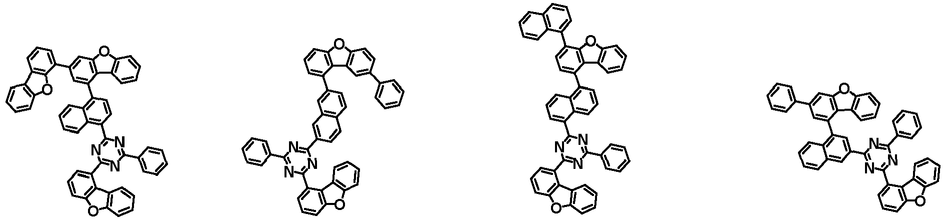

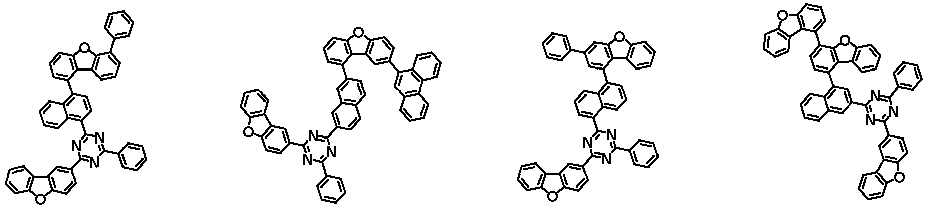

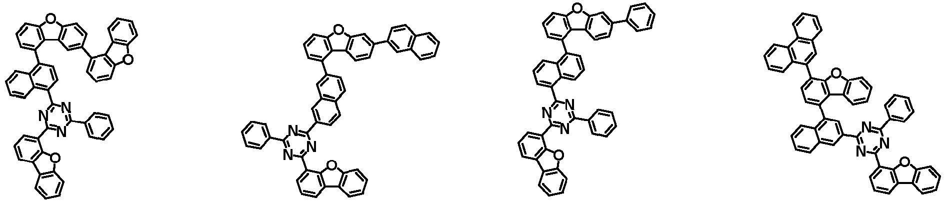

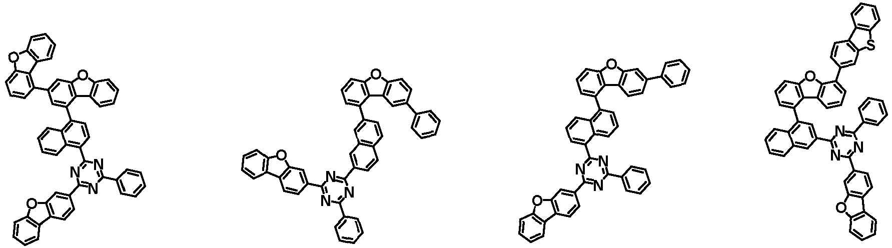

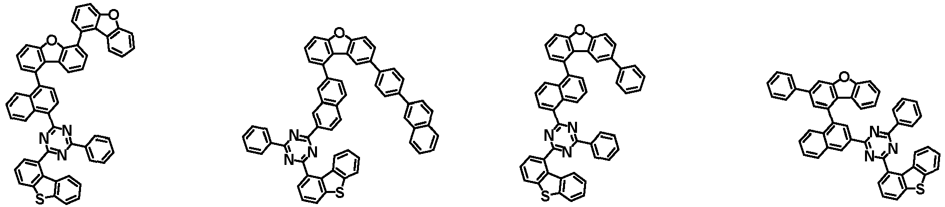

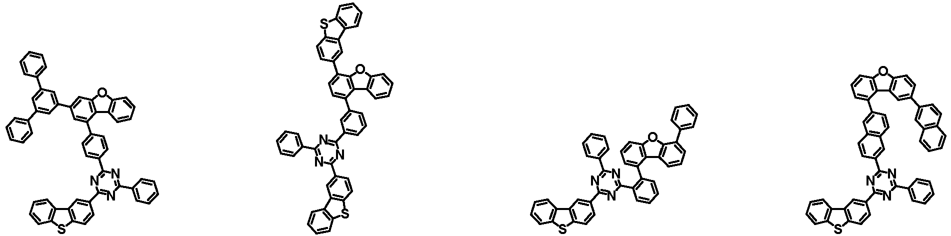

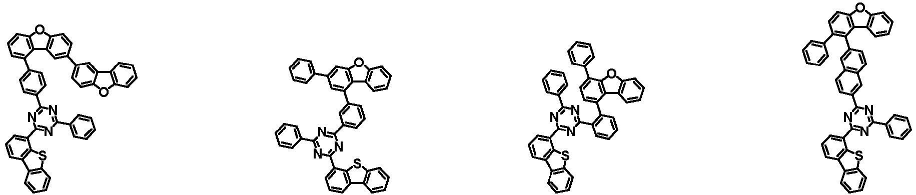

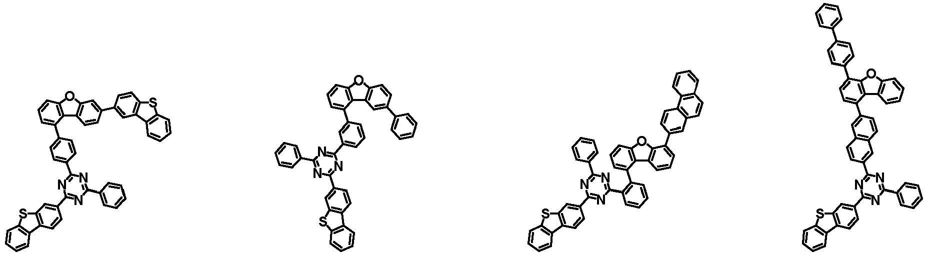

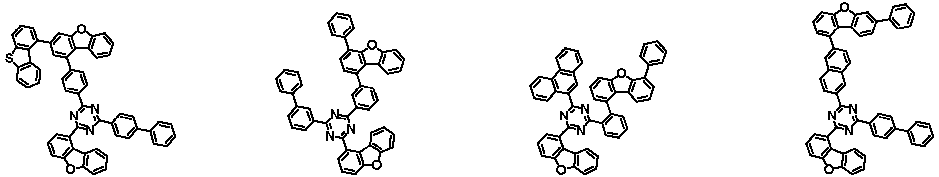

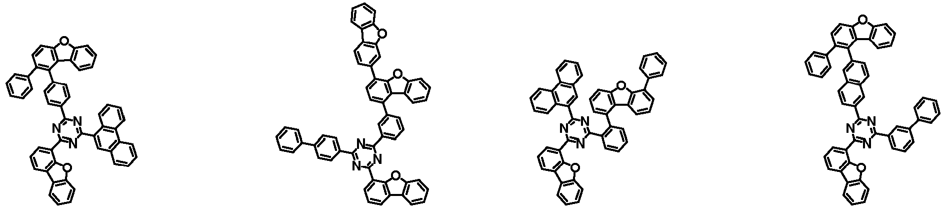

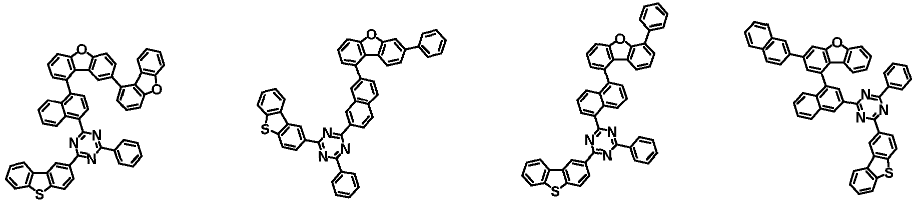

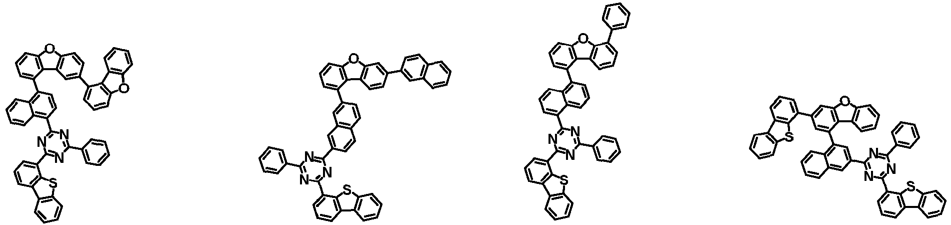

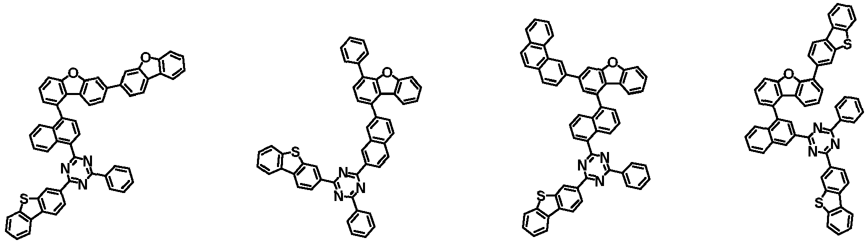

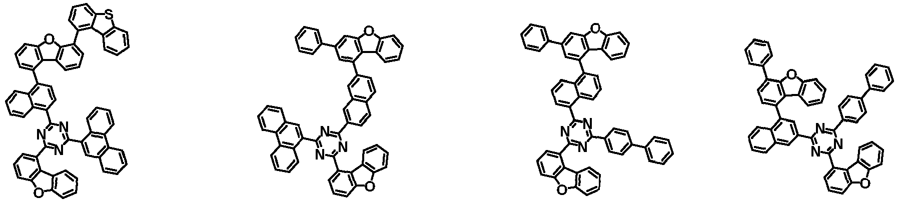

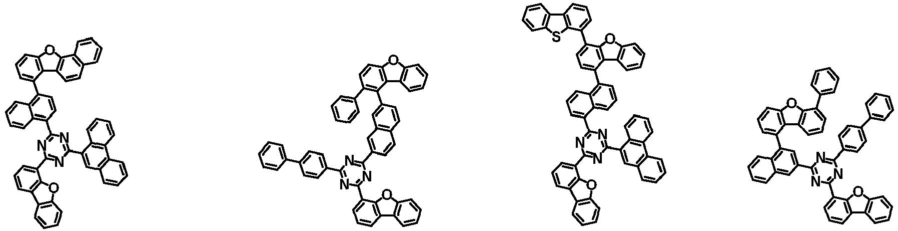

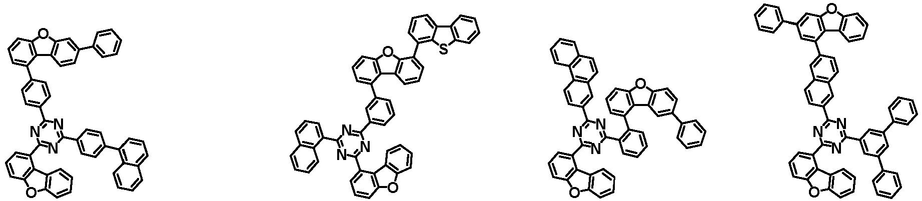

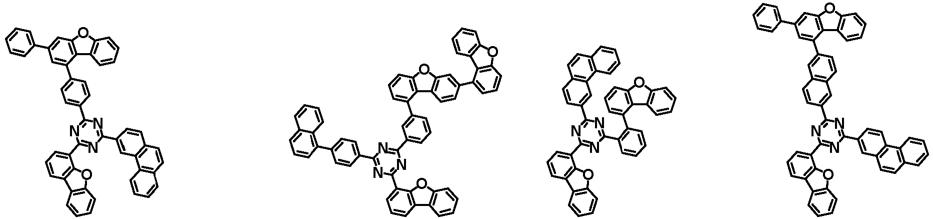

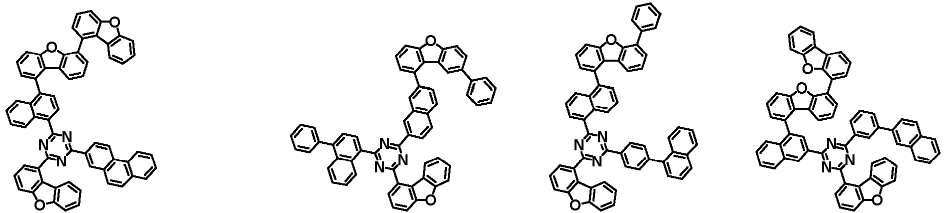

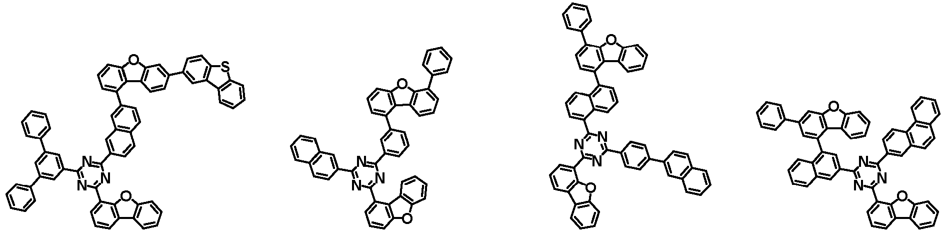

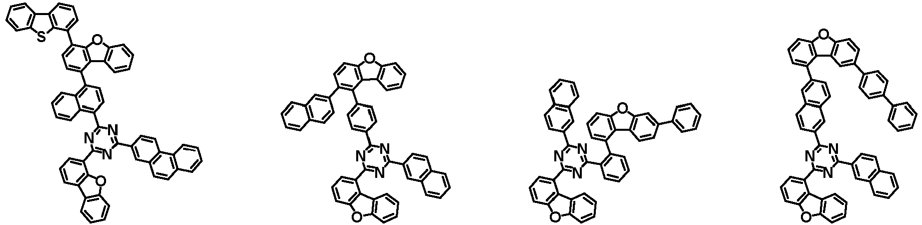

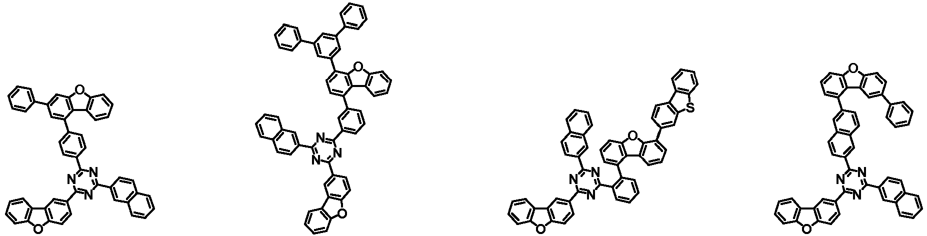

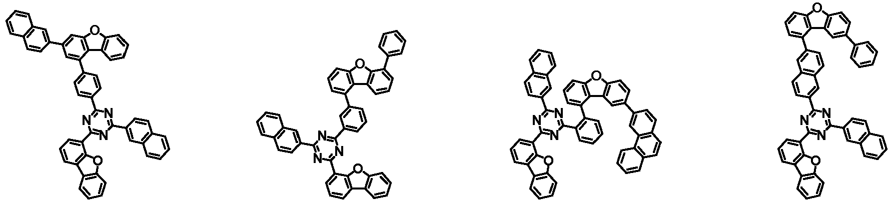

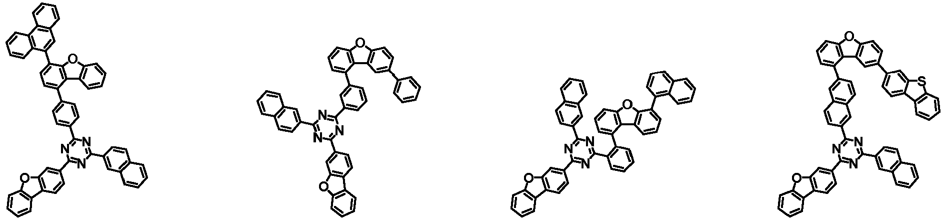

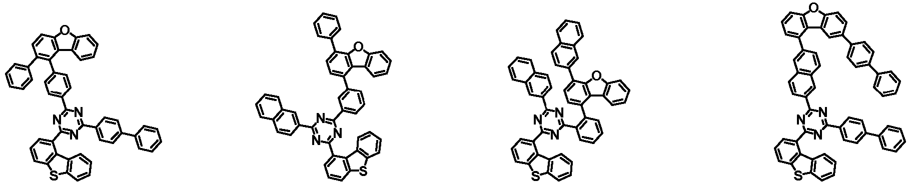

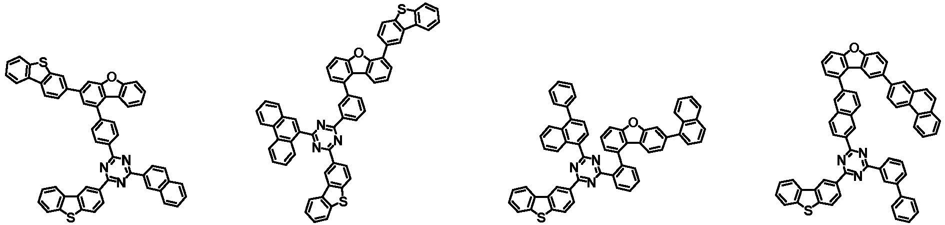

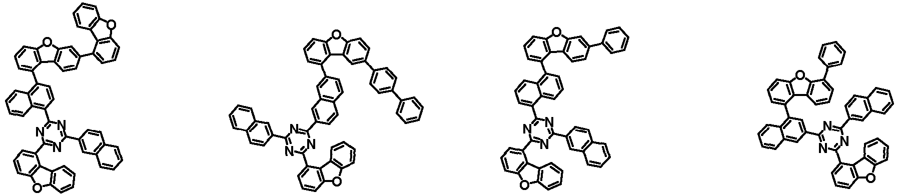

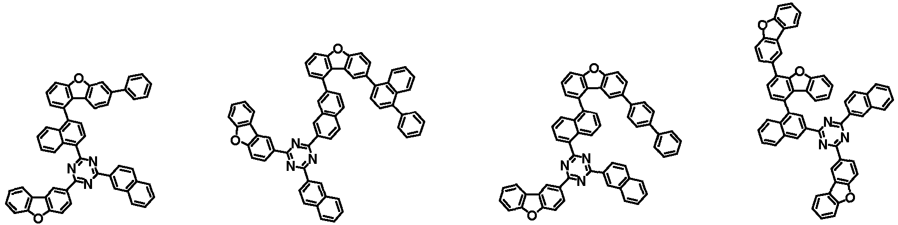

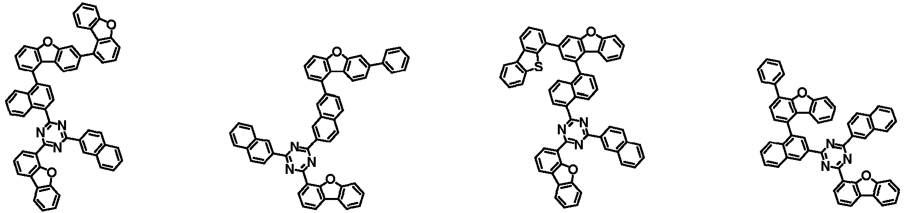

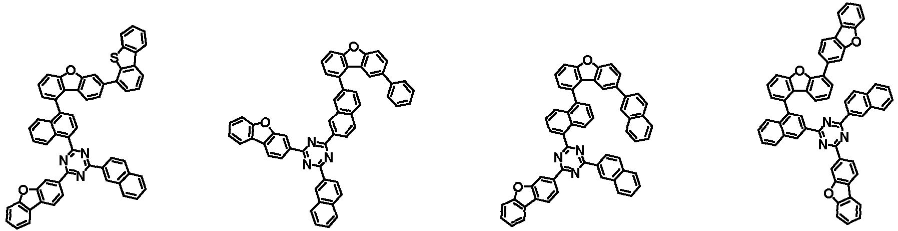

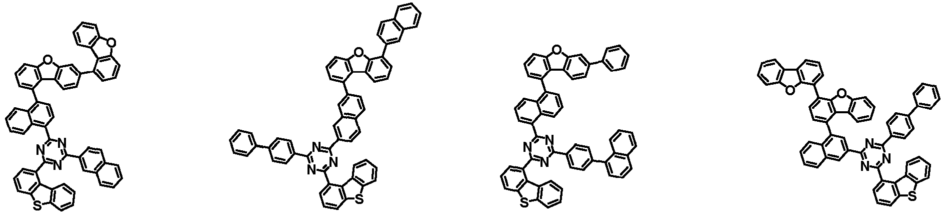

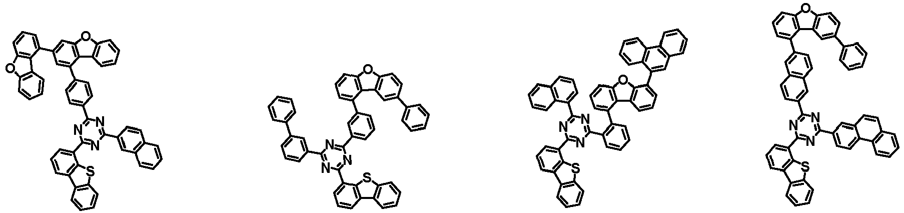

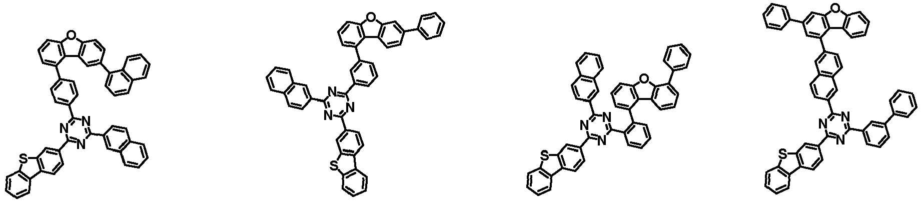

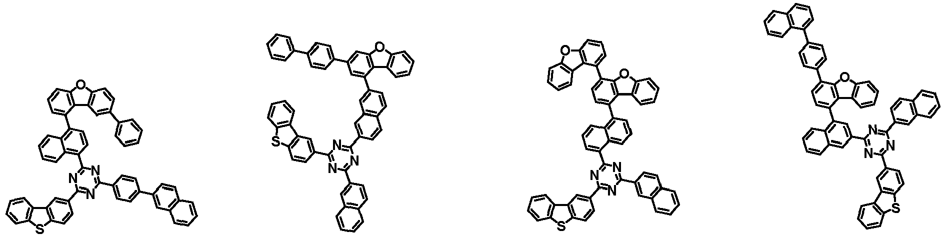

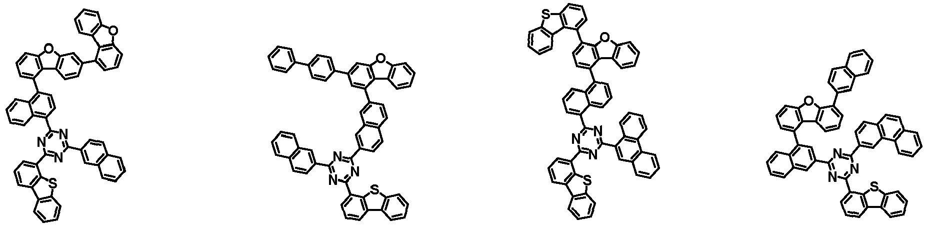

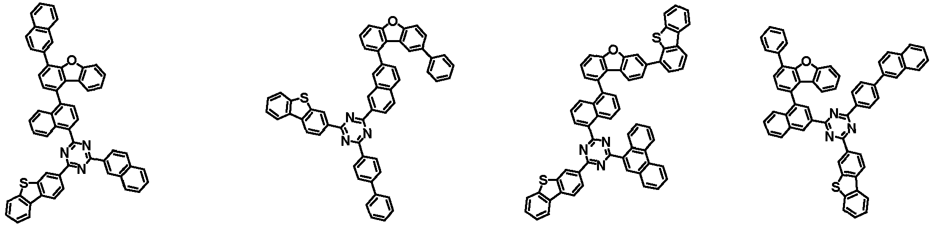

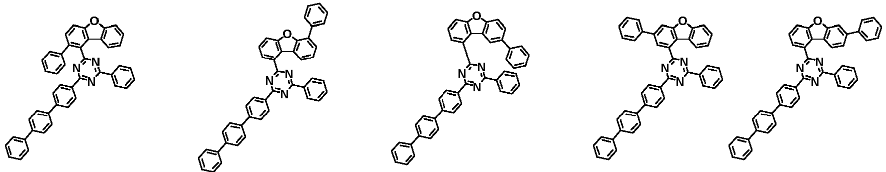

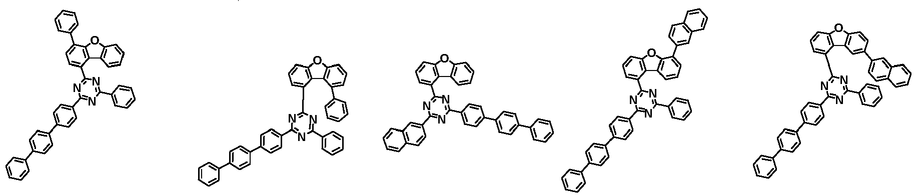

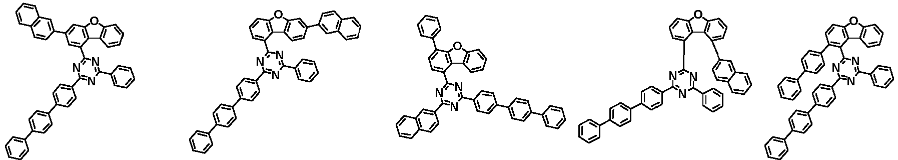

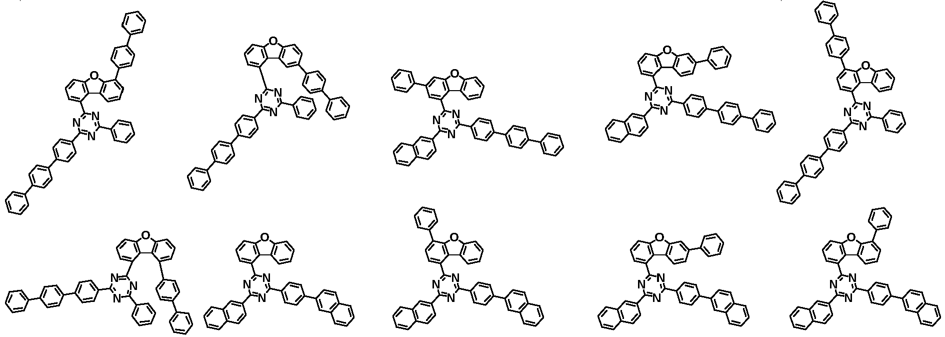

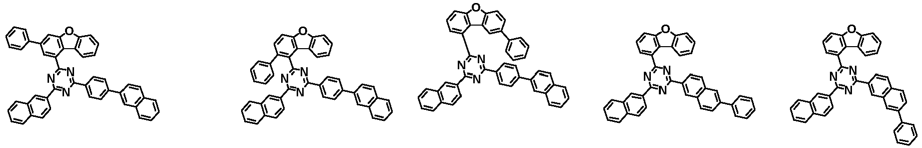

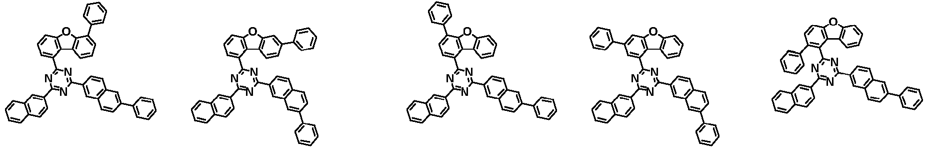

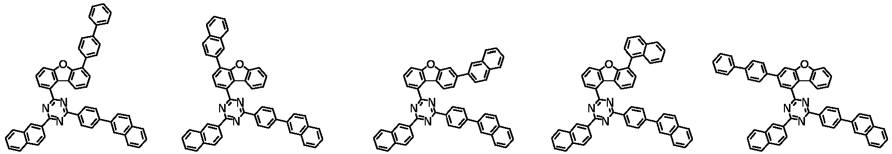

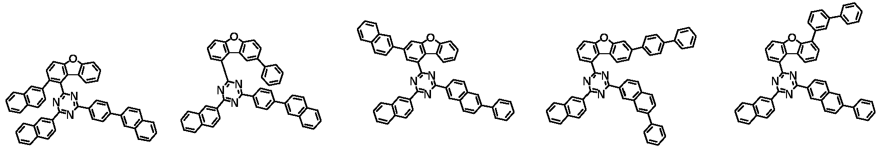

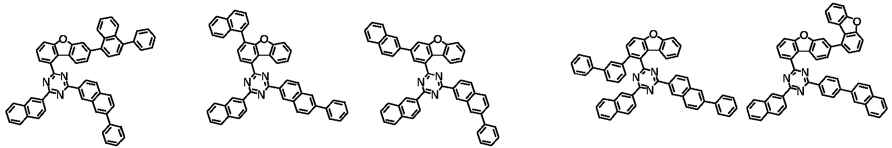

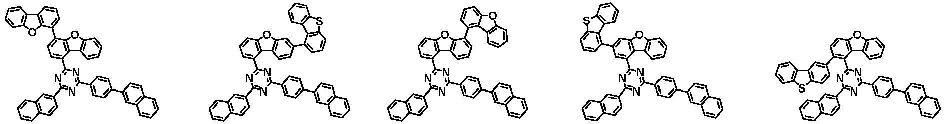

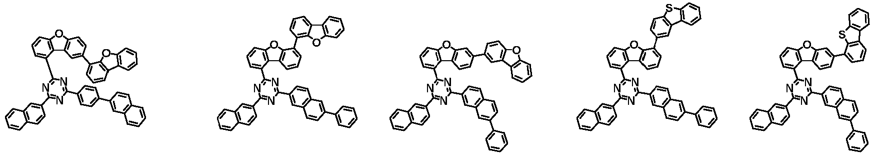

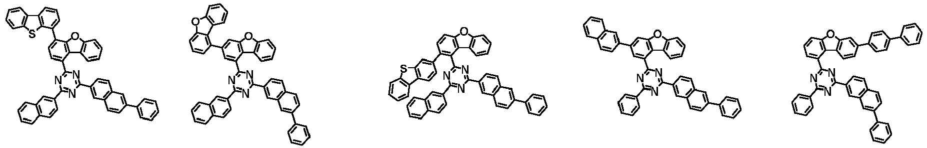

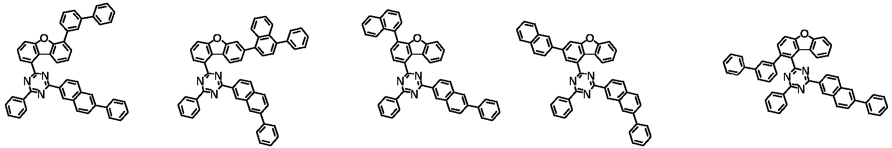

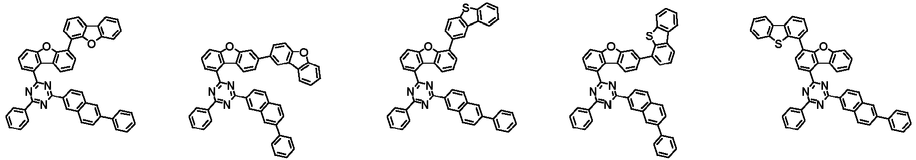

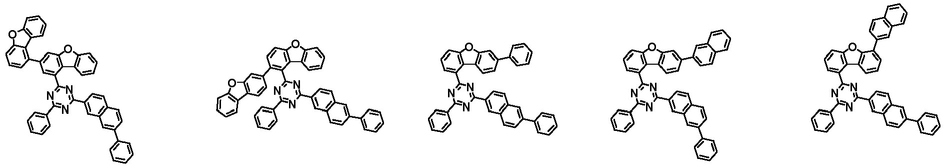

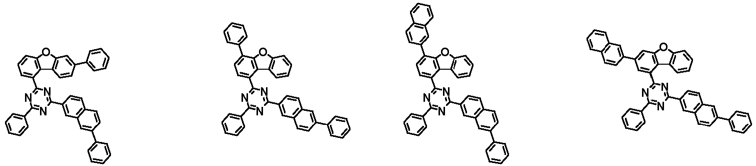

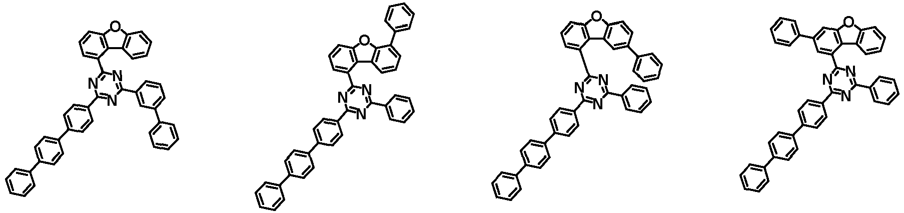

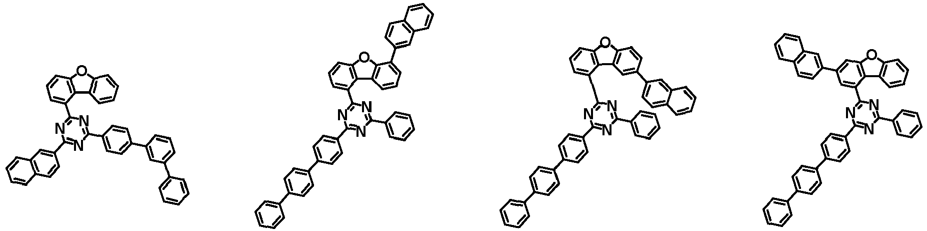

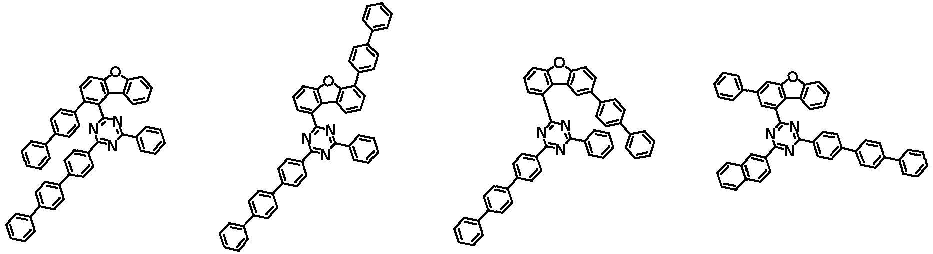

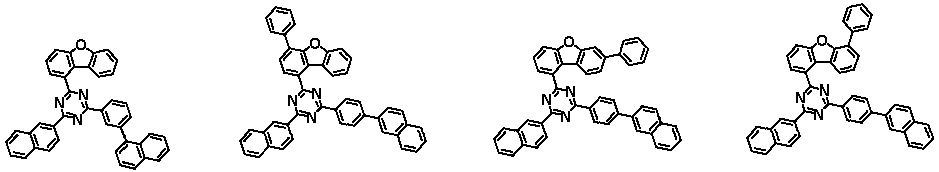

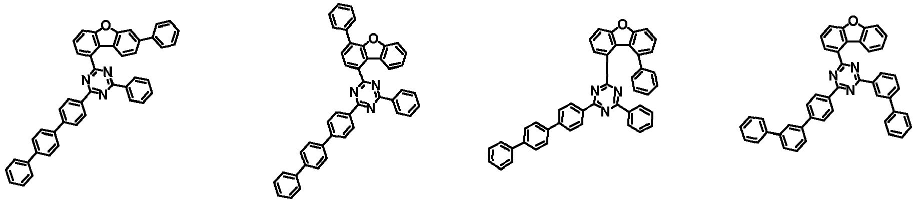

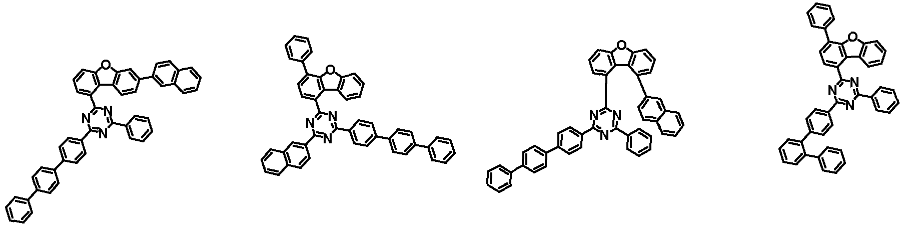

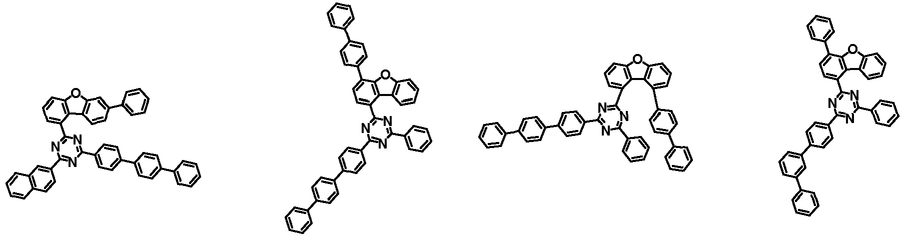

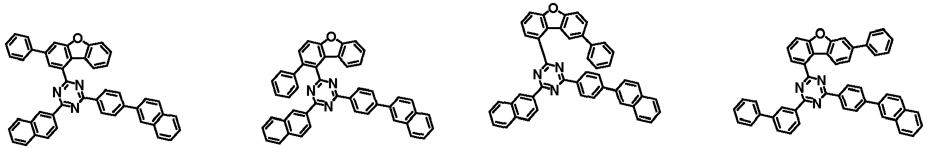

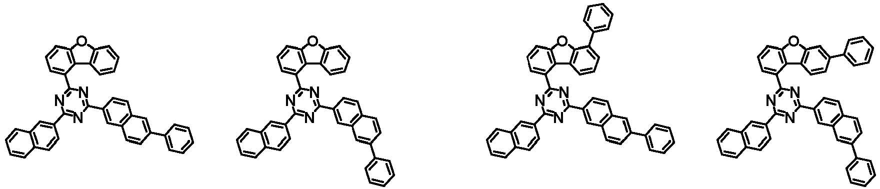

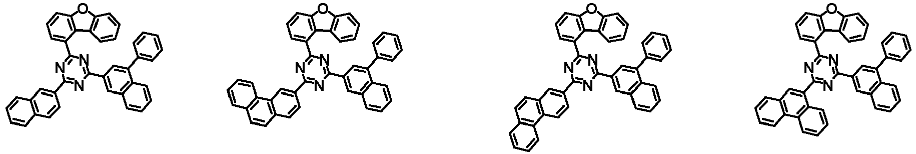

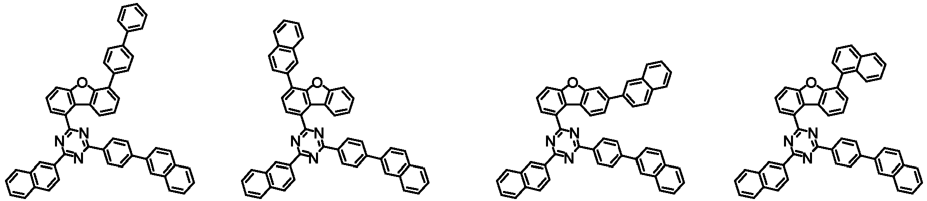

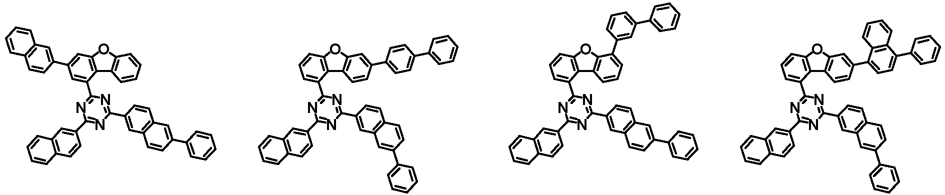

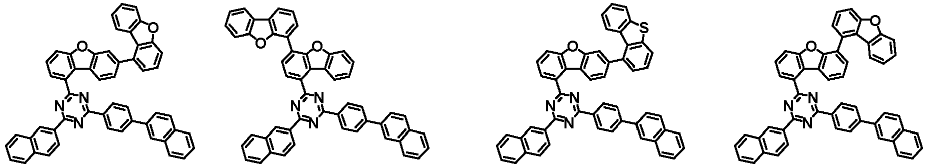

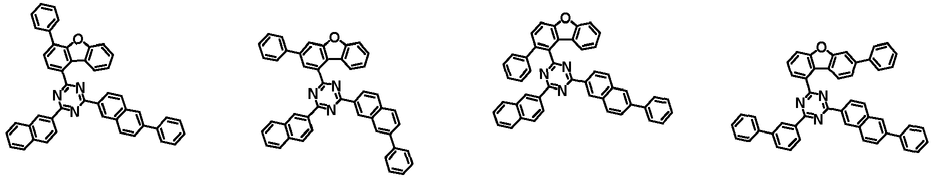

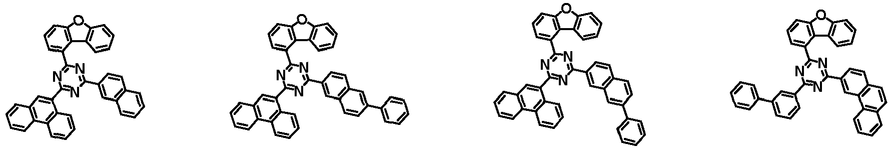

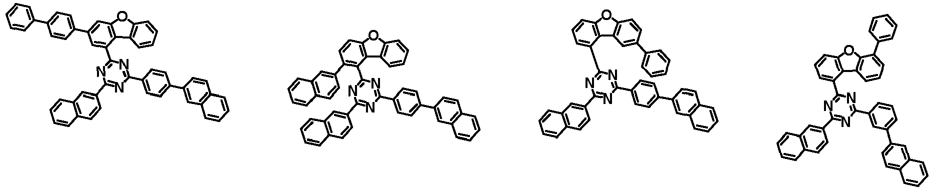

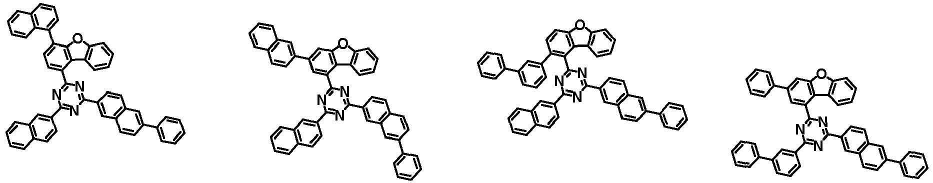

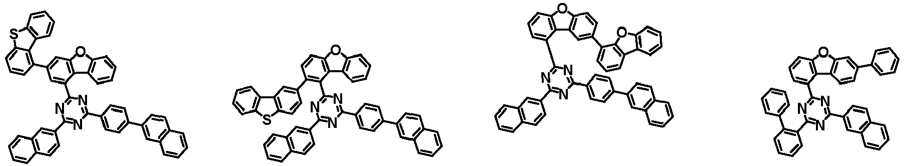

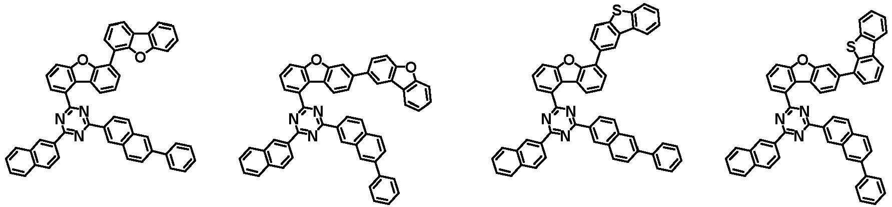

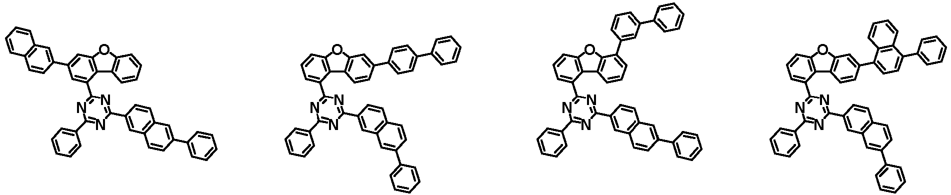

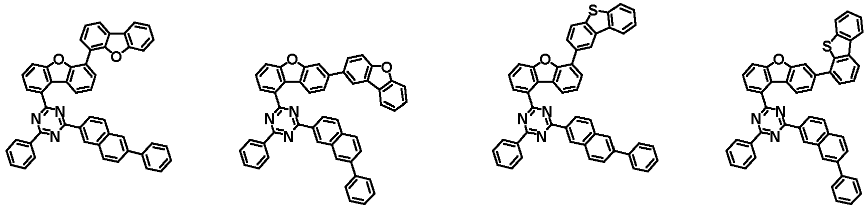

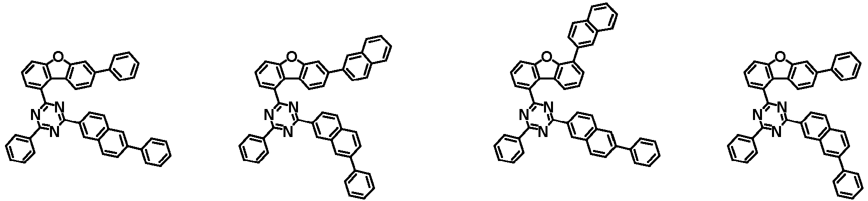

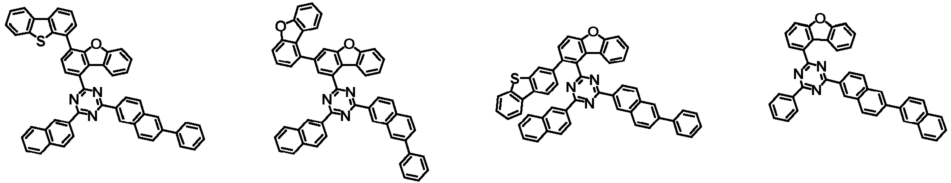

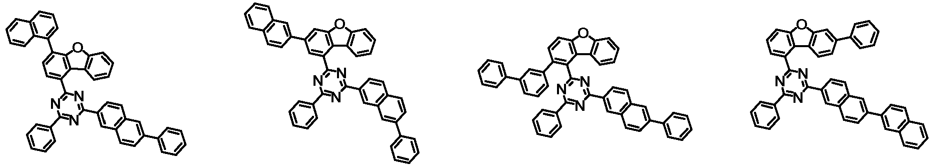

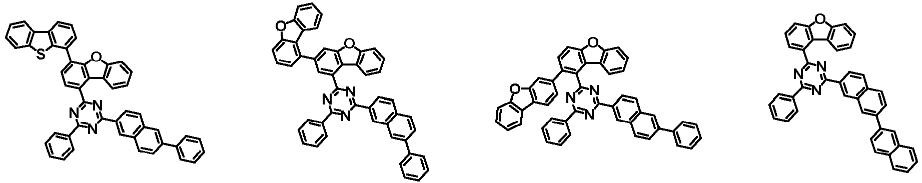

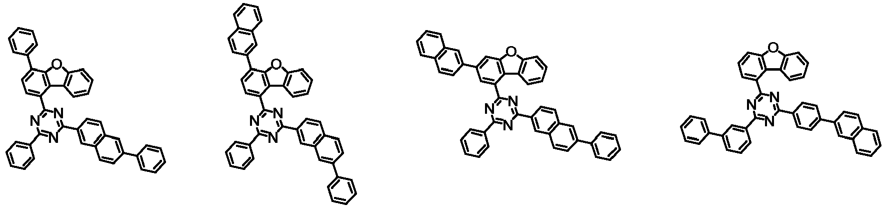

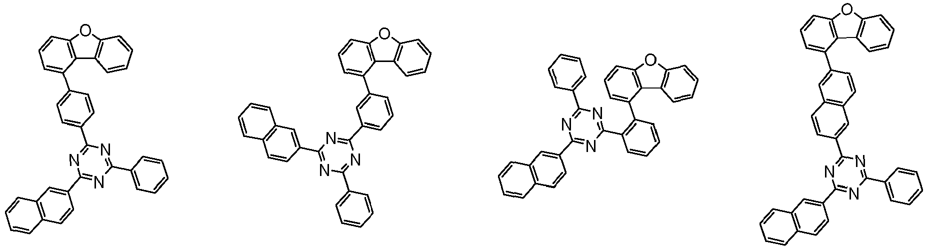

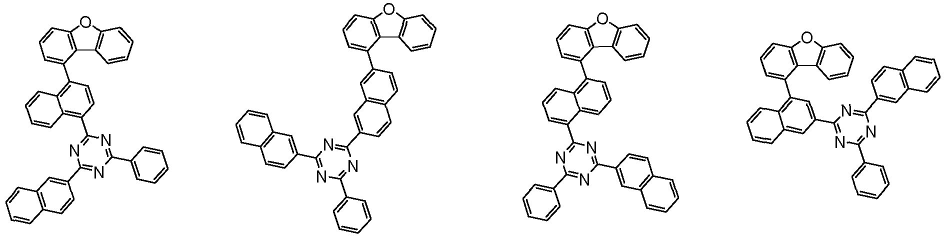

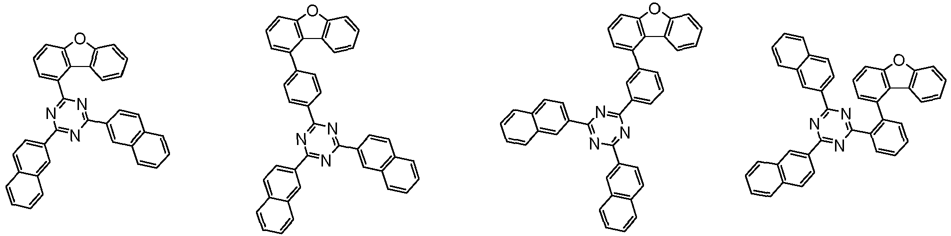

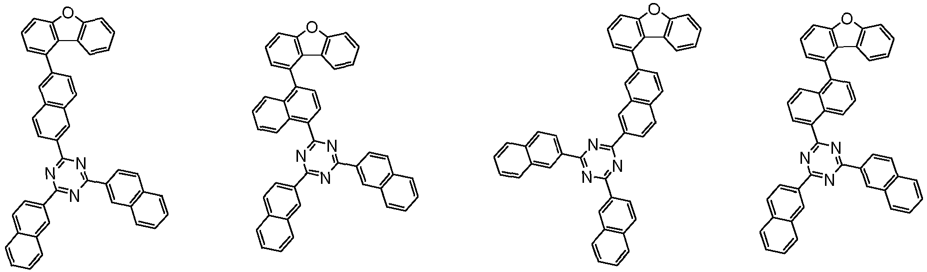

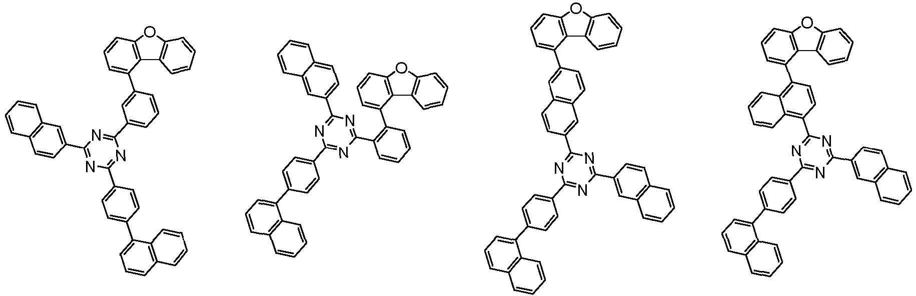

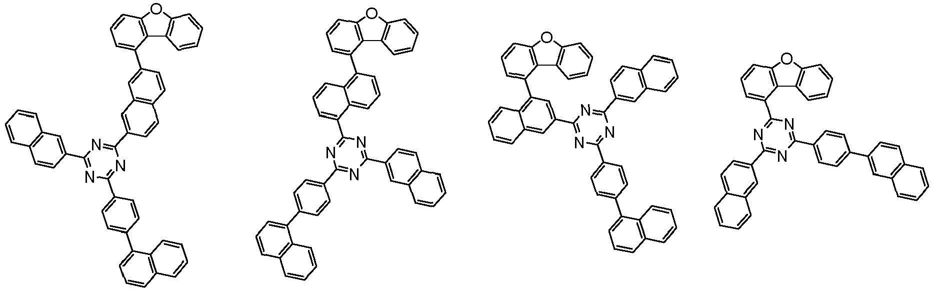

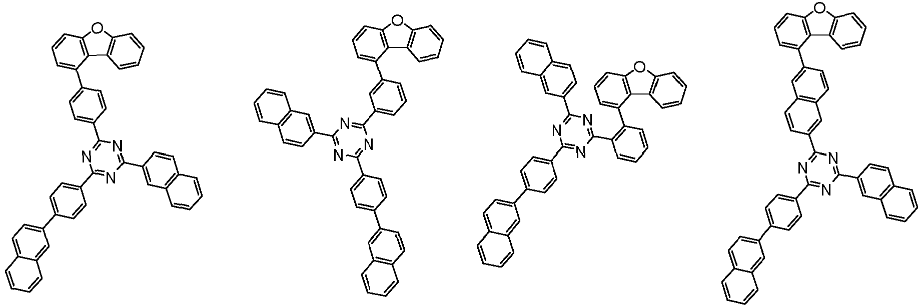

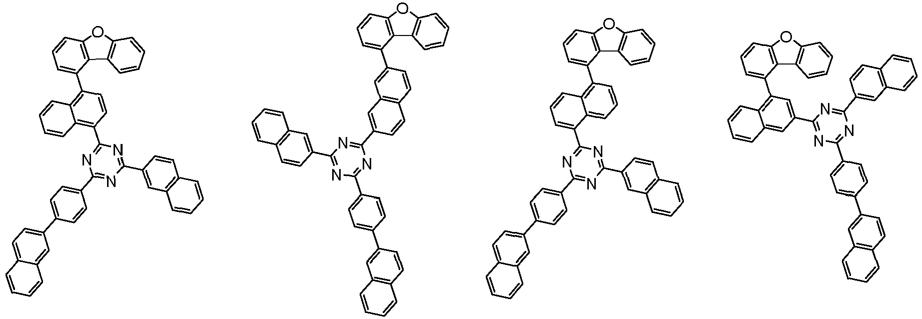

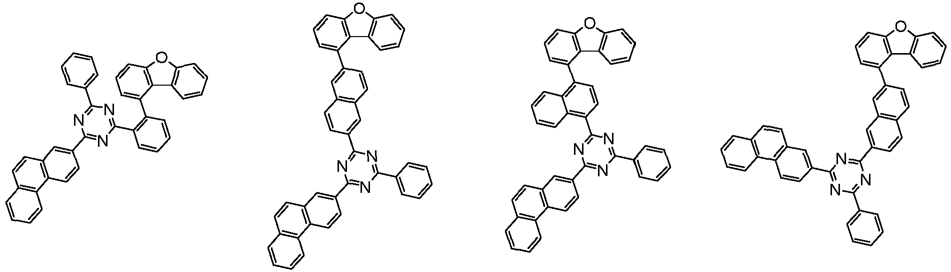

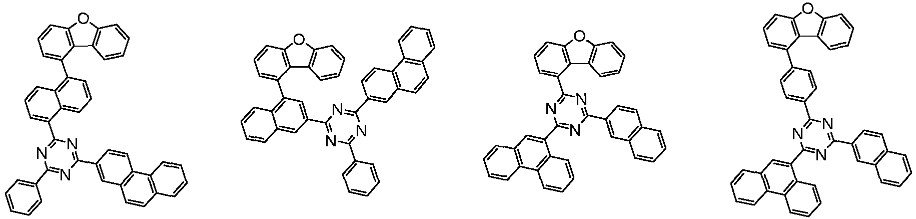

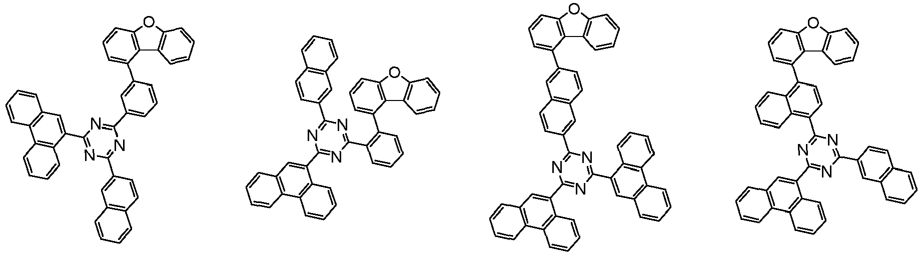

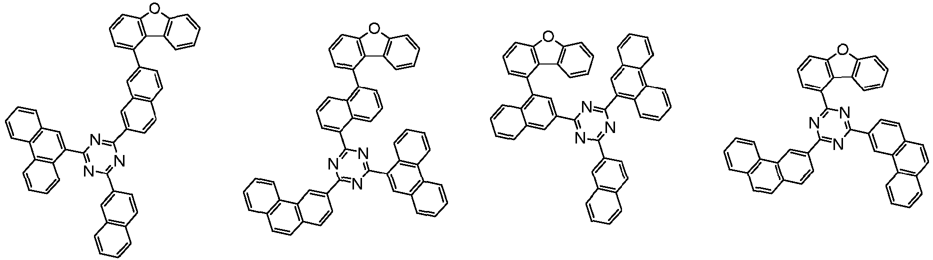

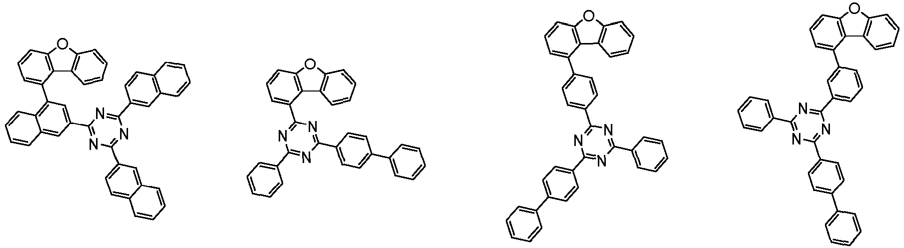

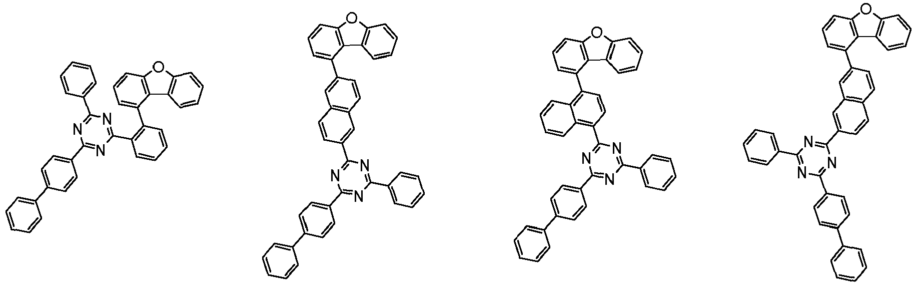

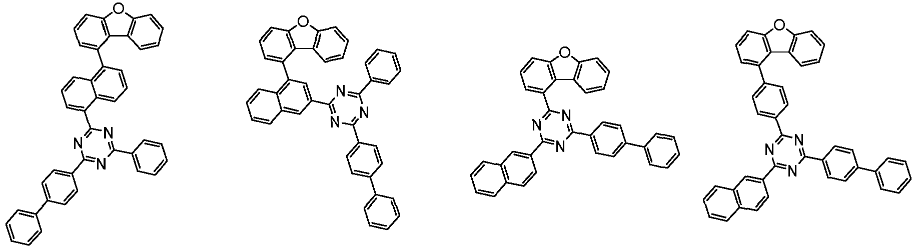

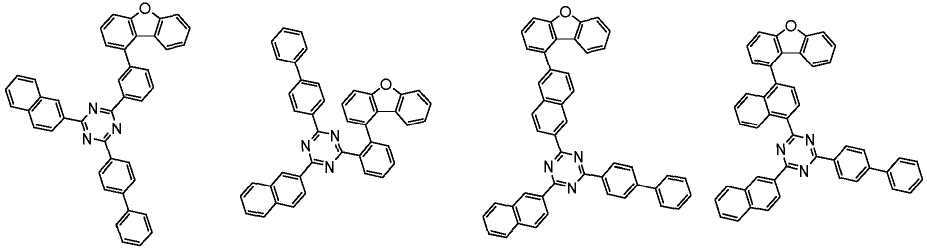

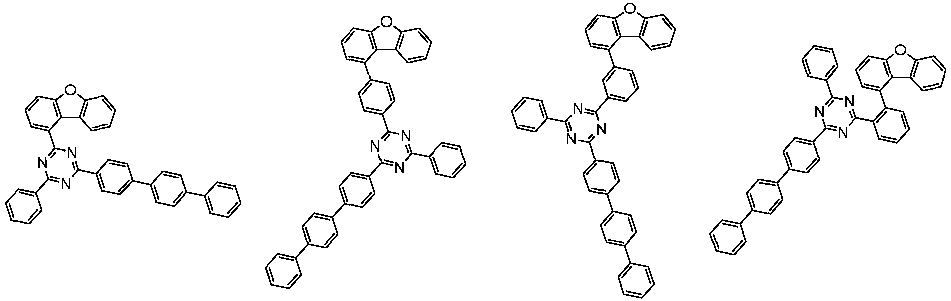

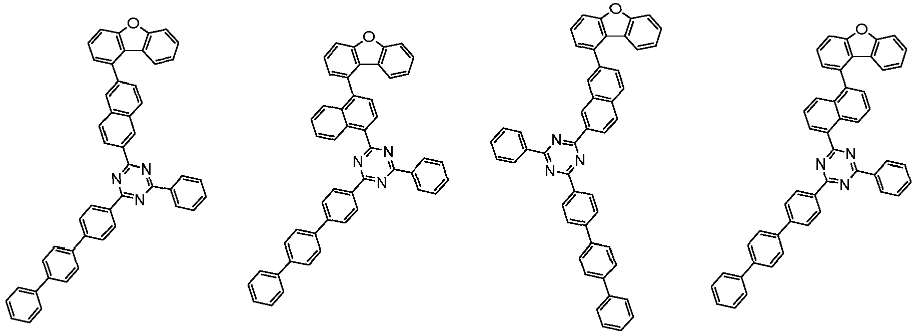

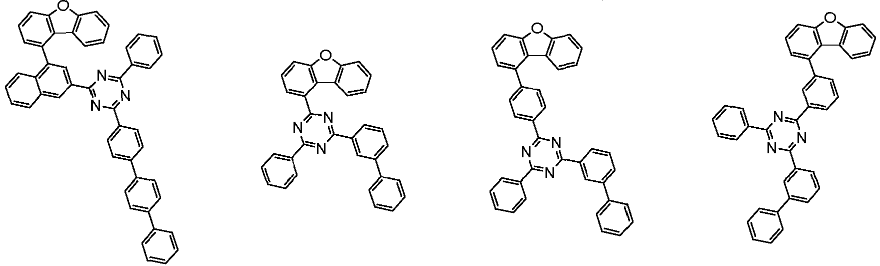

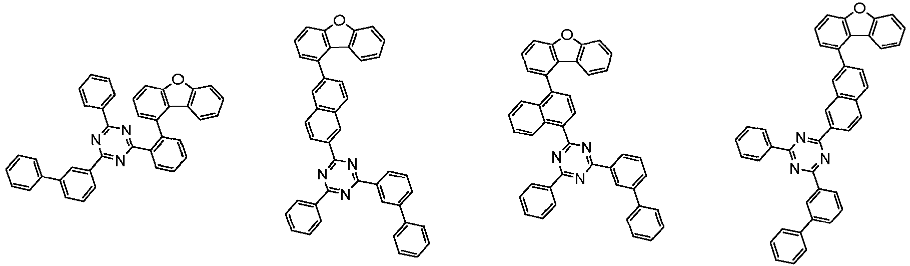

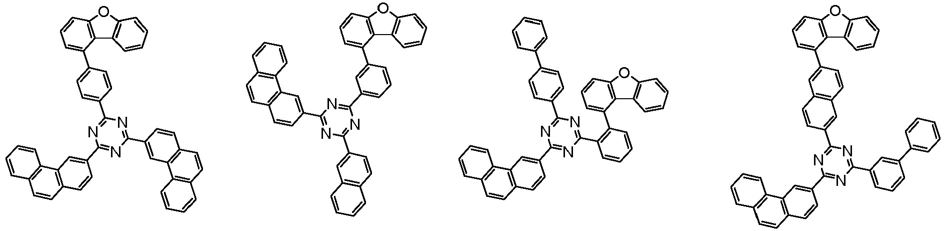

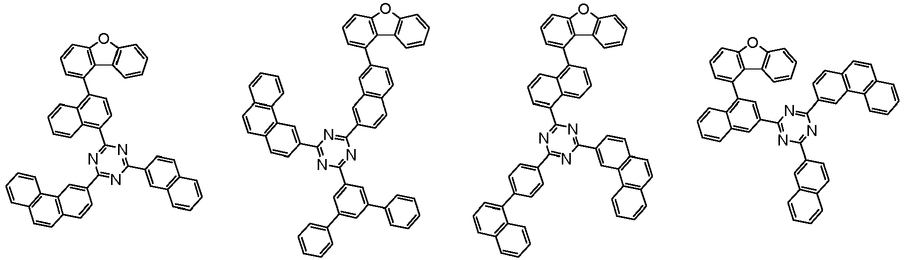

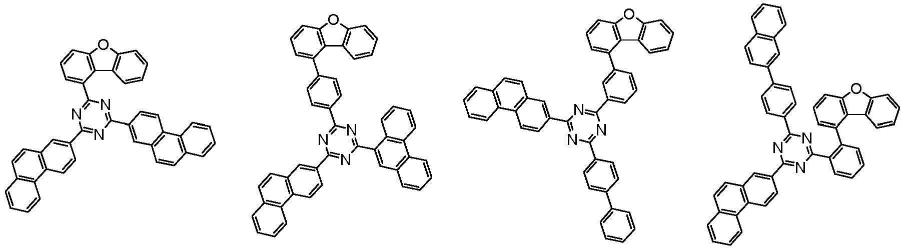

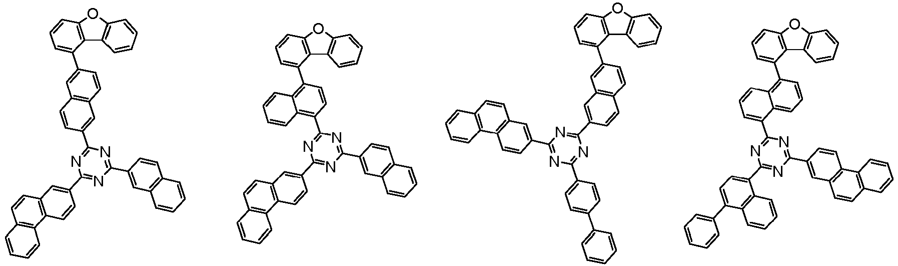

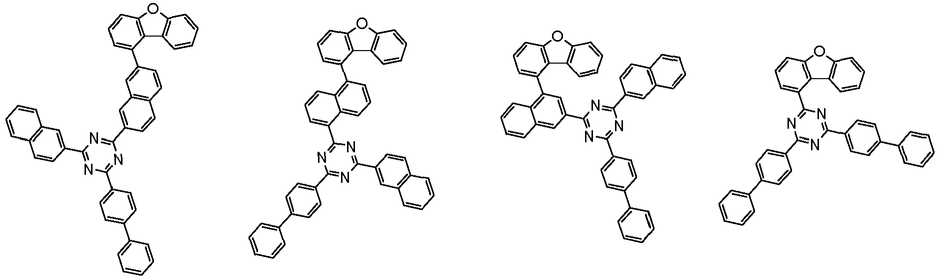

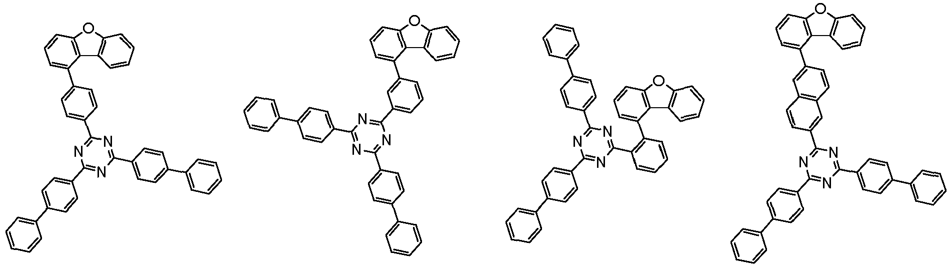

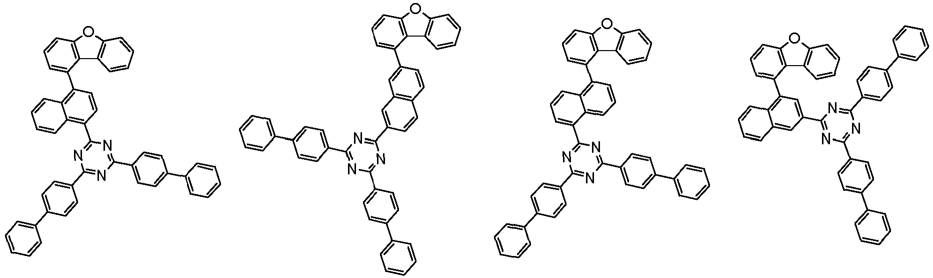

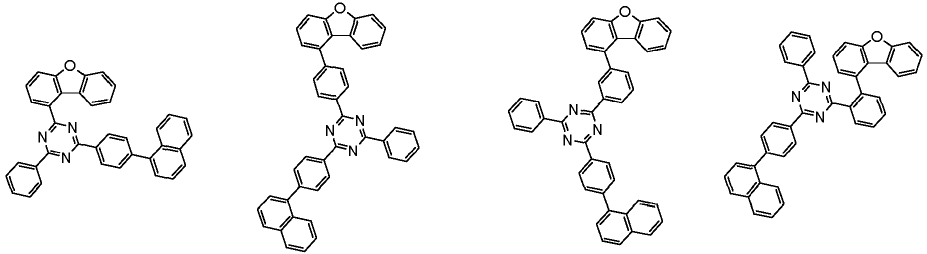

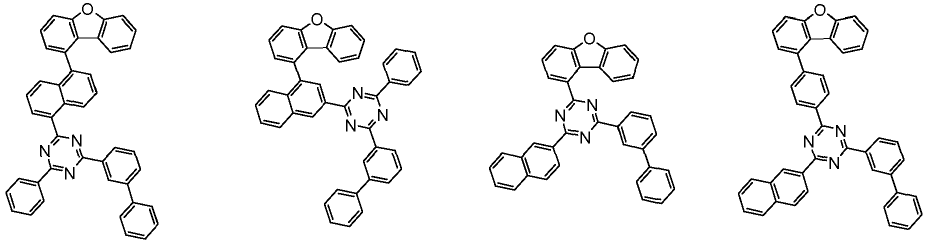

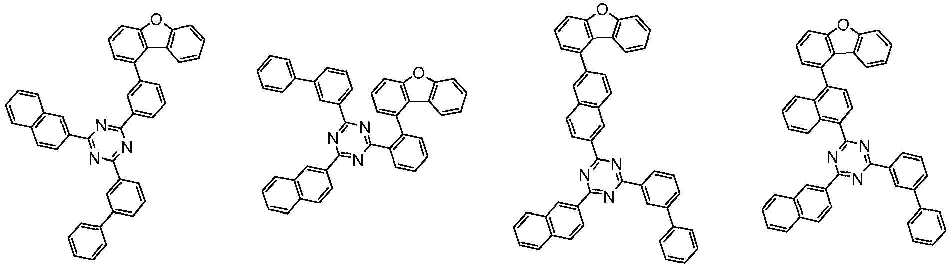

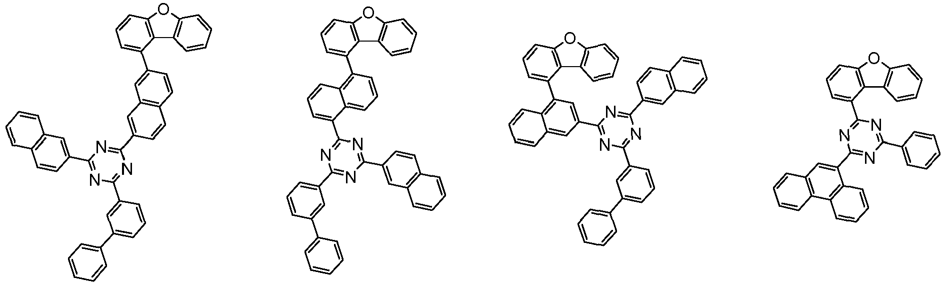

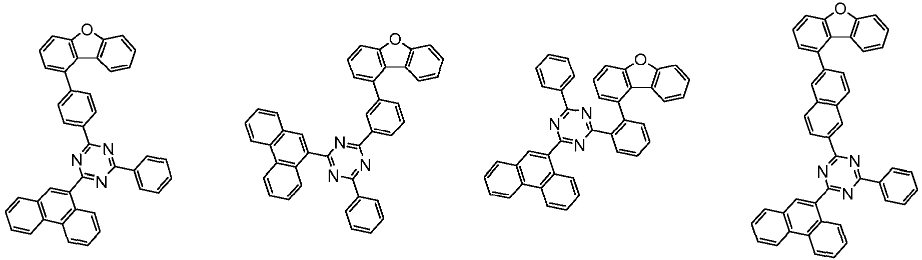

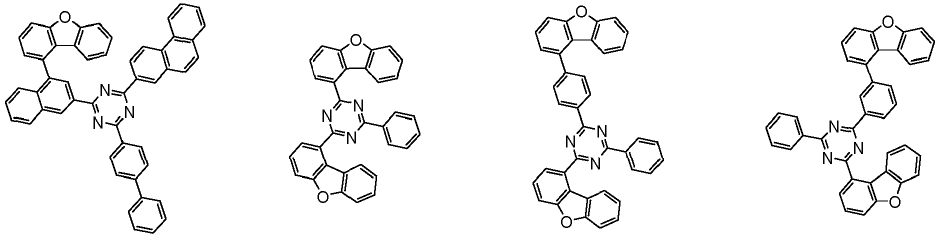

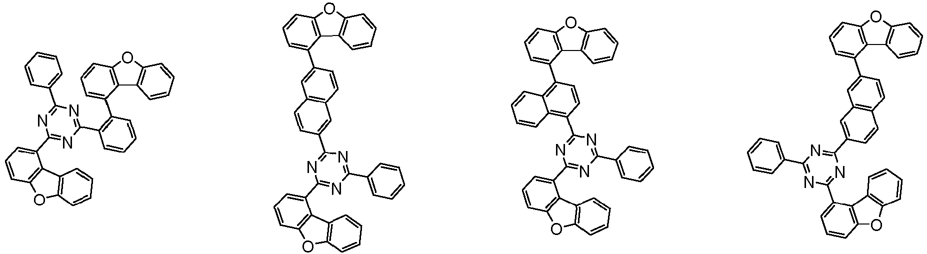

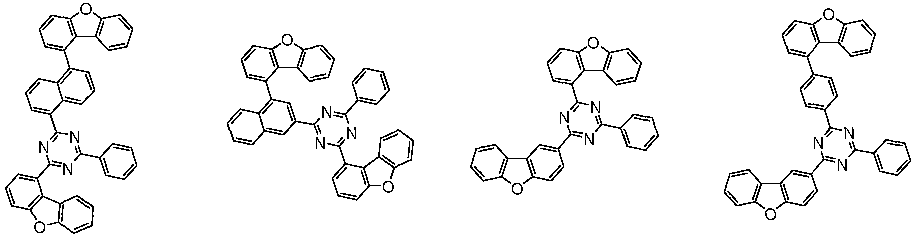

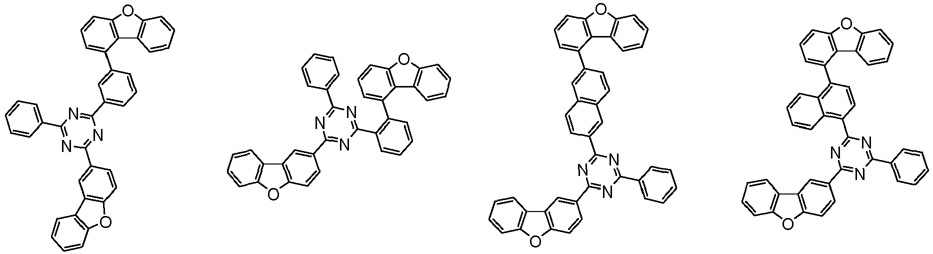

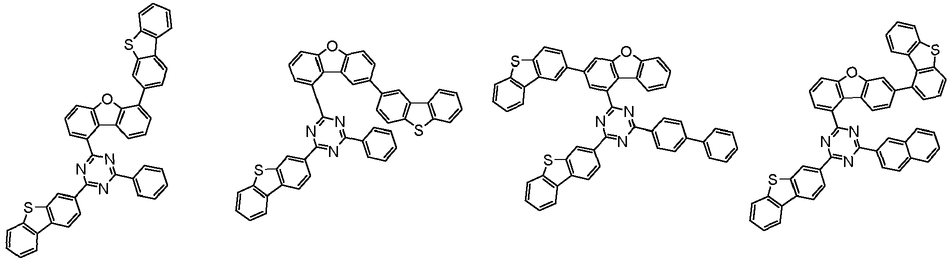

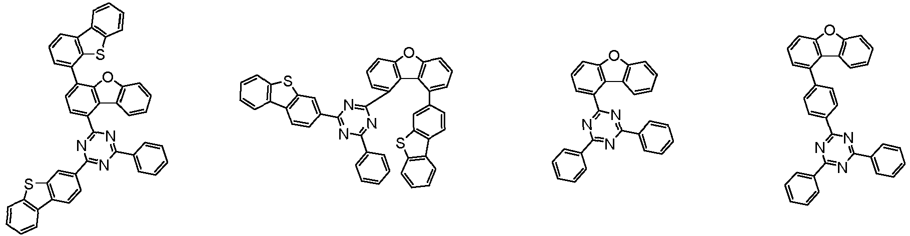

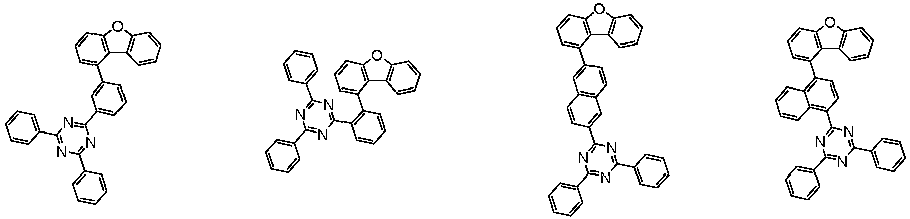

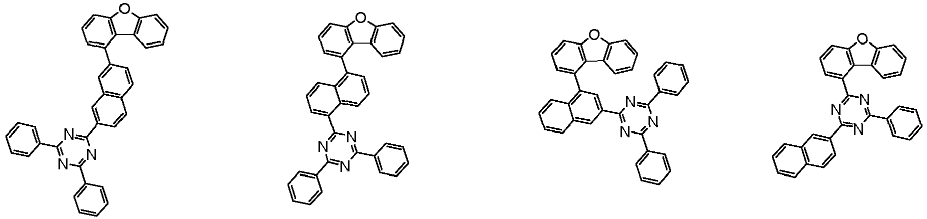

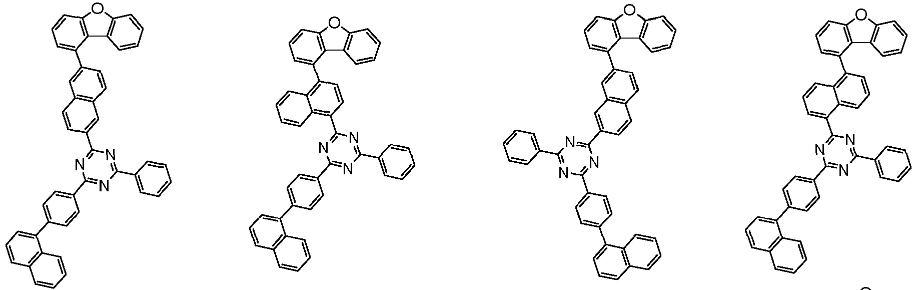

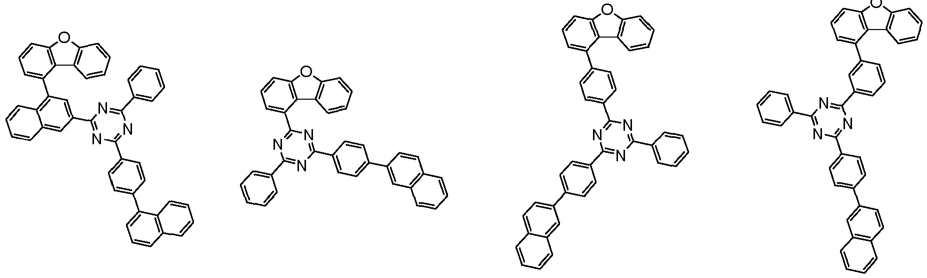

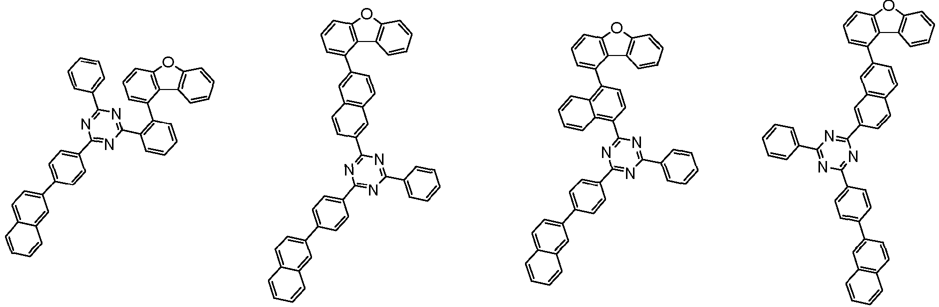

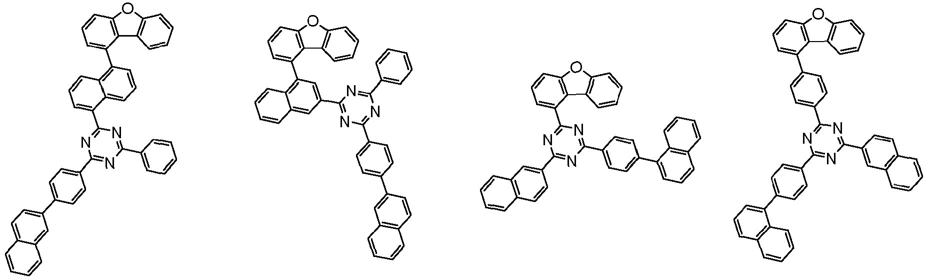

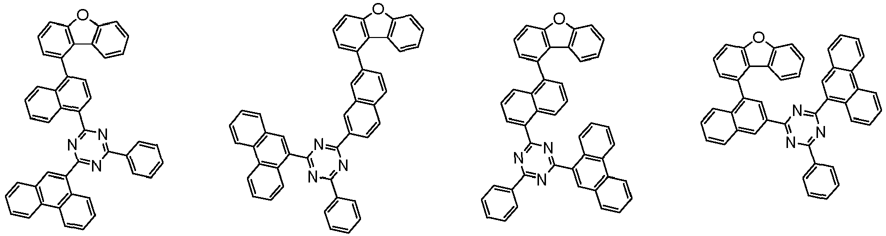

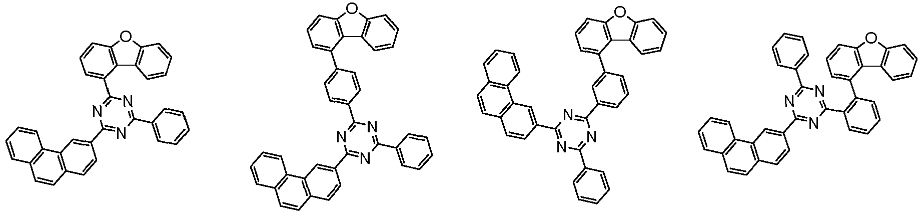

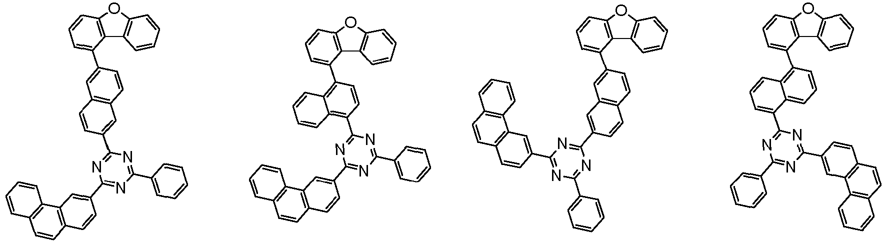

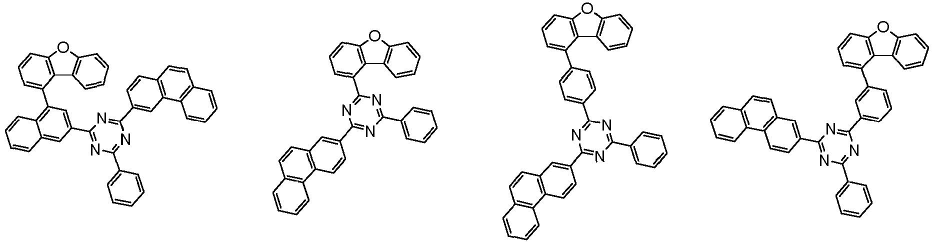

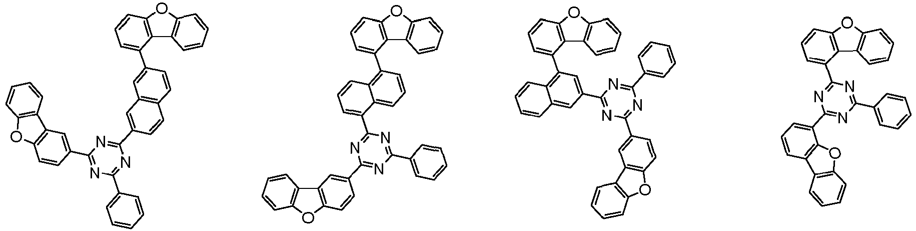

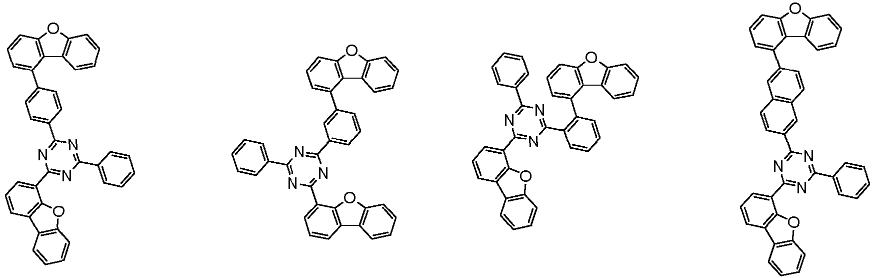

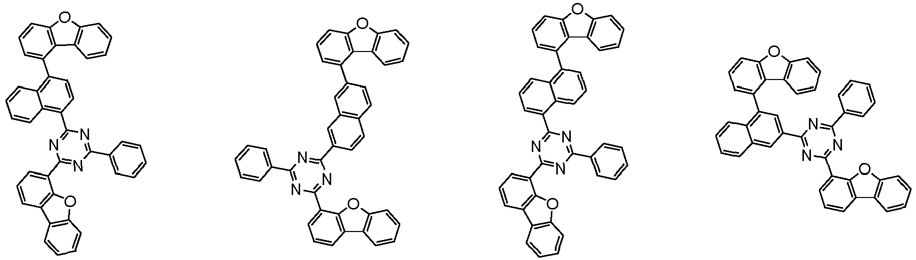

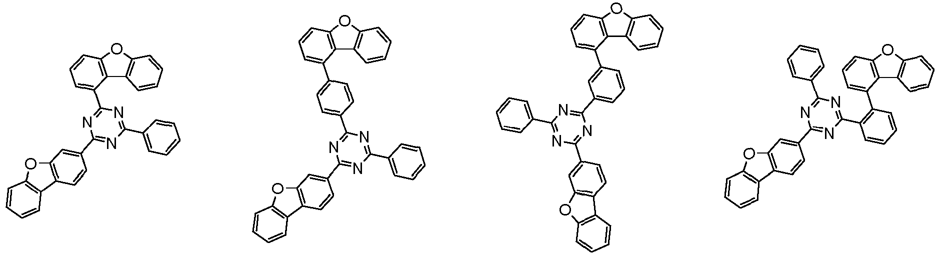

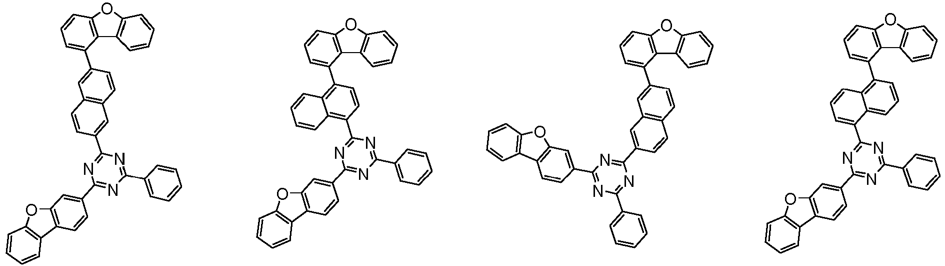

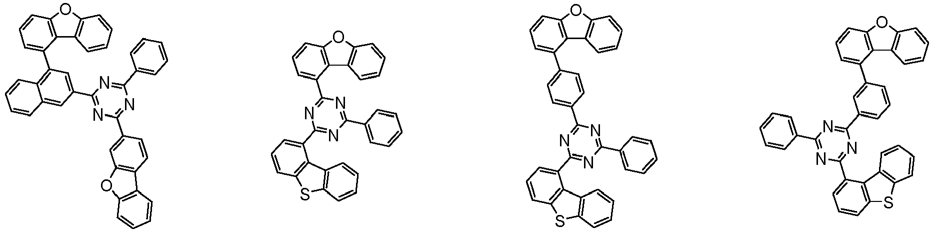

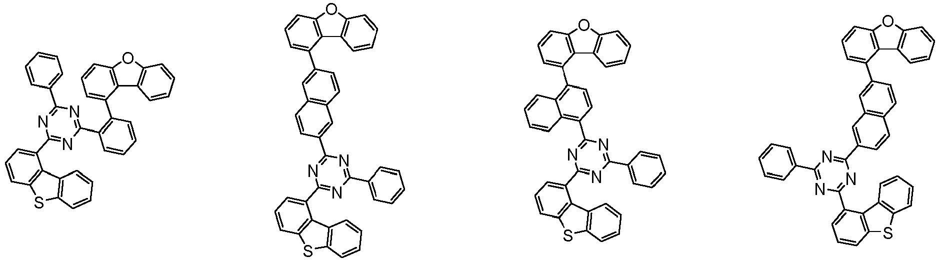

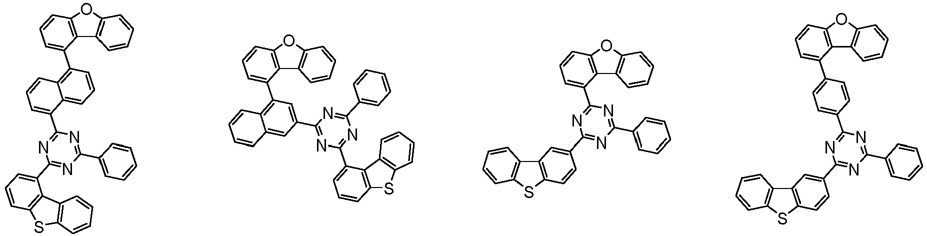

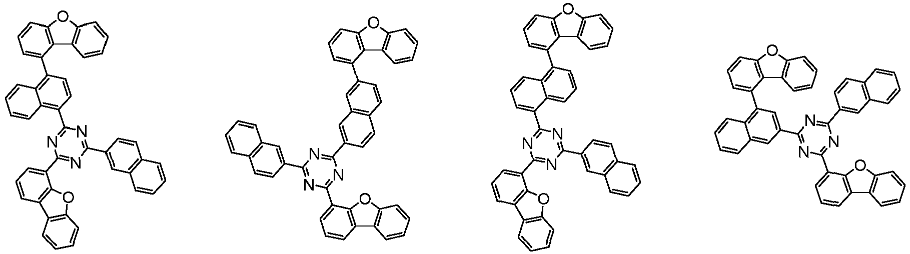

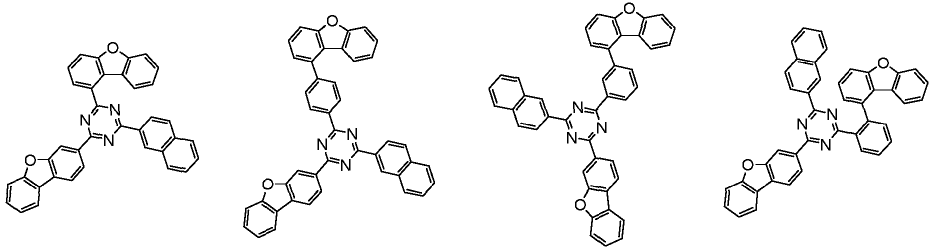

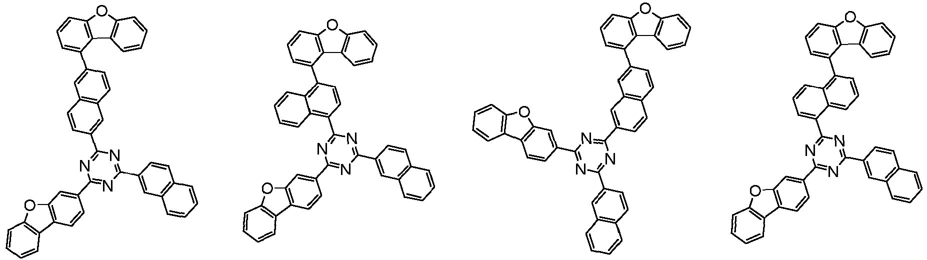

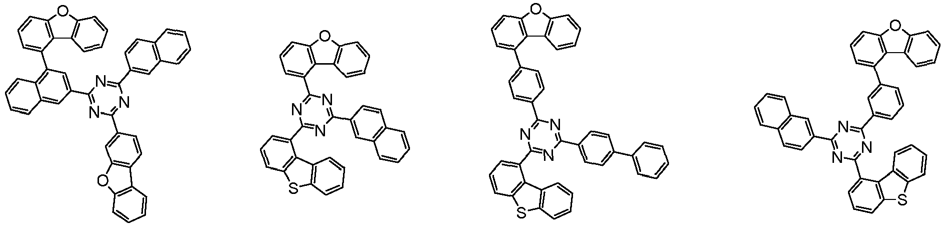

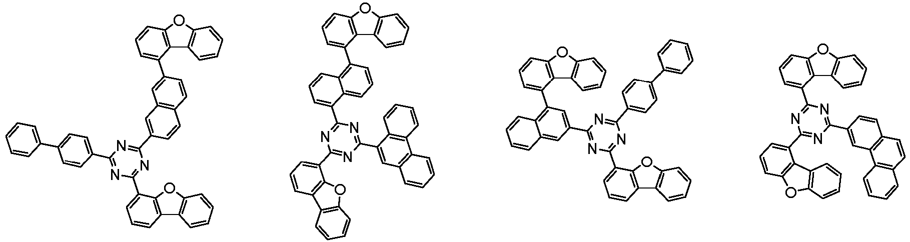

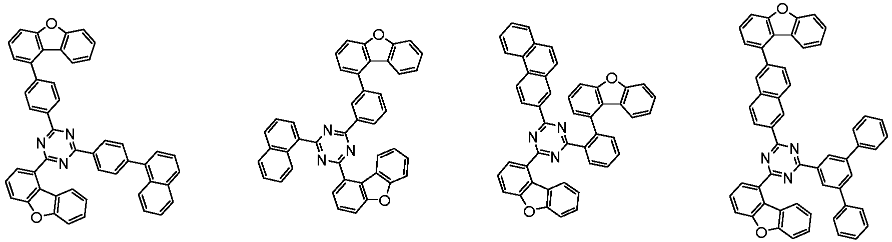

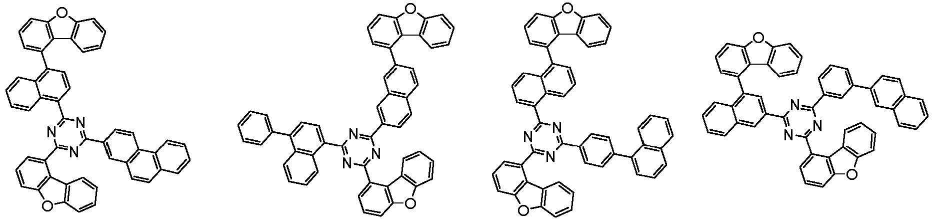

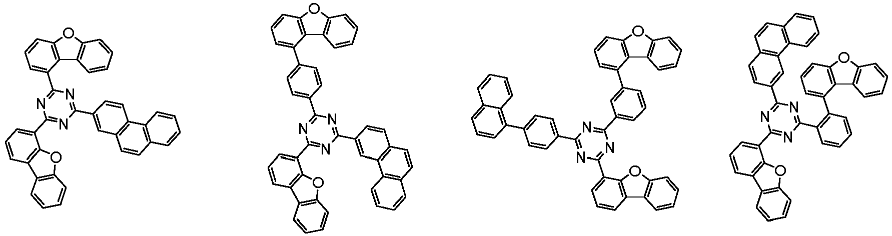

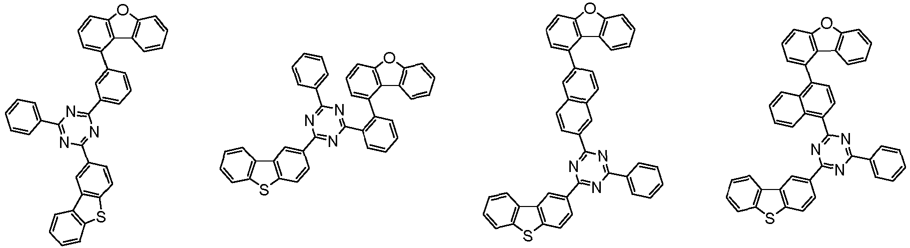

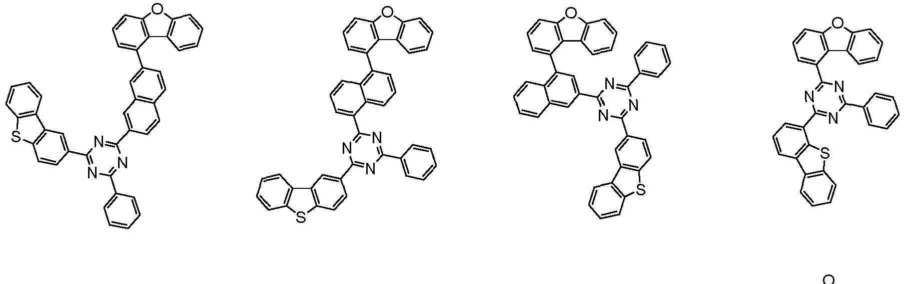

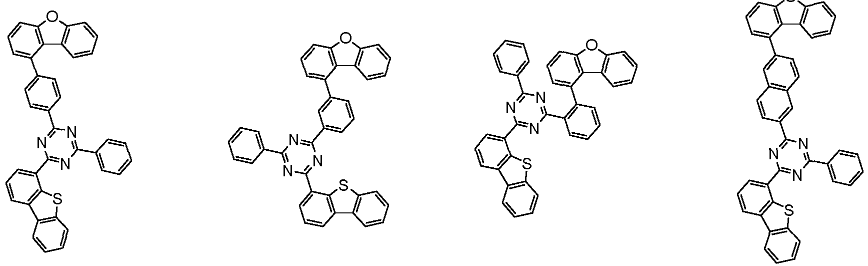

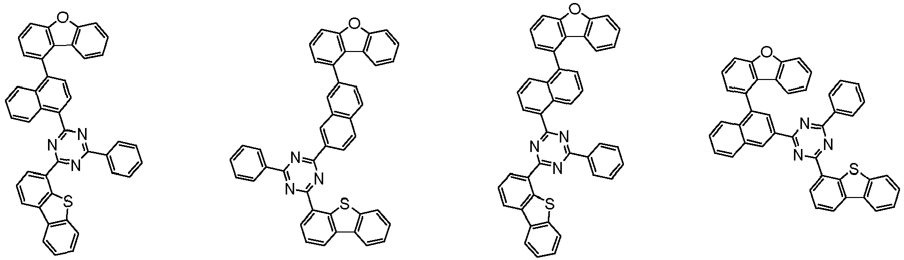

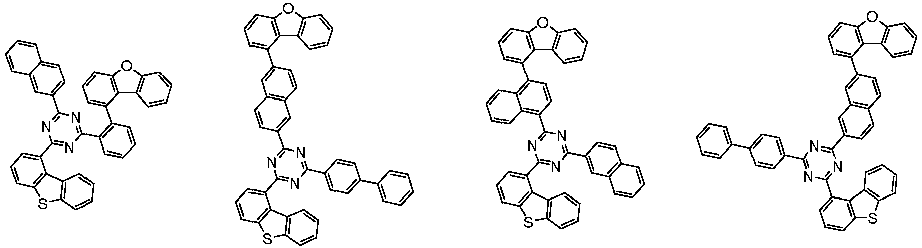

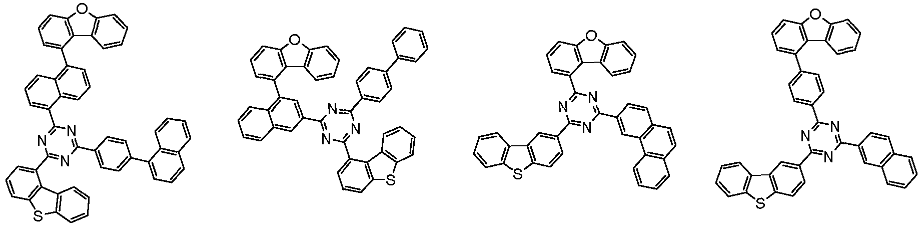

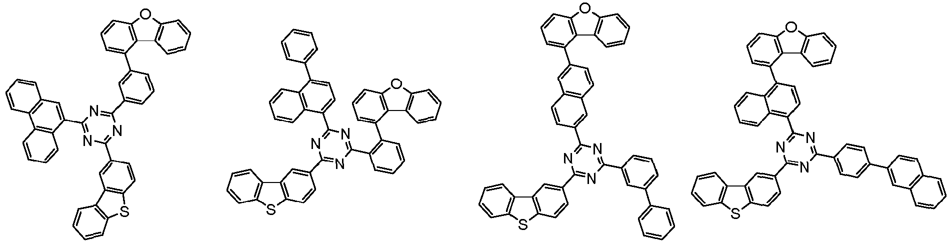

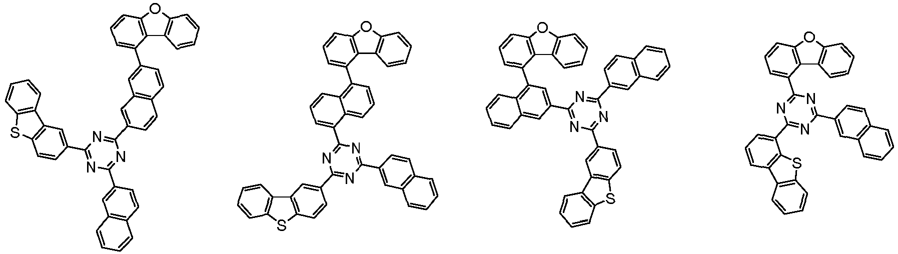

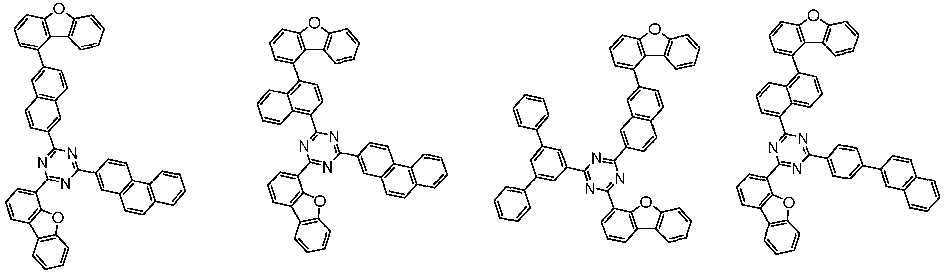

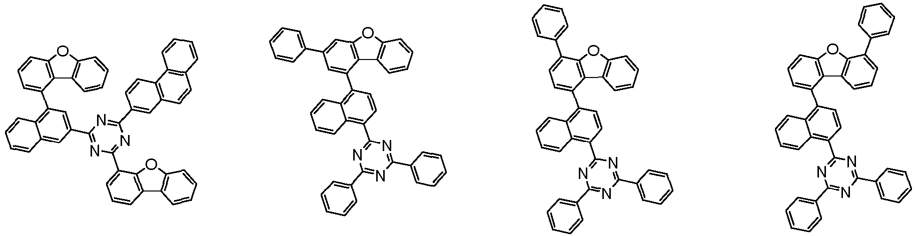

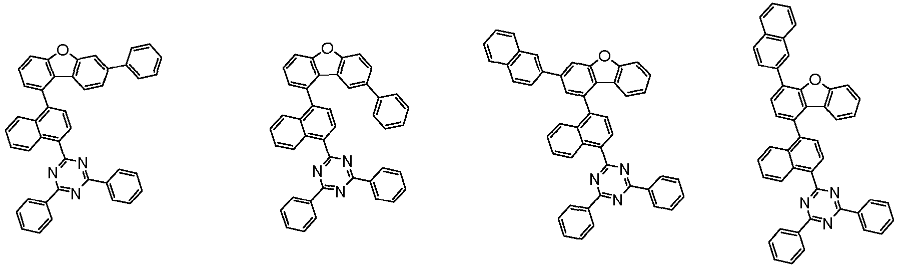

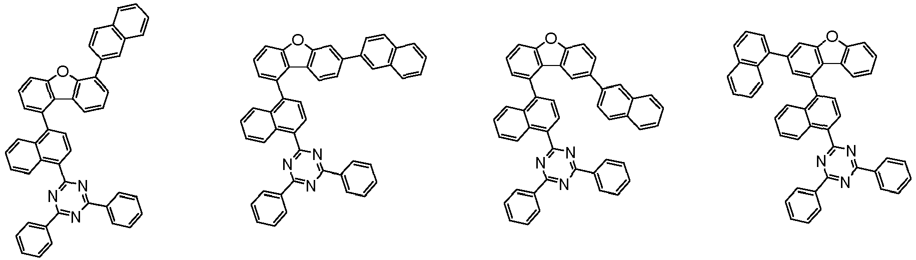

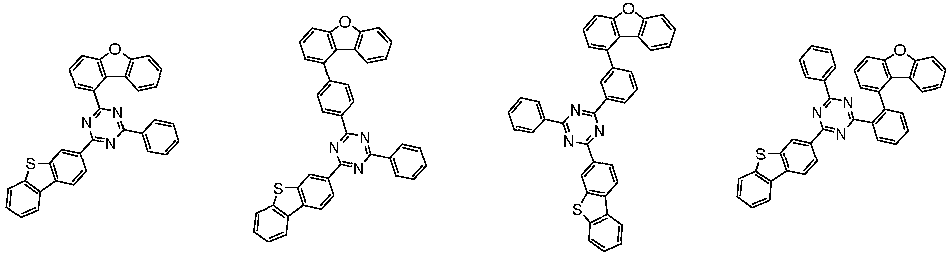

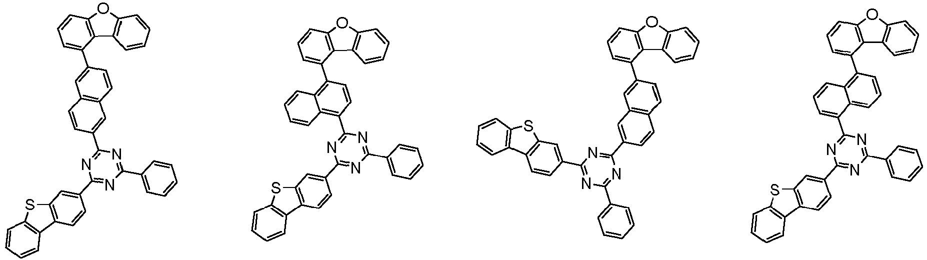

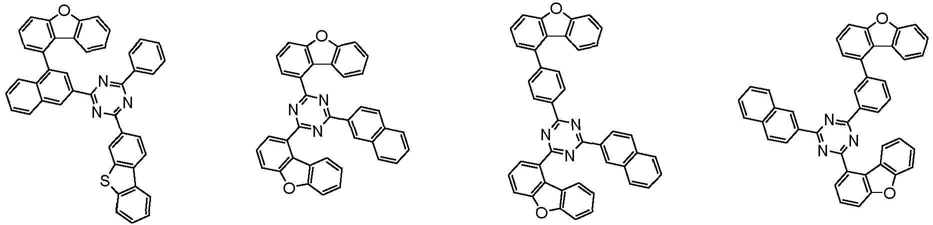

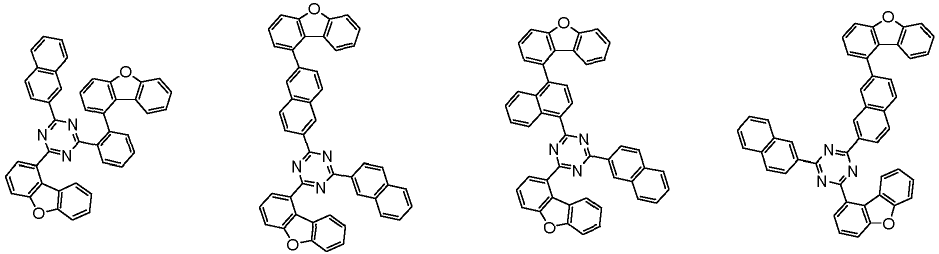

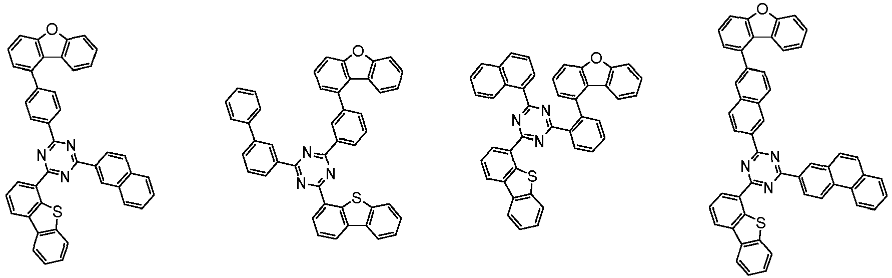

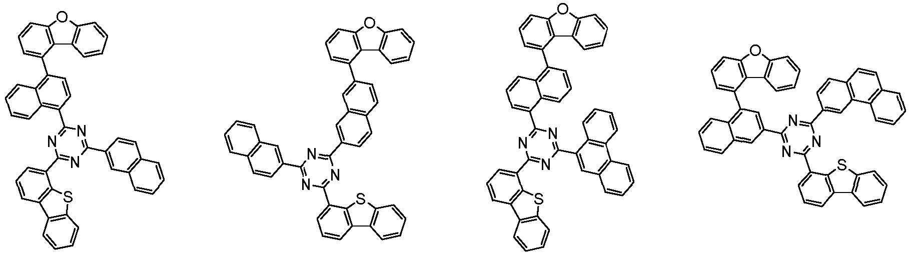

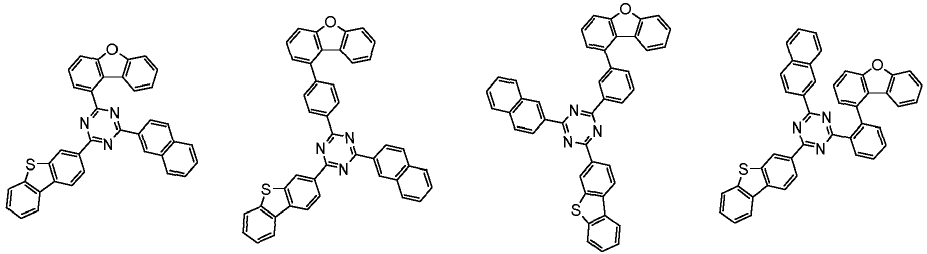

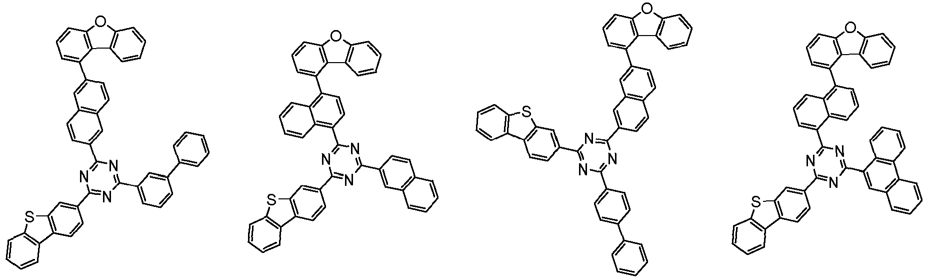

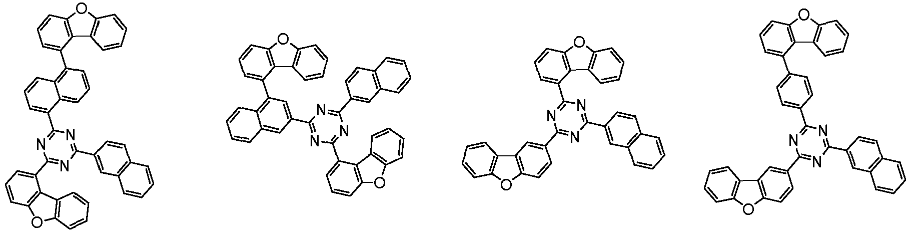

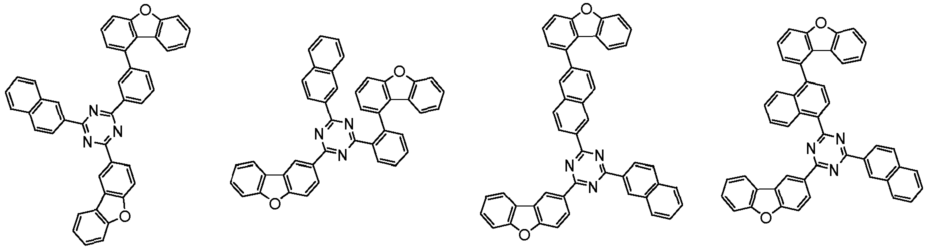

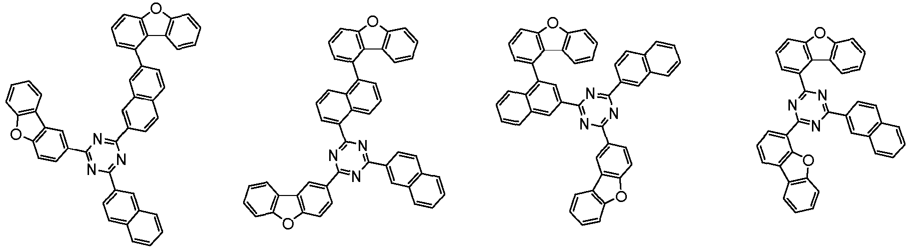

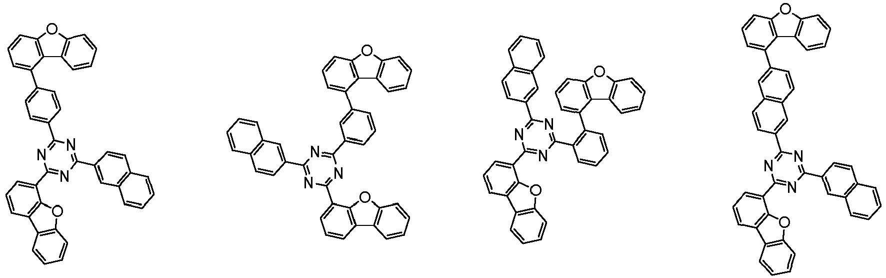

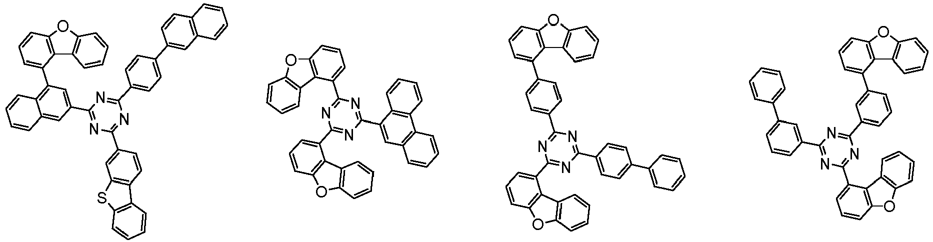

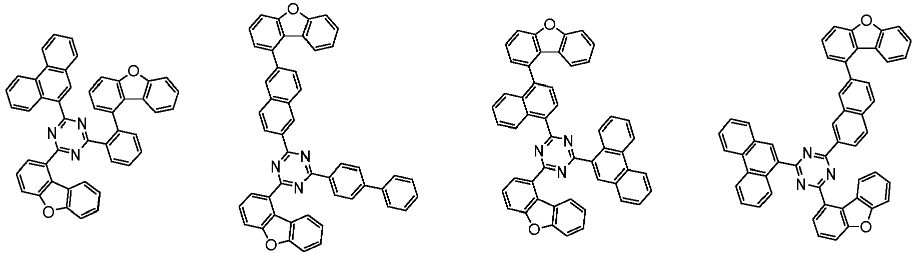

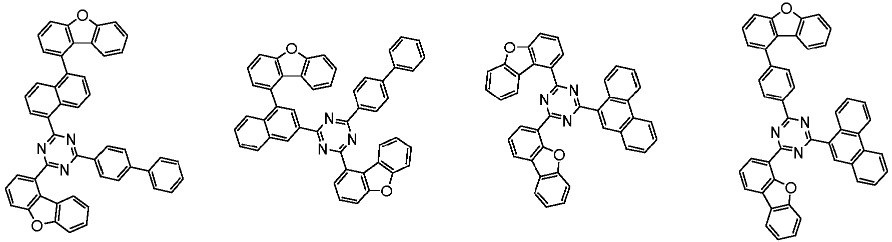

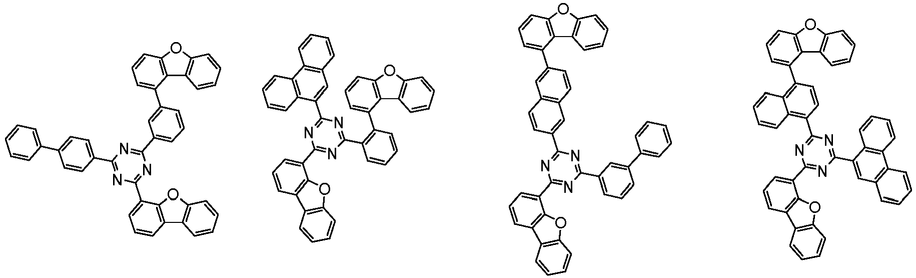

In addition, there is provided a method for preparing a compound represented by the Chemical Formula 1.

For example, the compound represented by the Chemical Formula 1 may be prepared by a preparation method as in Reaction Scheme 1 below.

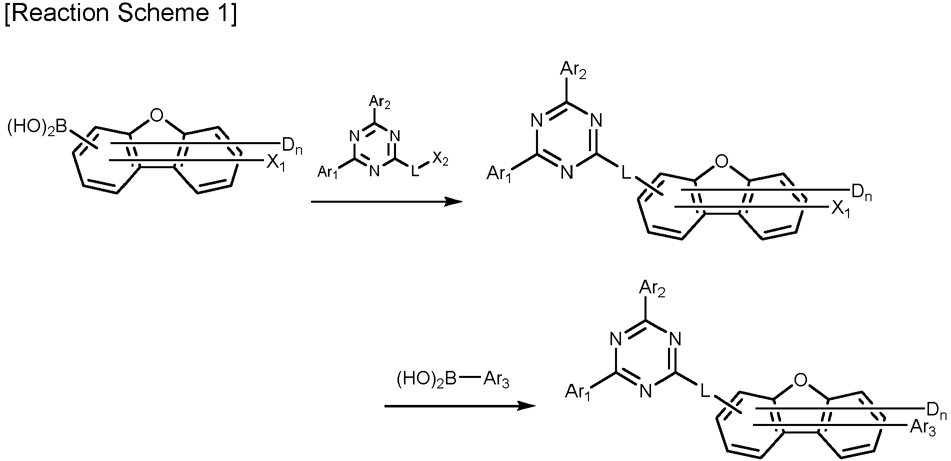

In the Reaction Scheme 1, definitions of other substituents except for X₁ and X₂ are the same as defined in the above, and X₁ and X₂ are each independently halogen, preferably bromo or chloro.

The Reaction Scheme 1 is a Suzuki coupling reaction, and preferably performed in the presence of a palladium catalyst and a base. In addition, the reactive group for the Suzuki coupling reaction may be appropriately changed as known in the art.

The preparation method of the compound represented by the Chemical Formula 1 may be more specifically described in Synthesis example 1 described below.

The Chemical Formula 2 has a structure including a core in which a benzoxazole ring is fused to a benzofuran ring, and an arylamine substituent bonded thereto.

Specifically, the Chemical Formula 2 may be represented by any one selected from the group consisting of the following Chemical Formulae 2-1 to 2-4: 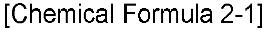 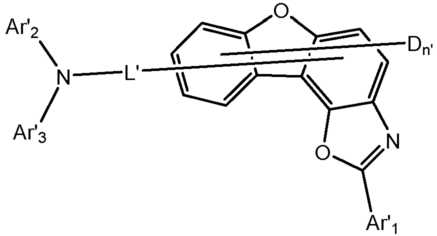 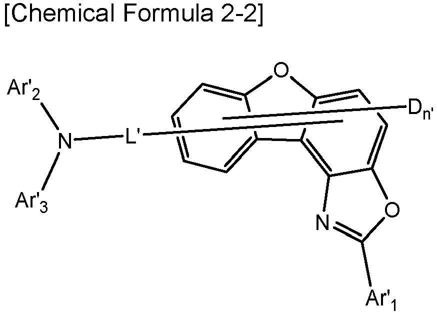 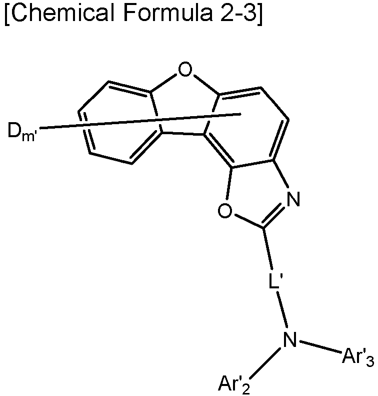 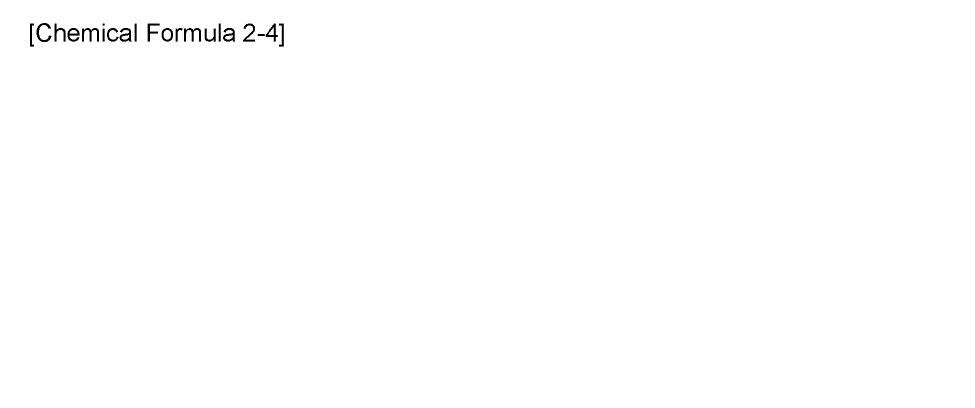 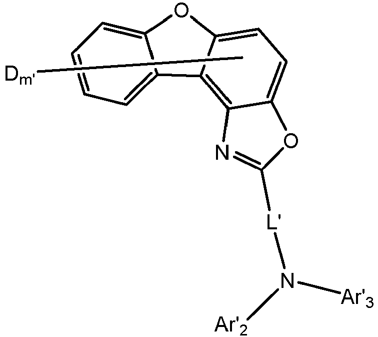 in the Chemical Formulae 2-1 to 2-4,
L', Ar'₁ to Ar'₃, D, and n' are as defined in Chemical Formula 2, and m' is an integer of 0 to 6.

Preferably, L' is a single bond; or substituted or unsubstituted C₆₋₂₀ arylene. Preferably, L' is a single bond; phenylene; or biphenyldiyl.

Ar'₁ is preferably substituted or unsubstituted C₆₋₂₀ aryl, and more preferably phenyl.

Preferably, Ar'₂ and Ar'₃ are each independently substituted or unsubstituted C₆₋₂₀ aryl; or substituted or unsubstituted C₂₋₂₀ heteroaryl containing at least one heteroatom selected from the group consisting of N, O and S.

More preferably, Ar'₂ and Ar'₃ are each independently phenyl; biphenylyl; terphenylyl; naphthyl; (naphthyl)phenyl; (phenyl)naphthyl; (naphthyl)biphenylyl; (naphthyl)naphthyl; [(phenyl)naphthyl]phenyl; dibenzofuranyl; dibenzothiophenyl; (dibenzofuranyl)phenyl; (dibenzothiophenyl)phenyl; phenanthrenyl; (phenanthrenyl)phenyl; 9,9-dimethylfluorenyl; or 9-phenylcarbazolyl.

In the above, (naphthyl)phenyl means phenyl substituted with one naphthyl; (phenyl)naphthyl means naphthyl substituted with one phenyl; (naphthyl)biphenylyl means biphenylyl substituted with one naphthyl; (naphthyl)naphthyl means naphthyl substituted with one naphthyl; [(phenyl)naphthyl]phenyl means phenyl substituted with (phenyl)naphthyl; (dibenzofuranyl)phenyl means phenyl substituted with one dibenzofuranyl; and (dibenzothiophenyl)phenyl means phenyl substituted with one dibenzothiophenyl.

In one embodiment, L' is a single bond; phenylene; or biphenyldiyl, and Ar'₁ is phenyl.

In one embodiment, L' is a single bond; phenylene; or biphenyldiyl, and Ar'₂ and Ar'₃ are each independently phenyl; biphenylyl; terphenylyl; naphthyl; (naphthyl)phenyl; (phenyl)naphthyl; (naphthyl)biphenylyl; (naphthyl)naphthyl; [(phenyl)naphthyl]phenyl; dibenzofuranyl; dibenzothiophenyl; (dibenzofuranyl)phenyl; (dibenzothiophenyl)phenyl; phenanthrenyl; (phenanthrenyl)phenyl; 9,9-dimethylfluorenyl; or 9-phenylcarbazolyl.

In one embodiment, L' is a single bond; phenylene; or biphenyldiyl, Ar'₁ is phenyl, and Ar'₂ and Ar'₃ are each independently phenyl; biphenylyl; terphenylyl; naphthyl; (naphthyl)phenyl; (phenyl)naphthyl; (naphthyl)biphenylyl; (naphthyl)naphthyl; [(phenyl)naphthyl]phenyl; dibenzofuranyl; dibenzothiophenyl; (dibenzofuranyl)phenyl; (dibenzothiophenyl)phenyl; phenanthrenyl; (phenanthrenyl)phenyl; 9,9-dimethylfluorenyl; or 9-phenylcarbazolyl.

Representative examples of the compound represented by the Chemical Formula 2 are as follows:

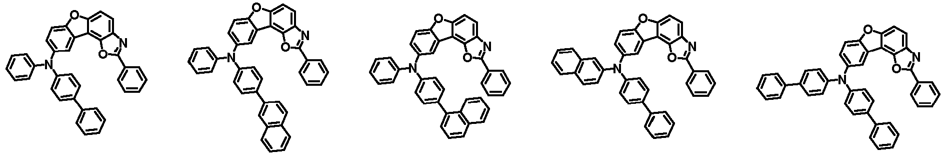

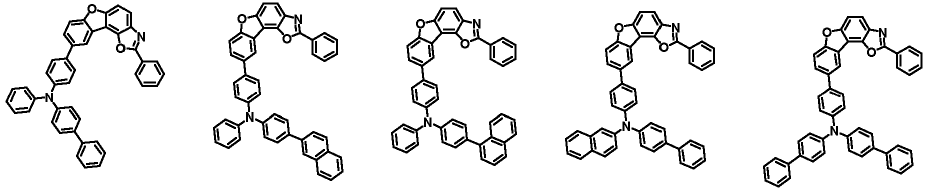

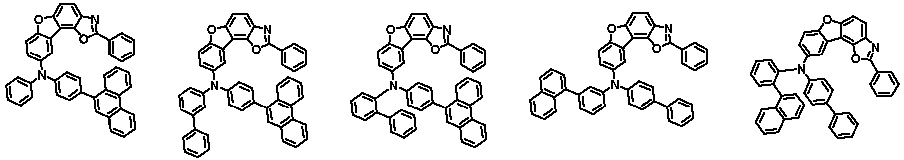

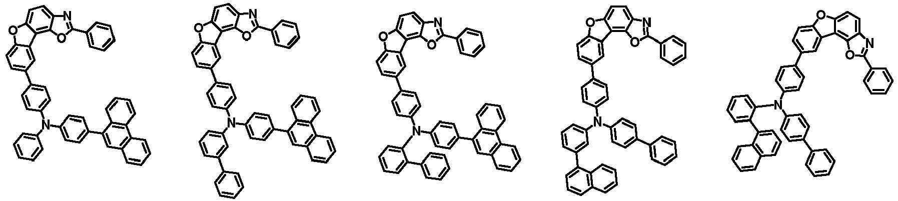

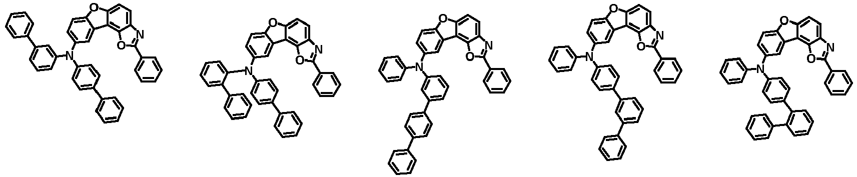

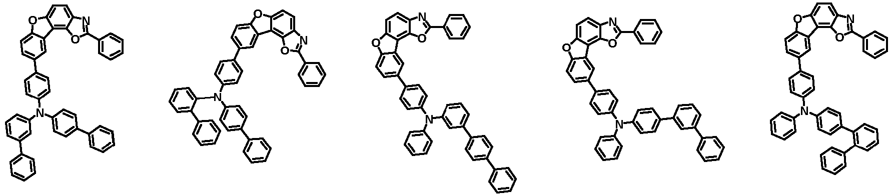

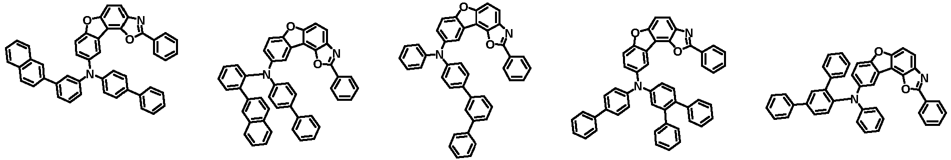

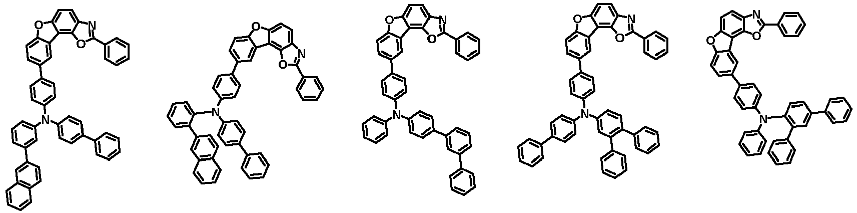

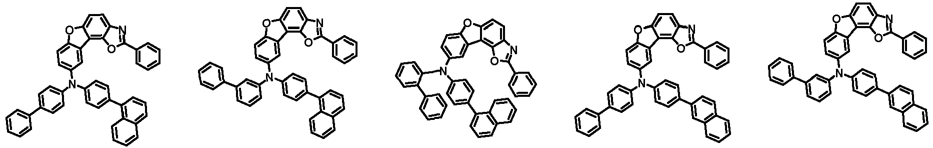

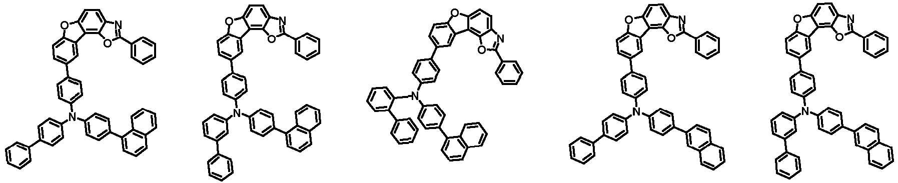

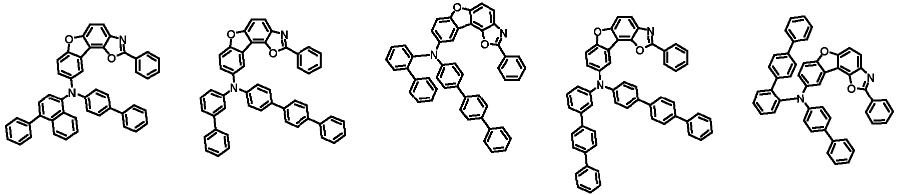

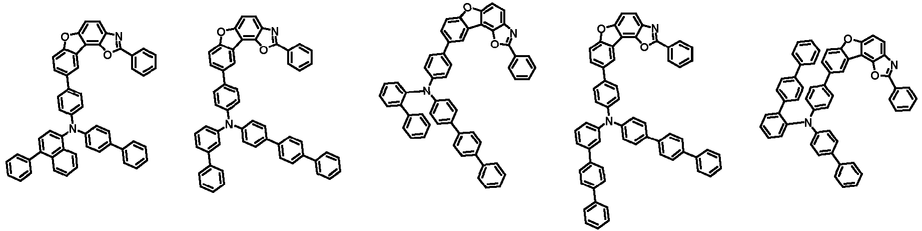

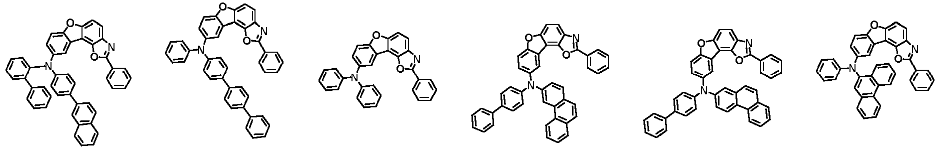

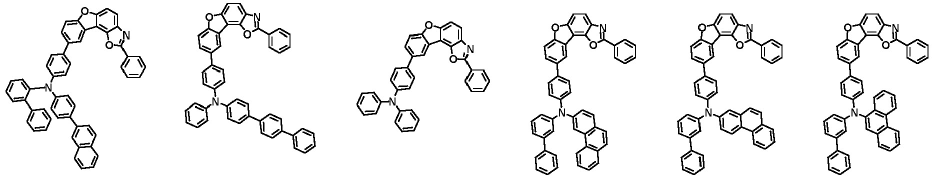

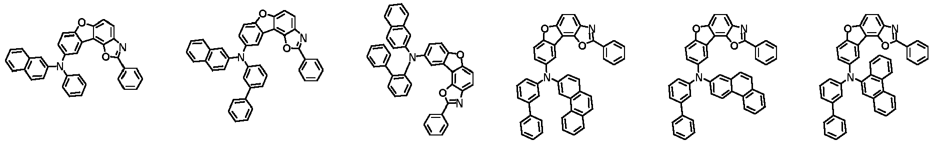

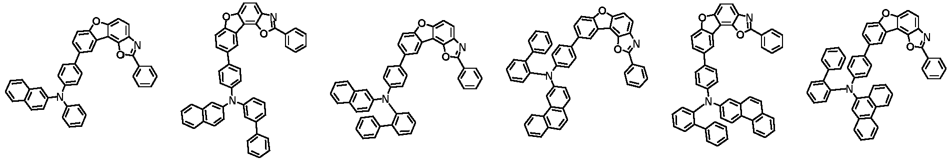

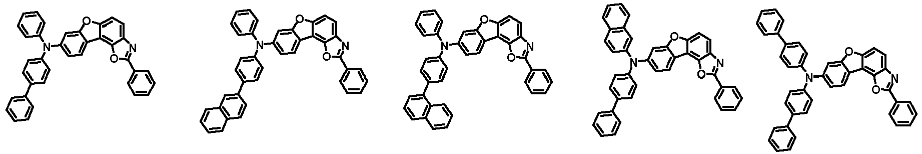

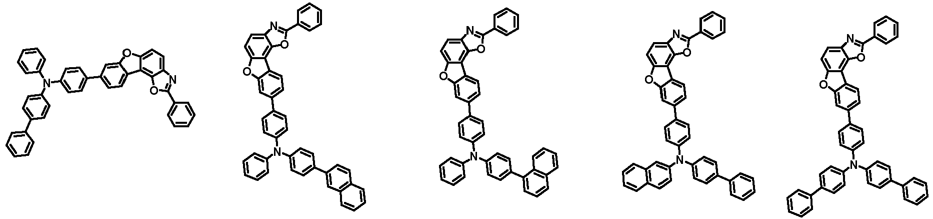

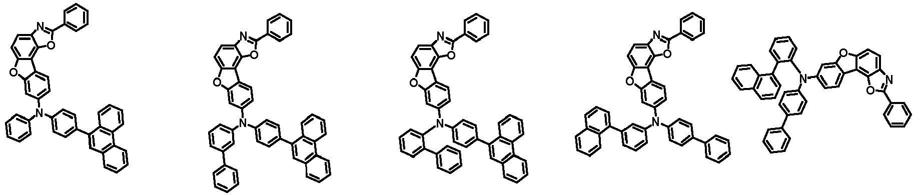

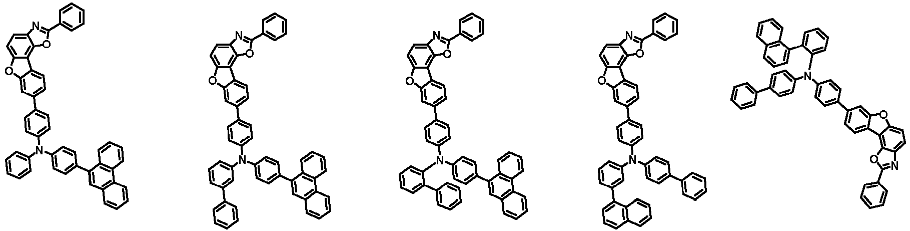

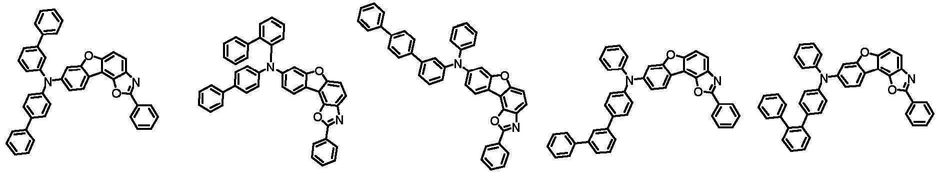

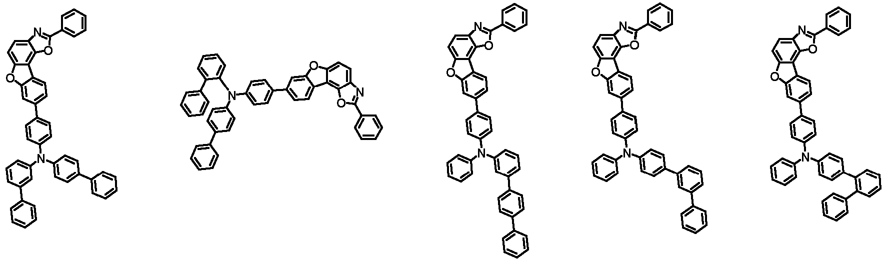

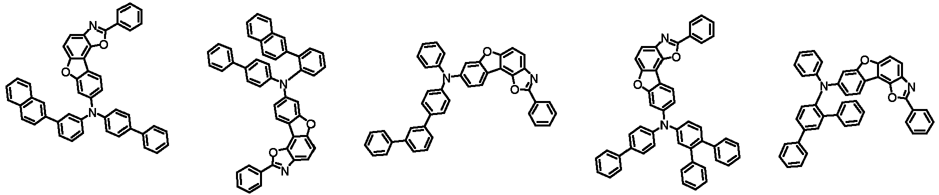

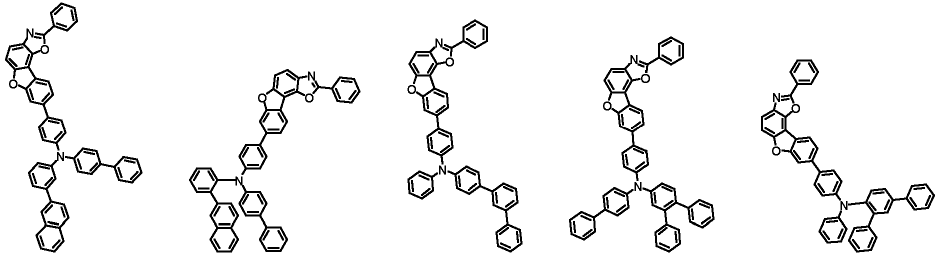

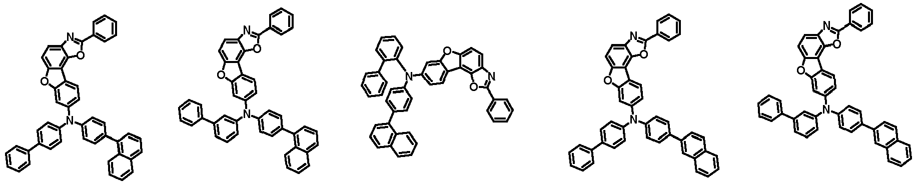

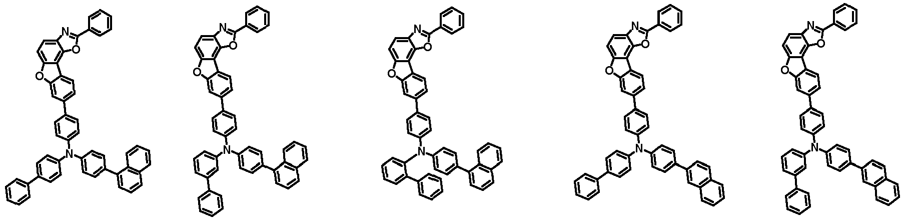

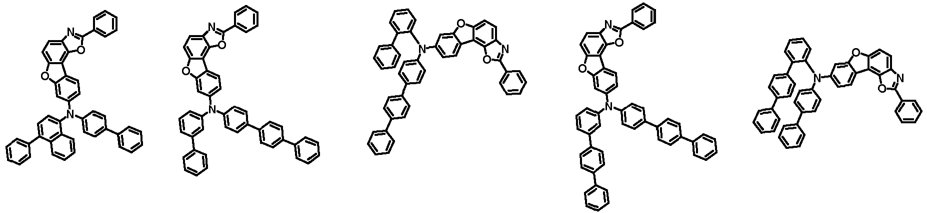

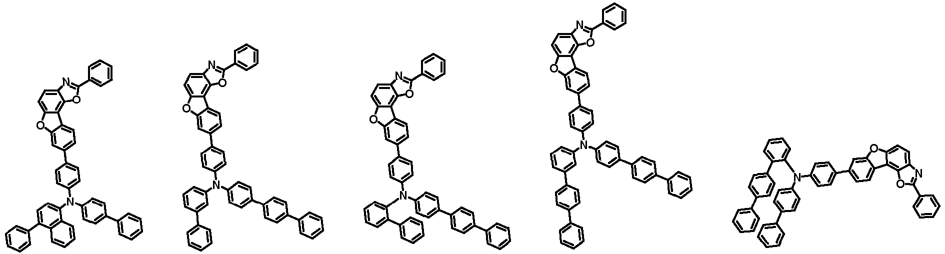

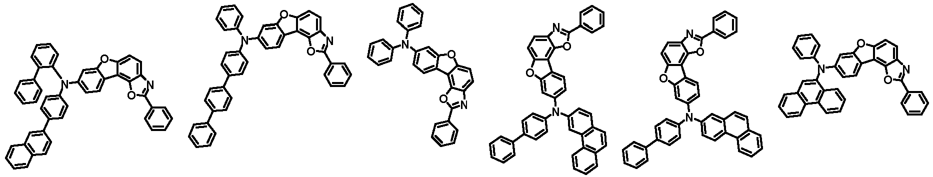

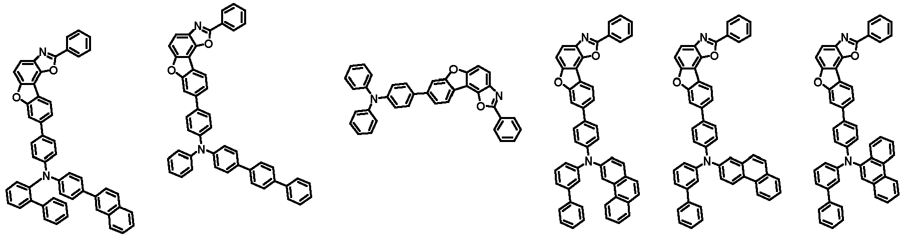

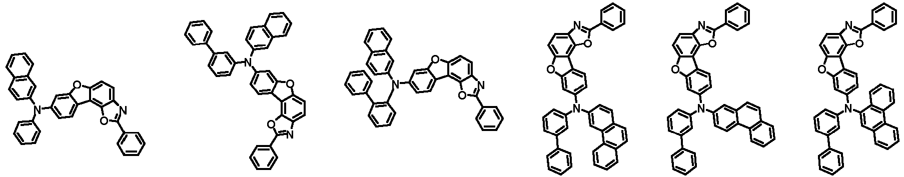

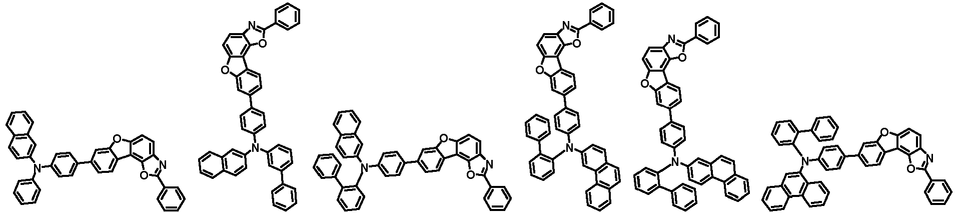

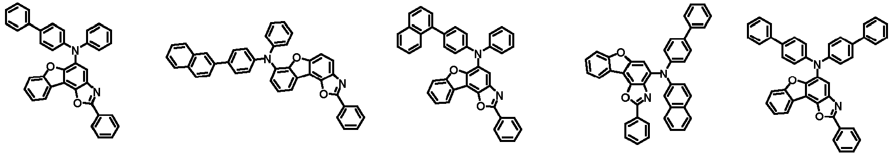

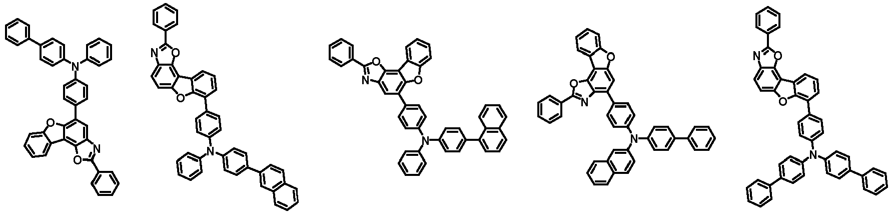

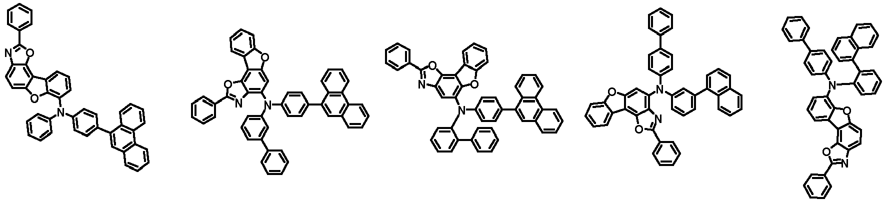

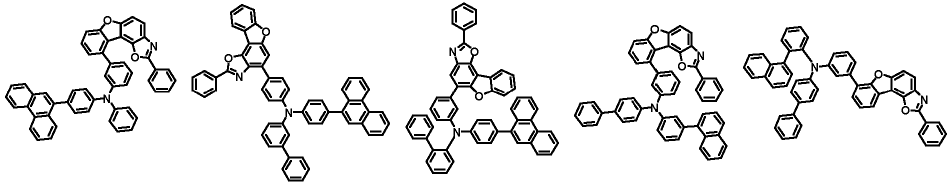

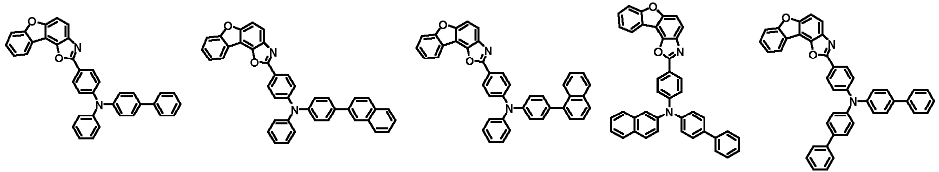

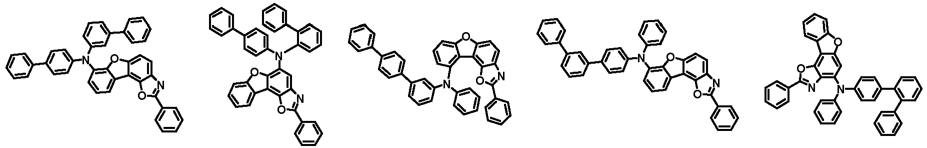

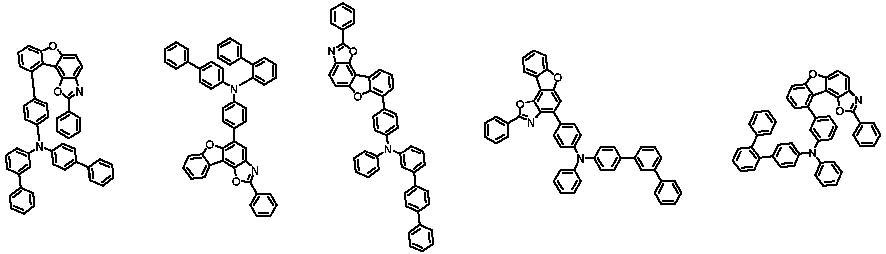

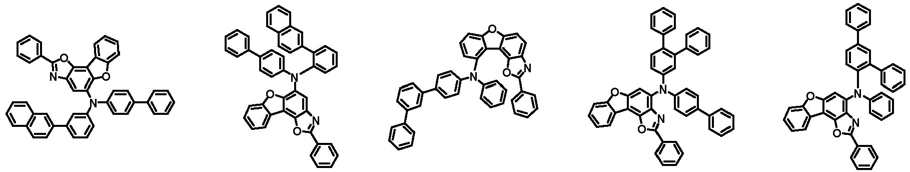

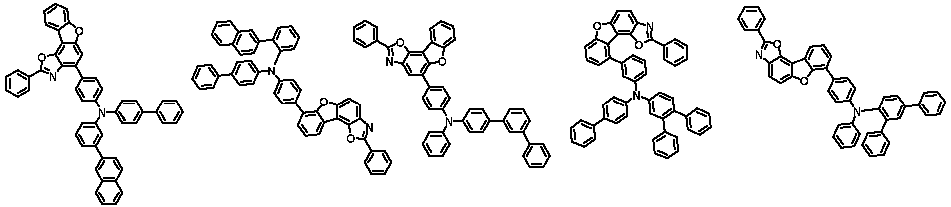

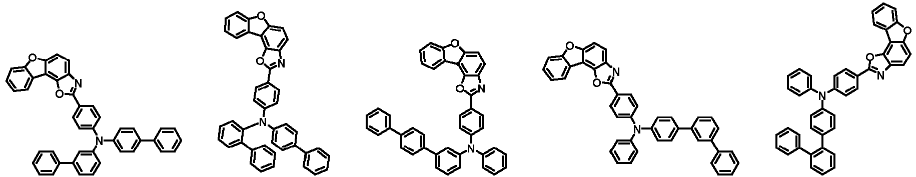

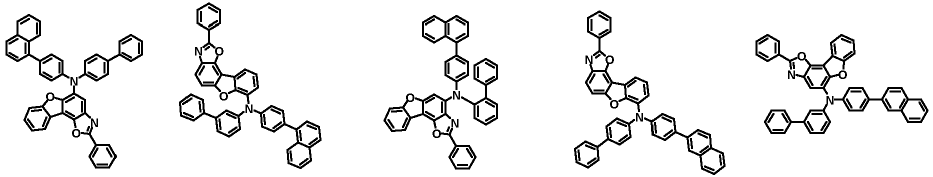

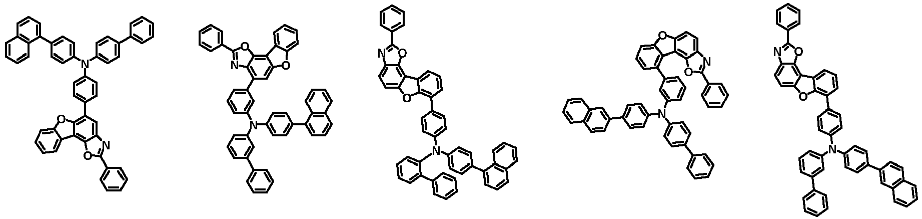

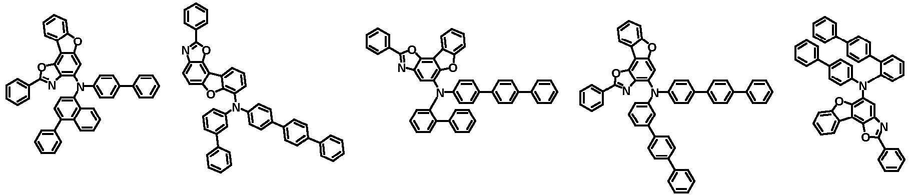

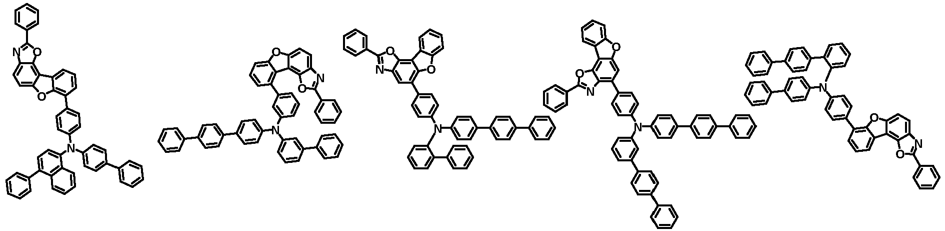

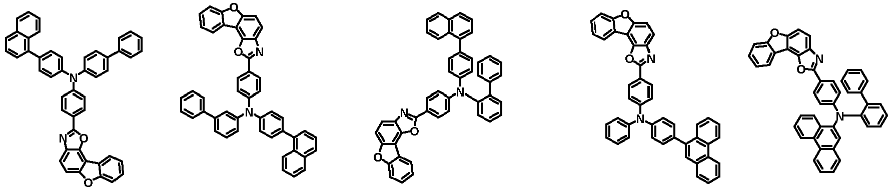

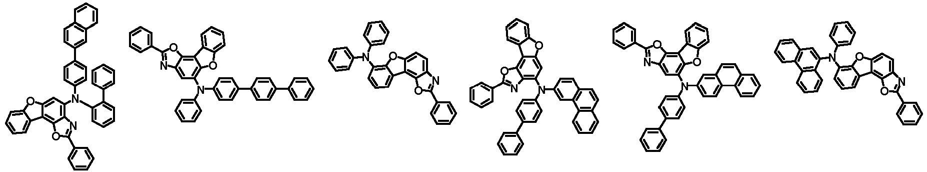

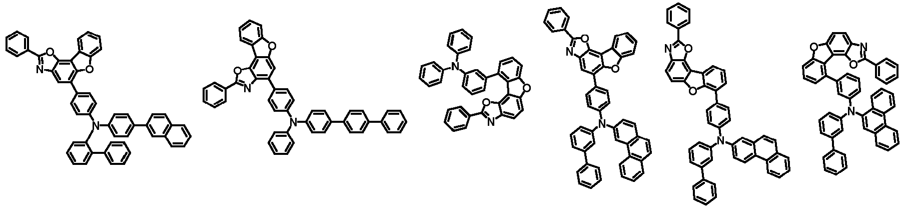

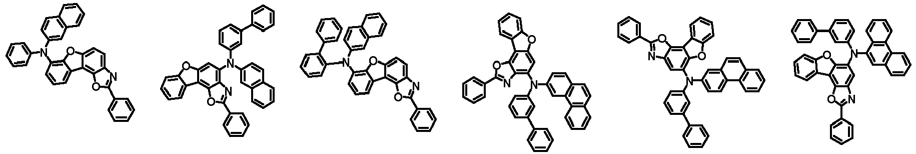

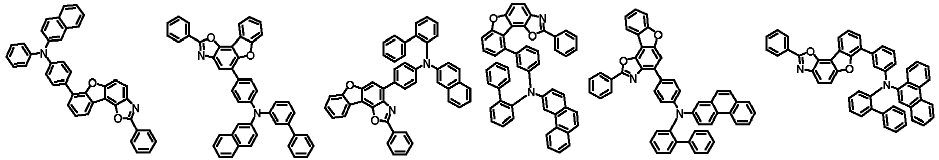

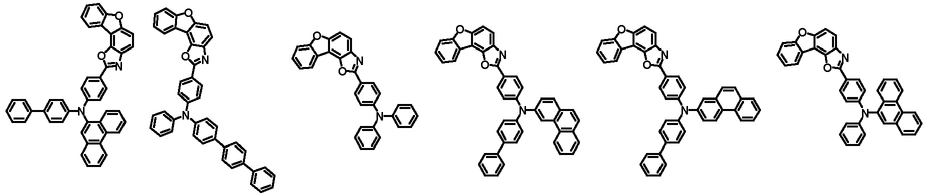

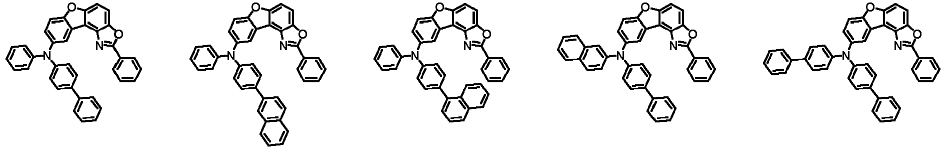

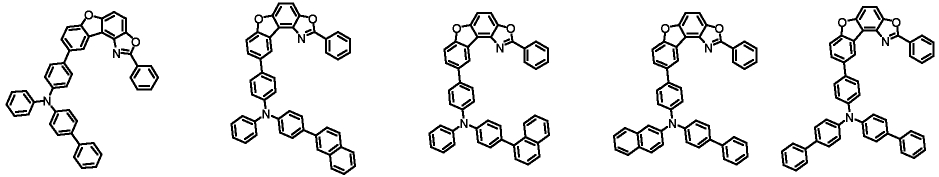

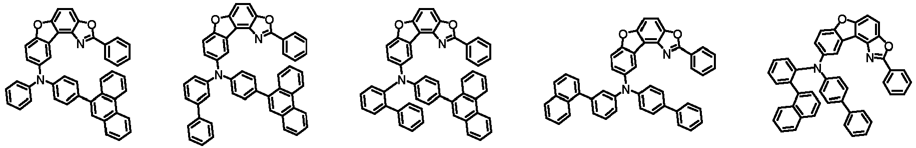

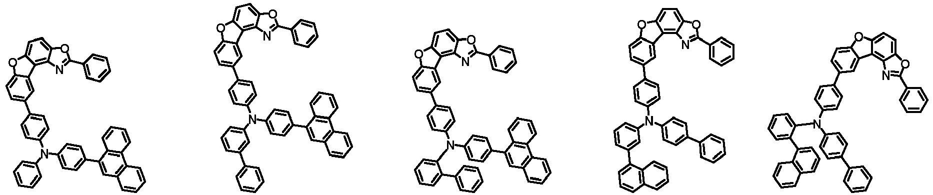

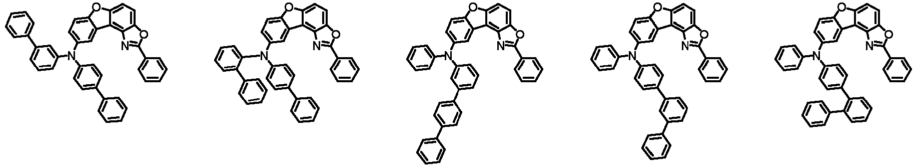

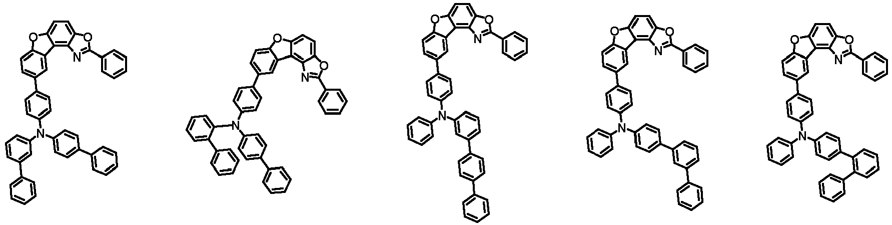

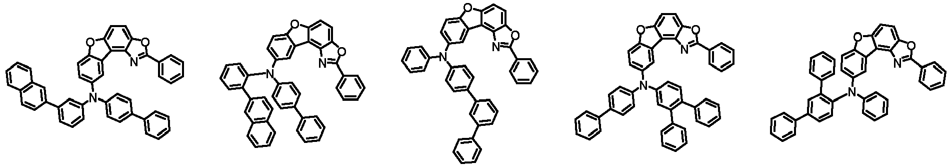

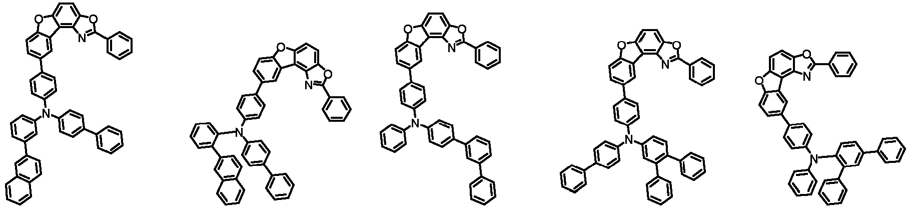

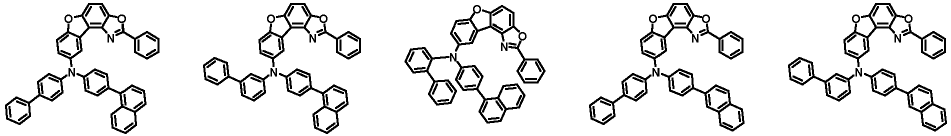

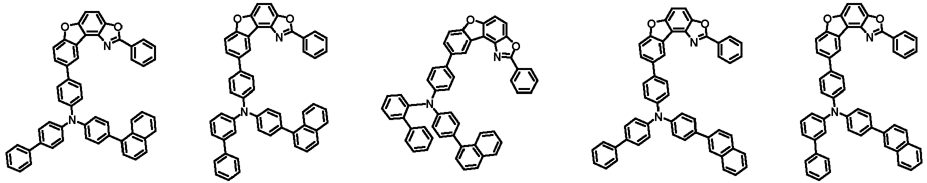

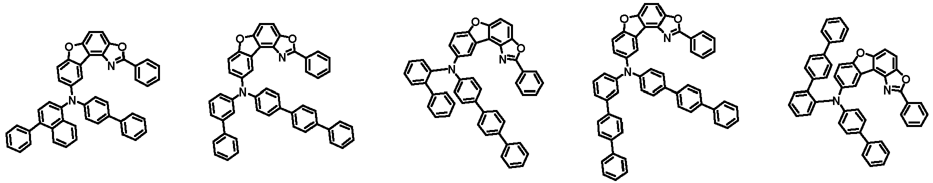

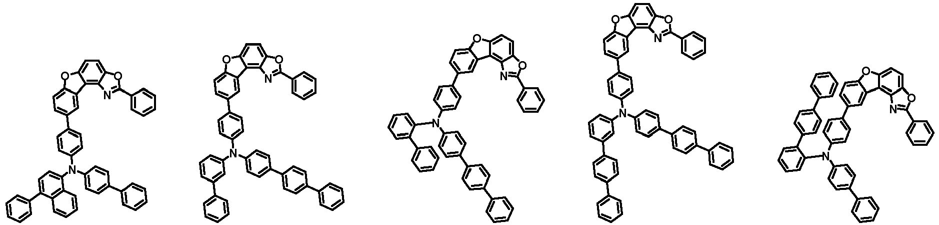

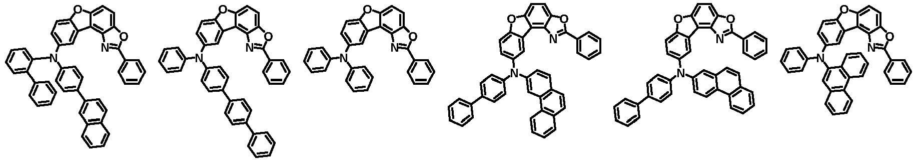

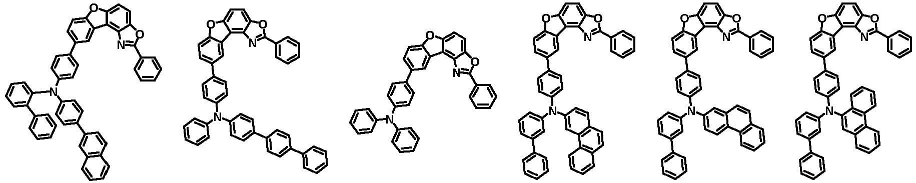

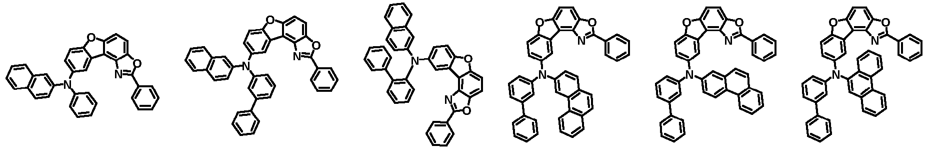

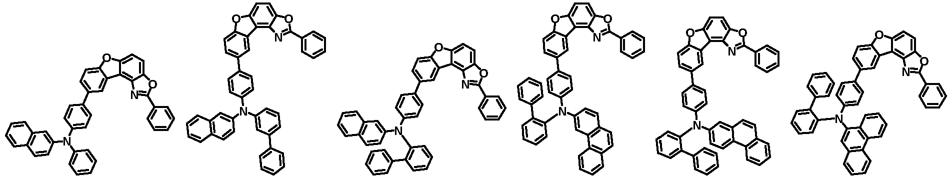

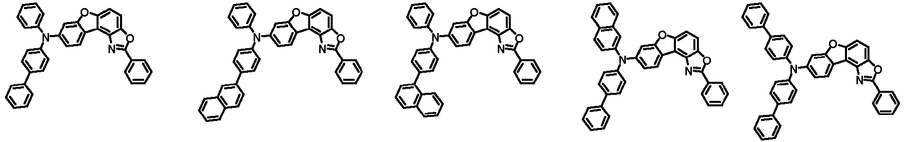

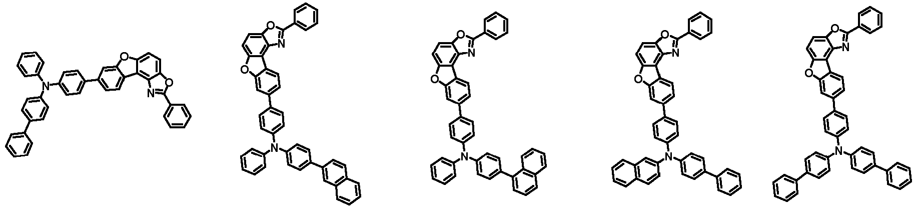

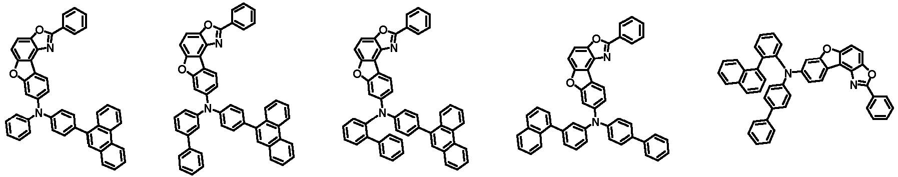

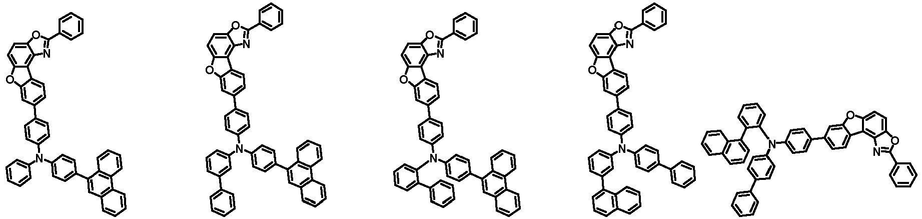

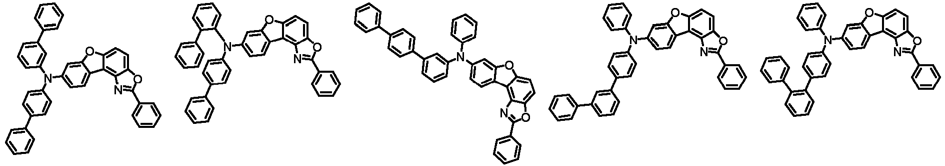

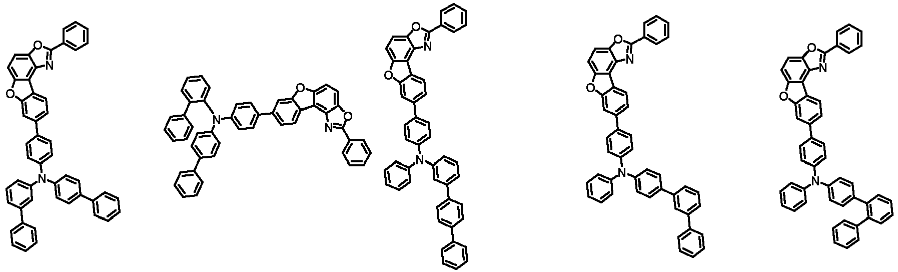

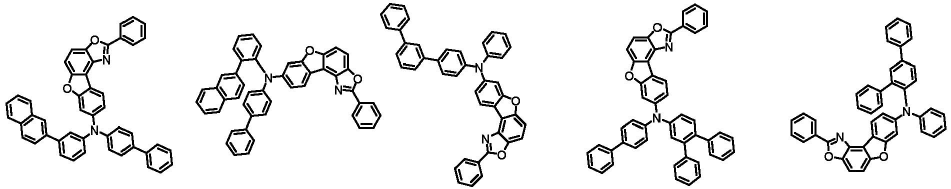

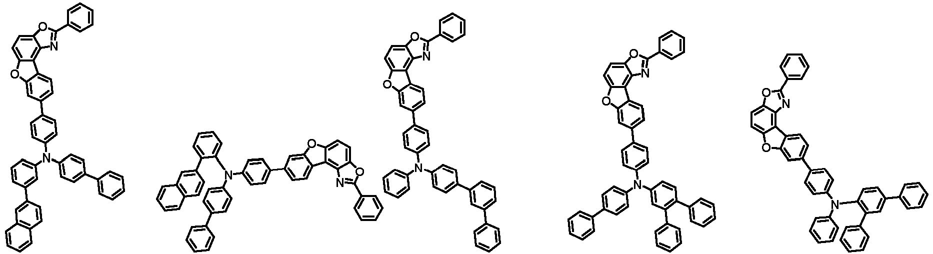

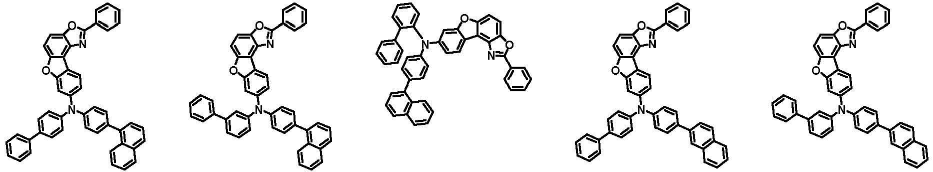

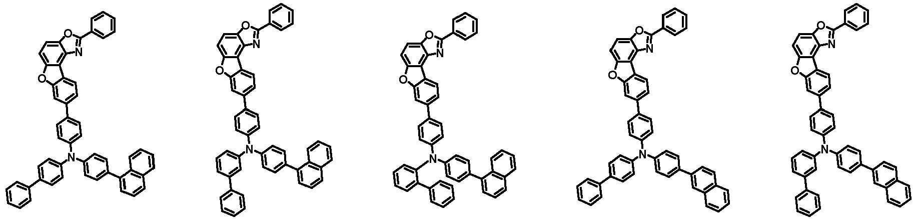

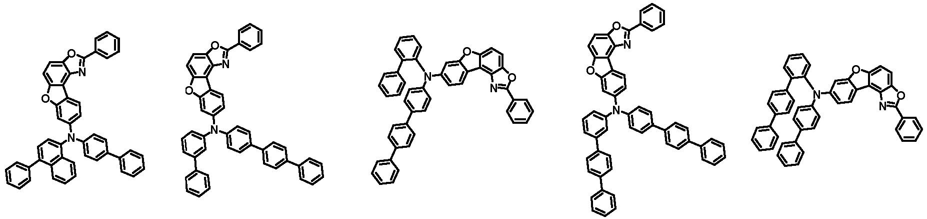

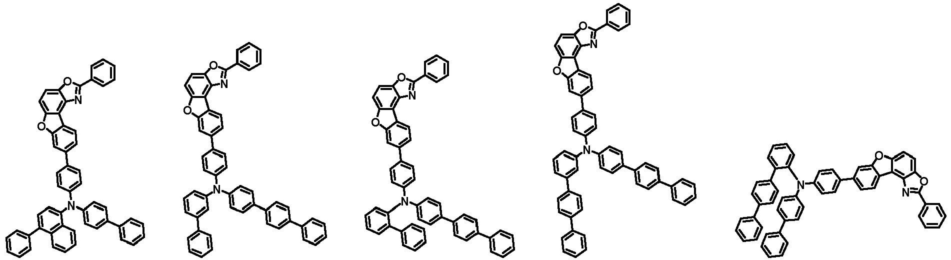

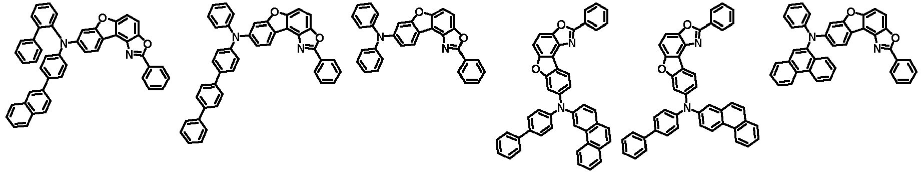

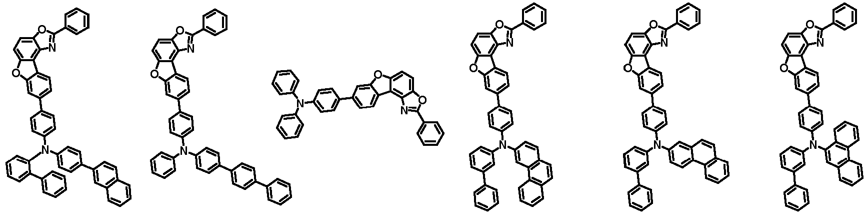

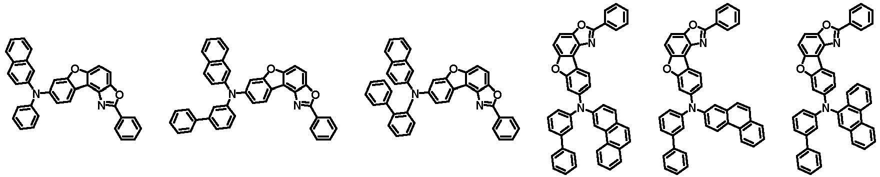

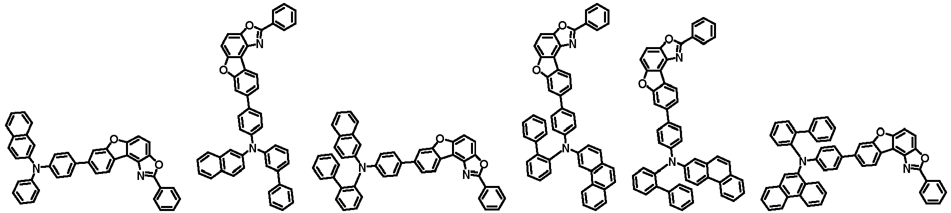

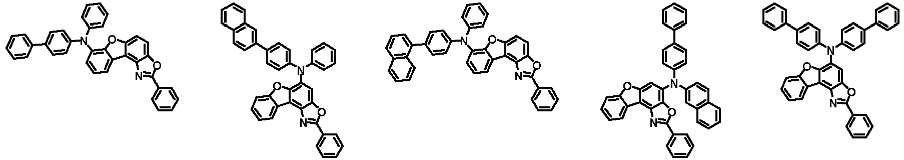

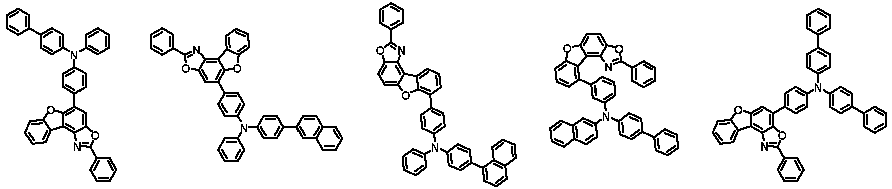

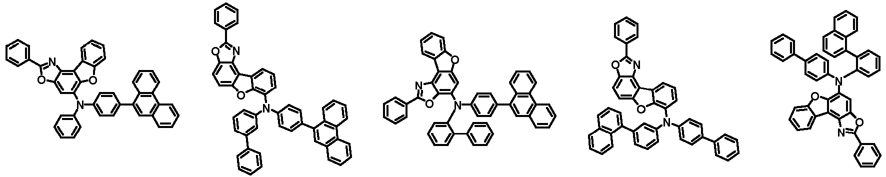

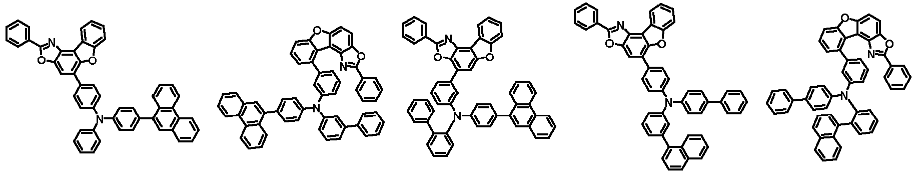

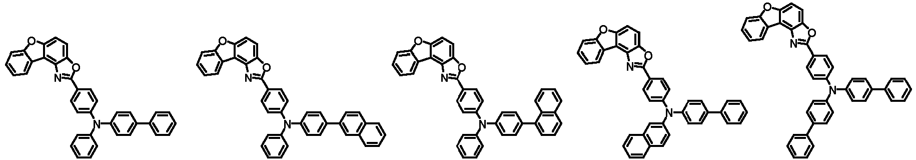

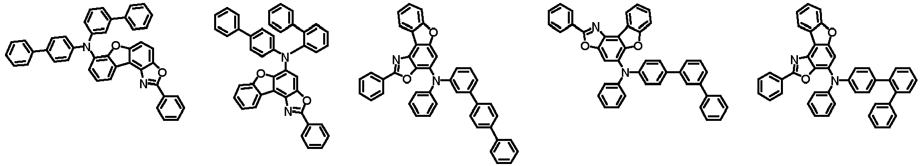

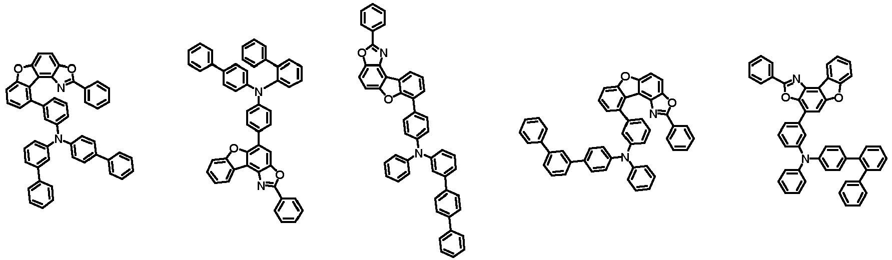

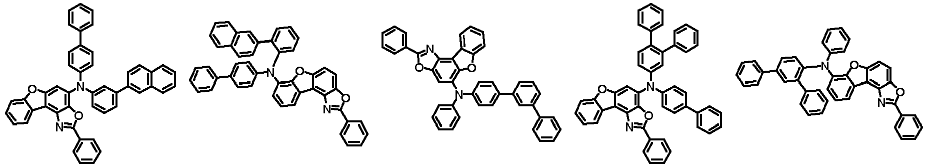

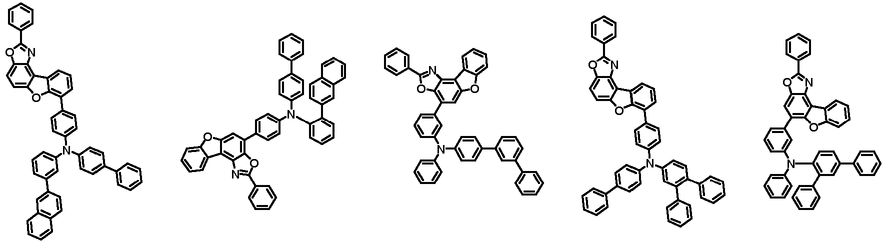

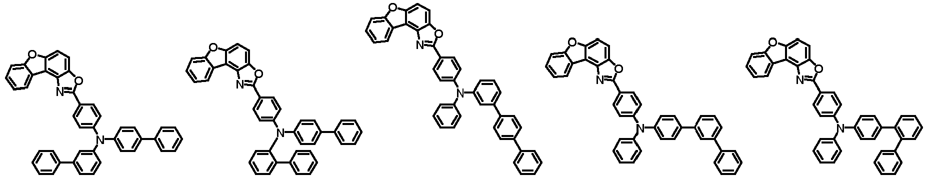

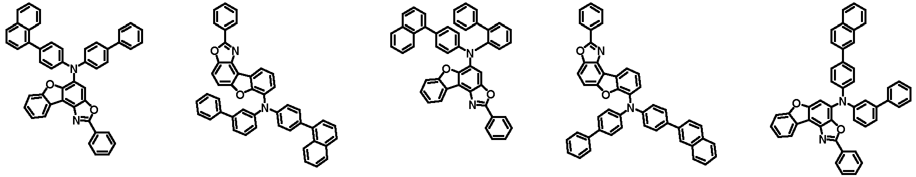

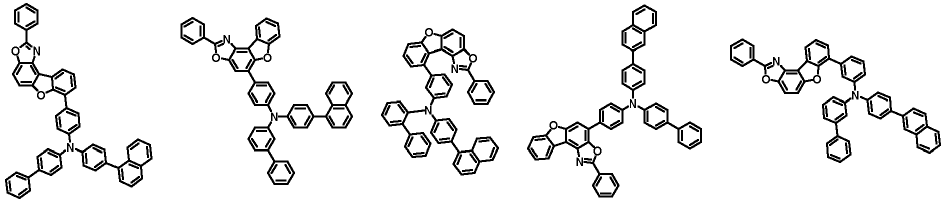

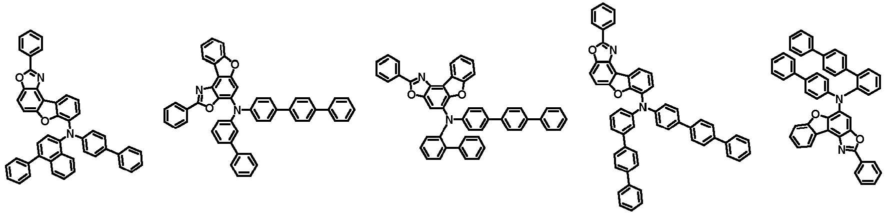

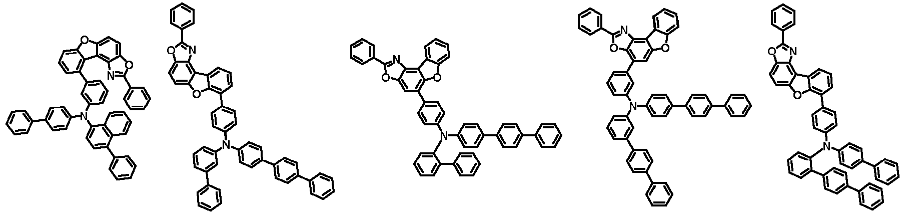

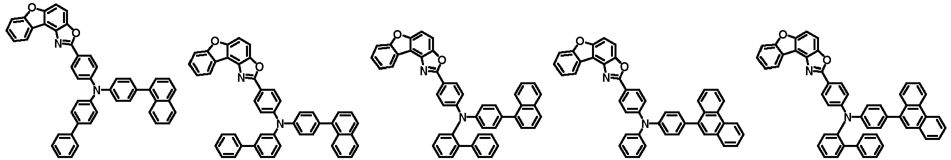

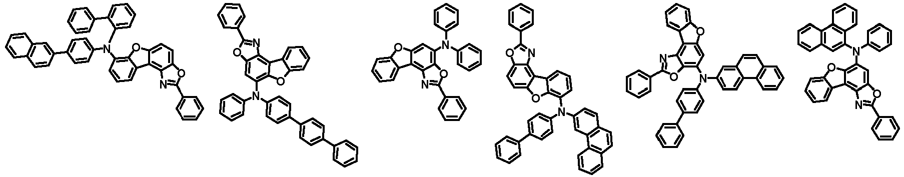

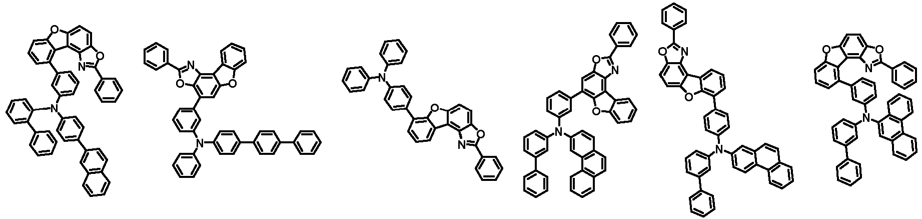

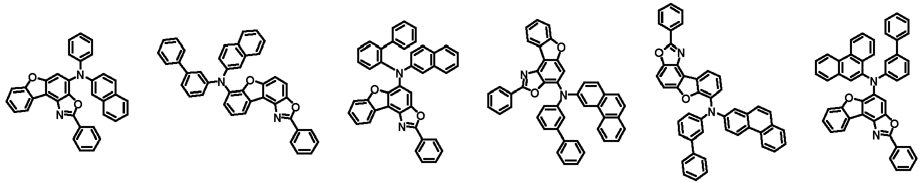

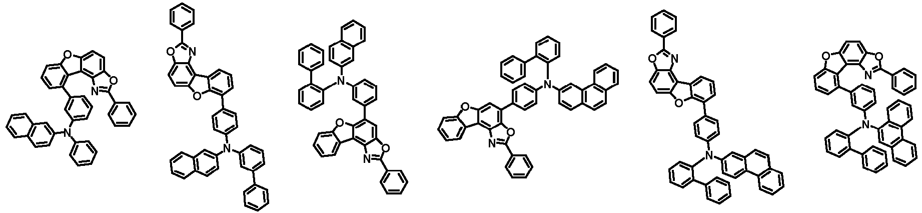

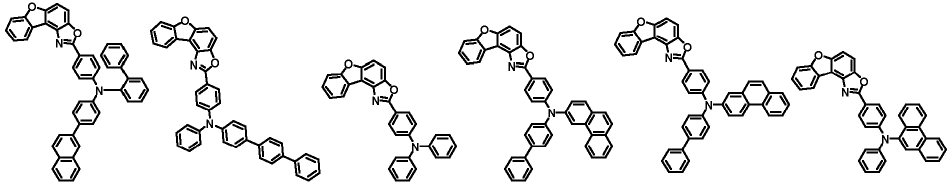

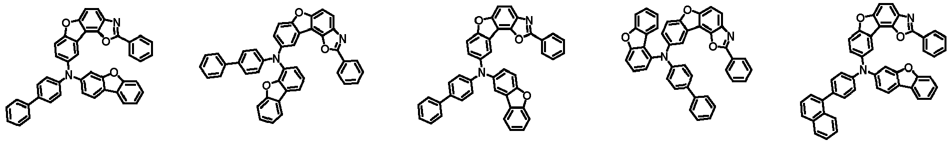

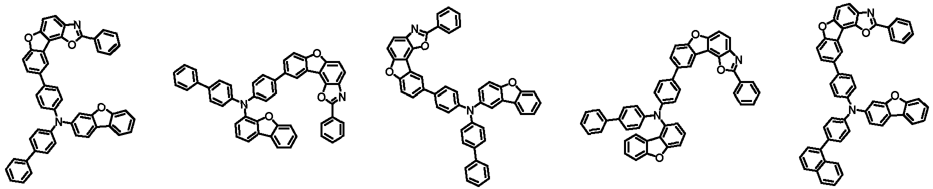

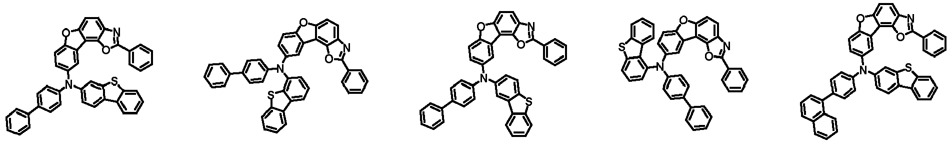

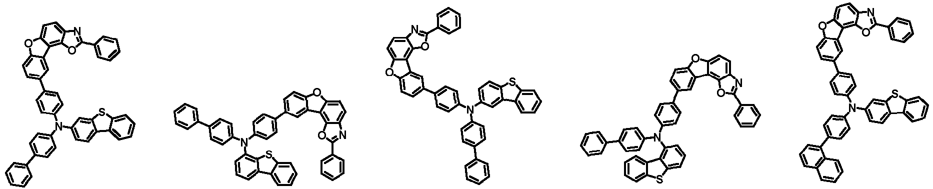

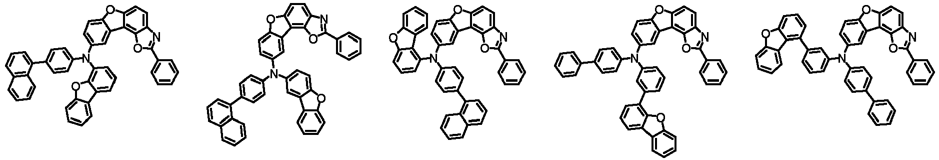

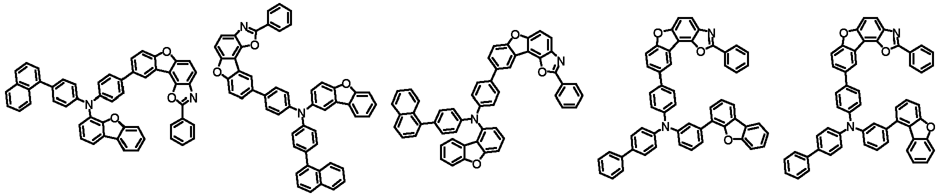

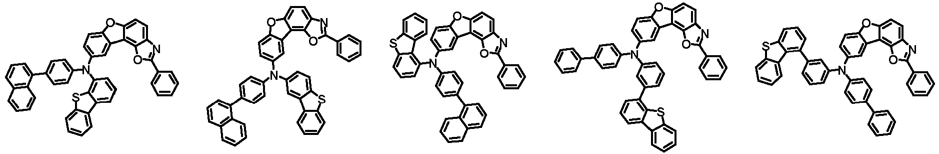

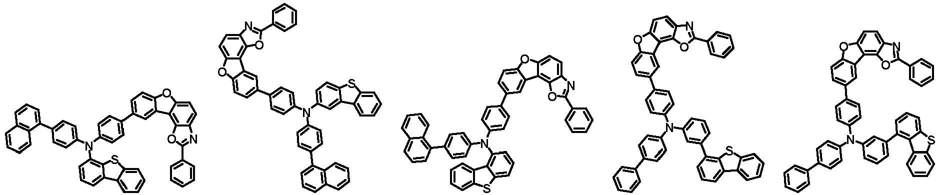

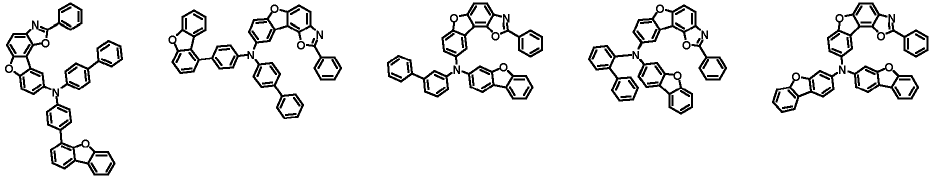

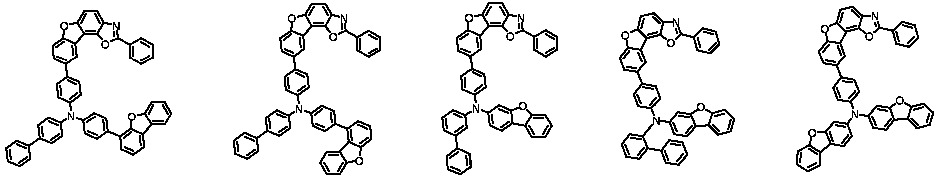

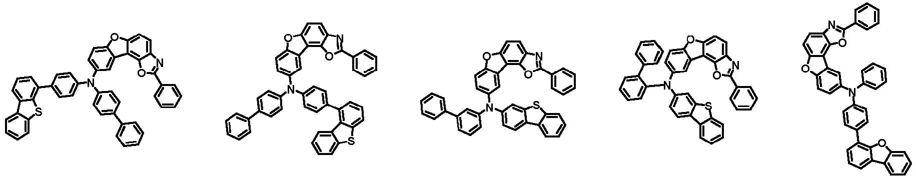

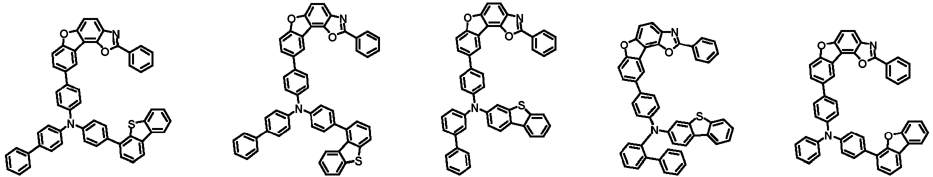

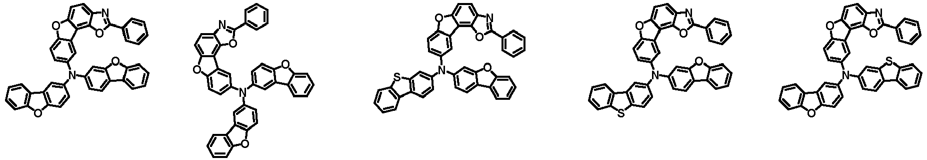

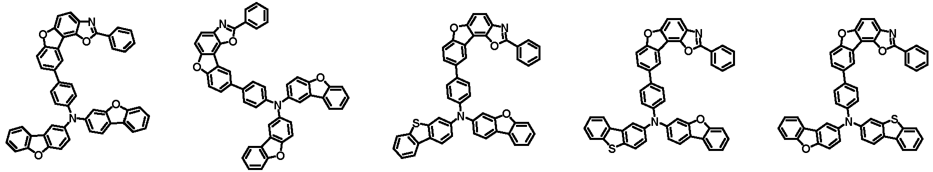

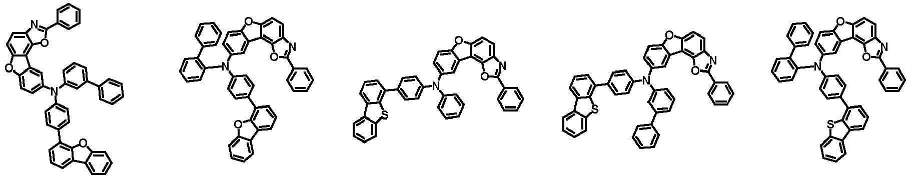

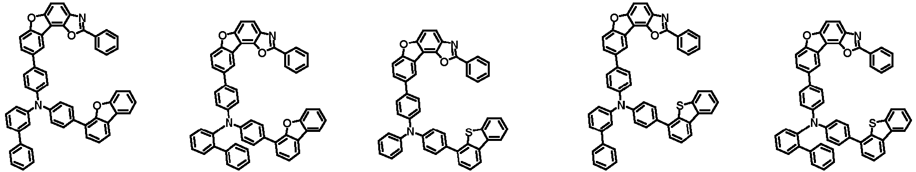

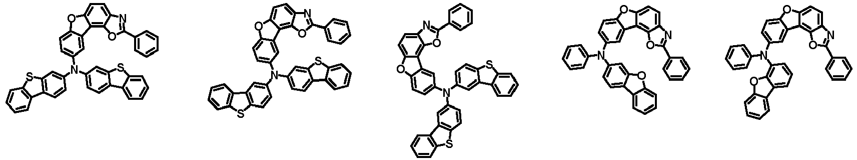

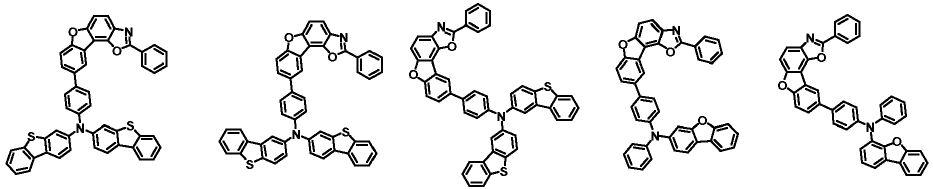

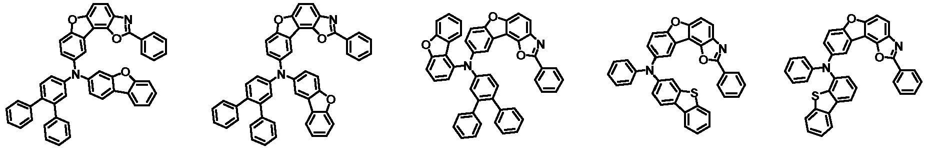

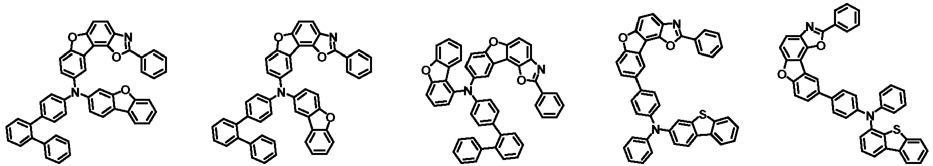

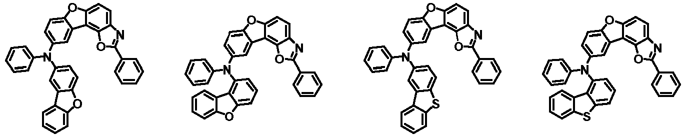

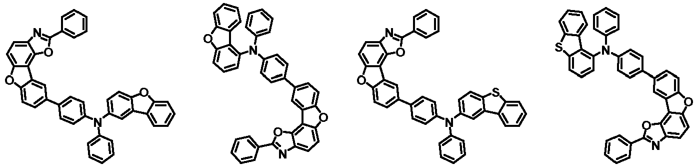

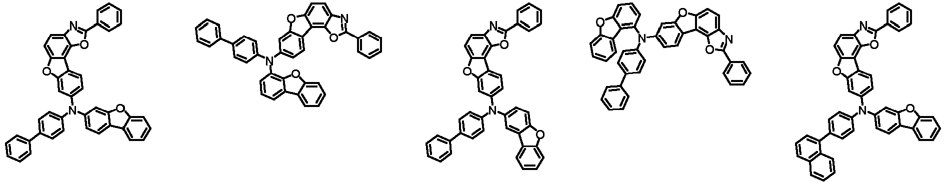

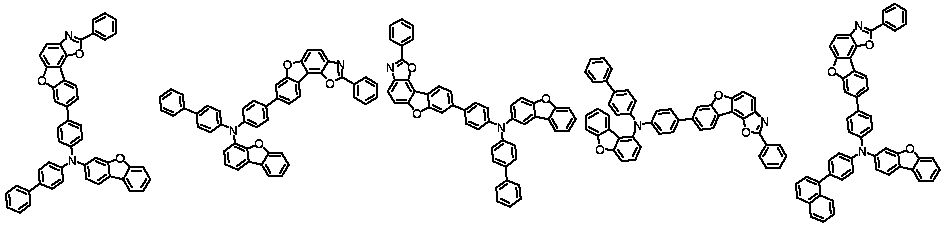

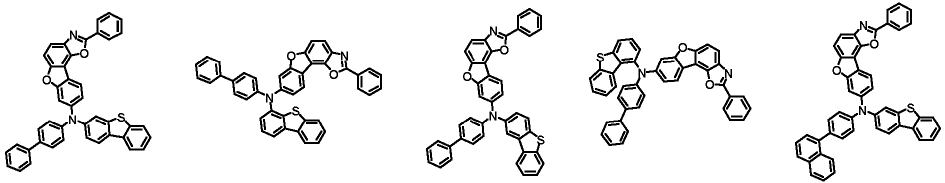

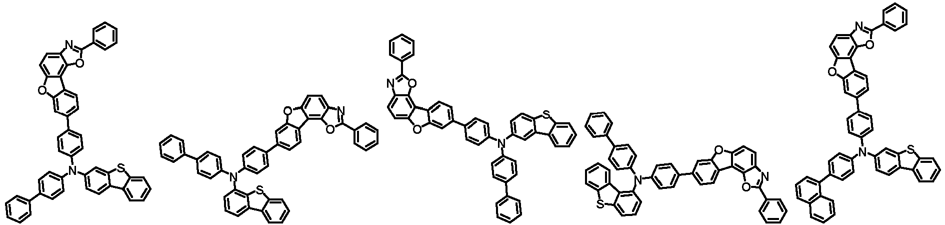

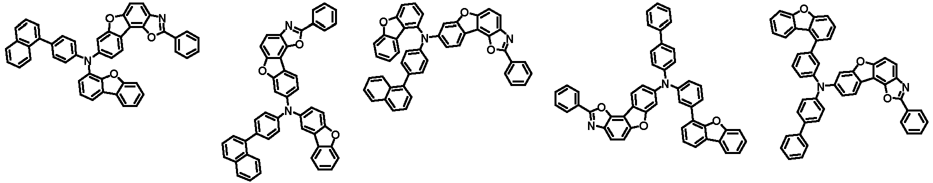

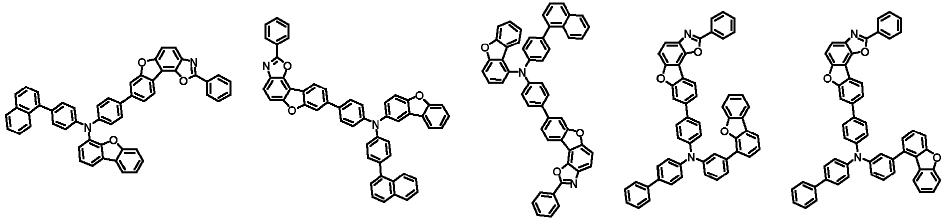

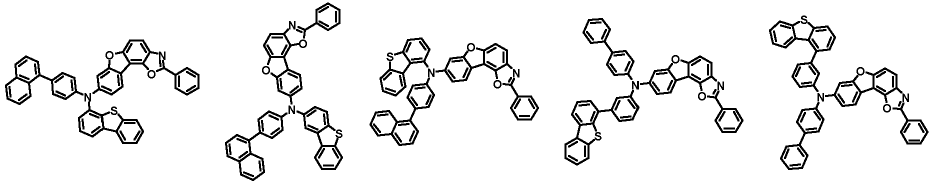

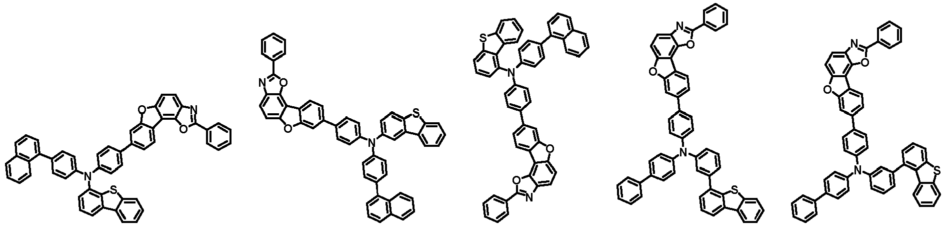

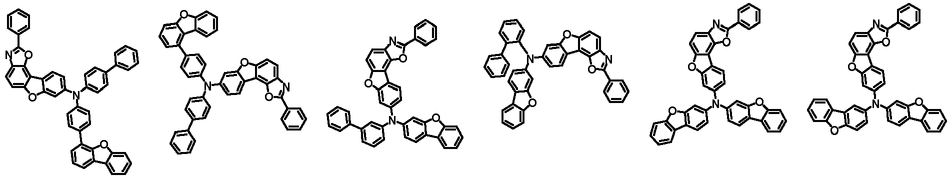

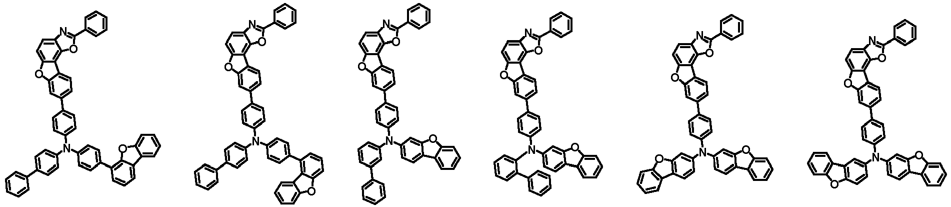

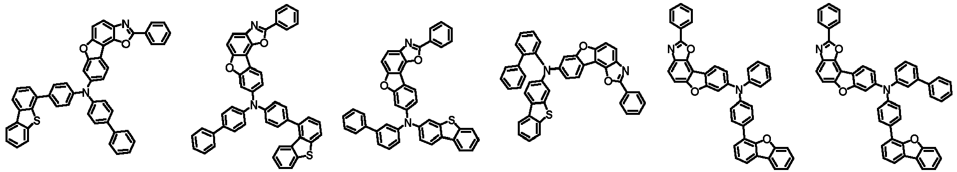

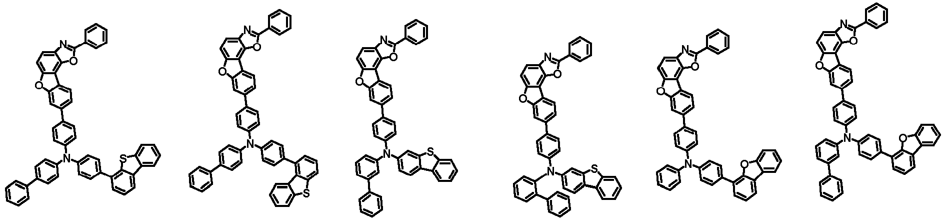

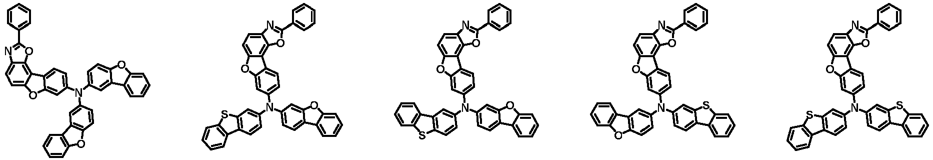

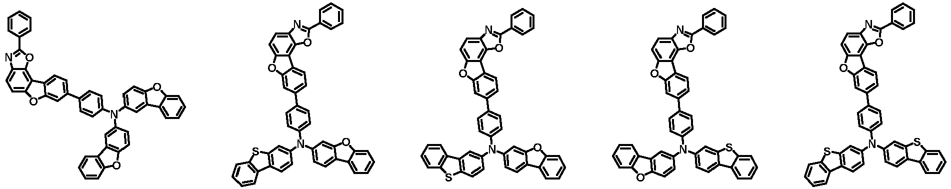

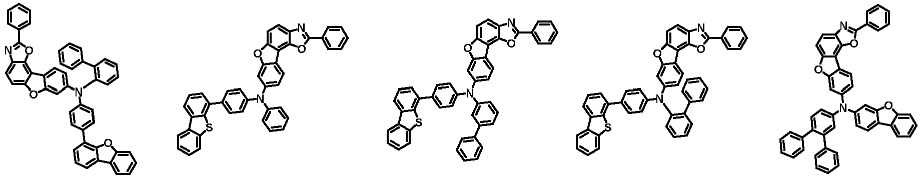

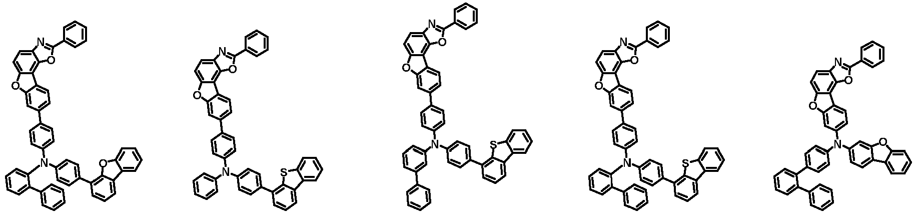

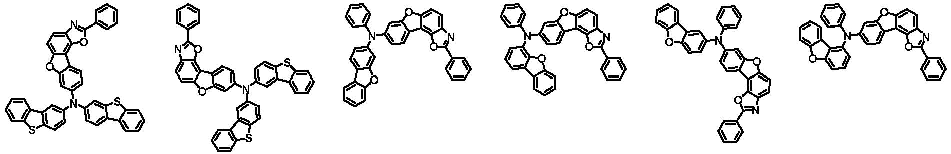

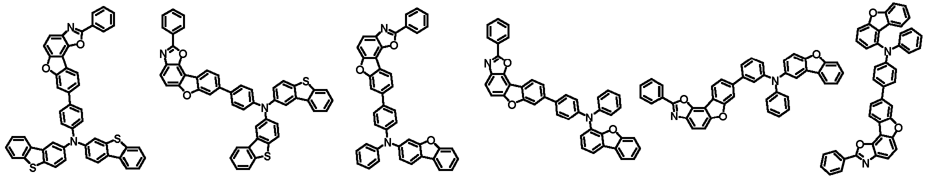

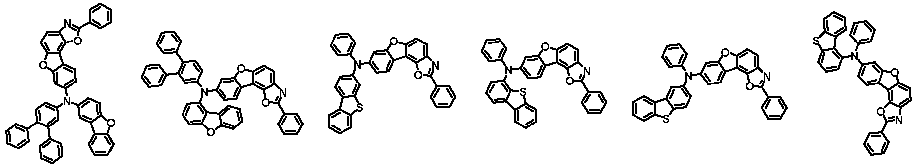

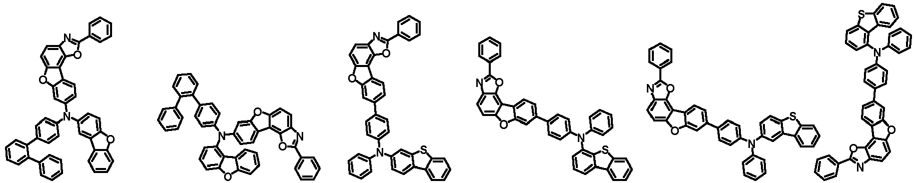

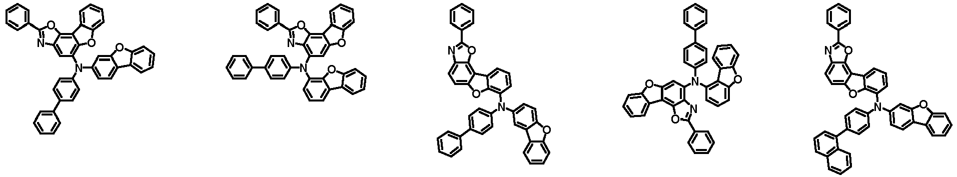

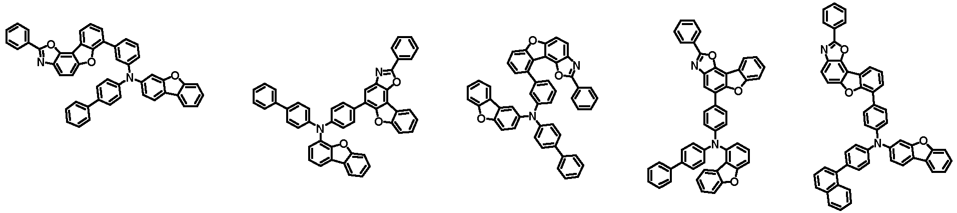

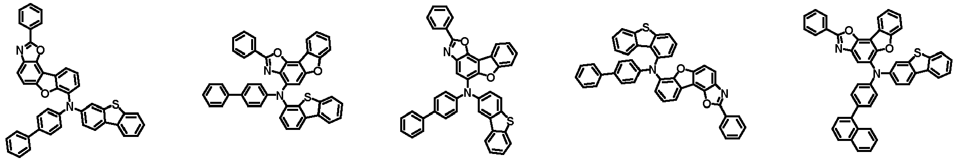

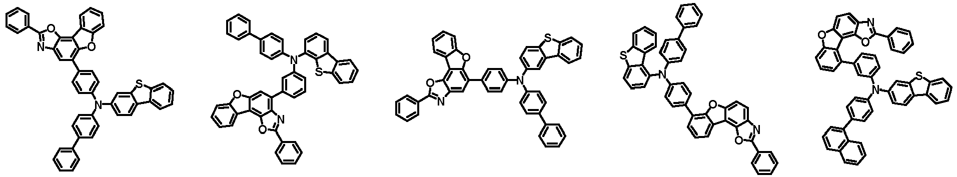

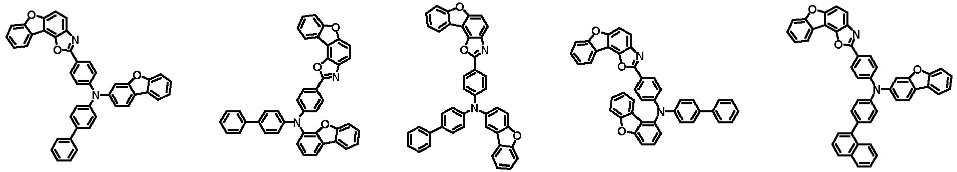

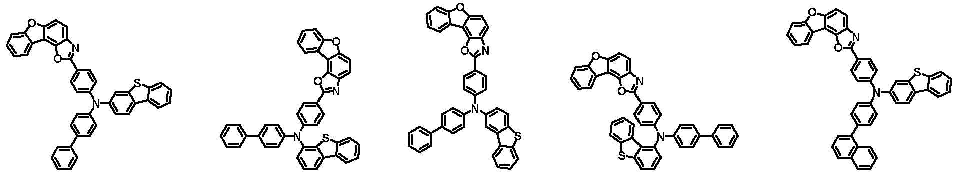

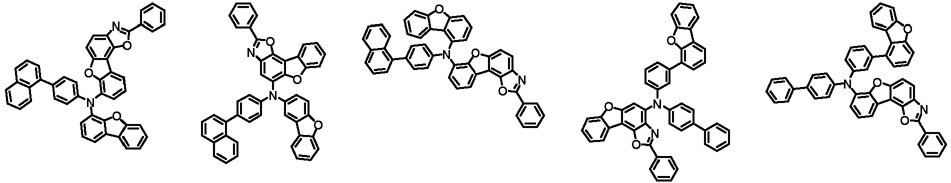

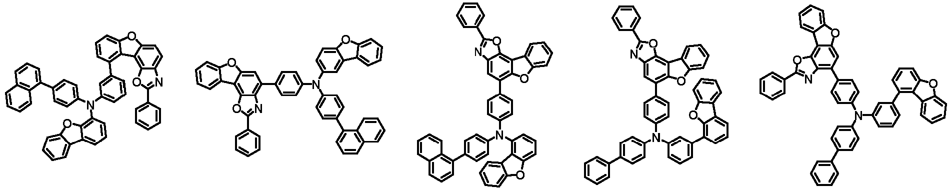

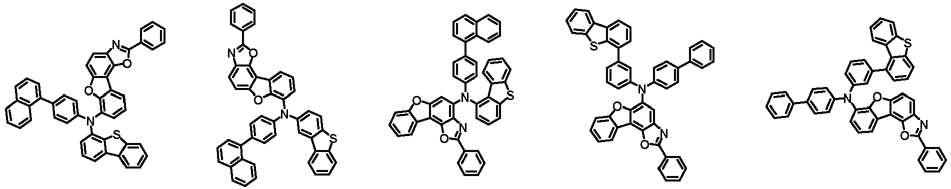

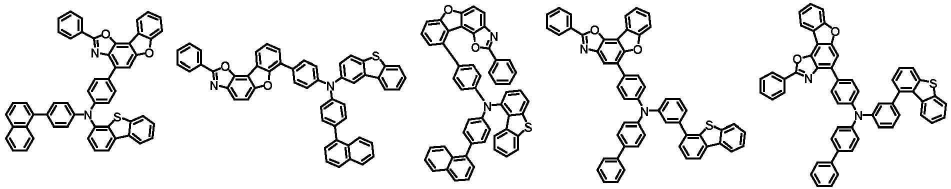

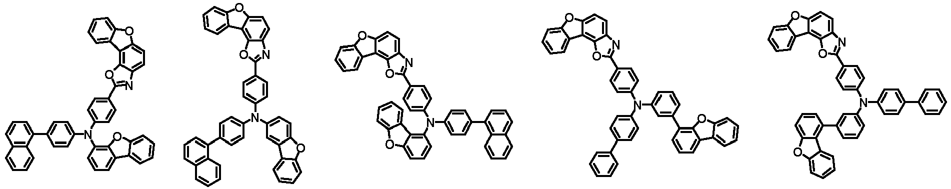

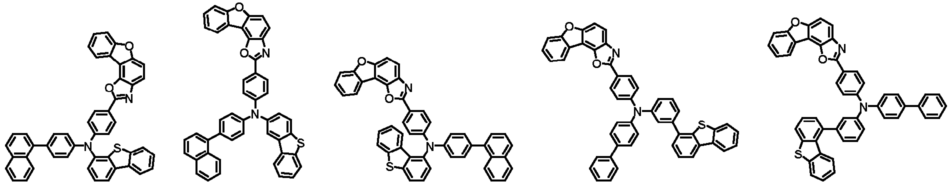

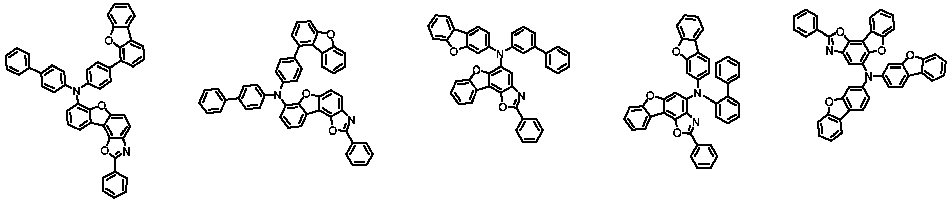

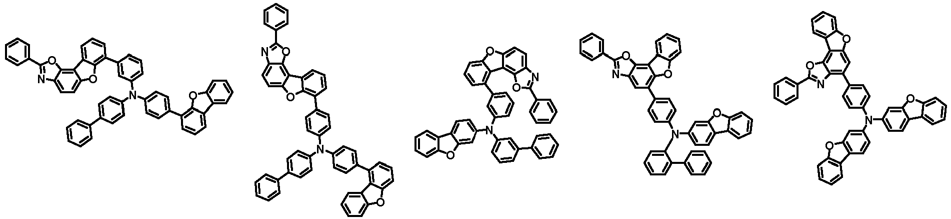

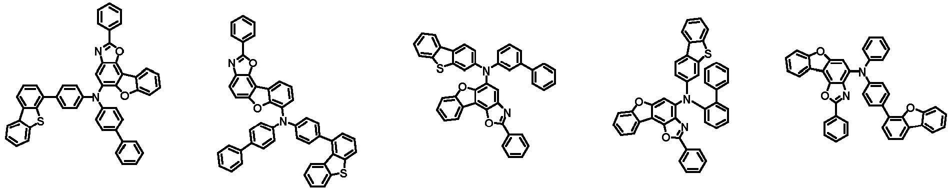

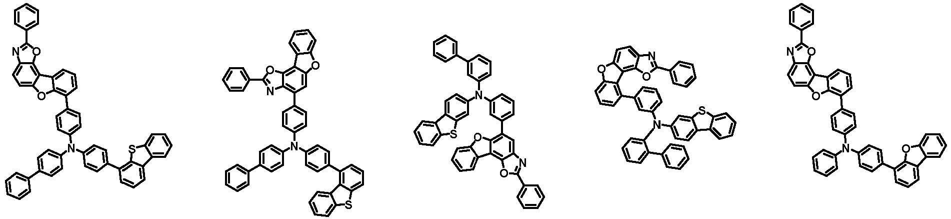

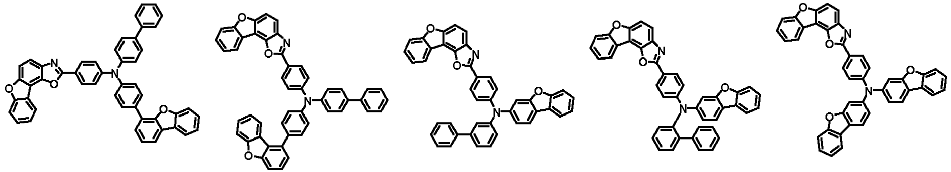

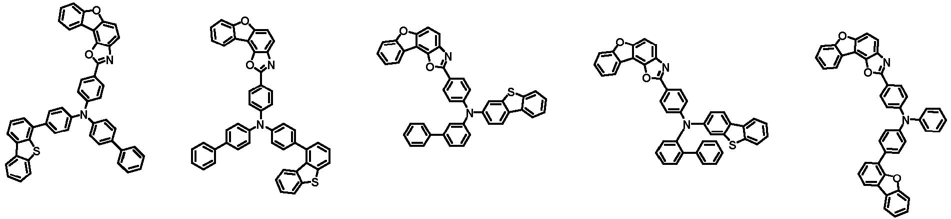

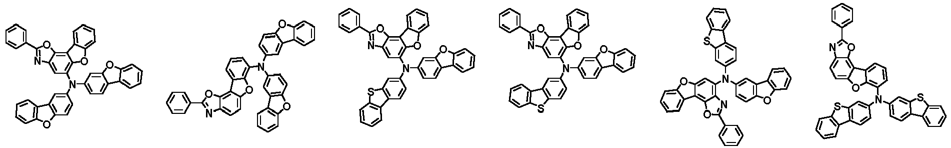

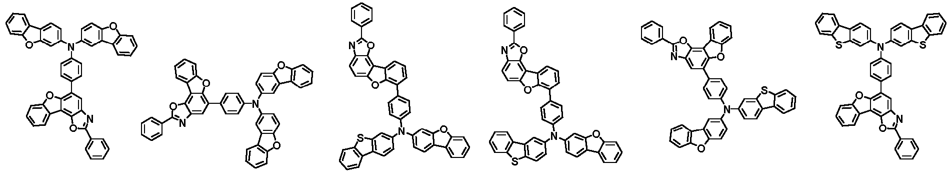

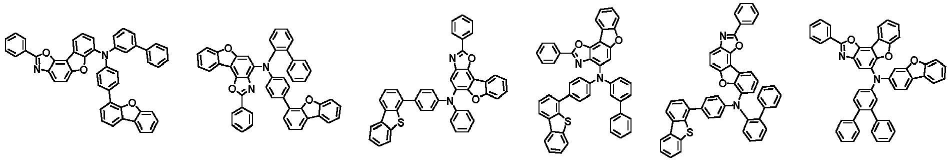

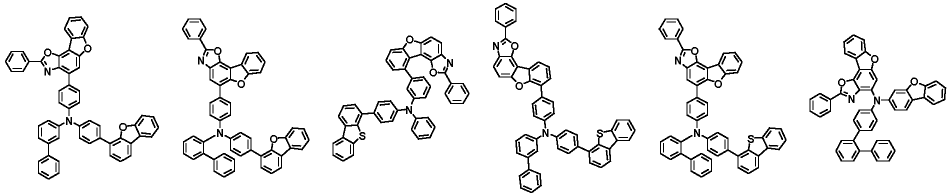

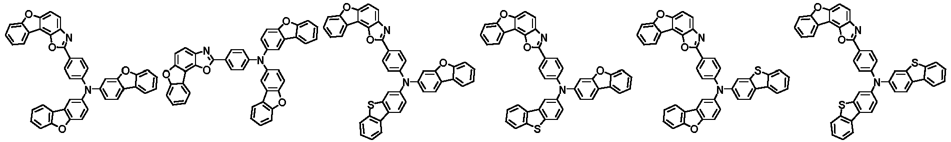

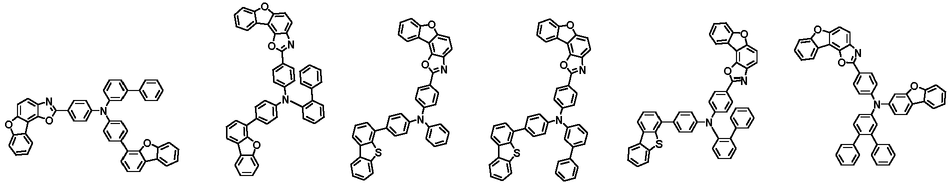

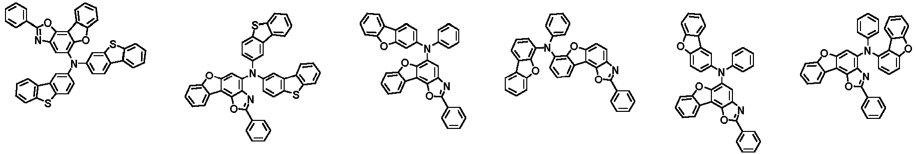

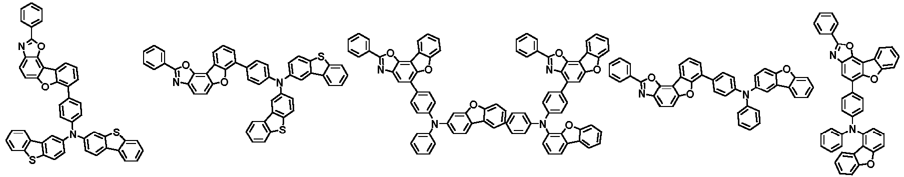

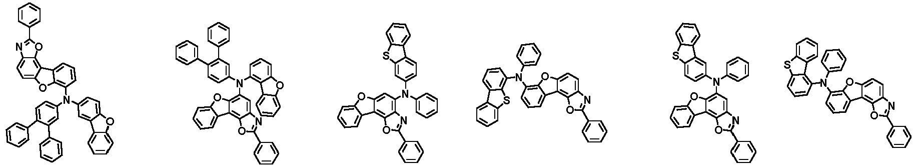

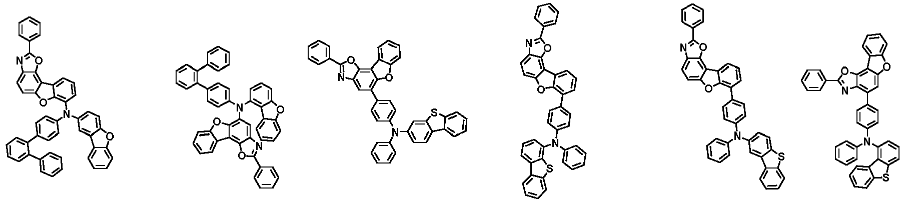

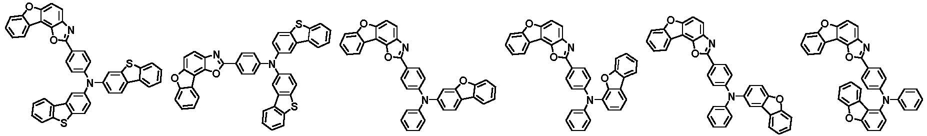

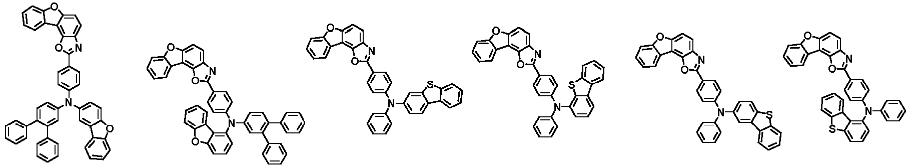

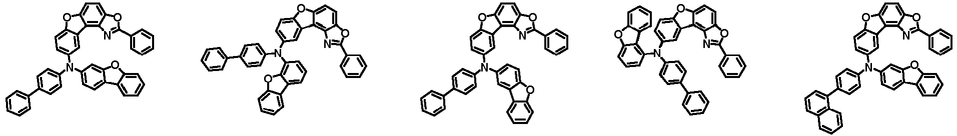

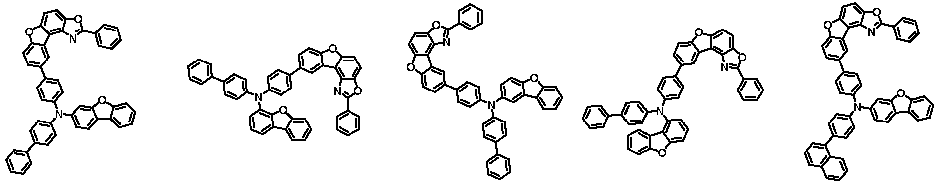

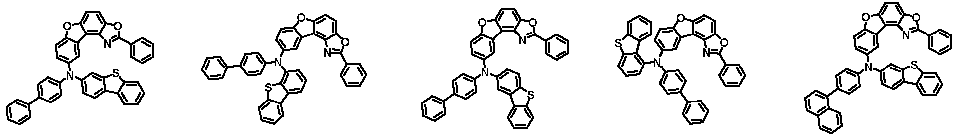

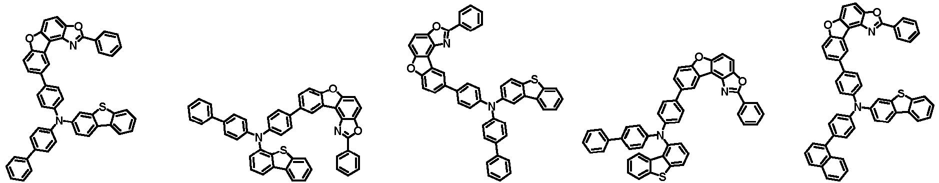

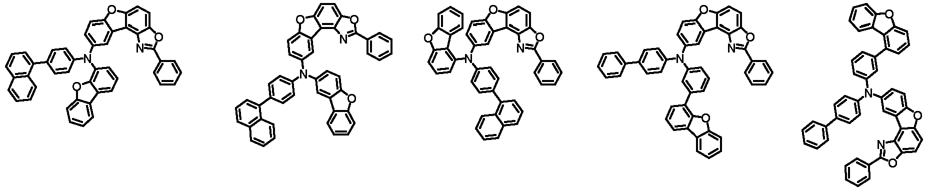

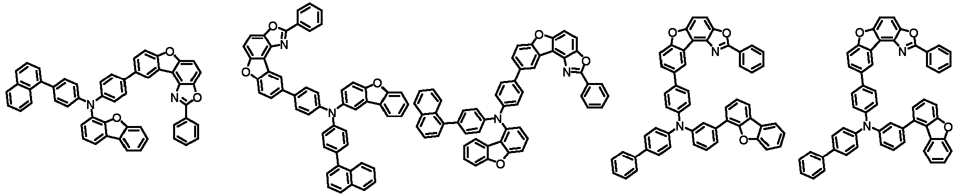

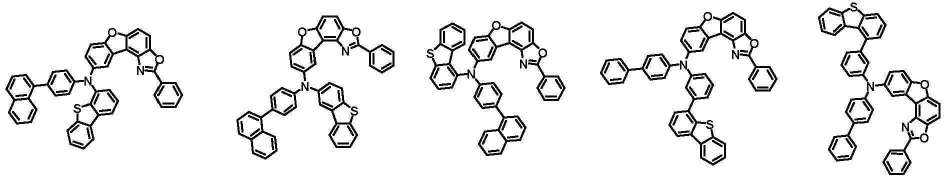

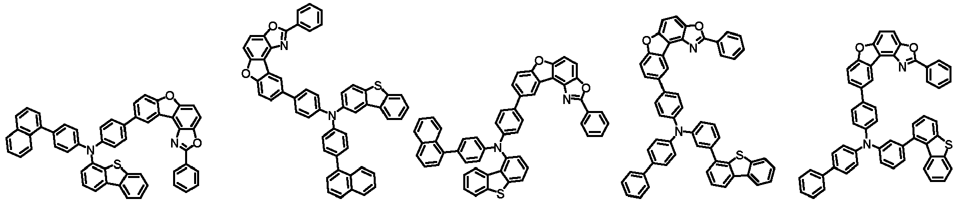

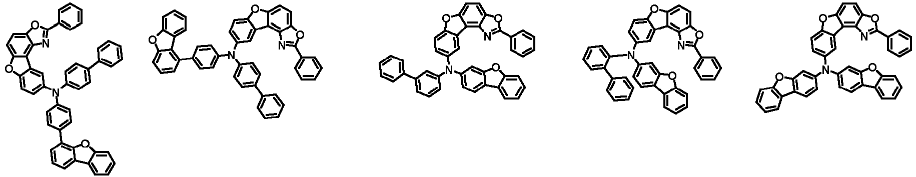

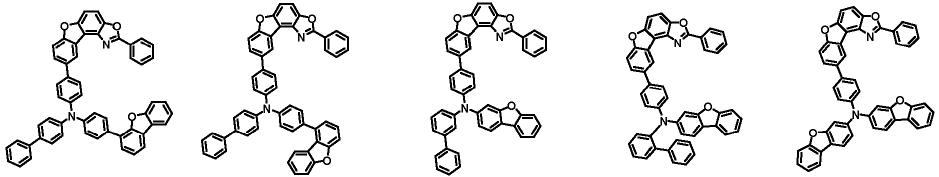

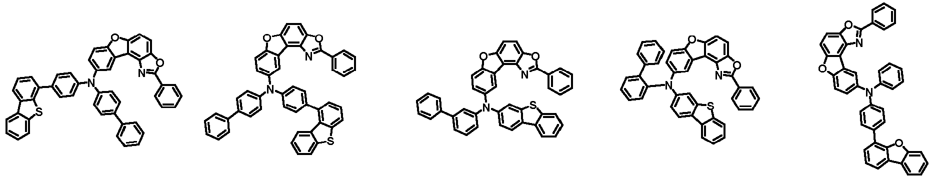

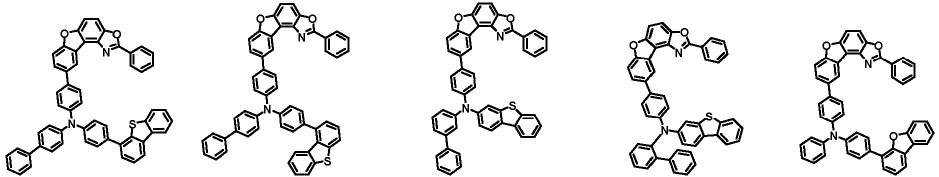

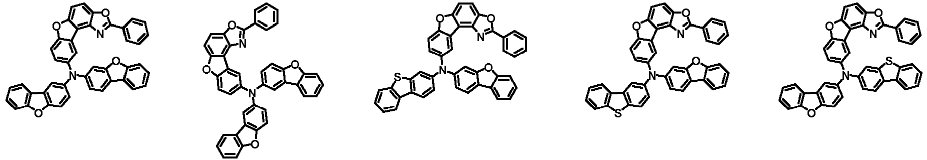

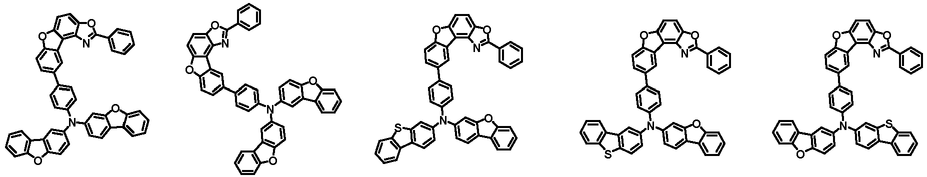

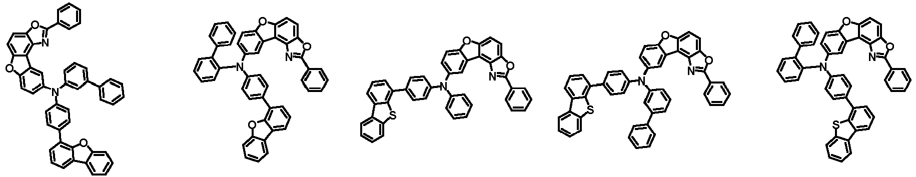

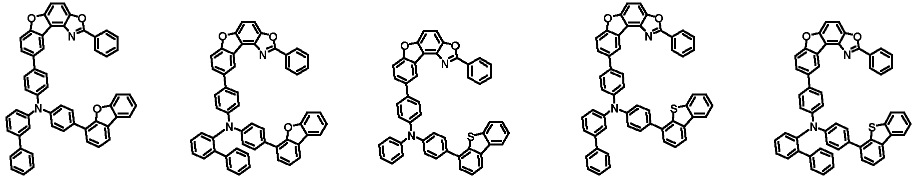

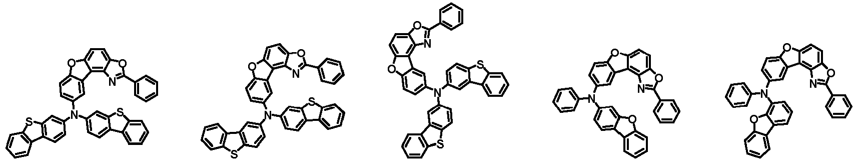

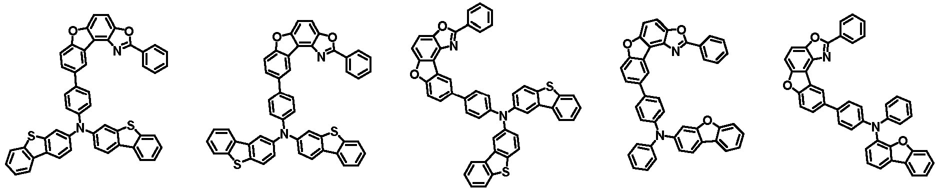

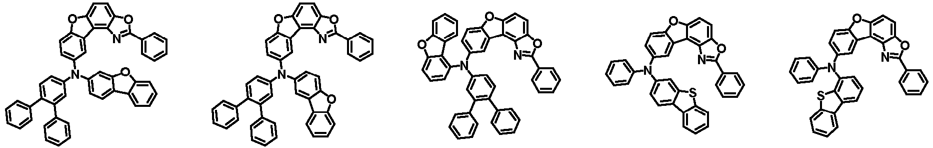

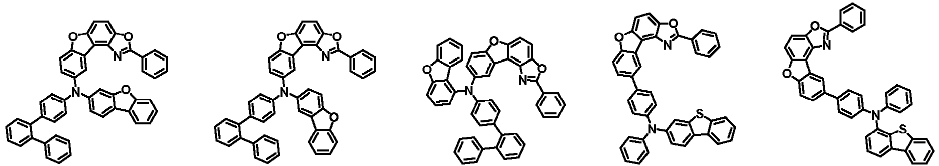

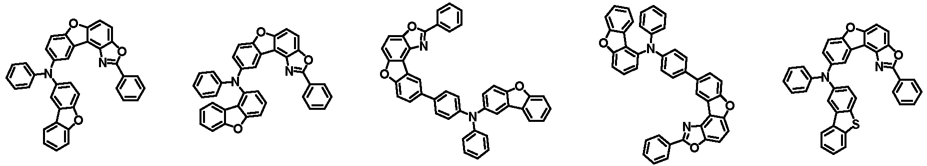

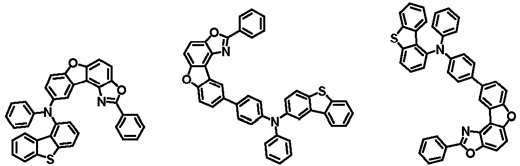

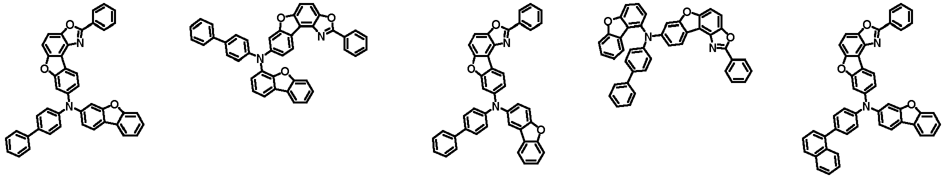

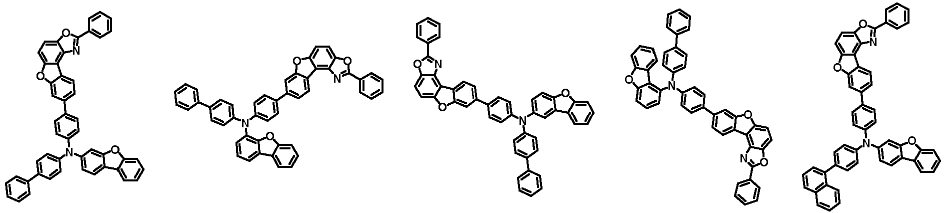

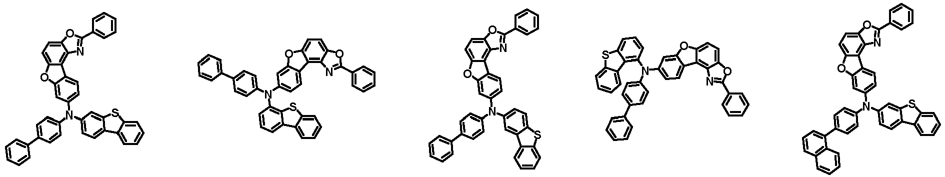

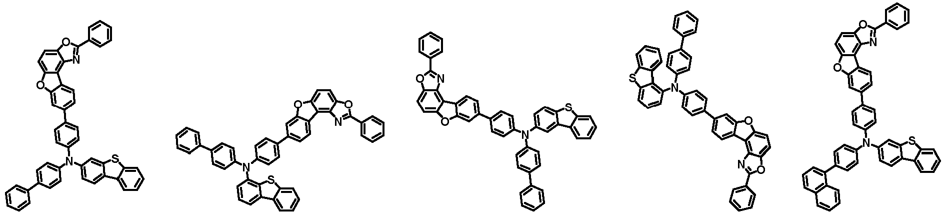

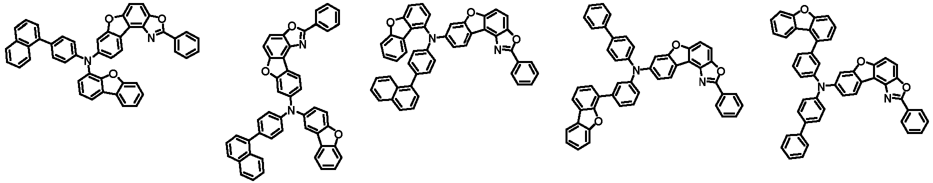

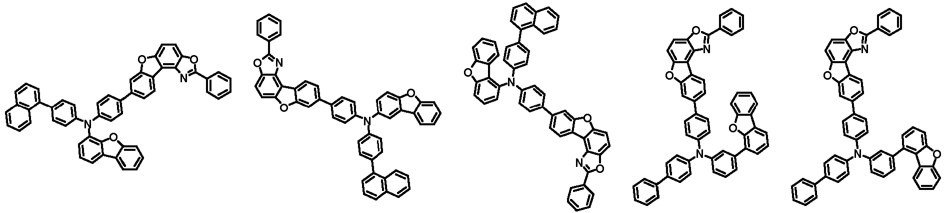

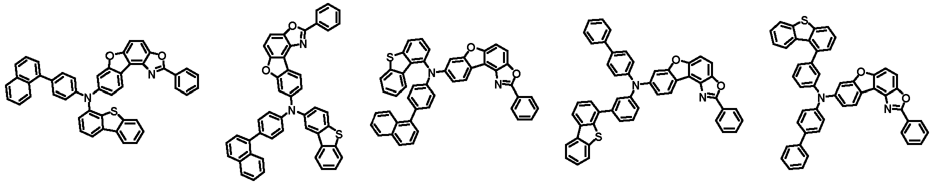

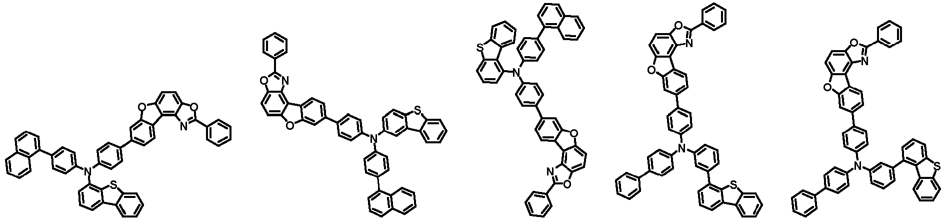

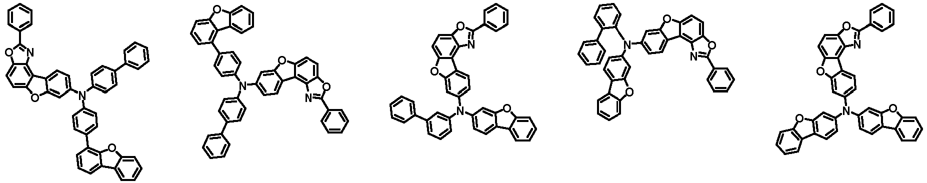

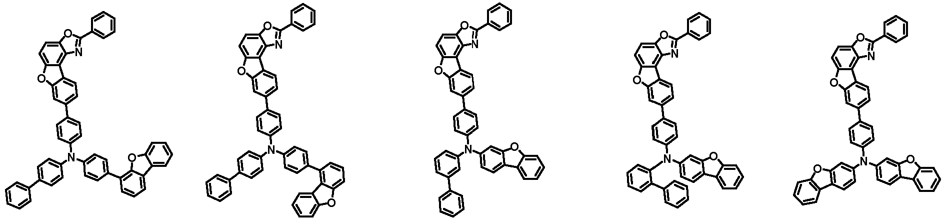

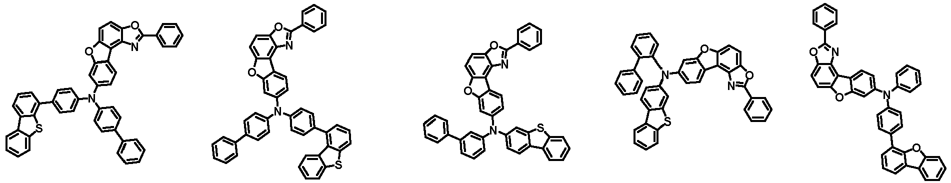

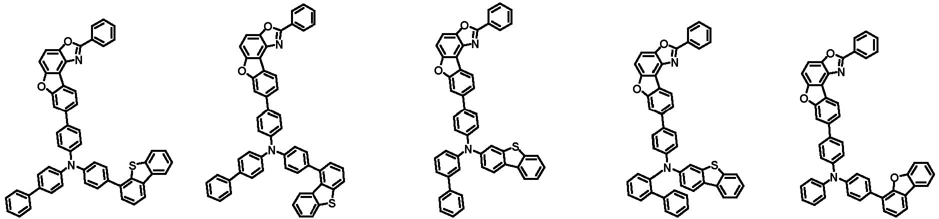

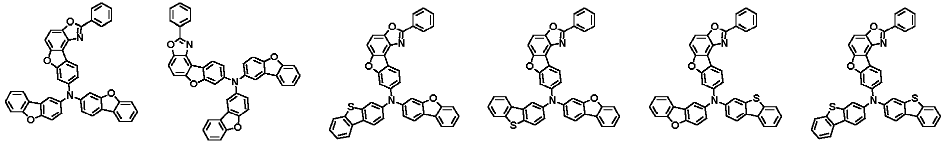

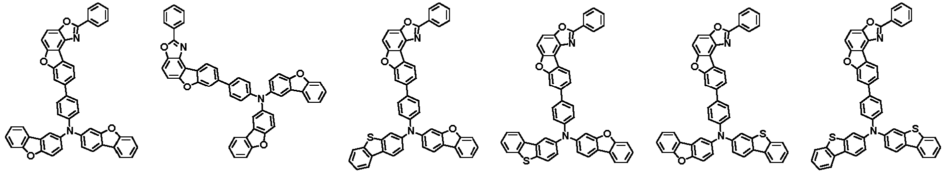

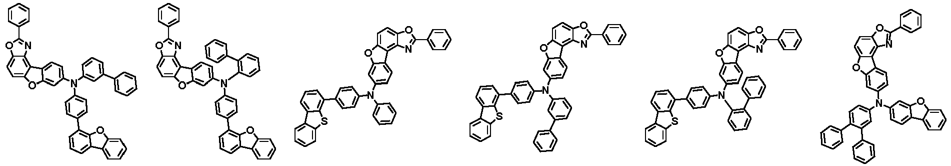

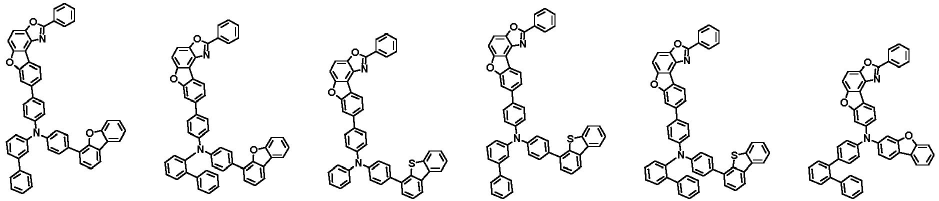

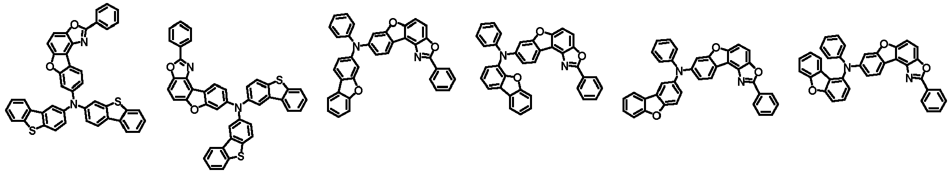

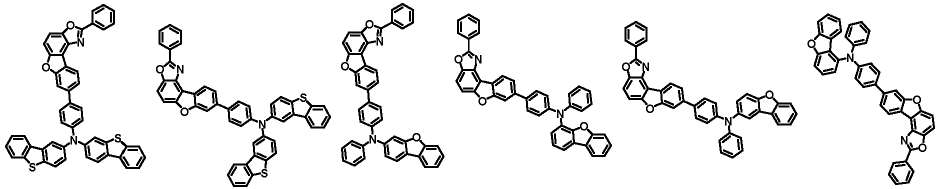

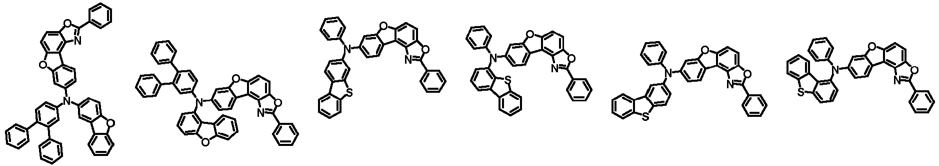

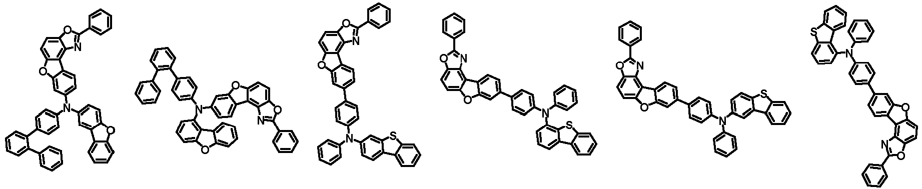

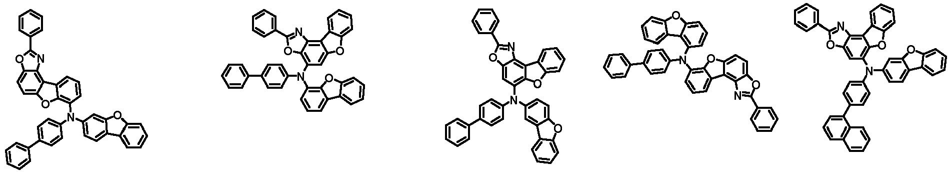

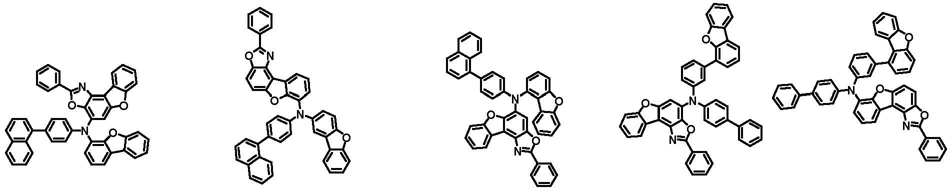

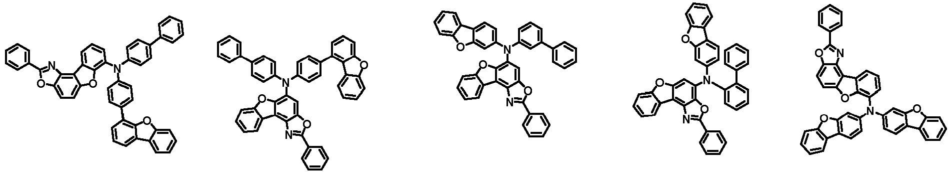

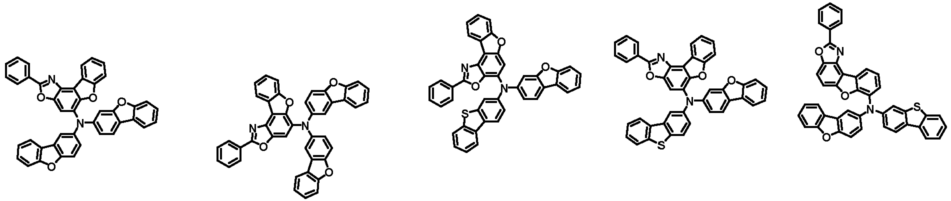

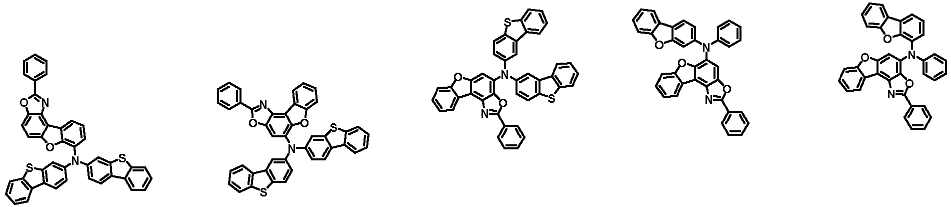

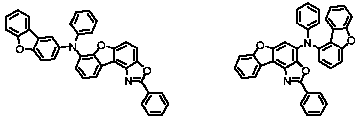

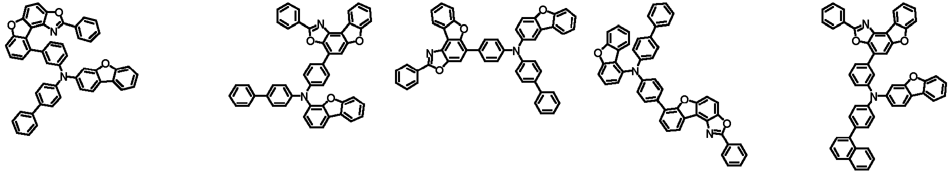

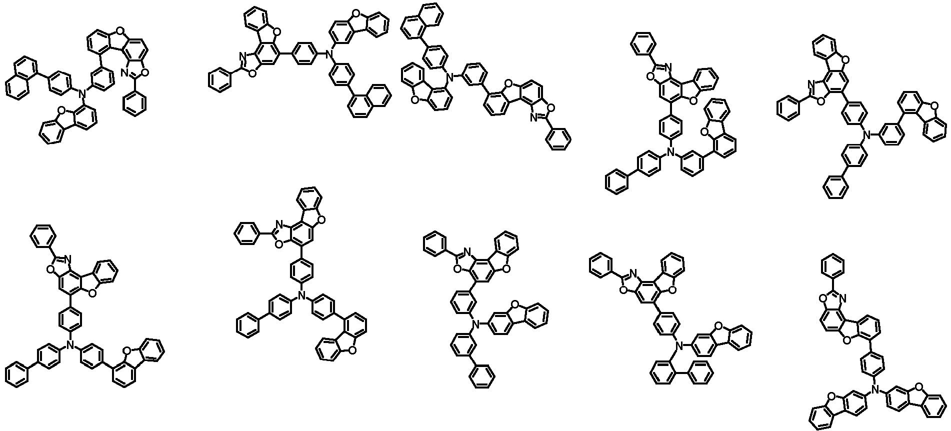

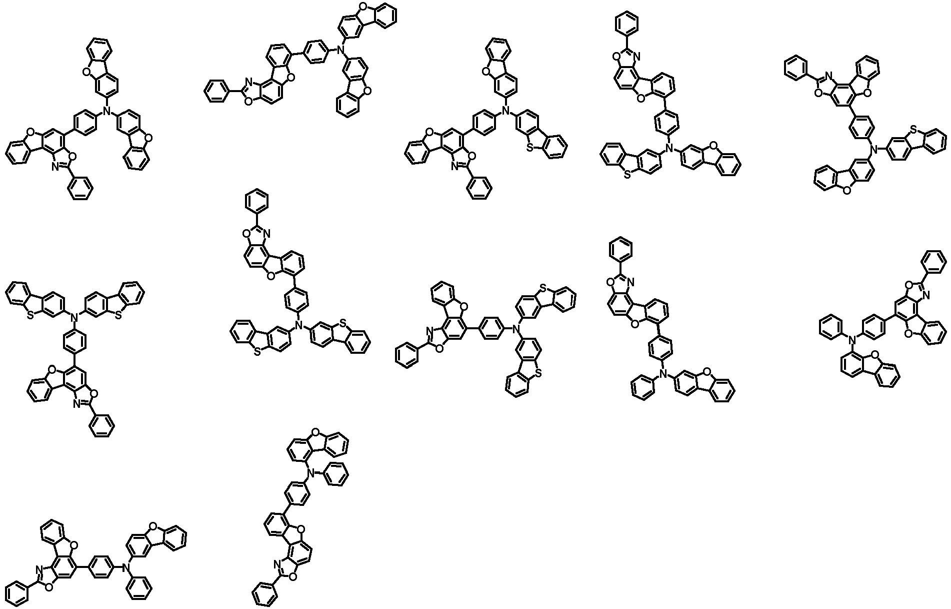

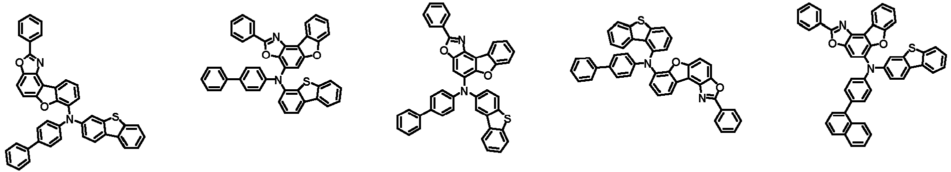

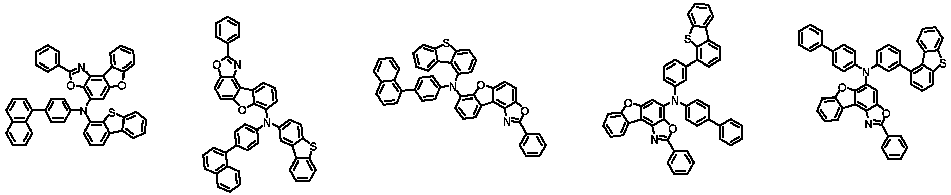

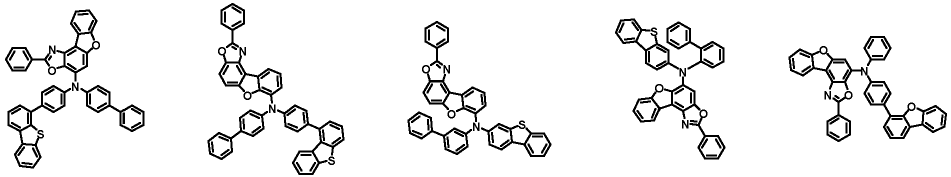

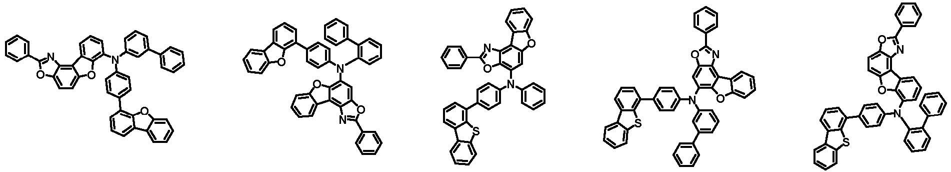

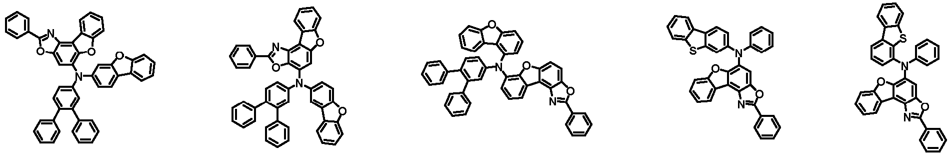

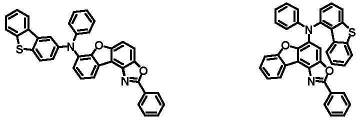

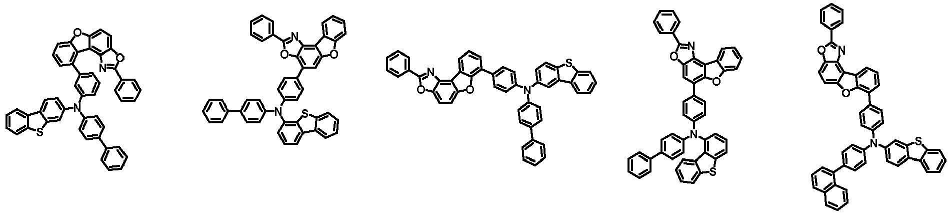

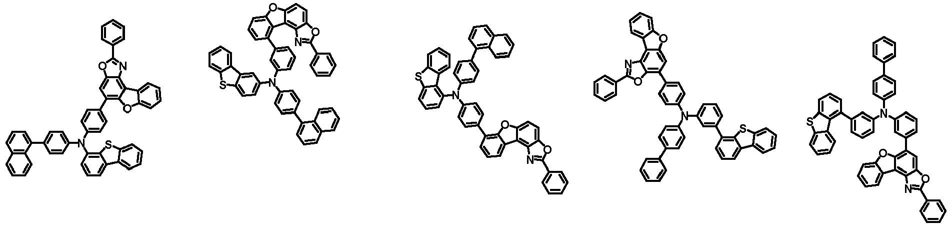

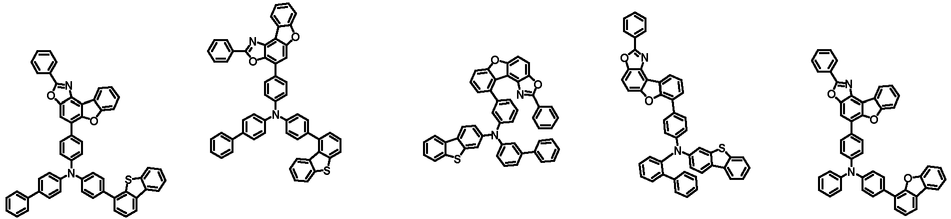

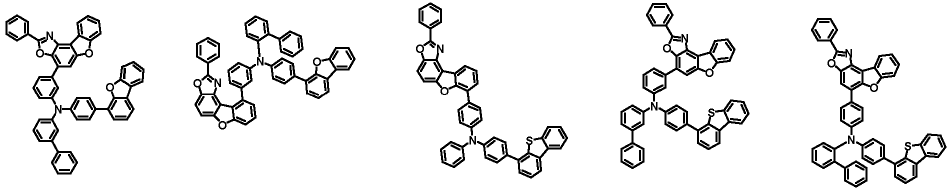

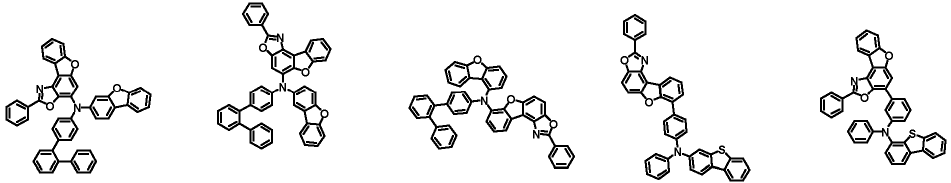

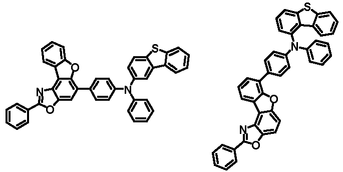

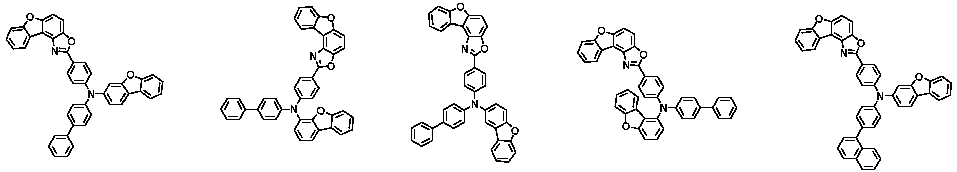

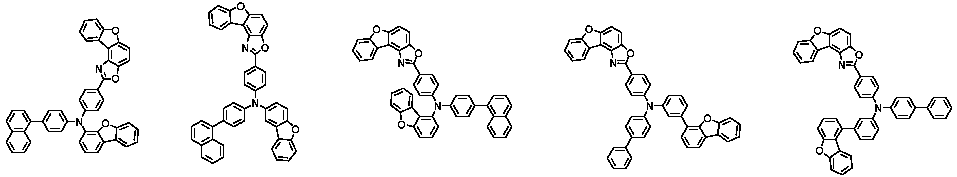

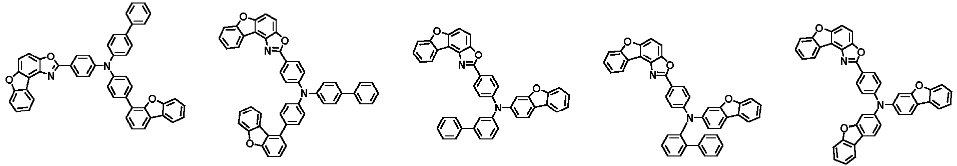

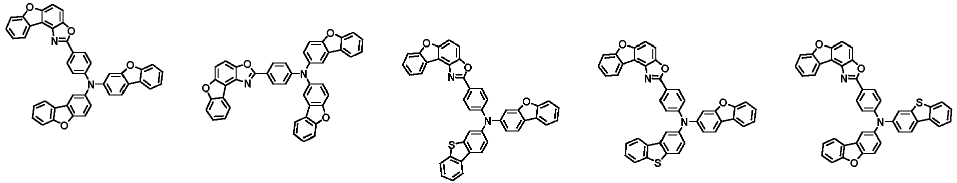

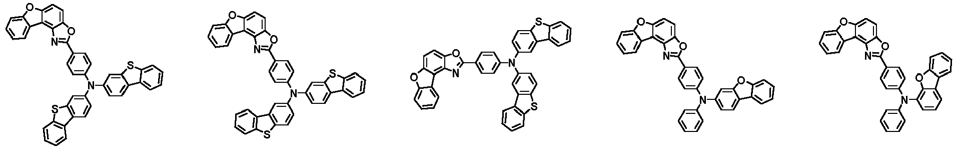

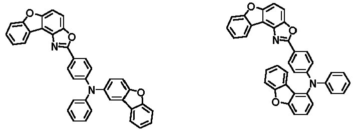

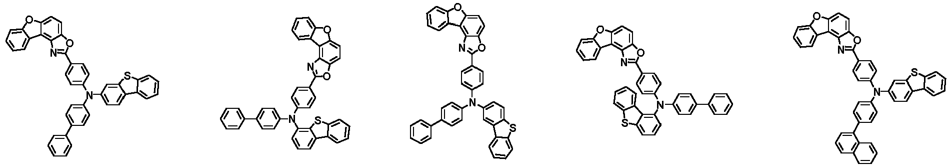

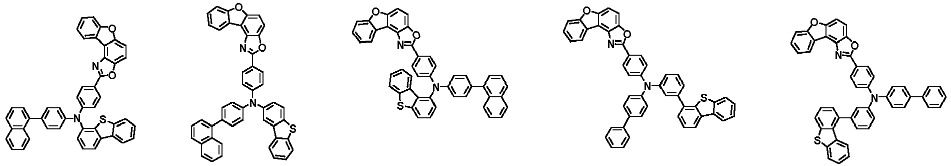

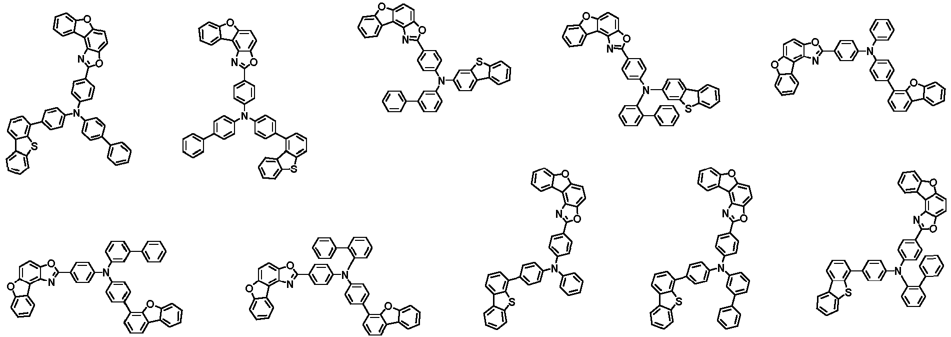

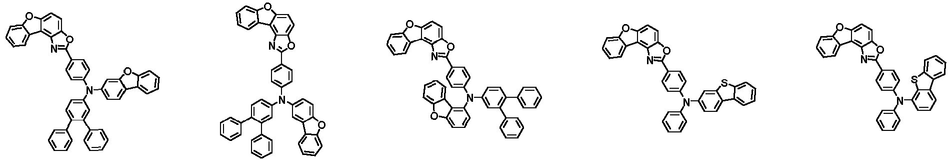

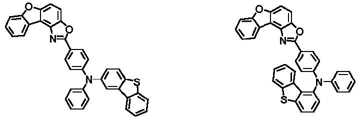

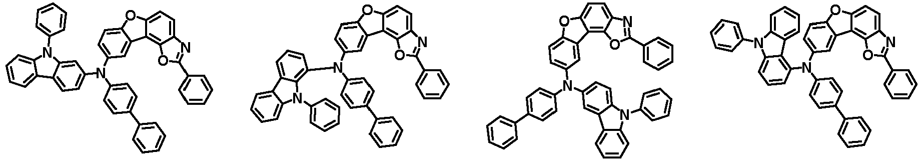

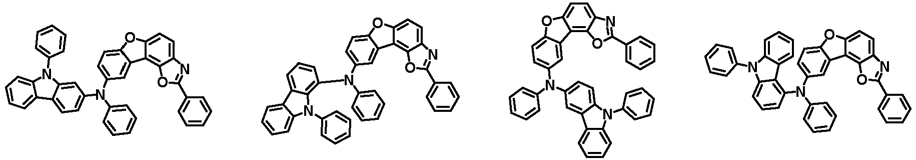

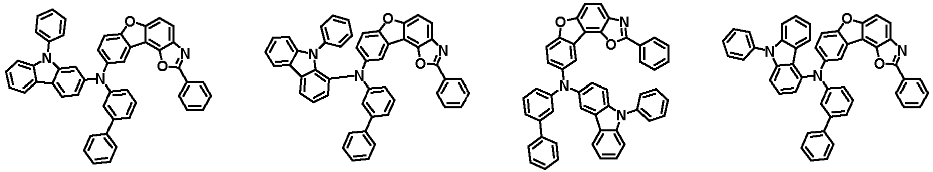

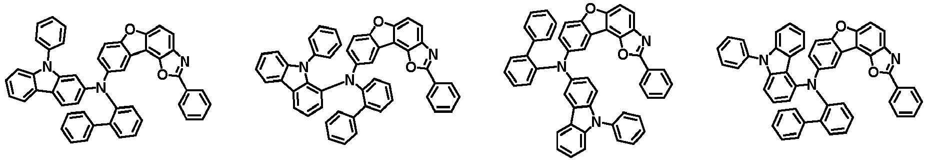

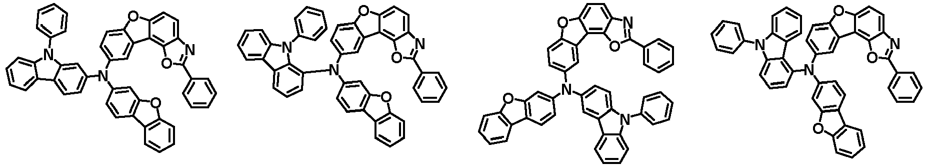

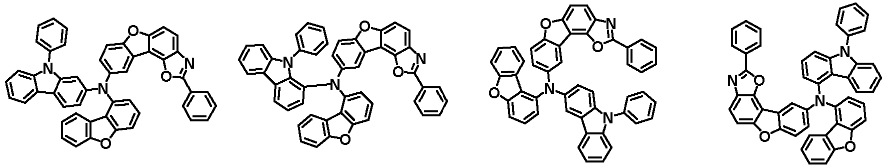

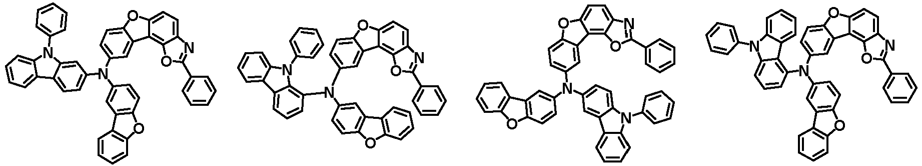

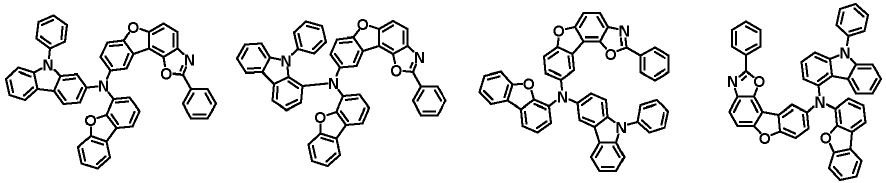

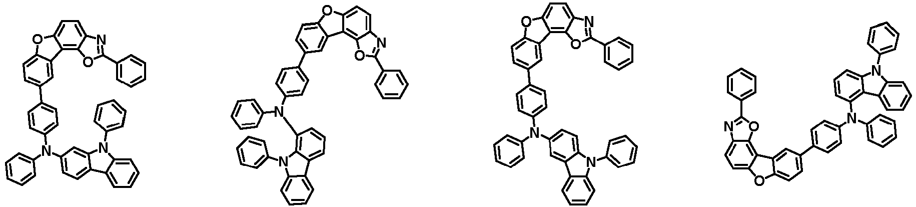

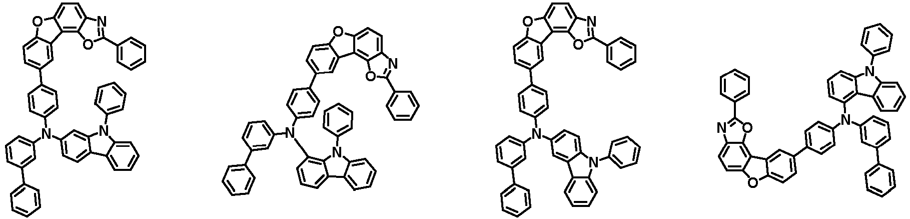

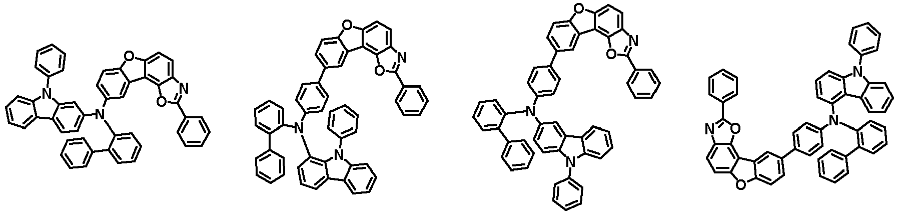

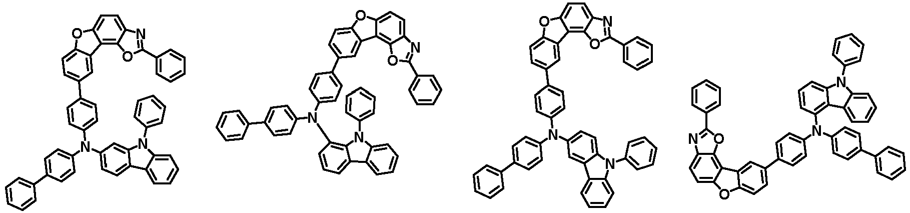

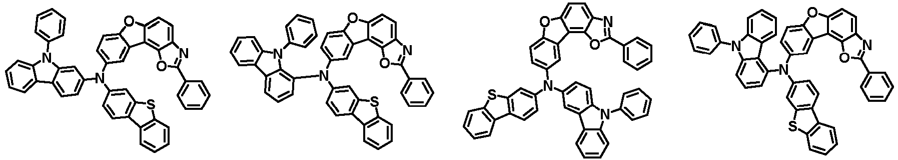

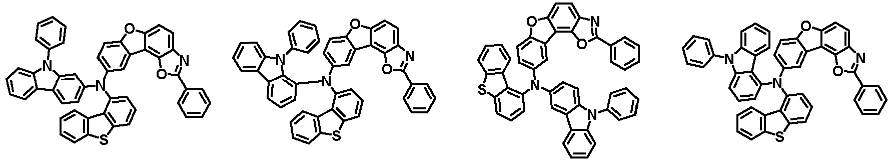

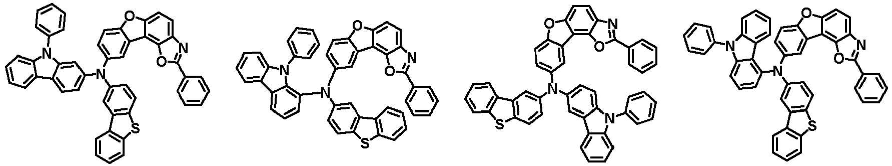

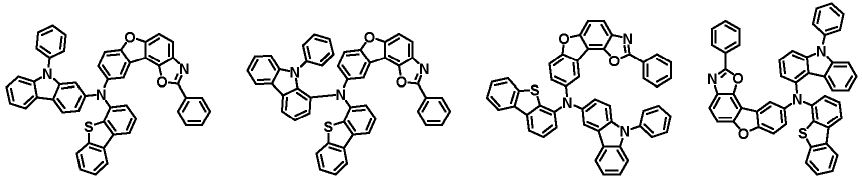

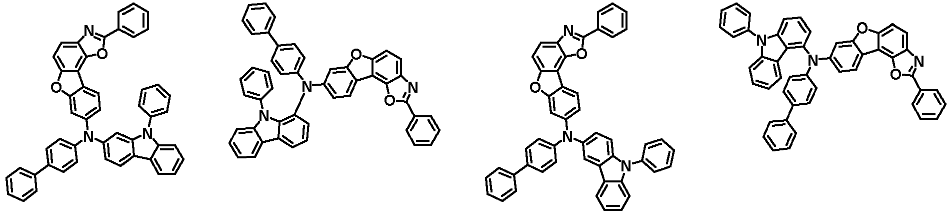

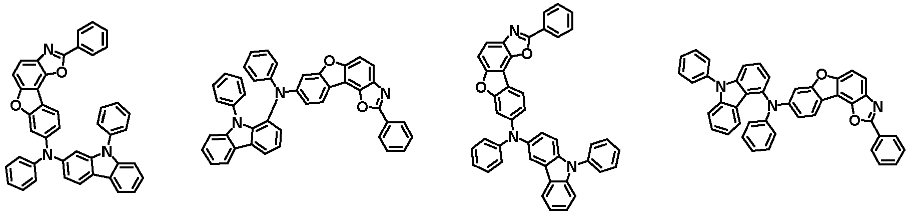

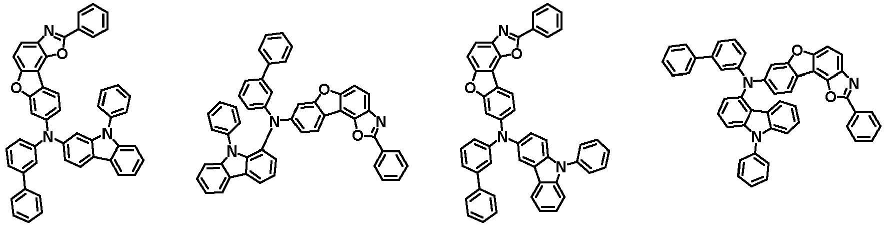

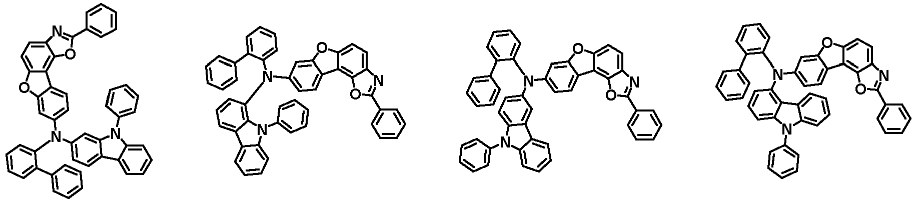

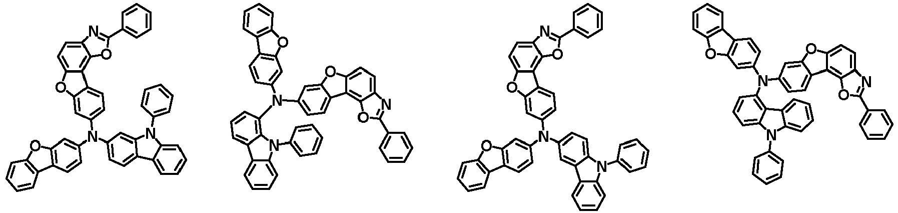

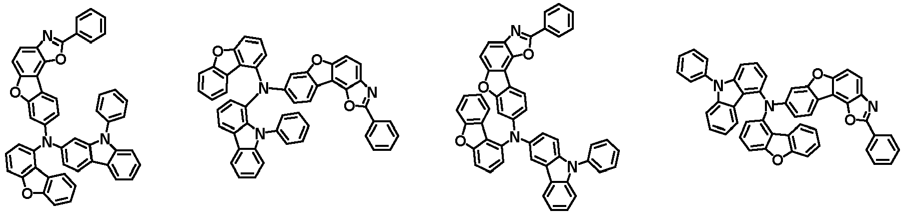

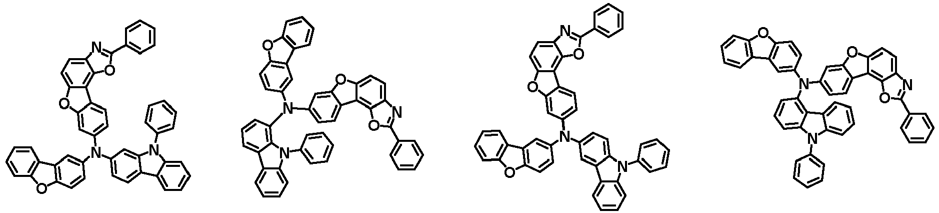

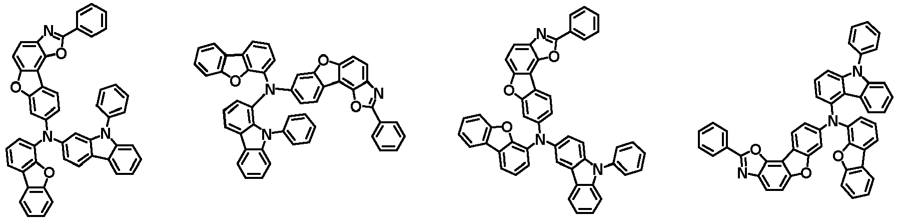

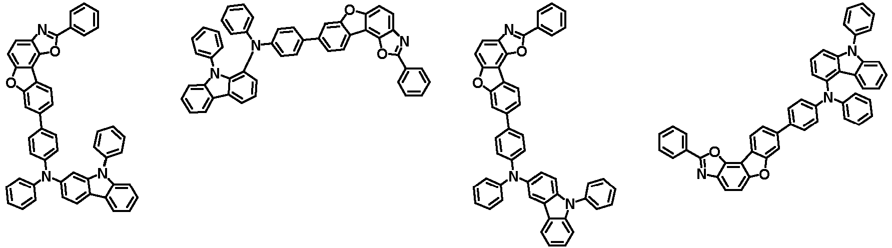

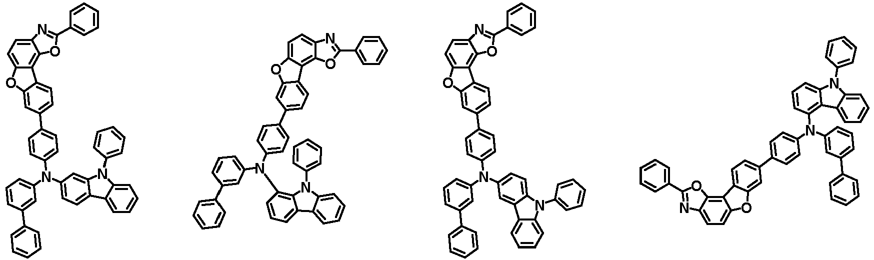

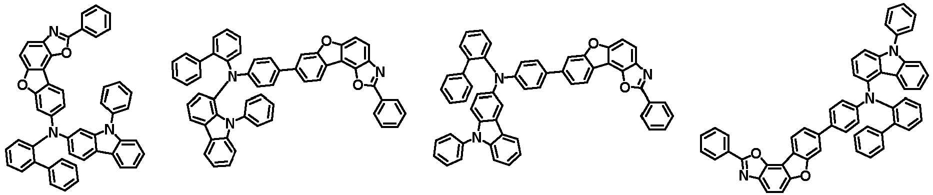

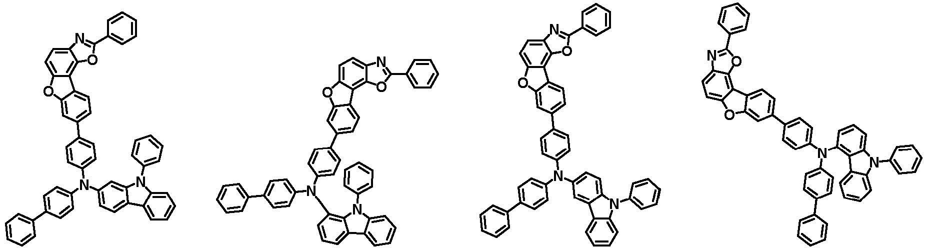

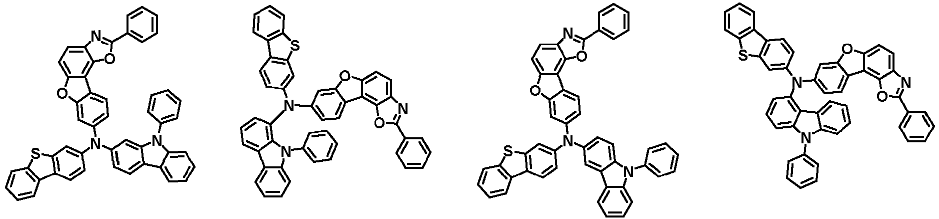

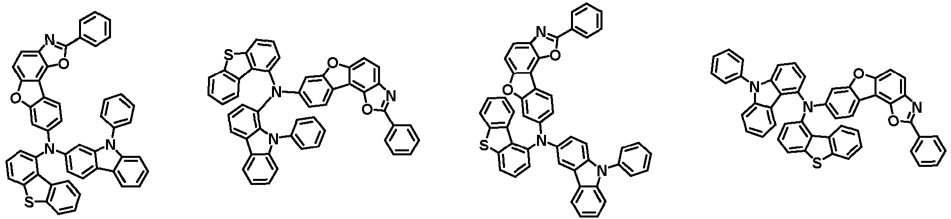

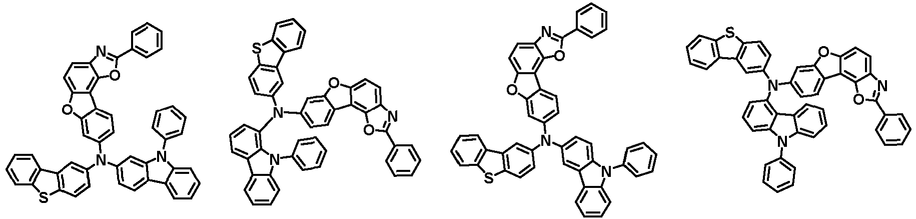

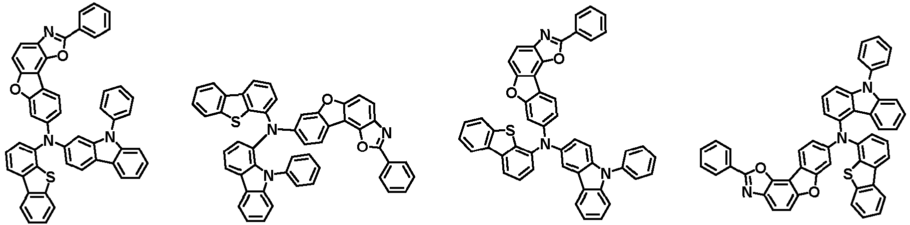

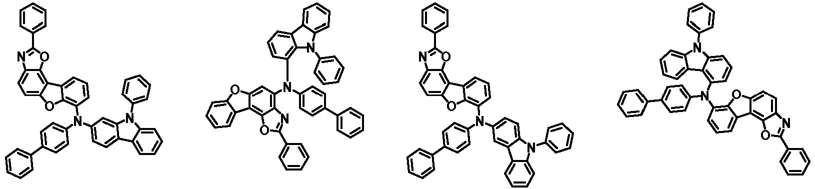

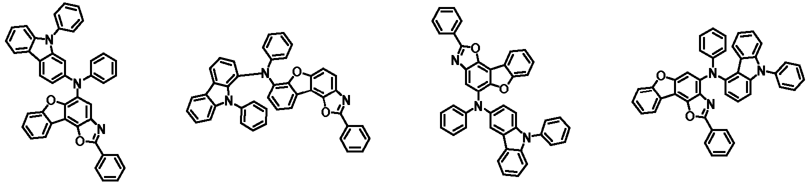

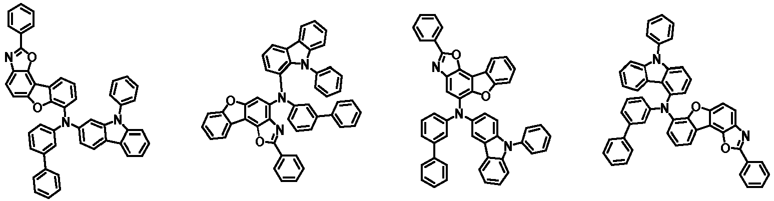

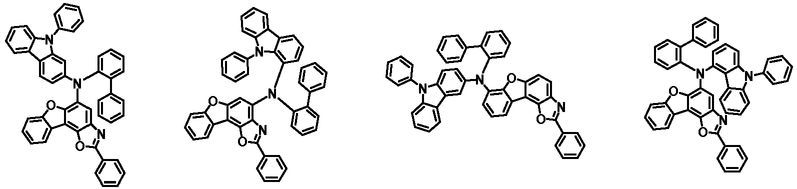

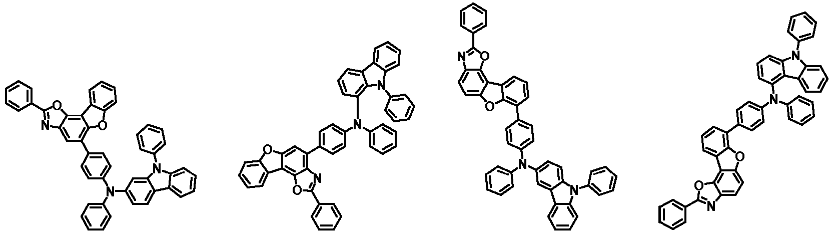

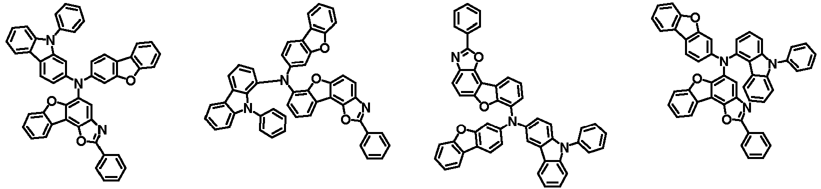

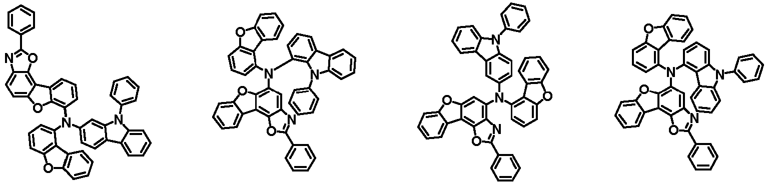

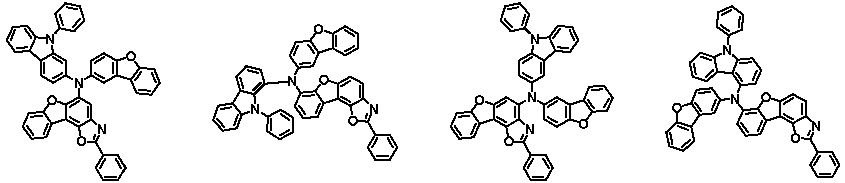

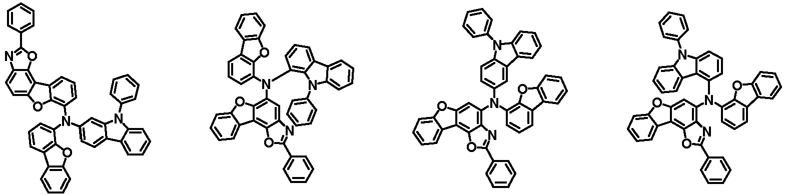

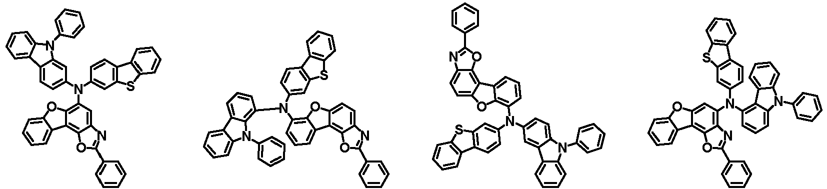

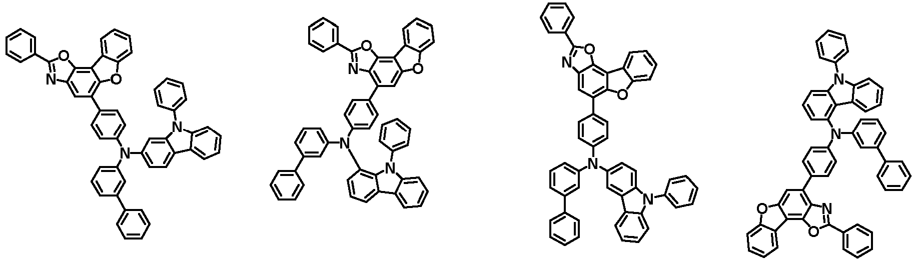

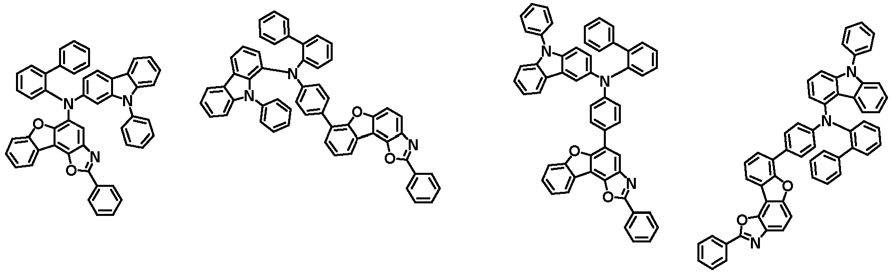

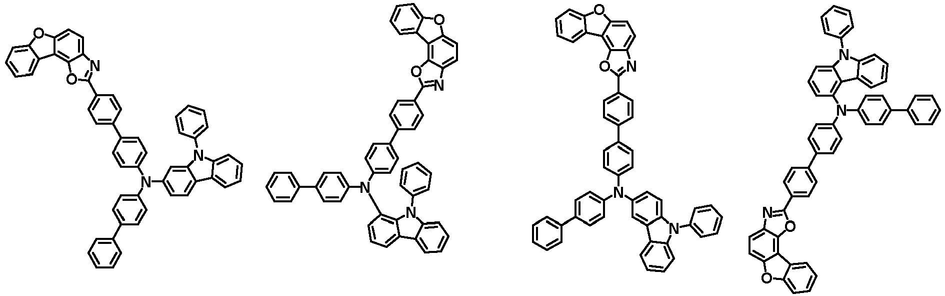

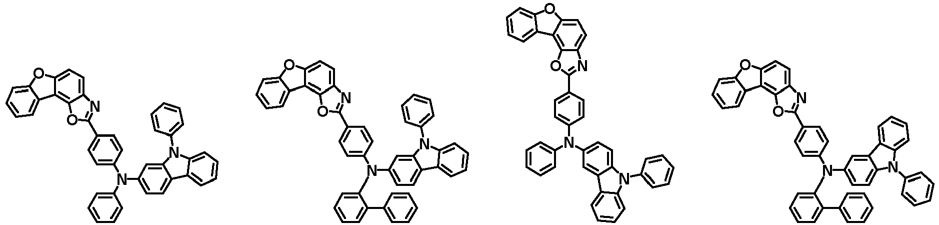

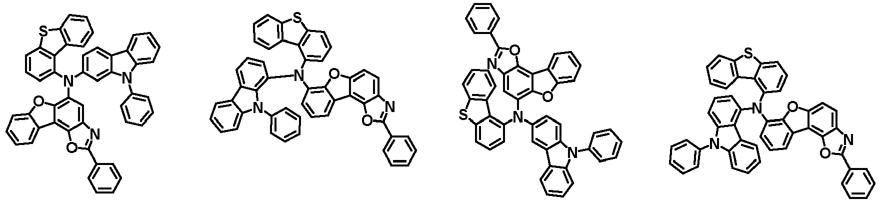

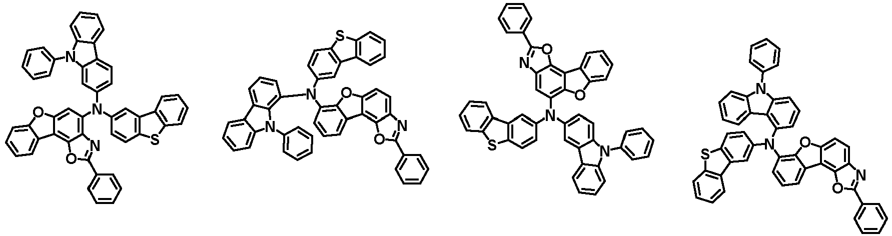

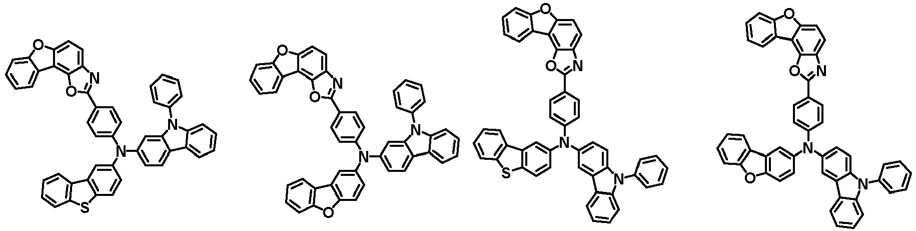

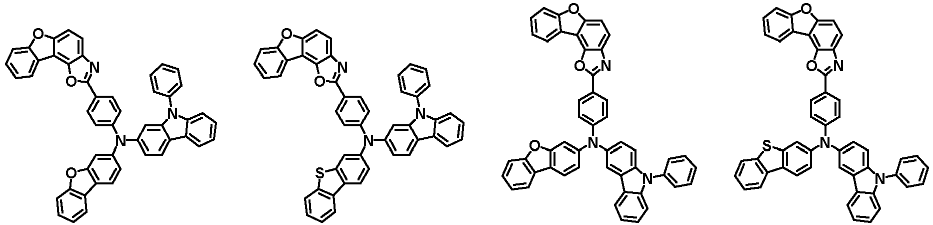

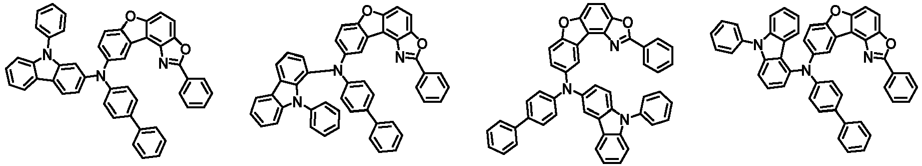

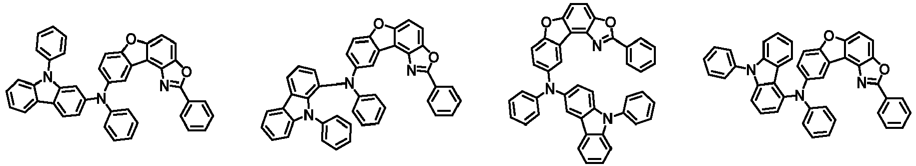

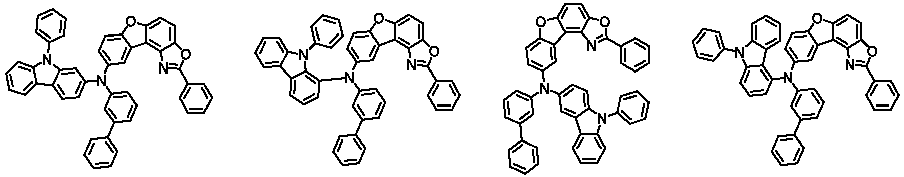

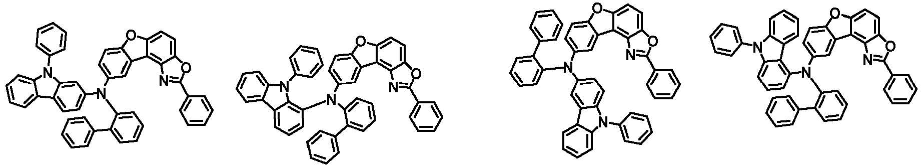

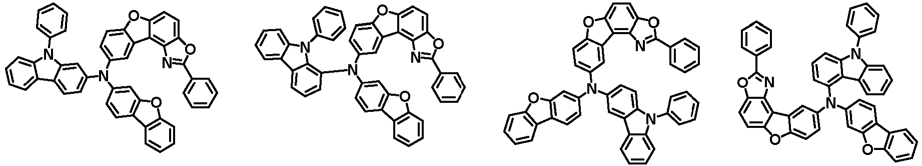

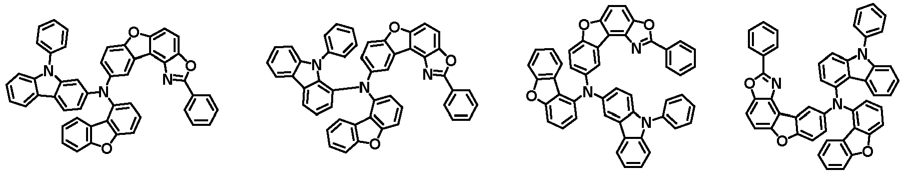

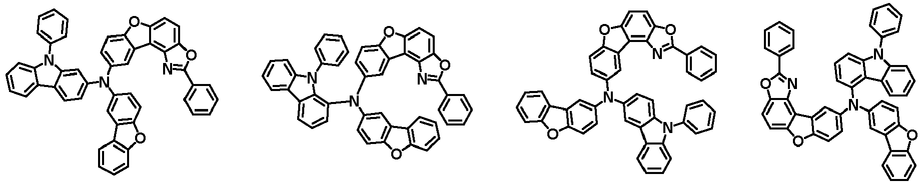

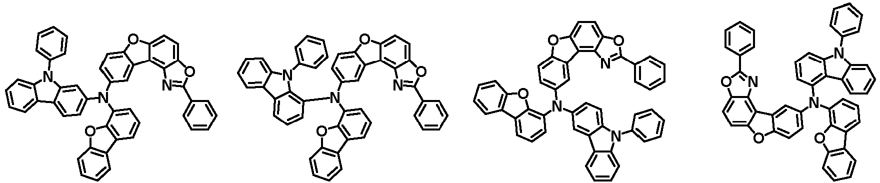

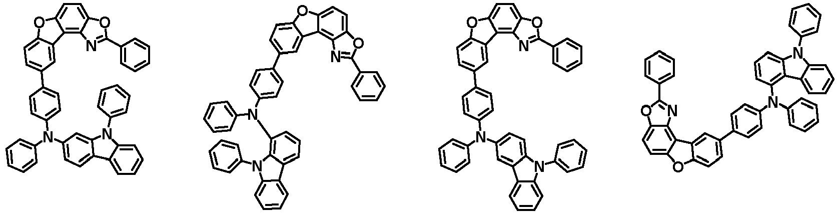

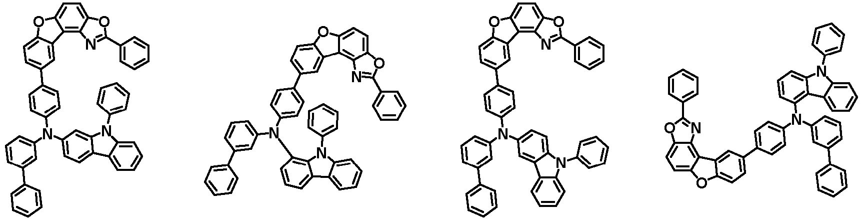

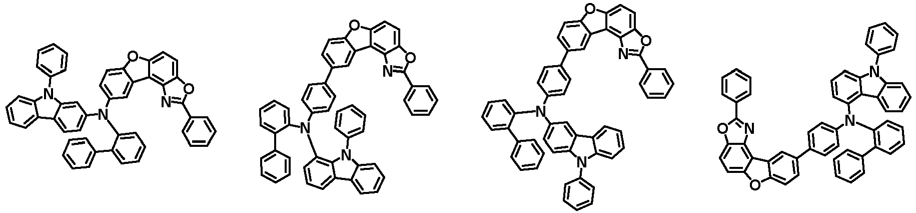

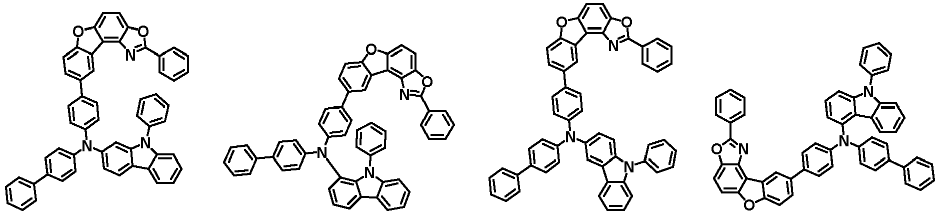

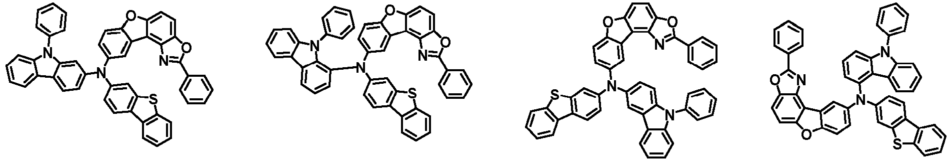

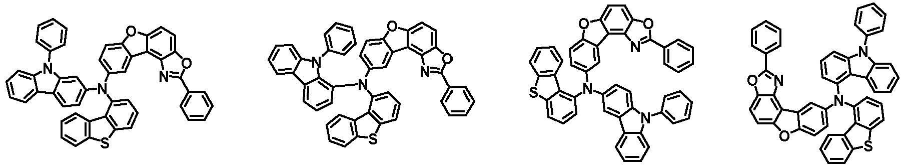

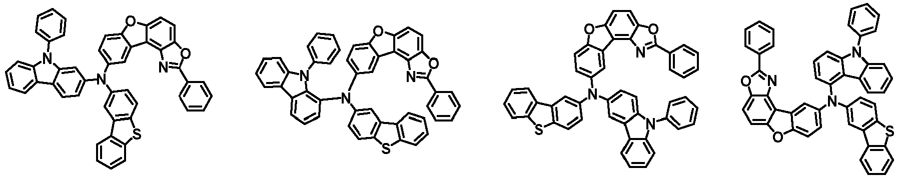

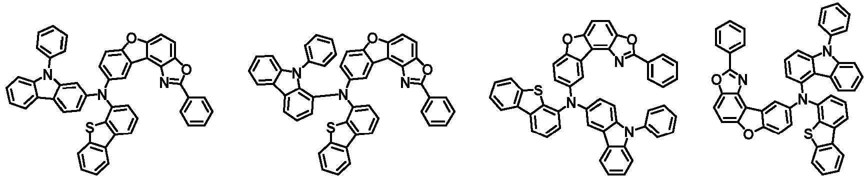

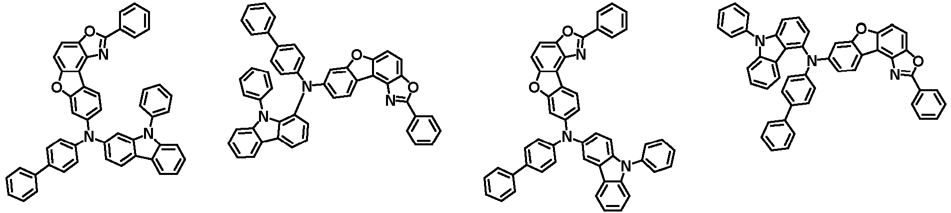

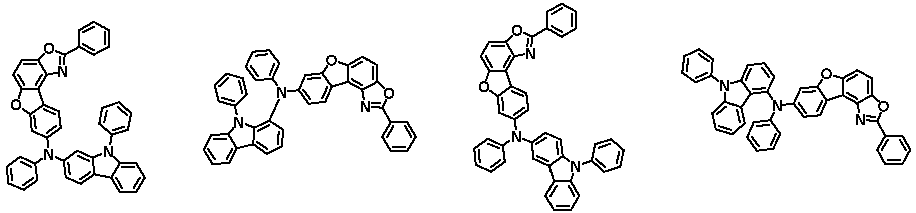

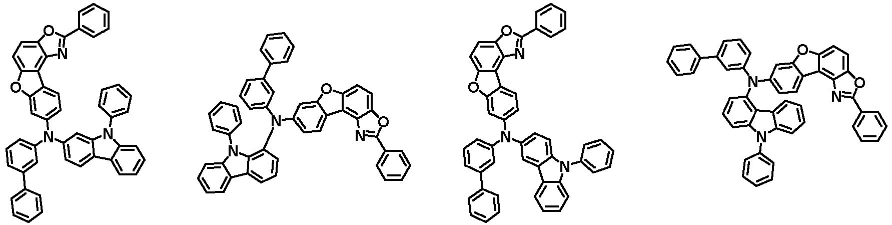

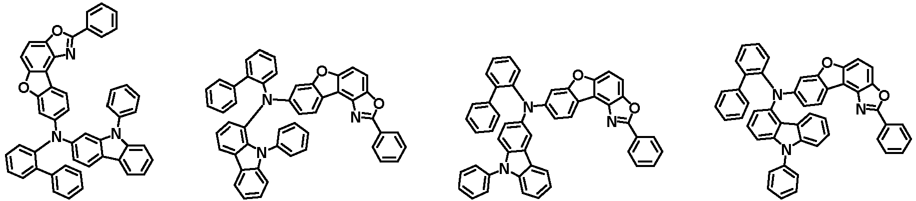

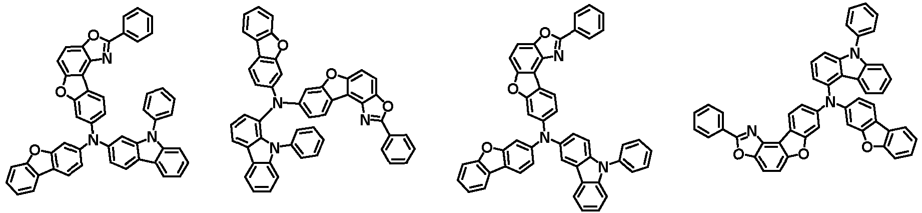

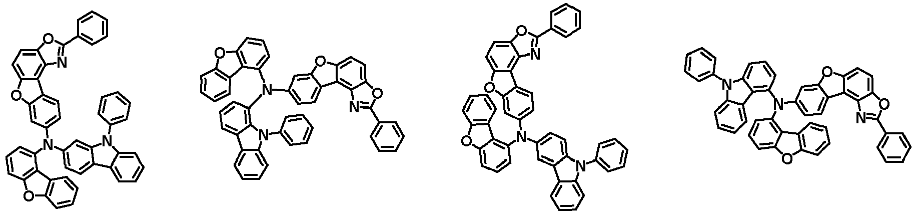

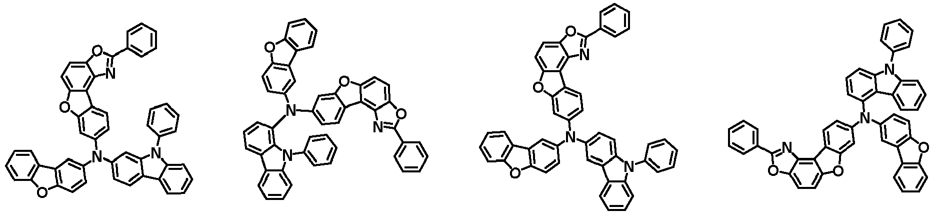

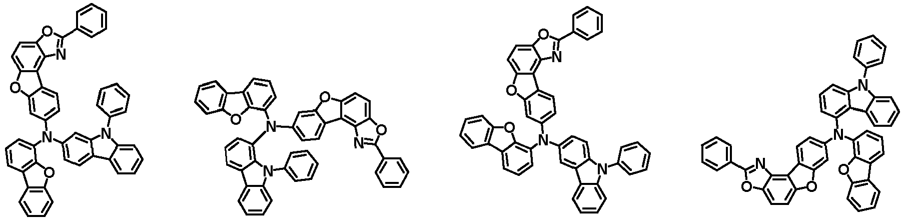

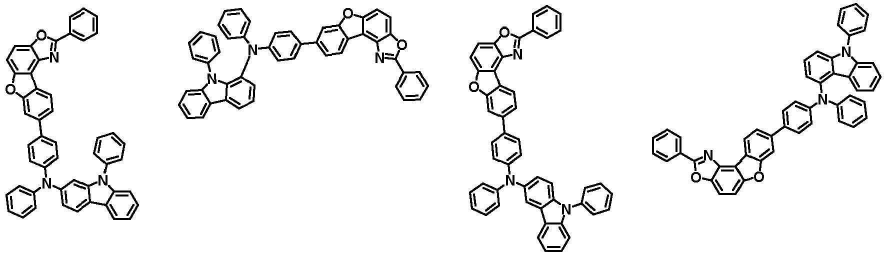

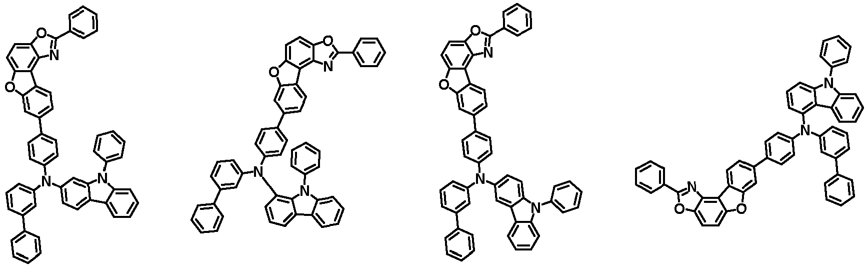

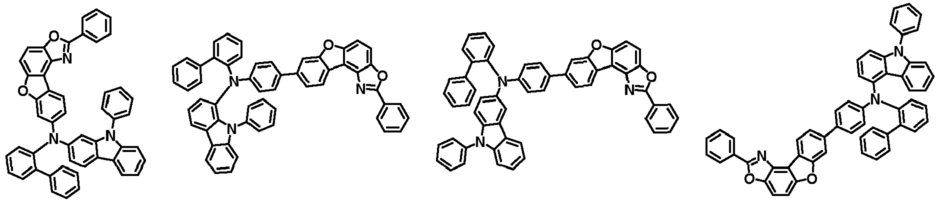

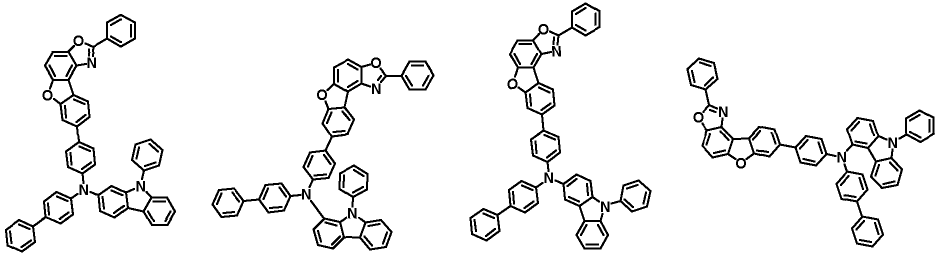

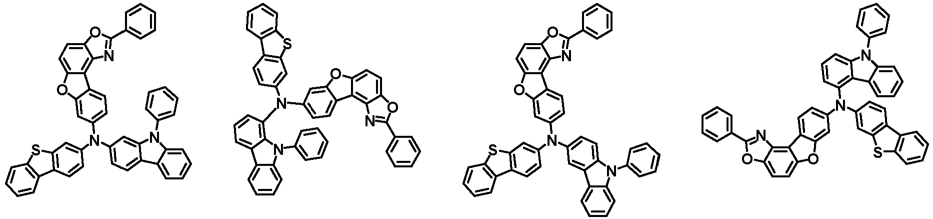

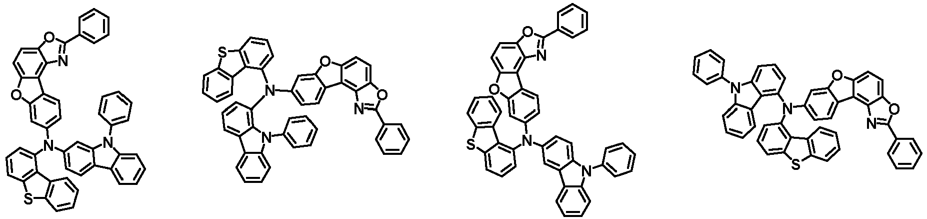

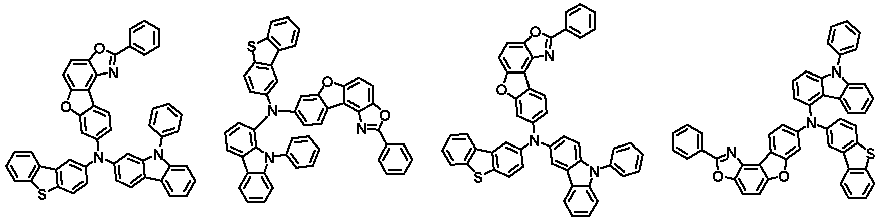

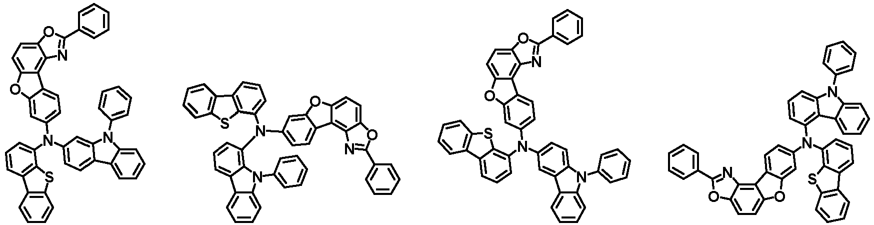

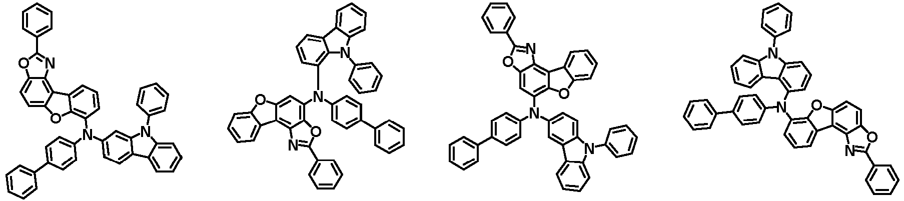

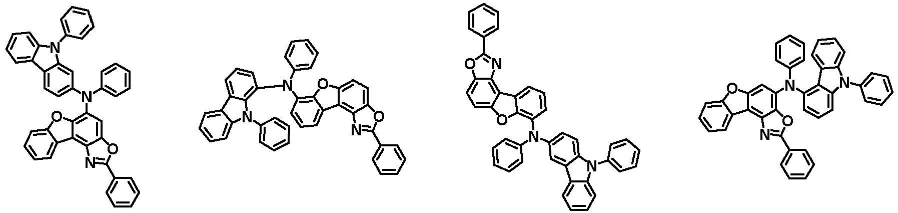

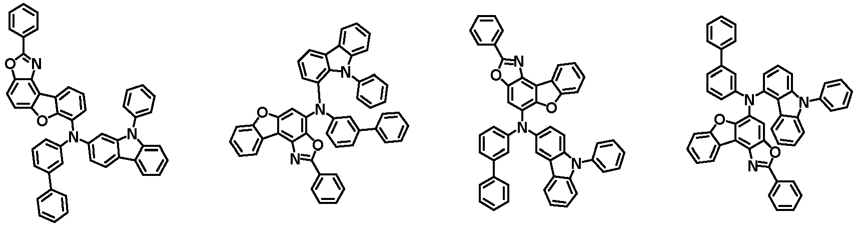

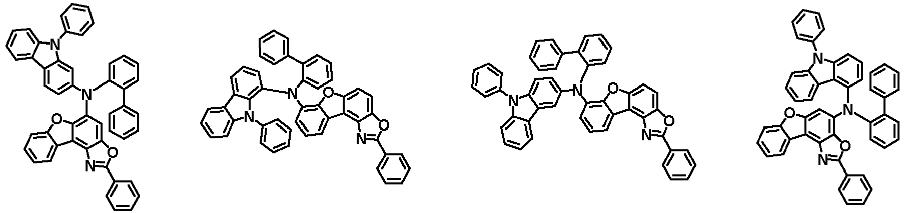

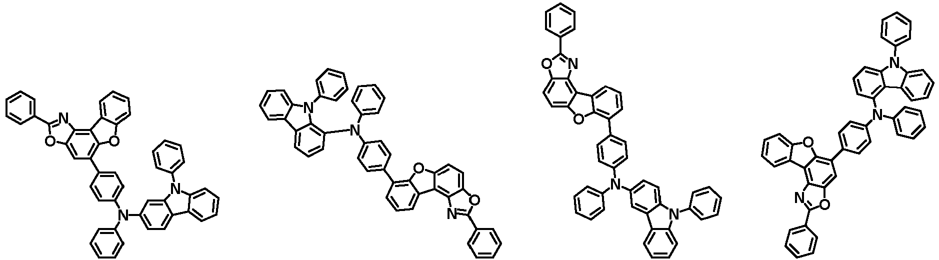

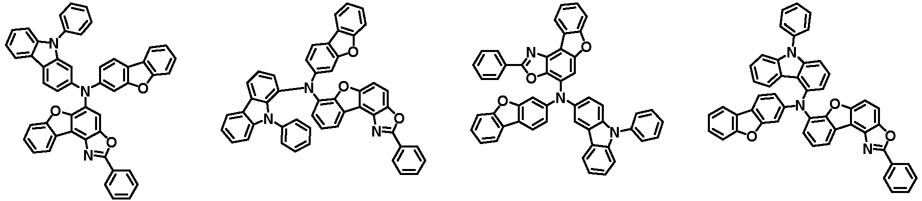

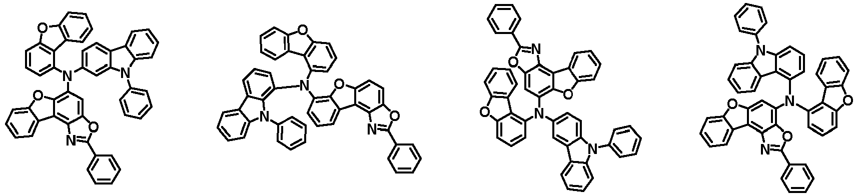

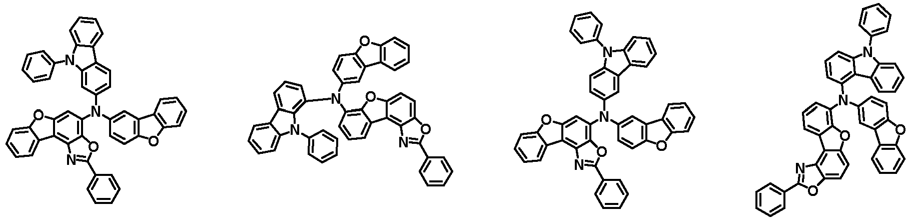

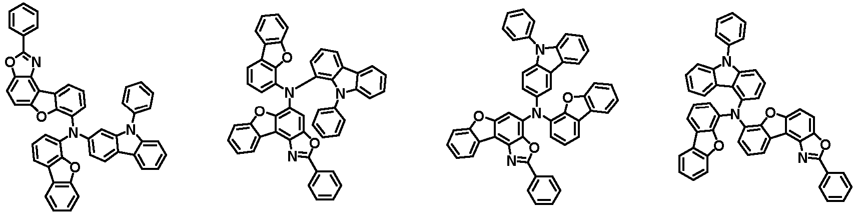

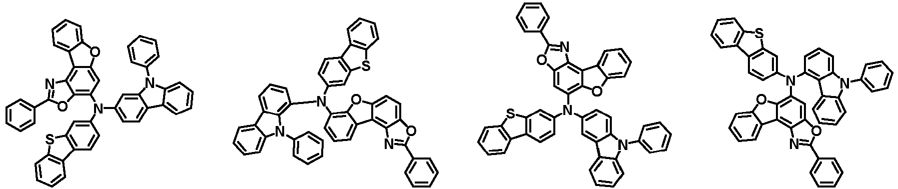

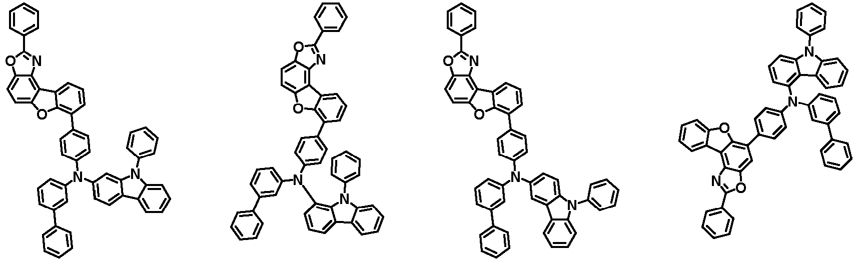

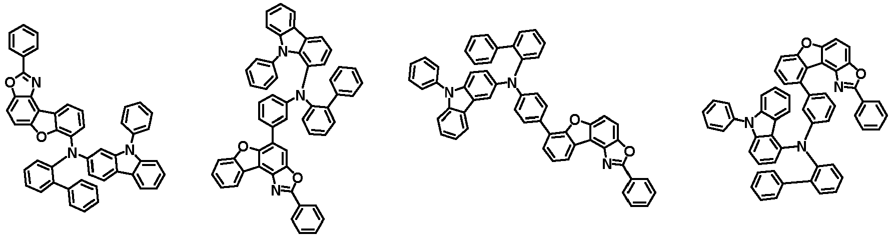

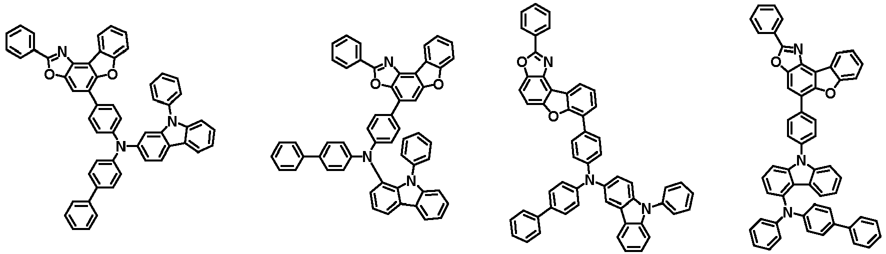

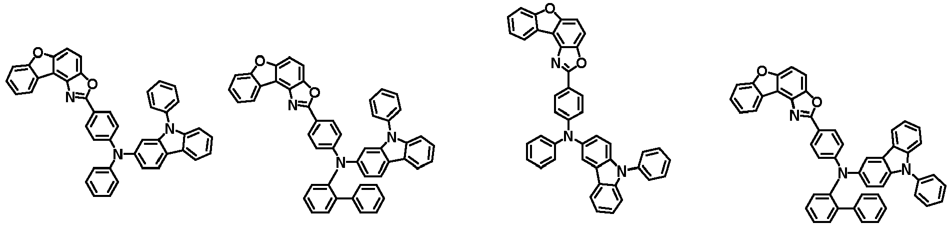

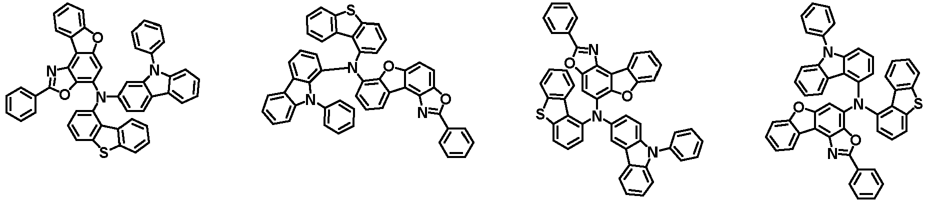

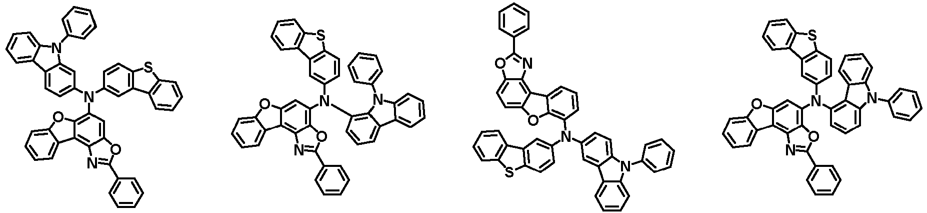

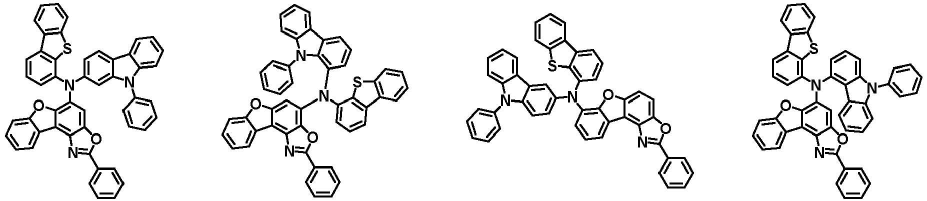

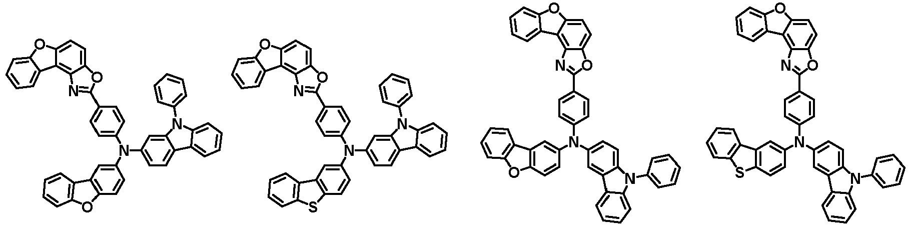

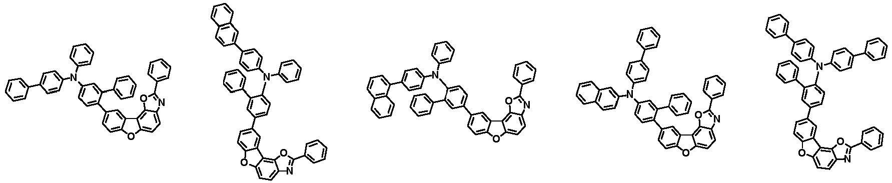

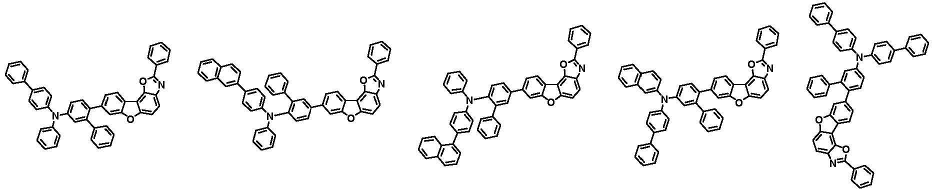

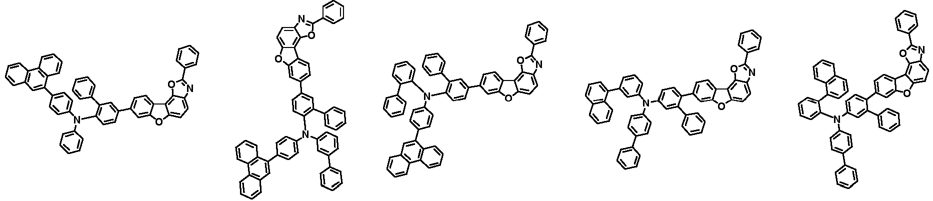

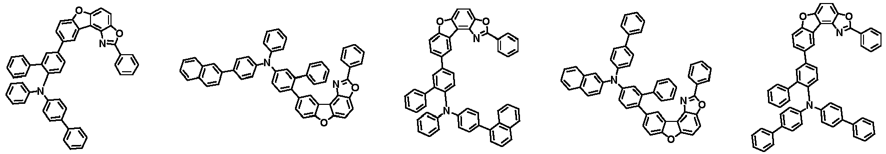

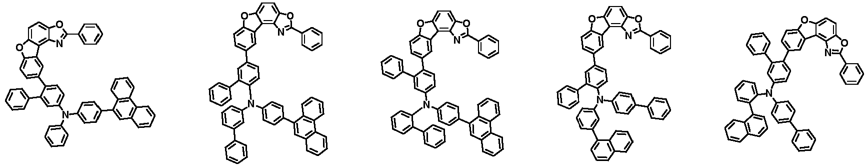

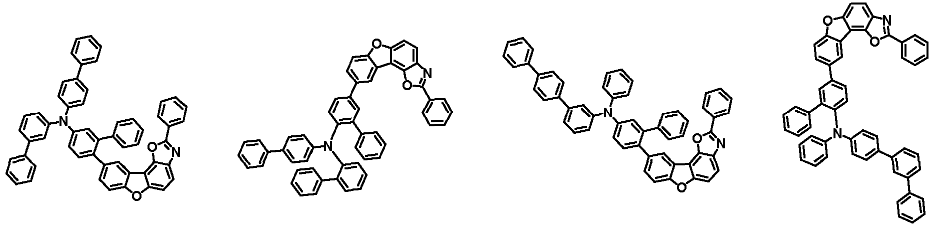

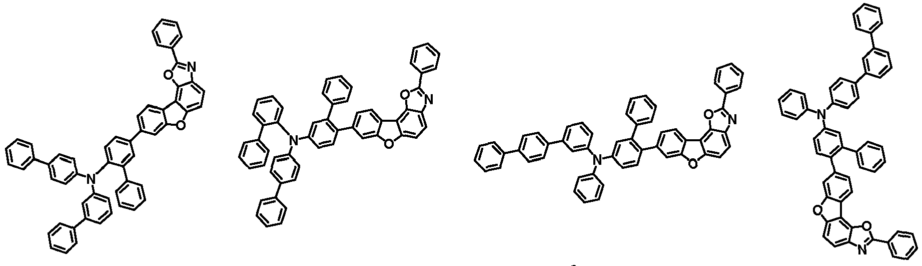

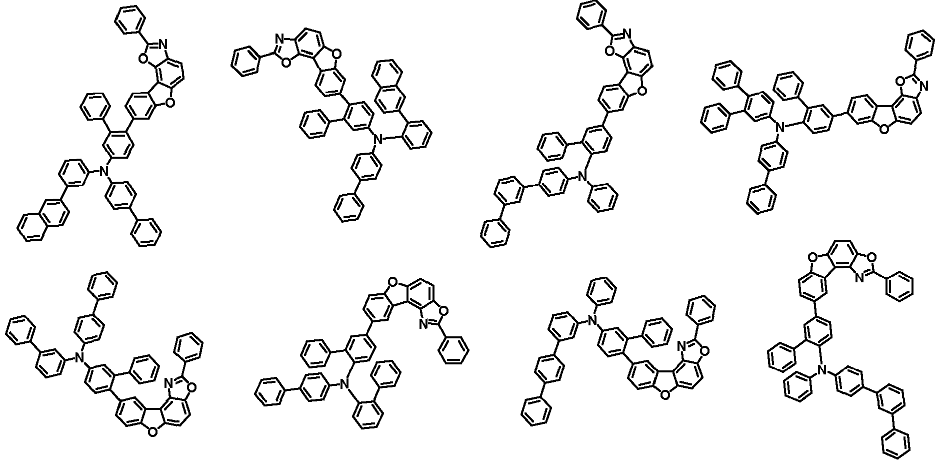

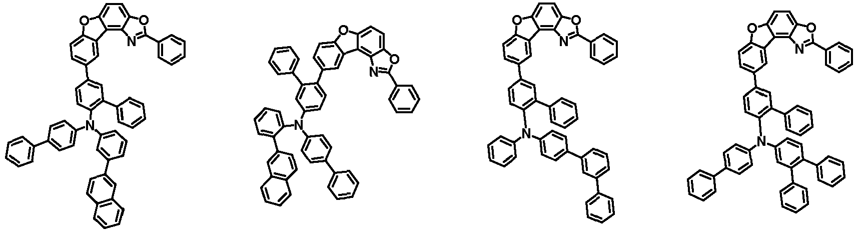

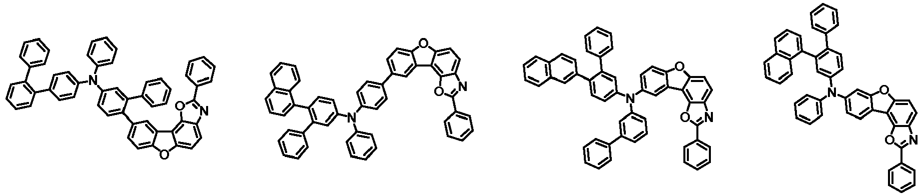

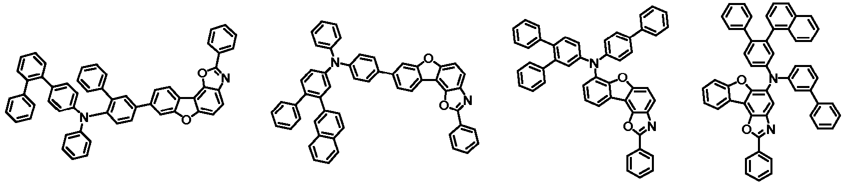

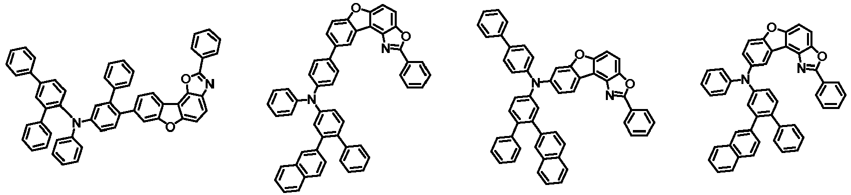

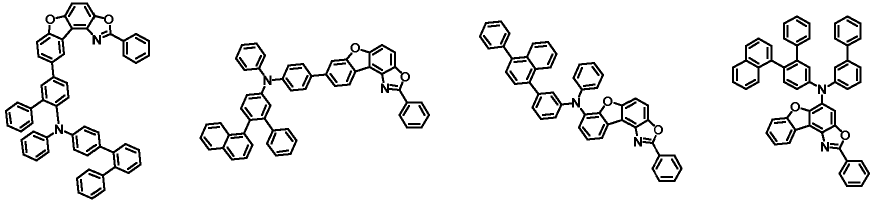

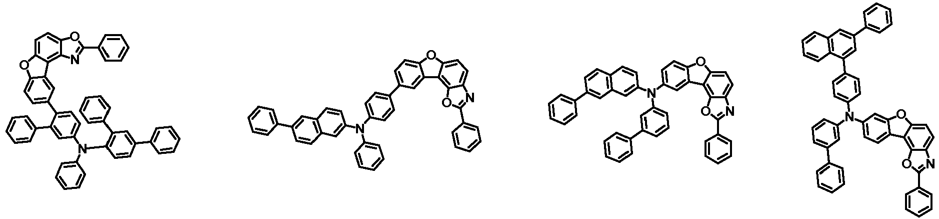

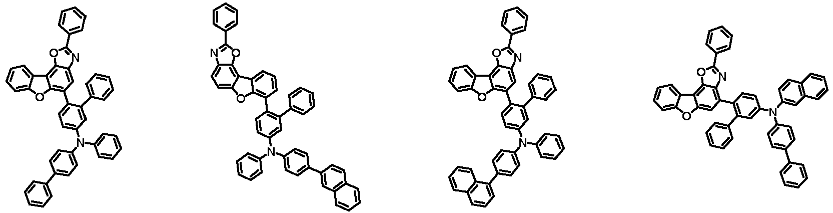

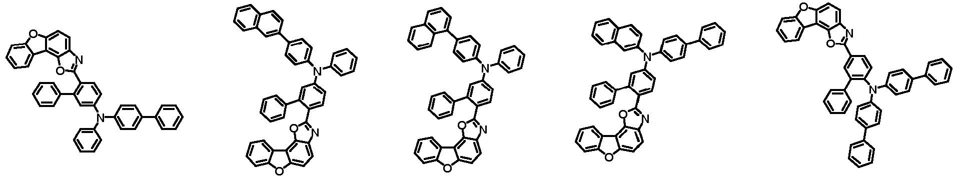

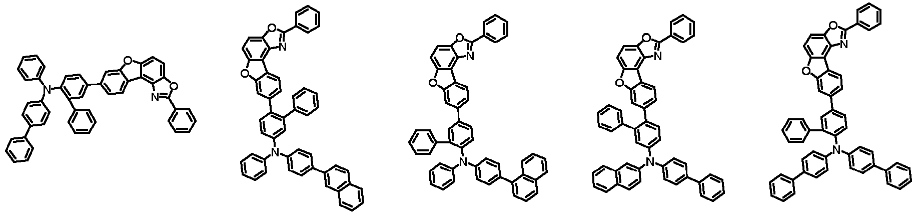

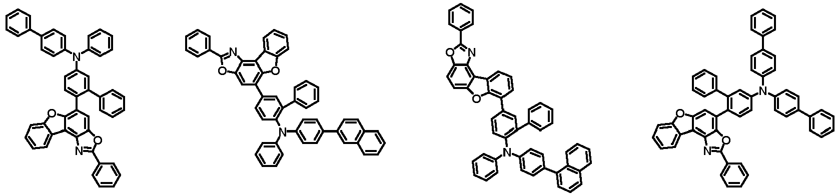

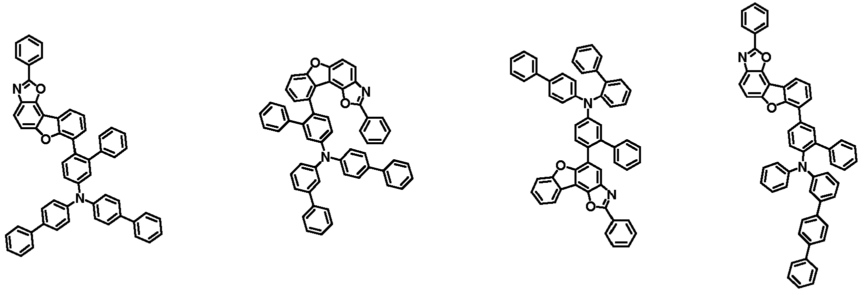

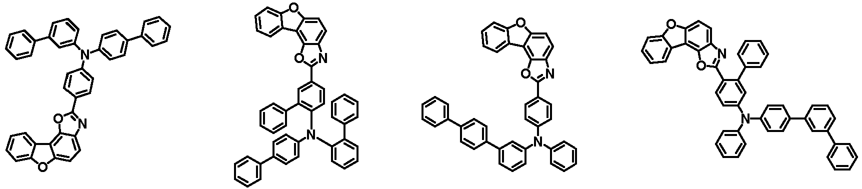

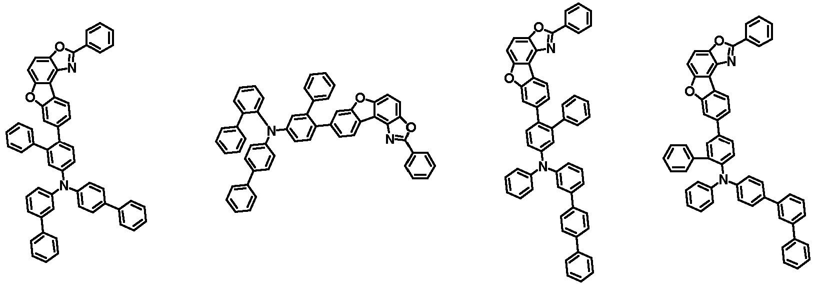

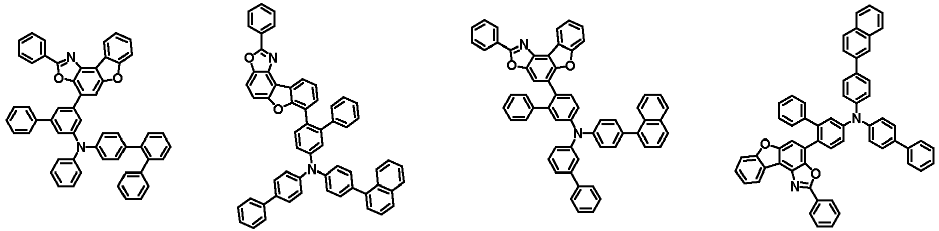

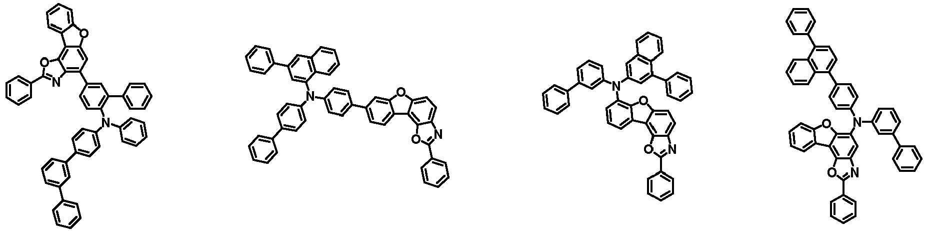

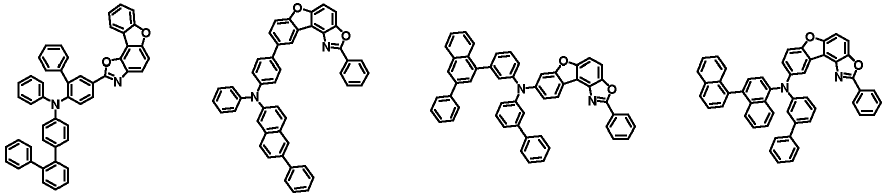

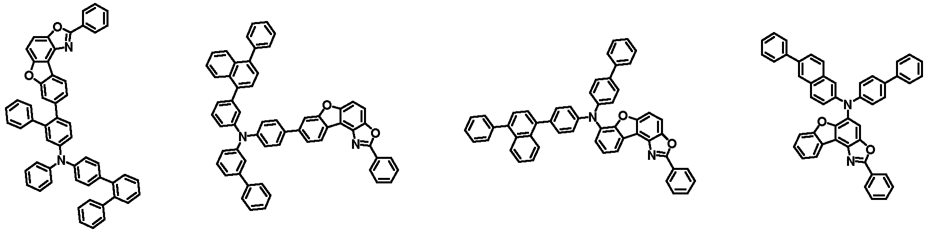

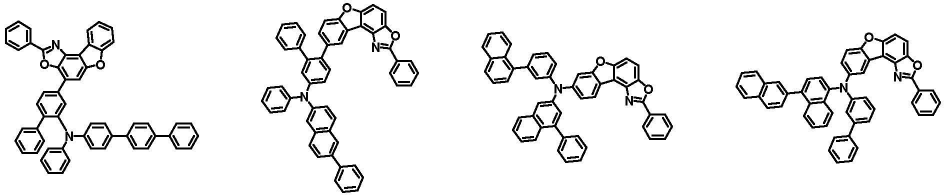

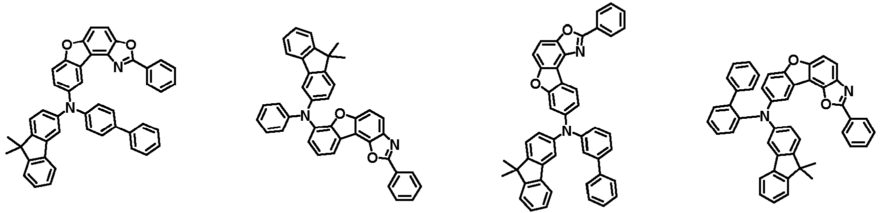

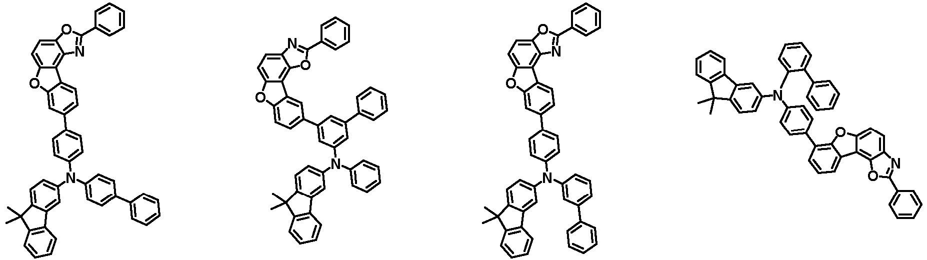

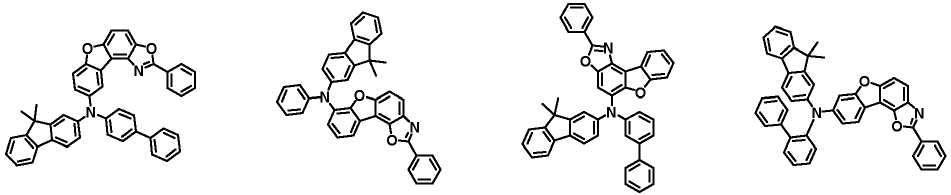

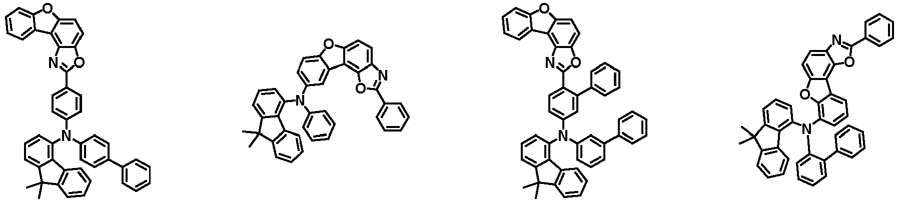

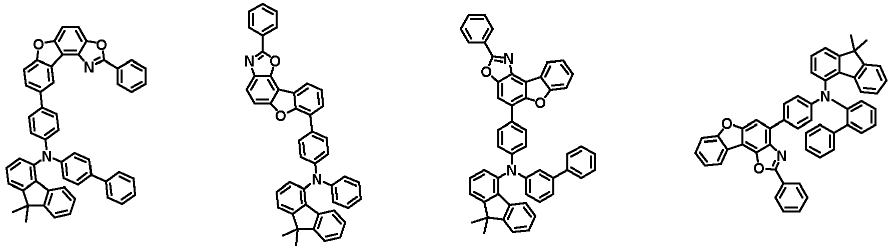

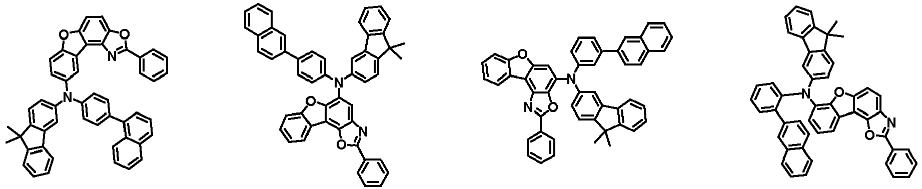

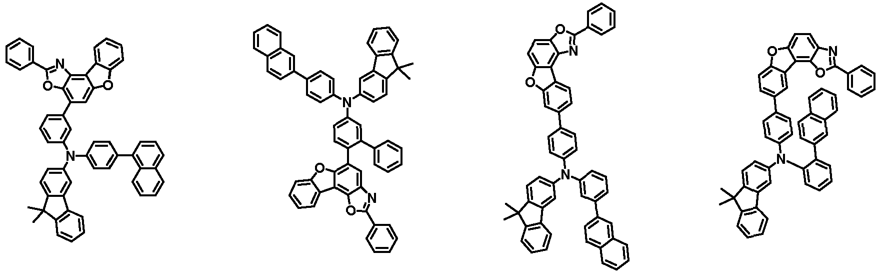

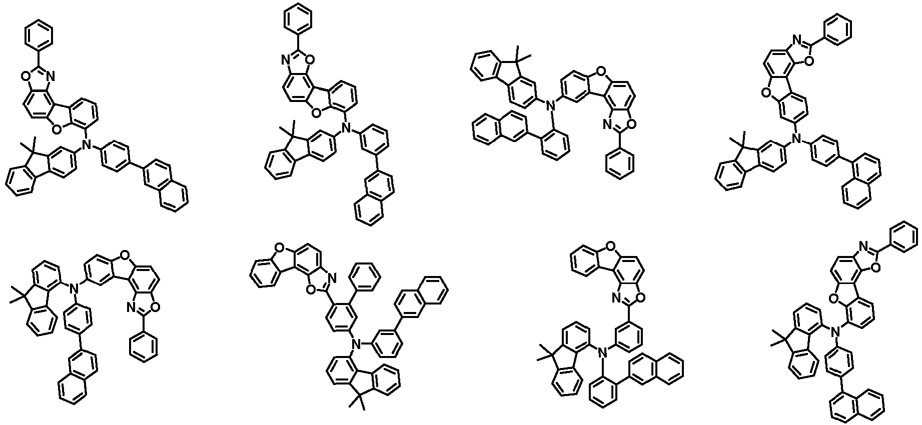

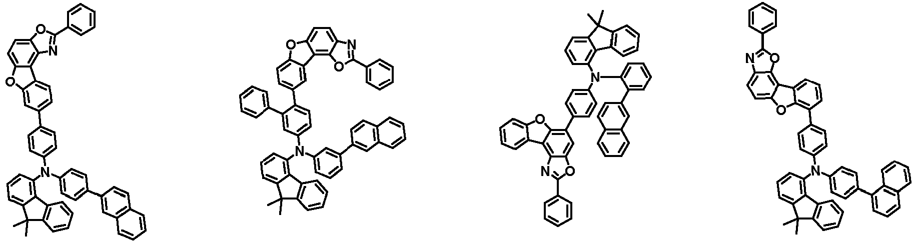

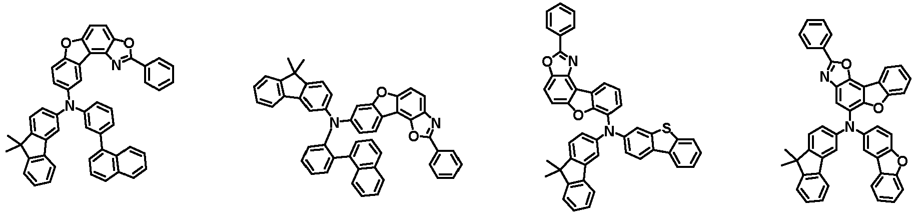

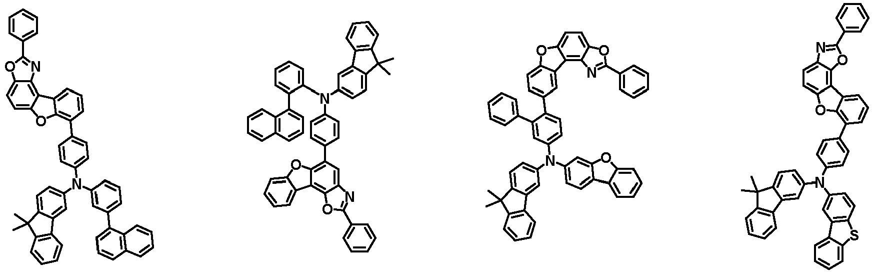

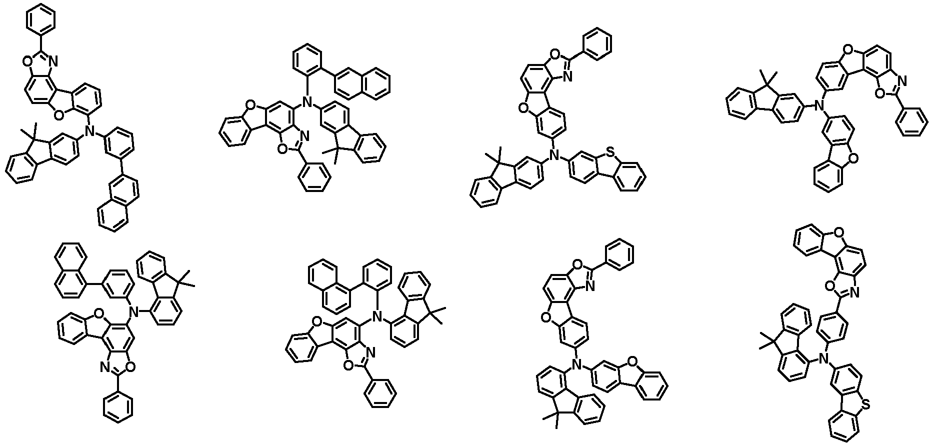

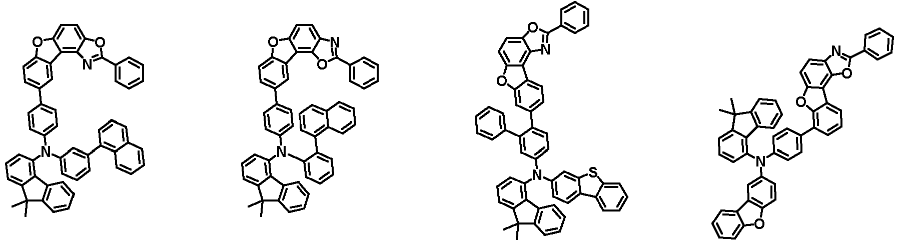

In addition, there is provided a method for preparing a compound represented by the Chemical Formula 2.

For example, when R'₁ is Ar'₁ and A'₂ is the Chemical Formula 2-b in the Chemical Formula 2, the compound of Chemical Formula 2 may be prepared by a preparation method as in Reaction Scheme 2-1 below. In addition, when L' is a single bond in the Chemical Formula 2-b, the compound of Chemical Formula 2 may be prepared by a preparation method as in Reaction Scheme 2-2 below. 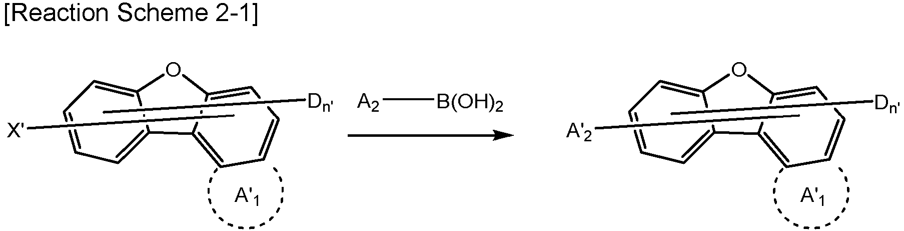 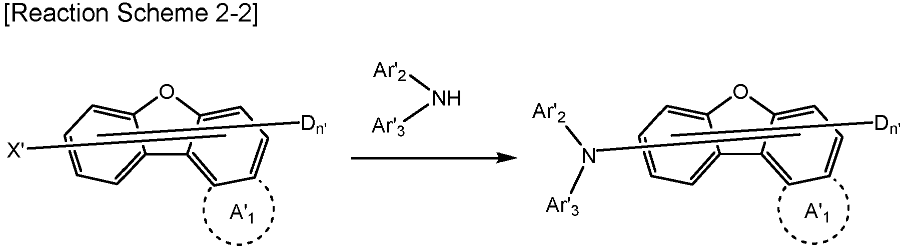 in the Reaction Schemes 2-1 to 2-2, definitions of other substituents except for X' are the same as defined in the above, and each X' is halogen, preferably bromo or chloro.

The Reaction Scheme 2-1 is a Suzuki coupling reaction, and preferably performed in the presence of a palladium catalyst and a base. In addition, the reactive group for the Suzuki coupling reaction may be appropriately changed as known in the art.

The Reaction Scheme 2-2 is an amine substitution reaction, and preferably performed in the presence of a palladium catalyst and a base. In addition, the reactive group for the amine substitution reaction may be appropriately changed as known in the art.

When R'₁ of Chemical Formula 2 is a substituent represented by the Chemical Formula 2-b, the compound represented by Chemical Formula 2 may be similarly obtained by the Suzuki coupling reaction of Reaction Scheme 2-3 or the amine substitution reaction of Reaction Scheme 2-4 below. 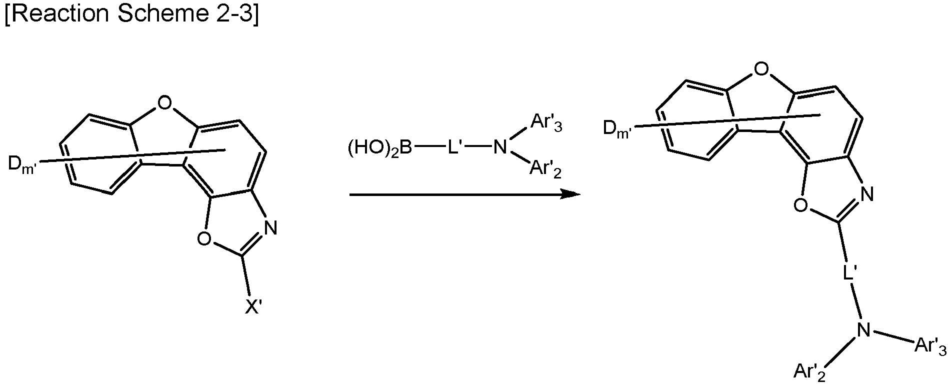 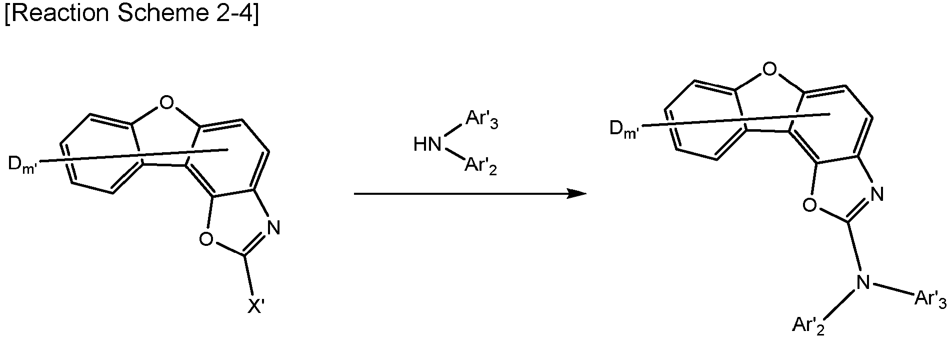 in the Reaction Schemes 2-3 and 2-4, definitions of other substituents except for X' are the same as defined in the above, and each X' is halogen, preferably bromo or chloro.

The preparation method of the compound represented by the Chemical Formula 2 may be more specifically described in Synthesis example 2 described below.

In the light emitting layer, the compound represented by the Chemical Formula 1 and the compound represented by the Chemical Formula 2 may be included at a weight ratio of 1:99 to 99:1, 5:95 to 95:5, or 10:90 to 90:10.

The dopant material is not particularly limited as long as it is a material used in an organic light emitting device. For example, the dopant material includes an aromatic amine derivative, a styrylamine compound, a boron complex, a fluoranthene compound, a metal complex, and the like. Specifically, the aromatic amine derivative is a substituted or unsubstituted fused aromatic ring derivative having an arylamino group, and examples thereof include pyrene, anthracene, chrysene, periflanthene and the like, which have an arylamino group. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, the metal complex includes an iridium complex, a platinum complex, and the like, but is not limited thereto.

In one embodiment, one or more of the following compounds may be used as the dopant material, but the present disclosure is not limited thereto:

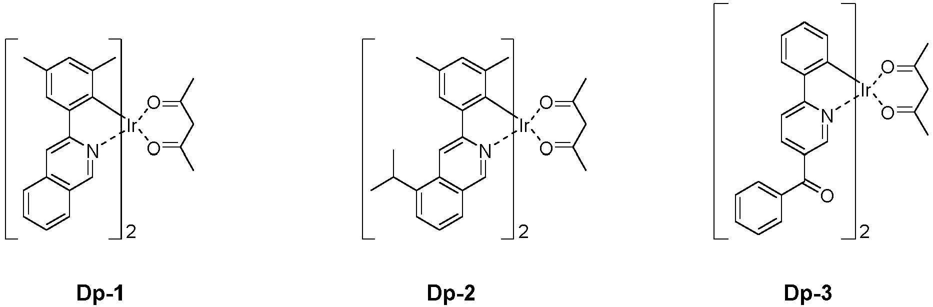

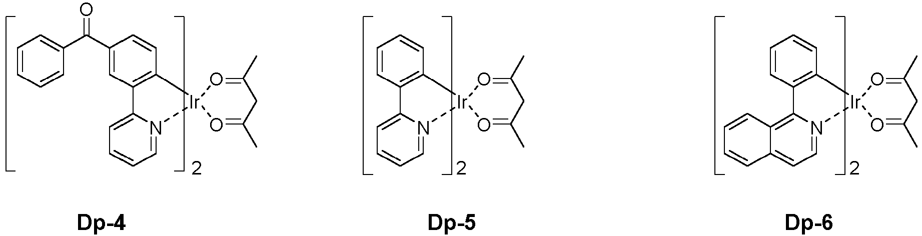

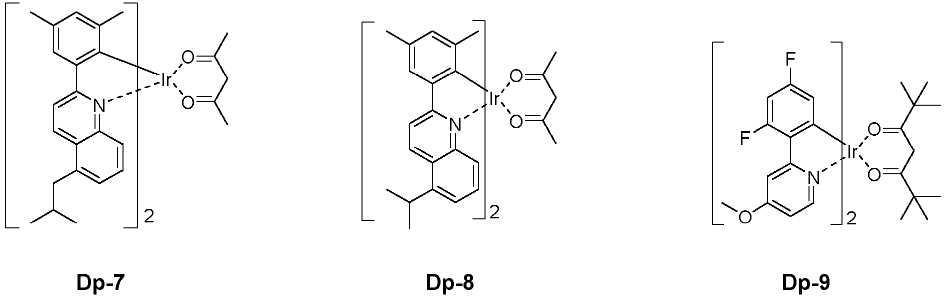

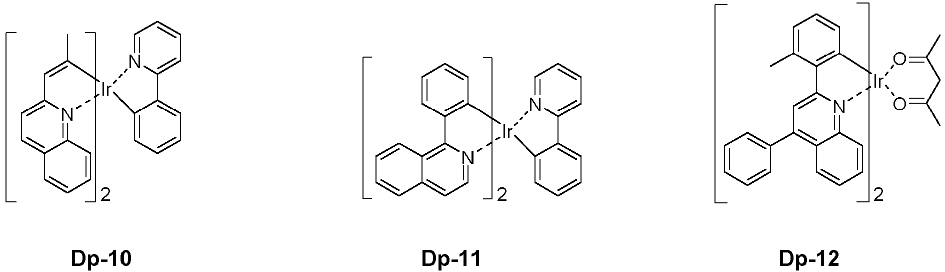

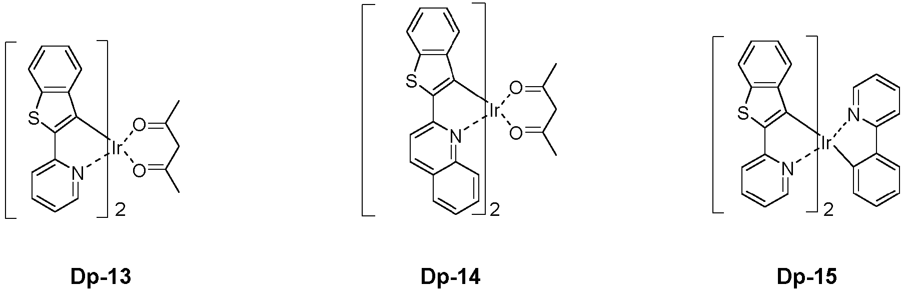

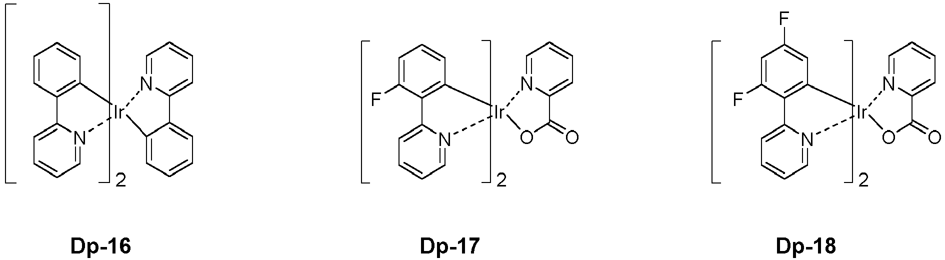

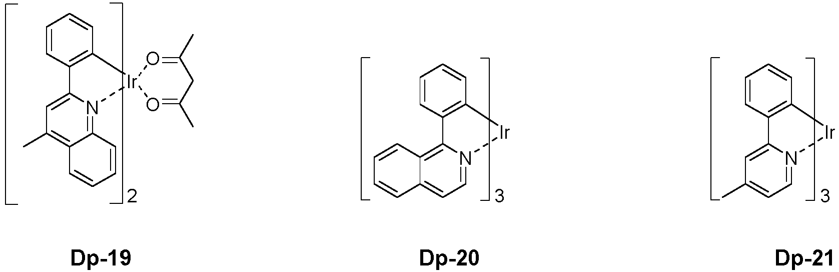

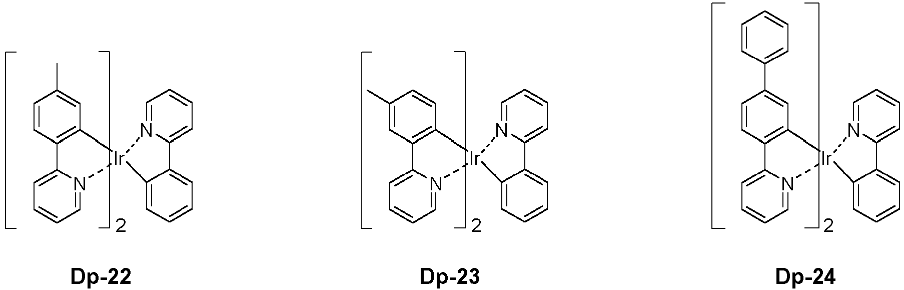

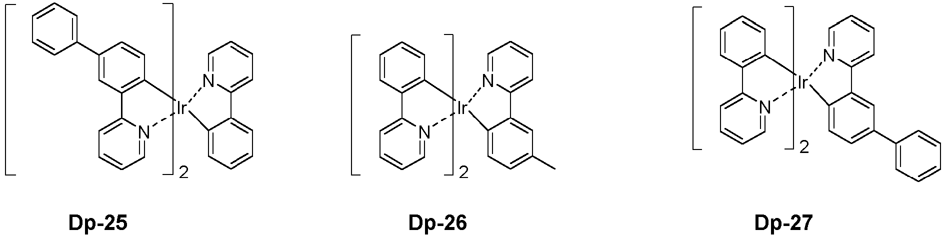

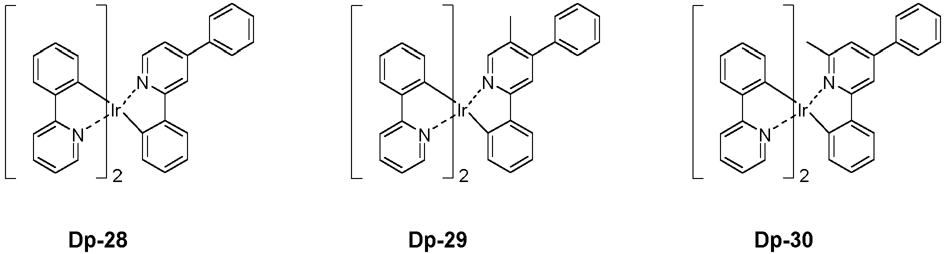

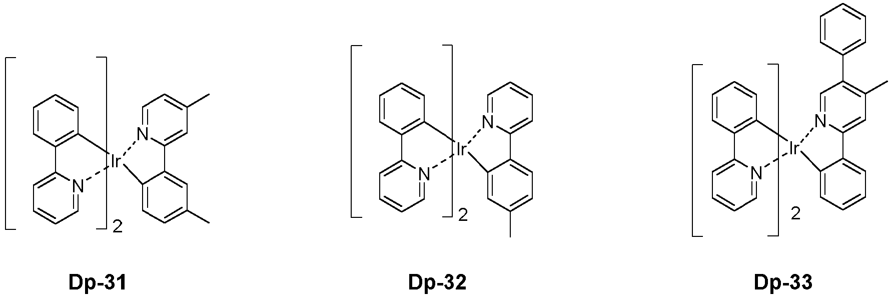

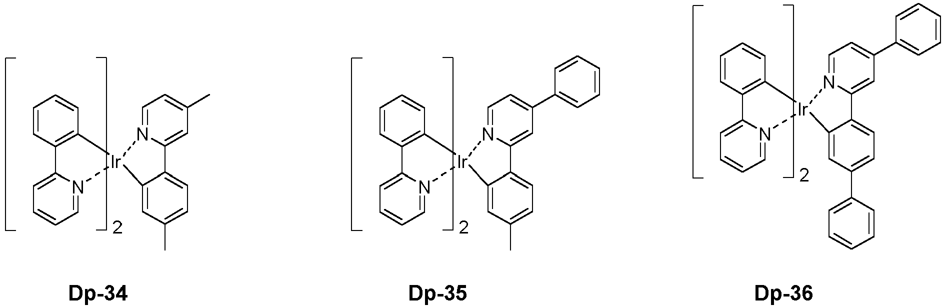

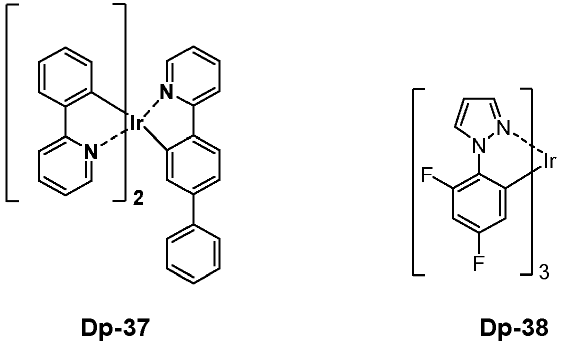

### Hole transport layer

The organic light emitting device according to the present disclosure may include a hole transport layer between the light emitting layer and the anode.

In addition, the hole transport layer is a layer that receives holes from a hole injection layer and transports the holes to the light emitting layer. The hole transport material is suitably a material having large mobility to the holes, which may receive holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together, and the like, but are not limited thereto.

### Hole injection layer

The organic light emitting device according to the present disclosure may further include a hole injection layer between the anode and the hole transport layer, if necessary.

The hole injection layer is a layer for injecting holes from the electrode, and the hole injection material is preferably a compound which has a capability of transporting the holes, thus has a hole injecting effect in the anode and an excellent hole-injecting effect to the light emitting layer or the light emitting material, prevents excitons produced in the light emitting layer from moving to an electron injection layer or the electron injection material, and is excellent in the ability to form a thin film. It is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Electron blocking layer

The organic light emitting device according to the present disclosure may include an electron blocking layer between a hole transport layer and a light emitting layer, if necessary.

The electron blocking layer prevents electrons injected from the cathode from being transferred to the hole transport layer without recombination in the light emitting layer, and is also called an electron suppressing layer. A material having the electron affinity lower than that of the electron transport layer is preferable for the electron blocking layer.

### Electron transport layer

The organic light emitting device according to the present disclosure may include an electron transport layer between the light emitting layer and the cathode.

The electron transport layer receives electrons from a cathode or an electron injection layer formed on the cathode and transports the electrons to a light emitting layer, and also inhibits the transport of holes in the light emitting layer. The electron transport material is suitably a material which can receive electrons well from a cathode and transfer the electrons to a light emitting layer and has large mobility for electrons.

Specifically, examples thereof may include an Al complex of 8-hydroxyquinoline; a complex including Alq₃; an organic radical compound; a hydroxyflavone-metal complex, and the like, but are not limited thereto. The electron transport layer may be used with any desired cathode material, as used according to the related art. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron injection layer

The organic light emitting device according to the present disclosure may further include an electron injection layer between the electron transport layer and the cathode, if necessary.

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the material that can be used for the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

According to one embodiment of the present disclosure, the electron transport material and the electron injection material may be simultaneously deposited to form an electron injection and transport layer as a single layer.

### Hole blocking layer

The organic light emitting device according to the present disclosure may include a hole blocking layer between the electron transport layer and the light emitting layer, if necessary.

The hole blocking layer prevents holes injected from the anode from being transferred to the electron transport layer without recombination in the light emitting layer, and a material having high ionization energy is preferable for the hole blocking layer.

### Organic light emitting device

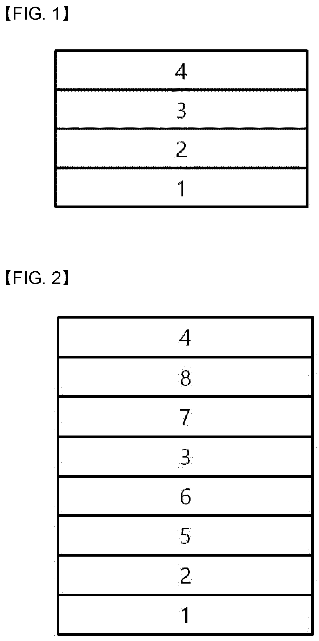

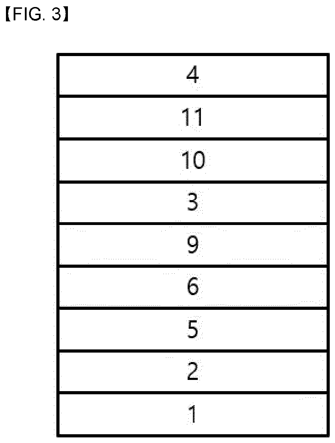

A structure of the organic light emitting device according to the present disclosure is illustrated in FIG. 1. FIG. 1 shows an example of an organic light emitting device including a substrate 1, an anode 2, a light emitting layer 3, and a cathode 4. FIG. 2 shows an example of an organic light emitting device including a substrate 1, an anode 2, a hole injection layer 5, a hole transport layer 6, a light emitting layer 3, an electron transport layer 7, an electron injection layer 8, and a cathode 4. FIG. 3 shows an example of an organic light emitting device including a substrate 1, an anode 2, a hole injection layer 5, a hole transport layer 6, an electron blocking layer 9, a light emitting layer 3, a hole blocking layer 10, an electron injection and transport layer 11, and a cathode 4.

The organic light emitting device according to the present disclosure may be manufactured by sequentially laminating the above-described components. In this case, the organic light emitting device may be manufactured by depositing a metal, metal oxides having conductivity, or an alloy thereof on the substrate using a PVD (physical vapor deposition) method such as a sputtering method or an e-beam evaporation method to form an anode, forming the above-mentioned respective layers thereon, and then depositing a material that can be used as the cathode thereon.

In addition to such a method, the organic light emitting device may be manufactured by sequentially depositing the above-described components from a cathode material to an anode material in the reverse order on a substrate (WO 2003/012890). Further, the light emitting layer may be formed using the host and the dopant by a solution coating method as well as a vacuum deposition method. Herein, the solution coating method means a spin coating, a dip coating, a doctor blading, an inkjet printing, a screen printing, a spray method, a roll coating, or the like, but is not limited thereto.

The organic light emitting device according to the present disclosure may be a bottom emission device, a top emission device, or a double-sided emission device, and in particular, may be a bottom emission device requiring relatively high luminous efficiency.

The preparation of the organic light emitting device according to the present disclosure will be described in detail in the following examples. However, these examples are presented for illustrative purposes only, and are not intended to limit the scope of the present disclosure.

### [Examples]

### <Synthesis Example 1: Preparation of compound of Chemical Formula 1>

### Synthesis Example 1-1

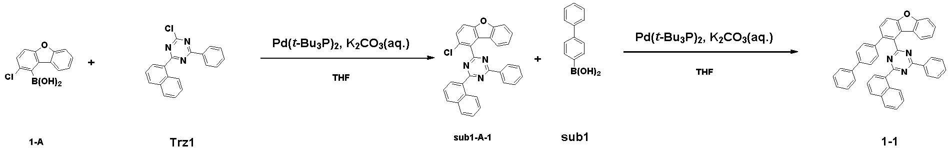

Chemical Formula 1-A (15g, 60.9mmol) and Trz1 (19.3g, 60.9mmol) were added to 300 ml of **THF** under a nitrogen atmosphere, and the mixture was stirred and refluxed. Then, potassium carbonate (16.8g, 121.7mmol) was dissolved in 50 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.9 g of sub1-A-1 (yield 71%, MS: [M+H]+= 484).

sub1-A-1 (15g, 31mmol) and sub1 (6.1g, 31mmol) were added to 300 ml of THF under a nitrogen atmosphere, and the mixture was stirred and refluxed. Then, potassium carbonate (8.6g, 62mmol) was dissolved in 26 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.3 g of Compound 1-1 (yield 66%, MS: [M+H]+= 602).

### Synthesis Example 1-2

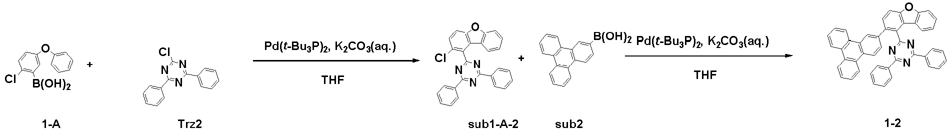

Chemical Formula 1-A (15g, 60.9mmol) and Trz2 (16.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 19.5 g of sub1-A-2 (yield 74%, MS: [M+H]+= 434).

sub1-A-2 (15g, 34.6mmol) and sub2 (9.4g, 34.6mmol) were added to 300 ml of THF under a nitrogen atmosphere, and the mixture was stirred and refluxed. Then, potassium carbonate (9.6g, 69.1mmol) was dissolved in 29 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.3 g of Compound 1-2 (yield 66%, MS: [M+H]+= 626).

### Synthesis Example 1-3

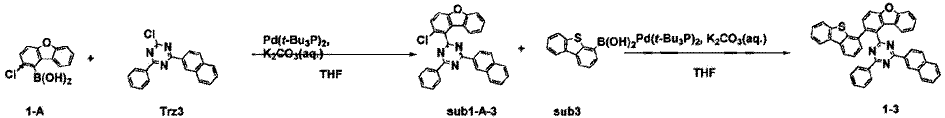

Chemical Formula 1-A (15g, 60.9mmol) and Trz3 (19.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 2 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 23.2 g of sub1-A-3 (yield 79%, MS: [M+H]+= 484).

sub1-A-3 (15g, 31mmol) and sub3 (7.1 g, 31mmol) were added to 300 ml of THF under a nitrogen atmosphere, and the mixture was stirred and refluxed. Then, potassium carbonate (8.6g, 62mmol) was dissolved in 26 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.9 g of Compound 1-3 (yield 66%, MS: [M+H]+= 632).

### Synthesis Example 1-4

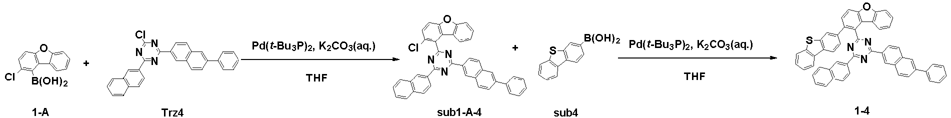

Chemical Formula 1-A (15g, 60.9mmol) and Trz4 (27g, 60.9mmol) were added to 300 ml of THF under a nitrogen atmosphere, and the mixture was stirred and refluxed.

Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 5 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26 g of sub1-A-4 (yield 70%, MS: [M+H]+= 610).

sub1-A-4 (15g, 24.6mmol) and sub4 (5.6g, 24.6mmol) were added to 300 ml of THF under a nitrogen atmosphere, and the mixture was stirred and refluxed. Then, potassium carbonate (6.8g, 49.2mmol) was dissolved in 20 ml of water, and then added thereto. Thereafter, it was stirred sufficiently, followed by adding bis(tri-tert-butylphosphine)palladium(0) (0.1g, 0.2mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 11.2 g of Compound 1-4 (yield 60%, MS: [M+H]+= 758).

### Synthesis Example 1-5

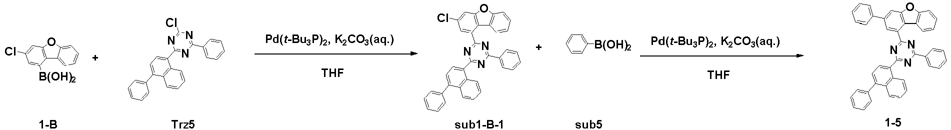

Chemical Formula 1-B (15g, 60.9mmol) and Trz5 (24g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26.2 g of sub1-B-1 (yield 77%, MS: [M+H]+= 560).

sub1-B-1 (15g, 26.8mmol) and sub5 (3.3g, 26.8mmol) were added to 300 ml of **THF** under a nitrogen atmosphere, and the mixture was stirred and refluxed. Then, potassium carbonate (7.4g, 53.6mmol) was dissolved in 22 ml of water, and then added thereto. Thereafter, it was stirred sufficiently, followed by adding bis(tri-tert-butylphosphine)palladium(0) (0.1g, 0.3mmol). After 2 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.9 g of Compound 1-5 (yield 80%, MS: [M+H]+= 602).

### Synthesis Example 1-6

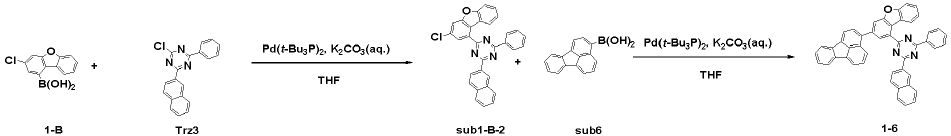

Chemical Formula 1-B (15g, 60.9mmol) and Trz3 (19.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 18.2 g of sub1-B-2 (yield 62%, MS: [M+H]+= 484).

sub1-B-2 (15g, 31mmol) and sub6 (7.6g, 31mmol) were added to 300 ml of **THF** under a nitrogen atmosphere, and the mixture was stirred and refluxed. Then, potassium carbonate (8.6g, 62mmol) was dissolved in 26 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.3 g of Compound 1-6 (yield 76%, MS: [M+H]+= 650).

### Synthesis Example 1-7

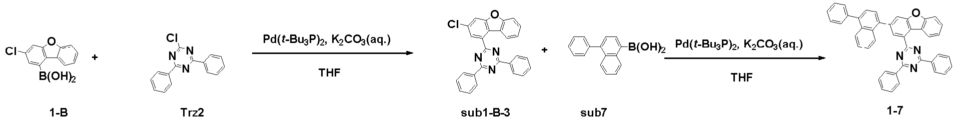

Chemical Formula 1-B (15g, 60.9mmol) and Trz2 (16.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.8 g of sub1-B-3 (yield 79%, MS: [M+H]+= 434).

sub1-B-3 (15g, 34.6mmol) and sub7 (8.6g, 34.6mmol) were added to 300 ml of THF under a nitrogen atmosphere, and the mixture was stirred and refluxed. Then, potassium carbonate (9.6g, 69.1mmol) was dissolved in 29 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.4 g of Compound 1-7 (yield 74%, MS: [M+H]+= 602).

### Synthesis Example 1-8

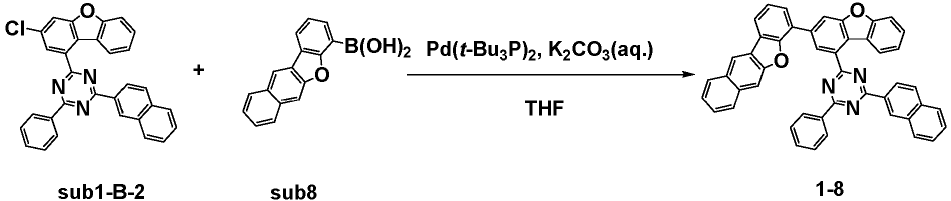

sub1-B-2 (15g, 31 mmol) and sub8 (8.1 g, 31 mmol) were added to 300 ml of THF under a nitrogen atmosphere, and the mixture was stirred and refluxed. Then, potassium carbonate (8.6g, 62mmol) was dissolved in 26 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.5 g of Compound 1-8 (yield 75%, MS: [M+H]+= 666).

### Synthesis Example 1-9

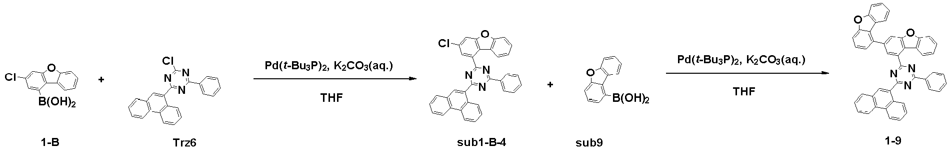

Chemical Formula 1-B (15g, 60.9mmol) and Trz6 (22.4g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 23.7 g of sub1-B-4 (yield 73%, MS: [M+H]+= 534).

sub1-B-4 (15g, 28.1mmol) and sub9 (6g, 28.1mmol) were added to 300 ml of **THF** under a nitrogen atmosphere, and the mixture was stirred and refluxed. Then, potassium carbonate (7.8g, 56.2mmol) was dissolved in 23 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 11.6 g of Compound 1-9 (yield 62%, MS: [M+H]+= 666).

### Synthesis Example 1-10

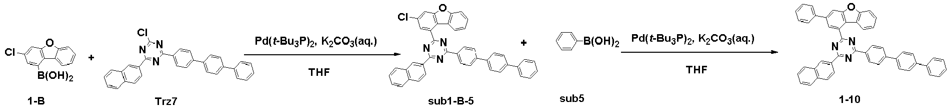

Chemical Formula 1-B (15g, 60.9mmol) and Trz7 (28.6g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 28.6 g of sub1-B-5 (yield 74%, MS: [M+H]+= 636).

sub1-B-5 (15g, 23.6mmol) and sub5 (2.9g, 23.6mmol) were added to 300 ml of THF under a nitrogen atmosphere, and the mixture was stirred and refluxed. Then, potassium carbonate (6.5g, 47.2mmol) was dissolved in 20 ml of water, and then added thereto. Thereafter, it was stirred sufficiently, followed by adding bis(tri-tert-butylphosphine)palladium(0) (0.1g, 0.2mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.4 g of Compound 1-10 (yield 65%, MS: [M+H]+= 678).

### Synthesis Example 1-11

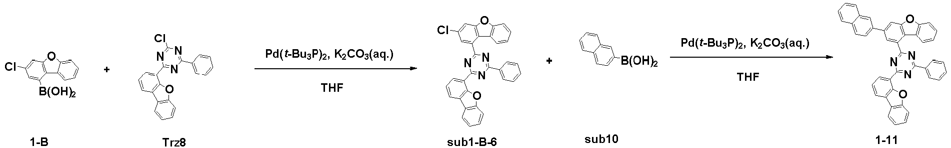

Chemical Formula 1-B (15g, 60.9mmol) and Trz8 (21.8g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.1 g of sub1-B-6 (yield 63%, MS: [M+H]+= 524).

sub1-B-6 (15g, 28.6mmol) and sub10 (4.9g, 28.6mmol) were added to 300 ml of THF under a nitrogen atmosphere, and the mixture was stirred and refluxed. Then, potassium carbonate (7.9g, 57.3mmol) was dissolved in 24 ml of water, and then added thereto. Thereafter, it was stirred sufficiently, followed by adding bis(tri-tert-butylphosphine)palladium(0) (0.1g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 11.4 g of Compound 1-11 (yield 65%, MS: [M+H]+= 616).

### Synthesis Example 1-12

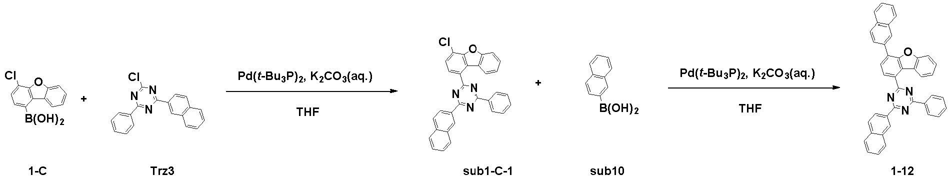

Chemical Formula 1-C (15g, 60.9mmol) and Trz3 (19.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 17.6 g of sub1-C-1 (yield 60%, MS: [M+H]+= 484).

sub1-C-1 (15g, 31mmol) and sub10 (5.3g, 31mmol) were added to 300 ml of THF under a nitrogen atmosphere, and the mixture was stirred and refluxed. Then, potassium carbonate (8.6g, 62mmol) was dissolved in 26 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.8 g of Compound 1-12 (yield 72%, MS: [M+H]+= 576).

### Synthesis Example 1-13

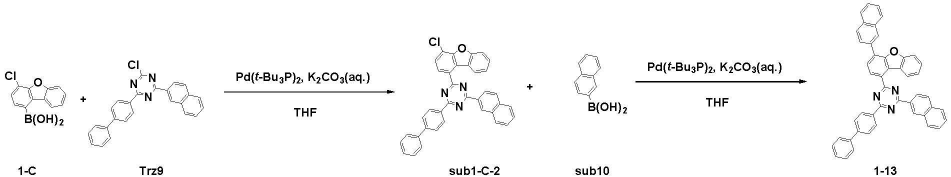

Chemical Formula 1-C (15g, 60.9mmol) and Trz9 (24g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 23.5 g of sub1-C-2 (yield 69%, MS: [M+H]+= 560).

sub1-C-2 (15g, 26.8mmol) and sub10 (4.6g, 26.8mmol) were added to 300 ml of THF under a nitrogen atmosphere, and the mixture was stirred and refluxed. Then, potassium carbonate (7.4g, 53.6mmol) was dissolved in 22 ml of water, and then added thereto. Thereafter, it was stirred sufficiently, followed by adding bis(tri-tert-butylphosphine)palladium(0) (0.1g, 0.3mmol). After 5 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14 g of Compound 1-13 (yield 80%, MS: [M+H]+= 652).

### Synthesis Example 1-14

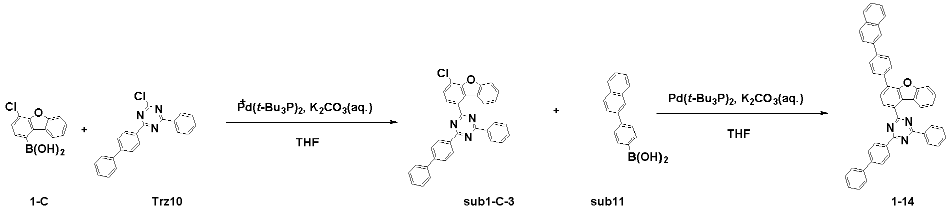

Chemical Formula 1-C (15g, 60.9mmol) and Trz10 (20.9g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.5 g of sub1-C-3 (yield 66%, MS: [M+H]+= 510).

sub1-C-3 (15g, 29.4mmol) and sub11 (7.3g, 29.4mmol) were added to 300 ml of THF under a nitrogen atmosphere, and the mixture was stirred and refluxed. Then, potassium carbonate (8.1g, 58.8mmol) was dissolved in 24 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.3 g of Compound 1-14 (yield 77%, MS: [M+H]+= 678).

### Synthesis Example 1-15

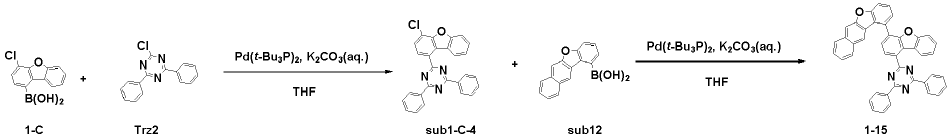

Chemical Formula 1-C (15g, 60.9mmol) and Trz2 (16.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 18.7 g of sub1-C-4 (yield 71 %, MS: [M+H]+= 434).

sub1-C-4 (15g, 37.1mmol) and sub12 (9.7g, 37.1mmol) were added to 300 ml of THF under a nitrogen atmosphere, and the mixture was stirred and refluxed. Then, potassium carbonate (10.3g, 74.3mmol) was dissolved in 31 ml of water, and then added thereto. Thereafter, it was stirred sufficiently, followed by adding bis(tri-tert-butylphosphine)palladium(0) (0.2g, 0.4mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.6 g of Compound 1-15 (yield 64%, MS: [M+H]+= 616).

### Synthesis Example 1-16

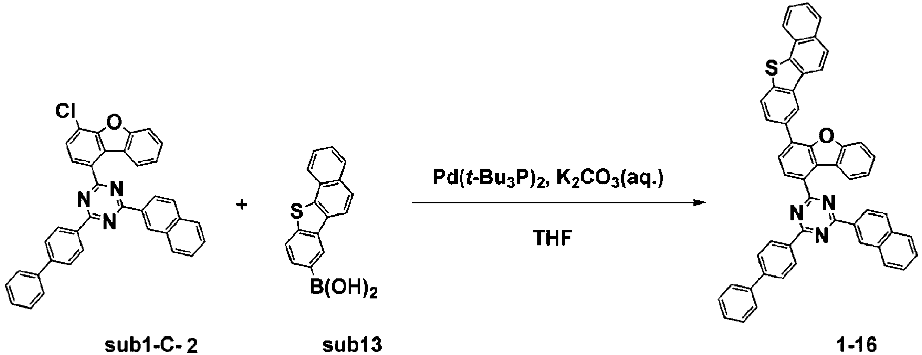

sub1-C-2 (15g, 26.8mmol) and sub13 (7.4g, 26.8mmol) were added to 300 ml of THF under a nitrogen atmosphere, and the mixture was stirred and refluxed. Then, potassium carbonate (7.4g, 53.6mmol) was dissolved in 22 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 16.2 g of Compound 1-16 (yield 80%, MS: [M+H]+= 758).

### Synthesis Example 1-17

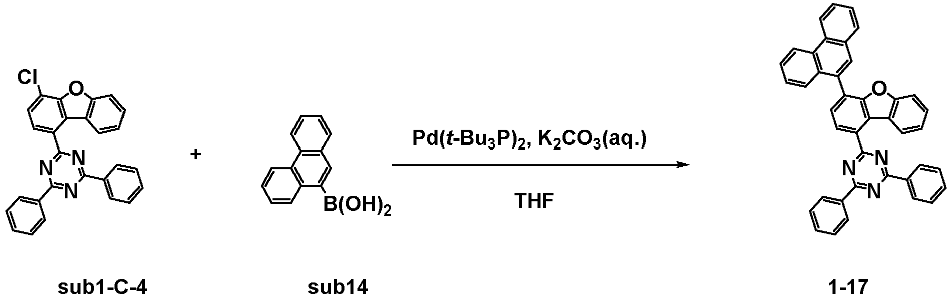

sub1-C-4 (15g, 34.6mmol) and sub14 (7.7g, 34.6mmol) were added to 300 ml of THF under a nitrogen atmosphere, and the mixture was stirred and refluxed. Then, potassium carbonate (9.6g, 69.1mmol) was dissolved in 29 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.3 g of Compound 1-17 (yield 62%, MS: [M+H]+= 576).

### Synthesis Example 1-18

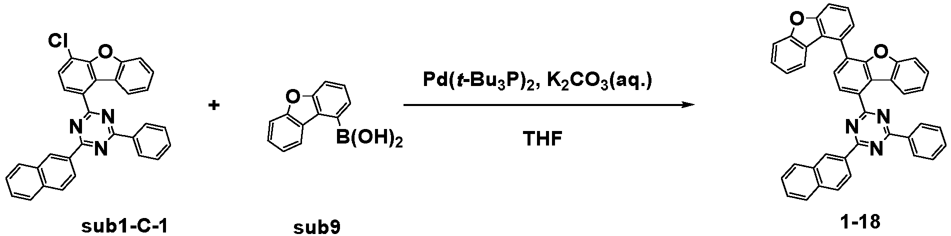

sub1-C-1 (15g, 31 mmol) and sub9 (6.6g, 31mmol) were added to 300 ml of THF under a nitrogen atmosphere, and the mixture was stirred and refluxed. Then, potassium carbonate (8.6g, 62mmol) was dissolved in 26 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12 g of Compound 1-18 (yield 63%, MS: [M+H]+= 616).

### Synthesis Example 1-19

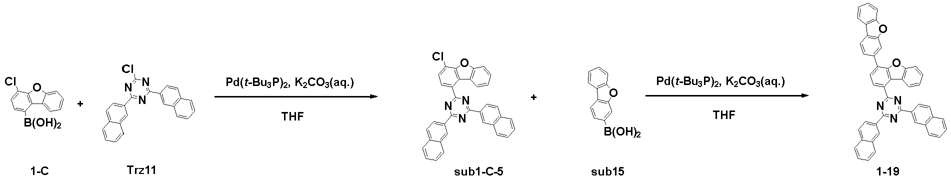

Chemical Formula 1-C (15g, 60.9mmol) and Trz11 (22.4g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 22.4 g of sub1-C-5 (yield 69%, MS: [M+H]+= 534).

sub1-C-5 (15g, 28.1mmol) and sub15 (6g, 28.1mmol) were added to 300 ml of THF under a nitrogen atmosphere, and the mixture was stirred and refluxed. Then, potassium carbonate (7.8g, 56.2mmol) was dissolved in 23 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.3 g of Compound 1-19 (yield 71%, MS: [M+H]+= 666).

### Synthesis Example 1-20

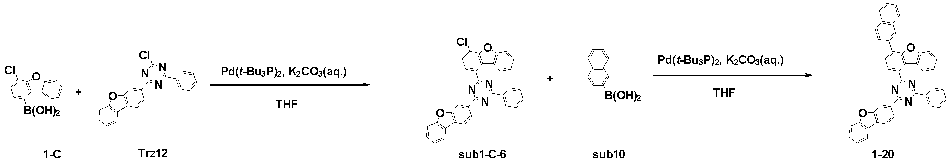

Chemical Formula 1-C (15g, 60.9mmol) and Trz12 (21.8g, 60.9mmol) were added to 300 ml of **THF** under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 21 g of sub1-C-6 (yield 66%, MS: [M+H]+= 524).

sub1-C-6 (15g, 28.6mmol) and sub10 (4.9g, 28.6mmol) were added to 300 ml of **THF** under a nitrogen atmosphere, and the mixture was stirred and refluxed. Then, potassium carbonate (11.9g, 85.9mmol) was dissolved in 36 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.3 g of Compound 1-20 (yield 70%, MS: [M+H]+= 616).

### Synthesis Example 1-21

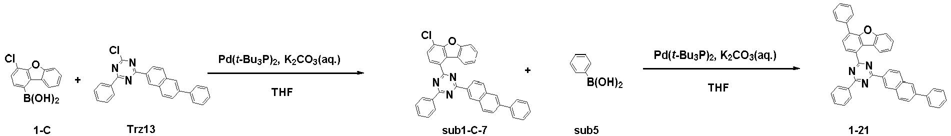

Chemical Formula 1-C (15g, 60.9mmol) and Trz13 (24g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26.2 g of sub1-C-7 (yield 77%, MS: [M+H]+= 560).

sub1-C-7 (15g, 26.8mmol) and sub5 (3.3g, 26.8mmol) were added to 300 ml of THF under a nitrogen atmosphere, and the mixture was stirred and refluxed. Then, potassium carbonate (11.1g, 80.3mmol) was dissolved in 33 ml of water, and then added thereto. Thereafter, it was stirred sufficiently, followed by adding bis(tri-tert-butylphosphine)palladium(0) (0.1g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.5 g of Compound 1-21 (yield 65%, MS: [M+H]+= 602).

### Synthesis Example 1-22

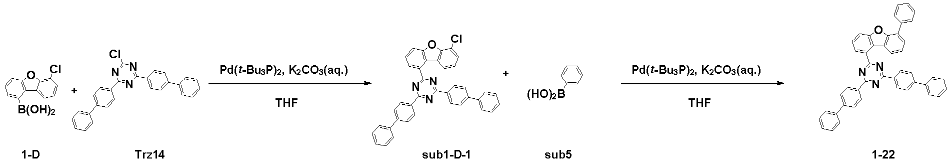

Chemical Formula 1-D (15g, 60.9mmol) and Trz14 (19.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 23.9 g of sub1-D-1 (yield 67%, MS: [M+H]+= 586).

sub1-D-1 (15g, 25.6mmol) and sub5 (3.1g, 25.6mmol) were added to 300 ml of THF under a nitrogen atmosphere, and the mixture was stirred and refluxed. Then, potassium carbonate (10.6g, 76.8mmol) was dissolved in 32 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.3 g of Compound 1-22 (yield 64%, MS: [M+H]+= 628).

### Synthesis Example 1-23

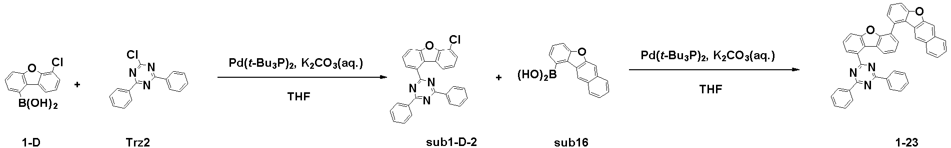

Chemical Formula 1-D (15g, 60.9mmol) and Trz2 (16.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20 g of sub1-D-2 (yield 76%, MS: [M+H]+= 434).

sub1-D-2 (15g, 34.6mmol) and sub16 (9.1g, 34.6mmol) were added to 300 ml of THF under a nitrogen atmosphere, and the mixture was stirred and refluxed. Then, potassium carbonate (14.3g, 103.7mmol) was dissolved in 43 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14 g of Compound 1-23 (yield 66%, MS: [M+H]+= 616).

### Synthesis Example 1-24

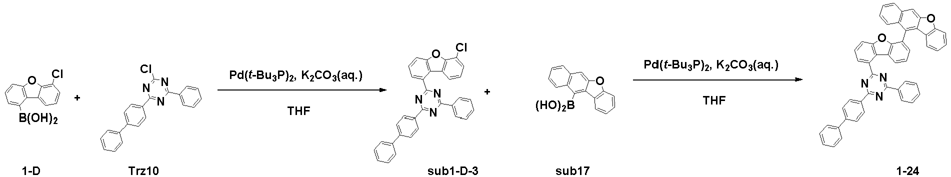

Chemical Formula 1-D (15g, 60.9mmol) and Trz10 (20.9g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.8 g of sub1-D-3 (yield 67%, MS: [M+H]+= 510).

sub1-D-3 (15g, 29.4mmol) and sub17 (7.7g, 29.4mmol) were added to 300 ml of THF under a nitrogen atmosphere, and the mixture was stirred and refluxed. Then, potassium carbonate (12.2g, 88.2mmol) was dissolved in 37 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.4 g of Compound 1-24 (yield 61%, MS: [M+H]+= 692).

### Synthesis Example 1-25

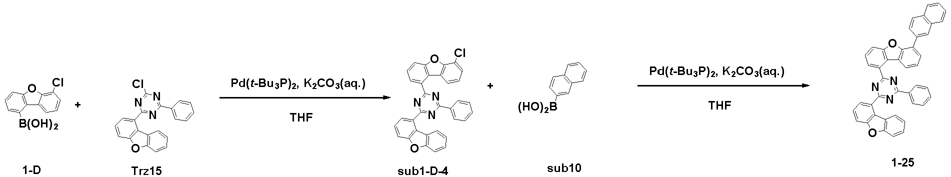

Chemical Formula 1-D (15g, 60.9mmol) and Trz15 (21.8g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 21.3 g of sub1-D-4 (yield 67%, MS: [M+H]+= 524).

sub1-D-4 (15g, 28.6mmol) and sub10 (4.9g, 28.6mmol) were added to 300 ml of THF under a nitrogen atmosphere, and the mixture was stirred and refluxed. Then, potassium carbonate (11.9g, 85.9mmol) was dissolved in 36 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.7 g of Compound 1-25 (yield 61%, MS: [M+H]+= 616).

### Synthesis Example 1-26

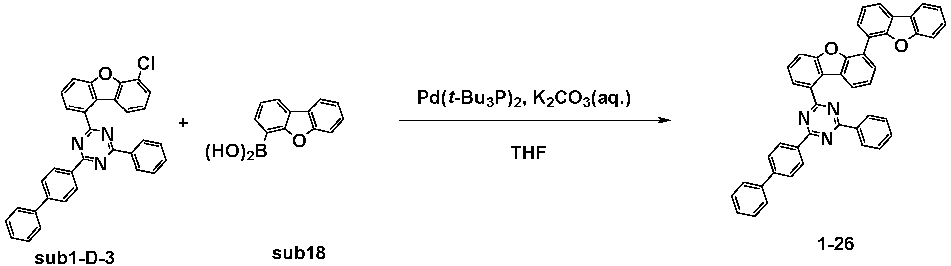

sub1-D-3 (15g, 29.4mmol) and sub18 (6.2g, 29.4mmol) were added to 300 ml of THF under a nitrogen atmosphere, and the mixture was stirred and refluxed. Then, potassium carbonate (12.2g, 88.2mmol) was dissolved in 37 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.3 g of Compound 1-26 (yield 76%, MS: [M+H]+= 642).

### Synthesis Example 1-27

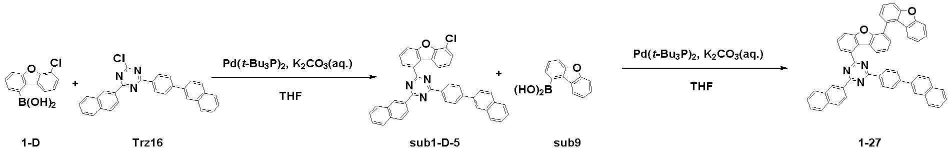

Chemical Formula 1-D (15g, 60.9mmol) and Trz16 (27g, 60.9mmol) were added to 300 ml of **THF** under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 27.1 g of sub1-D-5 (yield 73%, MS: [M+H]+= 610).

sub1-D-5 (15g, 24.6mmol) and sub9 (5.2g, 24.6mmol) were added to 300 ml of THF under a nitrogen atmosphere, and the mixture was stirred and refluxed. Then, potassium carbonate (10.2g, 73.8mmol) was dissolved in 31 ml of water, and then added thereto. Thereafter, it was stirred sufficiently, followed by adding bis(tri-tert-butylphosphine)palladium(0) (0.1g, 0.2mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.8 g of Compound 1-27 (yield 70%, MS: [M+H]+= 742).

### Synthesis Example 1-28

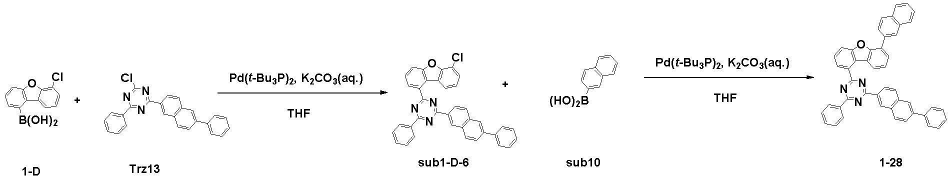

Chemical Formula 1-D (15g, 60.9mmol) and Trz13 (24g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.8 g of sub1-D-6 (yield 61%, MS: [M+H]+= 560).

sub1-D-6 (15g, 26.8mmol) and sub10 (4.6g, 26.8mmol) were added to 300 ml of THF under a nitrogen atmosphere, and the mixture was stirred and refluxed. Then, potassium carbonate (11.1g, 80.3mmol) was dissolved in 33 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.2 g of Compound 1-28 (yield 70%, MS: [M+H]+= 652).

### Synthesis Example 1-29

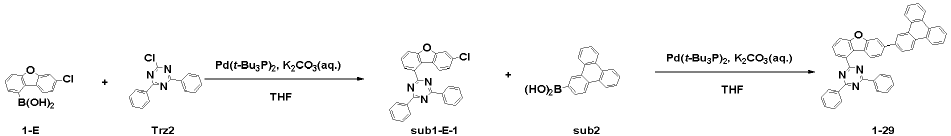

Chemical Formula 1-E (15g, 60.9mmol) and Trz2 (16.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 17.1 g of sub1-E-1 (yield 65%, MS: [M+H]+= 434).

sub1-E-1 (15g, 34.6mmol) and sub2 (9.4g, 34.6mmol) were added to 300 ml of THF under a nitrogen atmosphere, and the mixture was stirred and refluxed. Then, potassium carbonate (14.3g, 103.7mmol) was dissolved in 43 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.5 g of Compound 1-29 (yield 67%, MS: [M+H]+= 626).

### Synthesis Example 1-30

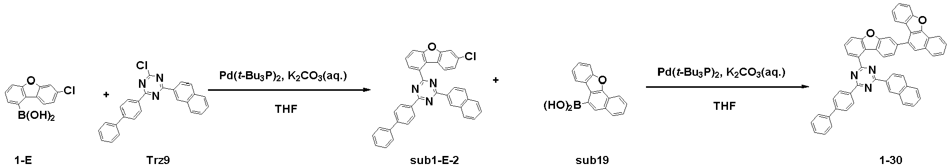

Chemical Formula 1-E (15g, 60.9mmol) and Trz9 (24g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26.9 g of sub1-E-2 (yield 79%, MS: [M+H]+= 560).

sub1-E-2 (15g, 26.8mmol) and sub19 (7g, 26.8mmol) were added to 300 ml of THF under a nitrogen atmosphere, and the mixture was stirred and refluxed. Then, potassium carbonate (11.1g, 80.3mmol) was dissolved in 33 ml of water, and then added thereto. Thereafter, it was stirred sufficiently, followed by adding bis(tri-tert-butylphosphine)palladium(0) (0.1g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.9 g of Compound 1-30 (yield 80%, MS: [M+H]+= 742).

### Synthesis Example 1-31

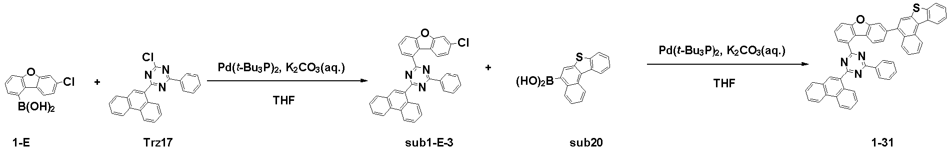

Chemical Formula 1-E (15g, 60.9mmol) and Trz17 (22.4g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 25.3 g of sub1-E-3 (yield 78%, MS: [M+H]+= 534).

sub1-E-3 (15g, 28.1mmol) and sub20(7.8g, 28.1mmol) were added to 300 ml of THF under a nitrogen atmosphere, and the mixture was stirred and refluxed. Then, potassium carbonate (11.6g, 84.3mmol) was dissolved in 35 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.8 g of Compound 1-31 (yield 72%, MS: [M+H]+= 732).

### Synthesis Example 1-32

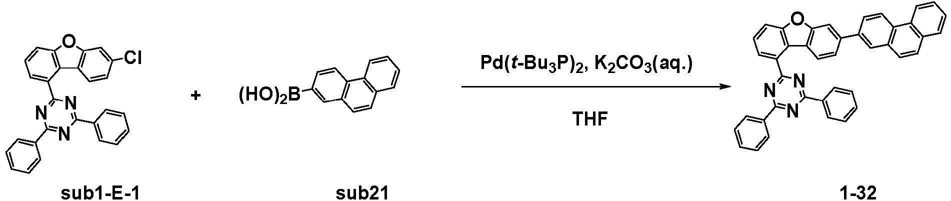

sub1-E-1 (15g, 34.6mmol) and sub21 (7.7g, 34.6mmol) were added to 300 ml of THF under a nitrogen atmosphere, and the mixture was stirred and refluxed. Then, potassium carbonate (14.3g, 103.7mmol) was dissolved in 43 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.9 g of Compound 1-32 (yield 65%, MS: [M+H]+= 576).

### Synthesis Example 1-33

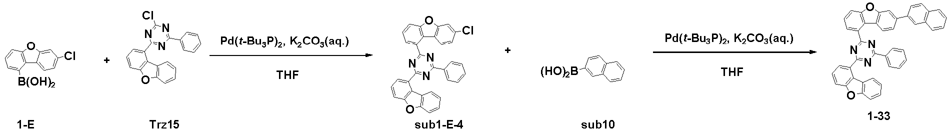

Chemical Formula 1-E (15g, 60.9mmol) and Trz15 (21.8g, 60.9mmol) were added to 300 ml of THF under a nitrogen atmosphere, and the mixture was stirred and refluxed.

Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 25.5 g of sub1-E-4 (yield 80%, MS: [M+H]+= 524).

sub1-E-4 (15g, 28.6mmol) and sub10 (4.9g, 28.6mmol) were added to 300 ml of THF under a nitrogen atmosphere, and the mixture was stirred and refluxed. Then, potassium carbonate (11.9g, 85.9mmol) was dissolved in 36 ml of water, and then added thereto. Thereafter, it was stirred sufficiently, followed by adding bis(tri-tert-butylphosphine)palladium(0) (0.1g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.6 g of Compound 1-33 (yield 60%, MS: [M+H]+= 616).

### Synthesis Example 1-34

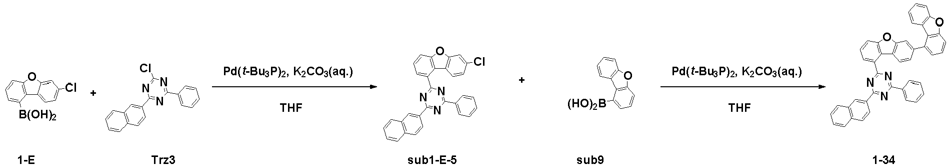

Chemical Formula 1-E (15g, 60.9mmol) and Trz3 (19.3g, 60.9mmol) were added to 300 ml of **THF** under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 17.6 g of sub1-E-5 (yield 60%, MS: [M+H]+= 484).

sub1-E-5 (15g, 31mmol) and sub9 (6.6g, 31mmol) were added to 300 ml of THF under a nitrogen atmosphere, and the mixture was stirred and refluxed. Then, potassium carbonate (12.9g, 93mmol) was dissolved in 39 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 11.4 g of Compound 1-34 (yield 60%, MS: [M+H]+= 616).

### Synthesis Example 1-35

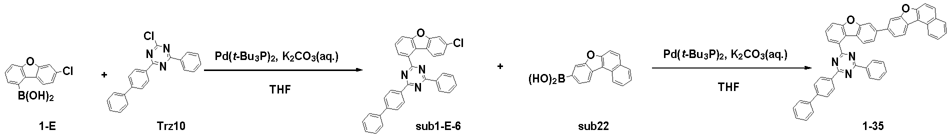

Chemical Formula 1-E (15g, 60.9mmol) and Trz10 (20.9g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 21.7 g of sub1-E-6 (yield 70%, MS: [M+H]+= 510).

sub1-E-6 (15g, 29.4mmol) and sub22 (7.7g, 29.4mmol) were added to 300 ml of THF under a nitrogen atmosphere, and the mixture was stirred and refluxed. Then, potassium carbonate (12.2g, 88.2mmol) was dissolved in 37 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.6 g of Compound 1-35 (yield 72%, MS: [M+H]+= 692).

### Synthesis Example 1-36

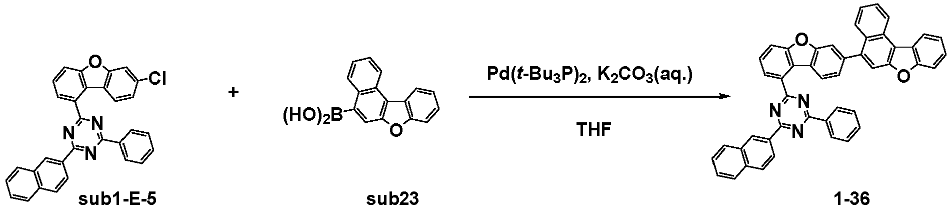

sub1-E-5 (15g, 31mmol) and sub23 (8.1g, 31mmol) were added to 300 ml of **THF** under a nitrogen atmosphere, and the mixture was stirred and refluxed. Then, potassium carbonate (12.9g, 93mmol) was dissolved in 39 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.4 g of Compound 1-36 (yield 60%, MS: [M+H]+= 666).

### Synthesis Example 1-37

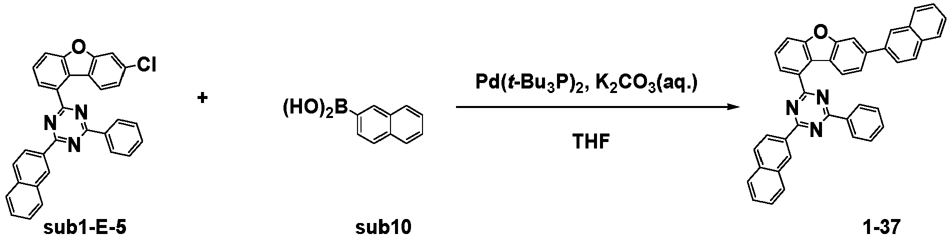

sub1-E-5 (15g, 31mmol) and sub10 (5.3g, 31mmol) were added to 300 ml of THF under a nitrogen atmosphere, and the mixture was stirred and refluxed. Then, potassium carbonate (12.9g, 93mmol) was dissolved in 39 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.1 g of Compound 1-37 (yield 79%, MS: [M+H]+= 576).

### Synthesis Example 1-38

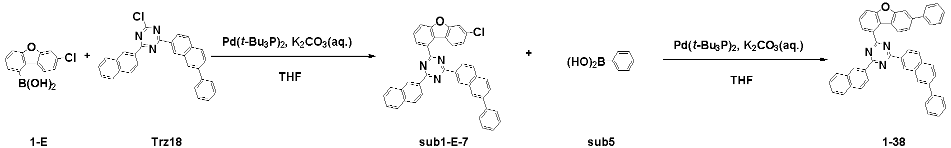

Chemical Formula 1-E (15g, 60.9mmol) and Trz18 (27g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 24.1 g of sub1-E-7 (yield 65%, MS: [M+H]+= 610).

sub1-E-7 (15g, 24.6mmol) and sub5 (3g, 24.6mmol) were added to 300 ml of THF under a nitrogen atmosphere, and the mixture was stirred and refluxed. Then, potassium carbonate (10.2g, 73.8mmol) was dissolved in 31 ml of water, and then added thereto. Thereafter, it was stirred sufficiently, followed by adding bis(tri-tert-butylphosphine)palladium(0) (0.1g, 0.2mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.1 g of Compound 1-38 (yield 63%, MS: [M+H]+= 652).

### Synthesis Example 1-39

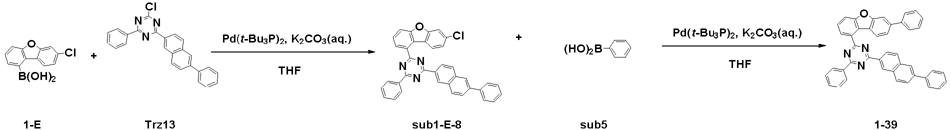

Chemical Formula 1-E (15g, 60.9mmol) and Trz13 (24g, 60.9mmol) were added to 300 ml of **THF** under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26.2 g of sub1-E-8 (yield 77%, MS: [M+H]+= 560).

sub1-E-8 (15g, 26.8mmol) and sub5 (3.3g, 26.8mmol) were added to 300 ml of THF under a nitrogen atmosphere, and the mixture was stirred and refluxed. Then, potassium carbonate (11.1g, 80.3mmol) was dissolved in 33 ml of water, and then added thereto. Thereafter, it was stirred sufficiently, followed by adding bis(tri-tert-butylphosphine)palladium(0) (0.1g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.9 g of Compound 1-39 (yield 68%, MS: [M+H]+= 602).

### Synthesis Example 1-40

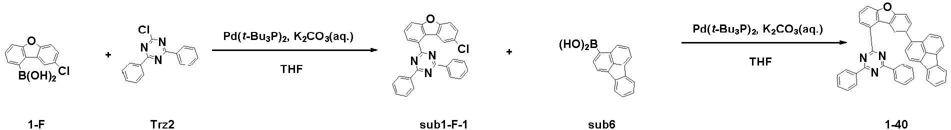

Chemical Formula 1-F (15g, 60.9mmol) and Trz2 (16.3g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 19.2 g of sub1-F-1 (yield 73%, MS: [M+H]+= 434).

Sub 1-F-1 (15g, 34.6mmol) and sub6 (8.5g, 34.6mmol) were added to 300 ml of THF under a nitrogen atmosphere, and the mixture was stirred and refluxed. Then, potassium carbonate (14.3g, 103.7mmol) was dissolved in 43 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.7 g of Compound 1-40 (yield 71%, MS: [M+H]+= 600).

### Synthesis Example 1-41

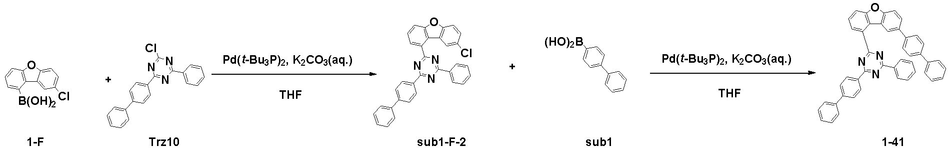

Chemical Formula 1-F (15g, 60.9mmol) and Trz10 (20.9g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 21.1 g of sub1-F-2 (yield 68%, MS: [M+H]+= 510).

sub1-F-2 (15g, 29.4mmol) and sub1 (5.8g, 29.4mmol) were added to 300 ml of THF under a nitrogen atmosphere, and the mixture was stirred and refluxed. Then, potassium carbonate (12.2g, 88.2mmol) was dissolved in 37 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.2 g of Compound 1-41 (yield 77%, MS: [M+H]+= 628).

### Synthesis Example 1-42

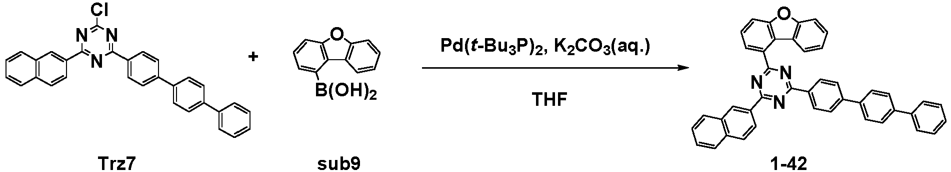

Trz7 (15g, 31.9mmol) and sub9 (6.8g, 31.9mmol) were added to 300 ml of THF under a nitrogen atmosphere, and the mixture was stirred and refluxed. Then, potassium carbonate (13.2g, 95.8mmol) was dissolved in 40 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.2 g of Compound 1-42 (yield 79%, MS: [M+H]+= 602).

### Synthesis Example 1-43

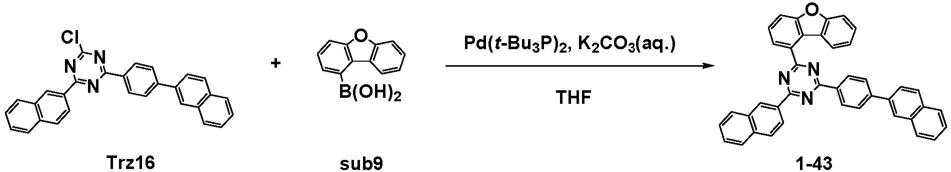

Trz16 (15g, 33.8mmol) and sub9 (7.2g, 33.8mmol) were added to 300 ml of THF under a nitrogen atmosphere, and the mixture was stirred and refluxed. Then, potassium carbonate (14g, 101.4mmol) was dissolved in 42 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15 g of Compound 1-43 (yield 77%, MS: [M+H]+= 576).

### Synthesis Example 1-44

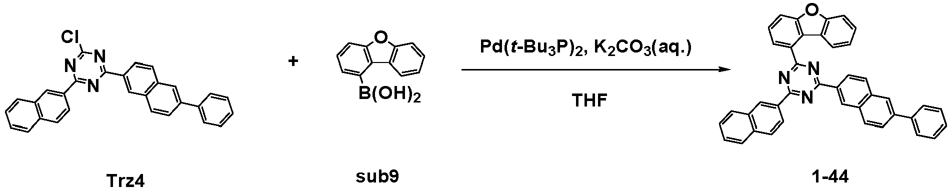

Trz4 (15g, 33.8mmol) and sub9 (7.2g, 33.8mmol) were added to 300 ml of THF under a nitrogen atmosphere, and the mixture was stirred and refluxed. Then, potassium carbonate (14g, 101.4mmol) was dissolved in 42 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.2 g of Compound 1-44 (yield 73%, MS: [M+H]+= 576).

### Synthesis Example 1-45

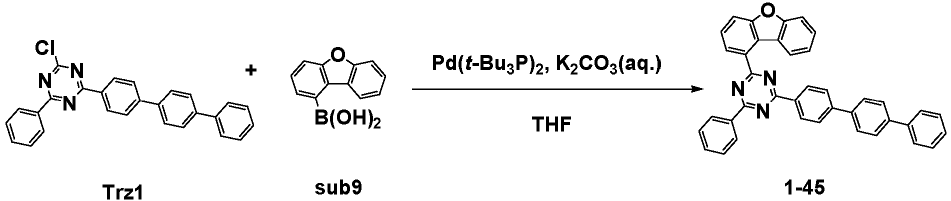

Trz1 (15g, 35.7mmol) and sub9 (7.6g, 35.7mmol) were added to 300 ml of THF under a nitrogen atmosphere, and the mixture was stirred and refluxed. Then, potassium carbonate (14.8g, 107.2mmol) was dissolved in 44 ml of water, and then added thereto. Thereafter, it was stirred sufficiently, followed by adding bis(tri-tert-butylphosphine)palladium(0) (0.2g, 0.4mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.2 g of Compound 1-45 (yield 62%, MS: [M+H]+= 552).

### Synthesis Example 1-46

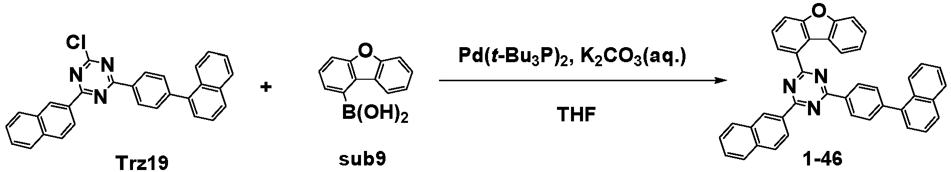

Trz19 (15g, 33.8mmol) and sub9 (7.2g, 33.8mmol) were added to 300 ml of THF under a nitrogen atmosphere, and the mixture was stirred and refluxed. Then, potassium carbonate (14g, 101.4mmol) was dissolved in 42 ml of water, and then added thereto.

Thereafter, it was stirred sufficiently, followed by adding bis(tri-tert-butylphosphine)palladium(0) (0.2g, 0.3mmol). After 7 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.6 g of Compound 1-46 (yield 70%, MS: [M+H]+= 576).

### Synthesis Example 1-47

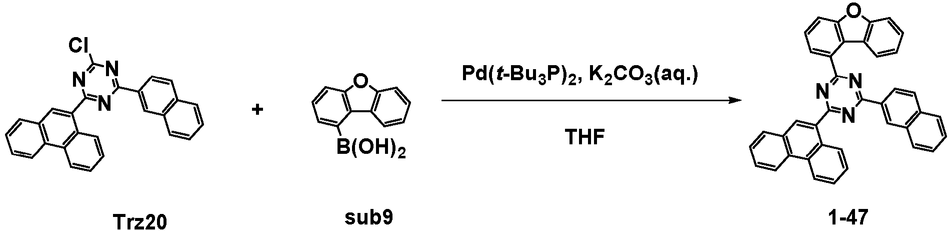

Trz20 (15g, 35.9mmol) and sub9 (7.6g, 35.9mmol) were added to 300 ml of THF under a nitrogen atmosphere, and the mixture was stirred and refluxed. Then, potassium carbonate (14.9g, 107.7mmol) was dissolved in 45 ml of water, and then added thereto. Thereafter, it was stirred sufficiently, followed by adding bis(tri-tert-butylphosphine)palladium(0) (0.2g, 0.4mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15 g of Compound 1-47 (yield 76%, MS: [M+H]+= 550).

### Synthesis Example 1-48

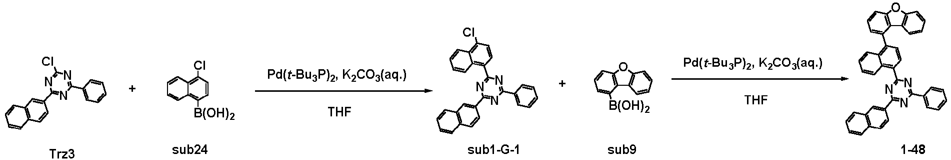

Trz3 (15g, 47.2mmol) and sub24 (9.7g, 47.2mmol) were added to 300 ml of THF under a nitrogen atmosphere, and the mixture was stirred and refluxed. Then, potassium carbonate (19.6g, 141.6mmol) was dissolved in 59 ml of water, and then added thereto. Thereafter, it was stirred sufficiently, followed by adding bis(tri-tert-butylphosphine)palladium(0) (0.2g, 0.5mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13 g of sub1-G-1 (yield 62%, MS: [M+H]+= 444).

sub1-G-1 (15g, 33.8mmol) and sub9 (7.2g, 33.8mmol) were added to 300 ml of **THF** under a nitrogen atmosphere, and the mixture was stirred and refluxed. Then, potassium carbonate (14g, 101.4mmol) was dissolved in 42 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.2 g of Compound 1-48 (yield 78%, MS: [M+H]+= 576).

### Synthesis Example 1-49

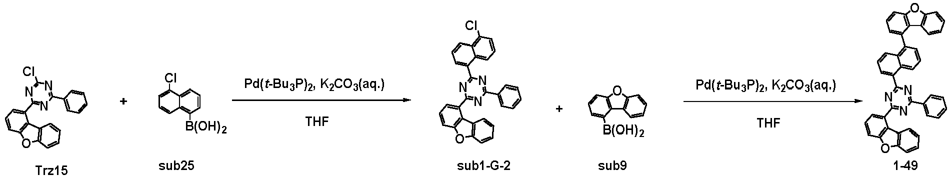

Trz15 (15g, 41.9mmol) and sub25 (8.7g, 41.9mmol) were added to 300 ml of **THF** under a nitrogen atmosphere, and the mixture was stirred and refluxed. Then, potassium carbonate (17.4g, 125.8mmol) was dissolved in 52 ml of water, and then added thereto. Thereafter, it was stirred sufficiently, followed by adding bis(tri-tert-butylphosphine)palladium(0) (0.2g, 0.4mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.6 g of sub1-G-2 (yield 62%, MS: [M+H]+= 484).

sub1-G-2 (15g, 31mmol) and sub9 (6.6g, 31mmol) were added to 300 ml of THF under a nitrogen atmosphere, and the mixture was stirred and refluxed. Then, potassium carbonate (12.9g, 93mmol) was dissolved in 39 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.7 g of Compound 1-49 (yield 72%, MS: [M+H]+= 616).

### Synthesis Example 1-50

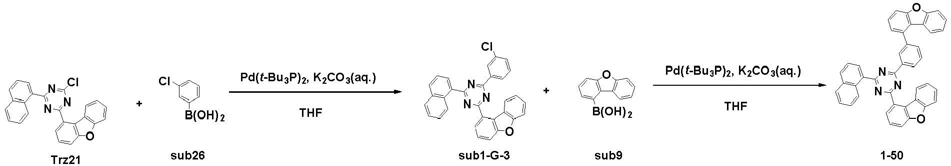

Trz21 (15g, 36.8mmol) and sub26 (5.8g, 36.8mmol) were added to 300 ml of THF under a nitrogen atmosphere, and the mixture was stirred and refluxed. Then, potassium carbonate (15.2g, 110.3mmol) was dissolved in 46 ml of water, and then added thereto. Thereafter, it was stirred sufficiently, followed by adding bis(tri-tert-butylphosphine)palladium(0) (0.2g, 0.4mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.8 g of sub1-G-3 (yield 72%, MS: [M+H]+= 484).

sub1-G-3 (15g, 31mmol) and sub9 (6.6g, 31mmol) were added to 300 ml of THF under a nitrogen atmosphere, and the mixture was stirred and refluxed. Then, potassium carbonate (12.9g, 93mmol) was dissolved in 39 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.2 g of Compound 1-50 (yield 69%, MS: [M+H]+= 616).

### Synthesis Example 1-51

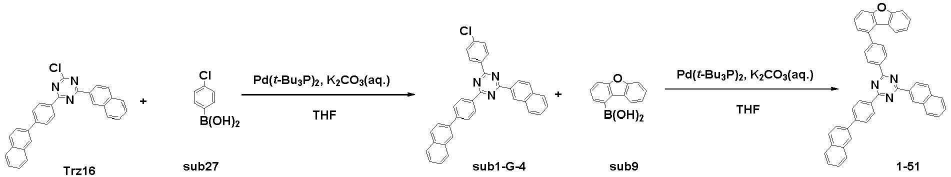

Trz16 (15g, 33.8mmol) and sub27 (5.3g, 33.8mmol) were added to 300 ml of THF under a nitrogen atmosphere, and the mixture was stirred and refluxed. Then, potassium carbonate (14g, 101.4mmol) was dissolved in 42 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.3 g of sub1-G-4 (yield 76%, MS: [M+H]+= 520).

sub1-G-4 (15g, 28.8mmol) and sub9 (6.1g, 28.8mmol) were added to 300 ml of THF under a nitrogen atmosphere, and the mixture was stirred and refluxed. Then, potassium carbonate (12g, 86.5mmol) was dissolved in 36 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.3 g of Compound 1-51 (yield 71%, MS: [M+H]+= 652).

### Synthesis Example 1-52

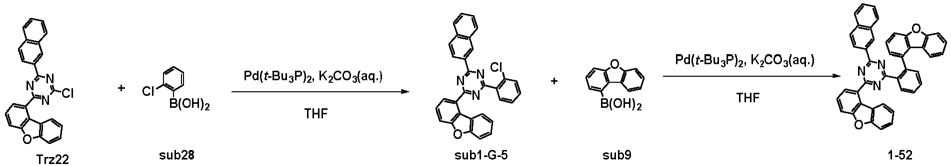

Trz22 (15g, 36.8mmol) and sub28 (5.8g, 36.8mmol) were added to 300 ml of THF under a nitrogen atmosphere, and the mixture was stirred and refluxed. Then, potassium carbonate (15.2g, 110.3mmol) was dissolved in 46 ml of water, and then added thereto. Thereafter, it was stirred sufficiently, followed by adding bis(tri-tert-butylphosphine)palladium(0) (0.2g, 0.4mmol). After 5 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.8 g of sub1-G-5 (yield 72%, MS: [M+H]+= 484).

sub1-G-5 (15g, 31mmol) and sub9 (6.6g, 31mmol) were added to 300 ml of THF under a nitrogen atmosphere, and the mixture was stirred and refluxed. Then, potassium carbonate (12.9g, 93mmol) was dissolved in 39 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13 g of Compound 1-52 (yield 68%, MS: [M+H]+= 616).

### Synthesis Example 1-53

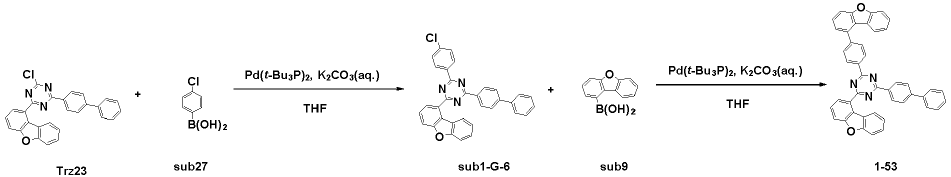

Trz23 (15g, 34.6mmol) and sub27 (5.4g, 34.6mmol) were added to 300 ml of THF under a nitrogen atmosphere, and the mixture was stirred and refluxed. Then, potassium carbonate (14.3g, 103.7mmol) was dissolved in 43 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 11.3 g of sub1-G-6 (yield 64%, MS: [M+H]+= 510).

sub1-G-6 (15g, 31mmol) and sub9 (6.6g, 31mmol) were added to 300 ml of THF under a nitrogen atmosphere, and the mixture was stirred and refluxed. Then, potassium carbonate (12.9g, 93mmol) was dissolved in 39 ml of water, and then added thereto. Thereafter, it was stirred sufficiently, followed by adding bis(tri-tert-butylphosphine)palladium(0) (0.2g, 0.3mmol). After 2 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13 g of Compound 1-53 (yield 68%, MS: [M+H]+= 616).

### Synthesis Example 1-54

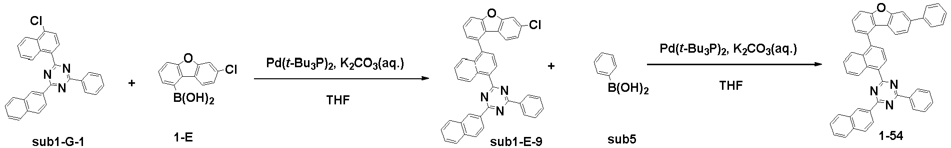

sub1-G-1 (15g, 33.8mmol) and Chemical Formula 1-E (8.3g, 33.8mmol) were added to 300 ml of THF under a nitrogen atmosphere, and the mixture was stirred and refluxed. Then, potassium carbonate (14g, 101.4mmol) was dissolved in 42 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.4 g of sub1-E-9 (yield 70%, MS: [M+H]+= 610).

sub1-E-9 (15g, 24.6mmol) and sub5 (3g, 24.6mmol) were added to 300 ml of THF under a nitrogen atmosphere, and the mixture was stirred and refluxed. Then, potassium carbonate (10.2g, 73.8mmol) was dissolved in 31 ml of water, and then added thereto. Thereafter, it was stirred sufficiently, followed by adding bis(tri-tert-butylphosphine)palladium(0) (0.1g, 0.2mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.2 g of Compound 1-54 (yield 76%, MS: [M+H]+= 652).

### Synthesis Example 1-55

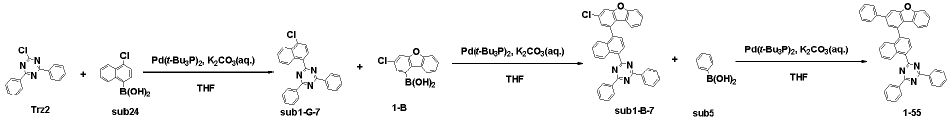

Trz2(15g, 56mmol) and sub24 (11.6g, 56mmol) were added to 300 ml of THF under a nitrogen atmosphere, and the mixture was stirred and refluxed. Then, potassium carbonate (23.2g, 168.1mmol) was dissolved in 70 ml of water, and then added thereto. Thereafter, it was stirred sufficiently, followed by adding bis(tri-tert-butylphosphine)palladium(0) (0.3g, 0.6mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.6 g of sub1-G-7 (yield 71%, MS: [M+H]+= 394).

sub1-G-7 (15g, 38.1mmol) and Chemical Formula 1-B (9.4g, 38.1mmol) were added to 300 ml of **THF** under a nitrogen atmosphere, and the mixture was stirred and refluxed. Then, potassium carbonate (15.8g, 114.3mmol) was dissolved in 47 ml of water, and then added thereto. Thereafter, it was stirred sufficiently, followed by adding bis(tri-tert-butylphosphine)palladium(0) (0.2g, 0.4mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.8 g of sub1-B-7 (yield 65%, MS: [M+H]+= 560).

sub1-B-7 (15g, 26.8mmol) and sub5 (3.3g, 26.8mmol) were added to 300 ml of THF under a nitrogen atmosphere, and the mixture was stirred and refluxed. Then, potassium carbonate (11.1g, 80.3mmol) was dissolved in 33 ml of water, and then added thereto. Thereafter, it was stirred sufficiently, followed by adding bis(tri-tert-butylphosphine)palladium(0) (0.1g, 0.3mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.9 g of Compound 1-55 (yield 80%, MS: [M+H]+= 602).

### Synthesis Example 1-56

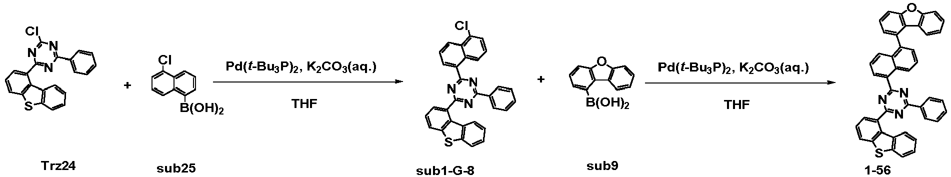

Trz24 (15g, 40.1mmol) and sub25 (9.1g, 44.1mmol) were added to 300 ml of THF under a nitrogen atmosphere, and the mixture was stirred and refluxed. Then, potassium carbonate (16.6g, 120.3mmol) was dissolved in 50 ml of water, and then added thereto. Thereafter, it was stirred sufficiently, followed by adding bis(tri-tert-butylphosphine)palladium(0) (0.2g, 0.4mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.8 g of sub1-G-8 (yield 69%, MS: [M+H]+= 501).

sub1-G-8 (13g, 26mmol) and sub9 (6.1g, 29mmol) were added to 300 ml of THF under a nitrogen atmosphere, and the mixture was stirred and refluxed. Then, potassium carbonate (10.8g, 78mmol) was dissolved in 40 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.1 g of Compound 1-56 (yield 73%, MS: [M+H]+= 632).

### Synthesis Example 1-57

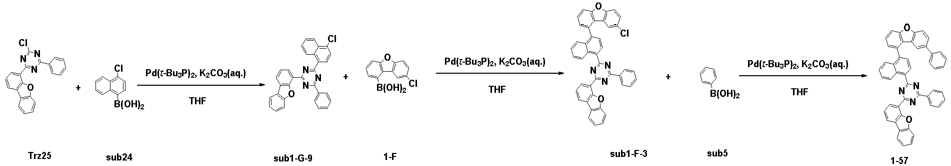

Trz25 (15g, 41.9mmol) and sub24 (8.7g, 41.9mmol) were added to 300 ml of THF under a nitrogen atmosphere, and the mixture was stirred and refluxed. Then, potassium carbonate (17.4g, 125.8mmol) was dissolved in 52 ml of water, and then added thereto. Thereafter, it was stirred sufficiently, followed by adding bis(tri-tert-butylphosphine)palladium(0) (0.2g, 0.4mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.4 g of sub1-G-9 (yield 61%, MS: [M+H]+= 484).

sub1-G-9 (15g, 31mmol) and Chemical Formula 1-F (7.6g, 31mmol) were added to 300 ml of THF under a nitrogen atmosphere, and the mixture was stirred and refluxed. Then, potassium carbonate (12.9g, 93mmol) was dissolved in 39 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.5 g of sub1-F-3 (yield 62%, MS: [M+H]+= 650).

sub1-F-3 (15g, 23.1mmol) and sub5 (2.8g, 23.1mmol) were added to 300 ml of THF under a nitrogen atmosphere, and the mixture was stirred and refluxed. Then, potassium carbonate (9.6g, 69.2mmol) was dissolved in 29 ml of water, and then added thereto. Thereafter, it was stirred sufficiently, followed by adding bis(tri-tert-butylphosphine)palladium(0) (0.1g, 0.2mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.8 g of Compound 1-57 (yield 80%, MS: [M+H]+= 692).

### Synthesis Example 1-58

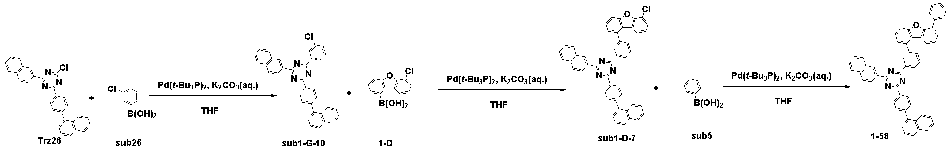

Trz26 (15g, 33.8mmol) and sub26 (5.3g, 33.8mmol) were added to 300 ml of THF under a nitrogen atmosphere, and the mixture was stirred and refluxed. Then, potassium carbonate (14g, 101.4mmol) was dissolved in 42 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.5 g of sub1-G-10 (yield 60%, MS: [M+H]+= 520).

sub1-G-10 (15g, 28.8mmol) and Chemical Formula 1-D (7.1g, 28.8mmol) were added to 300 ml of THF under a nitrogen atmosphere, and the mixture was stirred and refluxed. Then, potassium carbonate (12g, 86.5mmol) was dissolved in 36 ml of water, and then added thereto. Thereafter, it was stirred sufficiently, followed by adding bis(tri-tert-butylphosphine)palladium(0) (0.1g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15 g of sub1-D-7 (yield 76%, MS: [M+H]+= 687).

sub1-D-7 (15g, 21.9mmol) and sub5 (2.7g, 21.9mmol) were added to 300 ml of **THF** under a nitrogen atmosphere, and the mixture was stirred and refluxed. Then, potassium carbonate (9.1g, 65.6mmol) was dissolved in 27 ml of water, and then added thereto. Thereafter, it was stirred sufficiently, followed by adding bis(tri-tert-butylphosphine)palladium(0) (0.1g, 0.2mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 9.9 g of Compound 1-58 (yield 62%, MS: [M+H]+= 728).

### Synthesis Example 1-59

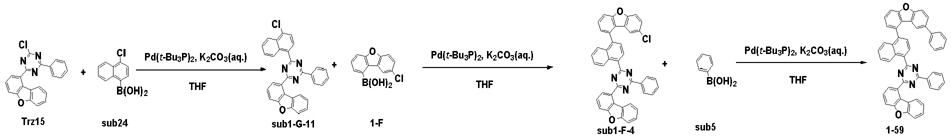

Trz15 (15g, 41.9mmol) and sub24 (8.7g, 41.9mmol) were added to 300 ml of **THF** under a nitrogen atmosphere, and the mixture was stirred and refluxed. Then, potassium carbonate (17.4g, 125.8mmol) was dissolved in 52 ml of water, and then added thereto. Thereafter, it was stirred sufficiently, followed by adding bis(tri-tert-butylphosphine)palladium(0) (0.2g, 0.4mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.4 g of sub1-G-11 (yield 61%, MS: [M+H]+= 484).

sub1-G-11 (12.4g, 25.6mmol) and Chemical Formula 1-F (6.9g, 28.2mmol) were added to 300 ml of THF under a nitrogen atmosphere, and the mixture was stirred and refluxed. Then, potassium carbonate (11g, 76.8mmol) was dissolved in 36 ml of water, and then added thereto. Thereafter, it was stirred sufficiently, followed by adding bis(tri-tert-butylphosphine)palladium(0) (0.1g, 0.3mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13 g of sub1-F-4 (yield 78%, MS: [M+H]+= 651).

sub1-F-4 (13g, 19.9mmol) and sub5 (2.7g, 21.9mmol) were added to 300 ml of THF under a nitrogen atmosphere, and the mixture was stirred and refluxed. Then, potassium carbonate (8.3g, 59.9mmol) was dissolved in 29 ml of water, and then added thereto. Thereafter, it was stirred sufficiently, followed by adding bis(tri-tert-butylphosphine)palladium(0) (0.1g, 0.2mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.2 g of Compound 1-59 (yield 73%, MS: [M+H]+= 692).

### Synthesis Example 1-60

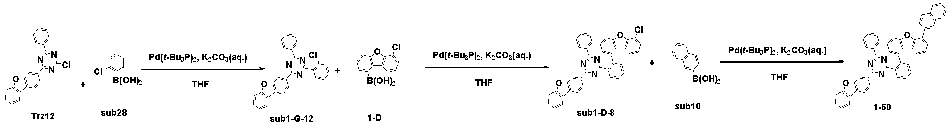

Trz12 (15g, 41.9mmol) and sub28 (6.6g, 41.9mmol) were added to 300 ml of THF under a nitrogen atmosphere, and the mixture was stirred and refluxed. Then, potassium carbonate (17.4g, 125.8mmol) was dissolved in 52 ml of water, and then added thereto. Thereafter, it was stirred sufficiently, followed by adding bis(tri-tert-butylphosphine)palladium(0) (0.2g, 0.4mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 11.1 g of sub1-G-12 (yield 61%, MS: [M+H]+= 434).

sub1-G-12 (15g, 34.6mmol) and Chemical Formula 1-D (8.5g, 34.6mmol) were added to 300 ml of THF under a nitrogen atmosphere, and the mixture was stirred and refluxed. Then, potassium carbonate (14.3g, 103.7mmol) was dissolved in 43 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.6 g of sub1-D-8 (yield 79%, MS: [M+H]+= 500).

sub1-D-8 (15g, 25mmol) and sub10 (4.3g, 25mmol) were added to 300 ml of THF under a nitrogen atmosphere, and the mixture was stirred and refluxed. Then, potassium carbonate (10.4g, 75mmol) was dissolved in 31 ml of water, and then added thereto. Thereafter, it was stirred sufficiently, followed by adding bis(tri-tert-butylphosphine)palladium(0) (0.1g, 0.2mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.3 g of Compound 1-60 (yield 77%, MS: [M+H]+= 692).

### Synthesis Example 1-61

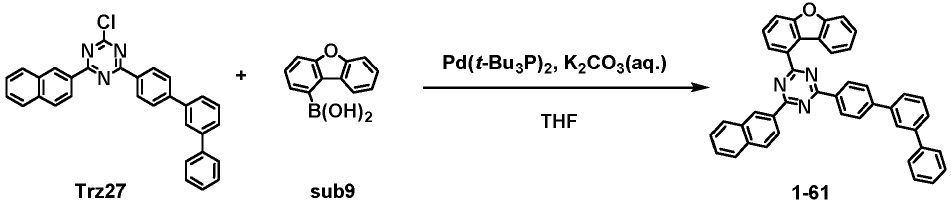

Trz27 (15g, 31.9mmol) and sub9 (6.8g, 31.9mmol) were added to 300 ml of THF under a nitrogen atmosphere, and the mixture was stirred and refluxed. Then, potassium carbonate (13.2g, 95.8mmol) was dissolved in 40 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10 g of Compound 1-61 (yield 52%, MS: [M+H]+= 602).

### Synthesis Example 1-62

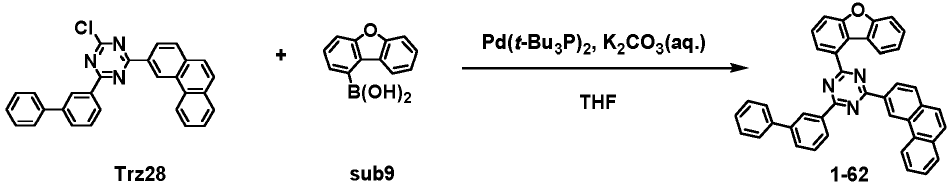

Trz28 (15g, 33.8mmol) and sub9 (7.2g, 33.8mmol) were added to 300 ml of THF under a nitrogen atmosphere, and the mixture was stirred and refluxed. Then, potassium carbonate (14g, 101.4mmol) was dissolved in 42 ml of water, and then added thereto.

Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.2 g of Compound 1-62 (yield 63%, MS: [M+H]+= 576).

### Synthesis Example 1-63

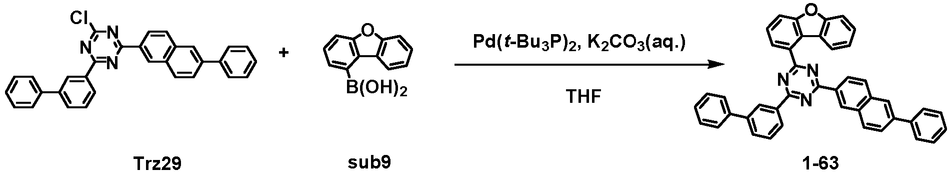

Trz29 (15g, 31.9mmol) and sub9 (6.8g, 31.9mmol) were added to 300 ml of THF under a nitrogen atmosphere, and the mixture was stirred and refluxed. Then, potassium carbonate (13.2g, 95.8mmol) was dissolved in 40 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.7 g of Compound 1-63 (yield 66%, MS: [M+H]+= 602).

### Synthesis Example 1-64

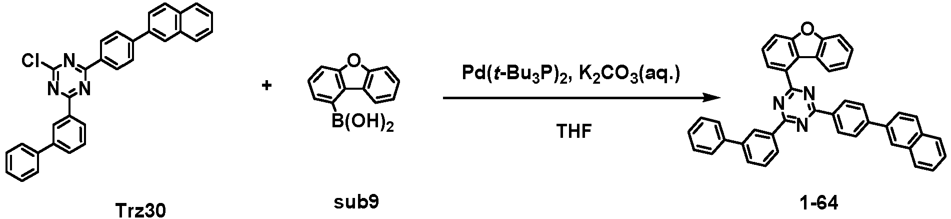

Trz30 (15g, 31.9mmol) and sub9 (6.8g, 31.9mmol) were added to 300 ml of THF under a nitrogen atmosphere, and the mixture was stirred and refluxed. Then, potassium carbonate (13.2g, 95.8mmol) was dissolved in 40 ml of water, and then added thereto. Thereafter, it was stirred sufficiently, followed by adding bis(tri-tert-butylphosphine)palladium(0) (0.2g, 0.3mmol). After 5 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.2 g of Compound 1-64 (yield 69%, MS: [M+H]+= 602).

### Synthesis Example 1-65

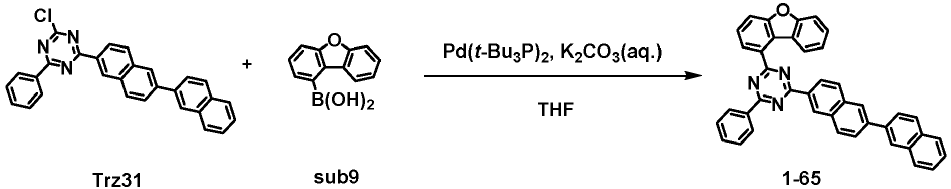

Trz31 (15g, 33.8mmol) and sub9 (7.2g, 33.8mmol) were added to 300 ml of THF under a nitrogen atmosphere, and the mixture was stirred and refluxed. Then, potassium carbonate (14g, 101.4mmol) was dissolved in 42 ml of water, and then added thereto. Thereafter, it was stirred sufficiently, followed by adding bis(tri-tert-butylphosphine)palladium(0) (0.2g, 0.3mmol). After 5 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.6 g of Compound 1-65 (yield 75%, MS: [M+H]+= 576).

### Synthesis Example 1-66

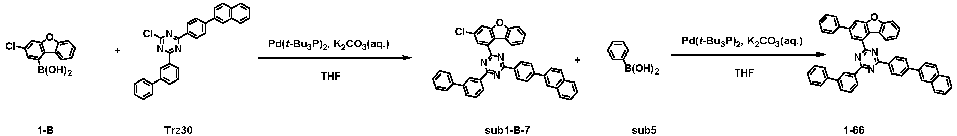

Chemical Formula 1-B (15g, 60.9mmol) and Trz30 (28.6g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.2g, 0.3mmol). After 5 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 19.3 g of sub1-B-7 (yield 50%, MS: [M+H]+= 636).

sub1-B-7 (15g, 23.6mmol) and sub5 (2.9g, 23.6mmol) were added to 300 ml of THF under a nitrogen atmosphere, and the mixture was stirred and refluxed. Then, potassium carbonate (9.8g, 70.7mmol) was dissolved in 29 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 8.5 g of Compound 1-66 (yield 53%, MS: [M+H]+= 678).

### Synthesis Example 1-67

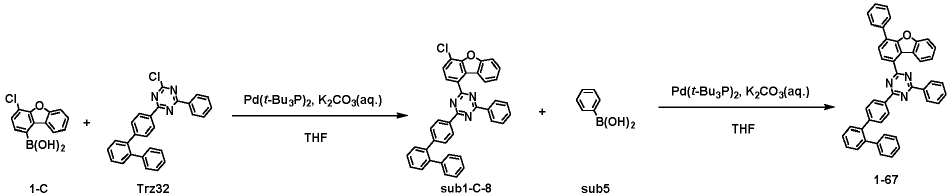

Chemical Formula 1-C (15g, 60.9mmol) and Trz32 (25.6g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.2g, 0.3mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 24.9 g of sub1-C-8 (yield 70%, MS: [M+H]+= 586).

sub1-C-8 (15g, 25.6mmol) and sub5 (3.1g, 25.6mmol) were added to 300 ml of THF under a nitrogen atmosphere, and the mixture was stirred and refluxed. Then, potassium carbonate (10.6g, 76.8mmol) was dissolved in 32 ml of water, and then added thereto. Thereafter, it was stirred sufficiently, followed by adding bis(tri-tert-butylphosphine)palladium(0) (0.2g, 0.3mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.6 g of Compound 1-67 (yield 66%, MS: [M+H]+= 628).

### Synthesis Example 1-68

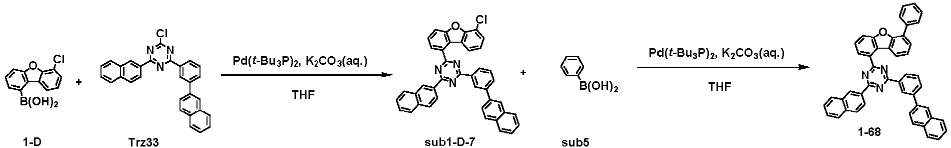

Chemical Formula 1-D (15g, 60.9mmol) and Trz33 (27g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.2g, 0.3mmol). After 5 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 29.7 g of sub1-D-7 (yield 80%, MS: [M+H]+= 610).

sub1-D-7 (15g, 24.6mmol) and sub5 (3g, 24.6mmol) were added to 300 ml of THF under a nitrogen atmosphere, and the mixture was stirred and refluxed. Then, potassium carbonate (10.2g, 73.8mmol) was dissolved in 31 ml of water, and then added thereto. Thereafter, it was stirred sufficiently, followed by adding bis(tri-tert-butylphosphine)palladium(0) (0.2g, 0.3mmol). After 4 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 11.2 g of Compound 1-68 (yield 70%, MS: [M+H]+= 652).

### Synthesis Example 1-69

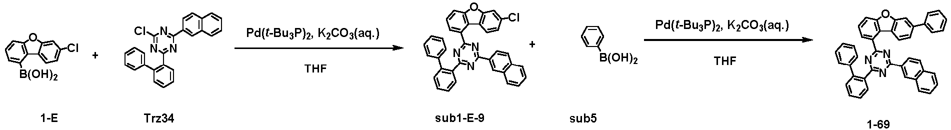

Chemical Formula 1-E (15g, 60.9mmol) and Trz34 (24g, 60.9mmol) were added to 300 ml of THF under a nitrogen atmosphere, and the mixture was stirred and refluxed. Then, potassium carbonate (25.2g, 182.6mmol) was dissolved in 76 ml of water, and then added thereto. Thereafter, it was stirred sufficiently, followed by adding bis(tri-tert-butylphosphine)palladium(0) (0.2g, 0.3mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 21.8 g of sub1-E-9 (yield 64%, MS: [M+H]+= 560).

sub1-E-9 (15g, 26.8mmol) and sub5 (3.3g, 26.8mmol) were added to 300 ml of THF under a nitrogen atmosphere, and the mixture was stirred and refluxed. Then, potassium carbonate (11.1g, 80.3mmol) was dissolved in 33 ml of water, and then added thereto. Thereafter, it was stirred sufficiently, followed by adding bis(tri-tert-butylphosphine)palladium(0) (0.2g, 0.3mmol). After 3 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10 g of Compound 1-69 (yield 62%, MS: [M+H]+= 602).

### <Preparation Examples: Preparation of core of compound of Chemical Formula 2>

### (Synthesis scheme of Preparation Examples 1 to 4)

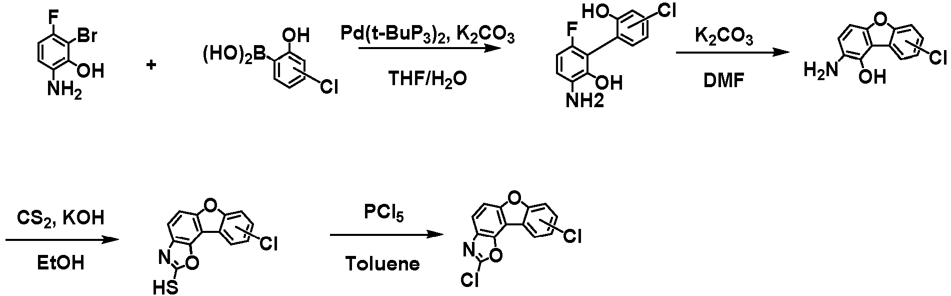

### Preparation Example 1: Synthesis of Chemical Formula AA

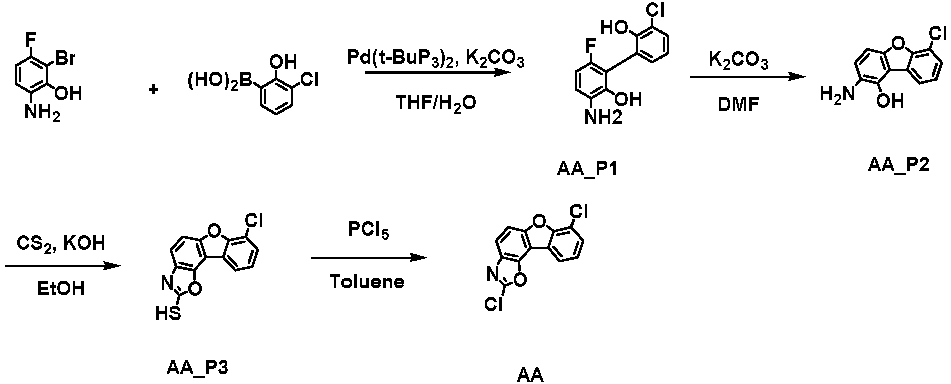

6-amino-2-bromo-3-fluorophenol (15g, 72.8mmol) and (3-chloro-2-hydroxyphenyl)boronic acid (12.6g, 72.8mmol) were added to 300 ml of THF under a nitrogen atmosphere, and the mixture was stirred and refluxed. Then, potassium carbonate (30.2g, 218.4mmol) was dissolved in 91 ml of water, and then added thereto. Thereafter, it was stirred sufficiently, followed by adding bis(tri-tert-butylphosphine)palladium(0) (0.4g, 0.7mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.3 g of Chemical Formula AA_P1 (yield 72%, MS: [M+H]+= 254).

Chemical Formula AA_P1 (15g, 59.1mmol) and potassium carbonate (24.5g, 177.4mmol) were added to 150 ml of DMF under a nitrogen atmosphere, and the mixture was stirred and refluxed. After 9 hours of reaction, cooling was performed to room temperature, and then the organic solvent was distilled under reduced pressure. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 9.6 g of Chemical Formula AA_P2 (yield 70%, MS: [M+H]+= 234).

Chemical Formula AA_P2 (15g, 64.2mmol), carbon disulfide (5.9g, 77mmol), and potassium hydroxide (4.3g, 77mmol) were added to 150 ml of EtOH under a nitrogen atmosphere, and the mixture was stirred and refluxed. After 12 hours of reaction, cooling was performed to room temperature, and then the organic solvent was distilled under reduced pressure. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.8 g of Chemical Formula AA_P3 (yield 70%, MS: [M+H]+= 242).

Chemical Formula AA_P3 (15g, 62.2mmol) and Phosphorus pentachloride (15.5g, 74.6mmol) were added to 150 ml of toluene under a nitrogen atmosphere, and the mixture was stirred and refluxed. After 12 hours of reaction, cooling was performed to room temperature, and then the organic solvent was distilled under reduced pressure. Then, this was dissolved again in chloroform, and washed twice with water. Thereafter, the organic layer was separated, treated with anhydrous magnesium sulfate, stirred, then filtered, and the filtrate was distilled under reduced pressure.

The concentrated compound was purified by silica gel column chromatography to prepare 13.6 g of Chemical Formula AA (yield 79%, MS: [M+H]+= 278).

### Preparation Example 2: Synthesis of Chemical Formula AB

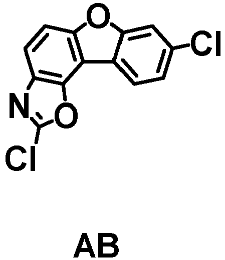

Chemical Formula AB was prepared in the same manner as in Preparation Example 1, except that (4-chloro-2-hydroxyphenyl)boronic acid was used instead of (3-chloro-2-hydroxyphenyl)boronic acid.

### Preparation Example 3: Synthesis of Chemical Formula AC

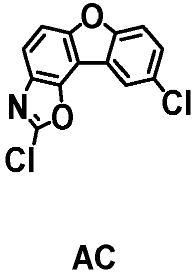

Chemical Formula AC was prepared in the same manner as in Preparation Example 1, except that (5-chloro-2-hydroxyphenyl)boronic acid was used instead of (3-chloro-2-hydroxyphenyl)boronic acid.

### Preparation Example 4: Synthesis of Chemical Formula AD

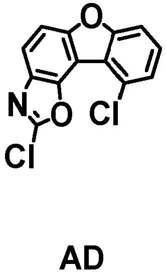

Chemical Formula AD was prepared in the same manner as in Preparation Example 1, except that (2-chloro-6-hydroxyphenyl)boronic acid was used instead of (3-chloro-2-hydroxyphenyl)boronic acid.

### (Synthesis scheme of Preparation Examples 5 to 6)

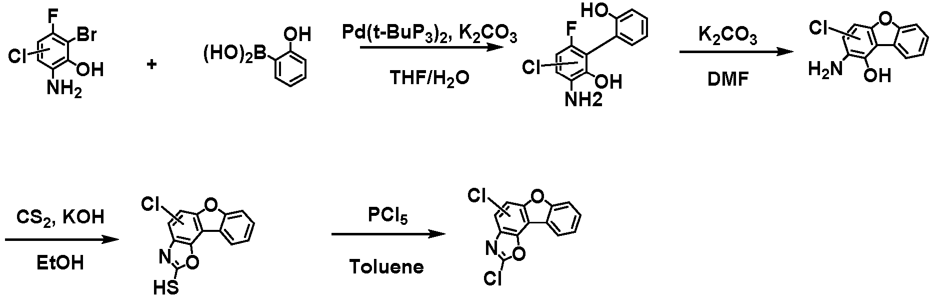

### Preparation Example 5: Synthesis of Chemical Formula AE

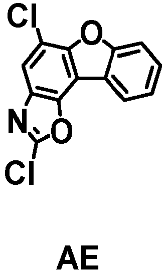

Chemical Formula AE was prepared in the same manner as in Preparation Example 1, except that 6-amino-2-bromo-4-chloro-3-fluorophenol was used instead of 6-amino-2-bromo-3-fluorophenol and (2-hydroxyphenyl)boronic acid was used instead of (3-chloro-2-hydroxyphenyl)boronic acid.

### Preparation Example 6: Synthesis of Chemical Formula AF

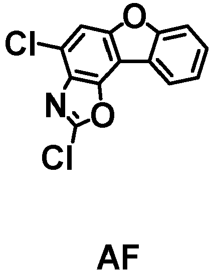

Chemical Formula AF was prepared in the same manner as in Preparation Example 1, except that 2-amino-6-bromo-3-chloro-5-fluorophenol was used instead of 6-amino-2-bromo-3-fluorophenol and (2-hydroxyphenyl)boronic acid was used instead of (3-chloro-2-hydroxyphenyl)boronic acid.

### Preparation Example 7: Synthesis of Chemical Formula AG

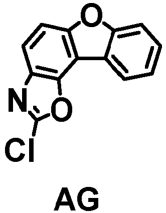

Chemical Formula AG was prepared in the same manner as in Preparation Example 1, except that (2-hydroxyphenyl)boronic acid was used instead of (3-chloro-2-hydroxyphenyl)boronic acid.

### (Synthesis scheme of Preparation Examples 8 to 11)

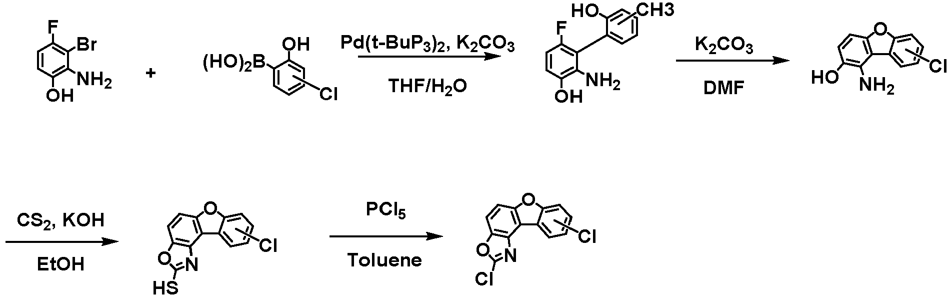

### Preparation Example 8: Synthesis of Chemical Formula BA

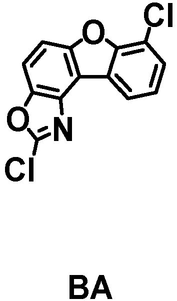

Chemical Formula BA was prepared in the same manner as in Preparation Example 1, except that 2-amino-3-bromo-4-fluorophenol was used instead of 6-amino-2-bromo-3-fluorophenol.

### Preparation Example 9: Synthesis of Chemical Formula BB

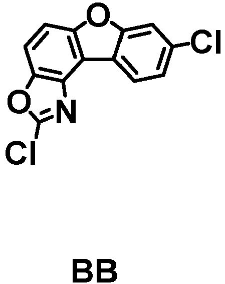

Chemical Formula BB was prepared in the same manner as in Preparation Example 1, except that 2-amino-3-bromo-4-fluorophenol was used instead of 6-amino-2-bromo-3-fluorophenol and (4-chloro-2-hydroxyphenyl)boronic acid was used instead of (3-chloro-2-hydroxyphenyl)boronic acid.

### Preparation Example 10: Synthesis of Chemical Formula BC

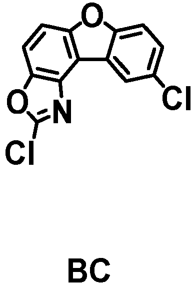

Chemical Formula BC was prepared in the same manner as in Preparation Example 1, except that 2-amino-3-bromo-4-fluorophenol was used instead of 6-amino-2-bromo-3-fluorophenol and (5-chloro-2-hydroxyphenyl)boronic acid was used instead of (3-chloro-2-hydroxyphenyl)boronic acid.

### Preparation Example 11: Synthesis of Chemical Formula BD

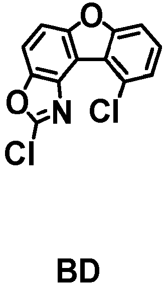

Chemical Formula BD was prepared in the same manner as in Preparation Example 1, except that 2-amino-3-bromo-4-fluorophenol was used instead of 6-amino-2-bromo-3-fluorophenol and (2-chloro-6-hydroxyphenyl)boronic acid was used instead of (3-chloro-2-hydroxyphenyl)boronic acid.

### (Synthesis scheme of Preparation Examples 12 to 13)

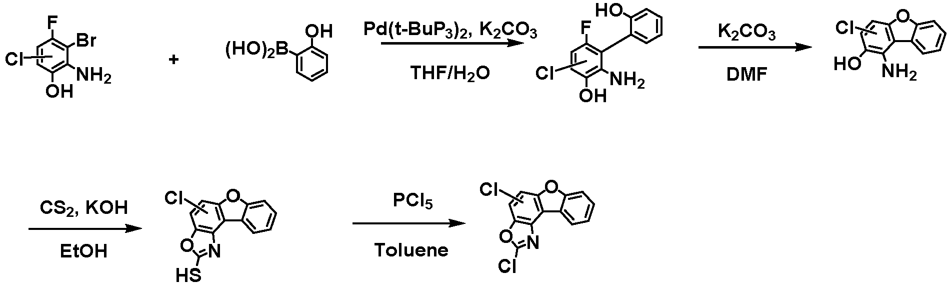

### Preparation Example 12: Synthesis of Chemical Formula BE

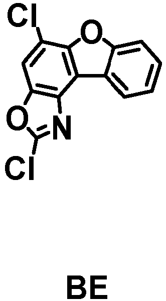

Chemical Formula BE was prepared in the same manner as in Preparation Example 1, except that 2-amino-3-bromo-5-chloro-4-fluorophenol was used instead of 6-amino-2-bromo-3-fluorophenol and (2-hydroxyphenyl)boronic acid was used instead of (3-chloro-2-hydroxyphenyl)boronic acid.

### Preparation Example 13: Synthesis of Chemical Formula BF

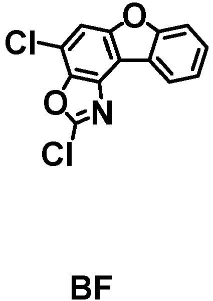

Chemical Formula BF was prepared in the same manner as in Preparation Example 1, except that 2-amino-3-bromo-6-chloro-4-fluorophenol was used instead of 6-amino-2-bromo-3-fluorophenol and (2-hydroxyphenyl)boronic acid was used instead of (3-chloro-2-hydroxyphenyl)boronic acid.

### Preparation Example 14: Synthesis of Chemical Formula BG

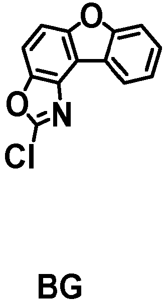

Chemical Formula BG was prepared in the same manner as in Preparation Example 1, except that 2-amino-3-bromo-4-fluorophenol was used instead of 6-amino-2-bromo-3-fluorophenol and (2-hydroxyphenyl)boronic acid was used instead of (3-chloro-2-hydroxyphenyl)boronic acid.

### <Synthesis Example 2: Preparation of compound of Chemical Formula 2>

### Synthesis Example 2-1

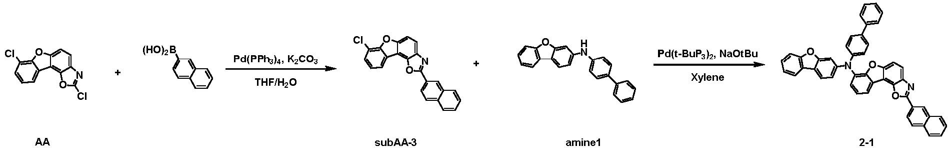

Chemical Formula AA (15g, 53.9mmol) and naphthalen-2-ylboronic acid (9.3g, 53.9mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 12 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.3 g of subAA-3 (yield 77%, MS: [M+H]+= 370).

subAA-3 (10 g, 27mmol), amine1 (9.1g, 27 mmol), and sodium tert-butoxide (8.6 g, 40.6 mmol) were added to 200 ml of Xylene under a nitrogen atmosphere, and the mixture was stirred and refluxed. Then, bis(tri-tert-butylphosphine)palladium(0) (0.1 g, 0.3 mmol) was added thereto. After 2 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 10.8 g of Compound 2-1 (yield 60%, MS: [M+H]+= 669).

### Synthesis Example 2-2

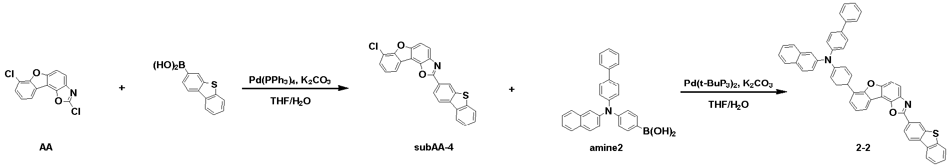

Chemical Formula AA (15g, 53.9mmol) and dibenzo[b,d]thiophen-3-ylboronic acid (12.9g, 56.6mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.8 g of subAA-4 (yield 56%, MS: [M+H]+= 426).

subAA-4 (15g, 35.2mmol) and amine2 (15.4g, 37mmol) were added to 300 ml of THF under a nitrogen atmosphere, and the mixture was stirred and refluxed. Then, potassium carbonate (14.6g, 105.7mmol) was dissolved in 44 ml of water, and then added thereto. Thereafter, it was stirred sufficiently, followed by adding bis(tri-tert-butylphosphine)palladium(0) (0.2g, 0.4mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.7 g of Compound 2-2 (yield 55%, MS: [M+H]+= 761).

### Synthesis Example 2-3

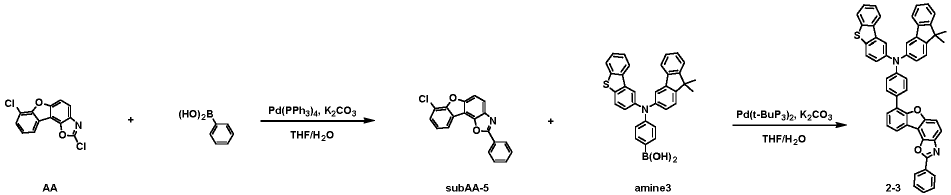

Chemical Formula AA (15g, 53.9mmol) and phenylboronic acid (6.9g, 56.6mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10 g of subAA-5 (yield 58%, MS: [M+H]+= 320).

subAA-5 (15g, 46.9mmol) and amine3 (25.2g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 19.7 g of Compound 2-3 (yield 56%, MS: [M+H]+= 751).

### Synthesis Example 2-4

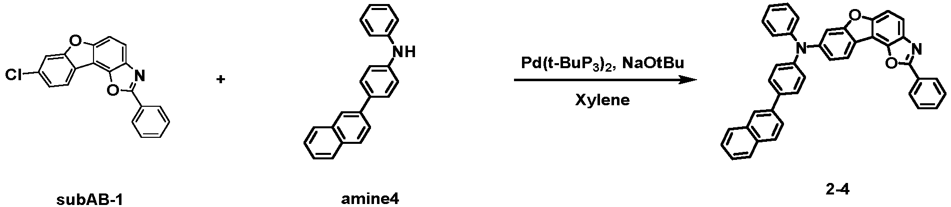

subAB-1 (10 g, 31.3mmol), amine4 (9.2g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 2 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 11.9 g of Compound 2-4 (yield 66%, MS: [M+H]+= 579).

### Synthesis Example 2-5

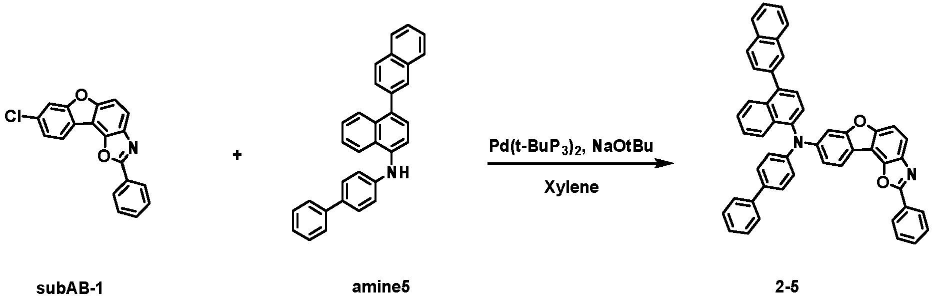

subAB-1 (10 g, 31.3mmol), amine5 (13.2g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 2 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 11.9 g of Compound 2-5 (yield 54%, MS: [M+H]+= 706).

### Synthesis Example 2-6

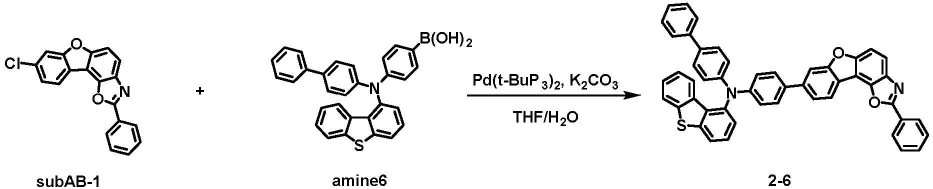

subAB-1 (15g, 46.9mmol) and amine6 (23.2g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.3 g of Compound 2-6 (yield 61%, MS: [M+H]+= 711).

### Synthesis Example 2-7

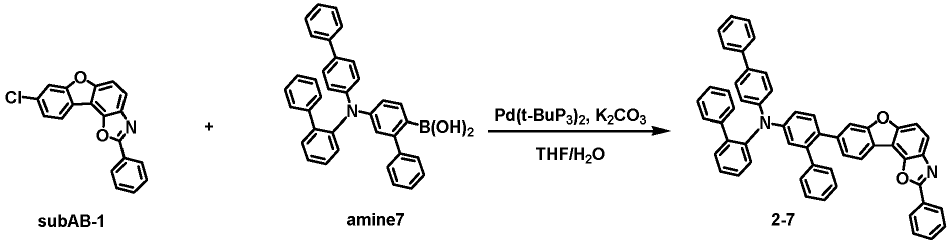

subAB-1 (15g, 46.9mmol) and amine7 (25.5g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.2 g of Compound 2-7 (yield 57%, MS: [M+H]+= 757).

### Synthesis Example 2-8

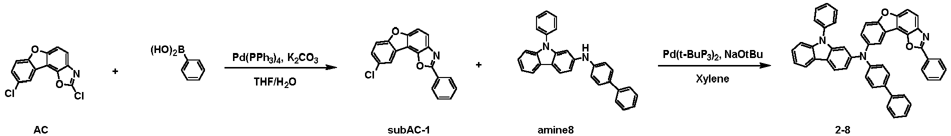

Chemical Formula AC (15g, 53.9mmol) and phenylboronic acid (6.6g, 53.9mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.1 g of subAC-1 (yield 76%, MS: [M+H]+= 320).

subAC-1 (10 g, 31.3mmol), amine8 (12.8g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 15 g of Compound 2-8 (yield 69%, MS: [M+H]+= 694).

### Synthesis Example 2-9

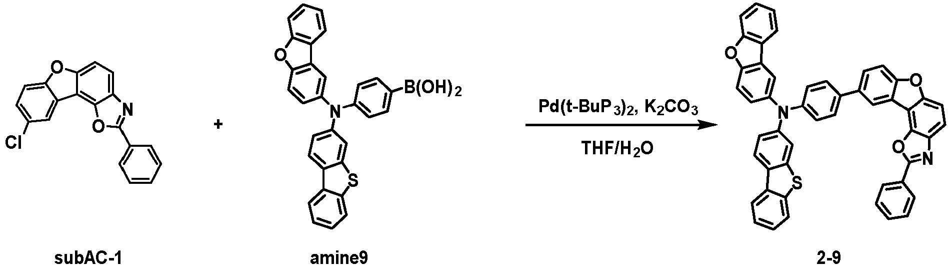

subAC-1 (15g, 46.9mmol) and amine9 (22.8g, 46.9mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 23.1 g of Compound 2-9 (yield 68%, MS: [M+H]+= 725).

### Synthesis Example 2-10

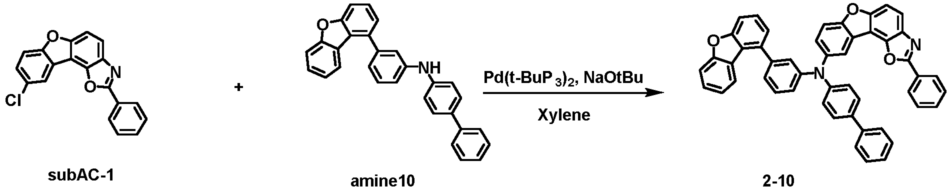

subAC-1 (10 g, 31.3mmol), amine10 (12.9g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 10.9 g of Compound 2-10 (yield 50%, MS: [M+H]+= 695).

### Synthesis Example 2-11

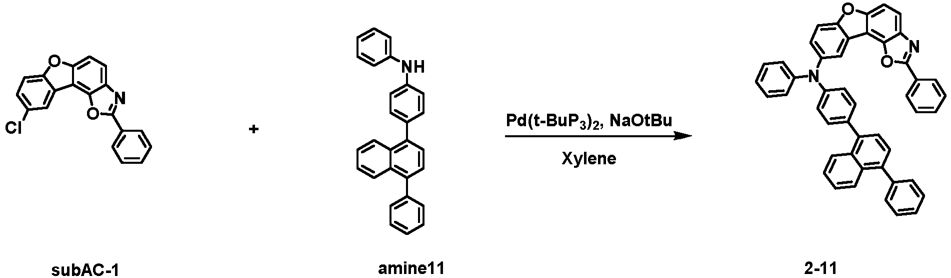

subAC-1 (10 g, 31.3mmol), amine11 (11.6g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 12.3 g of Compound 2-11 (yield 60%, MS: [M+H]+= 655).

### Synthesis Example 2-12

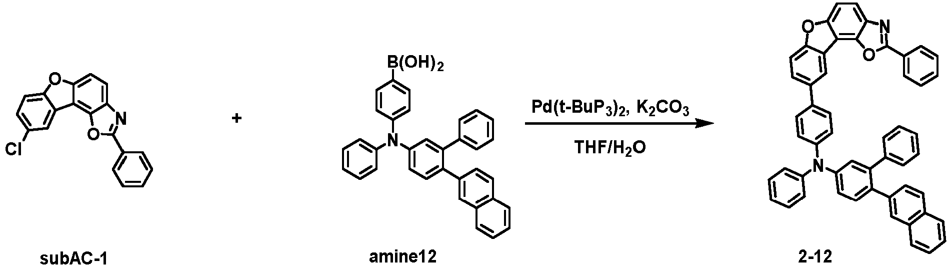

subAC-1 (15g, 46.9mmol) and amine12 (24.2g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 17.5 g of Compound 2-12 (yield 51%, MS: [M+H]+= 731).

### Synthesis Example 2-13

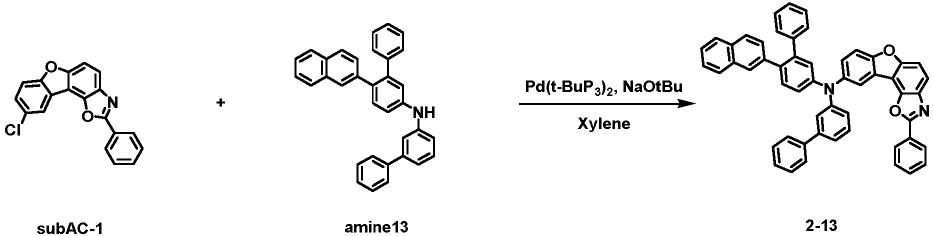

subAC-1 (10 g, 31.3mmol), amine13 (14g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 12.6 g of Compound 2-13 (yield 55%, MS: [M+H]+= 731).

### Synthesis Example 2-14

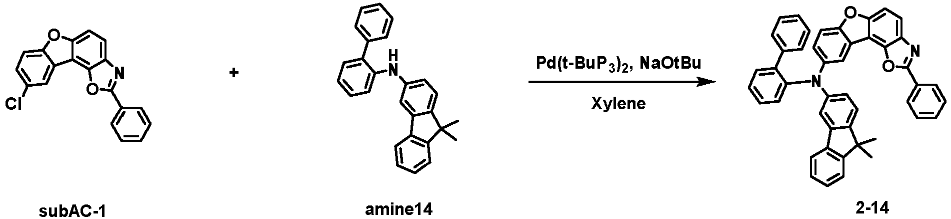

subAC-1 (10 g, 31.3mmol), amine14 (11.3g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 12.1 g of Compound 2-14 (yield 60%, MS: [M+H]+= 645).

### Synthesis Example 2-15

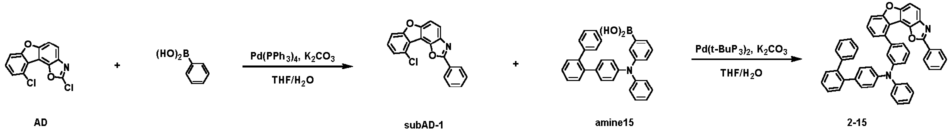

Chemical Formula AD (15g, 53.9mmol) and phenylboronic acid (6.9g, 56.6mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 12 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 8.8 g of subAD-1 (yield 51%, MS: [M+H]+= 320).

subAD-1 (15g, 46.9mmol) and amine15 (21.7g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 18.8 g of Compound 2-15 (yield 59%, MS: [M+H]+= 681).

### Synthesis Example 2-16

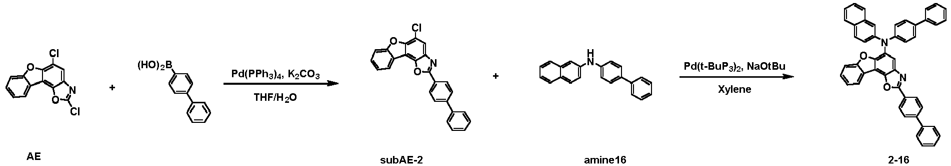

Chemical Formula AE (15g, 53.9mmol) and [1,1'-biphenyl]-4-ylboronic acid (10.7g, 53.9mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 12 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 17 g of subAE-2 (yield 80%, MS: [M+H]+= 396). subAE-2 (10 g, 25.3mmol), amine16 (7.5g, 25.3 mmol), and sodium tert-butoxide (8 g, 37.9 mmol) were added to 200 ml of Xylene under a nitrogen atmosphere, and the mixture was stirred and refluxed. Then, bis(tri-tert-butylphosphine)palladium(0) (0.1 g, 0.3 mmol) was added thereto. After 2 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 8.3 g of Compound 2-16 (yield 50%, MS: [M+H]+= 655).

### Synthesis Example 2-17

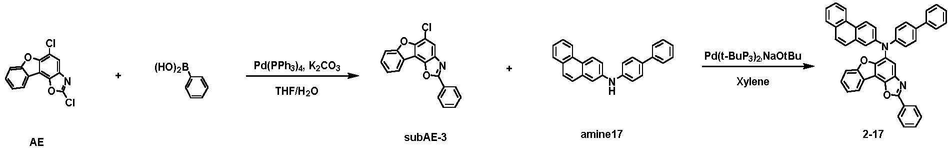

Chemical Formula AE (15g, 53.9mmol) and phenylboronic acid (6.9g, 56.6mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 11.4 g of subAE-3 (yield 66%, MS: [M+H]+= 320).

subAE-3 (10 g, 31.3mmol), amine17 (10.8g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 12.8 g of Compound 2-17 (yield 65%, MS: [M+H]+= 629).

### Synthesis Example 2-18

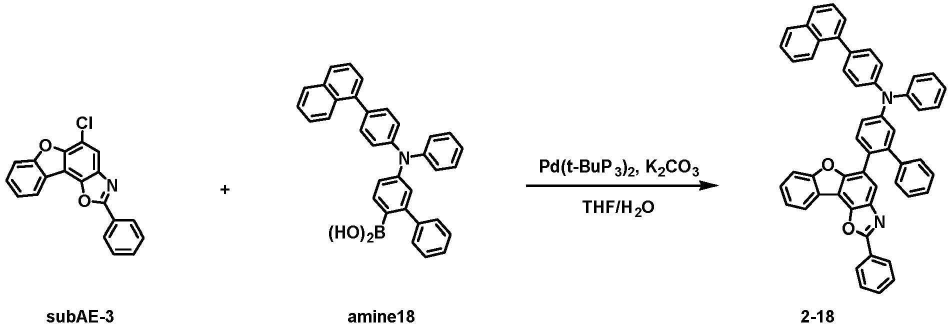

subAE-3 (15g, 46.9mmol) and amine18 (24.2g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.9 g of Compound 2-18 (yield 61%, MS: [M+H]+= 731).

### Synthesis Example 2-19

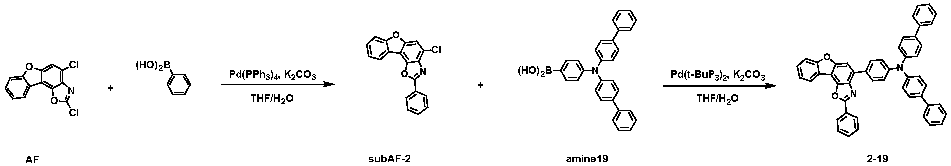

Chemical Formula AF (15g, 53.9mmol) and phenylboronic acid (6.6g, 53.9mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.7 g of subAF-2 (yield 74%, MS: [M+H]+= 320).

subAF-2 (15g, 46.9mmol) and amine19 (20.7g, 46.9mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 20.1 g of Compound 2-19 (yield 63%, MS: [M+H]+= 681).

### Synthesis Example 2-20

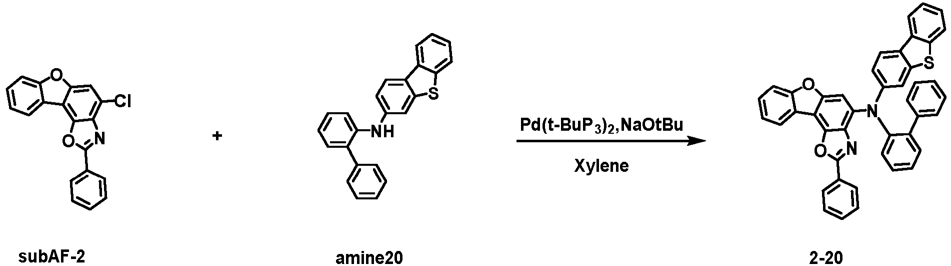

subAF-2 (10 g, 31.3mmol), amine20 (11g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 2 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 10.7 g of Compound 2-20 (yield 54%, MS: [M+H]+= 635).

### Synthesis Example 2-21

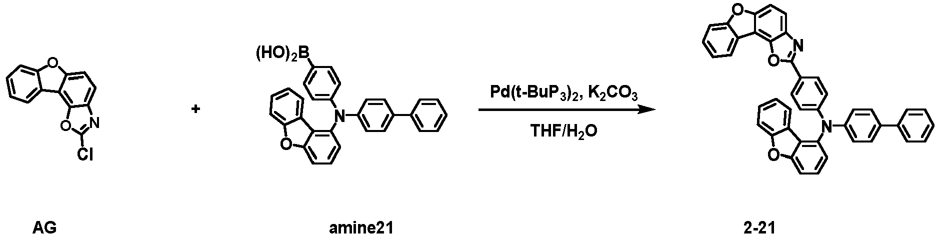

Chemical Formula AG (15g, 61.6mmol) and amine21 (29.4g, 64.6mmol) were added to 300 ml of THF under a nitrogen atmosphere, and the mixture was stirred and refluxed. Then, potassium carbonate (25.5g, 184.7mmol) was dissolved in 77 ml of water, and then added thereto. Thereafter, it was stirred sufficiently, followed by adding bis(tri-tert-butylphosphine)palladium(0) (0.3g, 0.6mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26.6 g of Compound 2-21 (yield 70%, MS: [M+H]+= 619).

### Synthesis Example 2-22

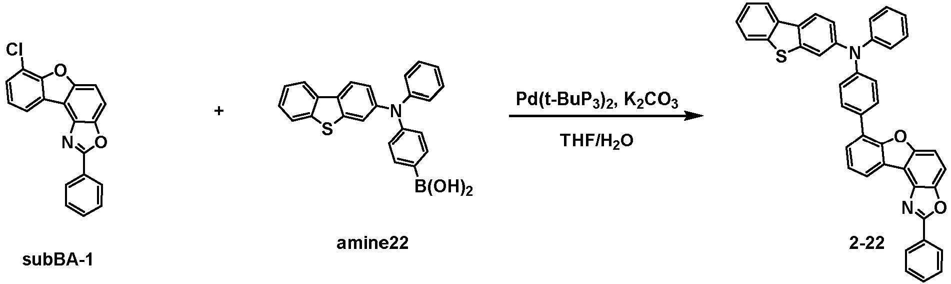

subBA-1 (15g, 46.9mmol) and amine22 (18.5g, 46.9mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 23.2 g of Compound 2-22 (yield 78%, MS: [M+H]+= 635).

### Synthesis Example 2-23

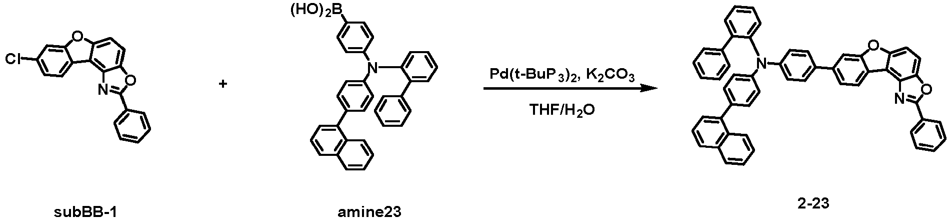

subBB-1 (15g, 46.9mmol) and amine23 (23.1g, 46.9mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 12 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26.7 g of Compound 2-23 (yield 78%, MS: [M+H]+= 731).

### Synthesis Example 2-24

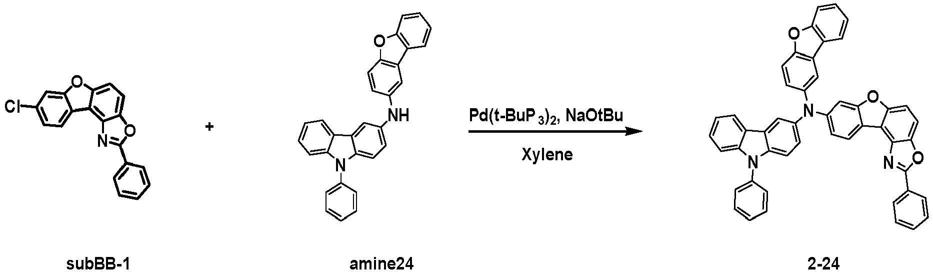

subBB-1 (10 g, 31.3mmol), amine24 (13.3g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 13.2 g of Compound 2-24 (yield 60%, MS: [M+H]+= 703).

### Synthesis Example 2-25

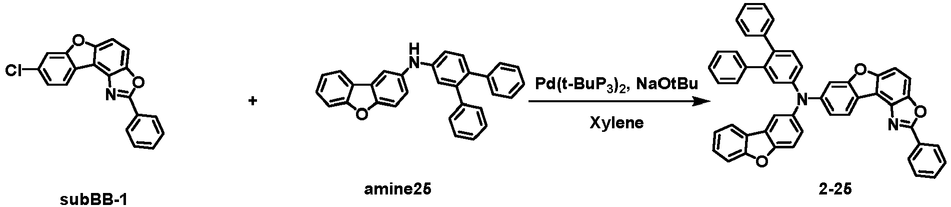

subBB-1 (10 g, 31.3mmol), amine25 (12.9g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 12.6 g of Compound 2-25 (yield 58%, MS: [M+H]+= 695).

### Synthesis Example 2-26

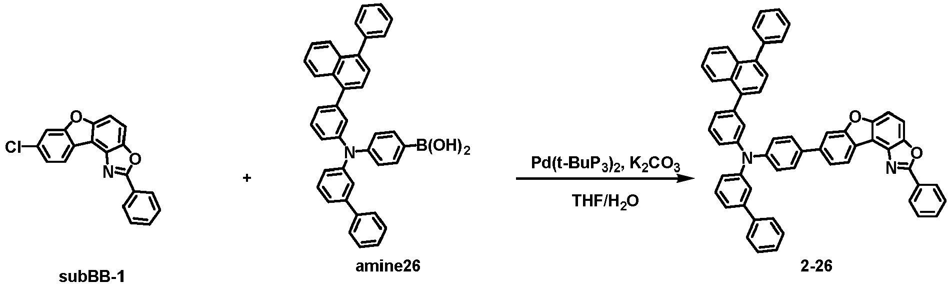

suBB-1 (15g, 46.9mmol) and amine26 (28g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26.1 g of Compound 2-26 (yield 69%, MS: [M+H]+= 807).

### Synthesis Example 2-27

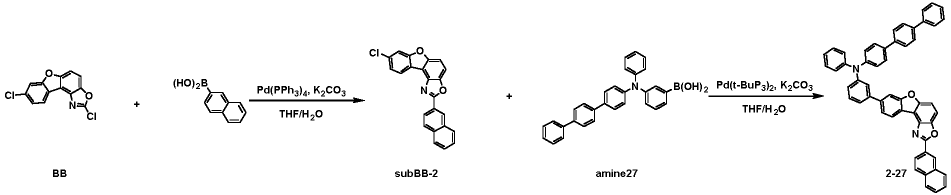

Chemical Formula BB (15g, 53.9mmol) and naphthalen-2-ylboronic acid (9.7g, 56.6mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 10.6 g of subBB-2 (yield 53%, MS: [M+H]+= 370).

subBB-2 (15g, 40.6mmol) and amine27 (18.8g, 42.6mmol) were added to 300 ml of THF under a nitrogen atmosphere, and the mixture was stirred and refluxed. Then, potassium carbonate (16.8g, 121.7mmol) was dissolved in 50 ml of water, and then added thereto. Thereafter, it was stirred sufficiently, followed by adding bis(tri-tert-butylphosphine)palladium(0) (0.2g, 0.4mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 19.8 g of Compound 2-27 (yield 67%, MS: [M+H]+= 731).

### Synthesis Example 2-28

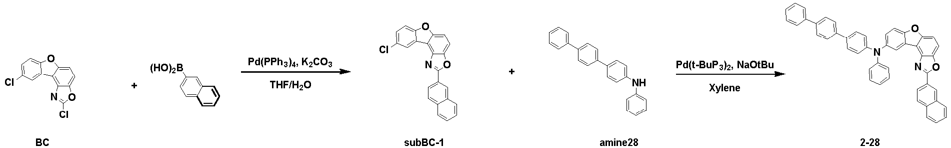

Chemical Formula BC (15g, 53.9mmol) and naphthalen-2-ylboronic acid (9.3g, 53.9mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.1 g of subBC-1 (yield 76%, MS: [M+H]+= 370). subBC-1 (10 g, 27mmol), amine28 (8.7g, 27 mmol), and sodium tert-butoxide (8.6 g, 40.6 mmol) were added to 200 ml of Xylene under a nitrogen atmosphere, and the mixture was stirred and refluxed. Then, bis(tri-tert-butylphosphine)palladium(0) (0.1 g, 0.3 mmol) was added thereto. After 3 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 9 g of Compound 2-28 (yield 51%, MS: [M+H]+= 655).

### Synthesis Example 2-29

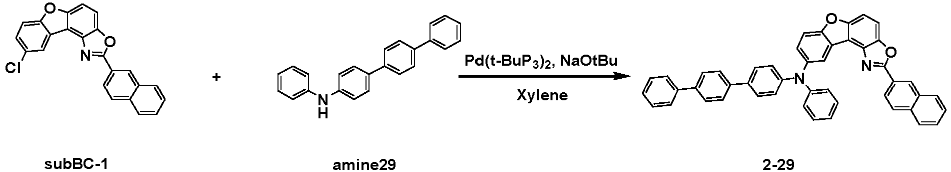

subBC-1 (10 g, 27mmol), amine29 (8.7g, 27 mmol), and sodium tert-butoxide (8.6 g, 40.6 mmol) were added to 200 ml of Xylene under a nitrogen atmosphere, and the mixture was stirred and refluxed. Then, bis(tri-tert-butylphosphine)palladium(0) (0.1 g, 0.3 mmol) was added thereto. After 2 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 10.6 g of Compound 2-29 (yield 60%, MS: [M+H]+= 655).

### Synthesis Example 2-30

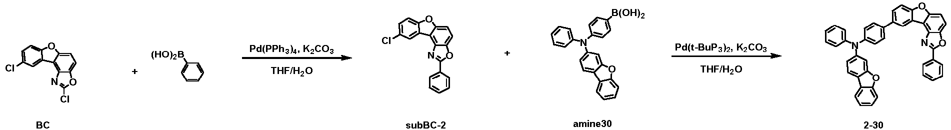

Chemical Formula BC (15g, 53.9mmol) and phenylboronic acid (6.6g, 53.9mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 11 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.4 g of subBC-2 (yield 78%, MS: [M+H]+= 320).

subBC-2 (15g, 46.9mmol) and amine30 (17.8g, 46.9mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 21.5 g of Compound 2-30 (yield 74%, MS: [M+H]+= 619).

### Synthesis Example 2-31

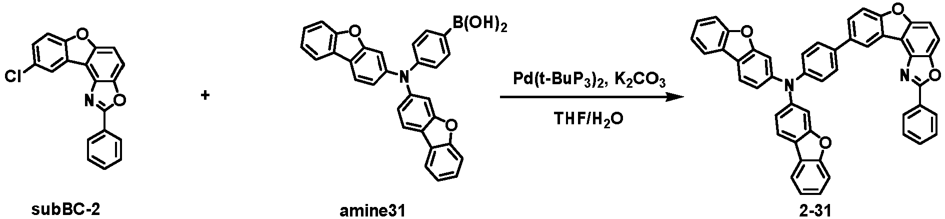

subBC-2 (15g, 46.9mmol) and amine31 (23.1g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 21.6 g of Compound 2-31 (yield 65%, MS: [M+H]+= 709).

### Synthesis Example 2-32

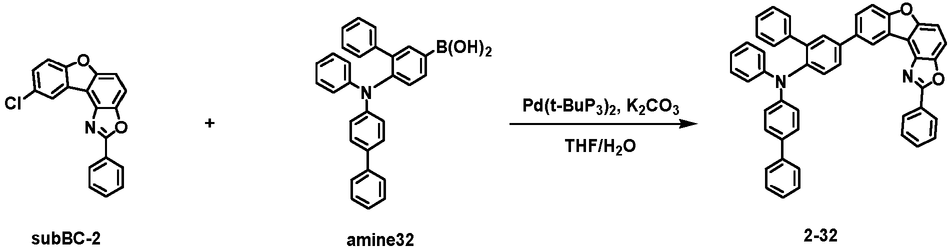

subBC-2 (15g, 46.9mmol) and amine32 (21.7g, 49.3mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 18.8 g of Compound 2-32 (yield 59%, MS: [M+H]+= 681).

### Synthesis Example 2-33

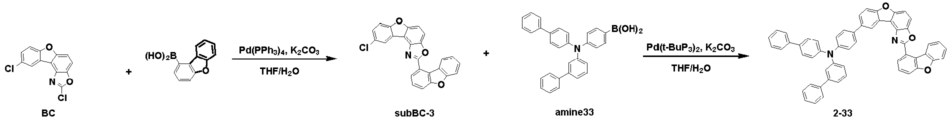

Chemical Formula BC (15g, 53.9mmol) and dibenzo[b,d]furan-1-ylboronic acid (11.4g, 53.9mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.9 g of subBC-3 (yield 63%, MS: [M+H]+= 410).

subBC-3 (15g, 36.6mmol) and amine33 (16.2g, 36.6mmol) were added to 300 ml of THF under a nitrogen atmosphere, and the mixture was stirred and refluxed. Then, potassium carbonate (15.2g, 109.8mmol) was dissolved in 46 ml of water, and then added thereto. Thereafter, it was stirred sufficiently, followed by adding bis(tri-tert-butylphosphine)palladium(0) (0.2g, 0.4mmol). After 12 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 18.3 g of Compound 2-33 (yield 65%, MS: [M+H]+= 771).

### Synthesis Example 2-34

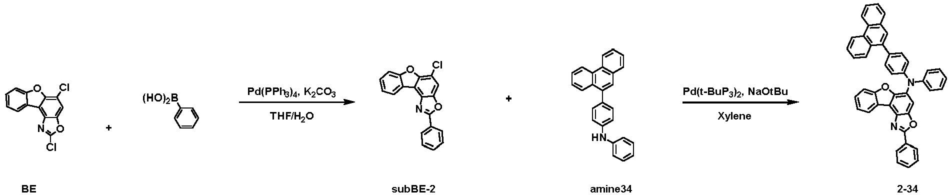

Chemical Formula BE (15g, 53.9mmol) and phenylboronic acid (6.6g, 53.9mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 12 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 13.1 g of subBE-2 (yield 76%, MS: [M+H]+= 320).

subBE-2 (10 g, 31.3mmol), amine34 (10.8g, 31.3 mmol), and sodium tert-butoxide (10 g, 46.9 mmol) were added to 200 ml of Xylene under a nitrogen atmosphere, and the mixture was stirred and refluxed. Then, bis(tri-tert-butylphosphine)palladium(0) (0.2 g, 0.3 mmol) was added thereto. After 2 hours, the reaction was completed, cooling was performed to room temperature, and the solvent was removed under reduced pressure. Then, the compound was completely dissolved again in chloroform, and washed twice with water. Thereafter, the organic layer was separated, treated with anhydrous magnesium sulfate, then filtered, and the filtrate was distilled under reduced pressure. The concentrated compound was purified by silica gel column chromatography to prepare 13 g of Compound 2-34 (yield 66%, MS: [M+H]+= 629).

### Synthesis Example 2-35

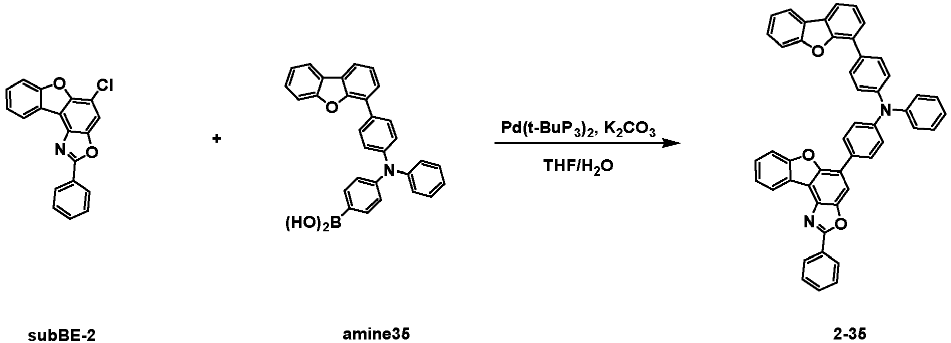

subBE-2 (15g, 46.9mmol) and amine35 (21.4g, 46.9mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 23.4 g of Compound 2-35 (yield 72%, MS: [M+H]+= 695).

### Synthesis Example 2-36

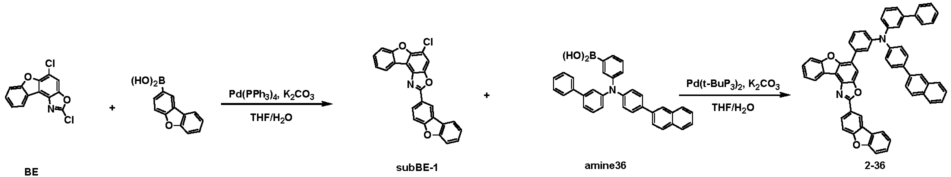

Chemical Formula BE (15g, 53.9mmol) and dibenzo[b,d]furan-2-ylboronic acid (12g, 56.6mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 12 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 12.4 g of subBE-1 (yield 56%, MS: [M+H]+= 410).

subBE-1 (15g, 36.6mmol) and amine36 (18.9g, 38.4mmol) were added to 300 ml of THF under a nitrogen atmosphere, and the mixture was stirred and refluxed. Then, potassium carbonate (15.2g, 109.8mmol) was dissolved in 46 ml of water, and then added thereto. Thereafter, it was stirred sufficiently, followed by adding bis(tri-tert-butylphosphine)palladium(0) (0.2g, 0.4mmol). After 12 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 15.3 g of Compound 2-36 (yield 51%, MS: [M+H]+= 821).

### Synthesis Example 2-37

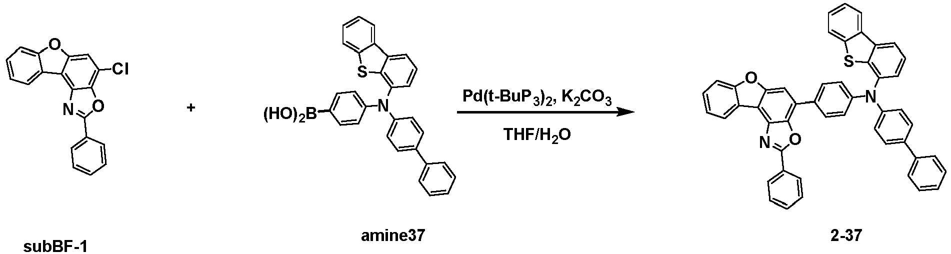

subBF-1 (15g, 46.9mmol) and amine37 (22.1g, 46.9mmol) were added to 300 ml of THF under a nitrogen atmosphere, and the mixture was stirred and refluxed. Then, potassium carbonate (19.5g, 140.7mmol) was dissolved in 58 ml of water, and then added thereto. Thereafter, it was stirred sufficiently, followed by adding bis(tri-tert-butylphosphine)palladium(0) (0.2g, 0.5mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 23.3 g of Compound 2-37 (yield 70%, MS: [M+H]+= 711).

### Synthesis Example 2-38

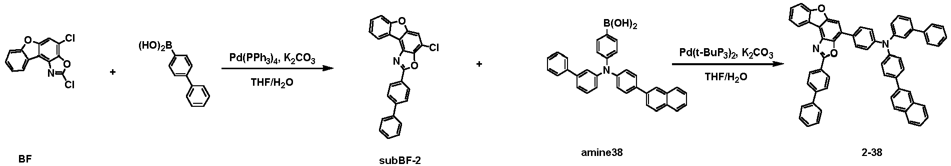

Chemical Formula BF (15g, 53.9mmol) and [1,1'-biphenyl]-4-ylboronic acid (11.2g, 56.6mmol) were added to 300 ml of THF under a nitrogen atmosphere, and the mixture was stirred and refluxed. Then, potassium carbonate (22.4g, 161.8mmol) was dissolved in 67 ml of water, and then added thereto. Thereafter, it was stirred sufficiently, followed by adding tetrakis(triphenylphosphine)palladium(0) (0.6g, 0.5mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 14.1 g of subBF-2 (yield 66%, MS: [M+H]+= 396).

subBF-2 (15g, 37.9mmol) and amine38 (19.6g, 39.8mmol) were added to 300 ml of THF under a nitrogen atmosphere, and the mixture was stirred and refluxed. Then, potassium carbonate (15.7g, 113.7mmol) was dissolved in 47 ml of water, and then added thereto. Thereafter, it was stirred sufficiently, followed by adding bis(tri-tert-butylphosphine)palladium(0) (0.2g, 0.4mmol). After 9 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 18.6 g of Compound 2-38 (yield 61%, MS: [M+H]+= 807).

### Synthesis Example 2-39

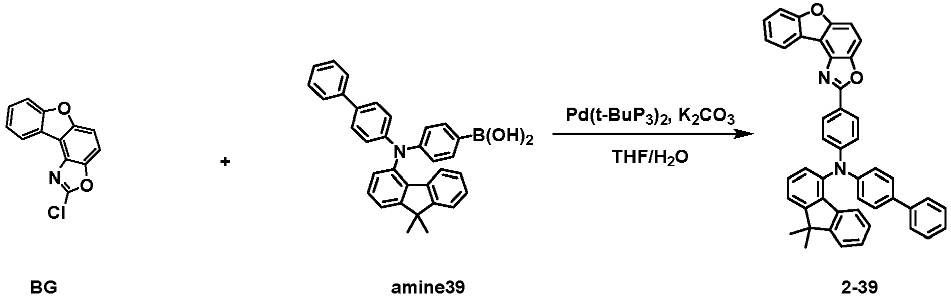

Chemical Formula BG (15g, 61.7mmol) and amine39 (31.2g, 64.8mmol) were added to 300 ml of THF under a nitrogen atmosphere, and the mixture was stirred and refluxed. Then, potassium carbonate (25.6g, 185.2mmol) was dissolved in 77 ml of water, and then added thereto. Thereafter, it was stirred sufficiently, followed by adding bis(tri-tert-butylphosphine)palladium(0) (0.3g, 0.6mmol). After 10 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 26.2 g of Compound 2-39 (yield 66%, MS: [M+H]+= 645).

### Synthesis Example 2-40

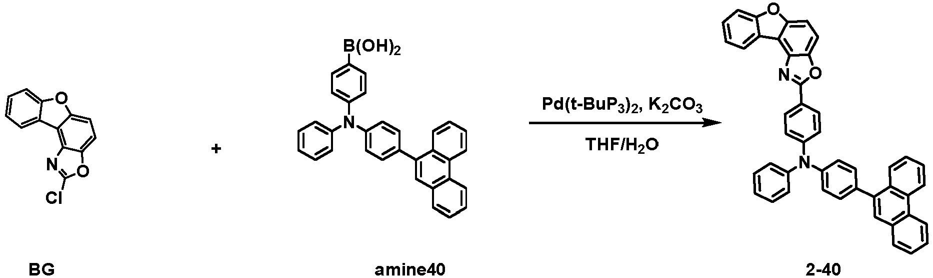

Chemical Formula BG (15g, 43.4mmol) and amine40 (21.2g, 45.5mmol) were added to 300 ml of THF under a nitrogen atmosphere, and the mixture was stirred and refluxed. Then, potassium carbonate (18g, 130.1mmol) was dissolved in 54 ml of water, and then added thereto. Thereafter, it was stirred sufficiently, followed by adding bis(tri-tert-butylphosphine)palladium(0) (0.2g, 0.4mmol). After 8 hours of reaction, cooling was performed to room temperature. Then, the organic layer was separated from the water layer, and then the organic layer was distilled. Then, this was dissolved again in chloroform, and washed twice with water. Thereafter, the organic layer was separated, treated with anhydrous magnesium sulfate, stirred, then filtered, and the filtrate was distilled under reduced pressure. The concentrated compound was purified by silica gel column chromatography to prepare 18.3 g of Compound 2-40 (yield 67%, MS: [M+H]+= 629).

### <Examples and Comparative Examples>

### Example 1

A glass substrate on which ITO (indium tin oxide) was coated as a thin film to a thickness of 1,000 Å was put into distilled water in which a detergent was dissolved, and ultrasonically cleaned. At this time, a product manufactured by Fischer Co. was used as the detergent, and distilled water filtered twice using a filter manufactured by Millipore Co. was used as the distilled water. After the ITO was cleaned for 30 minutes, ultrasonic cleaning was repeated twice using distilled water for 10 minutes. After the cleaning with distilled water was completed, the substrate was ultrasonically cleaned with solvents of isopropyl alcohol, acetone, and methanol, dried, and then transferred to a plasma cleaner. In addition, the substrate was cleaned for 5 minutes using oxygen plasma and then transferred to a vacuum depositor.

On the prepared ITO transparent electrode, the following Compound HI-1 was formed to a thickness of 1150 Å while the following Compound A-1 was p-doped at a concentration of 1.5% to form a hole injection layer. On the hole injection layer, the following Compound HT-1 was vacuum-deposited to form a hole transport layer having a thickness of 800 Å. Then, on the hole transport layer, the following Compound EB-1 was vacuum-deposited to form an electron blocking layer having a thickness of 150 Å. Then, on the EB-1 deposited film, the following Compound 1-2, Compound 2-1 and Compound Dp-7 were vacuum-deposited at a weight ratio of 49:49:2 to form a red light emitting layer having a thickness of 400 Å. On the light emitting layer, the following Compound HB-1 was vacuum-deposited to form a hole blocking layer having a thickness of 30 Å. On the hole blocking layer, the following Compound ET-1 and the following Compound LiQ were vacuum-deposited at a weight ratio of 2:1 to form an electron injection and transport layer having a thickness of 300 Å. On the electron injection and transport layer, lithium fluoride (LiF) and aluminum were sequentially deposited to a thickness of 12 Å and 1000 Å, respectively, to form a cathode.

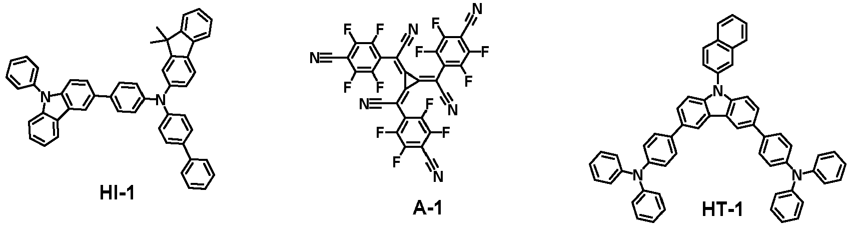

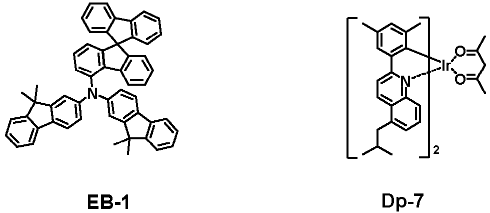

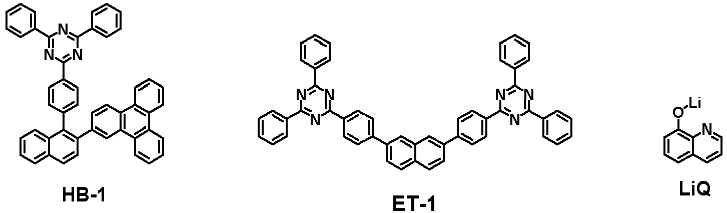

In the above process, the deposition rate of the organic material was maintained at 0.4 to 0.7 Å/sec, the deposition rate of lithium fluoride of the cathode was maintained at 0.3Å/sec, and the deposition rate of aluminum was maintained at 2 Å/sec. In addition, the degree of vacuum during the deposition was maintained at 2 x 10⁻⁷ to 5 x 10⁻⁶ torr, thereby manufacturing an organic light emitting device.

### Examples 2 to 185

An organic light emitting device was manufactured in the same manner as in Example 1, except that the first host and the second host described in Table 1 were used by co-deposition at a weight ratio of 1:1 instead of Compound 1-2 and Compound 2-1 in the organic light emitting device of Example 1.

### Comparative Examples 1 to 60

An organic light emitting device was manufactured in the same manner as in Example 1, except that one of Comparative Compounds A-1 to A-12 described in Table 2 as the first host and the compound of Chemical Formula 2 described in Table 2 as the second host were used by co-deposition at a weight ratio of 1:1.

### Comparative Examples 61 to 220

An organic light emitting device was manufactured in the same manner as in Example 1, except that the compound of Chemical Formula 1 described in Table 3 as the first host and one of Comparative Compounds B-1 to B-20 described in Table 3 as the second host were used by co-deposition at a weight ratio of 1:1.

Comparative Compounds A-1 to A-12 and B-1 to B-20 are as follows.

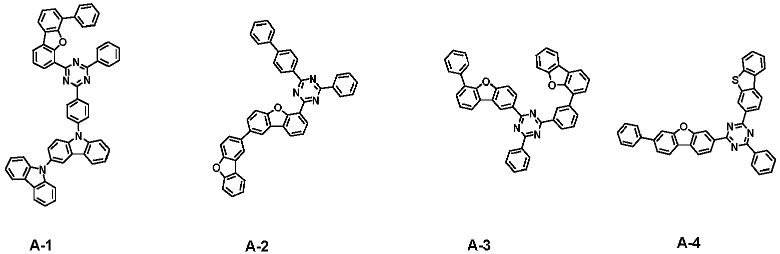

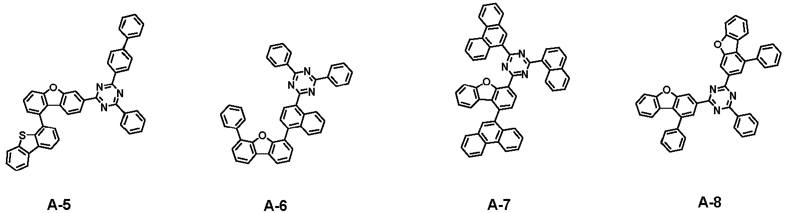

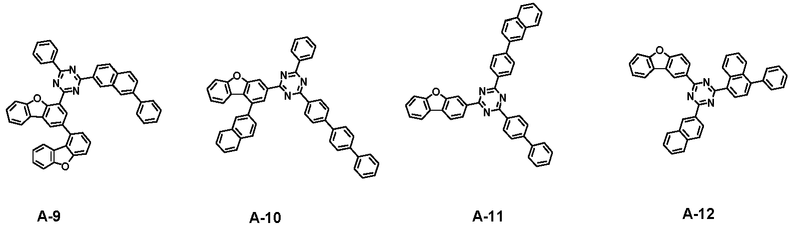

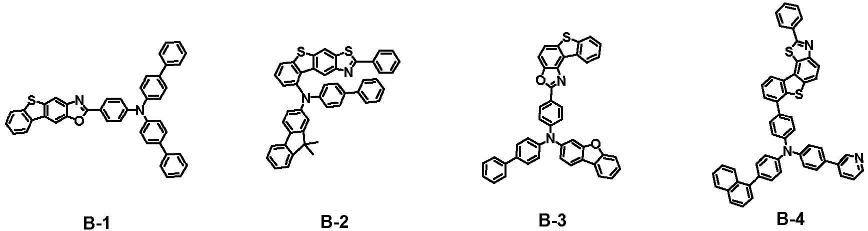

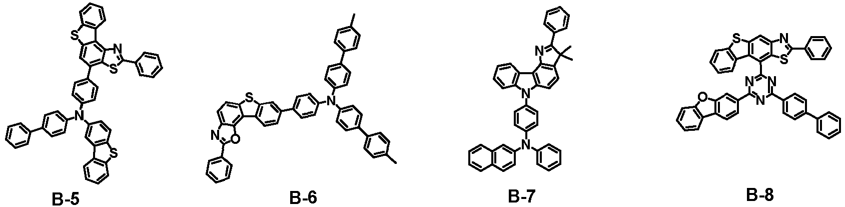

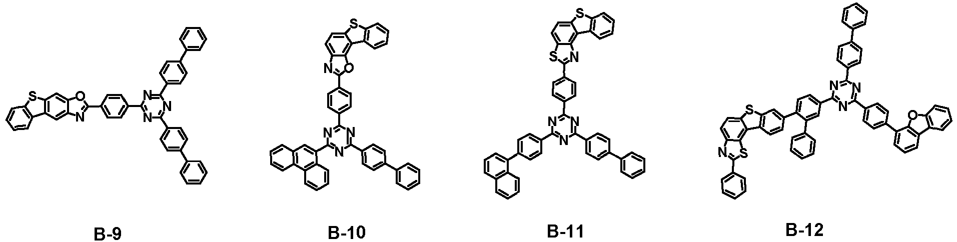

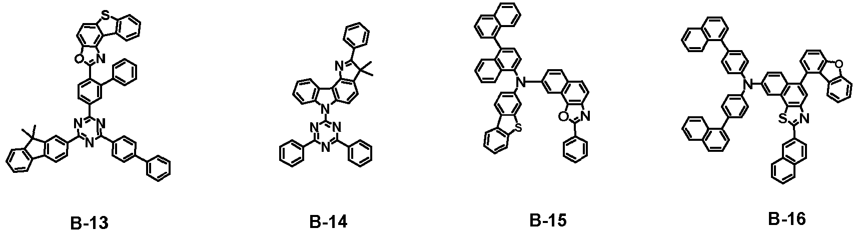

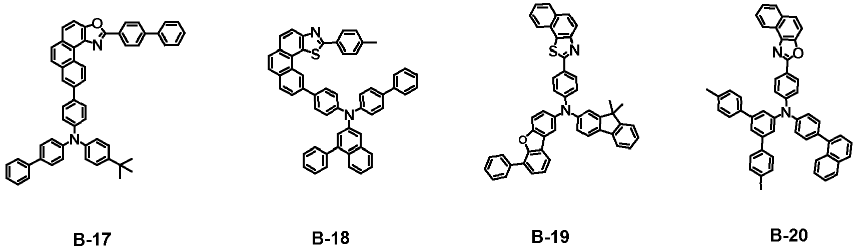

### <Experimental Example>

For the organic light emitting devices prepared in Examples 1 to 185 and Comparative Examples 1 to 220, the voltage, and efficiency were measured by applying a current (15 mA/cm²), and the results are shown in Tables 1 to 3 below. The lifespan (T95) means the time taken until the initial luminance (7,000 nit) decreases to 95%.

**[Table 1]**

| Category | First host | Second host | Driving voltage (V) | Efficiency (cd/A) | Lifespan T95 (hr) | Emission color |
|---|---|---|---|---|---|---|
| Example 1 | Compound 1-2 | Compound 2-1 | 3.68 | 20.41 | 214 | Red |
| Example 2 | Compound 1-2 | Compound 2-11 | 3.73 | 20.11 | 207 | Red |
| Example 3 | Compound 1-2 | Compound 2-16 | 3.68 | 19.99 | 227 | Red |
| Example 4 | Compound 1-2 | Compound 2-21 | 3.68 | 19.96 | 223 | Red |
| Example 5 | Compound 1-2 | Compound 2-36 | 3.73 | 19.95 | 226 | Red |
| Example 6 | Compound 1-3 | Compound 2-6 | 3.73 | 20.30 | 211 | Red |
| Example 7 | Compound 1-3 | Compound 2-16 | 3.68 | 20.18 | 211 | Red |
| Example 8 | Compound 1-3 | Compound 2-26 | 3.72 | 20.62 | 209 | Red |
| Example 9 | Compound 1-3 | Compound 2-31 | 3.74 | 20.44 | 217 | Red |
| Example 10 | Compound 1-3 | Compound 2-36 | 3.73 | 20.32 | 203 | Red |
| Example 11 | Compound 1-8 | Compound 2-1 | 3.39 | 22.18 | 291 | Red |
| Example 12 | Compound 1-8 | Compound 2-11 | 3.47 | 22.08 | 292 | Red |
| Example 13 | Compound 1-8 | Compound 2-16 | 3.44 | 21.88 | 283 | Red |
| Example 14 | Compound 1-8 | Compound 2-21 | 3.41 | 22.26 | 274 | Red |
| Example 15 | Compound 1-8 | Compound 2-36 | 3.41 | 22.13 | 281 | Red |
| Example 16 | Compound 1-9 | Compound 2-6 | 3.63 | 20.63 | 236 | Red |
| Example 17 | Compound 1-9 | Compound 2-16 | 3.66 | 21.23 | 264 | Red |
| Example 18 | Compound 1-9 | Compound 2-26 | 3.69 | 20.94 | 252 | Red |
| Example 19 | Compound 1-9 | Compound 2-31 | 3.64 | 21.05 | 245 | Red |
| Example 20 | Compound 1-9 | Compound 2-36 | 3.65 | 20.77 | 228 | Red |
| Example 21 | Compound 1-10 | Compound 2-1 | 3.38 | 21.67 | 279 | Red |
| Example 22 | Compound 1-10 | Compound 2-11 | 3.35 | 21.66 | 283 | Red |
| Example 23 | Compound 1-10 | Compound 2-16 | 3.41 | 22.20 | 282 | Red |
| Example 24 | Compound 1-10 | Compound 2-21 | 3.45 | 22.02 | 294 | Red |
| Example 25 | Compound 1-10 | Compound 2-36 | 3.46 | 21.96 | 279 | Red |
| Example 26 | Compound 1-12 | Compound 2-6 | 3.35 | 21.74 | 274 | Red |
| Example 27 | Compound 1-12 | Compound 2-16 | 3.41 | 21.84 | 291 | Red |
| Example 28 | Compound 1-12 | Compound 2-26 | 3.38 | 22.28 | 281 | Red |
| Example 29 | Compound 1-12 | Compound 2-31 | 3.48 | 22.03 | 286 | Red |
| Example 30 | Compound 1-12 | Compound 2-36 | 3.43 | 22.10 | 275 | Red |
| Example 31 | Compound 1-15 | Compound 2-1 | 3.38 | 21.66 | 279 | Red |
| Example 32 | Compound 1-15 | Compound 2-11 | 3.35 | 21.13 | 283 | Red |
| Example 33 | Compound 1-15 | Compound 2-16 | 3.41 | 21.32 | 282 | Red |
| Example 34 | Compound 1-15 | Compound 2-21 | 3.45 | 21.52 | 294 | Red |
| Example 35 | Compound 1-15 | Compound 2-36 | 3.46 | 21.63 | 279 | Red |
| Example 36 | Compound 1-17 | Compound 2-2 | 3.70 | 20.04 | 219 | Red |
| Example 37 | Compound 1-17 | Compound 2-12 | 3.73 | 20.73 | 208 | Red |
| Example 38 | Compound 1-17 | Compound 2-17 | 3.67 | 20.37 | 207 | Red |
| Example 39 | Compound 1-17 | Compound 2-22 | 3.73 | 20.52 | 218 | Red |
| Example 40 | Compound 1-17 | Compound 2-37 | 3.69 | 20.30 | 221 | Red |
| Example 41 | Compound 1-20 | Compound 2-7 | 3.73 | 19.99 | 203 | Red |
| Example 42 | Compound 1-20 | Compound 2-17 | 3.71 | 20.80 | 207 | Red |
| Example 43 | Compound 1-20 | Compound 2-22 | 3.70 | 19.98 | 225 | Red |
| Example 44 | Compound 1-20 | Compound 2-32 | 3.72 | 20.31 | 207 | Red |
| Example 45 | Compound 1-20 | Compound 2-37 | 3.70 | 20.32 | 225 | Red |
| Example 46 | Compound 1-21 | Compound 2-2 | 3.40 | 22.10 | 294 | Red |
| Example 47 | Compound 1-21 | Compound 2-12 | 3.41 | 21.89 | 294 | Red |
| Example 48 | Compound 1-21 | Compound 2-17 | 3.40 | 22.30 | 297 | Red |
| Example 49 | Compound 1-21 | Compound 2-22 | 3.39 | 21.73 | 281 | Red |
| Example 50 | Compound 1-21 | Compound 2-37 | 3.47 | 22.24 | 290 | Red |
| Example 51 | Compound 1-24 | Compound 2-7 | 3.72 | 20.06 | 223 | Red |
| Example 52 | Compound 1-24 | Compound 2-17 | 3.74 | 20.22 | 220 | Red |
| Example 53 | Compound 1-24 | Compound 2-22 | 3.71 | 20.17 | 231 | Red |
| Example 54 | Compound 1-24 | Compound 2-32 | 3.71 | 20.54 | 223 | Red |
| Example 55 | Compound 1-24 | Compound 2-37 | 3.69 | 19.93 | 217 | Red |
| Example 56 | Compound 1-27 | Compound 2-2 | 3.68 | 20.28 | 212 | Red |
| Example 57 | Compound 1-27 | Compound 2-12 | 3.68 | 20.19 | 205 | Red |
| Example 58 | Compound 1-27 | Compound 2-17 | 3.69 | 20.20 | 207 | Red |
| Example 59 | Compound 1-27 | Compound 2-22 | 3.72 | 20.42 | 215 | Red |
| Example 60 | Compound 1-27 | Compound 2-37 | 3.72 | 20.32 | 208 | Red |
| Example 61 | Compound 1-28 | Compound 2-7 | 3.40 | 21.68 | 294 | Red |
| Example 62 | Compound 1-28 | Compound 2-17 | 3.41 | 21.12 | 294 | Red |
| Example 63 | Compound 1-28 | Compound 2-22 | 3.40 | 21.31 | 297 | Red |
| Example 64 | Compound 1-28 | Compound 2-32 | 3.39 | 21.14 | 281 | Red |
| Example 65 | Compound 1-28 | Compound 2-37 | 3.47 | 21.06 | 290 | Red |
| Example 66 | Compound 1-31 | Compound 2-2 | 3.74 | 21.83 | 218 | Red |
| Example 67 | Compound 1-31 | Compound 2-12 | 3.70 | 21.74 | 218 | Red |
| Example 68 | Compound 1-31 | Compound 2-17 | 3.68 | 22.23 | 230 | Red |
| Example 69 | Compound 1-31 | Compound 2-22 | 3.69 | 22.05 | 209 | Red |
| Example 70 | Compound 1-31 | Compound 2-37 | 3.68 | 22.05 | 230 | Red |
| Example 71 | Compound 1-33 | Compound 2-7 | 3.38 | 21.83 | 294 | Red |
| Example 72 | Compound 1-33 | Compound 2-17 | 3.44 | 21.74 | 273 | Red |
| Example 73 | Compound 1-33 | Compound 2-22 | 3.41 | 22.23 | 273 | Red |
| Example 74 | Compound 1-33 | Compound 2-32 | 3.47 | 22.05 | 273 | Red |
| Example 75 | Compound 1-33 | Compound 2-37 | 3.35 | 22.05 | 284 | Red |
| Example 76 | Compound 1-37 | Compound 2-3 | 3.40 | 22.24 | 274 | Red |
| Example 77 | Compound 1-37 | Compound 2-13 | 3.35 | 22.03 | 288 | Red |
| Example 78 | Compound 1-37 | Compound 2-18 | 3.42 | 22.11 | 298 | Red |
| Example 79 | Compound 1-37 | Compound 2-23 | 3.36 | 21.99 | 287 | Red |
| Example 80 | Compound 1-37 | Compound 2-38 | 3.38 | 22.08 | 275 | Red |
| Example 81 | Compound 1-39 | Compound 2-8 | 3.48 | 21.64 | 281 | Red |
| Example 82 | Compound 1-39 | Compound 2-18 | 3.43 | 22.03 | 281 | Red |
| Example 83 | Compound 1-39 | Compound 2-23 | 3.48 | 22.32 | 279 | Red |
| Example 84 | Compound 1-39 | Compound 2-33 | 3.38 | 21.70 | 279 | Red |
| Example 85 | Compound 1-39 | Compound 2-38 | 3.41 | 21.64 | 287 | Red |
| Example 86 | Compound 1-40 | Compound 2-3 | 3.71 | 20.28 | 209 | Red |
| Example 87 | Compound 1-40 | Compound 2-13 | 3.67 | 20.77 | 218 | Red |
| Example 88 | Compound 1-40 | Compound 2-18 | 3.70 | 20.13 | 227 | Red |
| Example 89 | Compound 1-40 | Compound 2-23 | 3.68 | 20.63 | 222 | Red |
| Example 90 | Compound 1-40 | Compound 2-38 | 3.74 | 20.04 | 222 | Red |
| Example 91 | Compound 1-41 | Compound 2-8 | 3.67 | 20.34 | 222 | Red |
| Example 92 | Compound 1-41 | Compound 2-18 | 3.73 | 20.57 | 229 | Red |
| Example 93 | Compound 1-41 | Compound 2-23 | 3.72 | 20.63 | 207 | Red |
| Example 94 | Compound 1-41 | Compound 2-33 | 3.68 | 20.00 | 216 | Red |
| Example 95 | Compound 1-41 | Compound 2-38 | 3.73 | 20.30 | 203 | Red |
| Example 96 | Compound 1-42 | Compound 2-3 | 3.36 | 21.50 | 297 | Red |
| Example 97 | Compound 1-42 | Compound 2-13 | 3.43 | 21.35 | 287 | Red |
| Example 98 | Compound 1-42 | Compound 2-18 | 3.42 | 21.10 | 285 | Red |
| Example 99 | Compound 1-42 | Compound 2-23 | 3.46 | 21.35 | 292 | Red |
| Example 100 | Compound 1-42 | Compound 2-38 | 3.40 | 21.27 | 293 | Red |
| Example 101 | Compound 1-43 | Compound 2-8 | 3.47 | 21.46 | 297 | Red |
| Example 102 | Compound 1-43 | Compound 2-18 | 3.37 | 21.52 | 278 | Red |
| Example 103 | Compound 1-43 | Compound 2-23 | 3.38 | 21.31 | 288 | Red |
| Example 104 | Compound 1-43 | Compound 2-33 | 3.42 | 21.40 | 290 | Red |
| Example 105 | Compound 1-43 | Compound 2-38 | 3.43 | 21.40 | 279 | Red |
| Example 106 | Compound 1-44 | Compound 2-3 | 3.48 | 22.34 | 287 | Red |
| Example 107 | Compound 1-44 | Compound 2-13 | 3.46 | 21.78 | 295 | Red |
| Example 108 | Compound 1-44 | Compound 2-18 | 3.40 | 22.17 | 289 | Red |
| Example 109 | Compound 1-44 | Compound 2-23 | 3.36 | 21.68 | 281 | Red |
| Example 110 | Compound 1-44 | Compound 2-38 | 3.44 | 21.88 | 288 | Red |
| Example 101 | Compound 1-48 | Compound 2-8 | 3.39 | 21.68 | 280 | Red |
| Example 102 | Compound 1-48 | Compound 2-18 | 3.45 | 21.69 | 272 | Red |
| Example 103 | Compound 1-48 | Compound 2-23 | 3.44 | 21.80 | 282 | Red |
| Example 104 | Compound 1-48 | Compound 2-33 | 3.44 | 22.16 | 288 | Red |
| Example 105 | Compound 1-48 | Compound 2-38 | 3.48 | 21.75 | 291 | Red |
| Example 106 | Compound 1-52 | Compound 2-4 | 3.61 | 20.59 | 297 | Red |
| Example 107 | Compound 1-52 | Compound 2-14 | 3.45 | 20.43 | 295 | Red |
| Example 108 | Compound 1-52 | Compound 2-19 | 3.62 | 20.18 | 285 | Red |
| Example 109 | Compound 1-52 | Compound 2-24 | 3.48 | 20.64 | 286 | Red |
| Example 110 | Compound 1-52 | Compound 2-39 | 3.55 | 20.38 | 275 | Red |
| Example 111 | Compound 1-53 | Compound 2-9 | 3.53 | 20.59 | 280 | Red |
| Example 112 | Compound 1-53 | Compound 2-19 | 3.55 | 20.20 | 288 | Red |
| Example 113 | Compound 1-53 | Compound 2-24 | 3.49 | 20.79 | 274 | Red |
| Example 114 | Compound 1-53 | Compound 2-34 | 3.54 | 20.09 | 297 | Red |
| Example 115 | Compound 1-53 | Compound 2-39 | 3.52 | 20.21 | 279 | Red |
| Example 116 | Compound 1-55 | Compound 2-4 | 3.35 | 21.70 | 290 | Red |
| Example 117 | Compound 1-55 | Compound 2-14 | 3.38 | 22.26 | 298 | Red |
| Example 118 | Compound 1-55 | Compound 2-19 | 3.36 | 21.99 | 284 | Red |
| Example 119 | Compound 1-55 | Compound 2-24 | 3.44 | 21.86 | 290 | Red |
| Example 120 | Compound 1-55 | Compound 2-39 | 3.38 | 22.12 | 282 | Red |
| Example 121 | Compound 1-56 | Compound 2-9 | 3.62 | 20.90 | 257 | Red |
| Example 122 | Compound 1-56 | Compound 2-19 | 3.66 | 21.30 | 240 | Red |
| Example 123 | Compound 1-56 | Compound 2-24 | 3.59 | 20.86 | 236 | Red |
| Example 124 | Compound 1-56 | Compound 2-34 | 3.62 | 21.07 | 251 | Red |
| Example 125 | Compound 1-56 | Compound 2-39 | 3.60 | 20.67 | 232 | Red |
| Example 126 | Compound 1-57 | Compound 2-4 | 3.63 | 21.18 | 255 | Red |
| Example 127 | Compound 1-57 | Compound 2-14 | 3.68 | 20.88 | 251 | Red |
| Example 128 | Compound 1-57 | Compound 2-19 | 3.60 | 20.97 | 228 | Red |
| Example 129 | Compound 1-57 | Compound 2-24 | 3.64 | 20.61 | 250 | Red |
| Example 130 | Compound 1-57 | Compound 2-39 | 3.60 | 21.24 | 245 | Red |
| Example 131 | Compound 1-58 | Compound 2-9 | 3.69 | 22.01 | 205 | Red |
| Example 132 | Compound 1-58 | Compound 2-19 | 3.71 | 21.69 | 215 | Red |
| Example 133 | Compound 1-58 | Compound 2-24 | 3.67 | 21.92 | 231 | Red |
| Example 134 | Compound 1-58 | Compound 2-34 | 3.69 | 22.27 | 225 | Red |
| Example 135 | Compound 1-58 | Compound 2-39 | 3.72 | 22.08 | 228 | Red |
| Example 136 | Compound 1-60 | Compound 2-4 | 3.68 | 22.00 | 210 | Red |
| Example 137 | Compound 1-60 | Compound 2-14 | 3.67 | 22.27 | 209 | Red |
| Example 138 | Compound 1-60 | Compound 2-19 | 3.68 | 21.67 | 215 | Red |
| Example 139 | Compound 1-60 | Compound 2-24 | 3.71 | 22.17 | 215 | Red |
| Example 140 | Compound 1-60 | Compound 2-39 | 3.67 | 22.33 | 207 | Red |
| Example 141 | Compound 1-61 | Compound 2-9 | 3.41 | 21.22 | 281 | Red |
| Example 142 | Compound 1-61 | Compound 2-19 | 3.48 | 21.12 | 292 | Red |
| Example 143 | Compound 1-61 | Compound 2-24 | 3.38 | 21.09 | 297 | Red |
| Example 144 | Compound 1-61 | Compound 2-34 | 3.41 | 21.63 | 274 | Red |
| Example 145 | Compound 1-61 | Compound 2-39 | 3.40 | 21.20 | 288 | Red |
| Example 146 | Compound 1-62 | Compound 2-5 | 3.71 | 20.63 | 206 | Red |
| Example 147 | Compound 1-62 | Compound 2-15 | 3.72 | 20.44 | 213 | Red |
| Example 148 | Compound 1-62 | Compound 2-20 | 3.71 | 20.07 | 228 | Red |
| Example 149 | Compound 1-62 | Compound 2-25 | 3.72 | 20.66 | 204 | Red |
| Example 150 | Compound 1-62 | Compound 2-40 | 3.68 | 20.52 | 220 | Red |
| Example 151 | Compound 1-63 | Compound 2-10 | 3.42 | 22.13 | 294 | Red |
| Example 152 | Compound 1-63 | Compound 2-20 | 3.37 | 21.73 | 292 | Red |
| Example 153 | Compound 1-63 | Compound 2-25 | 3.36 | 22.12 | 293 | Red |
| Example 154 | Compound 1-63 | Compound 2-35 | 3.46 | 21.76 | 284 | Red |
| Example 155 | Compound 1-63 | Compound 2-40 | 3.40 | 22.08 | 280 | Red |
| Example 156 | Compound 1-64 | Compound 2-5 | 3.36 | 22.19 | 280 | Red |
| Example 157 | Compound 1-64 | Compound 2-15 | 3.46 | 22.31 | 273 | Red |
| Example 158 | Compound 1-64 | Compound 2-20 | 3.40 | 22.21 | 278 | Red |
| Example 159 | Compound 1-64 | Compound 2-25 | 3.41 | 21.85 | 287 | Red |
| Example 160 | Compound 1-64 | Compound 2-40 | 3.41 | 22.06 | 274 | Red |
| Example 161 | Compound 1-65 | Compound 2-10 | 3.38 | 21.75 | 274 | Red |
| Example 162 | Compound 1-65 | Compound 2-20 | 3.37 | 21.37 | 289 | Red |
| Example 163 | Compound 1-65 | Compound 2-25 | 3.46 | 21.33 | 292 | Red |
| Example 164 | Compound 1-65 | Compound 2-35 | 3.47 | 21.15 | 286 | Red |
| Example 165 | Compound 1-65 | Compound 2-40 | 3.36 | 21.36 | 272 | Red |
| Example 166 | Compound 1-66 | Compound 2-5 | 3.74 | 21.77 | 214 | Red |
| Example 167 | Compound 1-66 | Compound 2-15 | 3.72 | 22.06 | 219 | Red |
| Example 168 | Compound 1-66 | Compound 2-20 | 3.73 | 21.78 | 213 | Red |
| Example 169 | Compound 1-66 | Compound 2-25 | 3.73 | 22.27 | 212 | Red |
| Example 170 | Compound 1-66 | Compound 2-40 | 3.69 | 21.96 | 214 | Red |
| Example 171 | Compound 1-67 | Compound 2-10 | 3.72 | 22.02 | 215 | Red |
| Example 172 | Compound 1-67 | Compound 2-20 | 3.70 | 21.97 | 221 | Red |
| Example 173 | Compound 1-67 | Compound 2-25 | 3.73 | 22.14 | 204 | Red |
| Example 174 | Compound 1-67 | Compound 2-35 | 3.69 | 21.88 | 207 | Red |
| Example 175 | Compound 1-67 | Compound 2-40 | 3.68 | 22.11 | 231 | Red |
| Example 176 | Compound 1-68 | Compound 2-5 | 3.72 | 20.46 | 226 | Red |
| Example 177 | Compound 1-68 | Compound 2-15 | 3.71 | 20.68 | 208 | Red |
| Example 178 | Compound 1-68 | Compound 2-20 | 3.73 | 20.43 | 222 | Red |
| Example 179 | Compound 1-68 | Compound 2-25 | 3.73 | 20.01 | 215 | Red |
| Example 180 | Compound 1-68 | Compound 2-40 | 3.67 | 20.72 | 228 | Red |
| Example 181 | Compound 1-69 | Compound 2-10 | 3.69 | 20.46 | 225 | Red |
| Example 182 | Compound 1-69 | Compound 2-20 | 3.74 | 20.61 | 221 | Red |
| Example 183 | Compound 1-69 | Compound 2-25 | 3.70 | 20.34 | 204 | Red |
| Example 184 | Compound 1-69 | Compound 2-35 | 3.72 | 20.38 | 219 | Red |
| Example 185 | Compound 1-69 | Compound 2-40 | 3.74 | 20.11 | 212 | Red |

**[Table 2]**

| Category | First host | Second host | Driving voltage (V) | Efficiency (cd/A) | Lifespan T95 (hr) | Emission color |
|---|---|---|---|---|---|---|
| Comp. Example 1 | Compound A-1 | Compound 2-1 | 4.06 | 14.75 | 129 | Red |
| Comp. Example 2 | Compound A-1 | Compound 2-11 | 4.07 | 14.70 | 138 | Red |
| Comp. Example 3 | Compound A-1 | Compound 2-16 | 4.12 | 14.76 | 137 | Red |
| Comp. Example 4 | Compound A-1 | Compound 2-21 | 4.09 | 15.63 | 133 | Red |
| Comp. Example 5 | Compound A-1 | Compound 2-36 | 4.02 | 15.88 | 142 | Red |
| Comp. Example 6 | Compound A-2 | Compound 2-3 | 4.05 | 16.53 | 118 | Red |
| Comp. Example 7 | Compound A-2 | Compound 2-13 | 4.05 | 14.74 | 133 | Red |
| Comp. Example 8 | Compound A-2 | Compound 2-18 | 4.04 | 15.61 | 125 | Red |
| Comp. Example 9 | Compound A-2 | Compound 2-23 | 4.09 | 15.03 | 126 | Red |
| Comp. Example 10 | Compound A-2 | Compound 2-38 | 4.01 | 16.24 | 134 | Red |
| Comp. Example 11 | Compound A-3 | Compound 2-5 | 3.90 | 17.54 | 157 | Red |
| Comp. Example 12 | Compound A-3 | Compound 2-15 | 3.88 | 16.80 | 142 | Red |
| Comp. Example 13 | Compound A-3 | Compound 2-20 | 3.92 | 17.54 | 143 | Red |
| Comp. Example 14 | Compound A-3 | Compound 2-25 | 3.88 | 16.77 | 158 | Red |
| Comp. Example 15 | Compound A-3 | Compound 2-40 | 3.87 | 16.87 | 149 | Red |
| Comp. Example 16 | Compound A-4 | Compound 2-6 | 3.87 | 17.13 | 166 | Red |
| Comp. Example 17 | Compound A-4 | Compound 2-16 | 3.87 | 17.57 | 161 | Red |
| Comp. Example 18 | Compound A-4 | Compound 2-26 | 3.86 | 17.08 | 145 | Red |
| Comp. Example 19 | Compound A-4 | Compound 2-31 | 3.87 | 17.13 | 153 | Red |
| Comp. Example 20 | Compound A-4 | Compound 2-36 | 3.90 | 16.88 | 142 | Red |
| Comp. Example 21 | Compound A-5 | Compound 2-8 | 3.85 | 17.86 | 183 | Red |
| Comp. Example 22 | Compound A-5 | Compound 2-18 | 3.86 | 17.47 | 161 | Red |
| Comp. Example 23 | Compound A-5 | Compound 2-23 | 3.88 | 17.91 | 181 | Red |
| Comp. Example 24 | Compound A-5 | Compound 2-33 | 3.89 | 18.51 | 186 | Red |
| Comp. Example 25 | Compound A-5 | Compound 2-38 | 3.86 | 18.20 | 185 | Red |
| Comp. Example 26 | Compound A-6 | Compound 2-9 | 3.86 | 18.59 | 167 | Red |
| Comp. Example 27 | Compound A-6 | Compound 2-19 | 3.89 | 18.46 | 180 | Red |
| Comp. Example 28 | Compound A-6 | Compound 2-24 | 3.92 | 17.72 | 177 | Red |
| Comp. Example 29 | Compound A-6 | Compound 2-34 | 3.88 | 18.04 | 188 | Red |
| Comp. Example 30 | Compound A-6 | Compound 2-39 | 3.84 | 18.55 | 179 | Red |
| Comp. Example 31 | Compound A-7 | Compound 2-10 | 4.17 | 14.25 | 98 | Red |
| Comp. Example 32 | Compound A-7 | Compound 2-20 | 4.08 | 16.56 | 81 | Red |
| Comp. Example 33 | Compound A-7 | Compound 2-25 | 4.18 | 15.08 | 102 | Red |
| Comp. Example 34 | Compound A-7 | Compound 2-35 | 4.20 | 15.28 | 91 | Red |
| Comp. Example 35 | Compound A-7 | Compound 2-40 | 4.17 | 15.30 | 92 | Red |
| Comp. Example 36 | Compound A-8 | Compound 2-1 | 4.19 | 15.81 | 99 | Red |
| Comp. Example 37 | Compound A-8 | Compound 2-11 | 4.08 | 14.21 | 103 | Red |
| Comp. Example 38 | Compound A-8 | Compound 2-16 | 4.11 | 16.73 | 83 | Red |
| Comp. Example 39 | Compound A-8 | Compound 2-21 | 4.18 | 14.83 | 94 | Red |
| Comp. Example 40 | Compound A-8 | Compound 2-36 | 4.16 | 15.25 | 82 | Red |
| Comp. Example 41 | Compound A-9 | Compound 2-2 | 3.91 | 17.18 | 157 | Red |
| Comp. Example 42 | Compound A-9 | Compound 2-12 | 3.89 | 17.13 | 154 | Red |
| Comp. Example 43 | Compound A-9 | Compound 2-17 | 3.85 | 17.16 | 152 | Red |
| Comp. Example 44 | Compound A-9 | Compound 2-22 | 3.90 | 17.05 | 162 | Red |
| Comp. Example 45 | Compound A-9 | Compound 2-37 | 3.90 | 17.25 | 160 | Red |
| Comp. Example 46 | Compound A-10 | Compound 2-3 | 3.91 | 17.68 | 163 | Red |
| Comp. Example 47 | Compound A-10 | Compound 2-13 | 3.91 | 18.16 | 177 | Red |
| Comp. Example 48 | Compound A-10 | Compound 2-18 | 3.86 | 17.92 | 162 | Red |
| Comp. Example 49 | Compound A-10 | Compound 2-23 | 3.86 | 17.71 | 179 | Red |
| Comp. Example 50 | Compound A-10 | Compound 2-38 | 3.89 | 18.00 | 191 | Red |
| Comp. Example 51 | Compound A-11 | Compound 2-7 | 4.04 | 14.25 | 137 | Red |
| Comp. Example 52 | Compound A-11 | Compound 2-17 | 4.08 | 16.56 | 138 | Red |
| Comp. Example 53 | Compound A-11 | Compound 2-22 | 4.04 | 15.08 | 134 | Red |
| Comp. Example 54 | Compound A-11 | Compound 2-32 | 4.05 | 15.28 | 132 | Red |
| Comp. Example 55 | Compound A-11 | Compound 2-37 | 4.12 | 15.30 | 131 | Red |
| Comp. Example 56 | Compound A-12 | Compound 2-9 | 4.06 | 15.81 | 137 | Red |
| Comp. Example 57 | Compound A-12 | Compound 2-19 | 4.02 | 14.21 | 142 | Red |
| Comp. Example 58 | Compound A-12 | Compound 2-24 | 4.11 | 16.73 | 136 | Red |
| Comp. Example 59 | Compound A-12 | Compound 2-34 | 4.01 | 14.83 | 141 | Red |
| Comp. Example 60 | Compound A-12 | Compound 2-39 | 4.13 | 15.25 | 116 | Red |

**[Table 3]**

| Category | First host | Second host | Driving voltage (V) | Efficiency (cd/A) | Lifespan T95 (hr) | Emission color |
|---|---|---|---|---|---|---|
| Comp. Example 61 | Compound 1-2 | Compound B-1 | 3.95 | 18.04 | 150 | Red |
| Comp. Example 62 | Compound 1-17 | Compound B-1 | 3.93 | 17.59 | 147 | Red |
| Comp. Example 63 | Compound 1-37 | Compound B-1 | 3.95 | 18.09 | 168 | Red |
| Comp. Example 64 | Compound 1-52 | Compound B-1 | 3.95 | 18.03 | 181 | Red |
| Comp. Example 65 | Compound 1-3 | Compound B-1 | 3.92 | 17.76 | 151 | Red |
| Comp. Example 66 | Compound 1-20 | Compound B-1 | 3.91 | 18.14 | 164 | Red |
| Comp. Example 67 | Compound 1-39 | Compound B-1 | 3.92 | 17.50 | 151 | Red |
| Comp. Example 68 | Compound 1-53 | Compound B-1 | 3.94 | 17.93 | 152 | Red |
| Comp. Example 69 | Compound 1-8 | Compound B-2 | 3.99 | 17.28 | 144 | Red |
| Comp. Example 70 | Compound 1-21 | Compound B-2 | 3.89 | 17.19 | 138 | Red |
| Comp. Example 71 | Compound 1-40 | Compound B-2 | 3.95 | 17.14 | 149 | Red |
| Comp. Example 72 | Compound 1-55 | Compound B-2 | 3.95 | 16.44 | 140 | Red |
| Comp. Example 73 | Compound 1-9 | Compound B-2 | 3.92 | 16.74 | 139 | Red |
| Comp. Example 74 | Compound 1-24 | Compound B-2 | 3.91 | 16.78 | 132 | Red |
| Comp. Example 75 | Compound 1-41 | Compound B-2 | 3.88 | 16.59 | 135 | Red |
| Comp. Example 76 | Compound 1-56 | Compound B-2 | 3.93 | 16.89 | 148 | Red |
| Comp. Example 77 | Compound 1-10 | Compound B-3 | 4.21 | 15.31 | 111 | Red |
| Comp. Example 78 | Compound 1-27 | Compound B-3 | 4.11 | 15.26 | 73 | Red |
| Comp. Example 79 | Compound 1-42 | Compound B-3 | 4.19 | 15.90 | 107 | Red |
| Comp. Example 80 | Compound 1-57 | Compound B-3 | 4.09 | 14.65 | 100 | Red |
| Comp. Example 81 | Compound 1-12 | Compound B-3 | 4.20 | 15.77 | 82 | Red |
| Comp. Example 82 | Compound 1-28 | Compound B-3 | 4.17 | 16.39 | 89 | Red |
| Comp. Example 83 | Compound 1-43 | Compound B-3 | 4.23 | 15.99 | 102 | Red |
| Comp. Example 84 | Compound 1-58 | Compound B-3 | 4.23 | 16.01 | 103 | Red |
| Comp. Example 85 | Compound 1-15 | Compound B-4 | 3.95 | 17.90 | 147 | Red |
| Comp. Example 86 | Compound 1-31 | Compound B-4 | 3.89 | 17.63 | 152 | Red |
| Comp. Example 87 | Compound 1-44 | Compound B-4 | 3.88 | 17.72 | 148 | Red |
| Comp. Example 88 | Compound 1-52 | Compound B-4 | 3.94 | 17.60 | 170 | Red |
| Comp. Example 89 | Compound 1-16 | Compound B-4 | 3.88 | 18.14 | 169 | Red |
| Comp. Example 90 | Compound 1-33 | Compound B-4 | 3.93 | 17.69 | 151 | Red |
| Comp. Example 91 | Compound 1-48 | Compound B-4 | 3.91 | 17.82 | 180 | Red |
| Comp. Example 92 | Compound 1-53 | Compound B-4 | 3.91 | 17.79 | 149 | Red |
| Comp. Example 93 | Compound 1-2 | Compound B-5 | 4.14 | 15.31 | 126 | Red |
| Comp. Example 94 | Compound 1-17 | Compound B-5 | 4.13 | 15.26 | 113 | Red |
| Comp. Example 95 | Compound 1-37 | Compound B-5 | 4.06 | 15.90 | 125 | Red |
| Comp. Example 96 | Compound 1-58 | Compound B-5 | 4.14 | 14.65 | 121 | Red |
| Comp. Example 97 | Compound 1-9 | Compound B-5 | 4.14 | 15.77 | 137 | Red |
| Comp. Example 98 | Compound 1-24 | Compound B-5 | 4.05 | 16.39 | 117 | Red |
| Comp. Example 99 | Compound 1-41 | Compound B-5 | 4.07 | 15.99 | 117 | Red |
| Comp. Example 100 | Compound 1-56 | Compound B-5 | 4.16 | 16.01 | 114 | Red |
| Comp. Example 101 | Compound 1-2 | Compound B-6 | 3.95 | 17.90 | 147 | Red |
| Comp. Example 102 | Compound 1-17 | Compound B-6 | 3.89 | 17.63 | 152 | Red |
| Comp. Example 103 | Compound 1-37 | Compound B-6 | 3.88 | 17.72 | 148 | Red |
| Comp. Example 104 | Compound 1-52 | Compound B-6 | 3.94 | 17.60 | 170 | Red |
| Comp. Example 105 | Compound 1-10 | Compound B-6 | 3.88 | 18.14 | 169 | Red |
| Comp. Example 106 | Compound 1-27 | Compound B-6 | 3.93 | 17.69 | 151 | Red |
| Comp. Example 107 | Compound 1-42 | Compound B-6 | 3.91 | 17.82 | 180 | Red |
| Comp. Example 108 | Compound 1-57 | Compound B-6 | 3.91 | 17.79 | 149 | Red |
| Comp. Example 109 | Compound 1-3 | Compound B-7 | 4.10 | 14.64 | 81 | Red |
| Comp. Example 110 | Compound 1-20 | Compound B-7 | 4.12 | 15.12 | 94 | Red |
| Comp. Example 111 | Compound 1-39 | Compound B-7 | 4.12 | 15.82 | 108 | Red |
| Comp. Example 112 | Compound 1-53 | Compound B-7 | 4.16 | 15.10 | 78 | Red |
| Comp. Example 113 | Compound 1-8 | Compound B-7 | 4.10 | 15.94 | 101 | Red |
| Comp. Example 114 | Compound 1-21 | Compound B-7 | 4.13 | 14.64 | 97 | Red |
| Comp. Example 115 | Compound 1-40 | Compound B-7 | 4.17 | 15.85 | 91 | Red |
| Comp. Example 116 | Compound 1-55 | Compound B-7 | 4.10 | 15.90 | 88 | Red |
| Comp. Example 117 | Compound 1-9 | Compound B-8 | 3.92 | 17.38 | 133 | Red |
| Comp. Example 118 | Compound 1-24 | Compound B-8 | 3.93 | 17.26 | 138 | Red |
| Comp. Example 119 | Compound 1-41 | Compound B-8 | 3.89 | 17.24 | 135 | Red |
| Comp. Example 120 | Compound 1-56 | Compound B-8 | 3.95 | 16.72 | 149 | Red |
| Comp. Example 121 | Compound 1-10 | Compound B-8 | 3.94 | 17.41 | 149 | Red |
| Comp. Example 122 | Compound 1-27 | Compound B-8 | 3.93 | 16.94 | 132 | Red |
| Comp. Example 123 | Compound 1-42 | Compound B-8 | 3.94 | 16.66 | 139 | Red |
| Comp. Example 124 | Compound 1-57 | Compound B-8 | 3.91 | 17.29 | 135 | Red |
| Comp. Example 125 | Compound 1-12 | Compound B-9 | 3.89 | 17.31 | 168 | Red |
| Comp. Example 126 | Compound 1-28 | Compound B-9 | 3.92 | 17.80 | 174 | Red |
| Comp. Example 127 | Compound 1-43 | Compound B-9 | 3.93 | 17.43 | 159 | Red |
| Comp. Example 128 | Compound 1-58 | Compound B-9 | 3.89 | 17.89 | 148 | Red |
| Comp. Example 129 | Compound 1-15 | Compound B-9 | 3.93 | 17.51 | 179 | Red |
| Comp. Example 130 | Compound 1-31 | Compound B-9 | 3.94 | 18.16 | 180 | Red |
| Comp. Example 131 | Compound 1-44 | Compound B-9 | 3.93 | 18.15 | 176 | Red |
| Comp. Example 132 | Compound 1-52 | Compound B-9 | 3.92 | 17.73 | 178 | Red |
| Comp. Example 133 | Compound 1-16 | Compound B-10 | 4.09 | 16.20 | 134 | Red |
| Comp. Example 134 | Compound 1-33 | Compound B-10 | 4.10 | 15.43 | 111 | Red |
| Comp. Example 135 | Compound 1-48 | Compound B-10 | 4.12 | 15.26 | 136 | Red |
| Comp. Example 136 | Compound 1-53 | Compound B-10 | 4.11 | 15.15 | 114 | Red |
| Comp. Example 137 | Compound 1-2 | Compound B-10 | 4.14 | 14.77 | 132 | Red |
| Comp. Example 138 | Compound 1-17 | Compound B-10 | 4.05 | 15.74 | 109 | Red |
| Comp. Example 139 | Compound 1-37 | Compound B-10 | 4.12 | 16.19 | 116 | Red |
| Comp. Example 140 | Compound 1-52 | Compound B-10 | 4.09 | 15.85 | 113 | Red |
| Comp. Example 141 | Compound 1-2 | Compound B-11 | 3.95 | 17.80 | 167 | Red |
| Comp. Example 142 | Compound 1-17 | Compound B-11 | 3.95 | 17.52 | 178 | Red |
| Comp. Example 143 | Compound 1-37 | Compound B-11 | 3.93 | 17.97 | 180 | Red |
| Comp. Example 144 | Compound 1-52 | Compound B-11 | 3.93 | 17.37 | 181 | Red |
| Comp. Example 145 | Compound 1-3 | Compound B-11 | 3.92 | 17.54 | 162 | Red |
| Comp. Example 146 | Compound 1-20 | Compound B-11 | 3.93 | 17.56 | 163 | Red |
| Comp. Example 147 | Compound 1-39 | Compound B-11 | 3.94 | 17.59 | 165 | Red |
| Comp. Example 148 | Compound 1-53 | Compound B-11 | 3.95 | 18.19 | 152 | Red |
| Comp. Example 149 | Compound 1-8 | Compound B-12 | 3.94 | 16.65 | 136 | Red |
| Comp. Example 150 | Compound 1-21 | Compound B-12 | 3.92 | 16.64 | 138 | Red |
| Comp. Example 151 | Compound 1-40 | Compound B-12 | 3.91 | 16.88 | 144 | Red |
| Comp. Example 152 | Compound 1-55 | Compound B-12 | 3.89 | 17.38 | 140 | Red |
| Comp. Example 153 | Compound 1-9 | Compound B-12 | 3.89 | 16.99 | 149 | Red |
| Comp. Example 154 | Compound 1-24 | Compound B-12 | 3.89 | 16.95 | 142 | Red |
| Comp. Example 155 | Compound 1-41 | Compound B-12 | 3.91 | 17.38 | 139 | Red |
| Comp. Example 156 | Compound 1-56 | Compound B-12 | 3.91 | 16.54 | 141 | Red |
| Comp. Example 157 | Compound 1-10 | Compound B-13 | 3.96 | 17.27 | 145 | Red |
| Comp. Example 158 | Compound 1-27 | Compound B-13 | 3.92 | 17.17 | 145 | Red |
| Comp. Example 159 | Compound 1-42 | Compound B-13 | 3.89 | 16.31 | 139 | Red |
| Comp. Example 160 | Compound 1-57 | Compound B-13 | 3.89 | 17.48 | 138 | Red |
| Comp. Example 161 | Compound 1-12 | Compound B-13 | 3.94 | 17.19 | 149 | Red |
| Comp. Example 162 | Compound 1-28 | Compound B-13 | 3.89 | 16.30 | 142 | Red |
| Comp. Example 163 | Compound 1-43 | Compound B-13 | 3.94 | 17.27 | 146 | Red |
| Comp. Example 164 | Compound 1-58 | Compound B-13 | 3.88 | 16.89 | 140 | Red |
| Comp. Example 165 | Compound 1-2 | Compound B-14 | 4.21 | 14.87 | 102 | Red |
| Comp. Example 166 | Compound 1-17 | Compound B-14 | 4.22 | 14.73 | 108 | Red |
| Comp. Example 167 | Compound 1-37 | Compound B-14 | 4.19 | 15.26 | 90 | Red |
| Comp. Example 168 | Compound 1-52 | Compound B-14 | 4.22 | 14.99 | 102 | Red |
| Comp. Example 169 | Compound 1-3 | Compound B-14 | 4.21 | 16.23 | 98 | Red |
| Comp. Example 170 | Compound 1-20 | Compound B-14 | 4.15 | 15.54 | 111 | Red |
| Comp. Example 171 | Compound 1-39 | Compound B-14 | 4.22 | 16.22 | 73 | Red |
| Comp. Example 172 | Compound 1-53 | Compound B-14 | 4.19 | 15.96 | 101 | Red |
| Comp. Example 173 | Compound 1-8 | Compound B-15 | 3.94 | 18.17 | 148 | Red |
| Comp. Example 174 | Compound 1-21 | Compound B-15 | 3.92 | 17.75 | 179 | Red |
| Comp. Example 175 | Compound 1-40 | Compound B-15 | 3.89 | 18.06 | 158 | Red |
| Comp. Example 176 | Compound 1-55 | Compound B-15 | 3.94 | 17.71 | 180 | Red |
| Comp. Example 177 | Compound 1-9 | Compound B-15 | 3.88 | 17.32 | 179 | Red |
| Comp. Example 178 | Compound 1-24 | Compound B-15 | 3.95 | 17.99 | 158 | Red |
| Comp. Example 179 | Compound 1-41 | Compound B-15 | 3.89 | 17.39 | 169 | Red |
| Comp. Example 180 | Compound 1-56 | Compound B-15 | 3.88 | 18.02 | 162 | Red |
| Comp. Example 181 | Compound 1-10 | Compound B-16 | 4.11 | 15.03 | 112 | Red |
| Comp. Example 182 | Compound 1-27 | Compound B-16 | 4.09 | 15.44 | 112 | Red |
| Comp. Example 183 | Compound 1-42 | Compound B-16 | 4.05 | 16.19 | 123 | Red |
| Comp. Example 184 | Compound 1-57 | Compound B-16 | 4.11 | 16.05 | 122 | Red |
| Comp. Example 185 | Compound 1-12 | Compound B-16 | 4.08 | 15.01 | 119 | Red |
| Comp. Example 186 | Compound 1-28 | Compound B-16 | 4.09 | 15.40 | 113 | Red |
| Comp. Example 187 | Compound 1-43 | Compound B-16 | 4.12 | 14.94 | 121 | Red |
| Comp. Example 188 | Compound 1-58 | Compound B-16 | 4.09 | 15.85 | 137 | Red |
| Comp. Example 189 | Compound 1-2 | Compound B-17 | 4.22 | 15.88 | 73 | Red |
| Comp. Example 190 | Compound 1-17 | Compound B-17 | 4.12 | 15.00 | 86 | Red |
| Comp. Example 191 | Compound 1-37 | Compound B-17 | 4.17 | 16.26 | 99 | Red |
| Comp. Example 192 | Compound 1-52 | Compound B-17 | 4.18 | 14.79 | 87 | Red |
| Comp. Example 193 | Compound 1-10 | Compound B-17 | 4.10 | 14.92 | 95 | Red |
| Comp. Example 194 | Compound 1-27 | Compound B-17 | 4.13 | 15.26 | 97 | Red |
| Comp. Example 195 | Compound 1-42 | Compound B-17 | 4.20 | 16.16 | 112 | Red |
| Comp. Example 196 | Compound 1-57 | Compound B-17 | 4.21 | 14.72 | 104 | Red |
| Comp. Example 197 | Compound 1-3 | Compound B-18 | 3.92 | 16.67 | 144 | Red |
| Comp. Example 198 | Compound 1-20 | Compound B-18 | 3.89 | 17.45 | 133 | Red |
| Comp. Example 199 | Compound 1-39 | Compound B-18 | 3.95 | 16.75 | 145 | Red |
| Comp. Example 200 | Compound 1-53 | Compound B-18 | 3.90 | 16.46 | 143 | Red |
| Comp. Example 201 | Compound 1-12 | Compound B-18 | 3.90 | 16.97 | 132 | Red |
| Comp. Example 202 | Compound 1-28 | Compound B-18 | 3.93 | 17.25 | 149 | Red |
| Comp. Example 203 | Compound 1-43 | Compound B-18 | 3.92 | 17.43 | 145 | Red |
| Comp. Example 204 | Compound 1-58 | Compound B-18 | 3.89 | 16.58 | 147 | Red |
| Comp. Example 205 | Compound 1-8 | Compound B-19 | 3.88 | 17.78 | 170 | Red |
| Comp. Example 206 | Compound 1-21 | Compound B-19 | 3.94 | 18.13 | 167 | Red |
| Comp. Example 207 | Compound 1-40 | Compound B-19 | 3.88 | 17.98 | 161 | Red |
| Comp. Example 208 | Compound 1-55 | Compound B-19 | 3.91 | 17.37 | 163 | Red |
| Comp. Example 209 | Compound 1-9 | Compound B-19 | 3.91 | 18.01 | 165 | Red |
| Comp. Example 210 | Compound 1-24 | Compound B-19 | 3.90 | 17.49 | 178 | Red |
| Comp. Example 211 | Compound 1-41 | Compound B-19 | 3.93 | 18.09 | 175 | Red |
| Comp. Example 212 | Compound 1-56 | Compound B-19 | 3.91 | 17.55 | 165 | Red |
| Comp. Example 213 | Compound 1-2 | Compound B-20 | 4.06 | 15.40 | 132 | Red |
| Comp. Example 214 | Compound 1-17 | Compound B-20 | 4.16 | 15.93 | 115 | Red |
| Comp. Example 215 | Compound 1-37 | Compound B-20 | 4.07 | 14.83 | 115 | Red |
| Comp. Example 216 | Compound 1-52 | Compound B-20 | 4.09 | 16.35 | 129 | Red |
| Comp. Example 217 | Compound 1-10 | Compound B-20 | 4.14 | 16.11 | 135 | Red |
| Comp. Example 218 | Compound 1-27 | Compound B-20 | 4.13 | 15.61 | 130 | Red |
| Comp. Example 219 | Compound 1-42 | Compound B-20 | 4.15 | 16.15 | 130 | Red |
| Comp. Example 220 | Compound 1-57 | Compound B-20 | 4.17 | 15.12 | 112 | Red |

When a current was applied to the organic light emitting devices manufactured according to Examples 1 to 185 and Comparative Examples 1 to 220, the results shown in Tables 1 to 3 were obtained. The red organic light emitting device of Example 1 has a structure using Compound EB-1 as an electron blocking layer and Compound Dp-7 as a dopant of a red light emitting layer. Referring to Table 1, when the compound of Chemical Formula 1 and the compound of Chemical Formula 2 of the present disclosure were co-deposited and used for a red light emitting layer, it was confirmed that the driving voltage was low and the efficiency and lifespan were excellent.

On the other hand, as shown in Table 2, when one of Comparative Compounds A-1 to A-12 was co-deposited together with the compound of Chemical Formula 2 of the present disclosure and used for a red light emitting layer, the driving voltage was generally increased, and the efficiency and lifespan were lowered compared to the combination of the present disclosure. In addition, as shown in Table 3, when one of Comparative Compounds B-1 to B-20 was co-deposited together with the compound of Chemical Formula 1 of the present disclosure and used for a red light emitting layer, the driving voltage was increased and the efficiency and lifespan were decreased. From these results, it can be confirmed that the organic light emitting device of the present disclosure exhibits excellent effects in terms of driving voltage, efficiency, and lifespan. It can be inferred that this is because energy transfer to the red dopant in the red light emitting layer is better achieved when the compound of Chemical Formula 1 as the first host and the compound of Chemical Formula 2 as the second host of the present disclosure are combined compared to the combination used in Comparative Examples. In conclusion, it can be confirmed that the driving voltage, luminous efficiency, and lifespan of the organic light emitting device can be improved when the compound of Chemical Formula 1 and the compound of Chemical Formula 2 are combined and used by co-evaporation as a host for the red light emitting layer.

### [DESCRIPTION OF SYMBOLS]

| | | | |
|---|---|---|---|
| 1: | Substrate | 2: | Anode |
| 3: | Light emitting layer | 4: | Cathode |
| 5: | Hole injection layer | 6: | Hole transport layer |
| 7: | Electron transport layer | 8: | Electron injection layer |
| 9: | Electron blocking layer | 10: | Hole blocking layer |
| 11: | Electron injection and transport layer | | |

## Claims

1. An organic light emitting device comprising:
an anode (2); a cathode (4);
and a light emitting layer (3) that is provided between the anode and the cathode,
wherein the light emitting layer comprises a compound represented by the following Chemical Formula 1 and a compound represented by the following Chemical Formula 2: 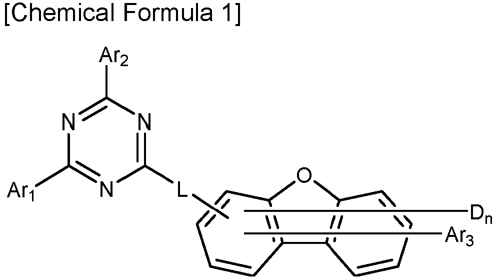 in the Chemical Formula 1,
L is a single bond; or substituted or unsubstituted C₆₋₆₀ arylene;
Ar₁ and Ar₂ are each independently substituted or unsubstituted C₆₋₆₀ aryl; or substituted or unsubstituted C₂₋₆₀ heteroaryl containing at least one selected from the group consisting of N, O and S,
Ar₃ is hydrogen; deuterium; substituted or unsubstituted C₆₋₆₀ aryl; or substituted or unsubstituted C₂₋₆₀ heteroaryl containing at least one selected from the group consisting of N, O and S,
D is deuterium, and
n is an integer of 0 to 6, 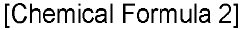 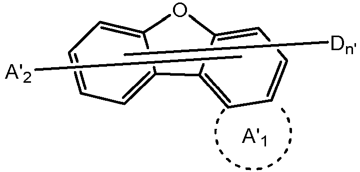 in the Chemical Formula 2,
A'₁ is represented by the following Chemical Formula 2-a, 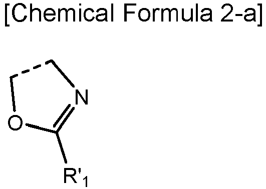 in the Chemical Formula 2-a,
the dotted line is fused with an adjacent ring,
R'₁ is Ar'₁; or a substituent represented by the following Chemical Formula 2-b, and
Ar'₁ is substituted or unsubstituted C₆₋₆₀ aryl; or substituted or unsubstituted C₂₋₆₀ heteroaryl containing at least one heteroatom selected from the group consisting of N, O and S, and 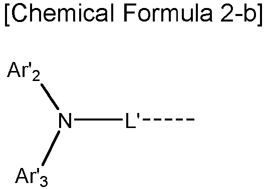 in the Chemical Formula 2-b,
L' is a single bond; or substituted or unsubstituted C₆₋₆₀ arylene;
Ar'₂ and Ar'₃ are each independently hydrogen; deuterium; substituted or unsubstituted C₆₋₆₀ aryl; or substituted or unsubstituted C₂₋₆₀ heteroaryl containing at least one heteroatom selected from the group consisting of N, O and S,
when R'₁ is Ar'₁, A'₂ is a substituent represented by the Chemical Formula 2-b,
when R'₁ is a substituent represented by the Chemical Formula 2-b, A'₂ is hydrogen;
or deuterium,
D is deuterium, and
n' is an integer of 0 to 5.

2. The organic light emitting device of Claim 1,
wherein the Chemical Formula 1 is represented by the following Chemical Formula 1-1: 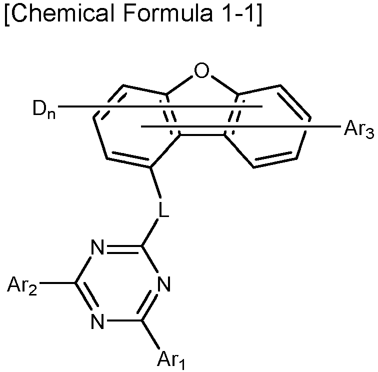 in the Chemical Formula 1-1,
L, Ar₁ to Ar₃, D, and n are as defined in Claim 1.

3. The organic light emitting device of Claim 1,
wherein L is a single bond; phenylene; or naphthalenediyl.

4. The organic light emitting device of Claim 1,
wherein Ar₁ and Ar₂ are each independently phenyl; biphenylyl; terphenylyl; naphthyl; phenanthrenyl; (phenyl)naphthyl; (naphthyl)phenyl; (naphthyl)naphthyl; dibenzofuranyl; or dibenzothiophenyl.

5. The organic light emitting device of Claim 1,
wherein Ar₃ is hydrogen; phenyl; biphenylyl; terphenylyl; naphthyl; phenanthrenyl; (phenyl)naphthyl; (naphthyl)phenyl; fluoranthenyl; triphenylenyl; dibenzofuranyl; dibenzothiophenyl; benzonaphthofuranyl; or benzonaphthothiophenyl.

6. The organic light emitting device of Claim 1,
wherein the compound represented by the Chemical Formula 1 is any one selected from the group consisting of:

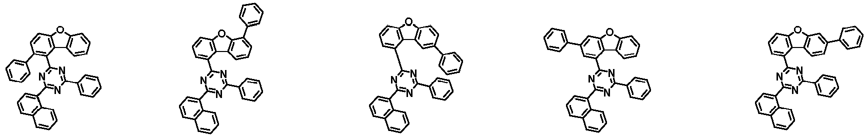

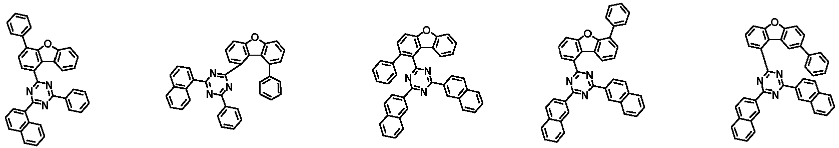

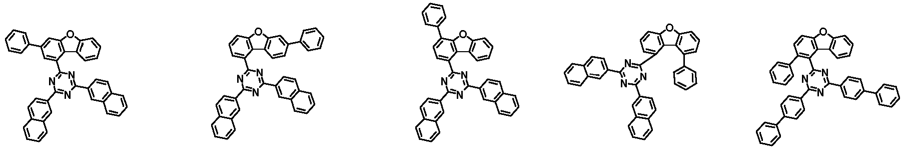

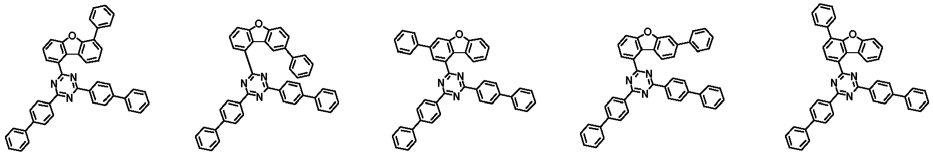

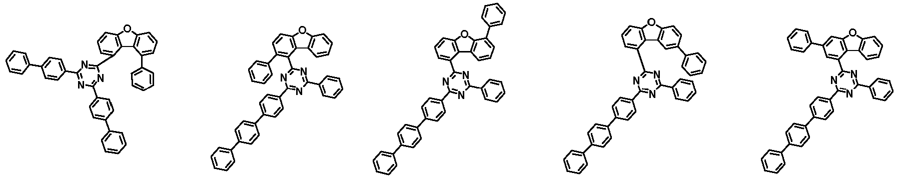

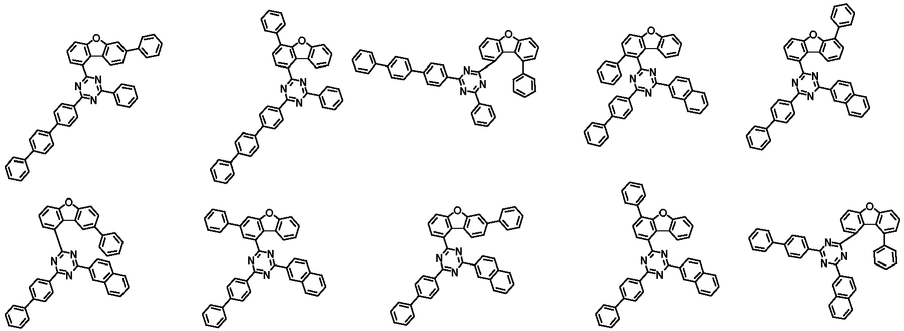

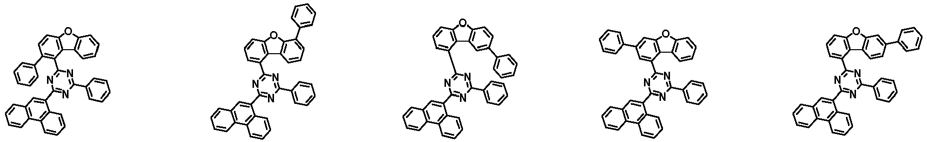

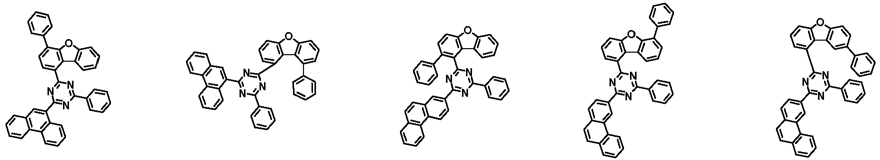

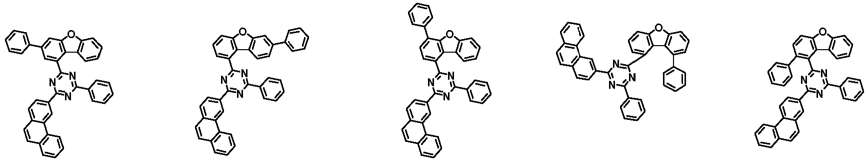

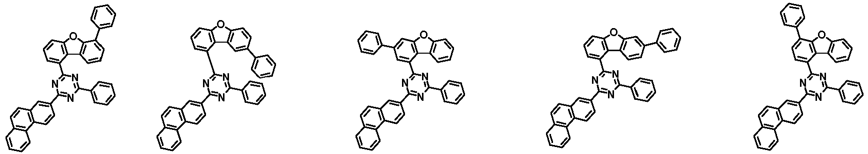

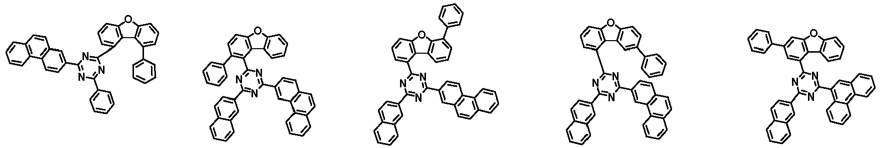

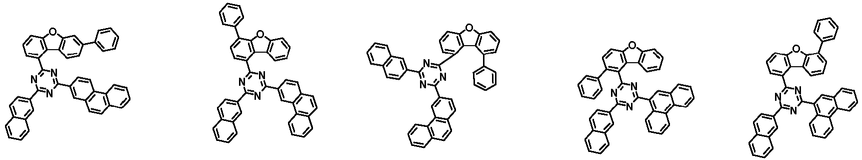

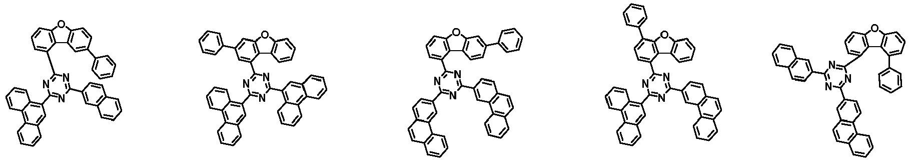

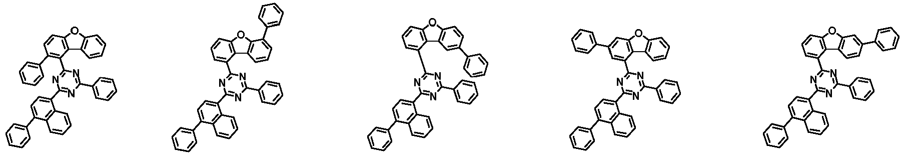

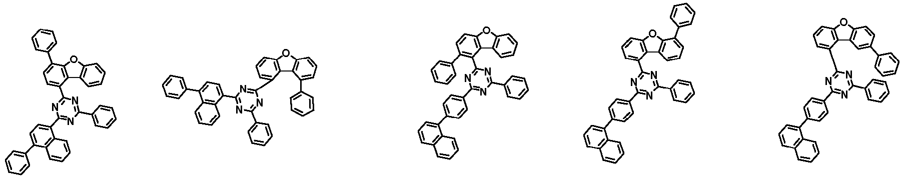

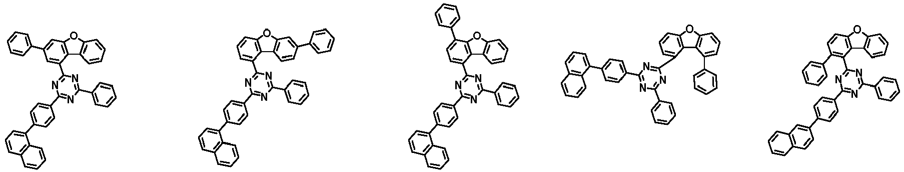

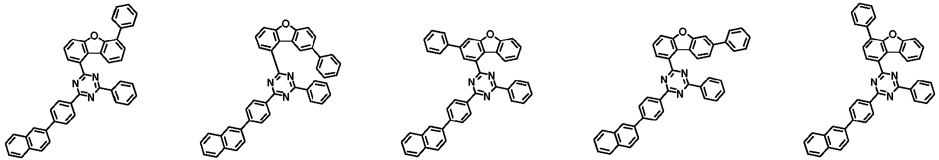

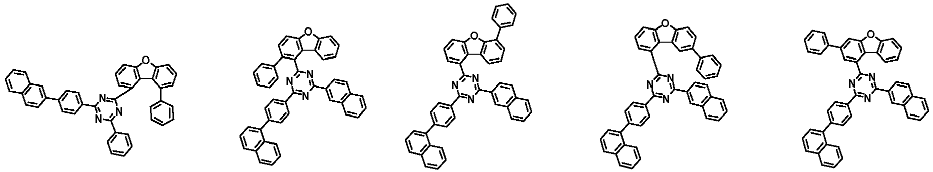

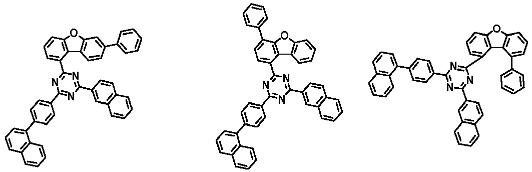

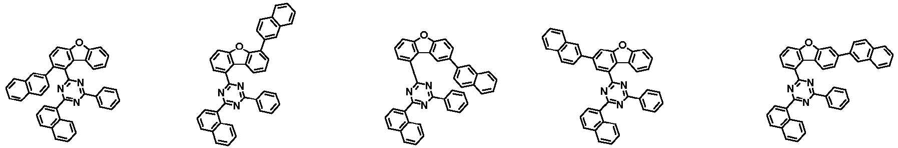

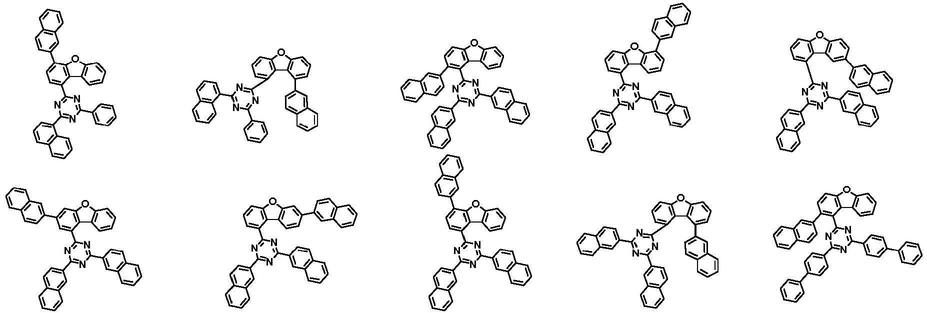

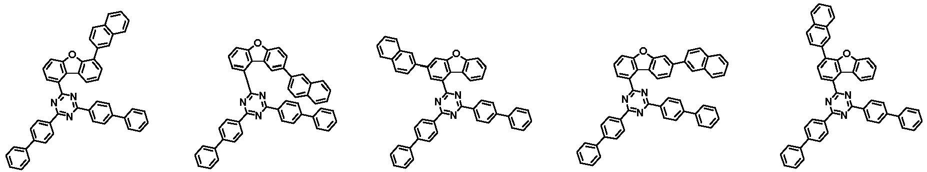

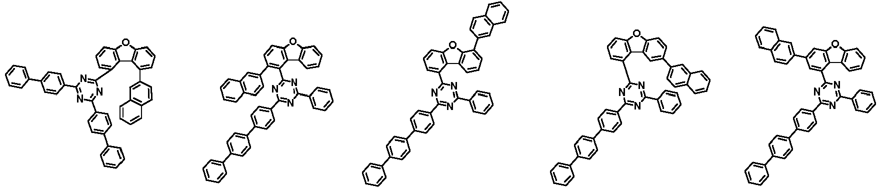

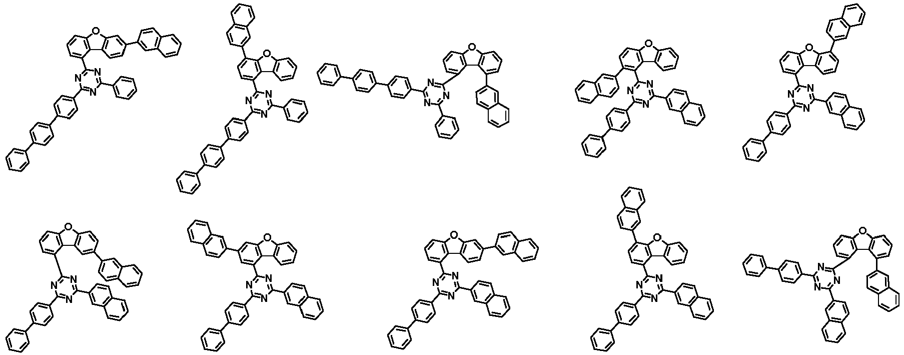

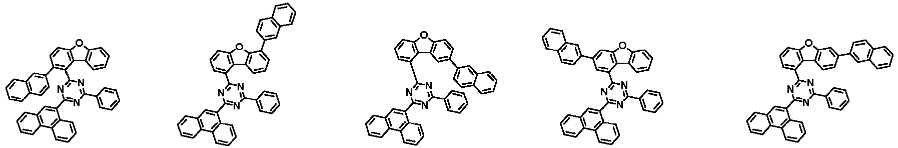

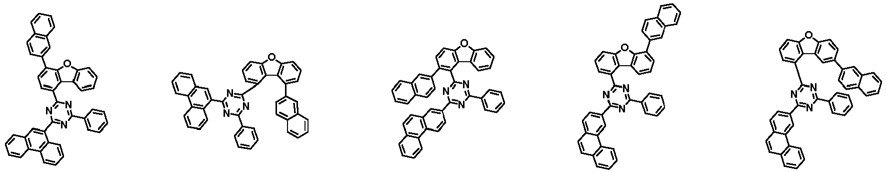

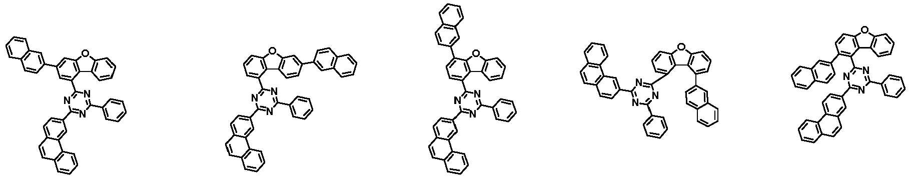

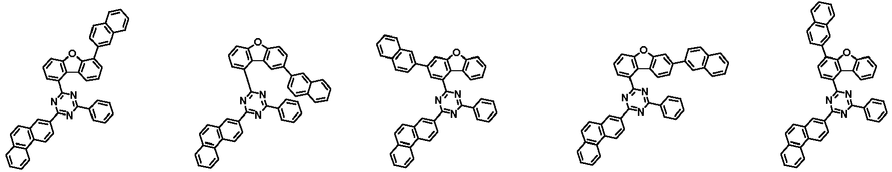

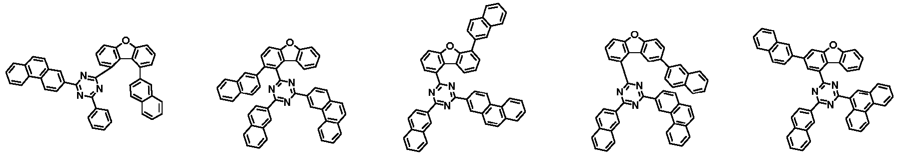

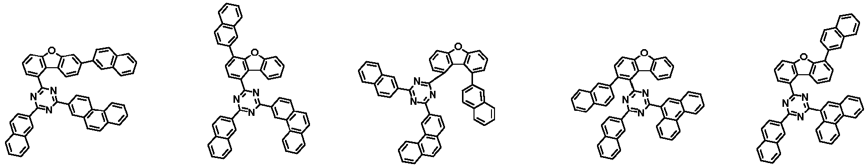

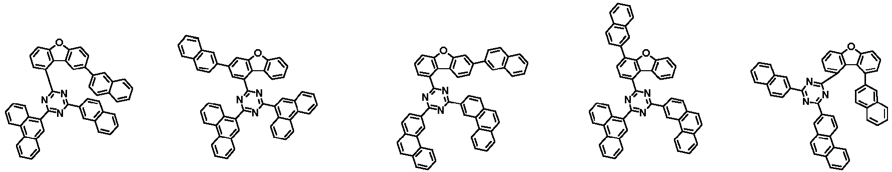

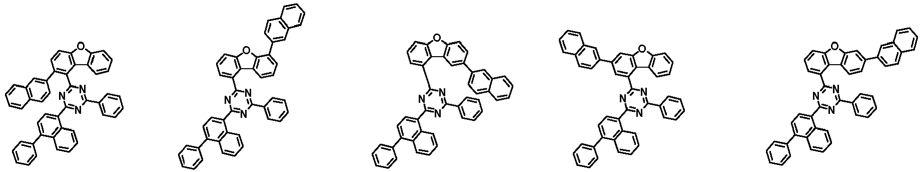

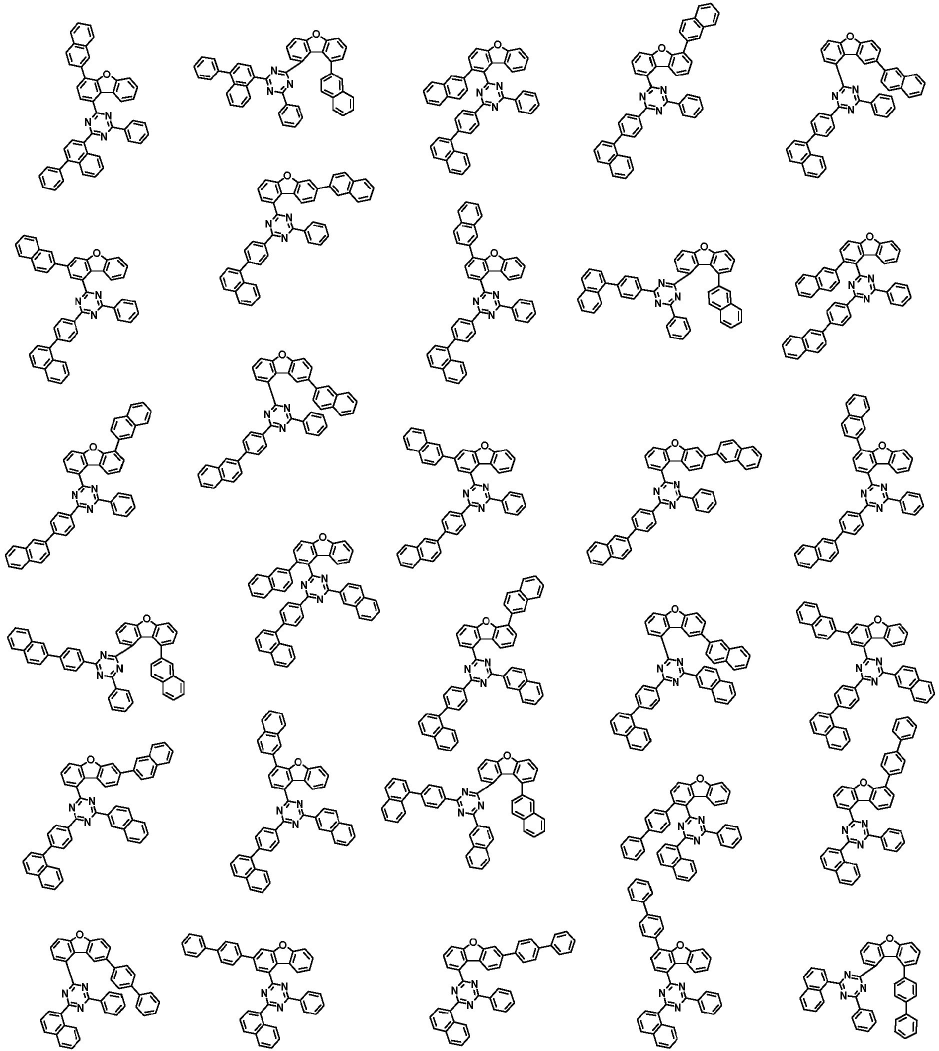

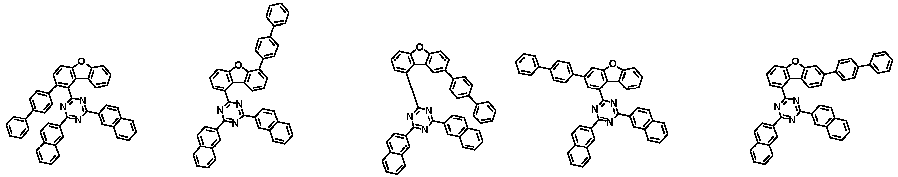

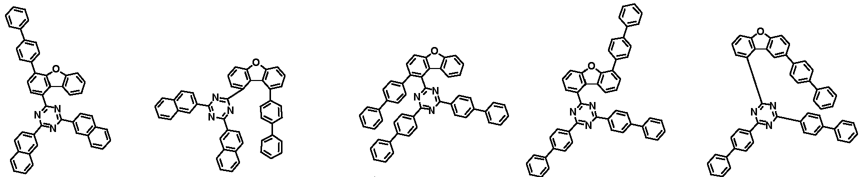

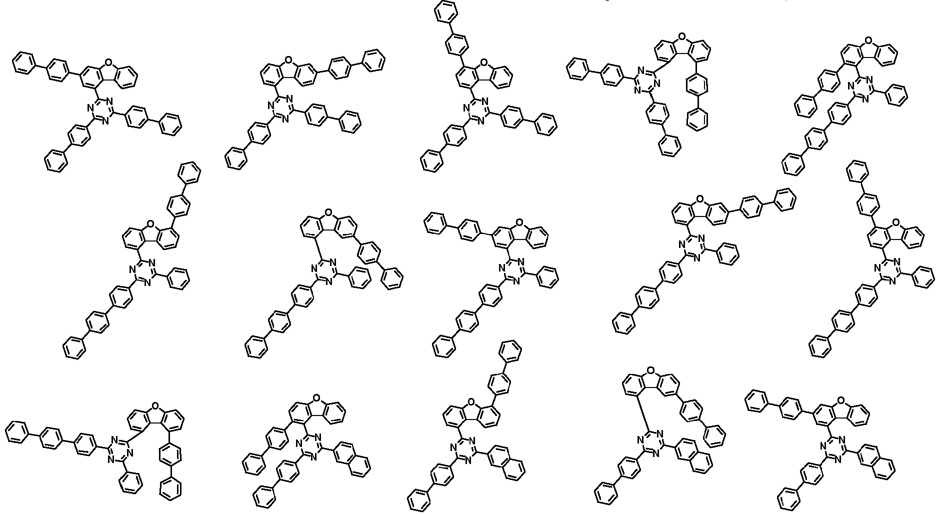

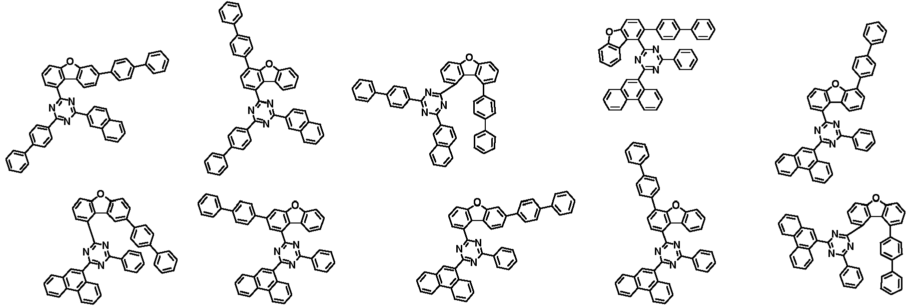

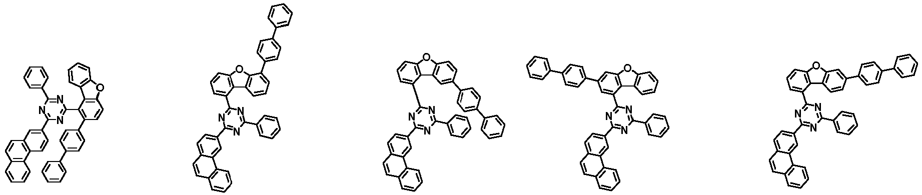

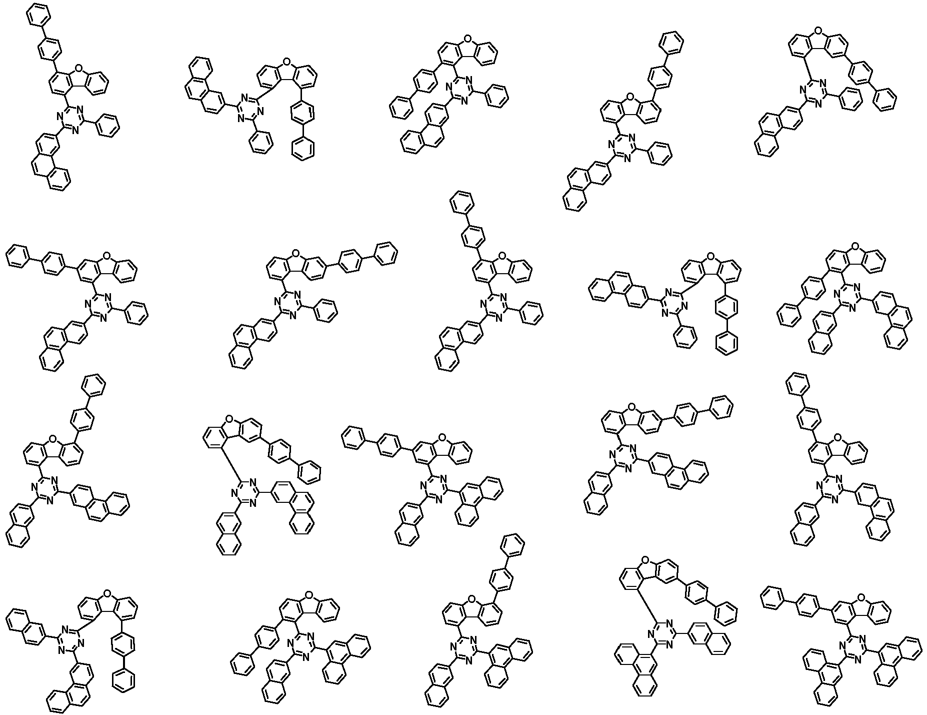

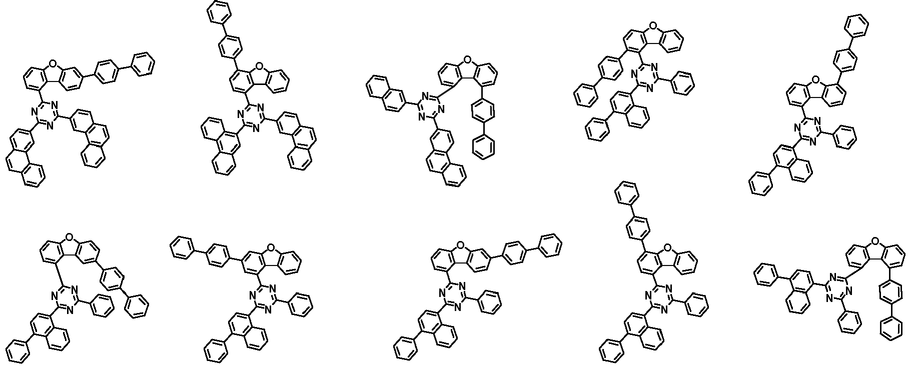

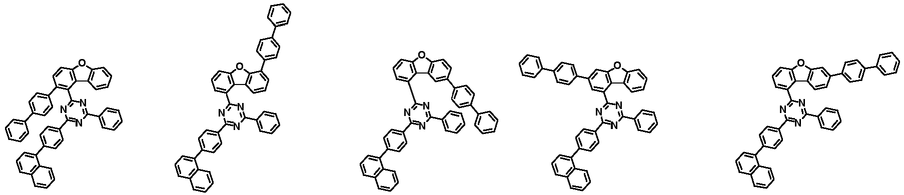

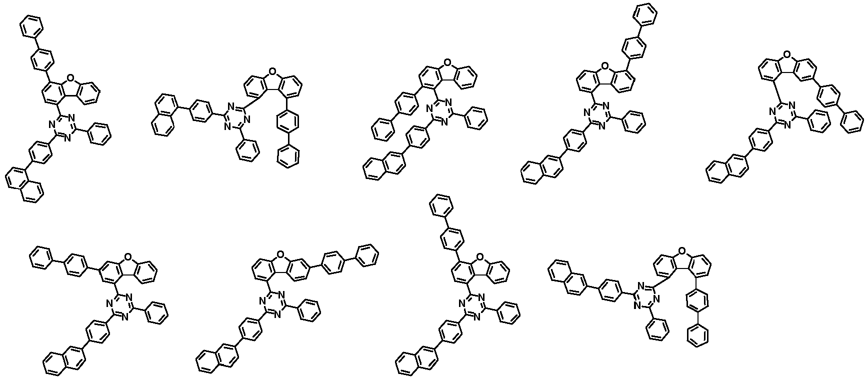

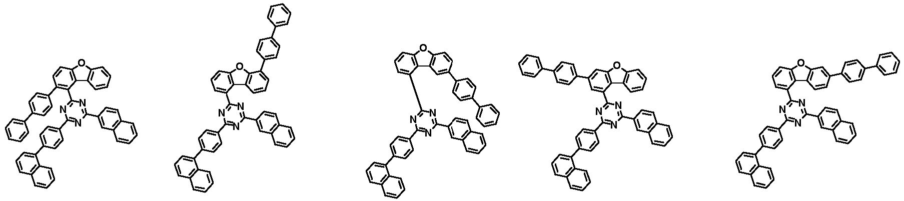

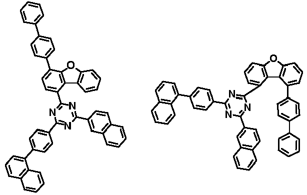

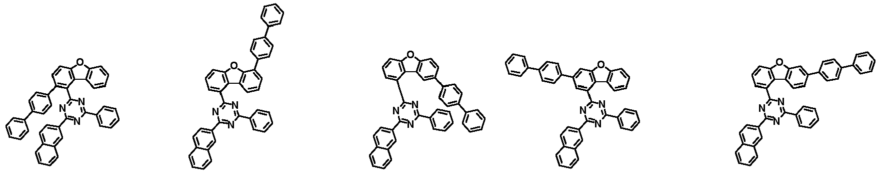

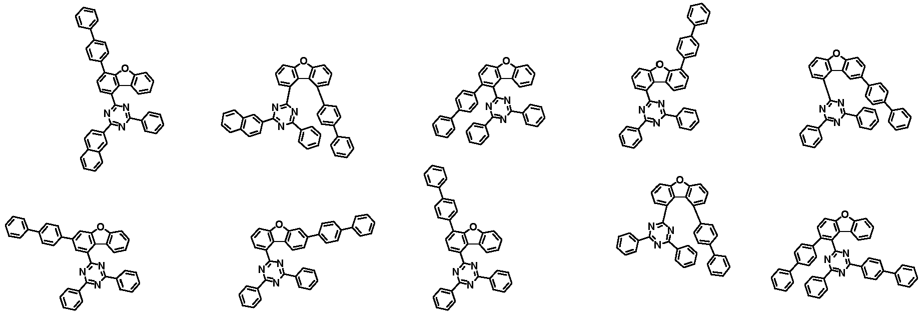

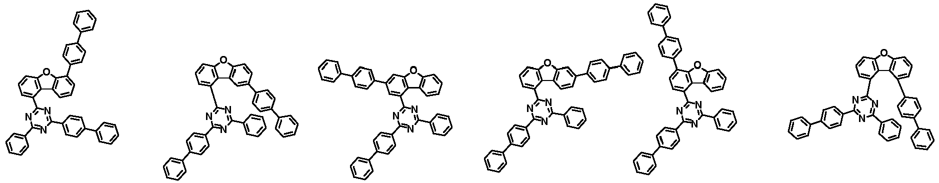

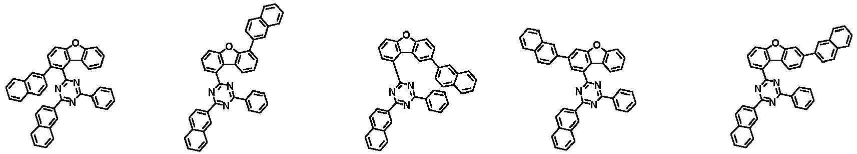

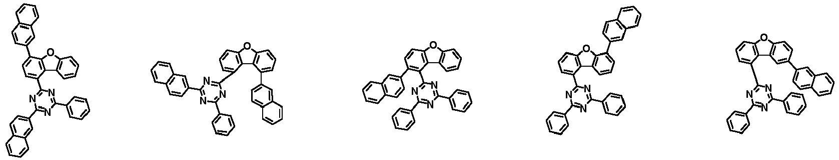

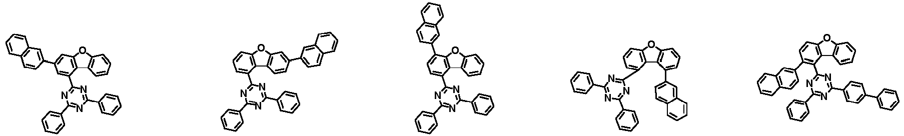

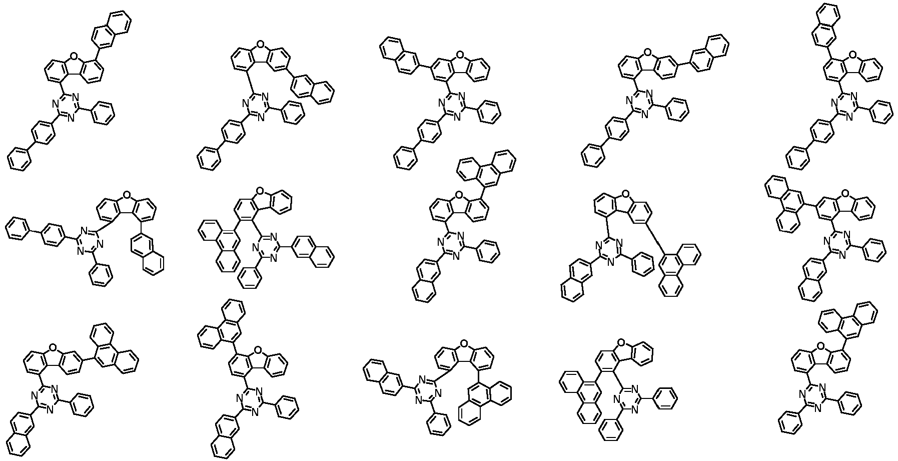

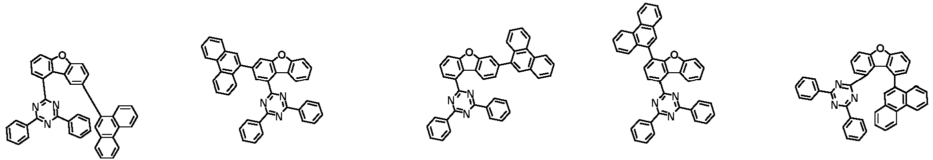

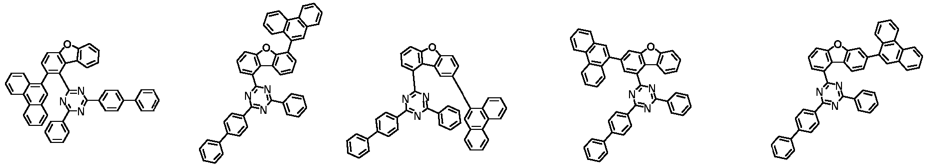

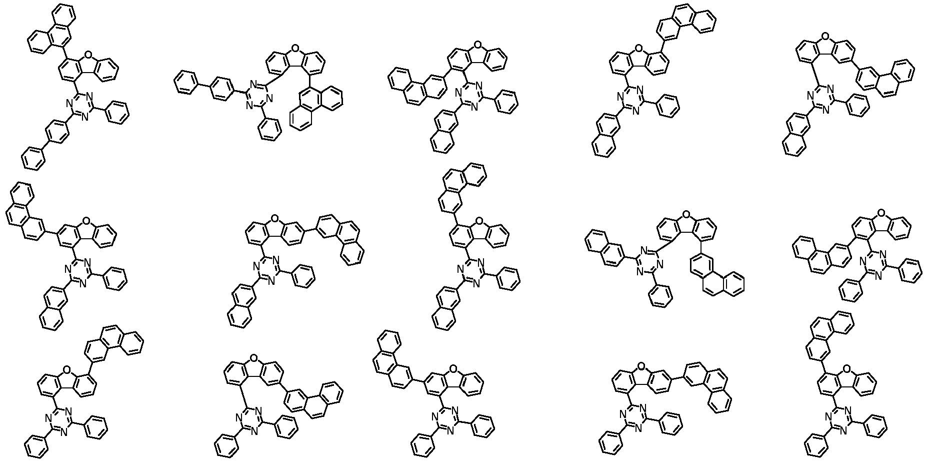

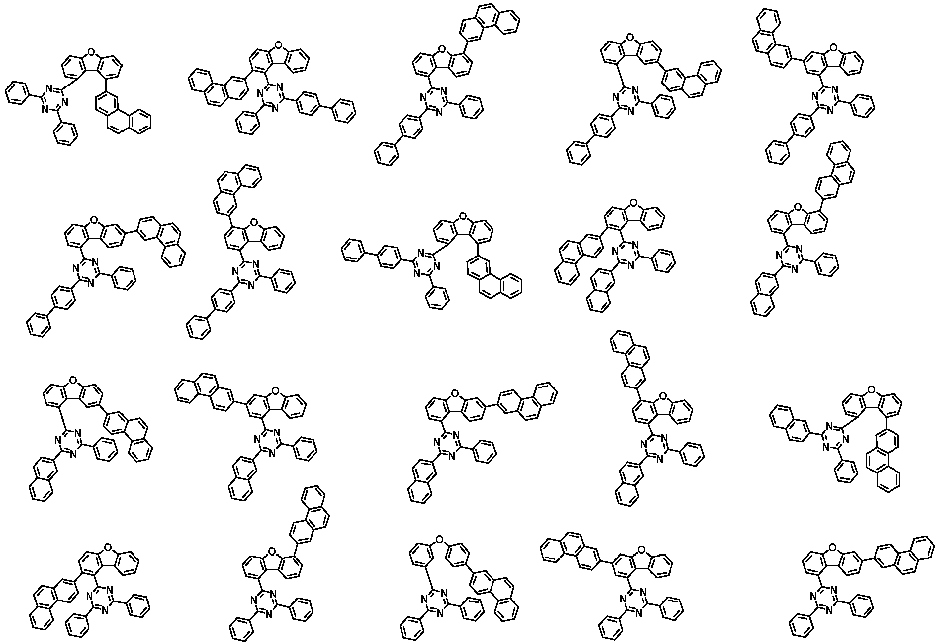

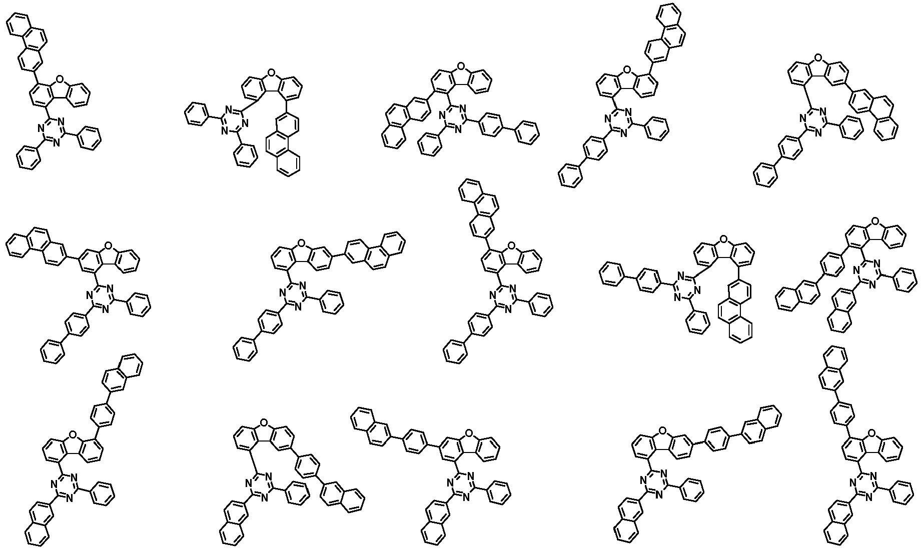

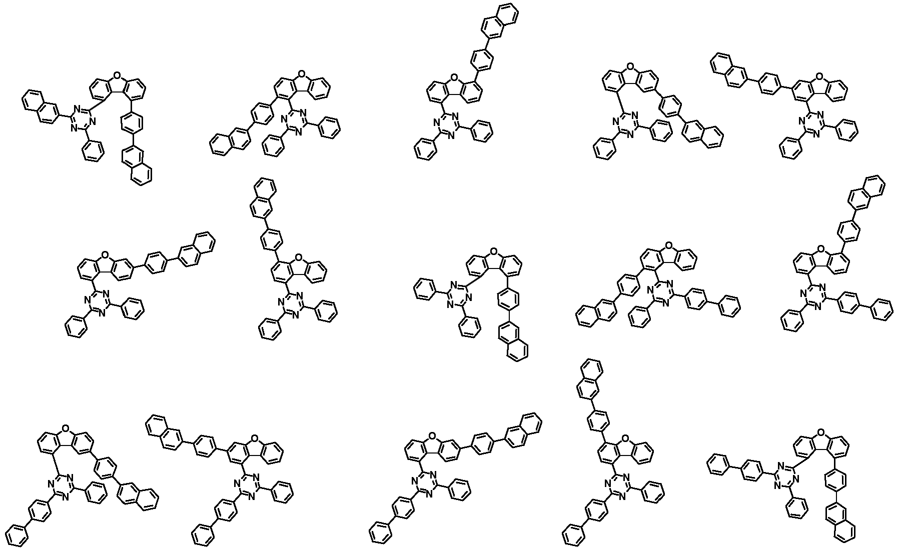

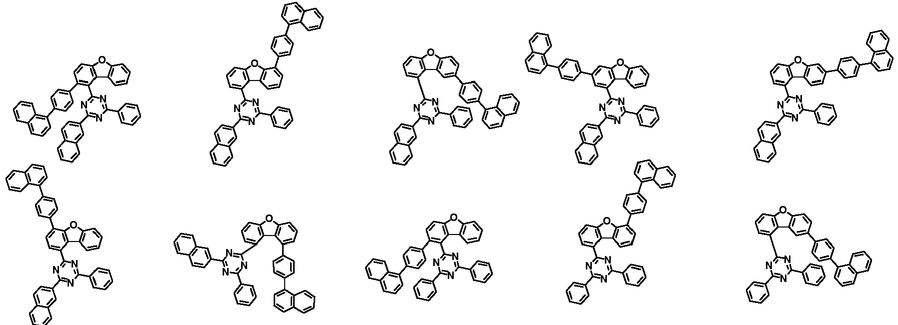

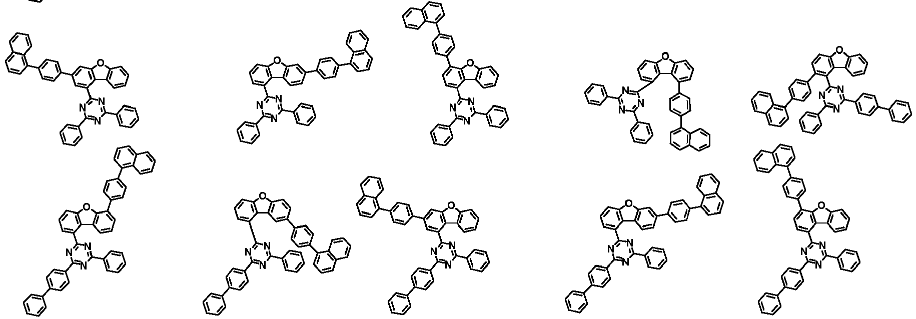

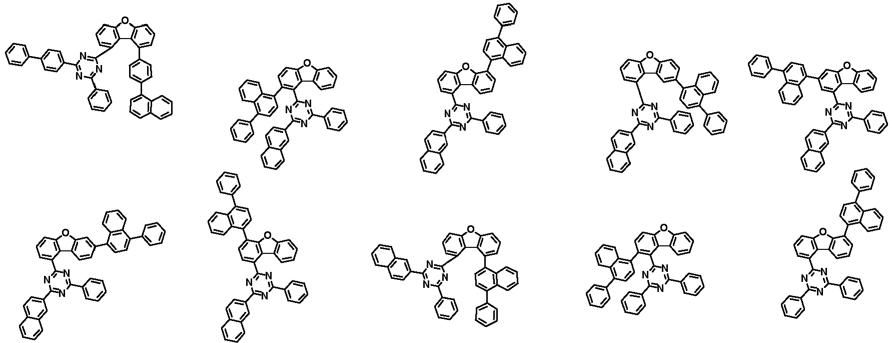

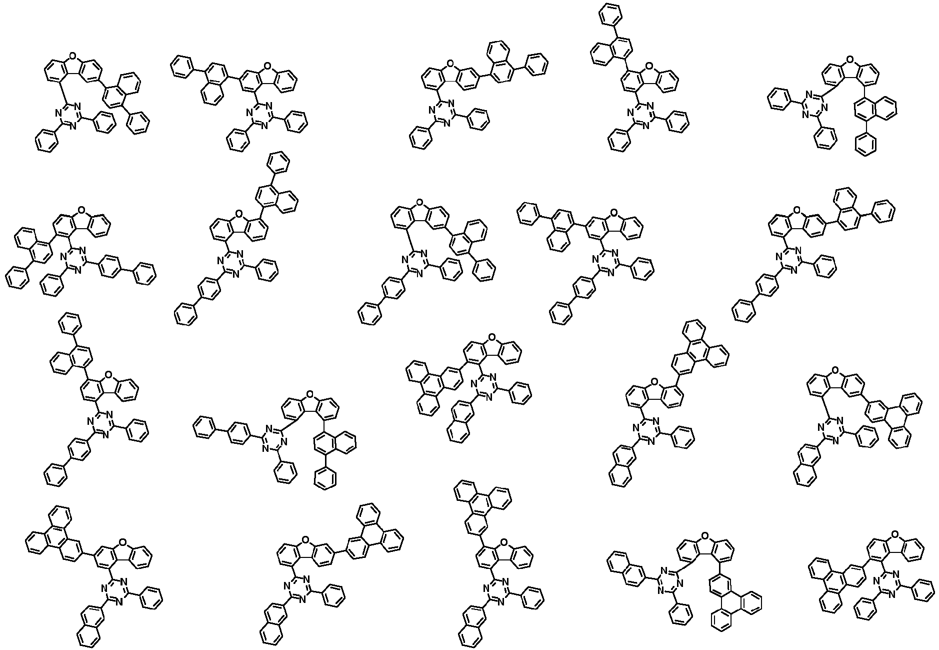

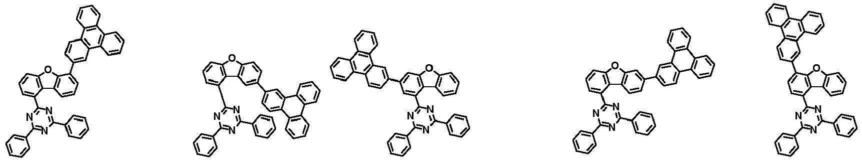

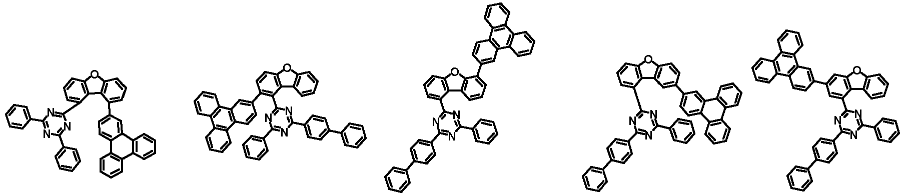

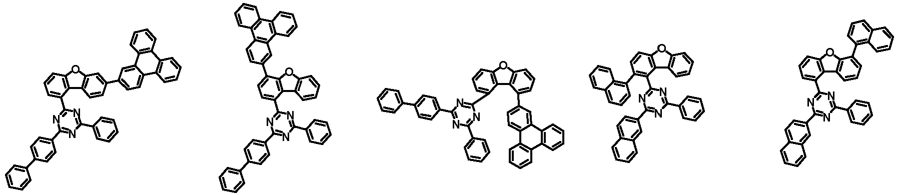

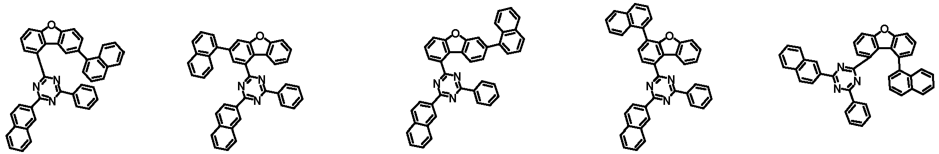

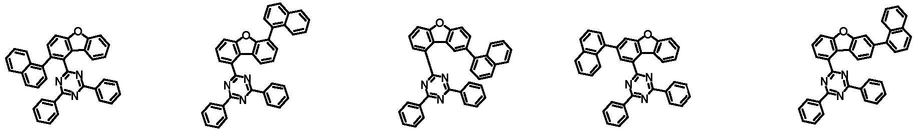

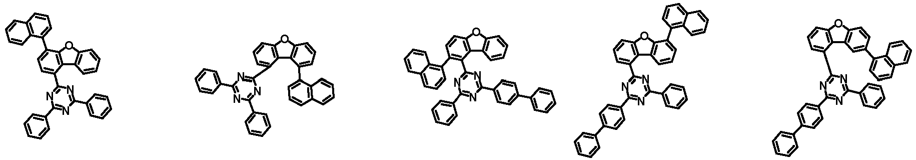

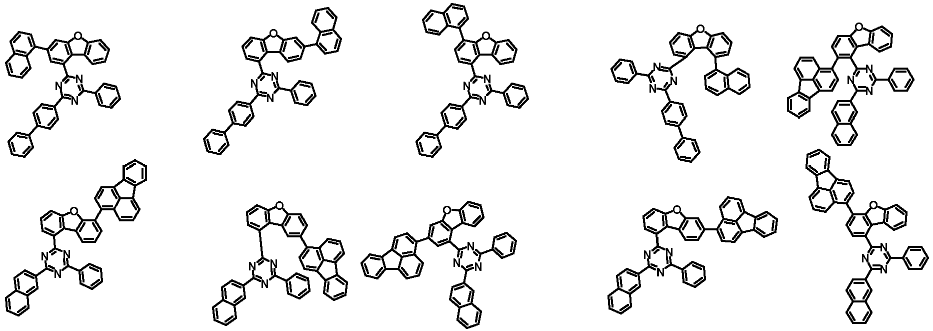

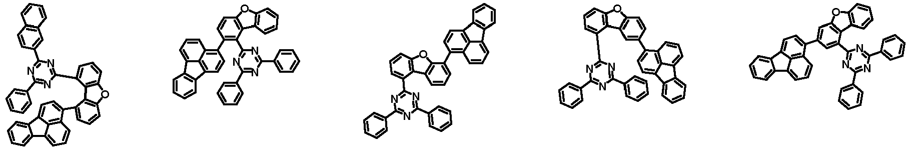

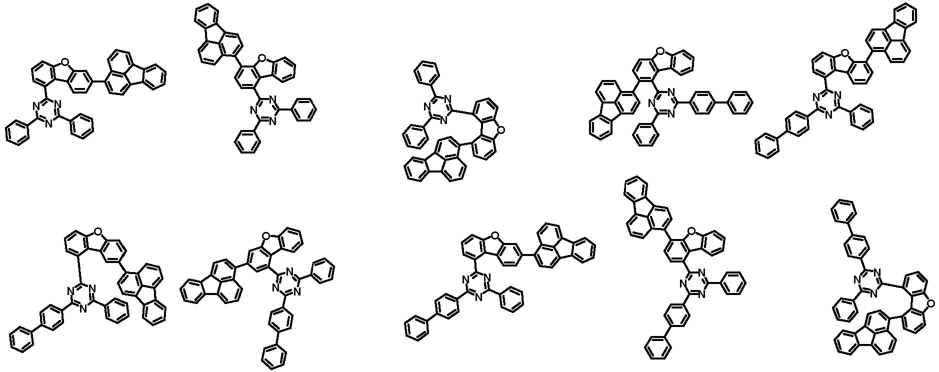

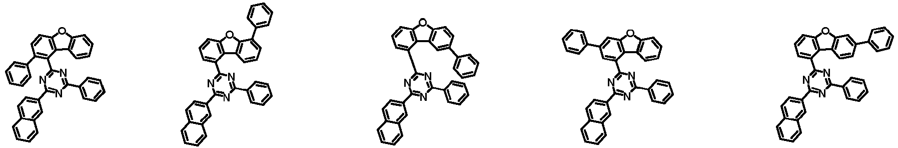

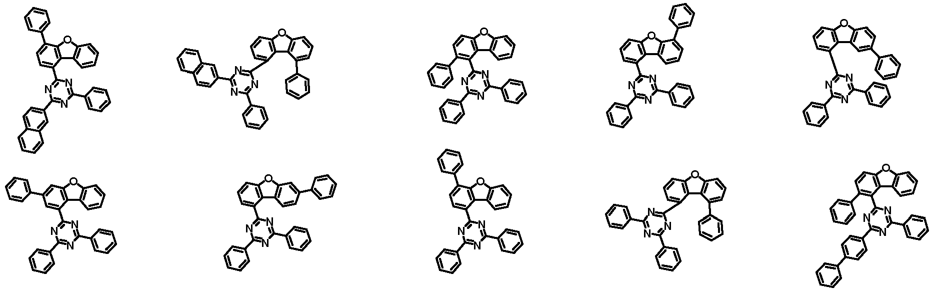

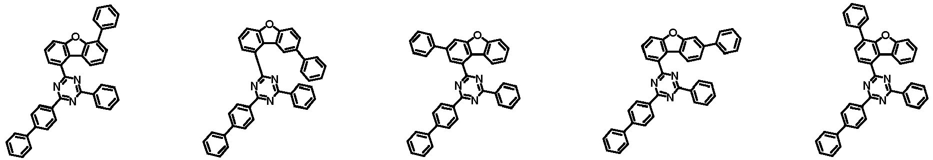

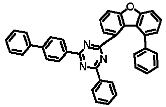

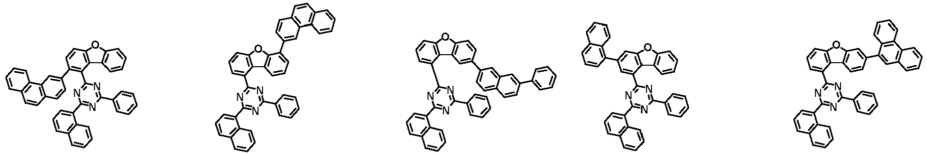

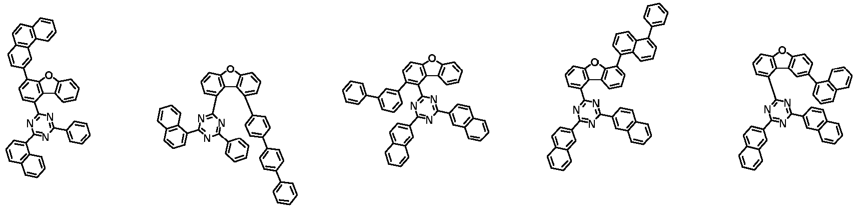

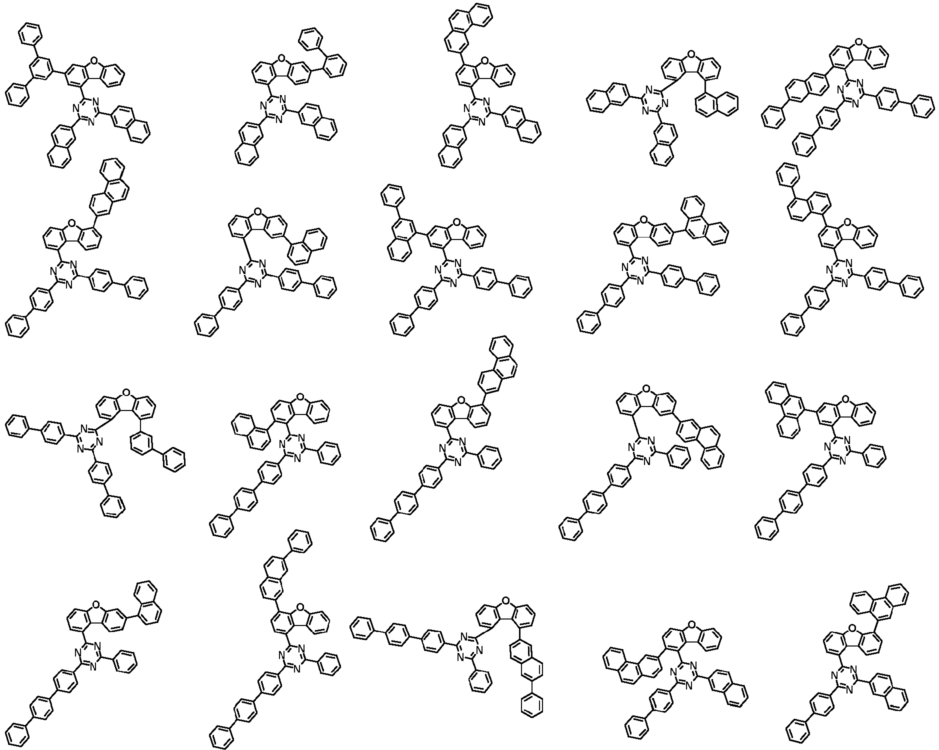

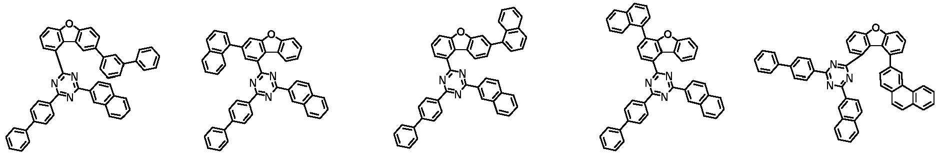

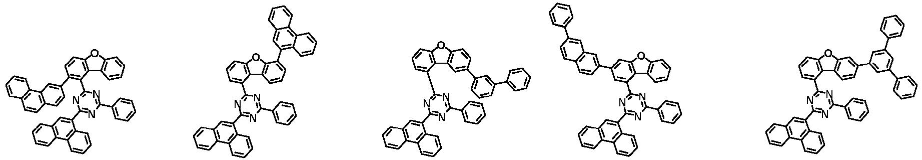

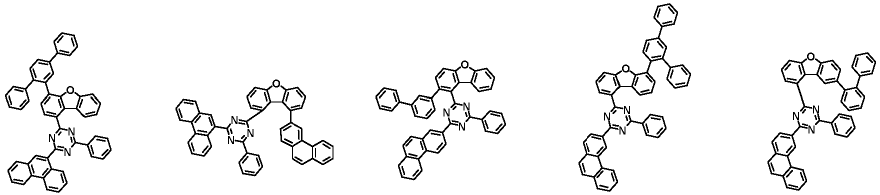

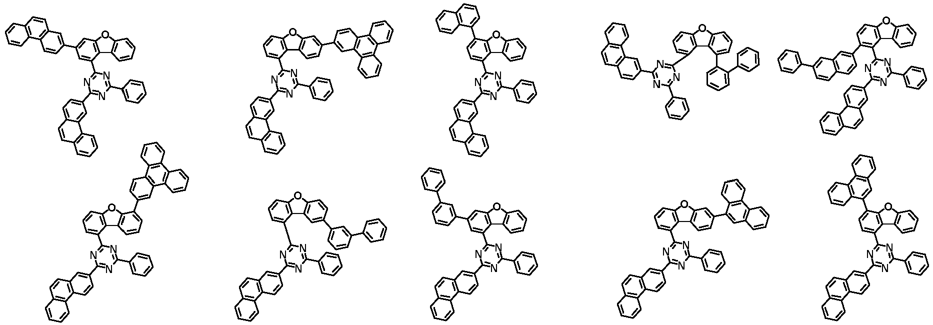

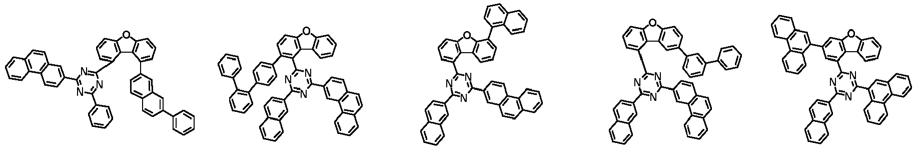

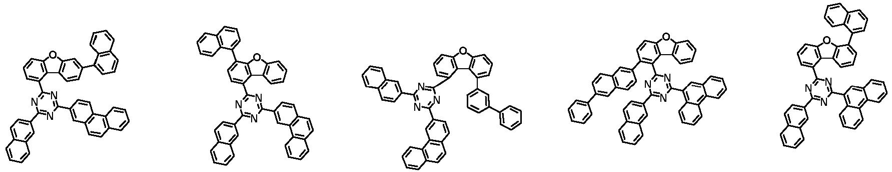

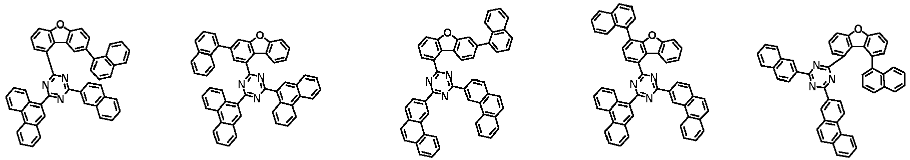

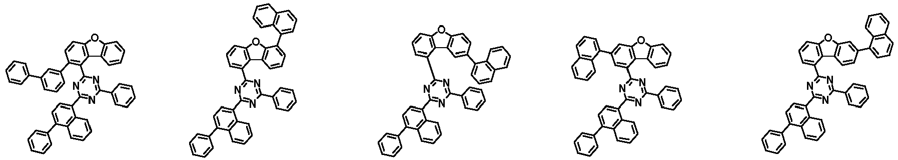

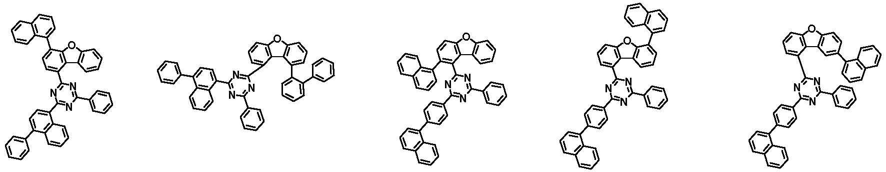

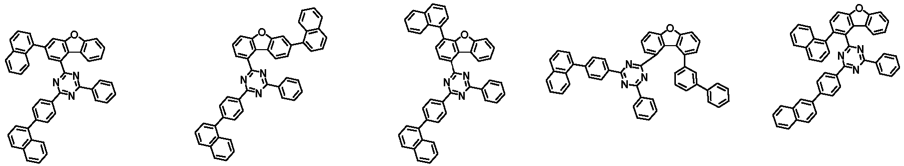

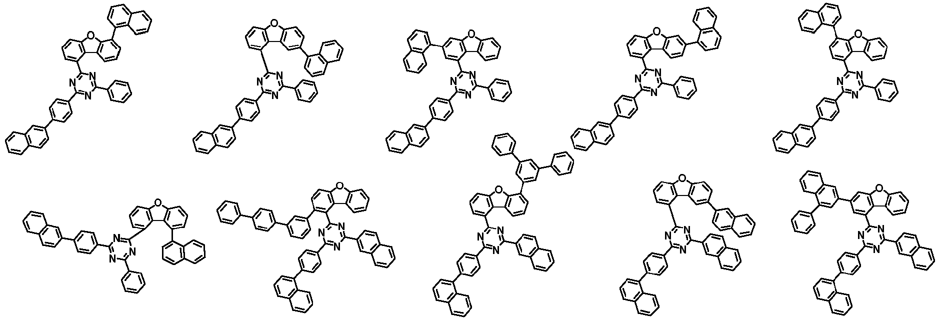

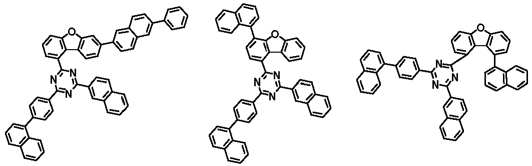

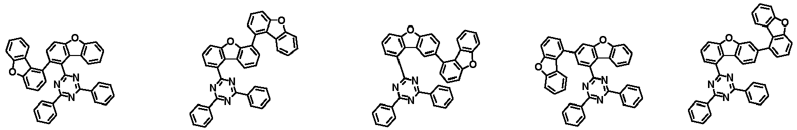

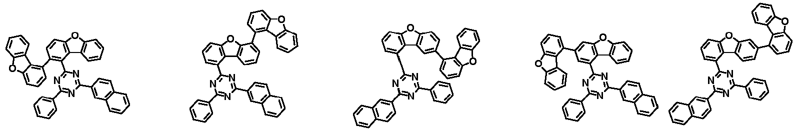

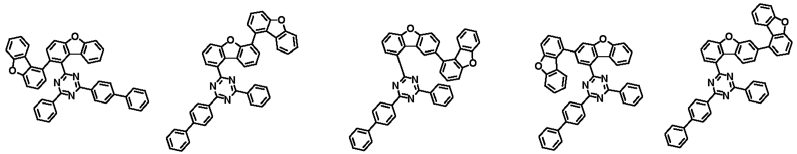

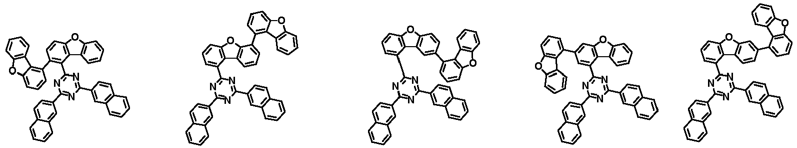

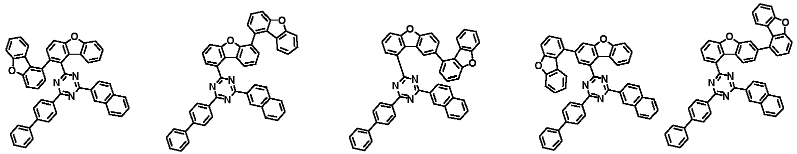

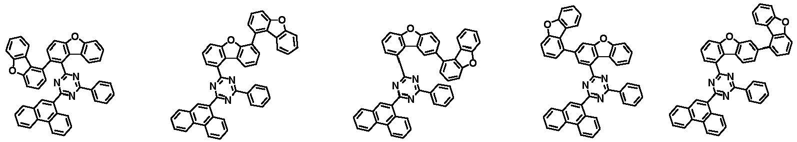

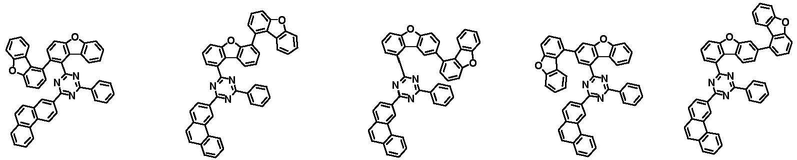

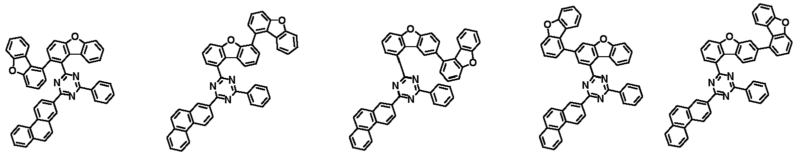

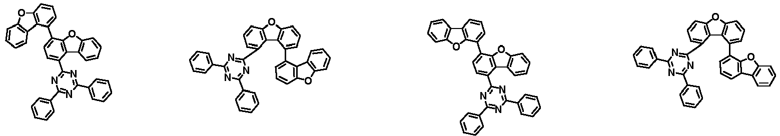

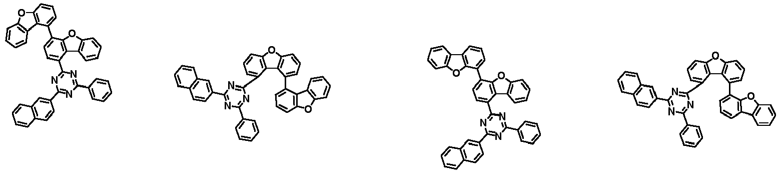

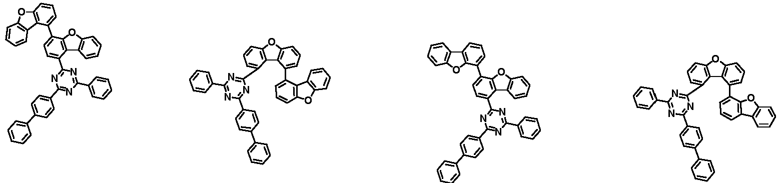

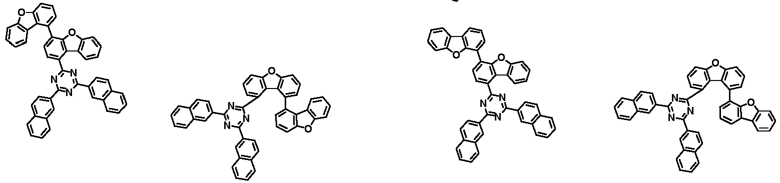

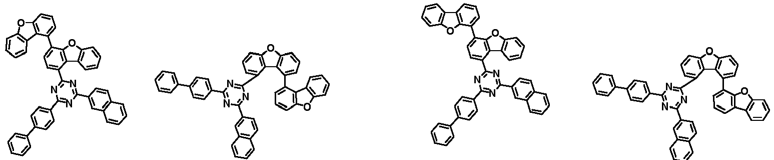

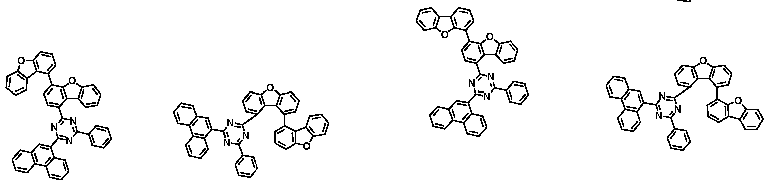

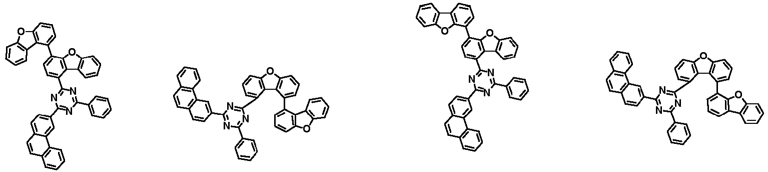

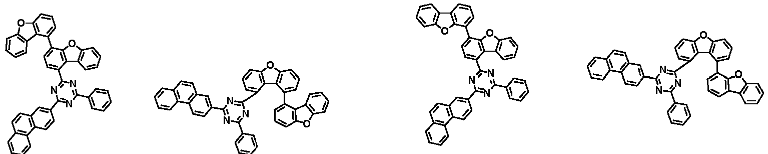

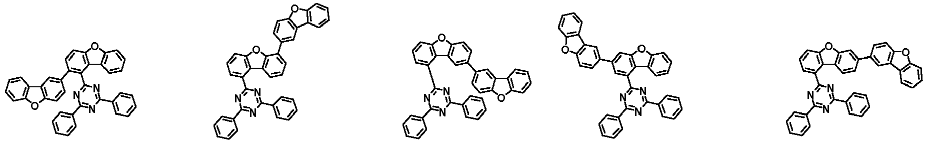

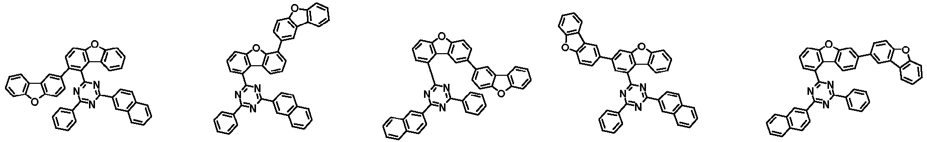

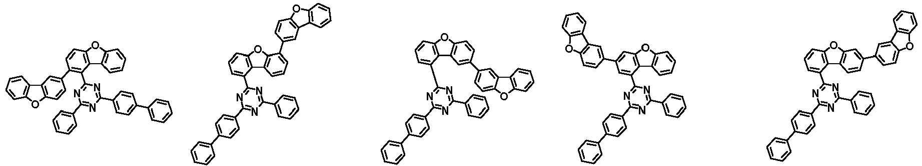

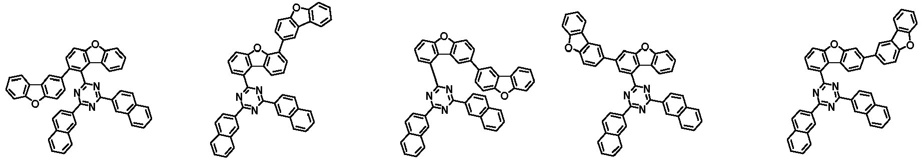

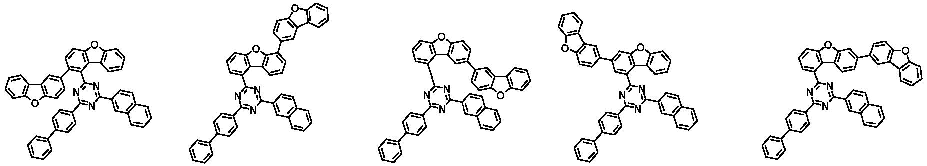

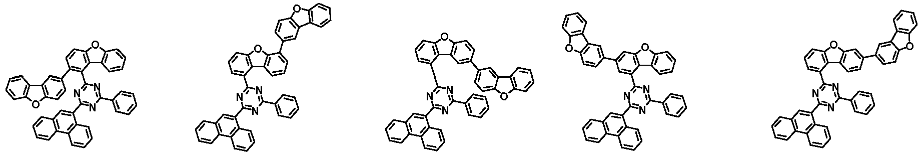

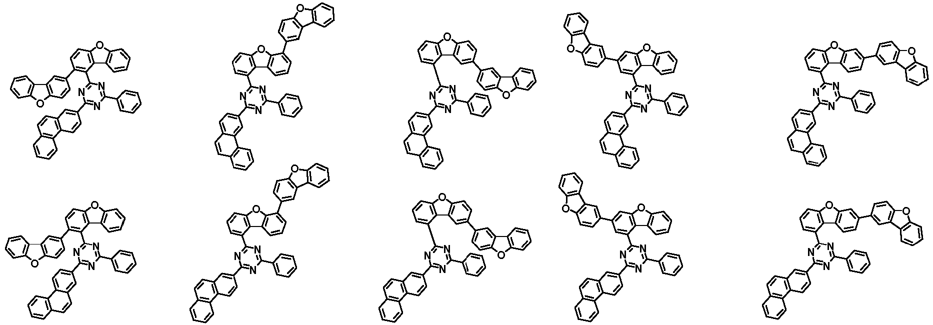

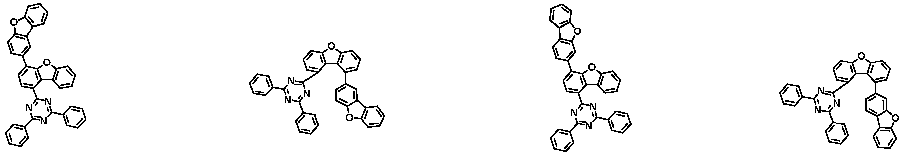

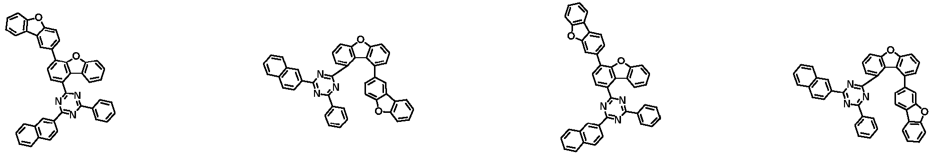

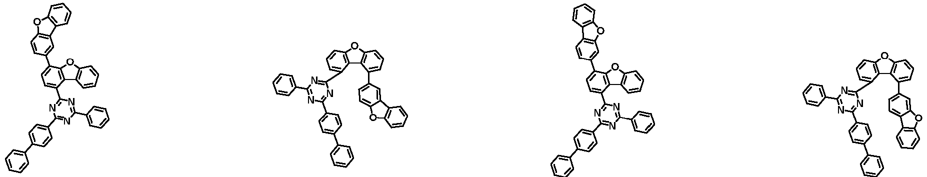

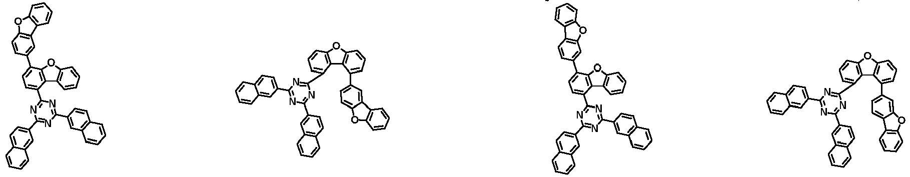

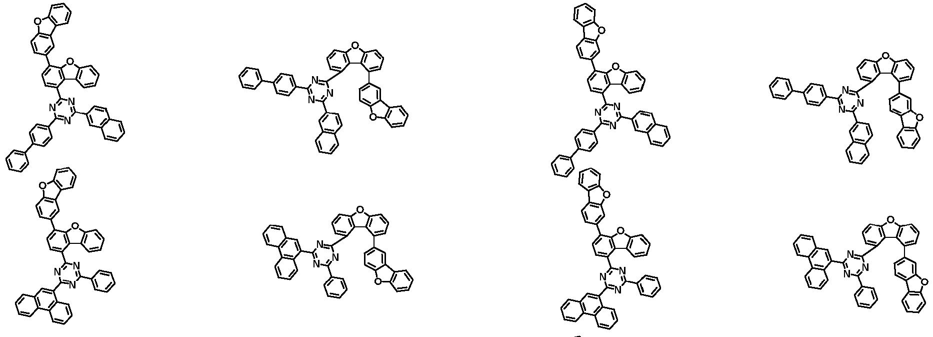

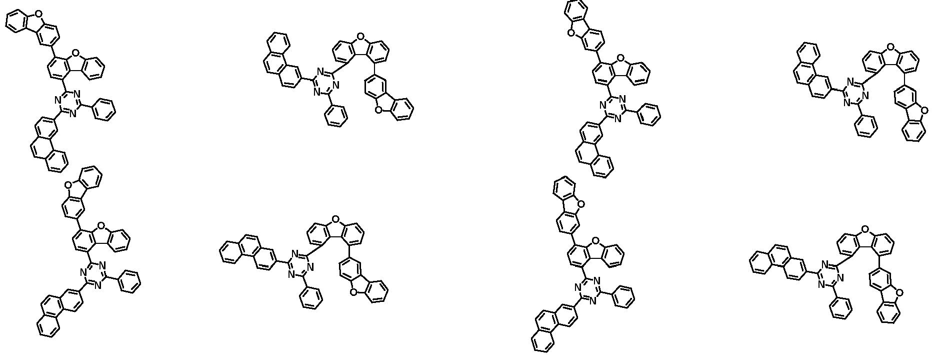

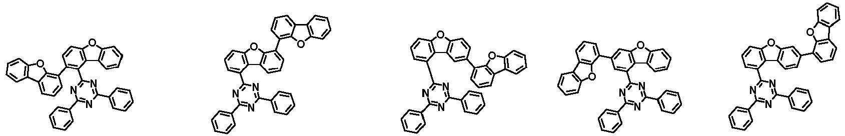

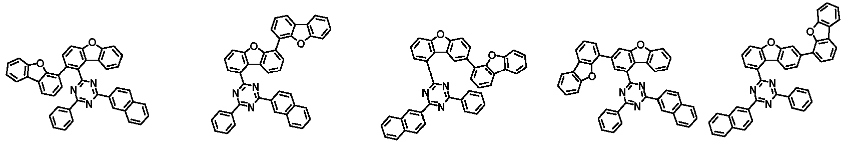

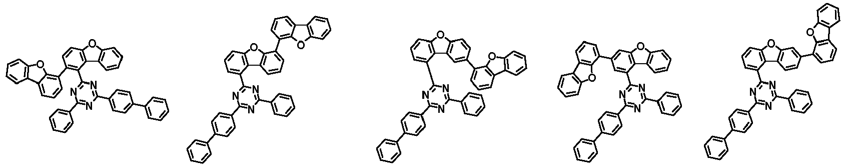

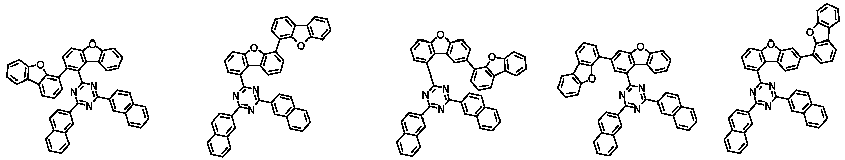

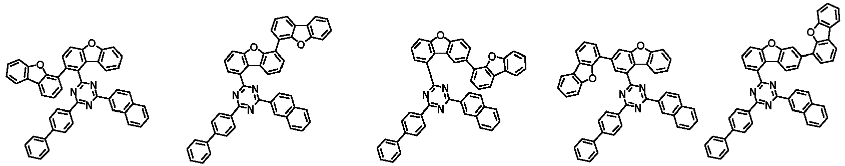

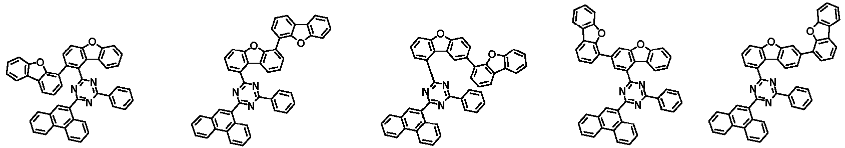

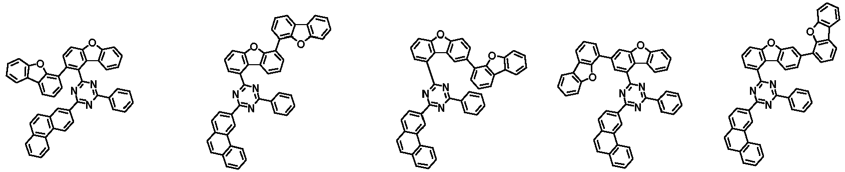

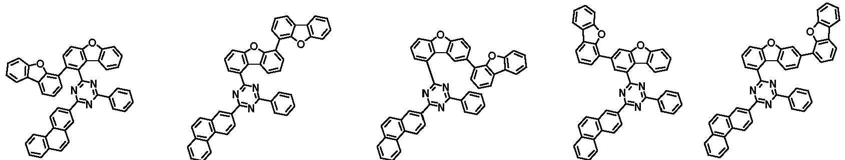

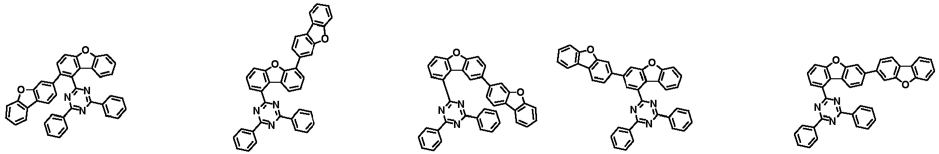

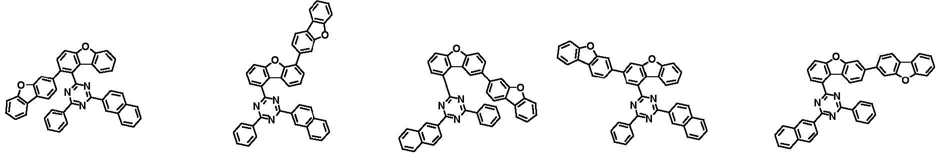

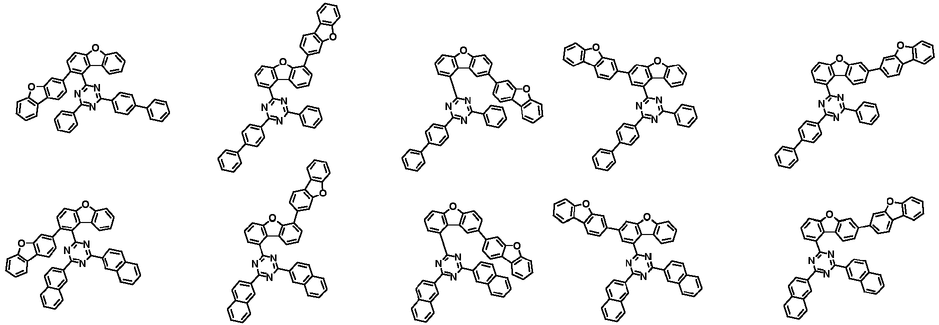

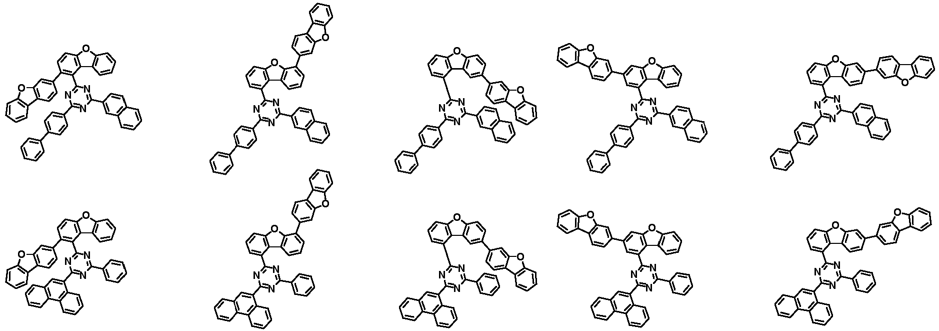

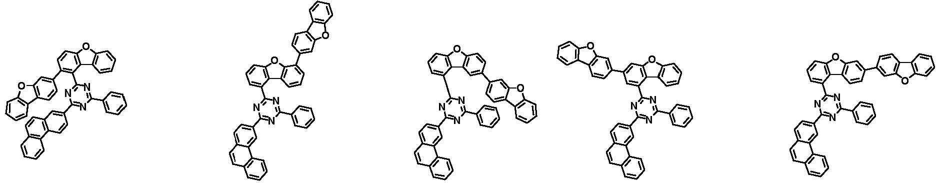

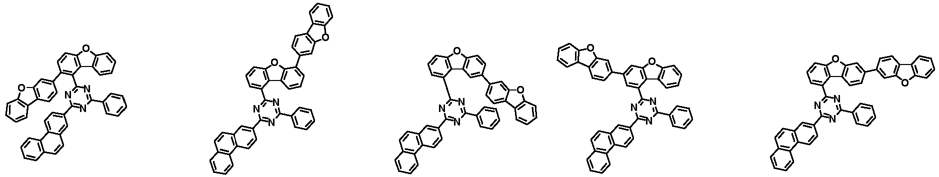

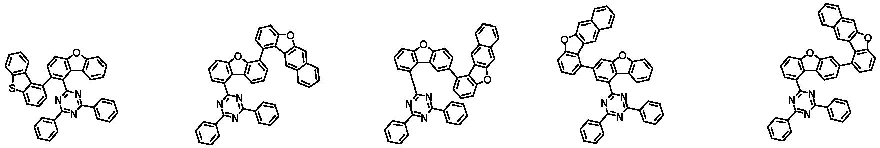

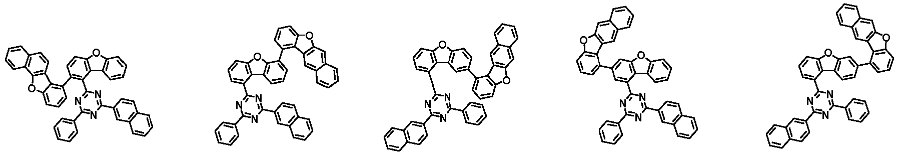

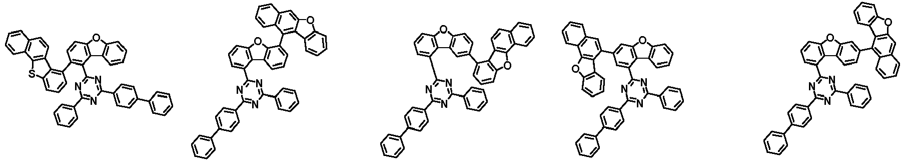

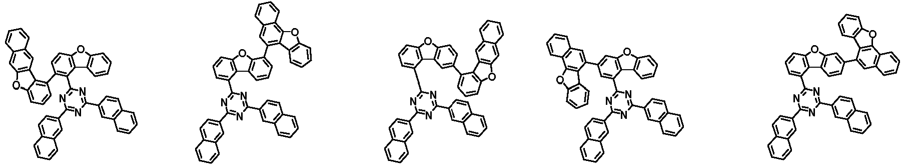

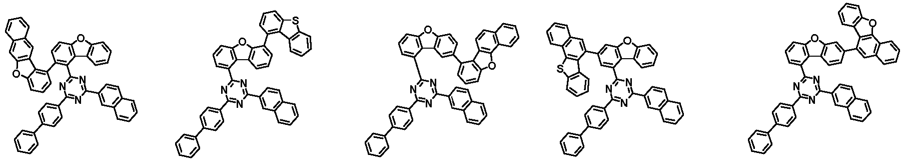

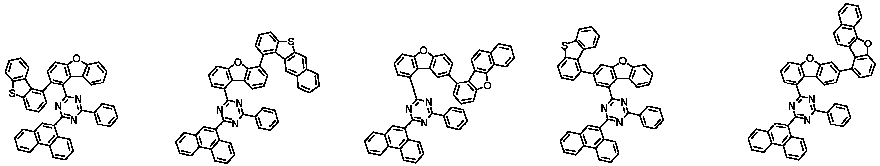

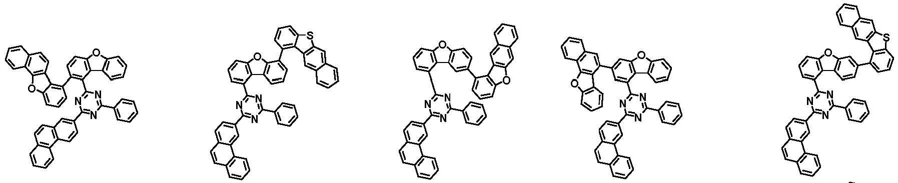

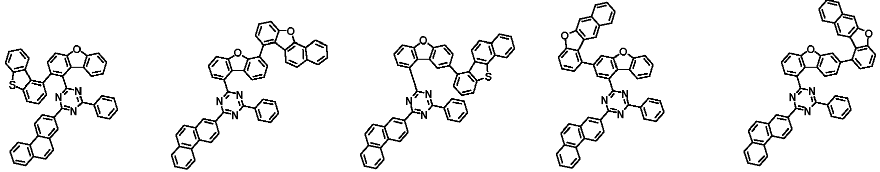

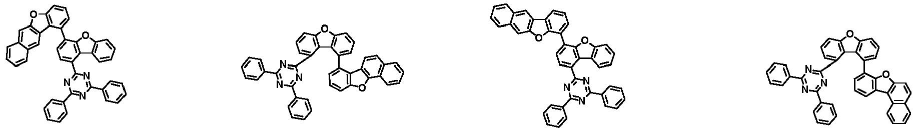

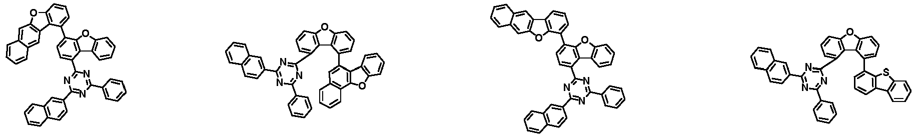

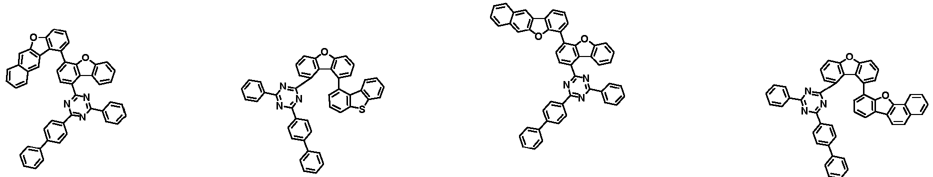

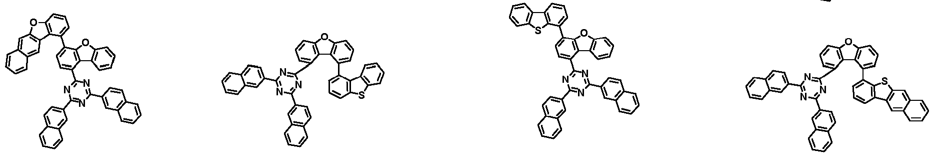

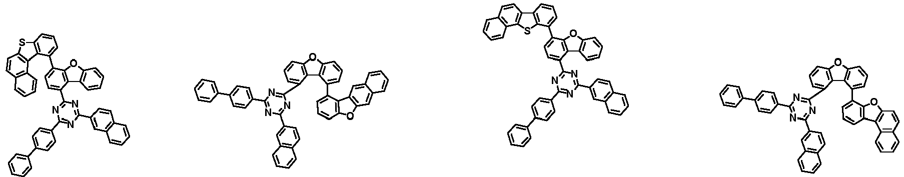

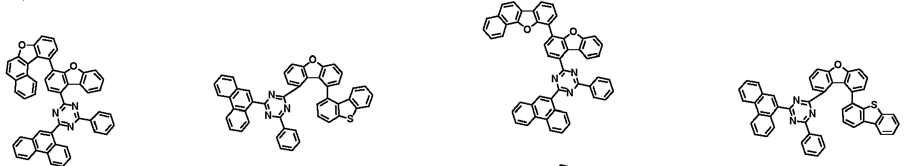

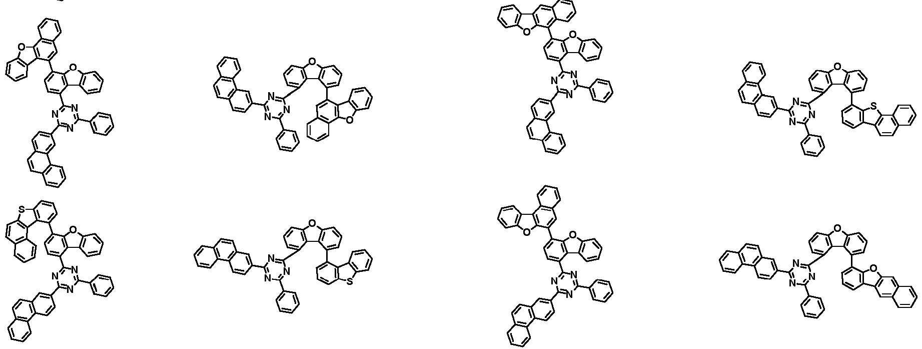

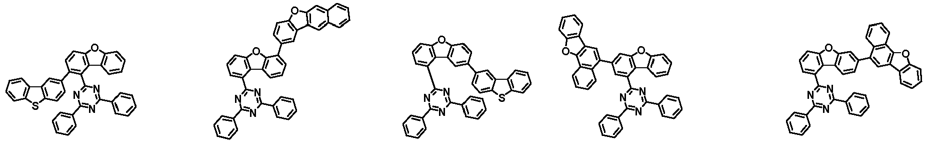

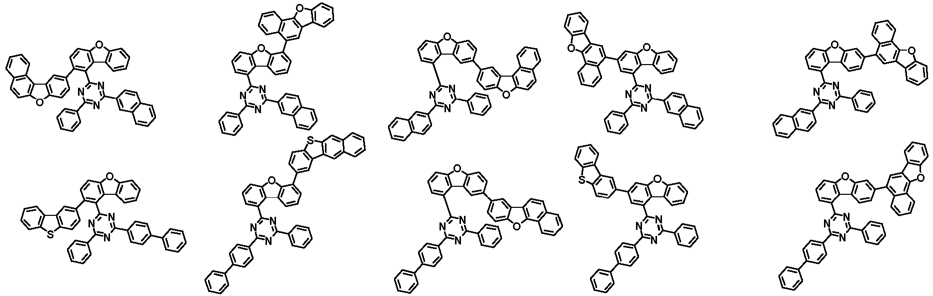

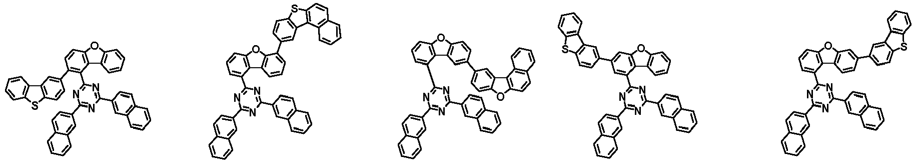

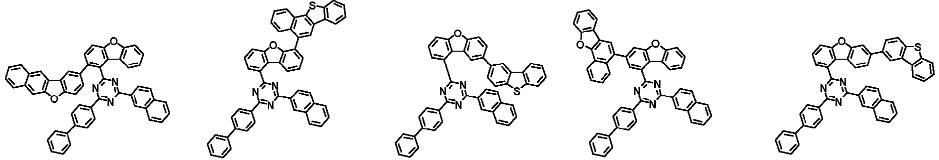

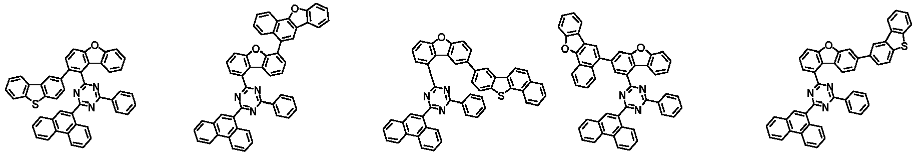

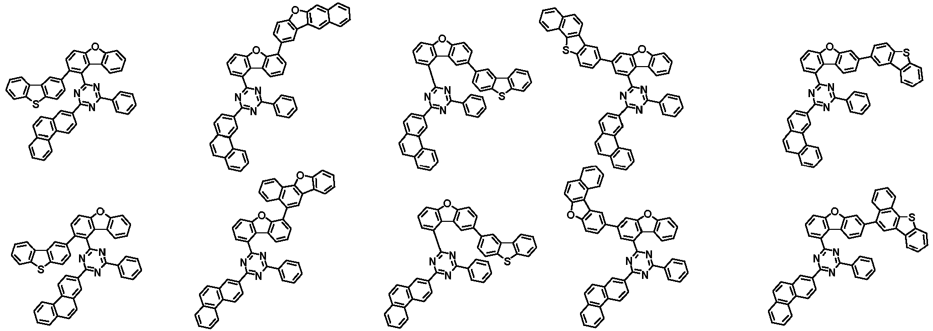

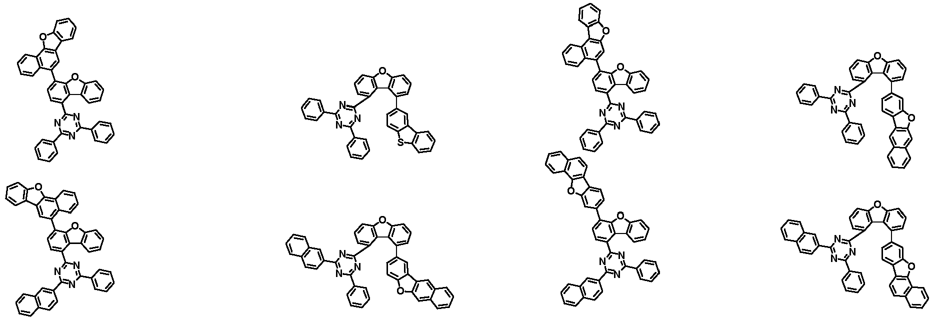

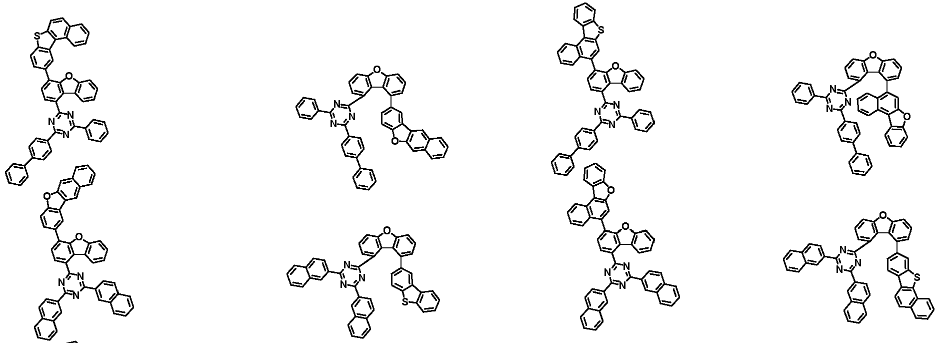

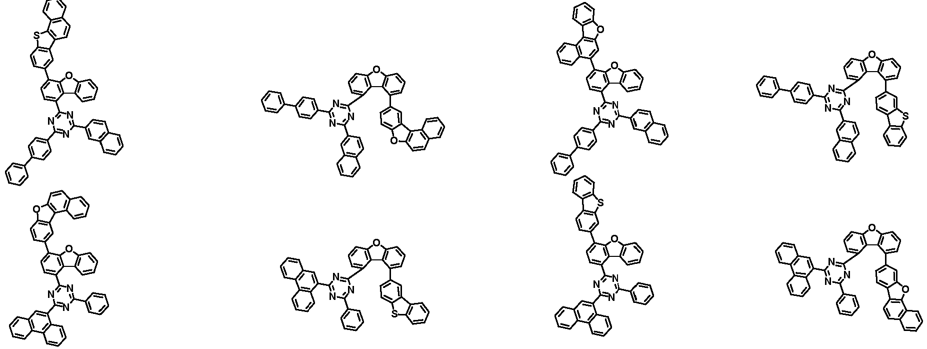

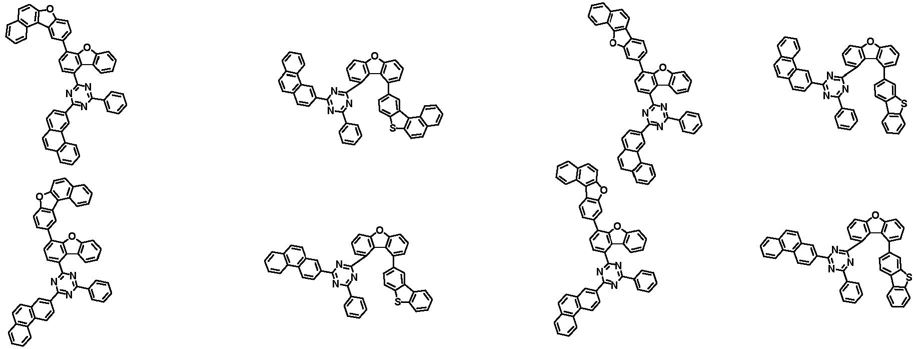

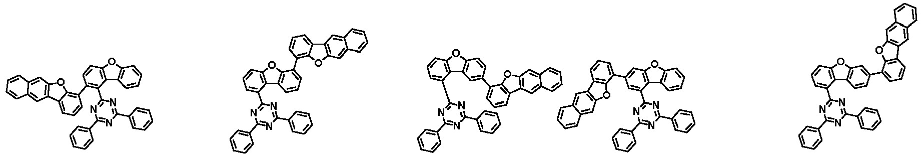

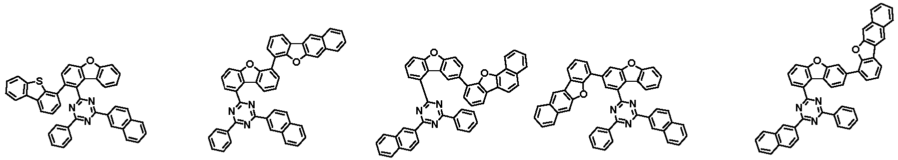

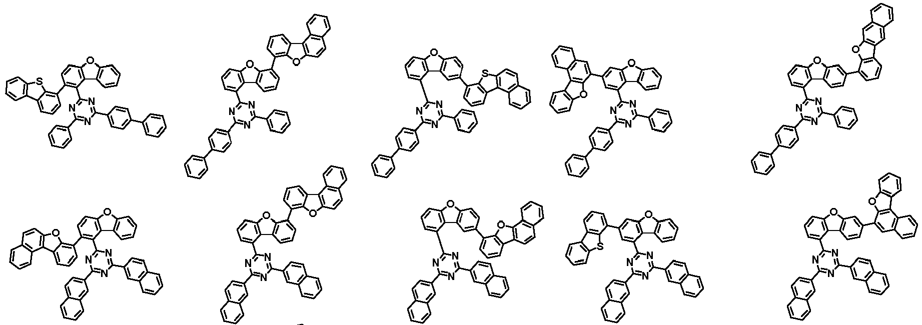

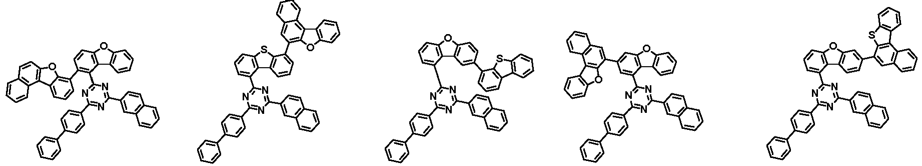

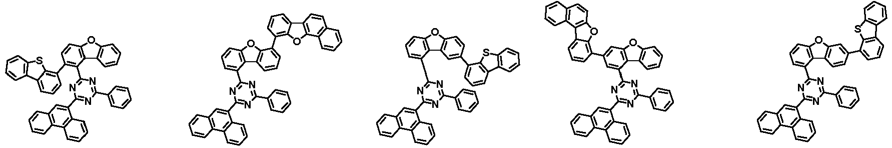

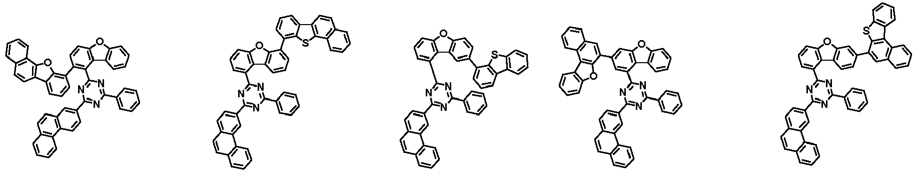

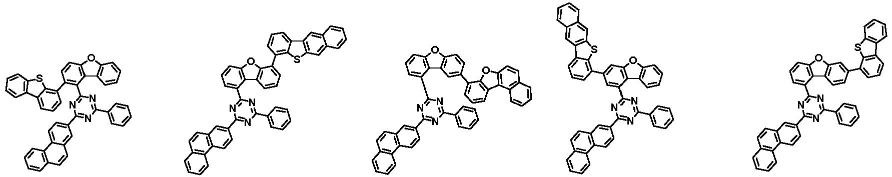

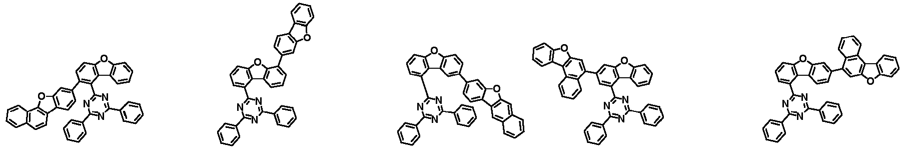

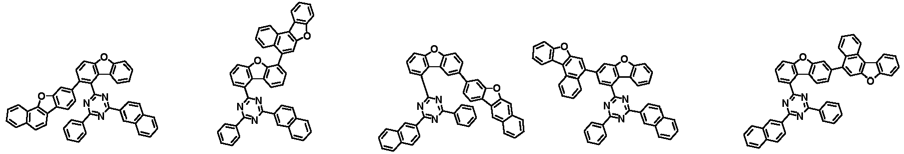

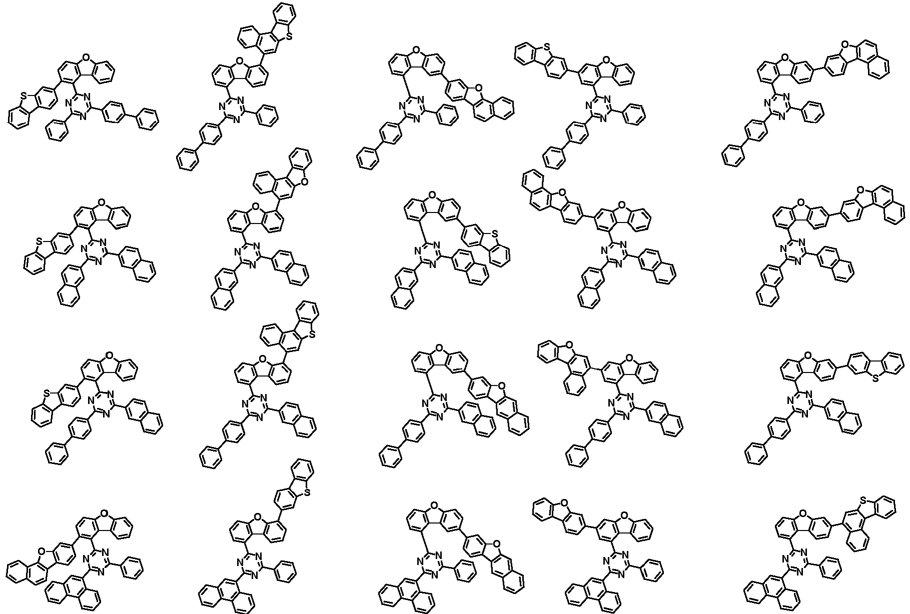

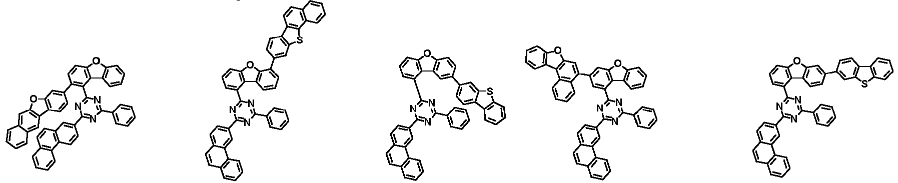

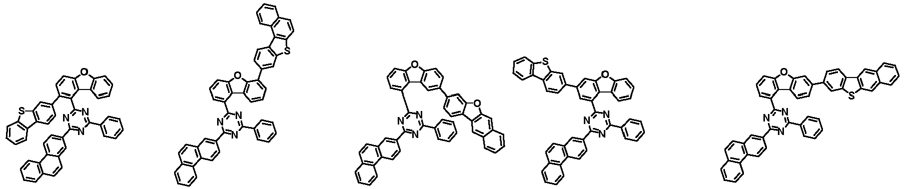

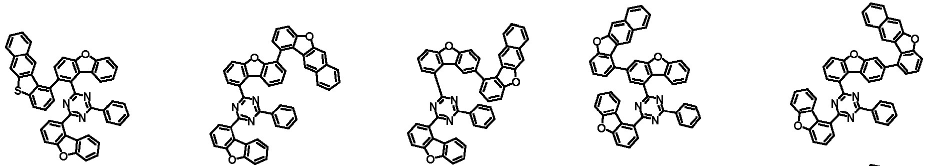

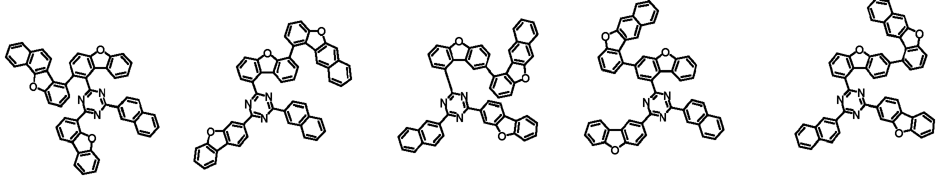

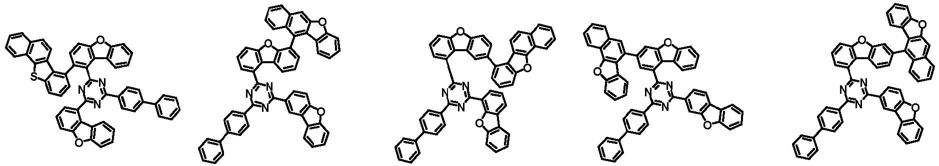

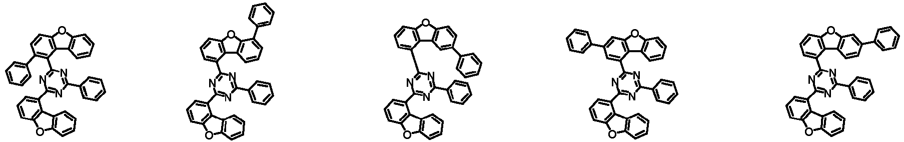

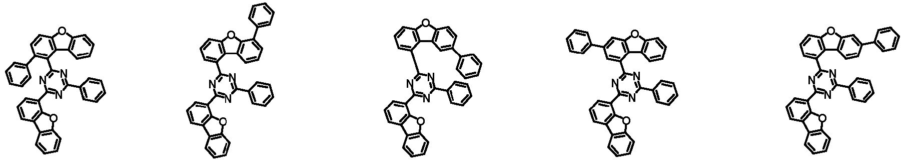

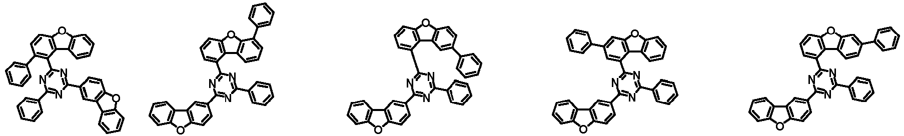

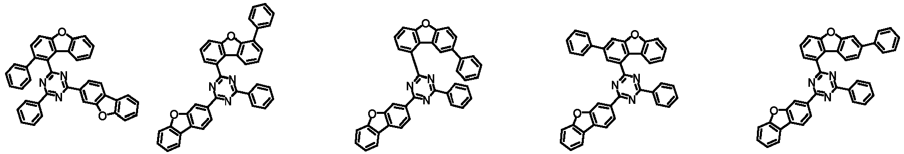

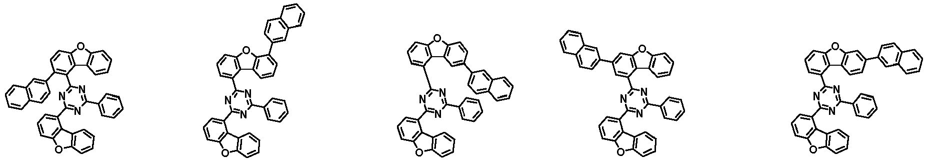

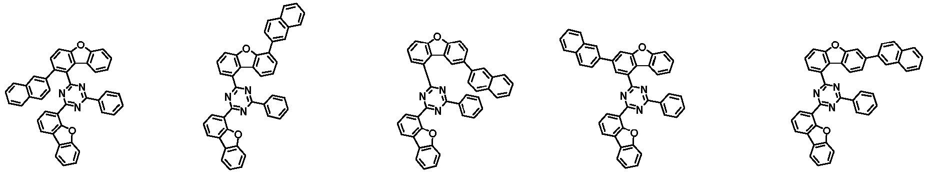

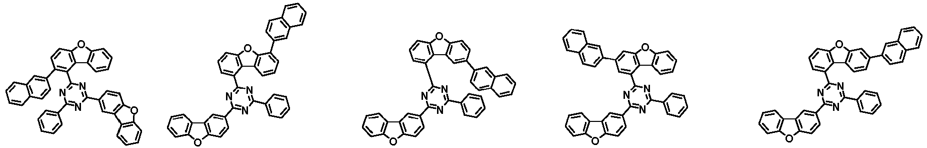

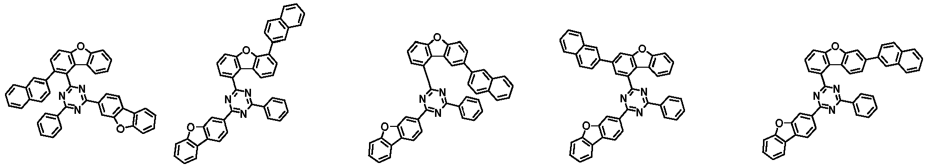

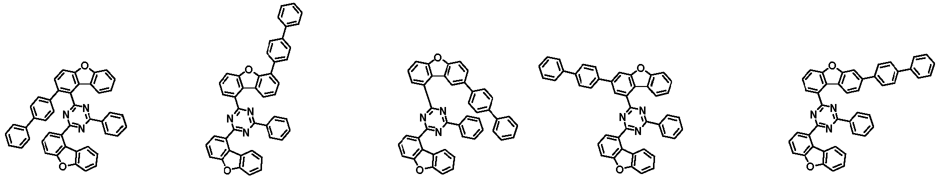

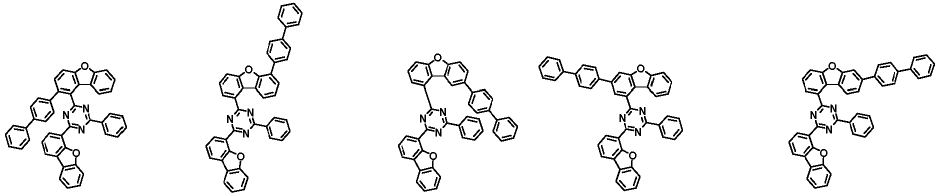

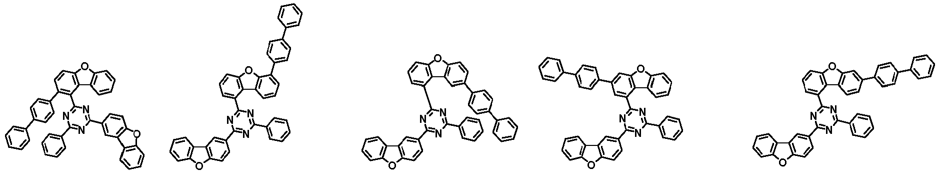

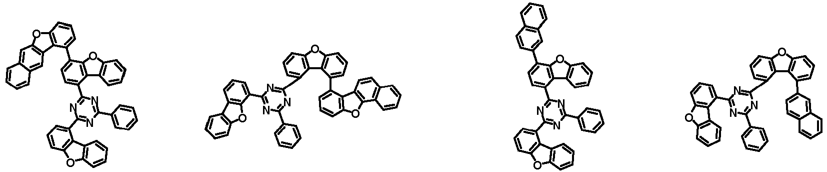

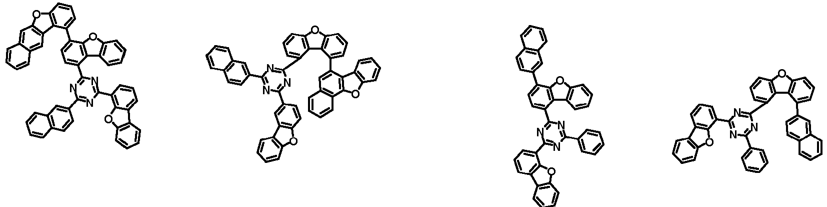

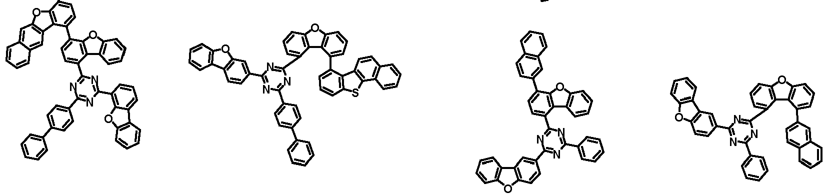

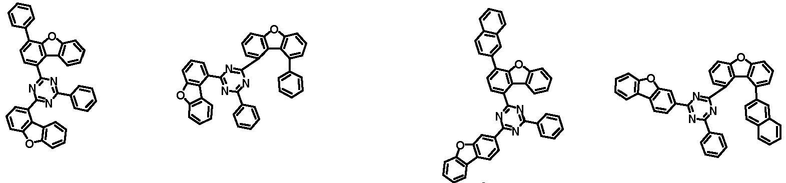

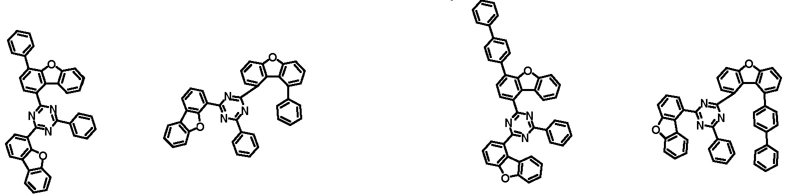

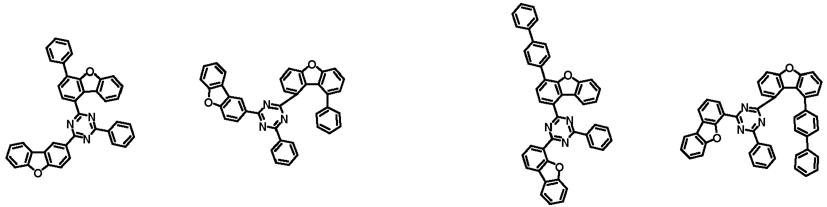

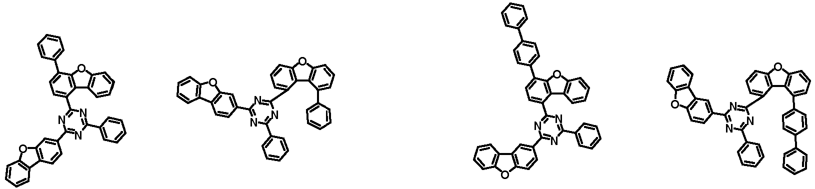

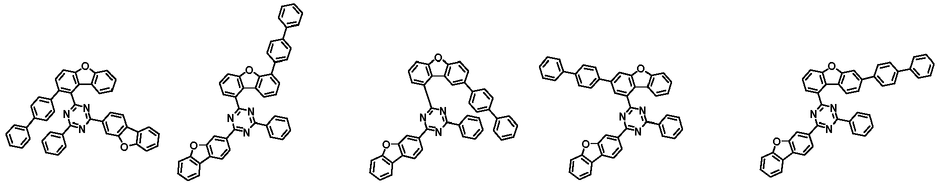

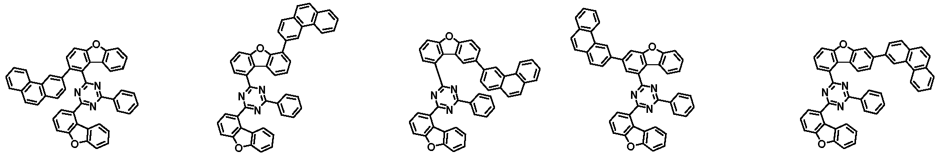

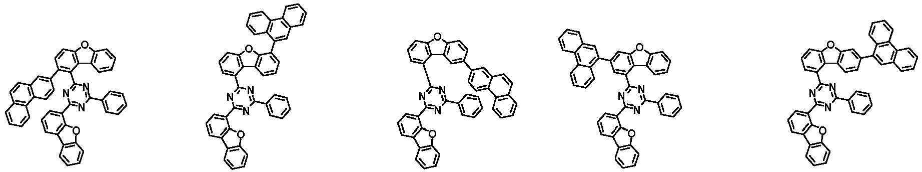

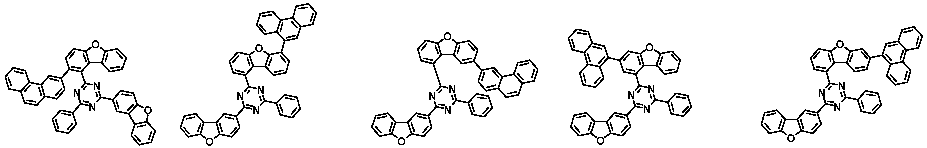

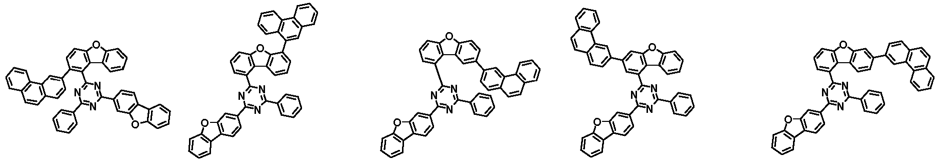

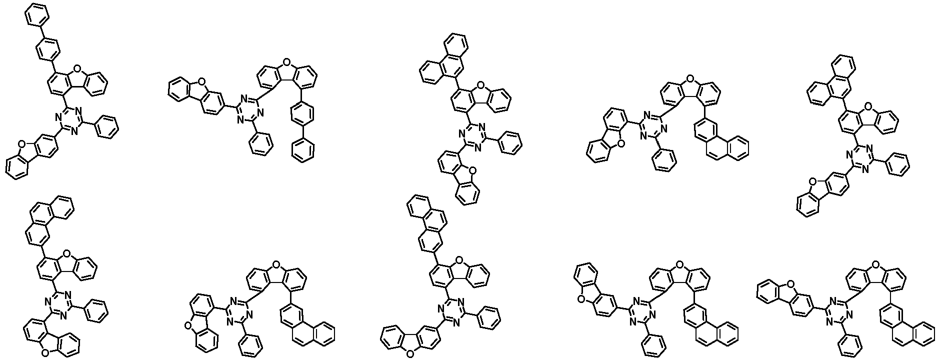

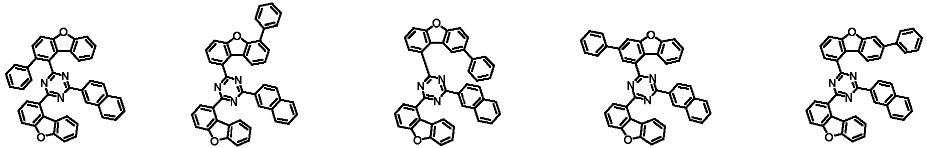

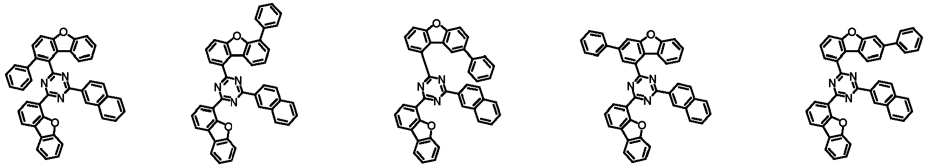

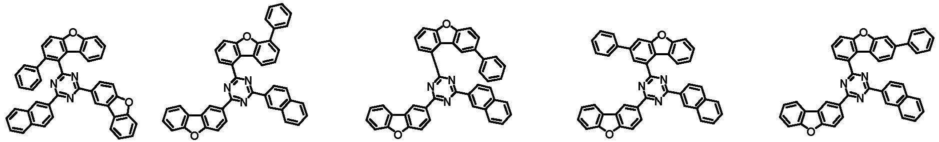

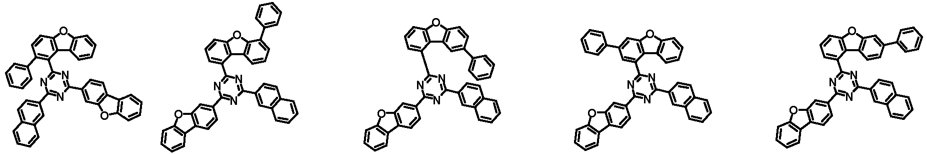

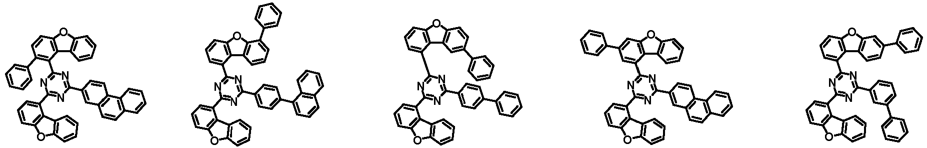

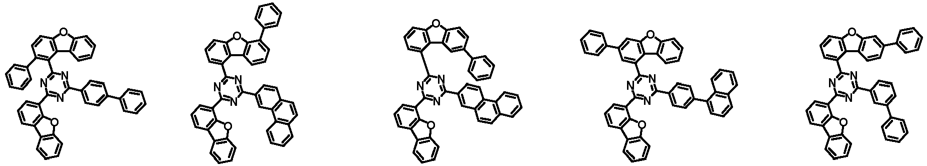

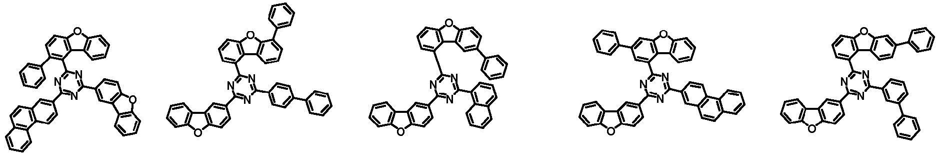

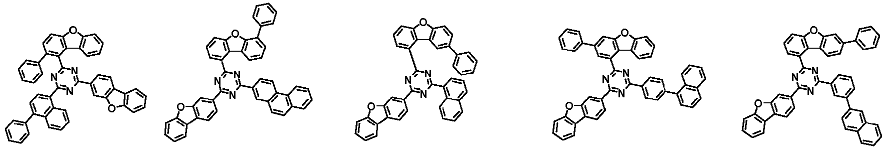

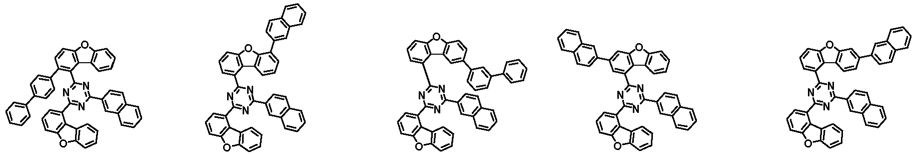

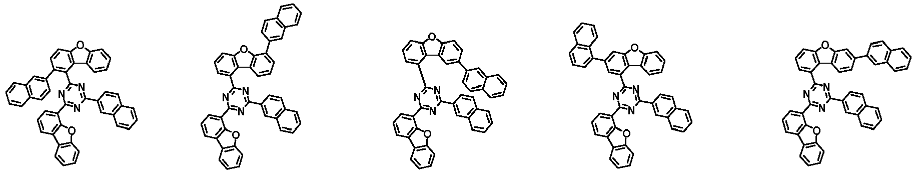

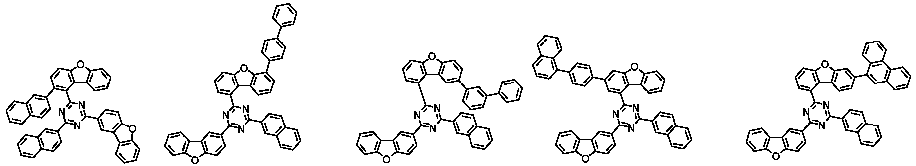

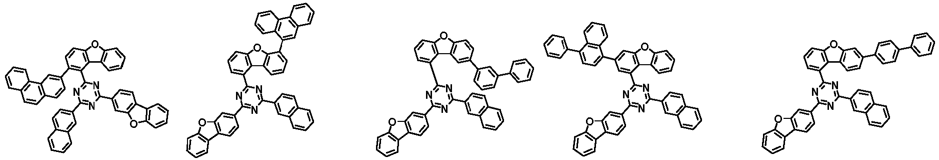

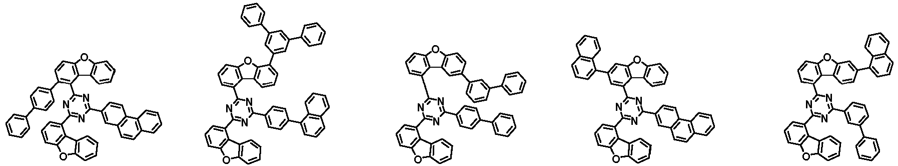

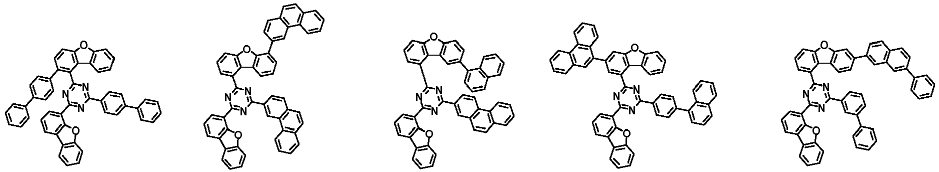

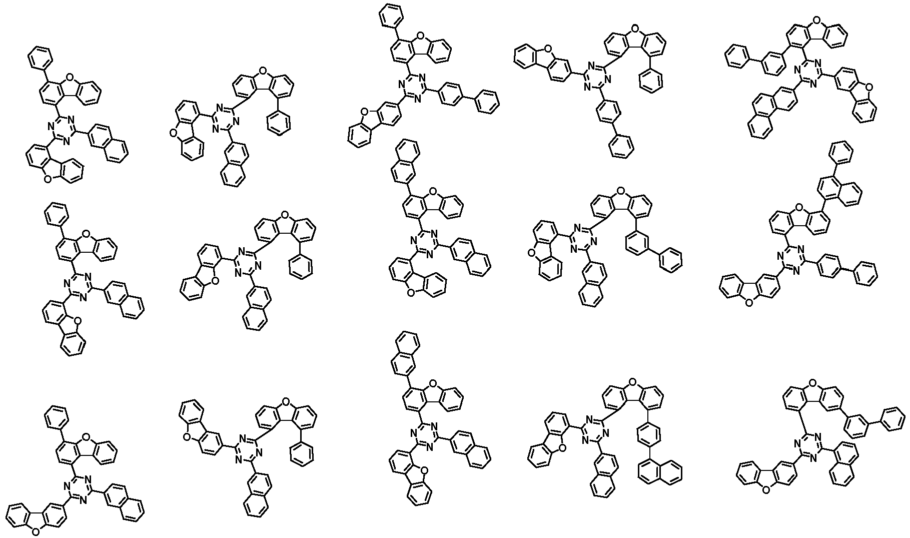

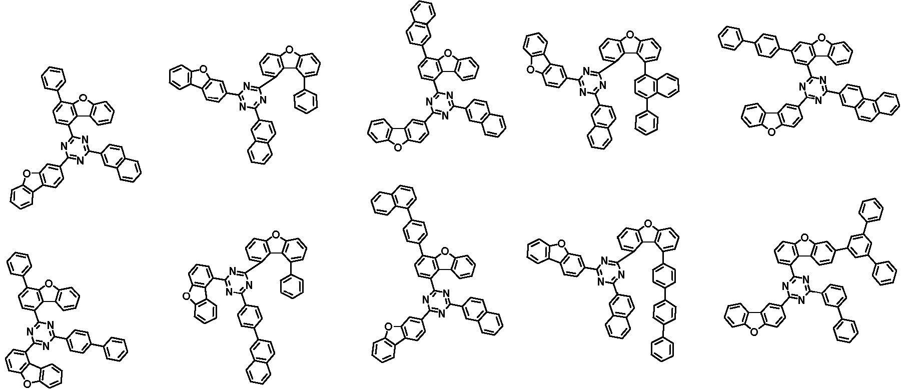

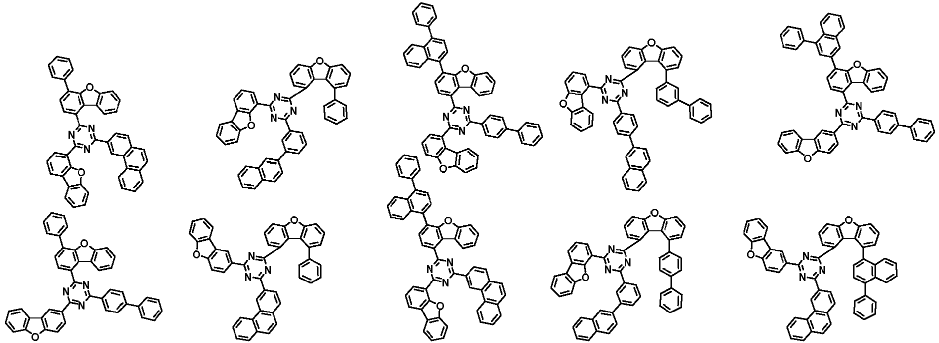

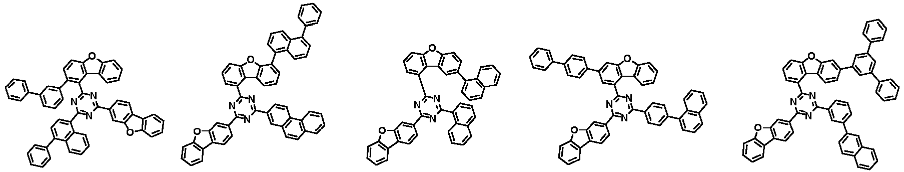

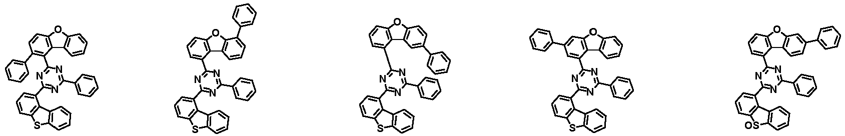

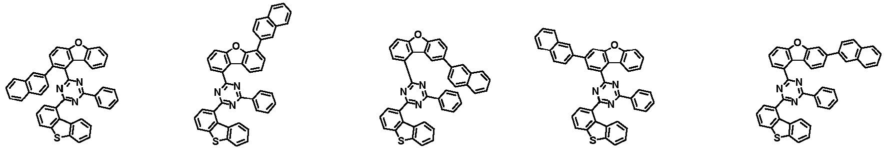

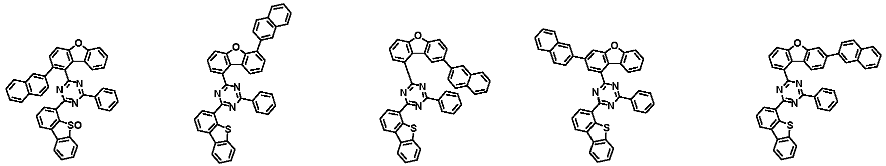

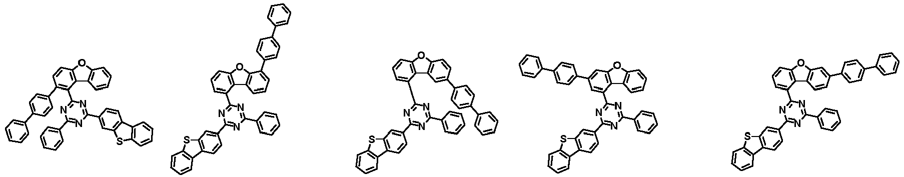

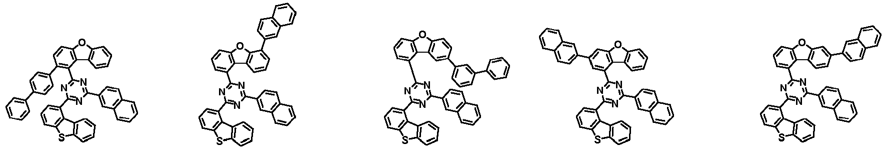

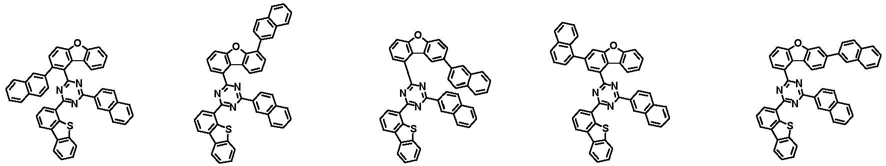

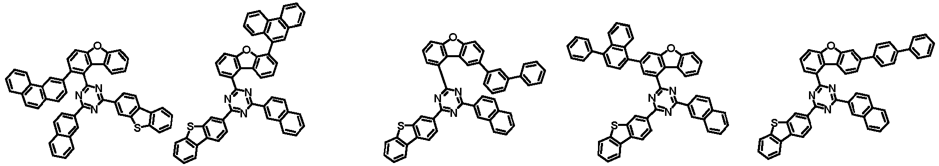

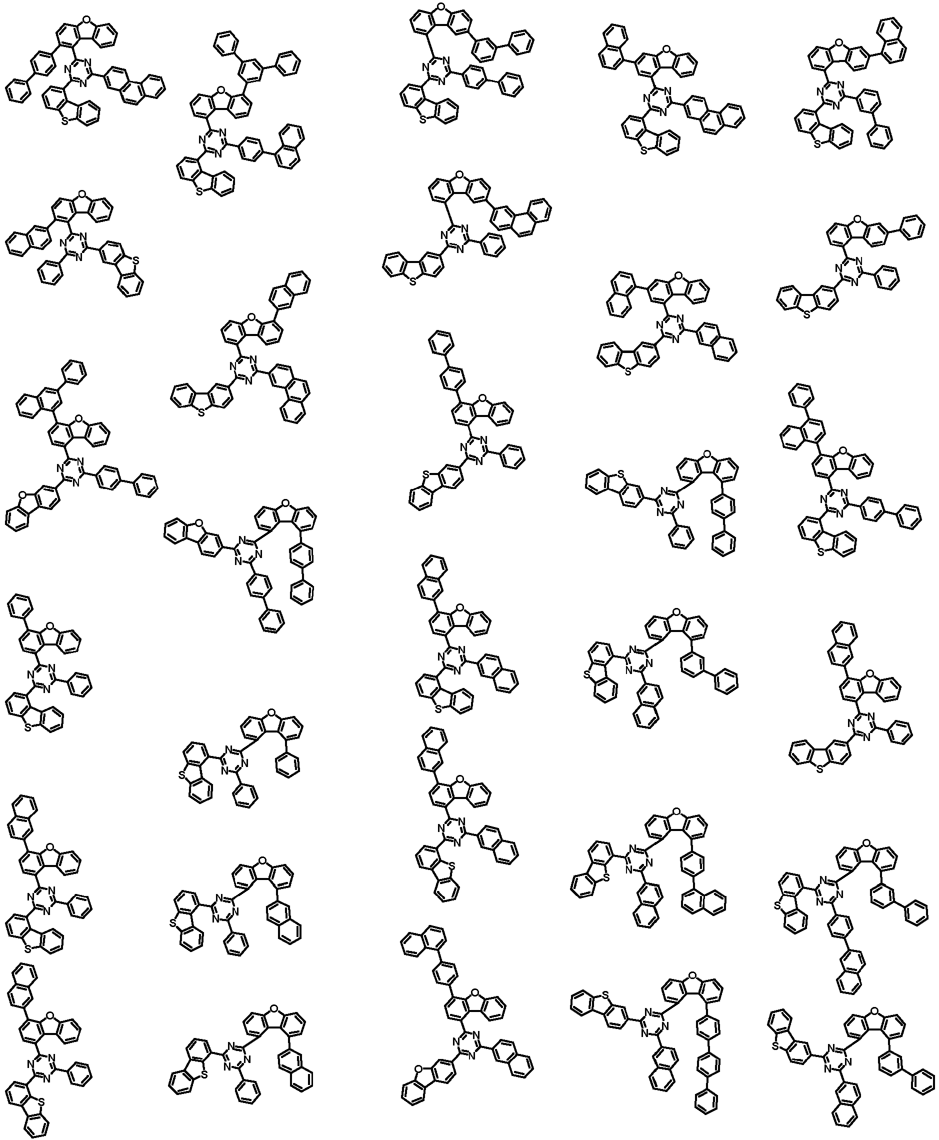

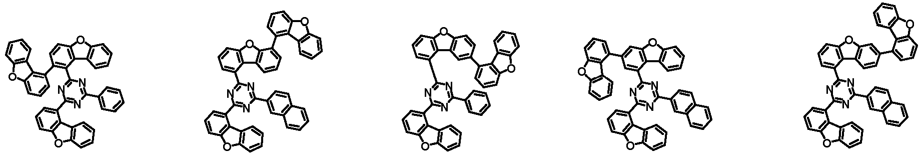

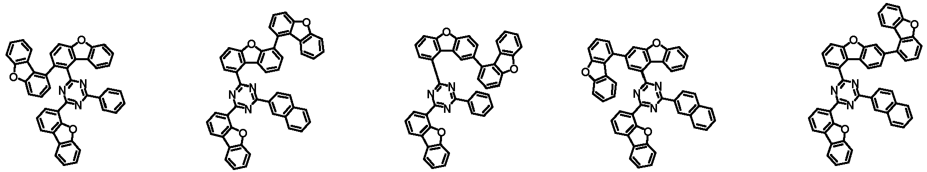

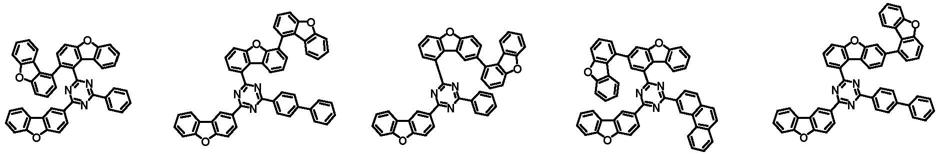

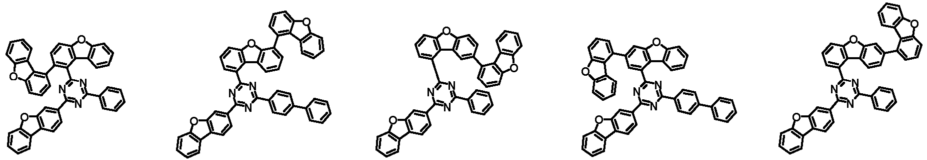

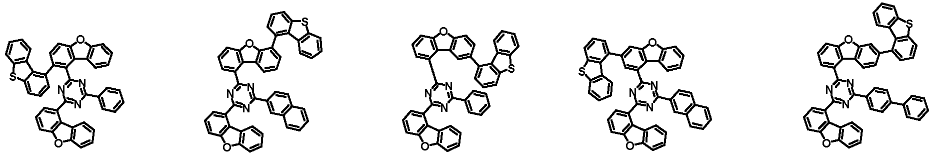

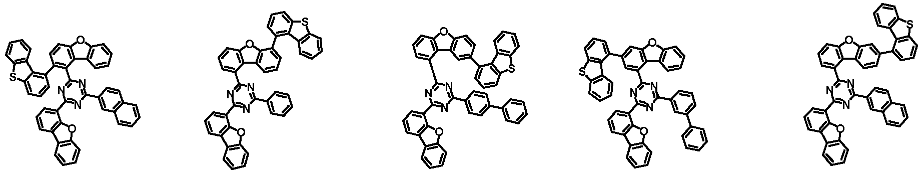

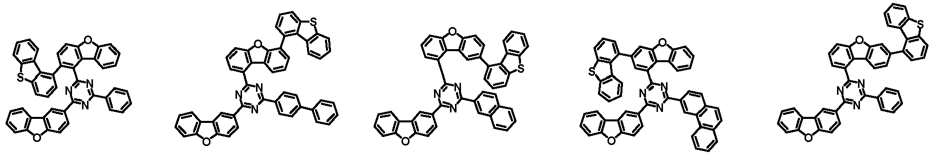

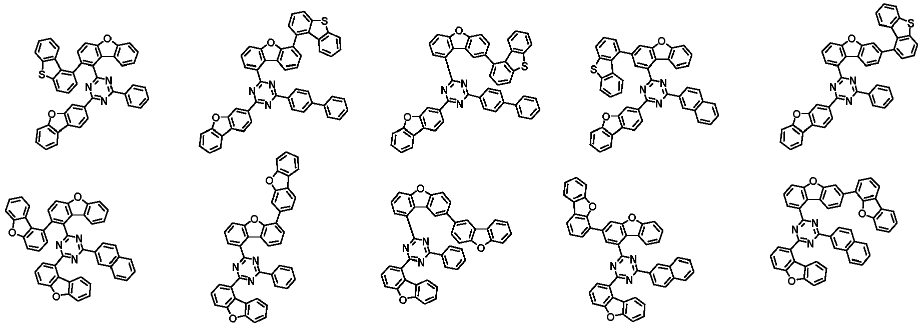

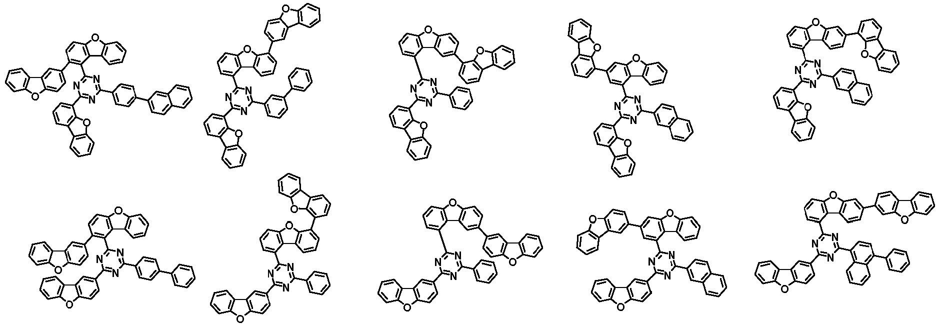

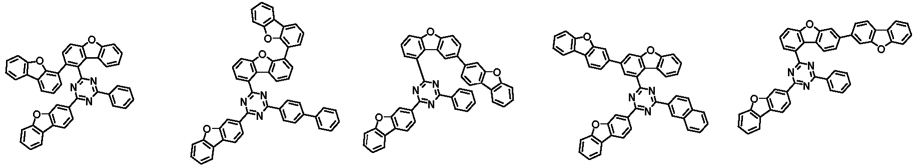

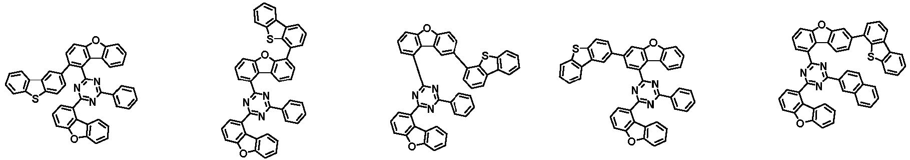

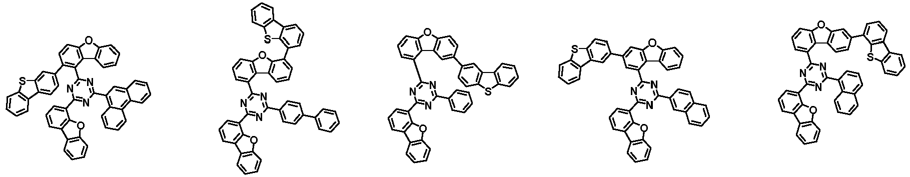

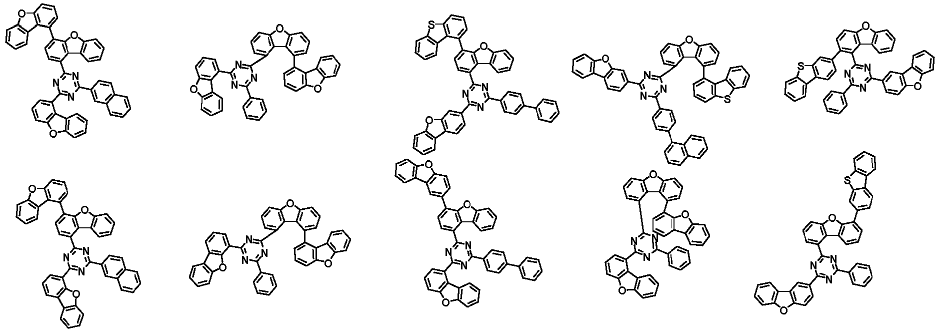

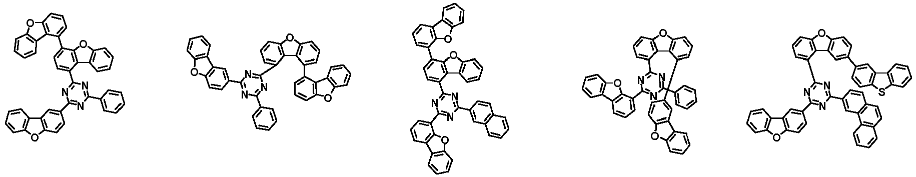

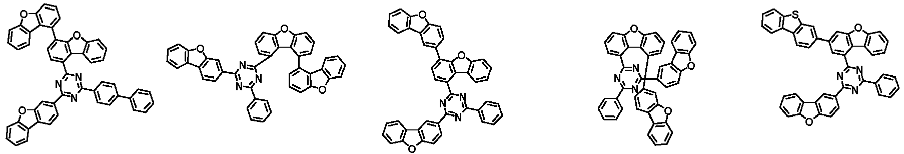

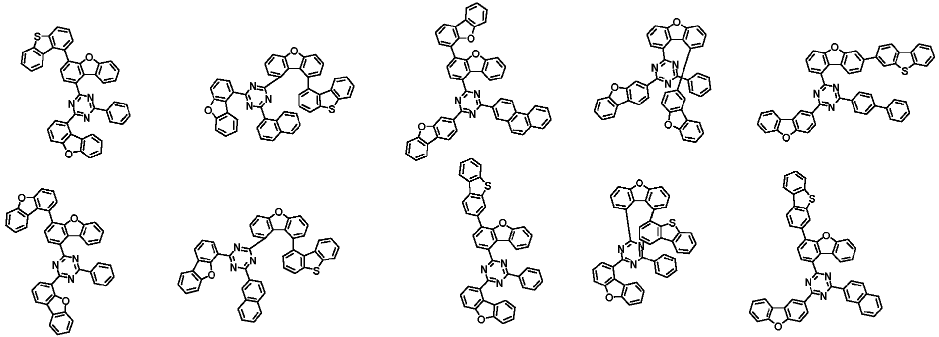

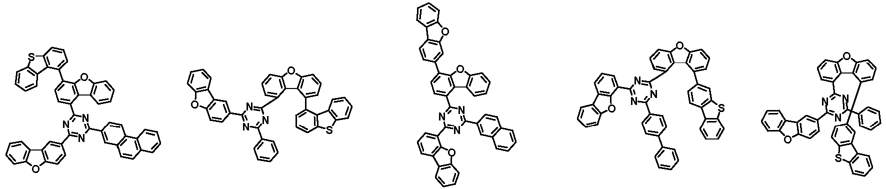

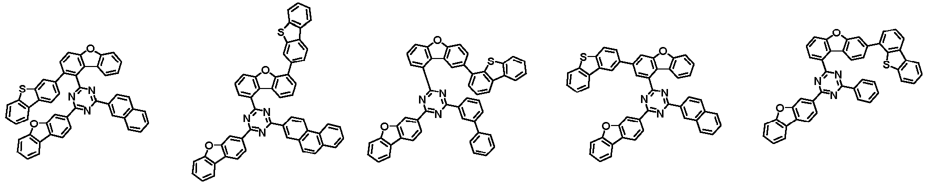

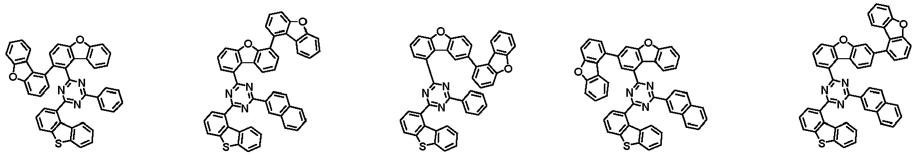

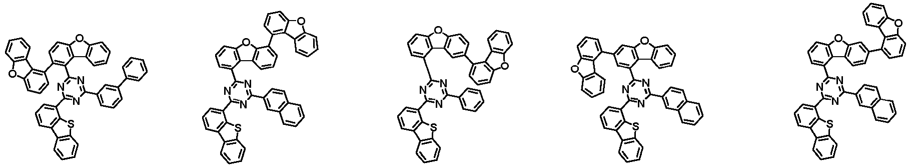

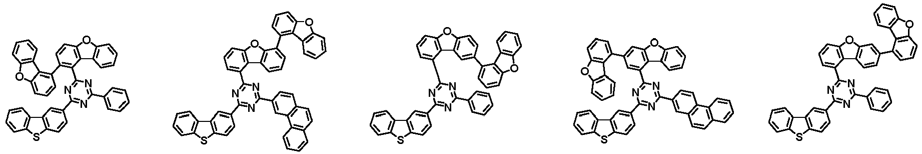

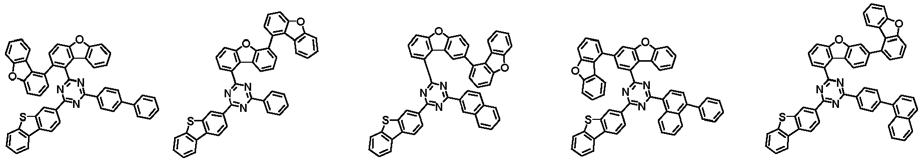

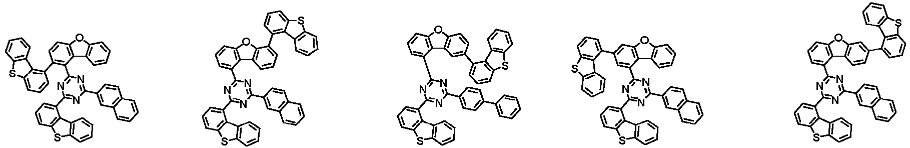

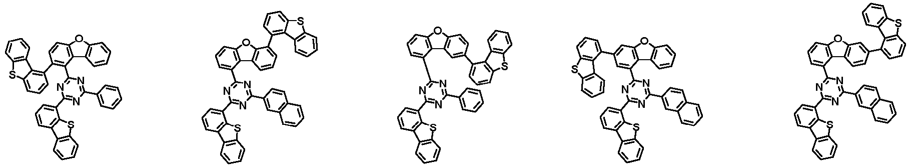

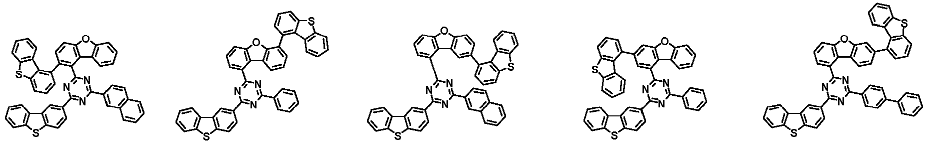

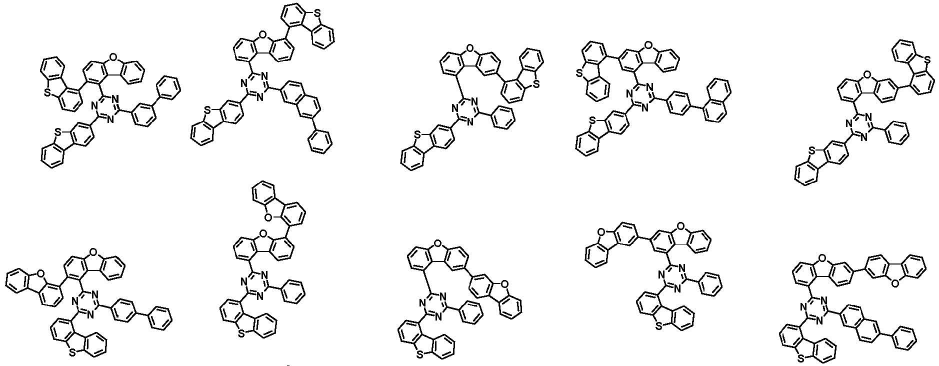

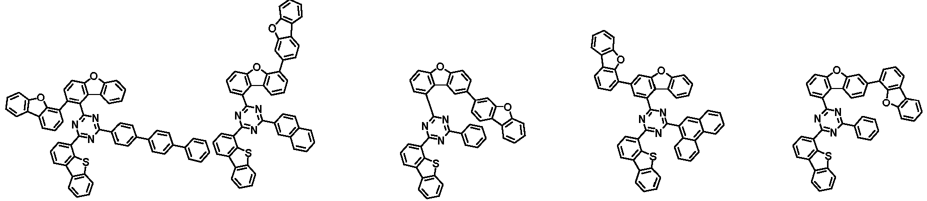

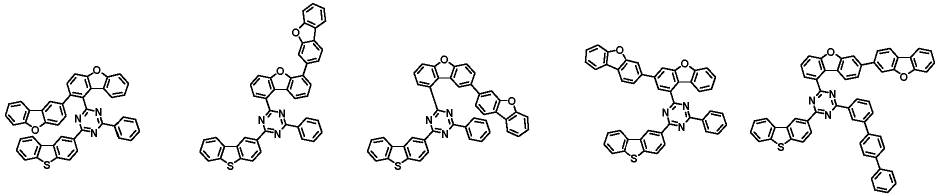

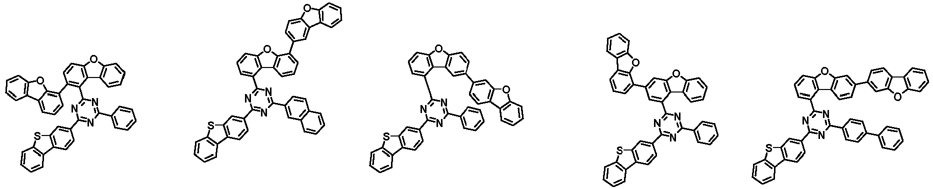

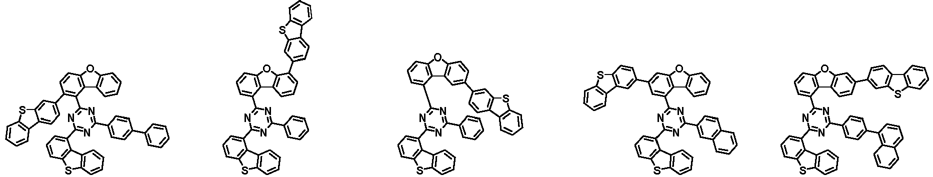

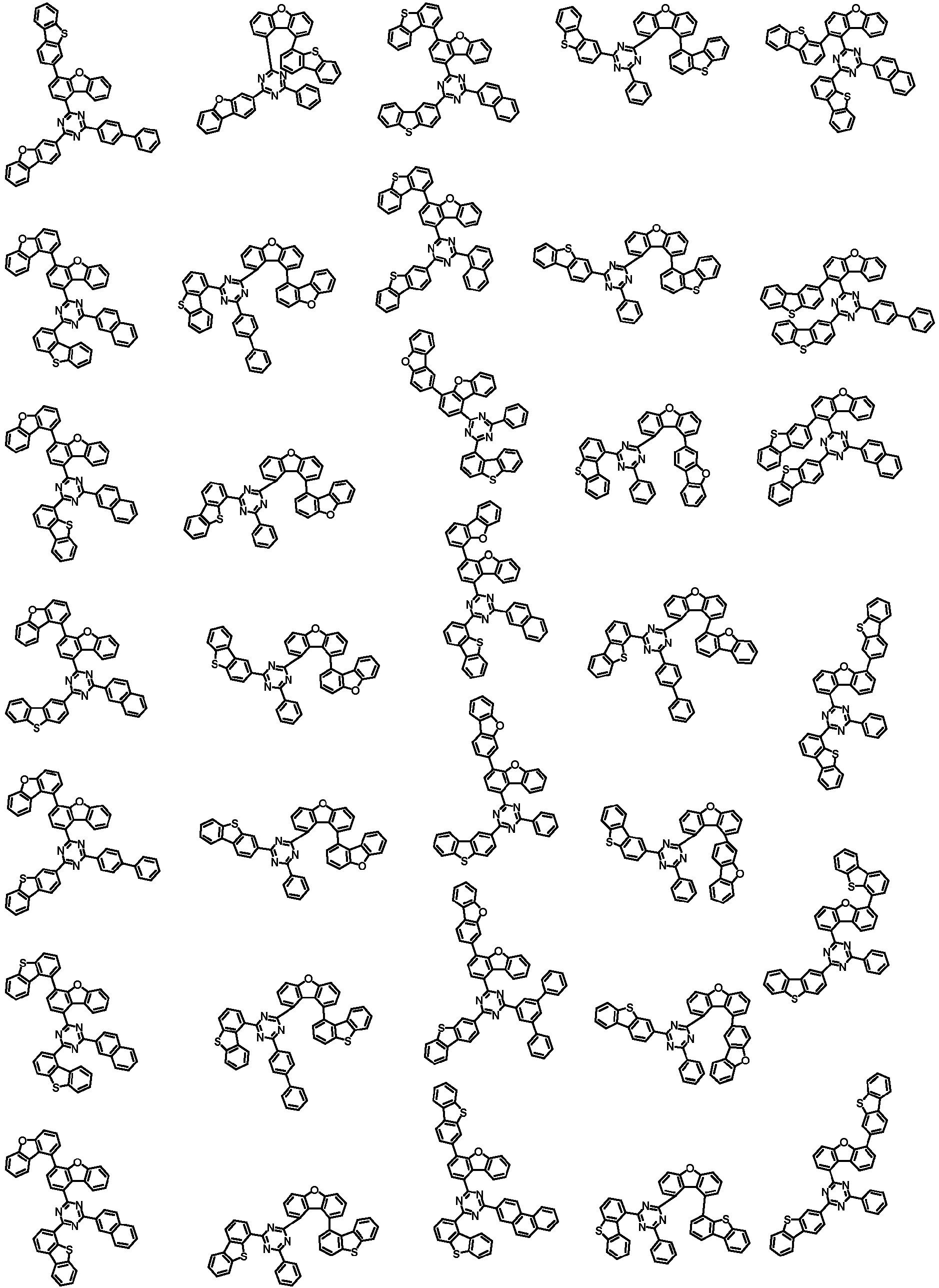

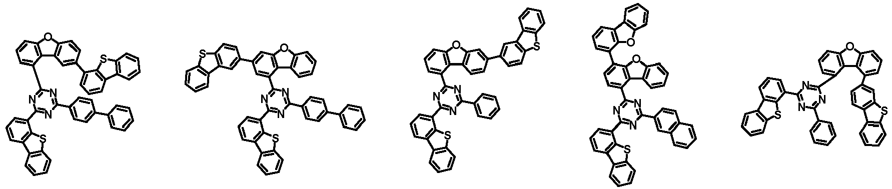

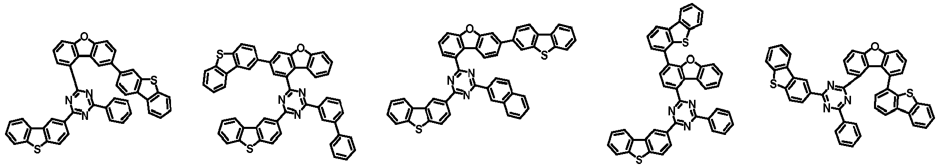

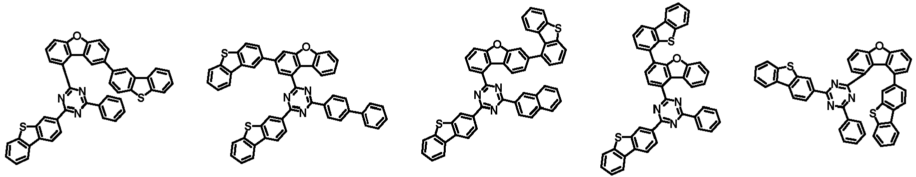

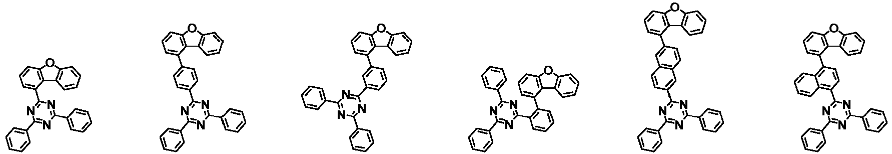

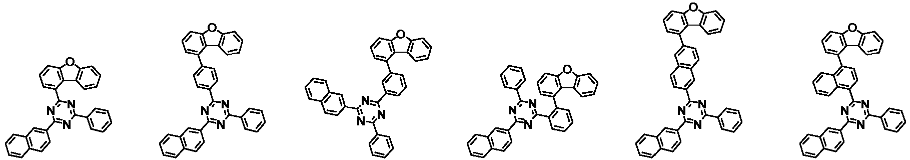

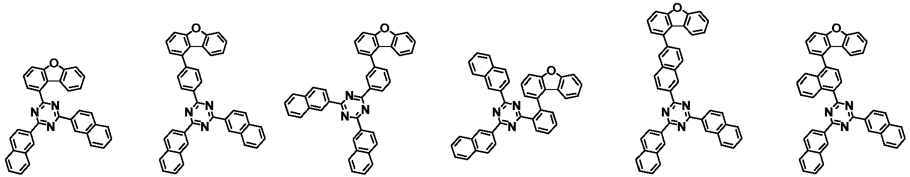

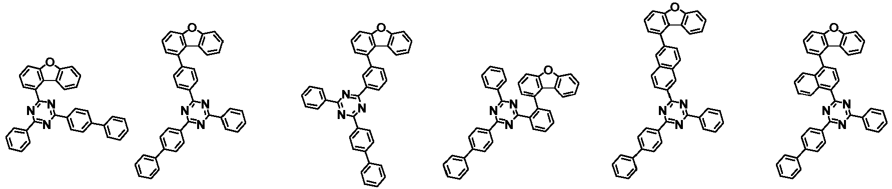

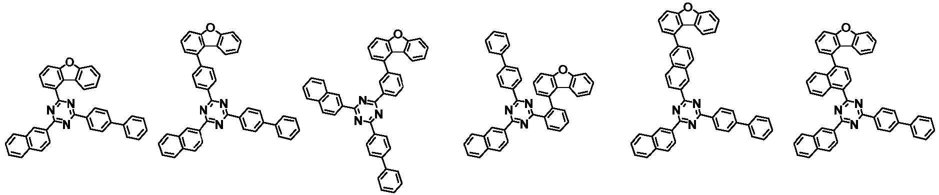

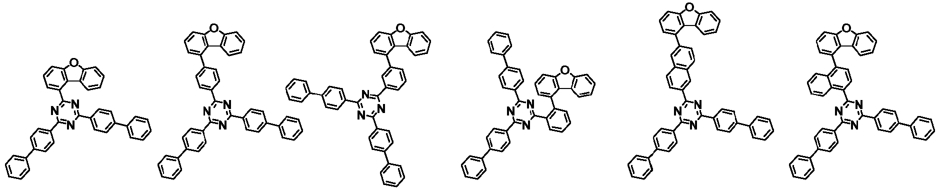

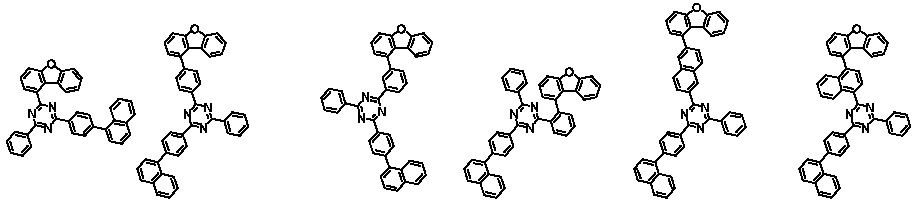

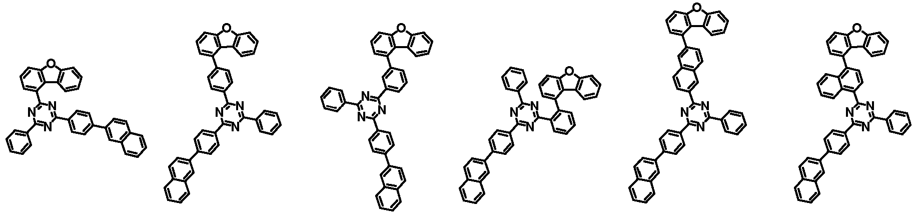

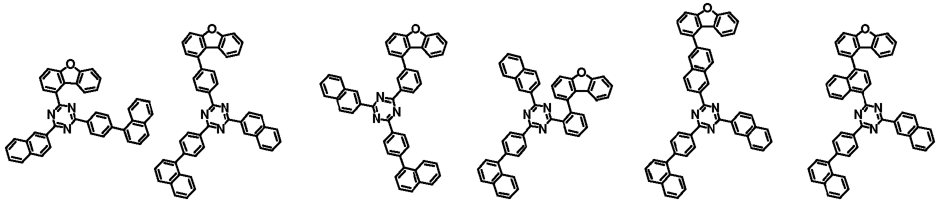

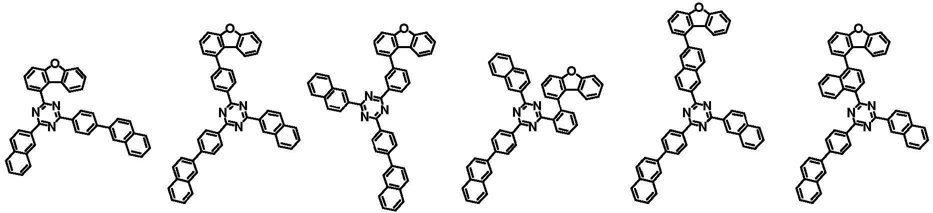

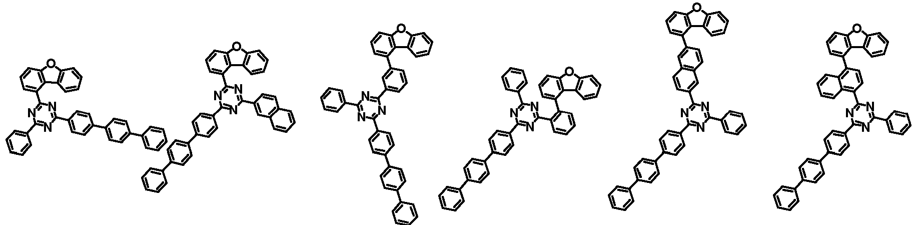

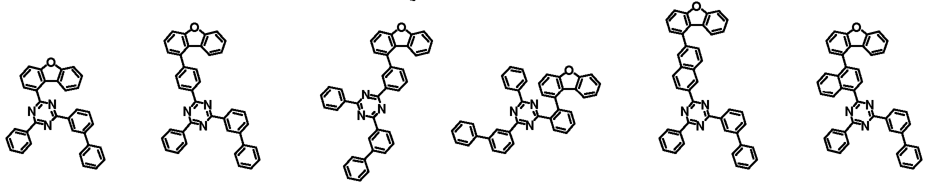

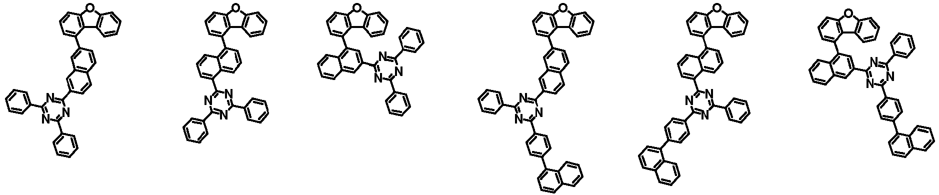

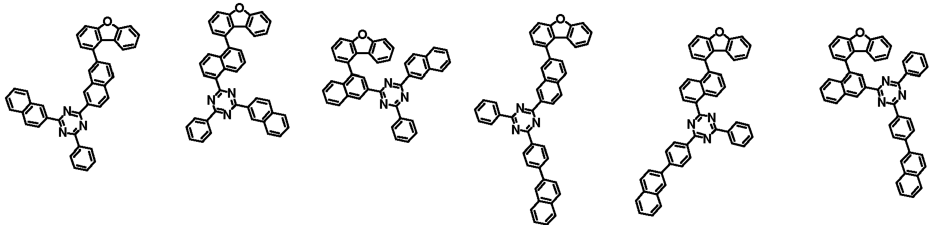

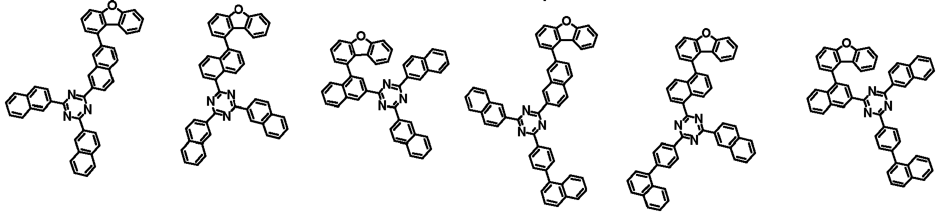

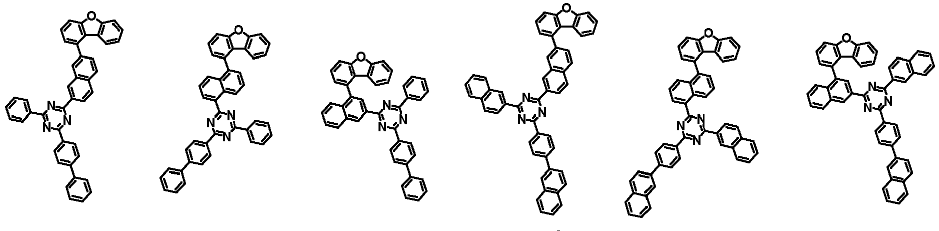

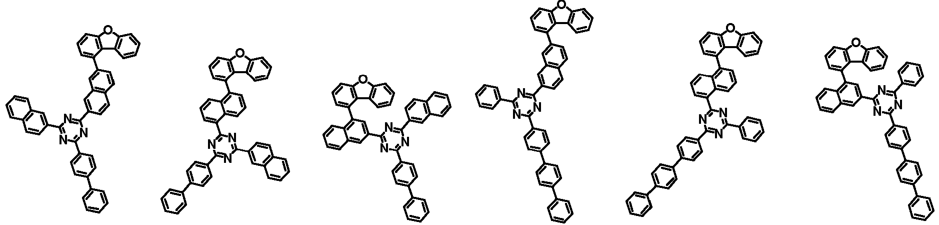

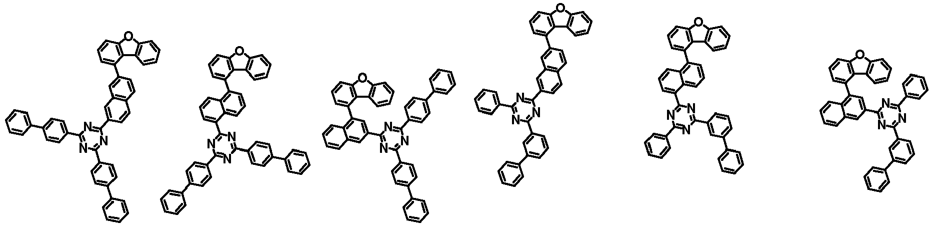

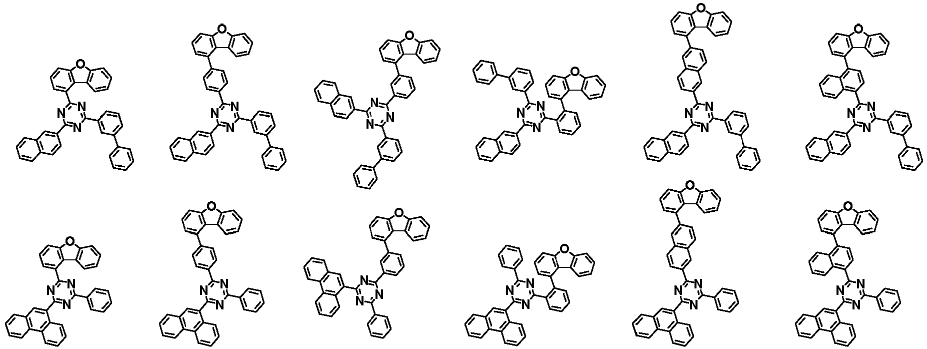

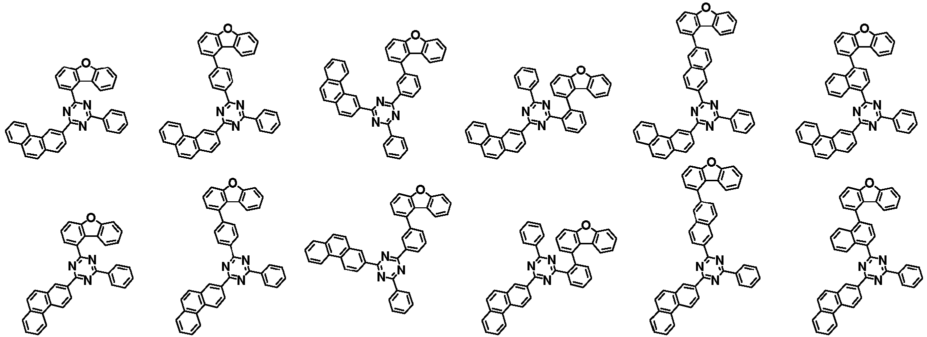

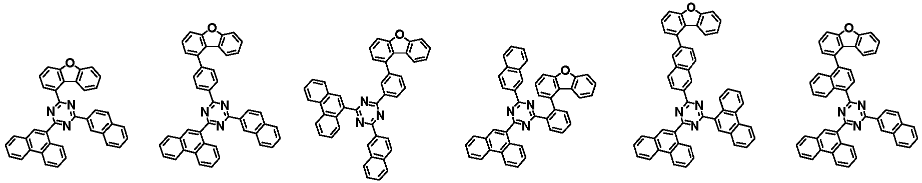

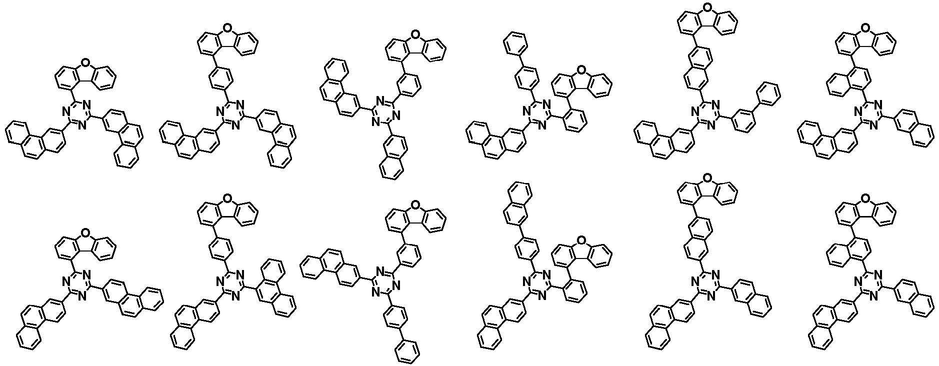

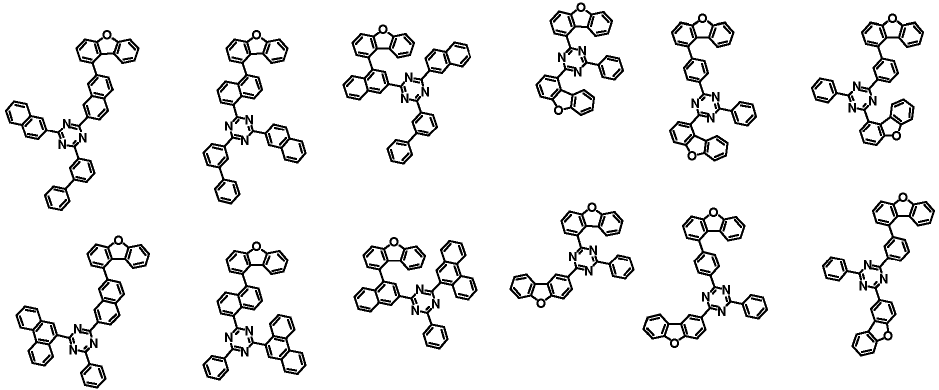

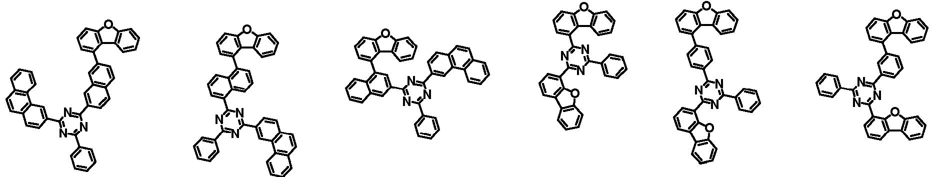

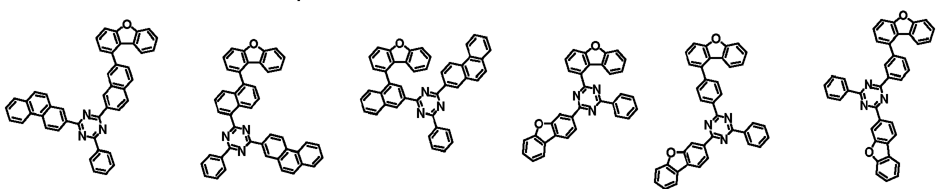

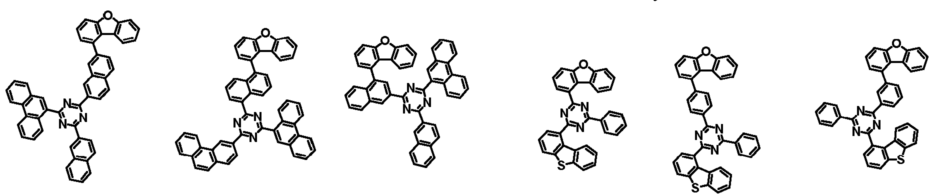

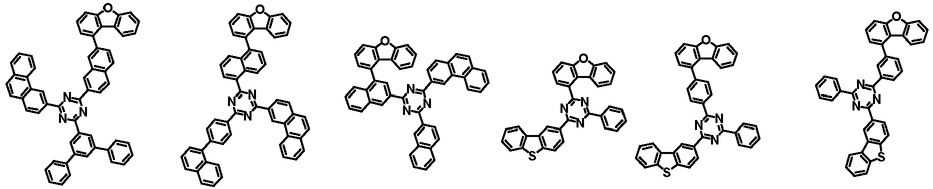

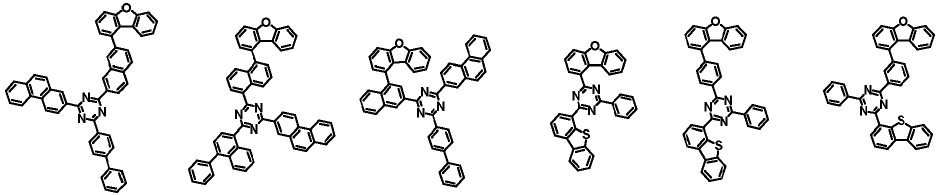

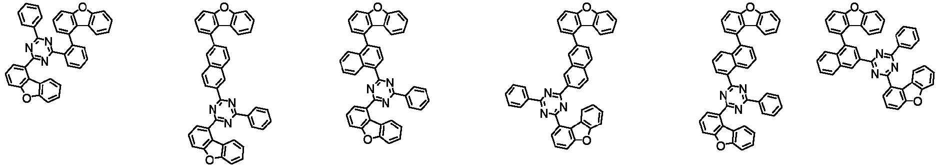

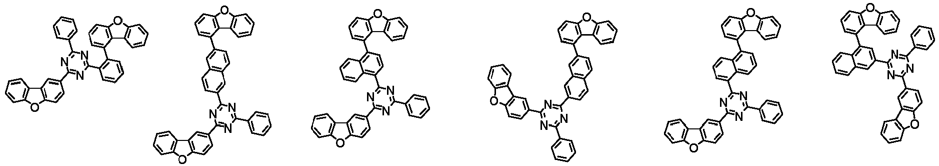

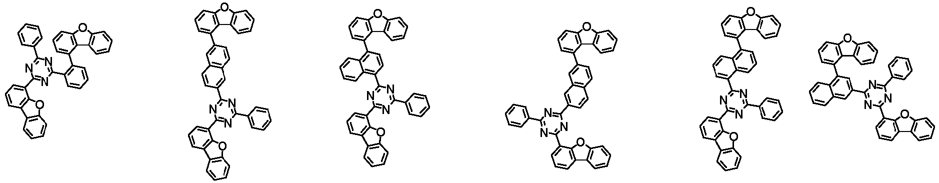

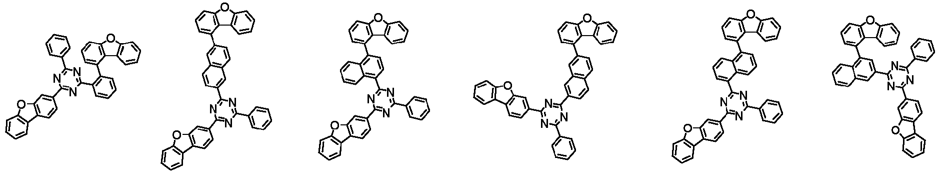

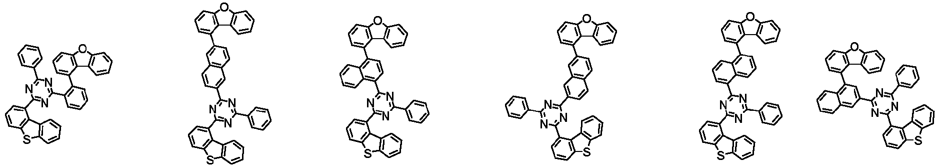

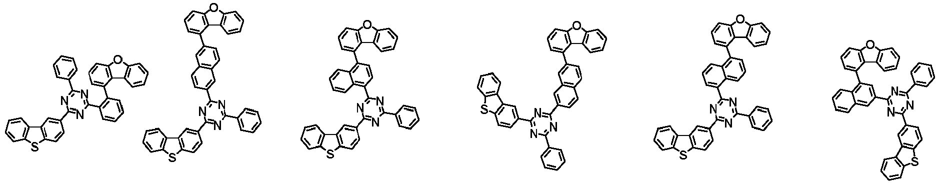

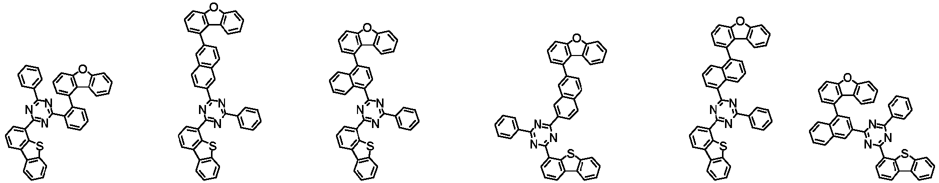

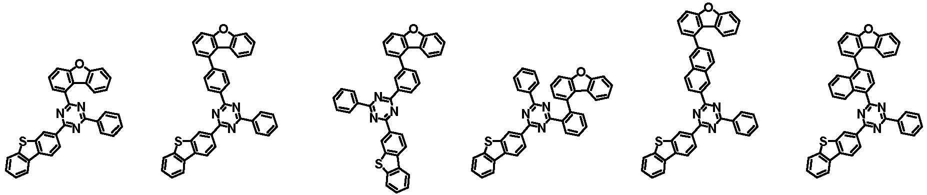

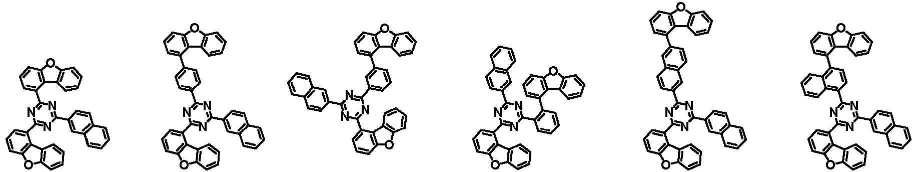

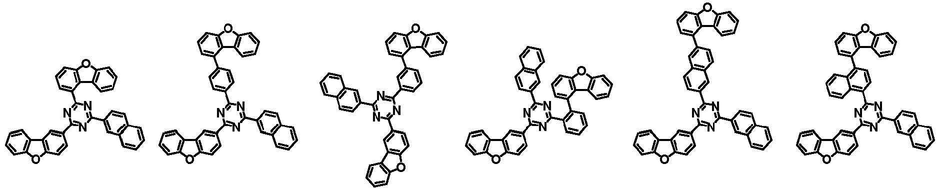

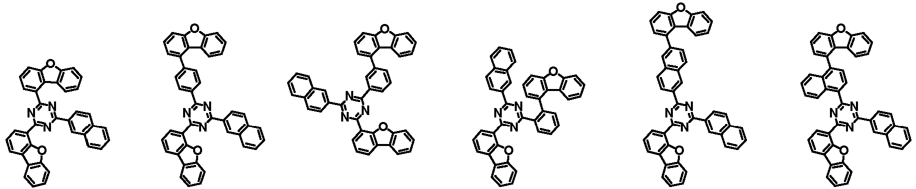

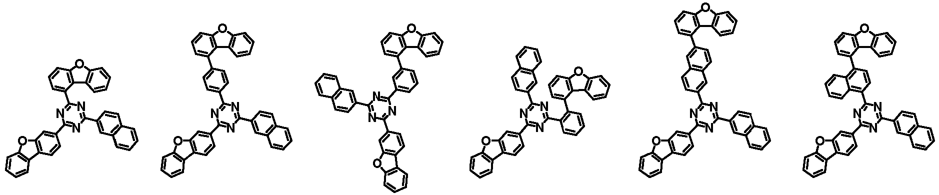

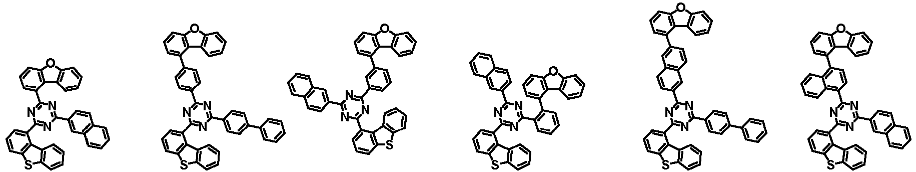

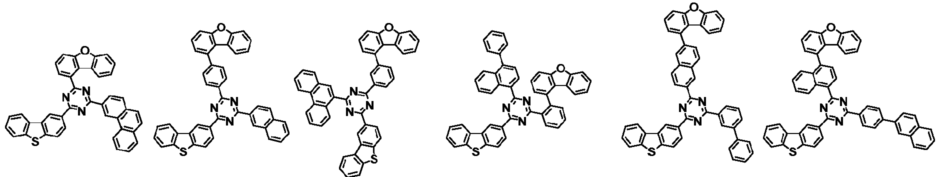

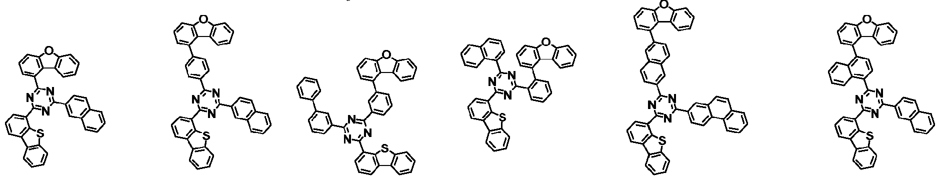

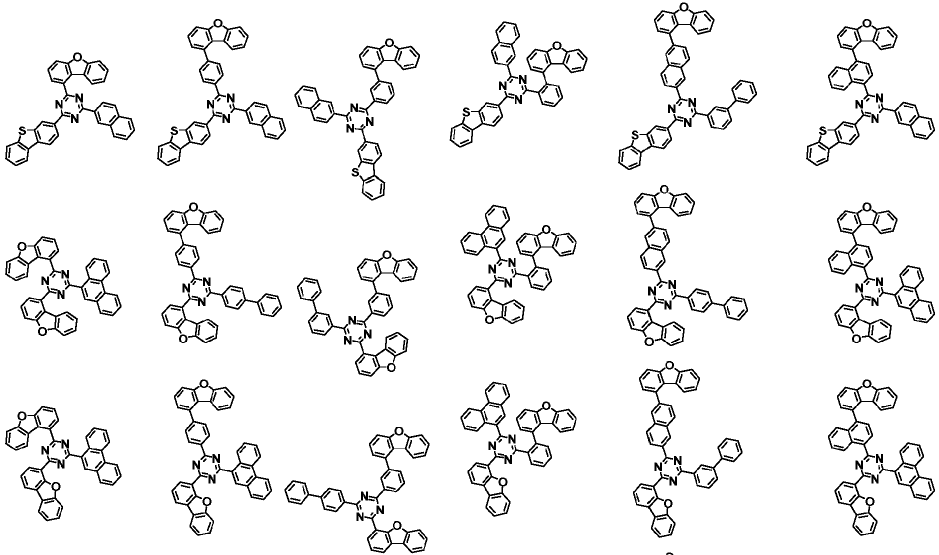

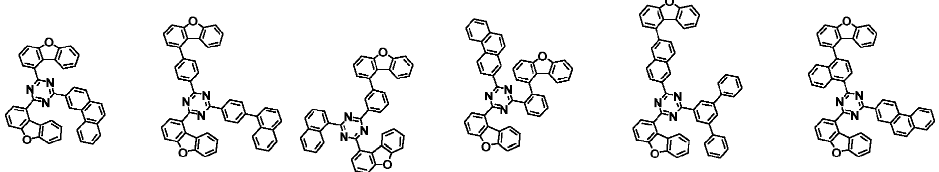

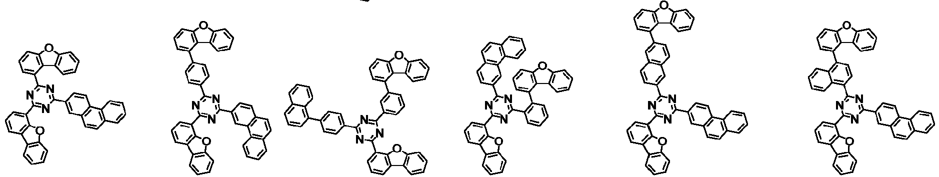

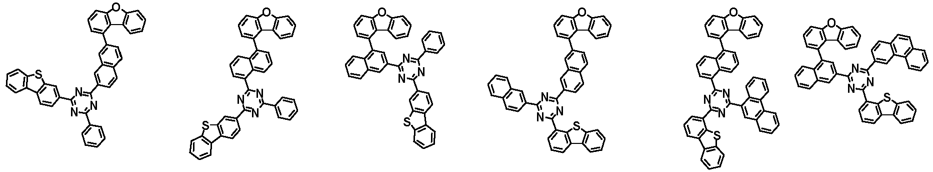

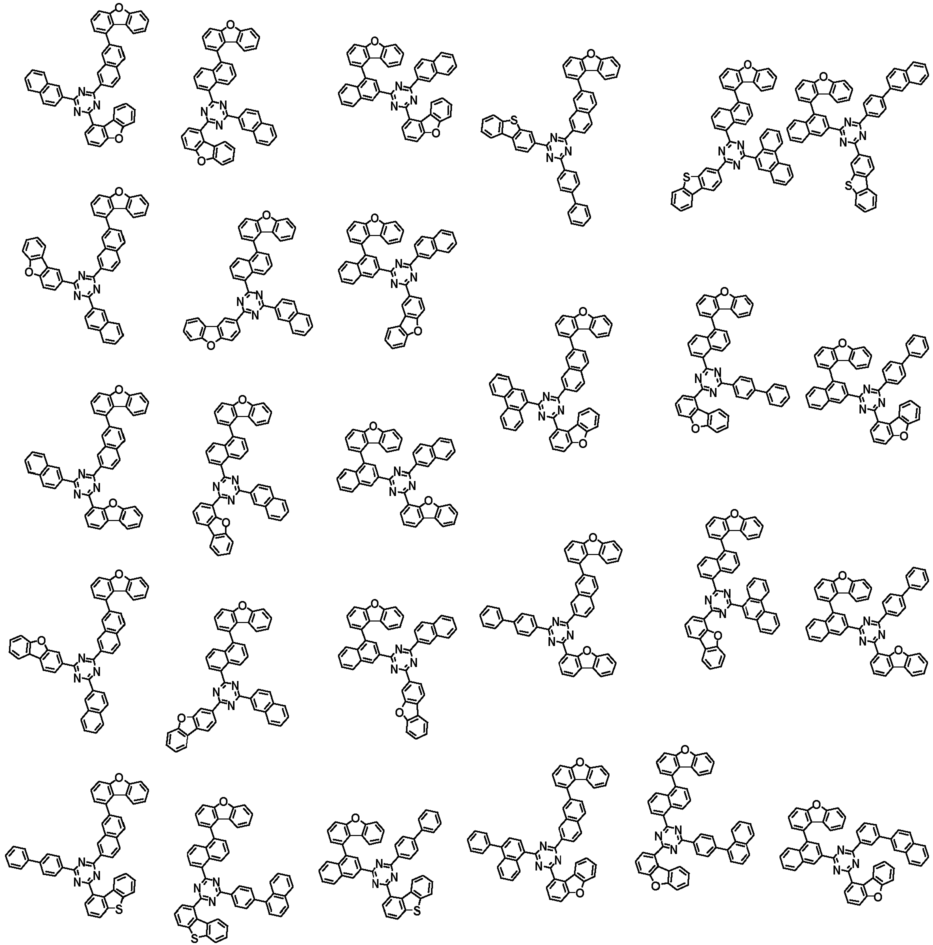

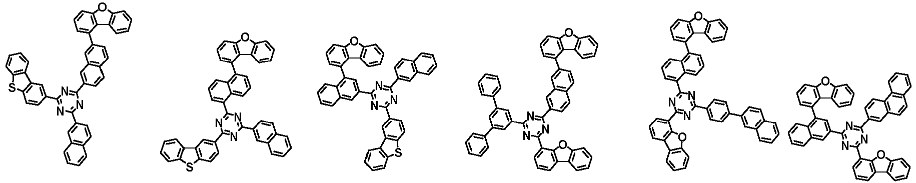

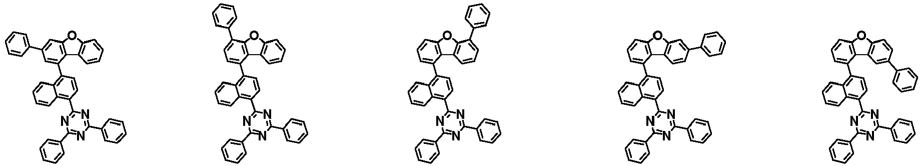

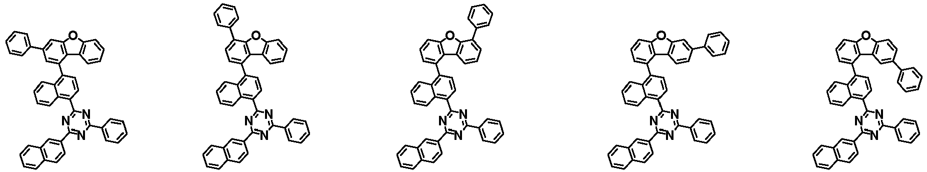

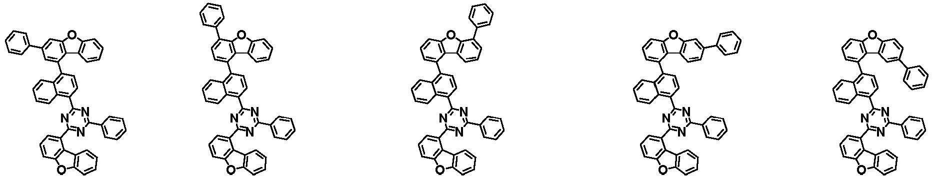

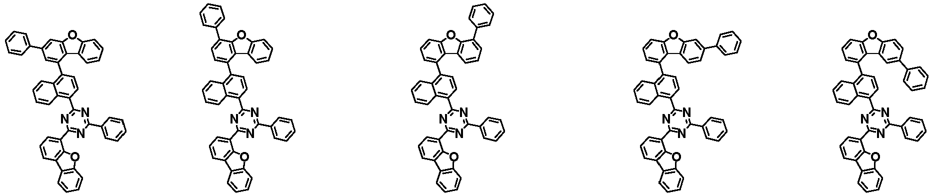

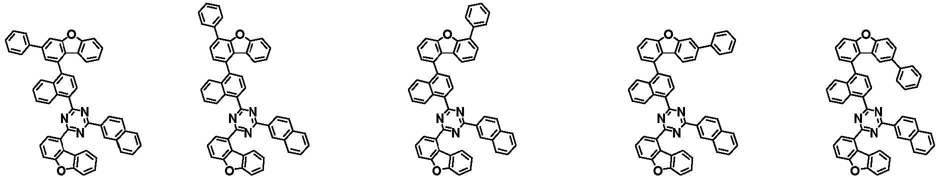

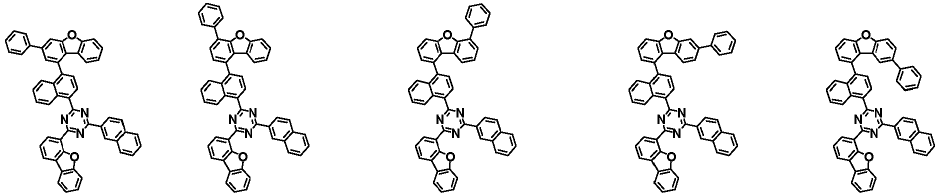

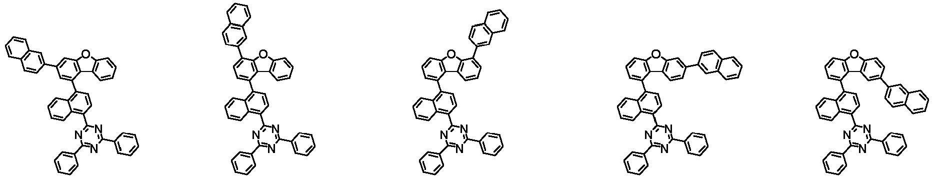

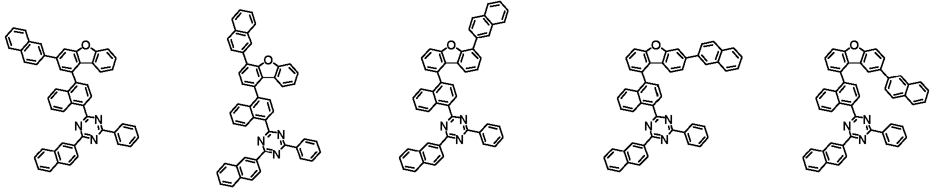

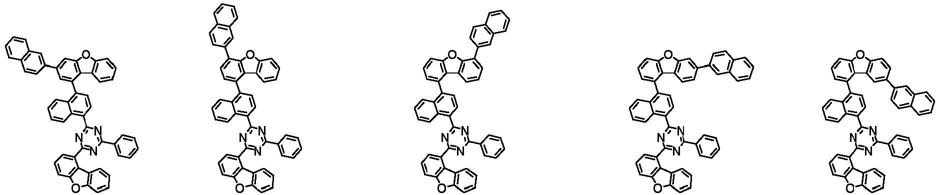

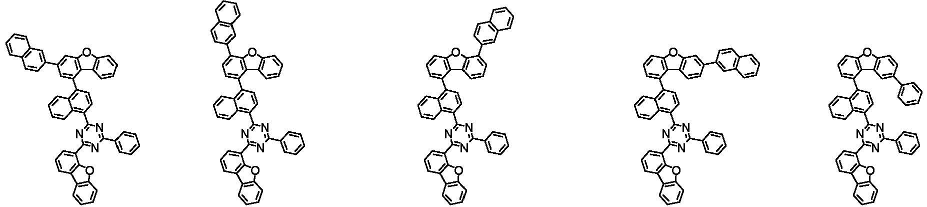

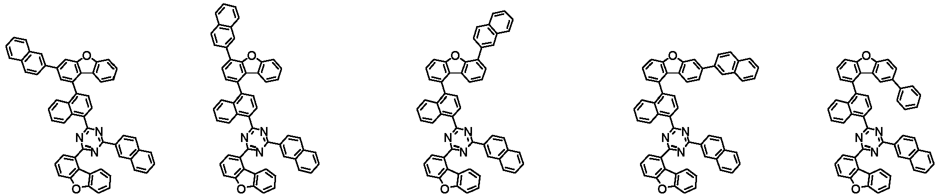

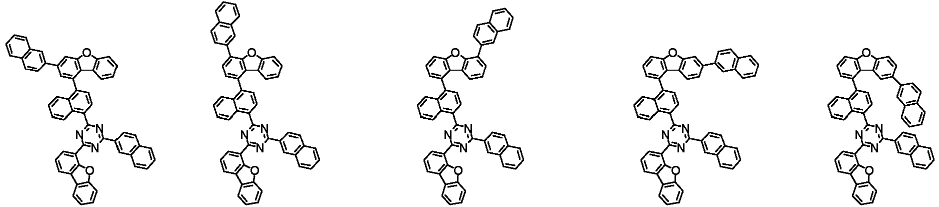

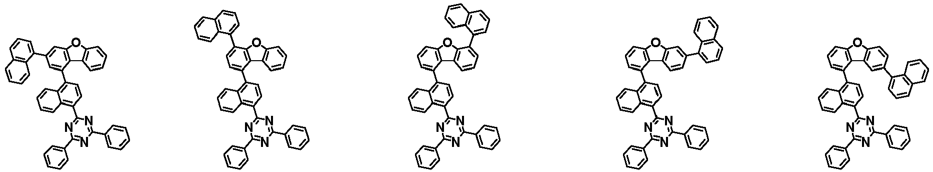

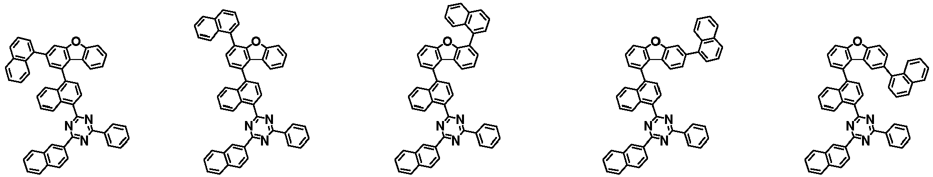

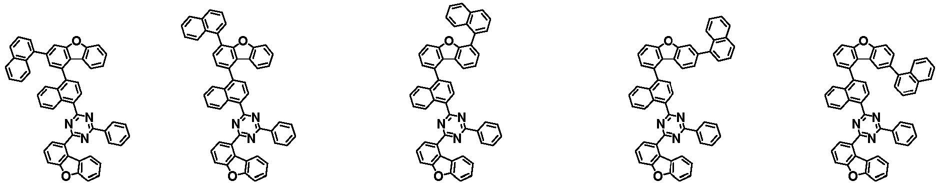

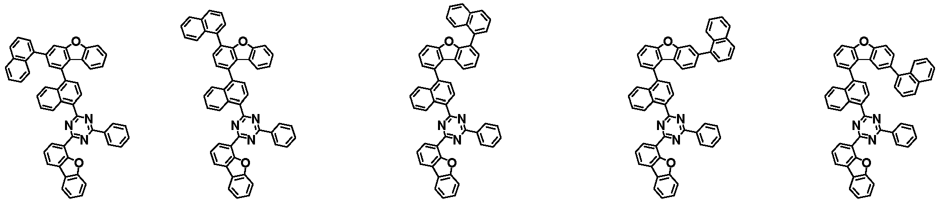

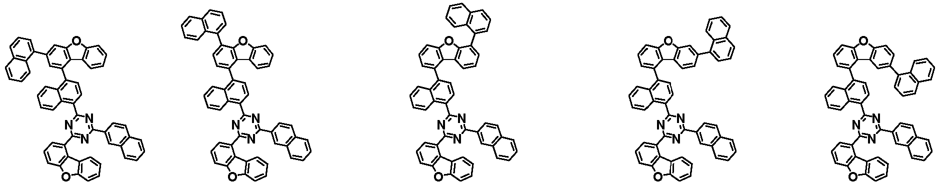

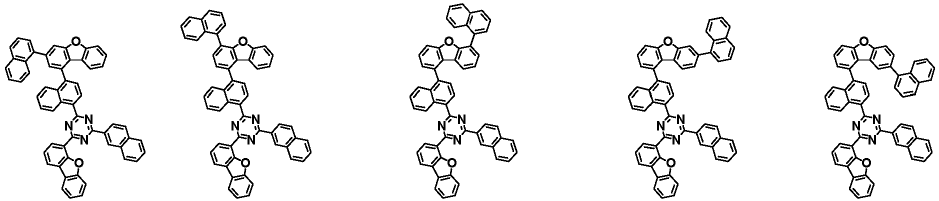

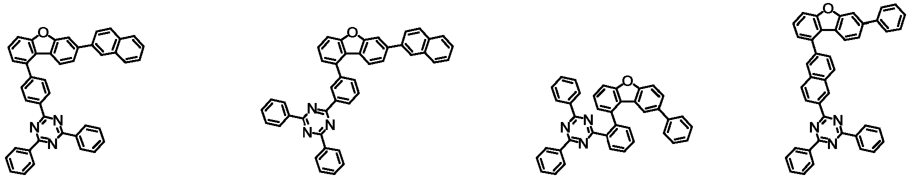

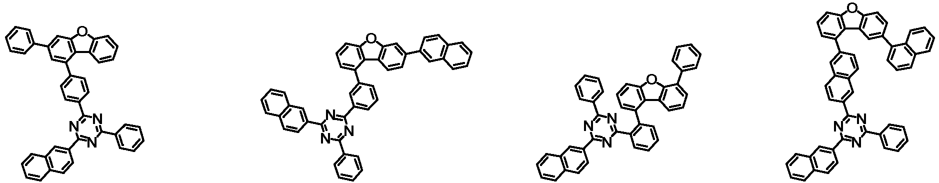

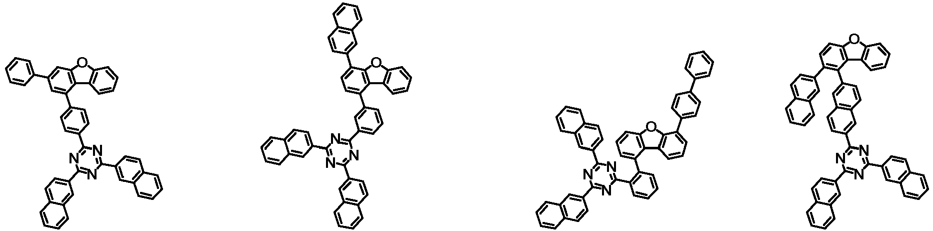

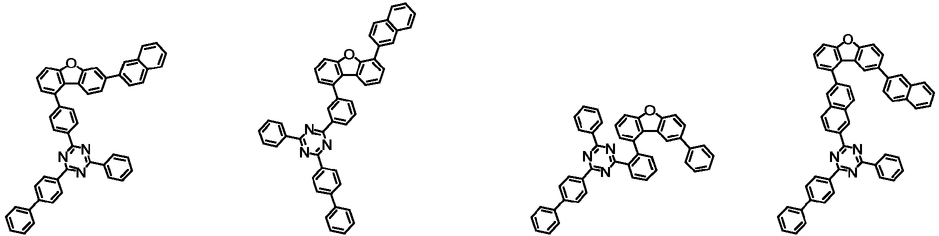

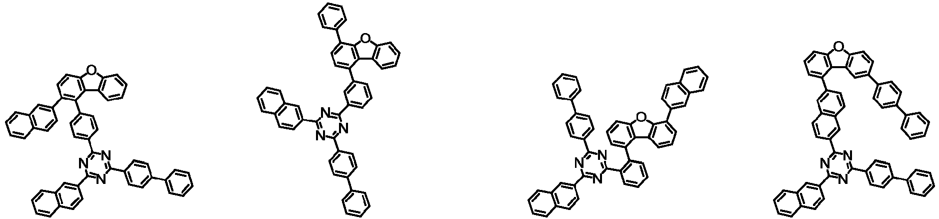

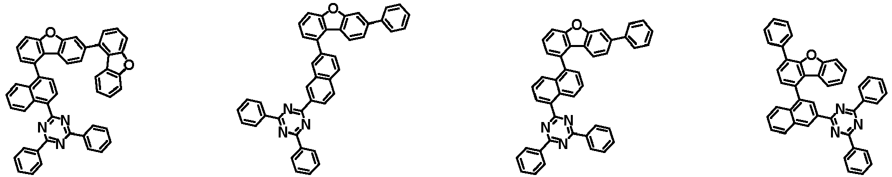

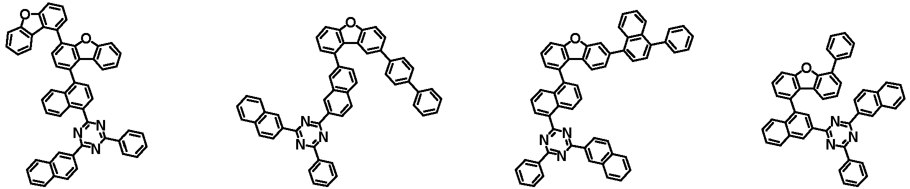

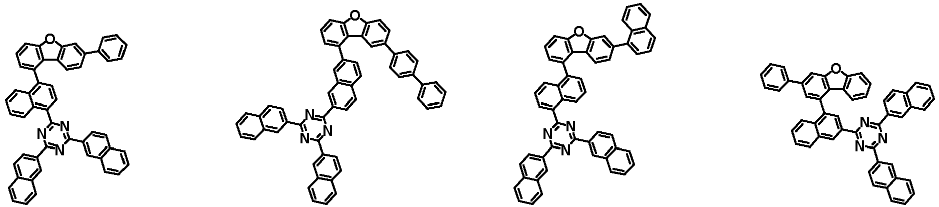

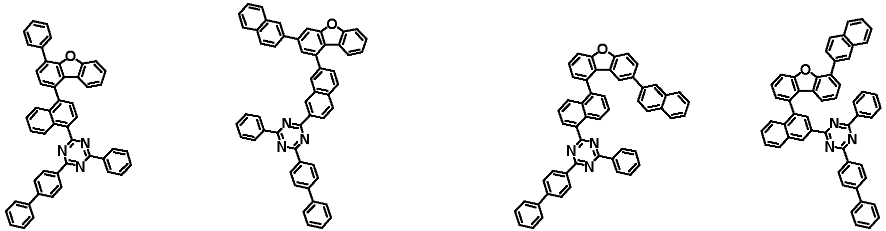

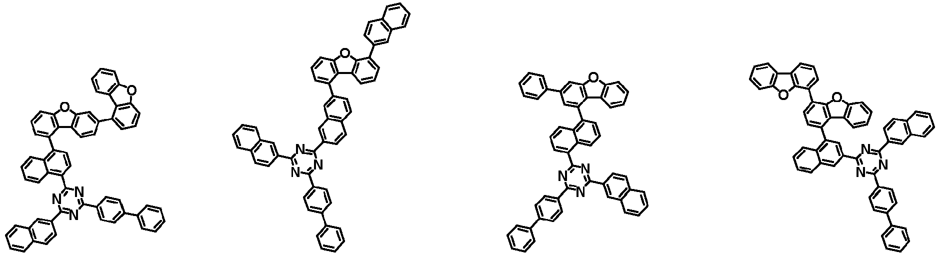

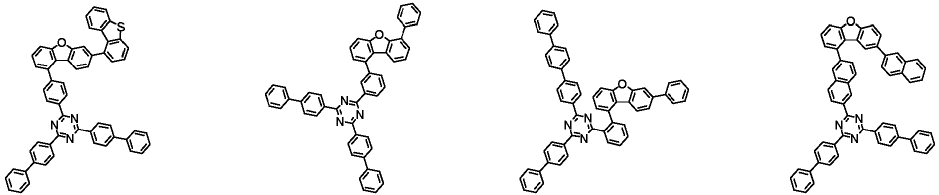

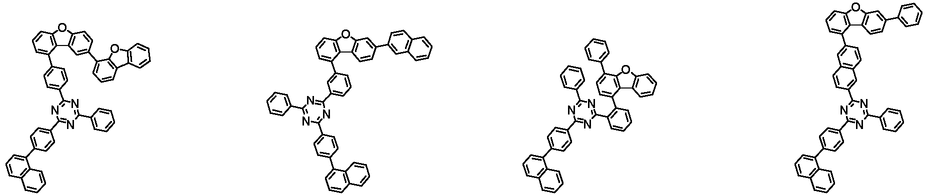

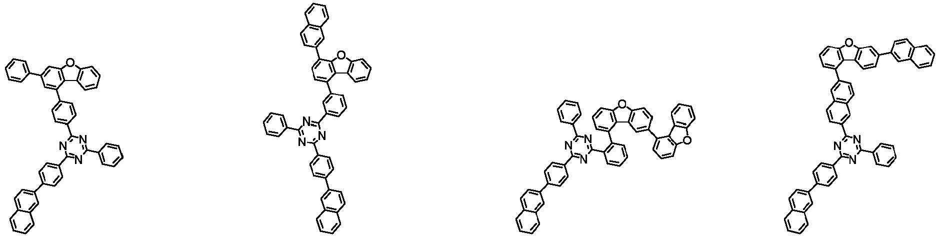

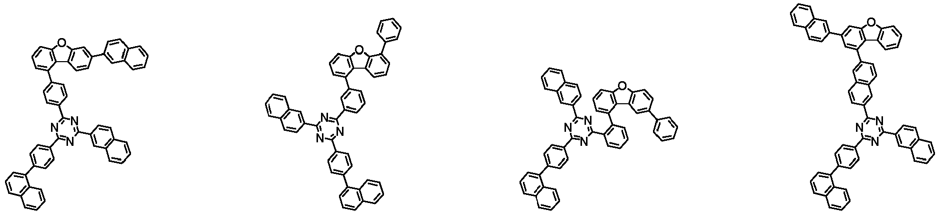

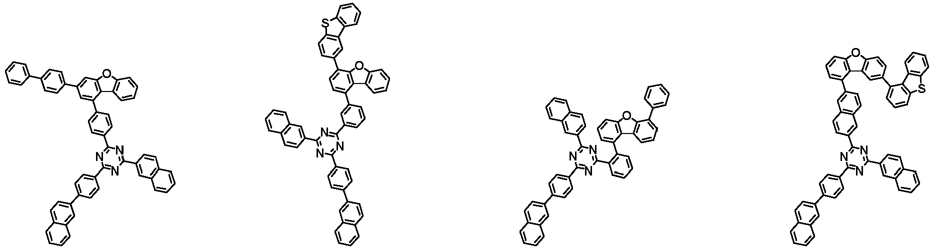

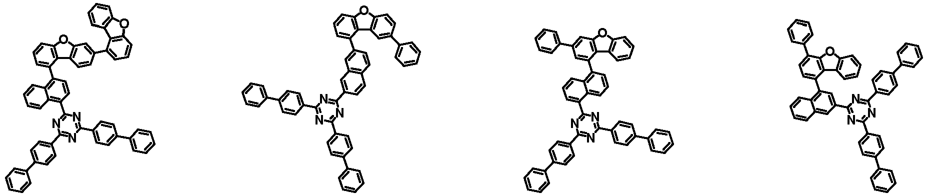

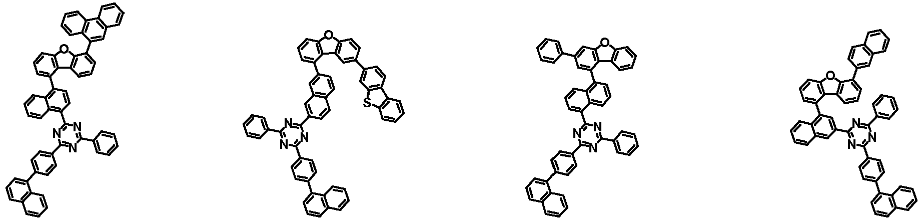

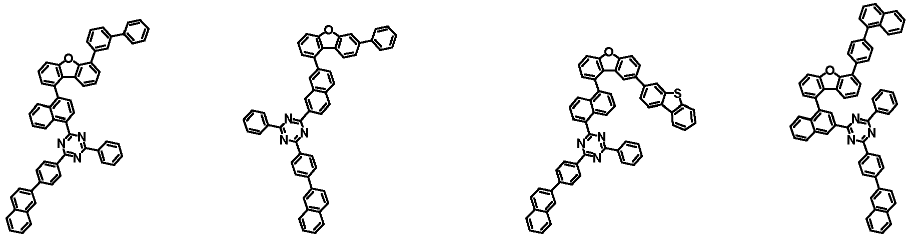

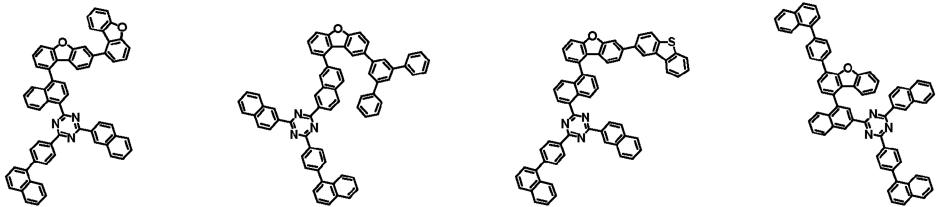

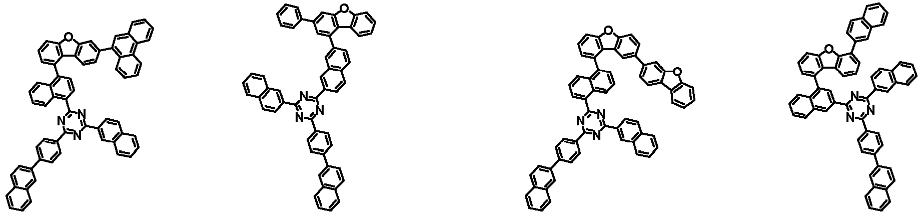

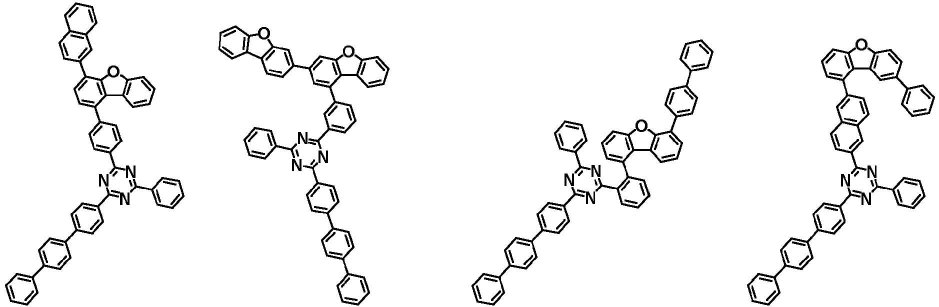

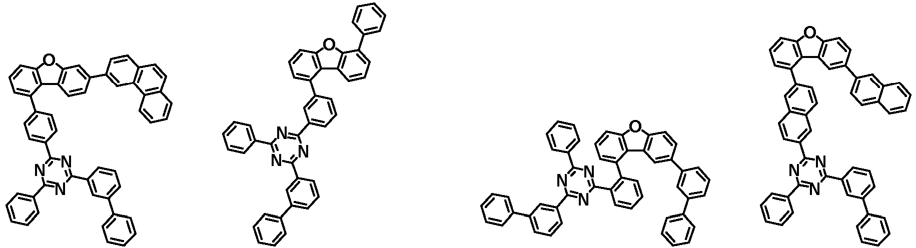

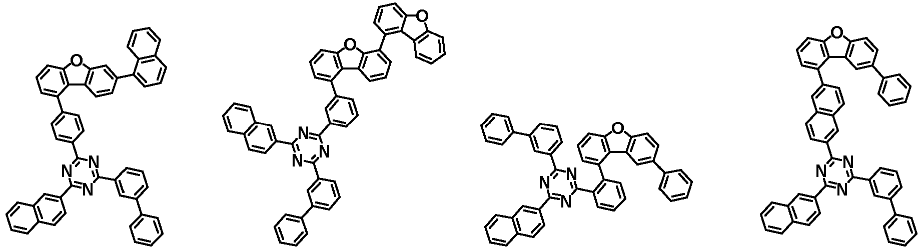

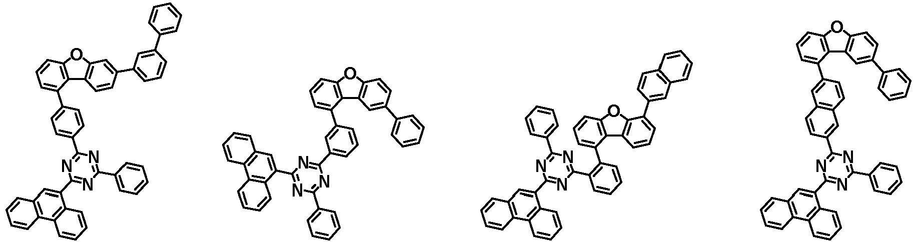

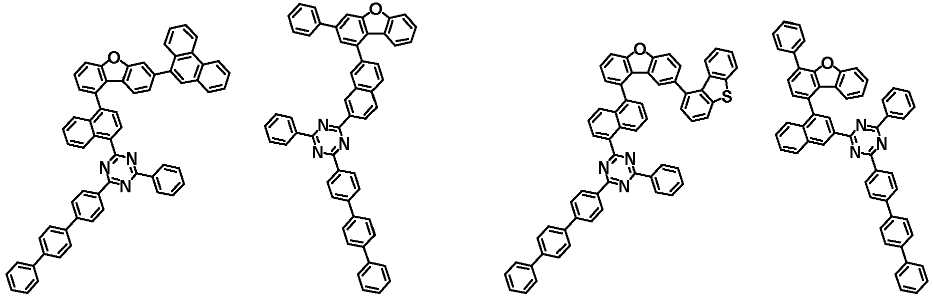

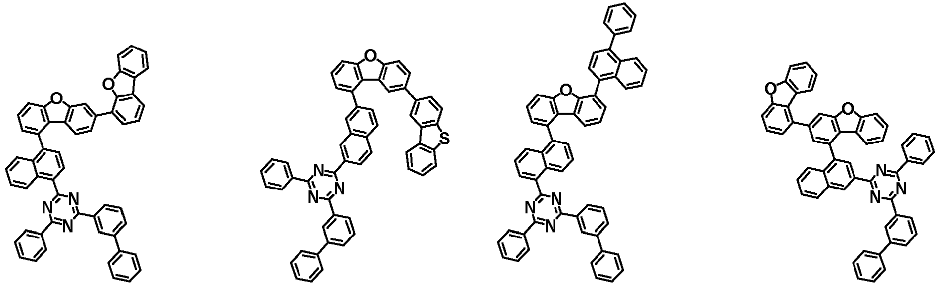

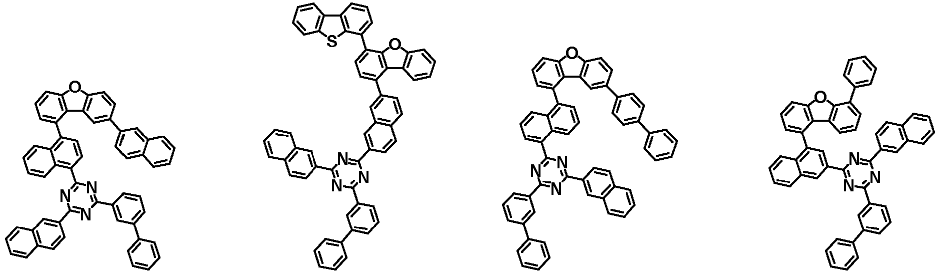

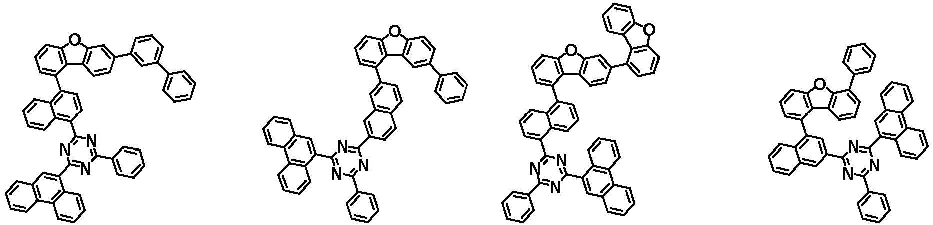

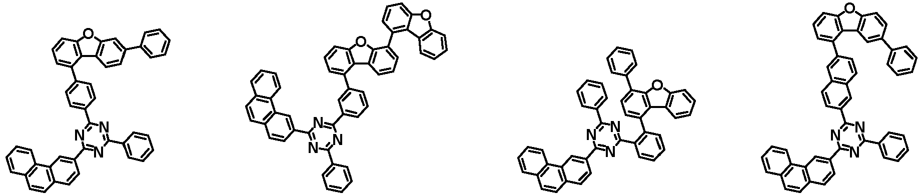

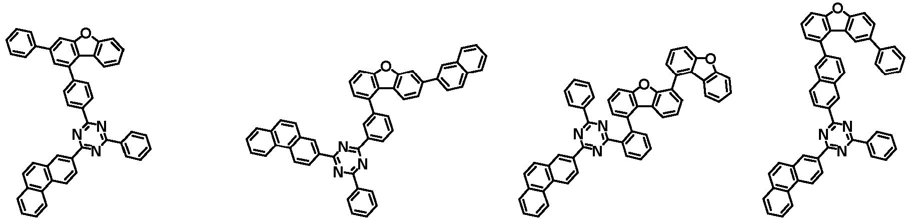

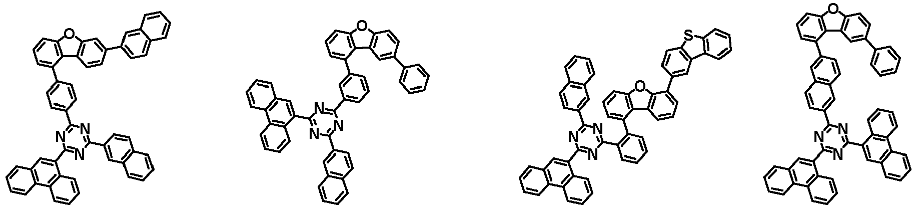

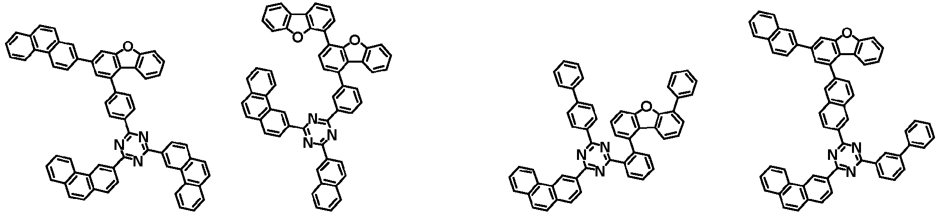

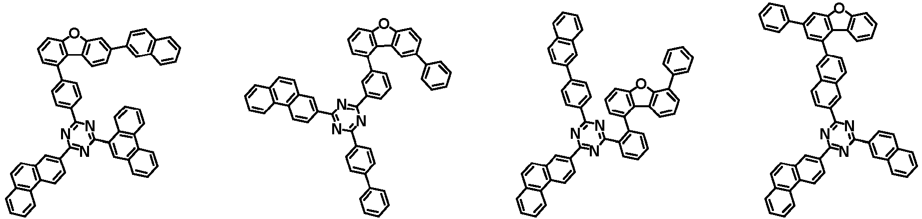

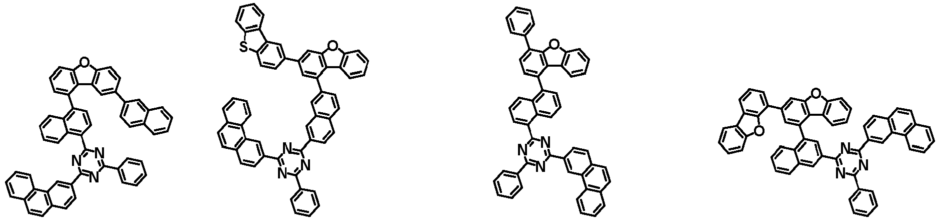

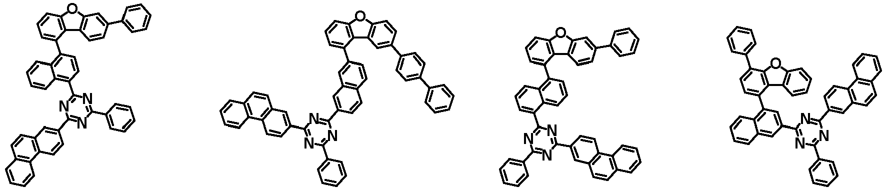

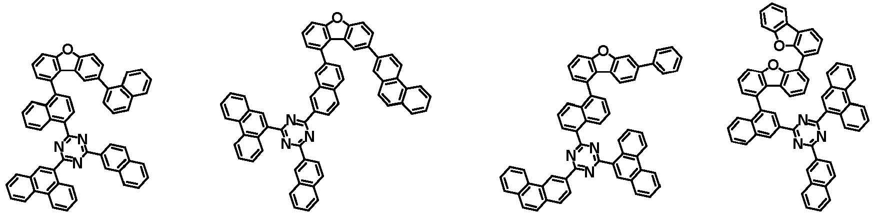

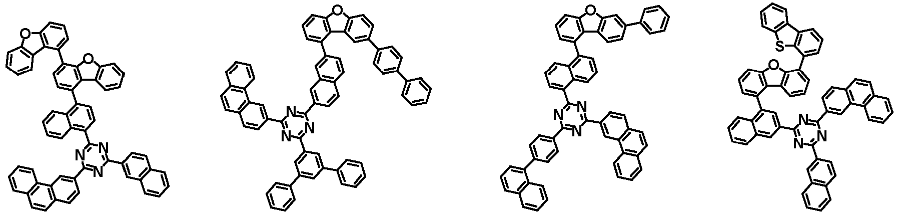

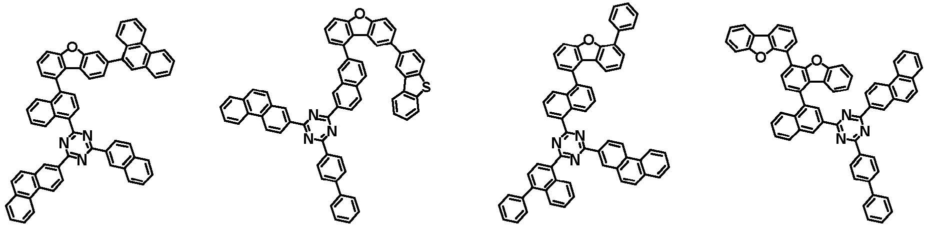

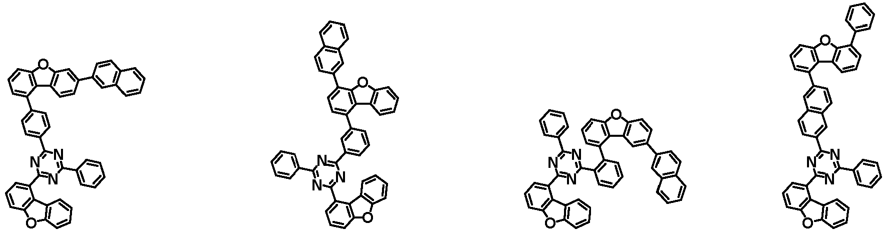

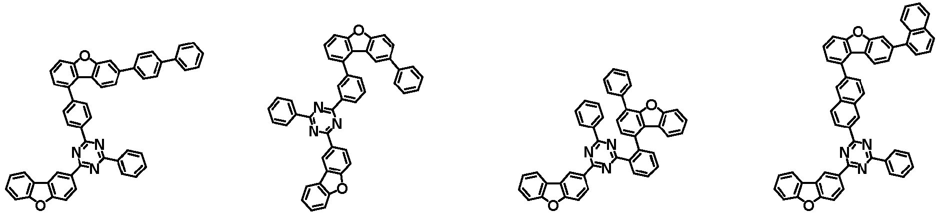

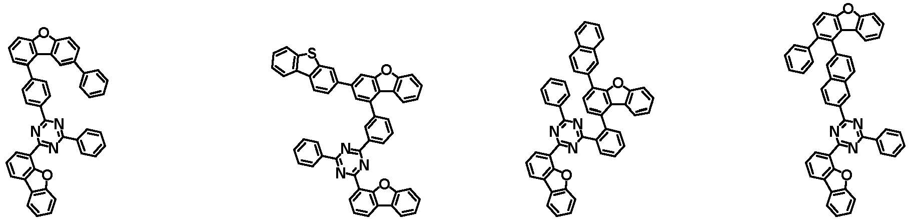

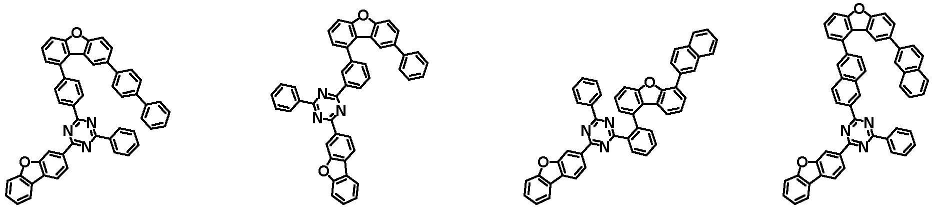

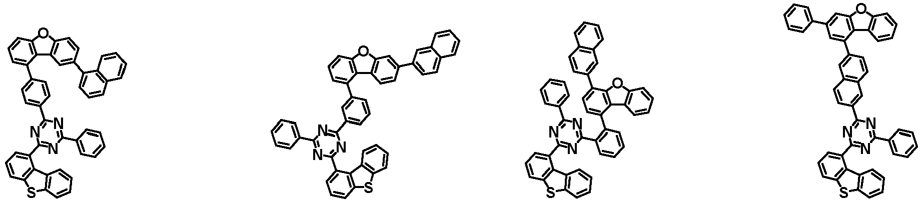

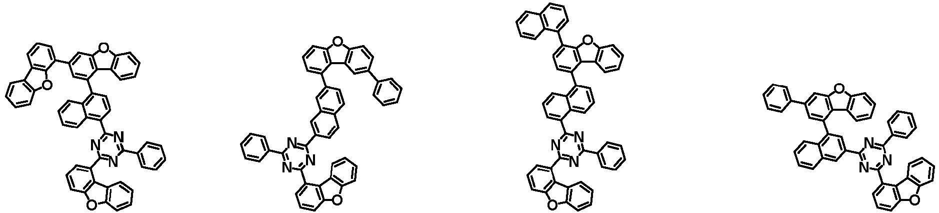

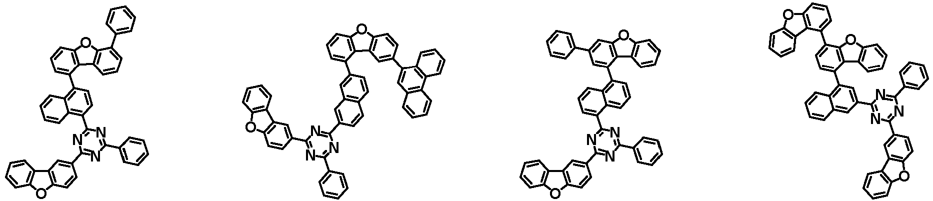

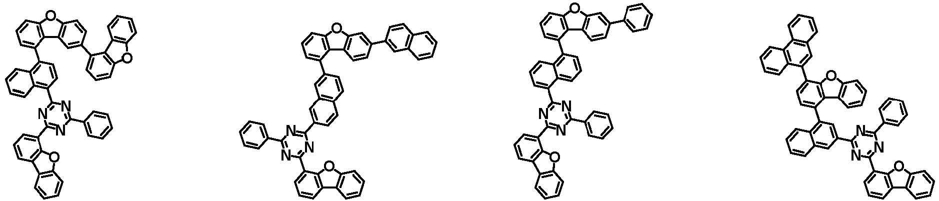

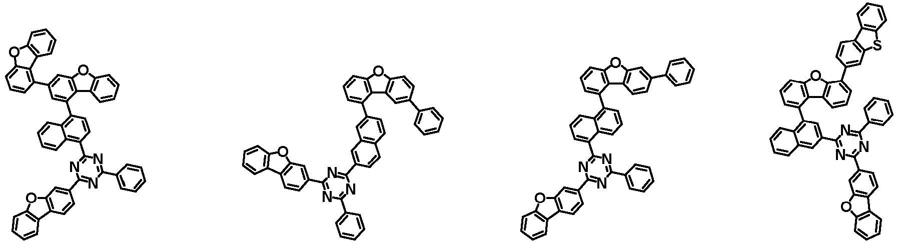

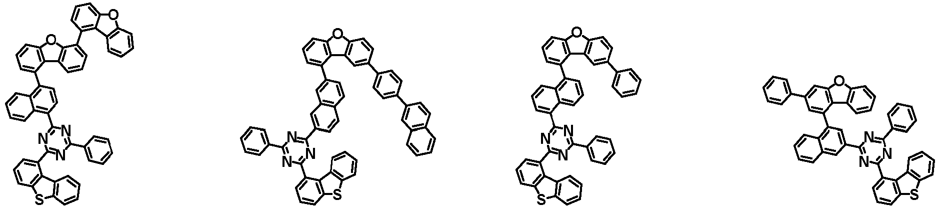

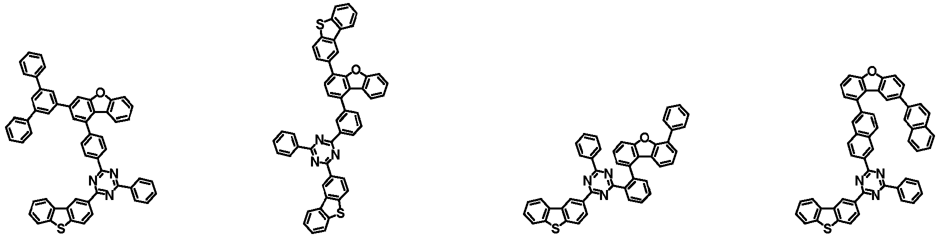

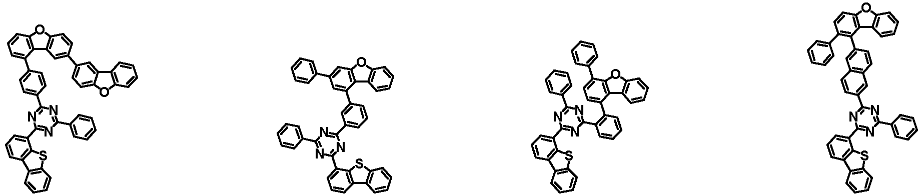

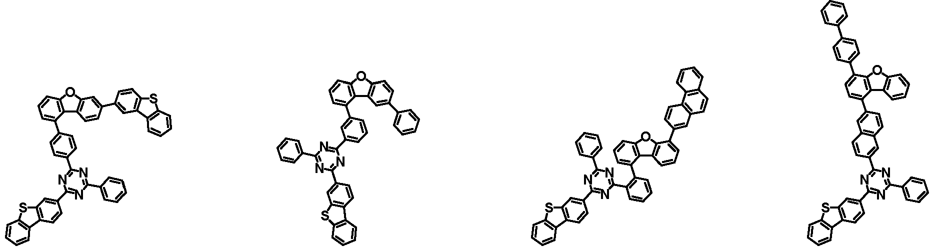

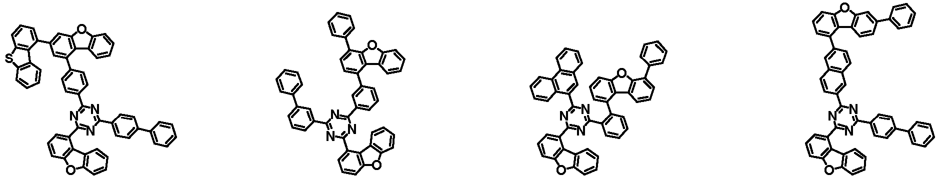

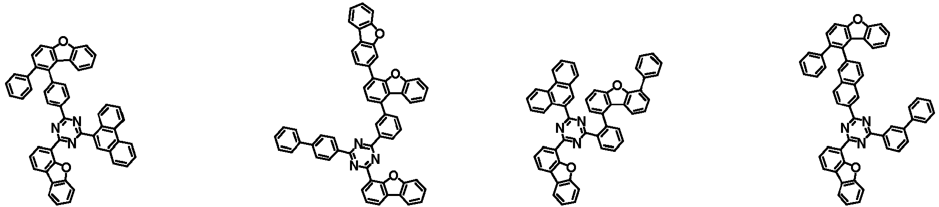

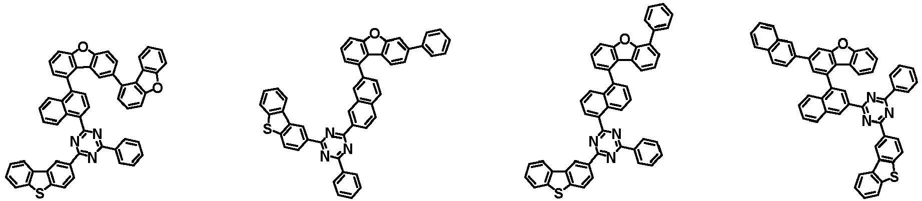

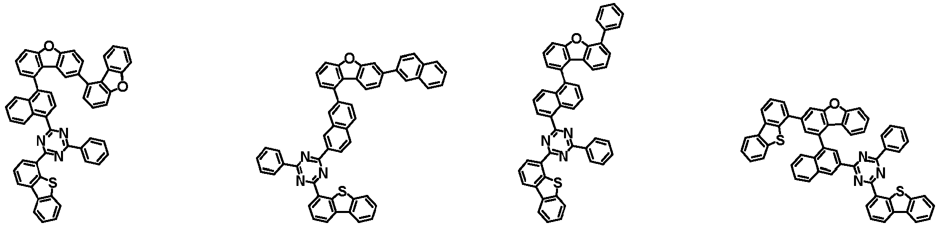

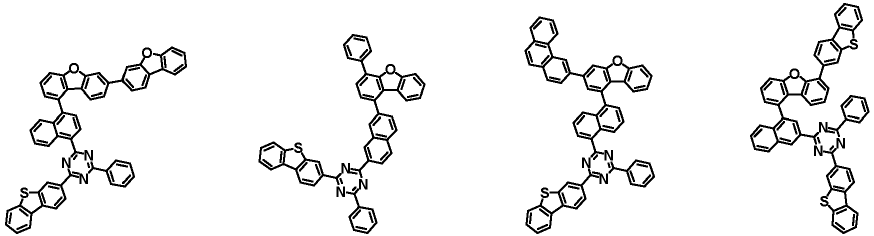

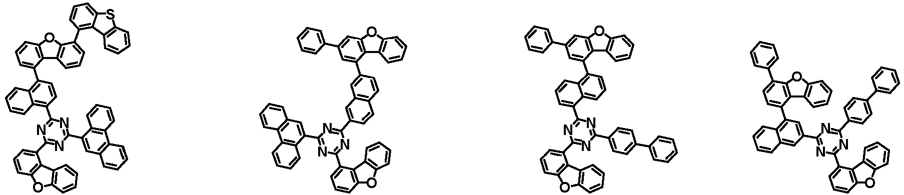

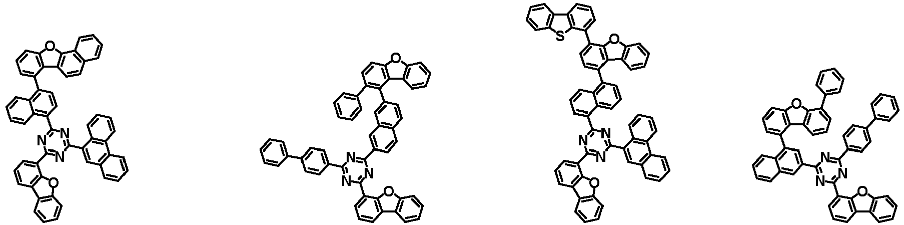

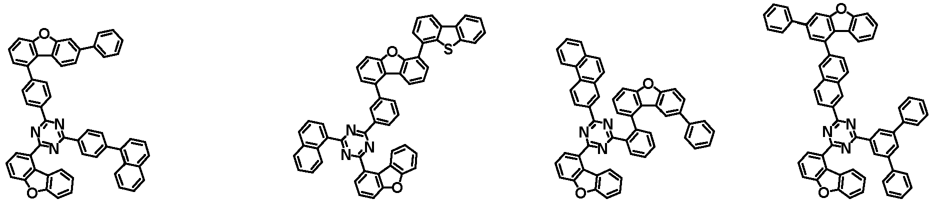

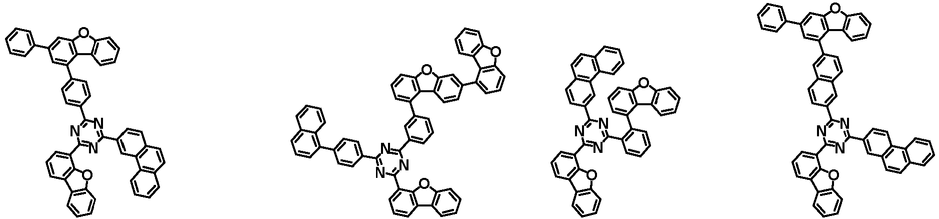

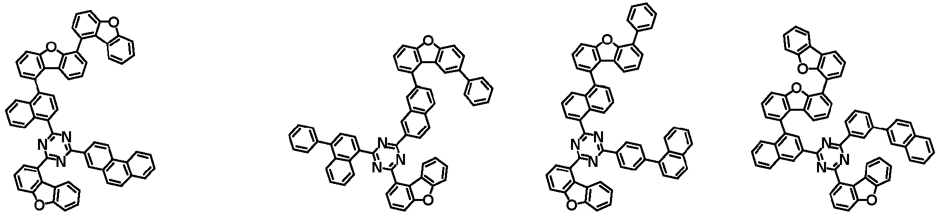

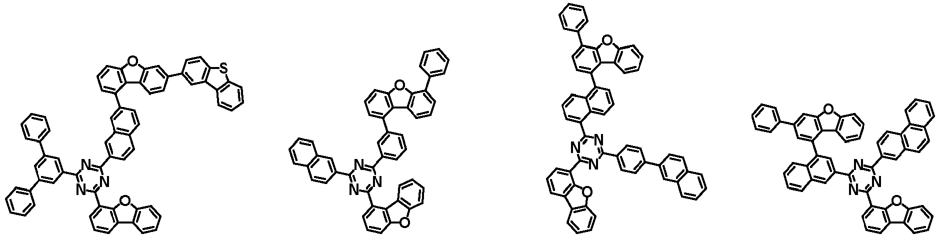

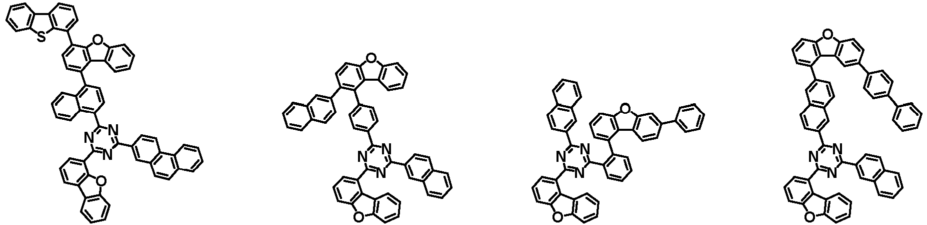

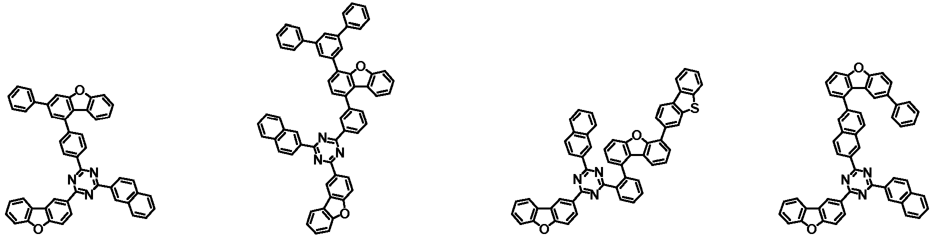

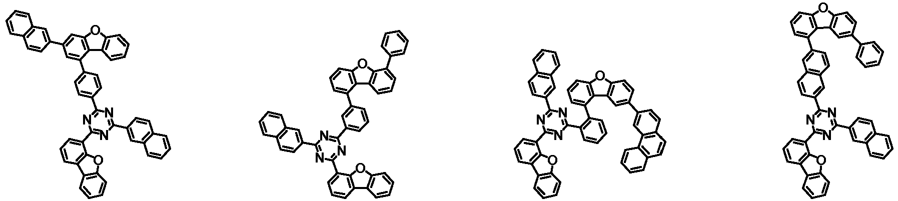

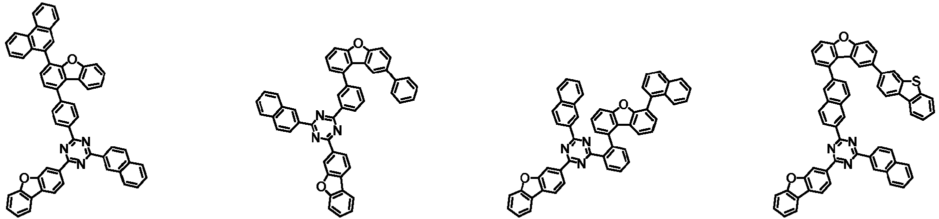

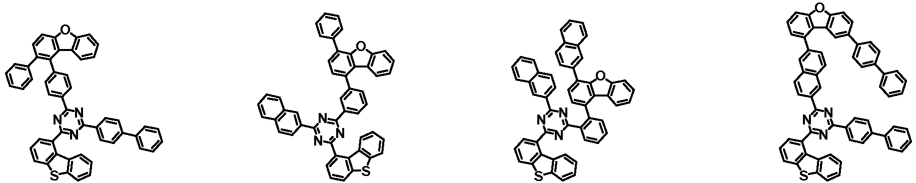

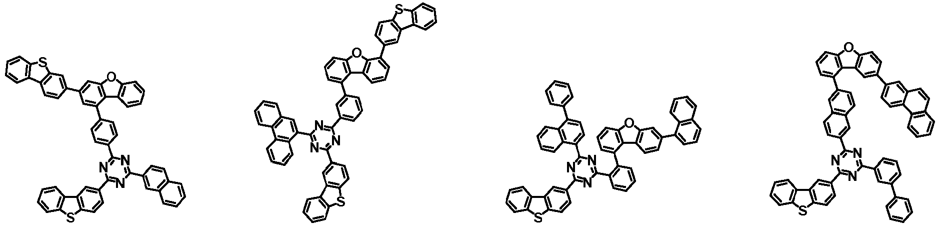

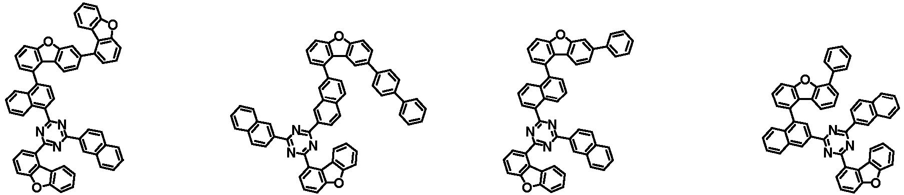

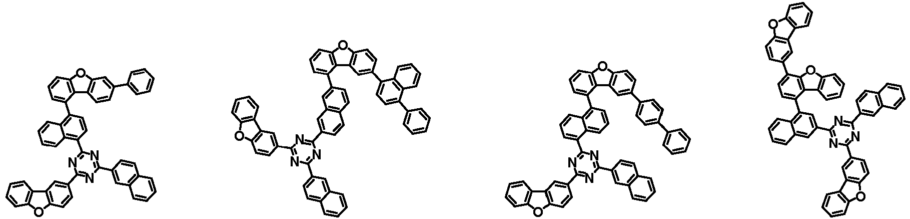

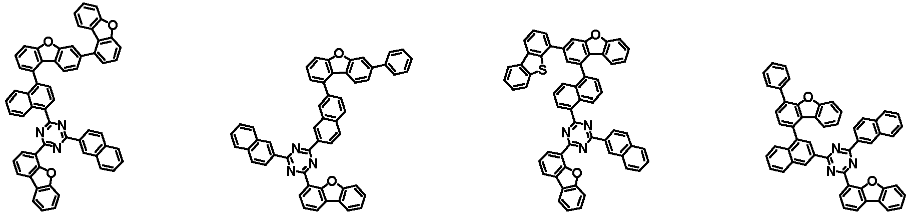

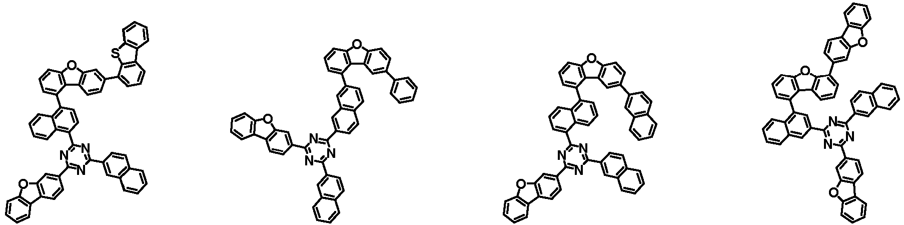

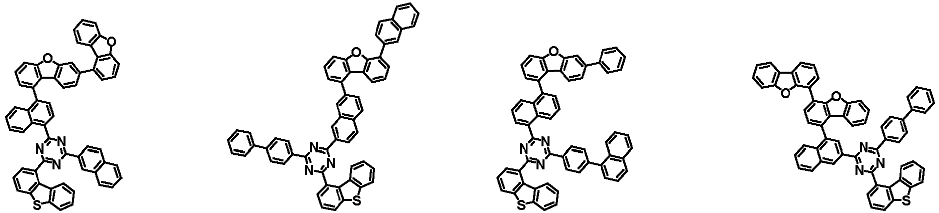

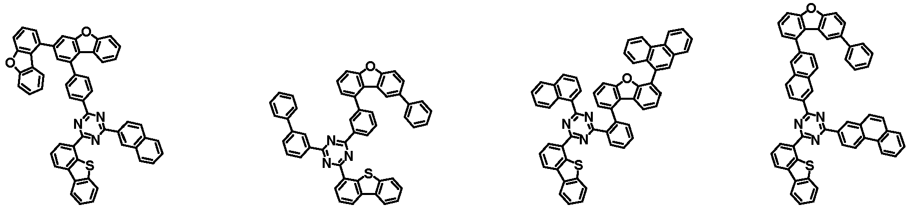

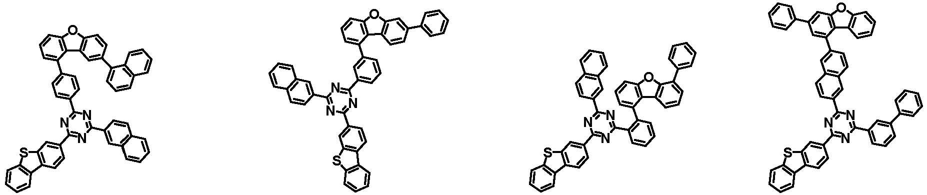

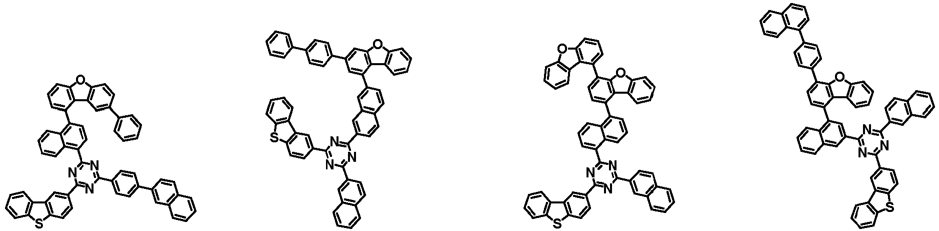

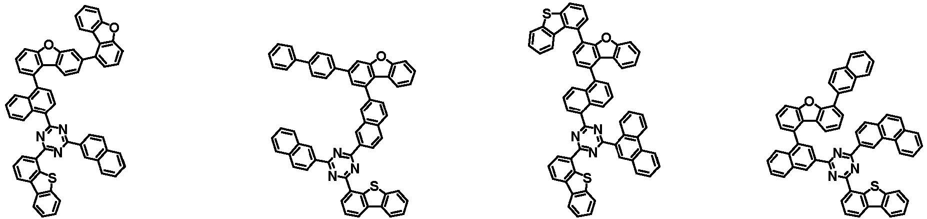

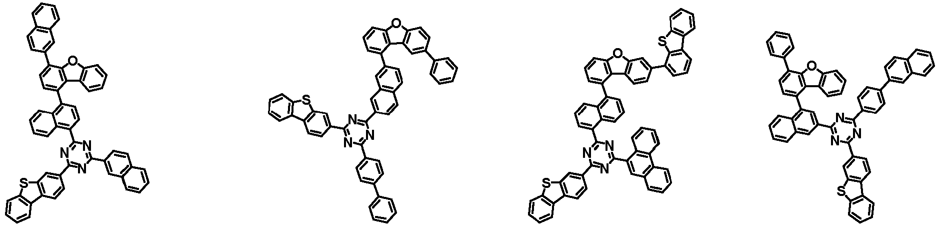

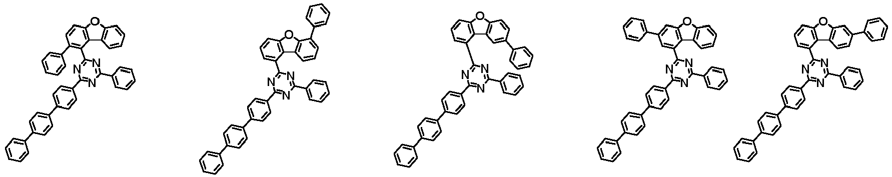

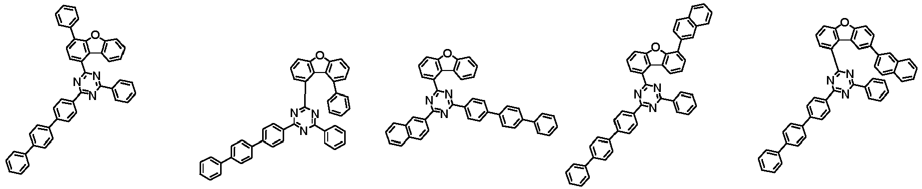

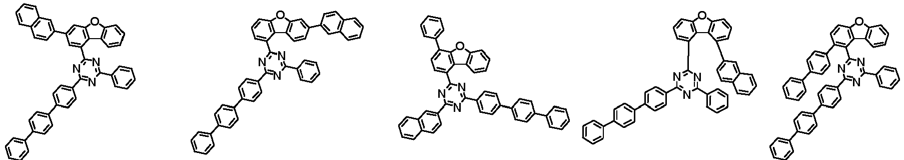

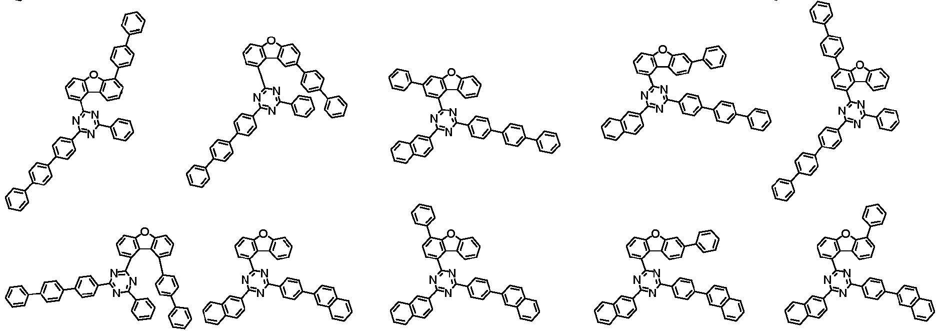

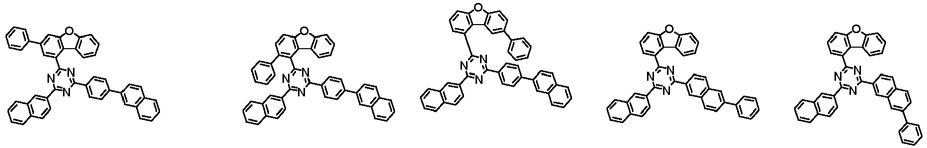

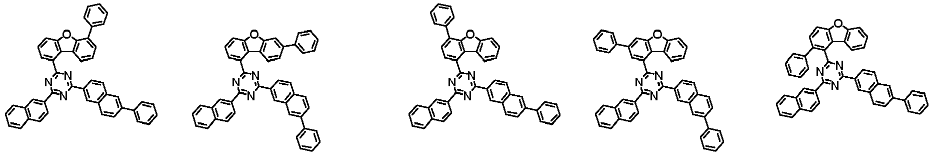

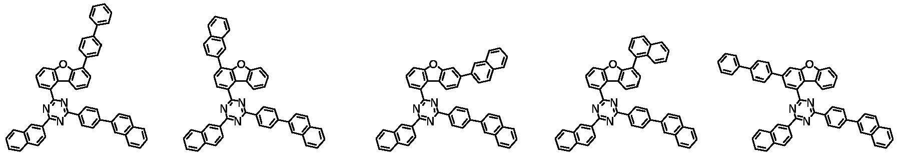

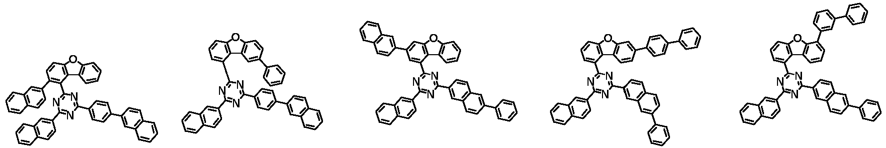

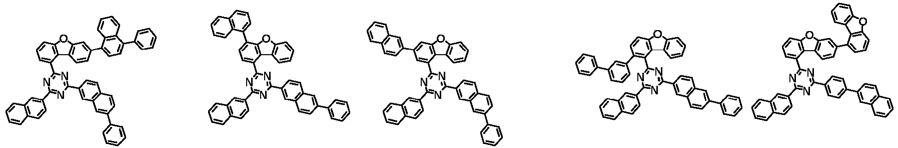

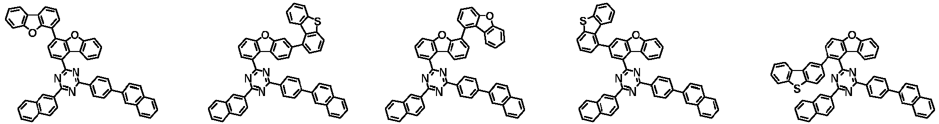

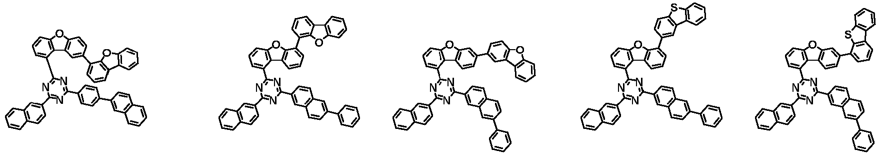

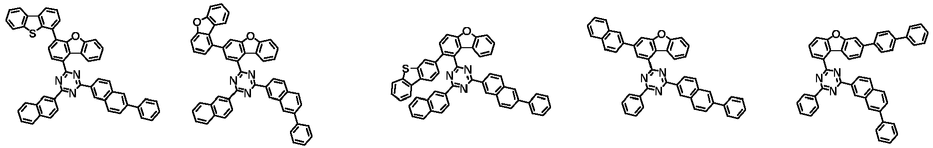

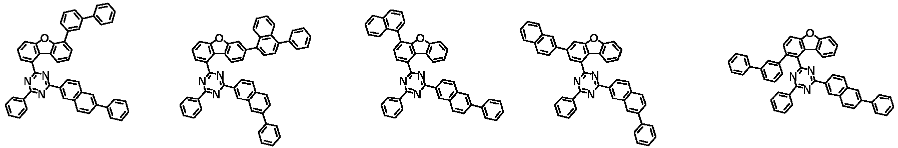

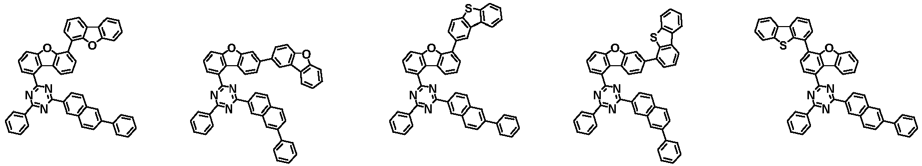

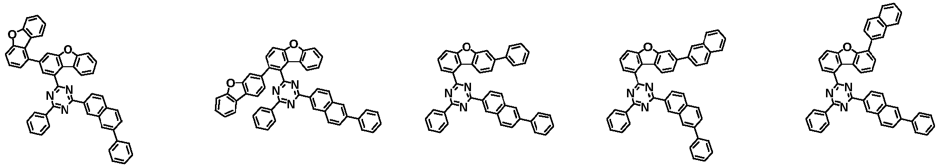

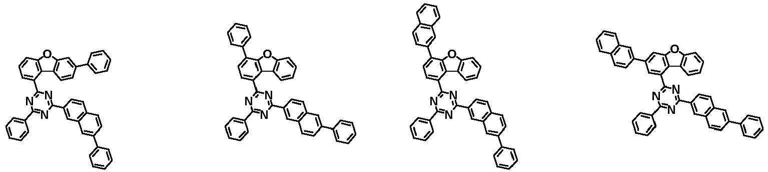

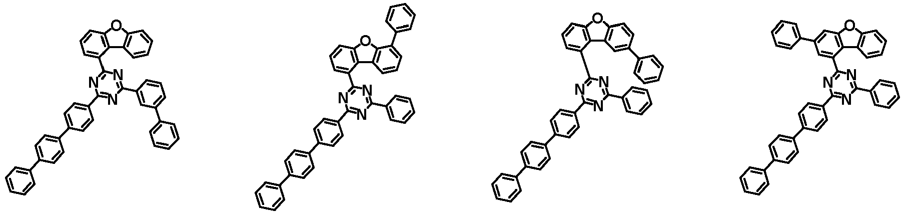

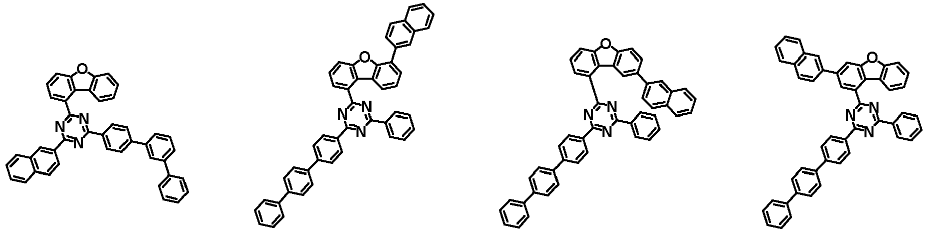

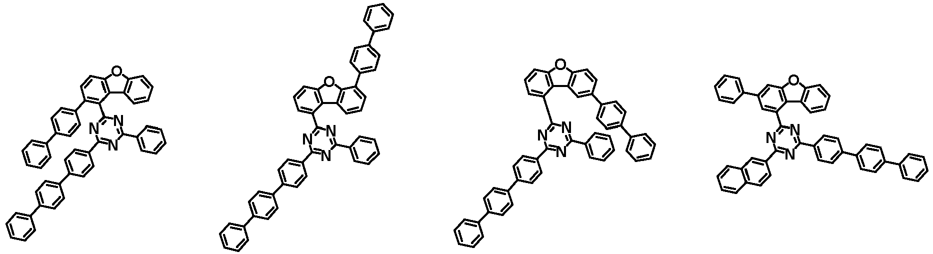

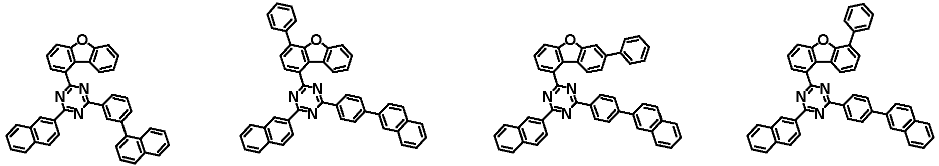

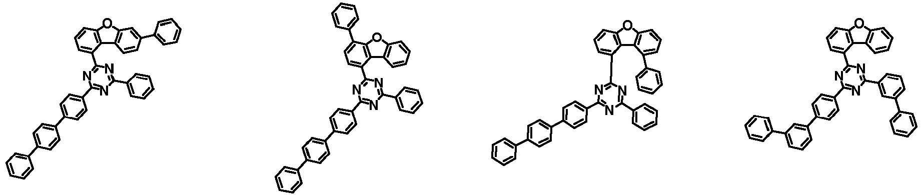

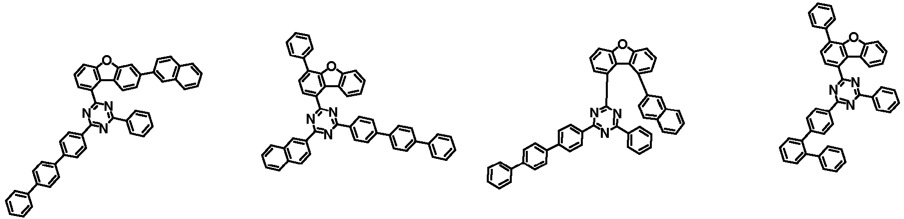

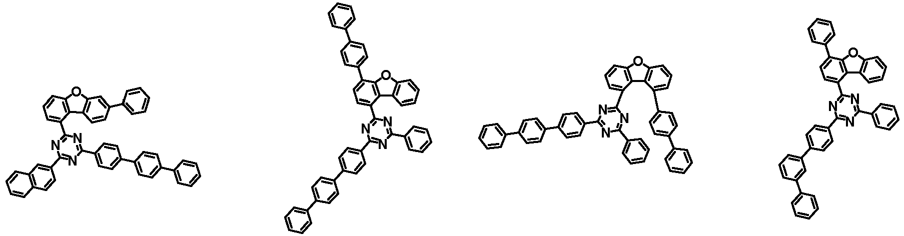

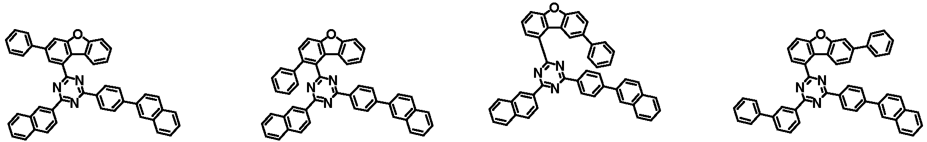

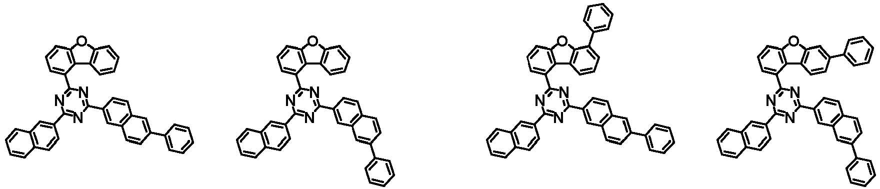

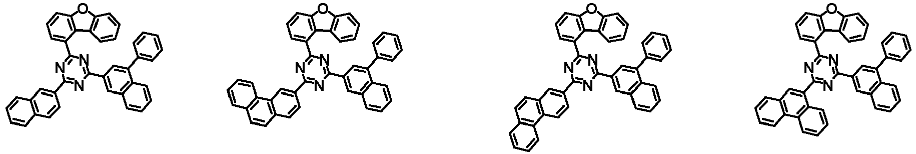

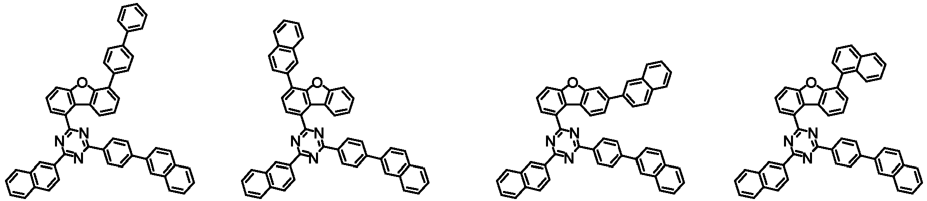

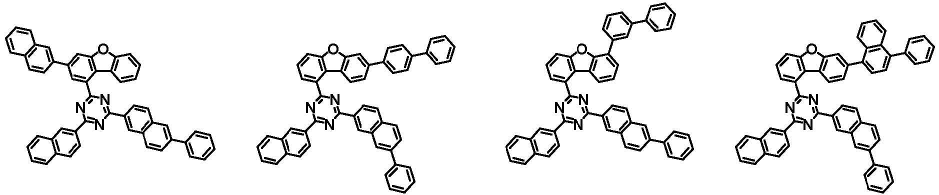

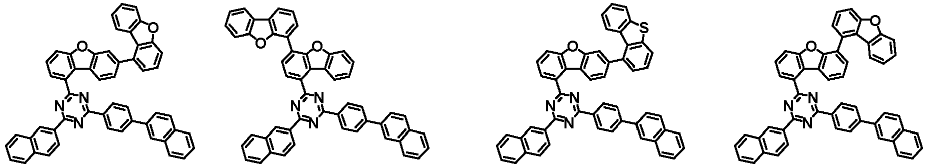

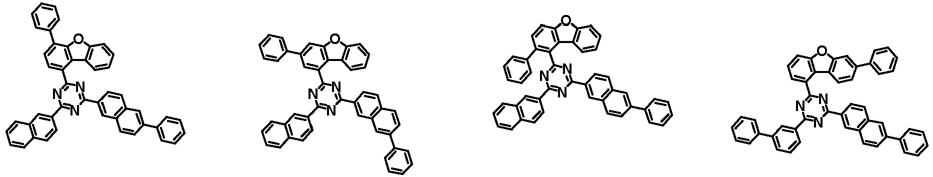

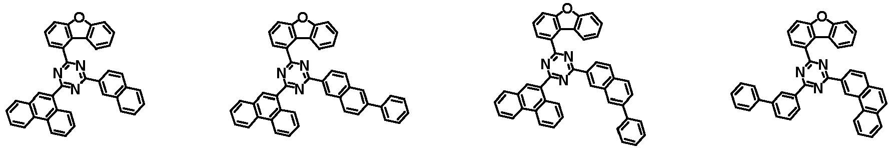

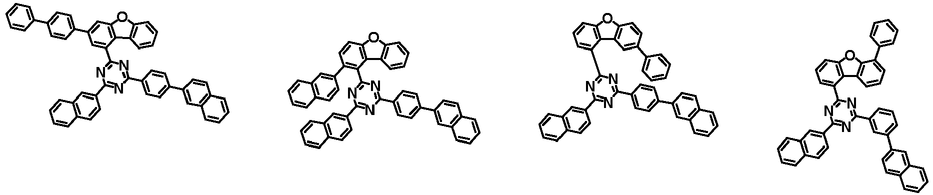

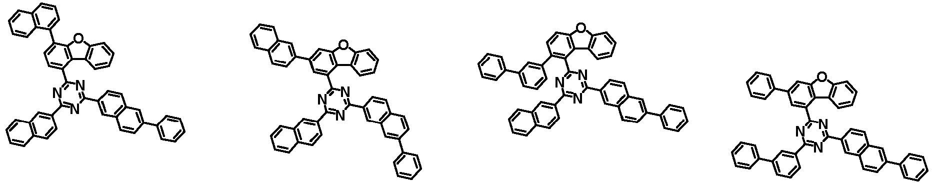

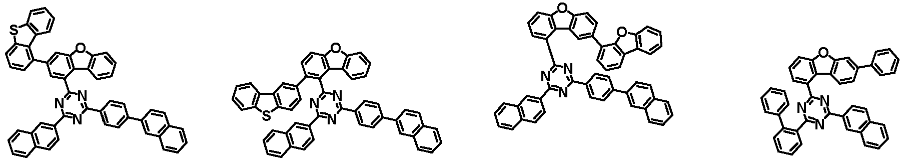

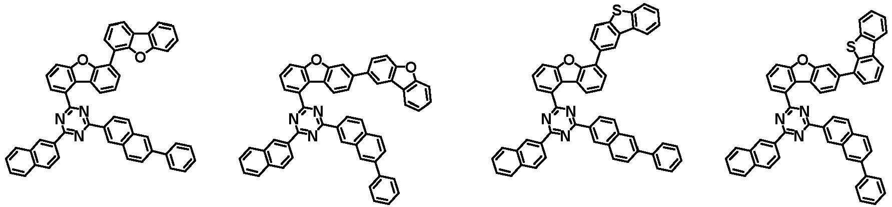

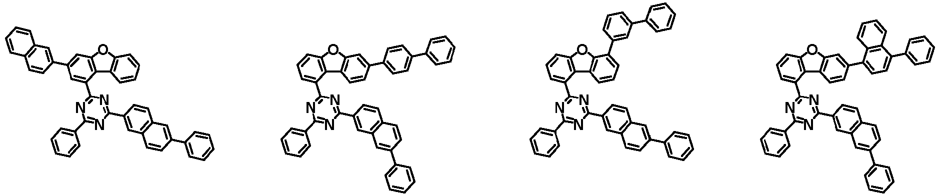

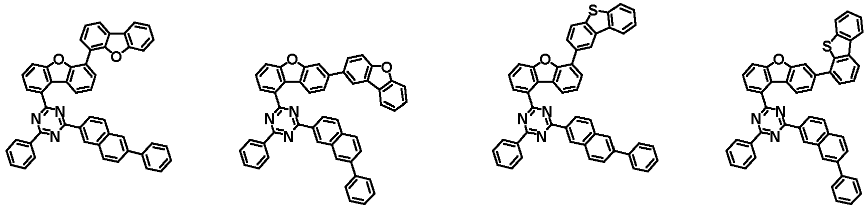

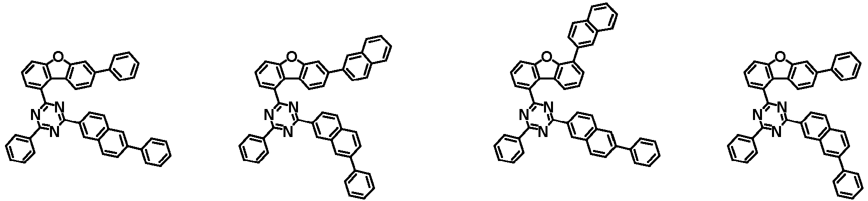

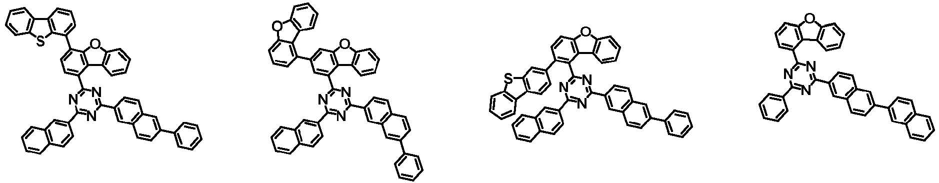

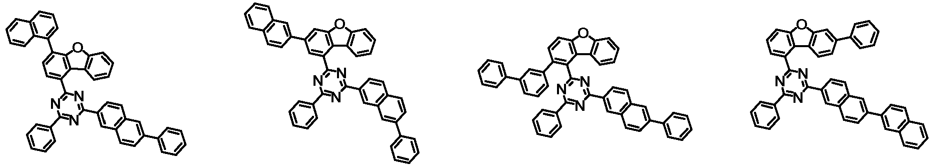

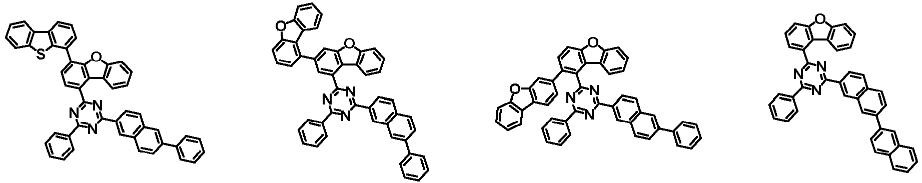

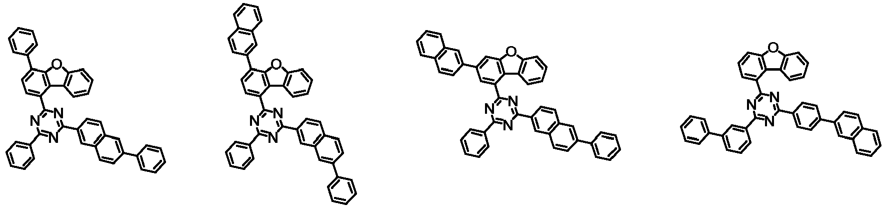

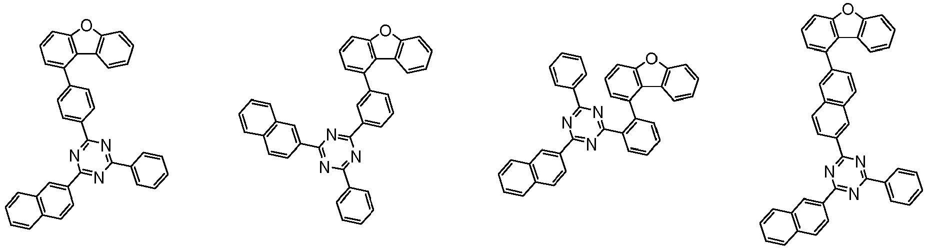

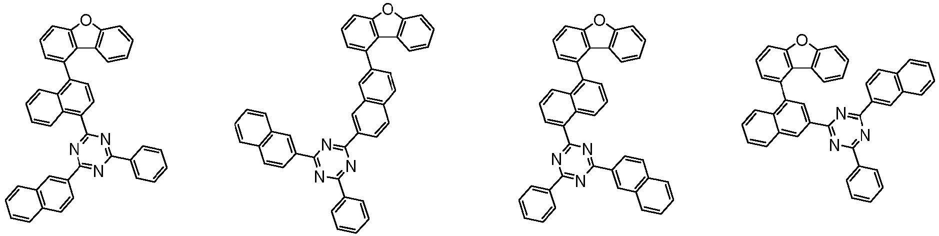

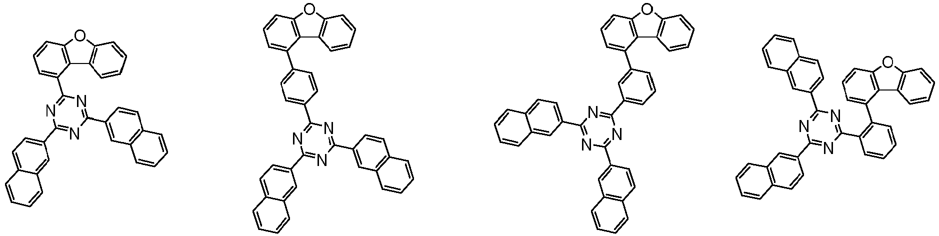

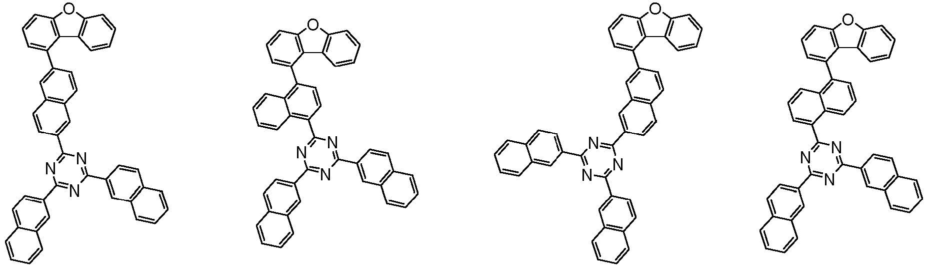

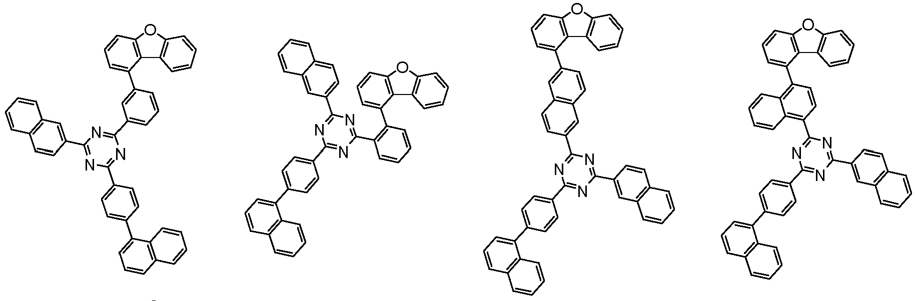

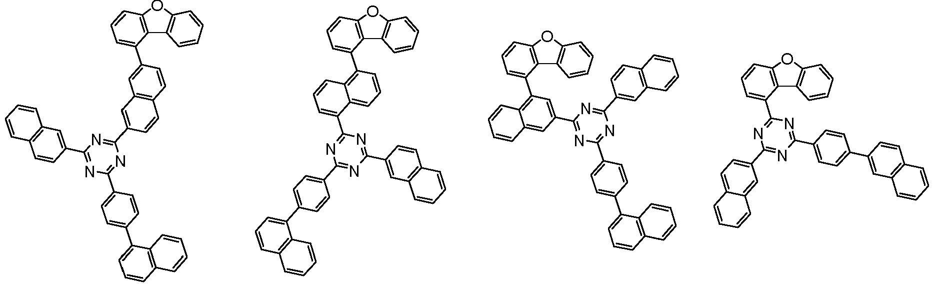

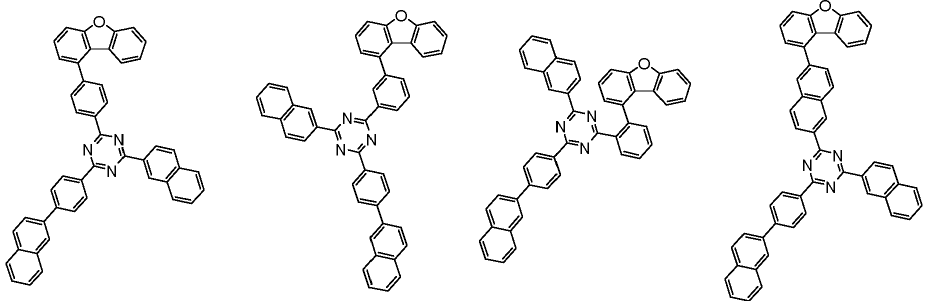

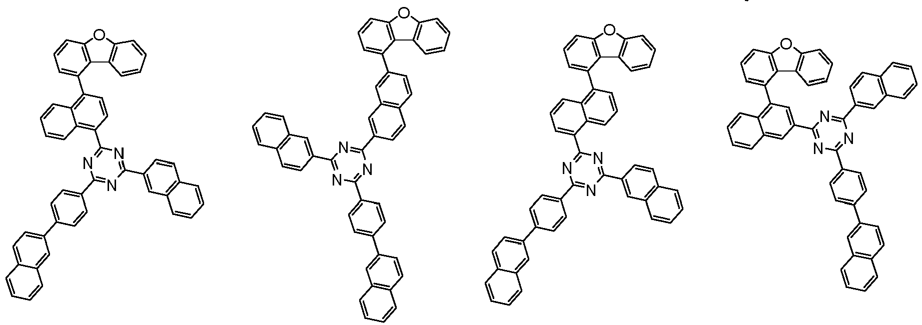

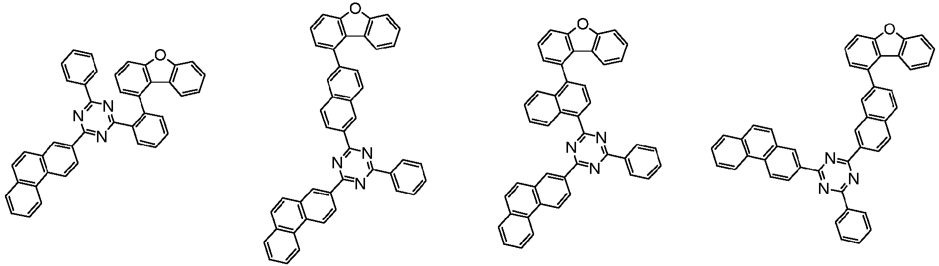

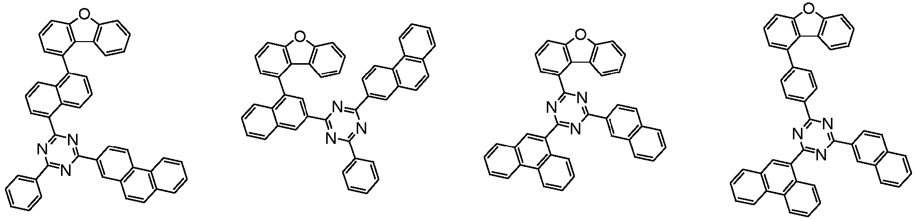

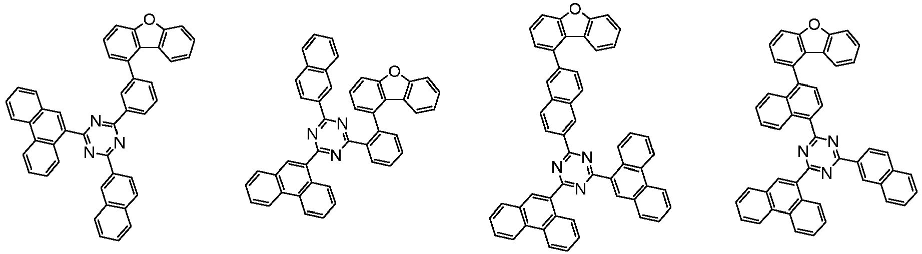

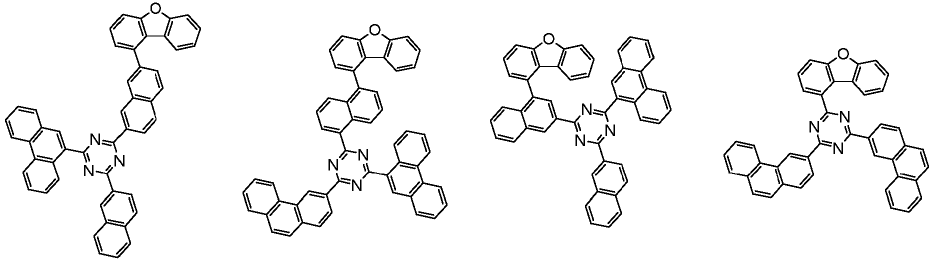

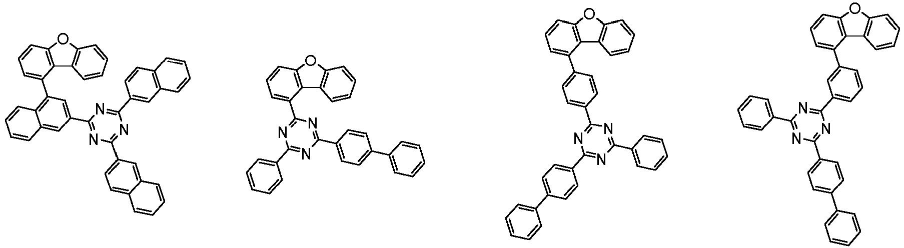

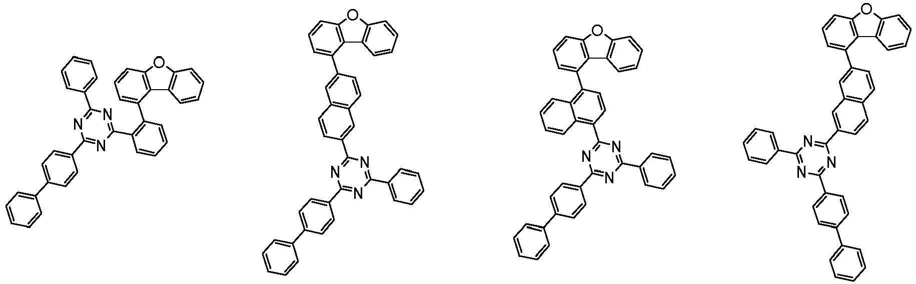

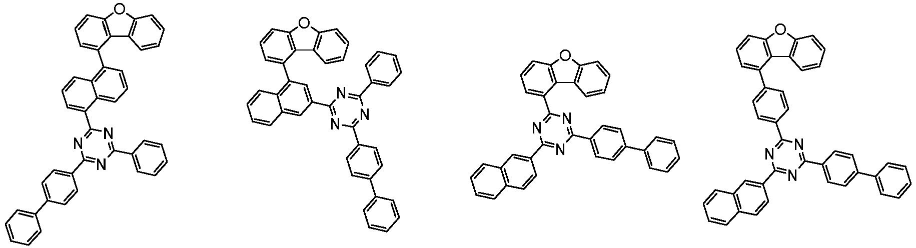

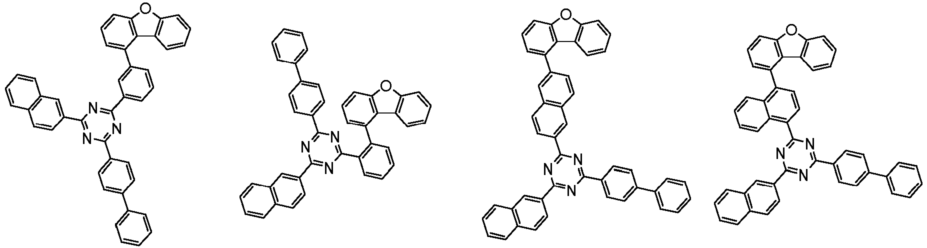

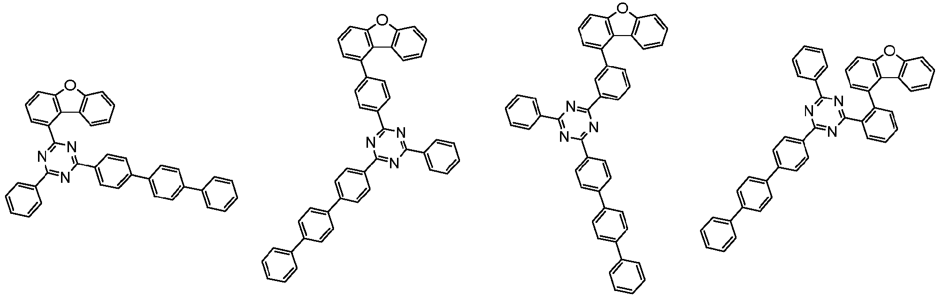

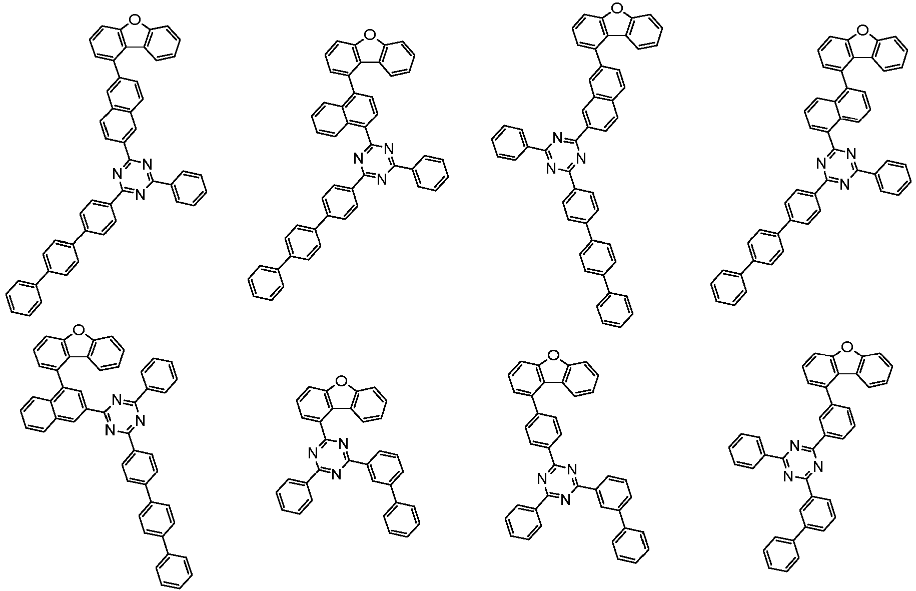

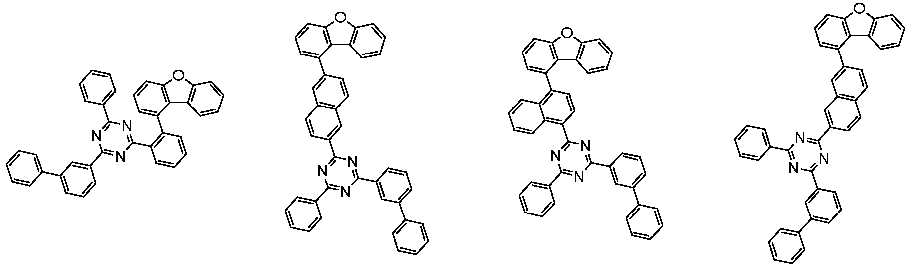

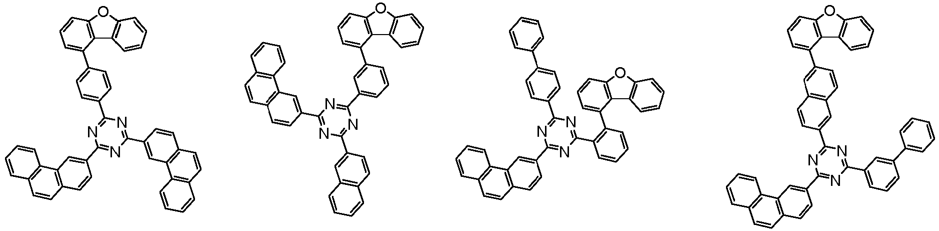

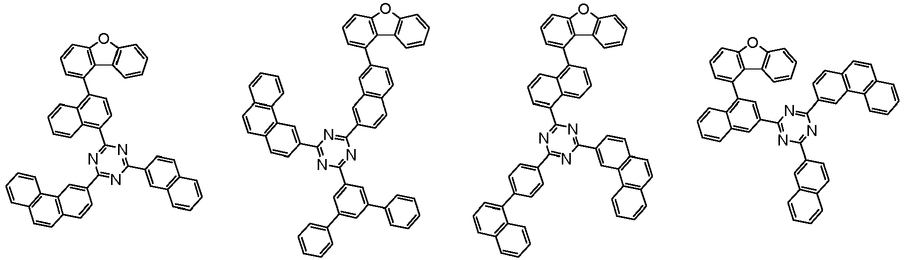

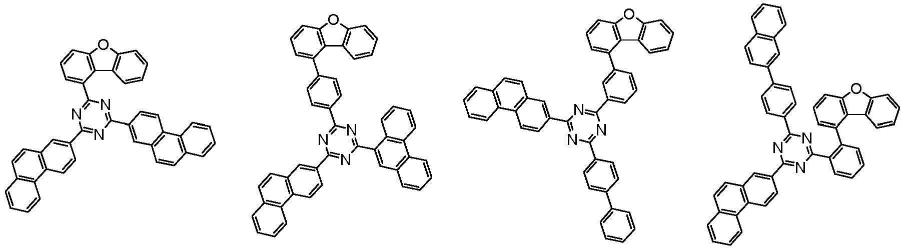

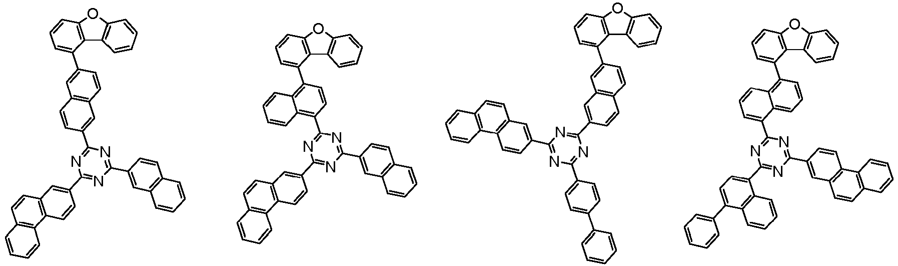

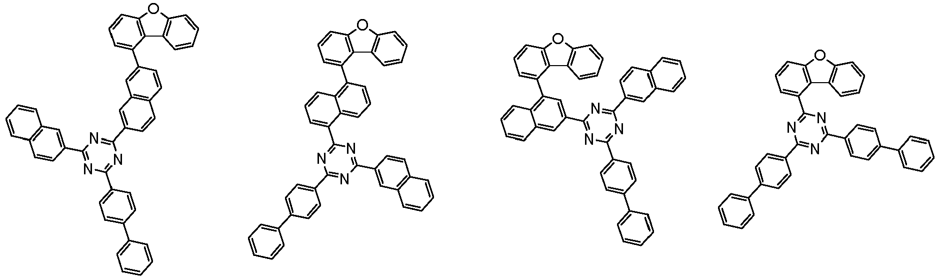

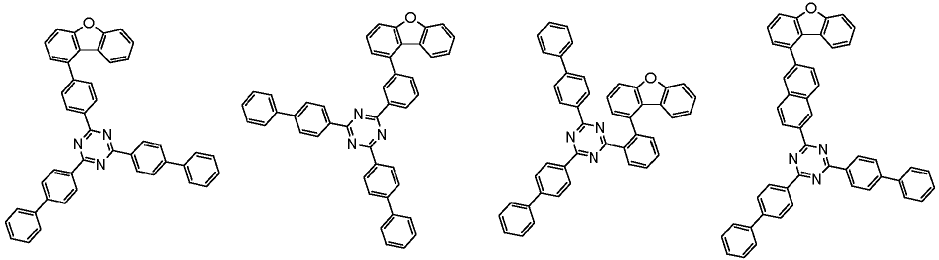

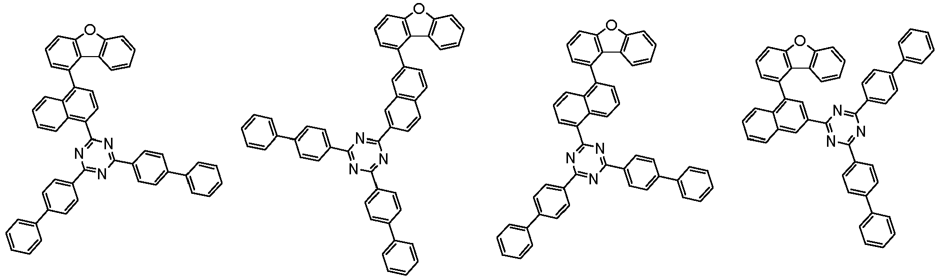

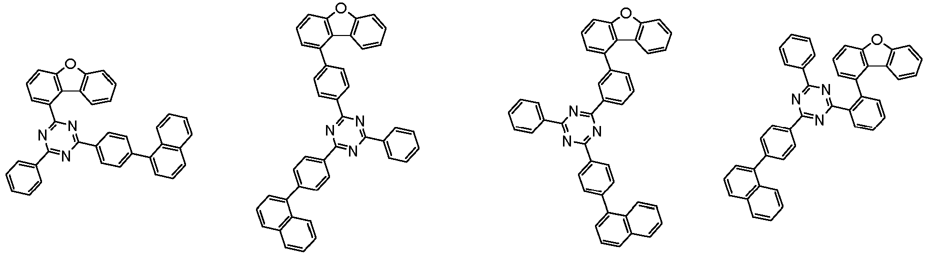

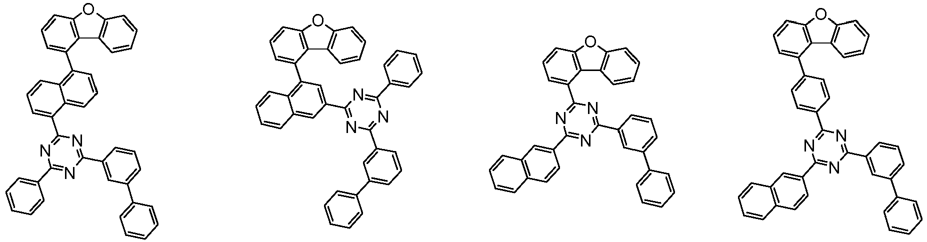

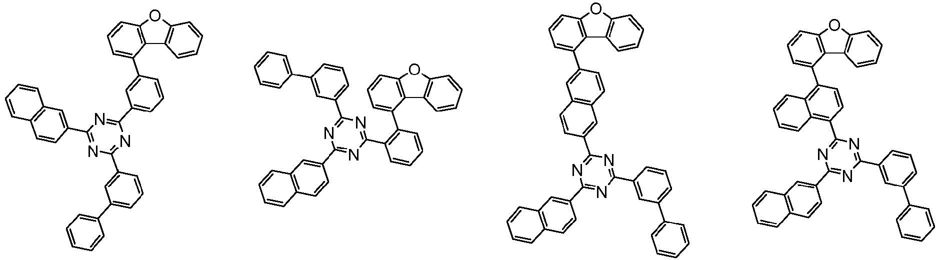

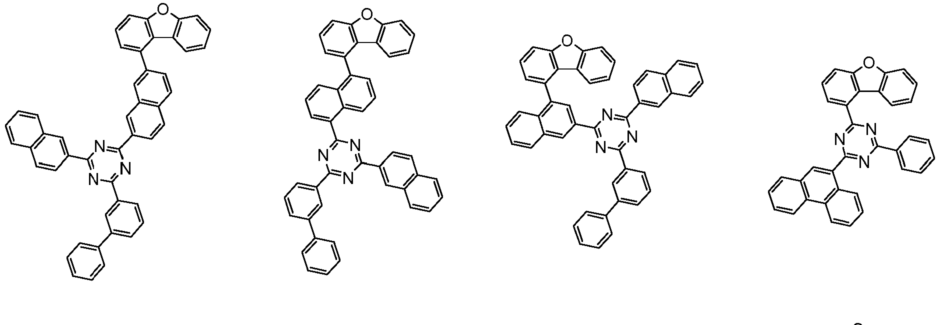

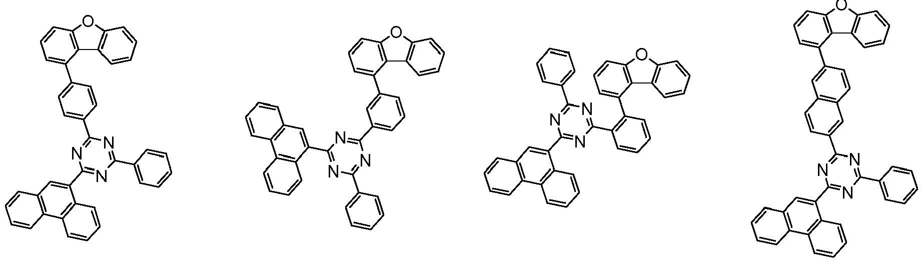

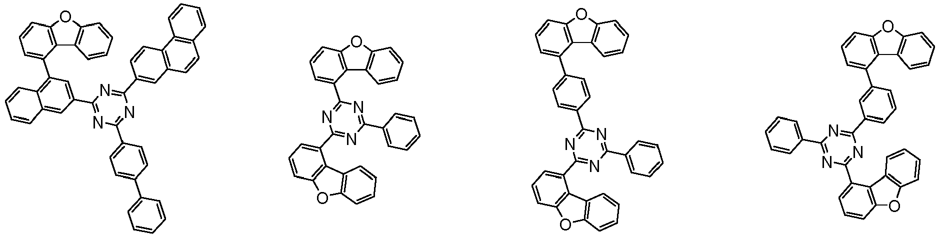

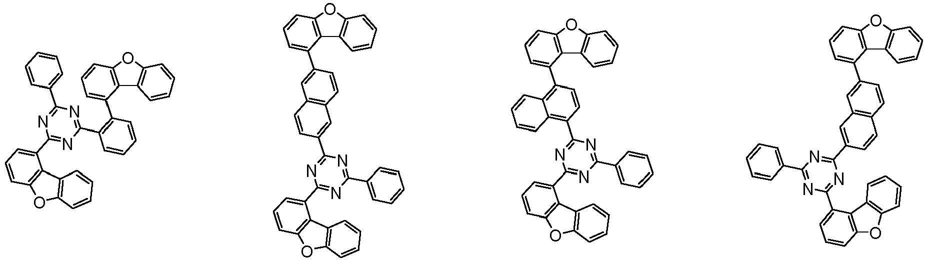

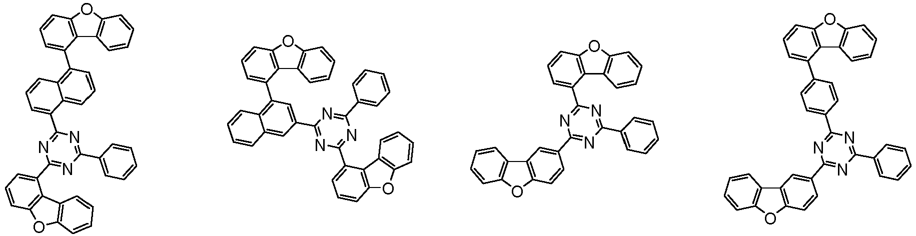

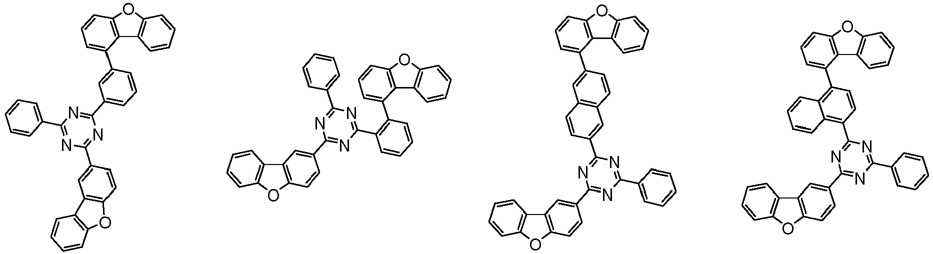

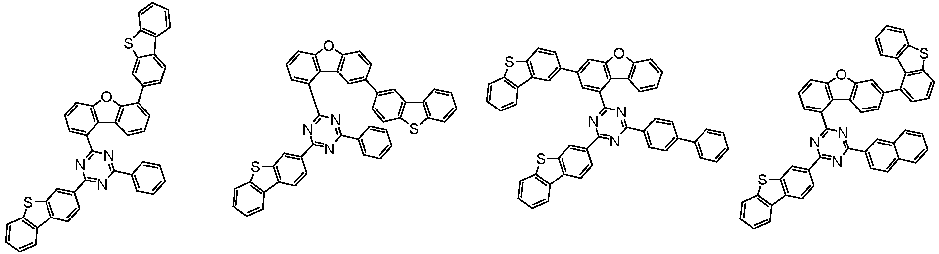

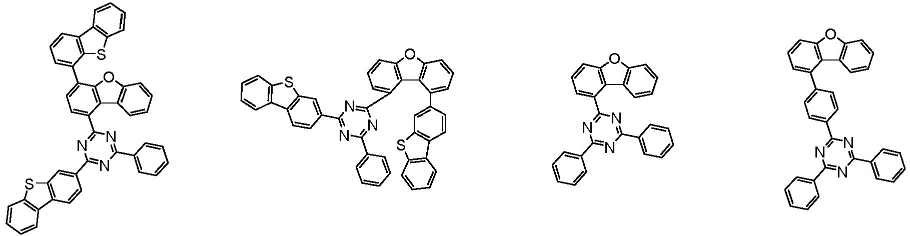

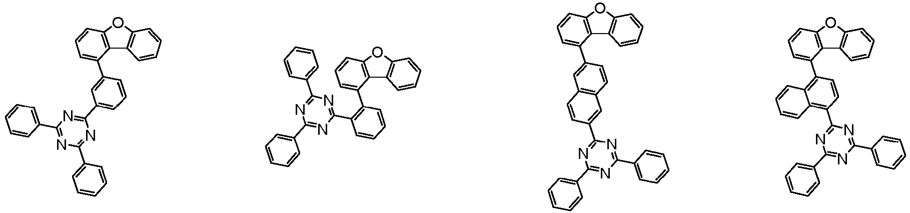

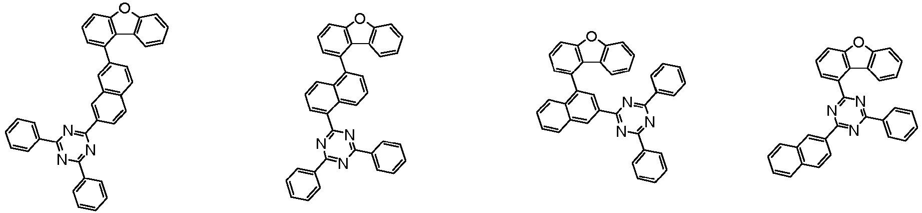

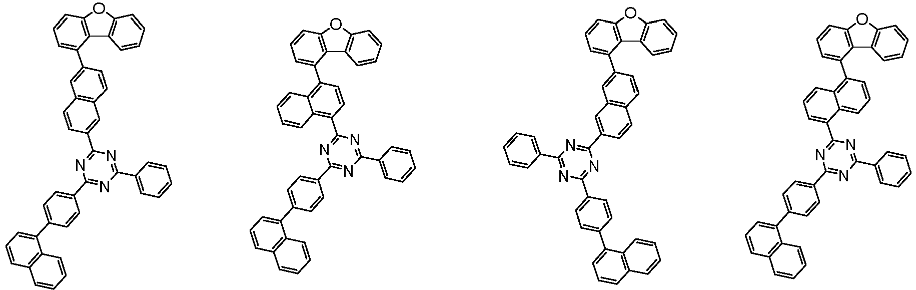

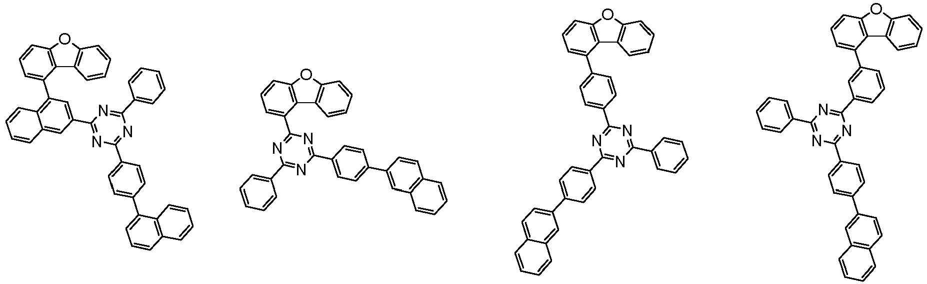

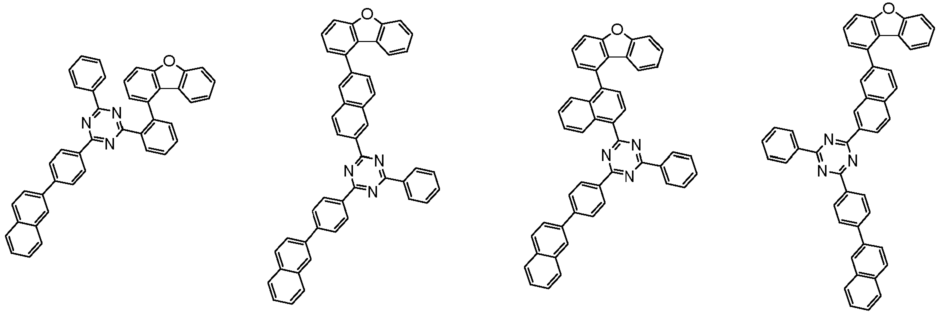

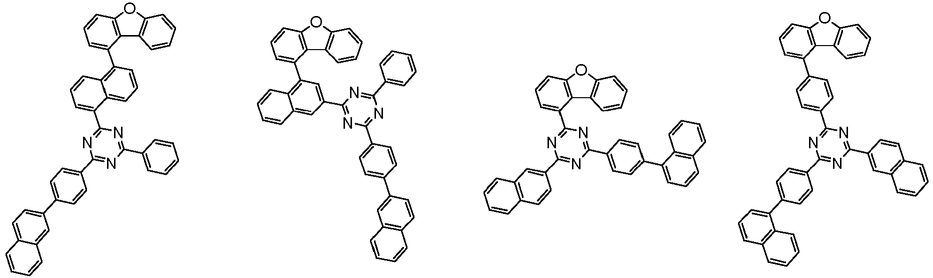

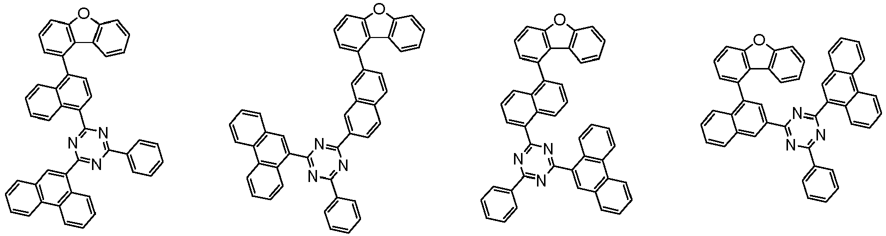

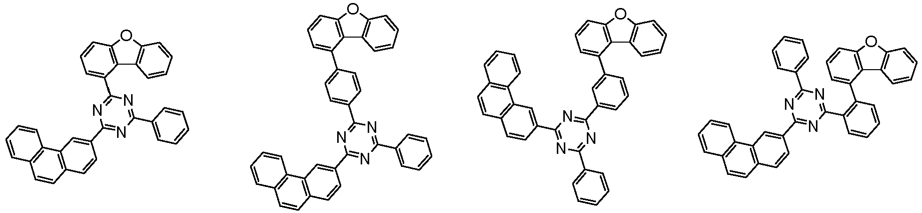

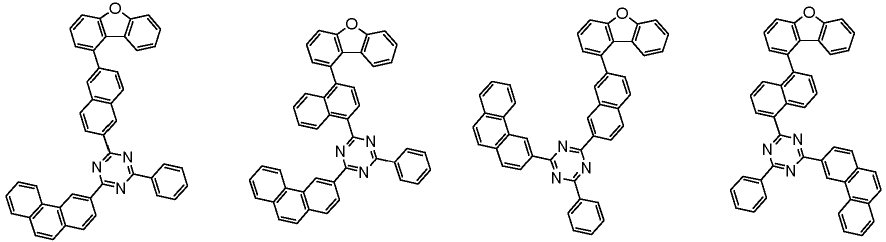

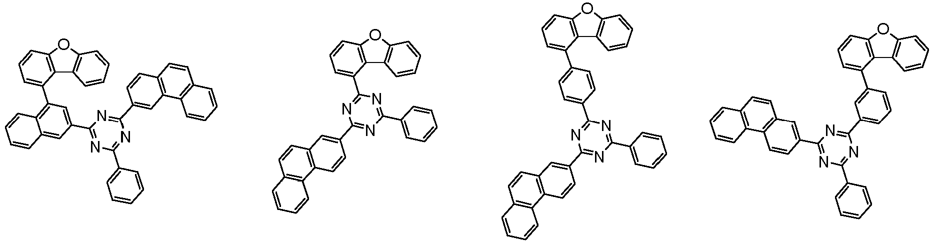

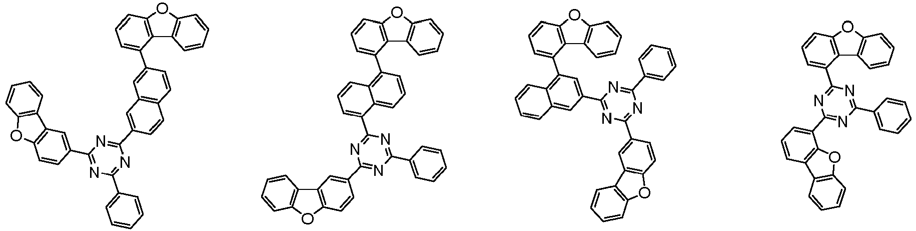

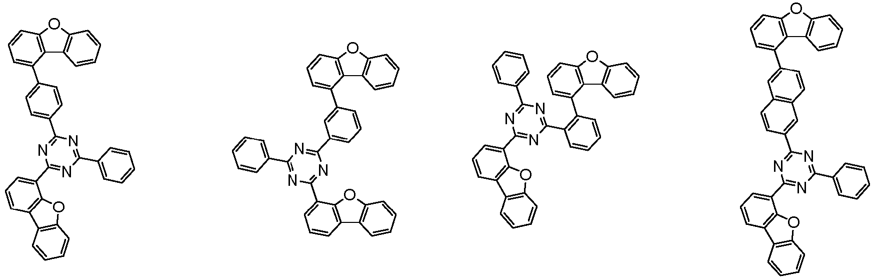

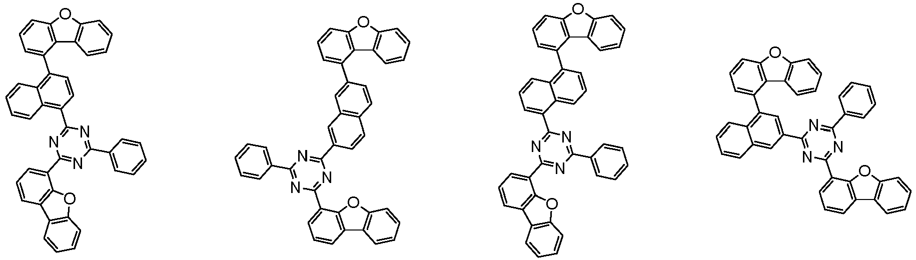

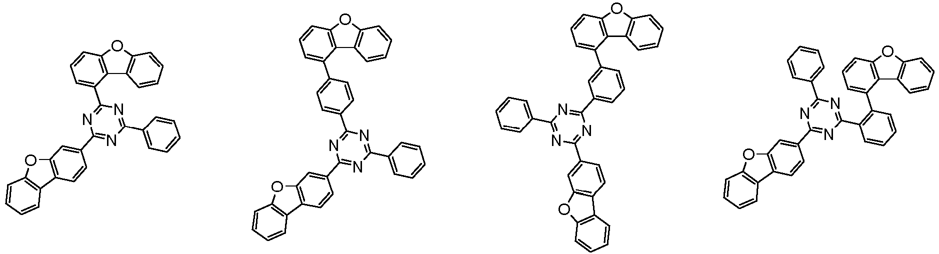

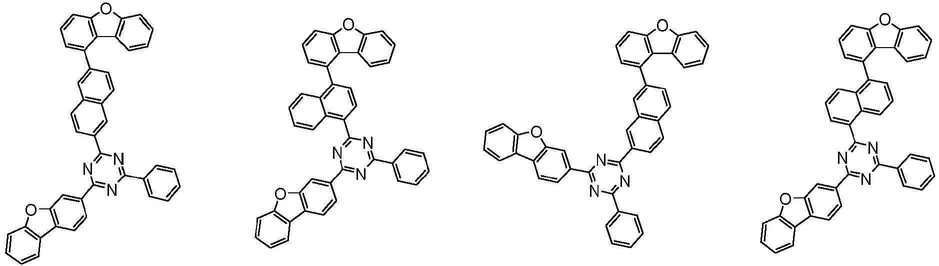

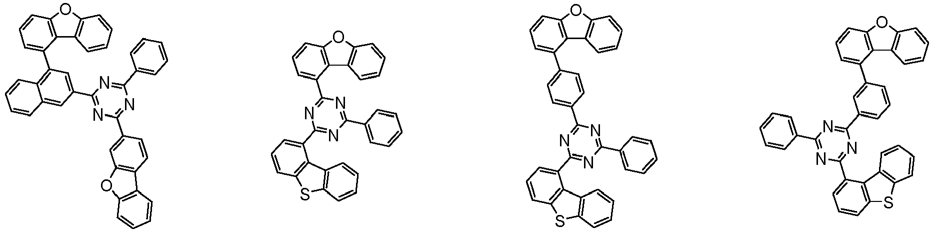

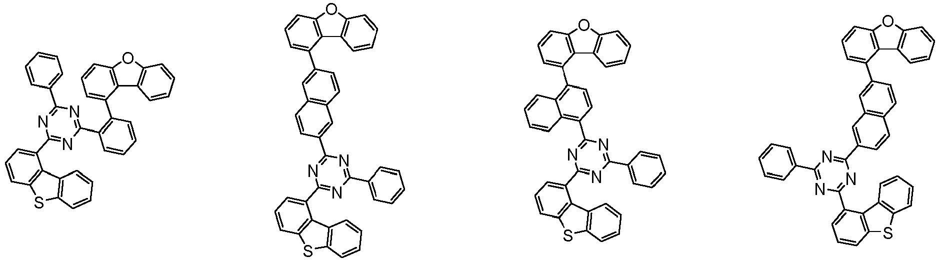

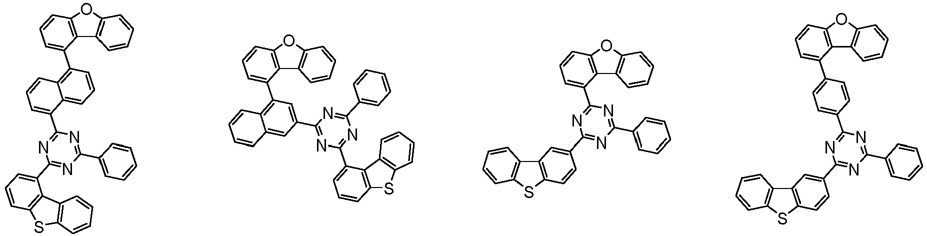

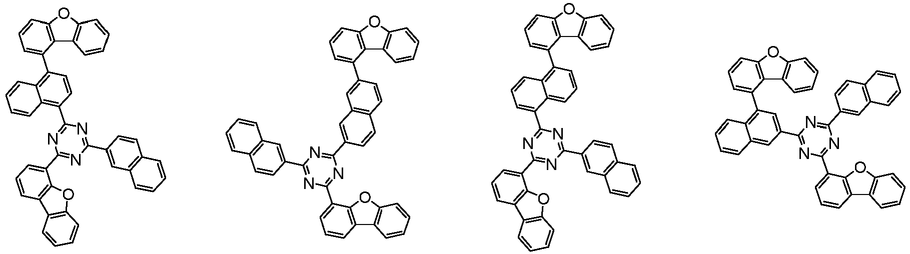

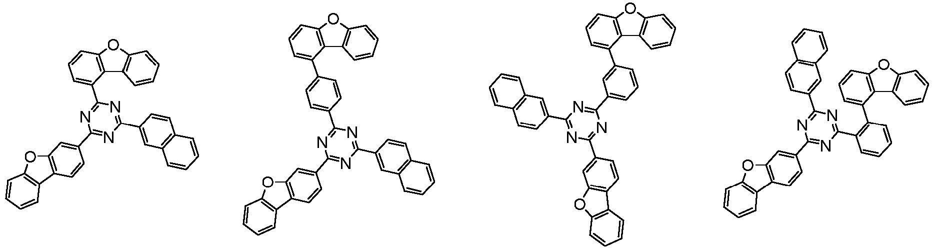

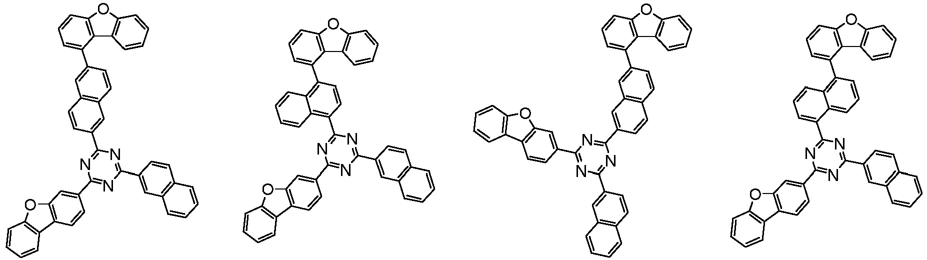

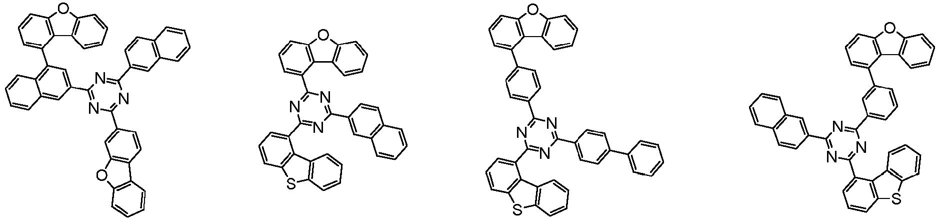

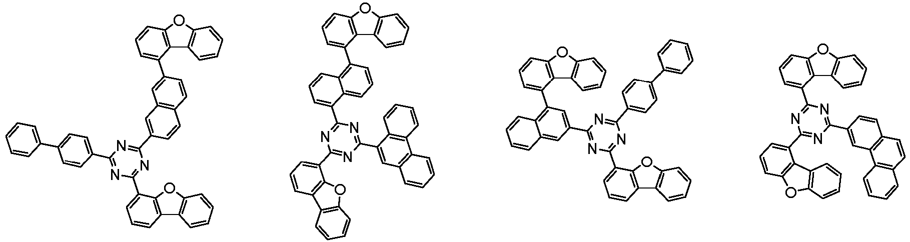

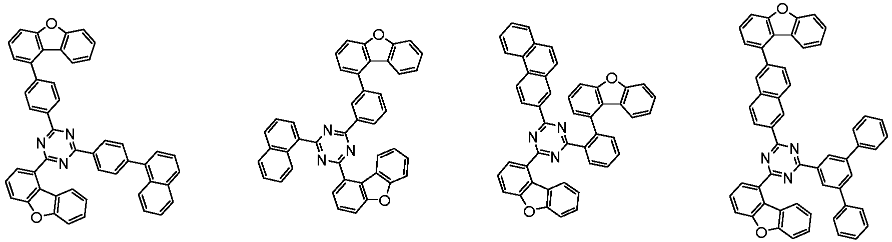

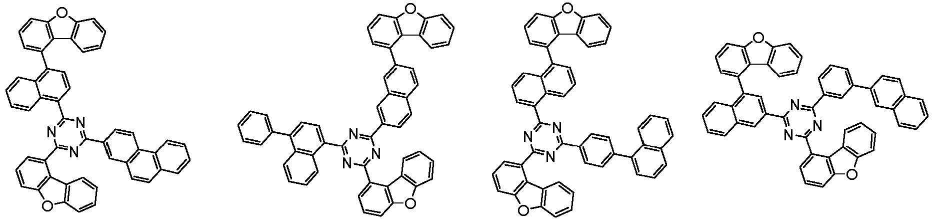

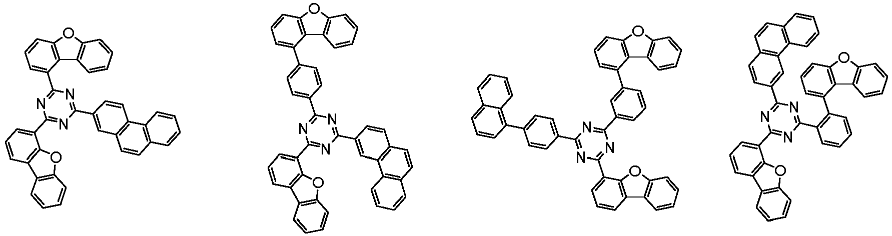

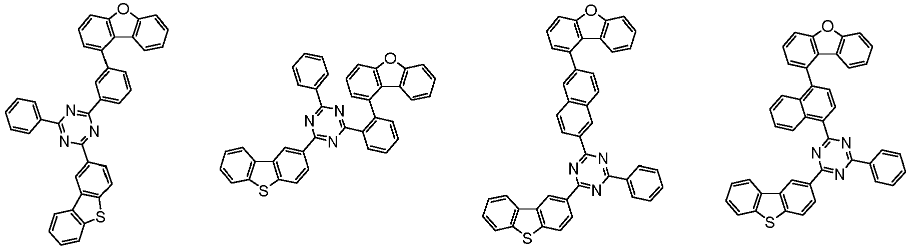

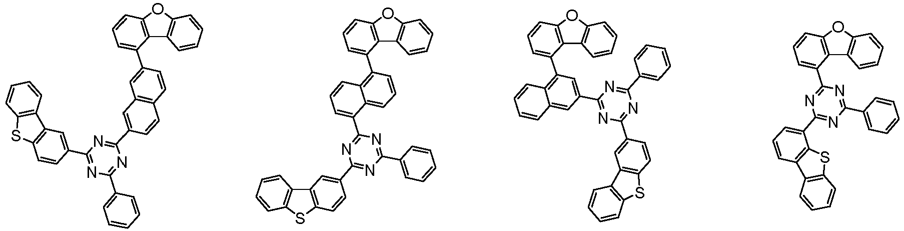

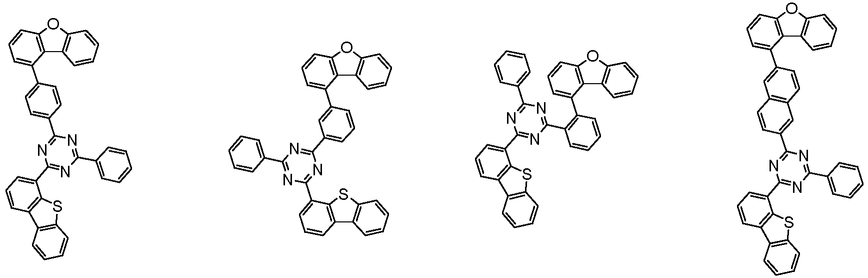

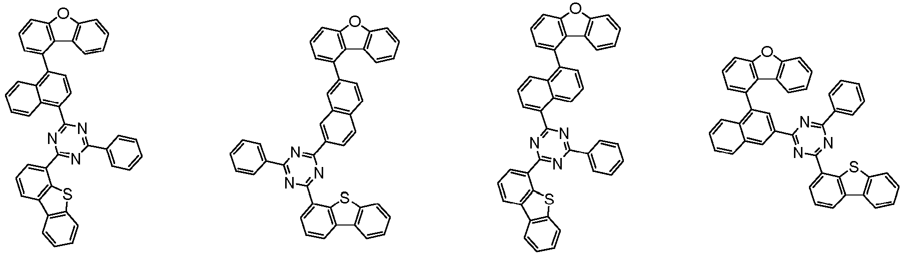

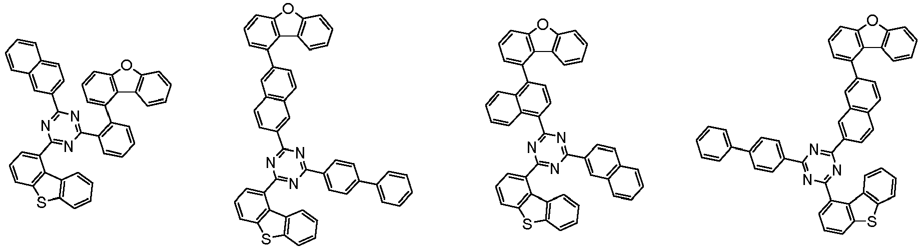

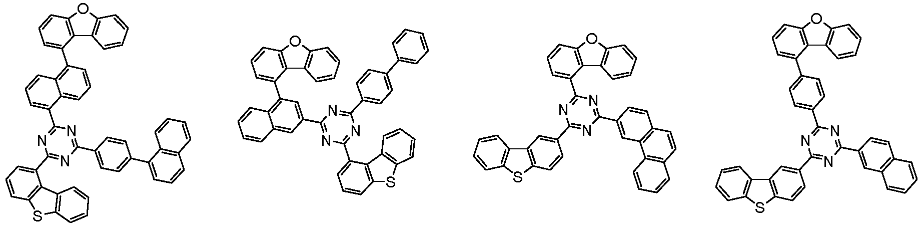

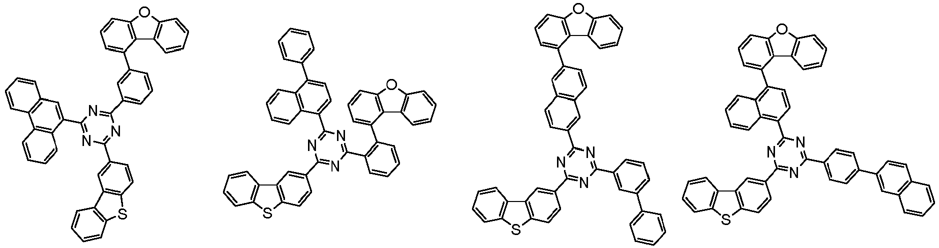

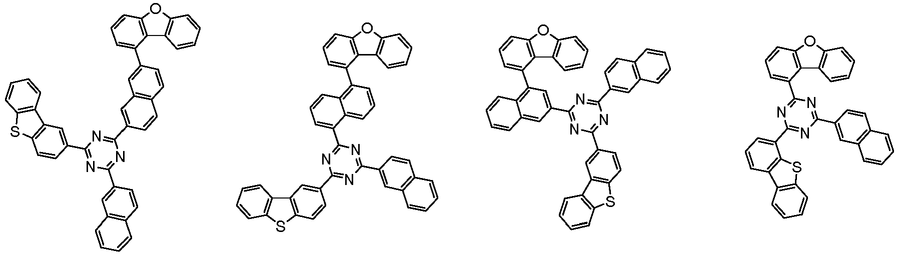

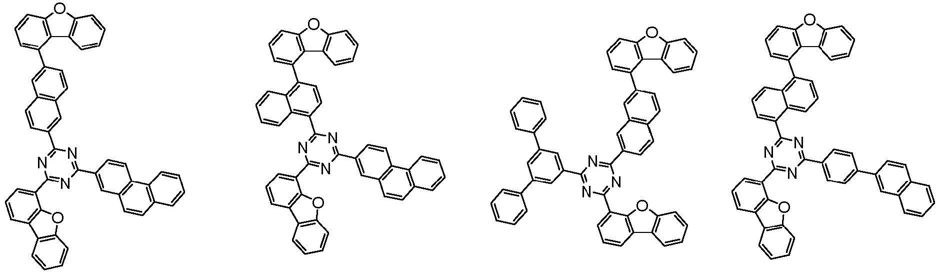

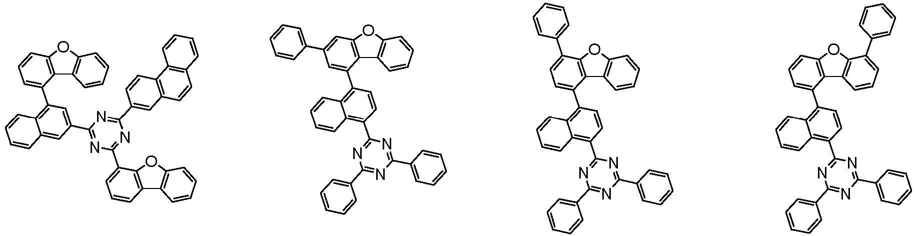

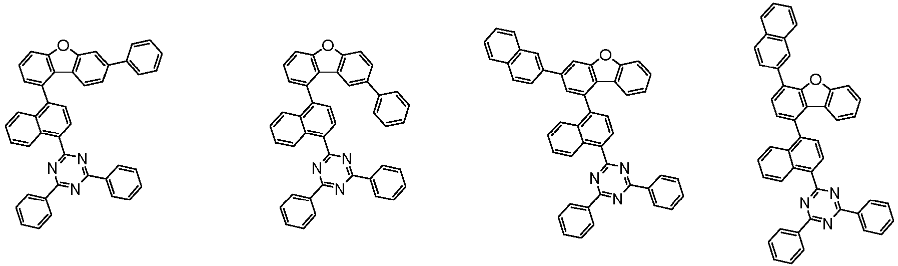

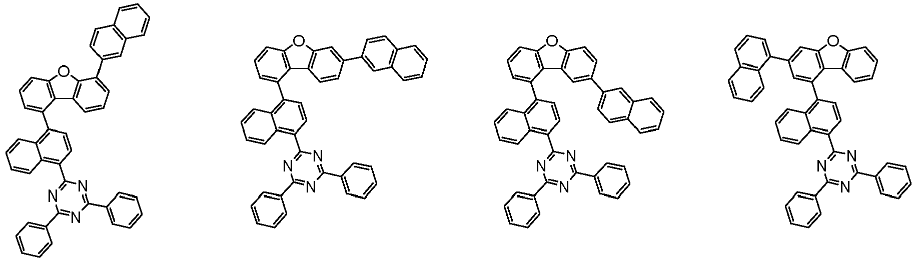

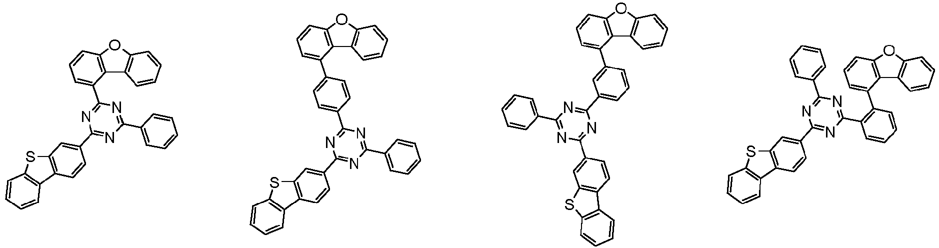

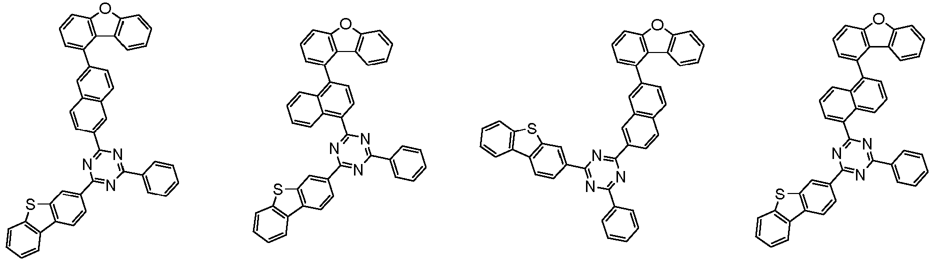

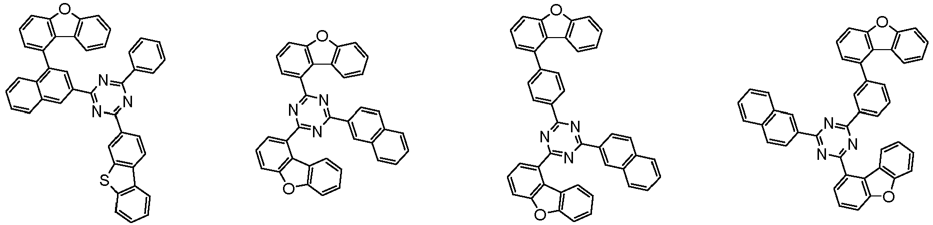

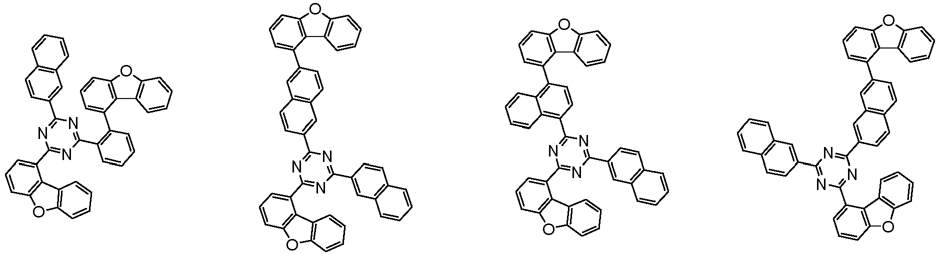

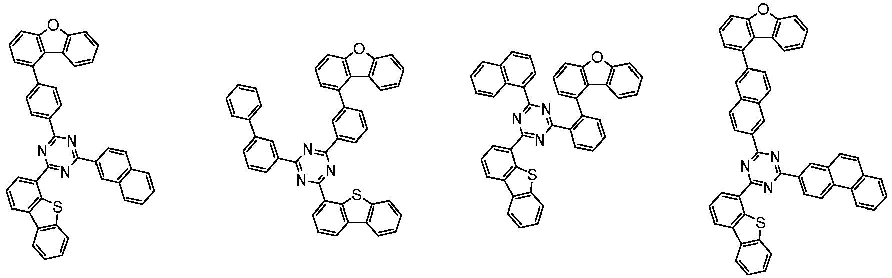

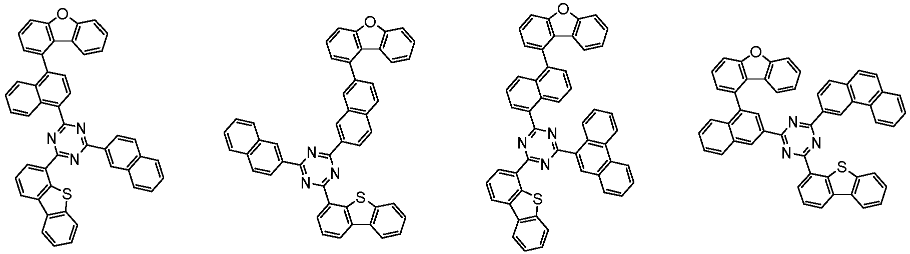

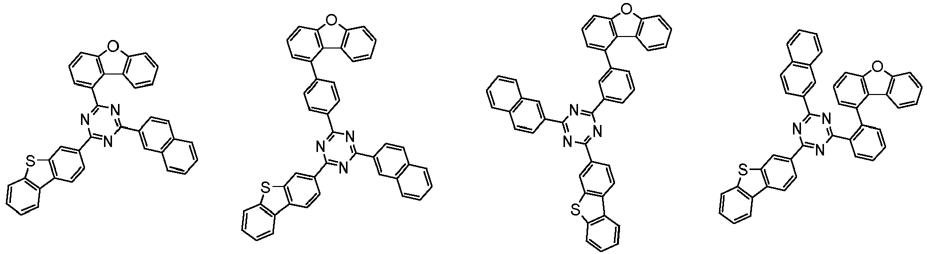

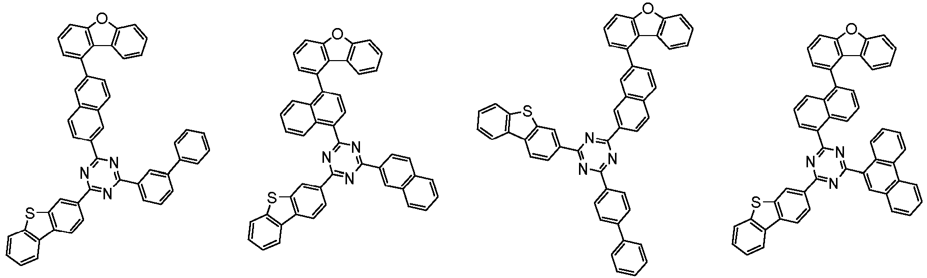

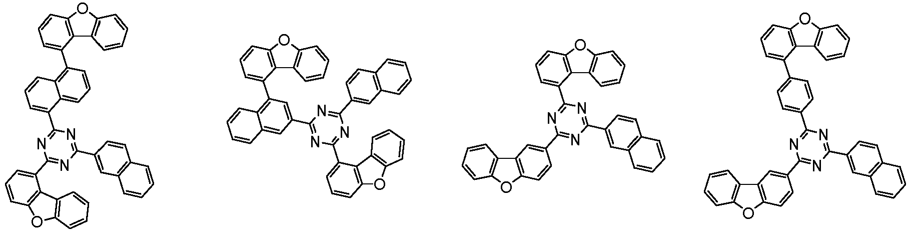

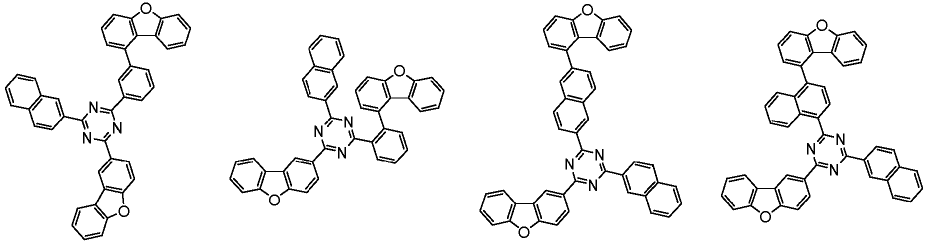

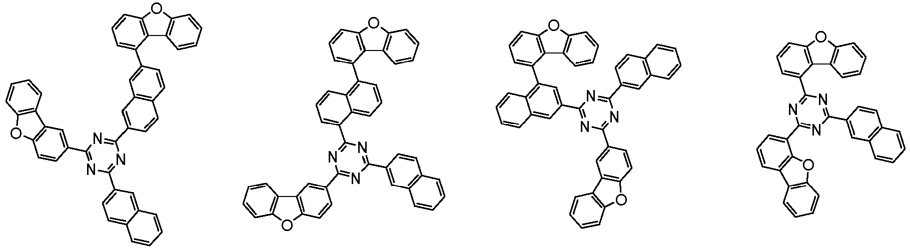

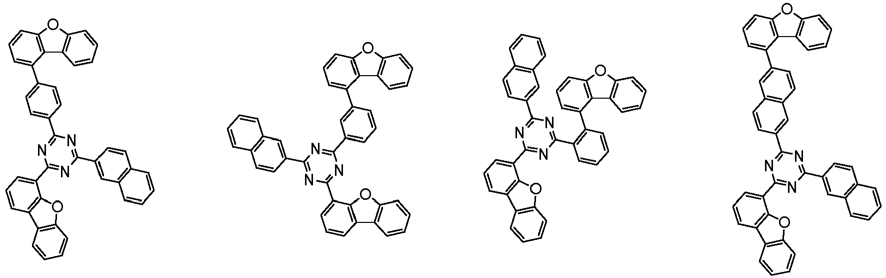

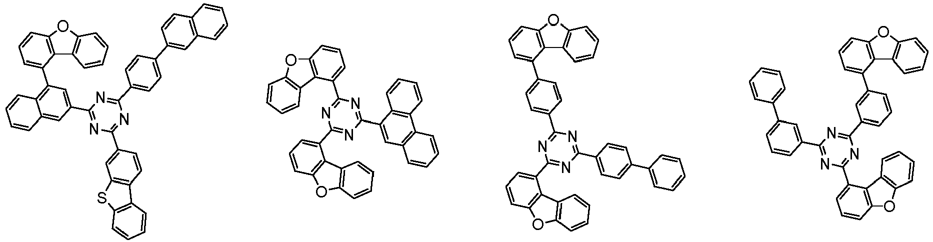

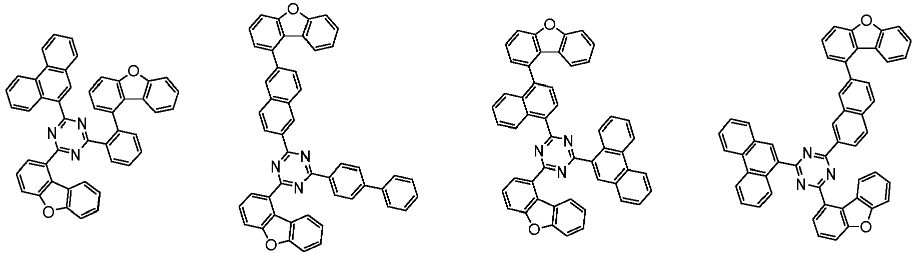

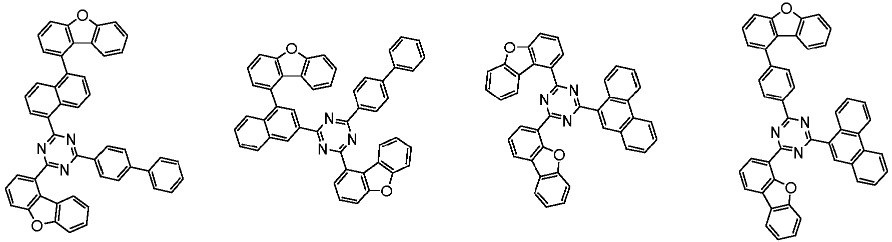

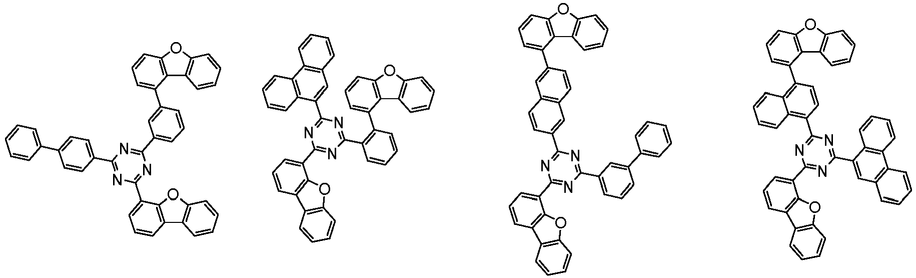

7. The organic light emitting device of Claim 1,
wherein the Chemical Formula 2 is represented by any one of the following Chemical Formulae 2-1 to 2-4: 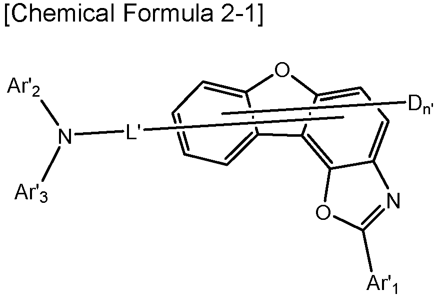 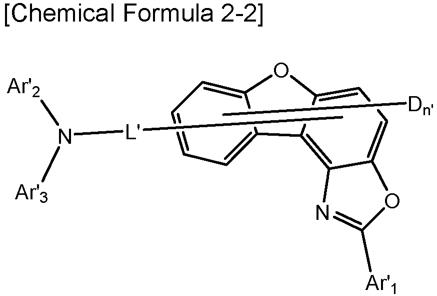 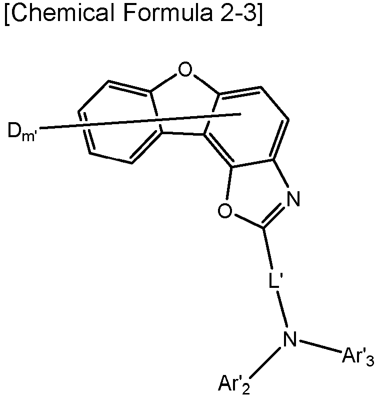 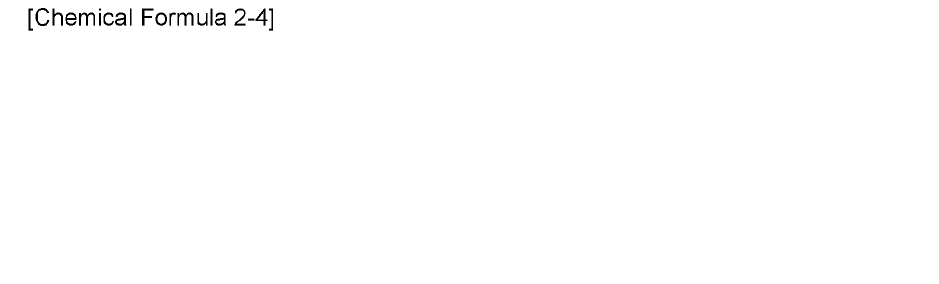 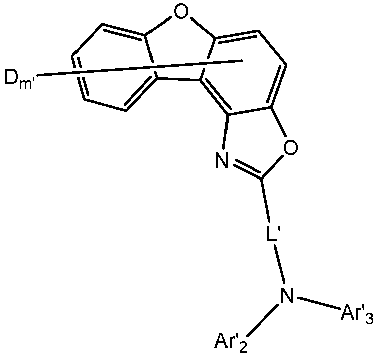 in the Chemical Formulae 2-1 to 2-4,
L', Ar'₁ to Ar'₃, D, and n' are as defined in Claim 1, and m' is an integer of 0 to 6.

8. The organic light emitting device of Claim 1,
wherein L' is a single bond; phenylene; or biphenyldiyl.

9. The organic light emitting device of Claim 1,
wherein Ar'₁ is phenyl.

10. The organic light emitting device of Claim 1,
wherein Ar'₂ and Ar'₃ are each independently phenyl; biphenylyl; terphenylyl; naphthyl; (naphthyl)phenyl; (phenyl)naphthyl; (naphthyl)biphenylyl; (naphthyl)naphthyl; [(phenyl)naphthyl]phenyl; dibenzofuranyl; dibenzothiophenyl; (dibenzofuranyl)phenyl; (dibenzothiophenyl)phenyl; phenanthrenyl; (phenanthrenyl)phenyl; 9,9-dimethylfluorenyl; or 9-phenylcarbazolyl.

11. The organic light emitting device of Claim 1,
wherein the compound represented by the Chemical Formula 2 is any one selected from the group consisting of:

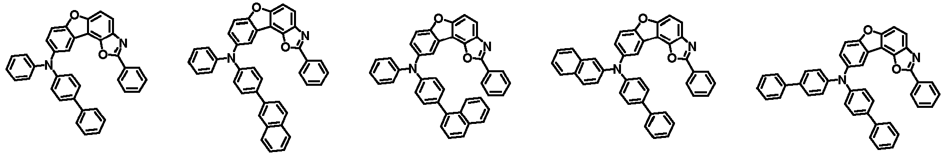

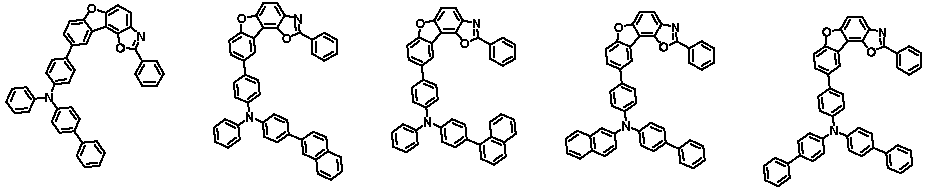

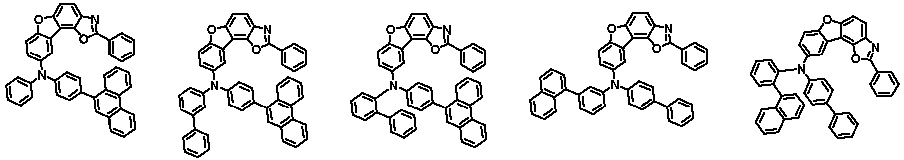

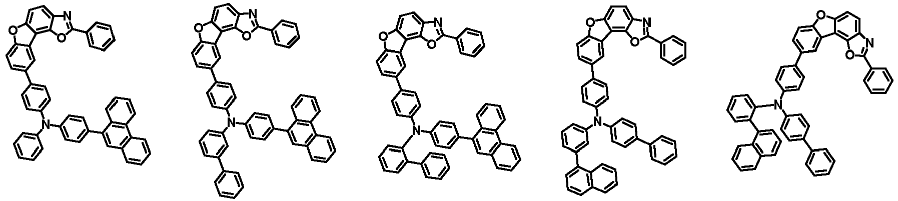

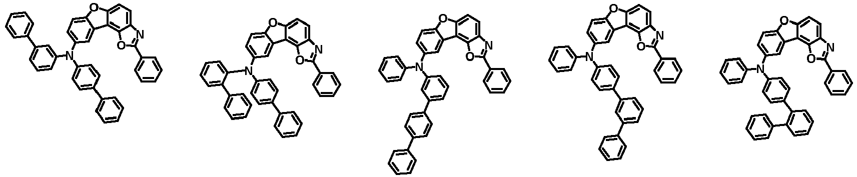

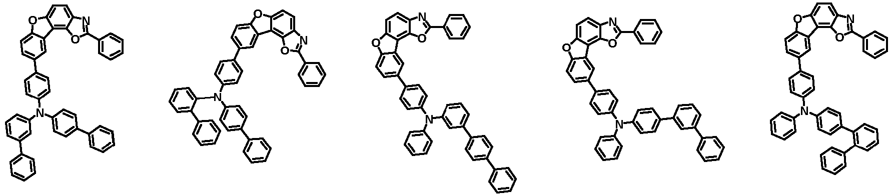

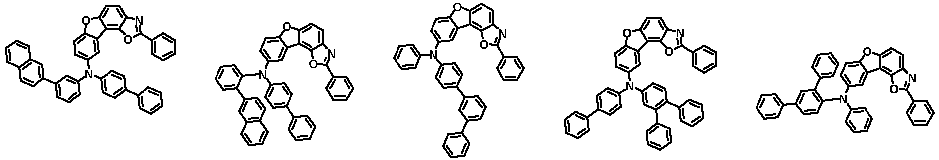

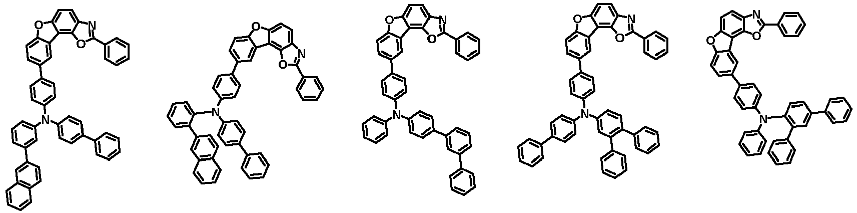

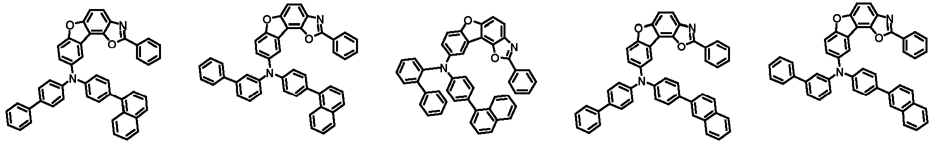

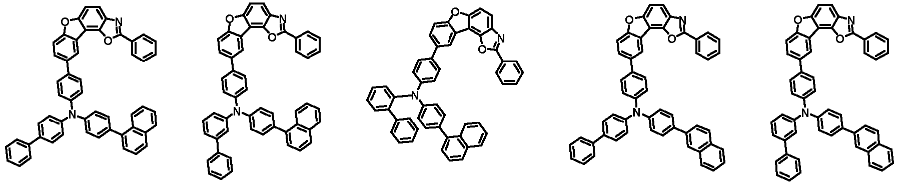

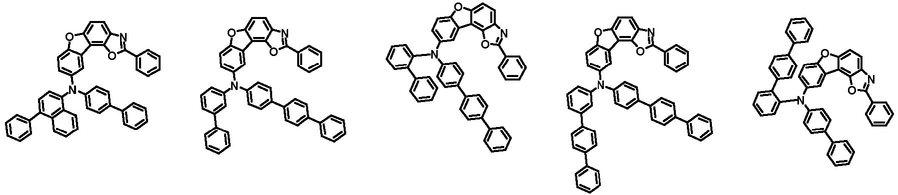

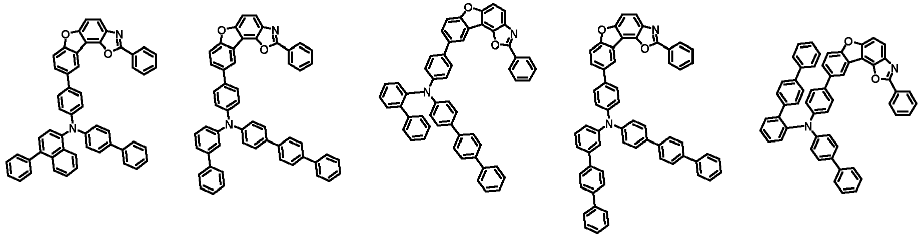

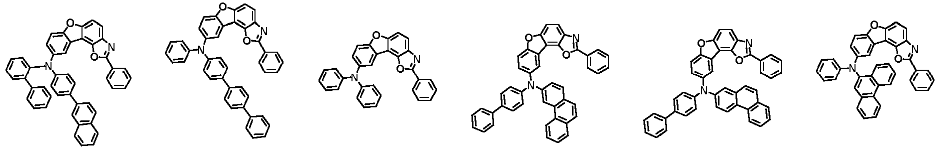

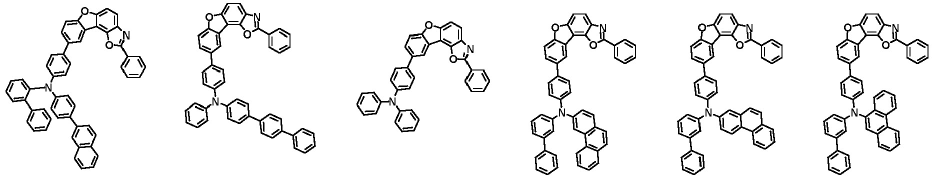

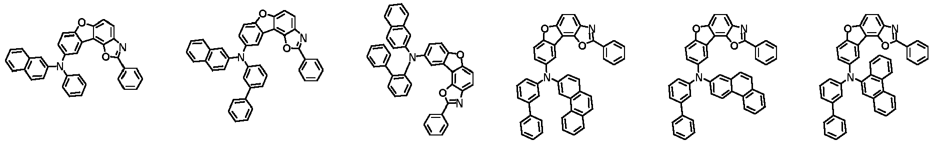

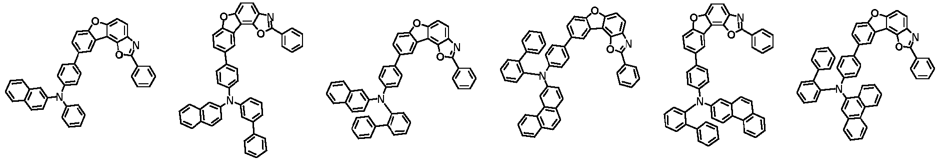

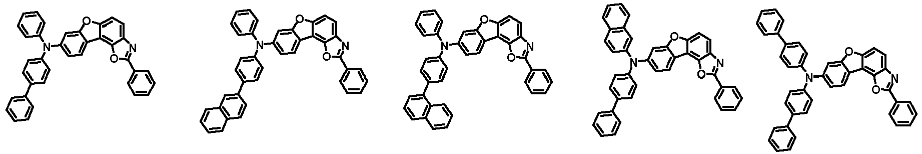

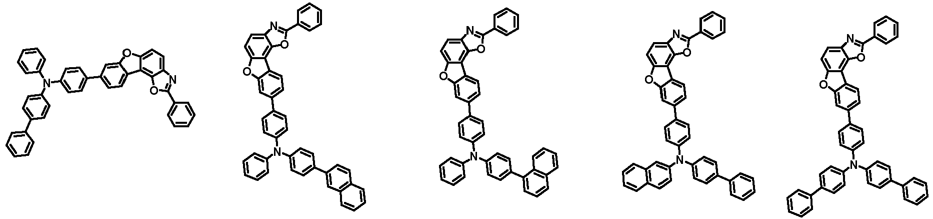

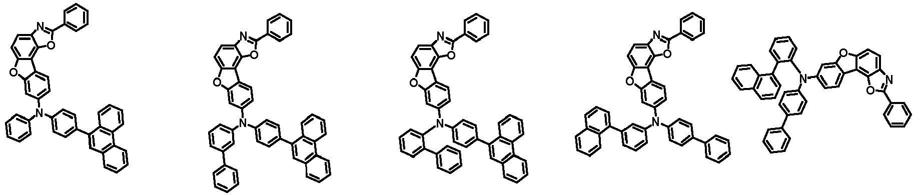

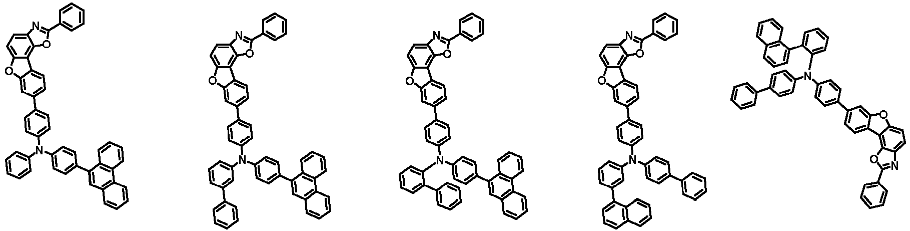

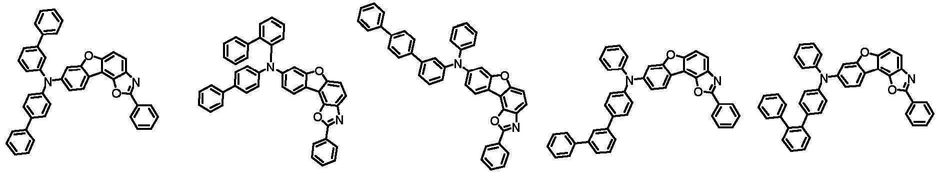

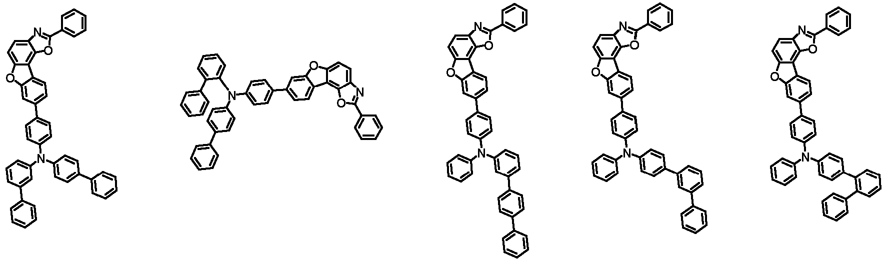

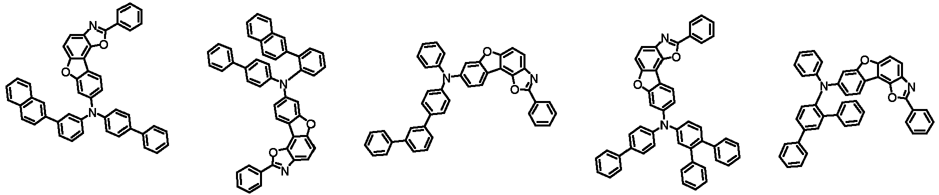

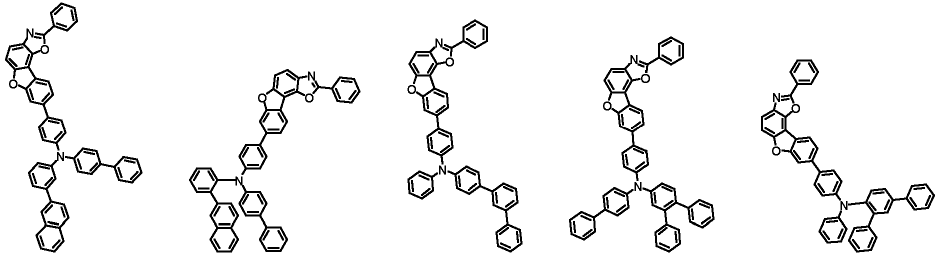

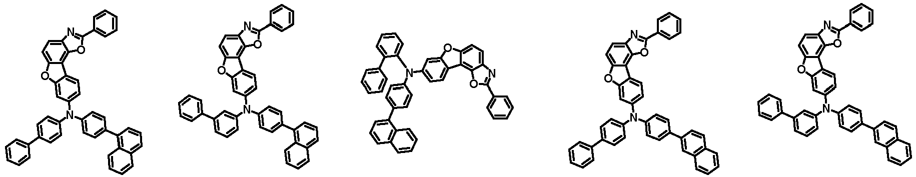

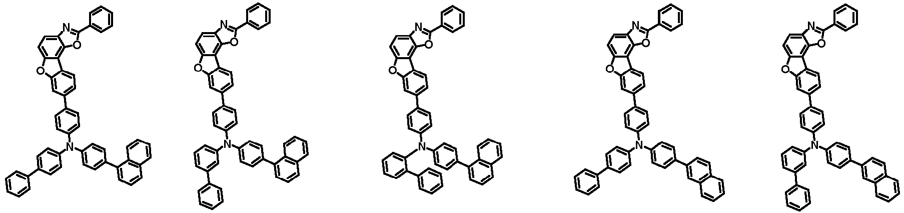

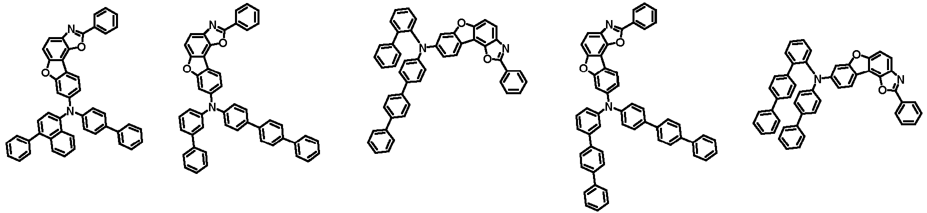

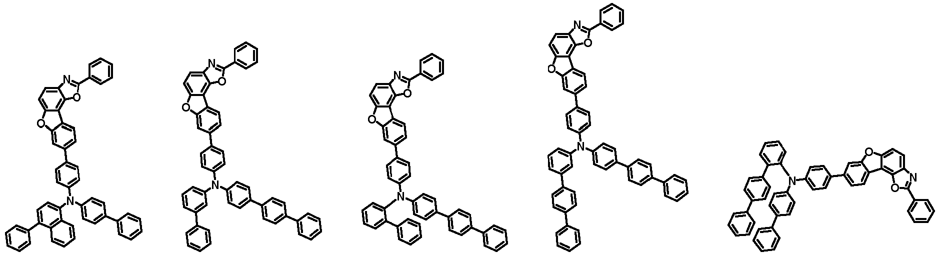

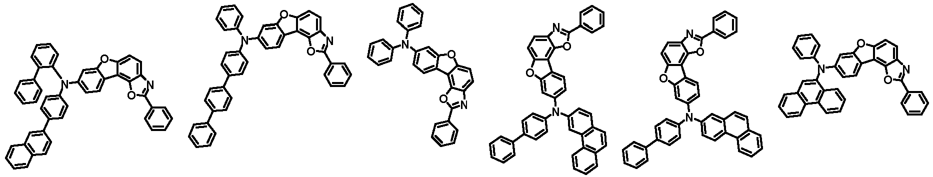

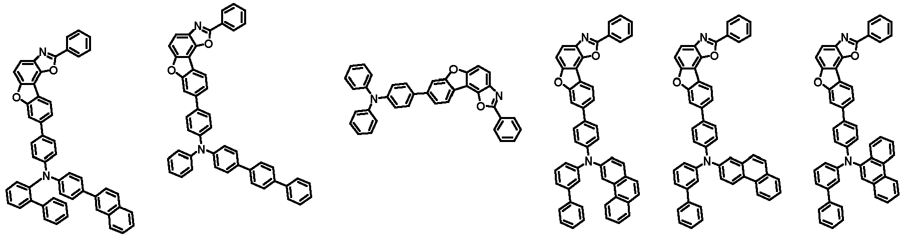

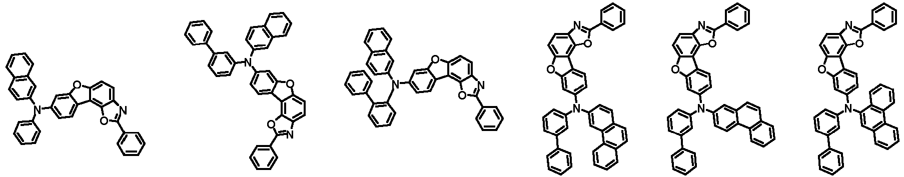

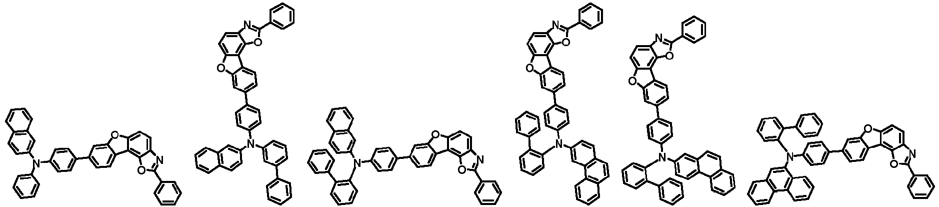

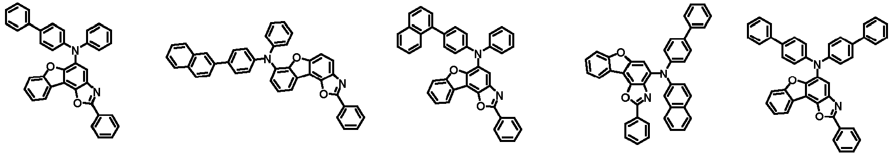

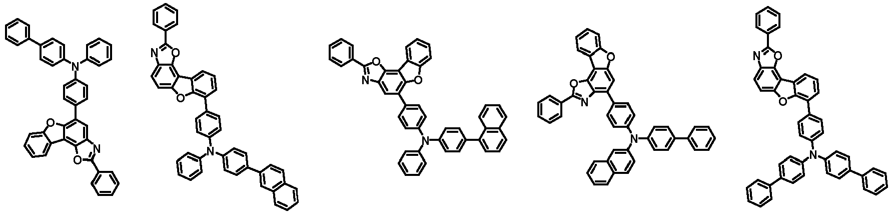

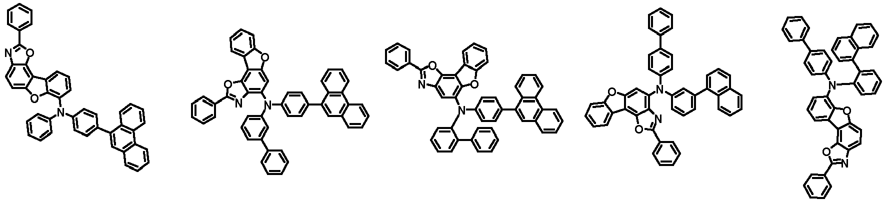

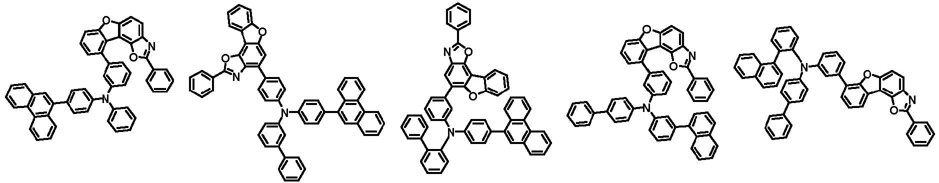

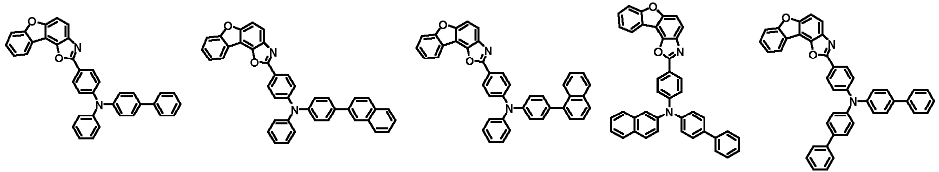

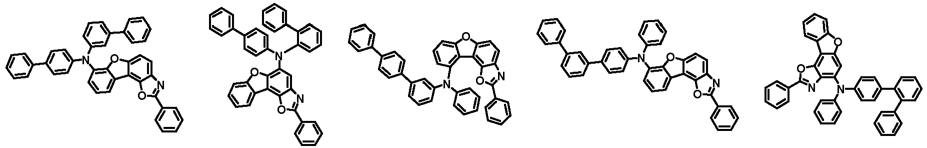

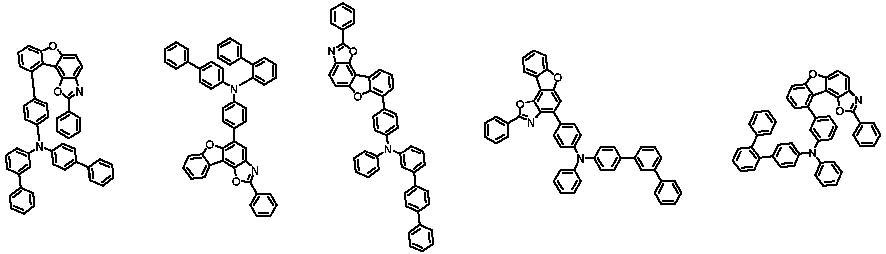

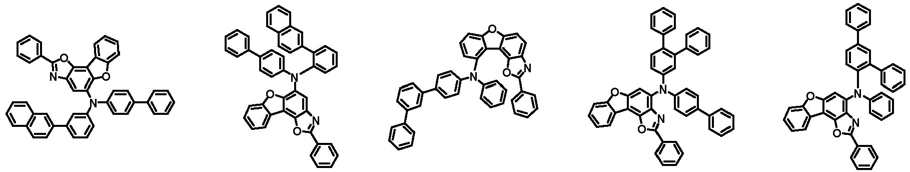

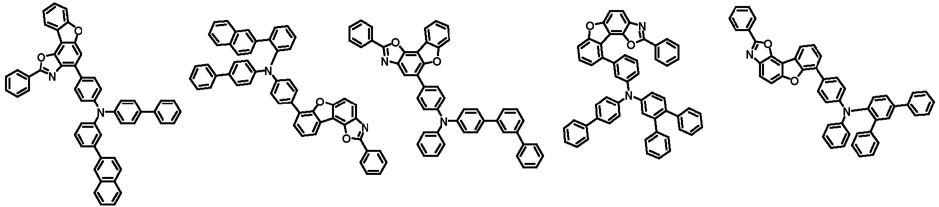

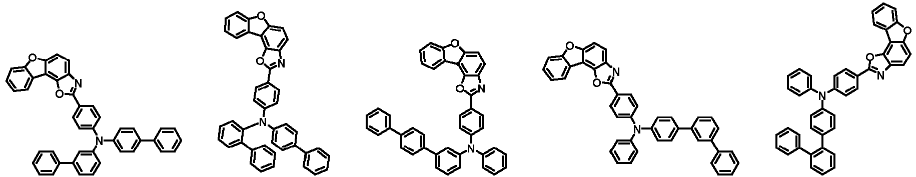

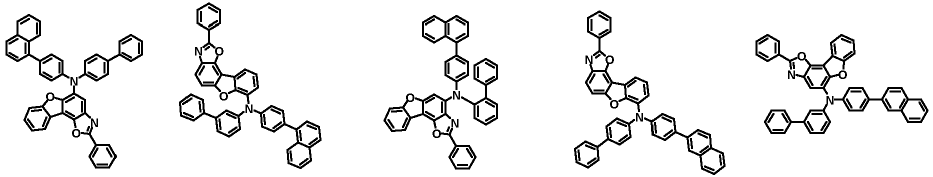

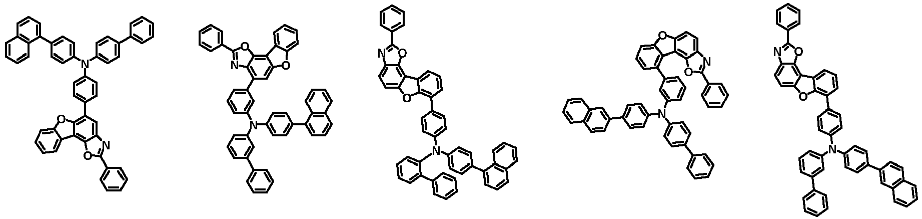

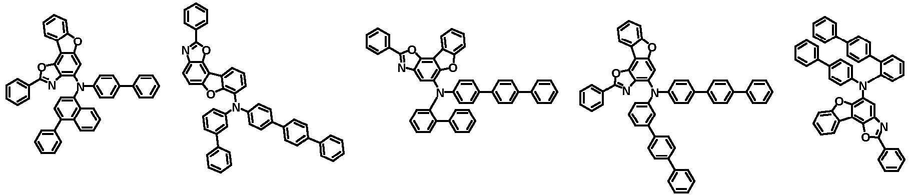

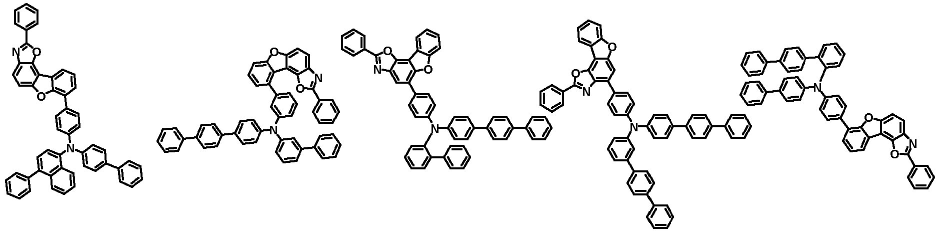

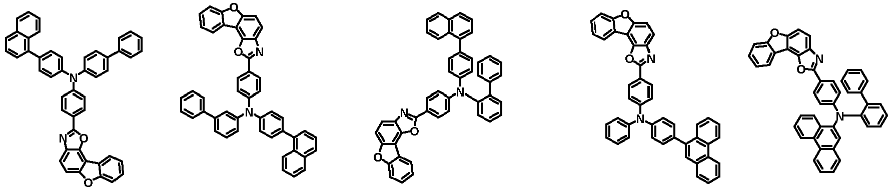

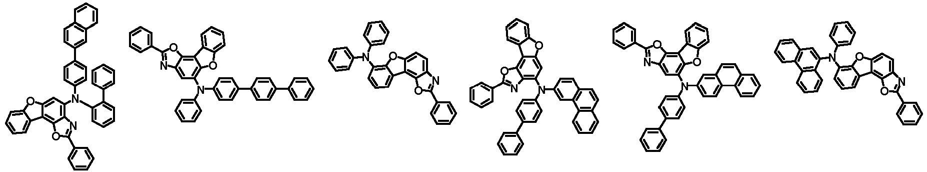

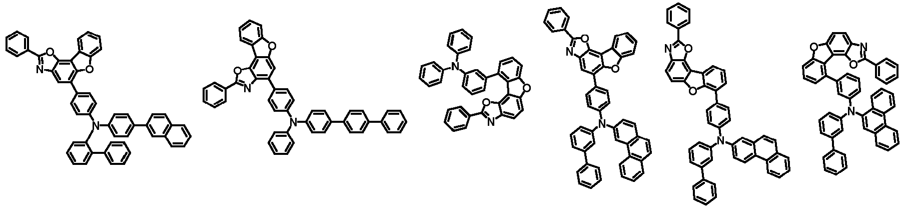

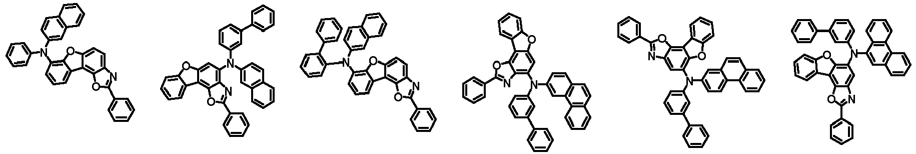

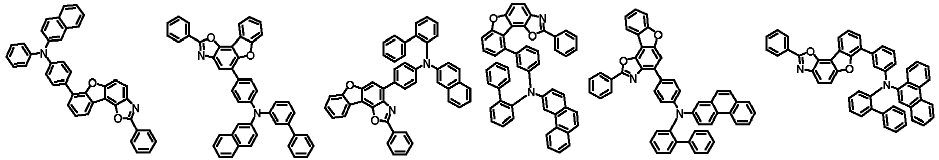

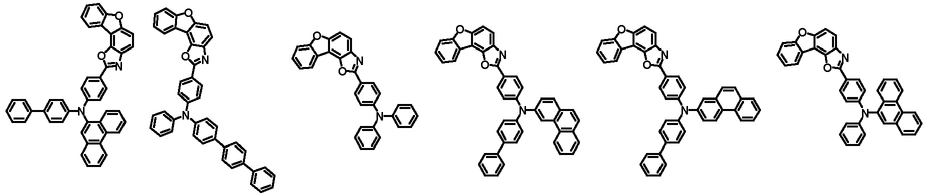

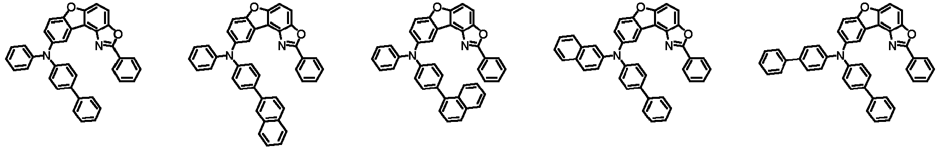

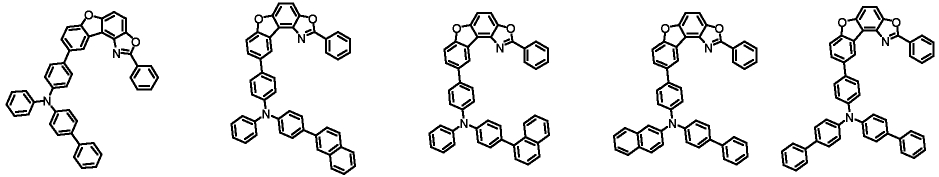

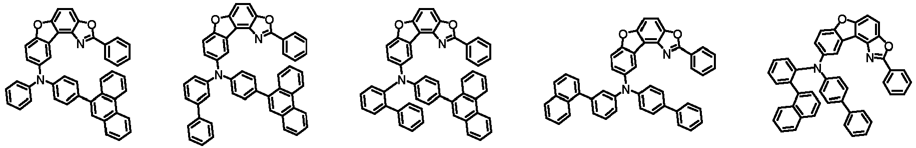

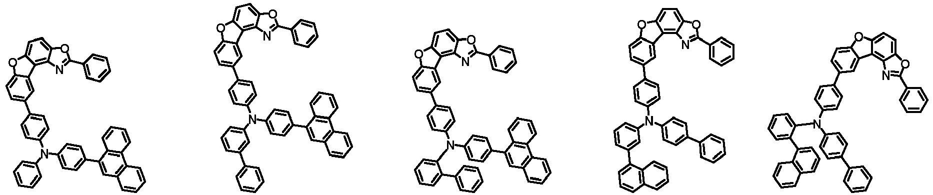

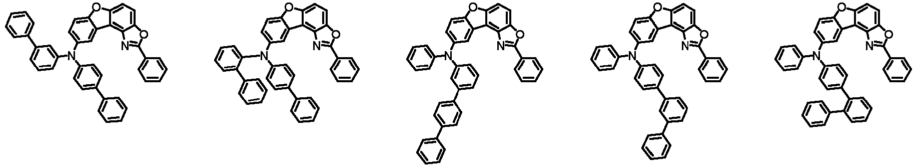

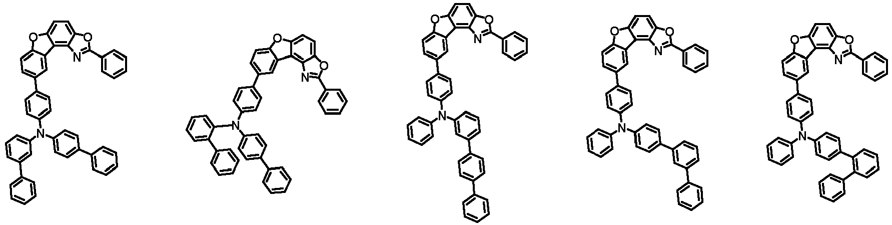

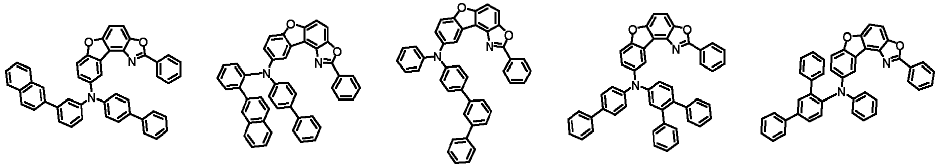

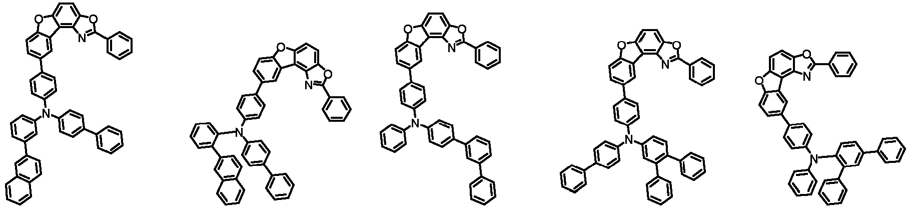

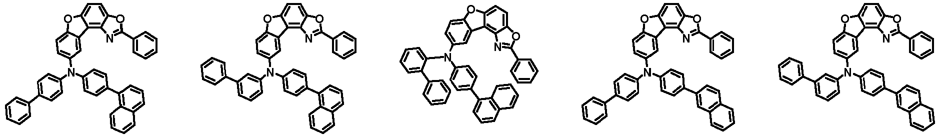

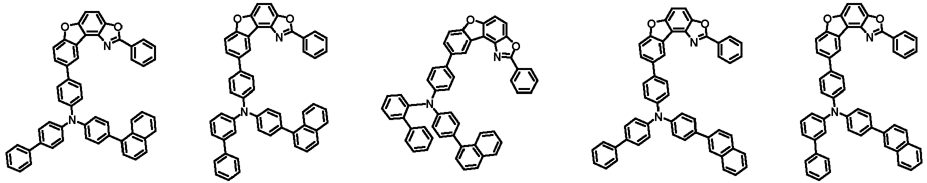

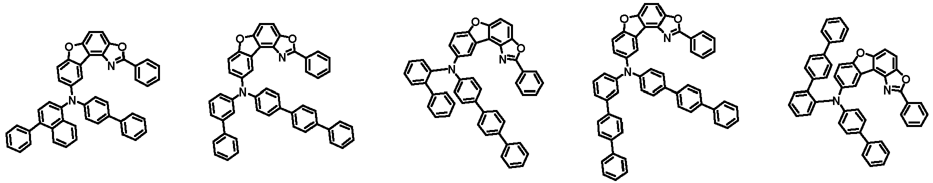

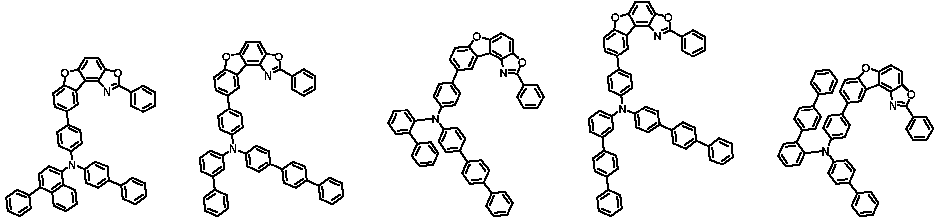

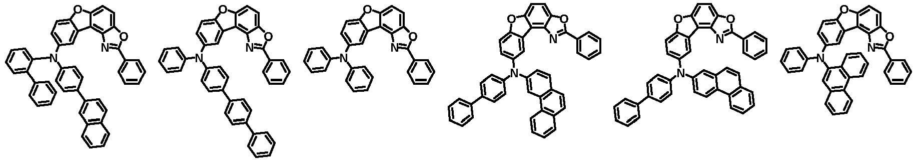

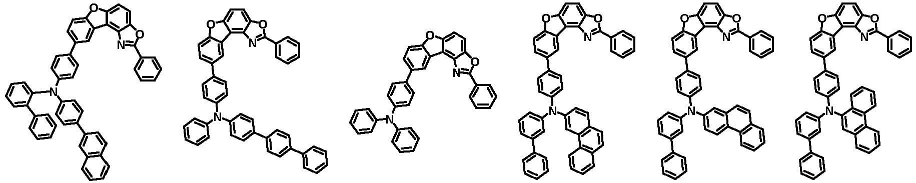

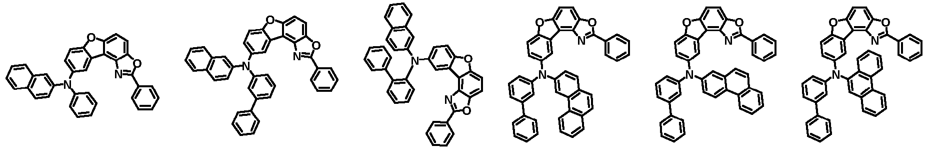

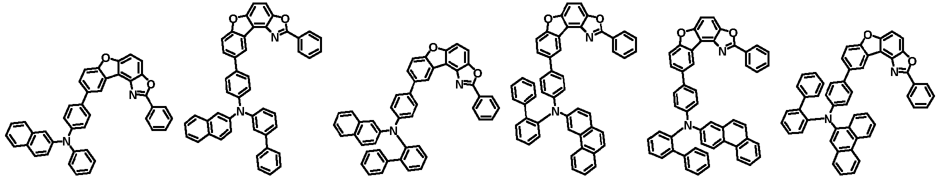

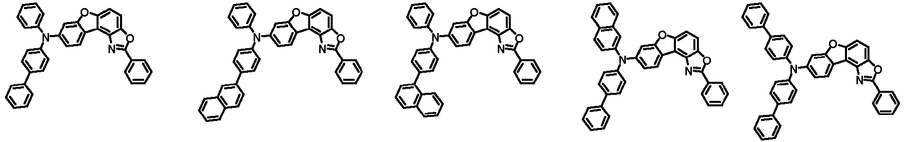

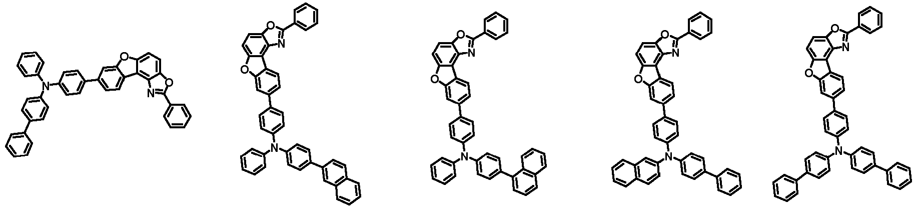

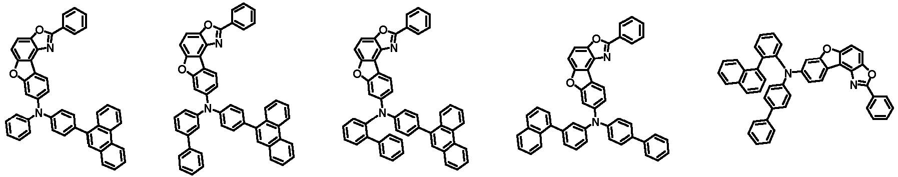

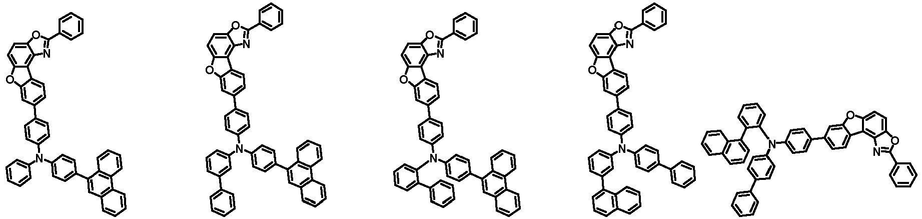

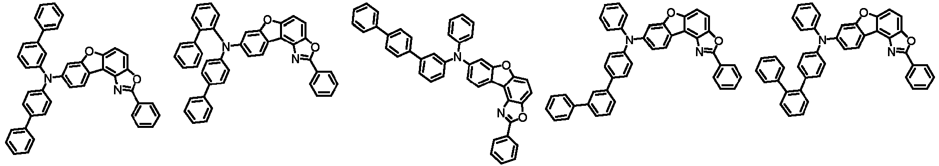

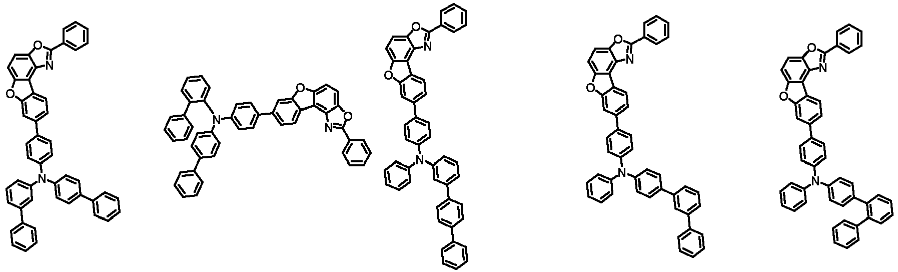

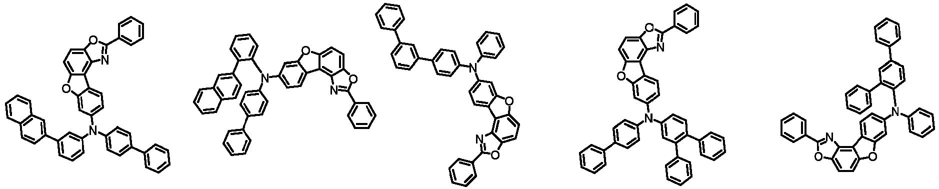

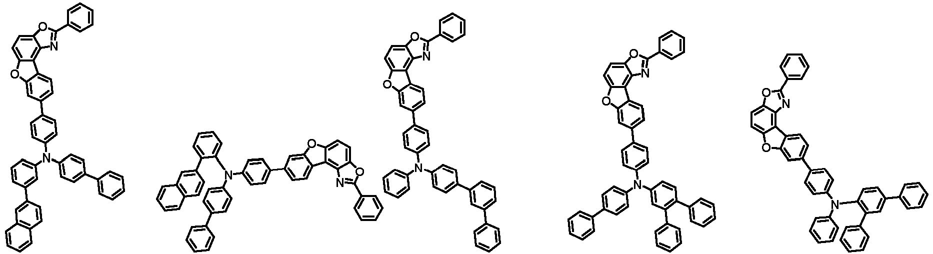

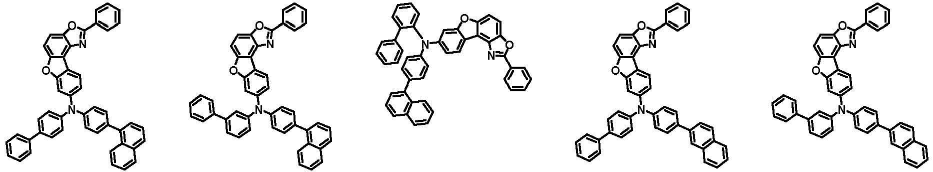

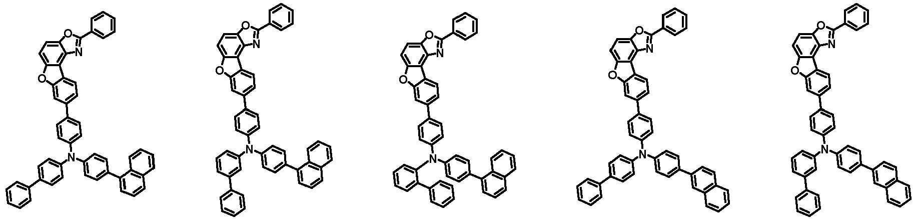

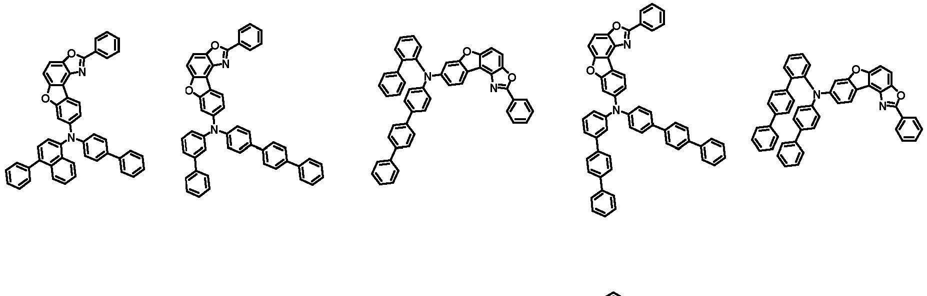

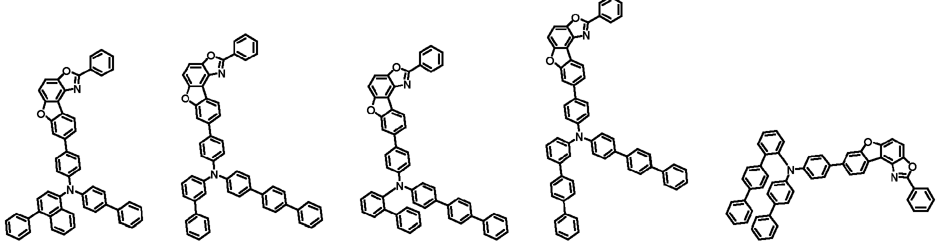

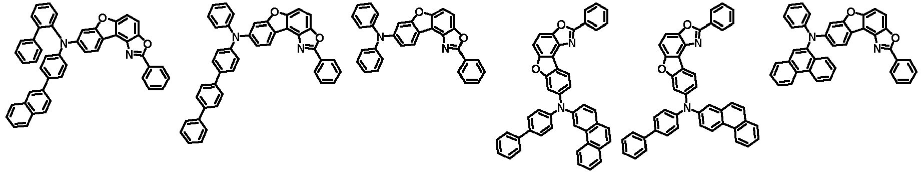

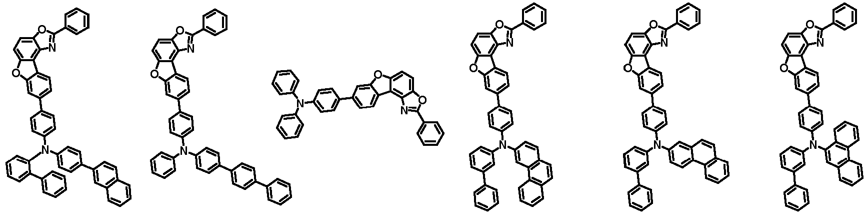

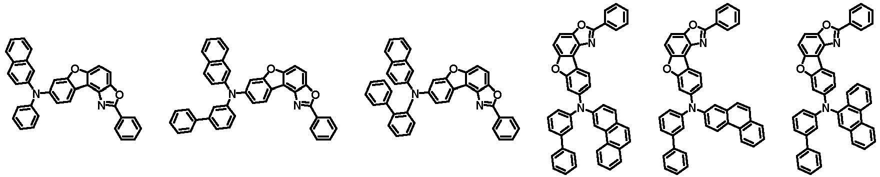

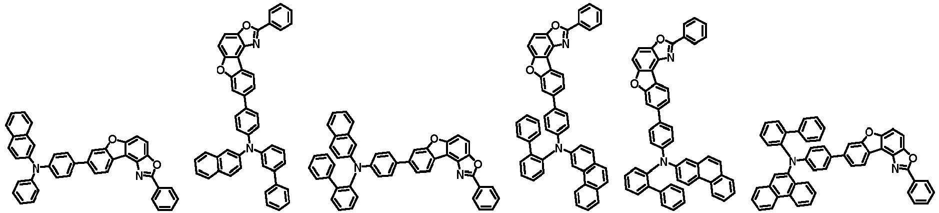

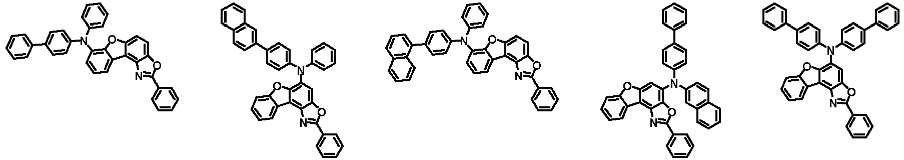

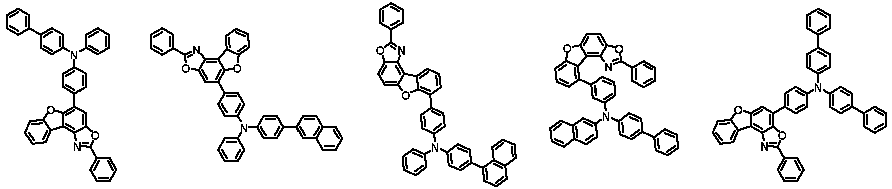

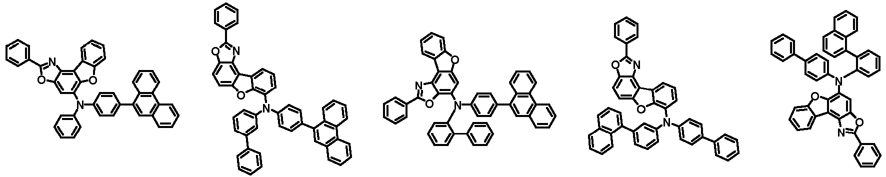

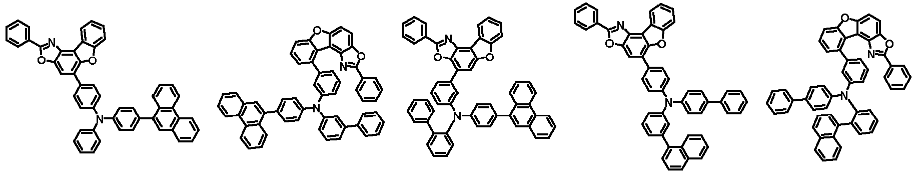

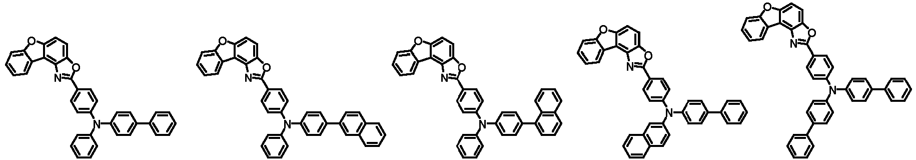

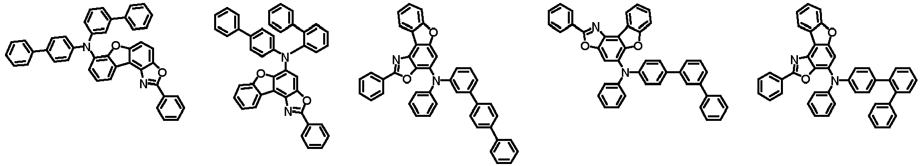

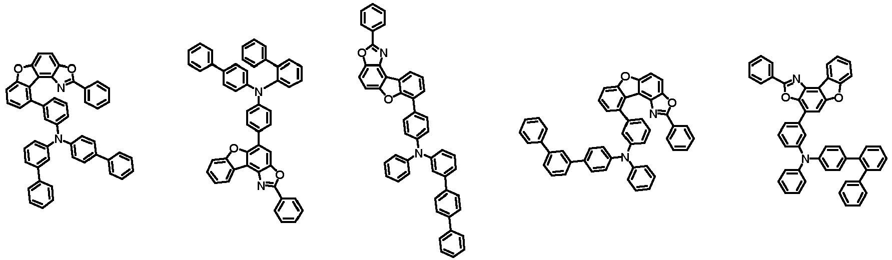

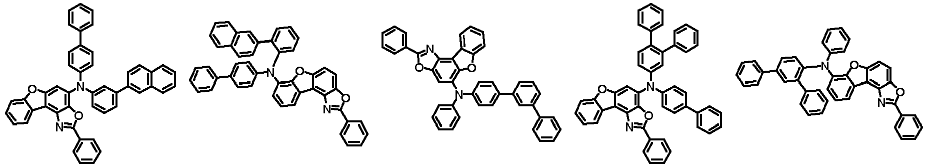

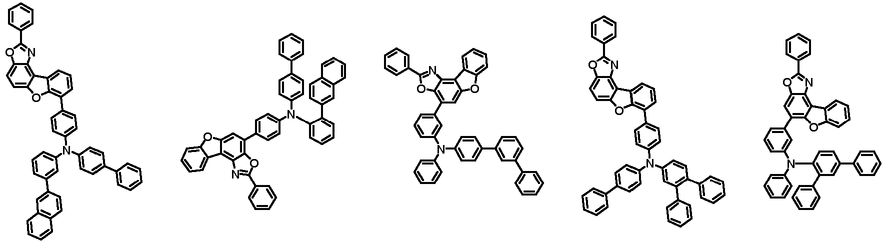

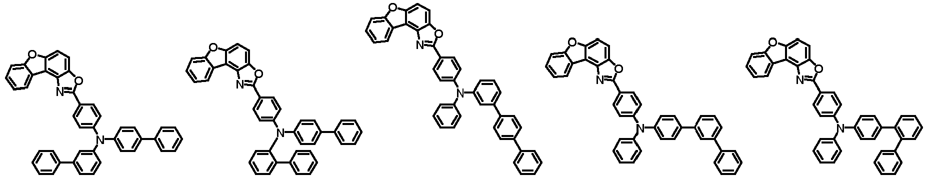

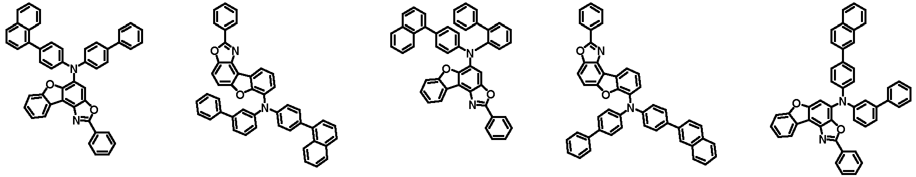

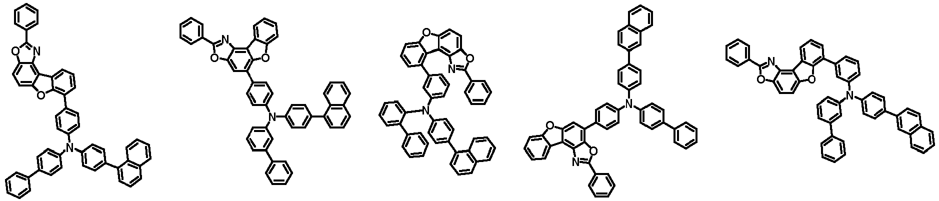

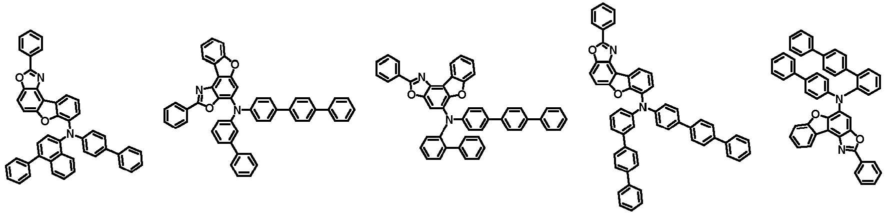

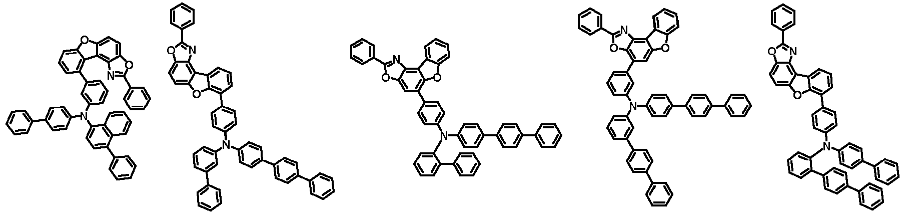

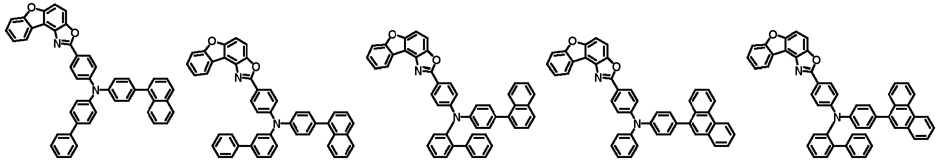

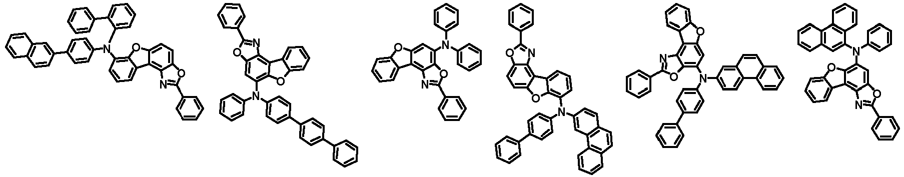

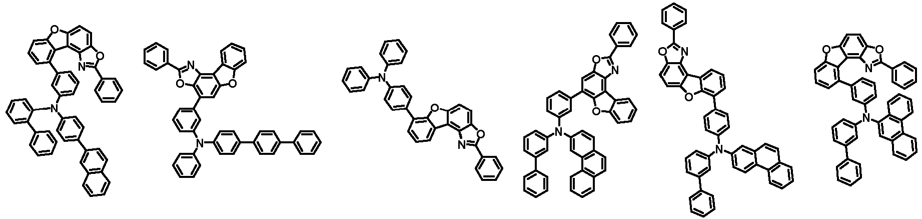

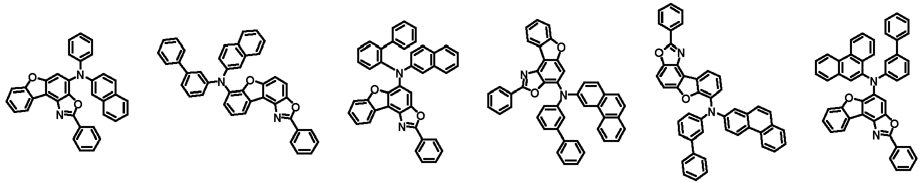

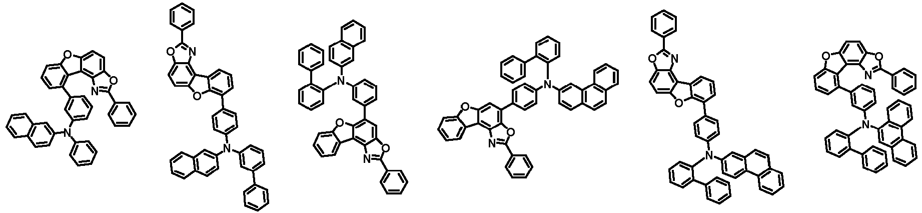

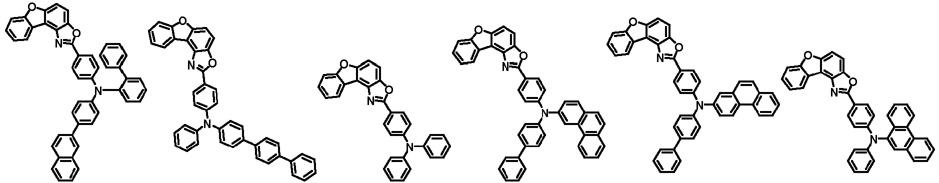

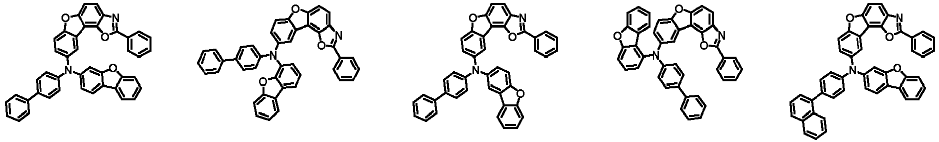

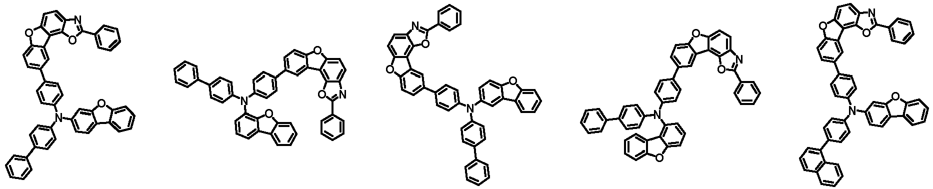

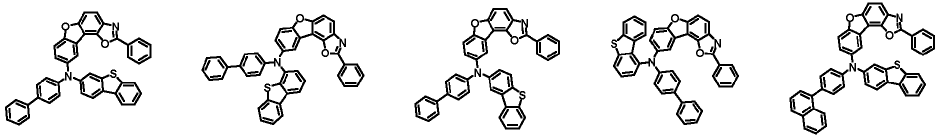

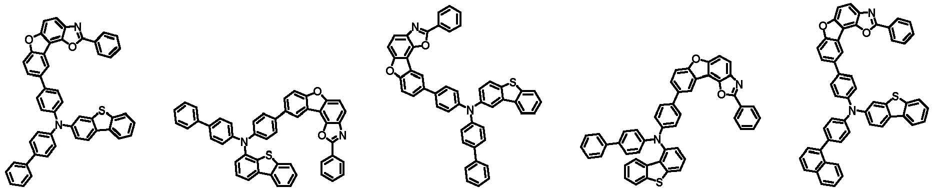

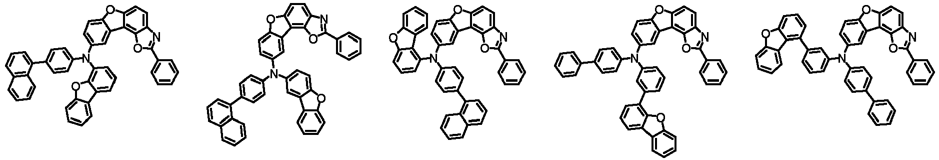

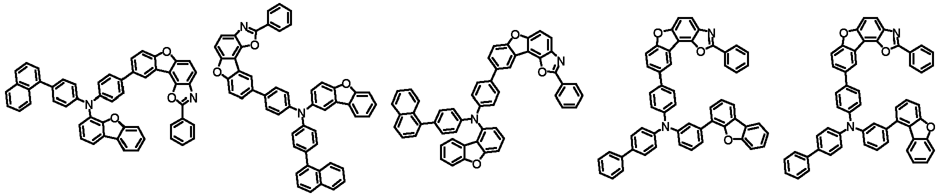

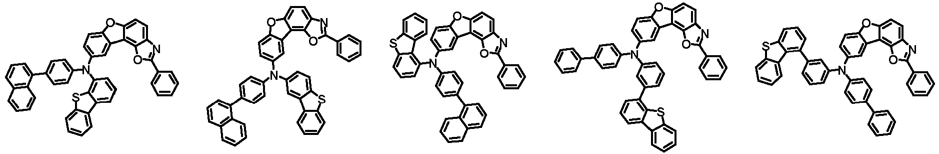

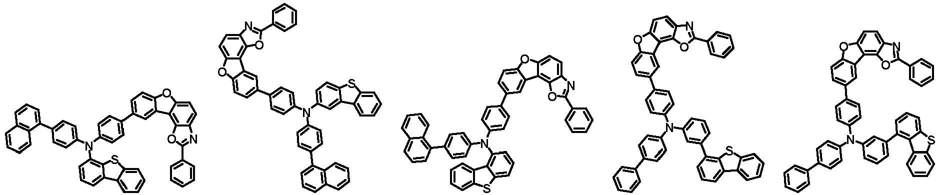

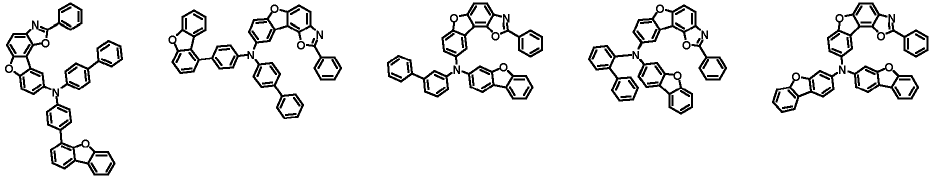

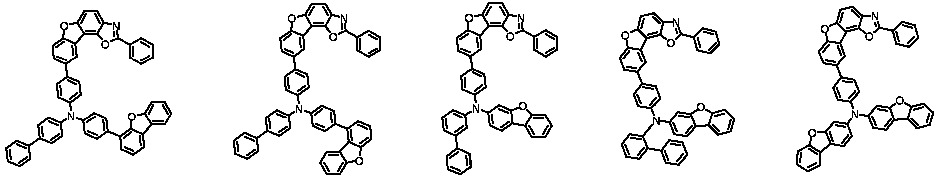

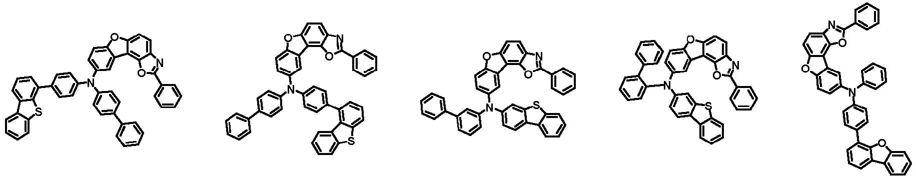

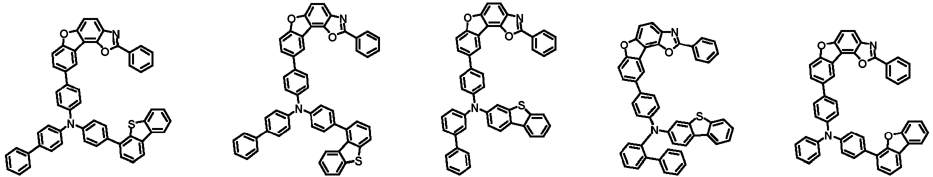

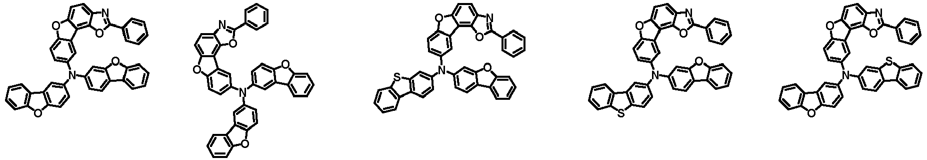

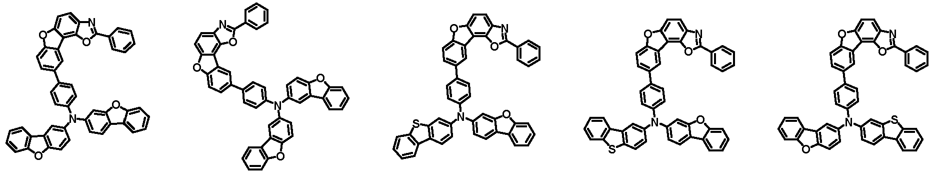

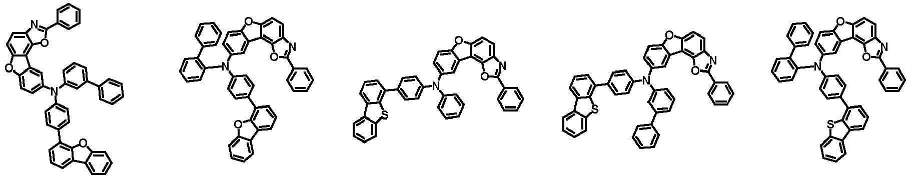

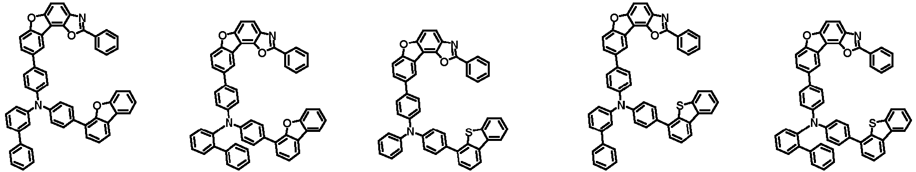

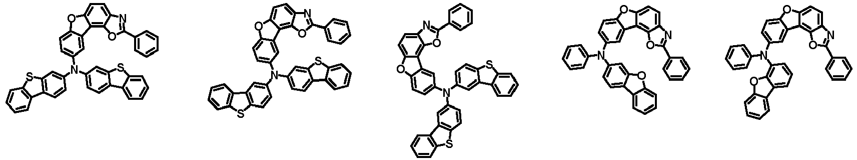

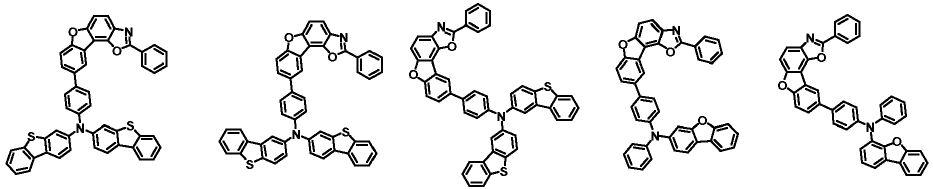

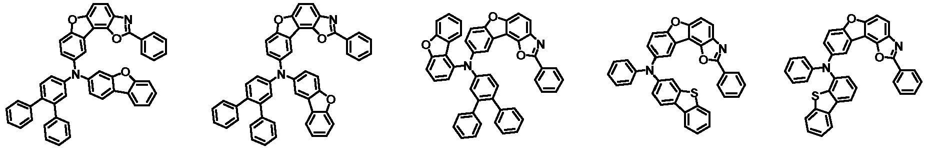

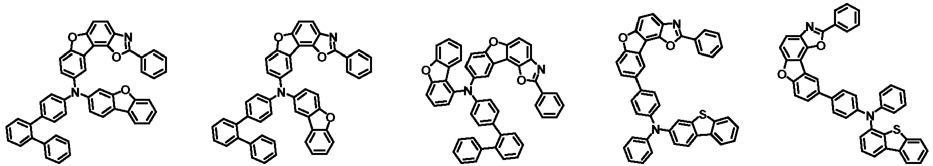

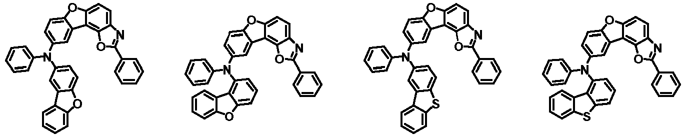

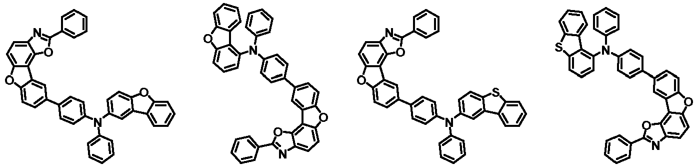

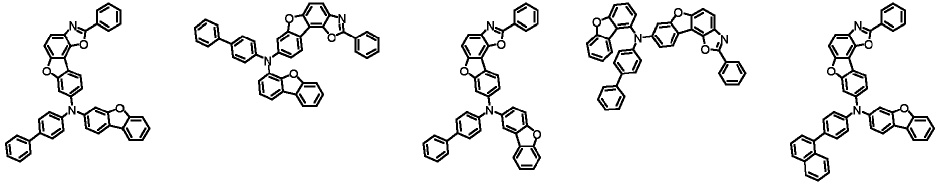

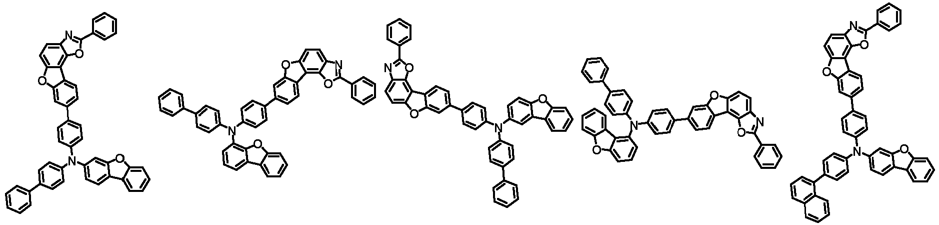

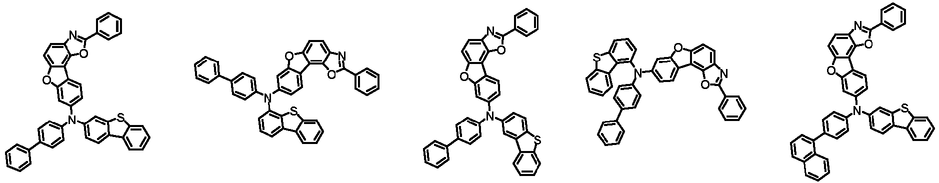

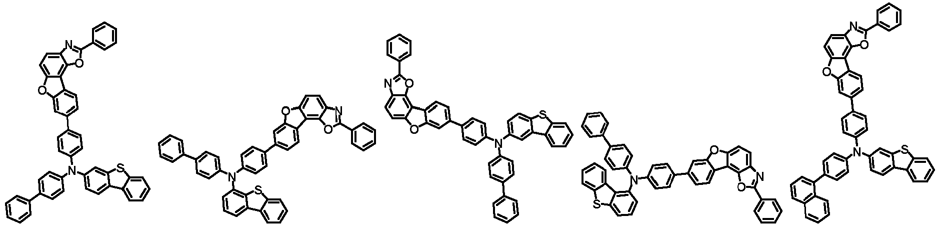

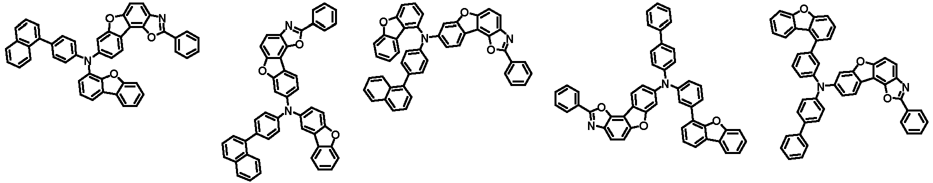

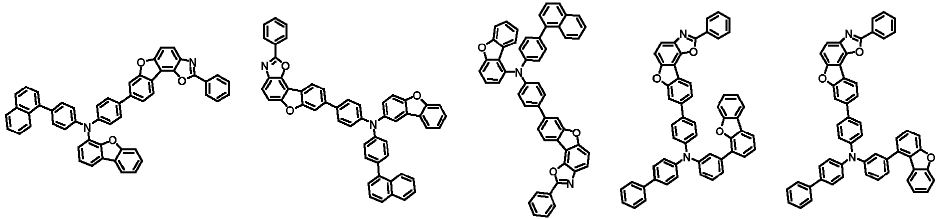

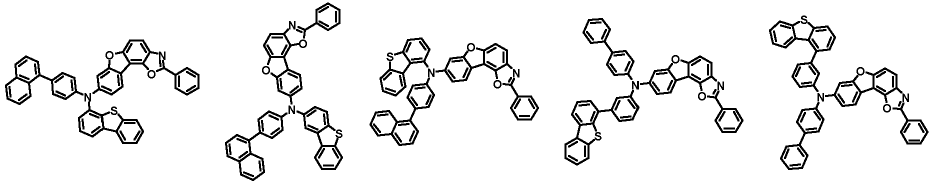

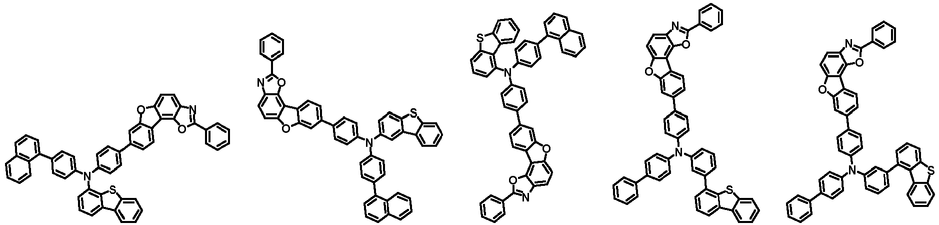

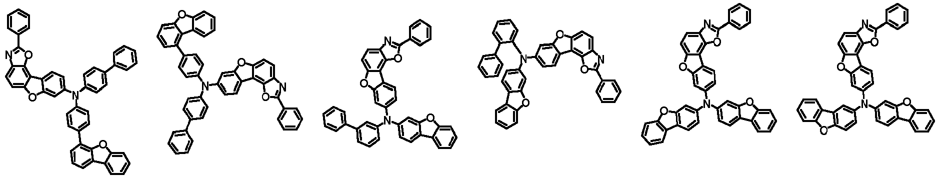

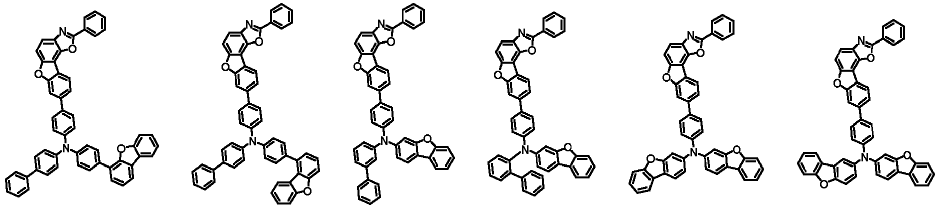

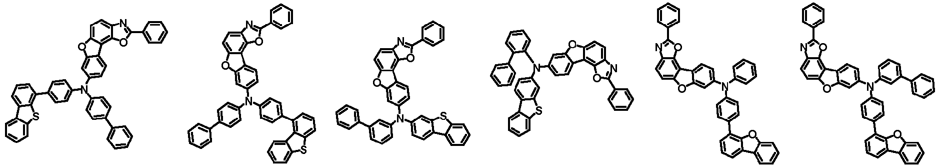

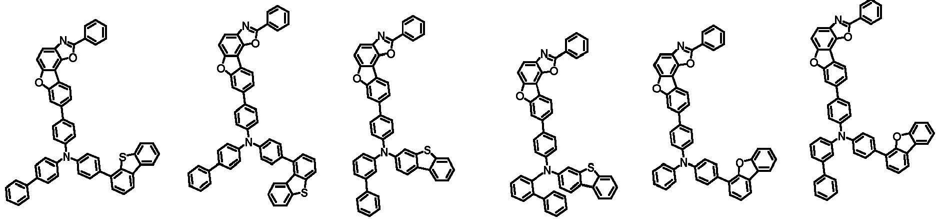

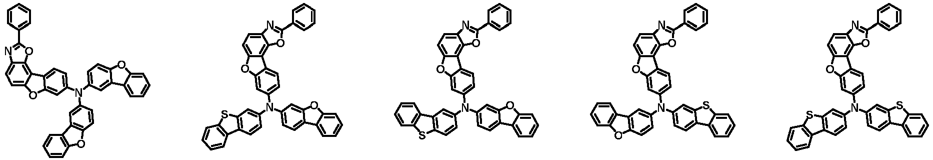

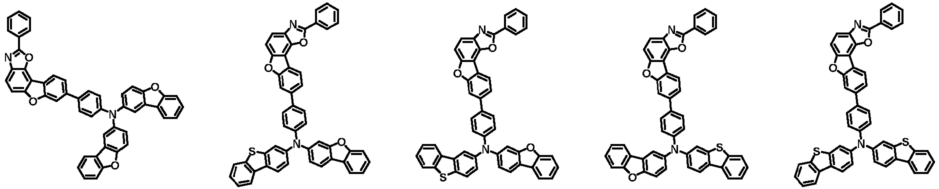

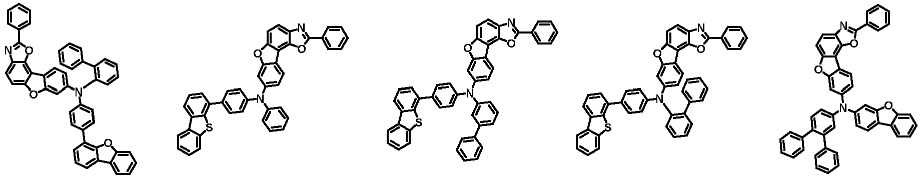

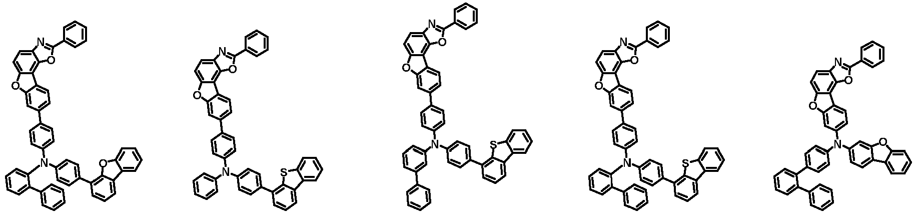

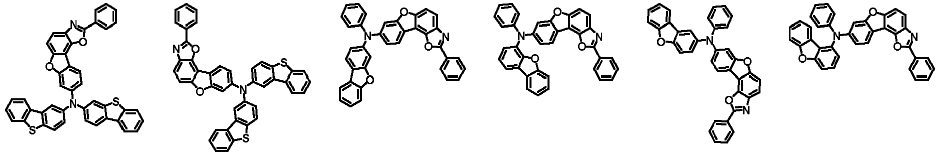

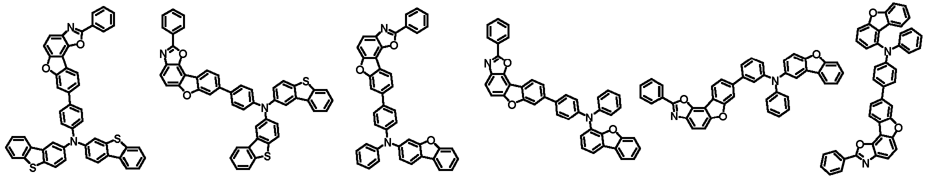

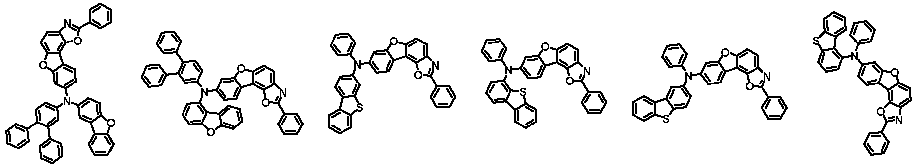

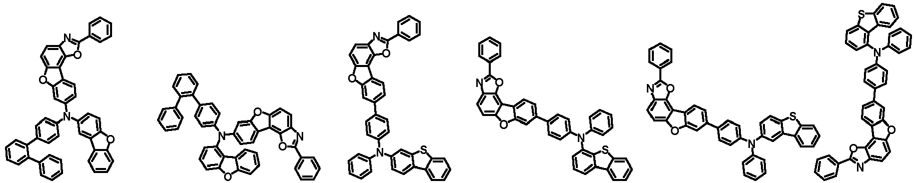

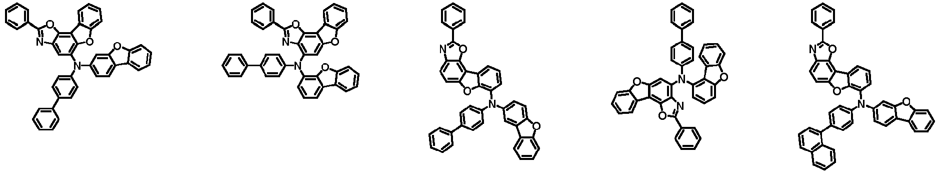

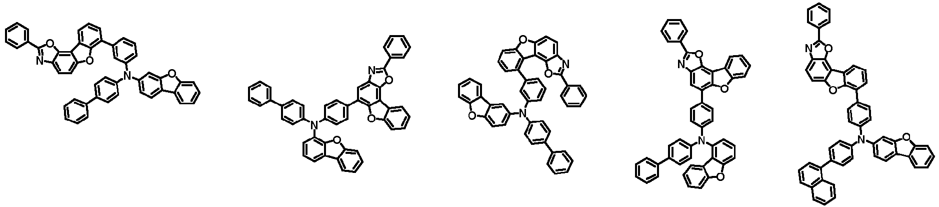

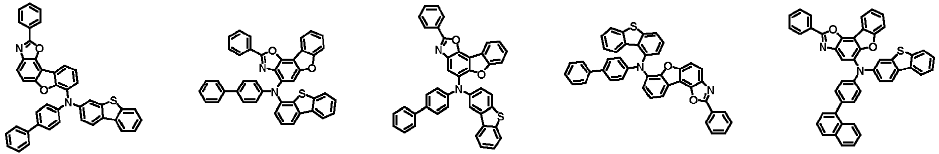

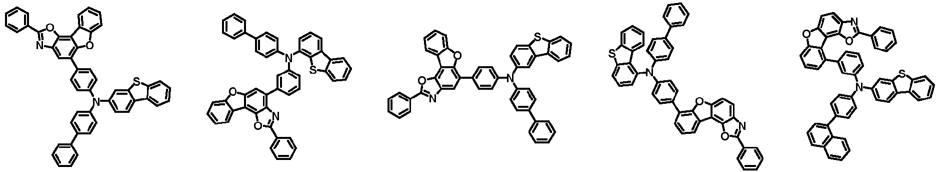

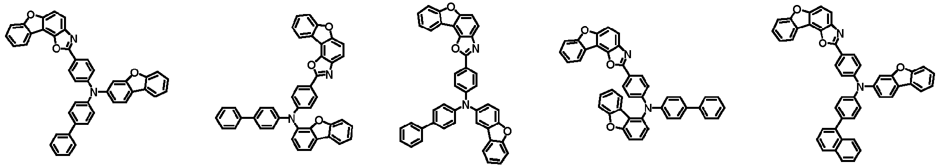

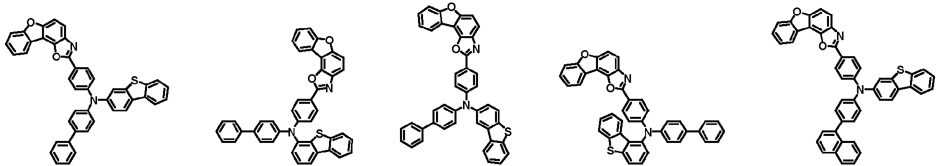

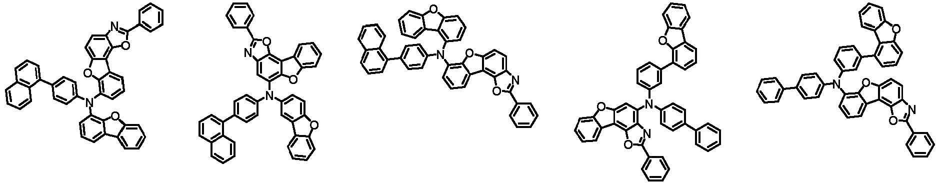

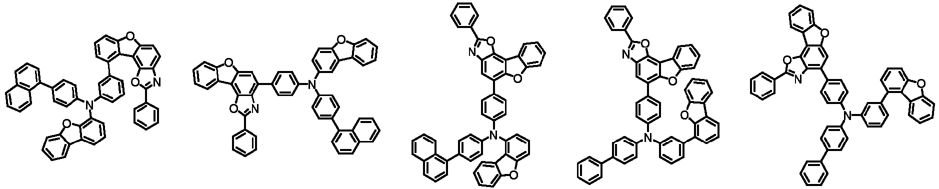

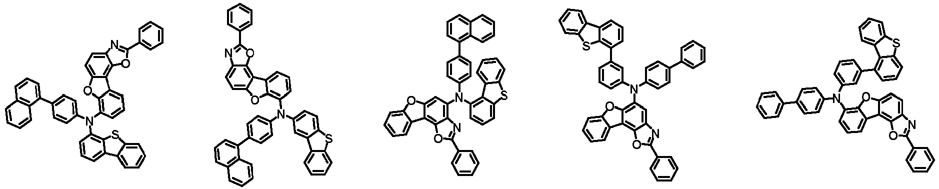

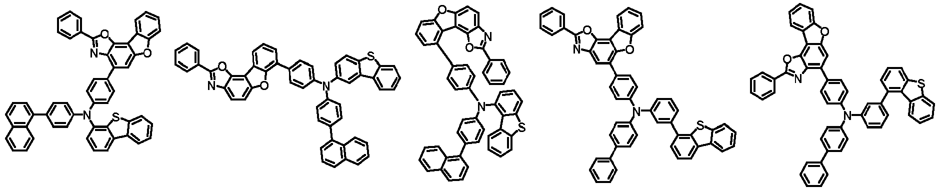

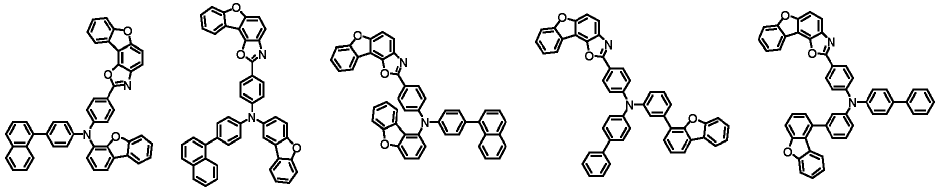

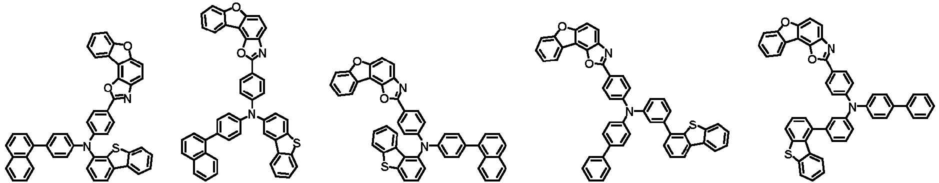

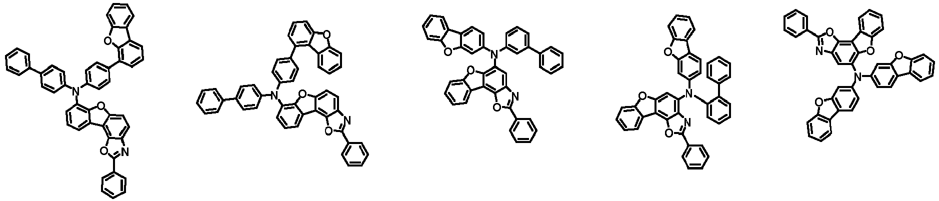

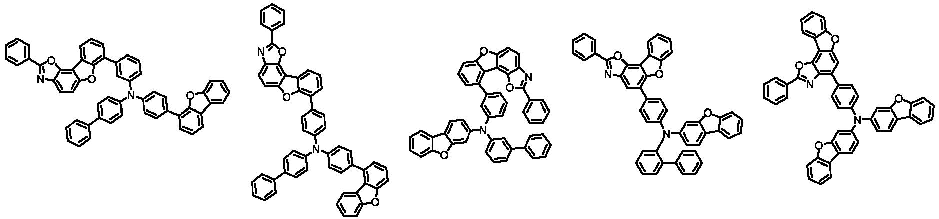

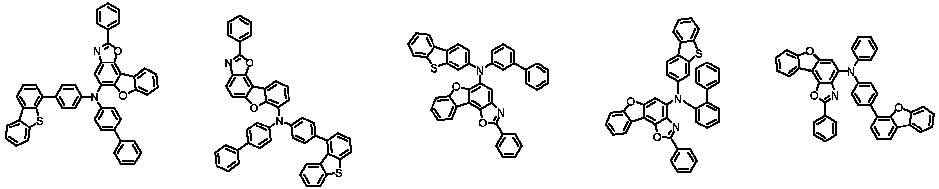

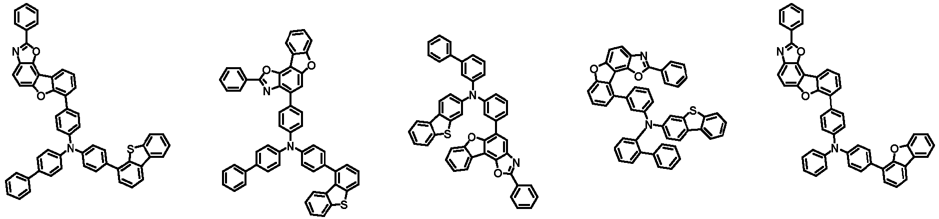

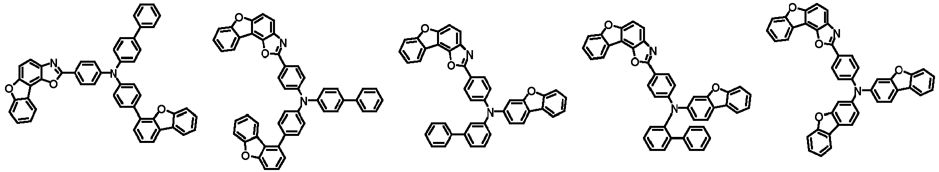

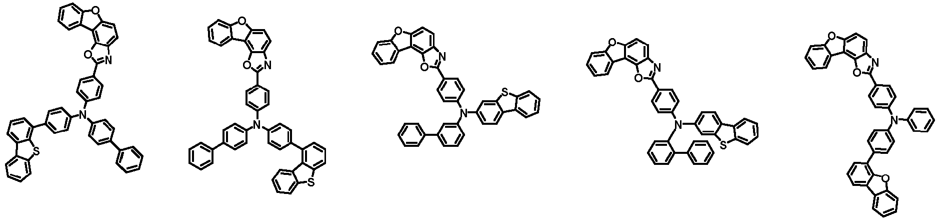

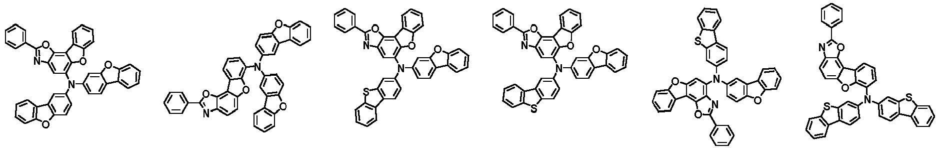

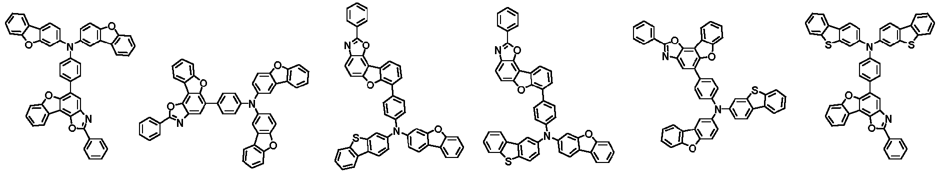

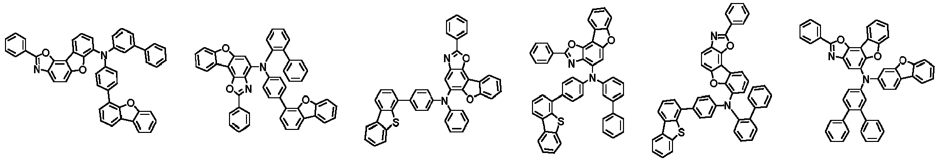

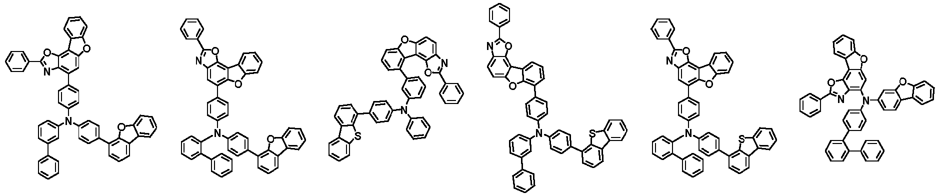

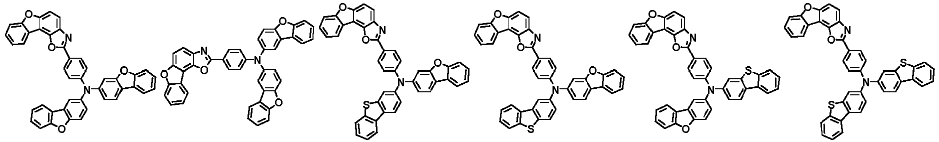

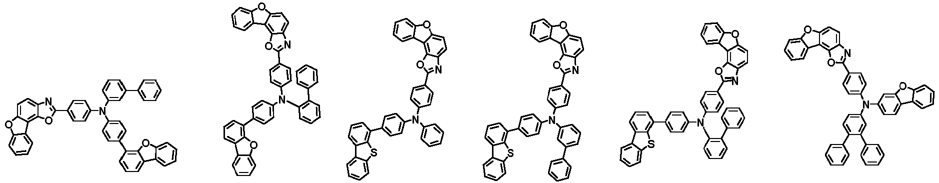

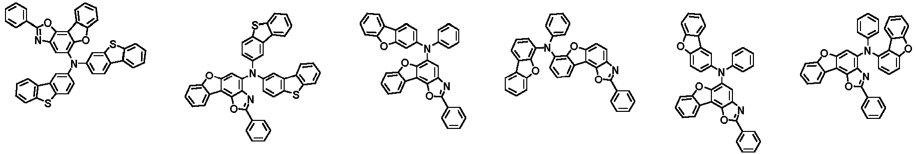

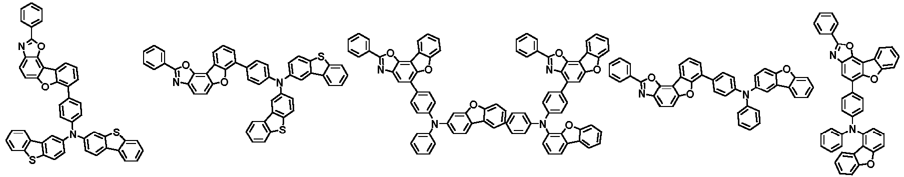

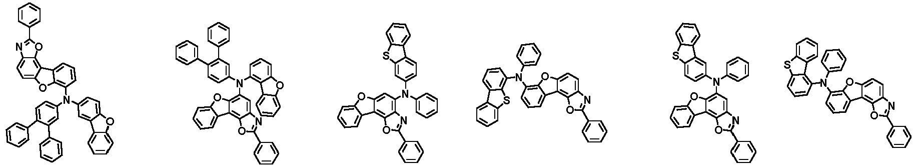

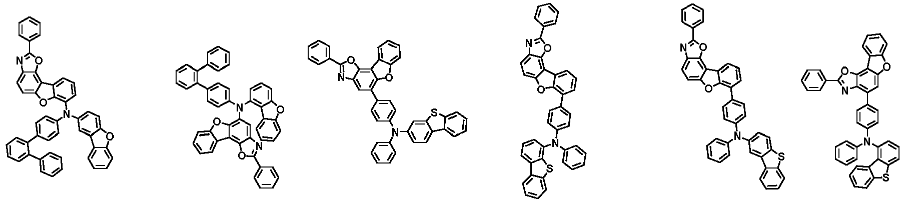

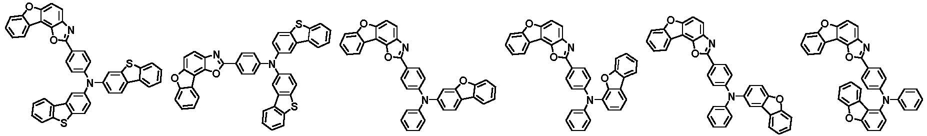

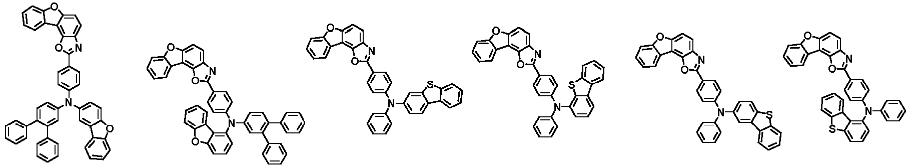

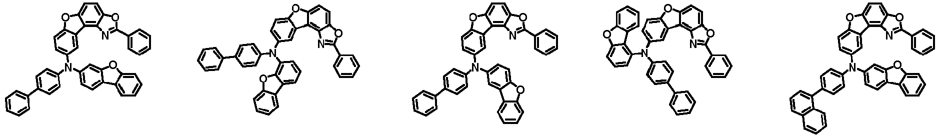

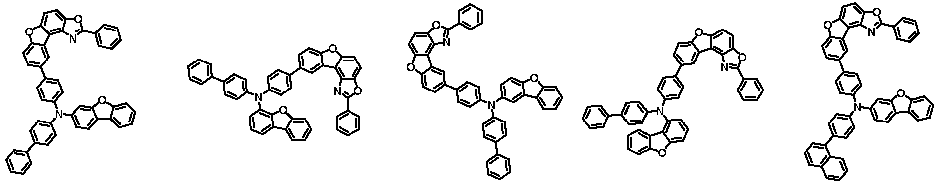

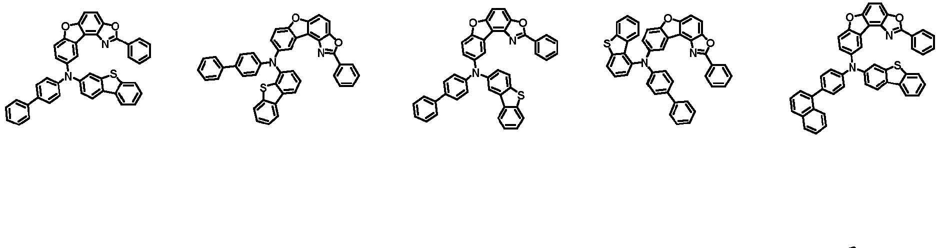

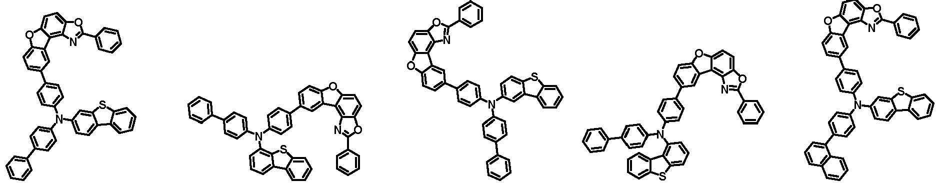

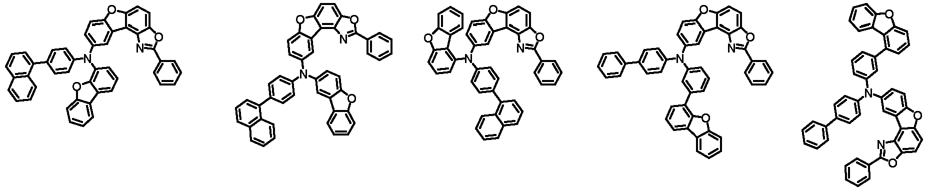

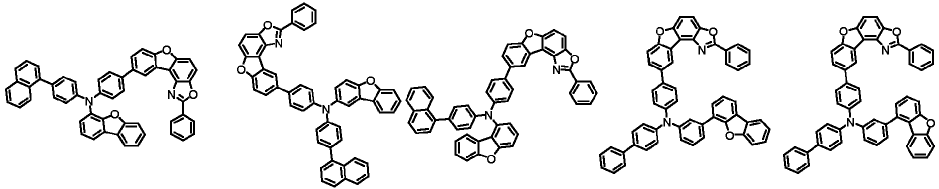

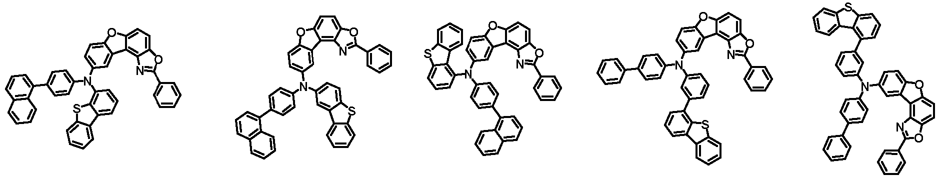

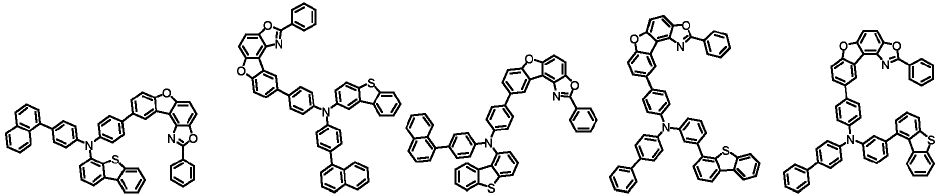

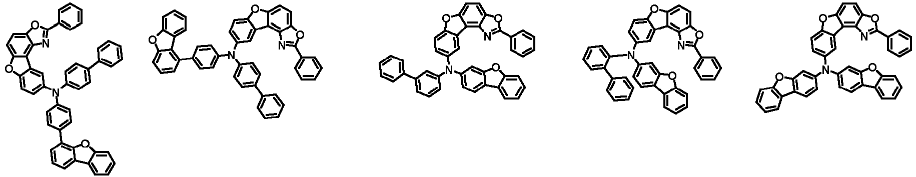

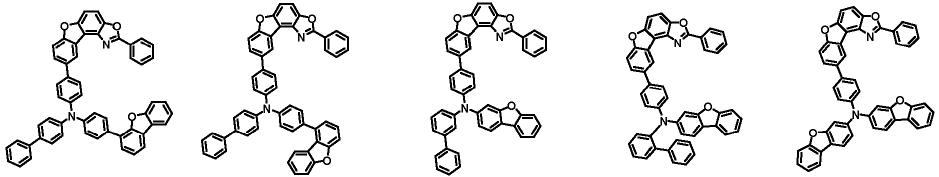

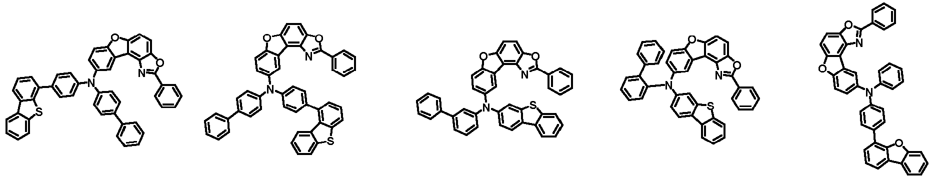

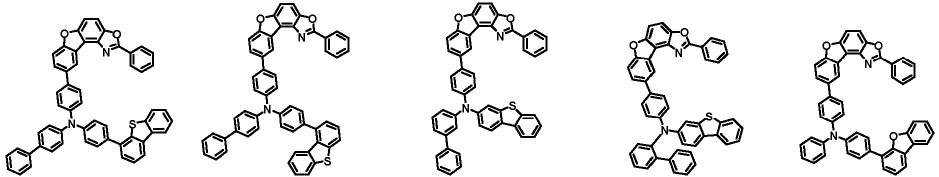

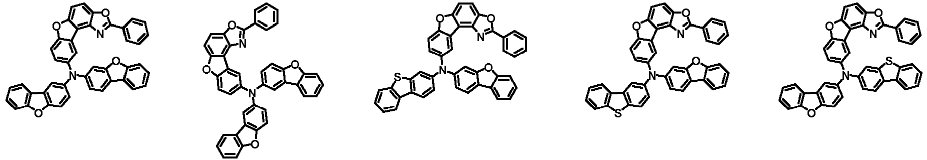

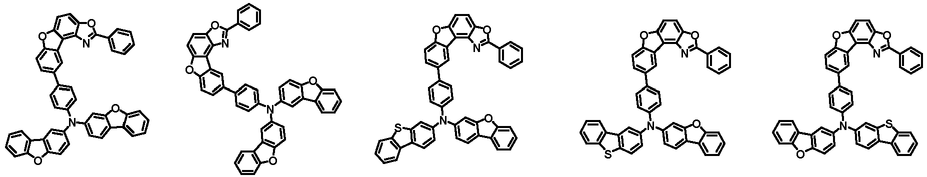

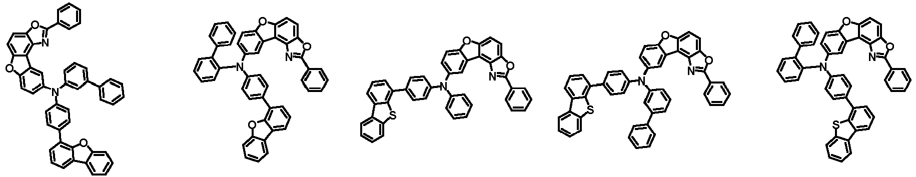

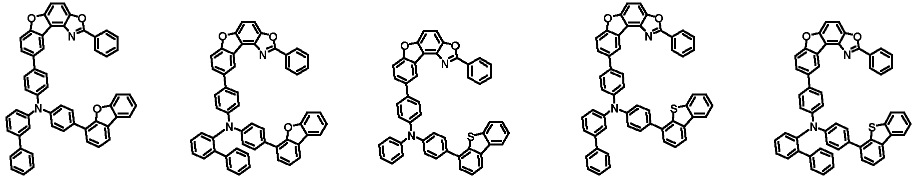

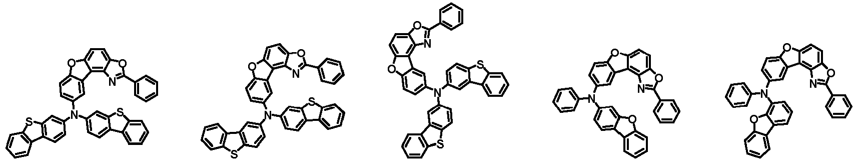

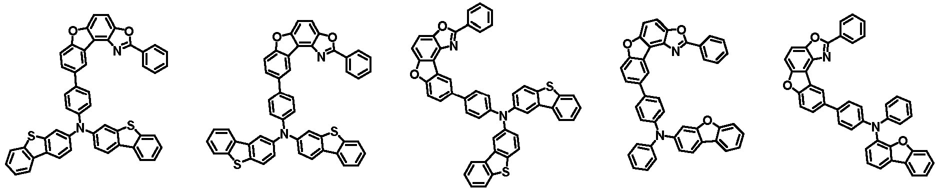

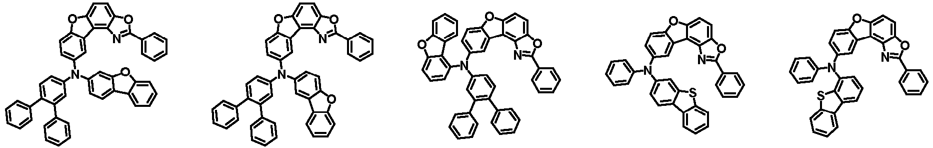

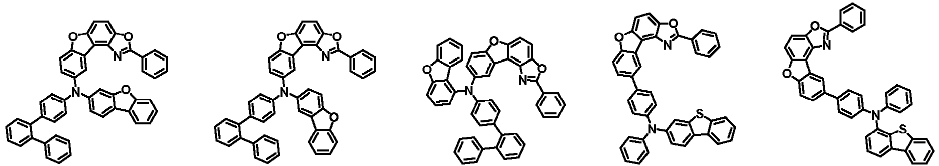

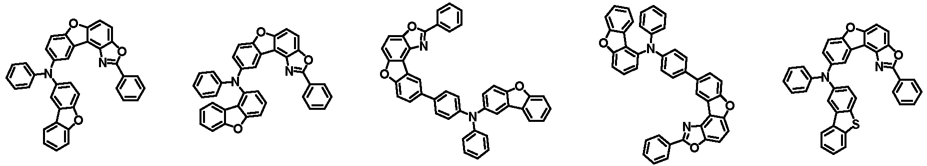

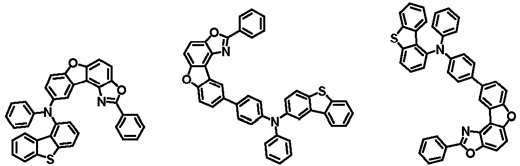

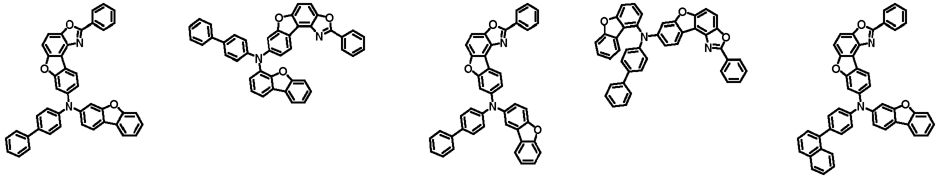

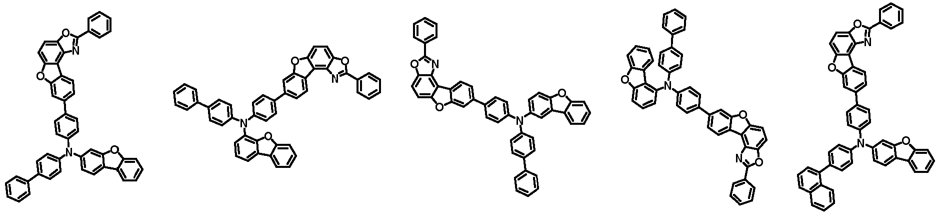

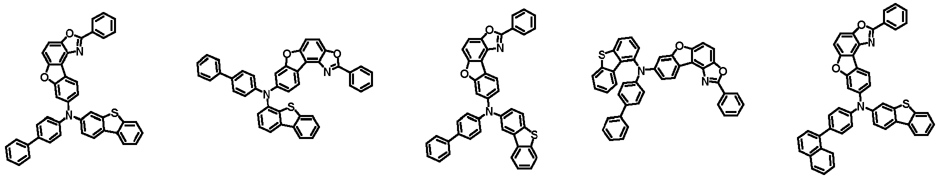

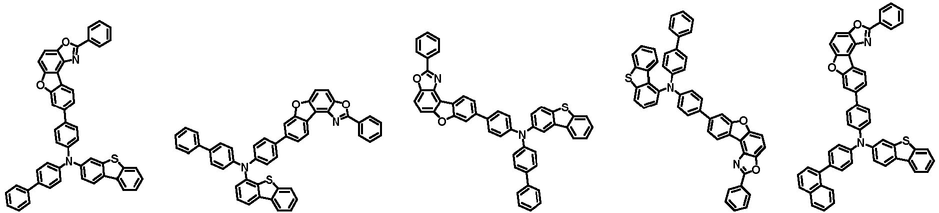

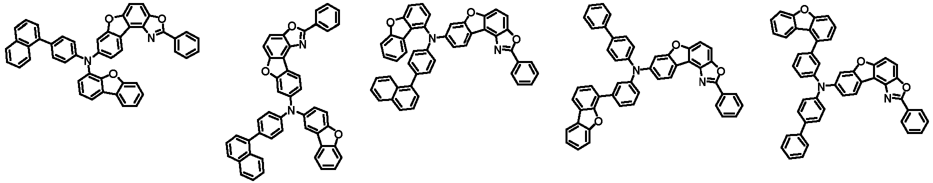

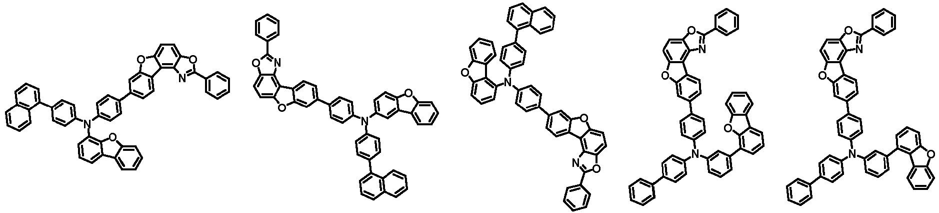

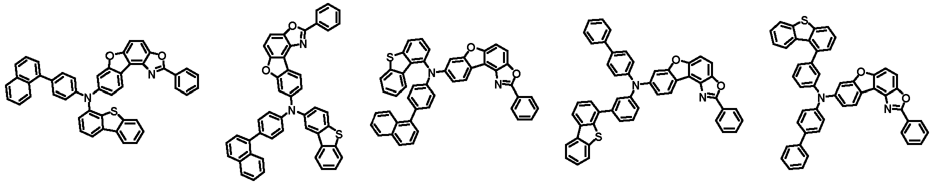

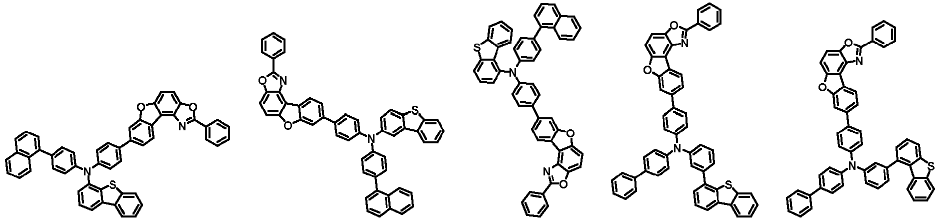

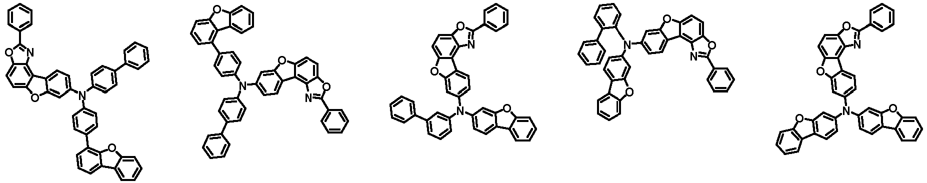

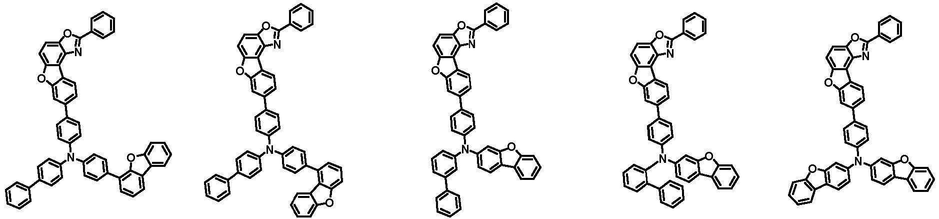

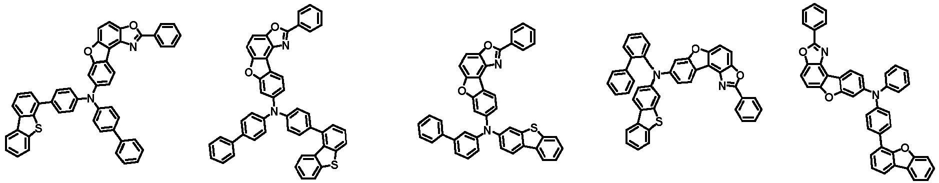

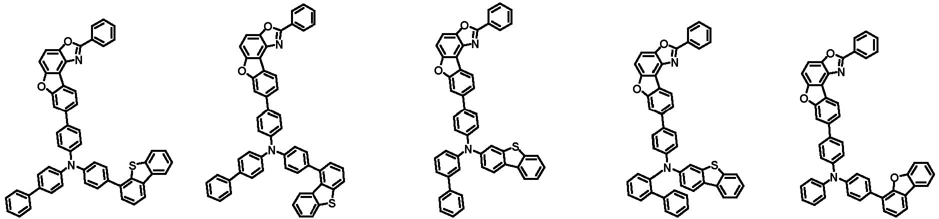

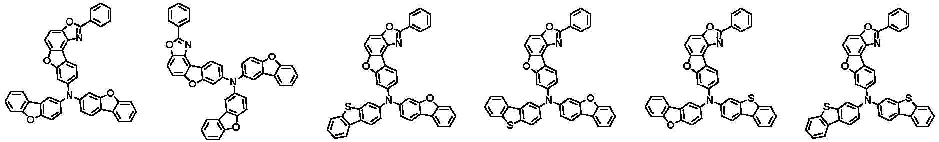

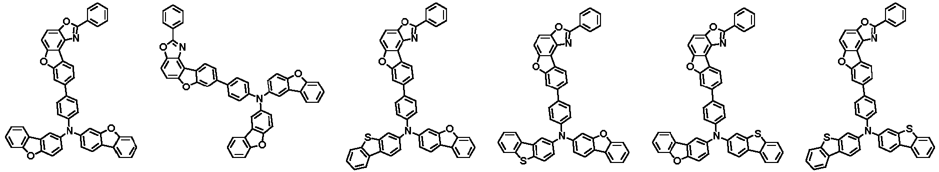

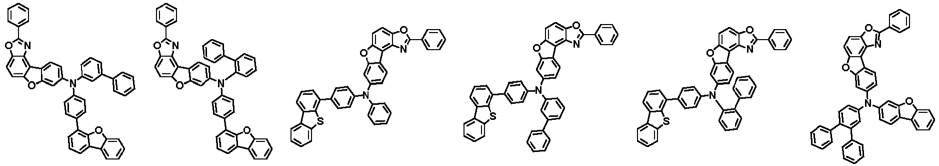

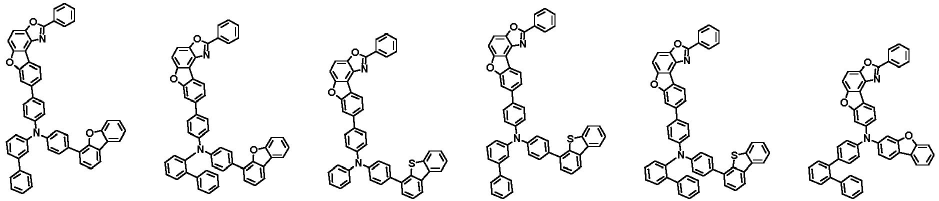

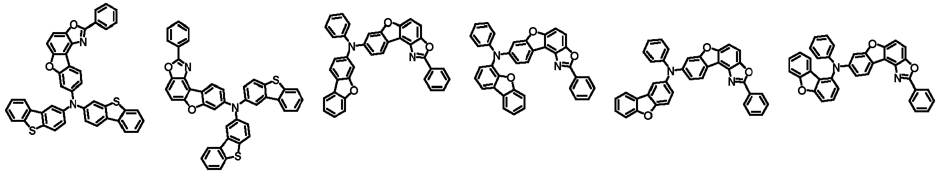

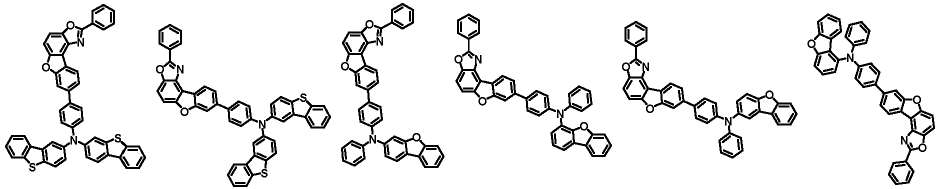

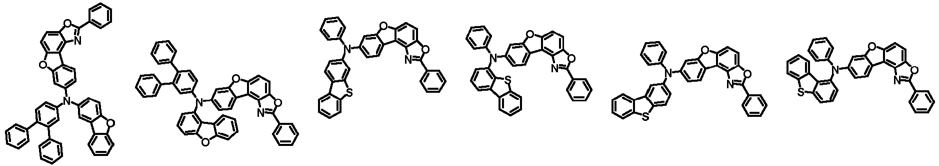

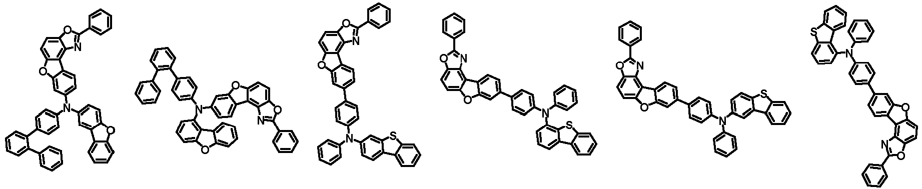

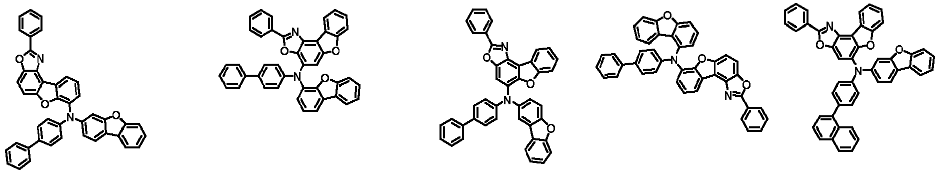

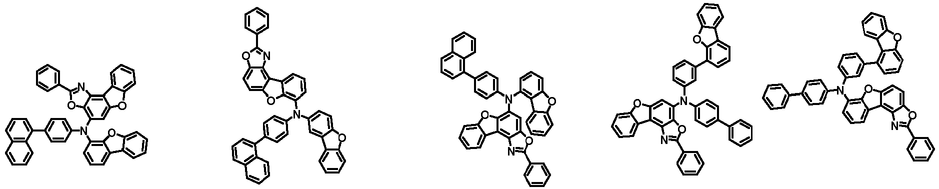

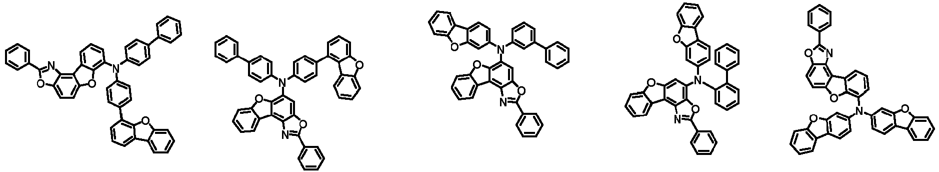

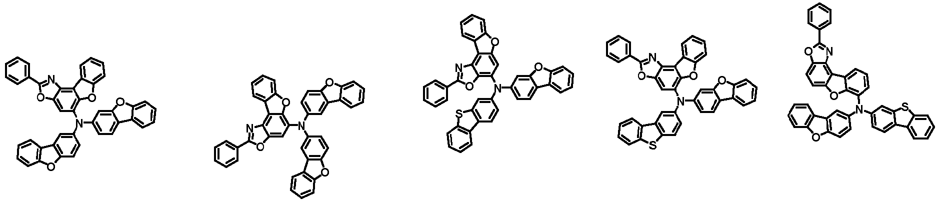

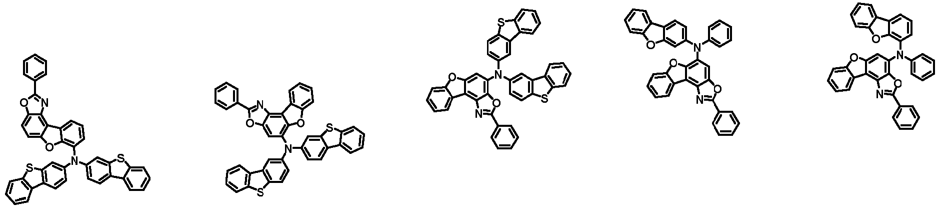

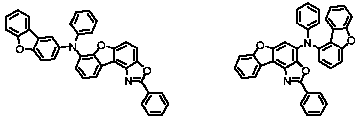

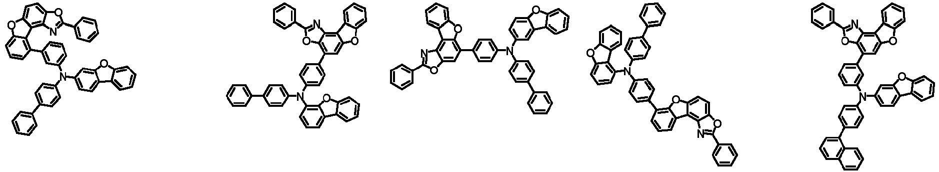

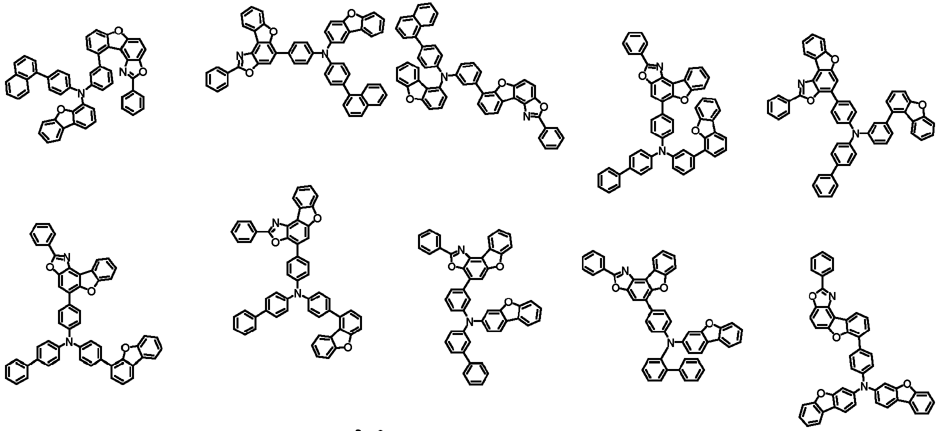

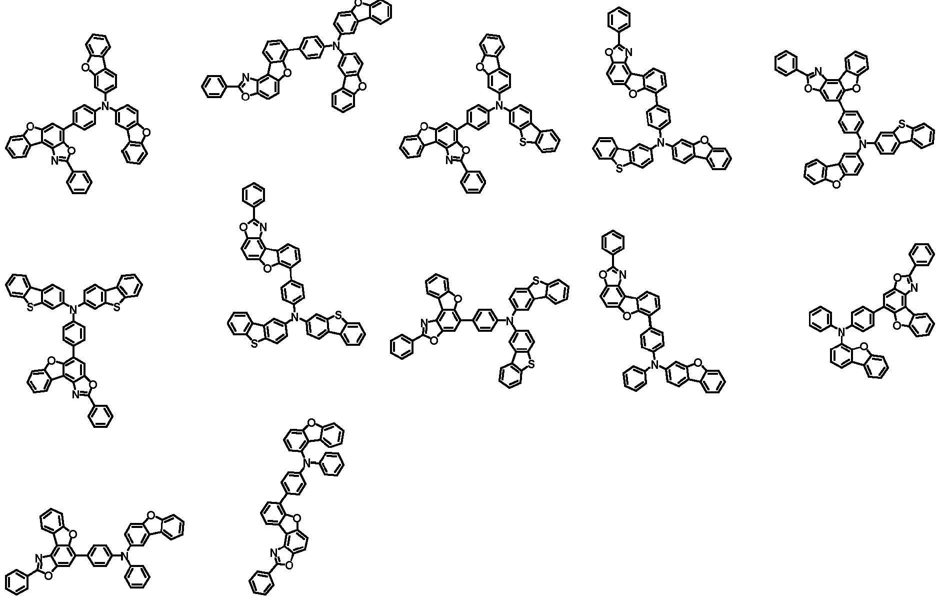

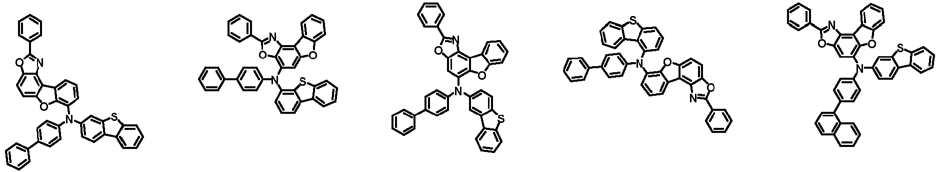

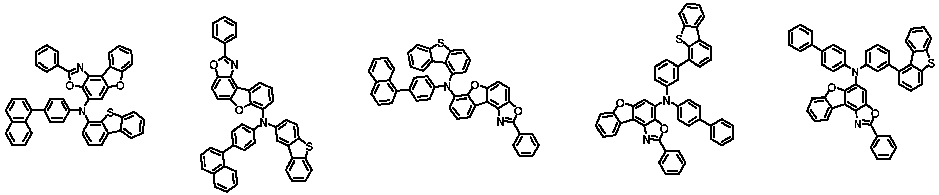

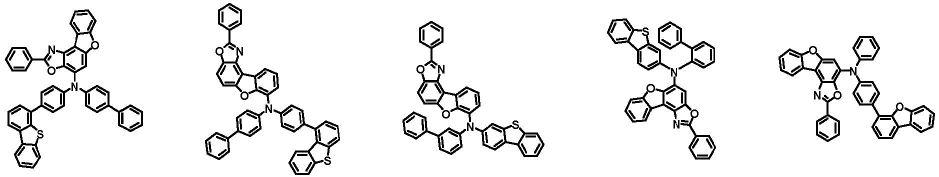

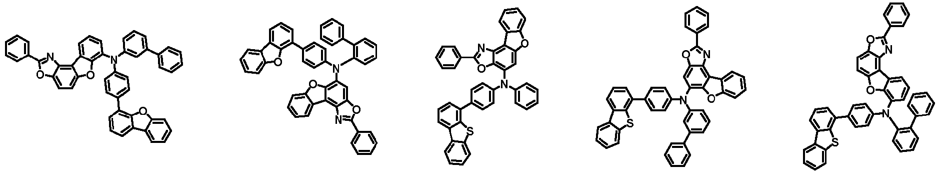

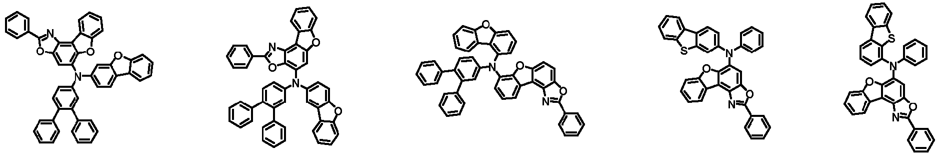

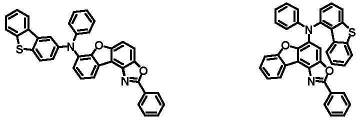

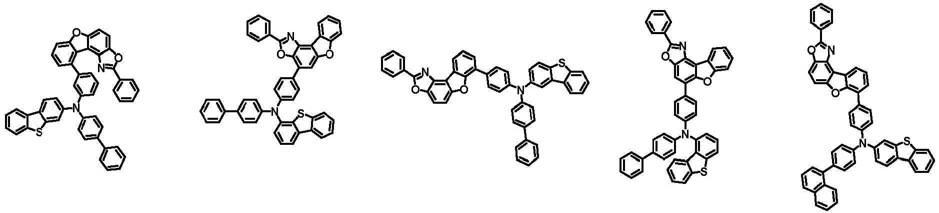

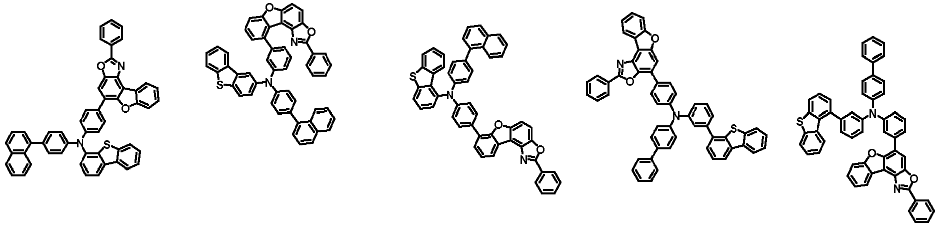

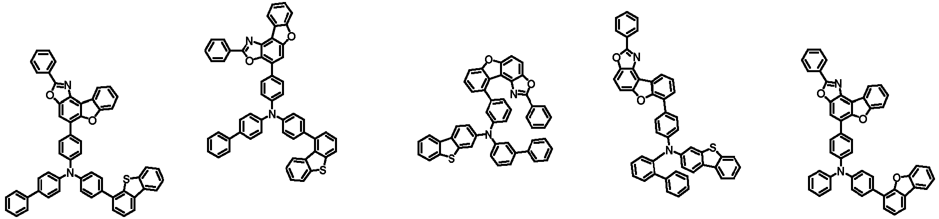

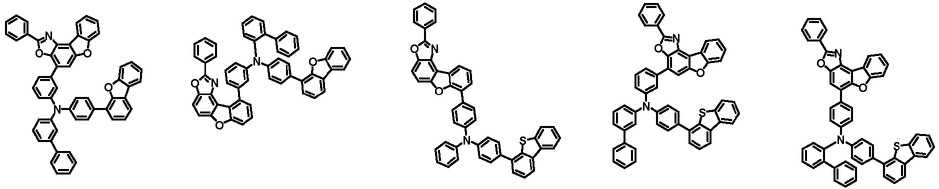

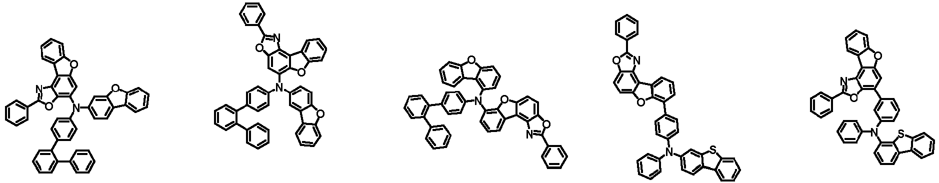

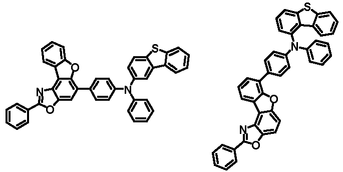

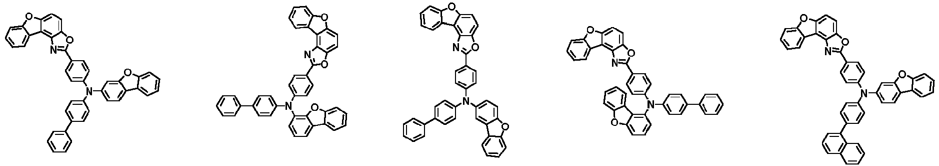

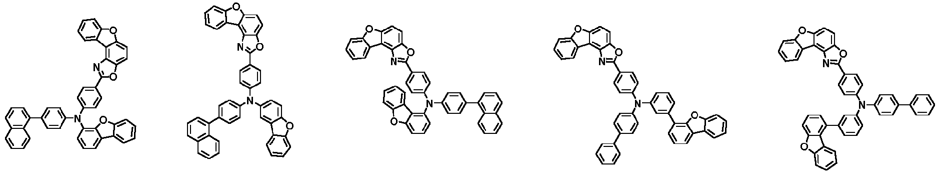

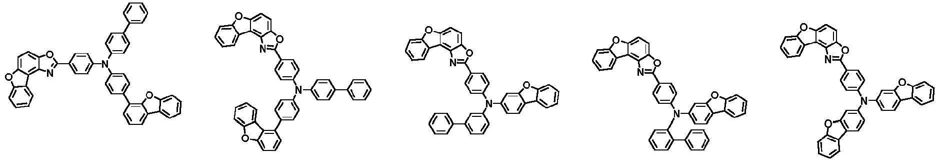

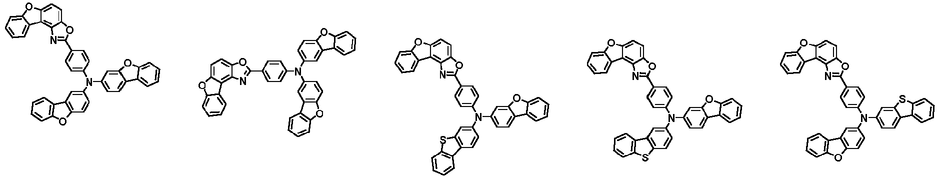

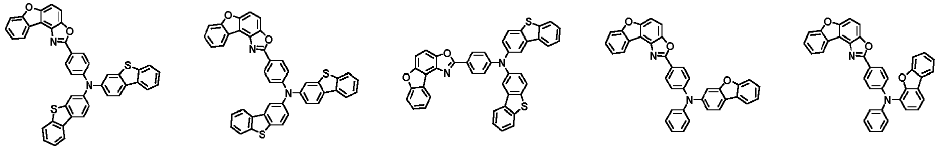

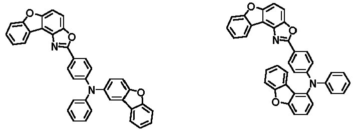

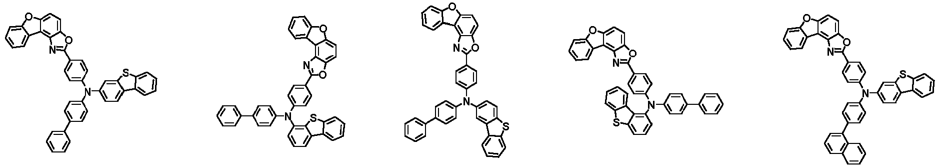

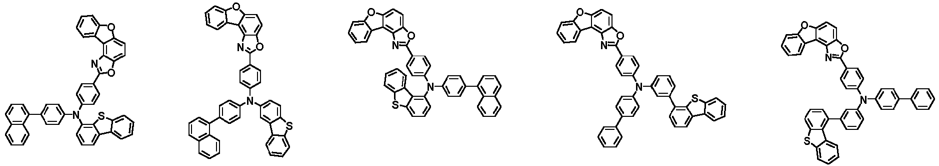

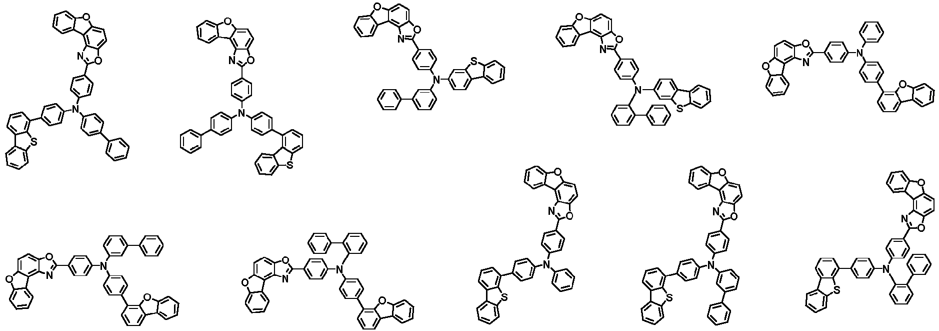

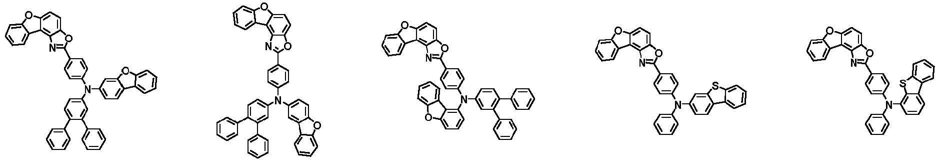

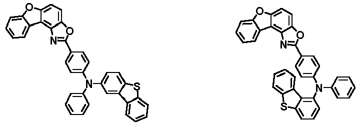

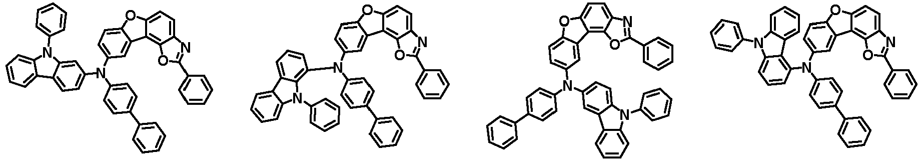

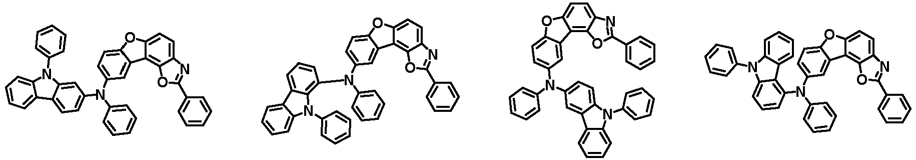

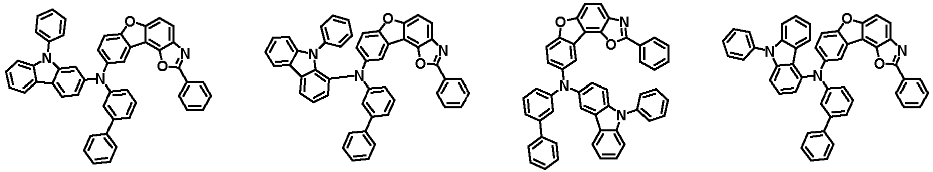

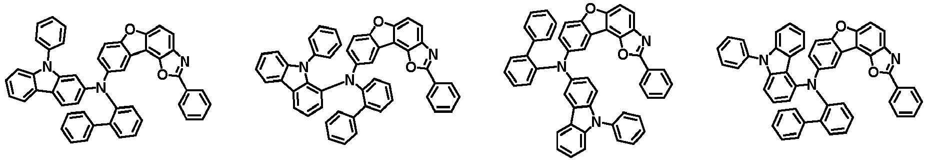

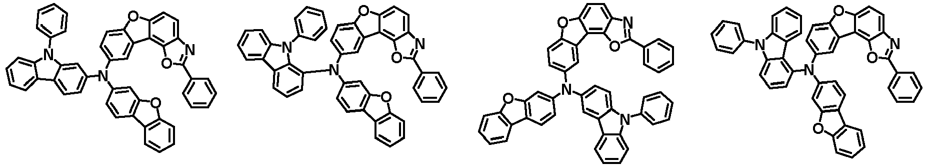

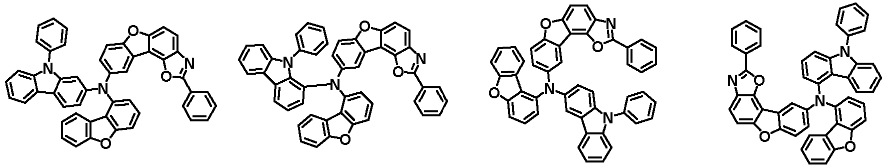

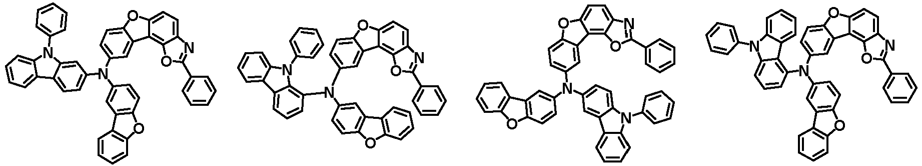

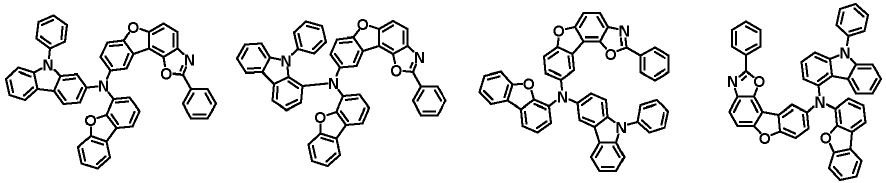

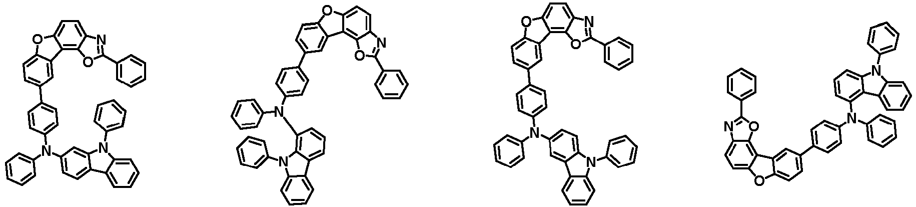

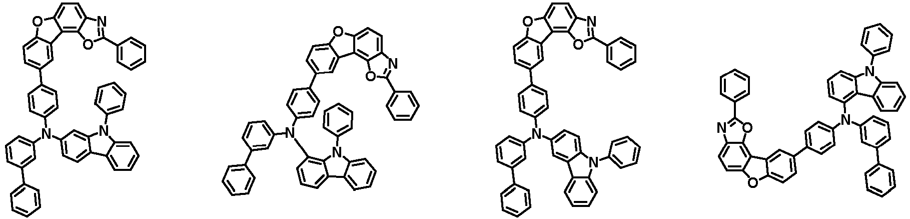

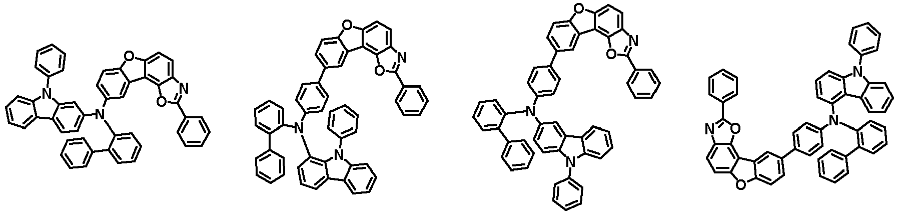

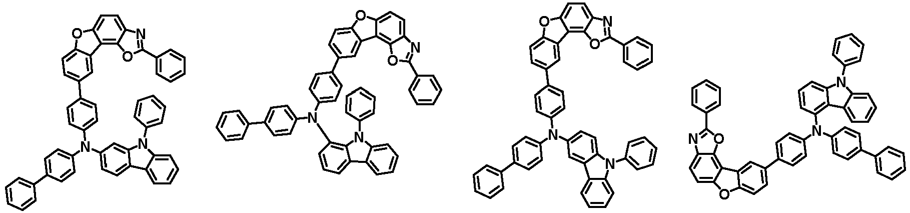

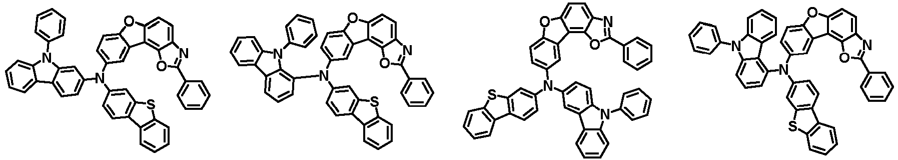

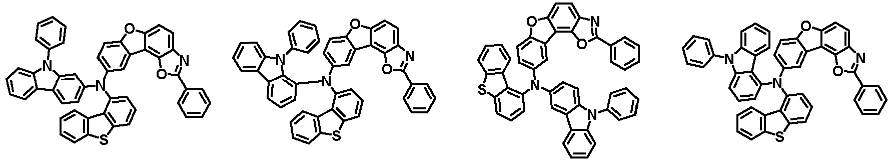

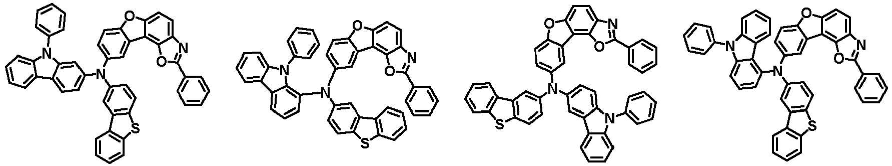

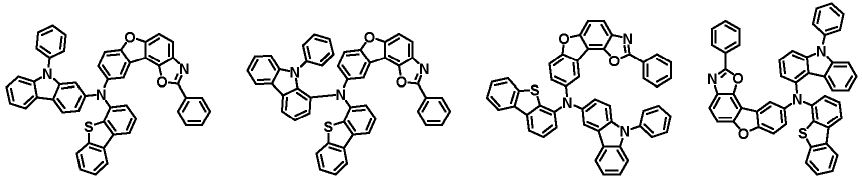

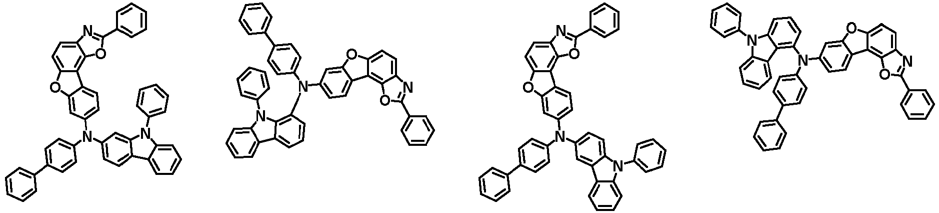

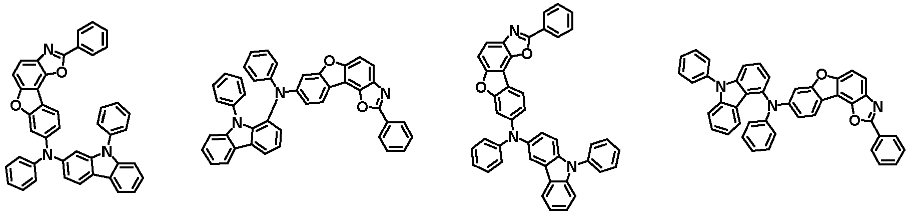

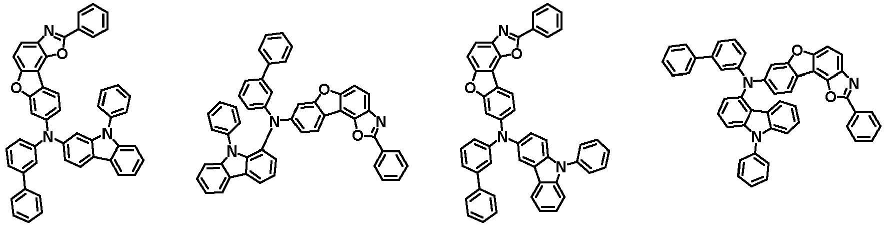

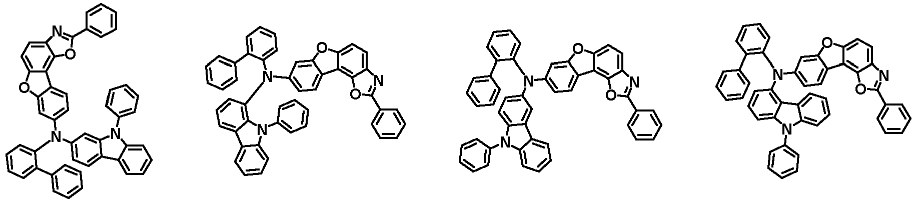

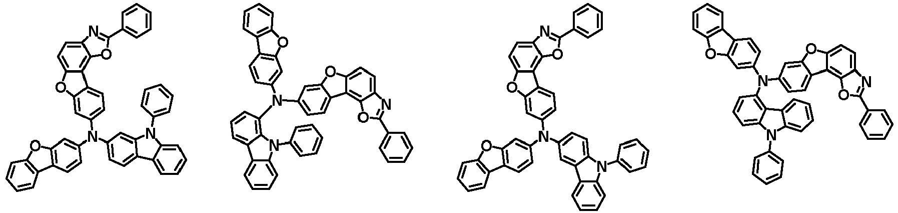

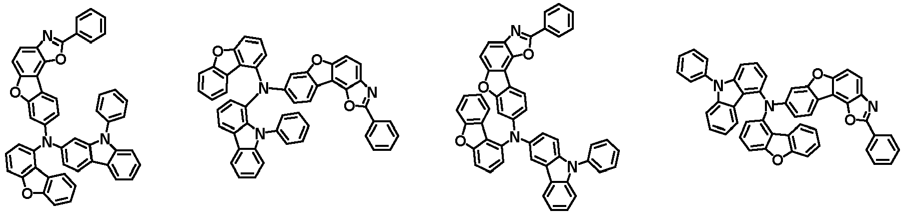

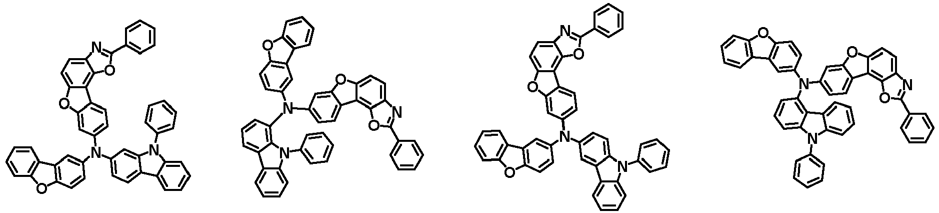

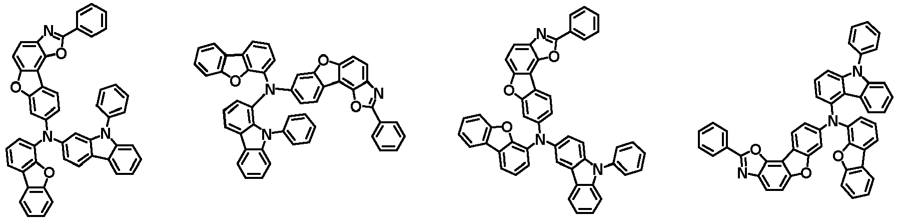

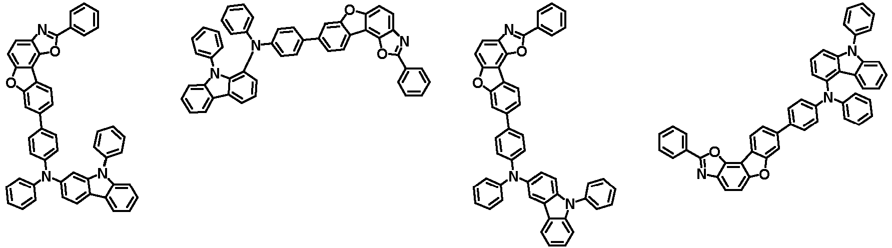

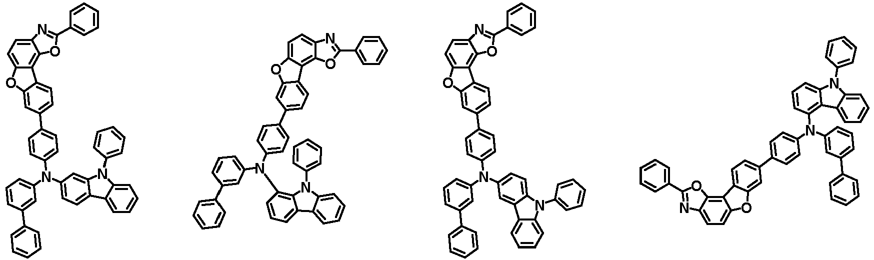

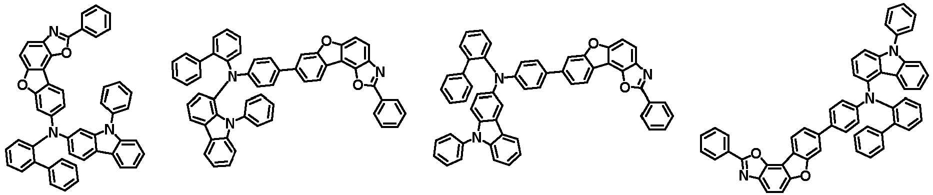

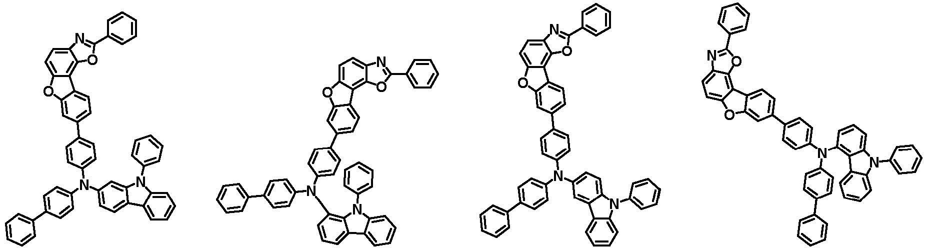

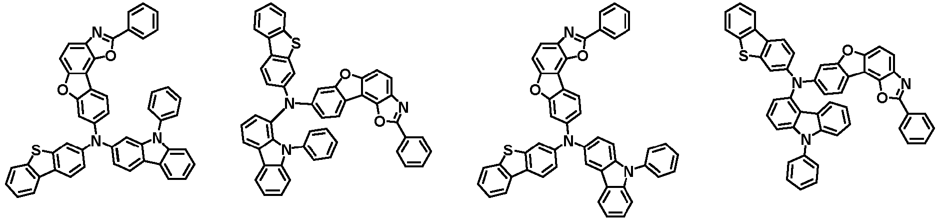

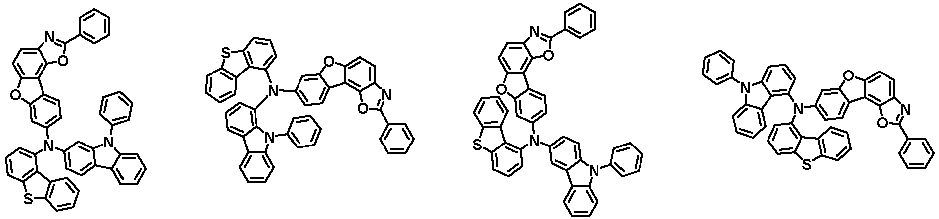

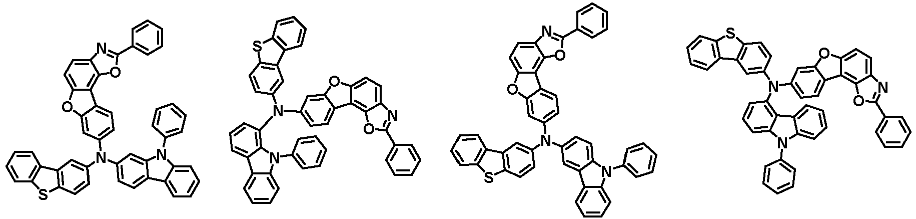

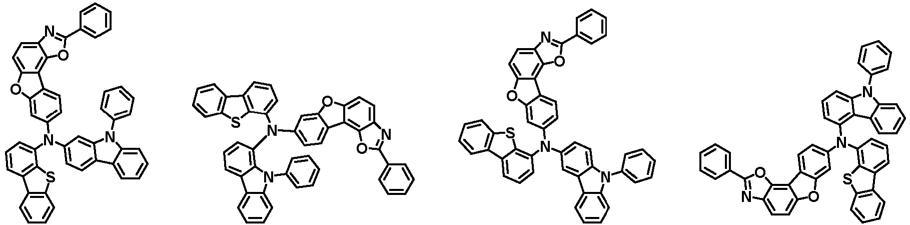

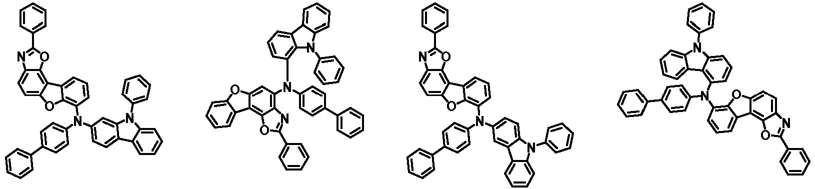

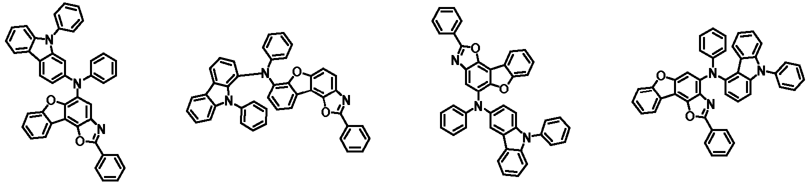

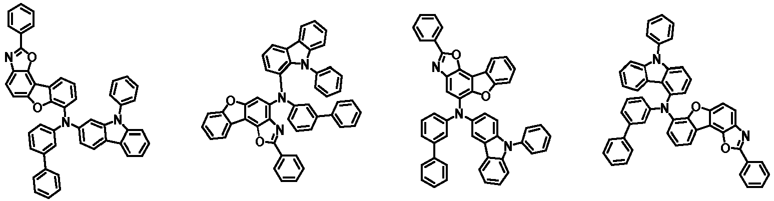

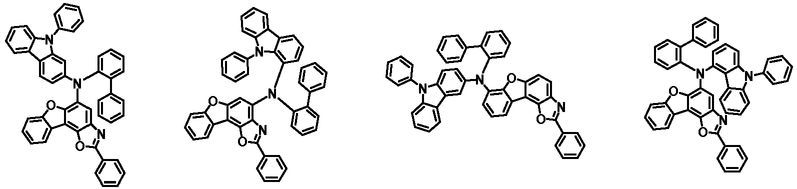

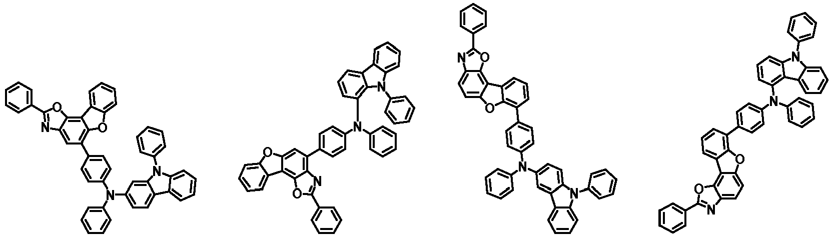

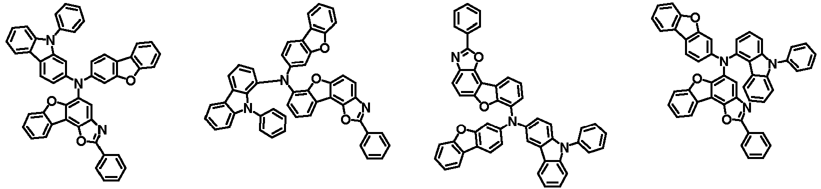

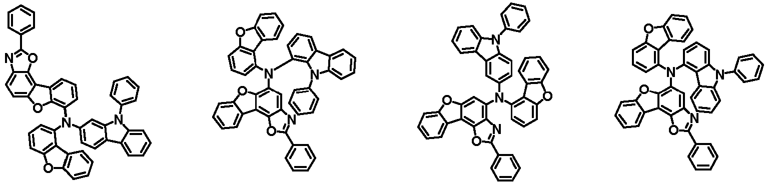

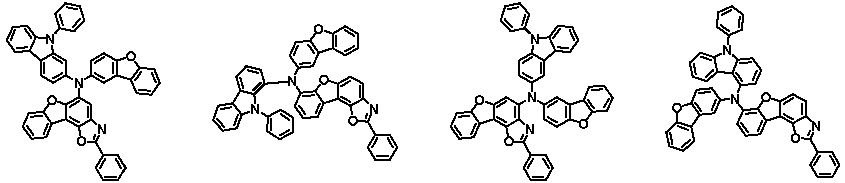

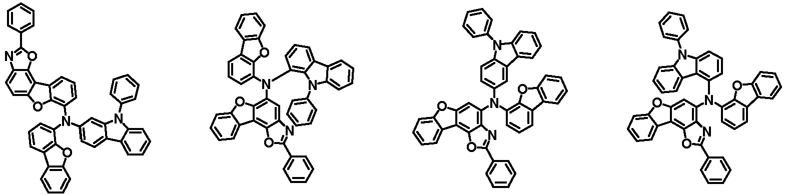

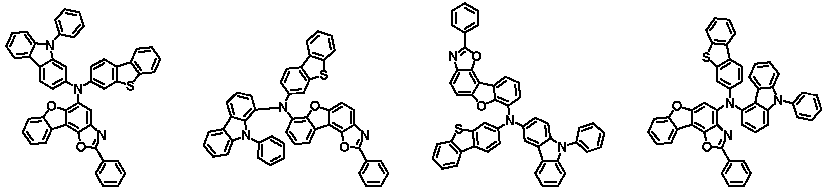

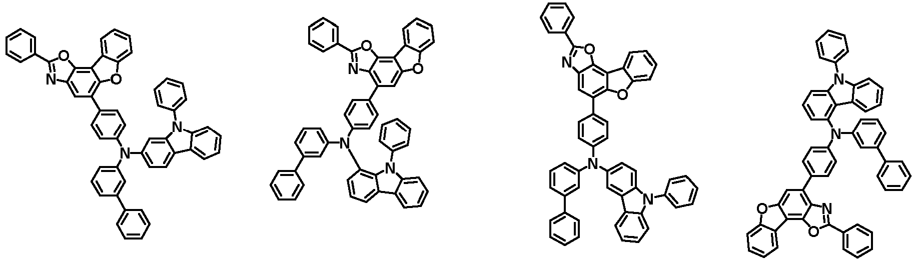

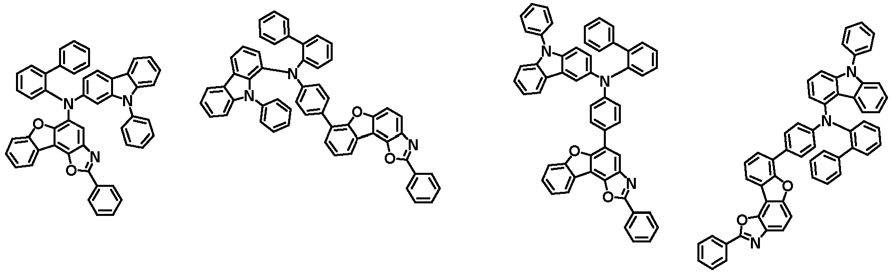

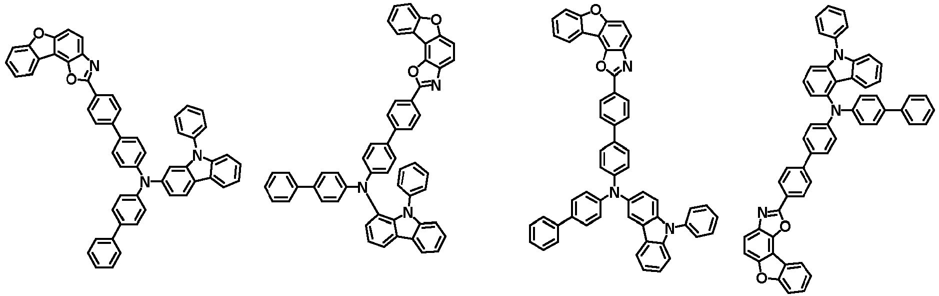

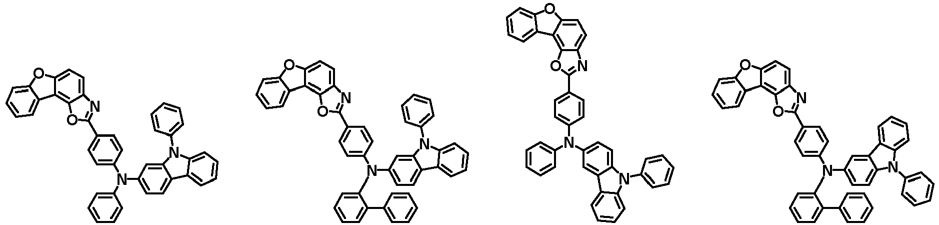

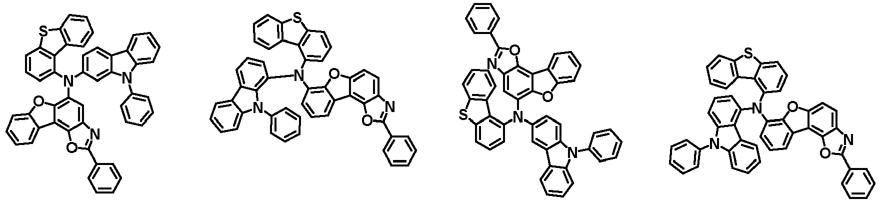

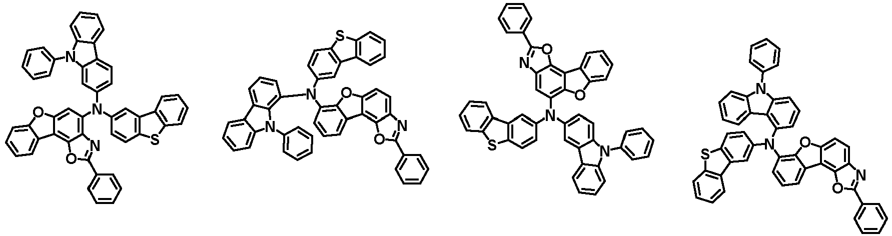

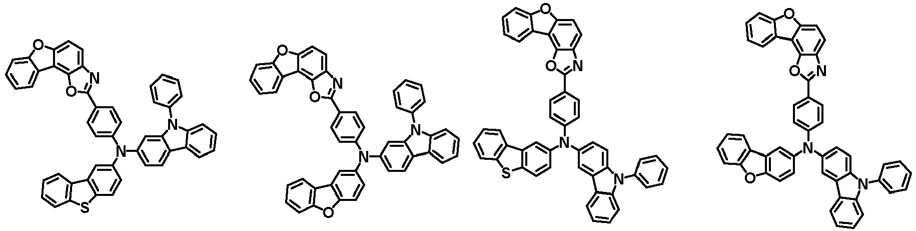

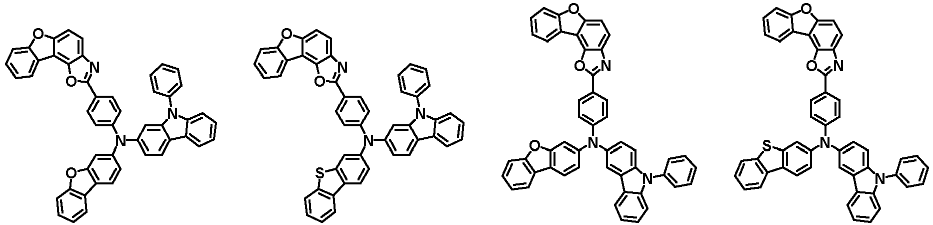

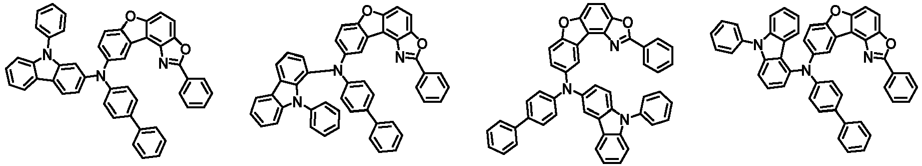

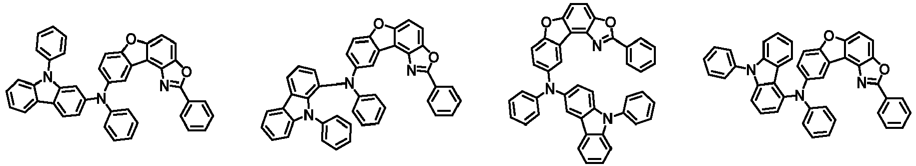

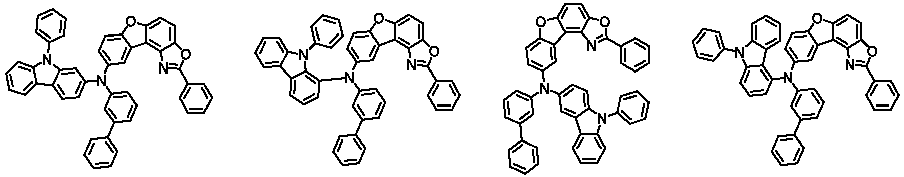

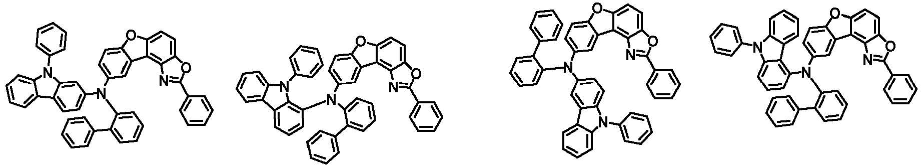

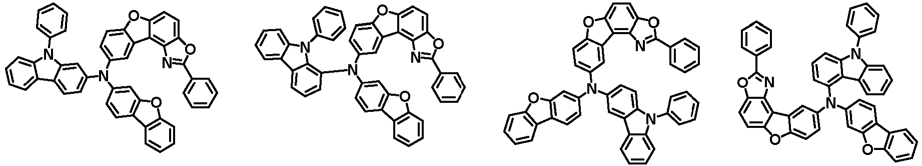

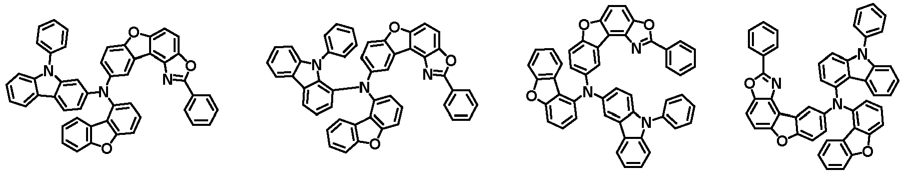

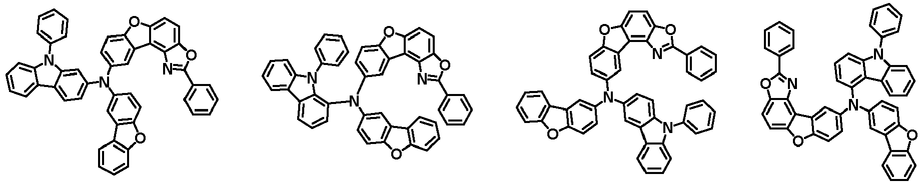

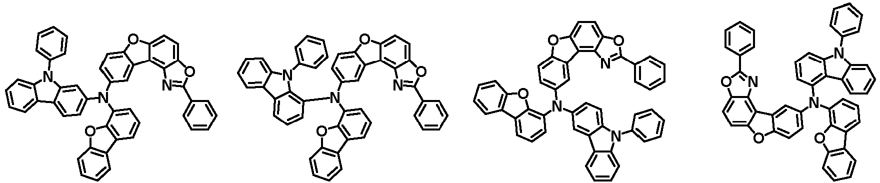

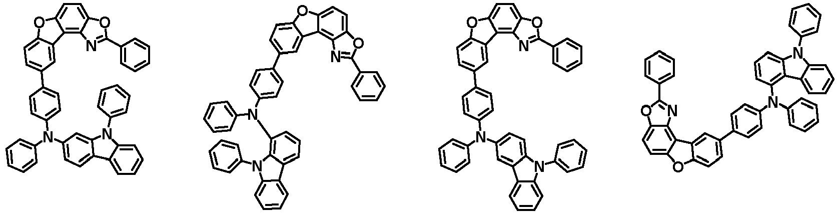

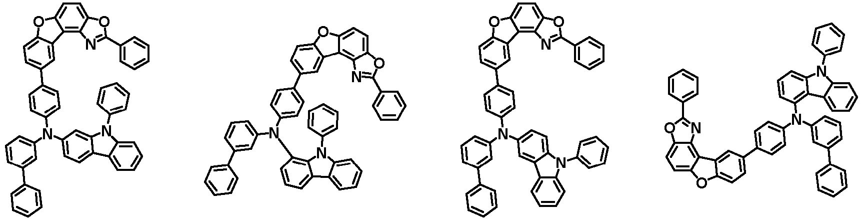

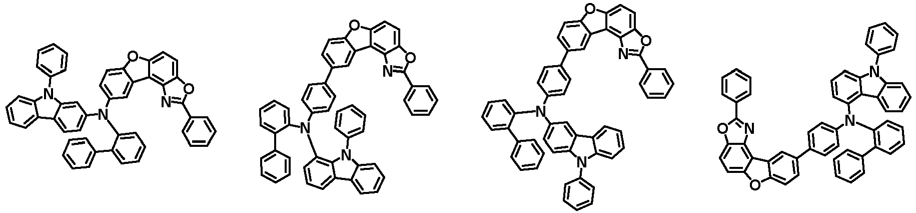

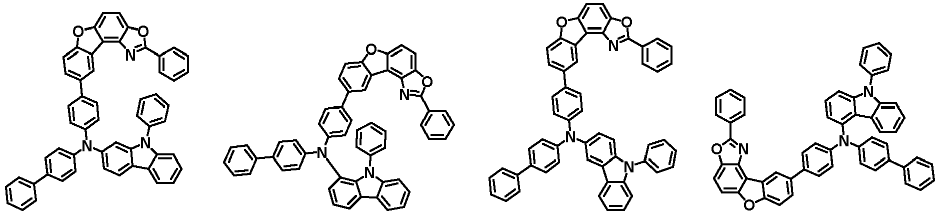

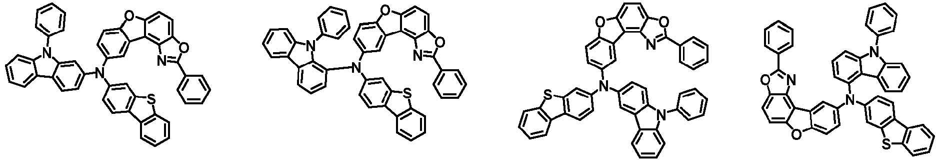

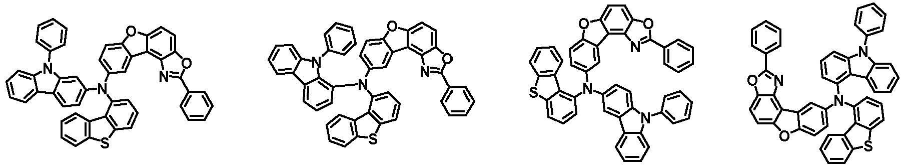

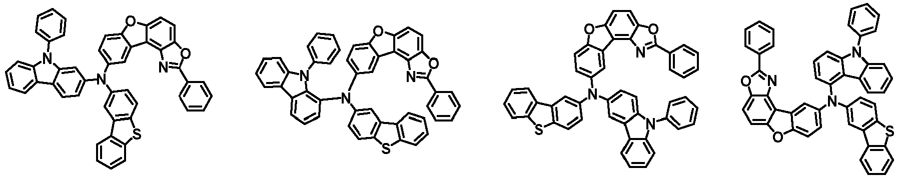

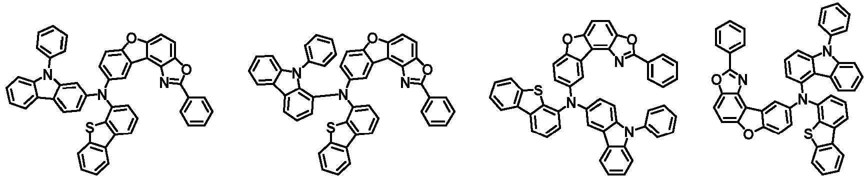

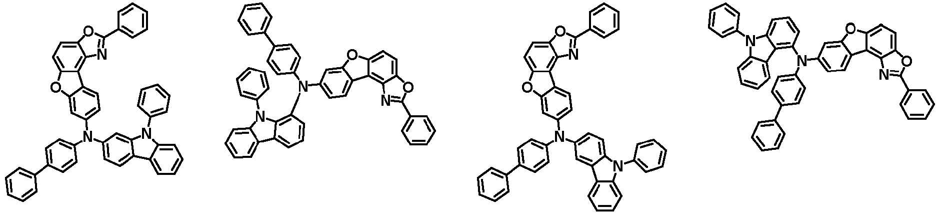

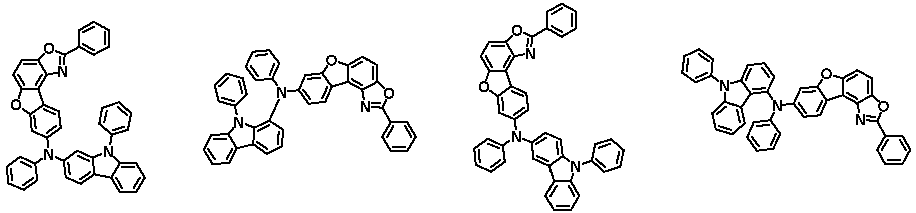

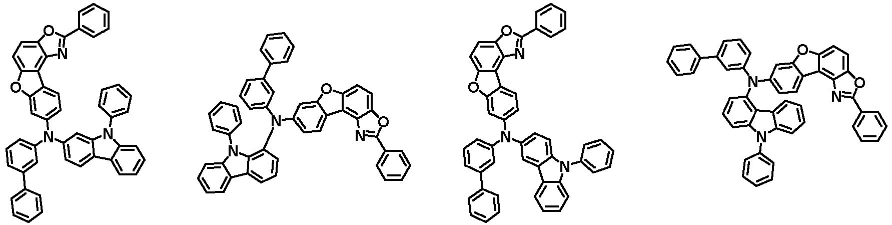

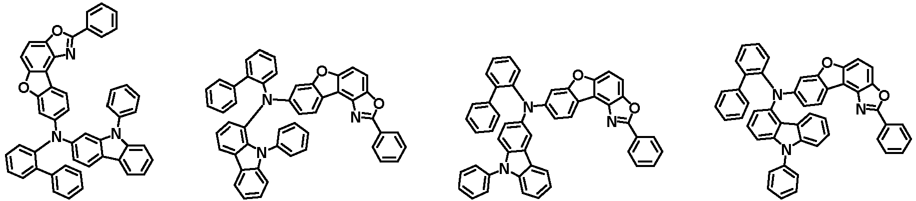

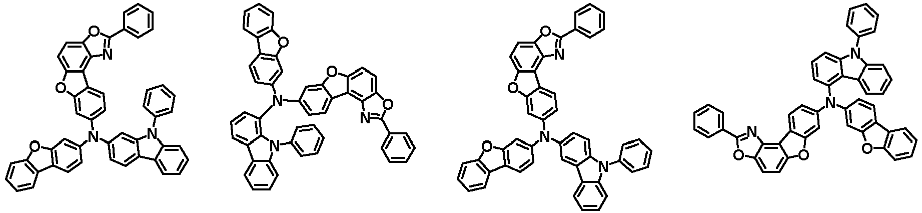

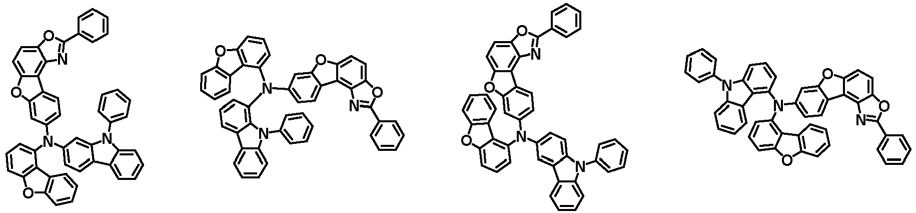

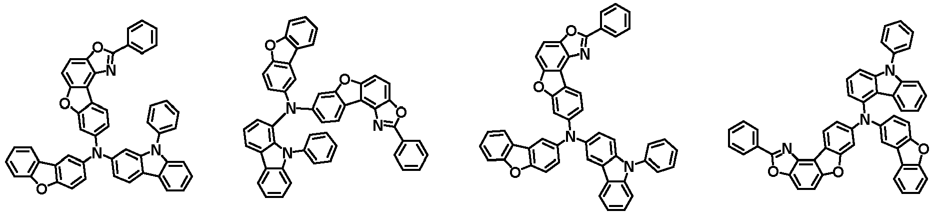

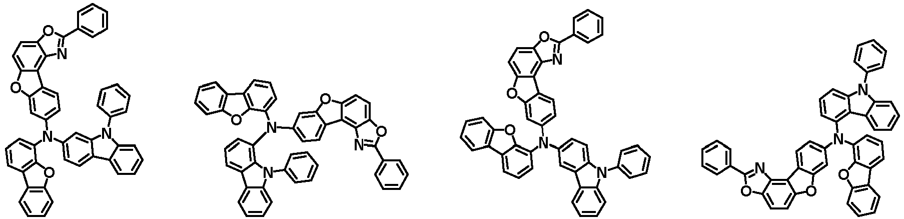

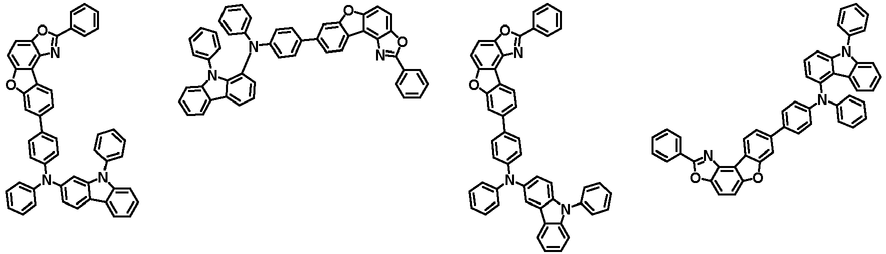

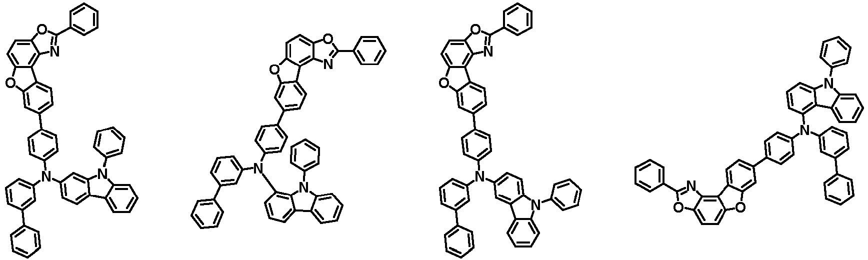

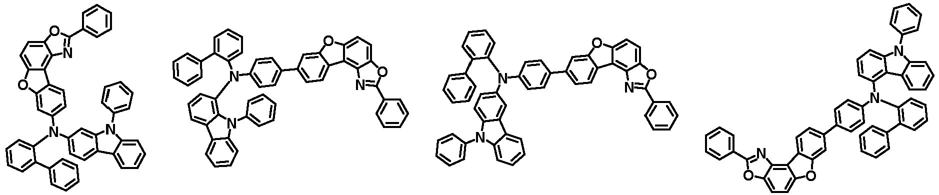

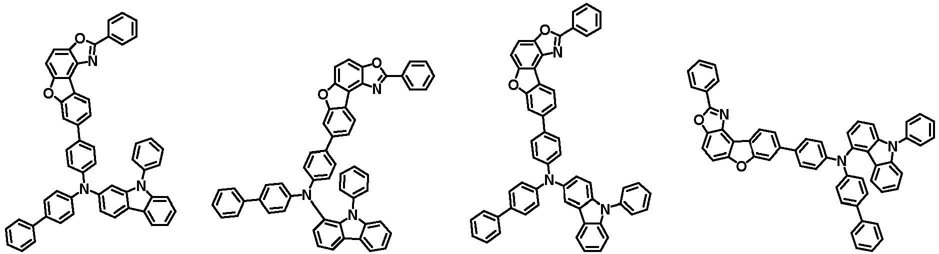

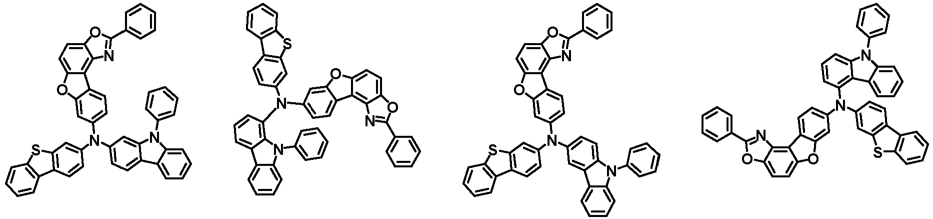

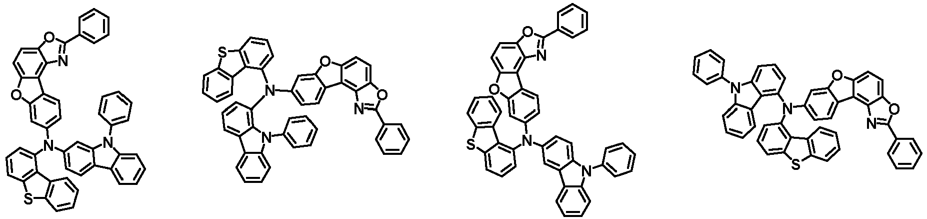

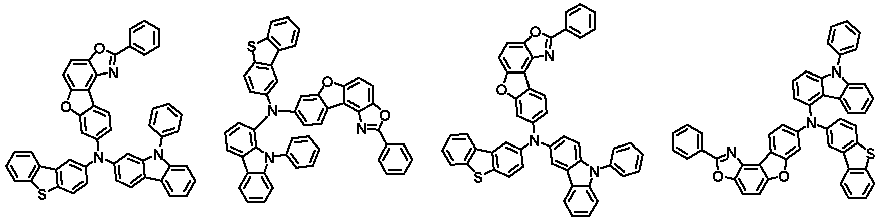

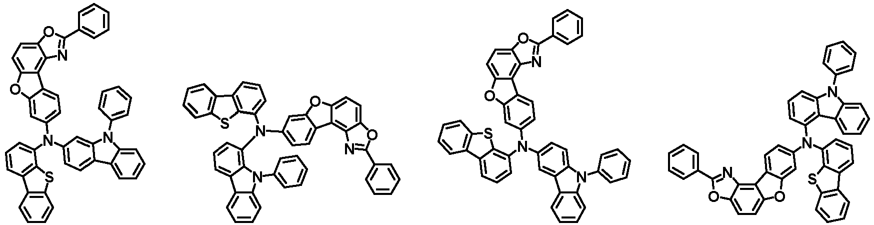

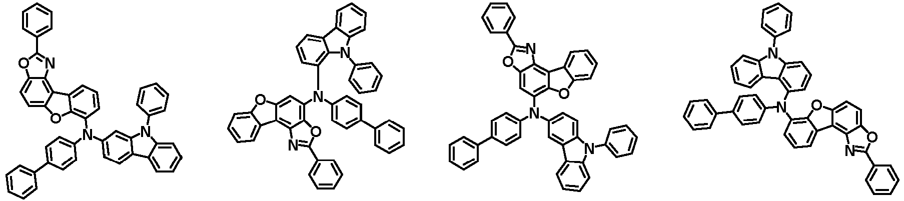

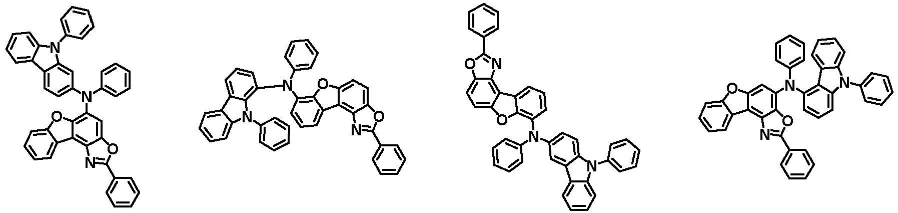

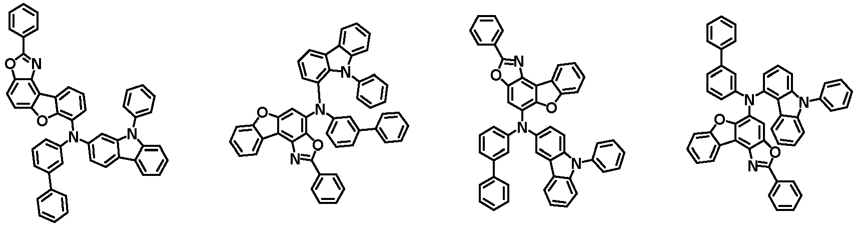

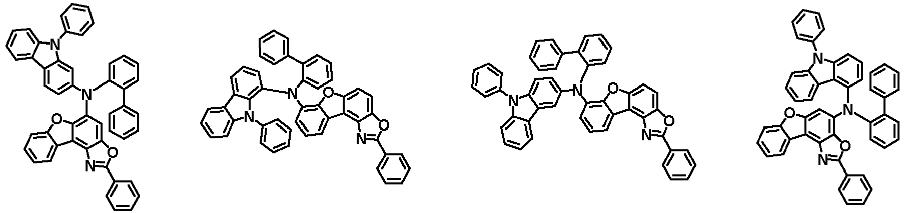

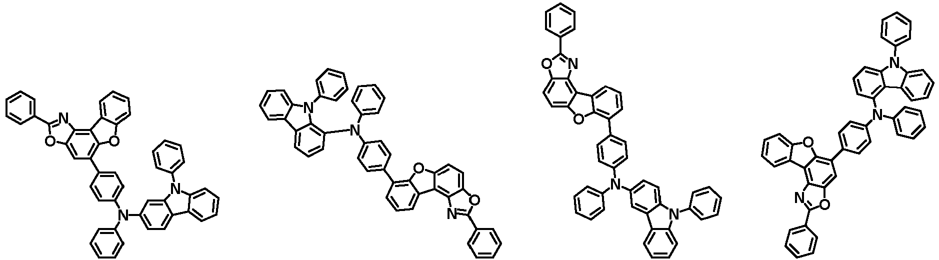

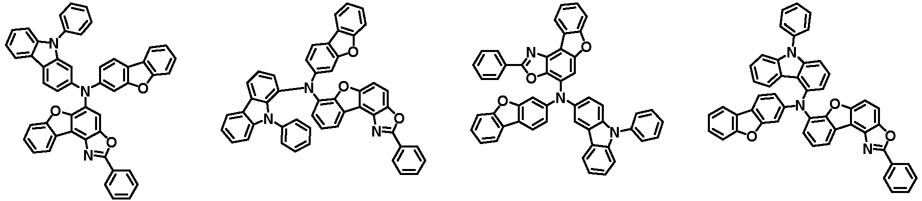

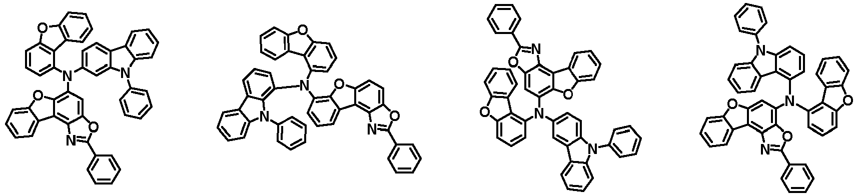

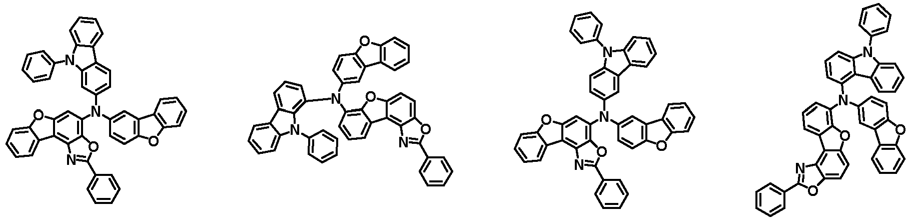

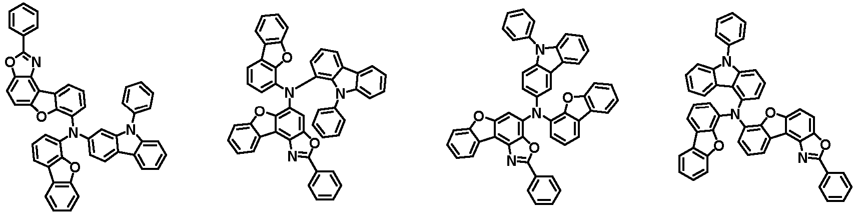

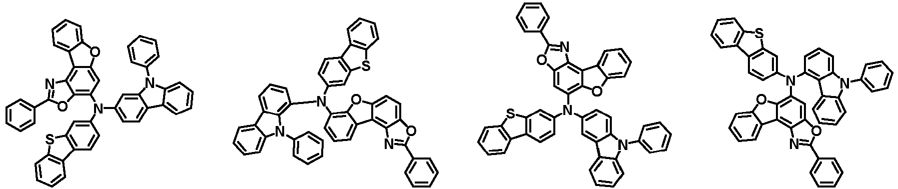

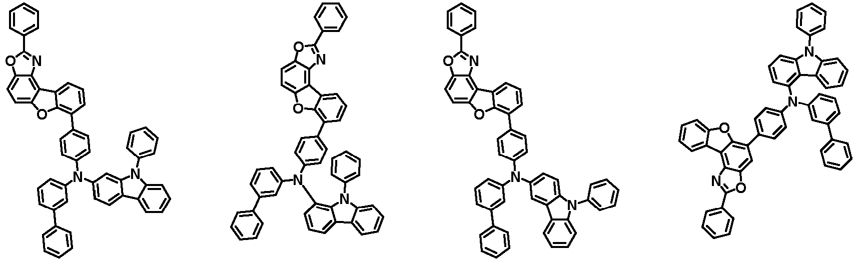

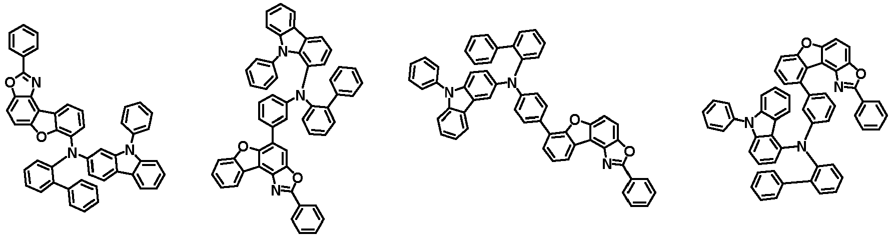

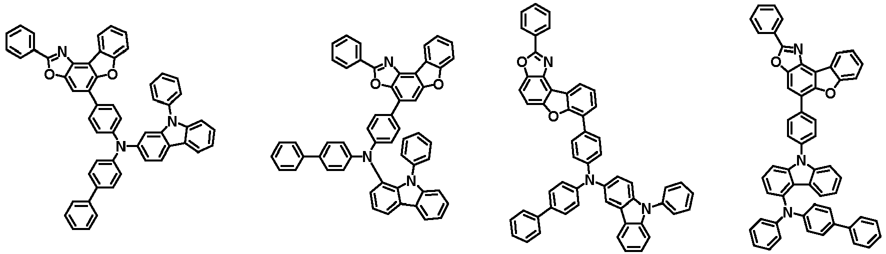

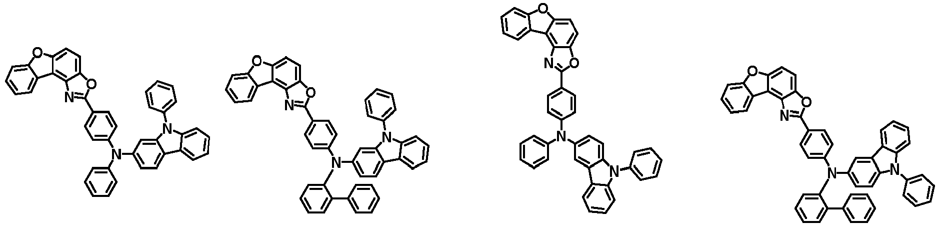

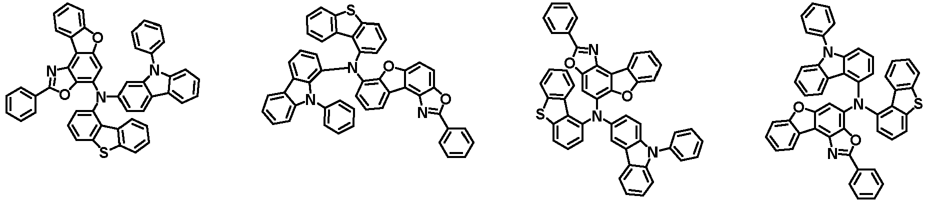

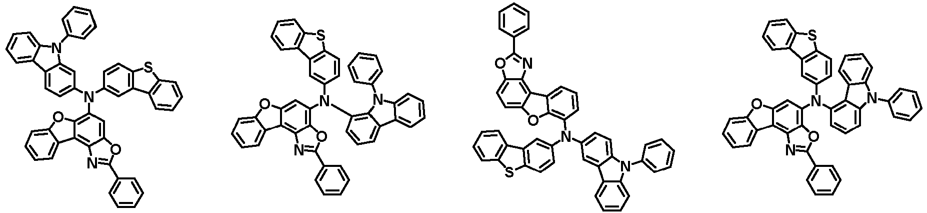

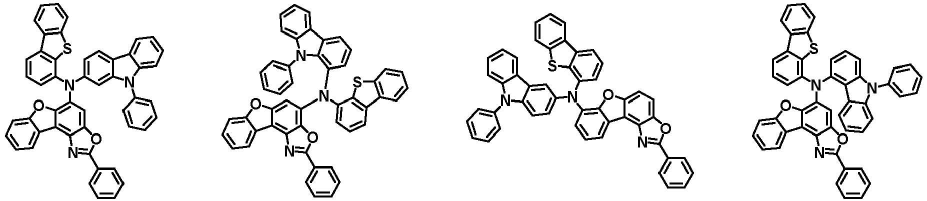

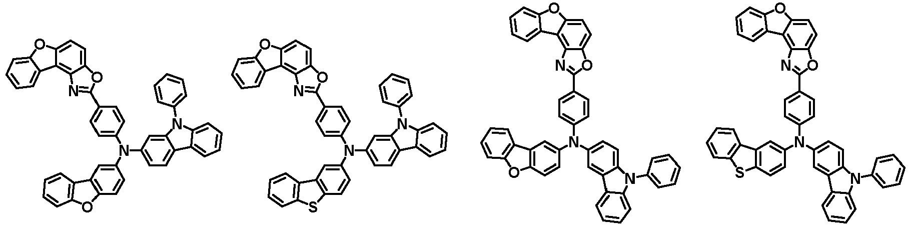

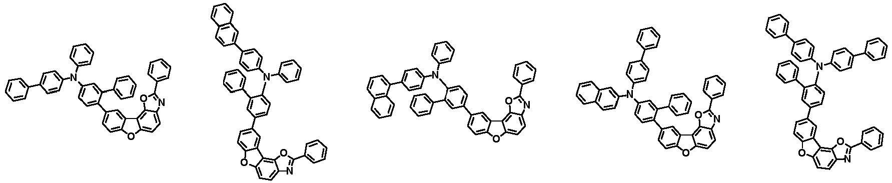

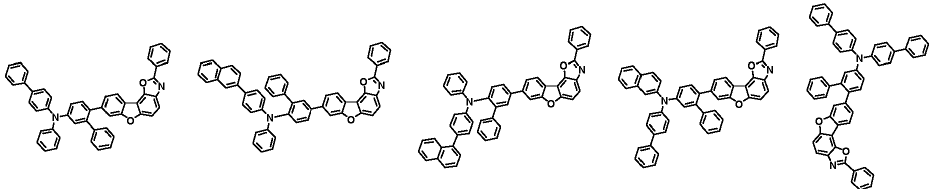

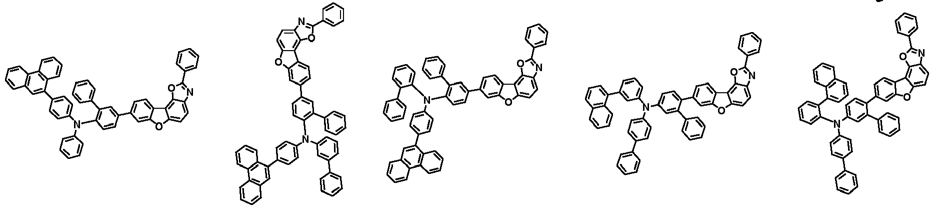

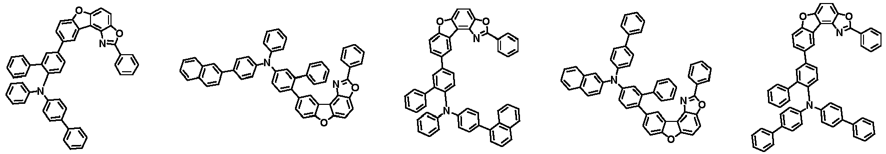

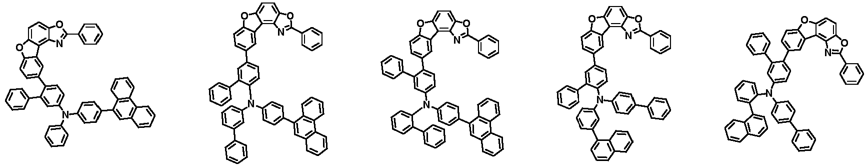

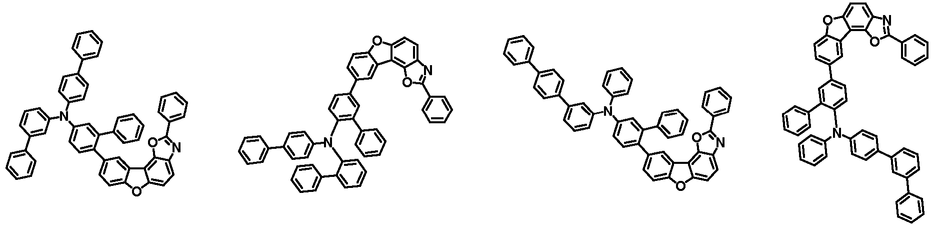

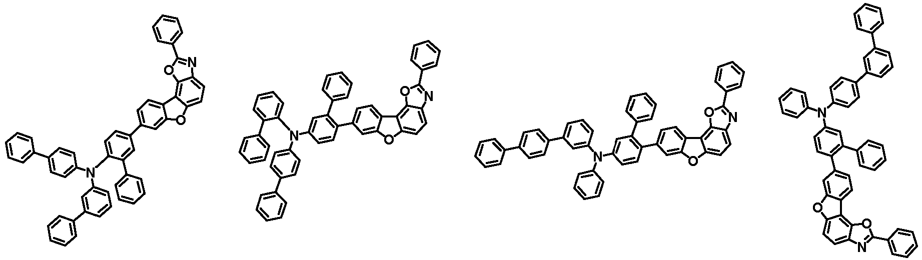

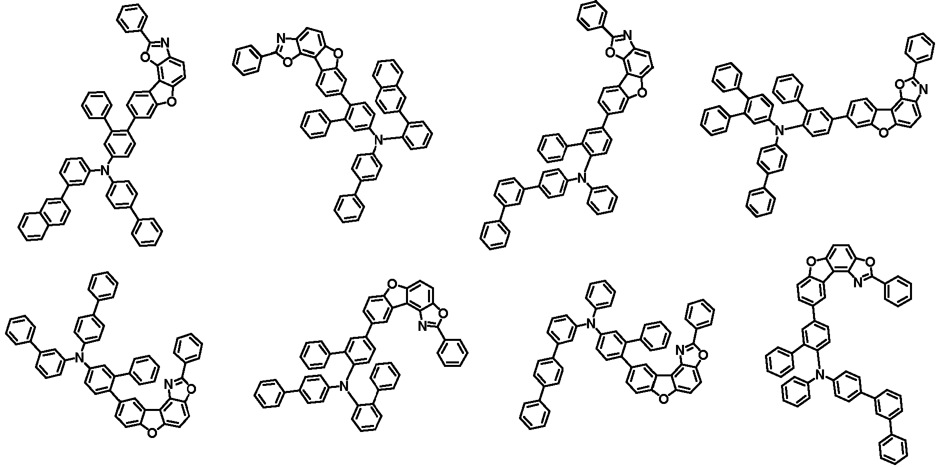

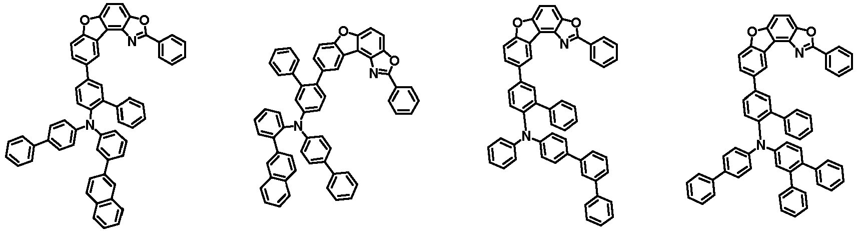

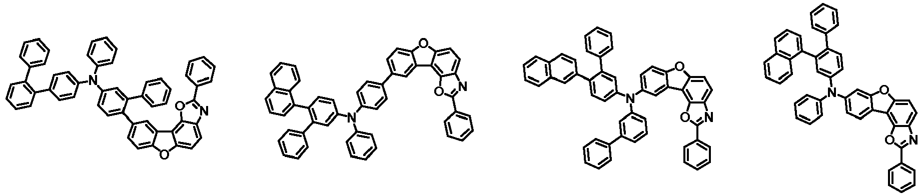

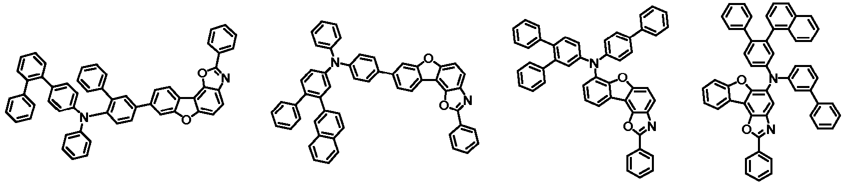

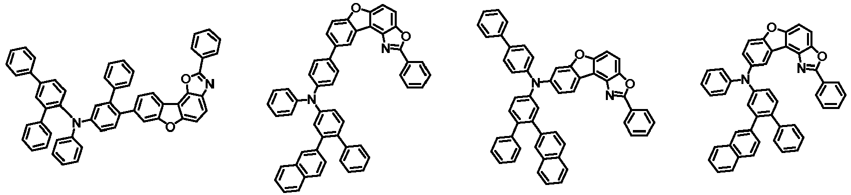

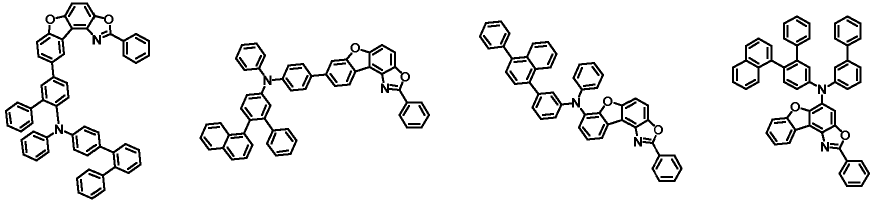

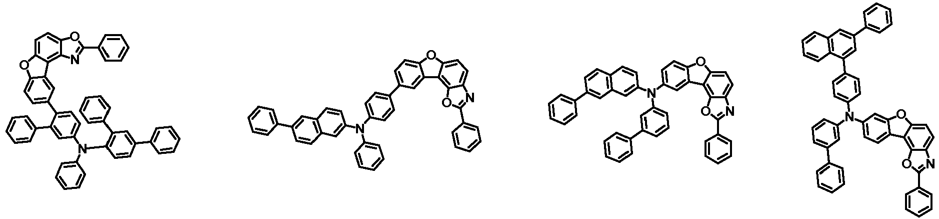

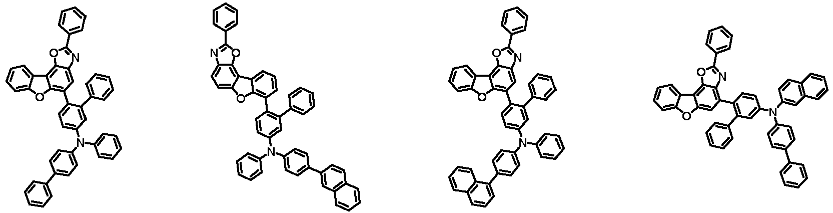

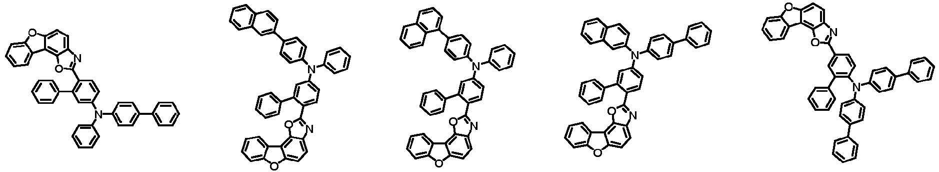

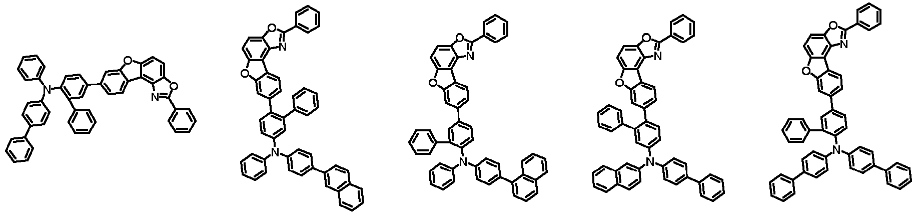

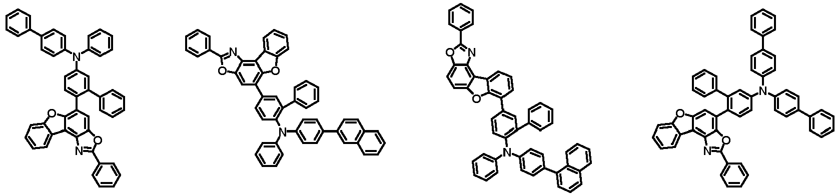

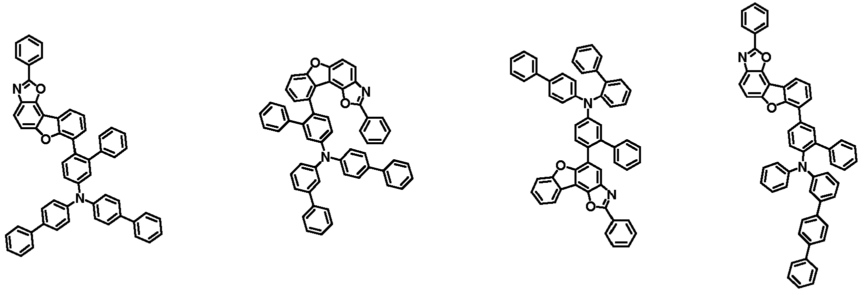

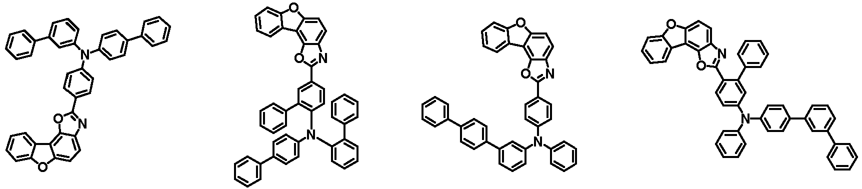

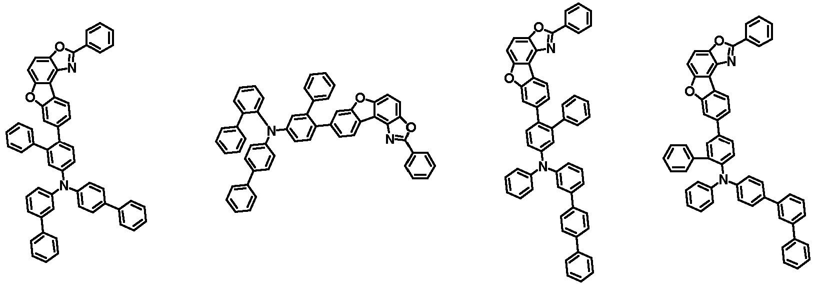

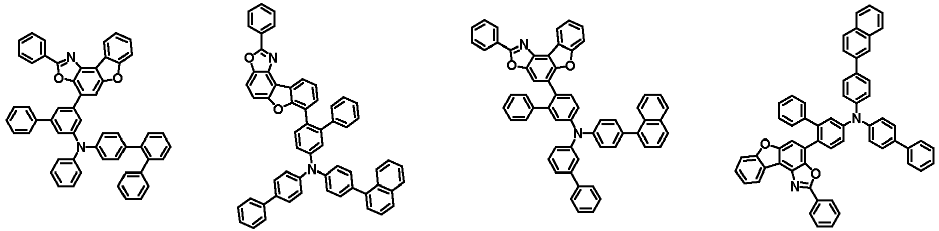

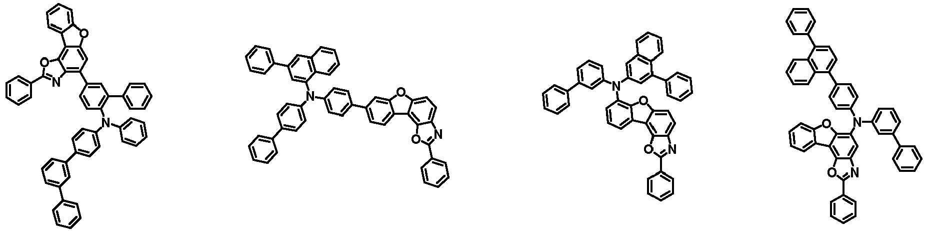

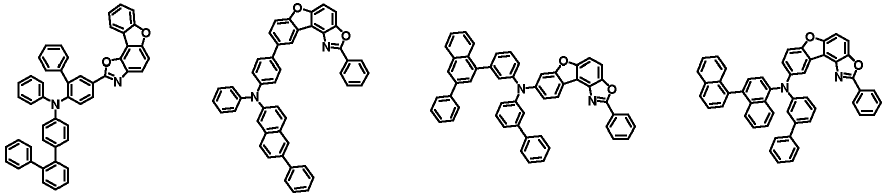

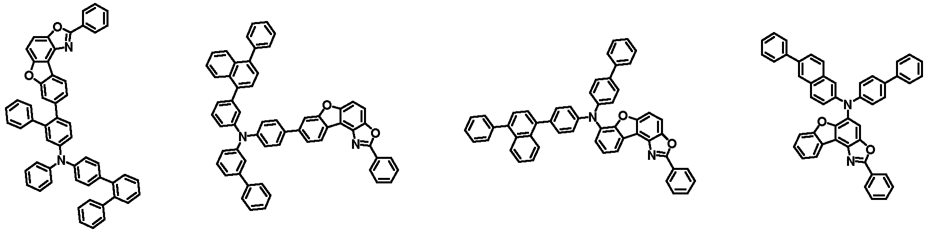

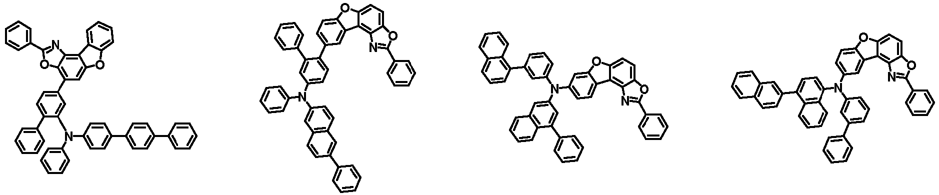

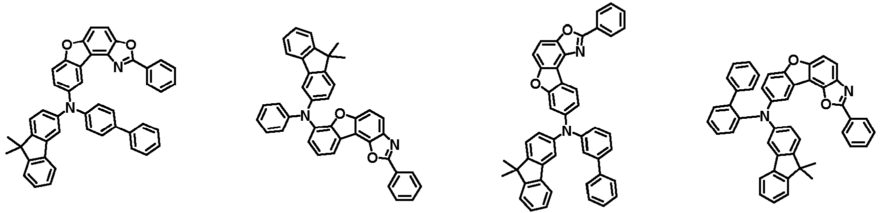

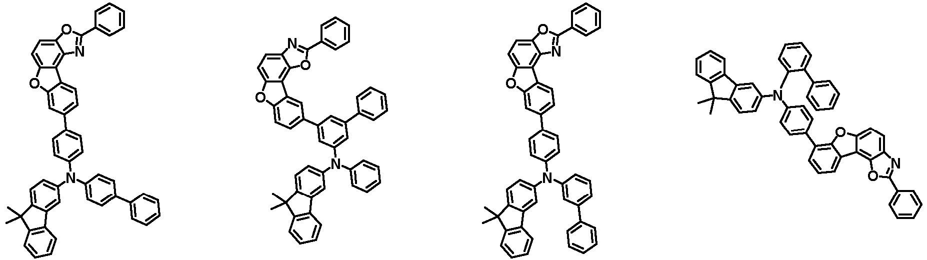

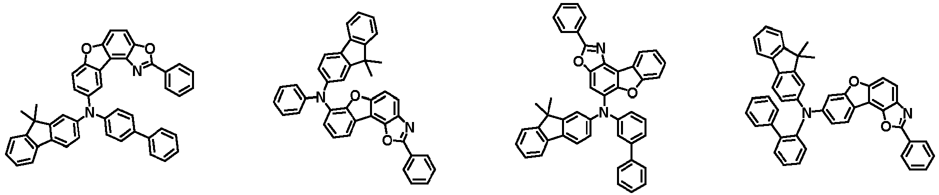

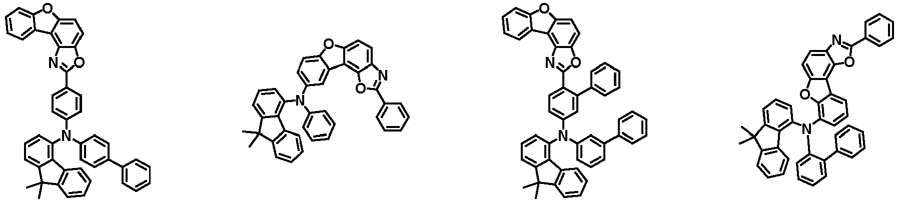

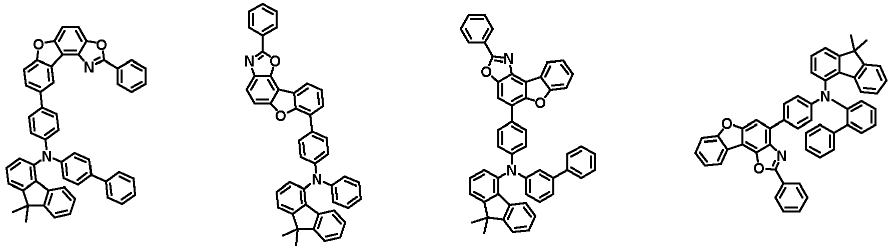

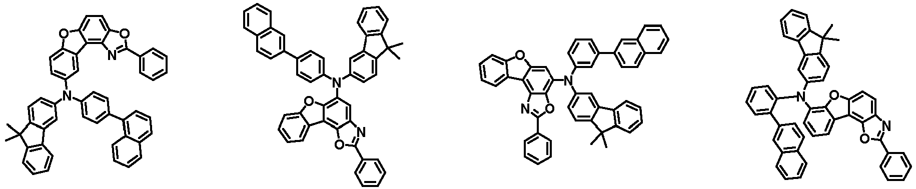

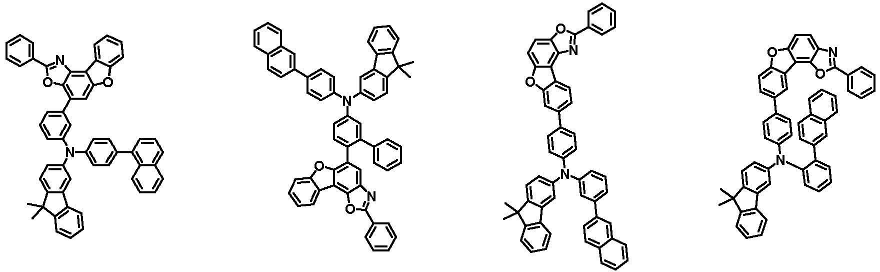

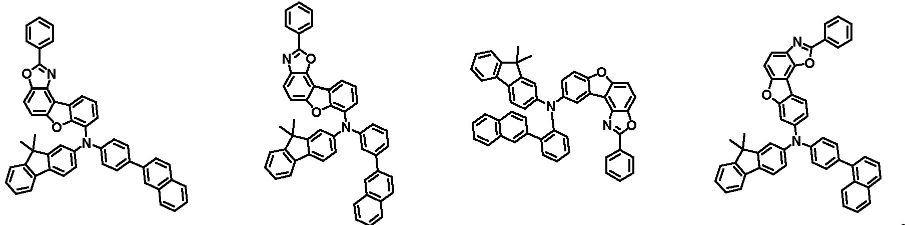

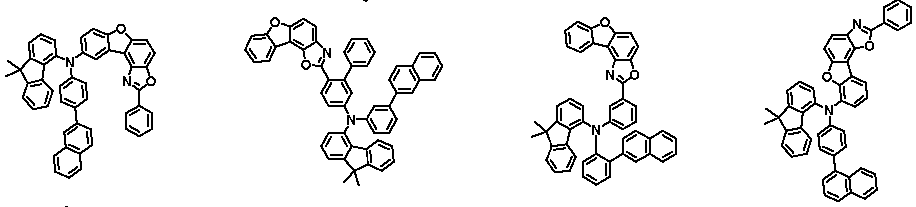

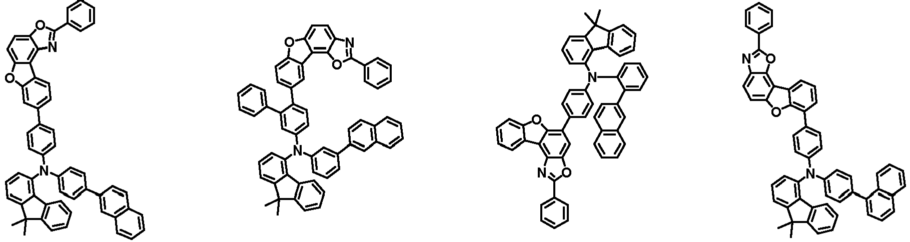

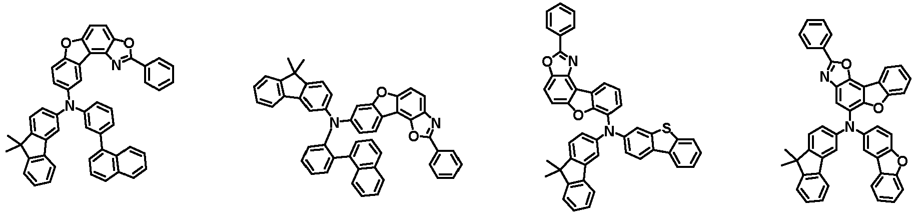

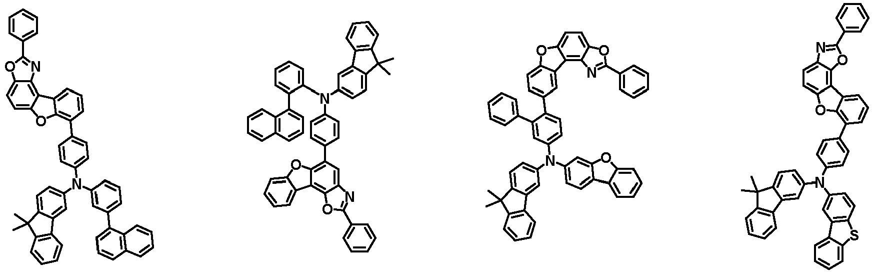

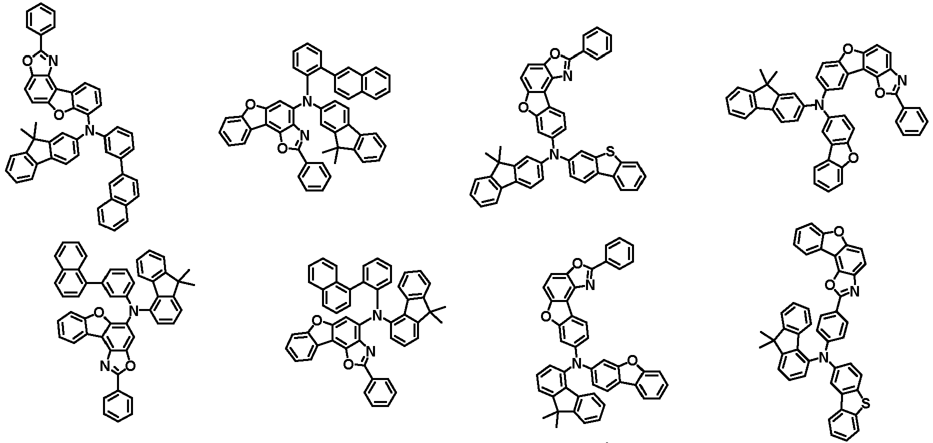

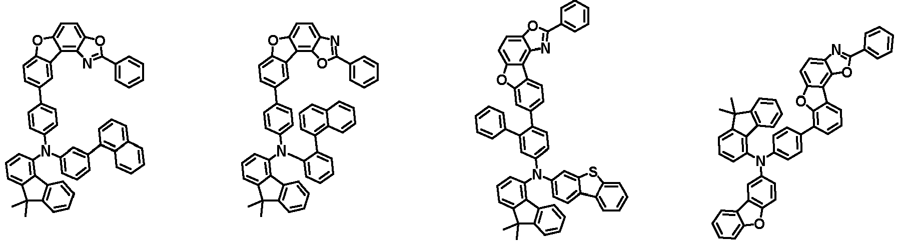

## Patentansprüche

1. Organische lichtemittierende Vorrichtung, umfassend: eine Anode (2); eine Kathode (4); und eine lichtemittierende Schicht (3), die zwischen der Anode und der Kathode angeordnet ist,
wobei die lichtemittierende Schicht eine durch die folgende chemische Formel 1 dargestellte Verbindung und eine durch die folgende chemische Formel 2 dargestellte Verbindung umfasst: 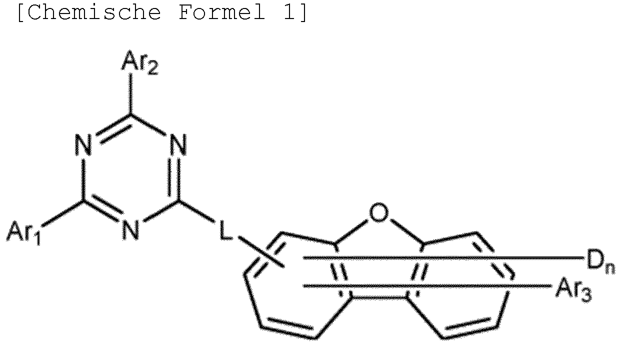 worin in der chemischen Formel 1
L eine Einfachbindung; oder ein substituiertes oder unsubstituiertes C₆₋₆₀-Arylen ist;
Ar₁ und Ar₂ jeweils unabhängig ein substituiertes oder unsubstituiertes C₆₋₆₀-Aryl; oder ein substituiertes oder unsubstituiertes C₂₋₆₀-Heteroaryl sind, das mindestens eines enthält, das ausgewählt ist aus einer Gruppe bestehend aus N, O und S,
Ar₃ Wasserstoff; Deuterium; ein substituiertes oder unsubstituiertes C₆₋₆₀-Aryl; oder ein substituiertes oder unsubstituiertes C₂₋₆₀-Heteroaryl ist, das mindestens eines enthält, das ausgewählt ist aus einer Gruppe bestehend aus N, O und S,
D Deuterium ist und
n eine ganze Zahl von 0 bis 6 ist, 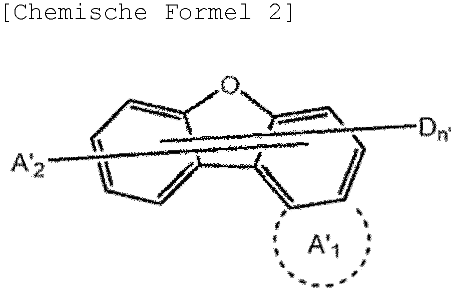
worin in der chemischen Formel 2
A'₁ dargestellt wird durch die folgende chemische Formel 2-a, 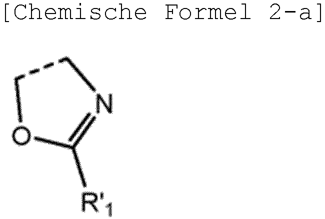 worin in der chemischen Formel 2-a
die gepunktete Linie mit einem benachbarten Ring kondensiert ist,
R'₁ Ar'₁; oder ein Substituent ist, der dargestellt wird durch die folgende chemische Formel 2-b, und
Ar'₁ ein substituiertes oder unsubstituiertes C₆₋₆₀-Aryl; oder ein substituiertes oder unsubstituiertes C₂₋₆₀-Heteroaryl ist, das mindestens ein Heteroatom enthält, das ausgewählt ist aus einer Gruppe bestehend aus N, O und S, und 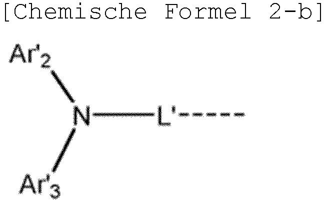 worin in der chemischen Formel 2-b
L' eine Einfachbindung; oder ein substituiertes oder unsubstituiertes C₆₋₆₀-Arylen ist;
Ar'₂ und Ar'₃ jeweils unabhängig Wasserstoff; Deuterium; ein substituiertes oder unsubstituiertes C₆₋₆₀-Aryl; oder ein substituiertes oder unsubstituiertes C₂₋₆₀-Heteroaryl sind, das mindestens ein Heteroatom enthält, das ausgewählt ist aus einer Gruppe bestehend aus N, O und S,
wenn R'₁ Ar'₁ ist, A'₂ ein Substituent ist, der dargestellt wird durch die chemische Formel 2-b,
wenn R'₁ ein Substituent ist, der dargestellt wird durch die chemische Formel 2-b, A'₂ Wasserstoff oder Deuterium ist,
D Deuterium ist und
n' eine ganze Zahl von 0 bis 5 ist.

2. Organische lichtemittierende Vorrichtung gemäß Anspruch 1,
wobei die chemische Formel 1 dargestellt wird durch die folgende chemische Formel 1-1: 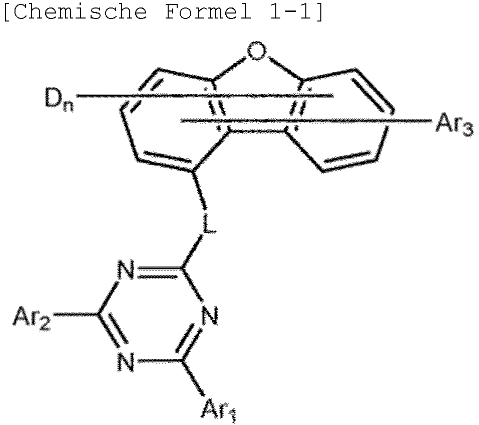 worin in der chemischen Formel 1-1
L, Ar₁ bis Ar₃, D und n wie in Anspruch 1 definiert sind.

3. Organische lichtemittierende Vorrichtung gemäß Anspruch 1,
worin L eine Einfachbindung, Phenylen oder Naphthalendiyl ist.

4. Organische lichtemittierende Vorrichtung gemäß Anspruch 1,
worin Ar₁ und Ar₂ jeweils unabhängig Phenyl, Biphenylyl, Terphenylyl, Naphthyl, Phenanthrenyl, (Phenyl)naphthyl, (Naphthyl)phenyl, (Naphthyl)naphthyl, Dibenzofuranyl oder Dibenzothiophenyl sind.

5. Organische lichtemittierende Vorrichtung gemäß Anspruch 1,
worin Ar₃ Wasserstoff, Phenyl, Biphenylyl, Terphenylyl, Naphthyl, Phenanthrenyl, (Phenyl)naphthyl, (Naphthyl)phenyl, Fluoranthenyl, Triphenylenyl, Dibenzofuranyl, Dibenzothiophenyl, Benzonaphthofuranyl oder Benzonaphthothiophenyl ist.

6. Organische lichtemittierende Vorrichtung gemäß Anspruch 1,
wobei die durch die chemische Formel 1 dargestellte Verbindung eine beliebige Verbindung ist, die ausgewählt ist aus einer Gruppe bestehend aus:

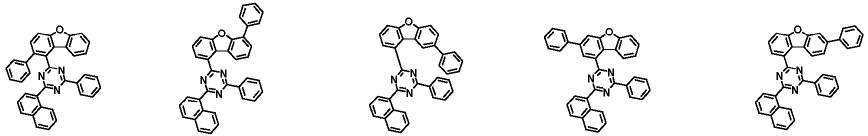

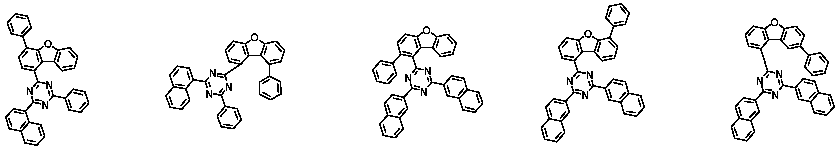

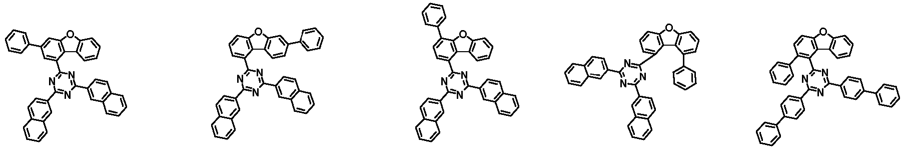

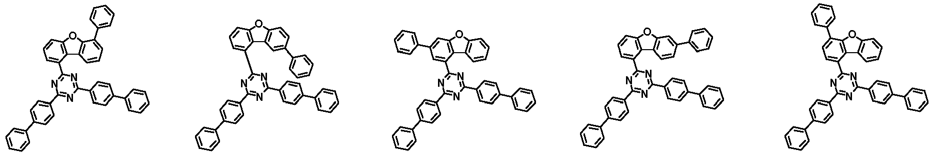

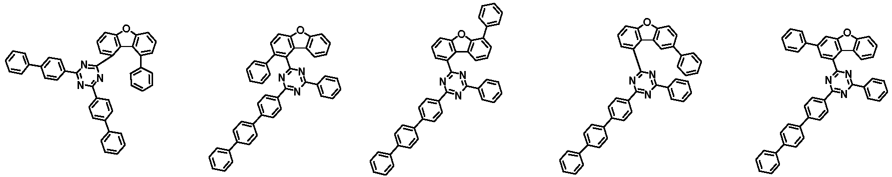

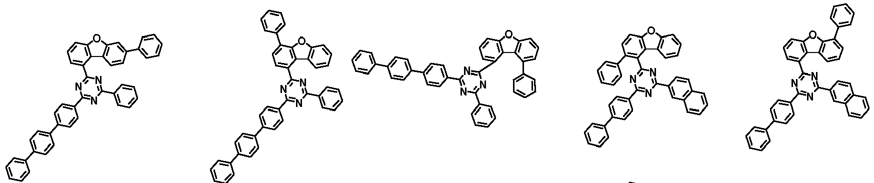

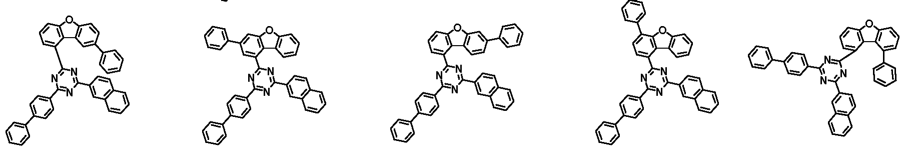

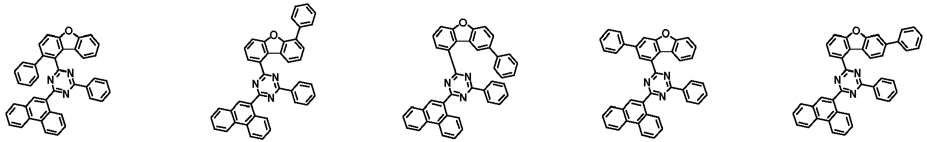

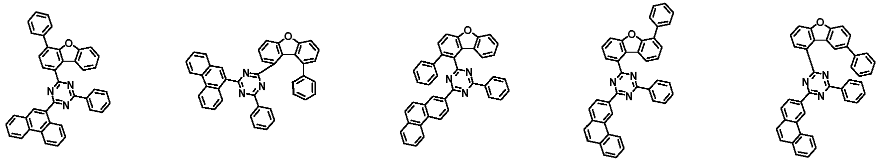

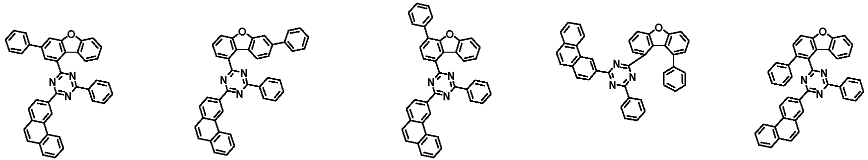

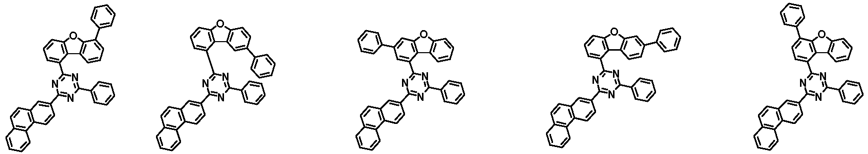

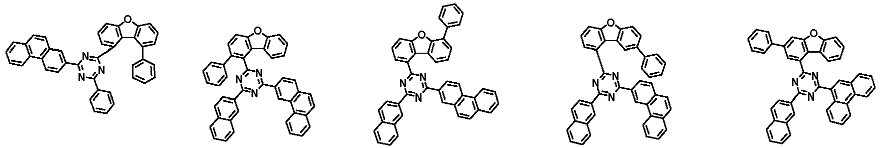

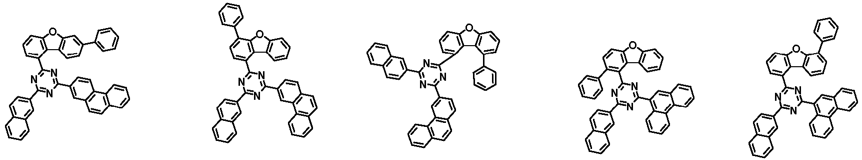

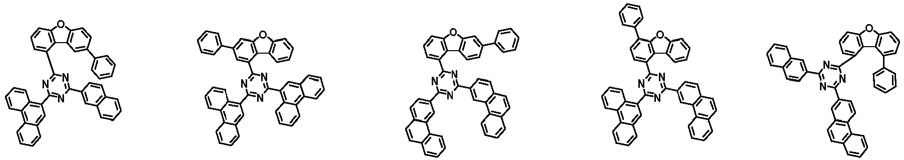

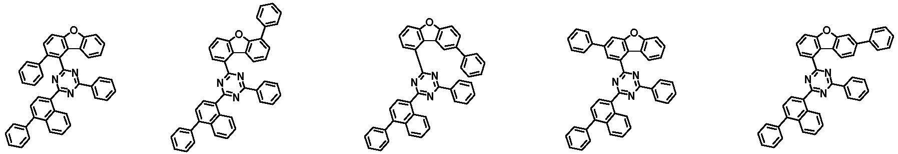

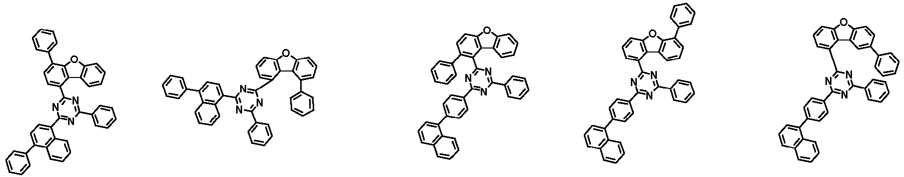

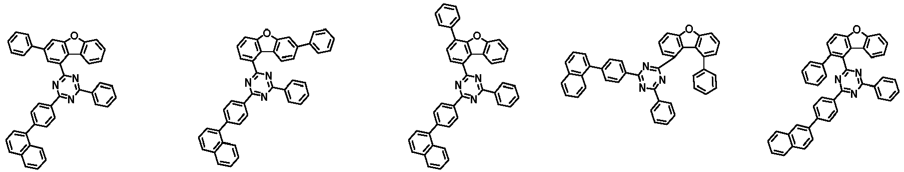

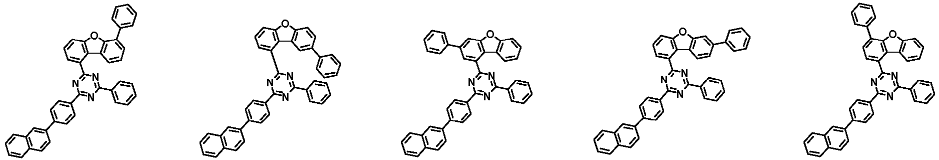

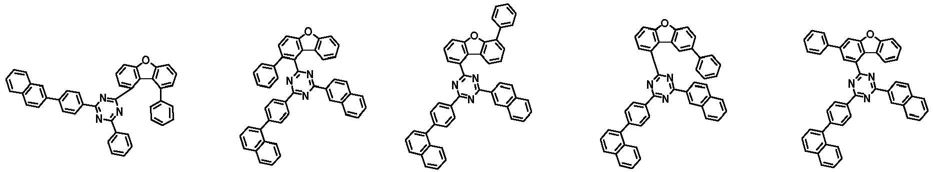

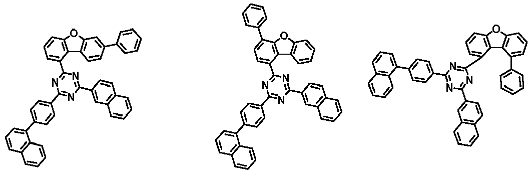

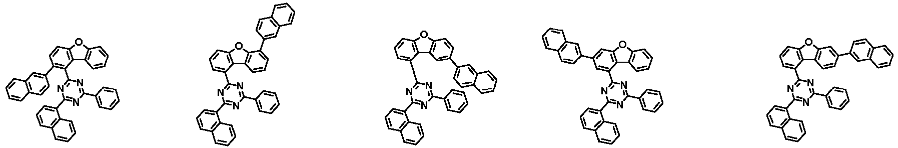

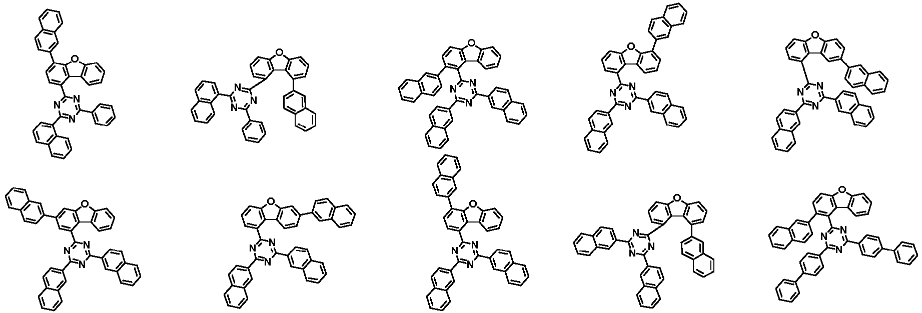

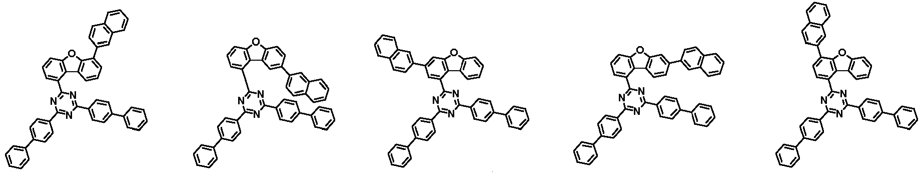

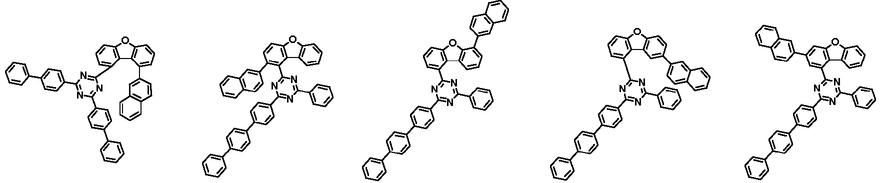

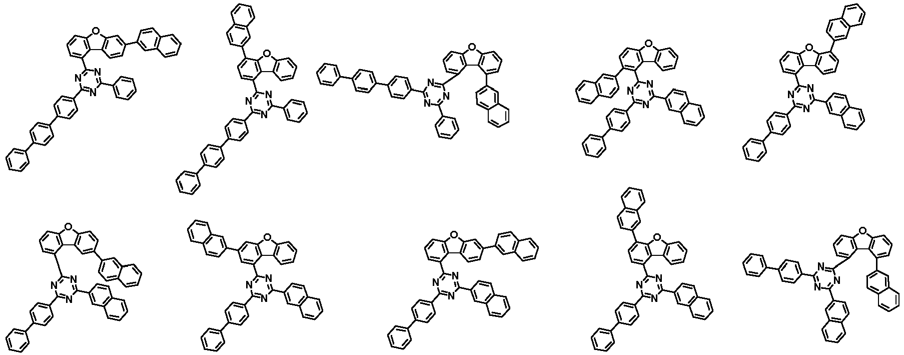

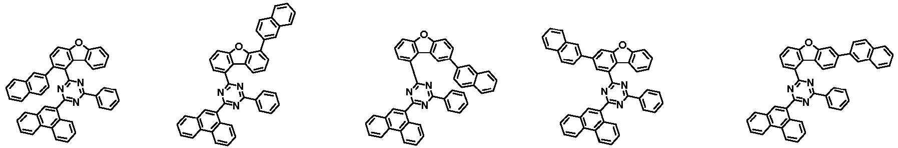

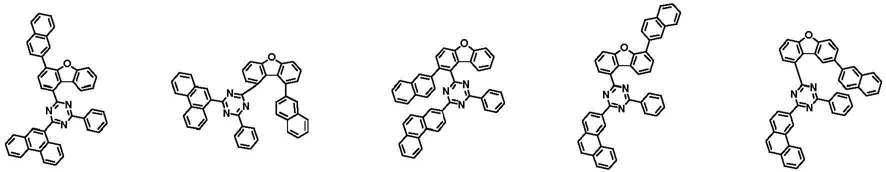

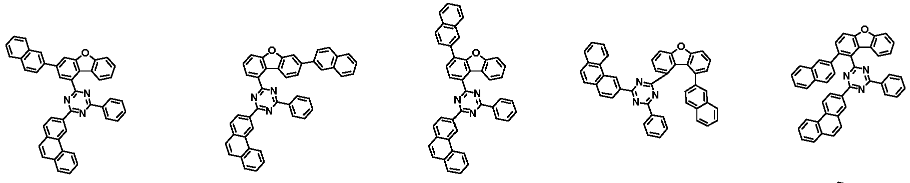

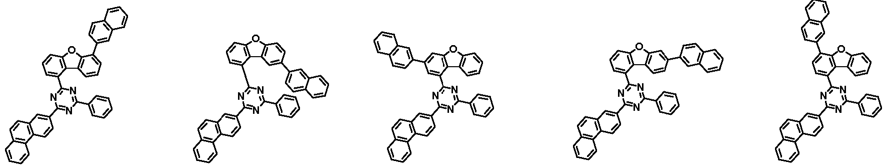

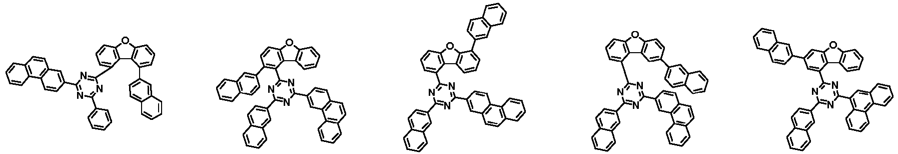

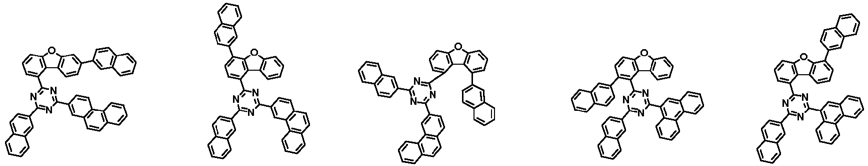

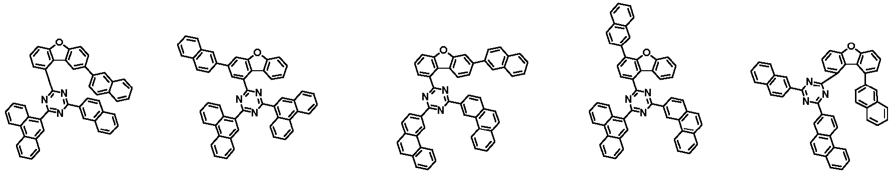

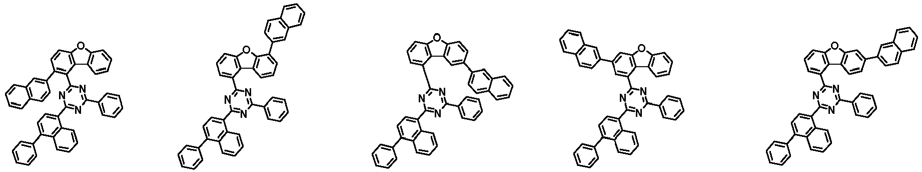

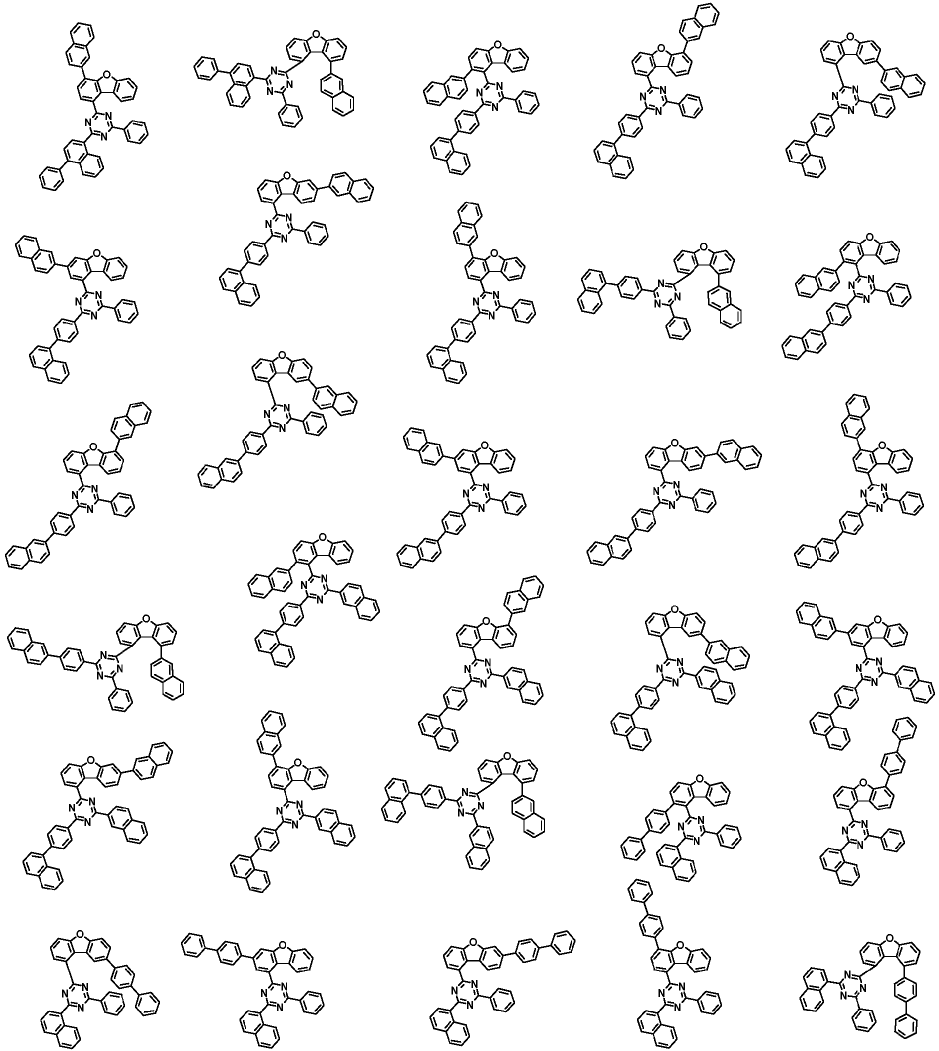

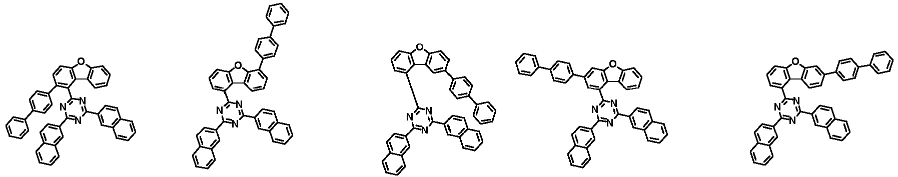

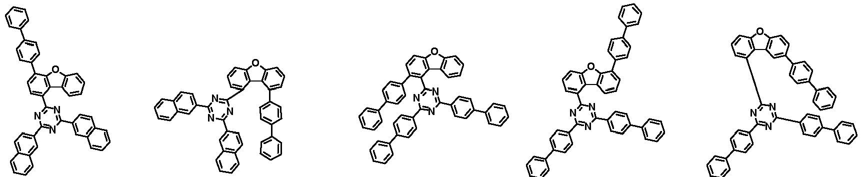

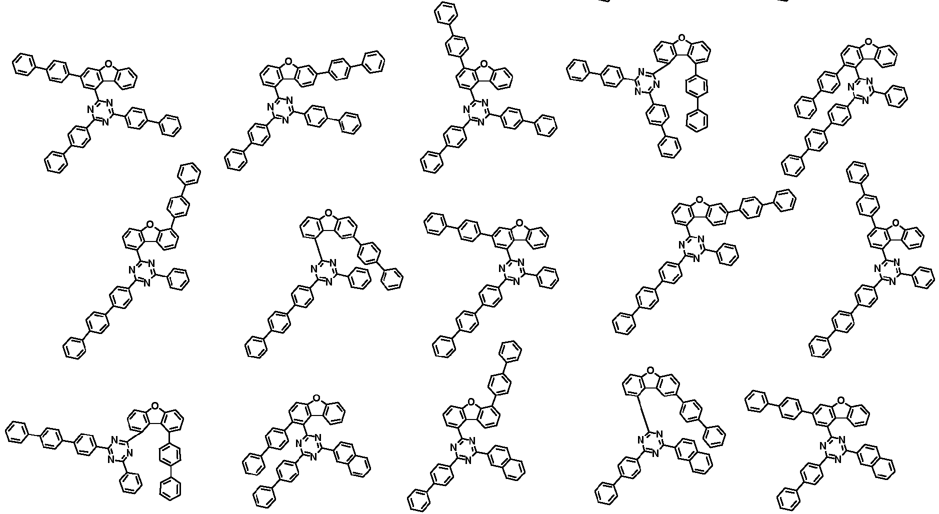

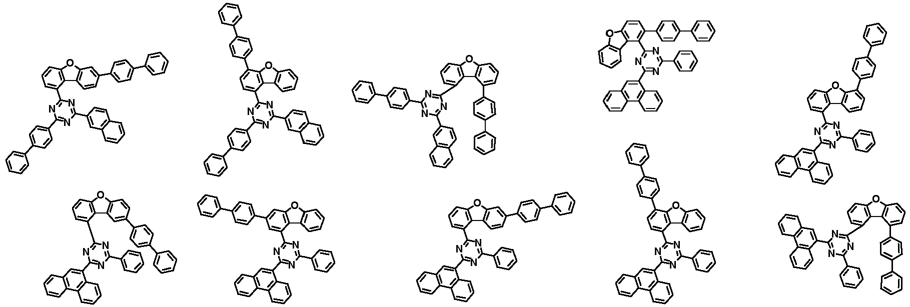

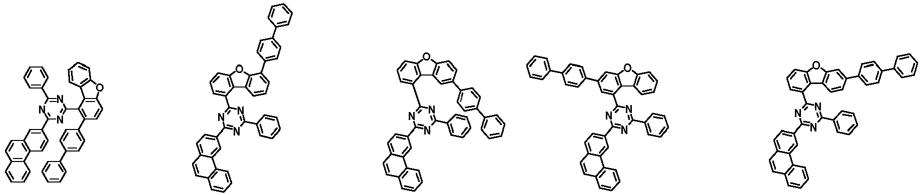

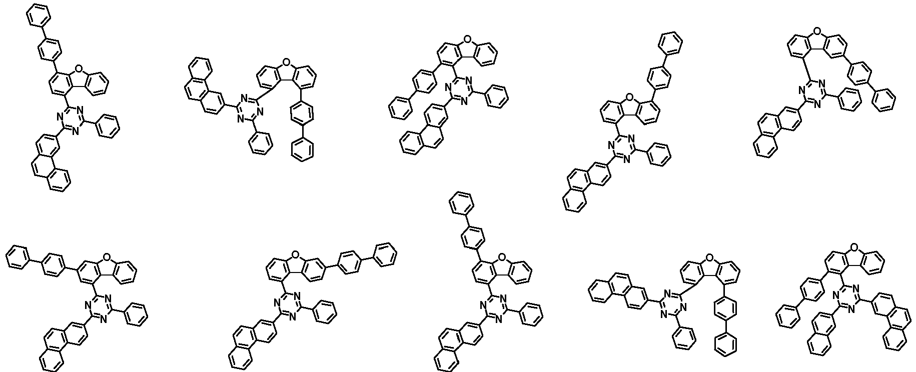

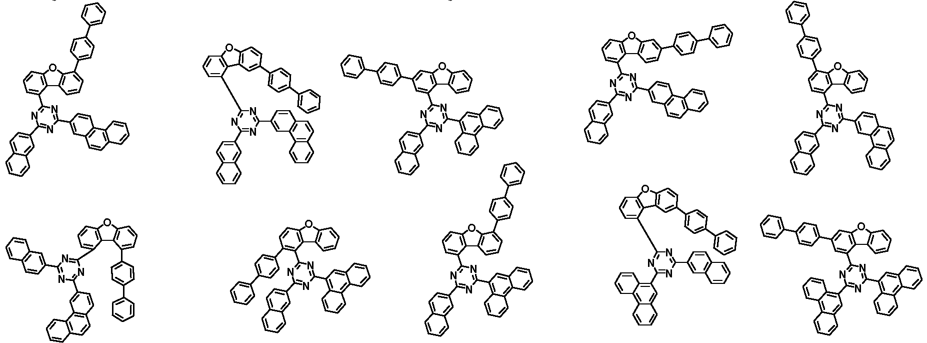

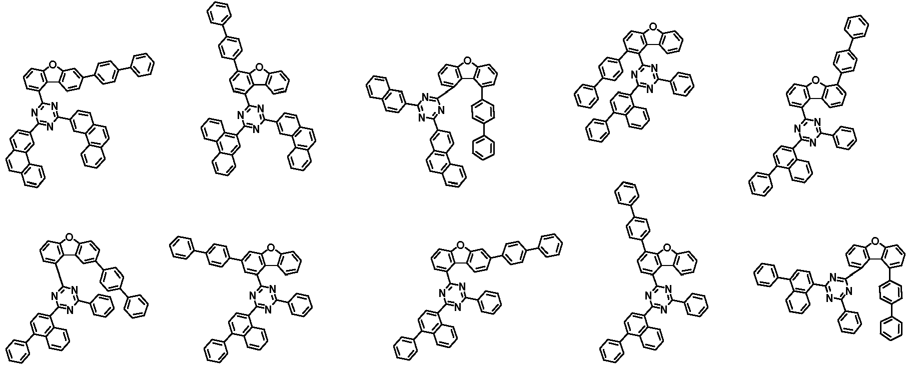

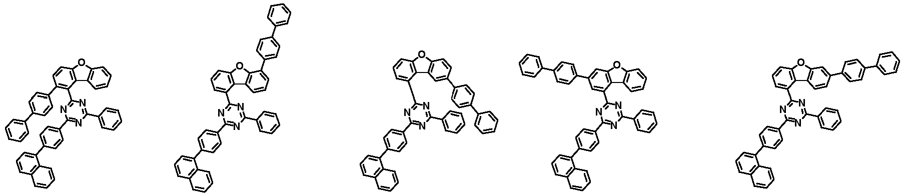

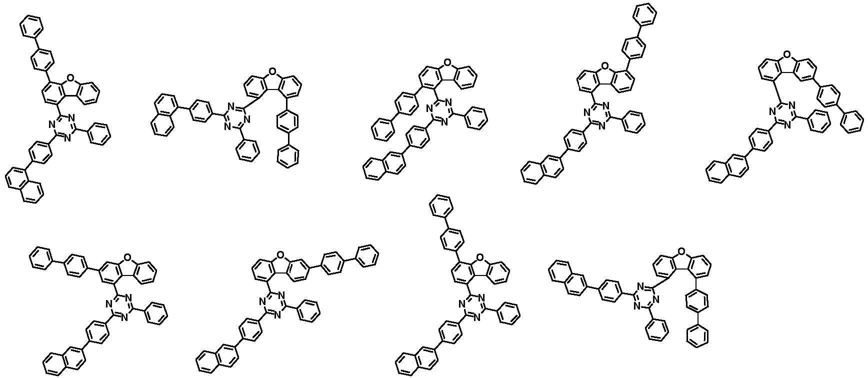

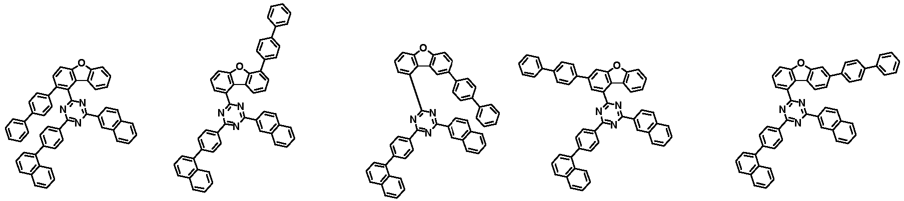

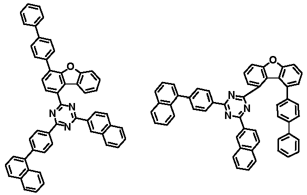

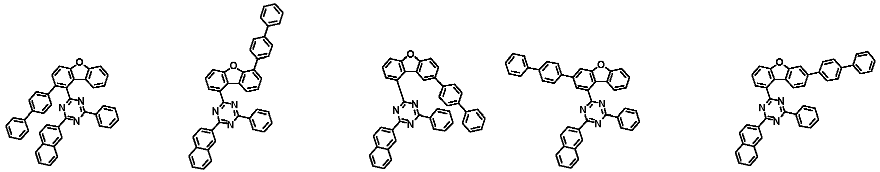

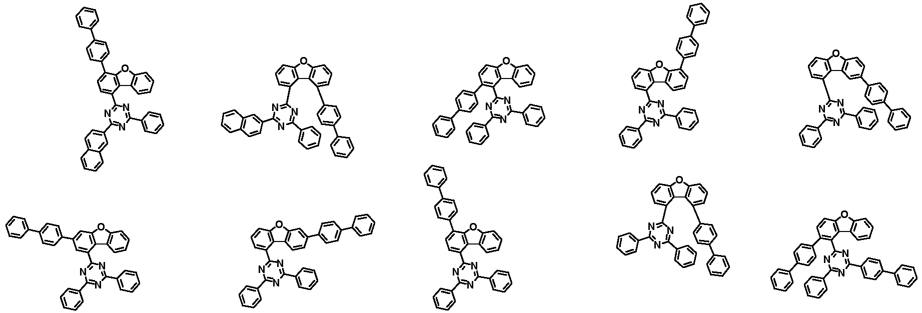

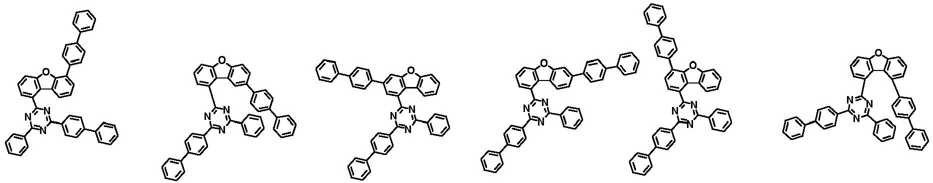

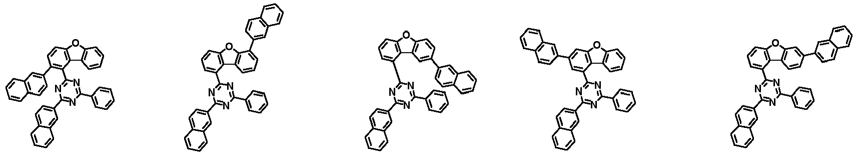

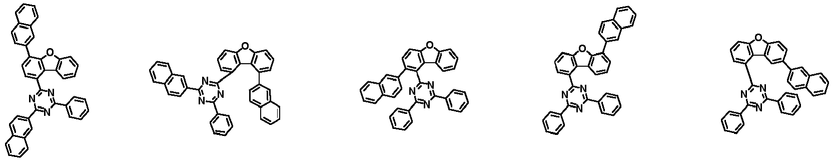

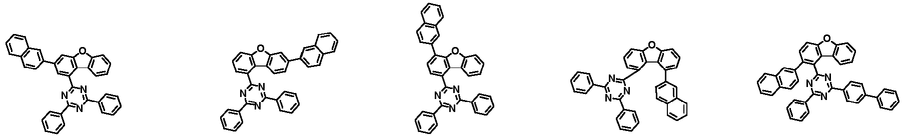

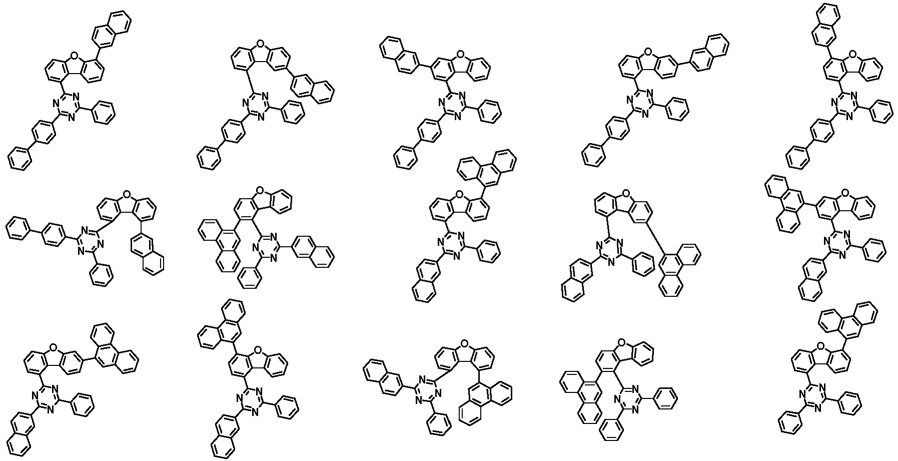

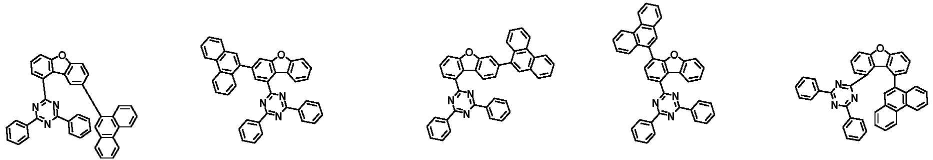

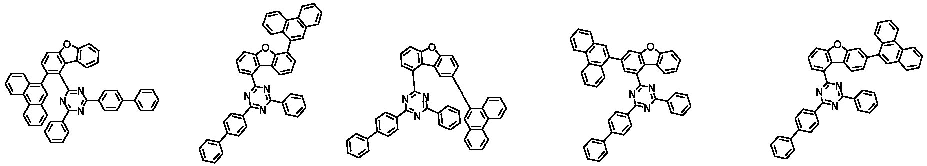

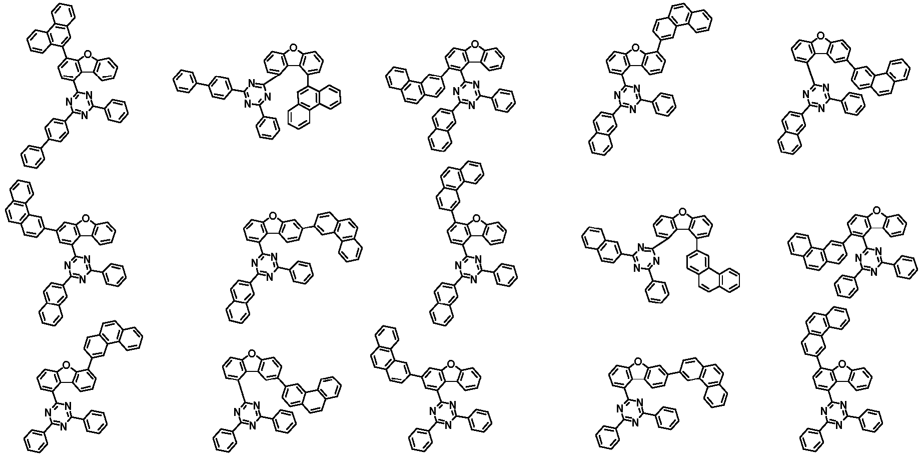

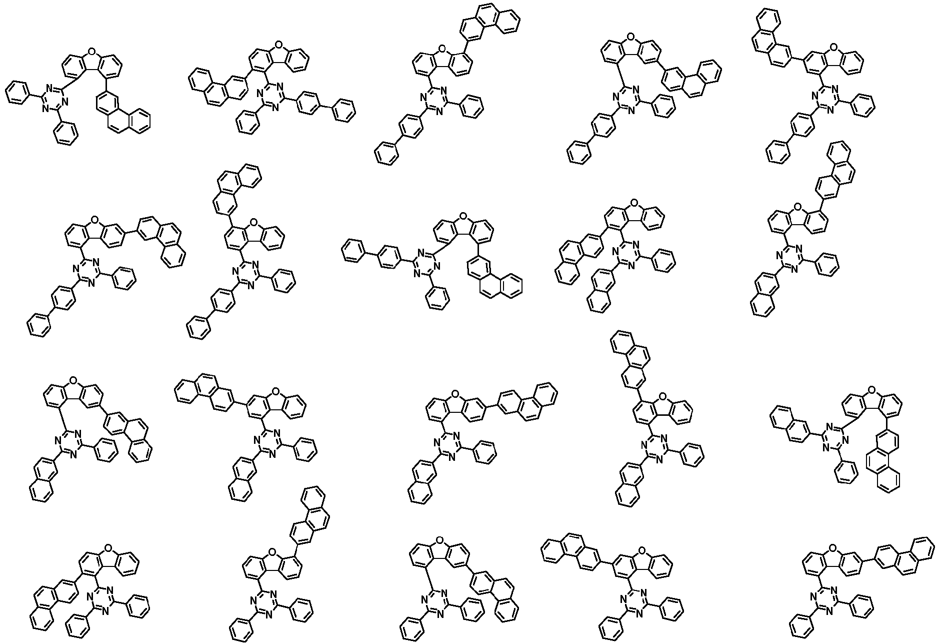

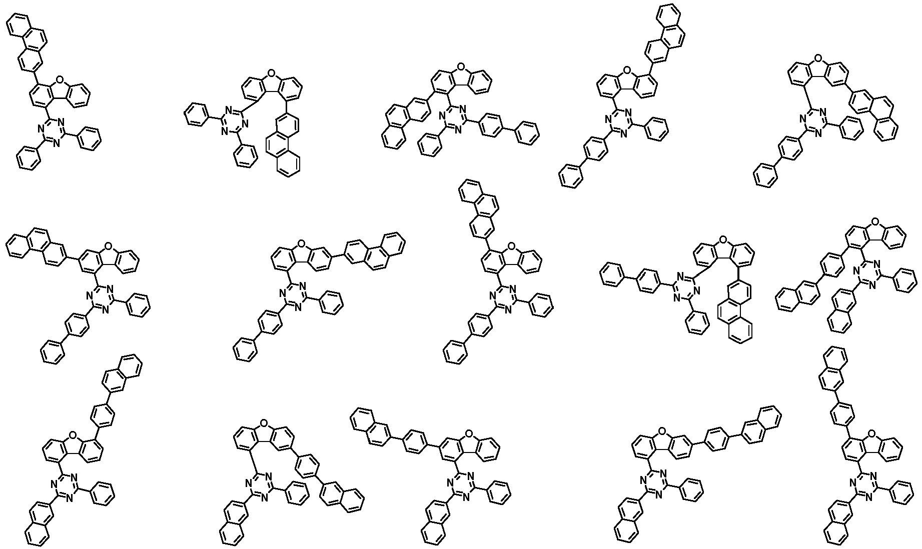

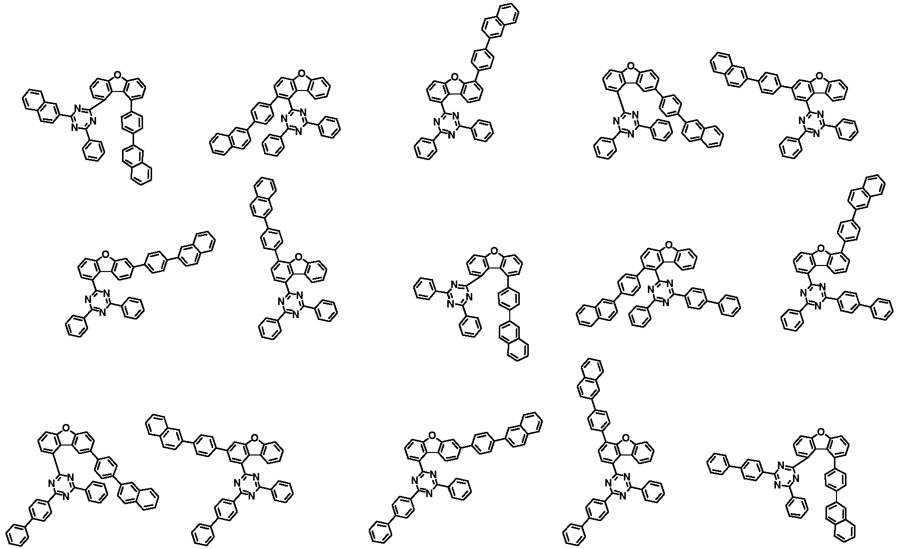

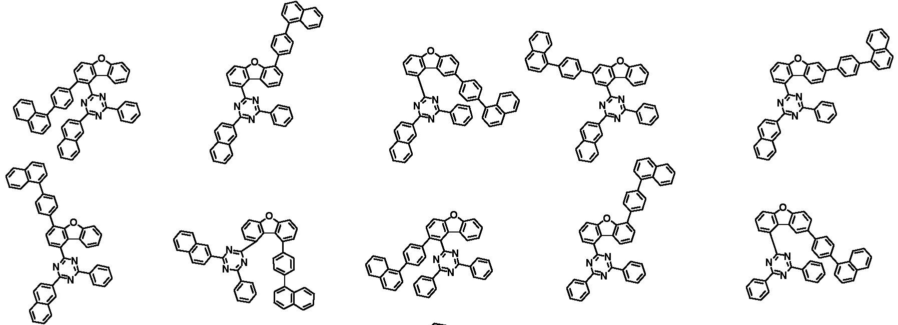

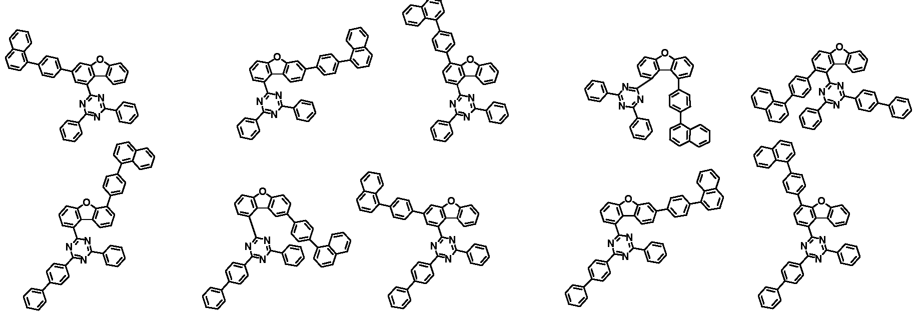

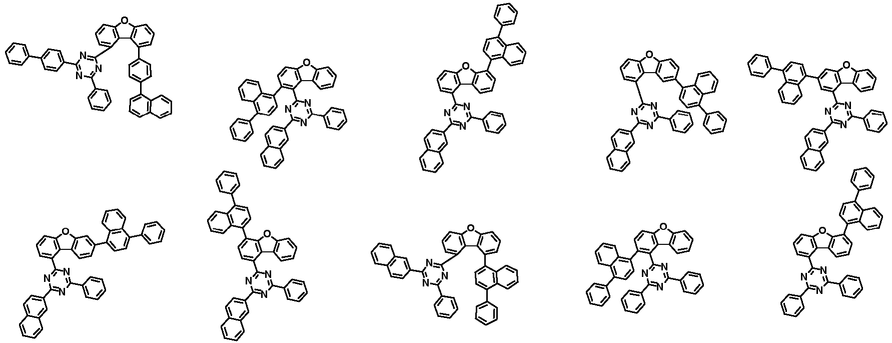

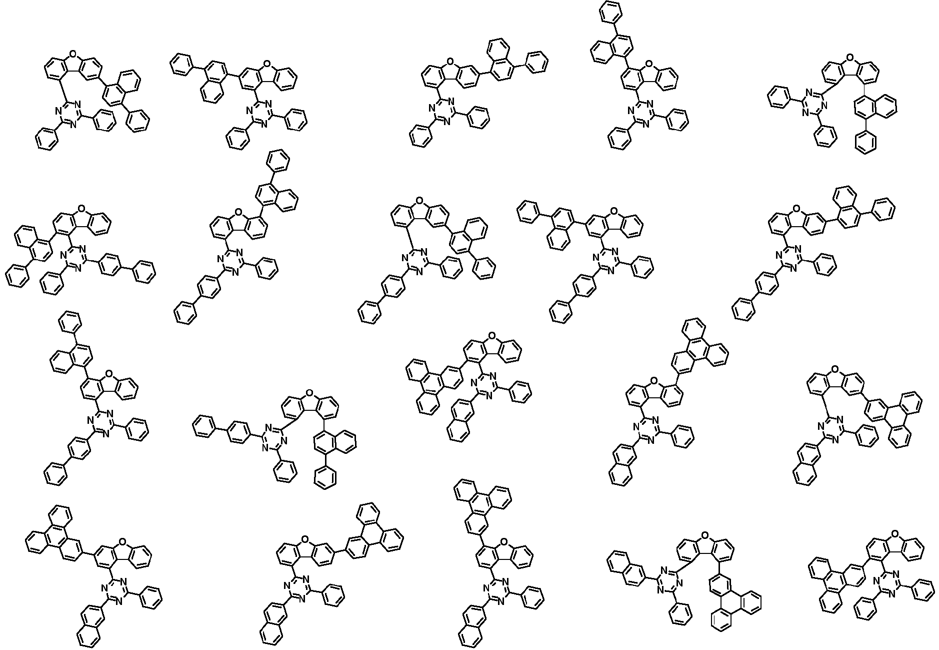

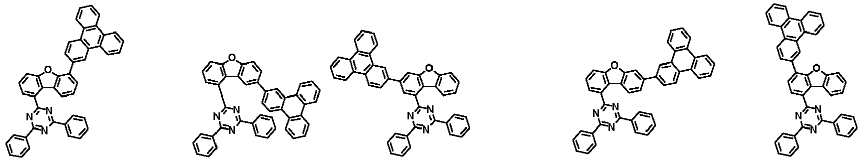

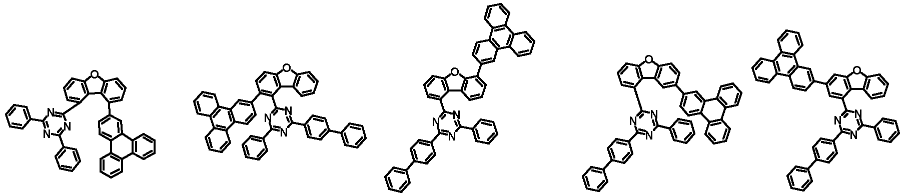

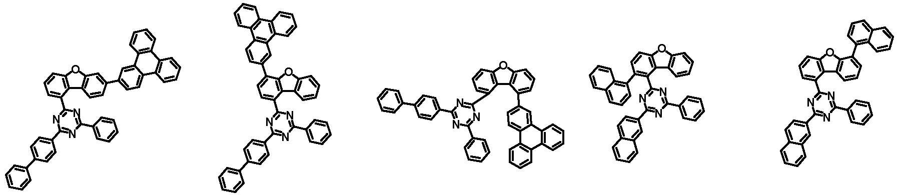

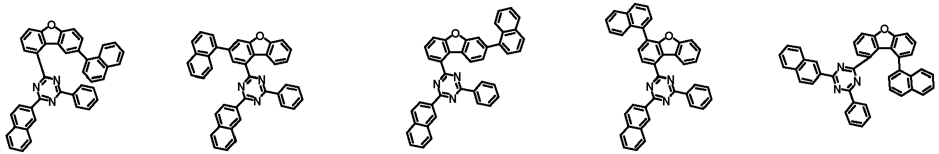

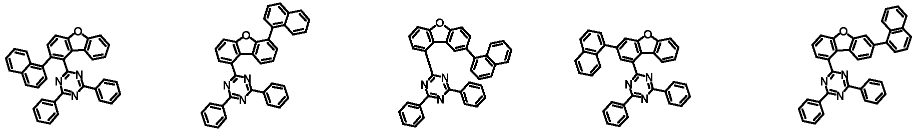

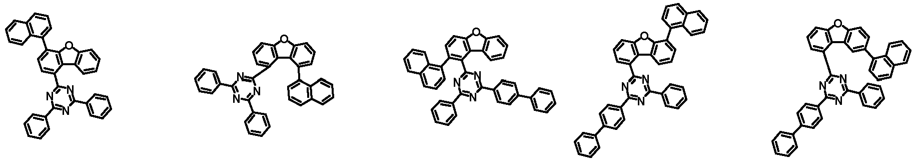

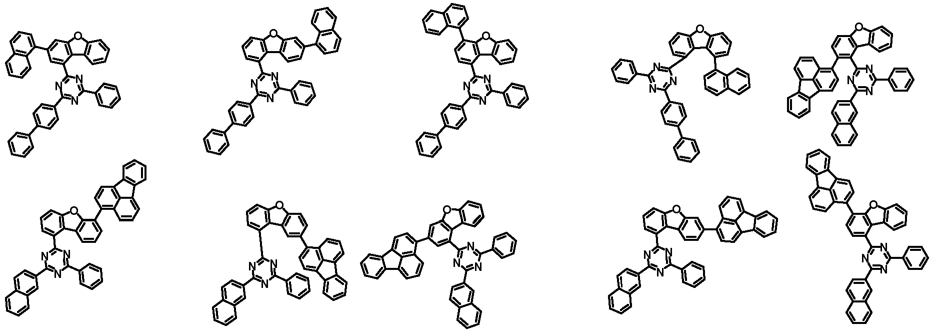

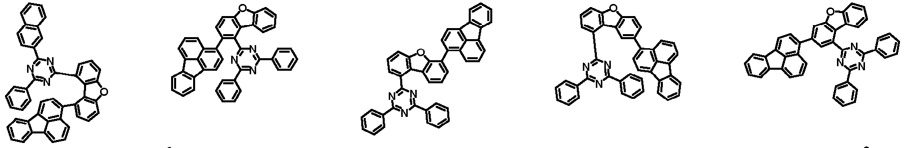

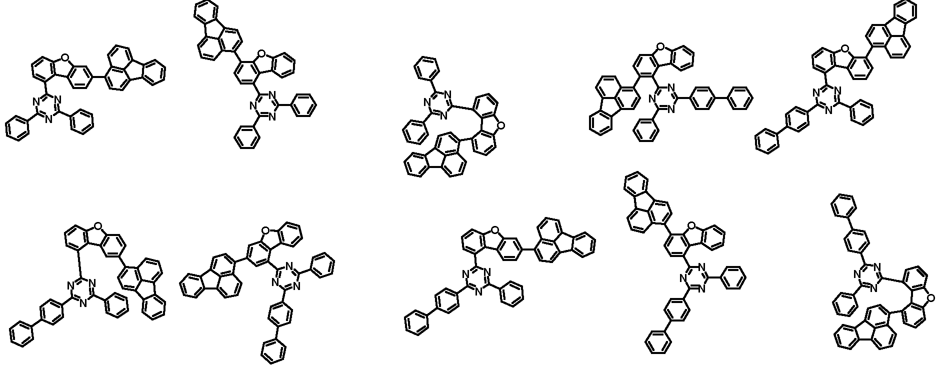

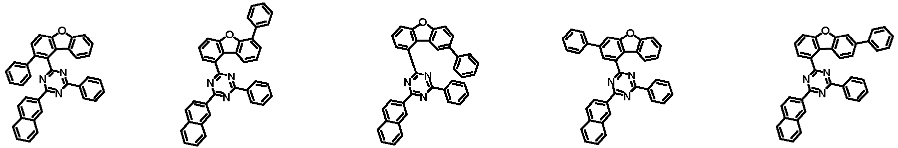

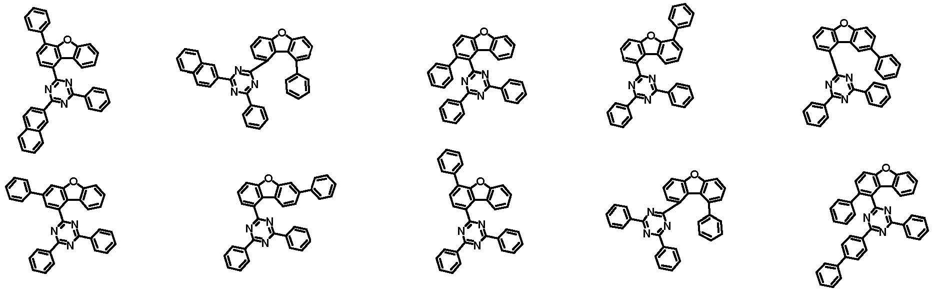

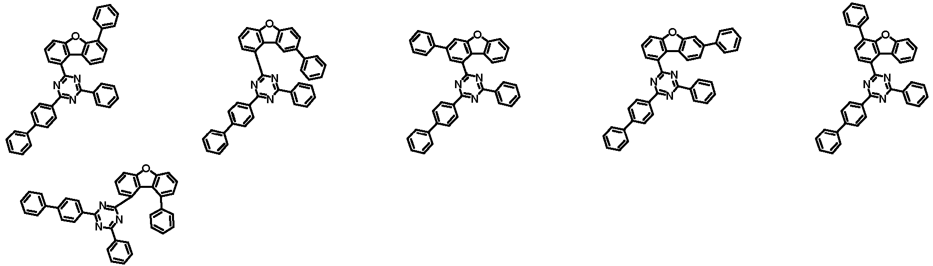

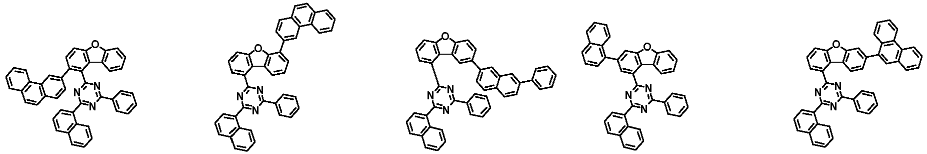

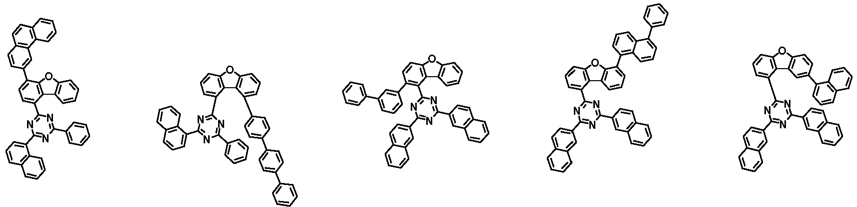

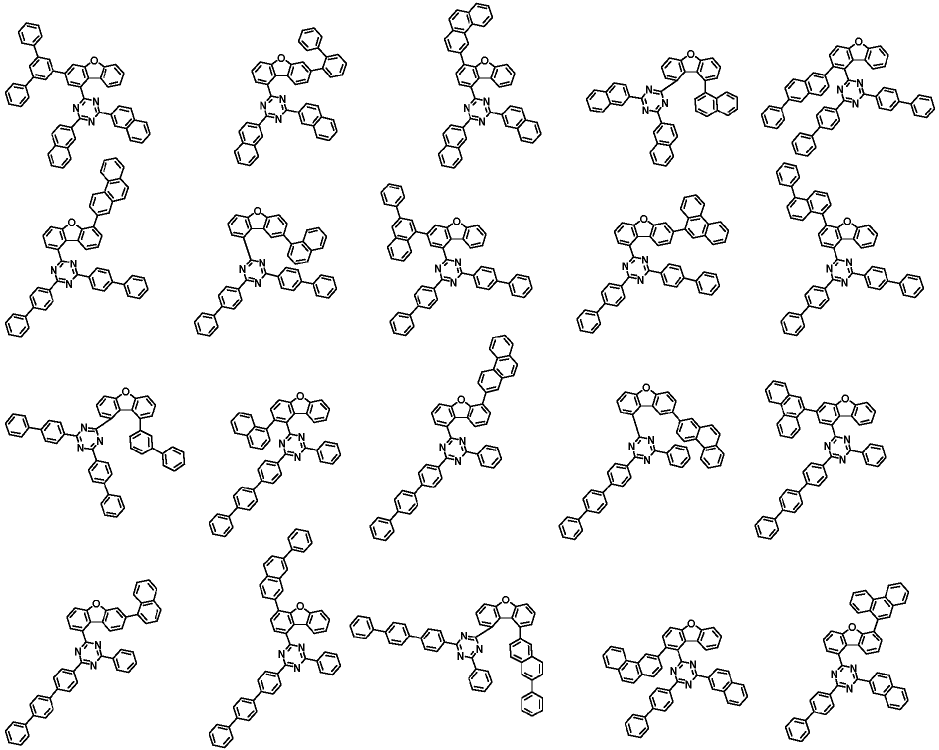

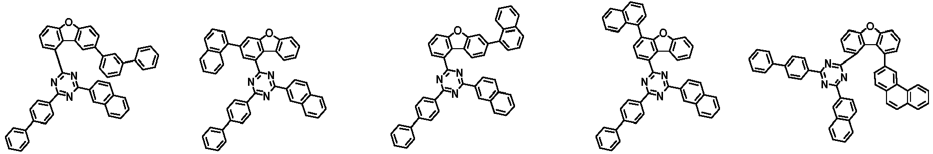

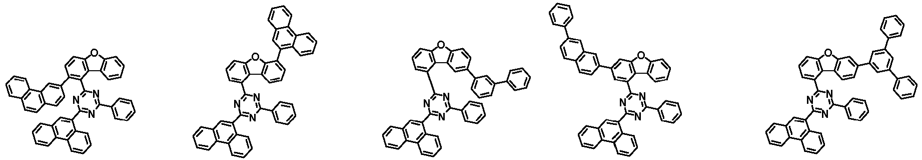

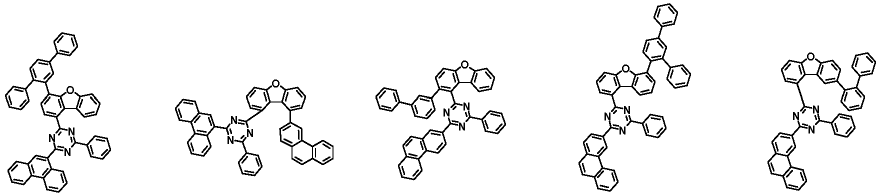

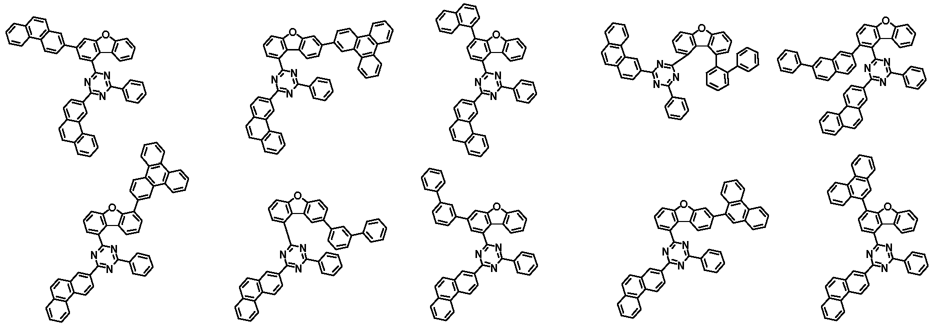

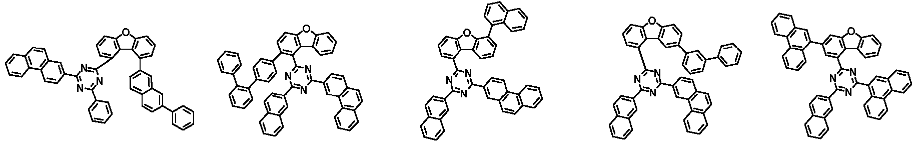

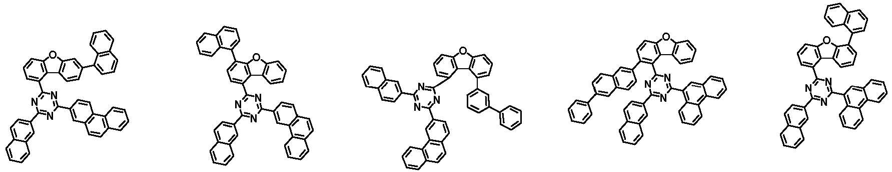

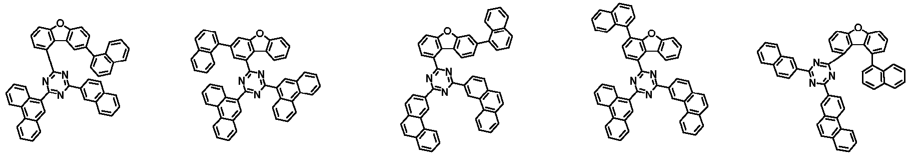

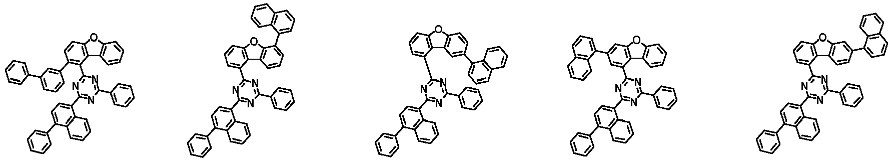

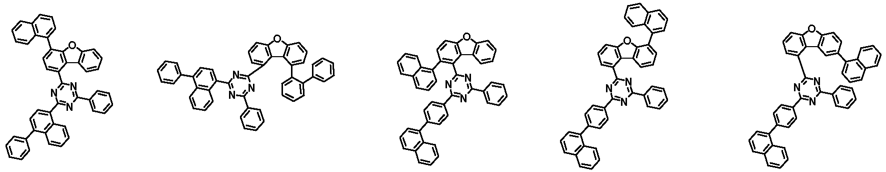

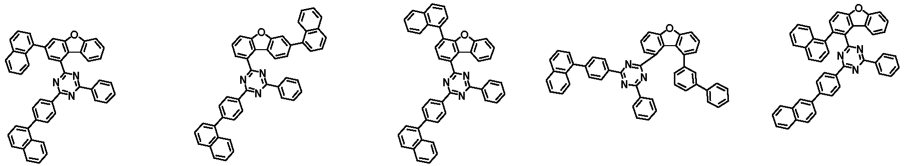

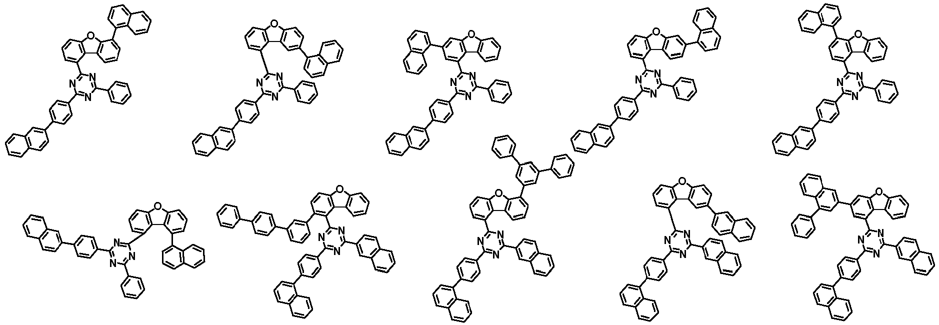

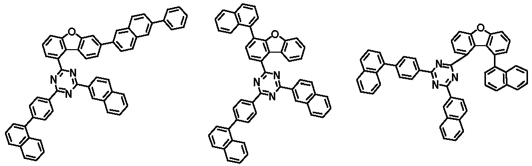

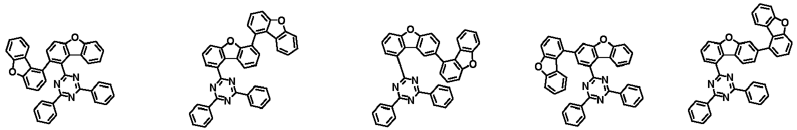

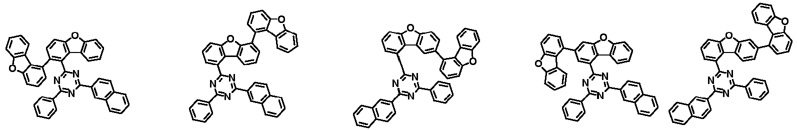

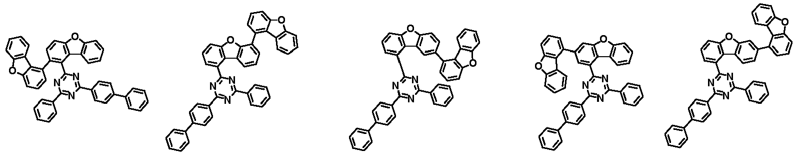

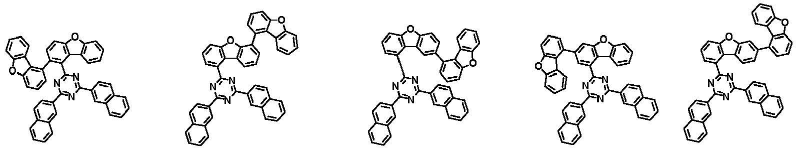

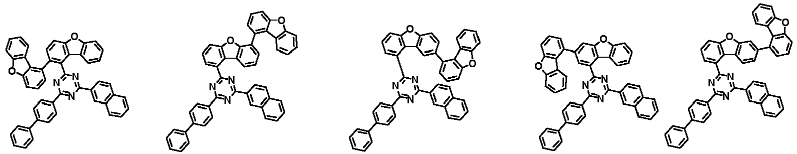

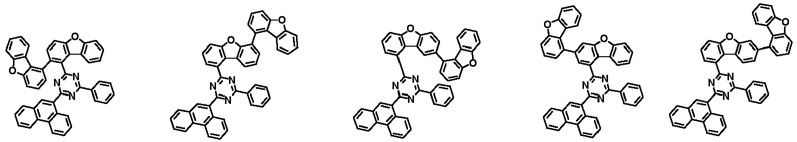

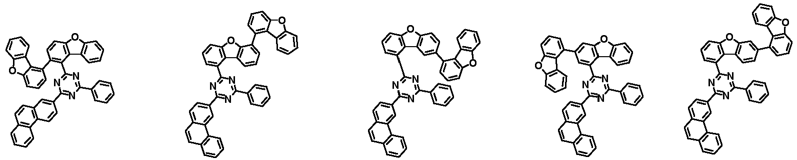

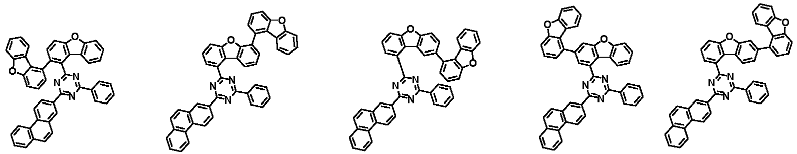

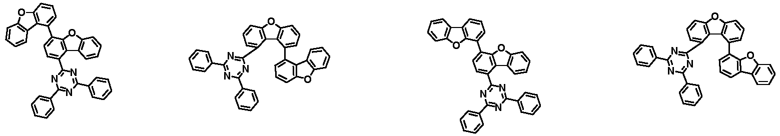

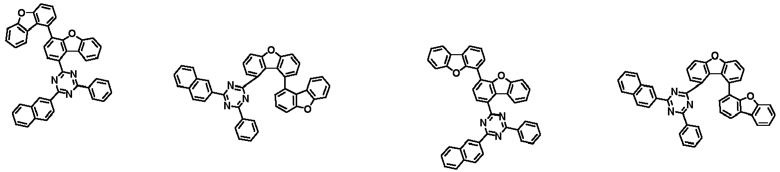

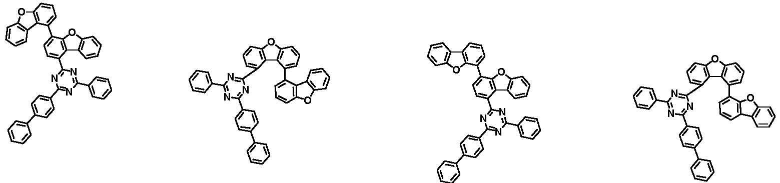

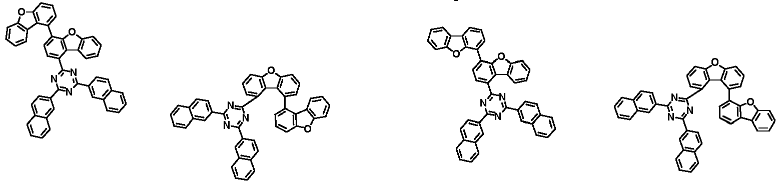

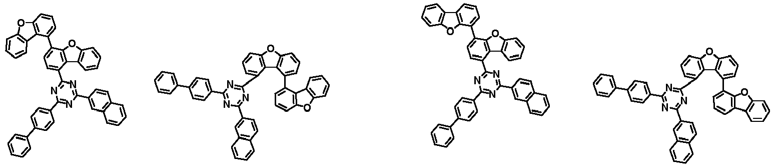

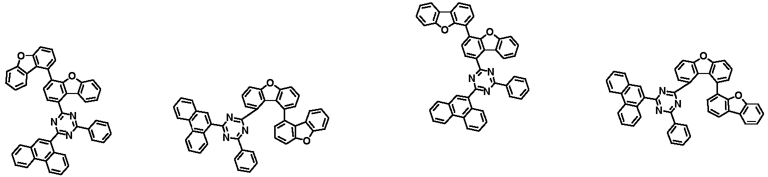

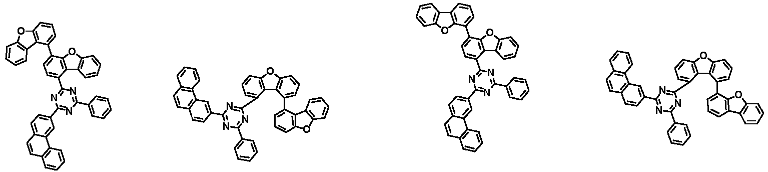

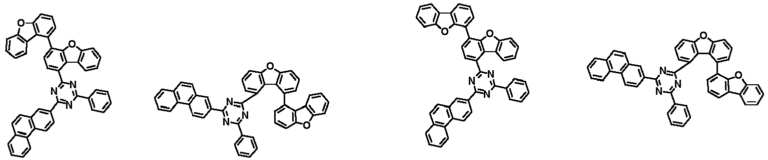

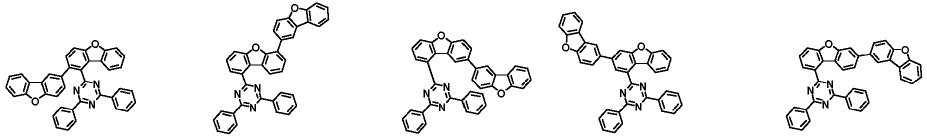

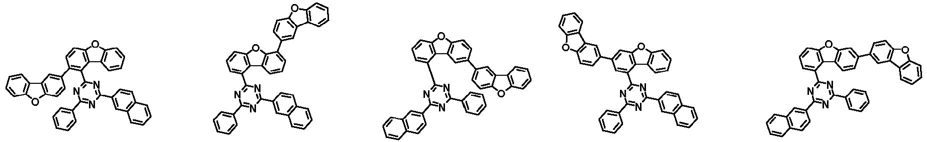

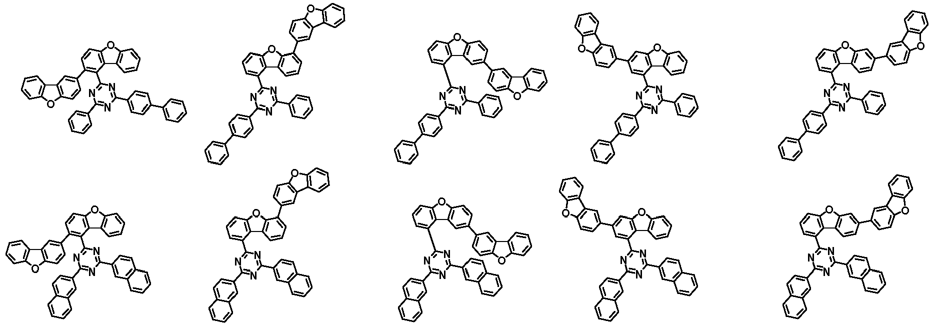

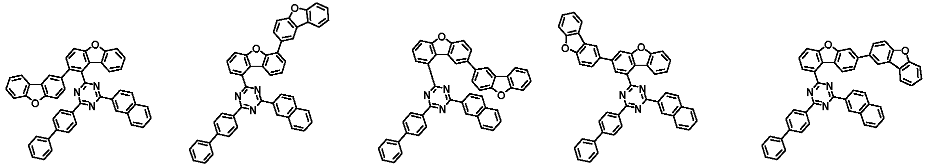

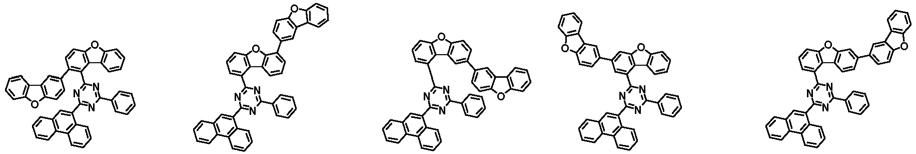

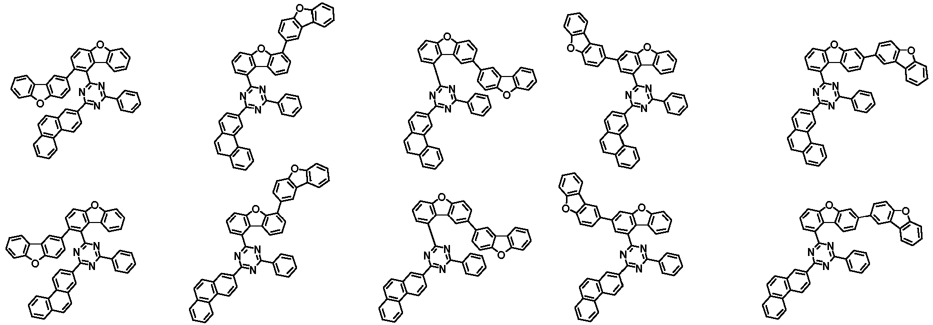

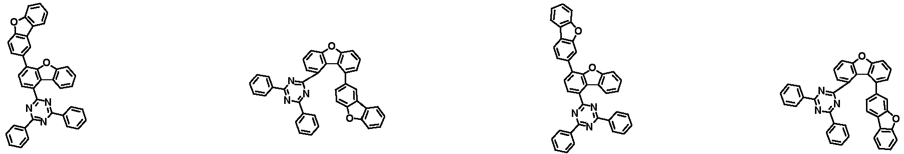

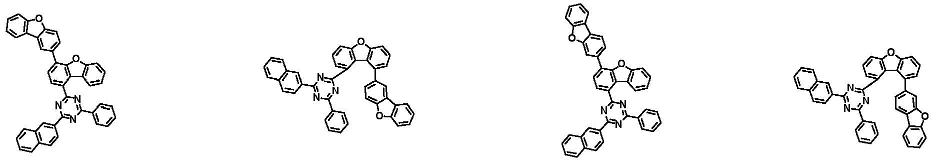

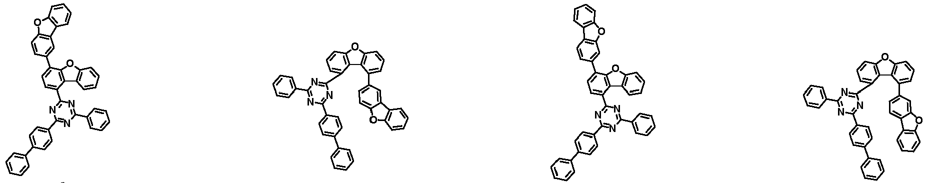

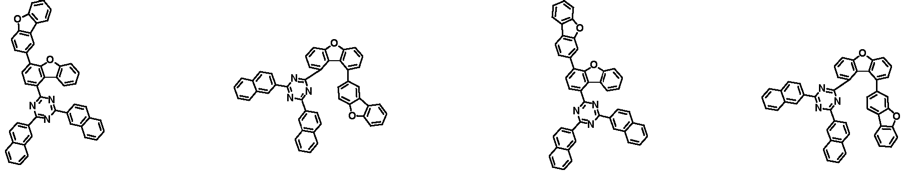

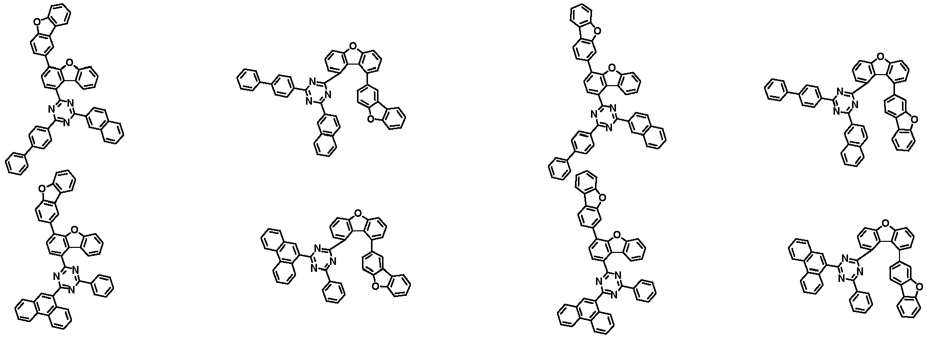

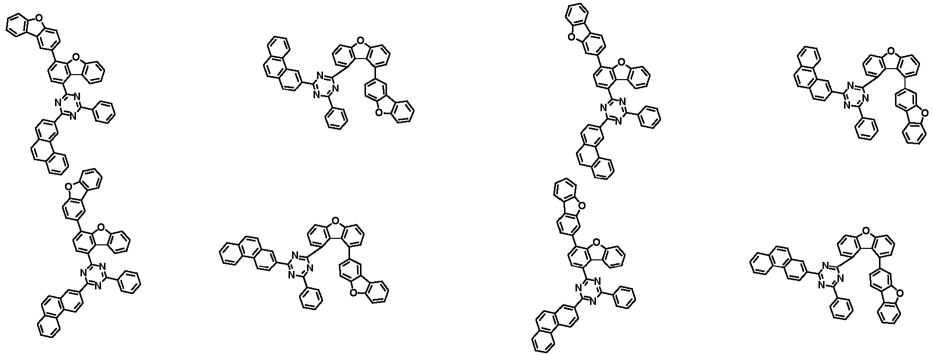

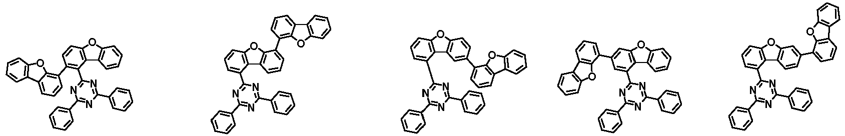

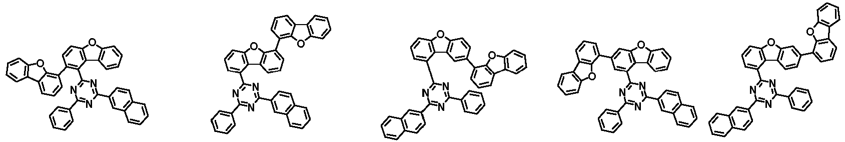

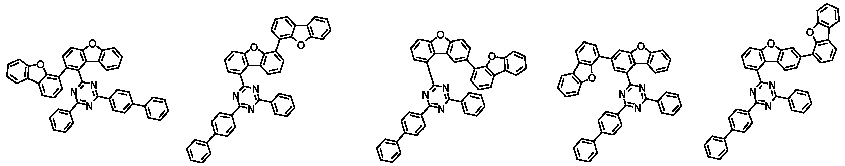

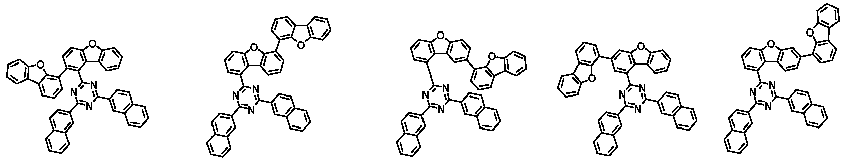

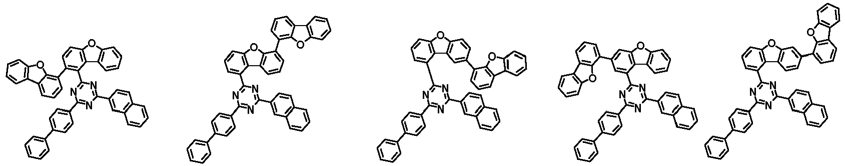

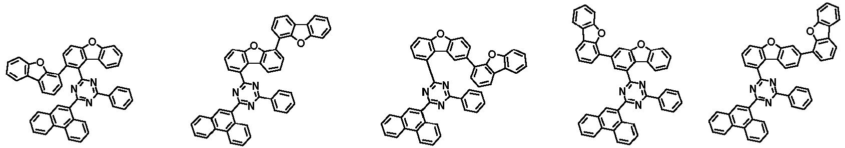

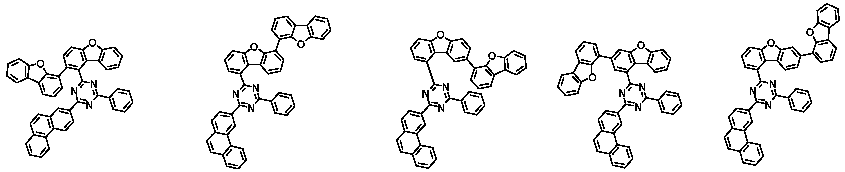

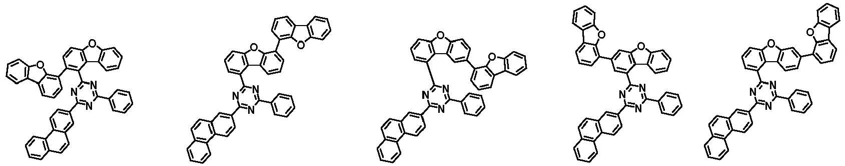

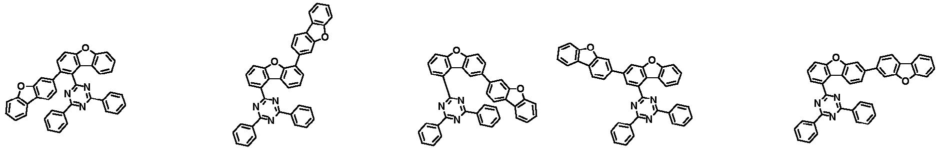

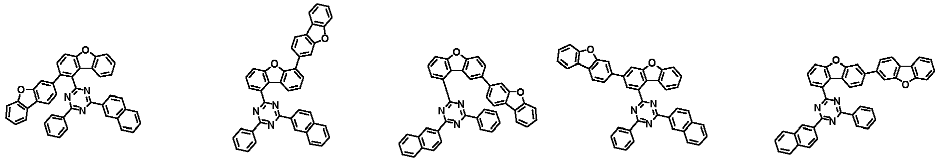

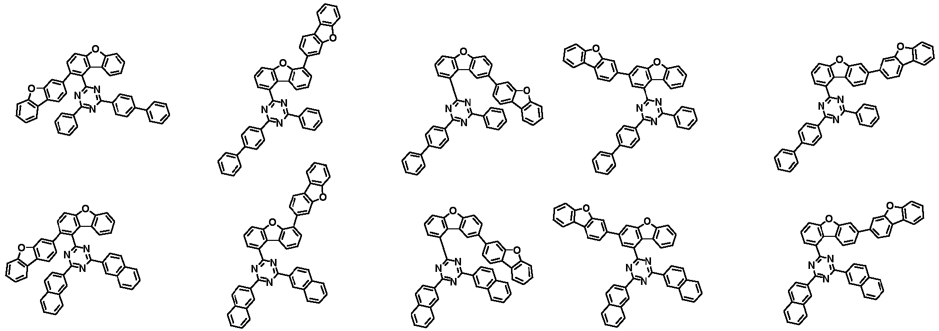

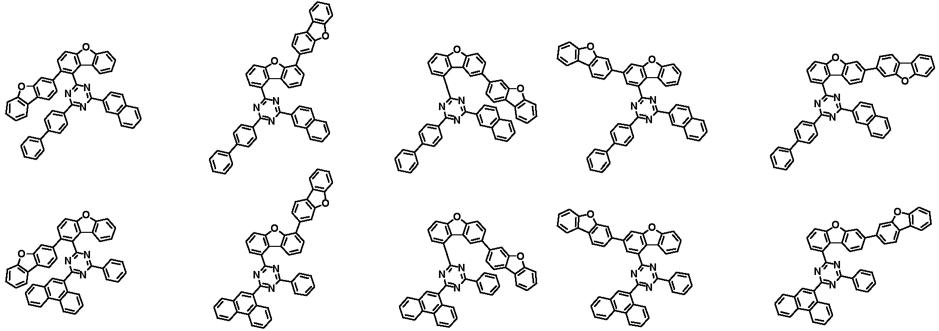

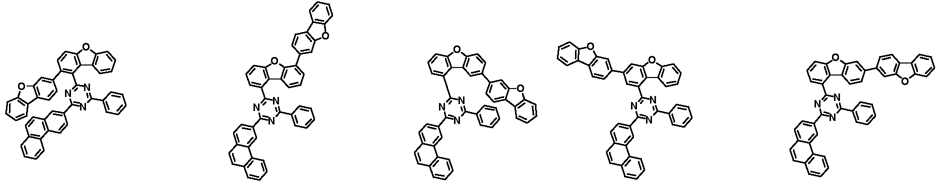

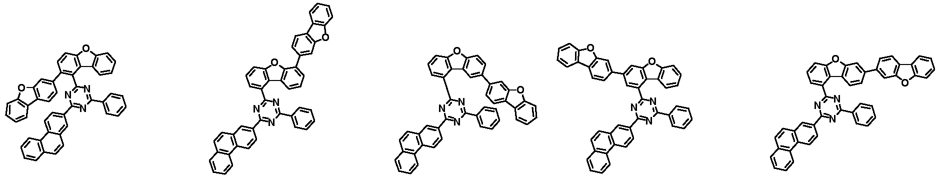

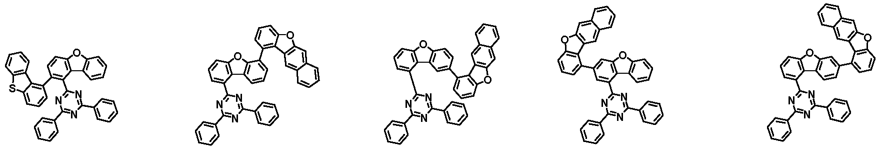

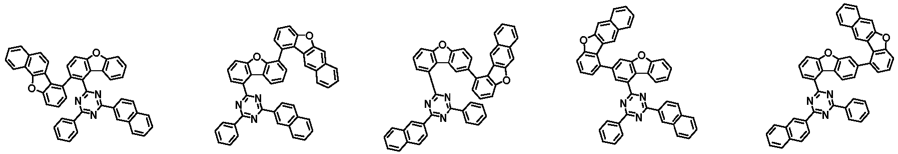

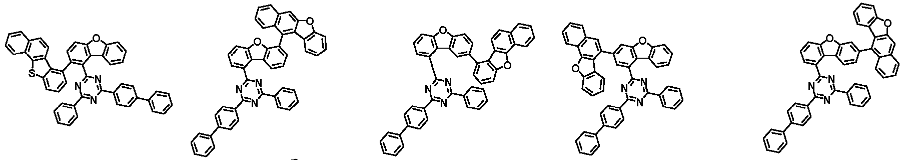

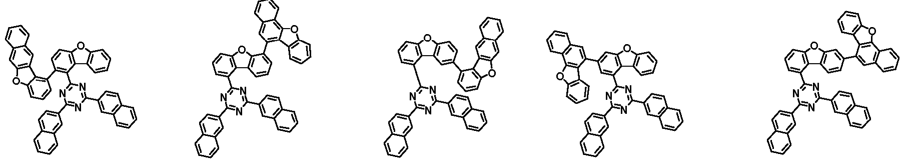

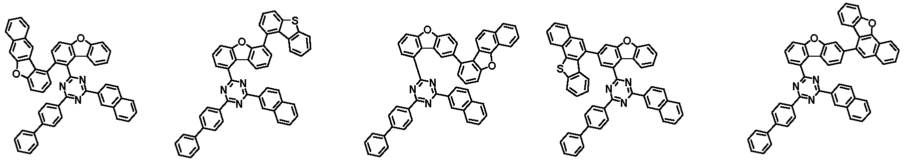

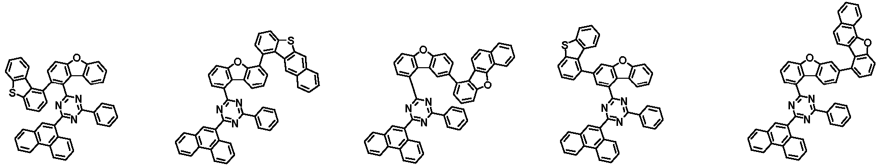

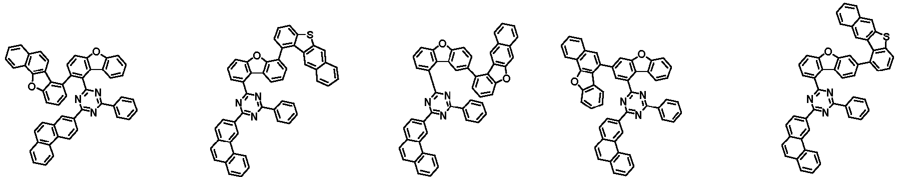

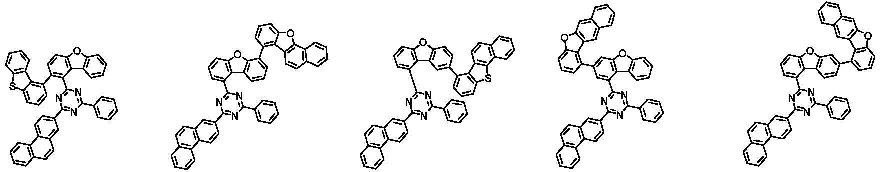

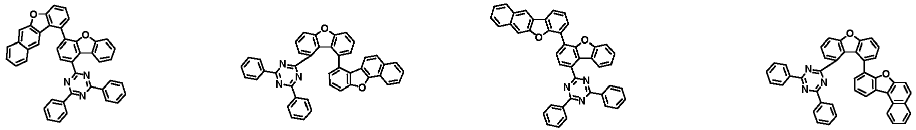

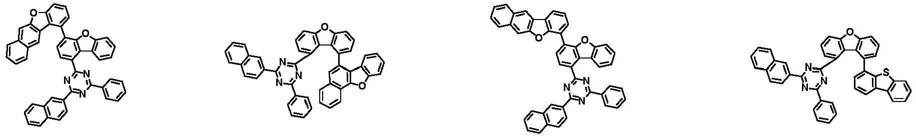

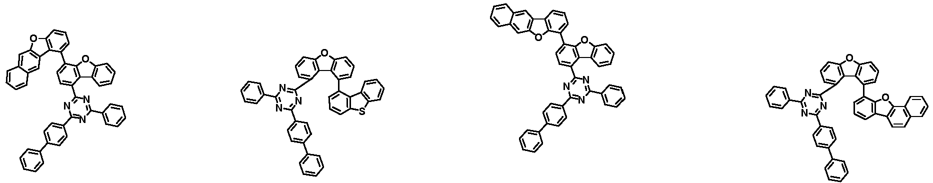

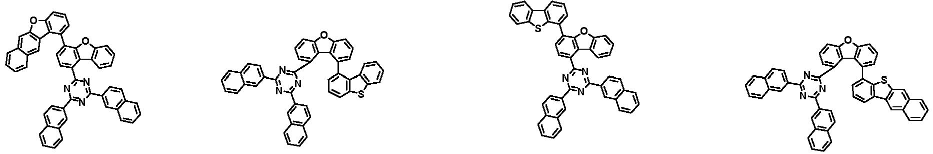

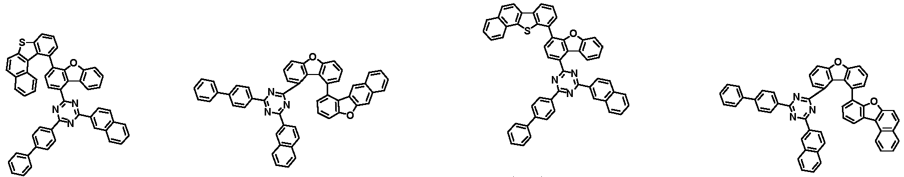

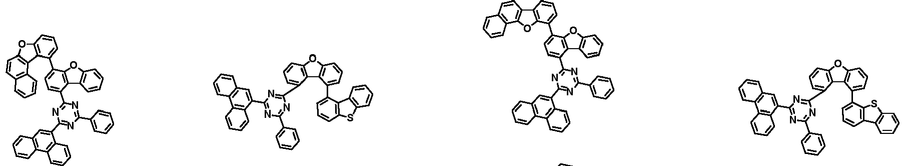

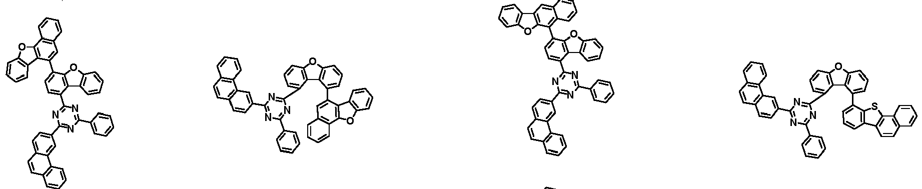

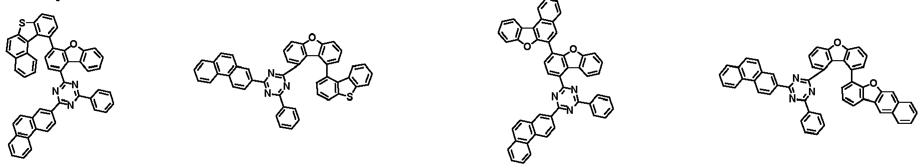

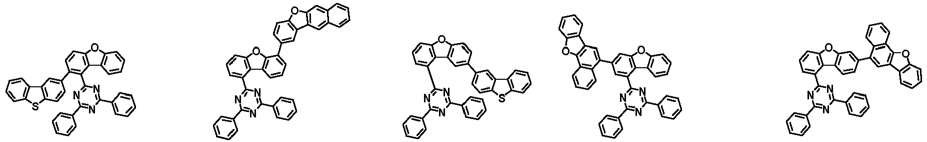

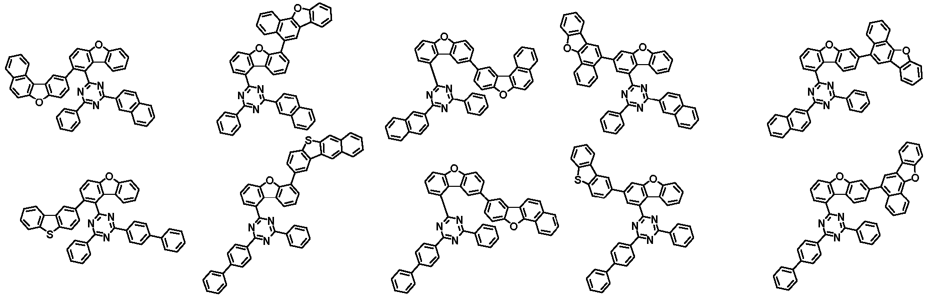

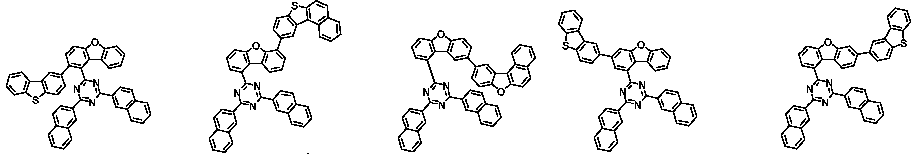

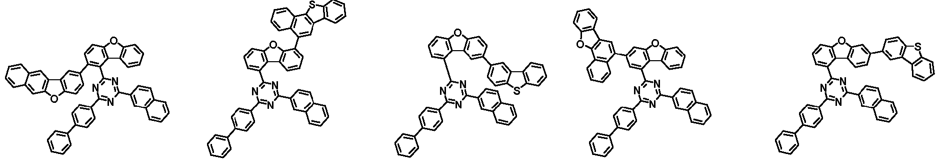

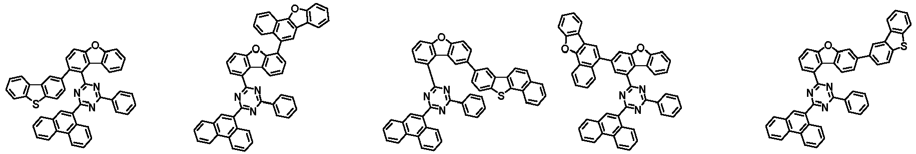

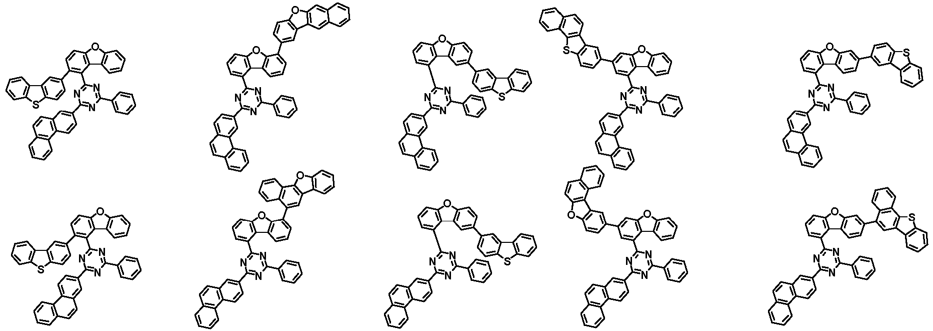

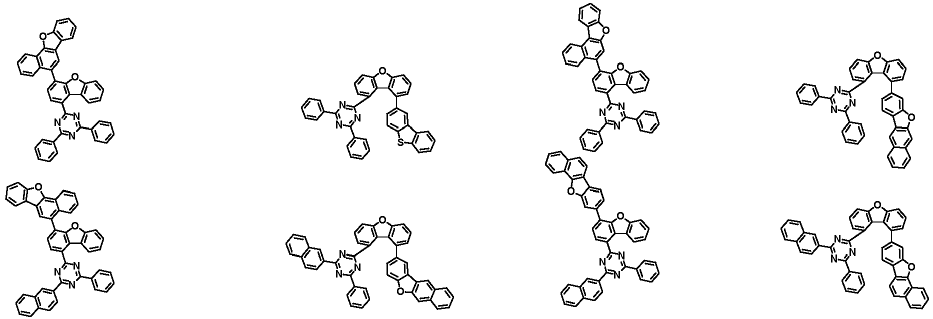

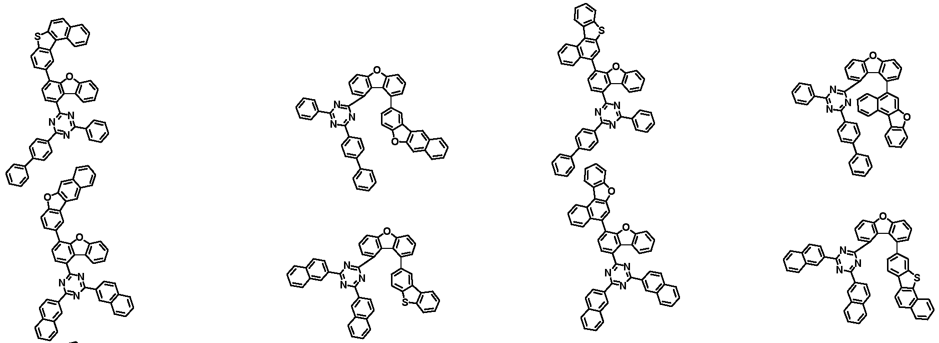

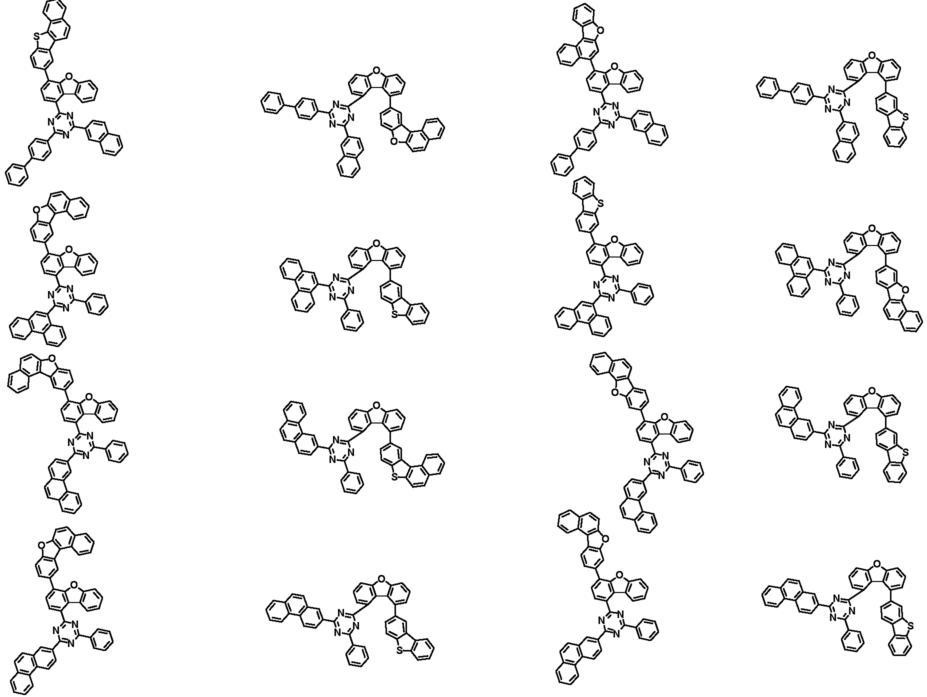

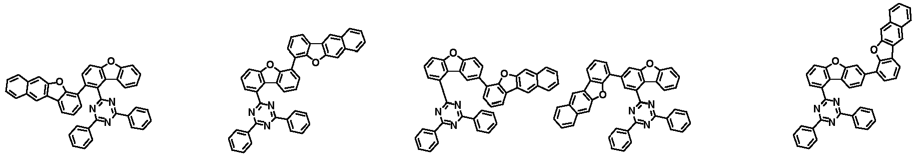

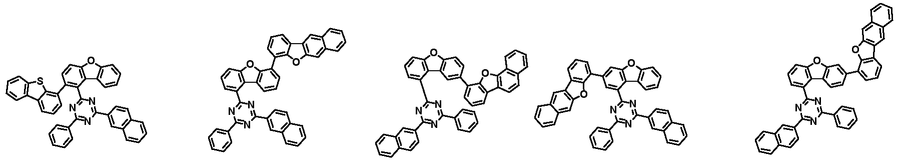

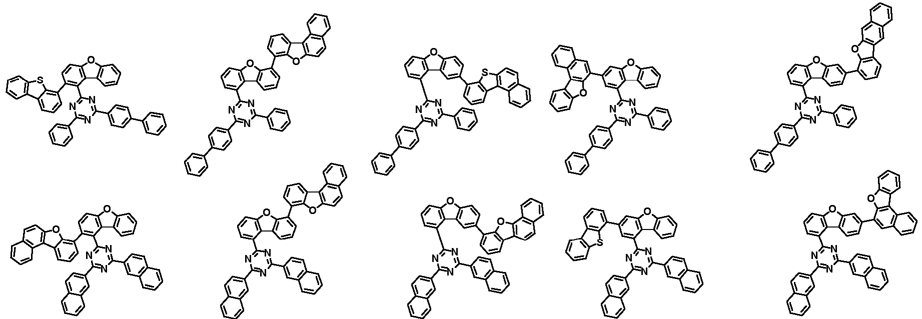

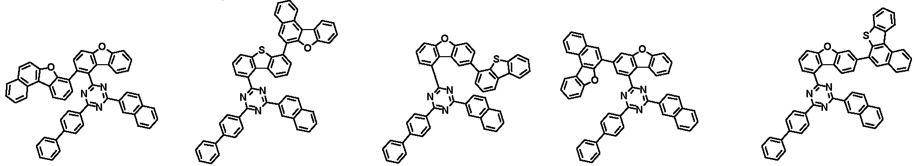

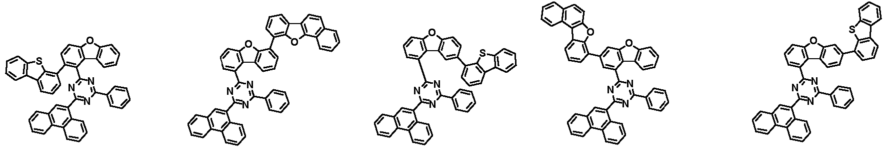

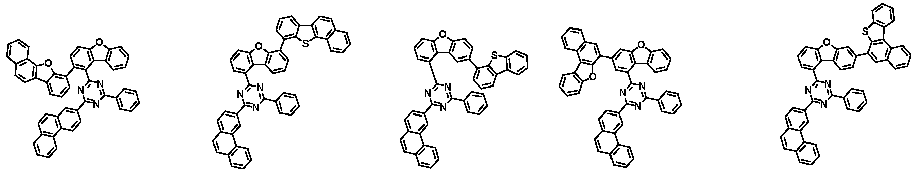

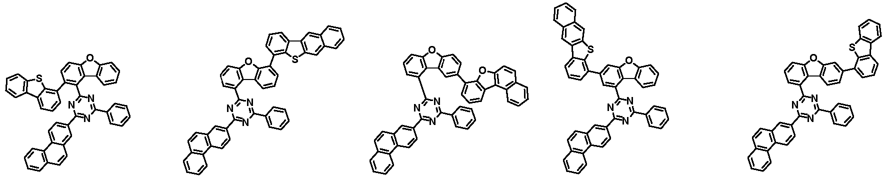

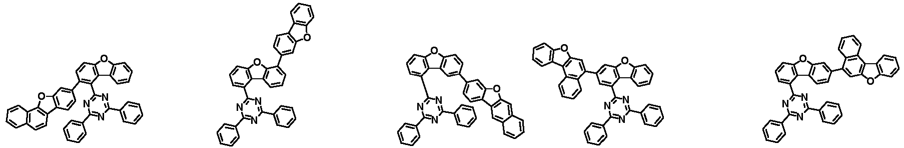

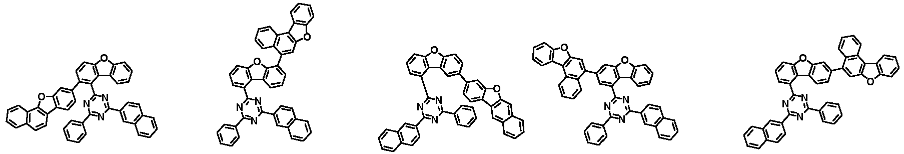

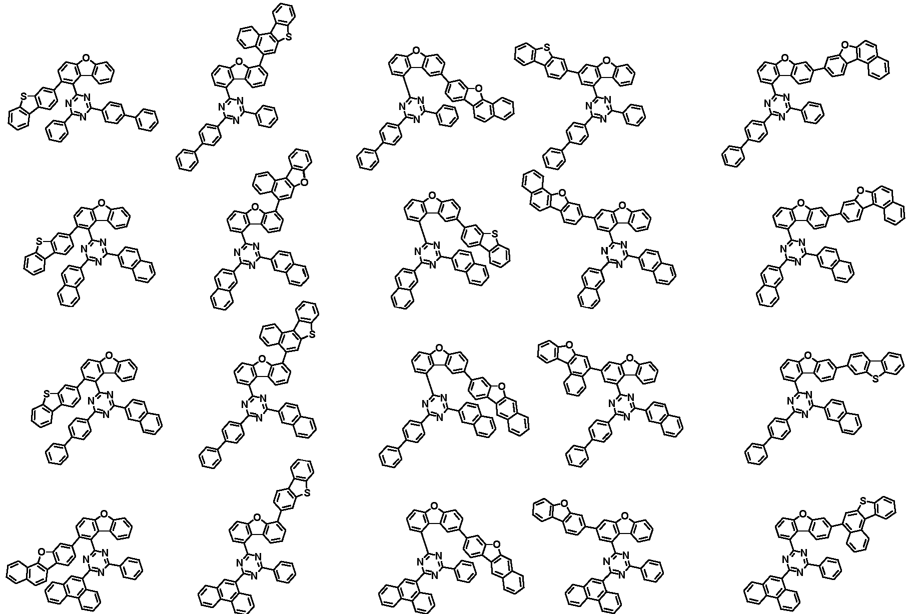

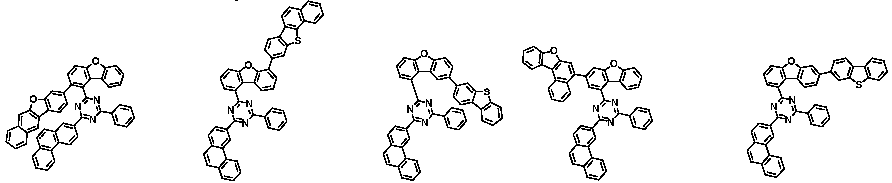

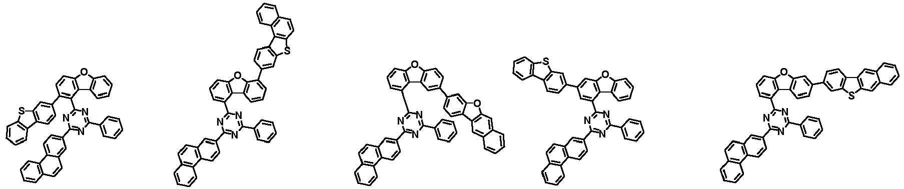

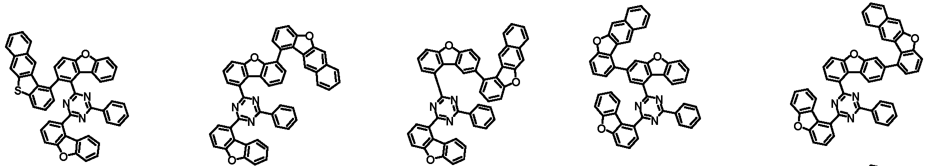

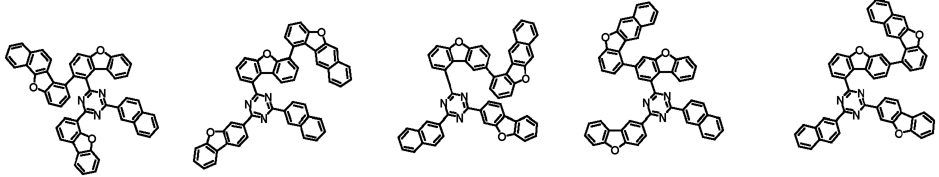

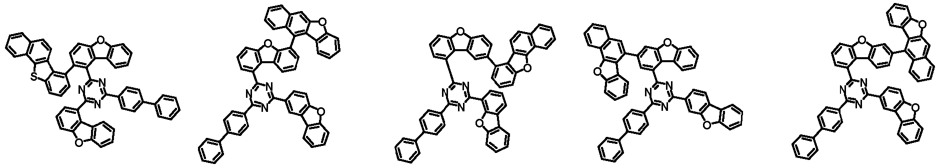

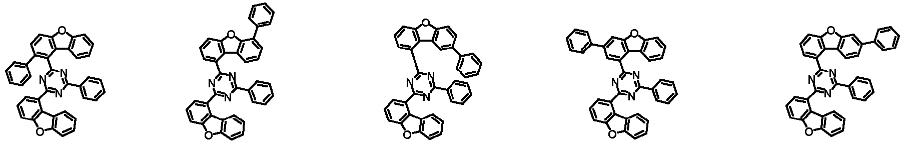

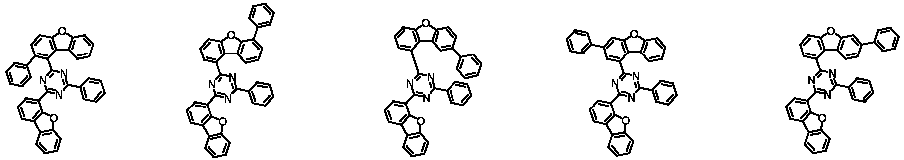

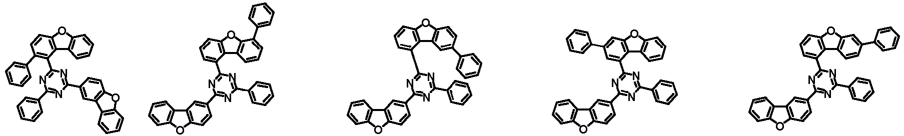

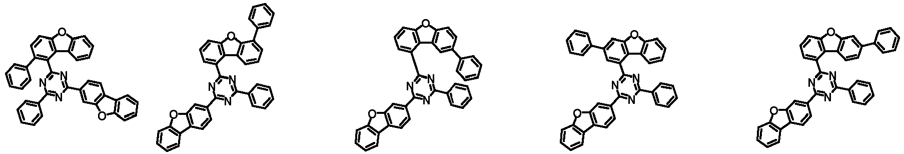

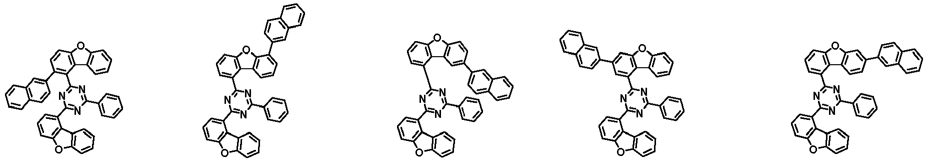

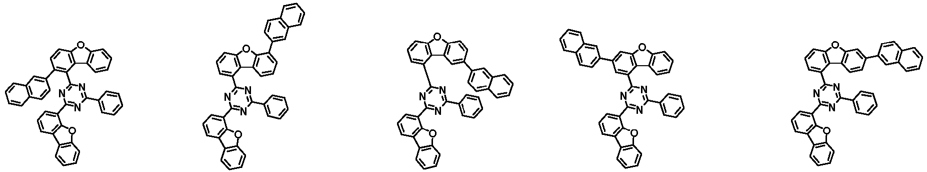

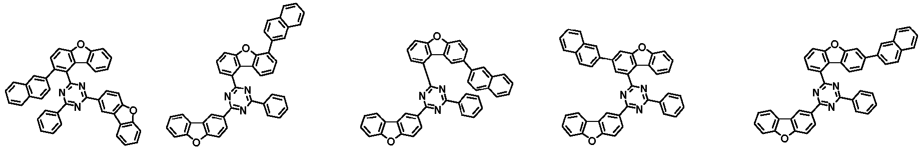

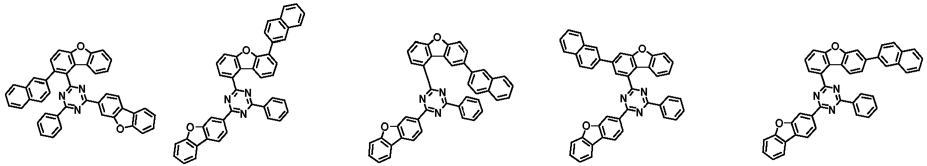

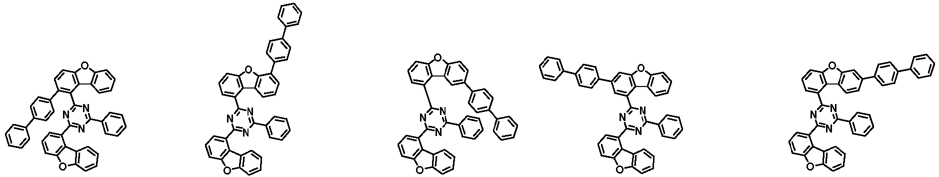

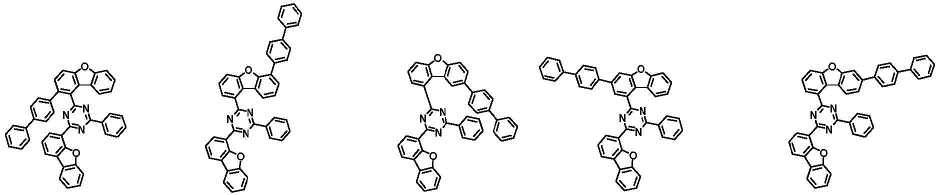

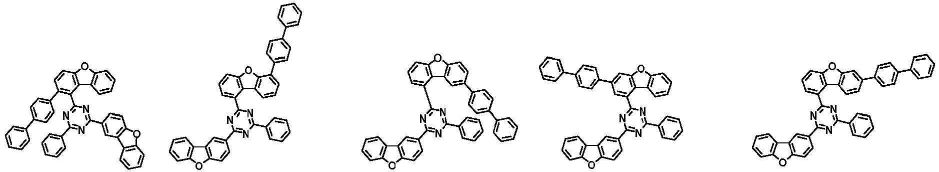

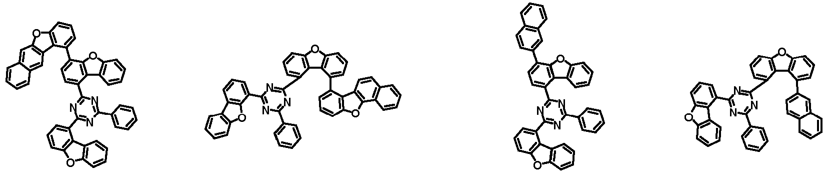

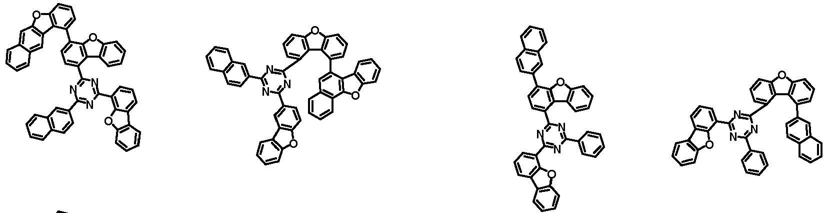

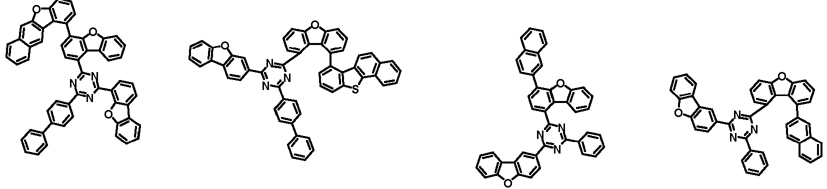

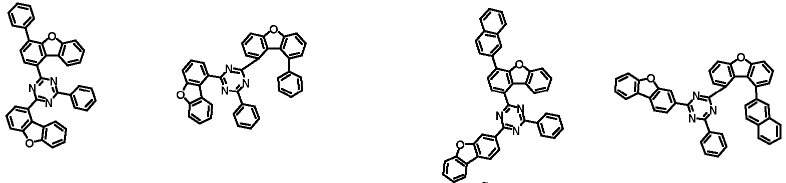

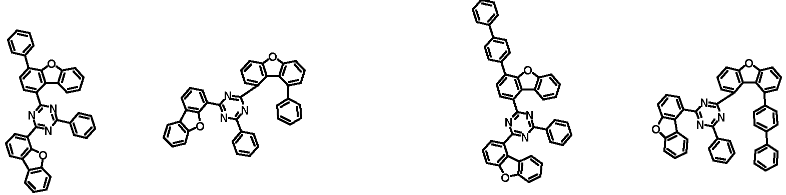

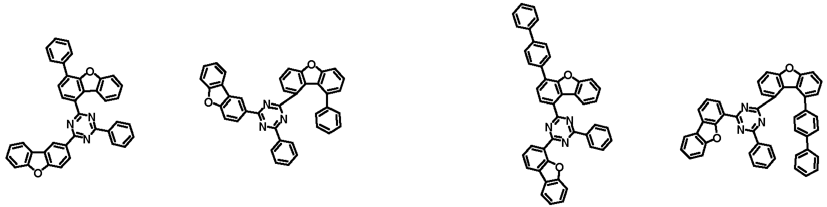

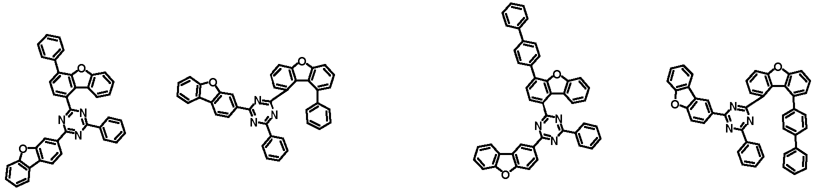

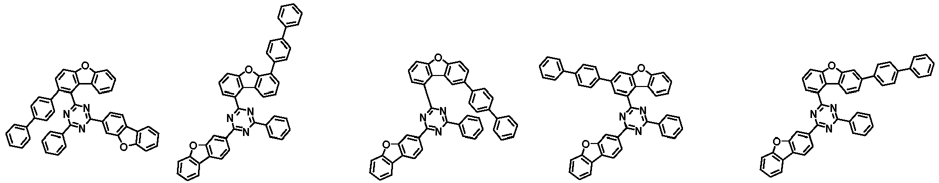

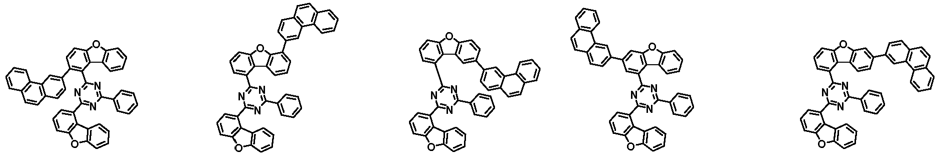

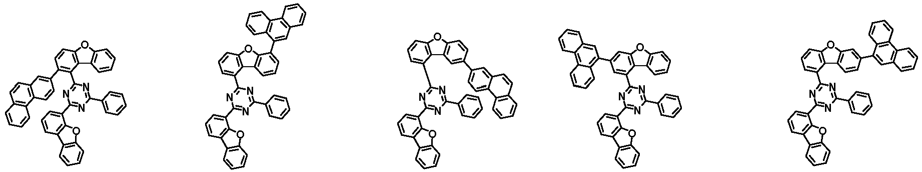

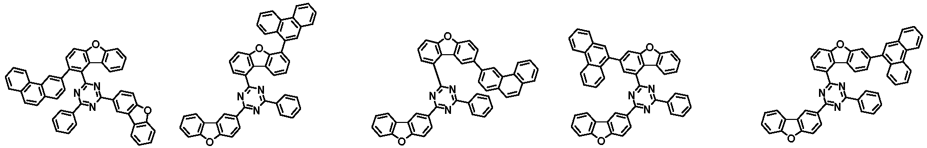

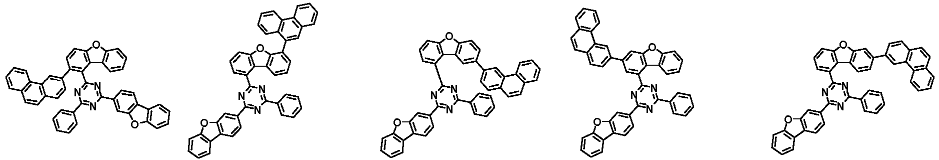

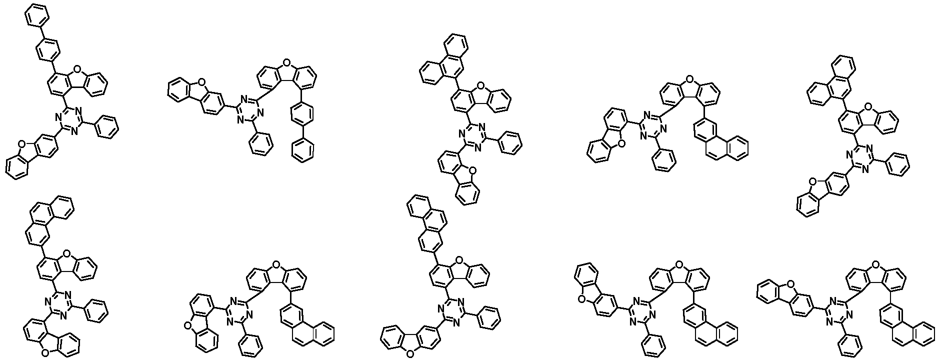

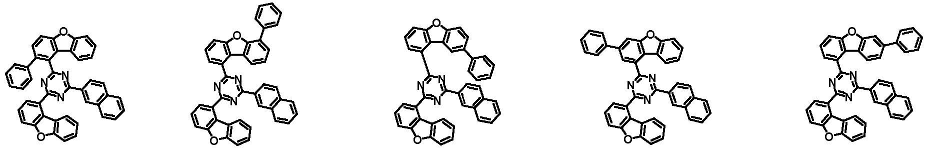

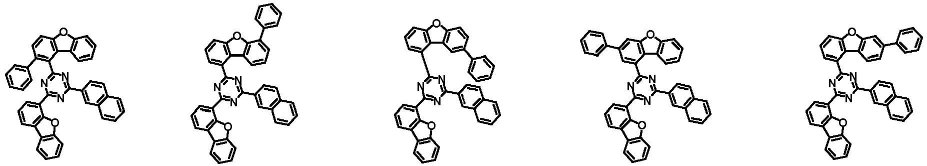

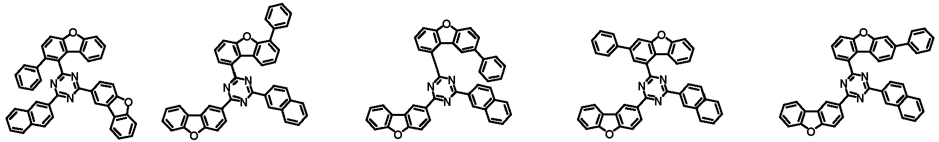

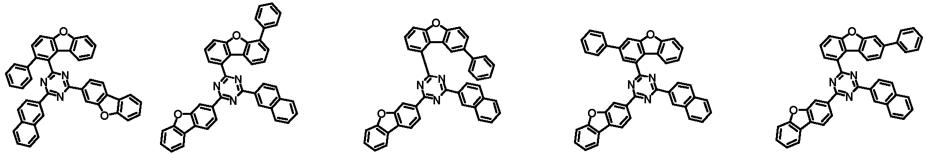

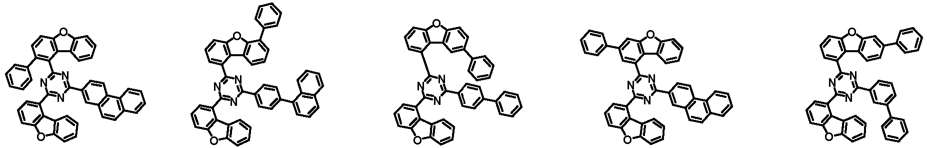

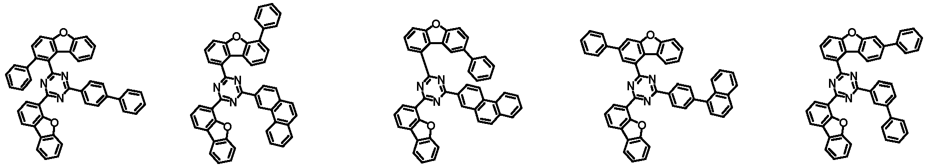

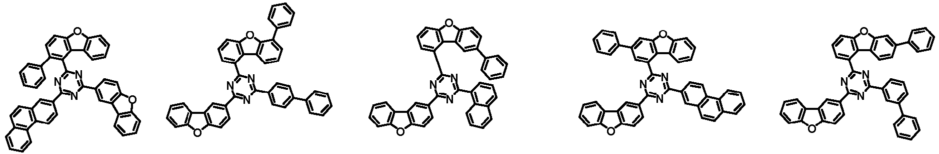

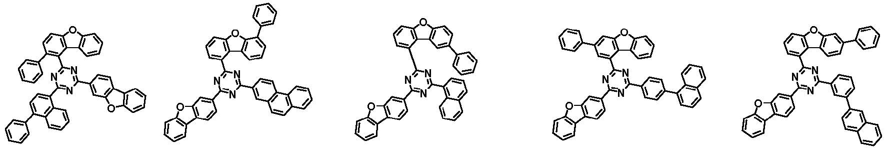

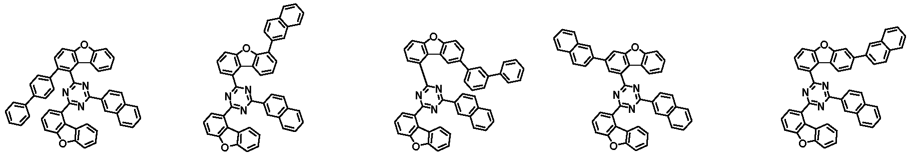

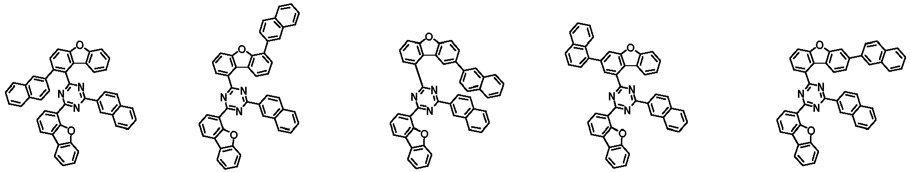

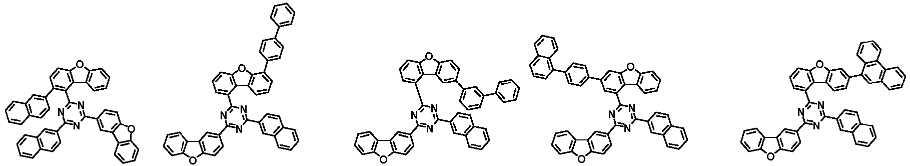

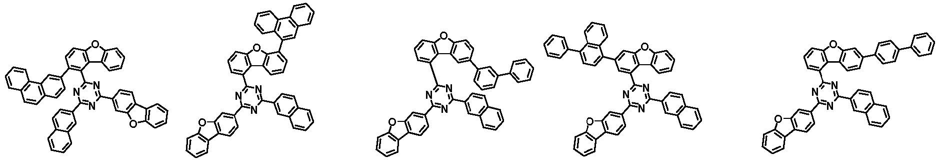

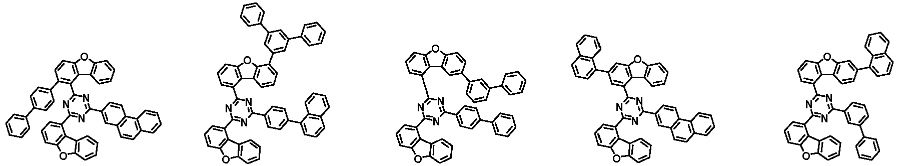

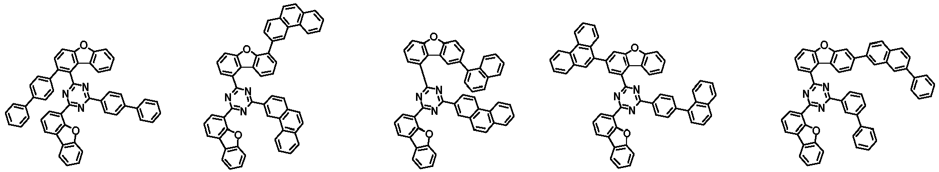

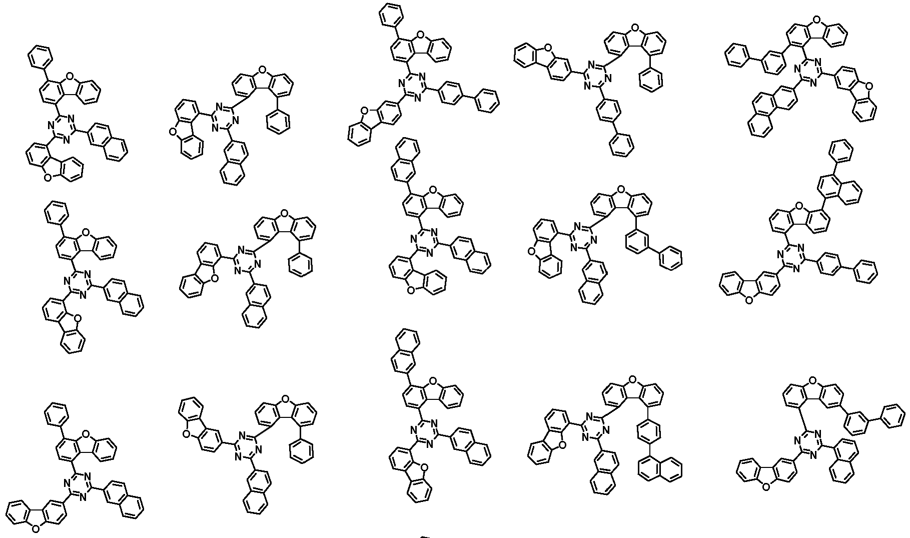

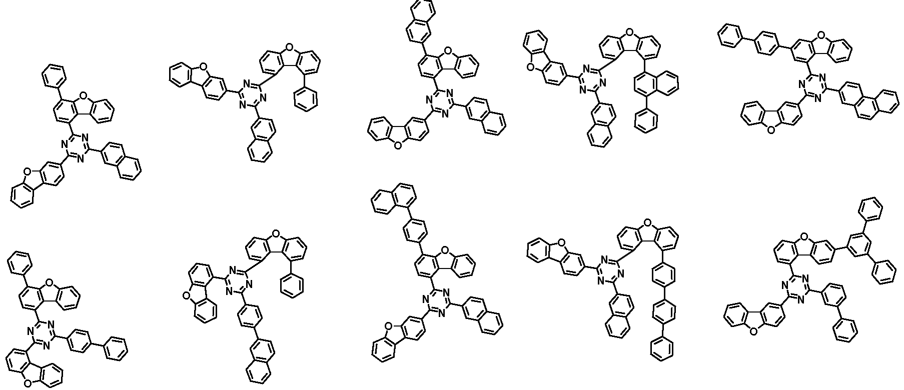

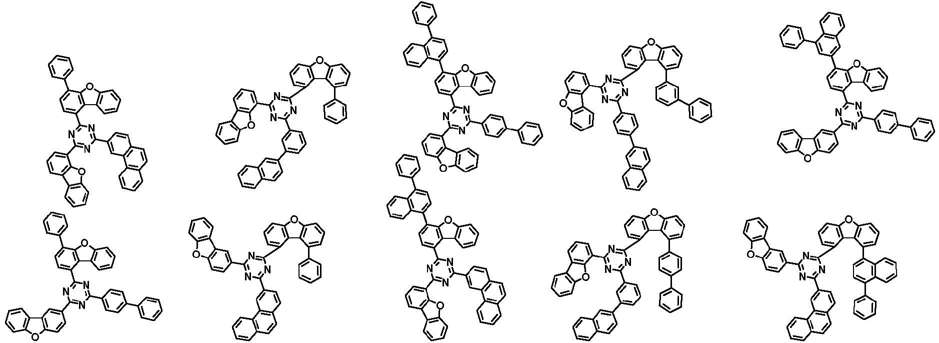

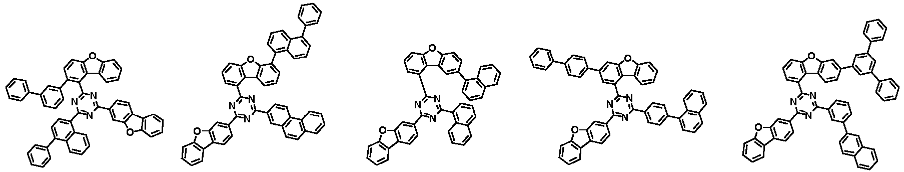

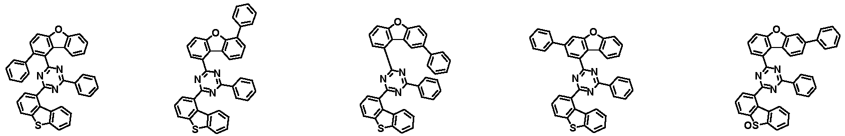

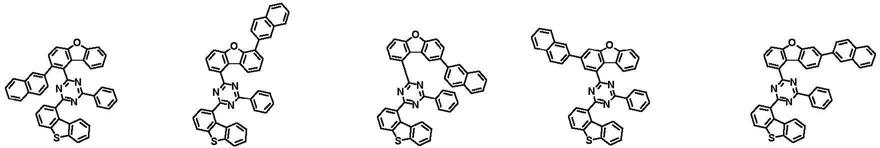

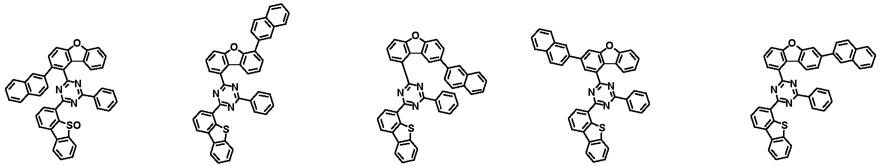

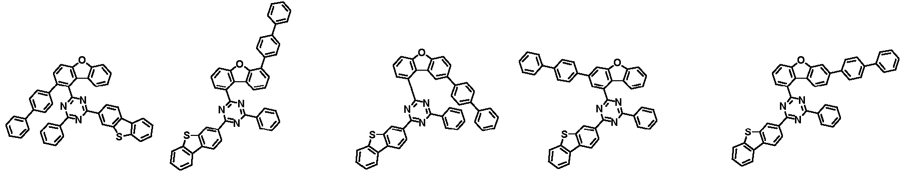

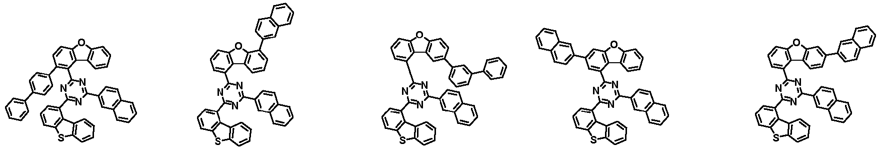

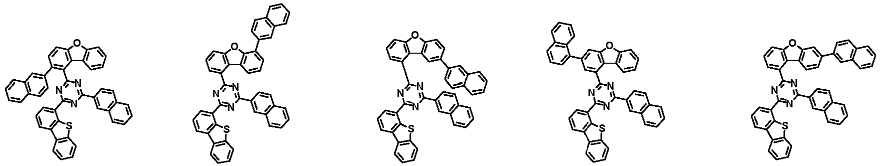

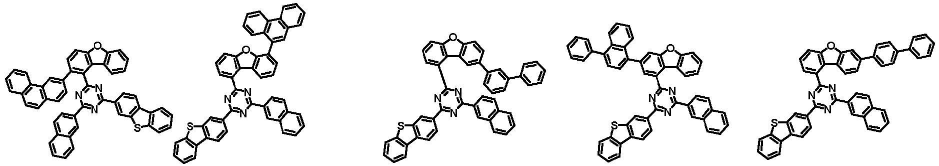

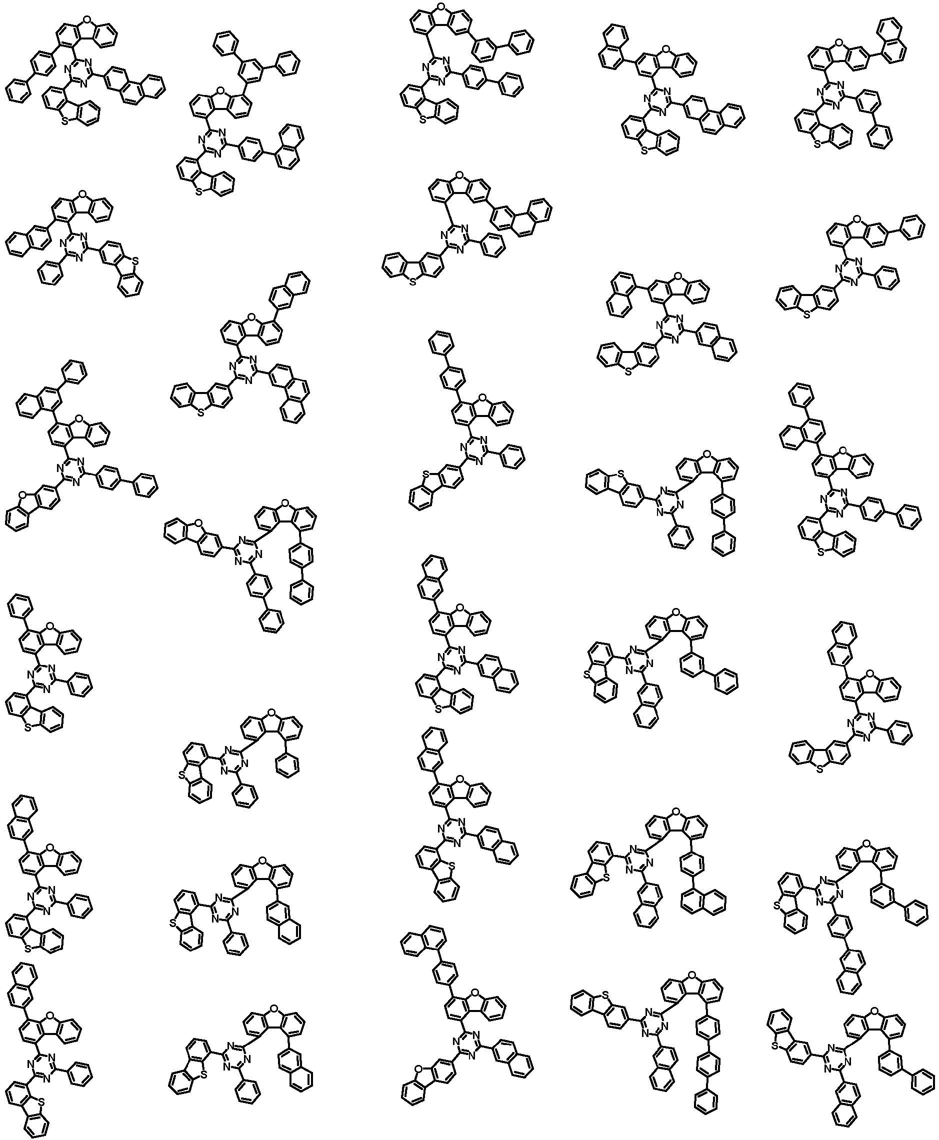

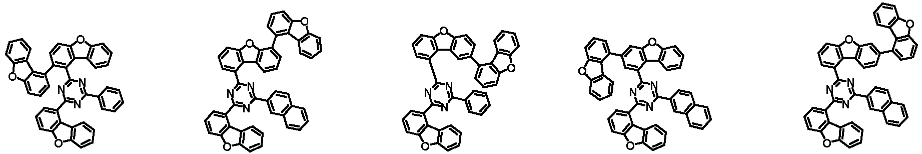

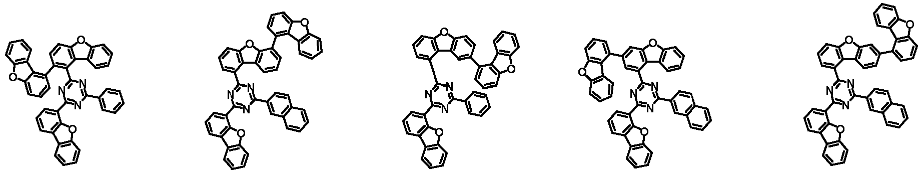

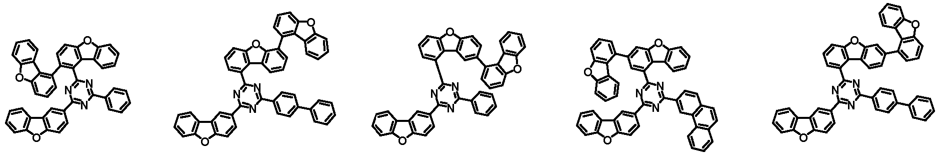

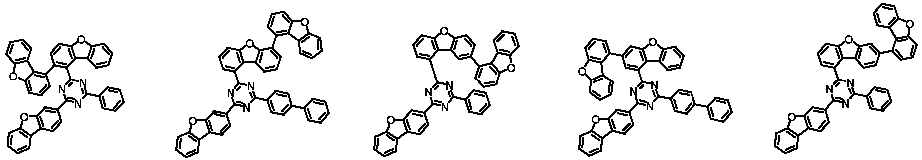

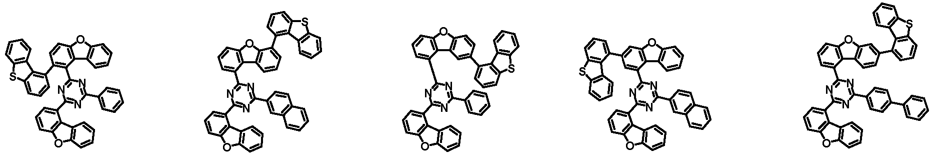

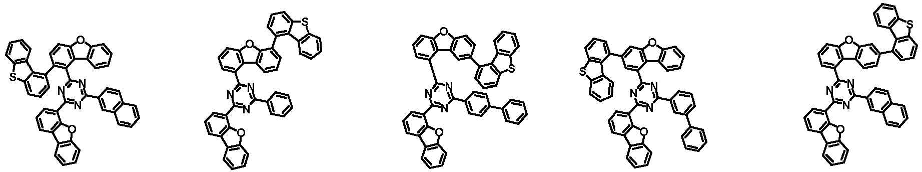

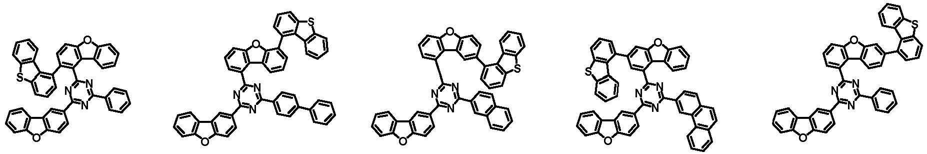

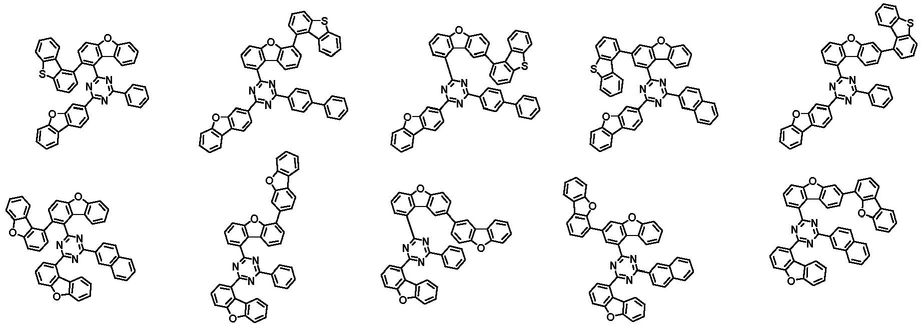

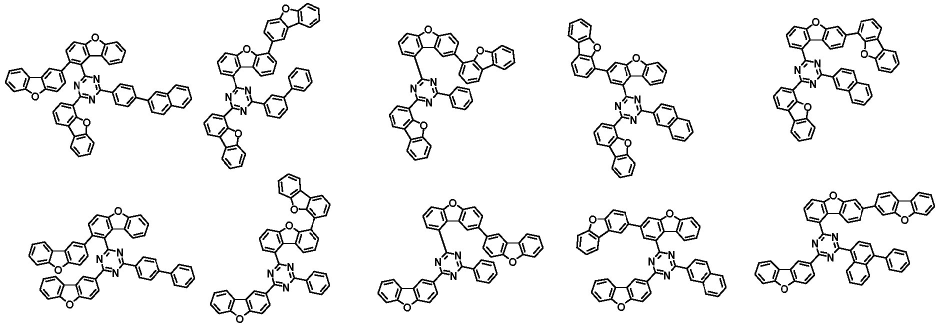

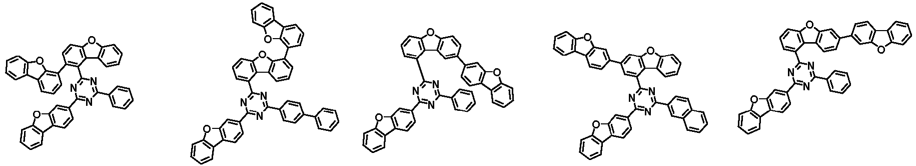

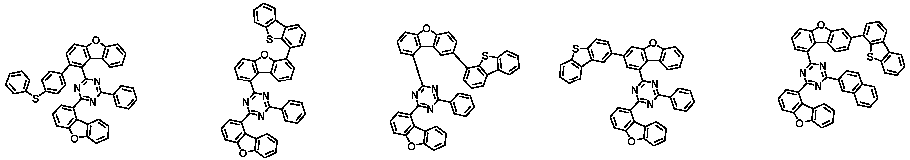

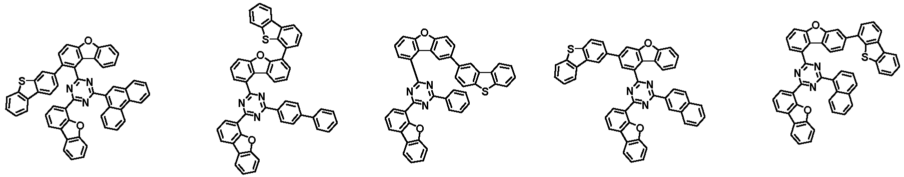

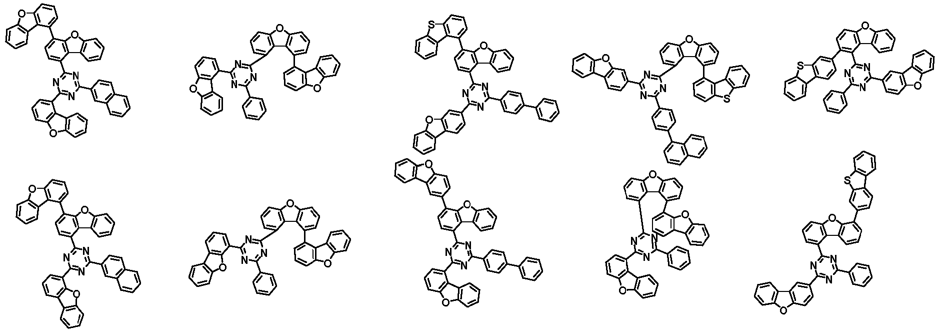

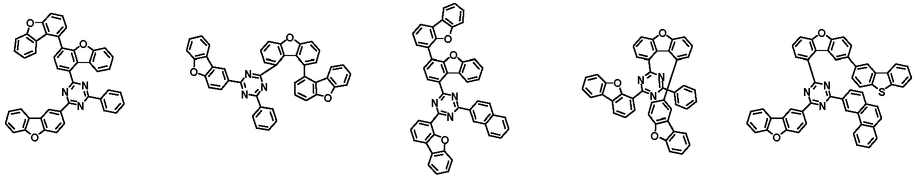

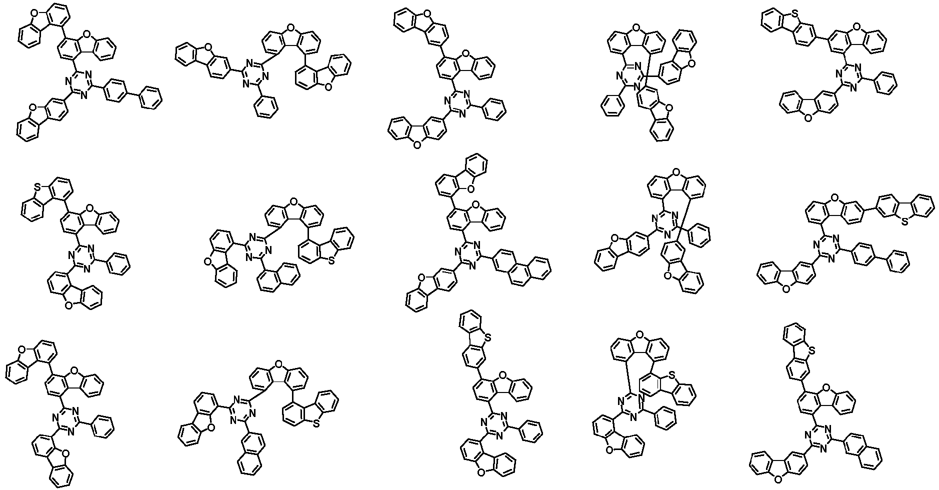

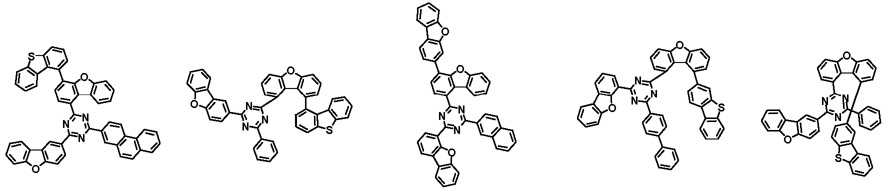

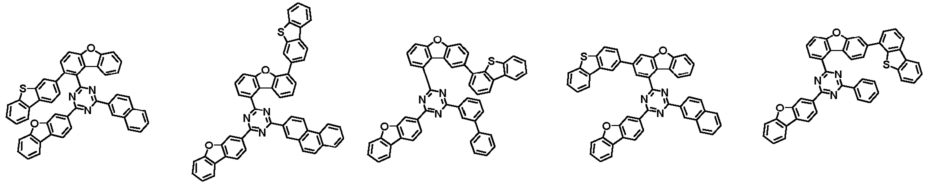

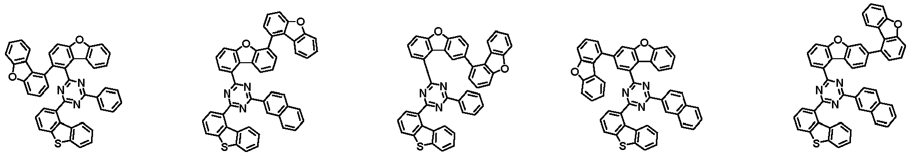

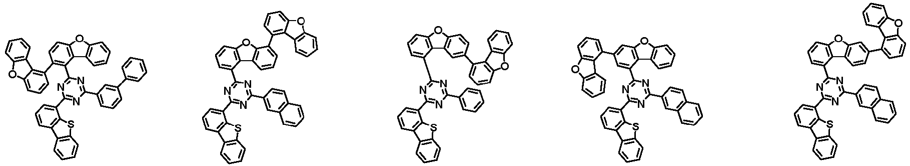

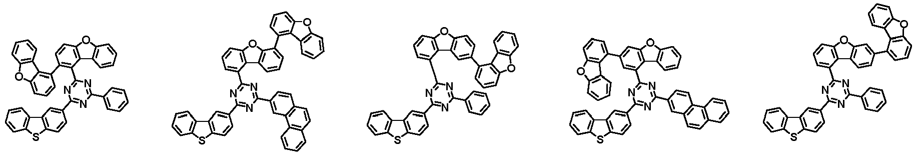

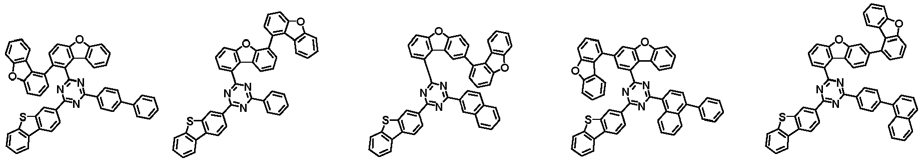

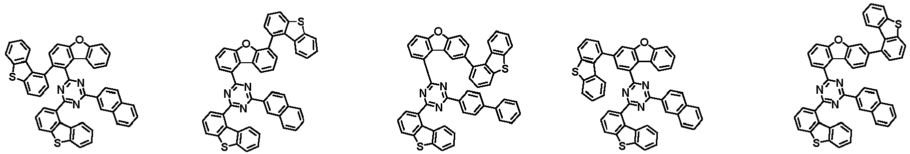

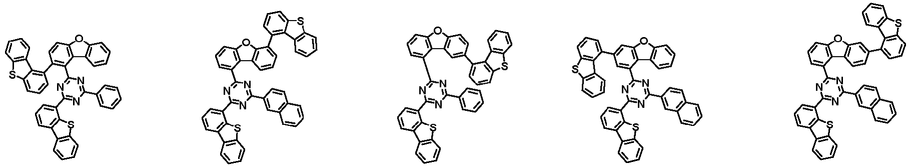

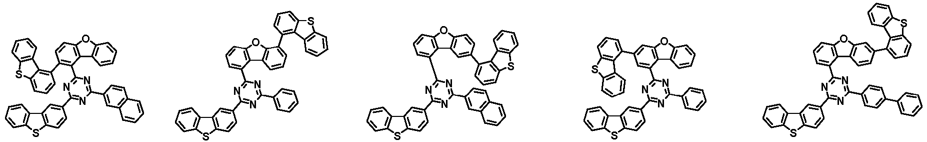

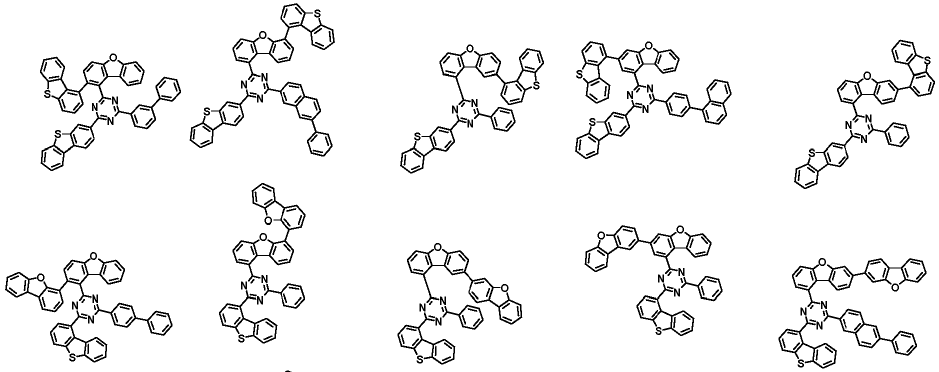

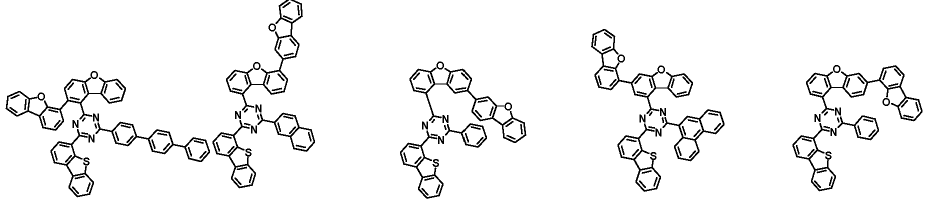

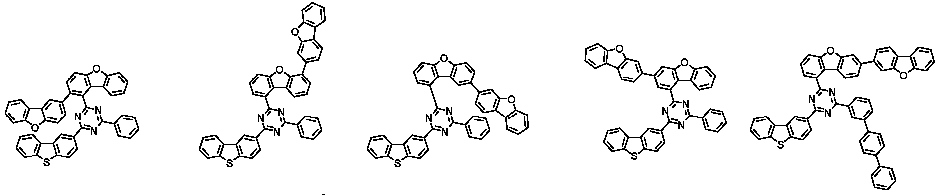

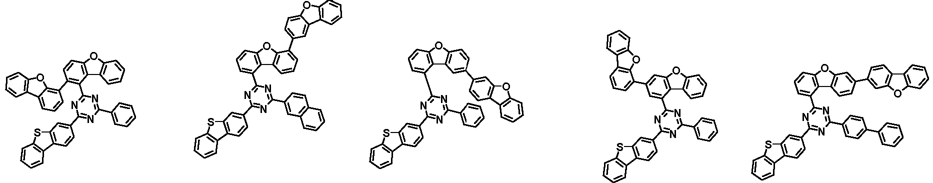

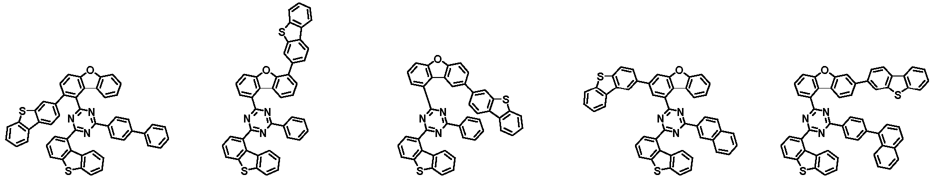

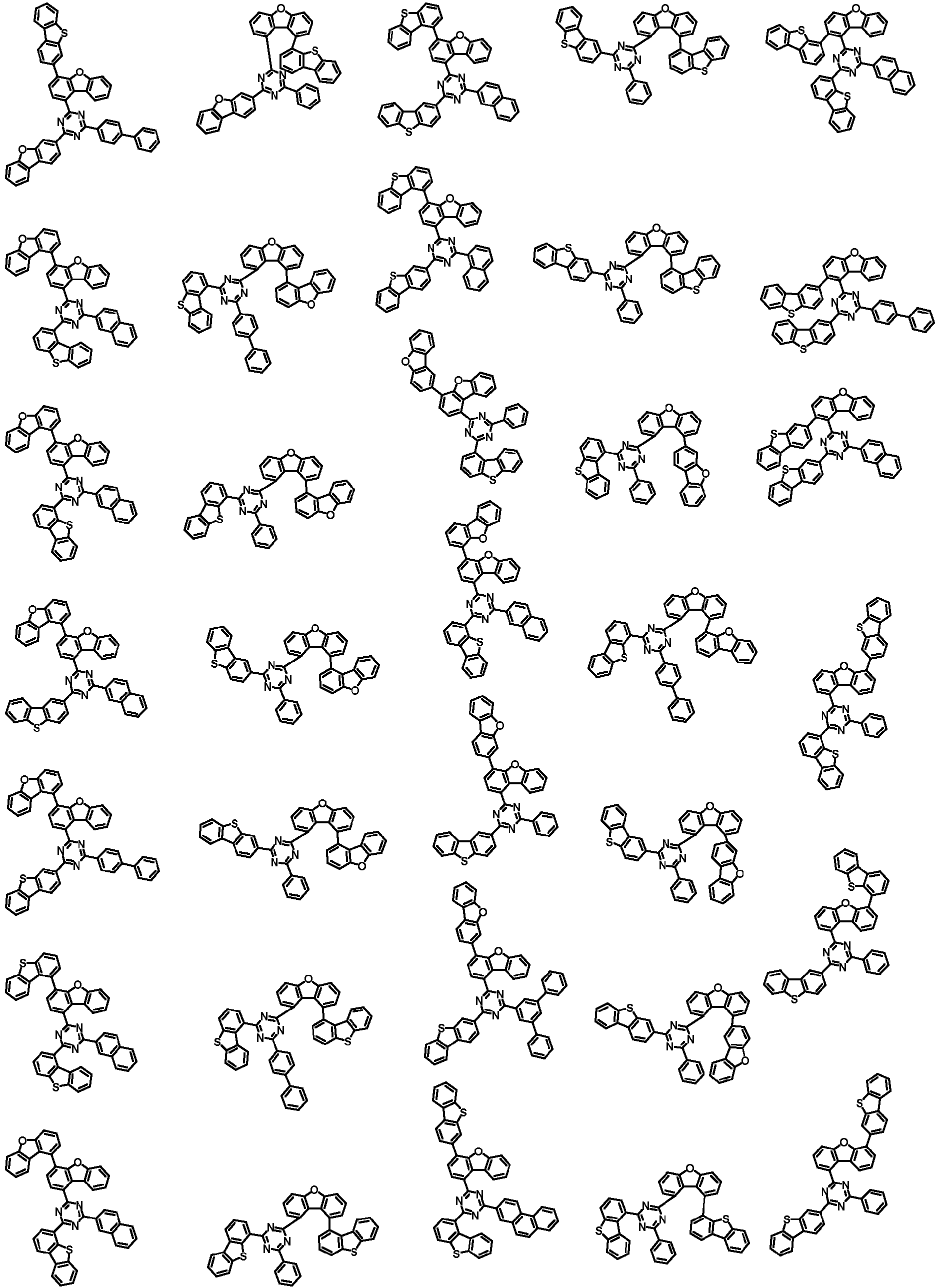

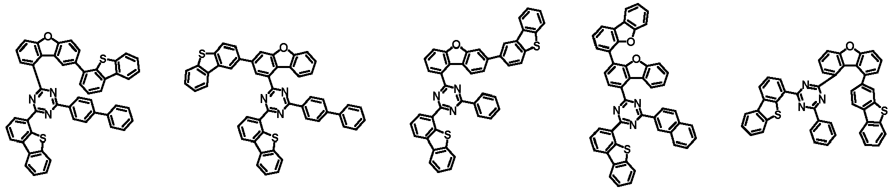

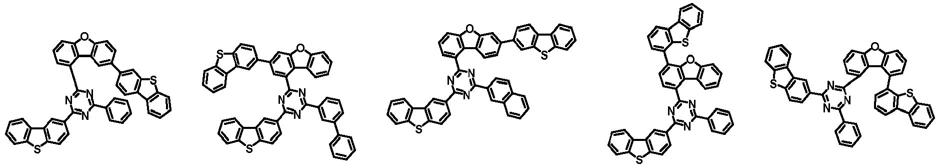

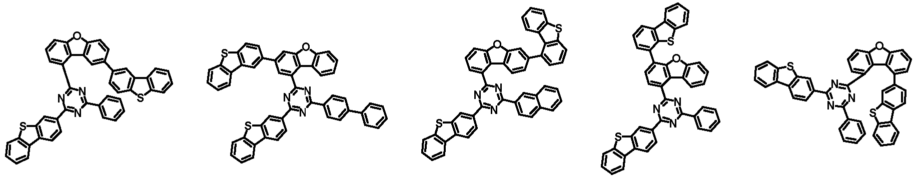

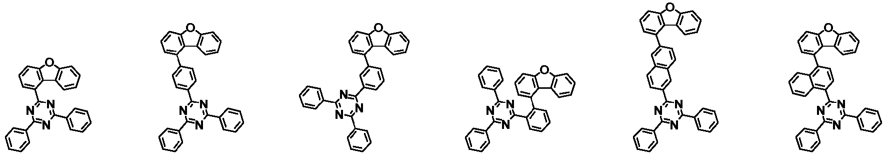

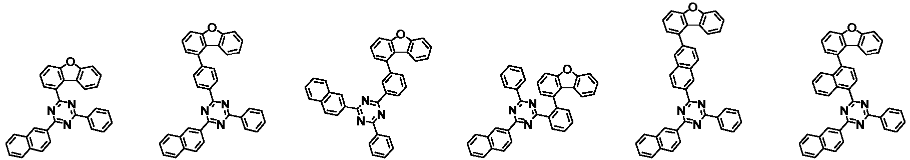

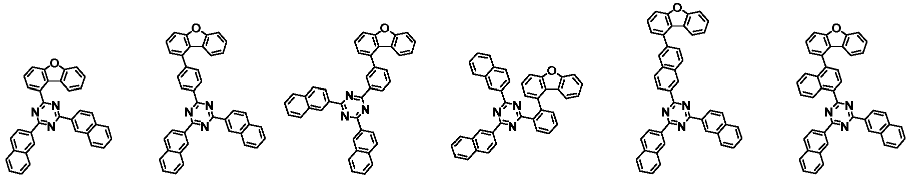

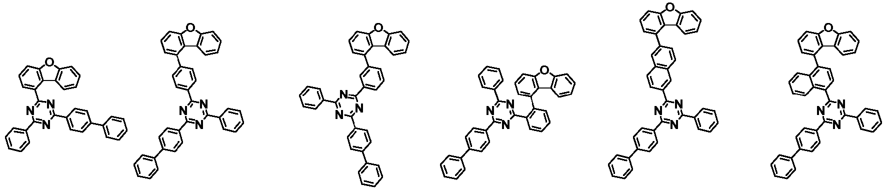

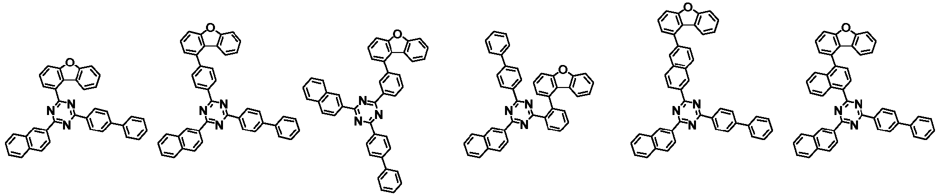

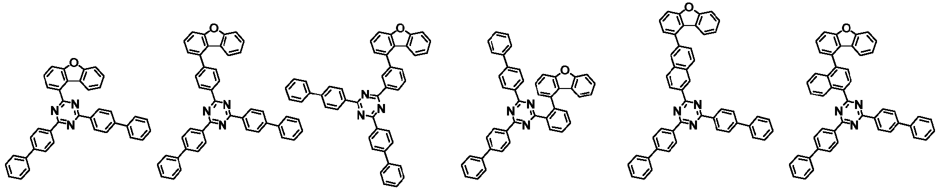

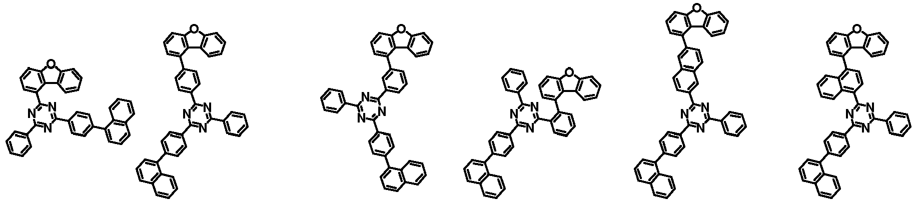

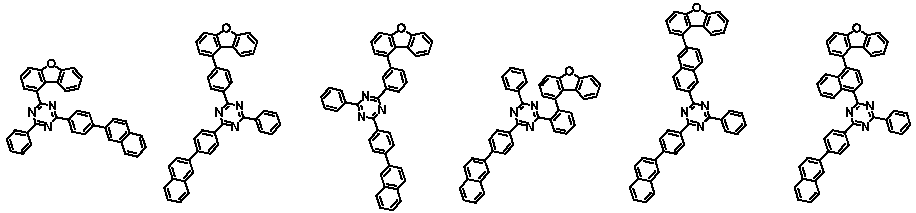

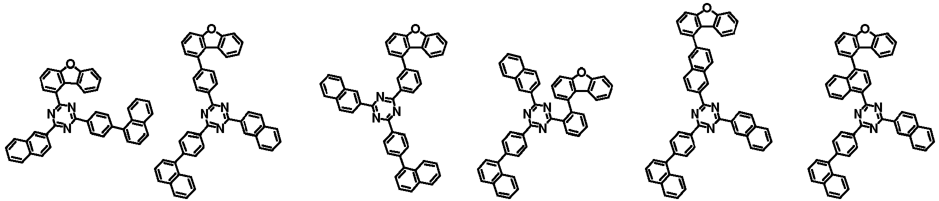

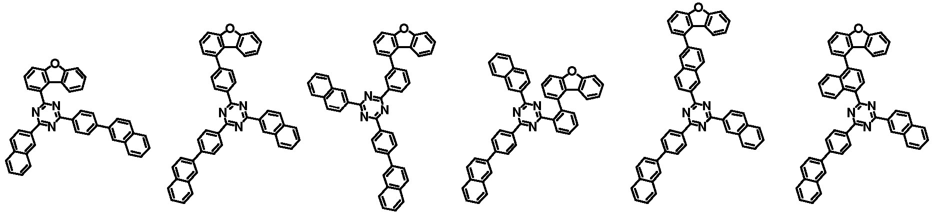

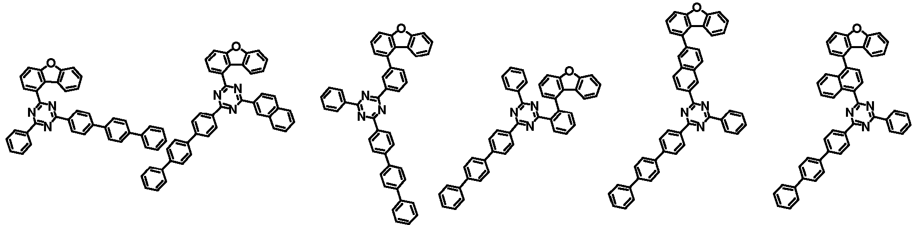

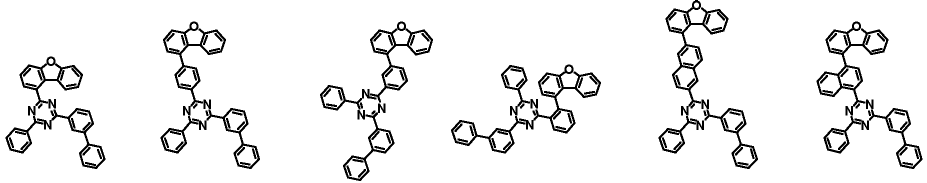

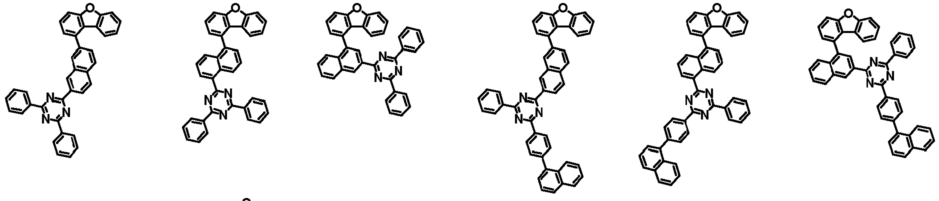

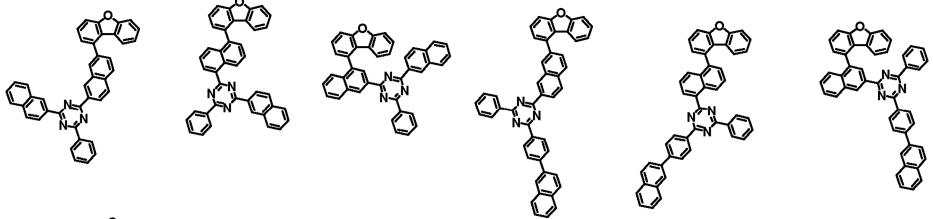

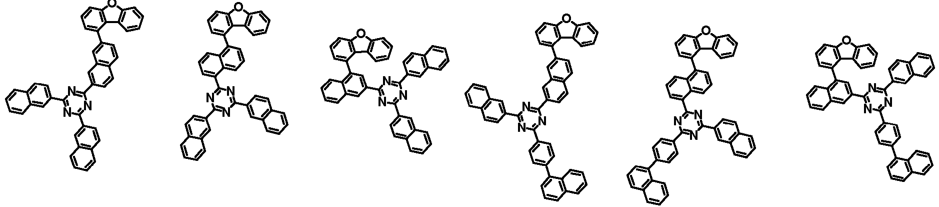

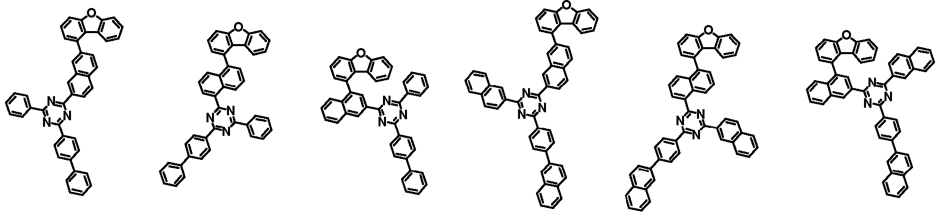

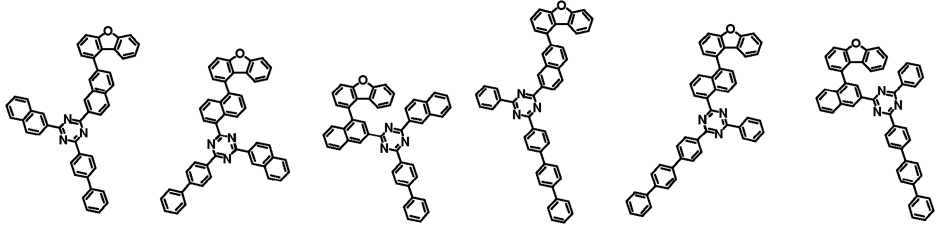

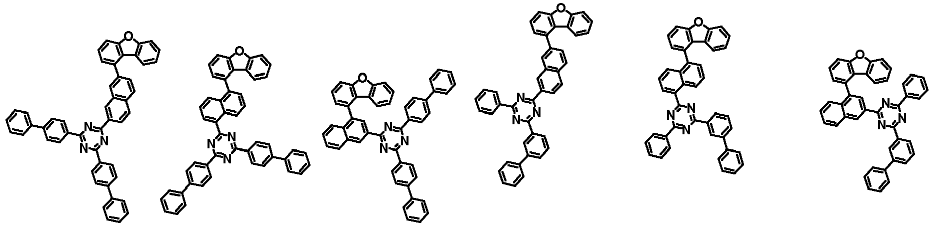

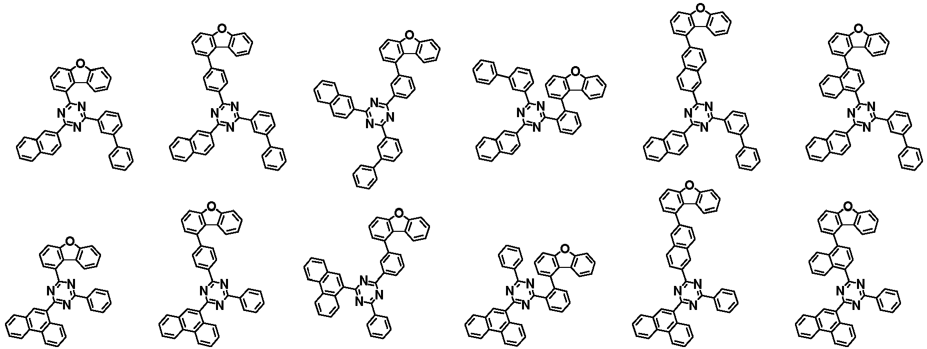

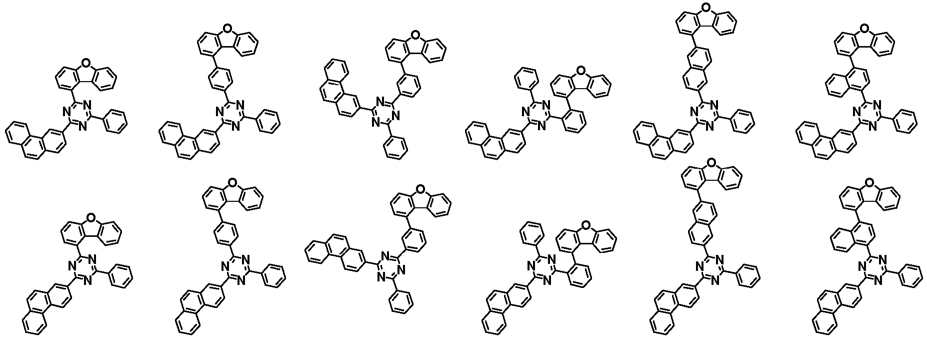

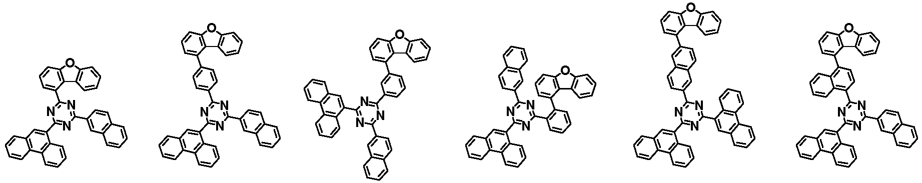

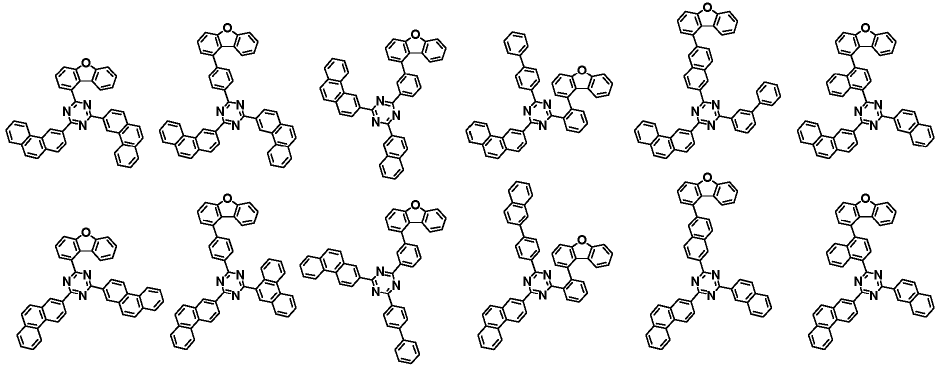

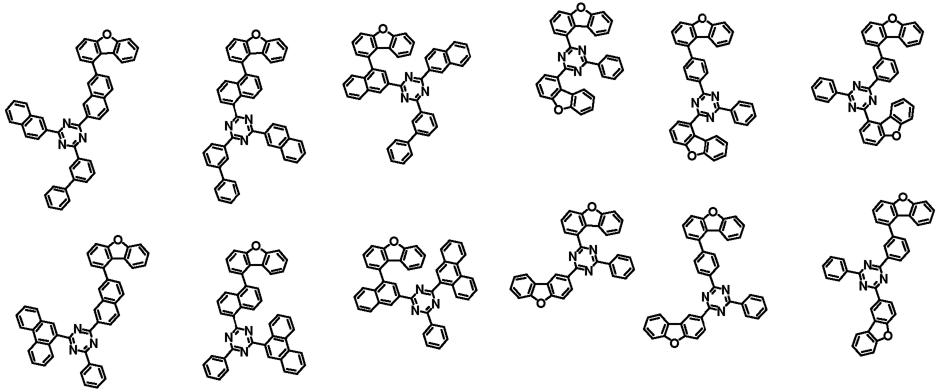

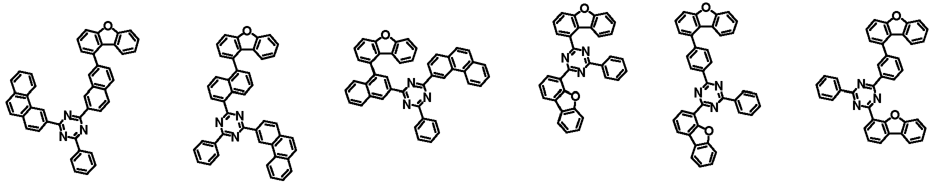

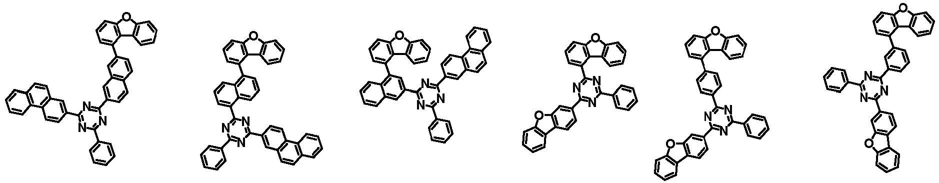

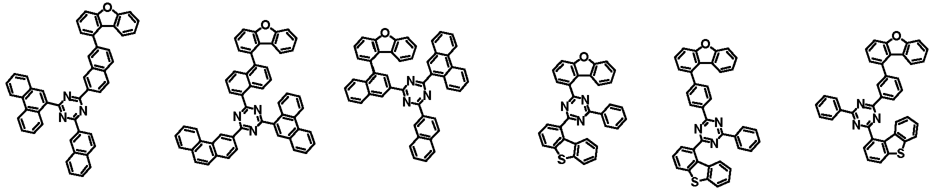

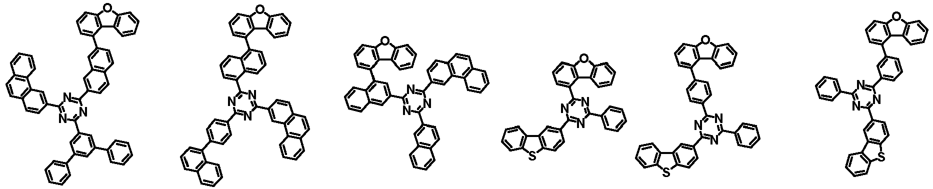

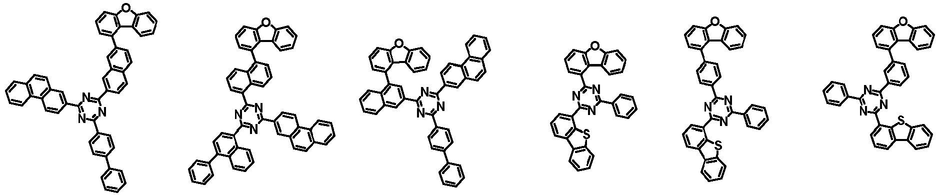

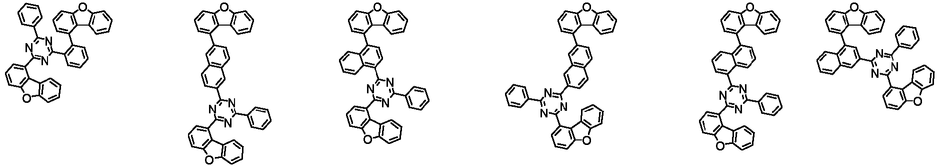

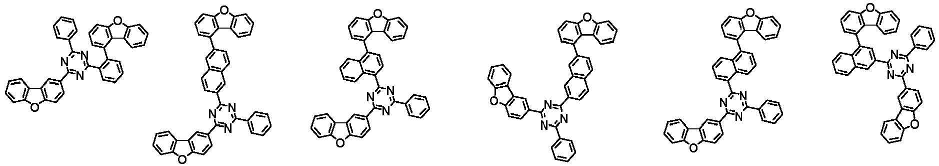

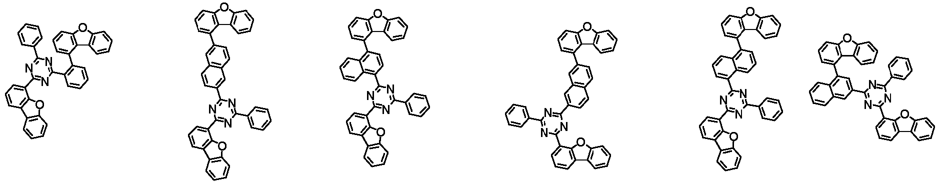

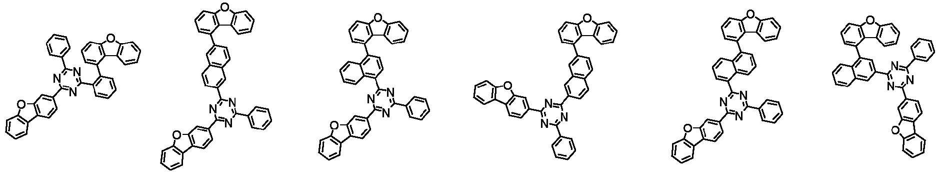

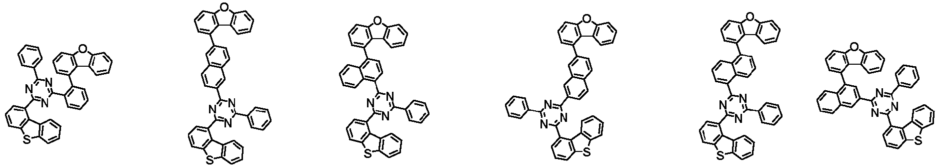

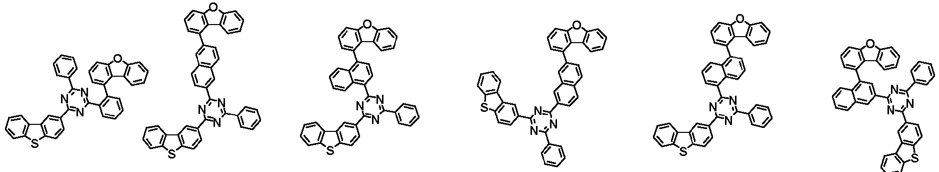

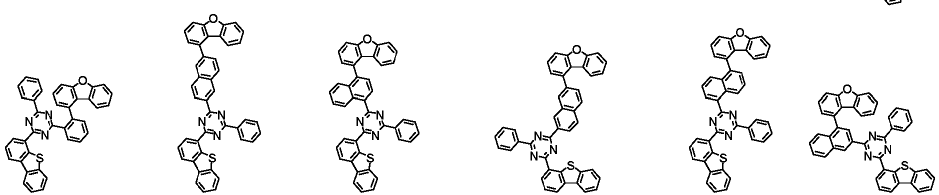

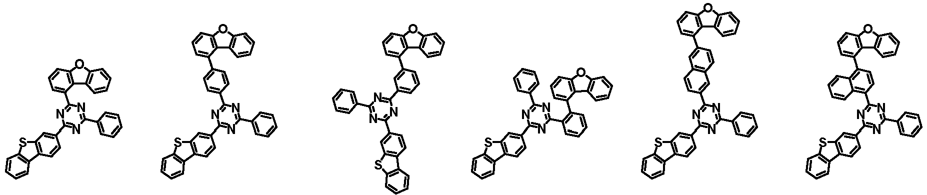

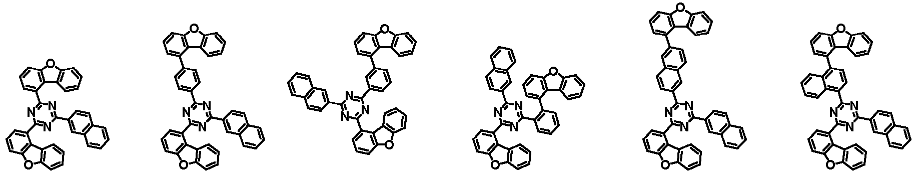

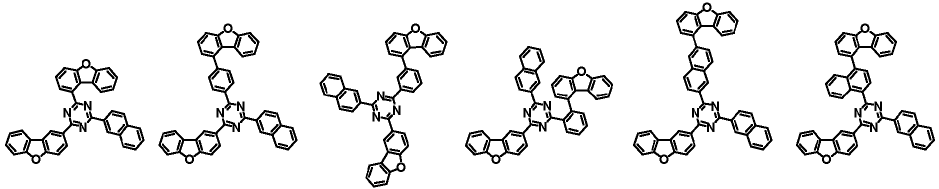

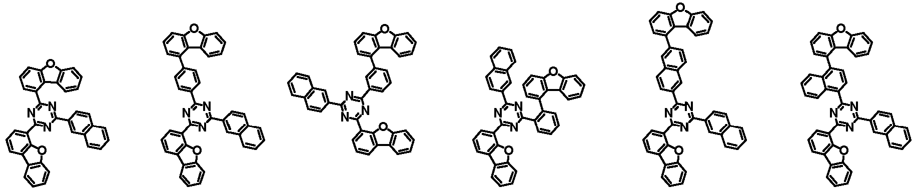

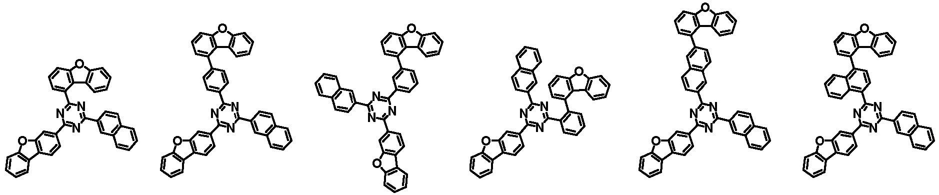

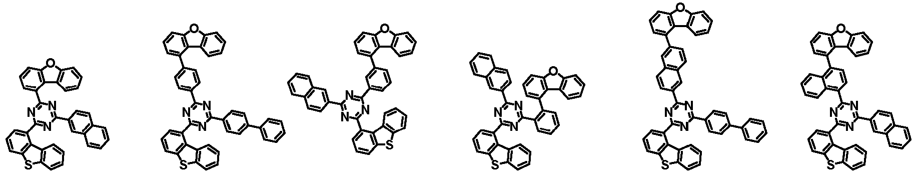

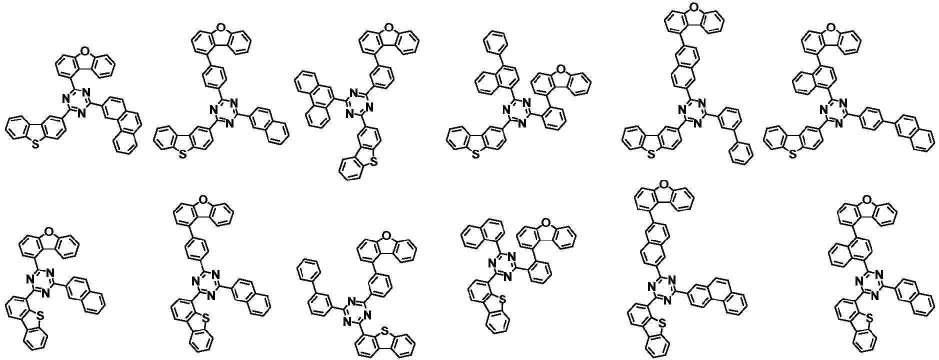

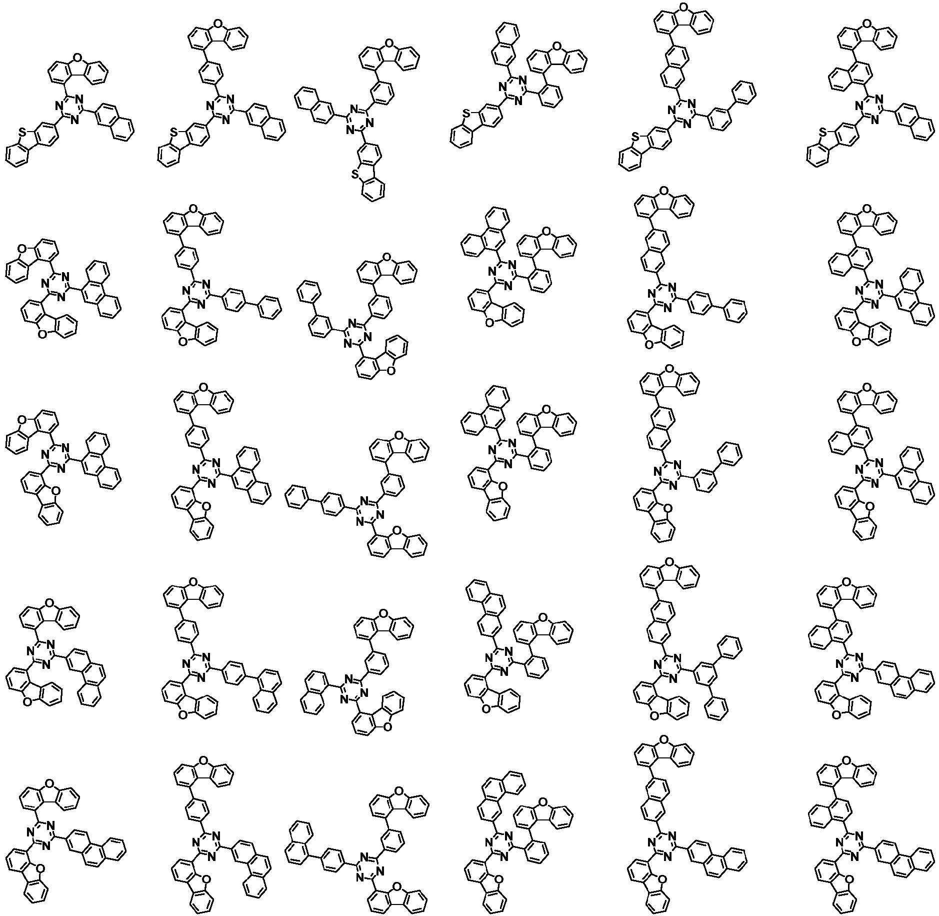

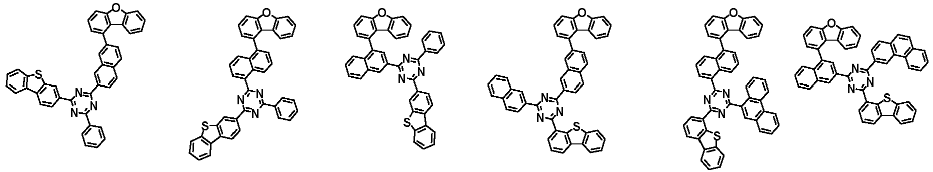

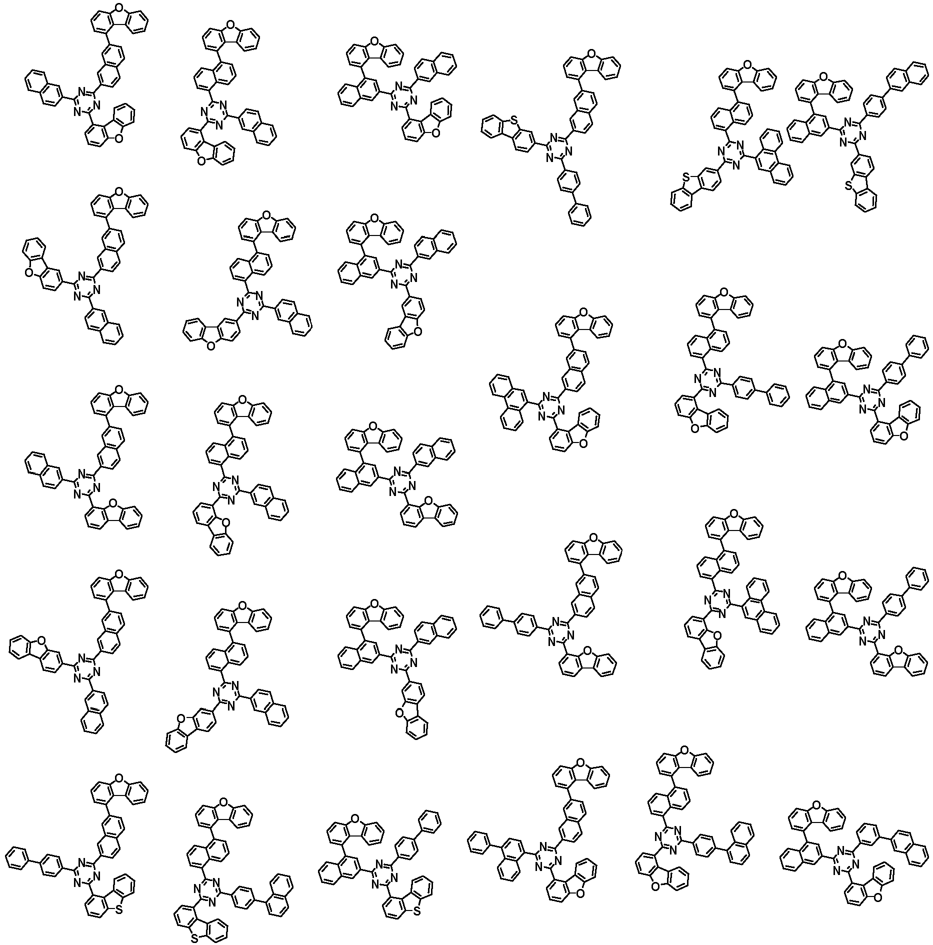

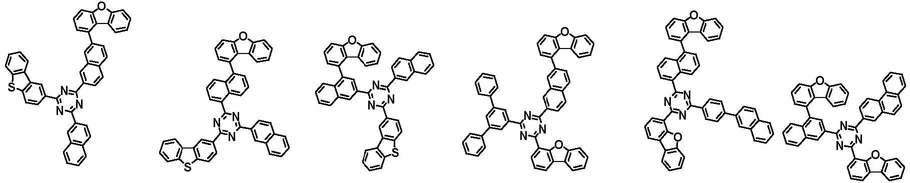

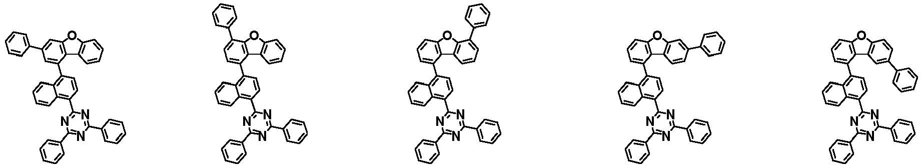

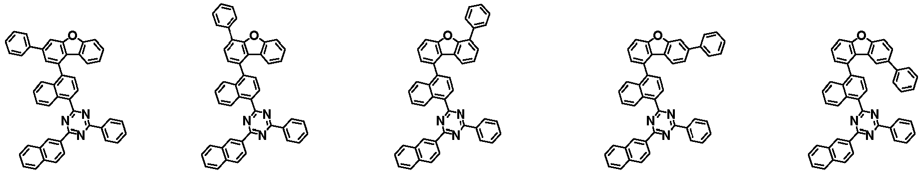

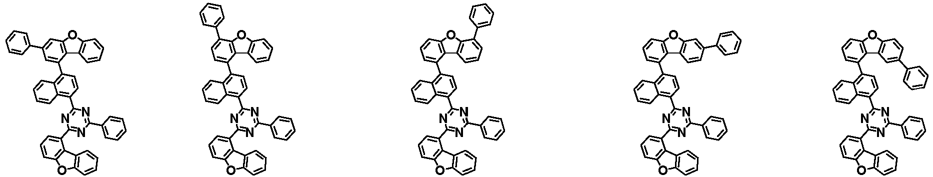

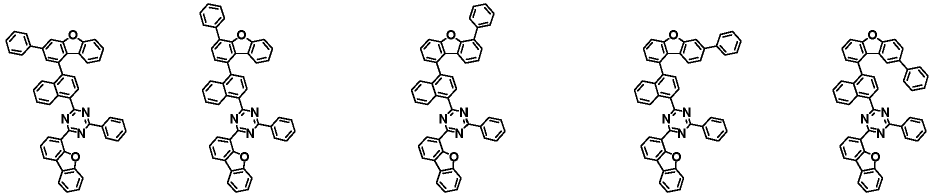

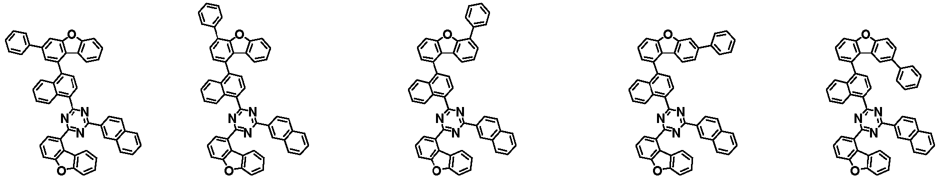

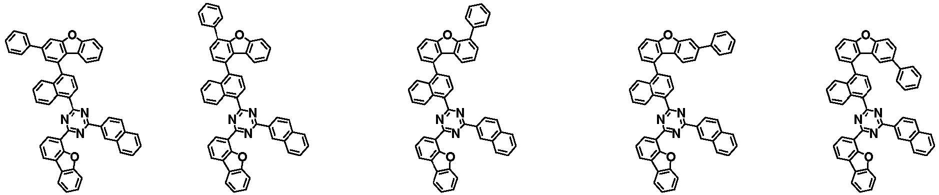

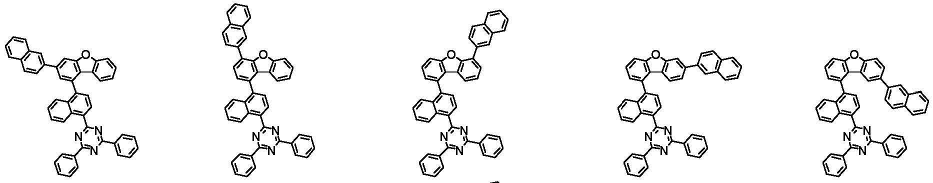

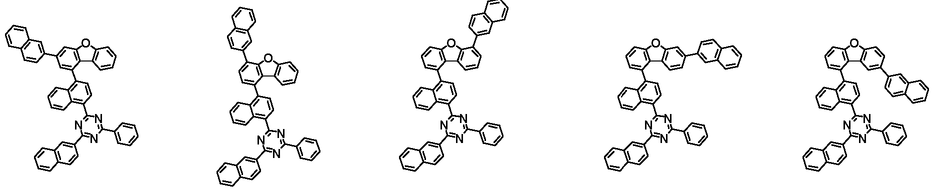

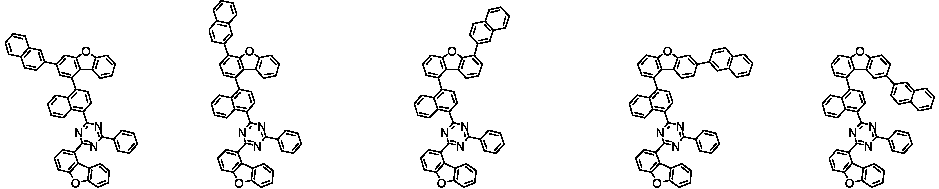

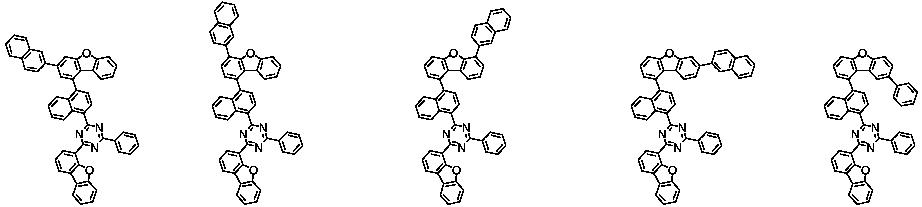

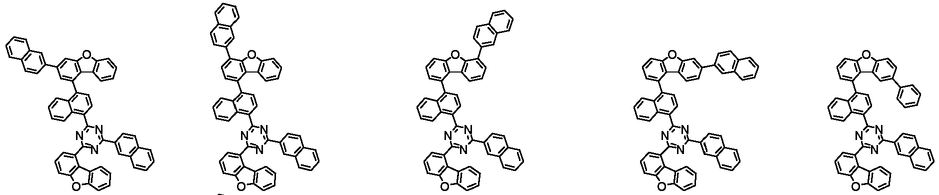

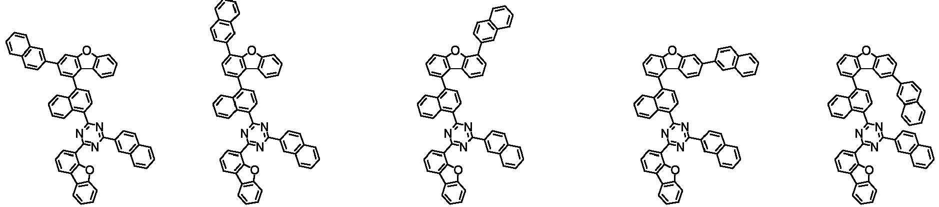

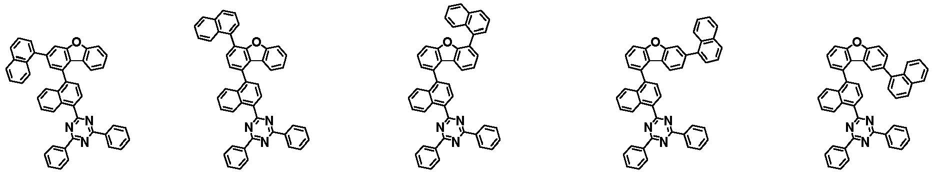

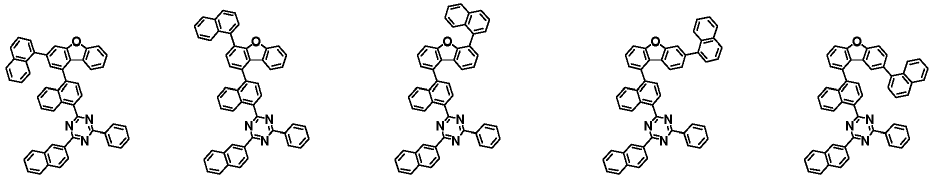

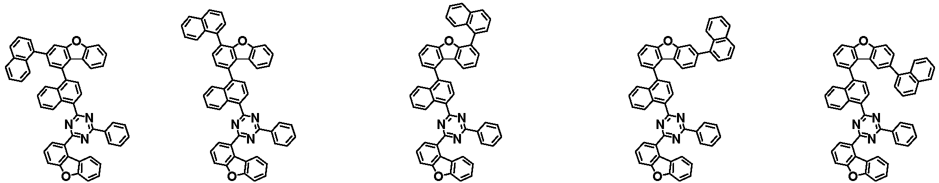

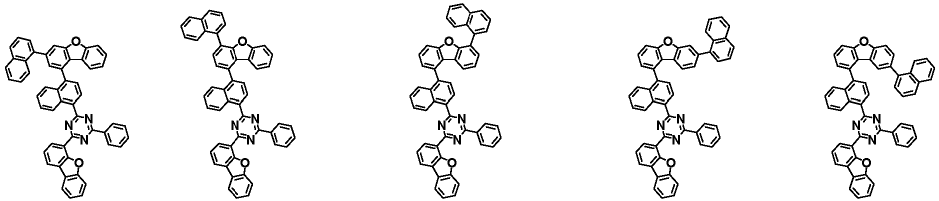

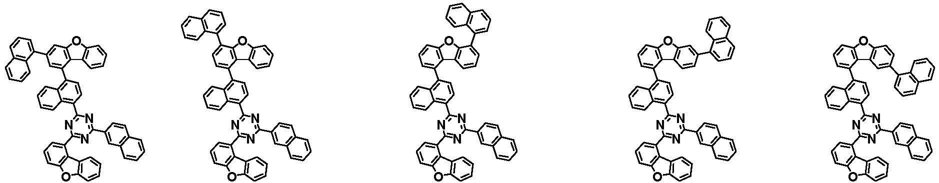

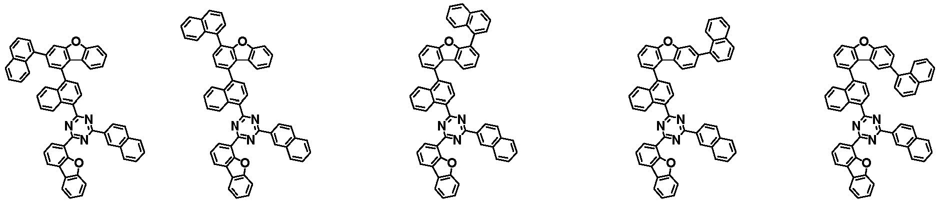

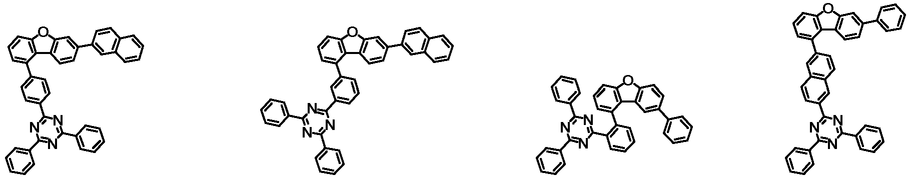

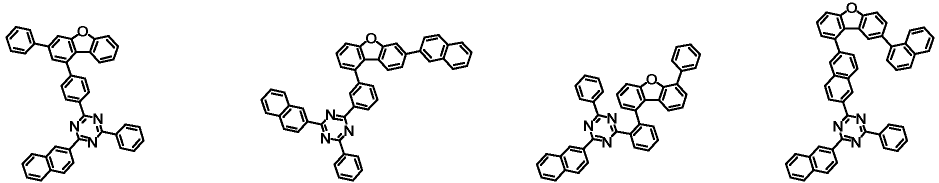

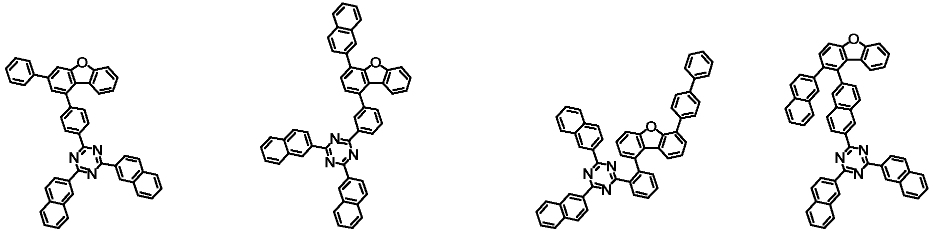

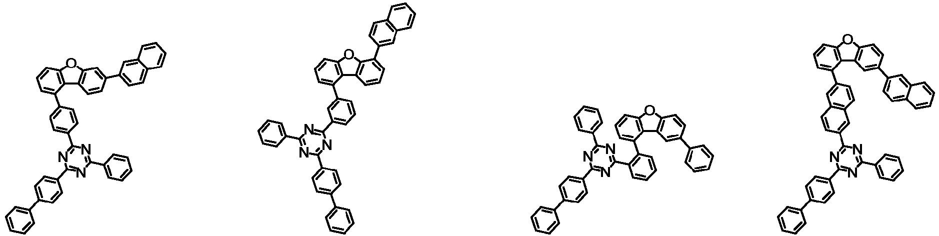

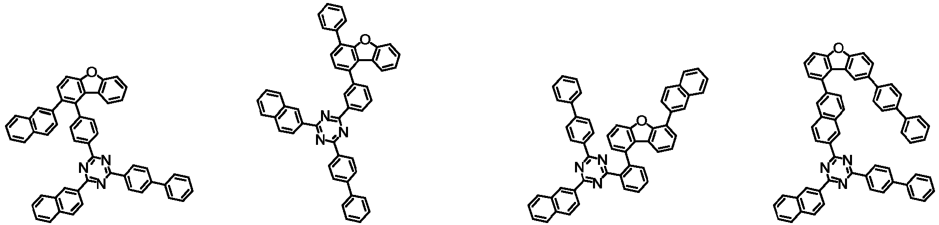

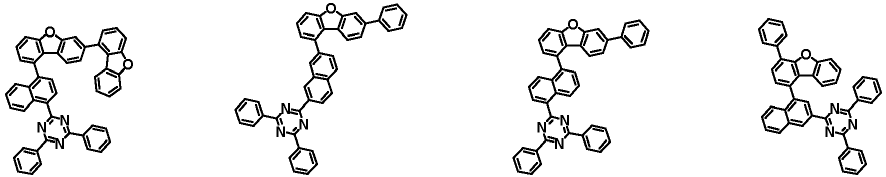

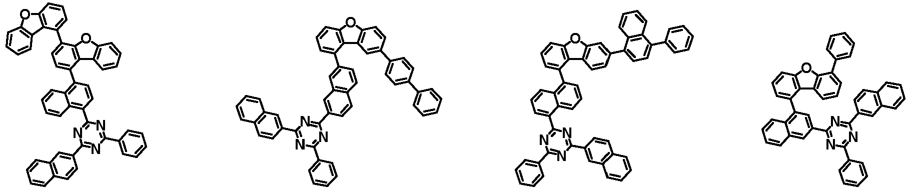

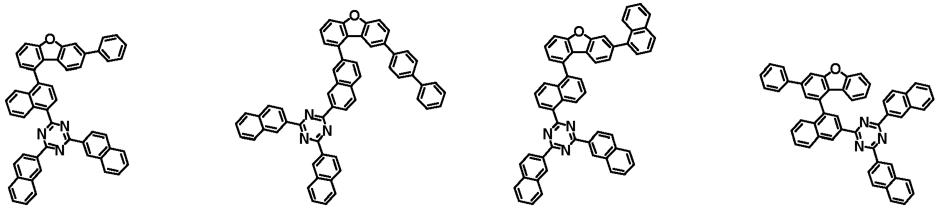

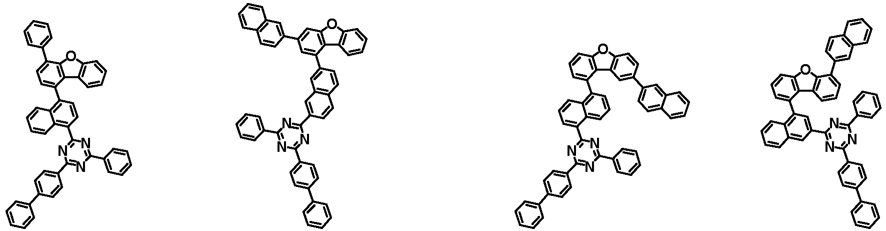

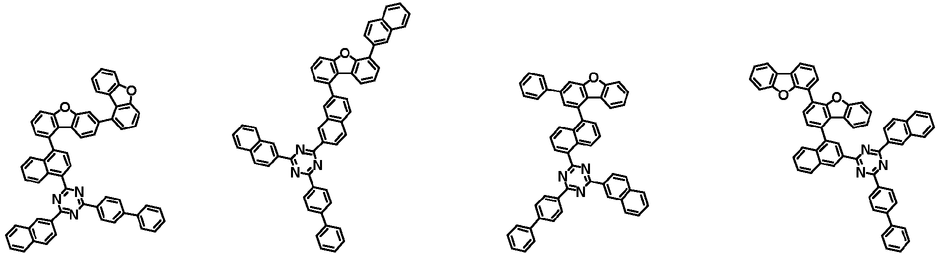

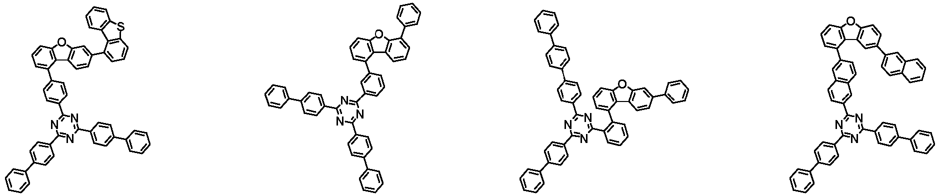

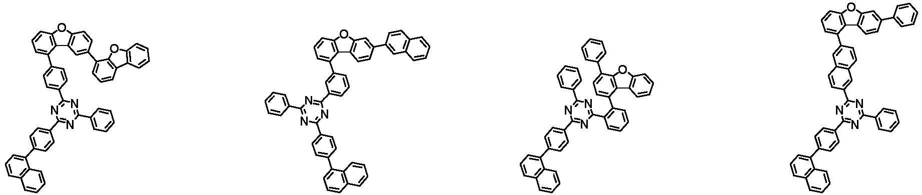

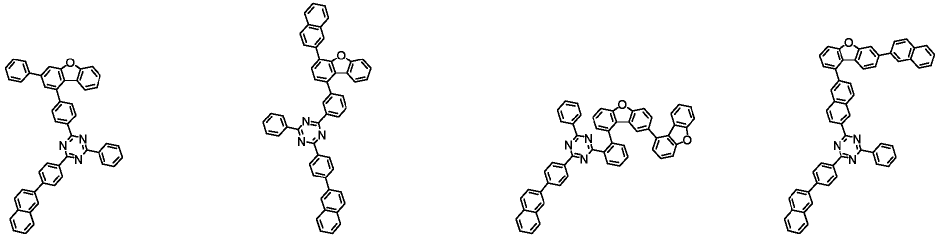

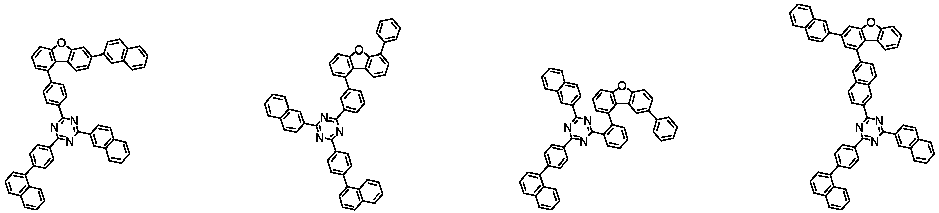

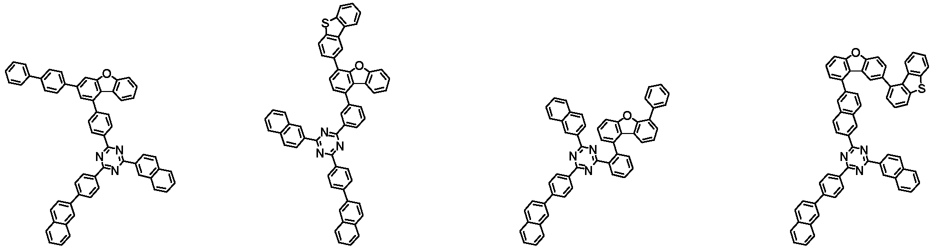

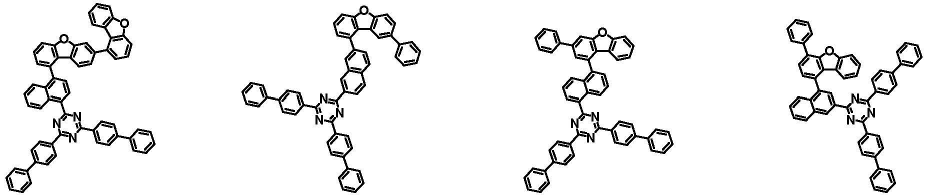

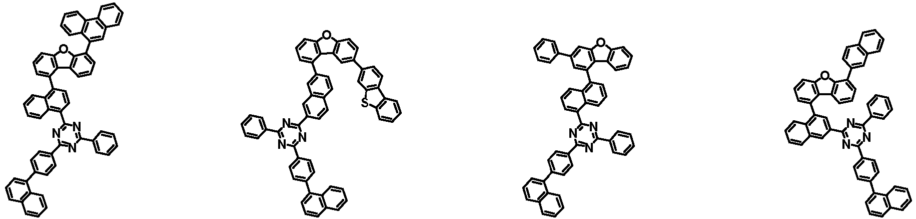

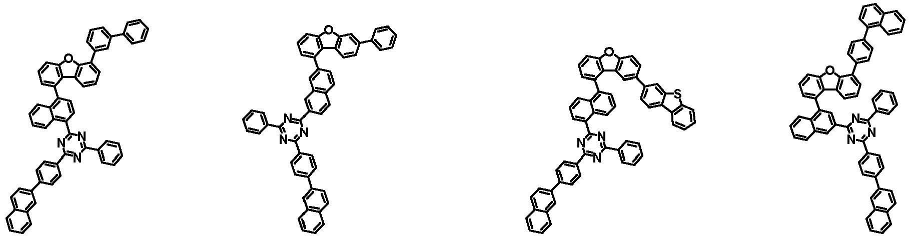

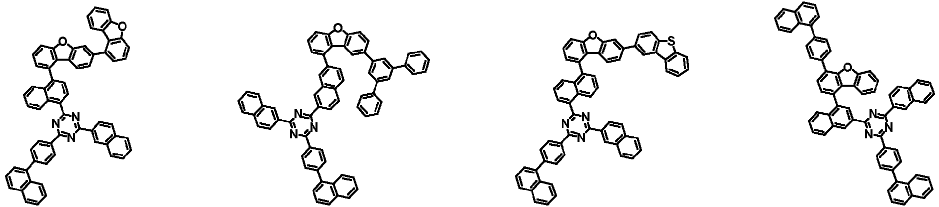

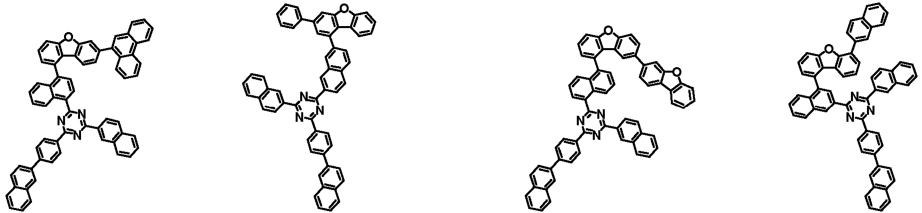

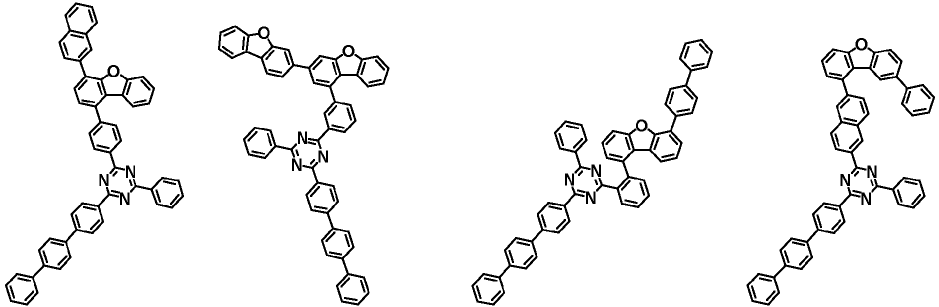

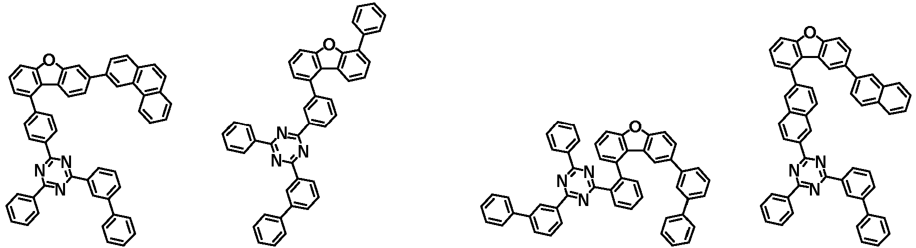

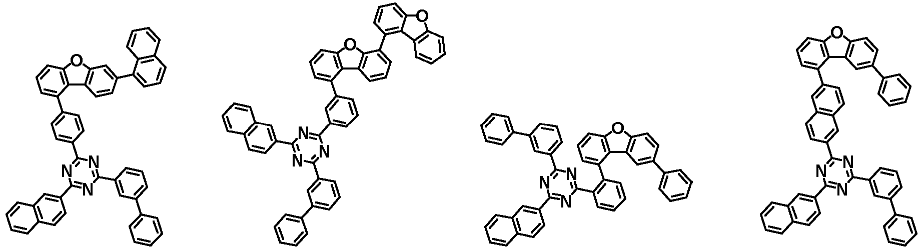

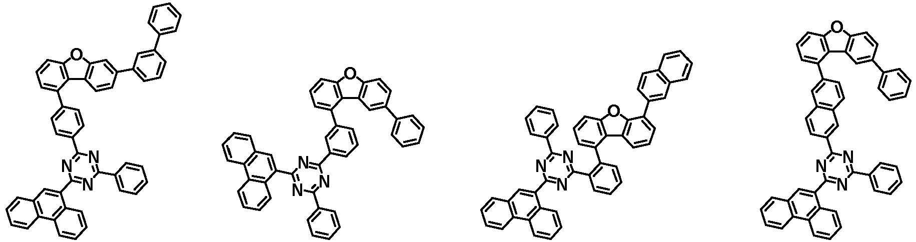

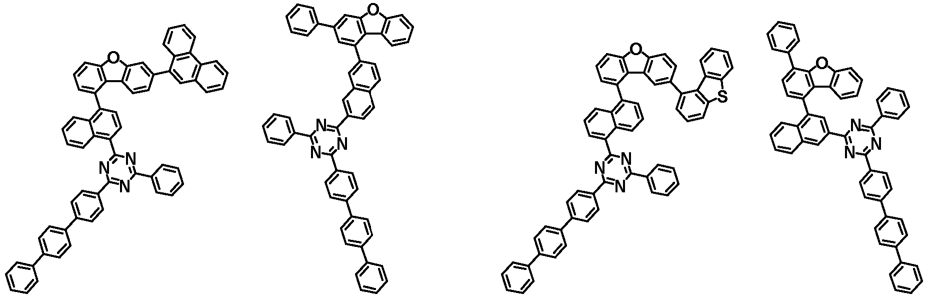

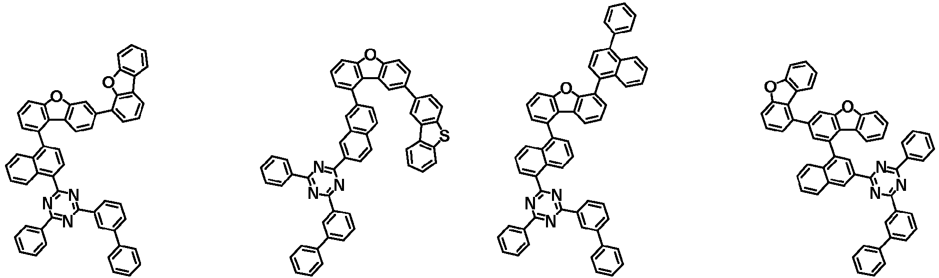

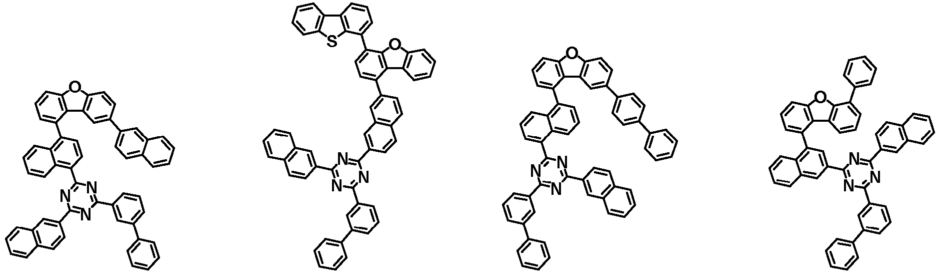

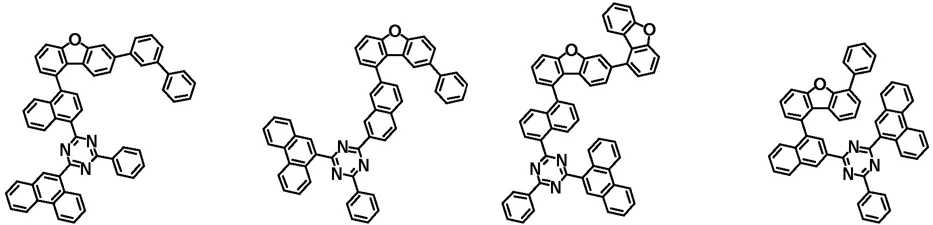

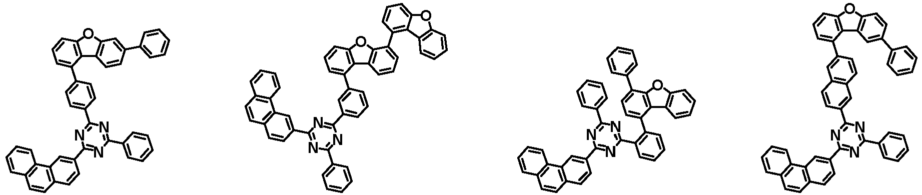

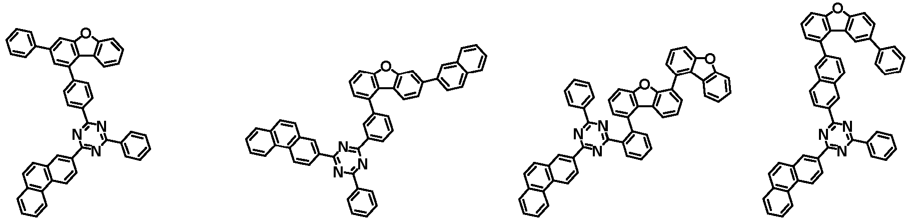

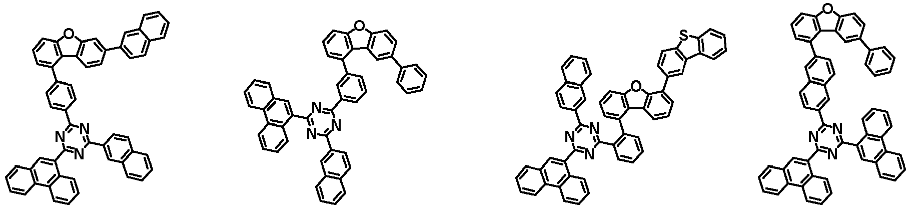

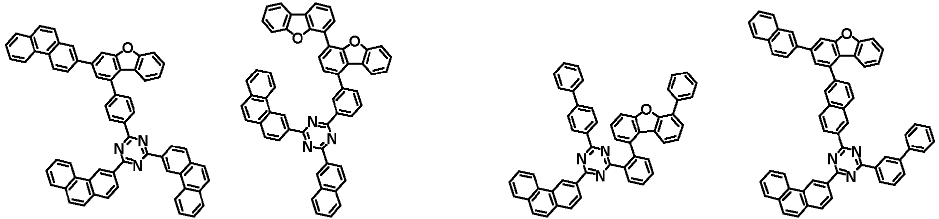

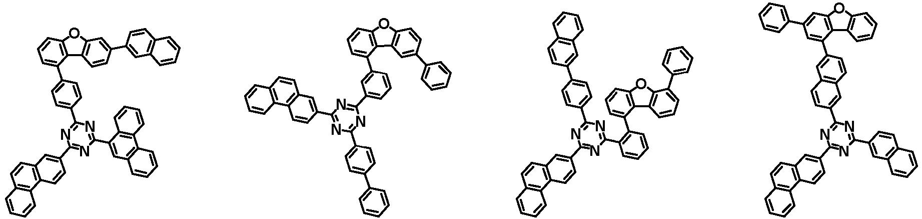

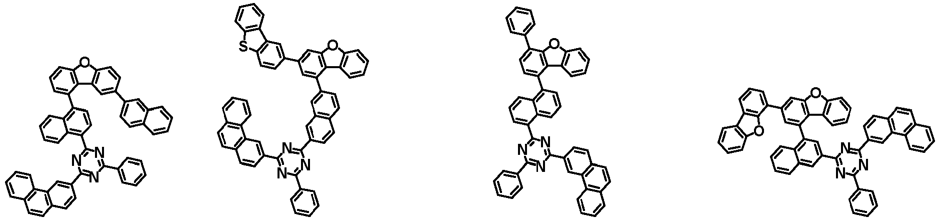

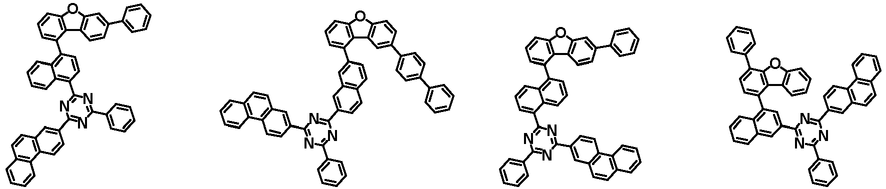

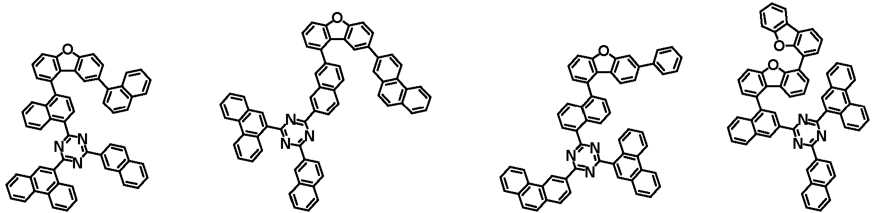

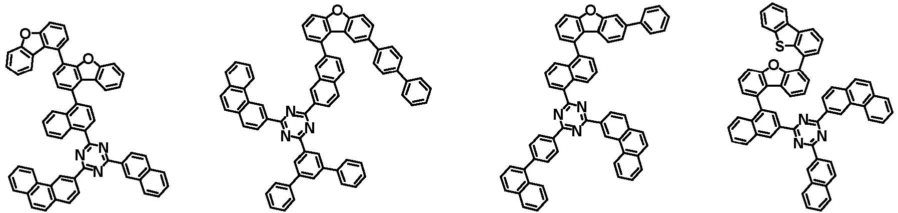

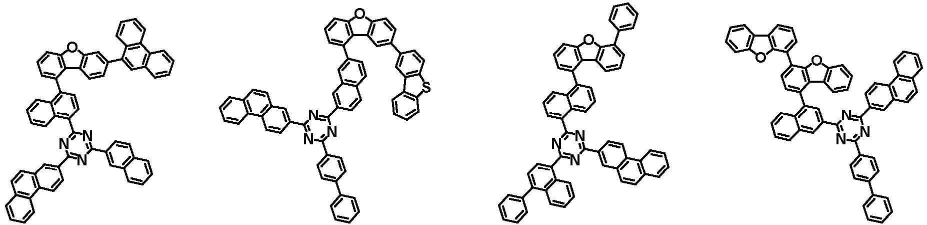

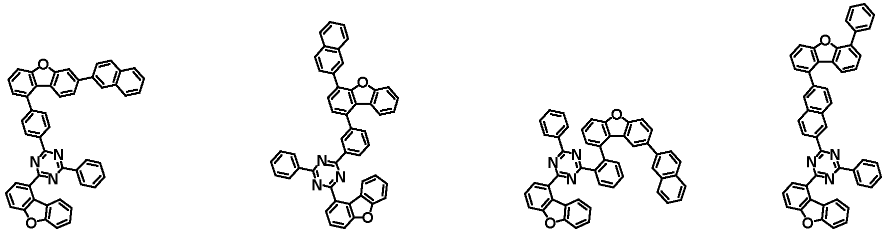

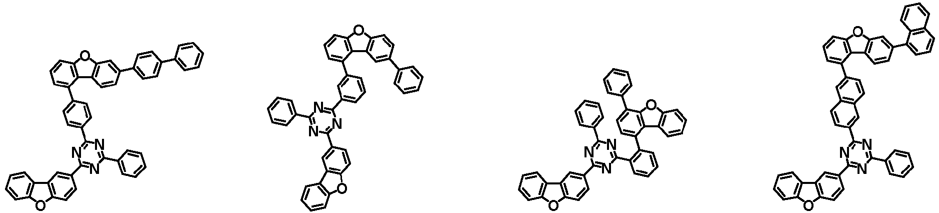

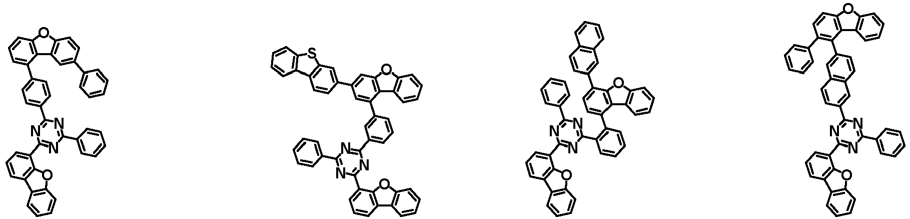

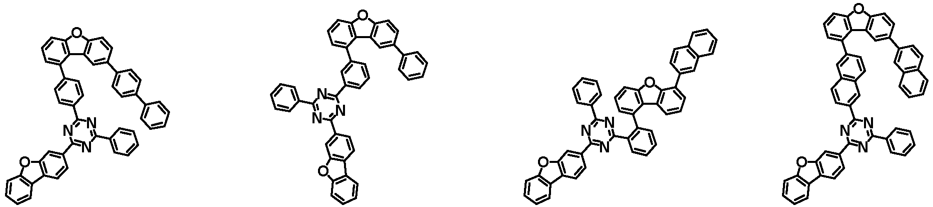

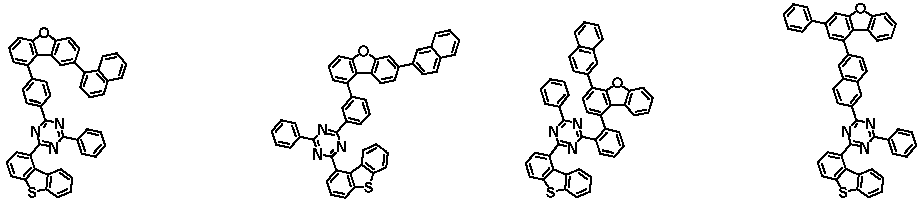

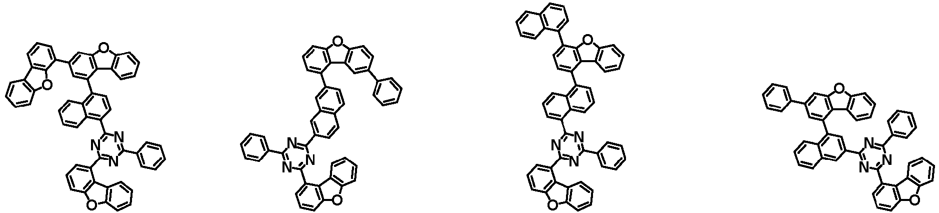

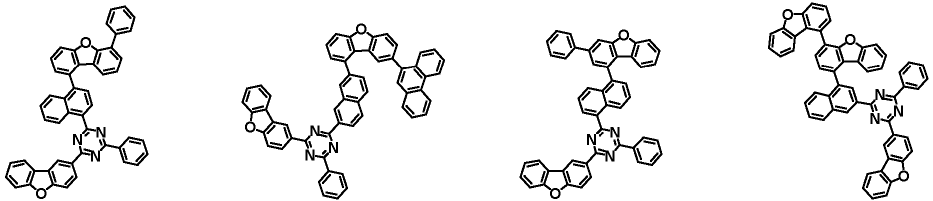

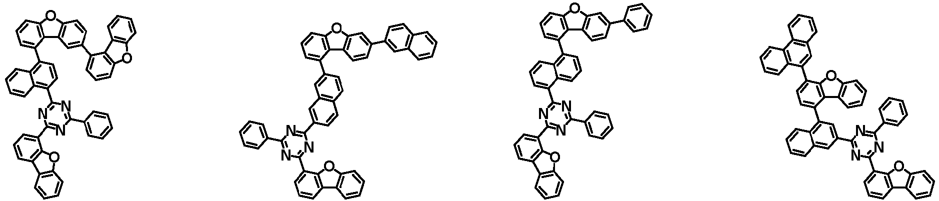

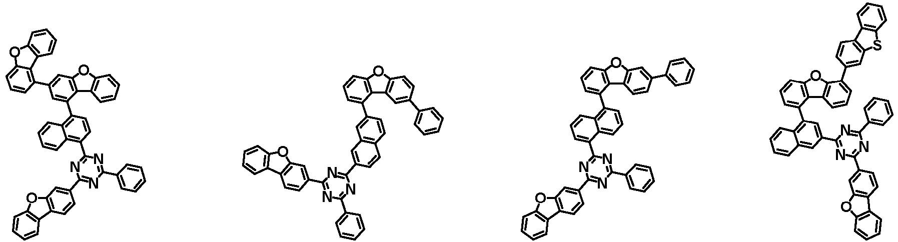

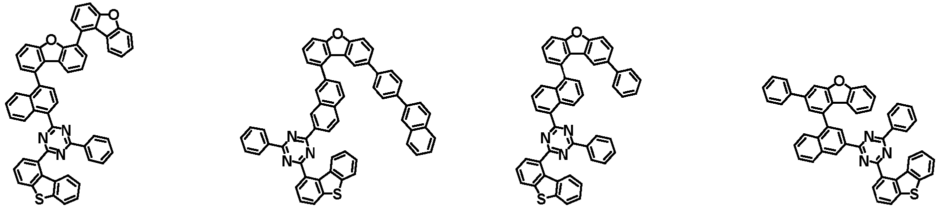

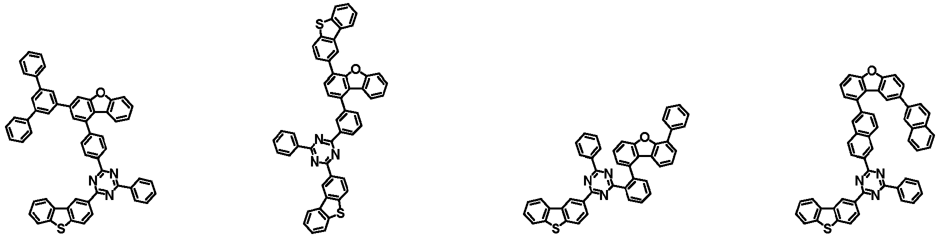

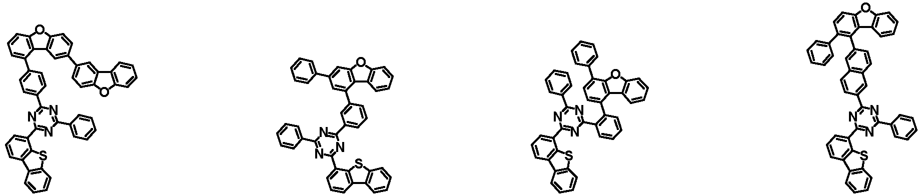

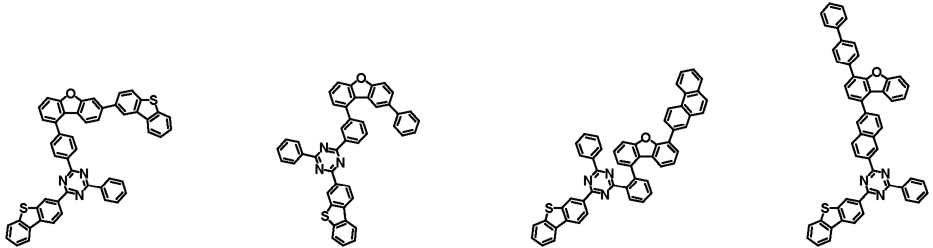

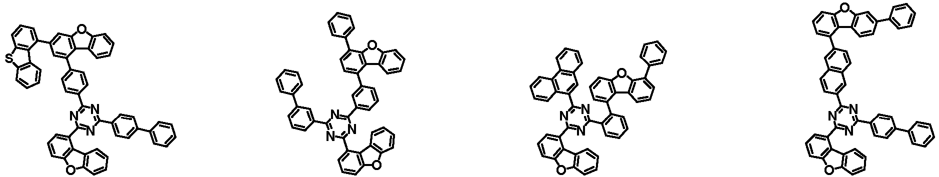

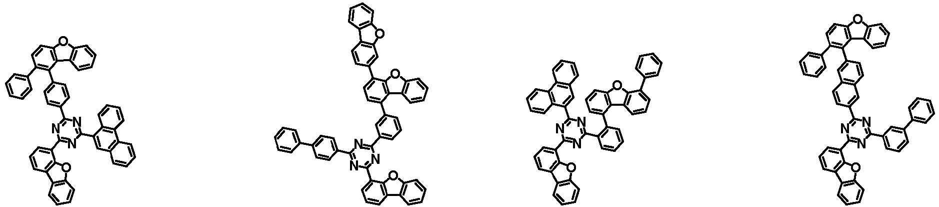

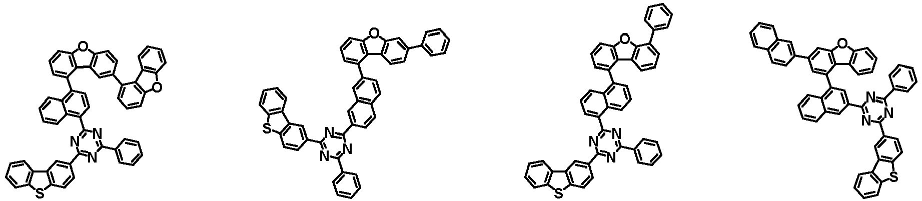

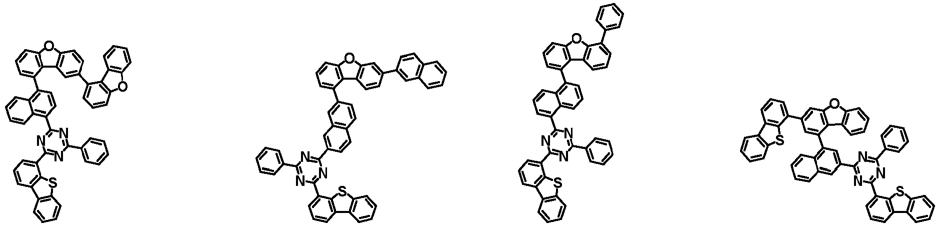

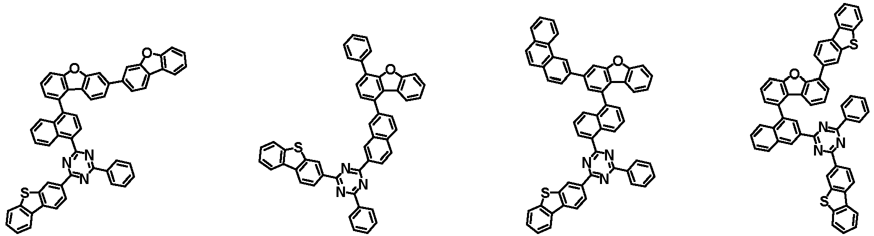

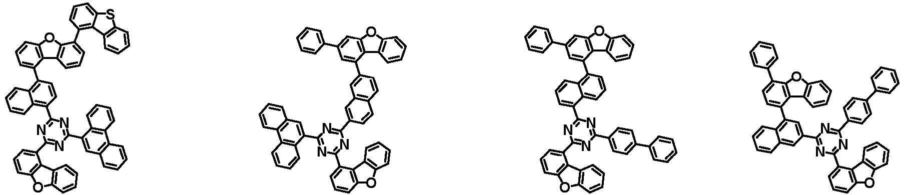

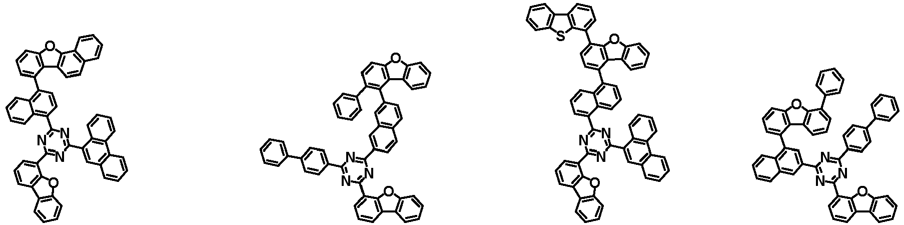

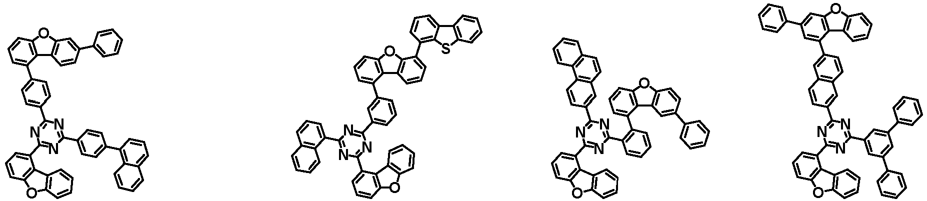

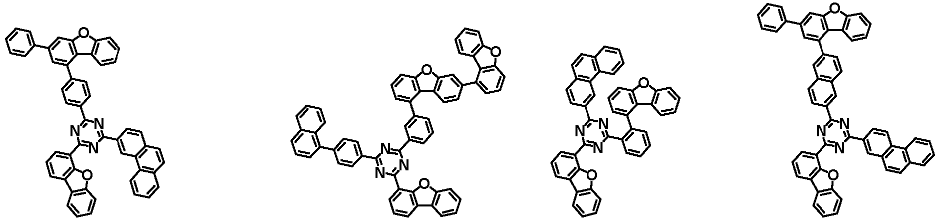

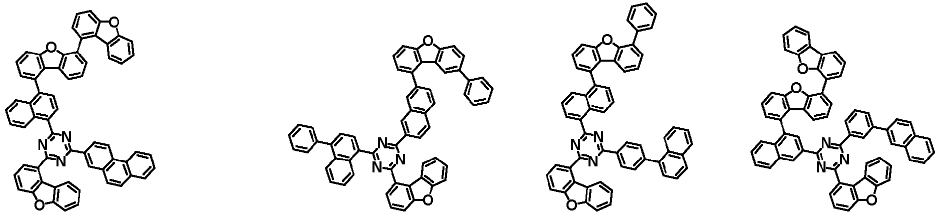

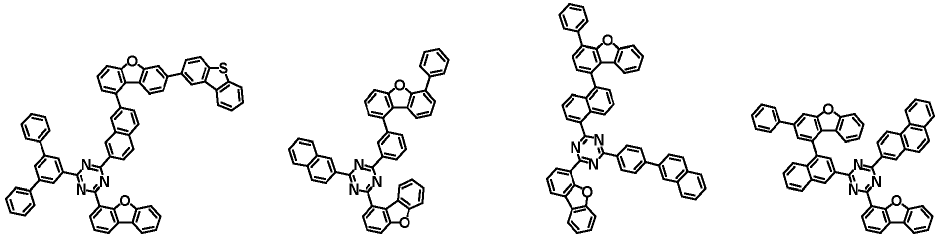

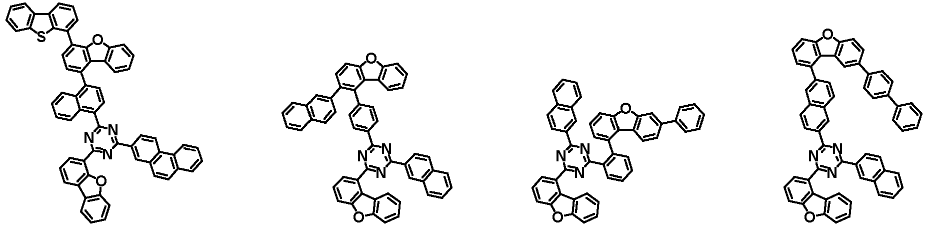

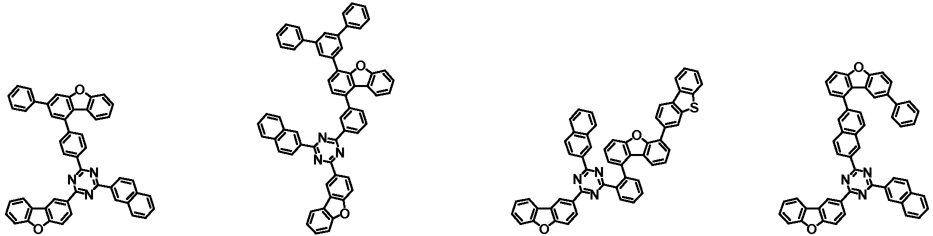

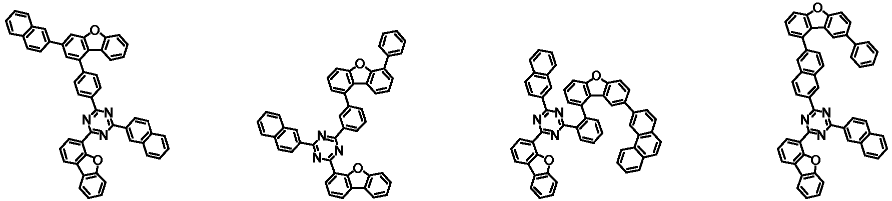

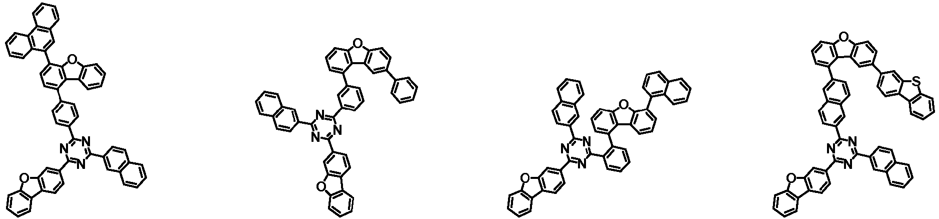

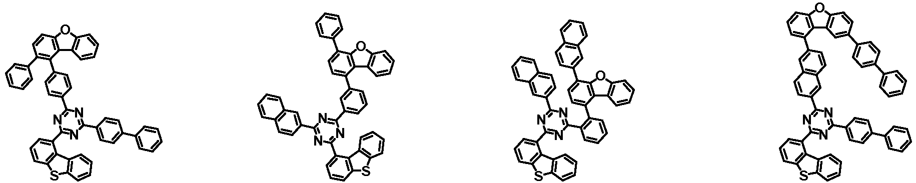

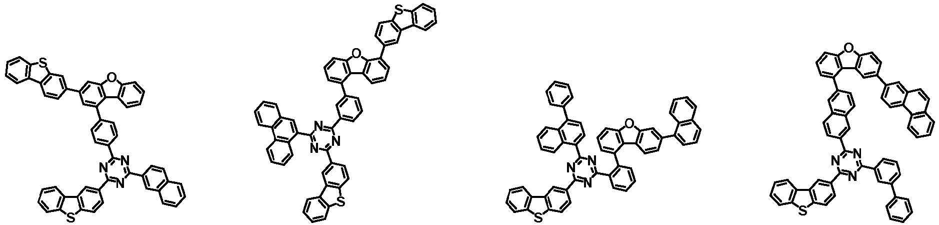

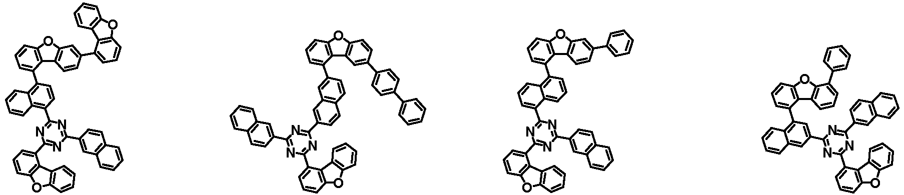

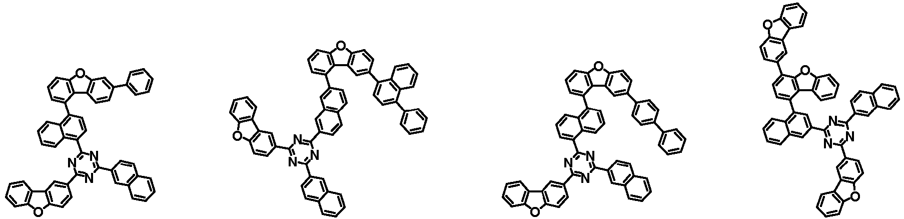

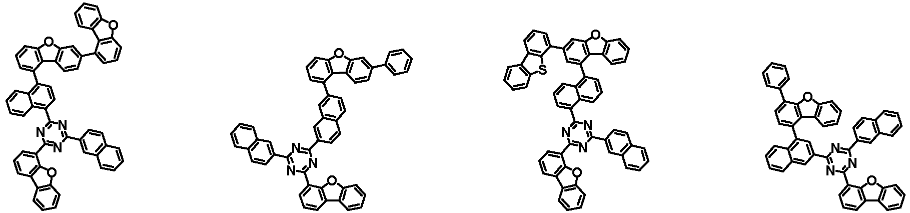

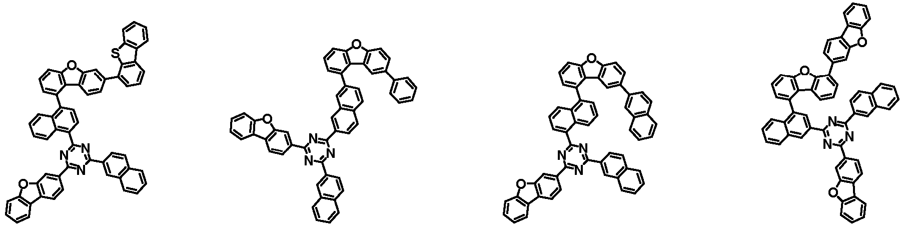

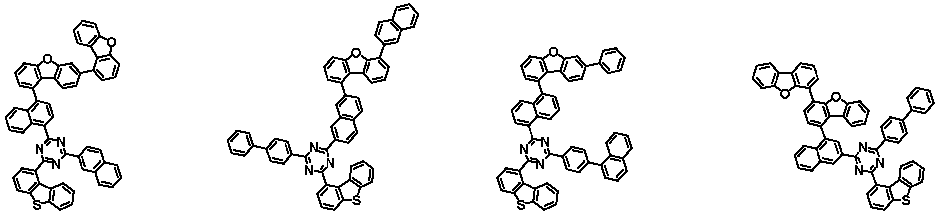

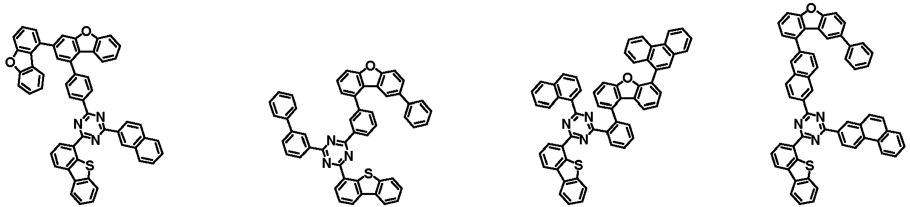

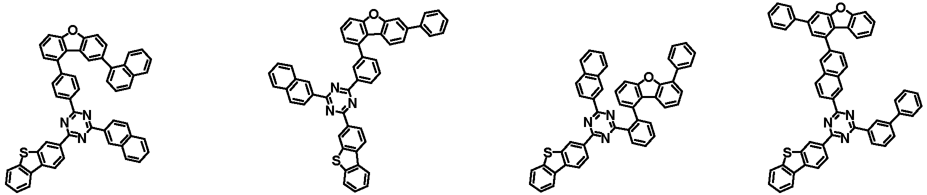

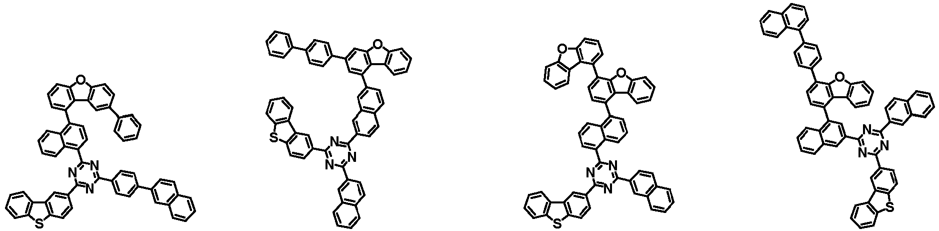

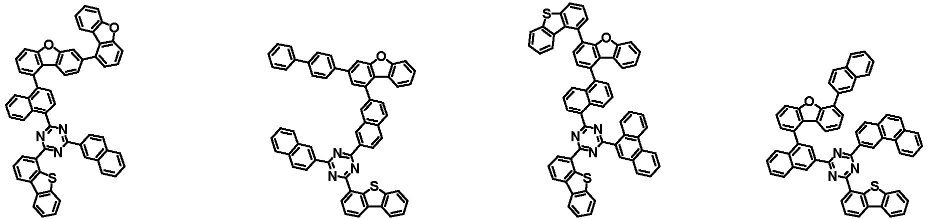

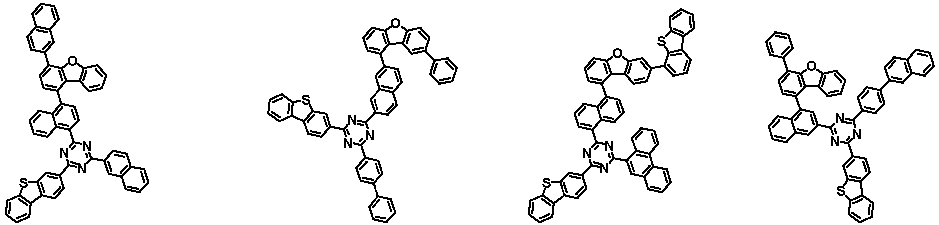

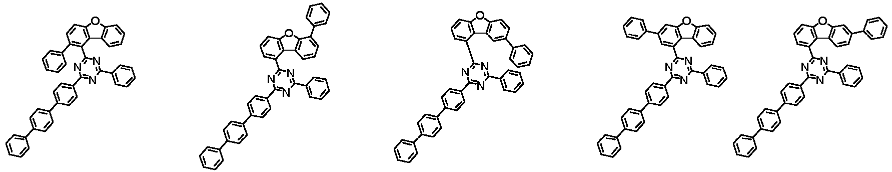

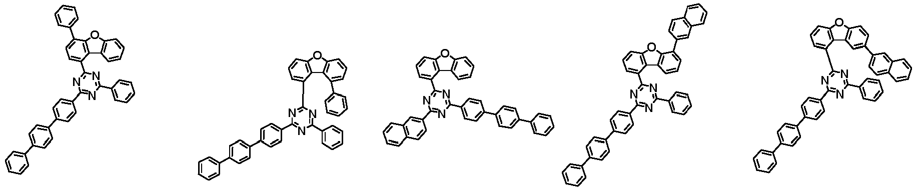

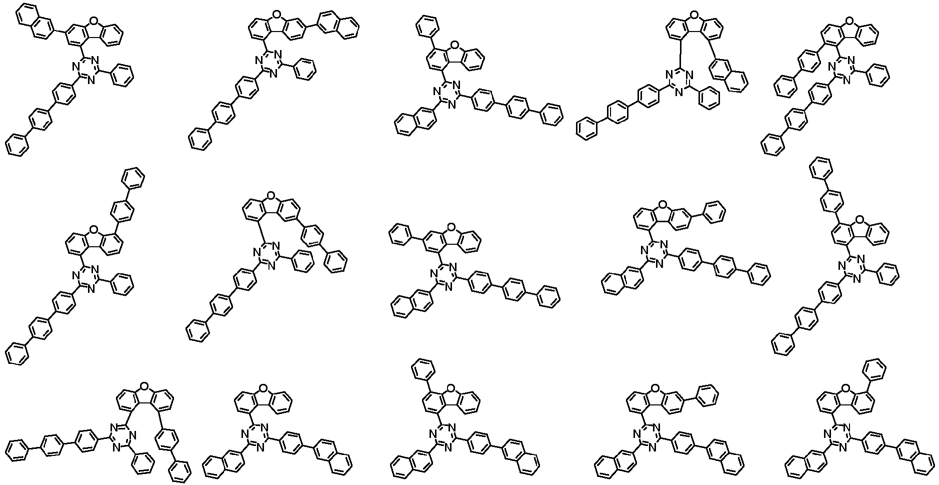

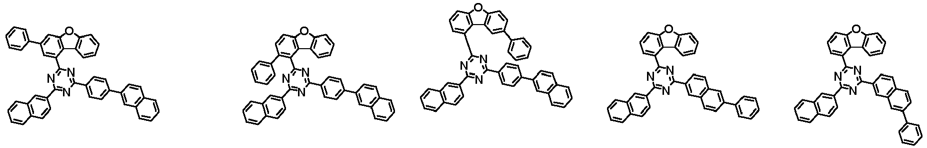

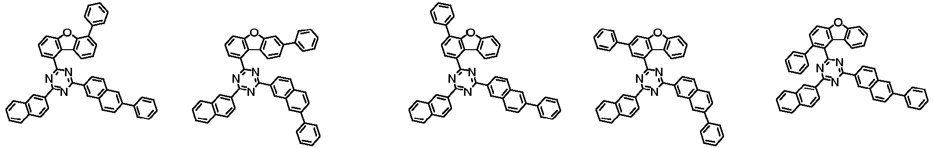

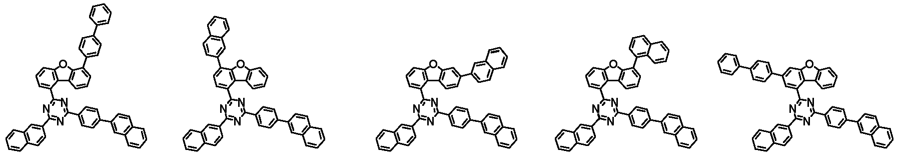

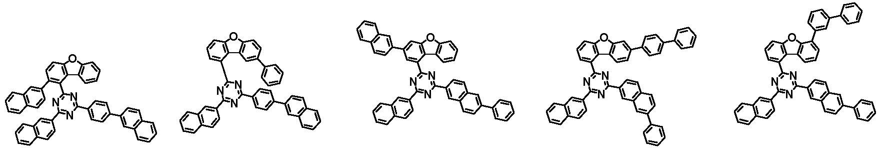

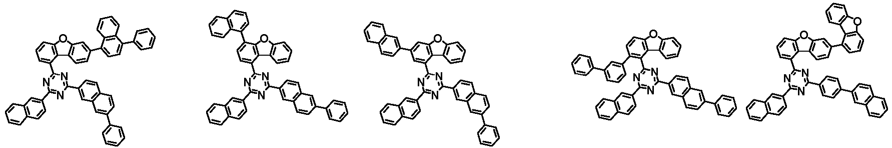

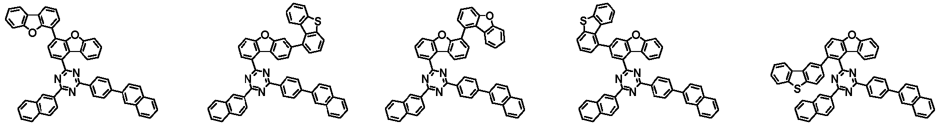

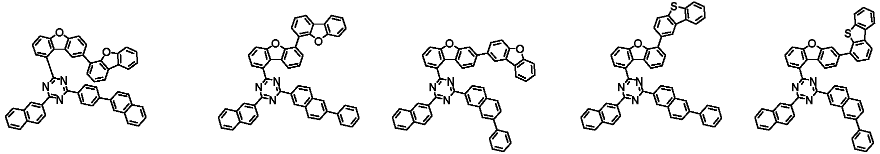

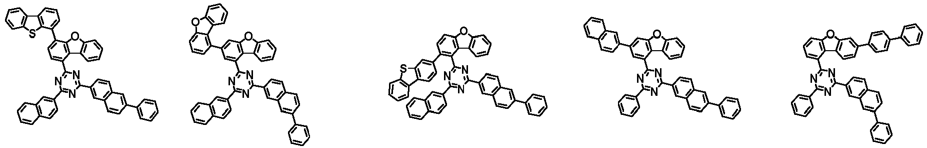

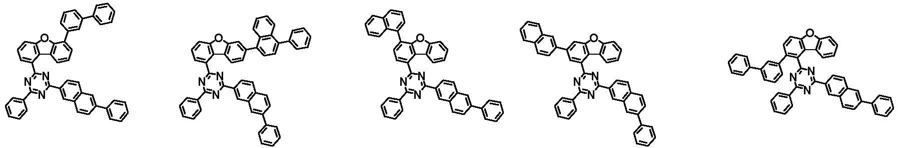

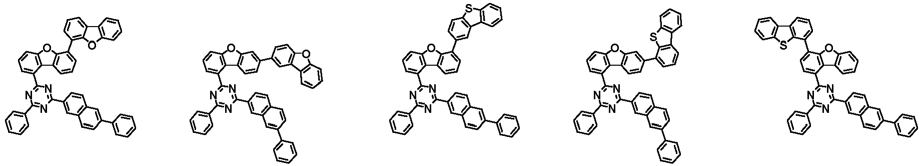

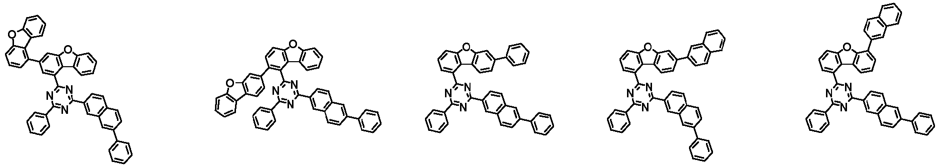

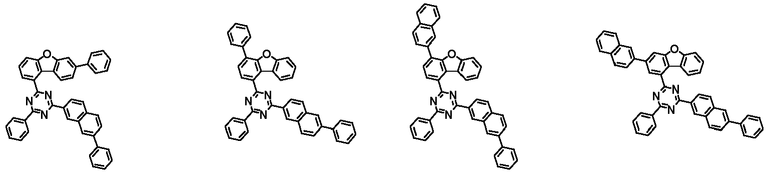

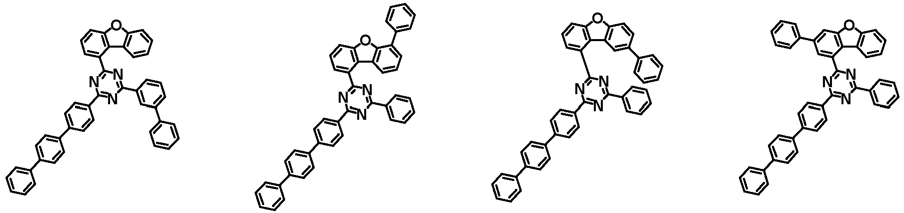

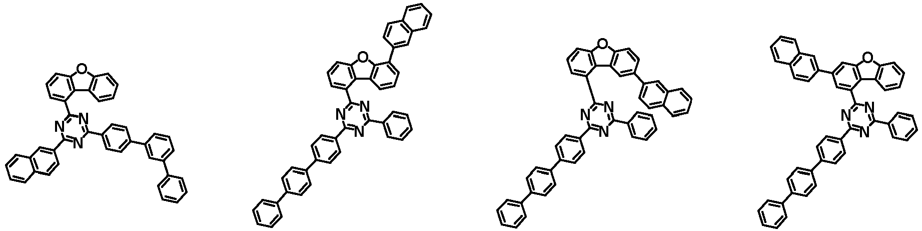

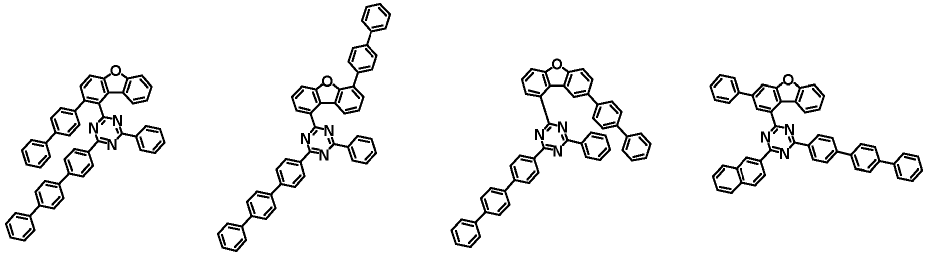

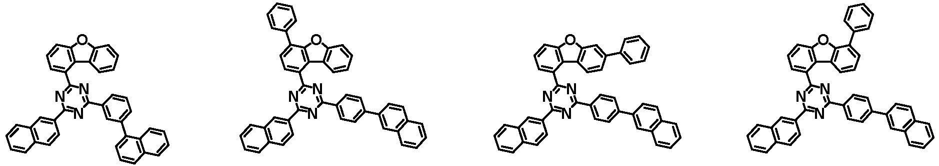

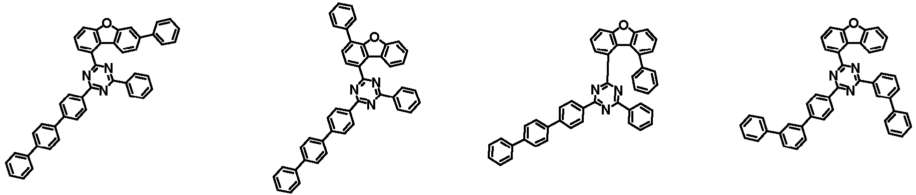

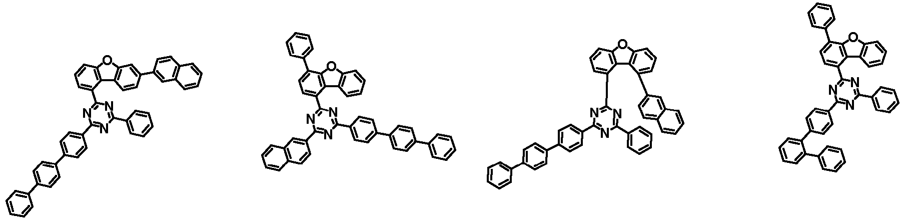

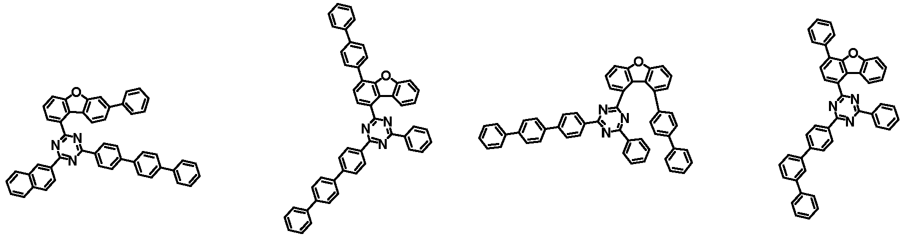

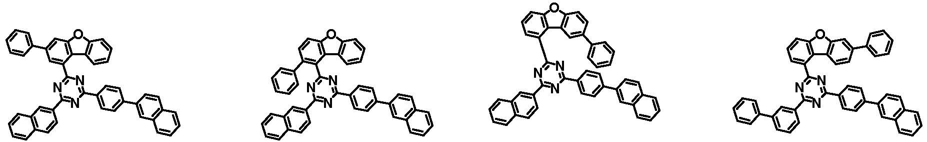

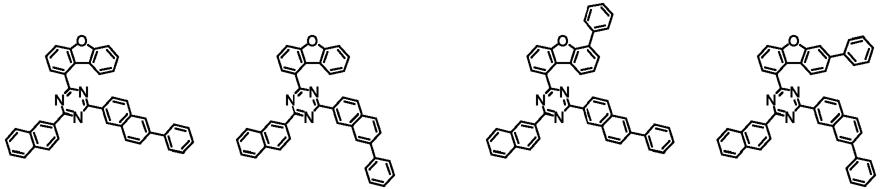

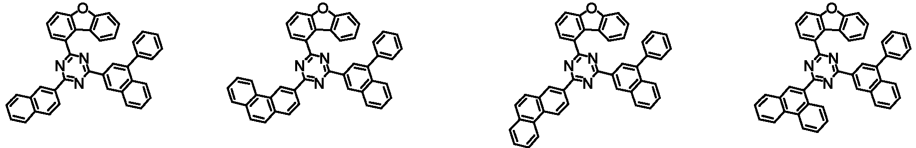

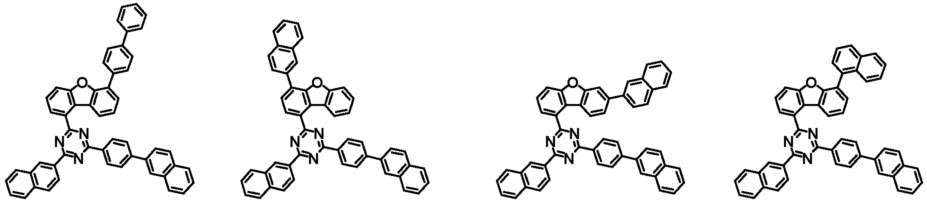

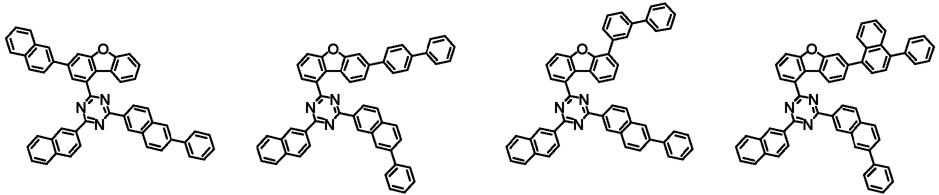

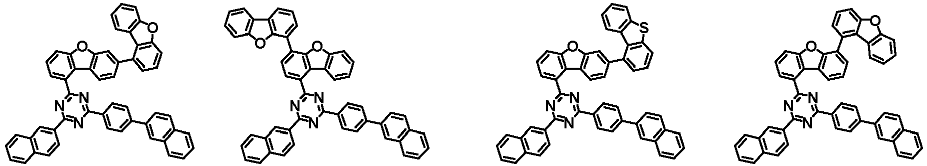

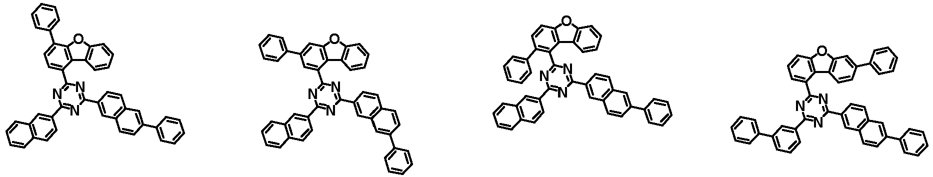

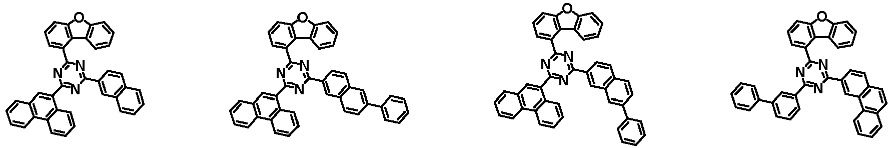

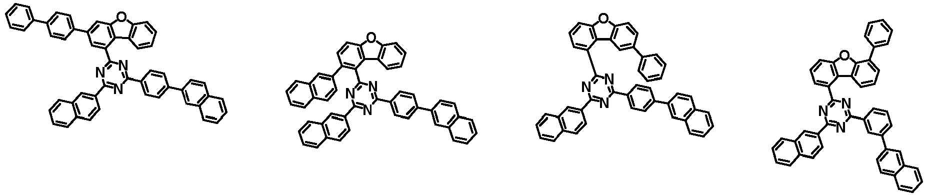

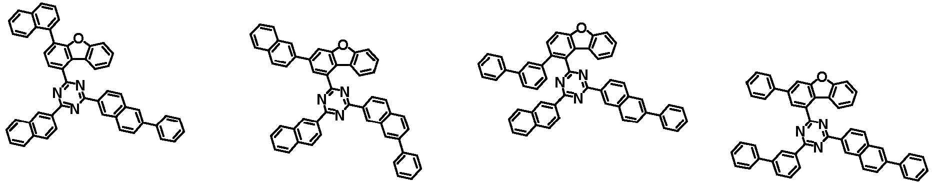

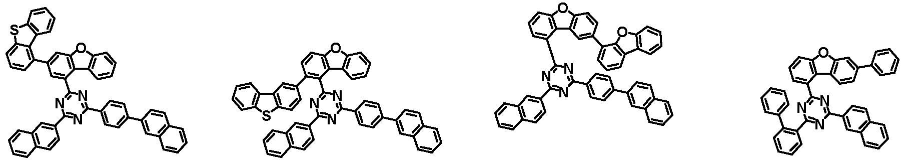

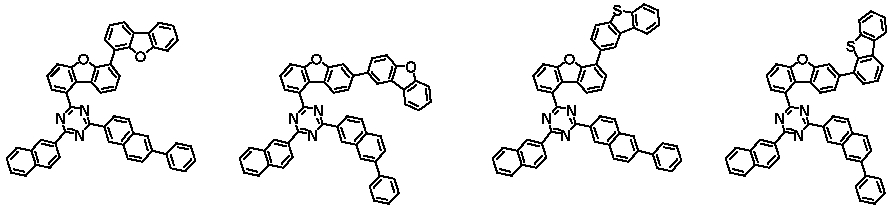

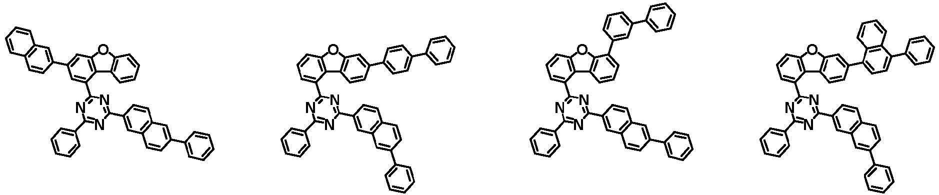

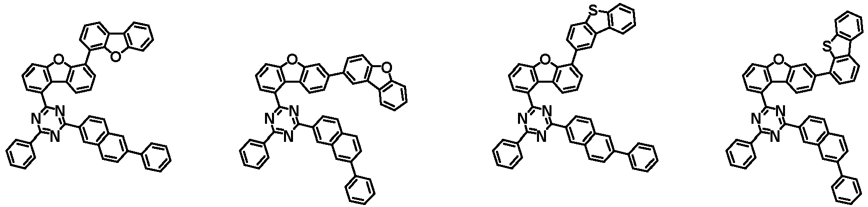

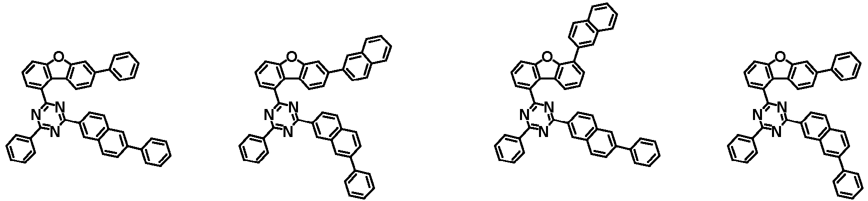

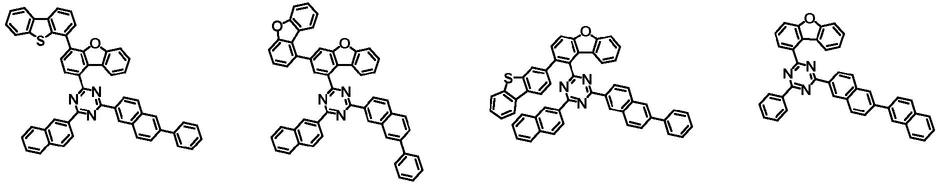

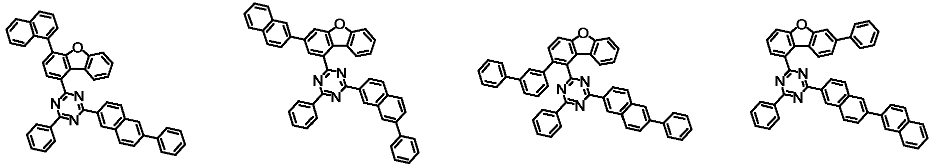

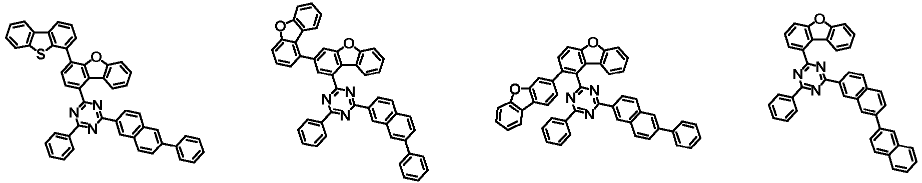

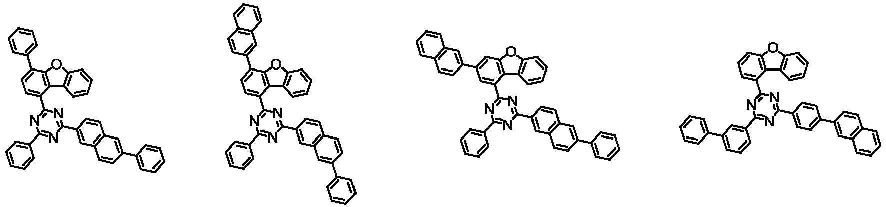

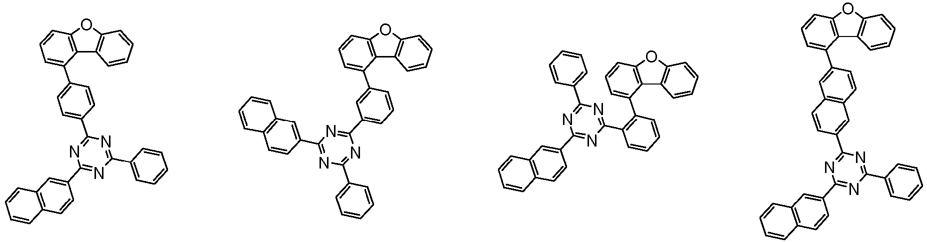

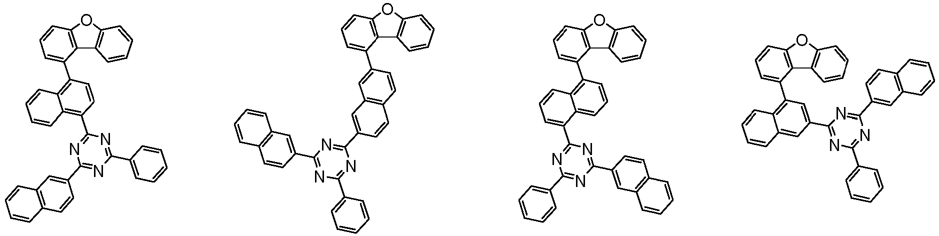

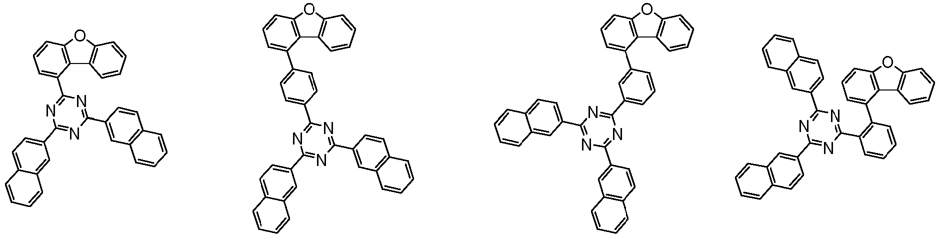

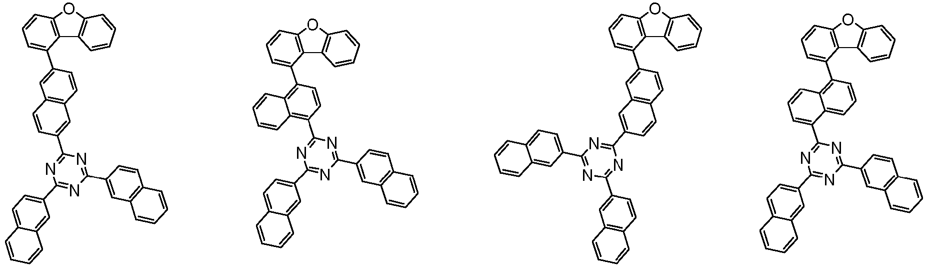

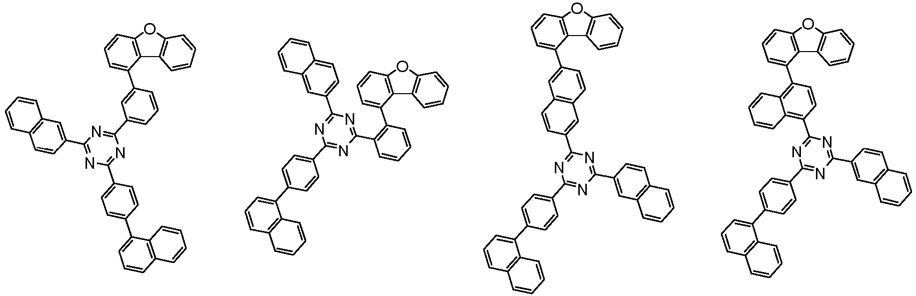

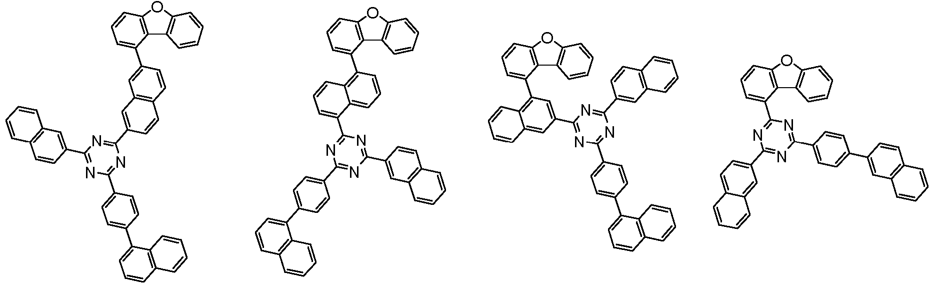

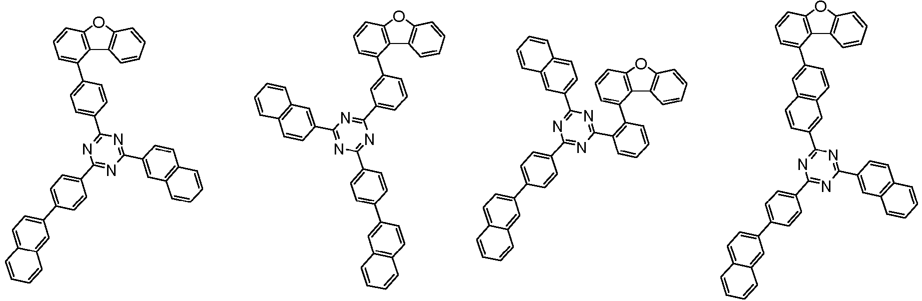

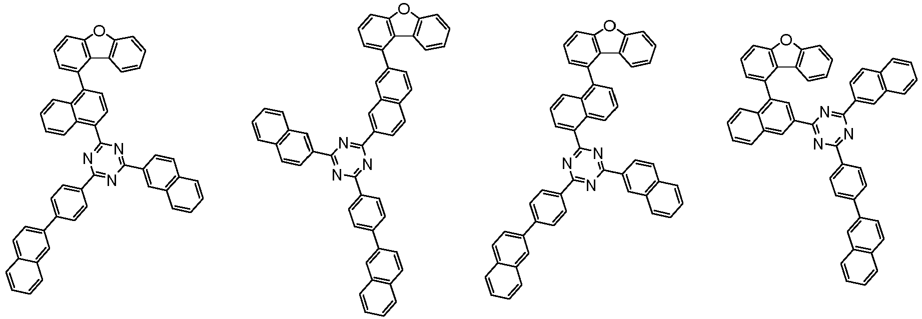

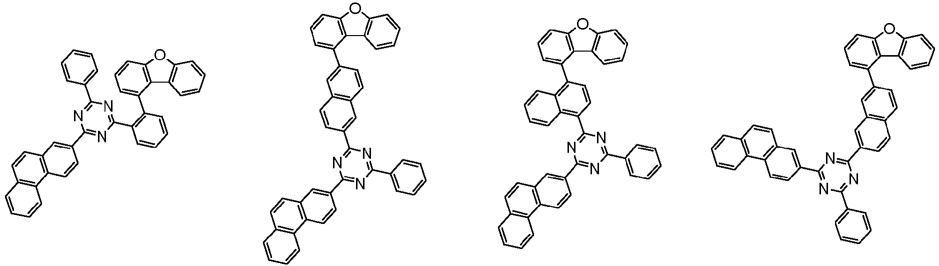

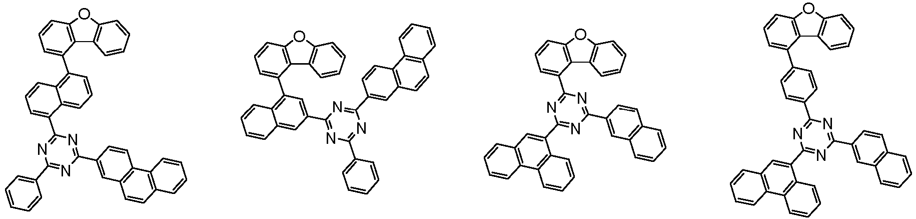

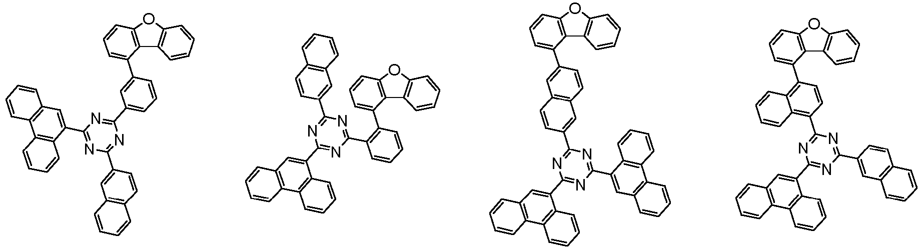

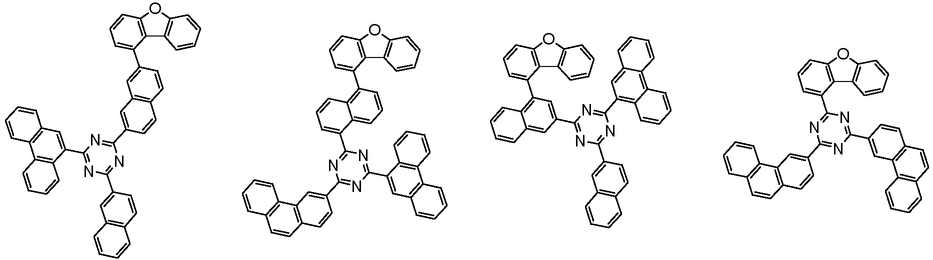

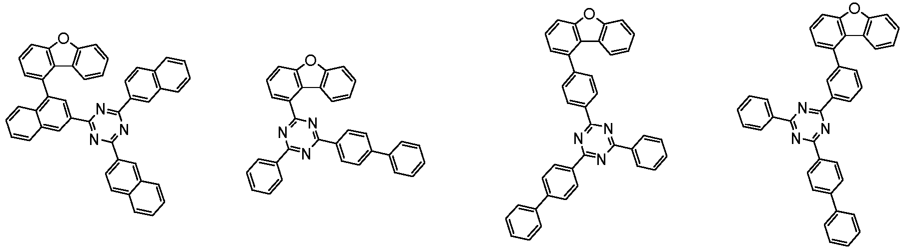

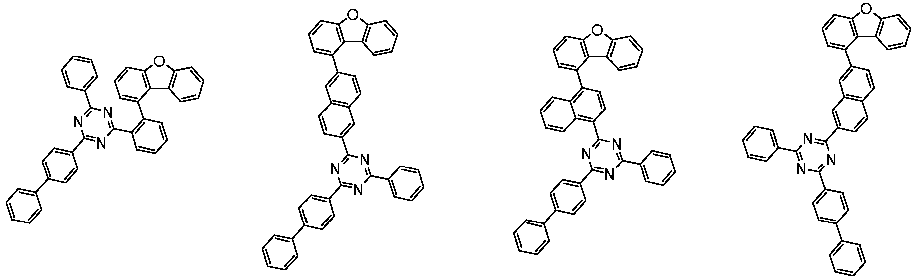

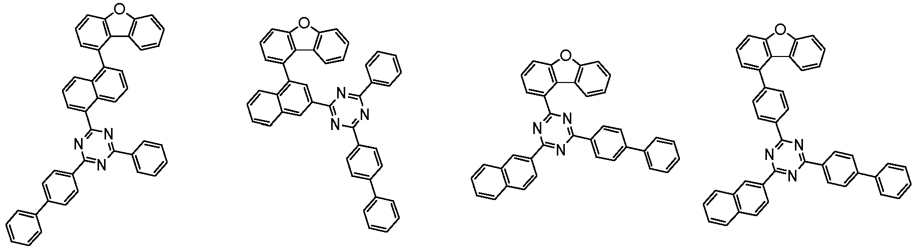

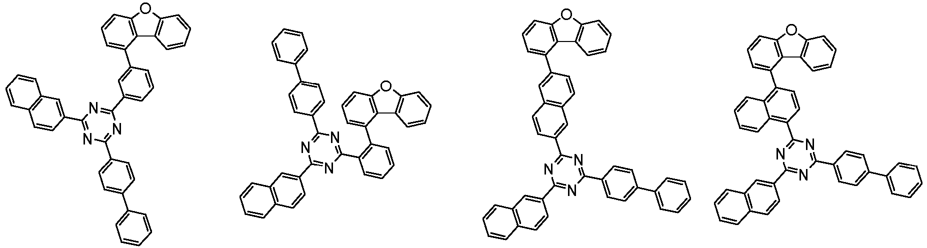

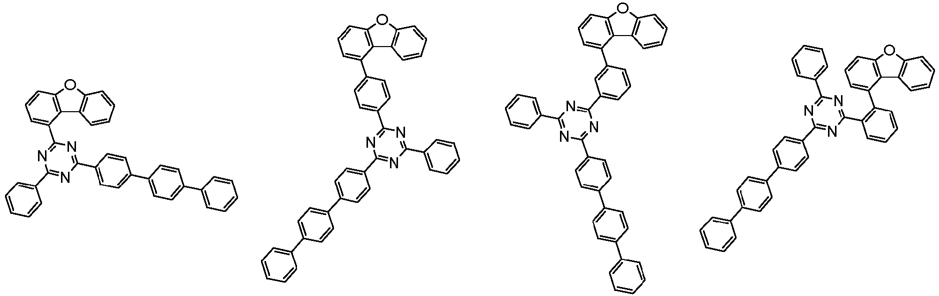

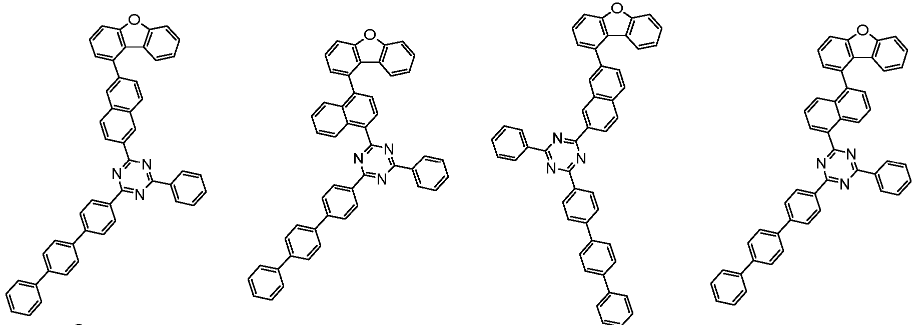

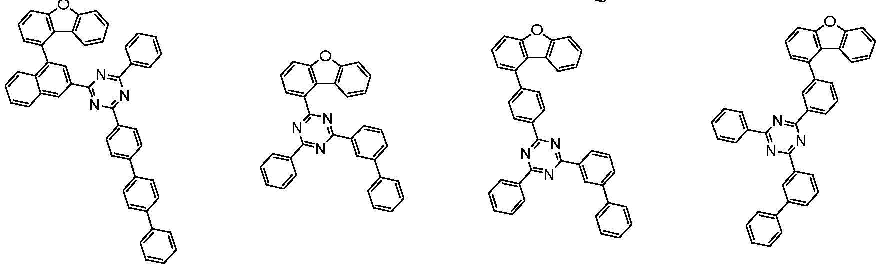

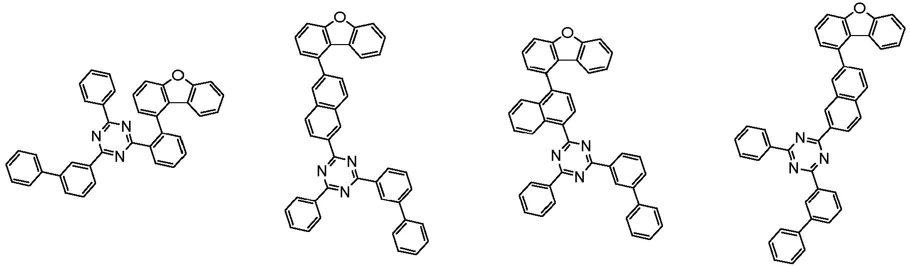

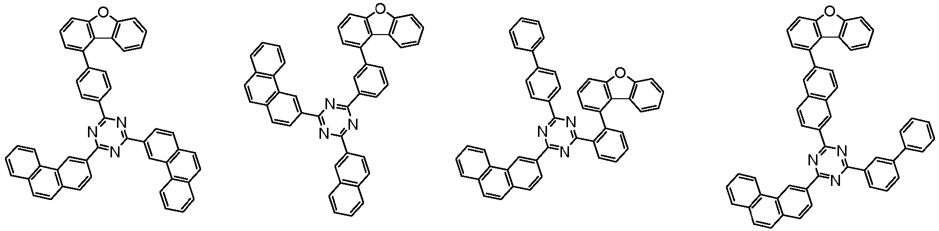

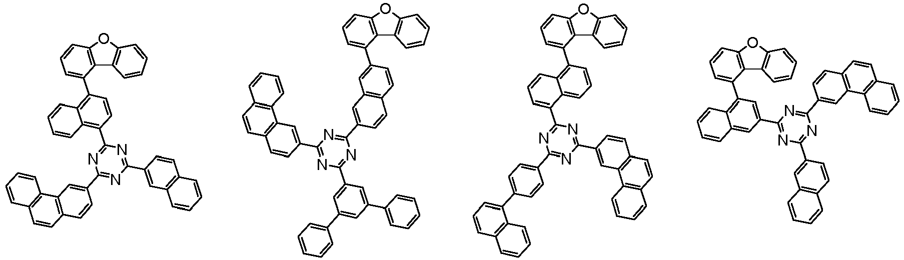

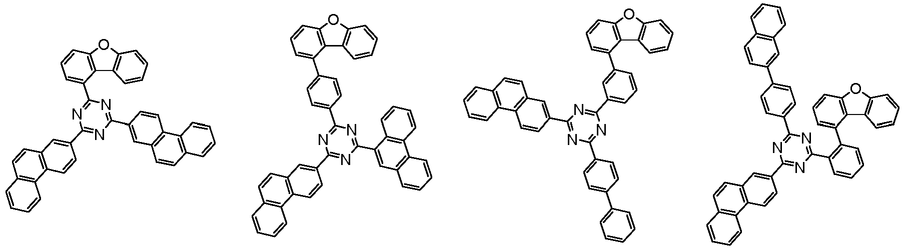

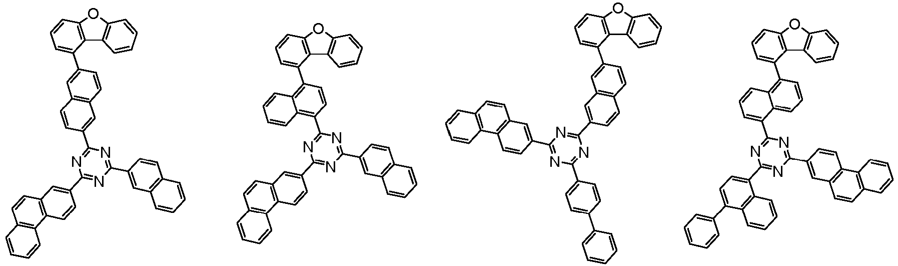

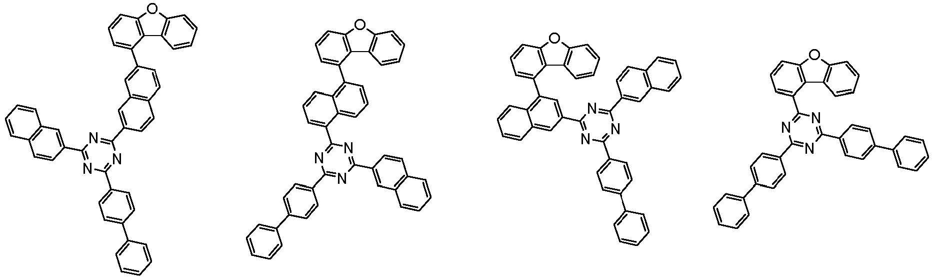

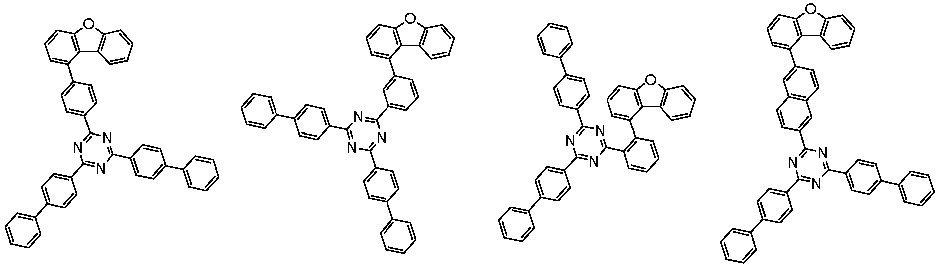

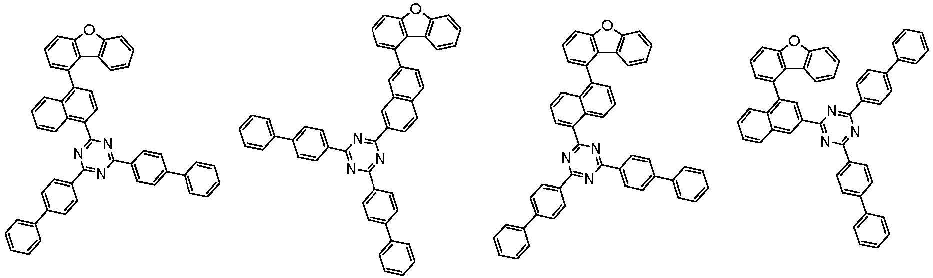

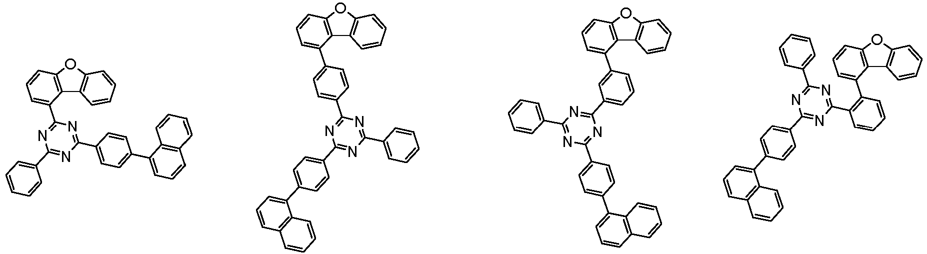

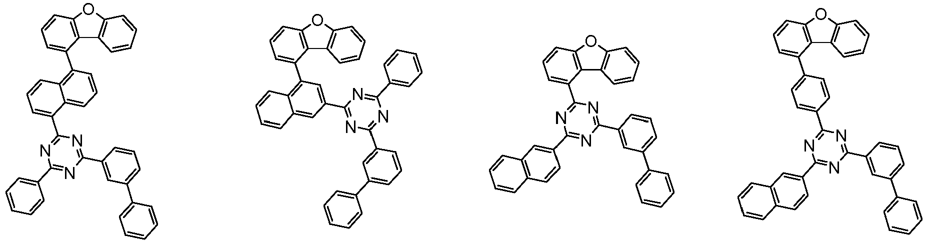

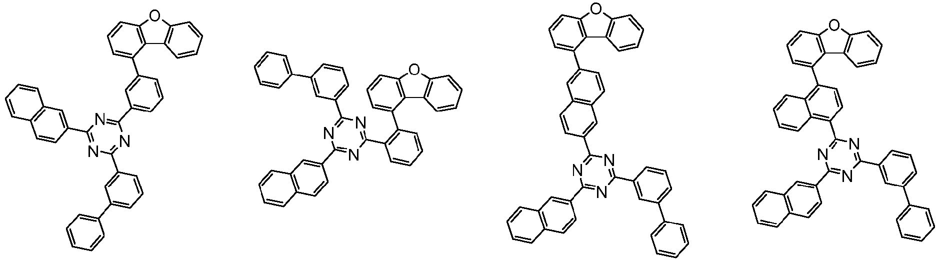

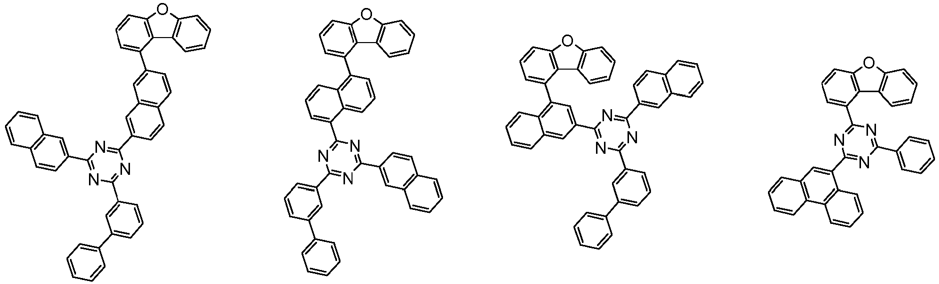

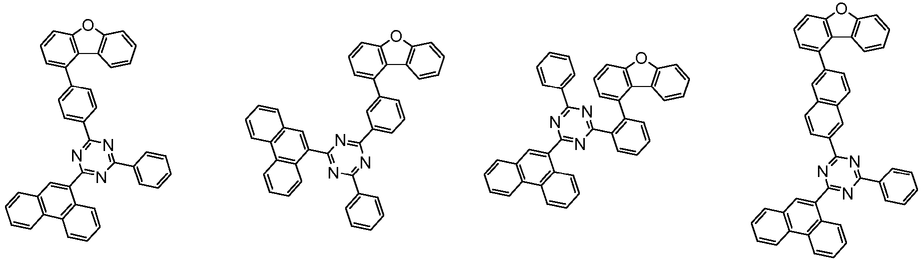

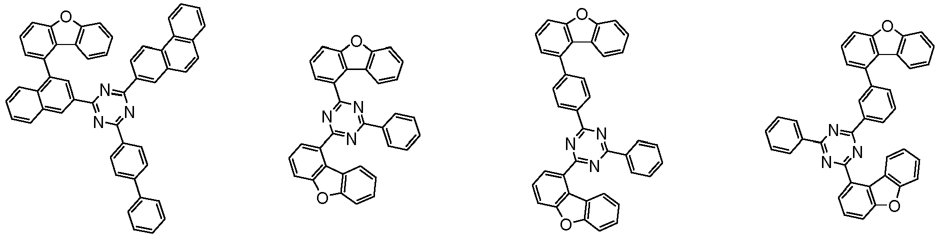

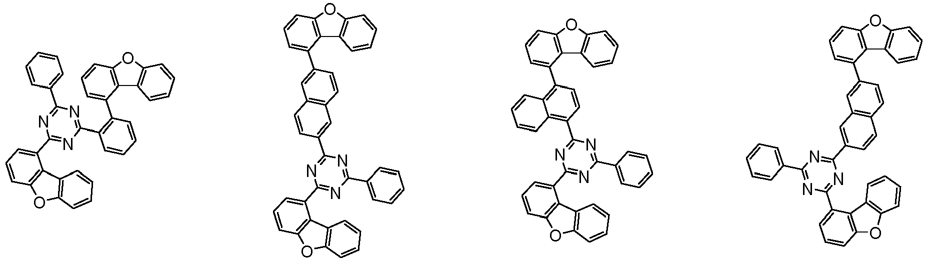

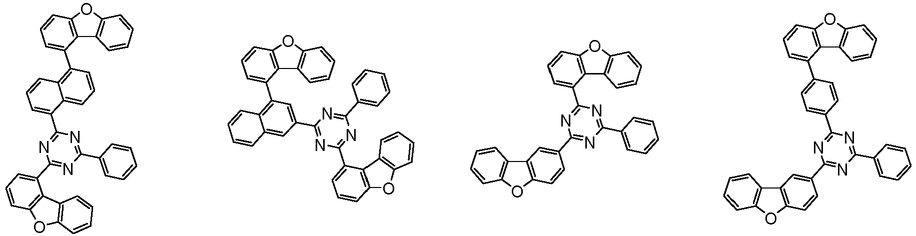

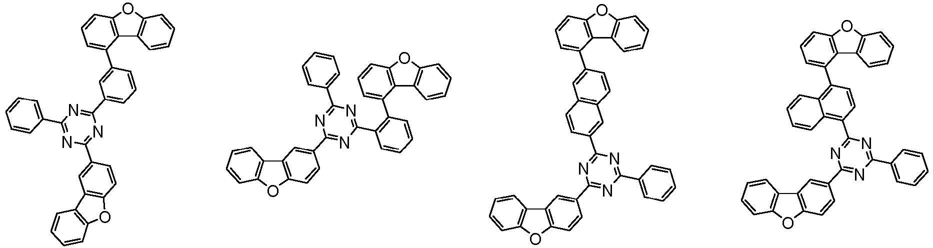

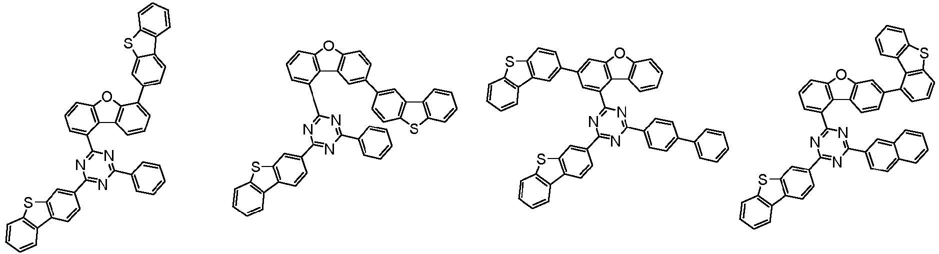

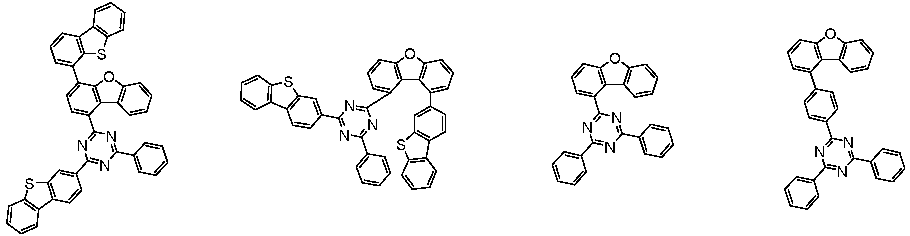

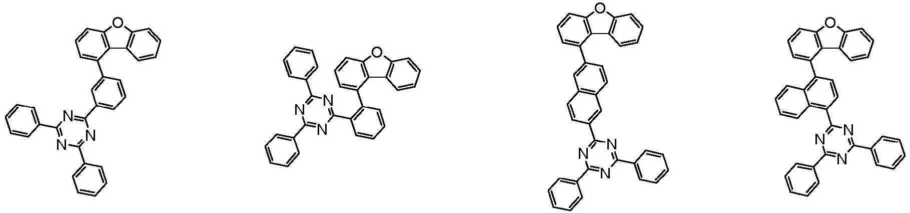

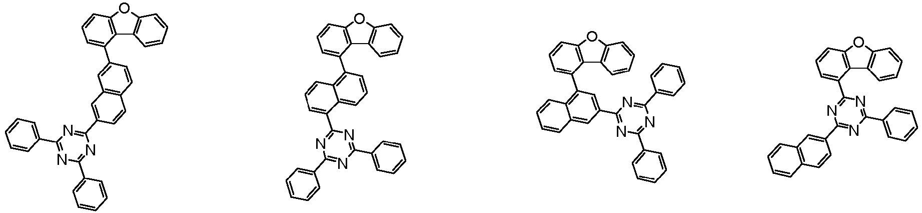

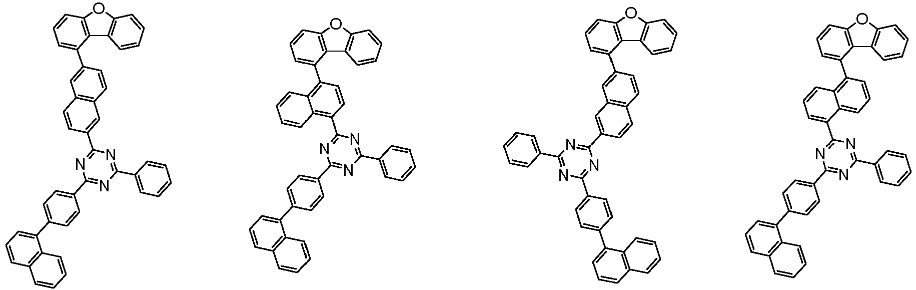

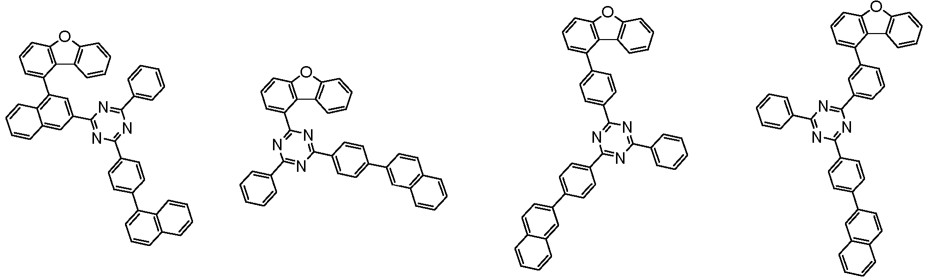

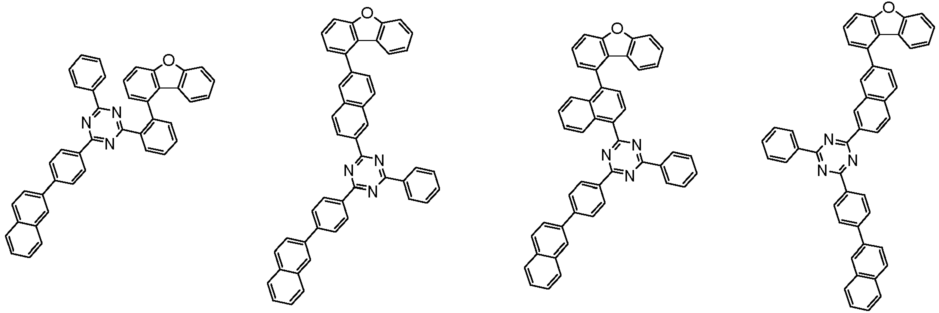

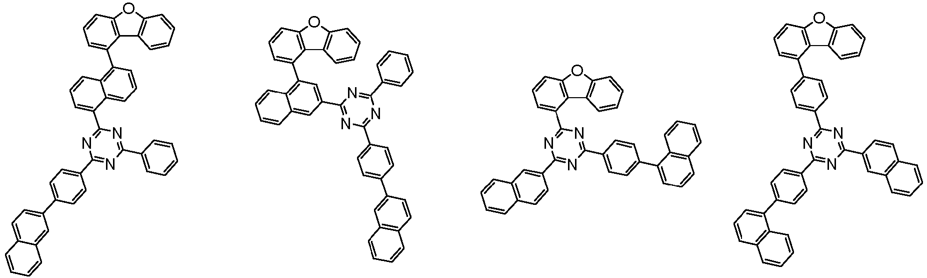

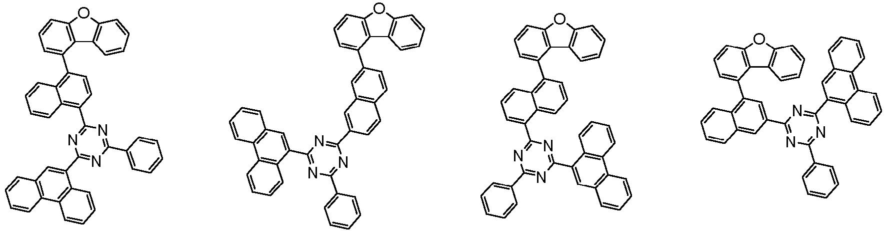

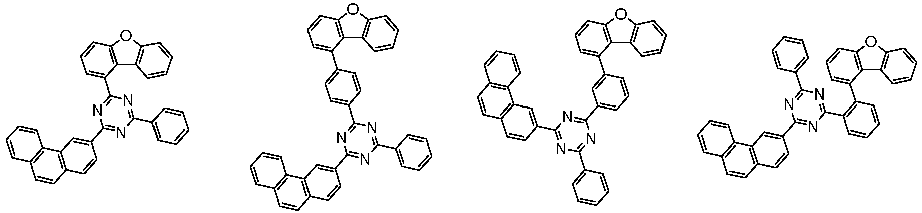

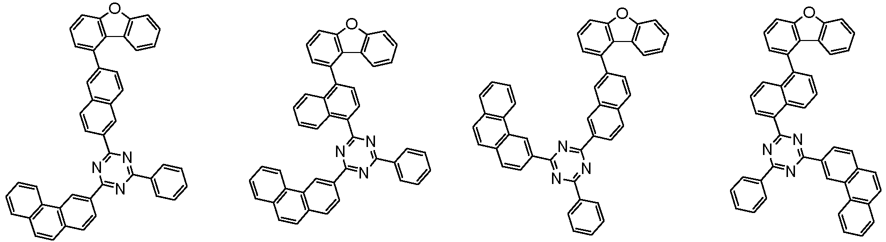

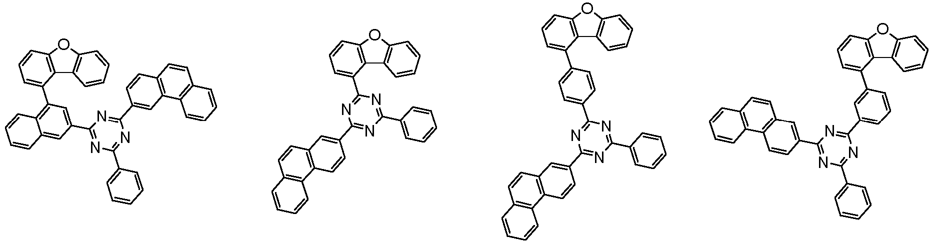

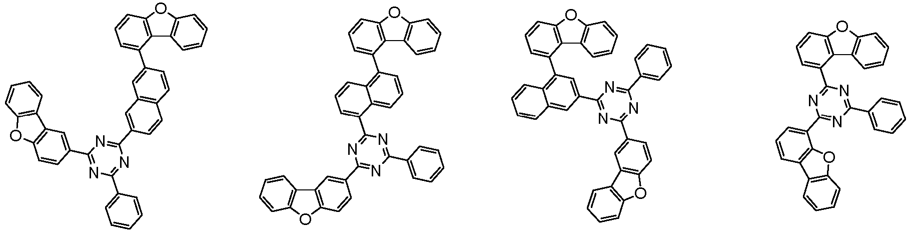

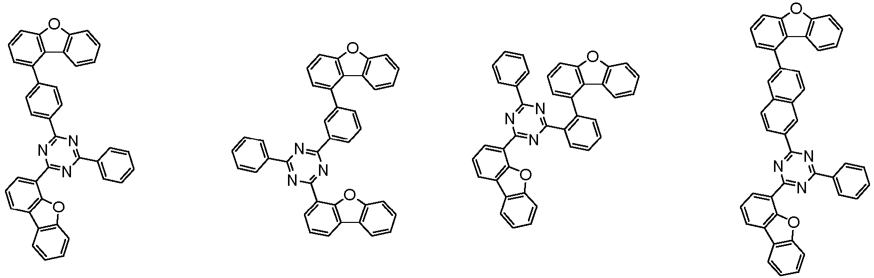

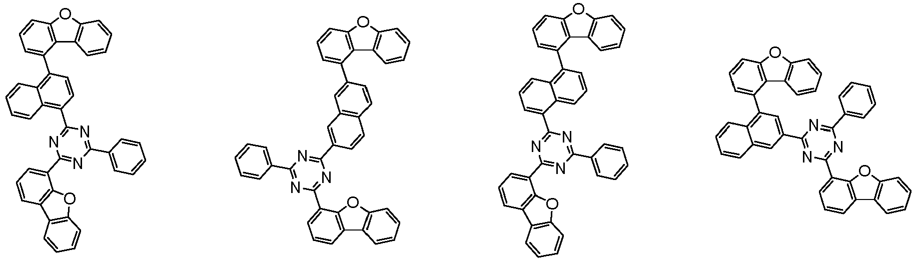

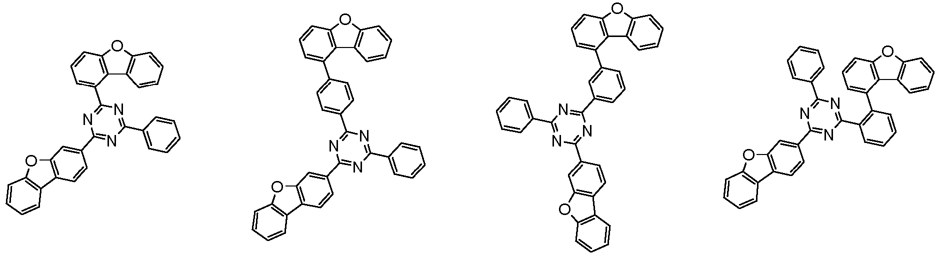

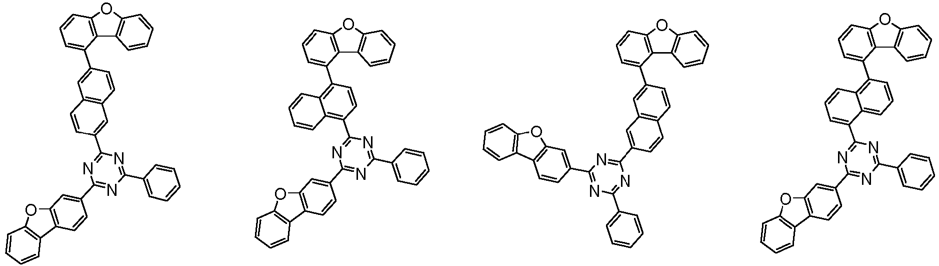

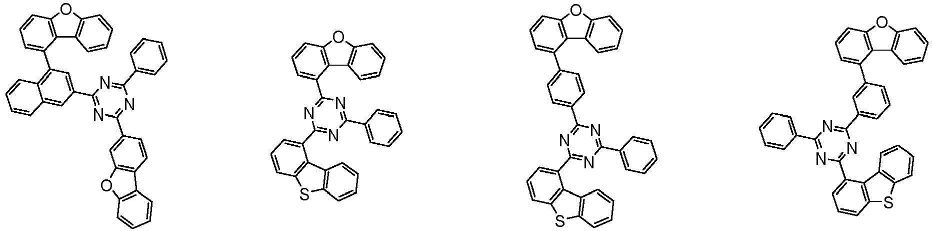

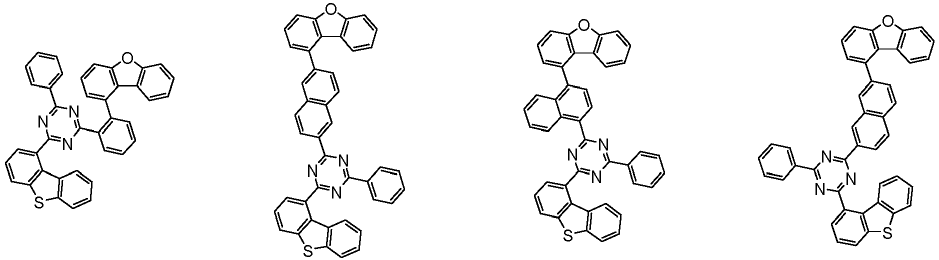

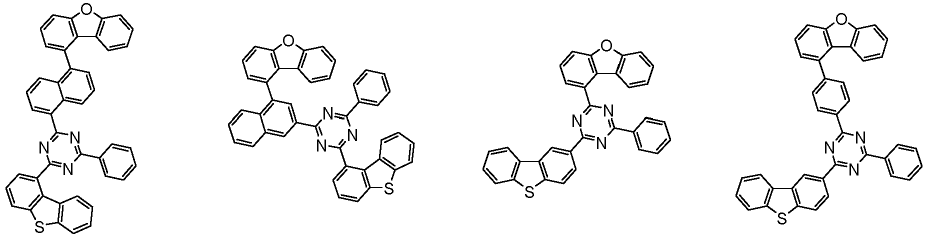

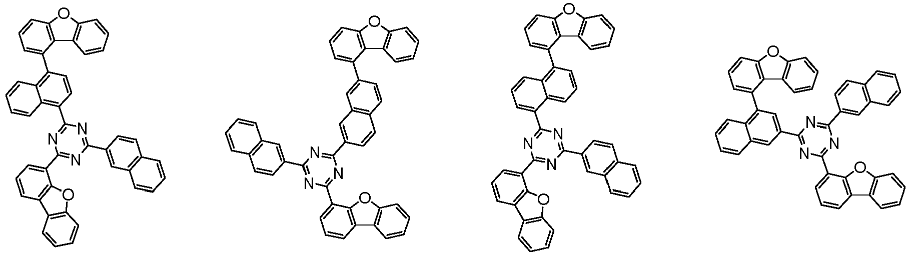

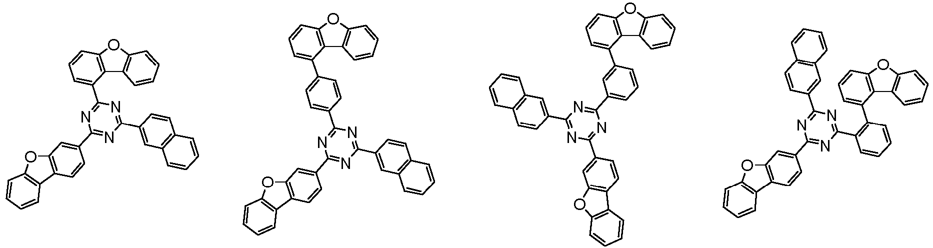

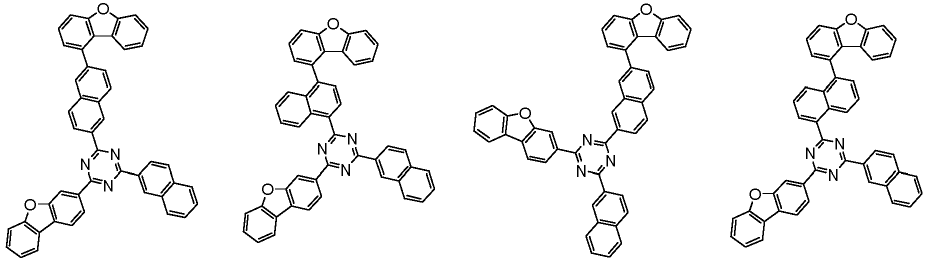

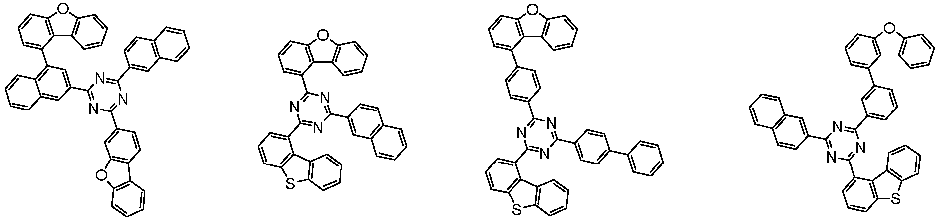

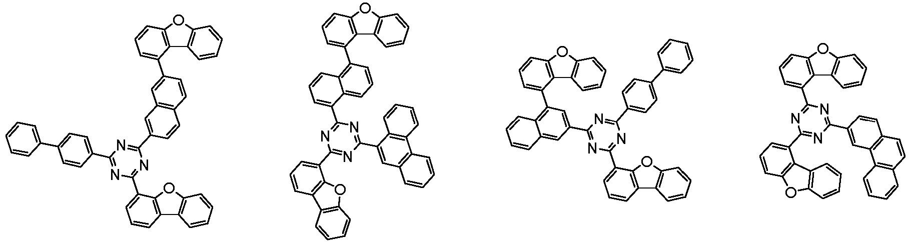

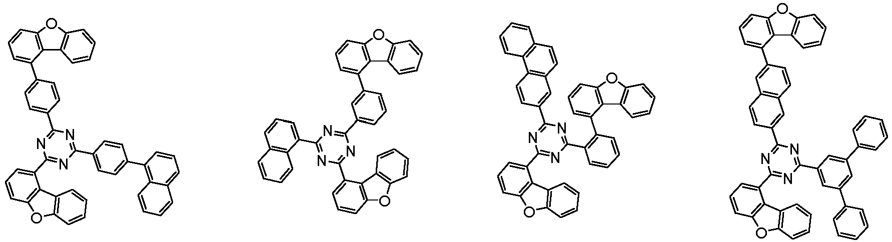

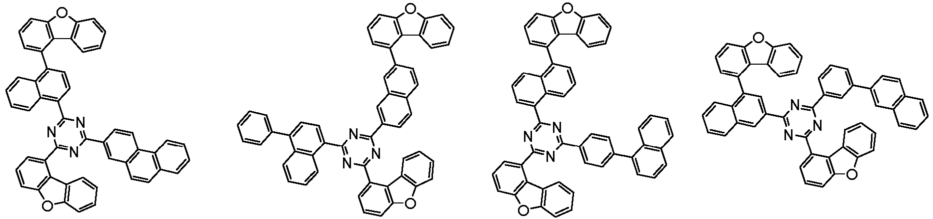

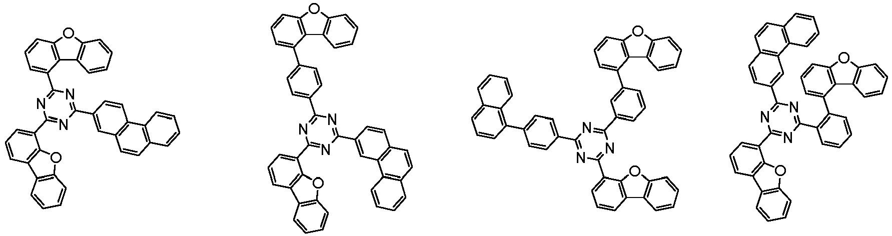

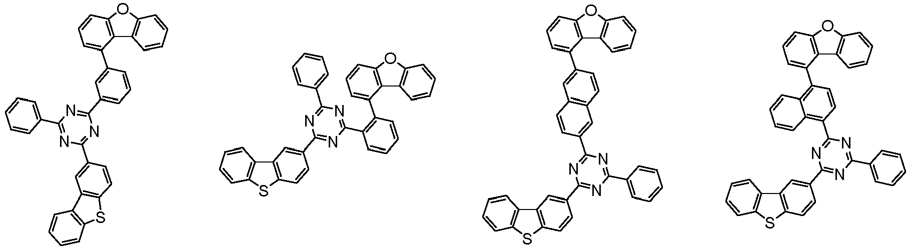

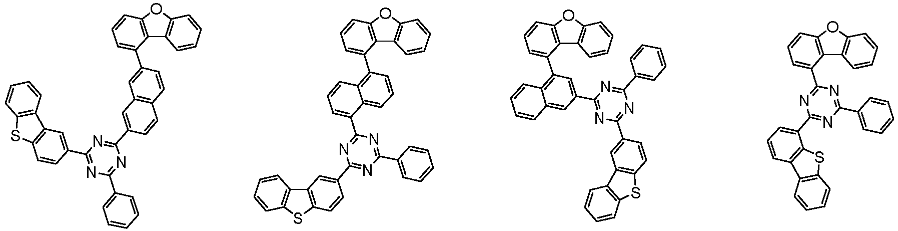

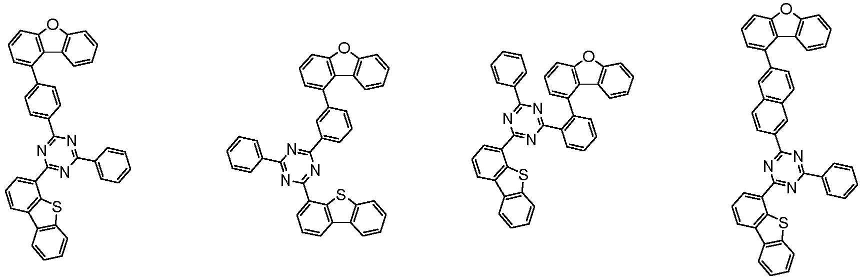

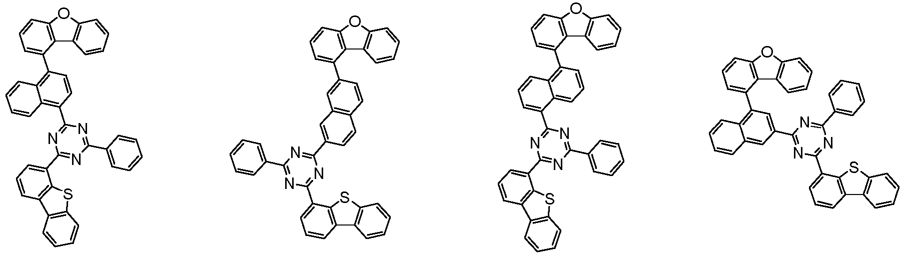

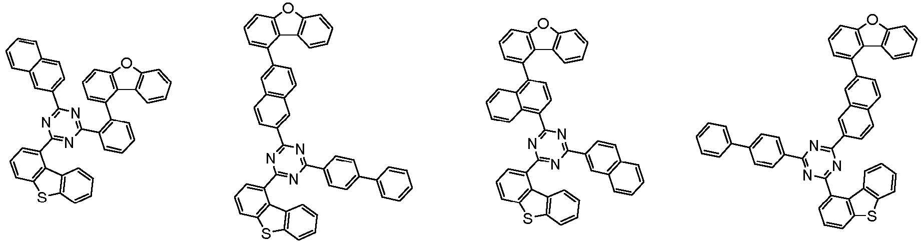

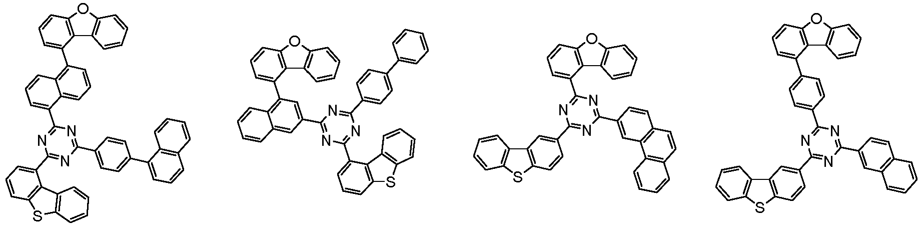

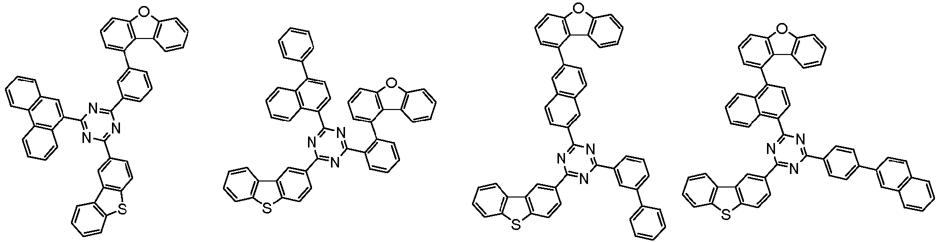

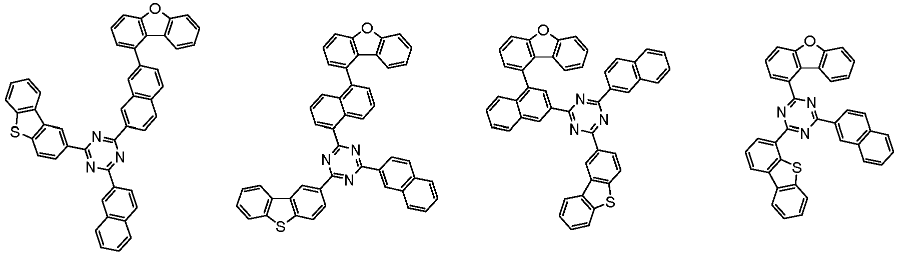

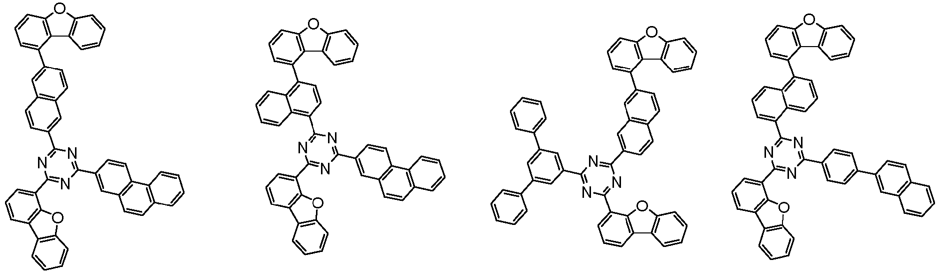

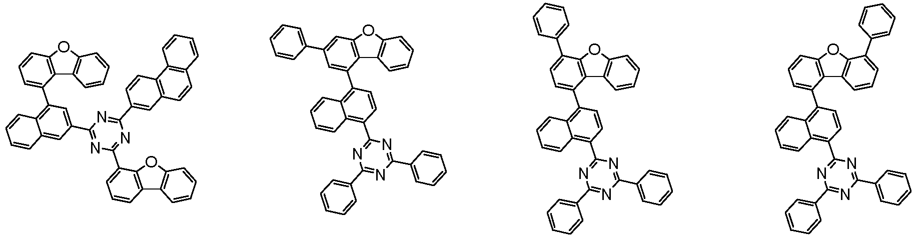

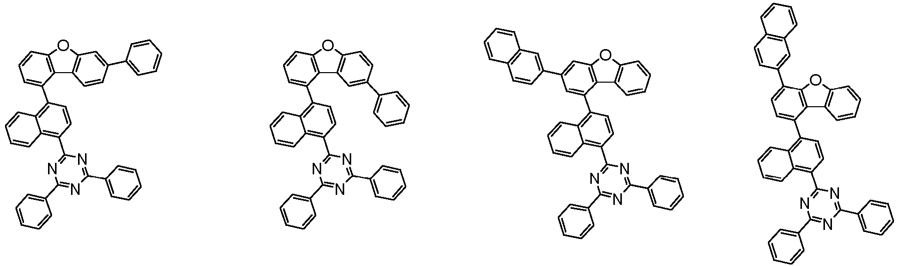

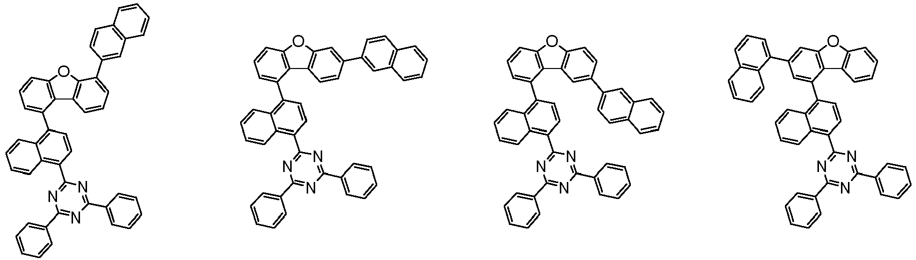

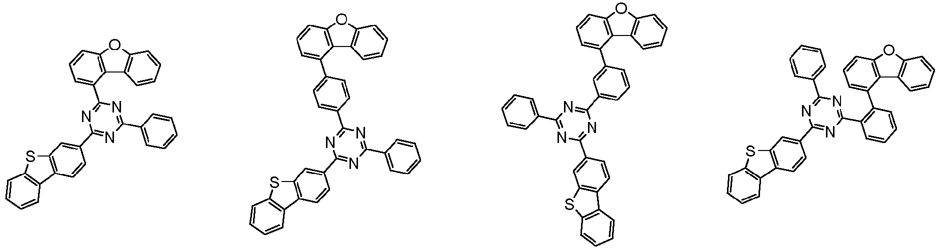

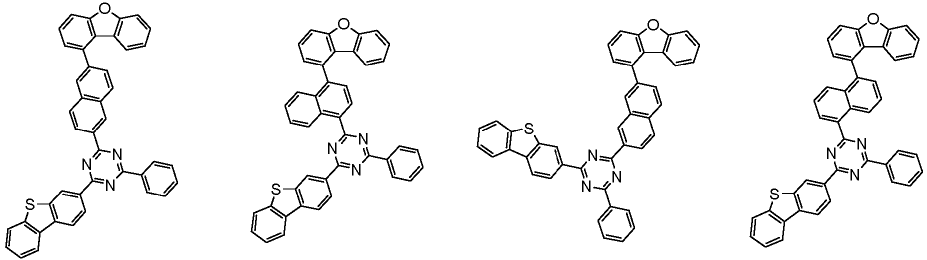

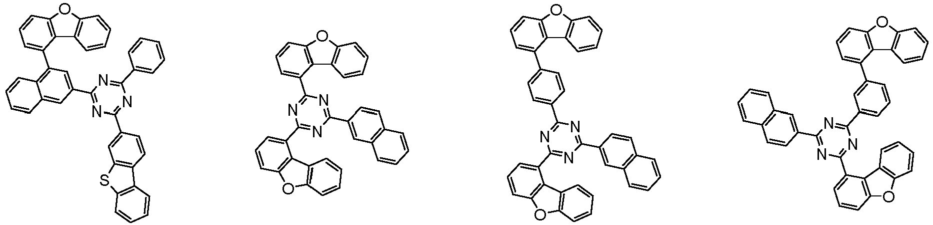

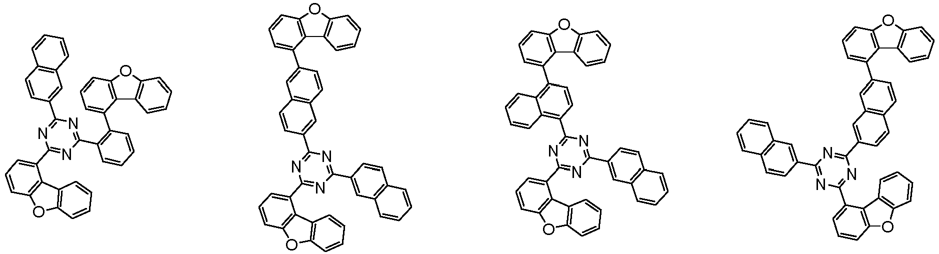

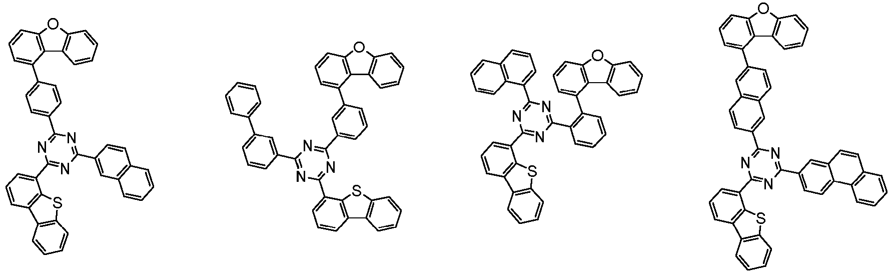

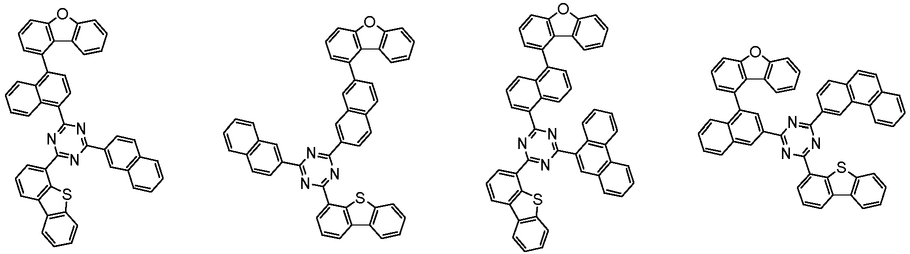

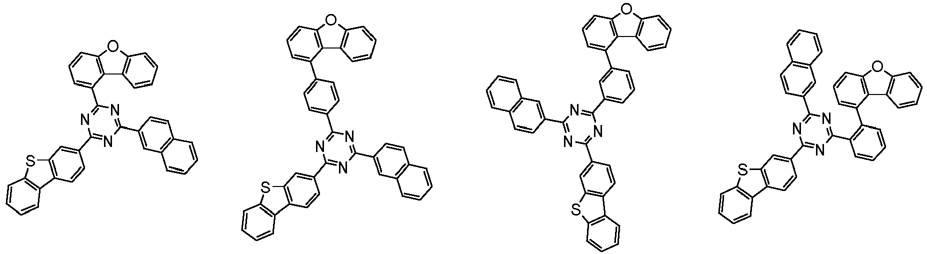

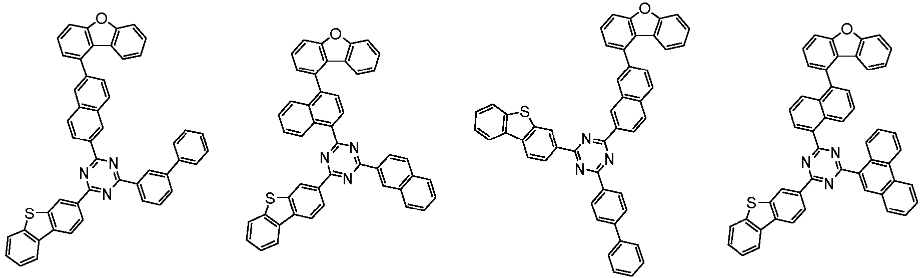

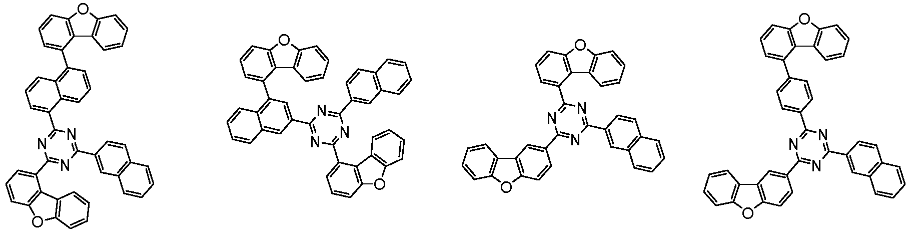

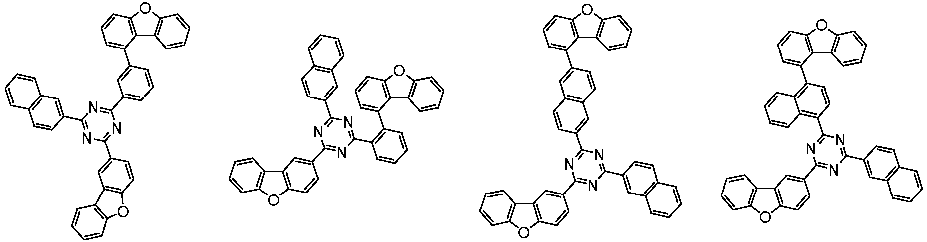

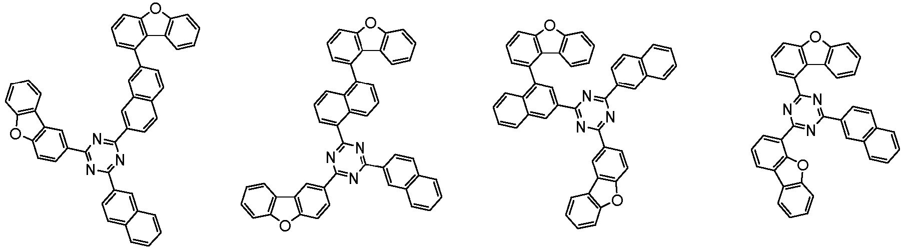

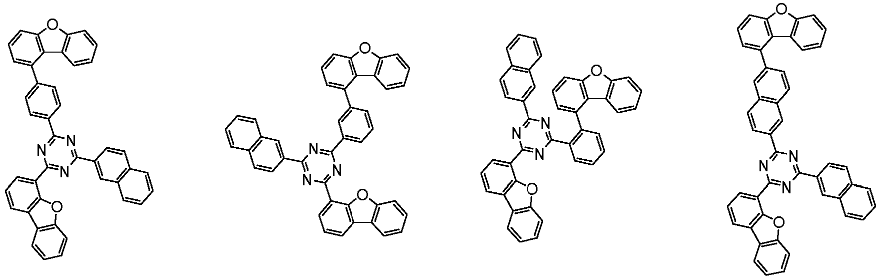

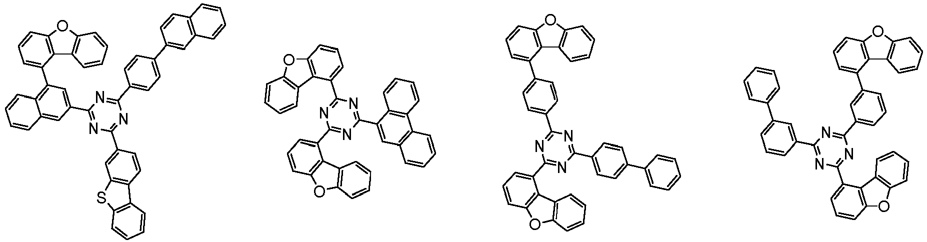

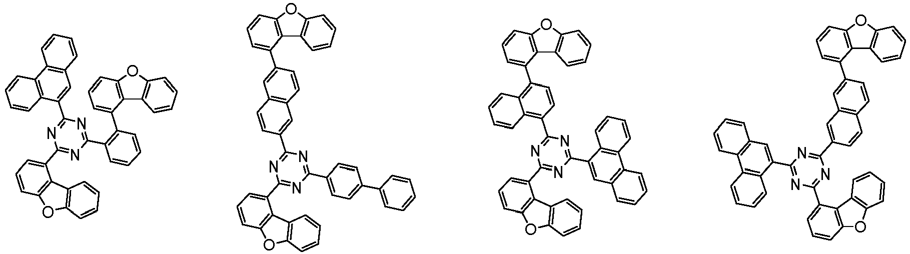

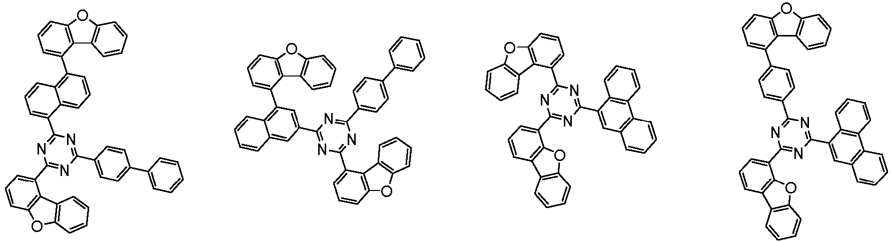

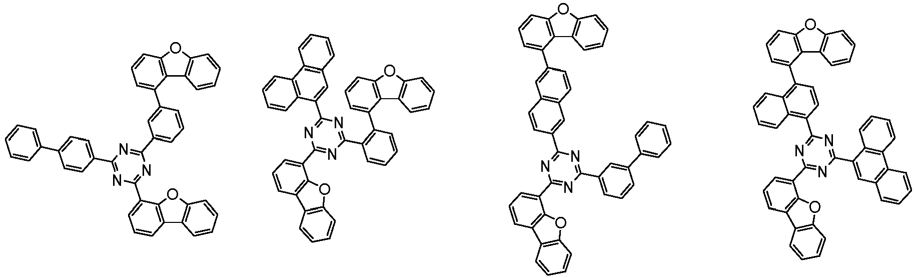

7. Organische lichtemittierende Vorrichtung gemäß Anspruch 1,
wobei die chemische Formel 2 dargestellt wird durch eine der folgenden chemischen Formeln 2-1 bis 2-4: 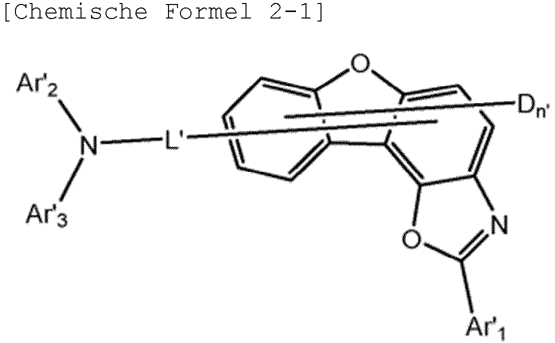 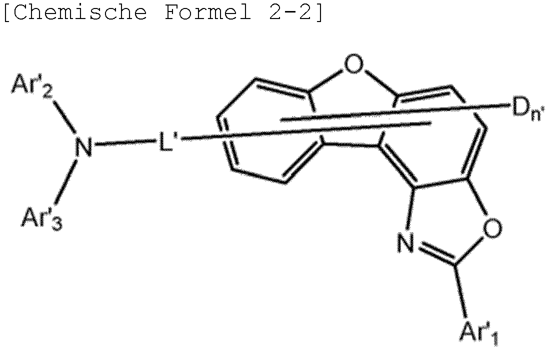 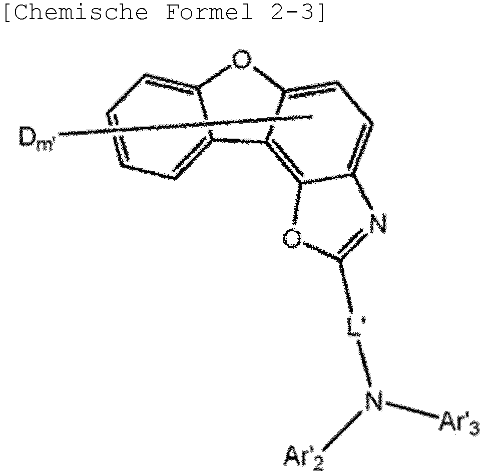 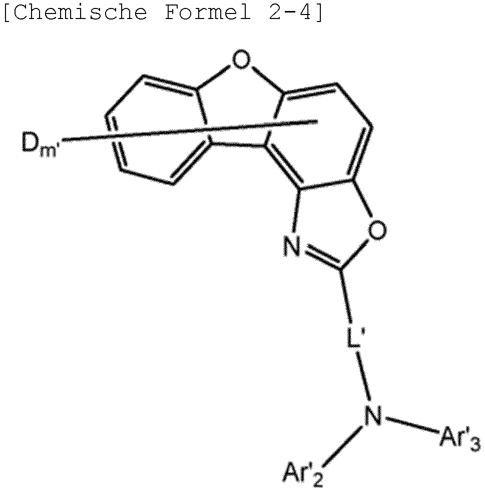 worin in den chemischen Formeln 2-1 bis 2-4
L', Ar'₁ bis Ar'₃, D und n' wie in Anspruch 1 definiert sind und m' eine ganze Zahl von 0 bis 6 ist.

8. Organische lichtemittierende Vorrichtung gemäß Anspruch 1,
worin L' eine Einfachbindung, Phenylen oder Biphenyldiyl ist.

9. Organische lichtemittierende Vorrichtung gemäß Anspruch 1, worin Ar'₁ Phenyl ist.

10. Organische lichtemittierende Vorrichtung gemäß Anspruch 1, worin Ar'₂ und Ar'₃ jeweils unabhängig Phenyl, Biphenylyl, Terphenylyl, Naphthyl, (Naphthyl)phenyl, (Phenyl)naphthyl, (Naphthyl)biphenylyl, (Naphthyl)naphthyl, [(Phenyl)naphthyl]phenyl, Dibenzofuranyl, Dibenzothiophenyl, (Dibenzofuranyl)phenyl, (Dibenzothiophenyl)phenyl, Phenanthrenyl, (Phenanthrenyl)phenyl, 9,9-Dimethylfluorenyl oder 9-Phenylcarbazolyl sind.

11. Organische lichtemittierende Vorrichtung gemäß Anspruch 1, wobei die durch die chemische Formel 2 dargestellte Verbindung eine beliebige Verbindung ist, die ausgewählt ist aus einer Gruppe bestehend aus:

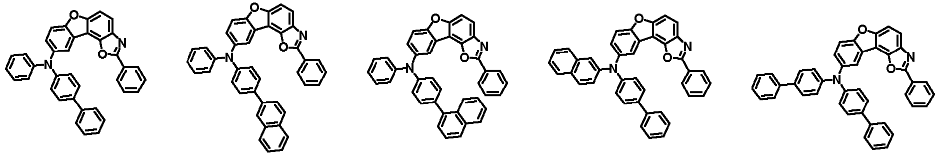

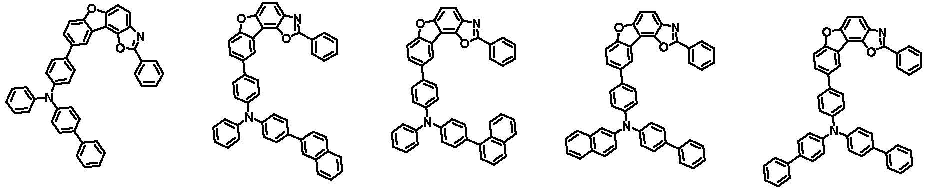

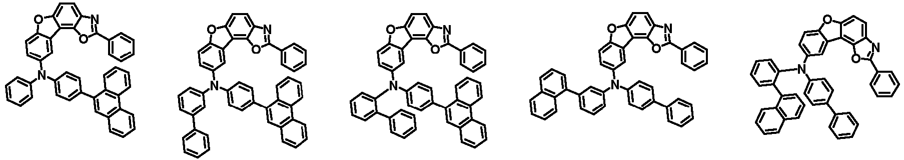

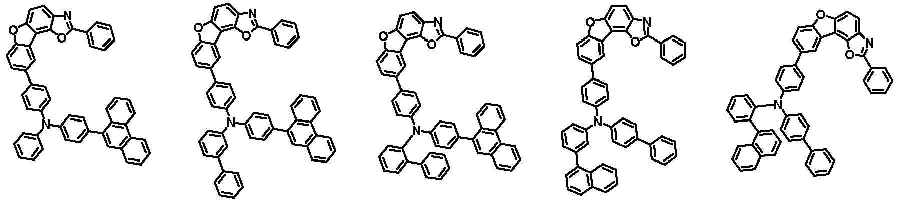

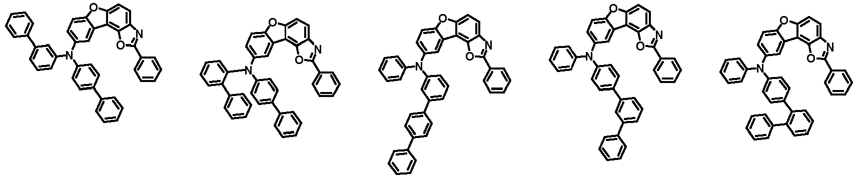

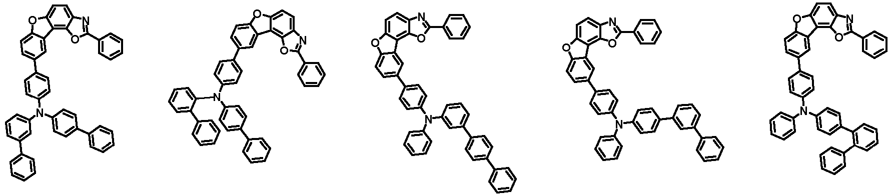

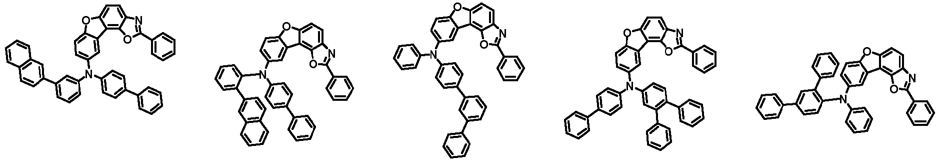

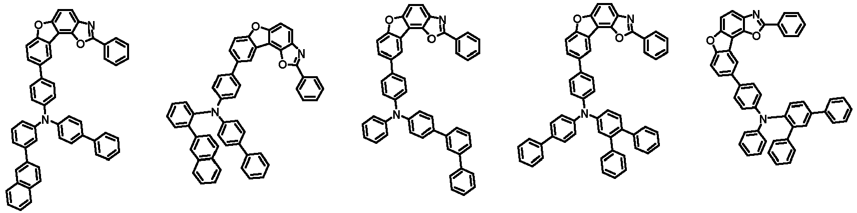

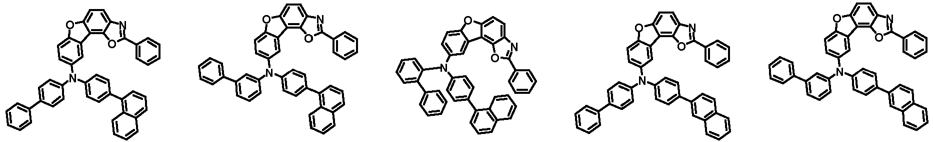

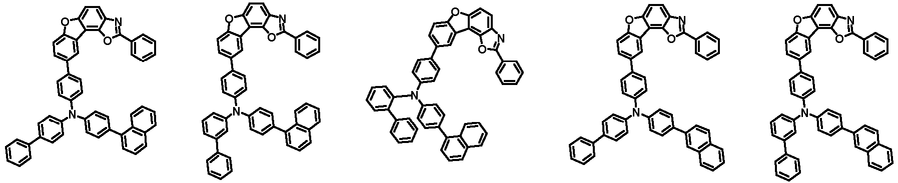

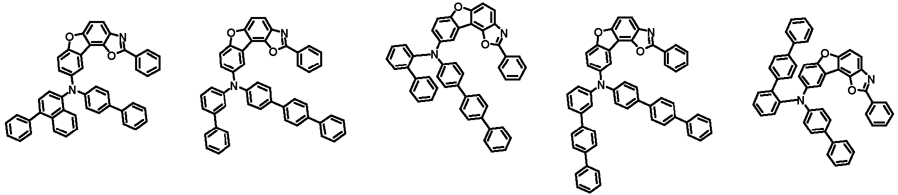

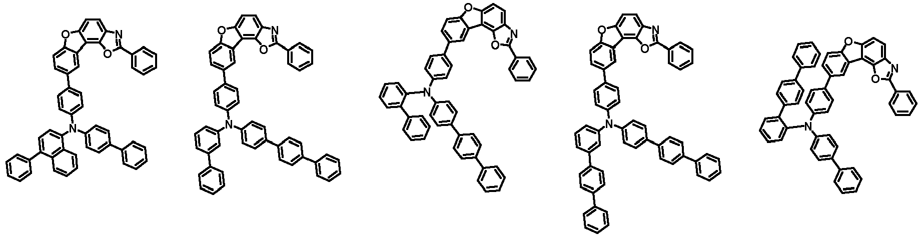

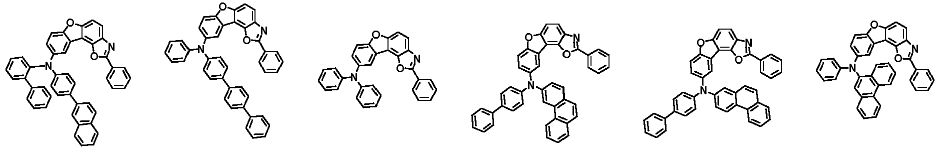

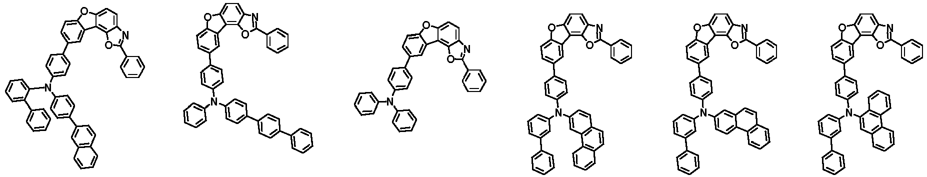

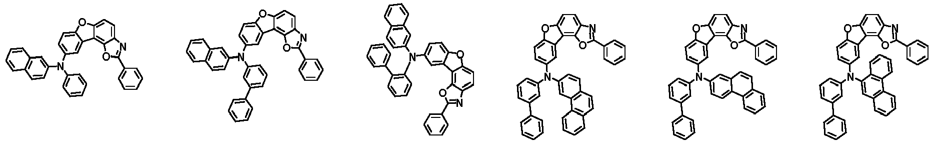

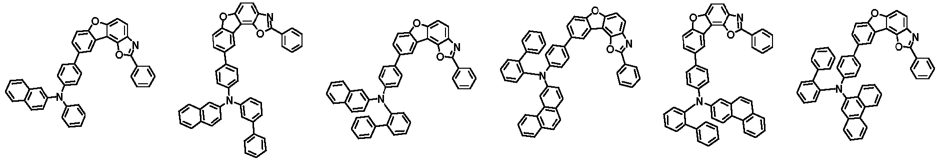

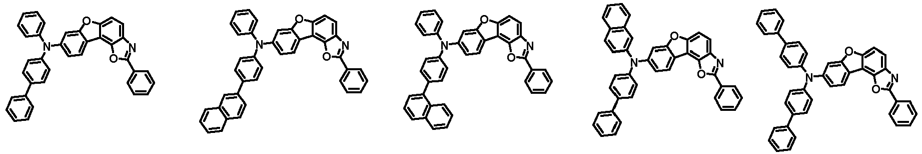

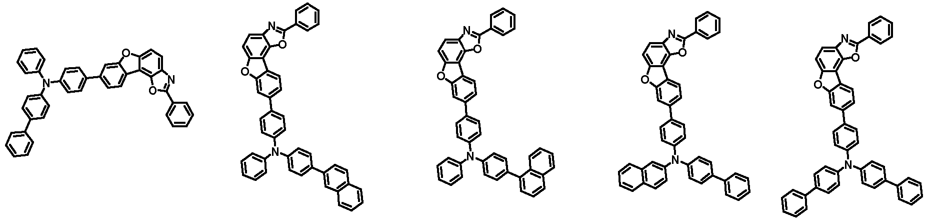

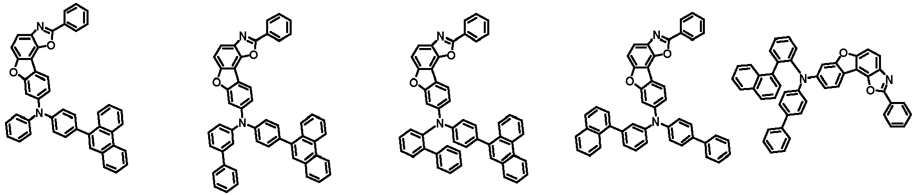

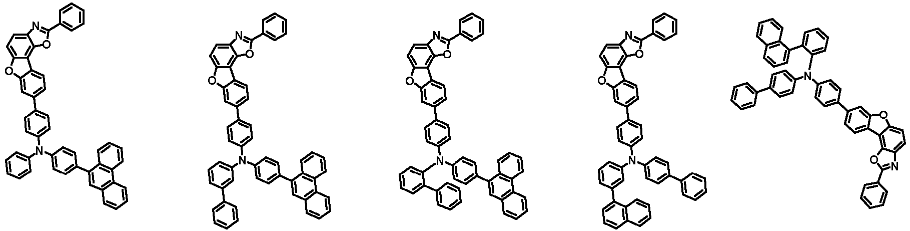

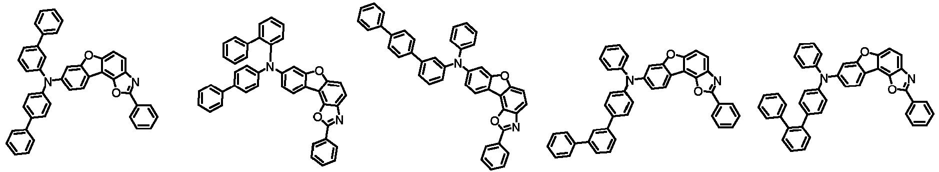

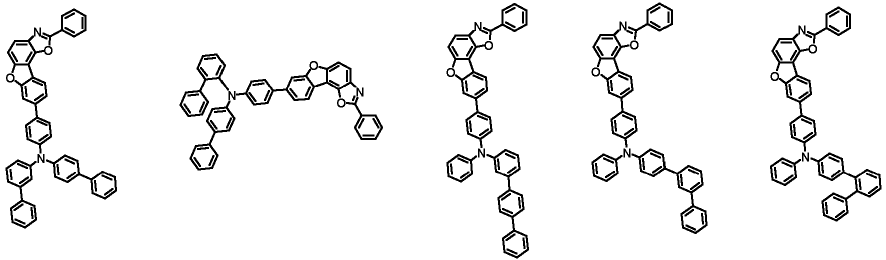

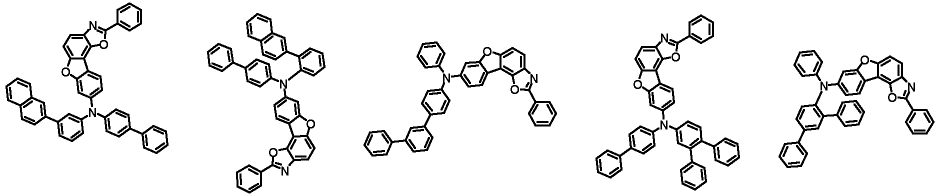

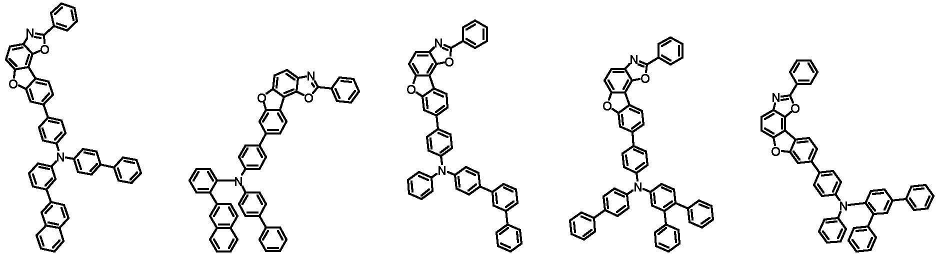

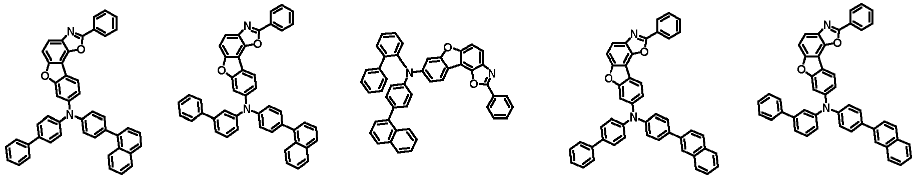

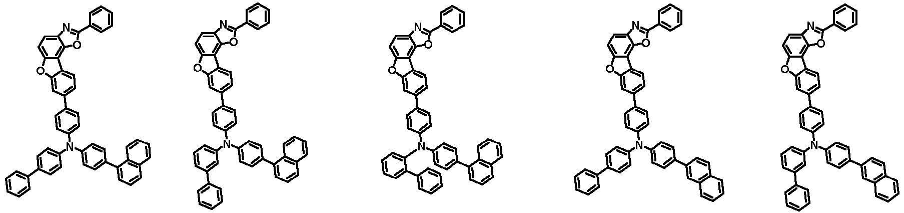

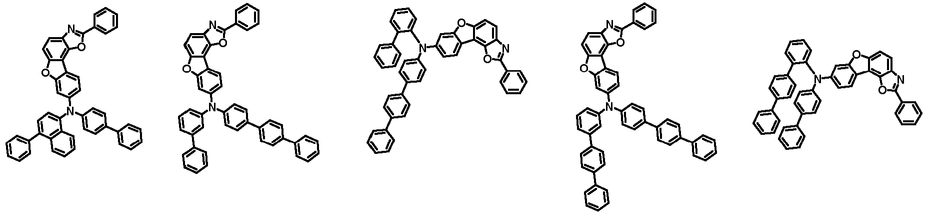

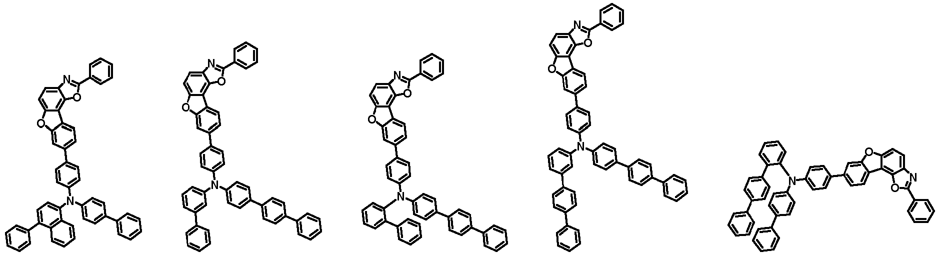

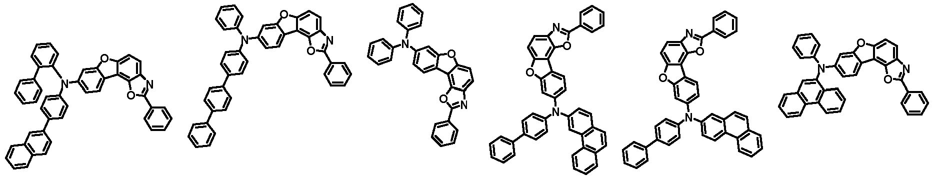

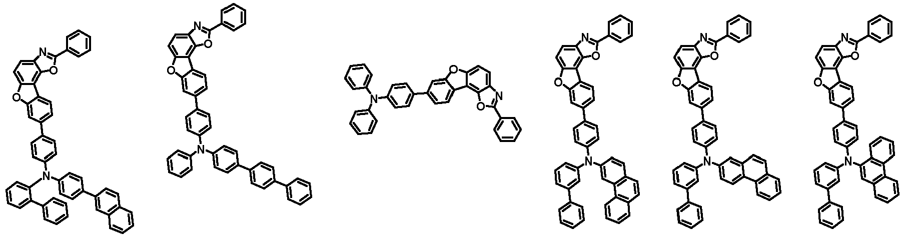

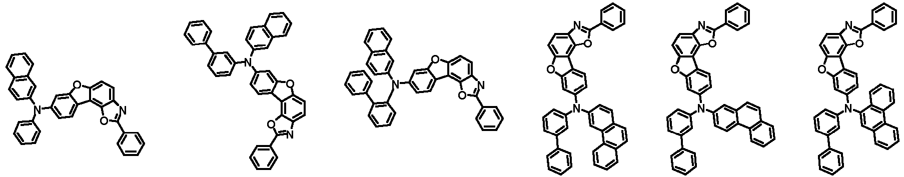

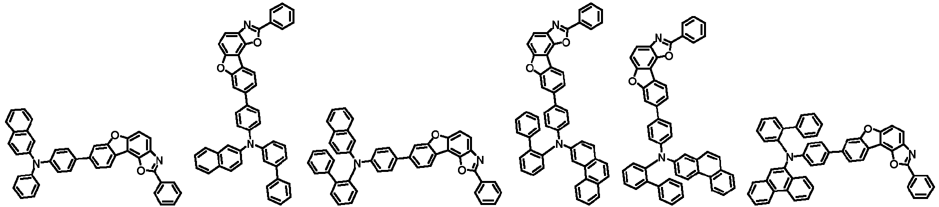

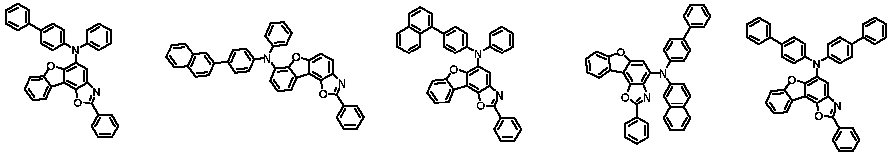

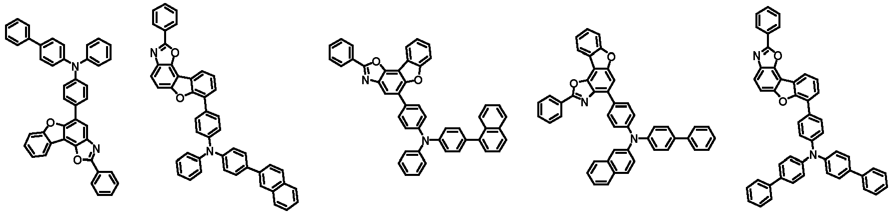

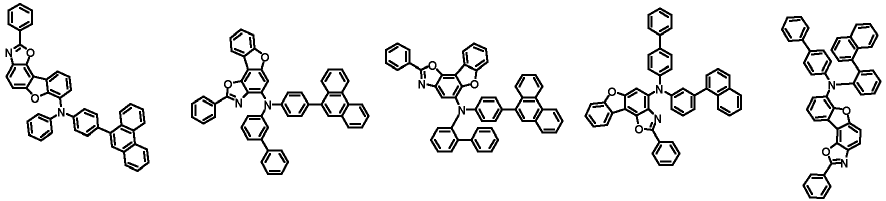

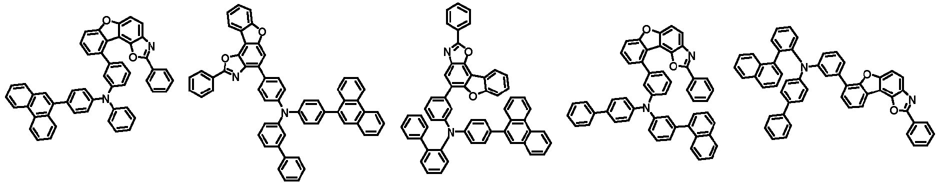

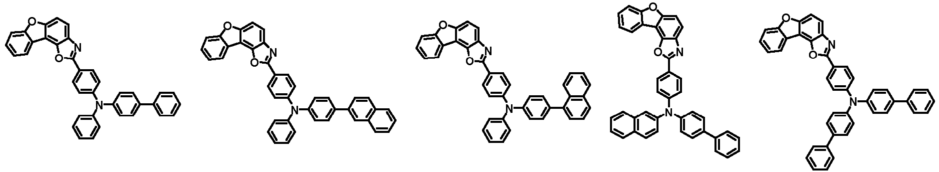

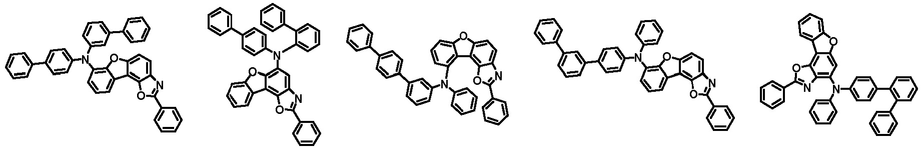

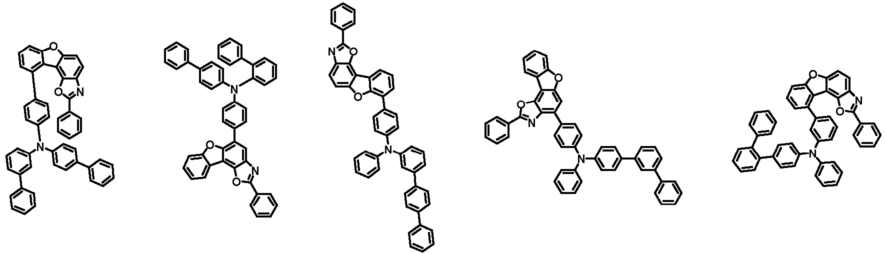

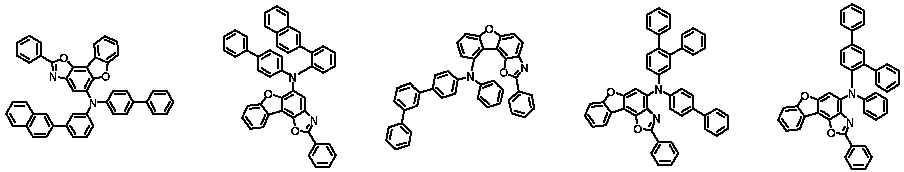

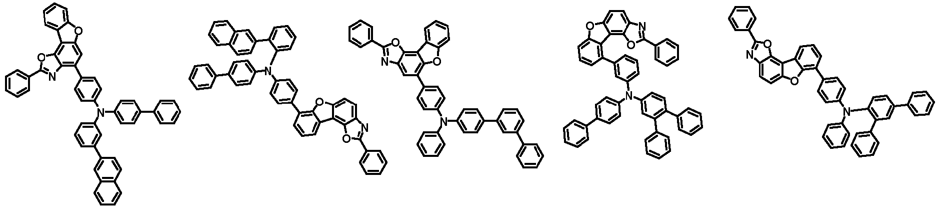

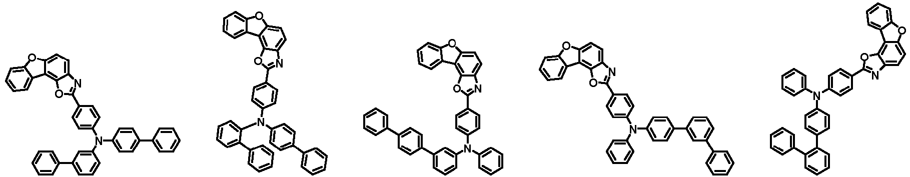

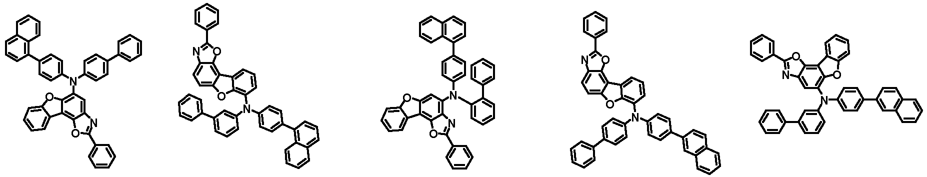

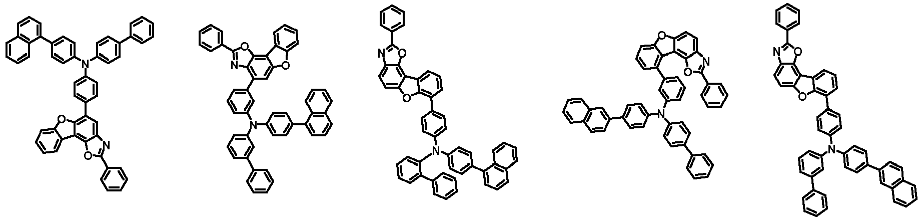

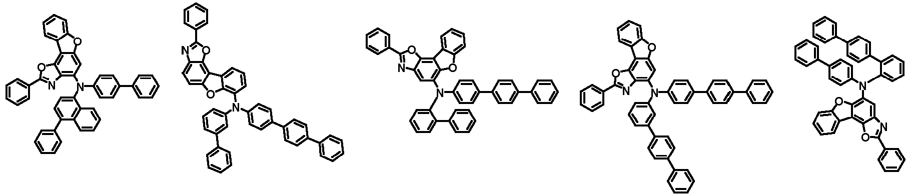

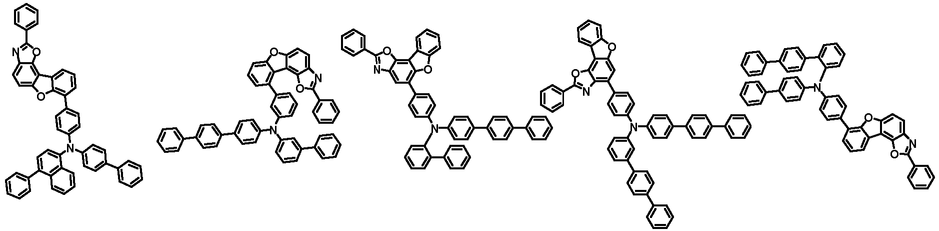

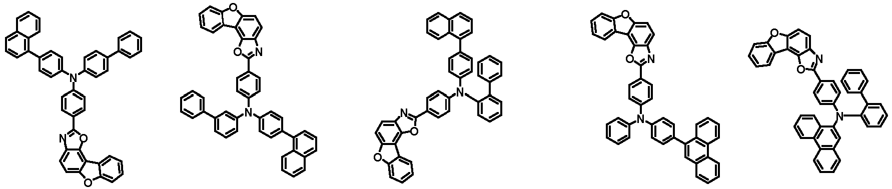

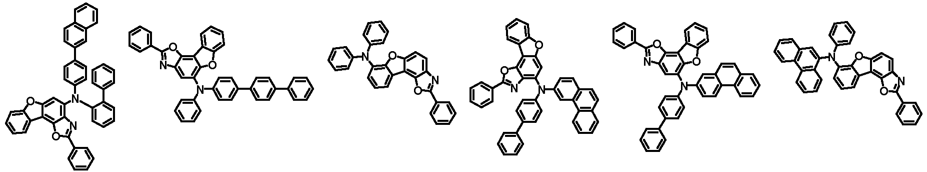

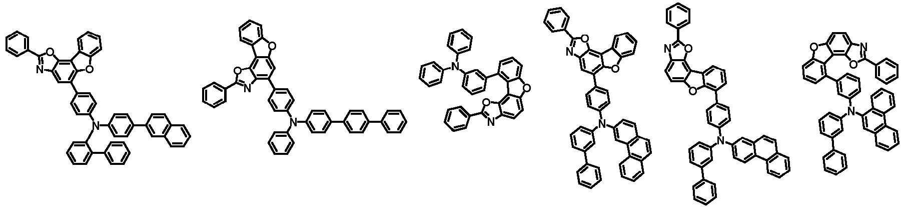

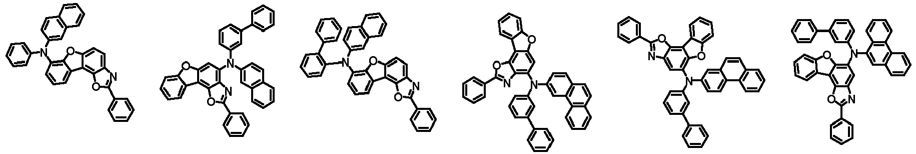

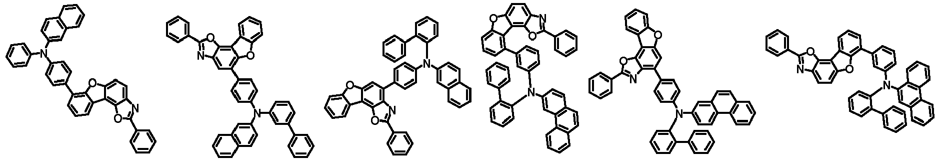

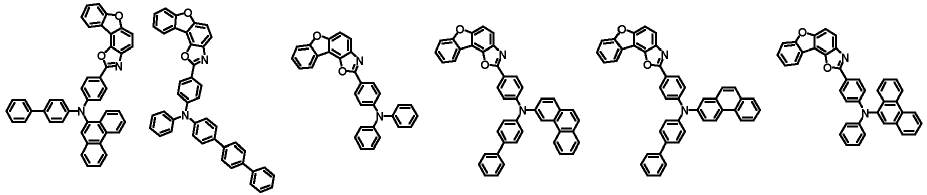

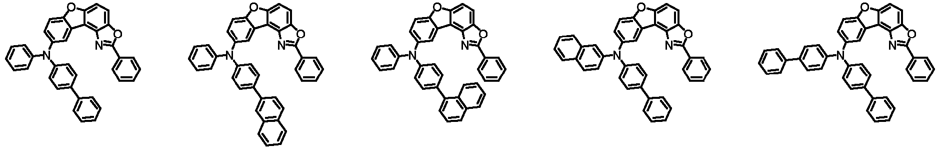

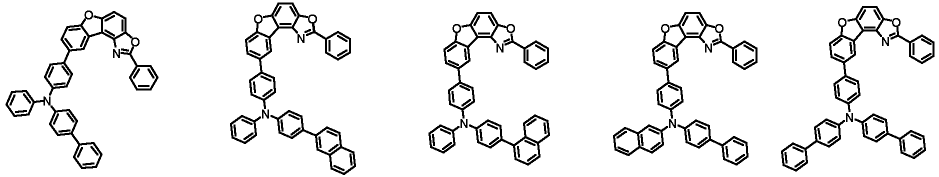

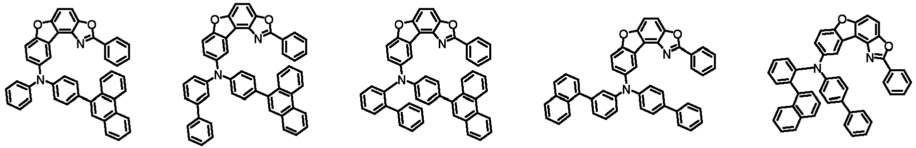

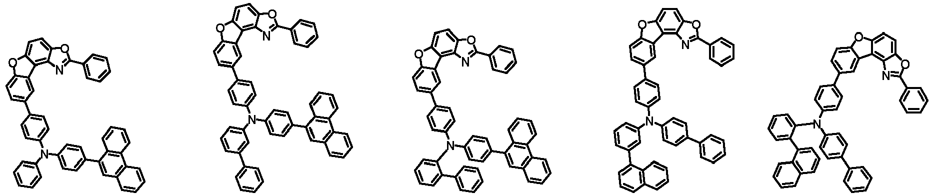

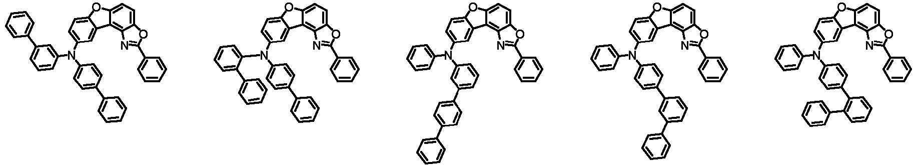

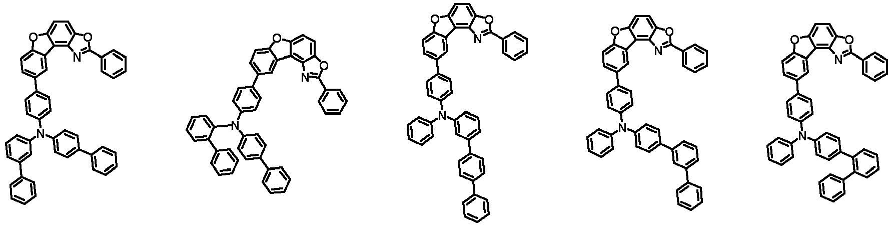

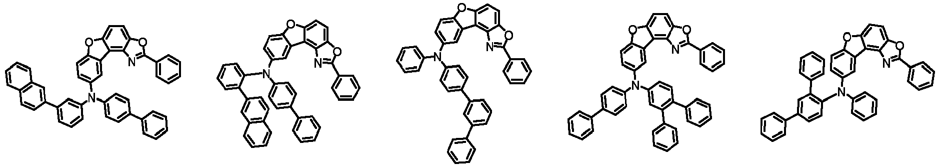

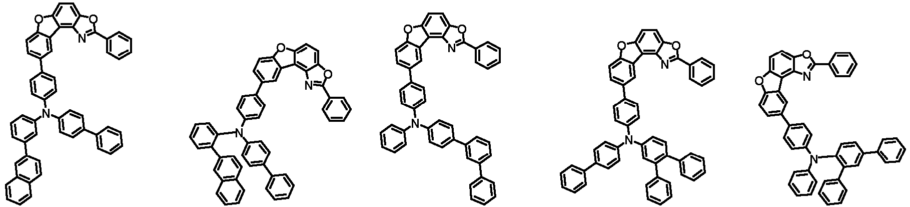

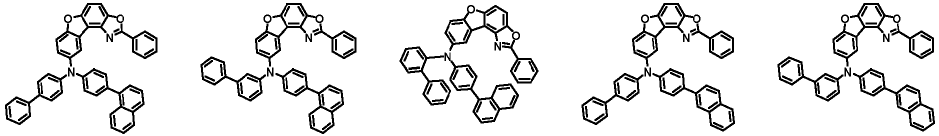

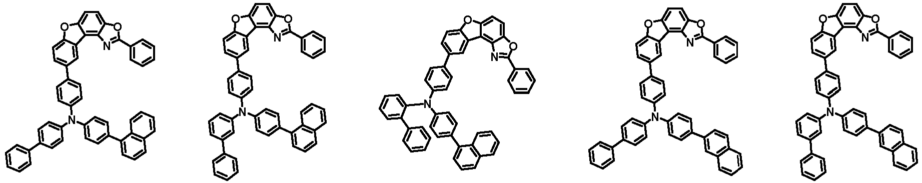

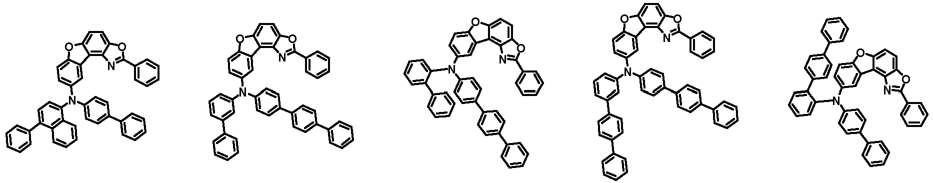

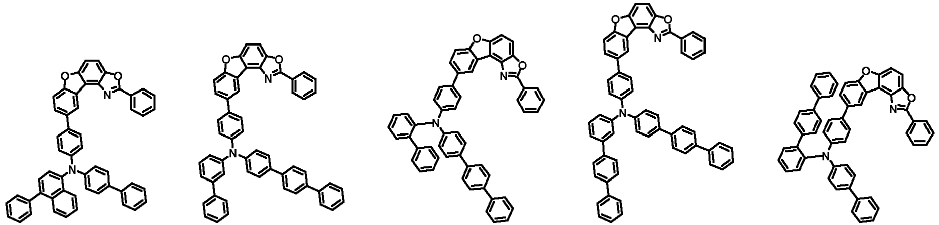

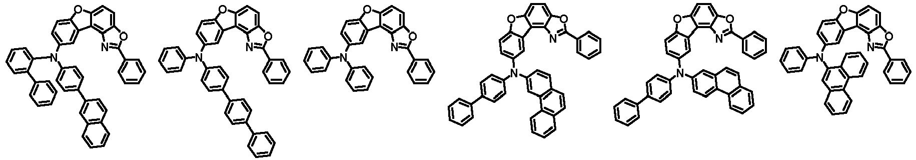

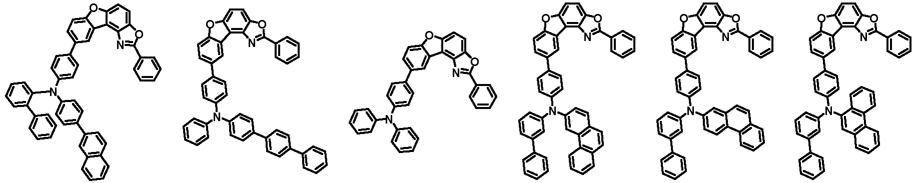

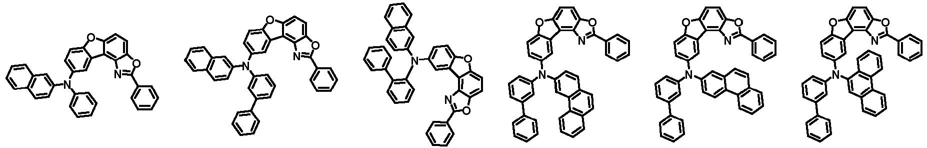

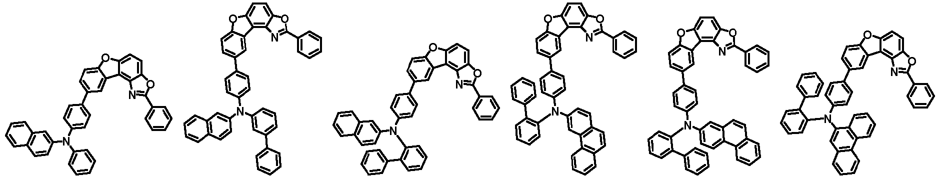

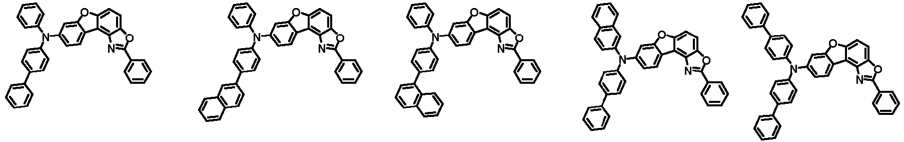

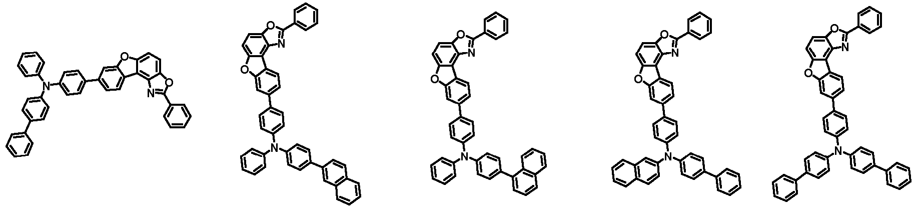

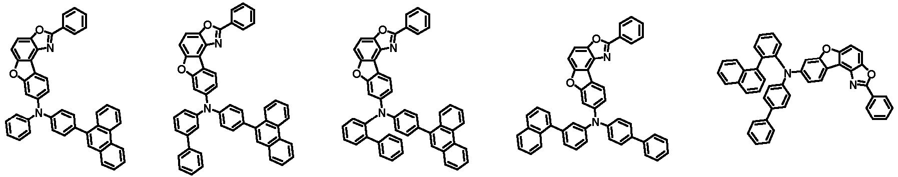

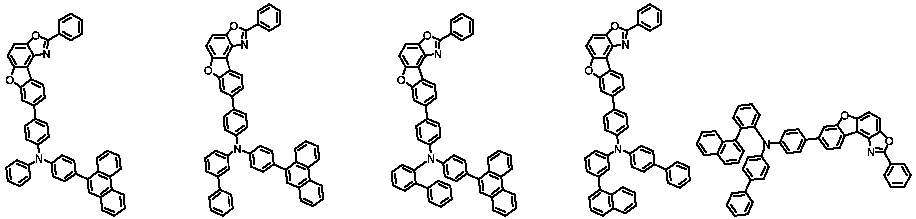

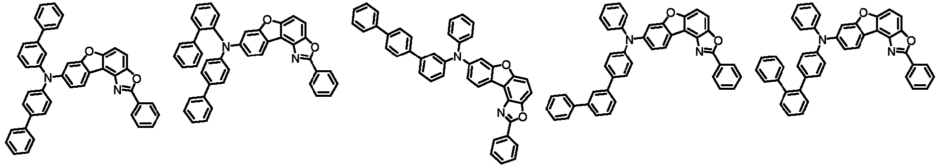

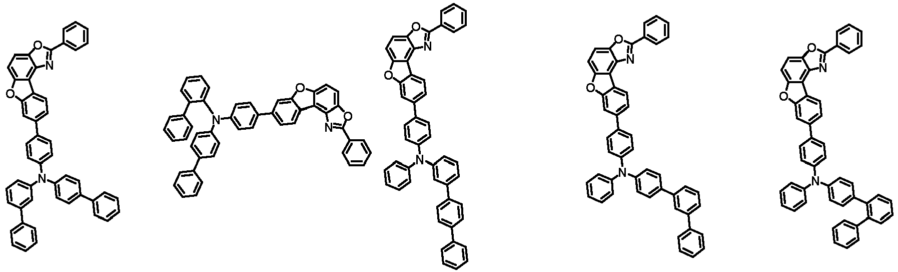

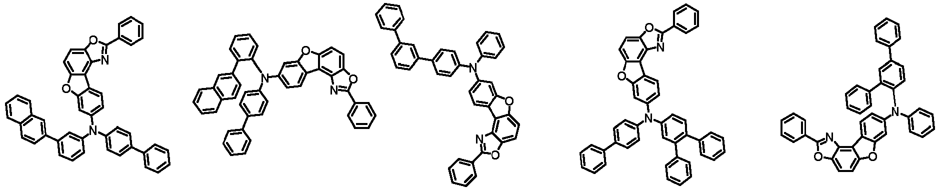

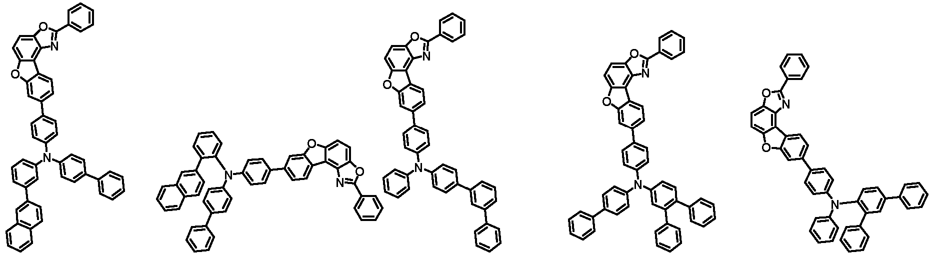

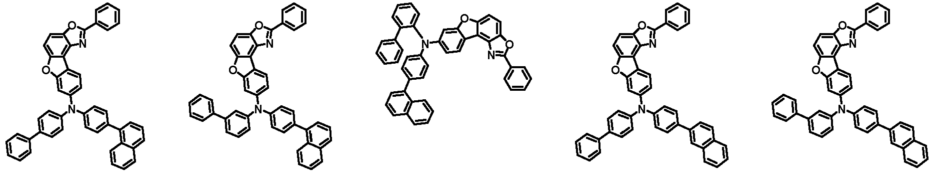

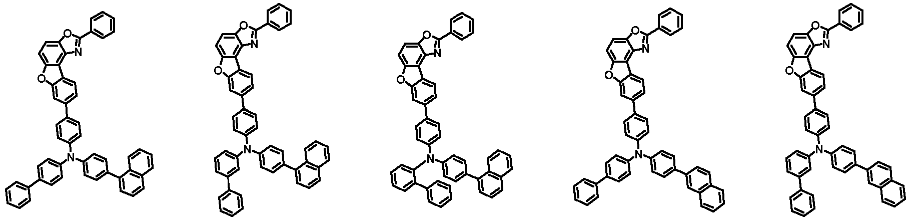

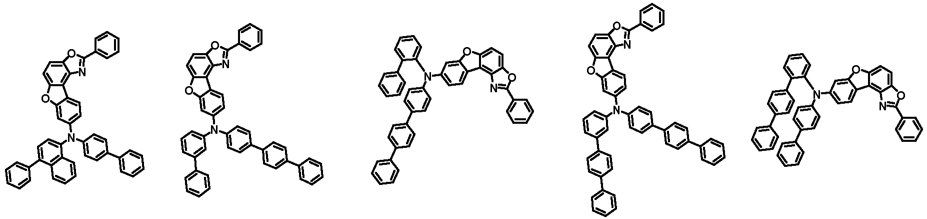

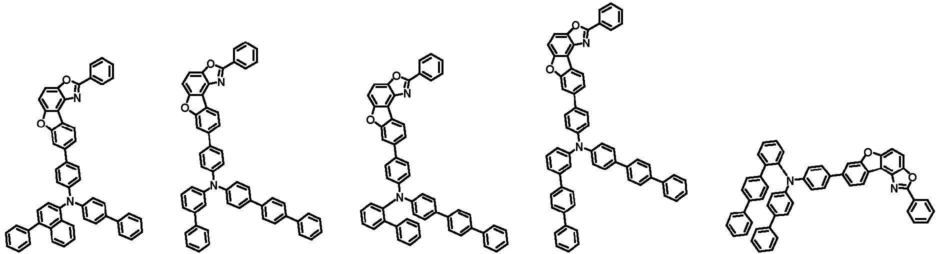

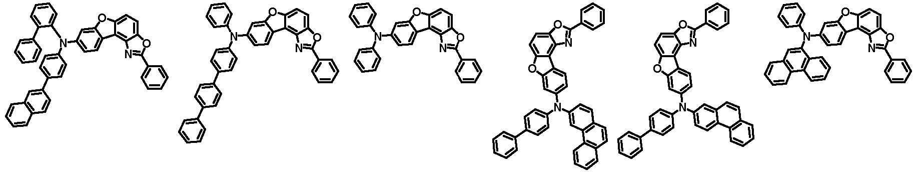

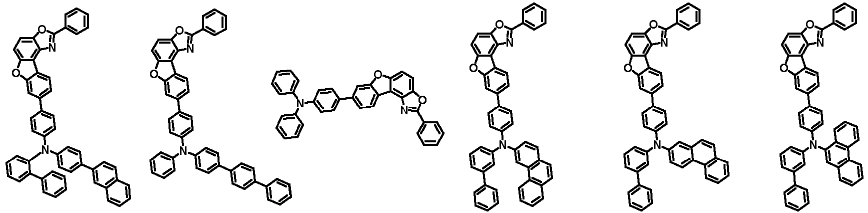

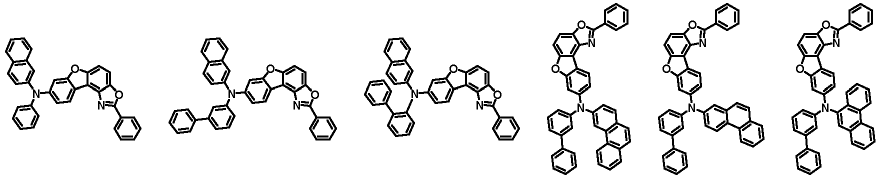

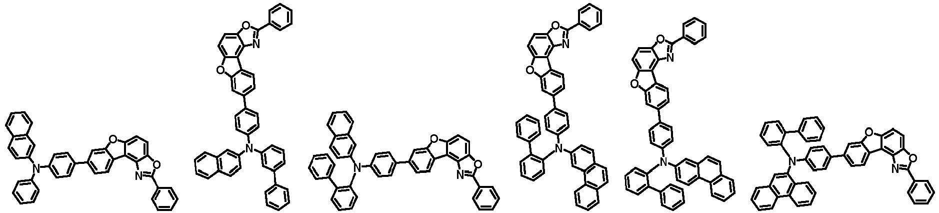

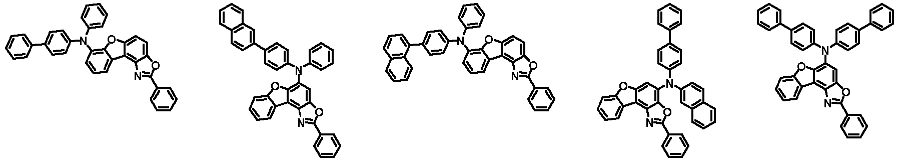

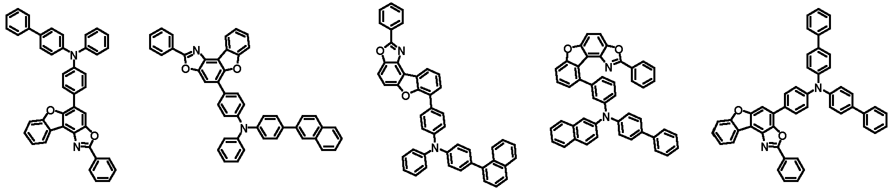

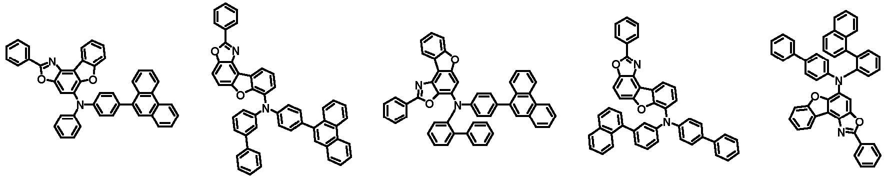

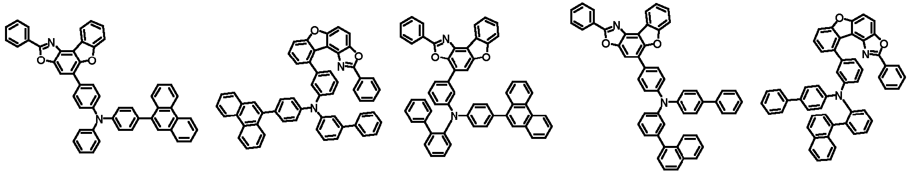

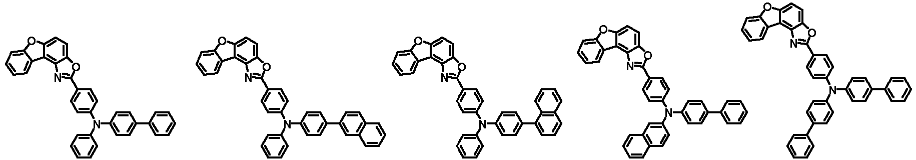

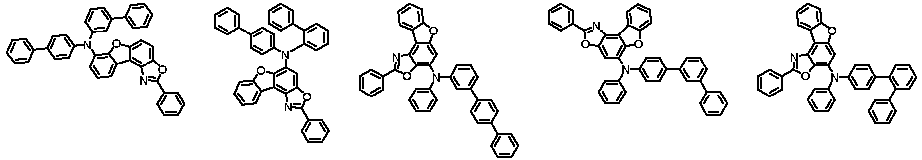

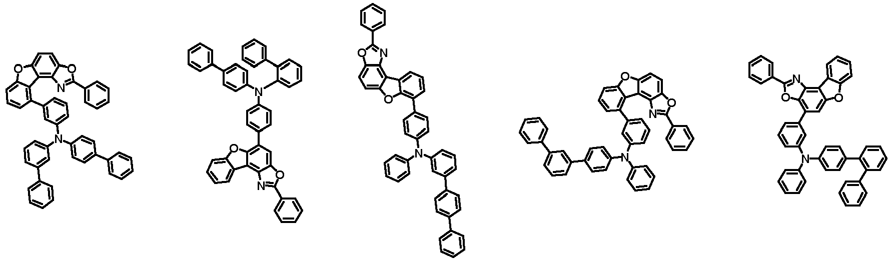

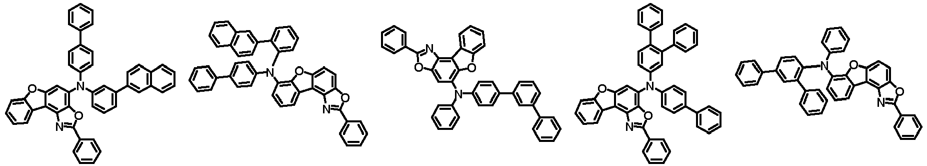

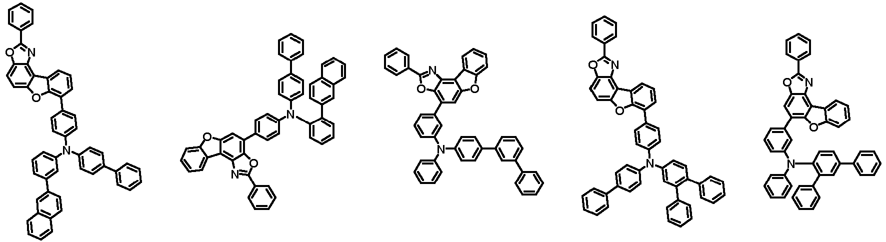

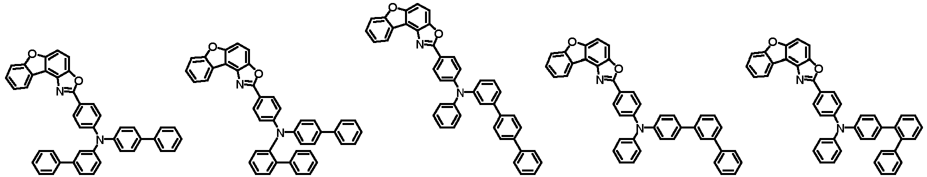

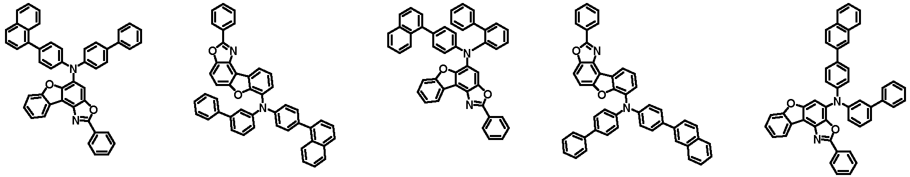

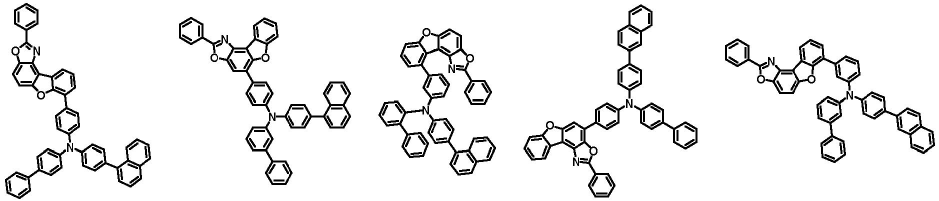

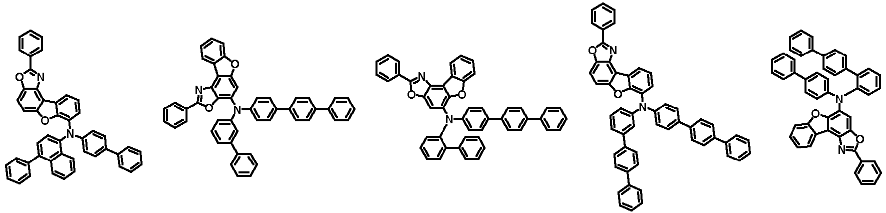

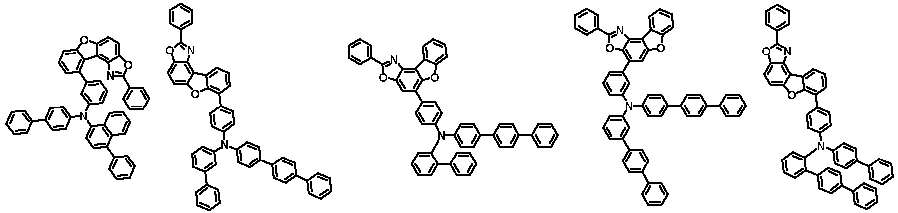

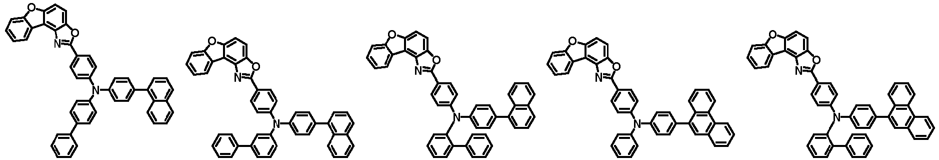

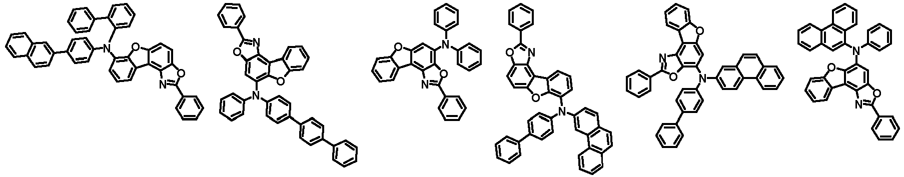

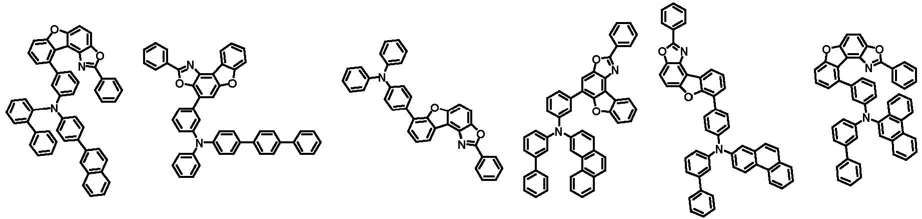

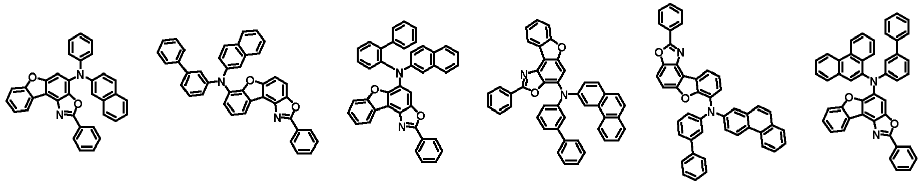

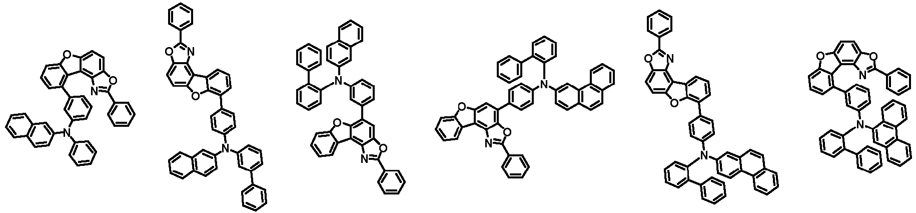

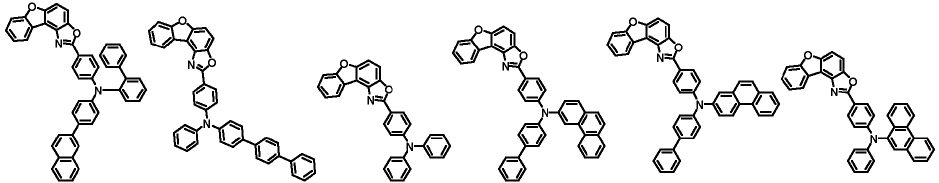

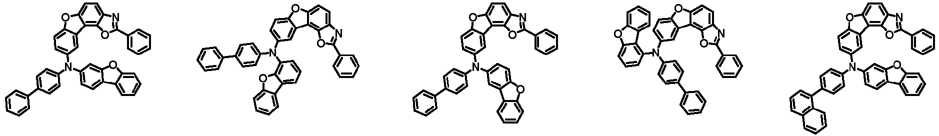

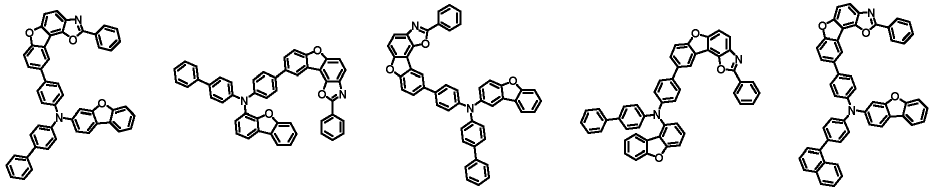

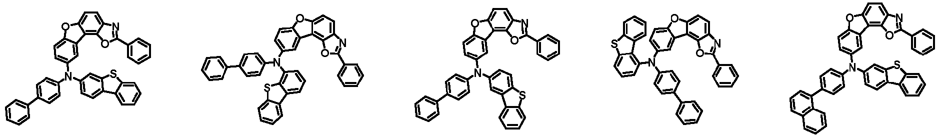

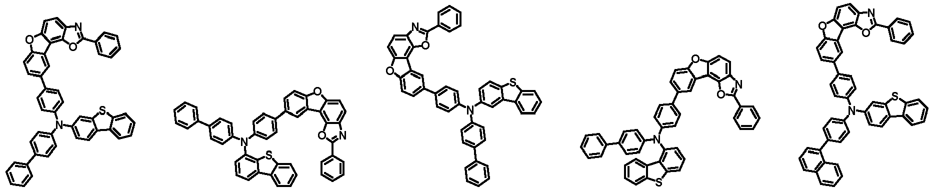

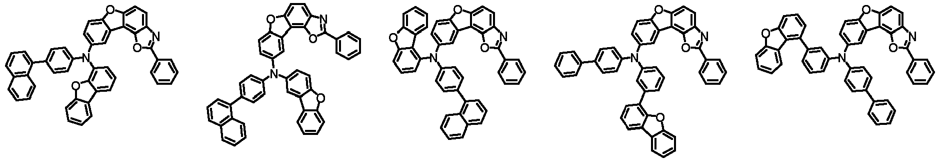

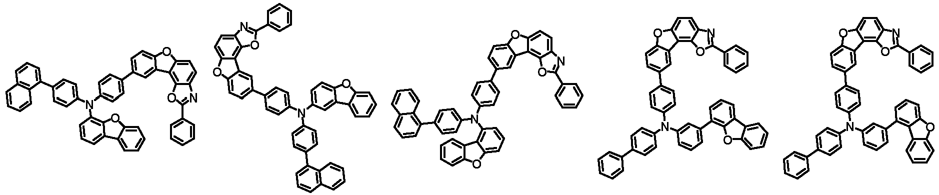

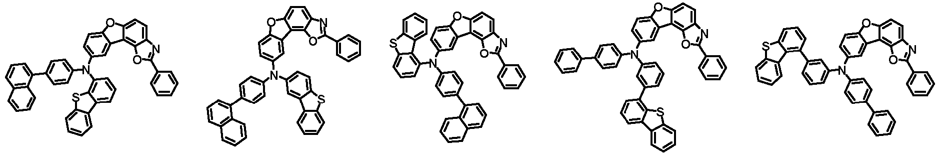

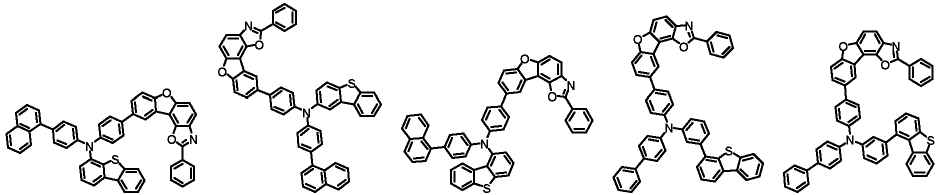

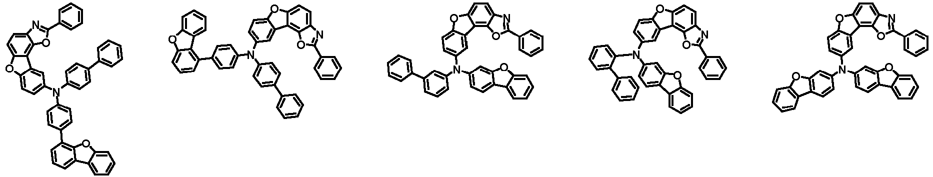

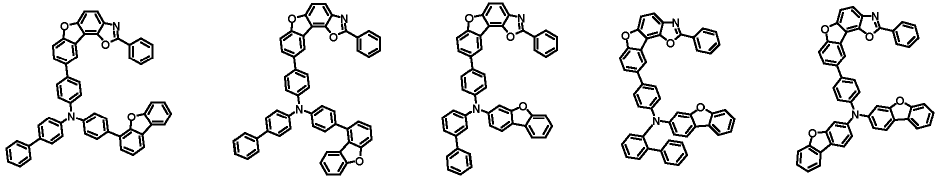

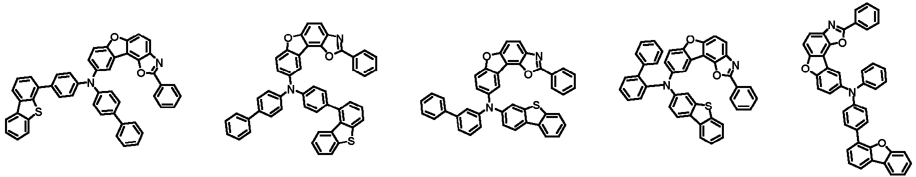

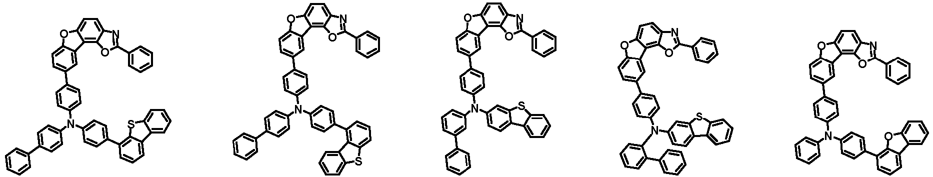

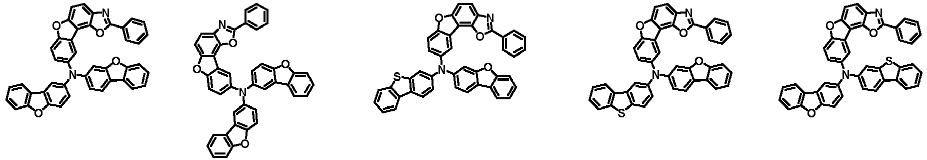

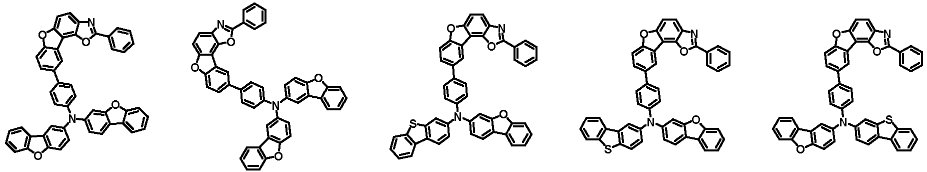

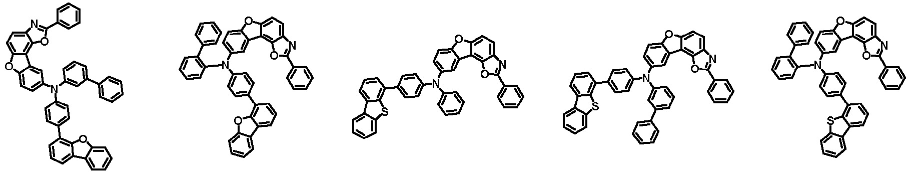

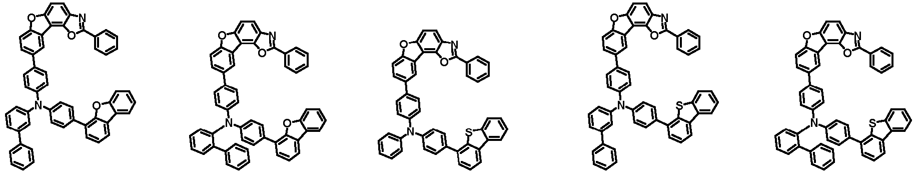

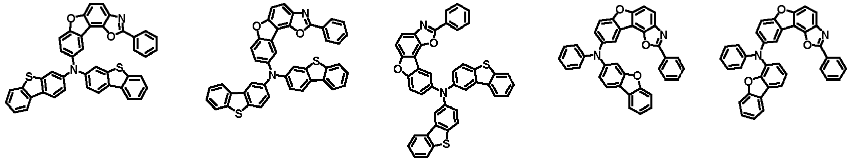

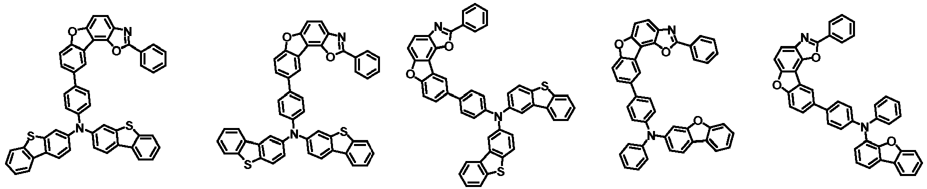

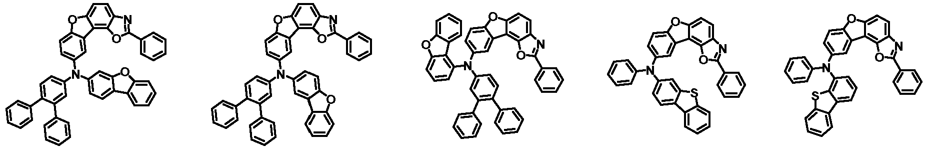

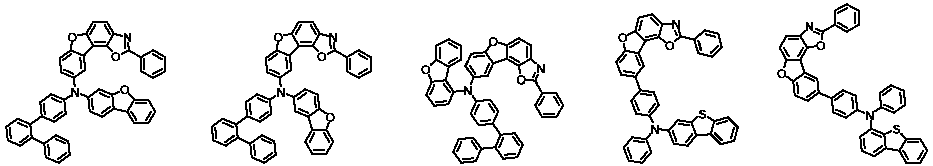

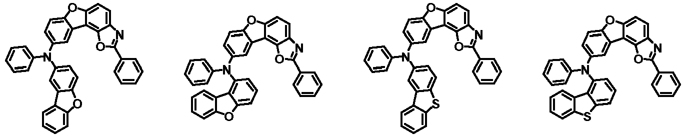

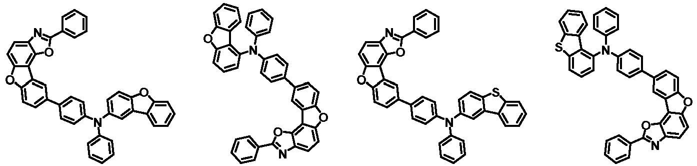

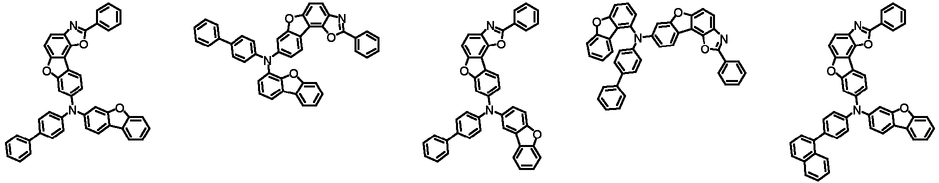

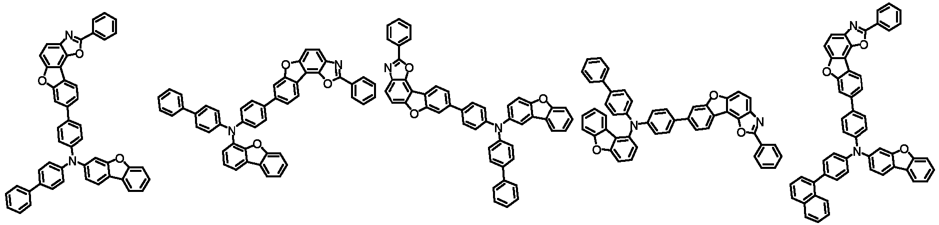

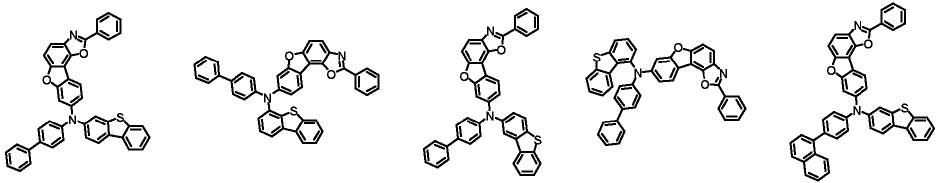

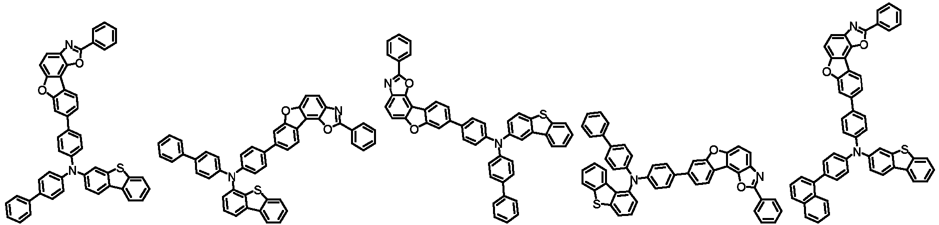

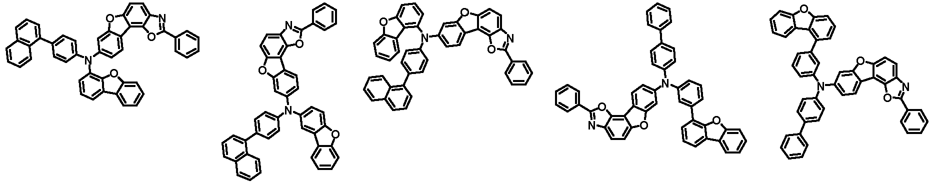

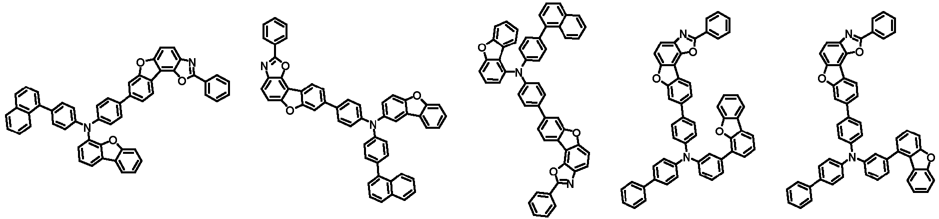

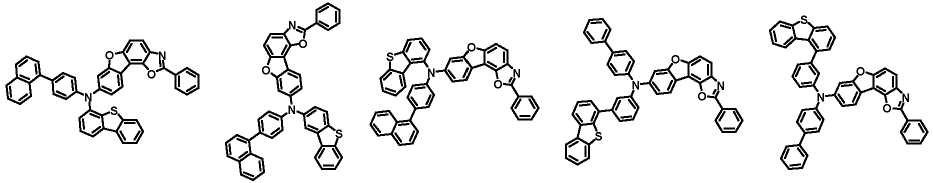

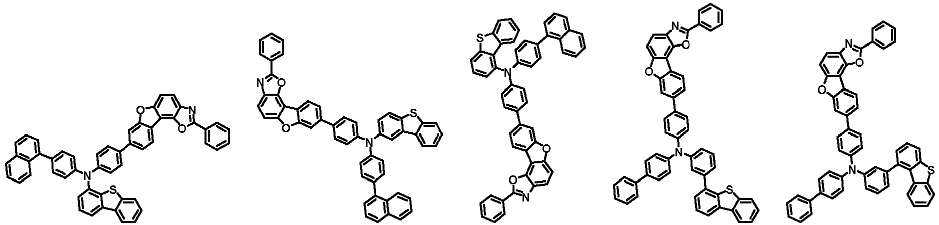

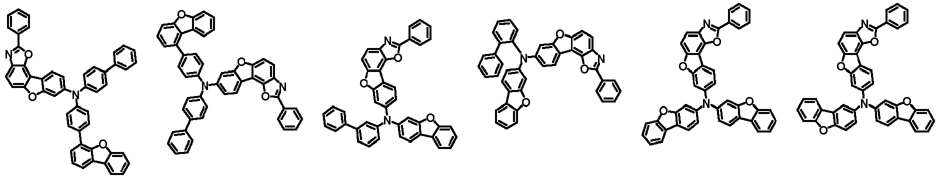

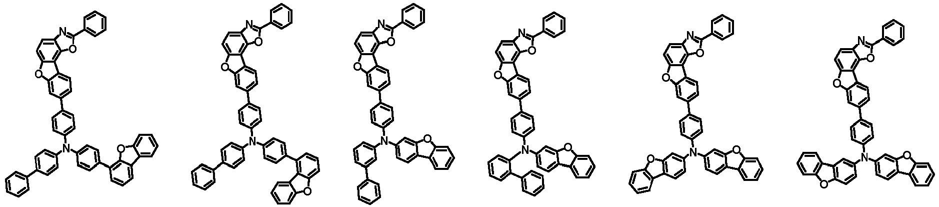

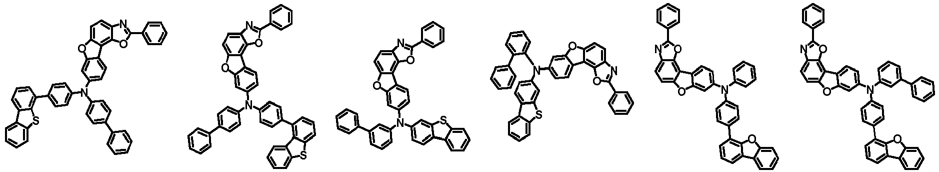

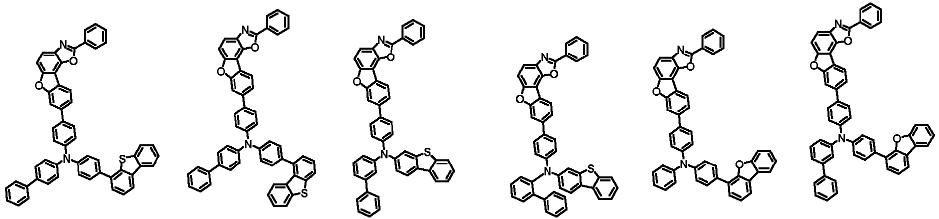

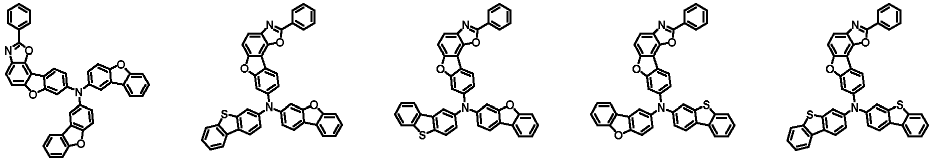

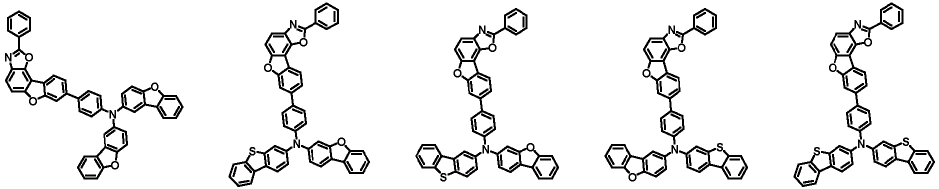

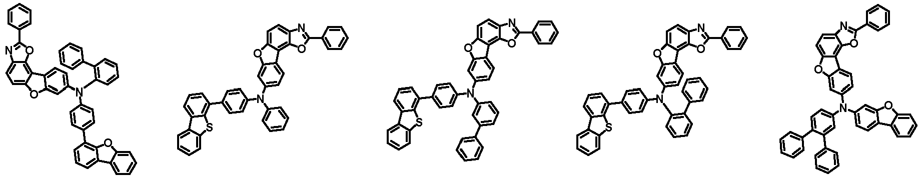

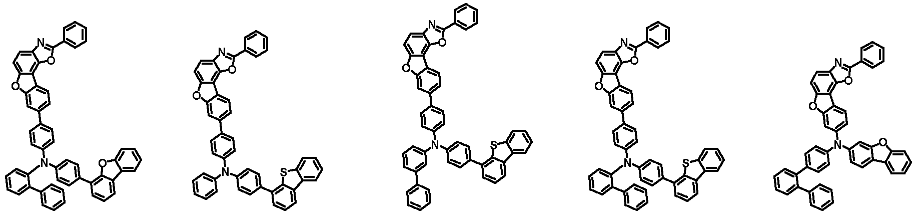

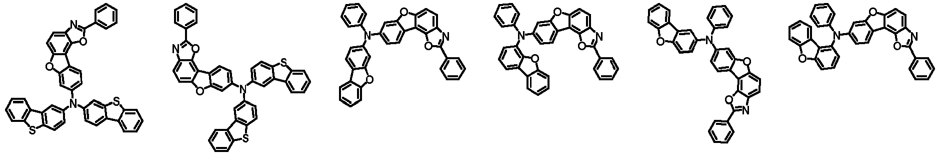

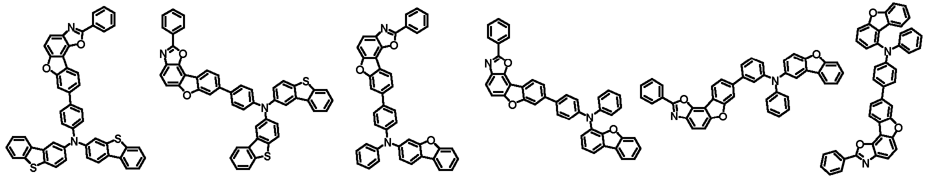

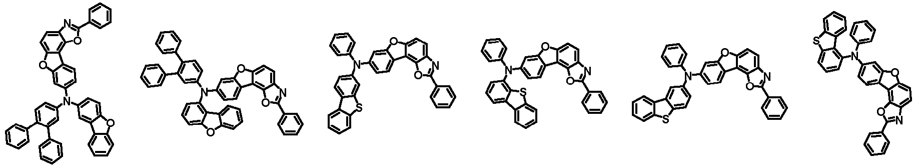

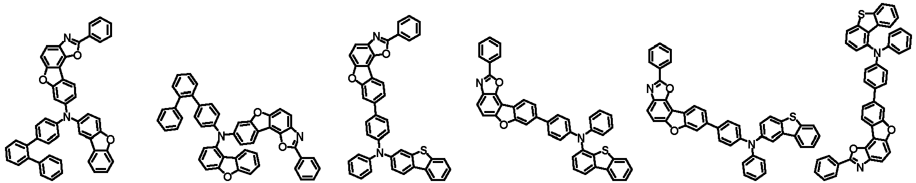

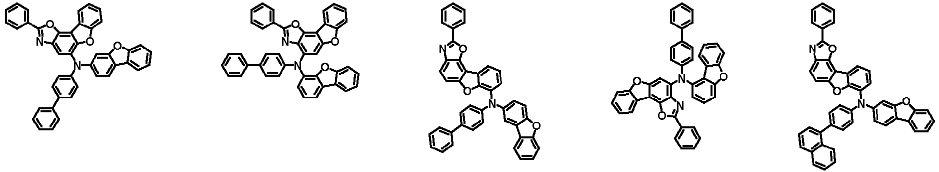

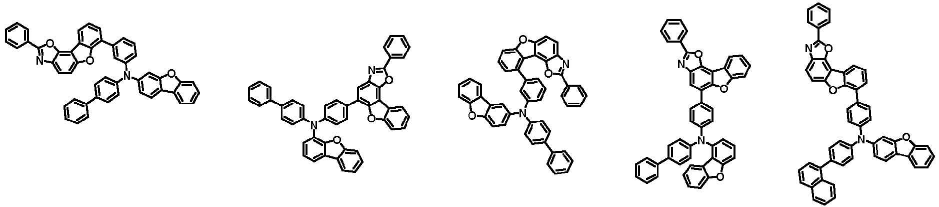

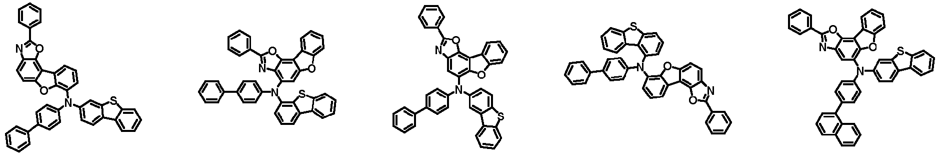

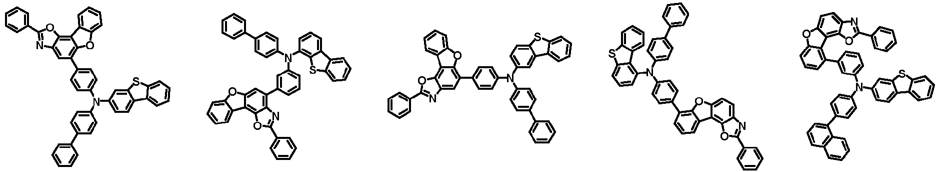

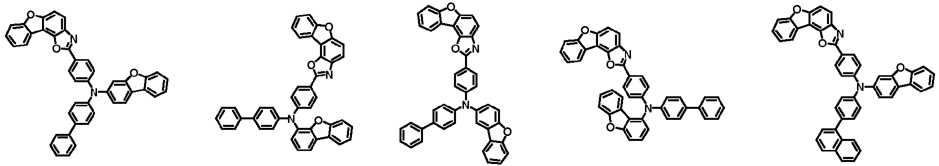

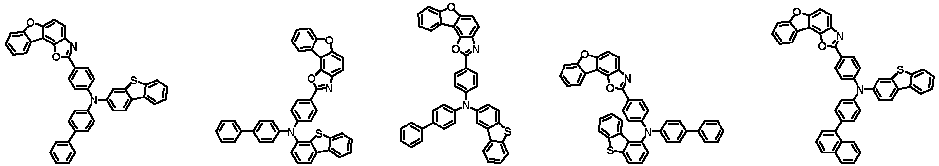

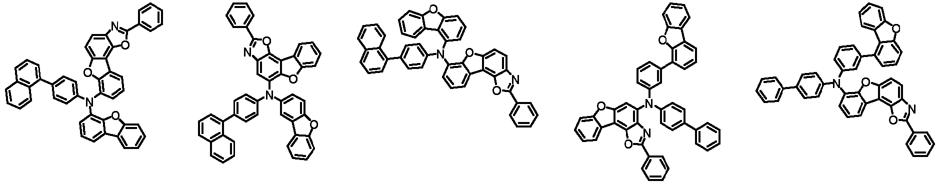

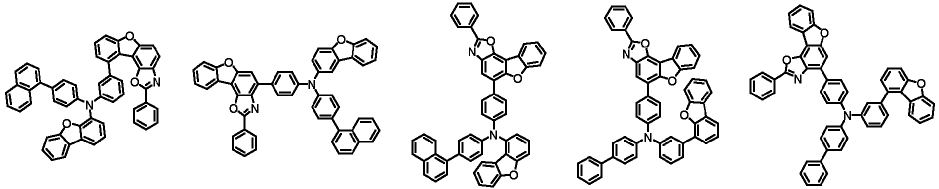

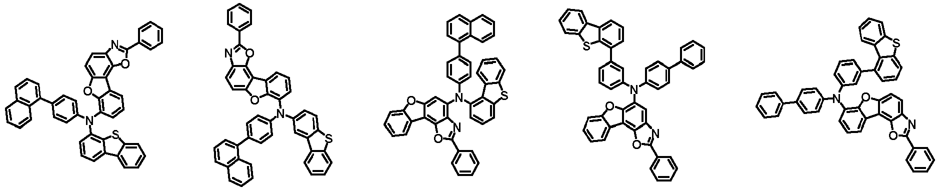

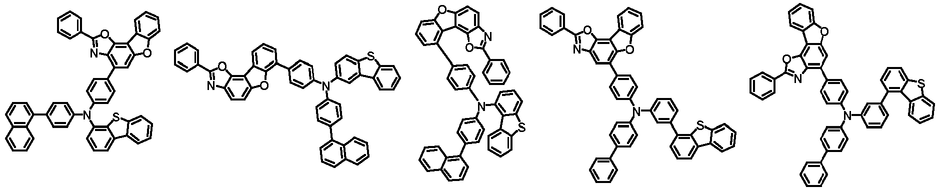

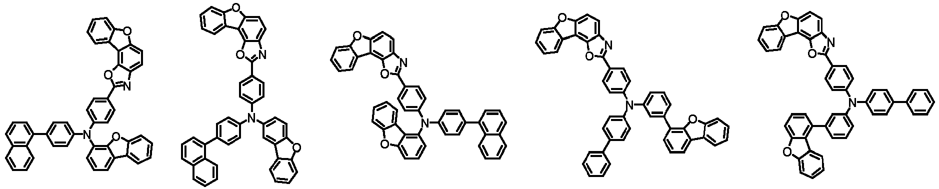

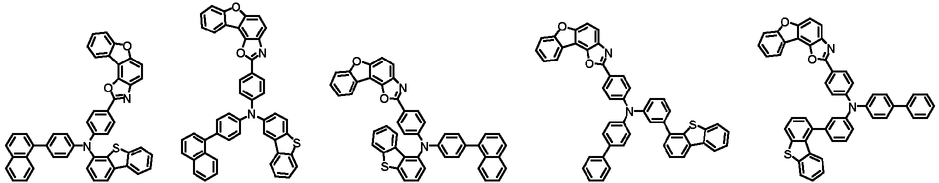

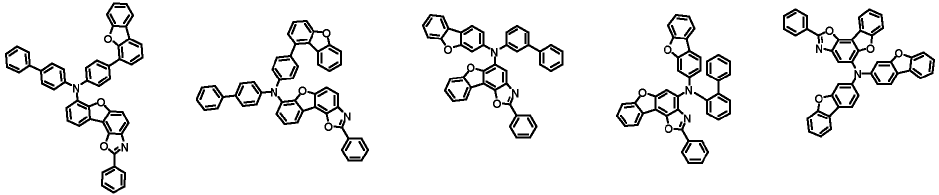

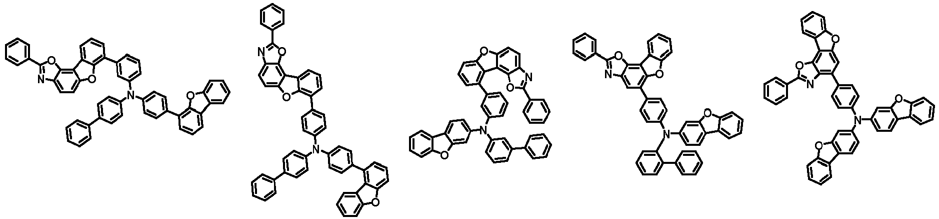

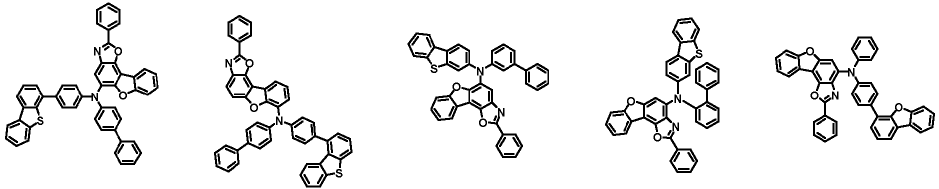

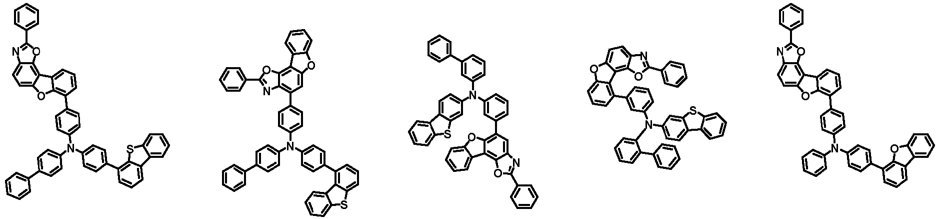

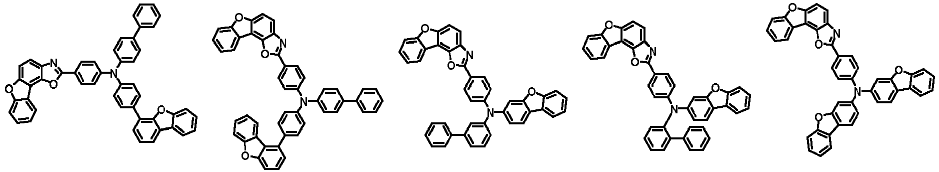

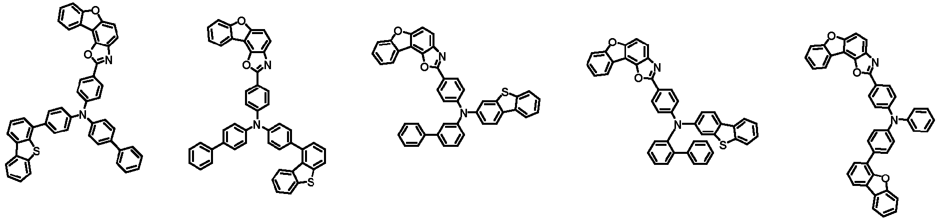

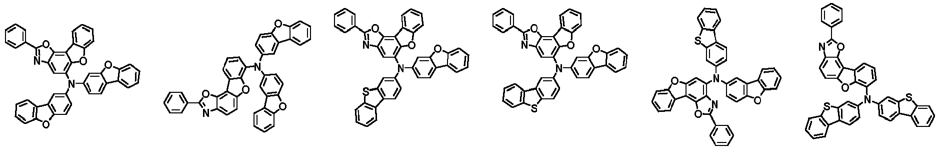

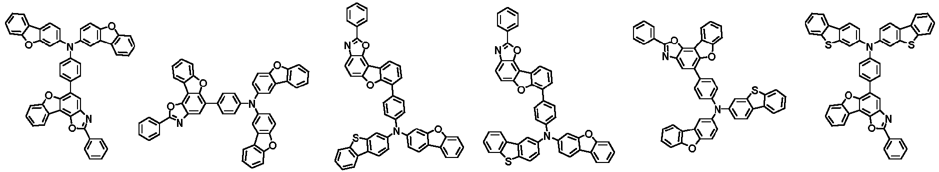

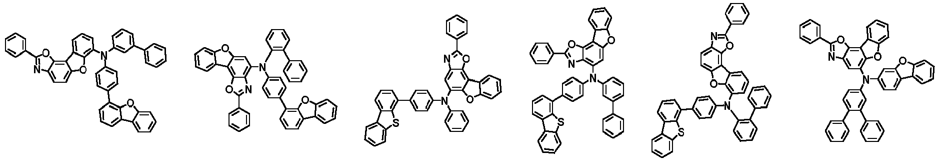

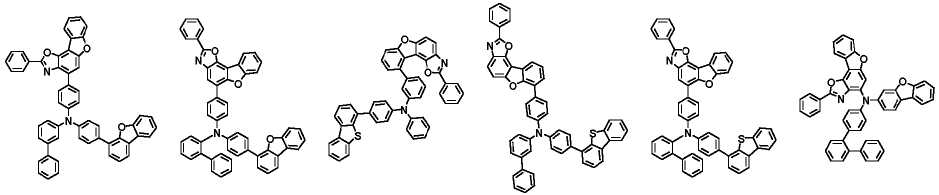

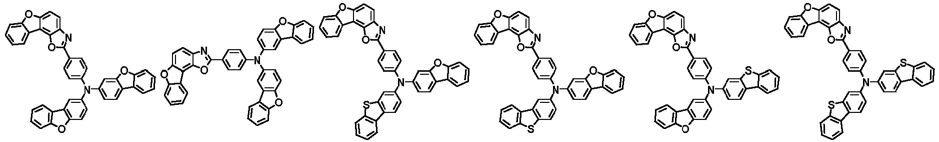

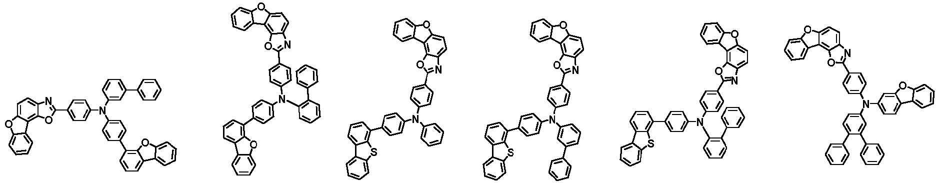

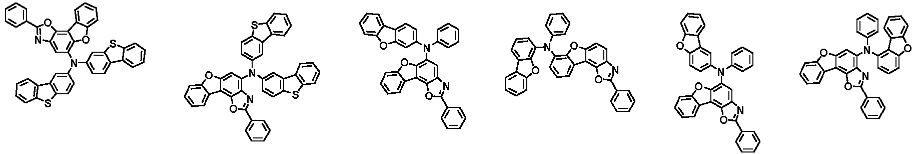

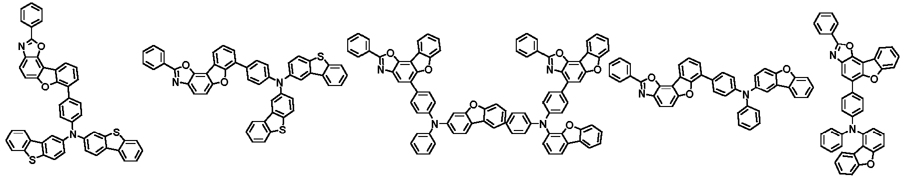

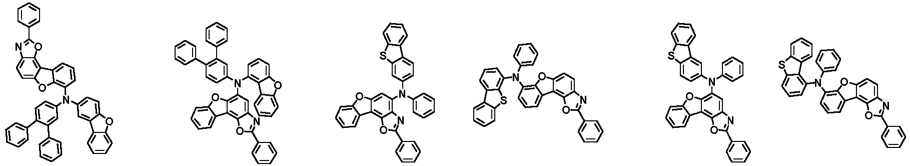

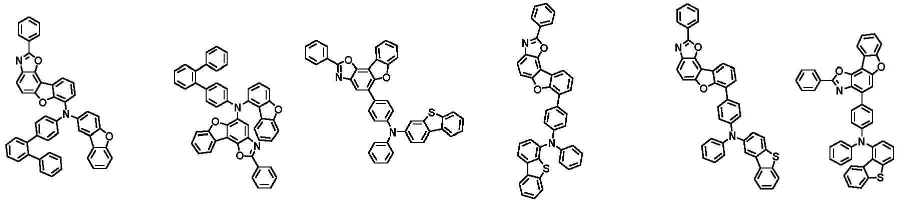

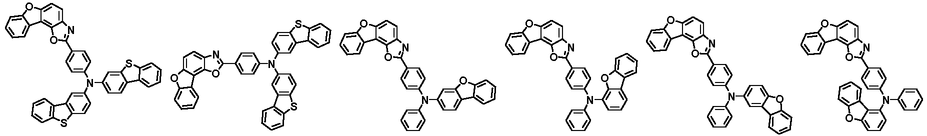

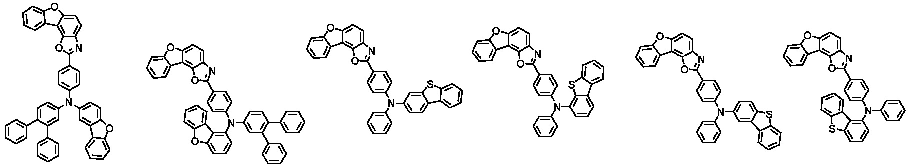

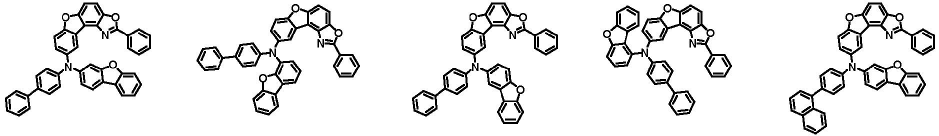

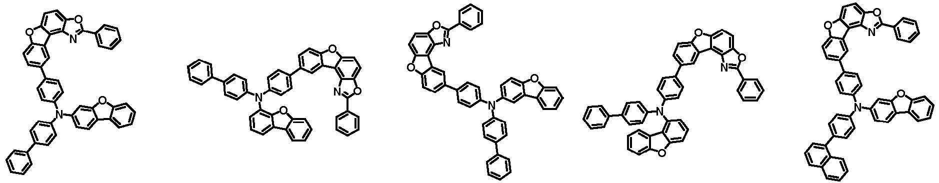

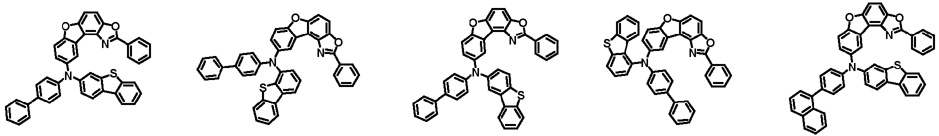

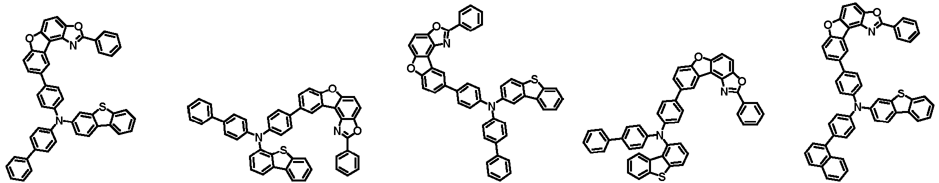

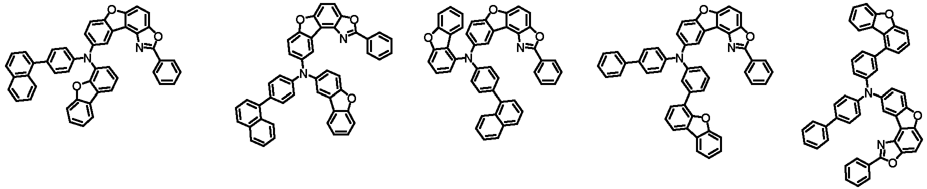

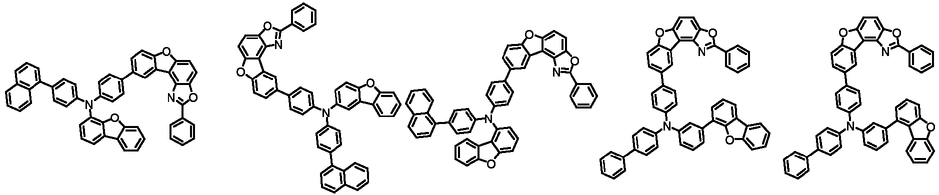

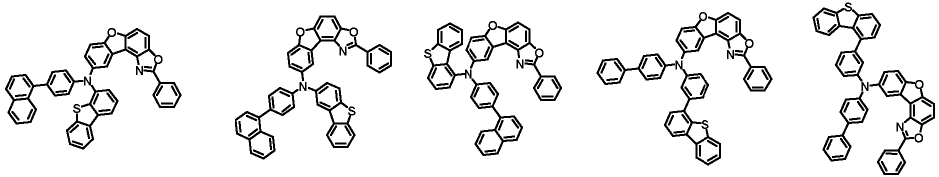

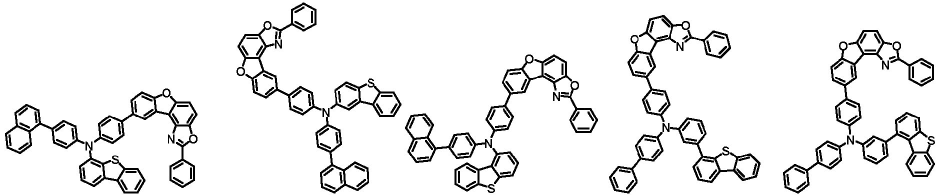

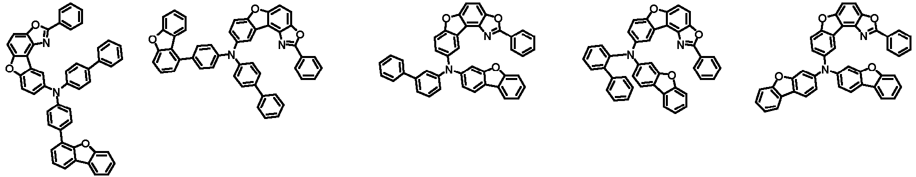

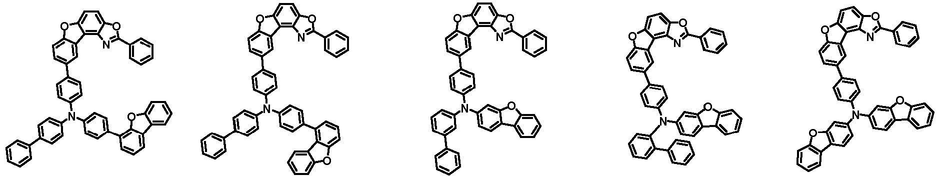

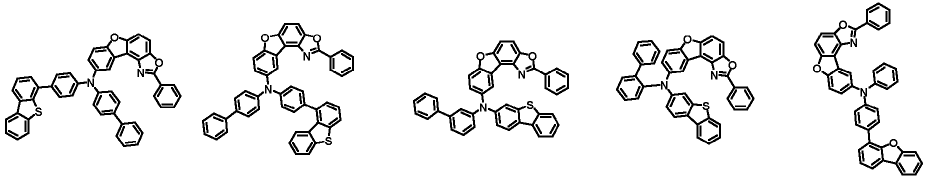

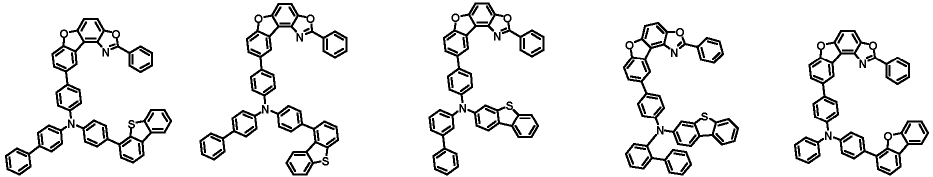

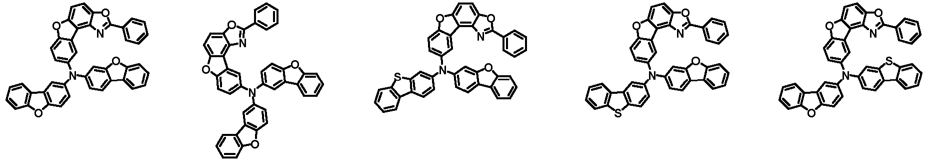

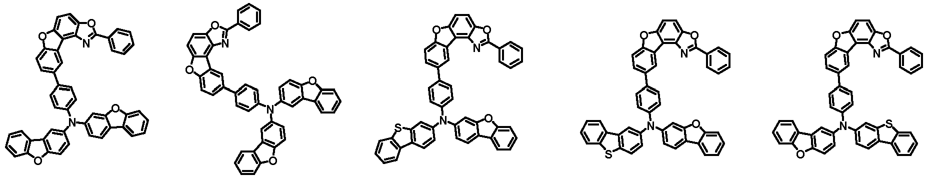

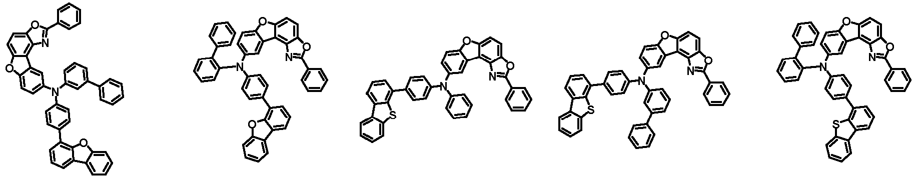

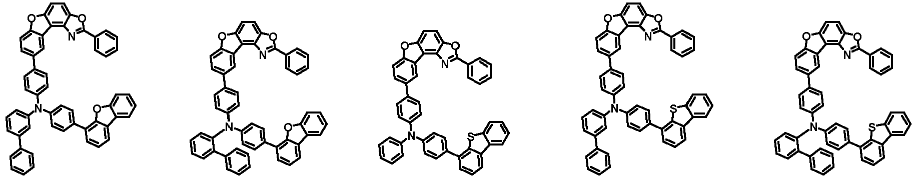

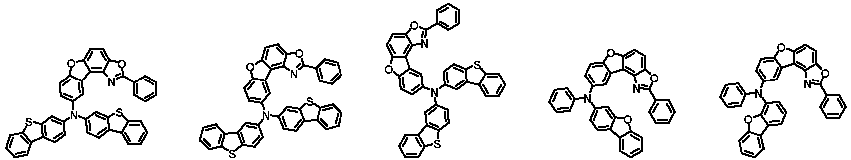

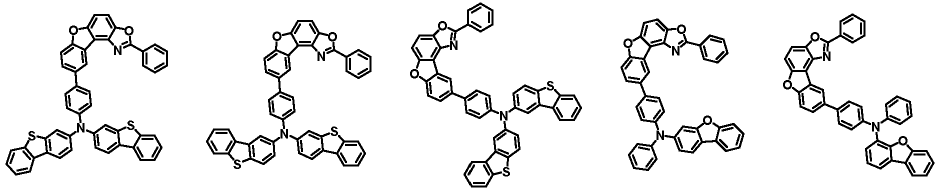

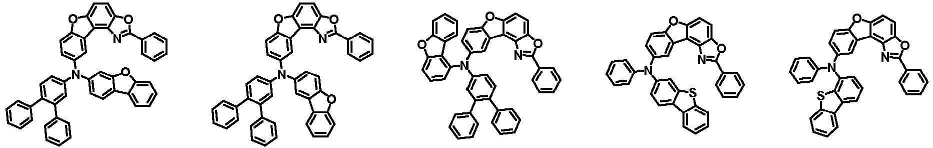

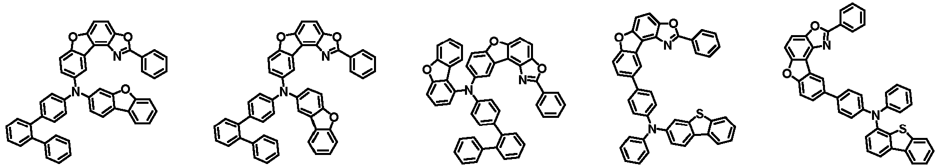

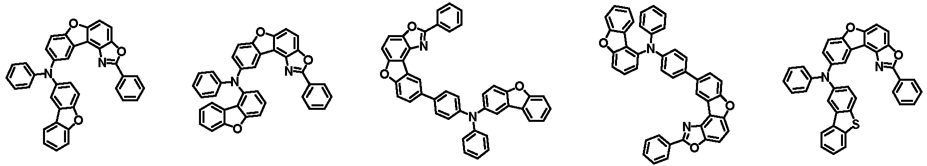

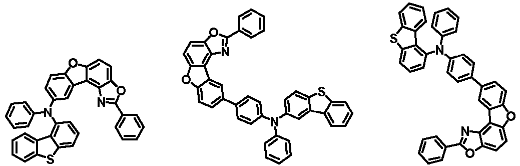

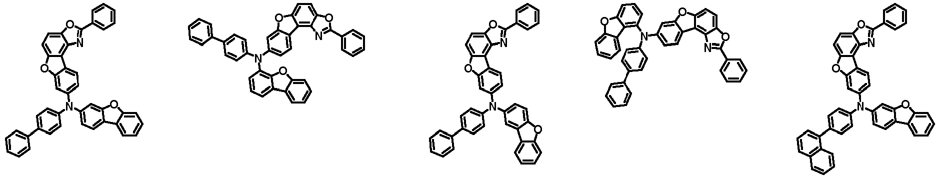

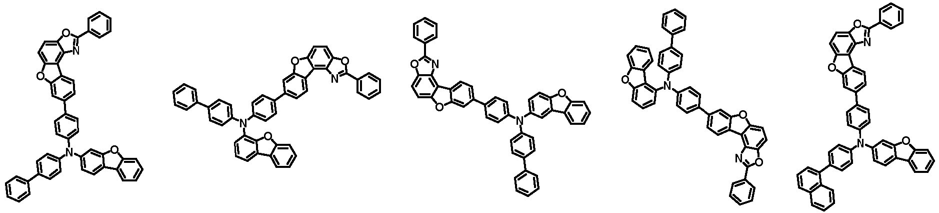

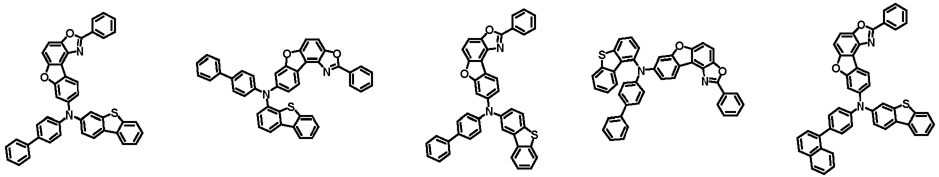

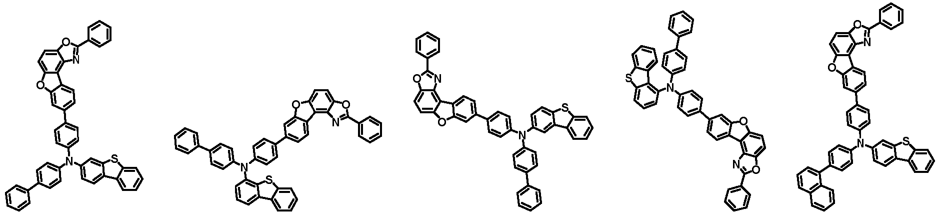

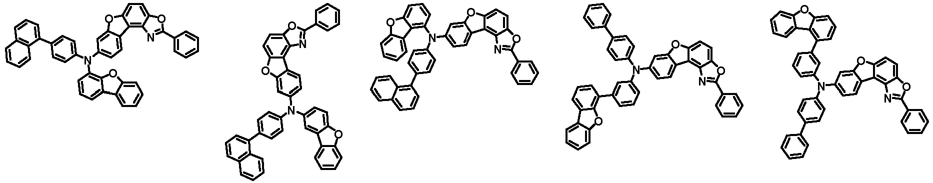

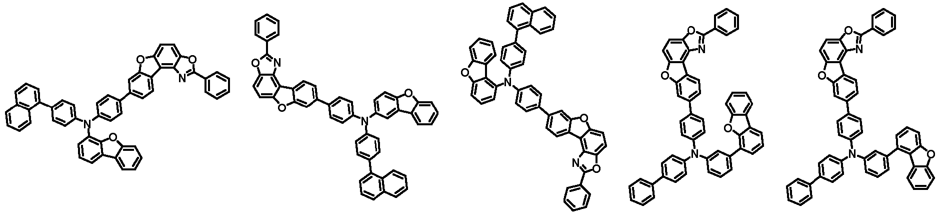

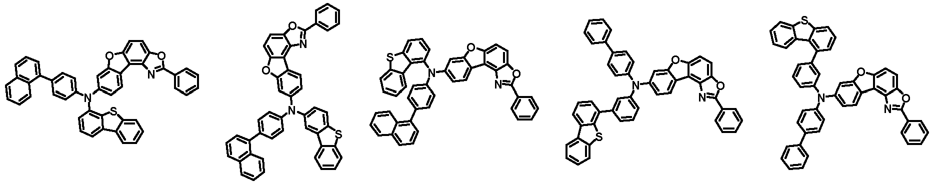

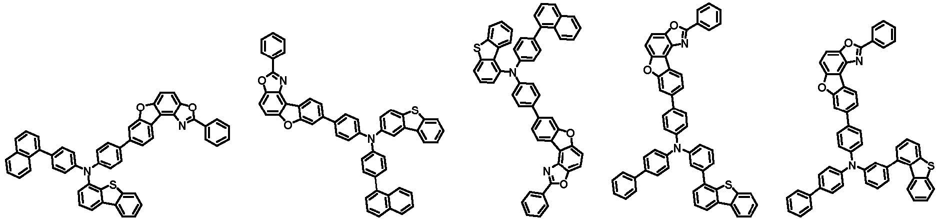

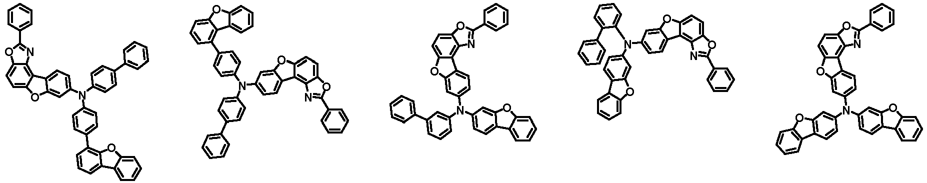

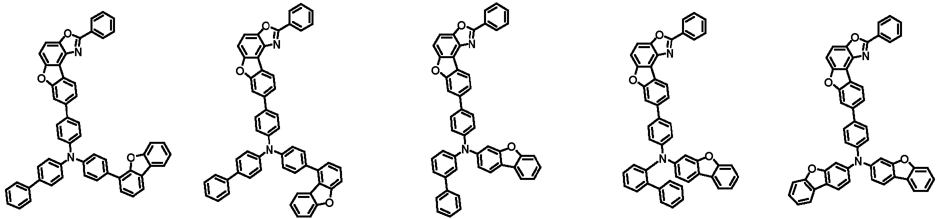

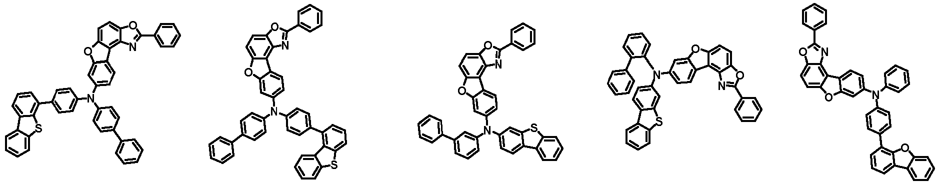

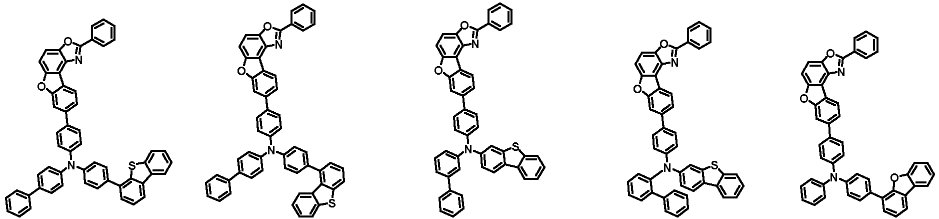

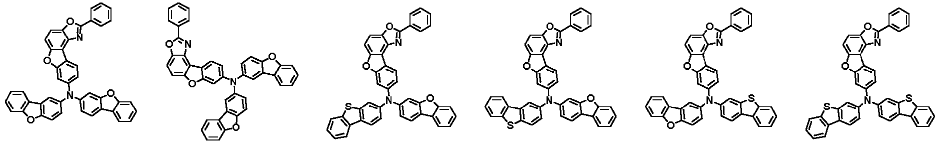

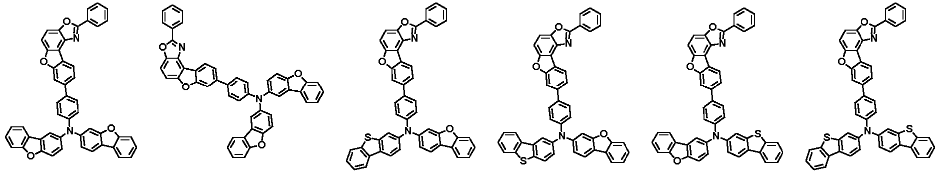

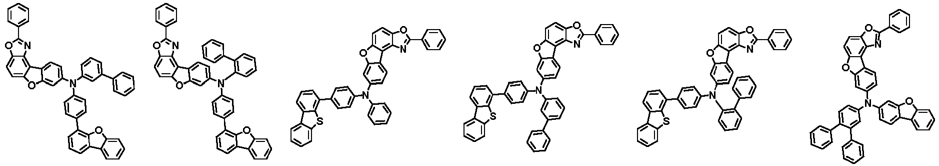

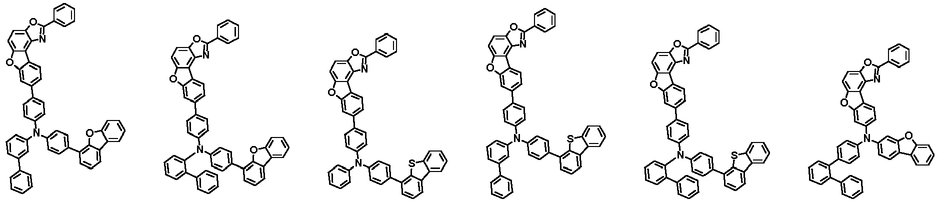

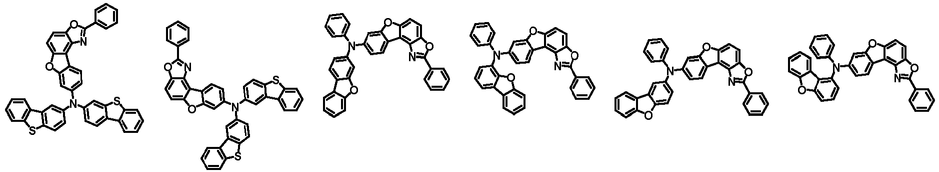

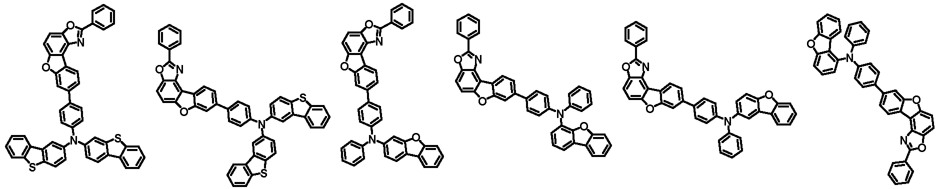

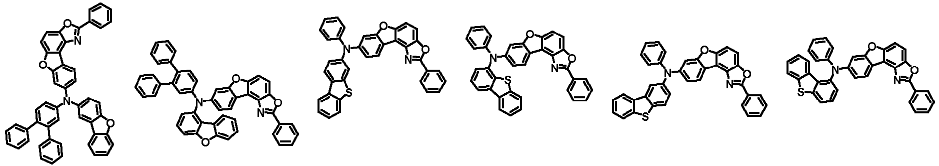

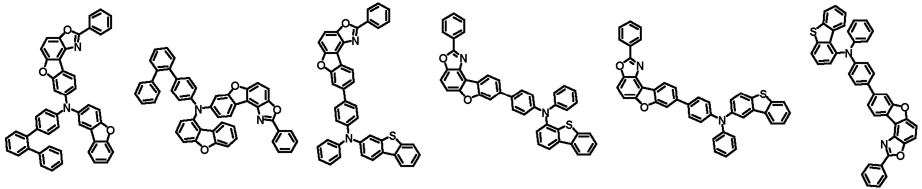

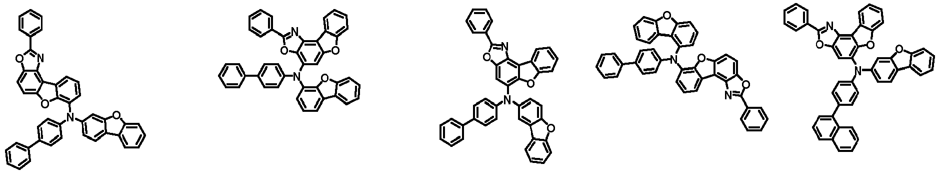

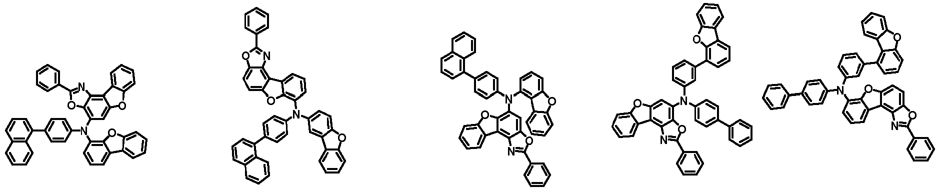

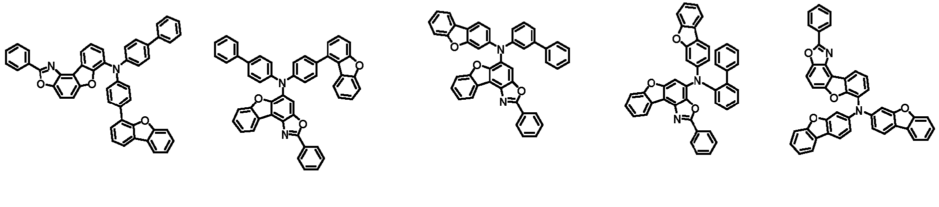

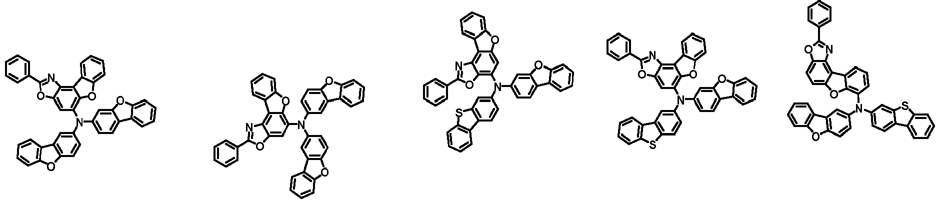

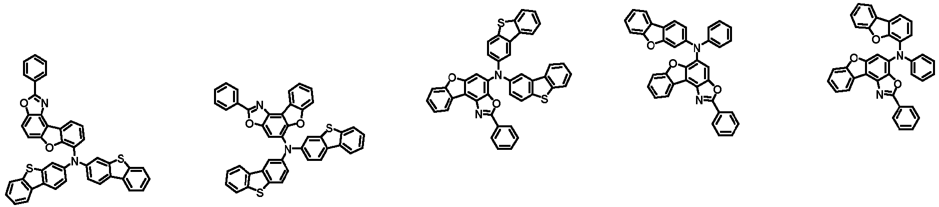

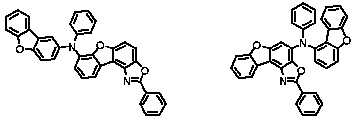

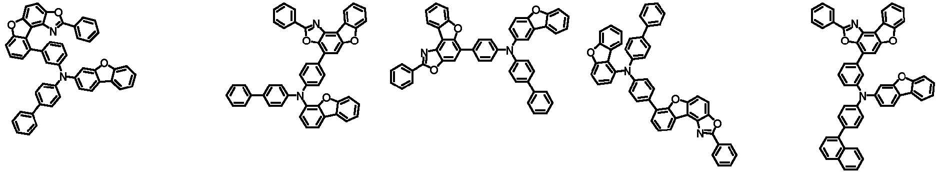

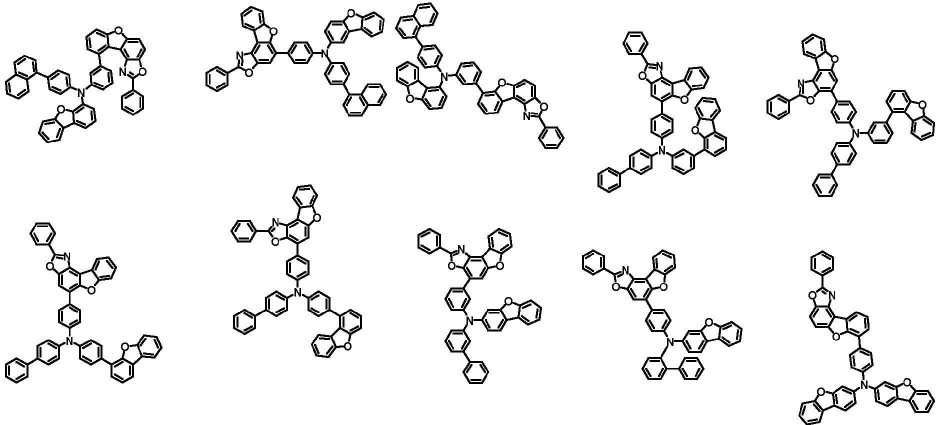

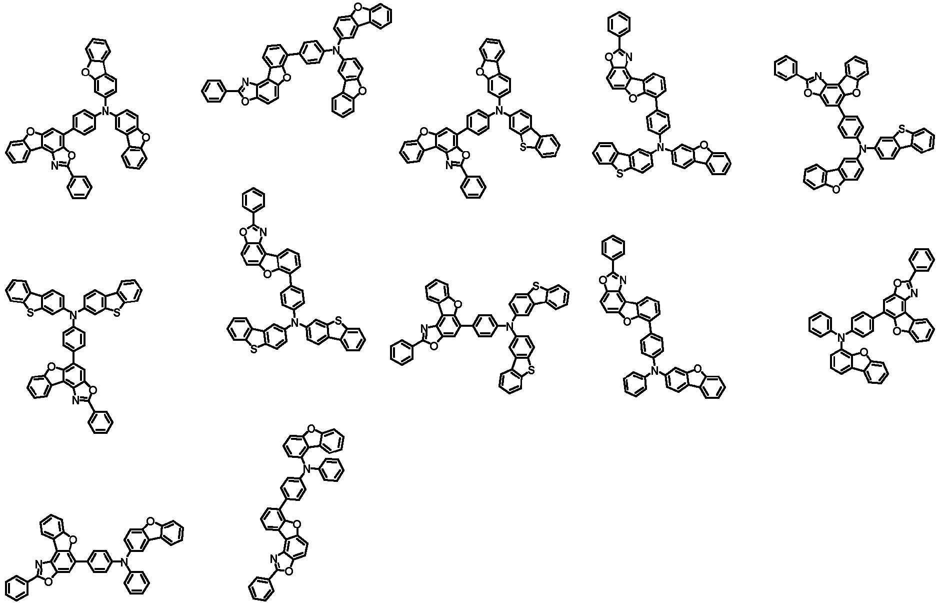

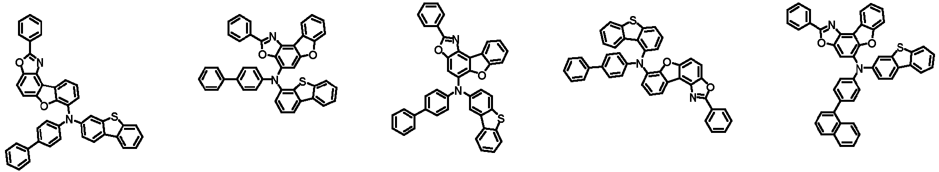

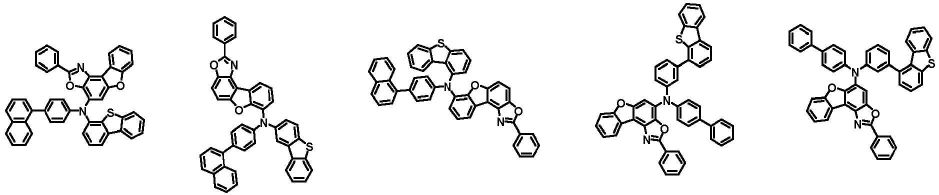

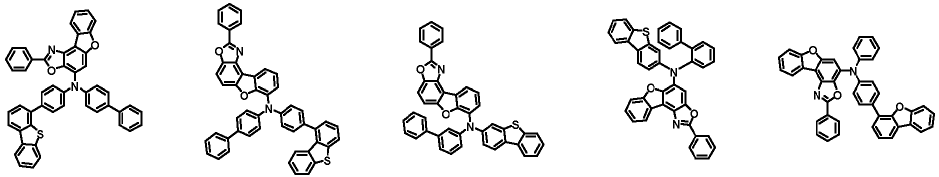

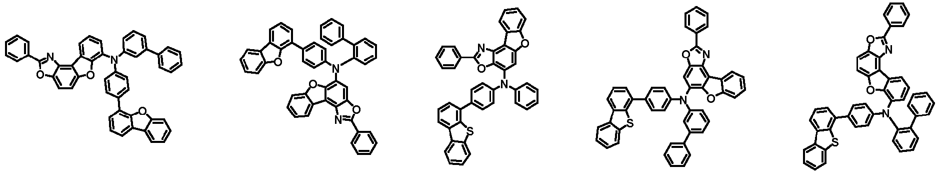

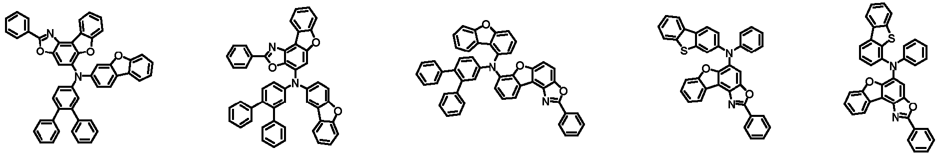

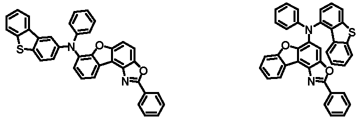

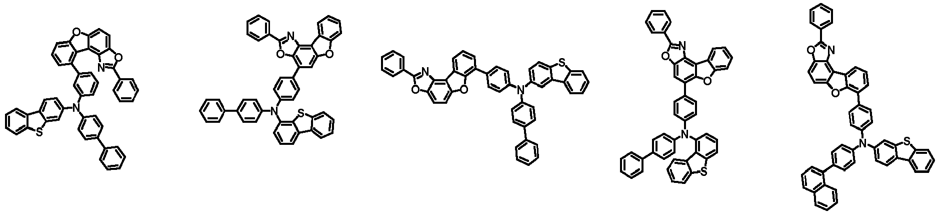

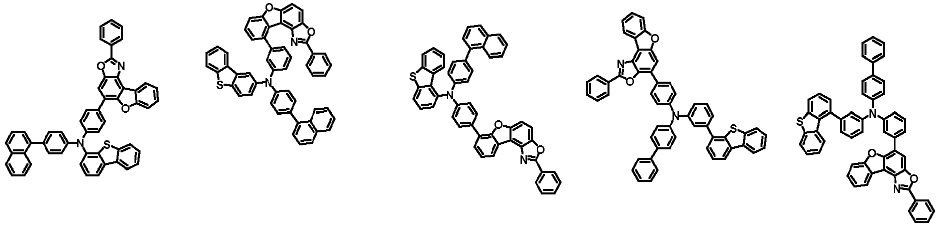

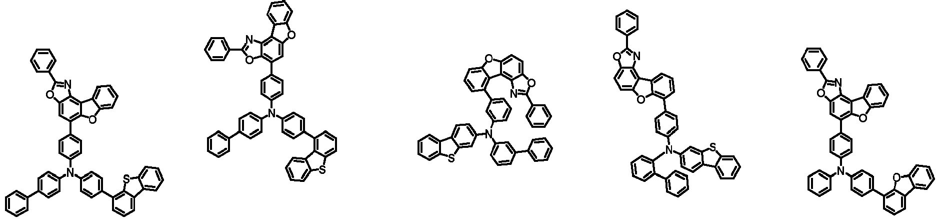

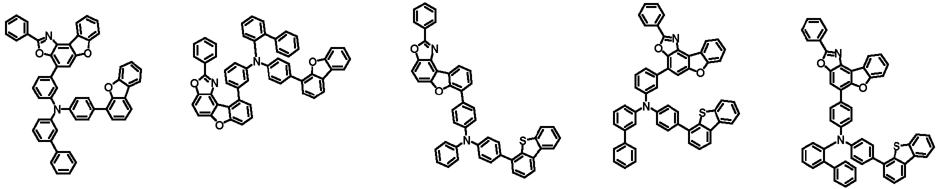

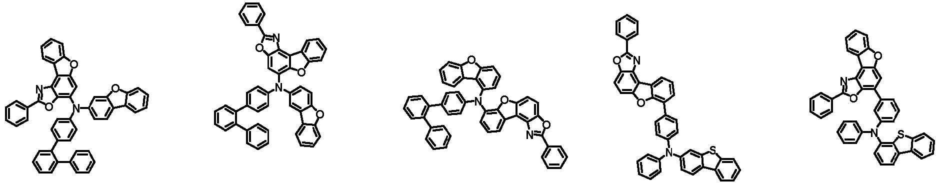

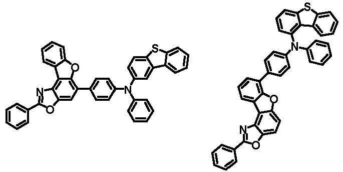

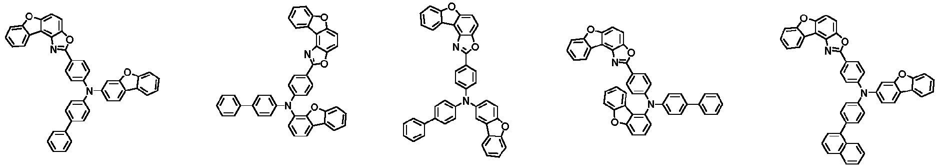

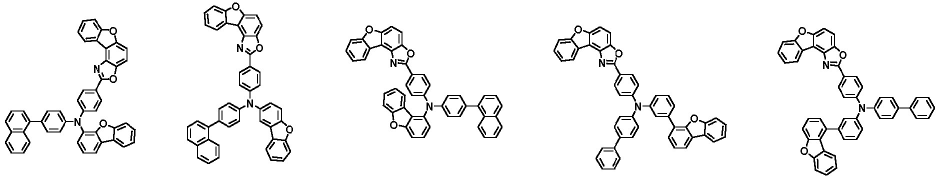

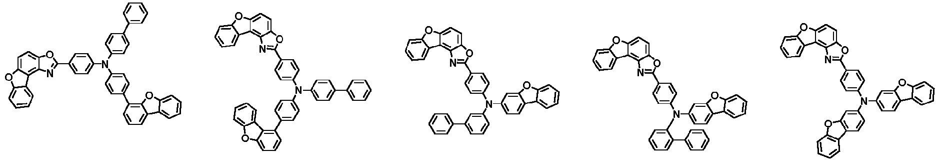

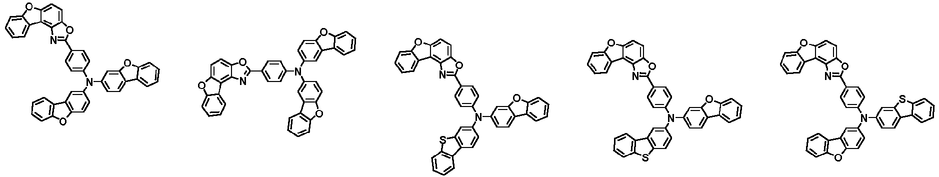

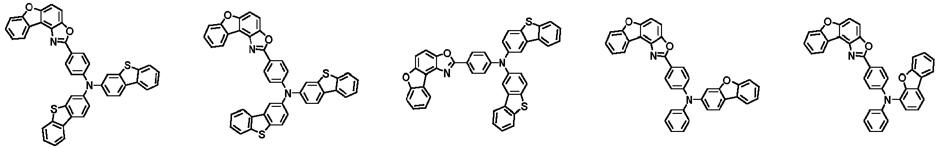

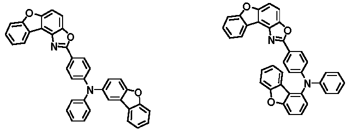

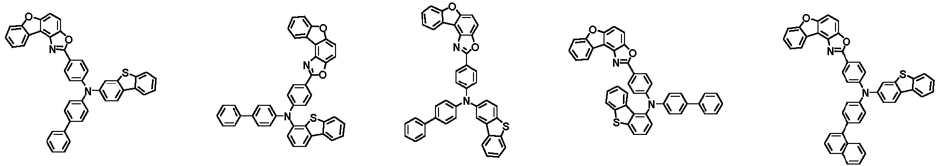

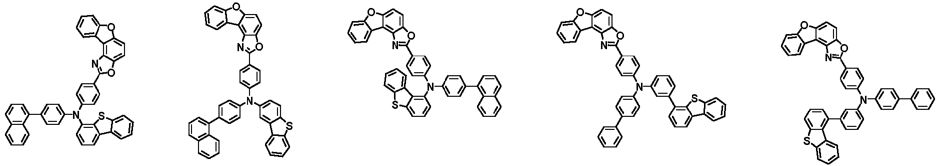

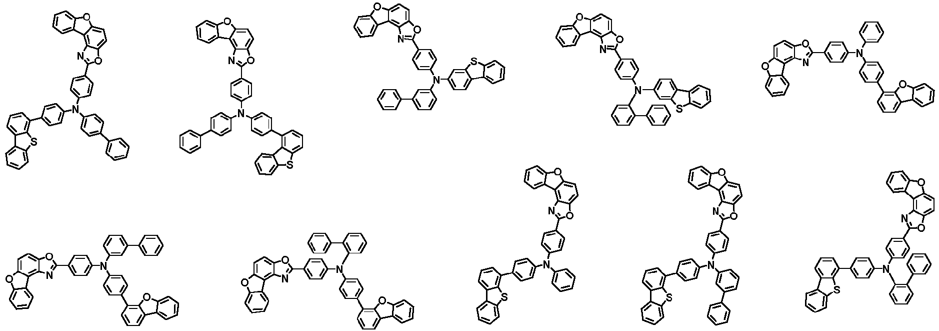

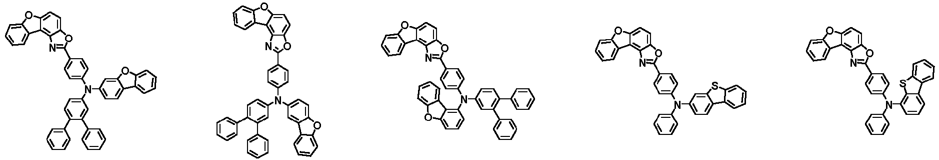

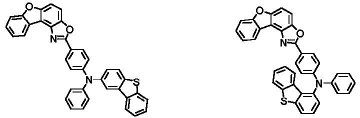

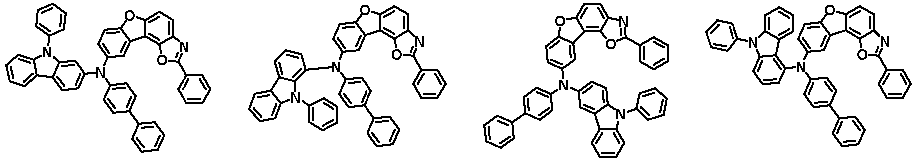

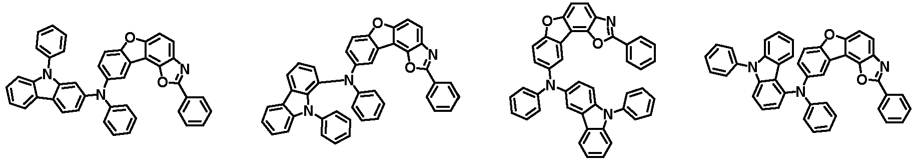

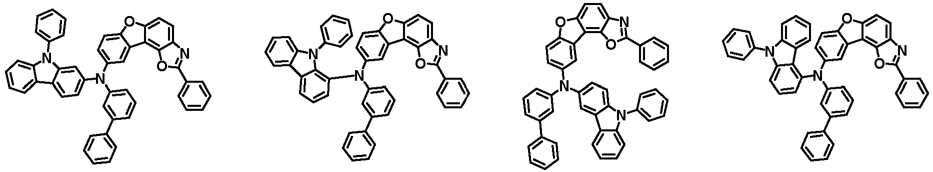

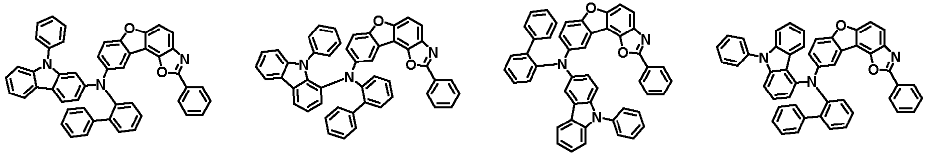

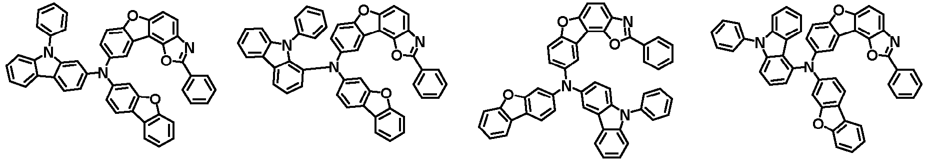

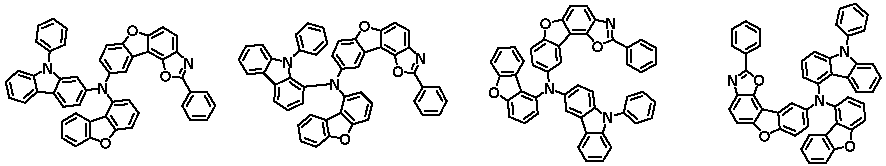

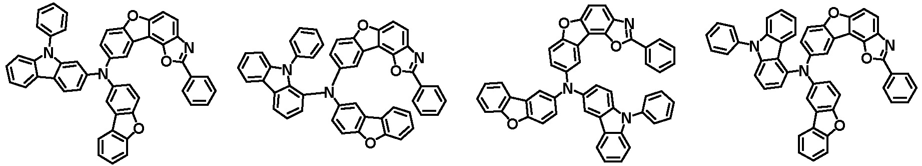

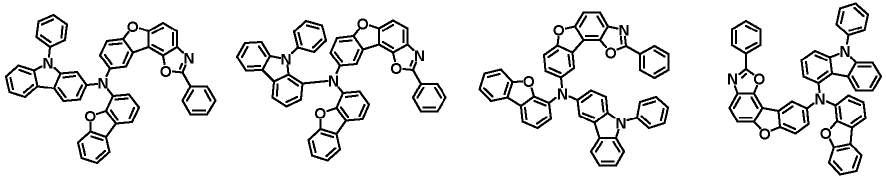

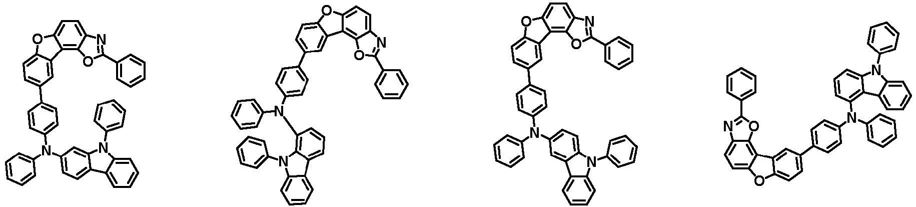

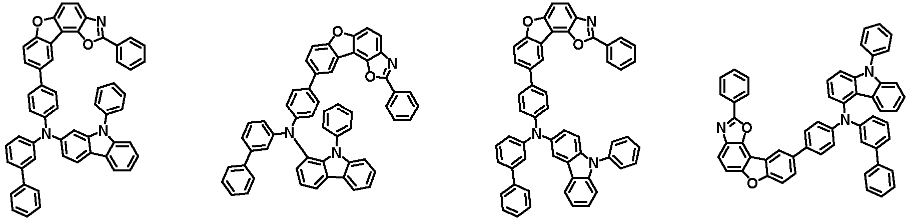

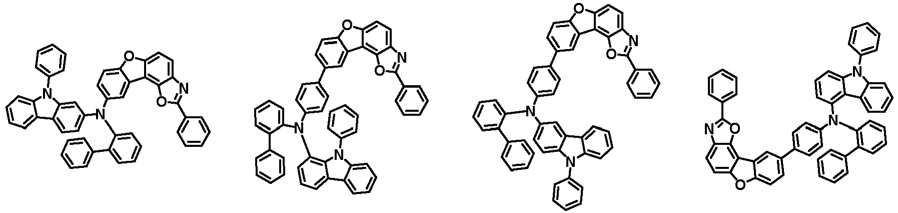

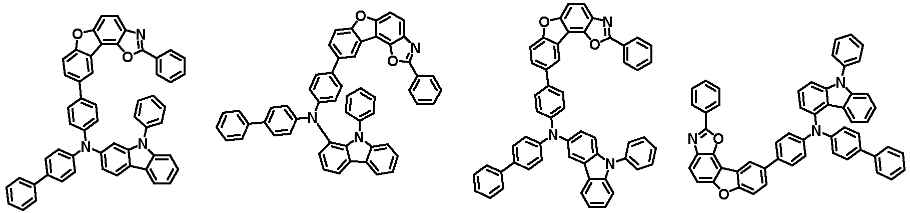

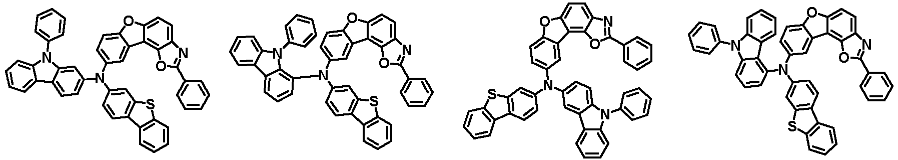

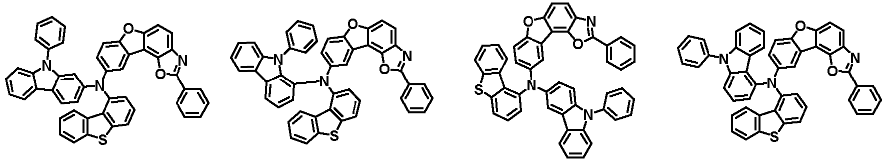

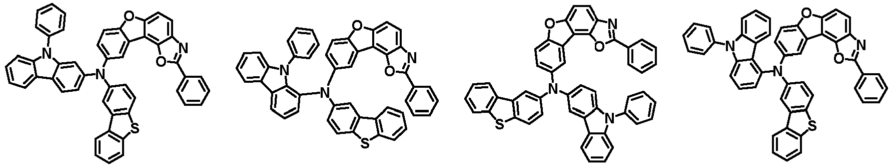

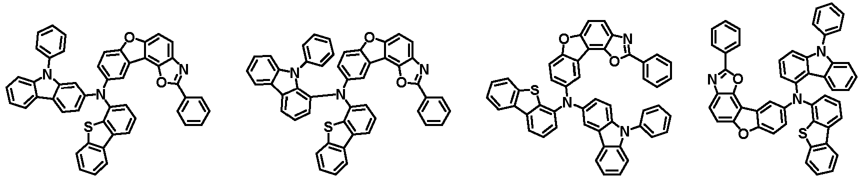

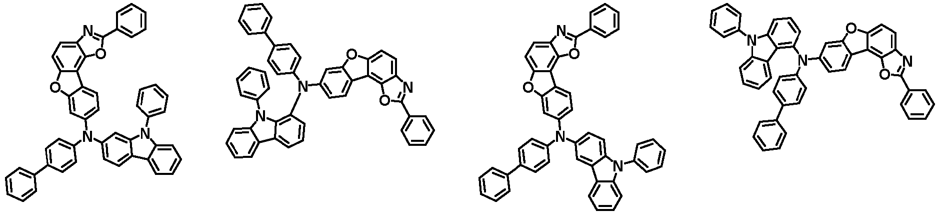

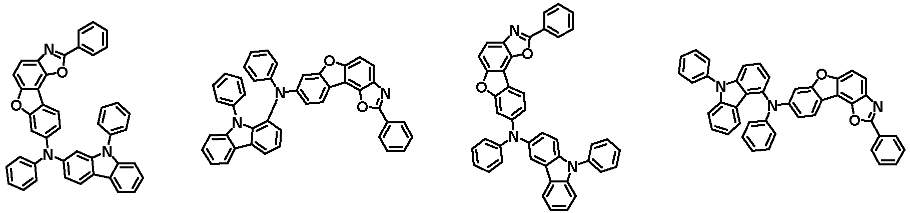

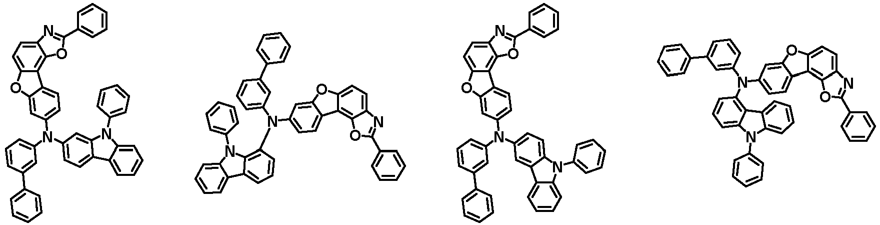

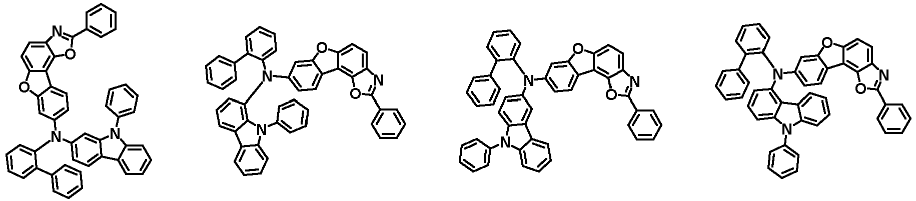

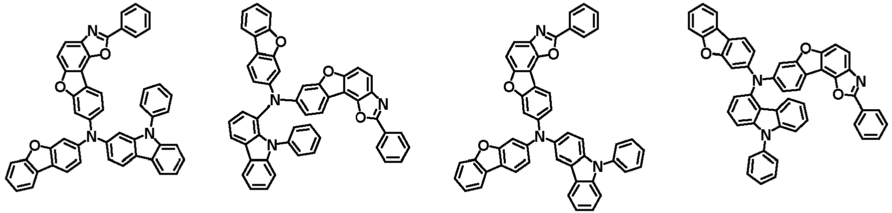

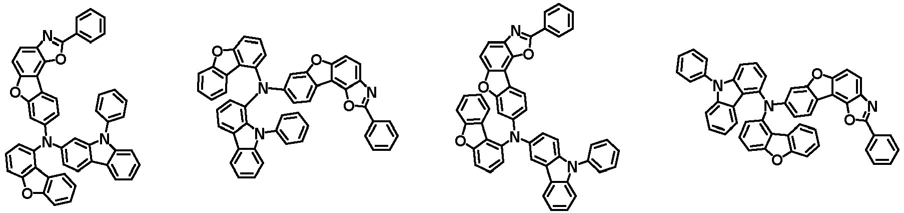

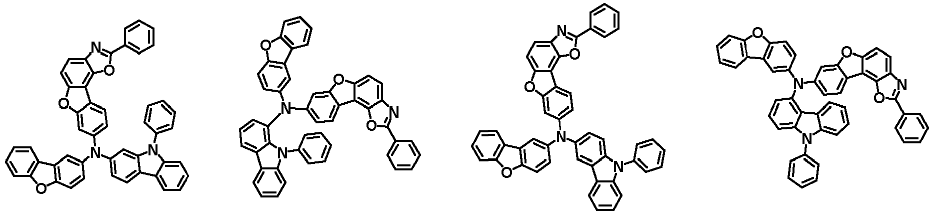

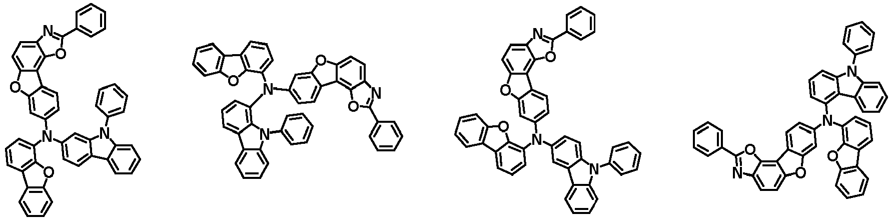

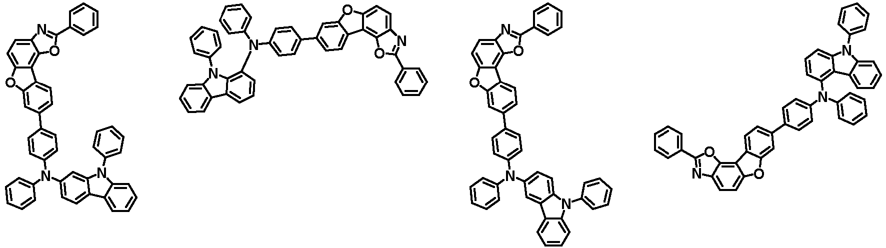

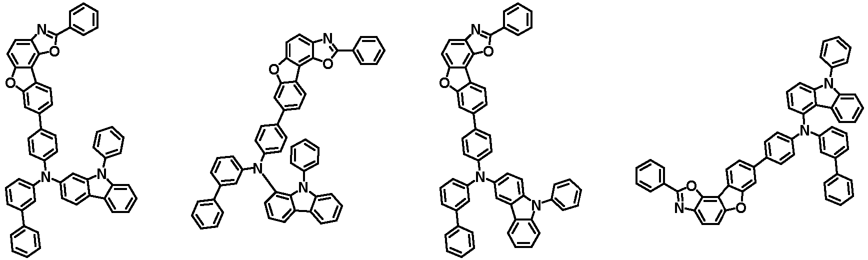

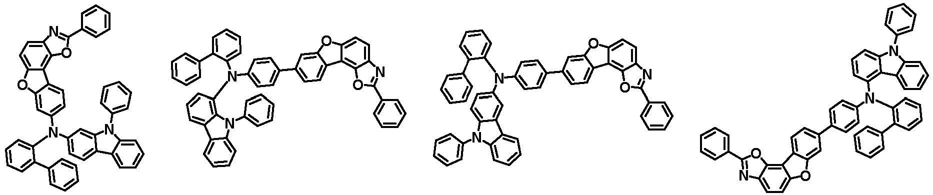

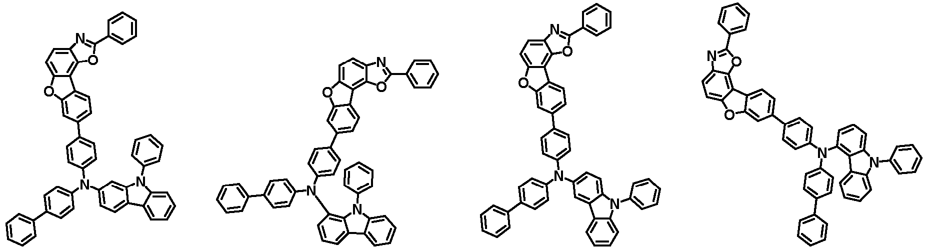

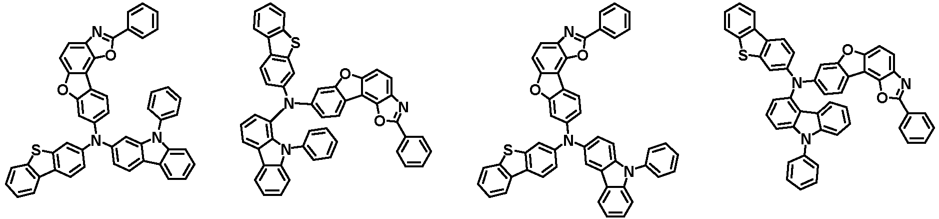

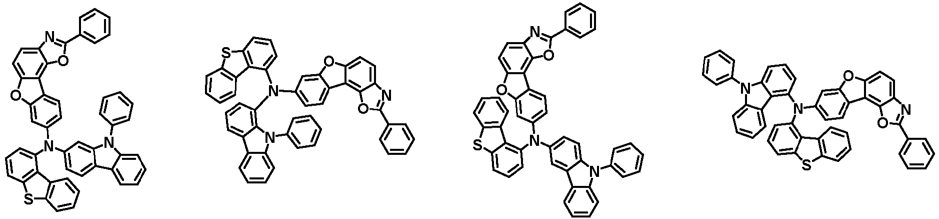

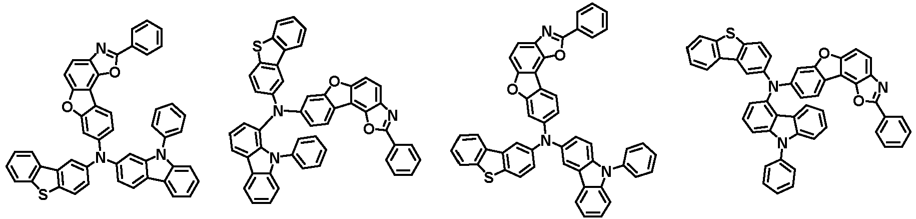

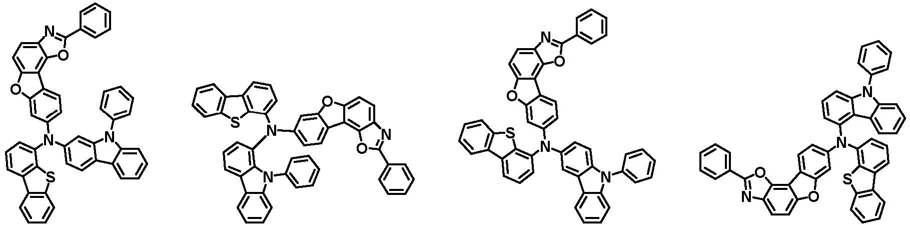

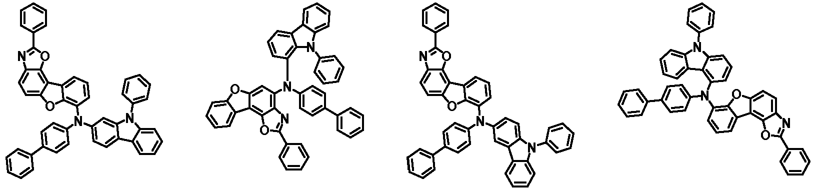

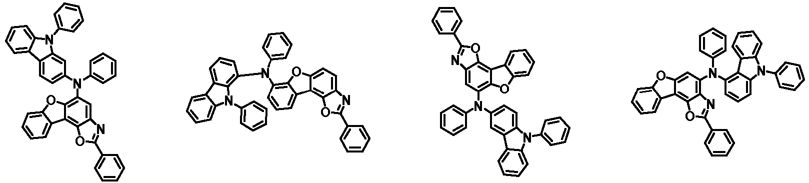

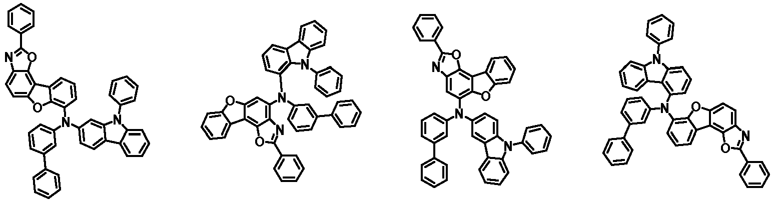

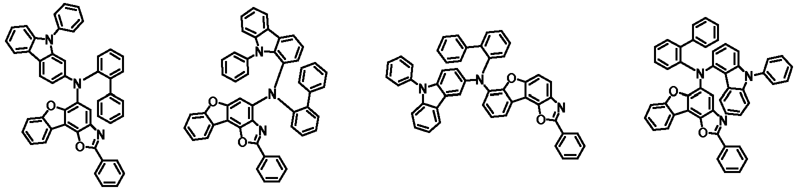

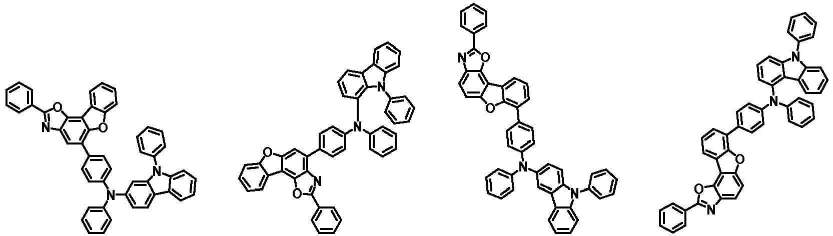

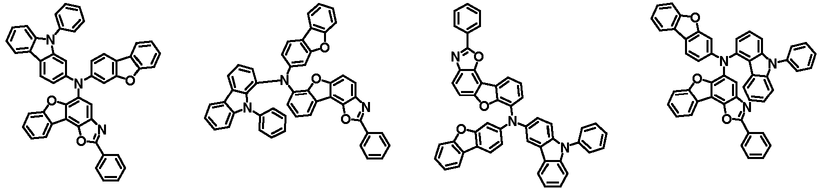

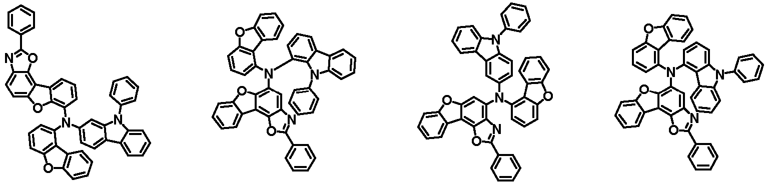

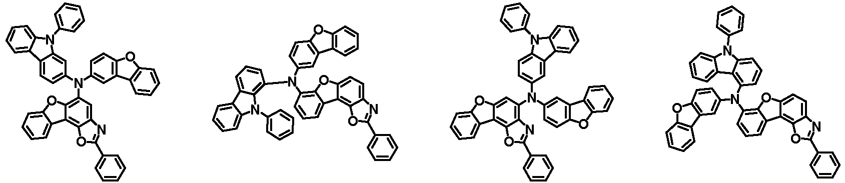

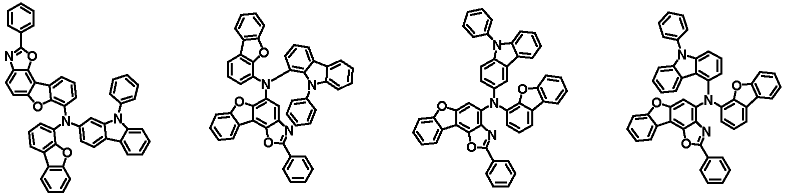

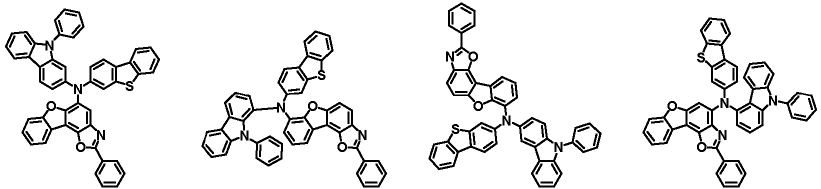

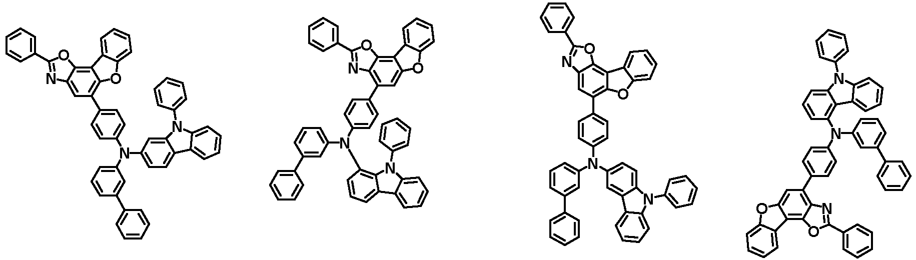

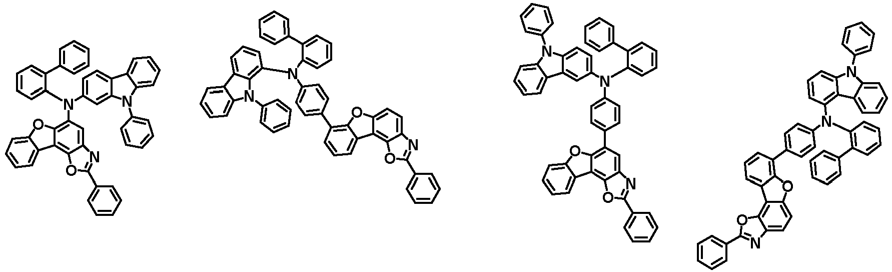

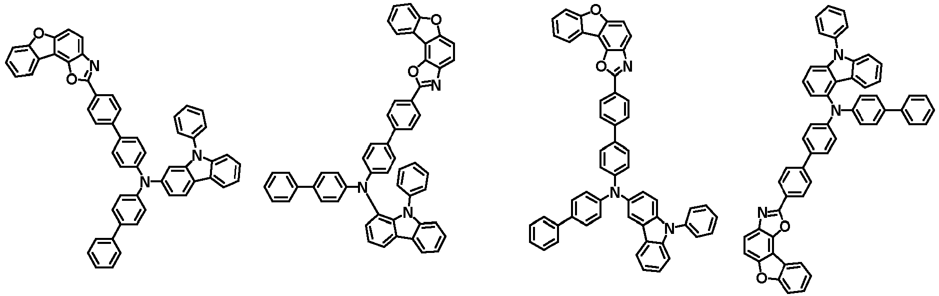

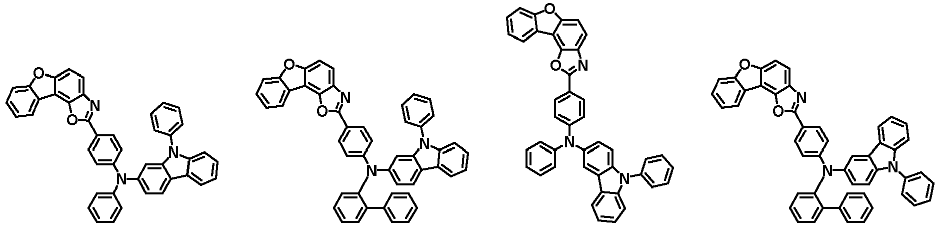

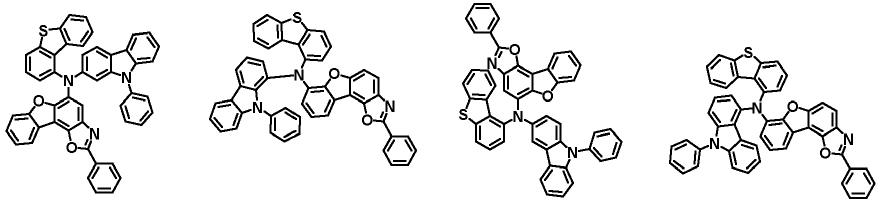

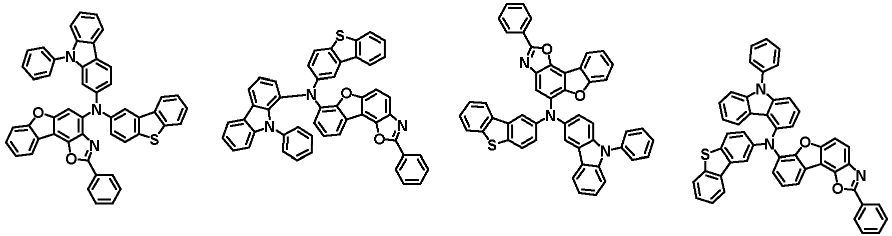

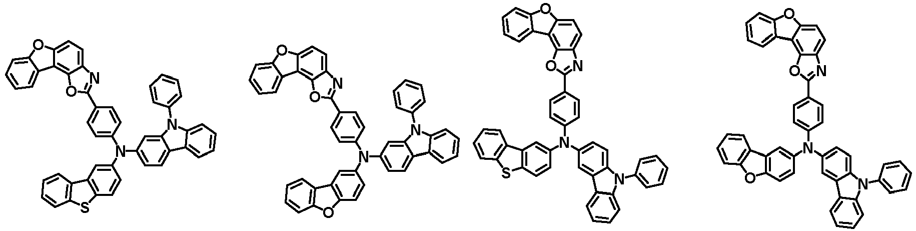

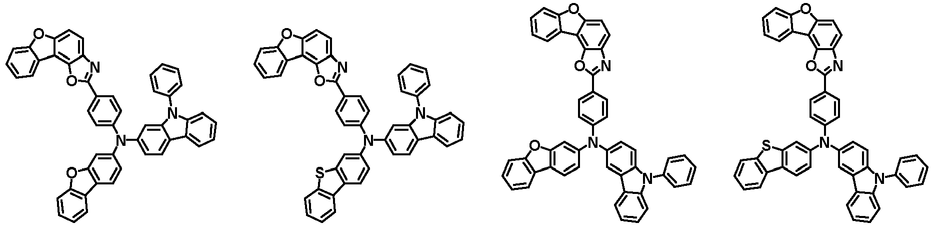

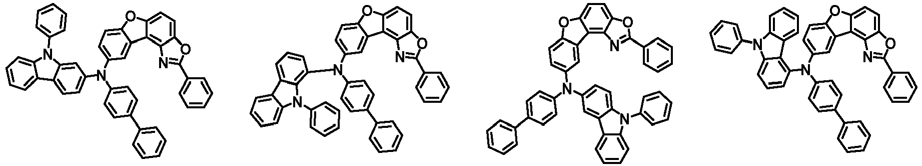

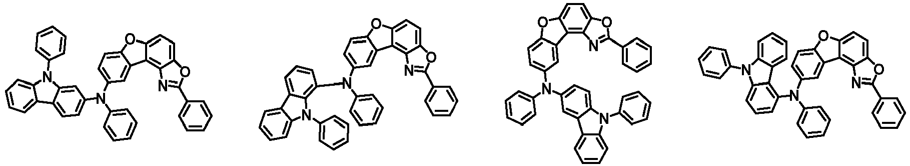

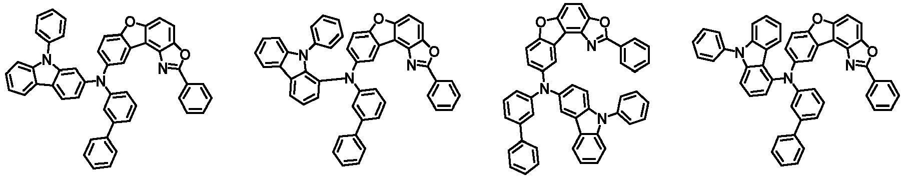

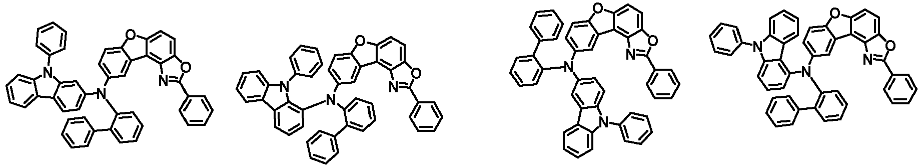

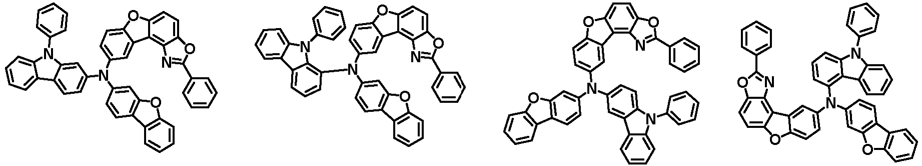

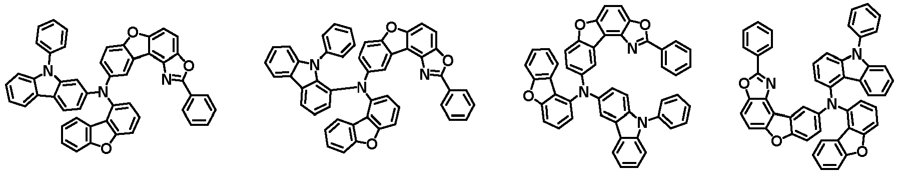

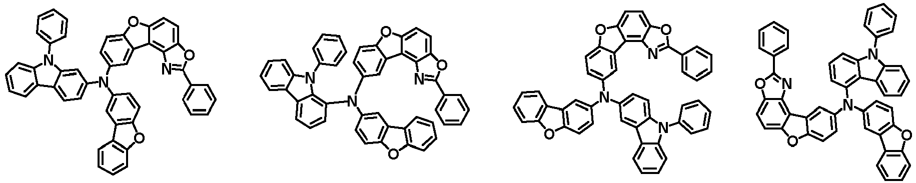

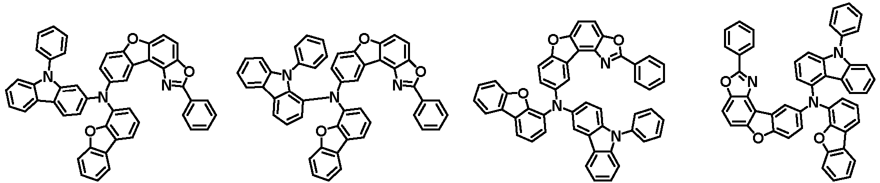

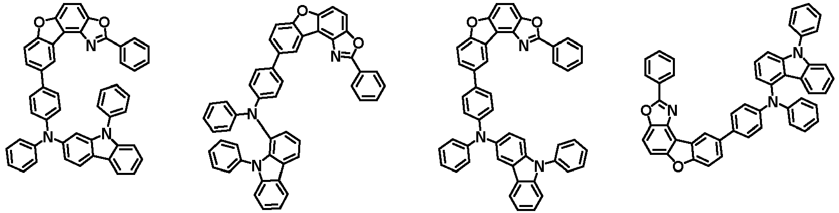

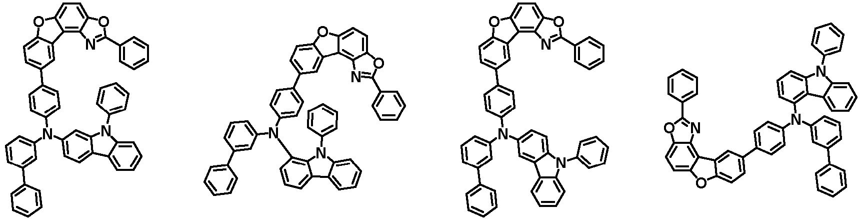

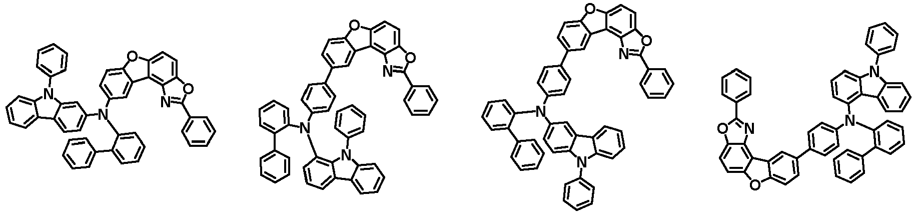

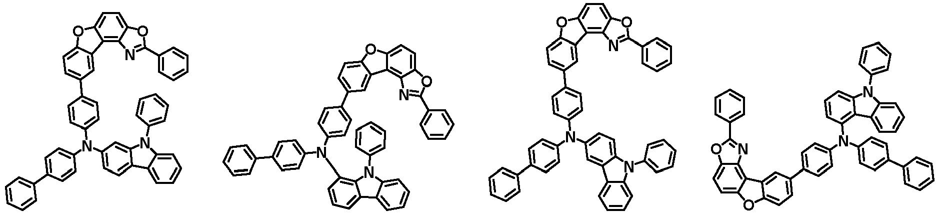

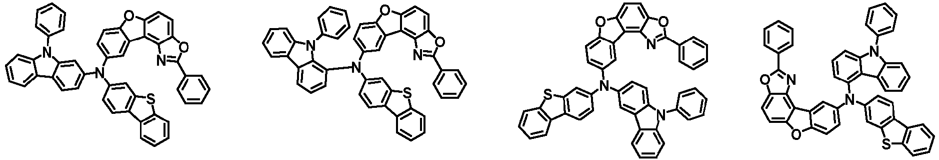

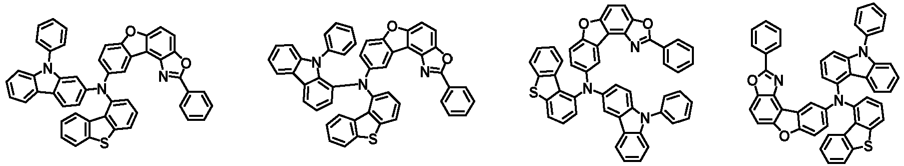

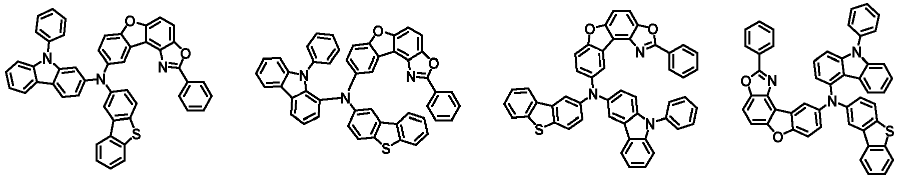

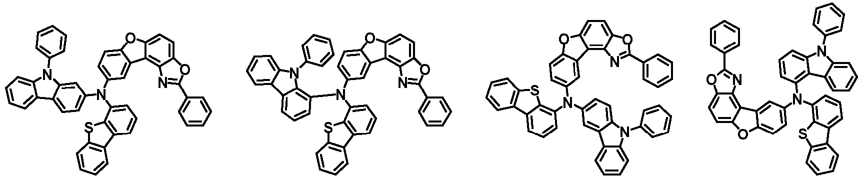

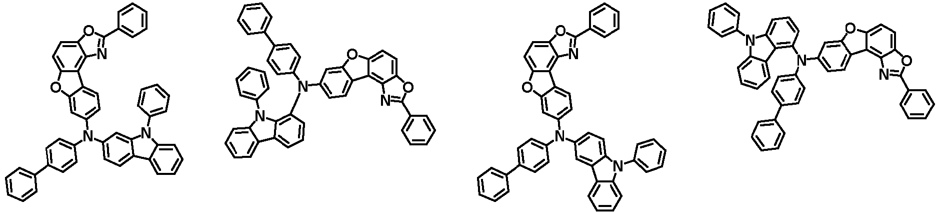

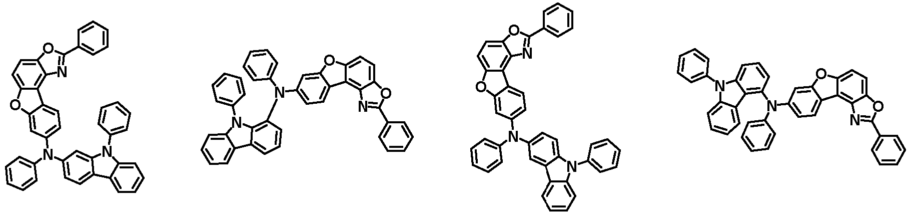

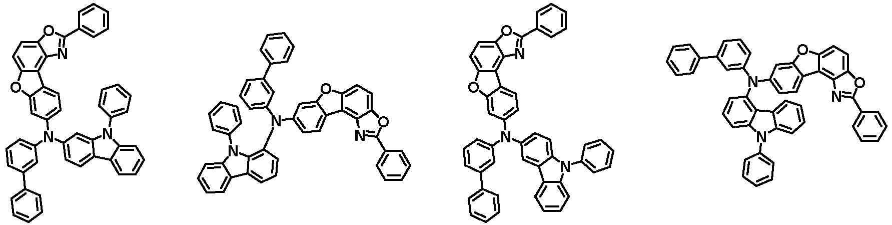

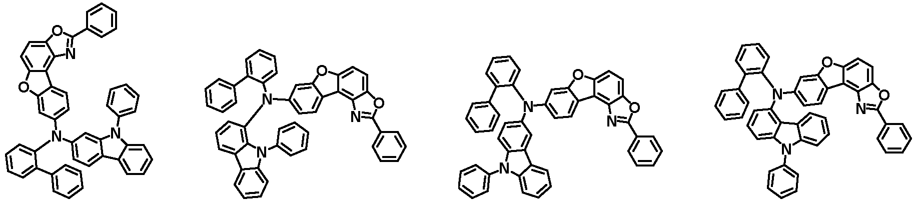

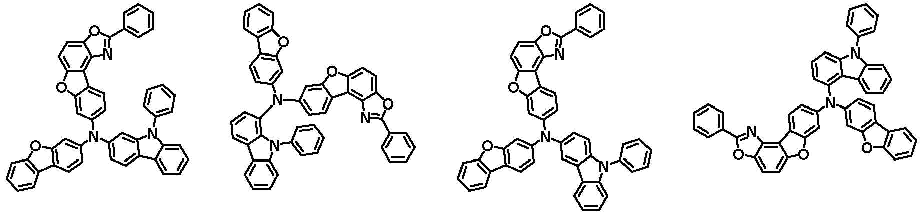

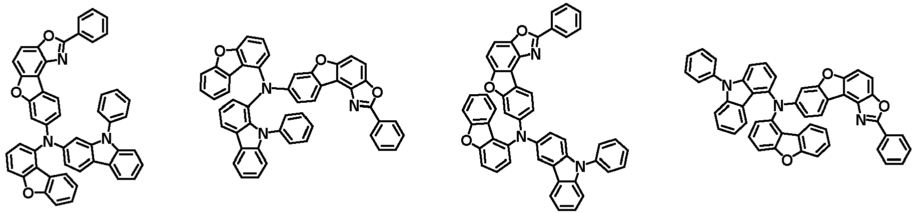

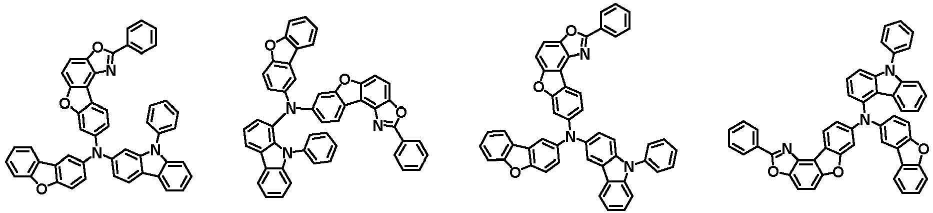

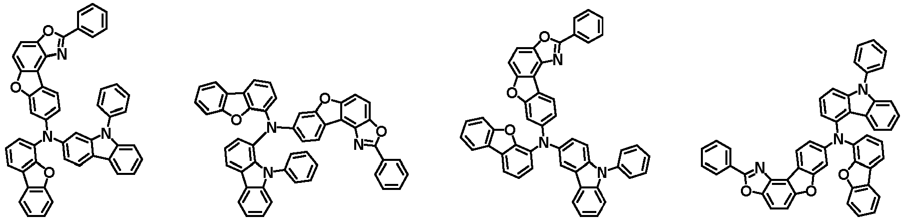

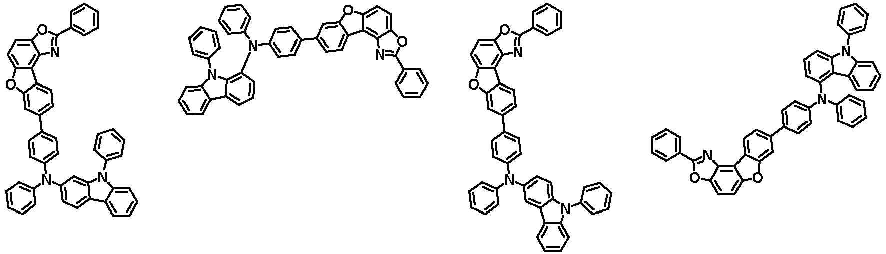

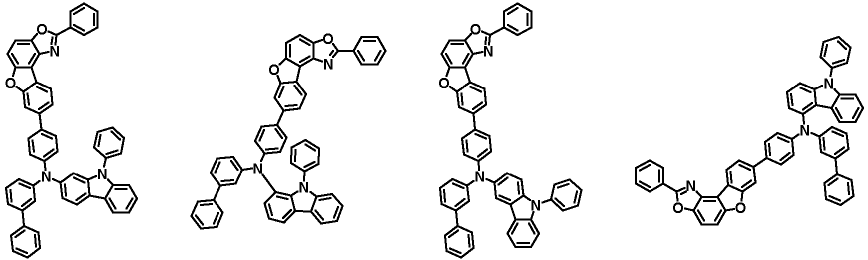

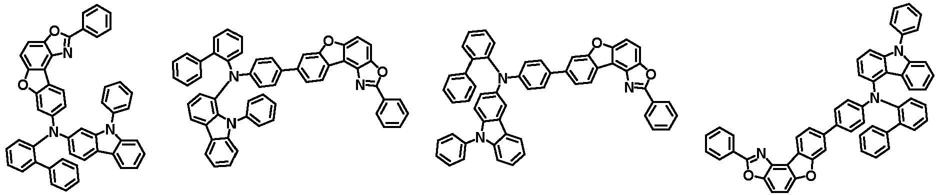

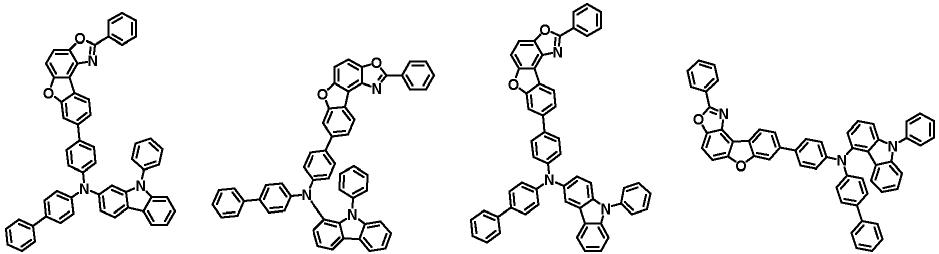

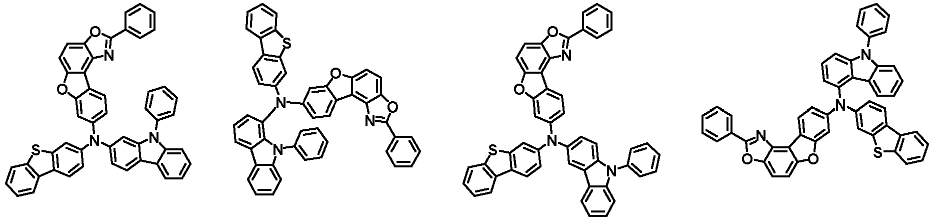

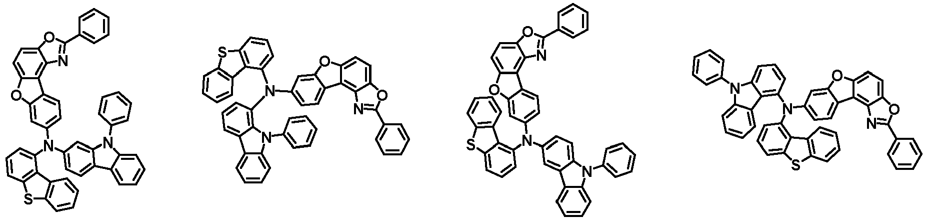

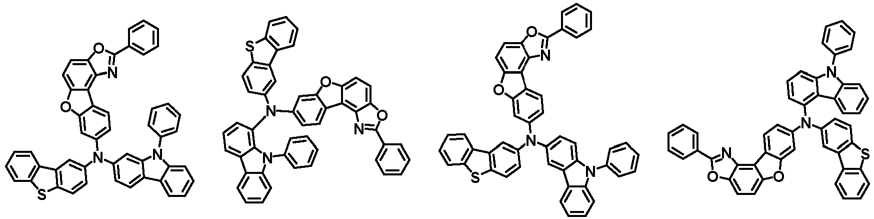

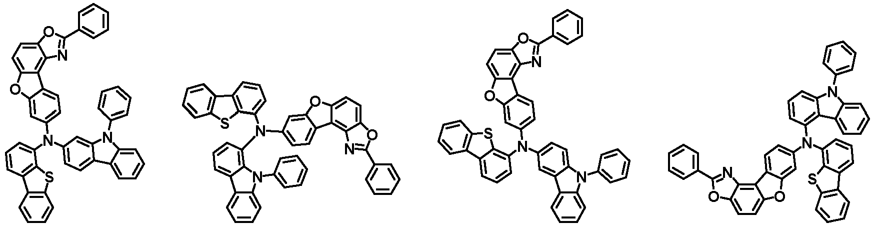

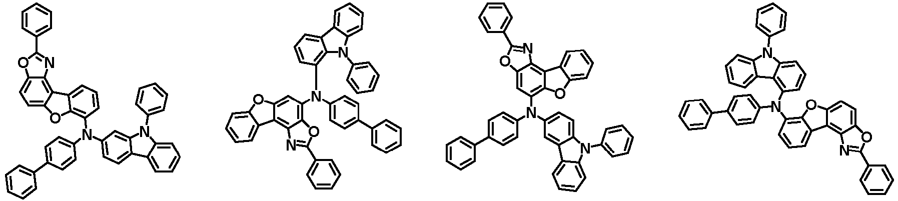

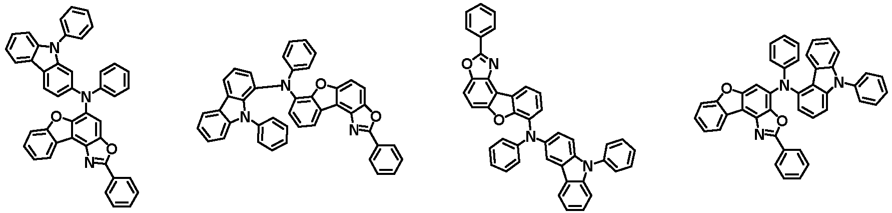

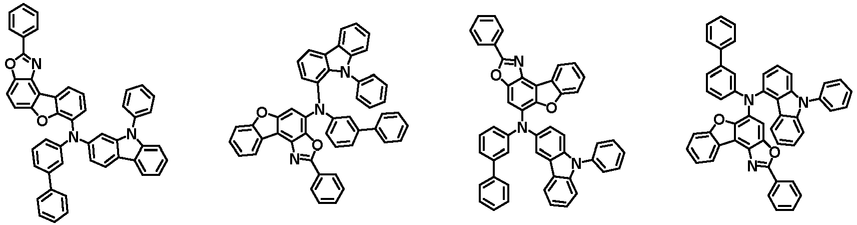

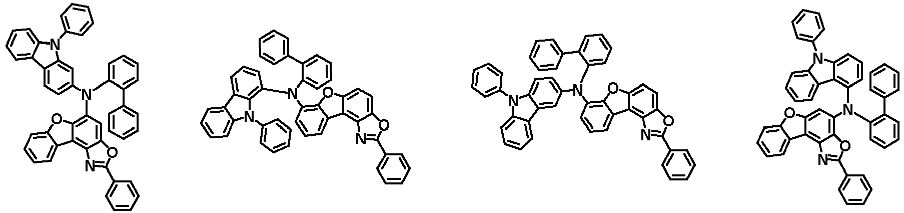

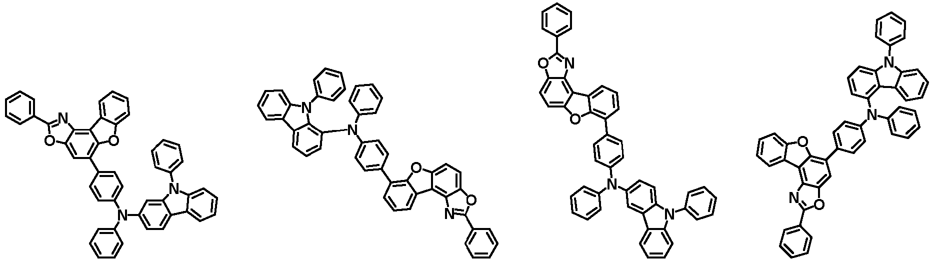

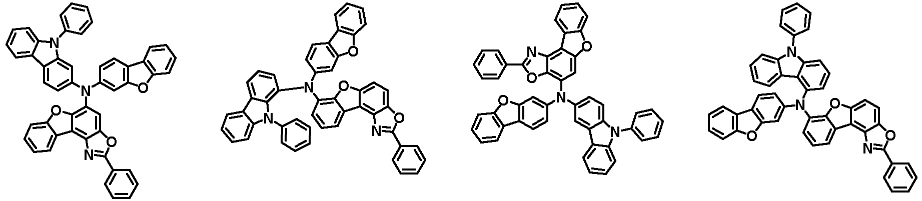

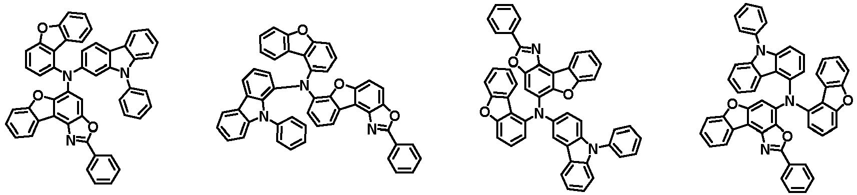

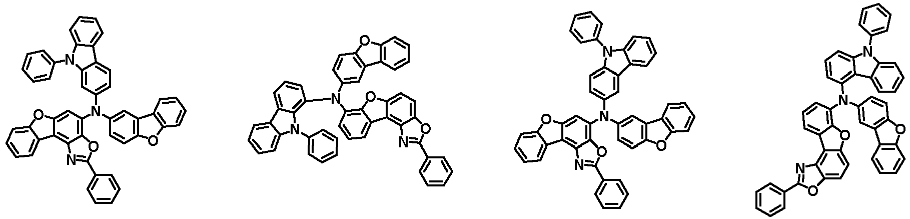

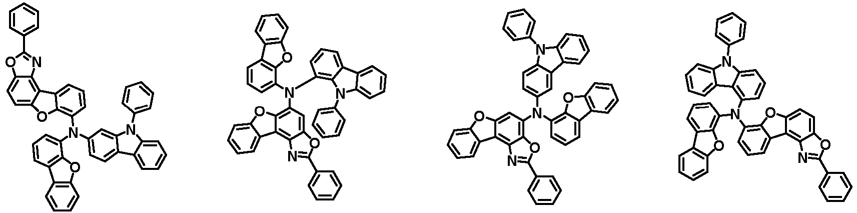

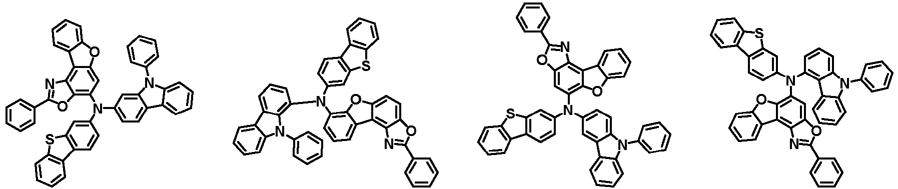

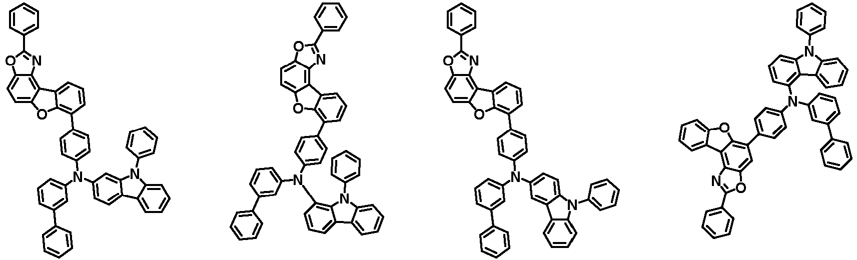

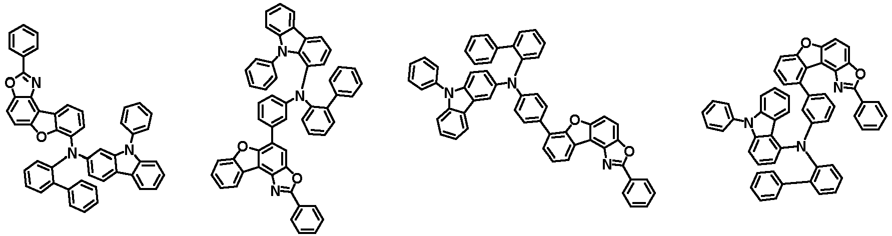

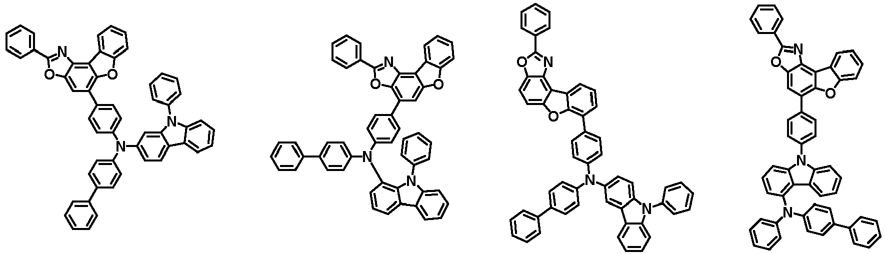

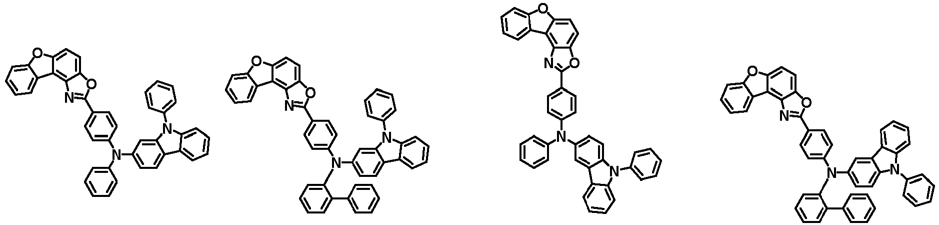

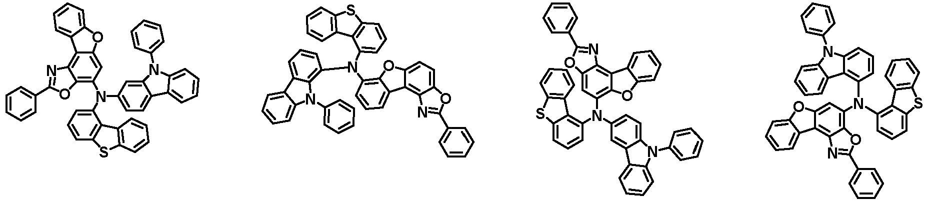

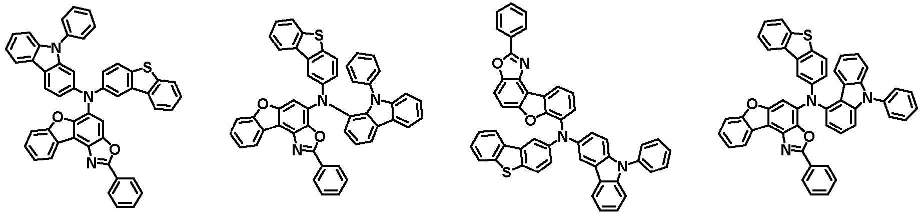

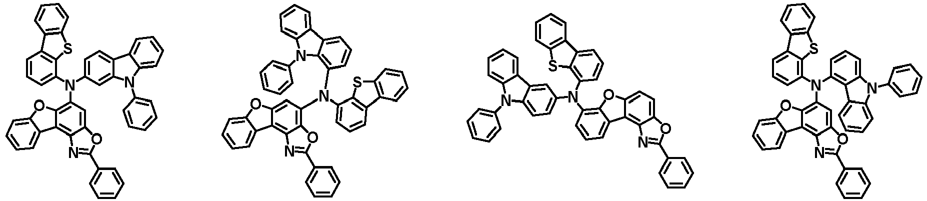

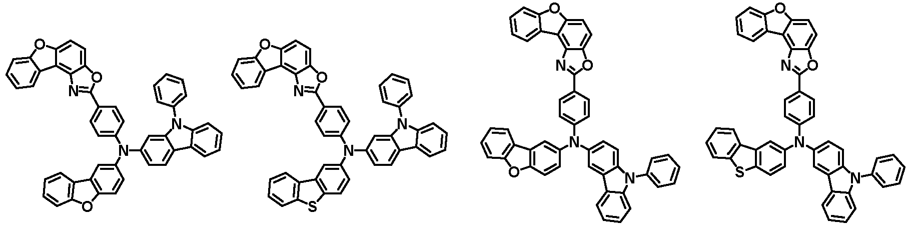

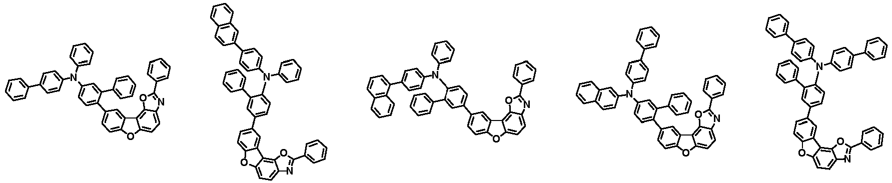

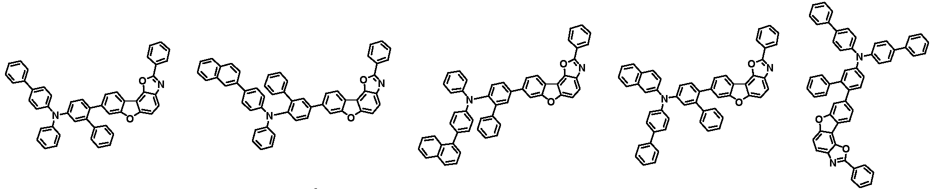

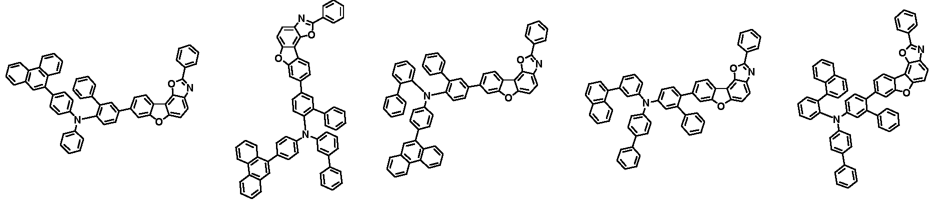

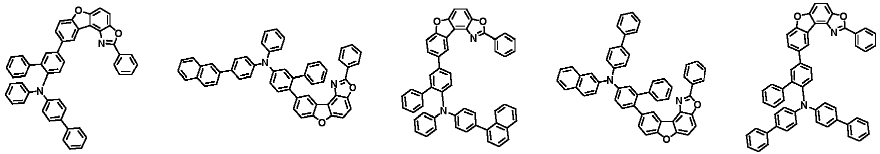

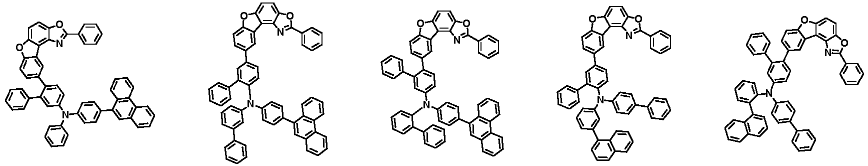

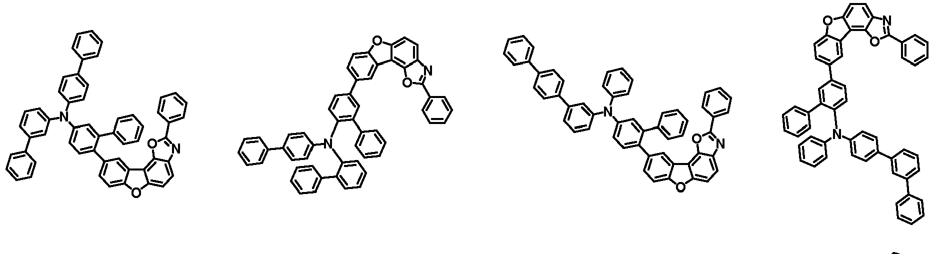

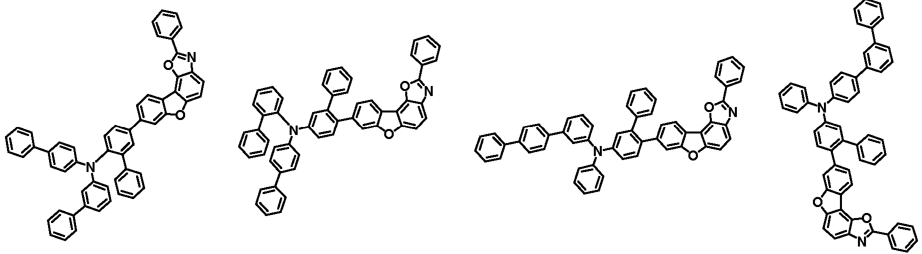

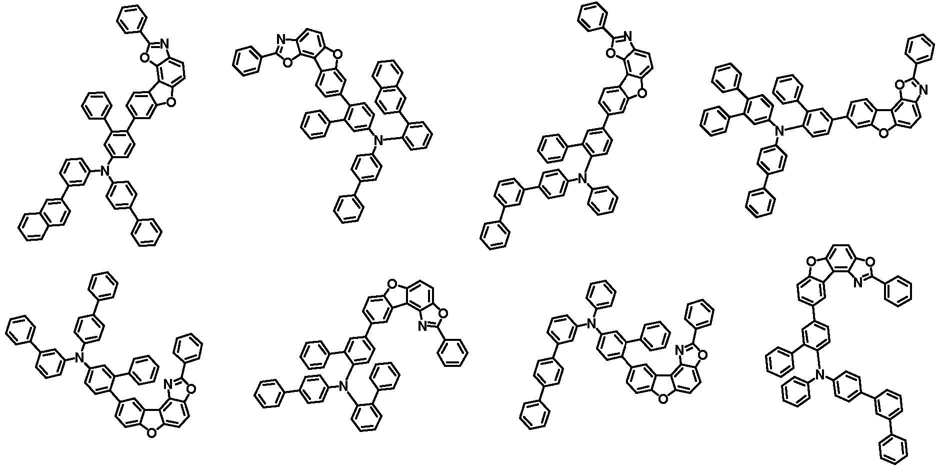

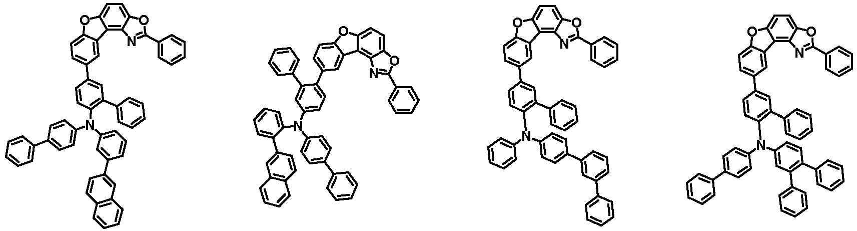

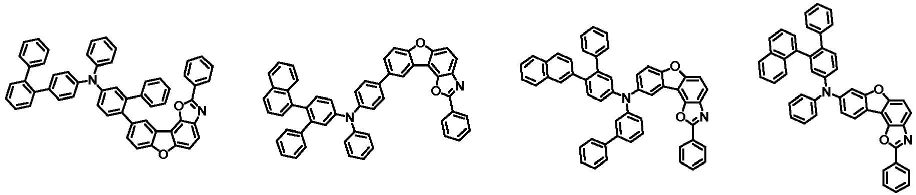

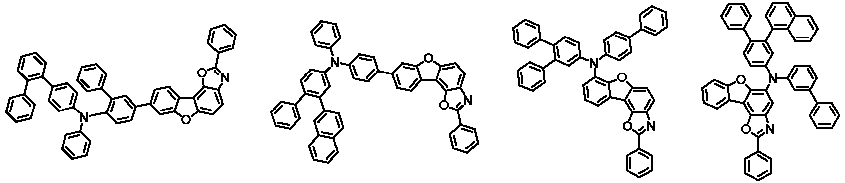

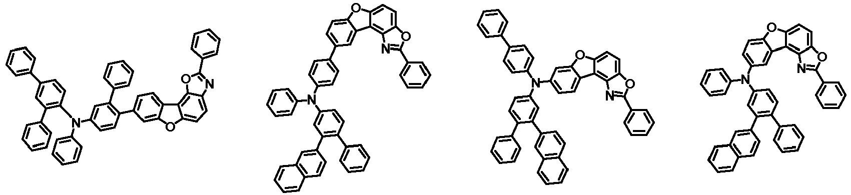

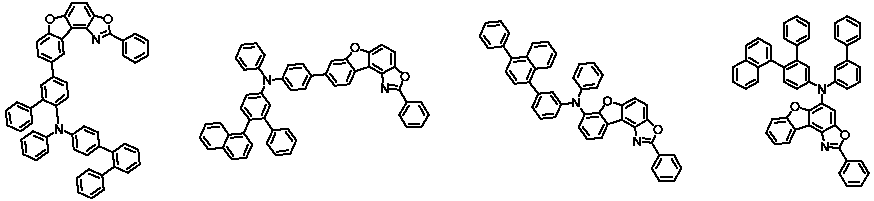

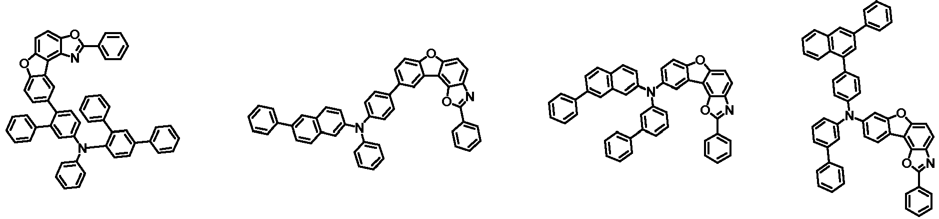

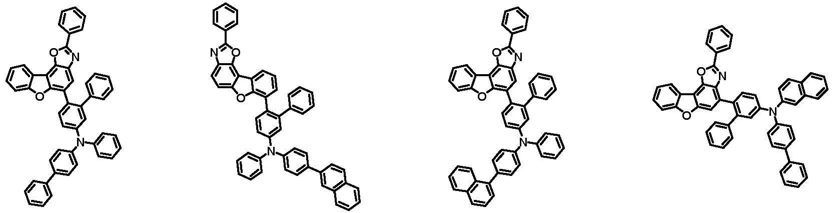

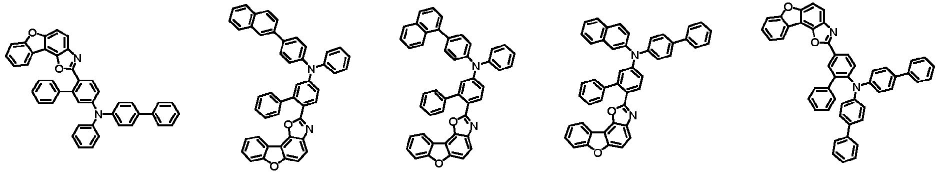

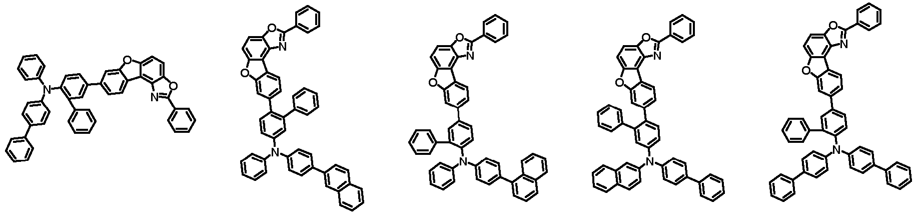

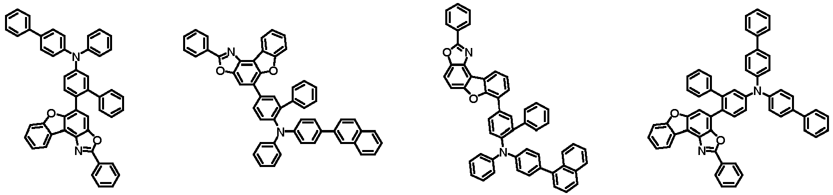

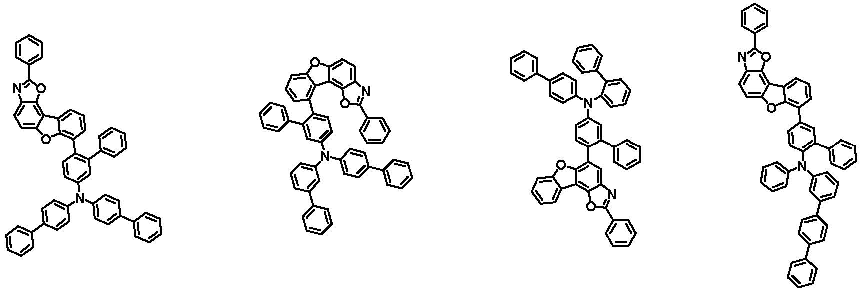

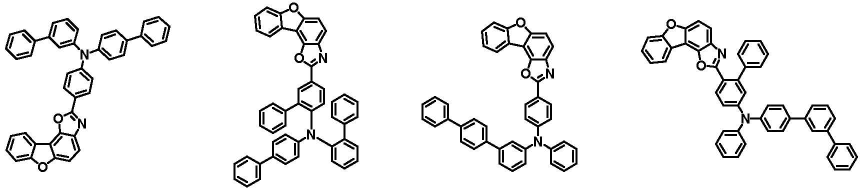

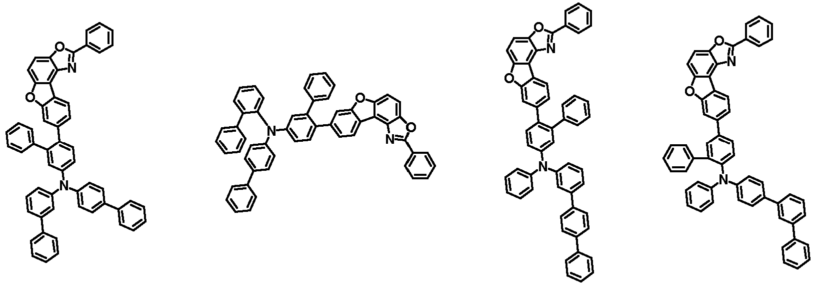

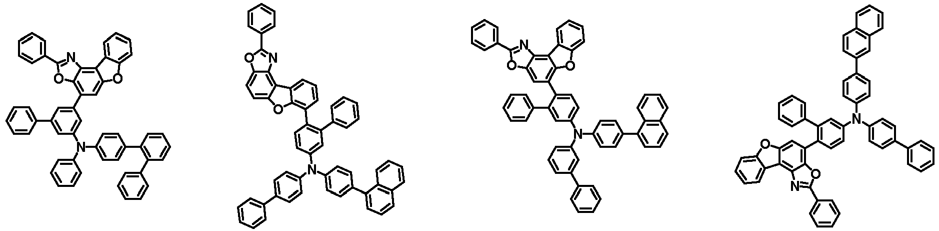

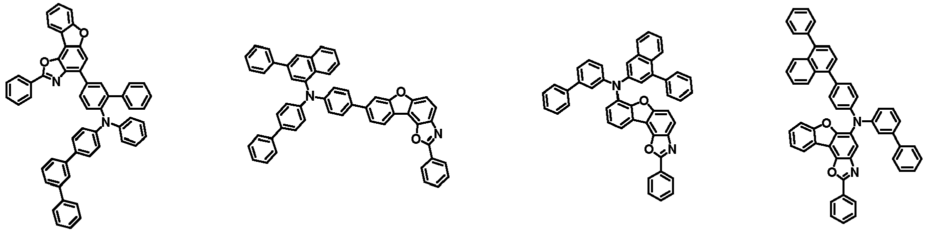

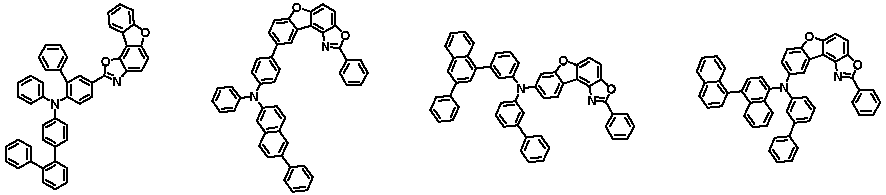

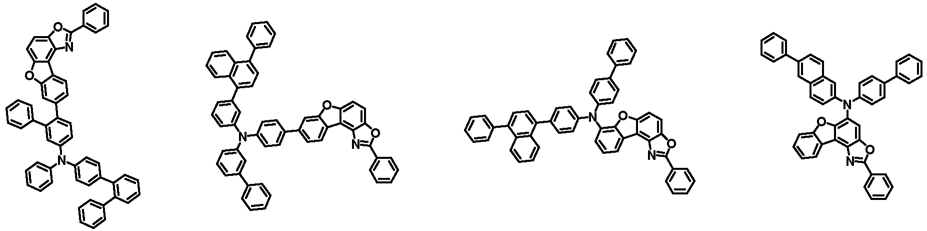

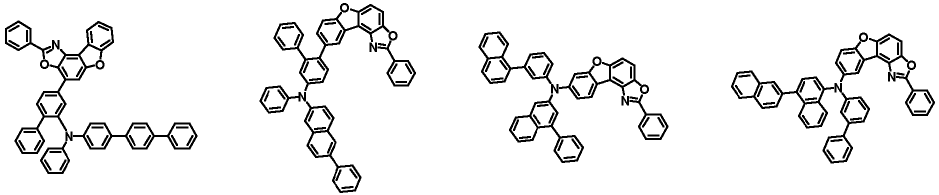

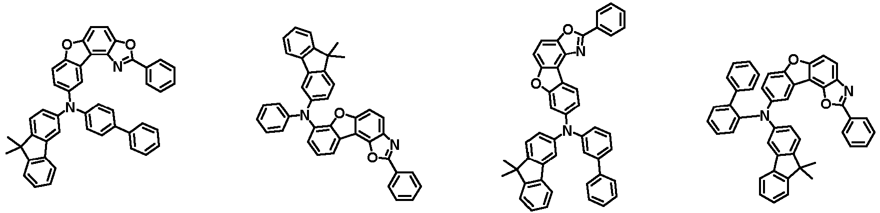

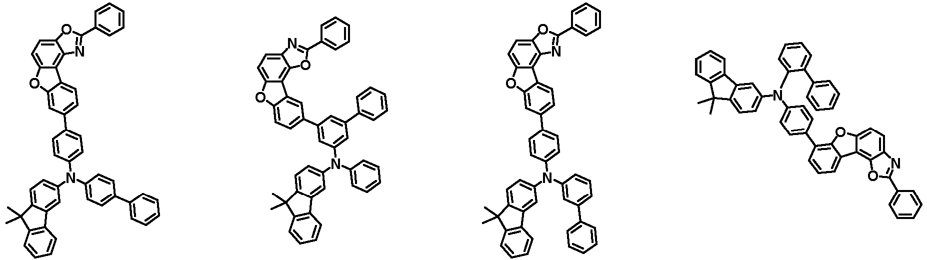

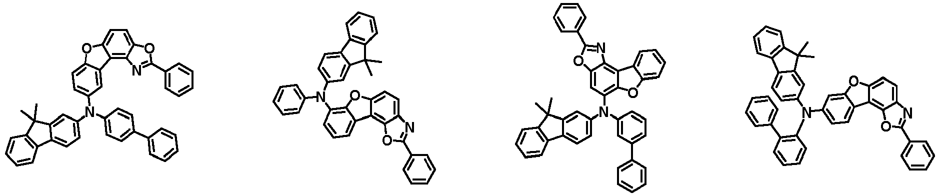

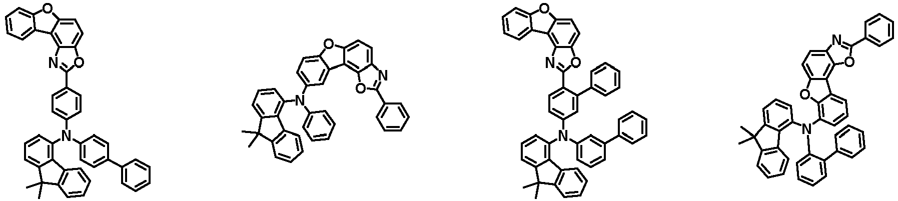

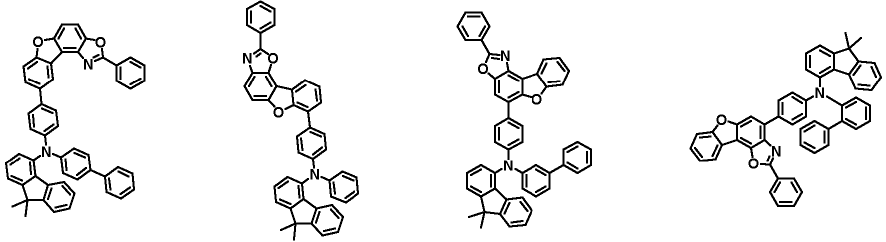

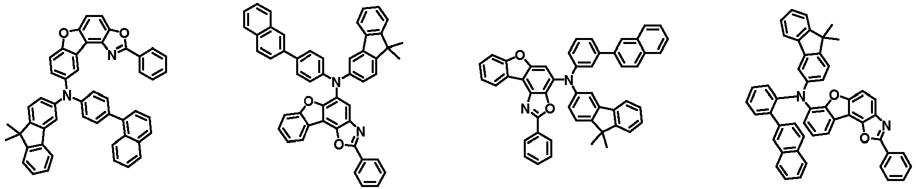

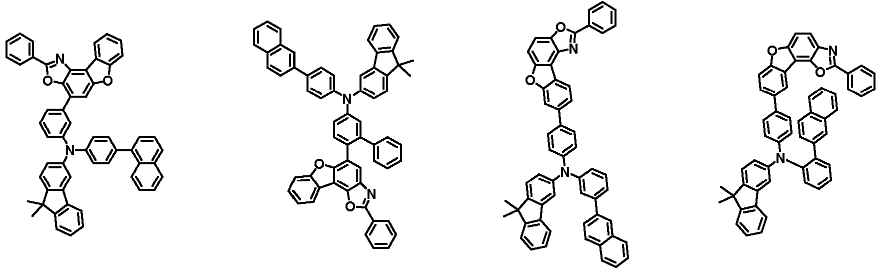

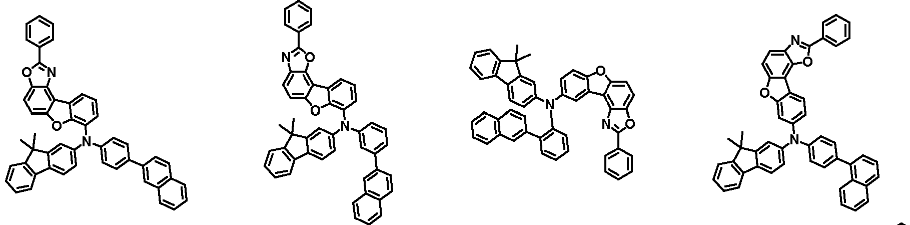

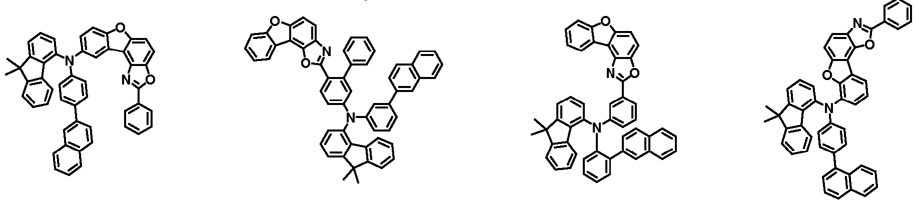

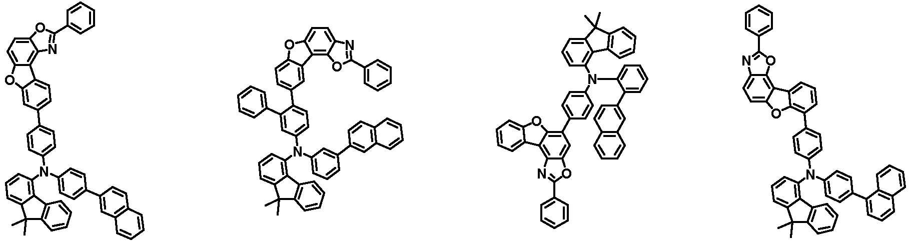

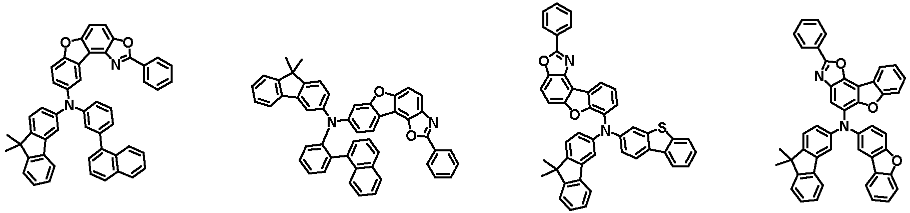

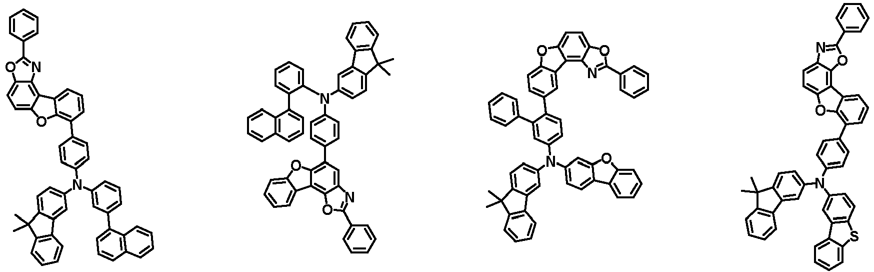

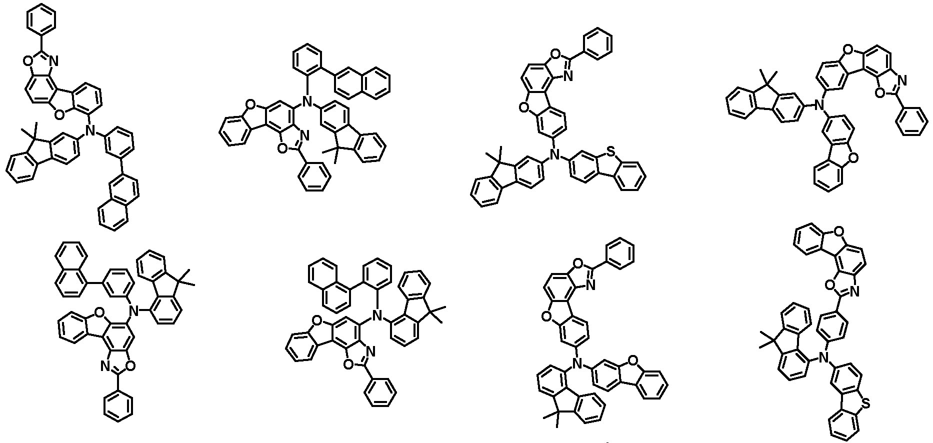

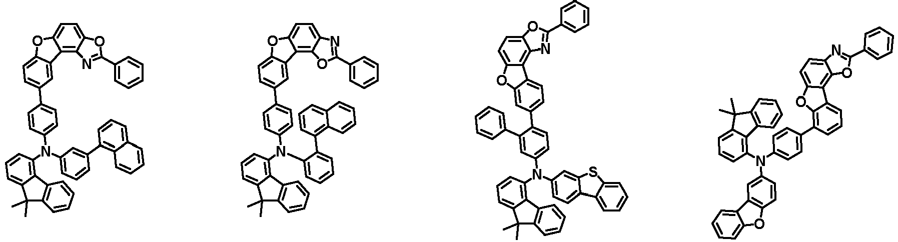

## Revendications

1. Dispositif électroluminescent organique comprenant :
une anode (2) ; une cathode (4) ; et une couche électroluminescente (3) disposée entre l'anode et la cathode,
dans lequel la couche électroluminescente comprend un composé représenté par la Formule chimique 1 suivante et un composé représenté par la Formule chimique 2 suivante : 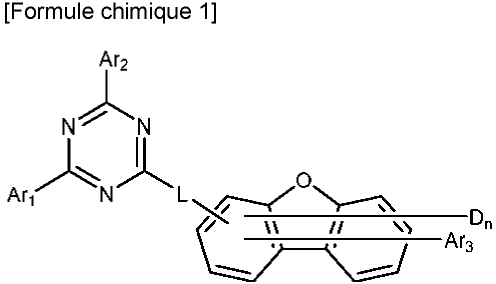 dans la Formule chimique 1,
L est une liaison simple ; ou un arylène en C₆₋₆₀ substitué ou non substitué ;
Ar₁ et Ar₂ sont chacun indépendamment un aryle en C₆₋₆₀ substitué ou non substitué ; ou
un hétéroaryle en C₂₋₆₀ substitué ou non substitué contenant au moins l'un sélectionné parmi le groupe consistant en N, O et S,
Ar₃ est un hydrogène ; un deutérium ; un aryle en C₆₋₆₀ substitué ou non substitué ; ou un hétéroaryle en C₂₋₆₀ substitué ou non substitué contenant au moins un sélectionné parmi le groupe consistant en N, O et S,
D est un deutérium, et
n est un nombre entier de 0 à 6, 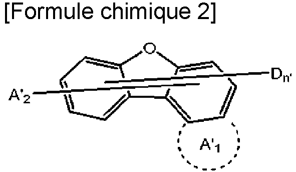 dans la Formule chimique 2,
A'₁ est représenté par la Formule chimique 2-a suivante, 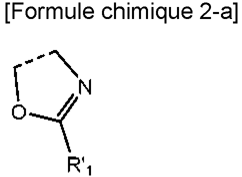 dans la Formule chimique 2-a,
la ligne pointillée est fusionnée avec un cycle adjacent,
R'₁ est Ar'₁ ; ou un substituant représenté par la Formule chimique 2-b suivante, et Ar'₁ est un aryle en C₆₋₆₀ substitué ou non substitué ; ou un hétéroaryle en C₂₋₆₀ substitué ou non substitué contenant au moins un hétéroatome sélectionné parmi le groupe consistant en N, O et S, et 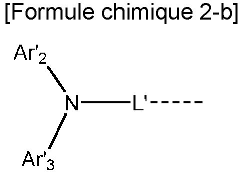 dans la Formule chimique 2-b,
L' est une liaison simple ; ou un arylène en C₆₋₆₀ substitué ou non substitué ;
Ar'₂ et Ar'₃ sont chacun indépendamment un hydrogène ; un deutérium ; un aryle en C₆₋₆₀ substitué ou non substitué ; ou un hétéroaryle en C₂₋₆₀ substitué ou non substitué contenant au moins un hétéroatome sélectionné parmi le groupe consistant en N, O et S,
lorsque R'₁ est Ar'₁, A'₂ est un substituant représenté par la Formule chimique 2-b,
lorsque R'₁ est un substituant représenté par la Formule chimique 2-b, A'₂ est un hydrogène ; ou un deutérium,
D est un deutérium, et
n'est un nombre entier de 0 à 5.

2. Dispositif électroluminescent organique selon la revendication 1,
dans lequel la Formule chimique 1 est représentée par la Formule chimique 1-1 suivante : 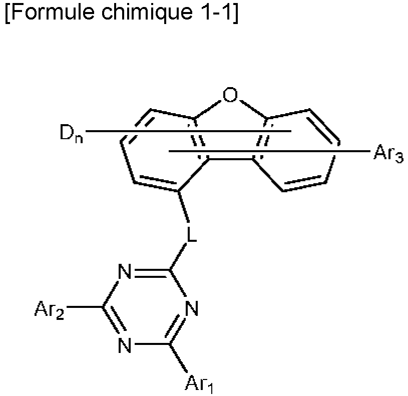 dans la Formule chimique 1-1,
L, Ar₁ à Ar₃, D, et n sont tels que définis dans la revendication 1.

3. Dispositif électroluminescent organique selon la revendication 1,
dans lequel L est une liaison simple ; un phénylène ; ou un naphthalènediyle.

4. Dispositif électroluminescent organique selon la revendication 1,
dans lequel Ar₁ et Ar₂ sont chacun indépendamment un phényle ; un biphénylyle ; un terphénylyle ; un naphthyle ; un phénanthrényle ; un (phényl)naphthyle ; un (naphthyl)phényle ; un (naphthyl)naphthyle ; un dibenzofuranyle ; ou un dibenzothiophényle.

5. Dispositif électroluminescent organique selon la revendication 1,
dans lequel Ar₃ est un hydrogène ; un phényle ; un biphénylyle ; un terphénylyle ; un naphtyle ; un phénanthrényle ; un (phényl)naphtyle ; un (naphtyl)phényle ; un fluoranthényle ; un triphénylène ; un dibenzofuranyle ; un dibenzothiophényle ; un benzonaphtophuranyle ; ou un benzonaphtothiophényle.

6. Dispositif électroluminescent organique selon la revendication 1,
dans lequel le composé représenté par la Formule chimique 1 est l'un quelconque sélectionné parmi le groupe consistant en :

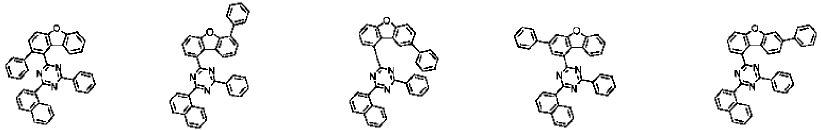

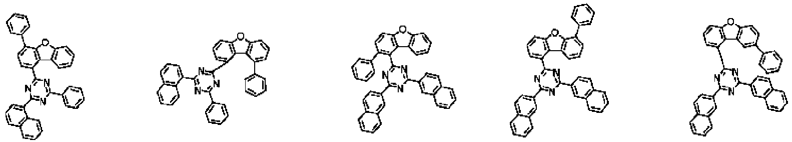

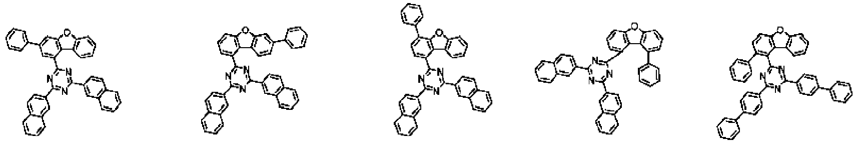

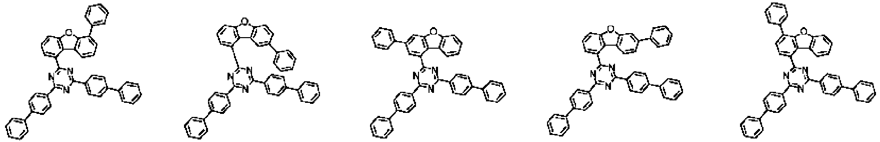

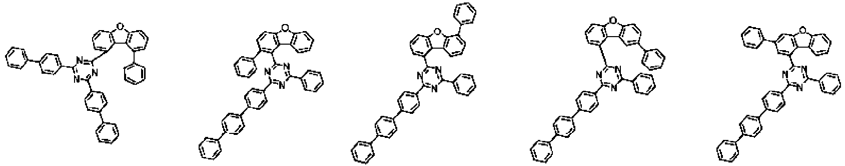

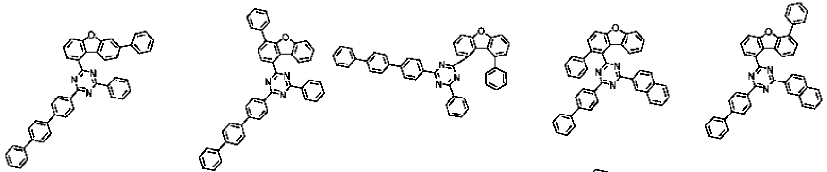

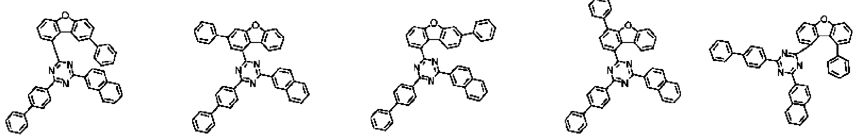

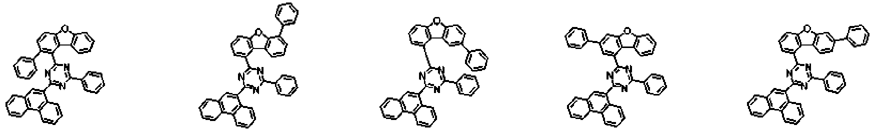

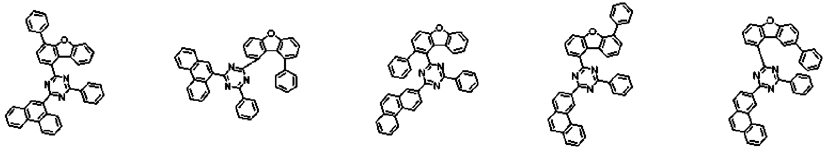

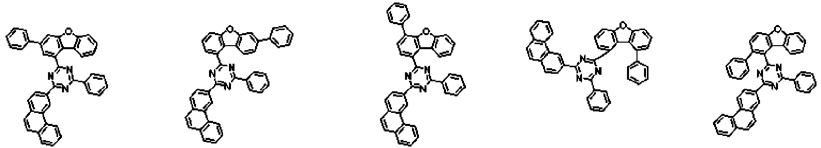

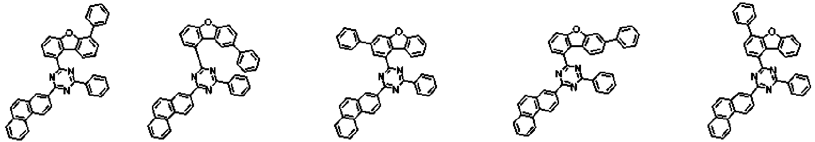

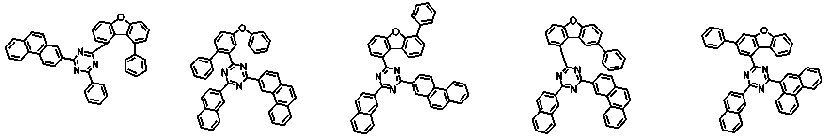

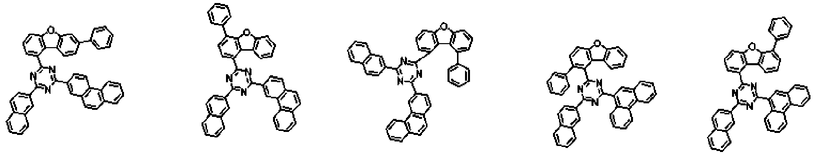

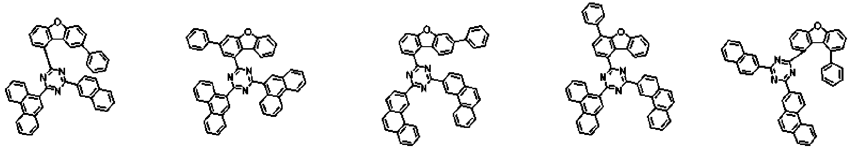

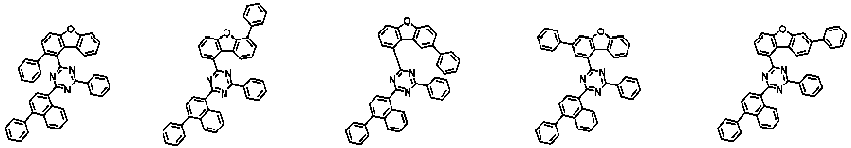

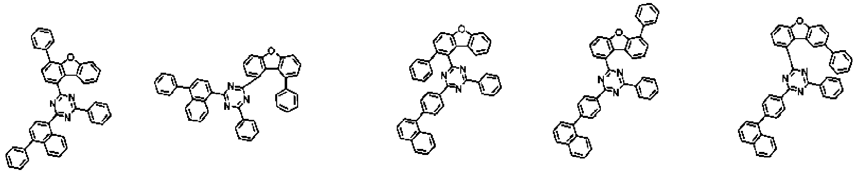

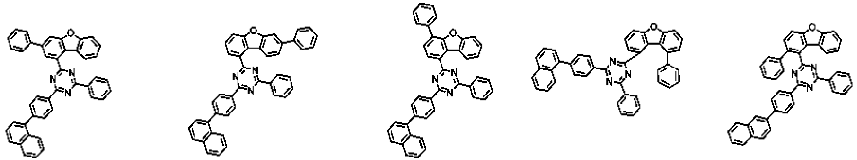

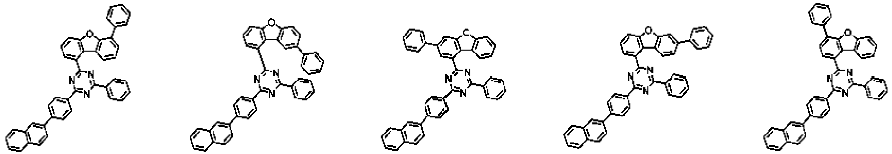

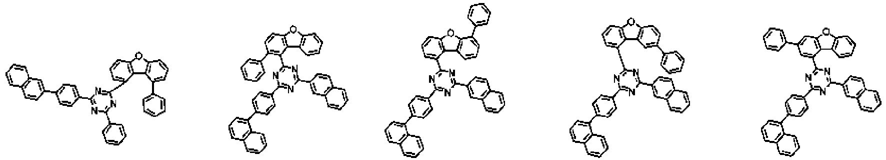

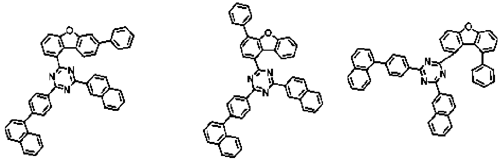

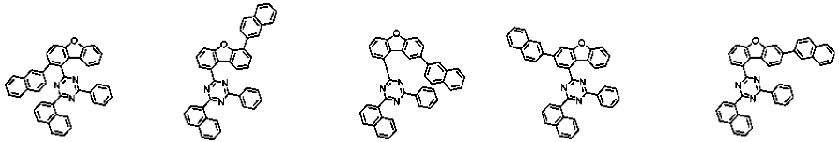

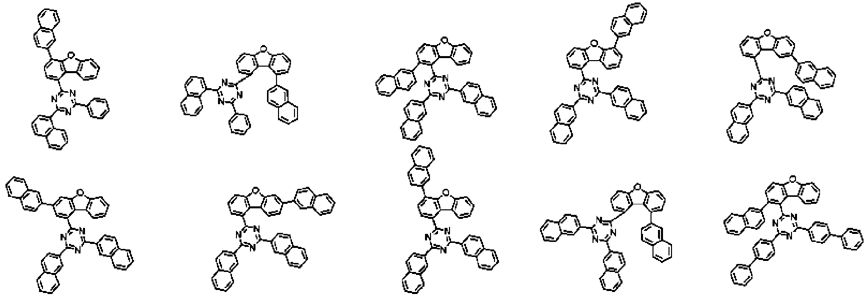

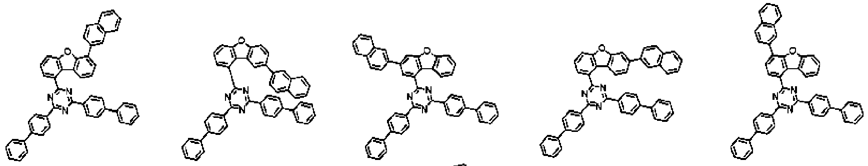

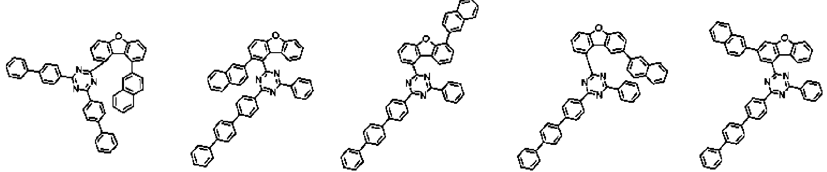

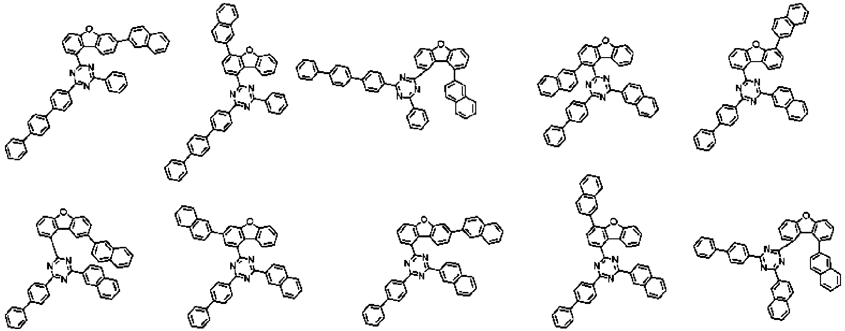

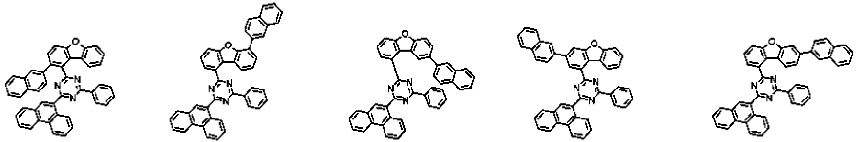

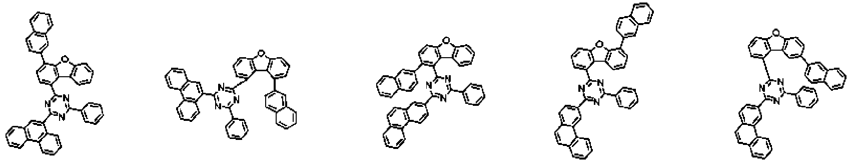

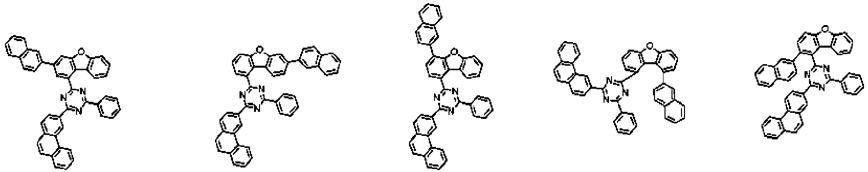

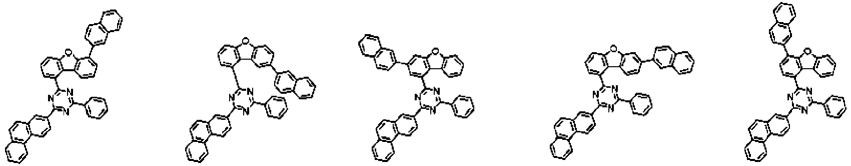

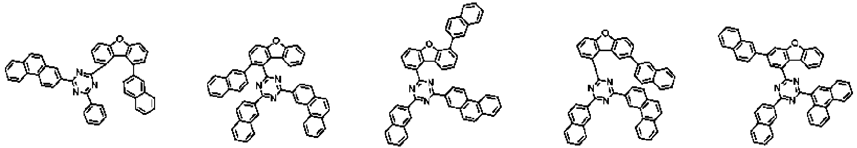

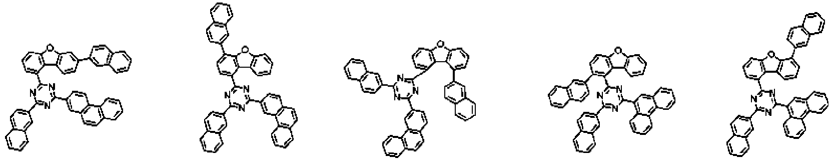

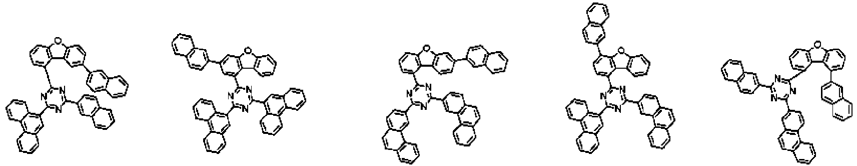

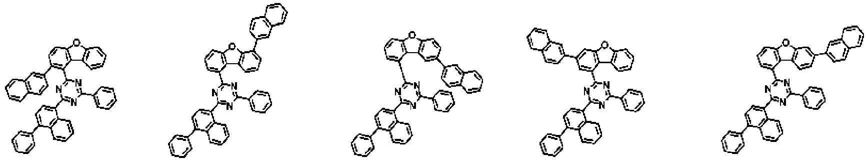

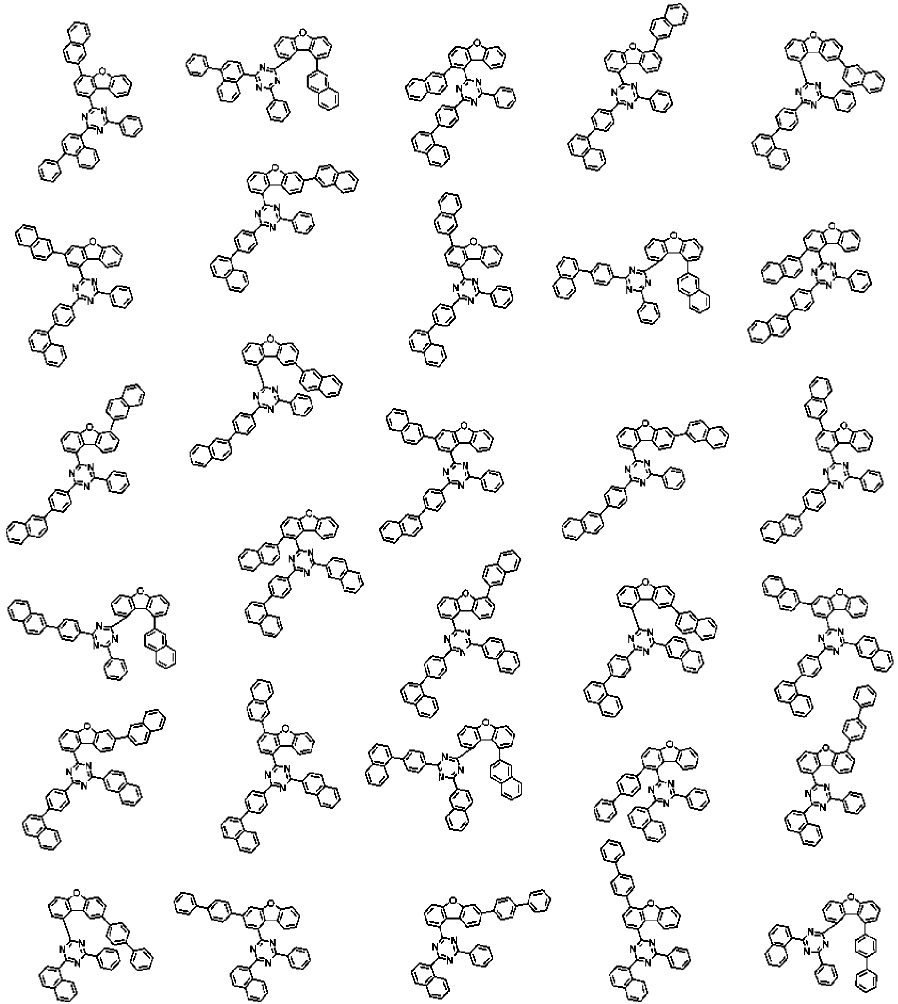

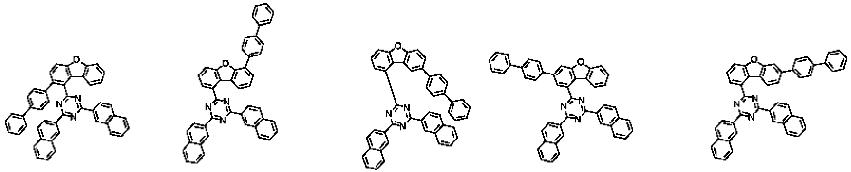

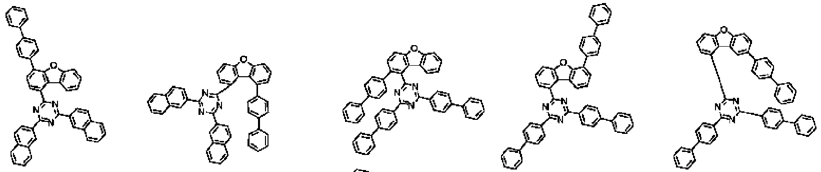

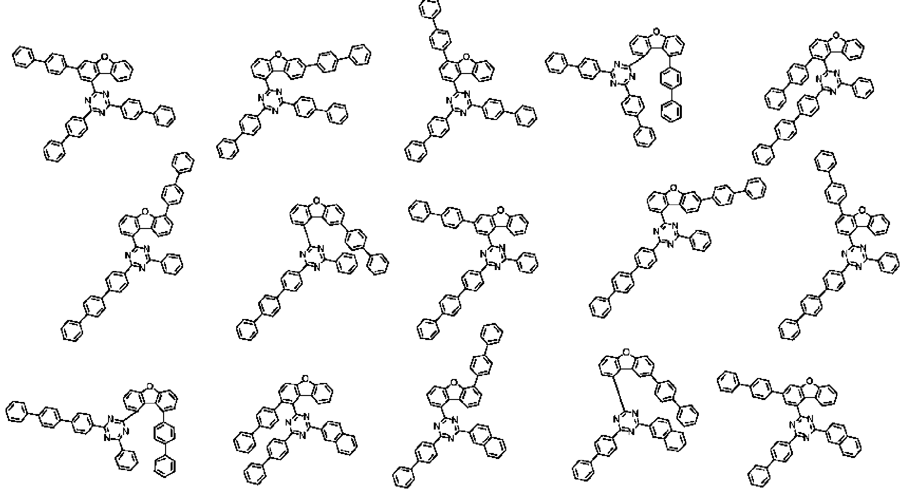

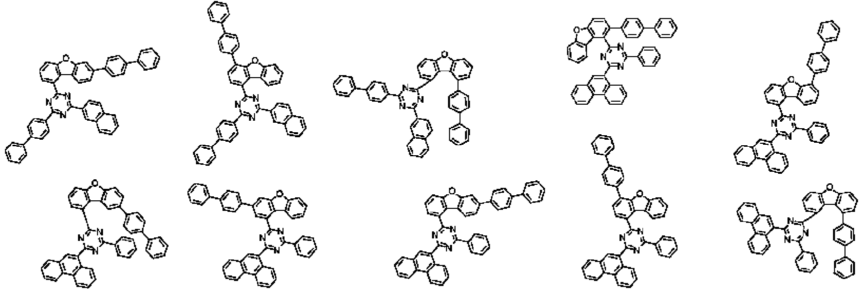

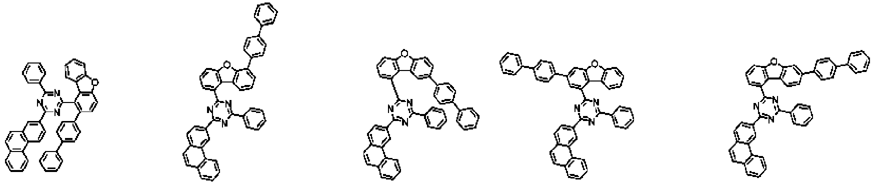

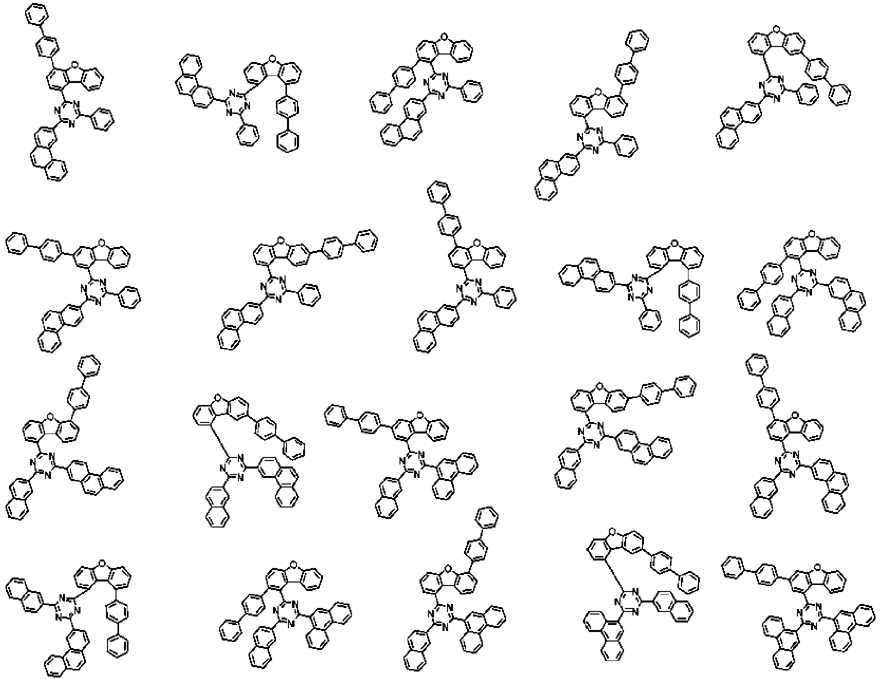

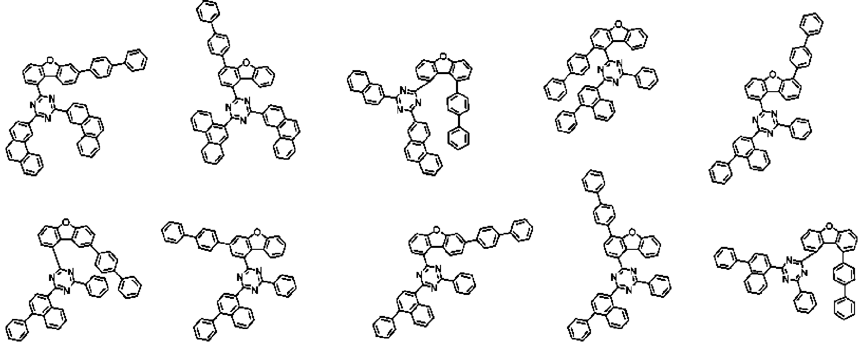

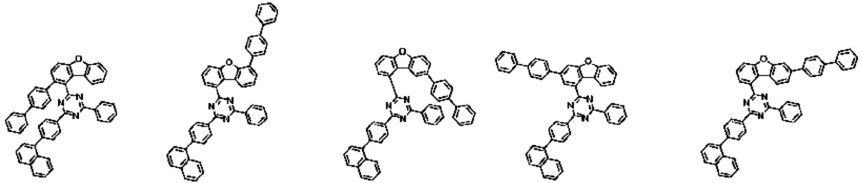

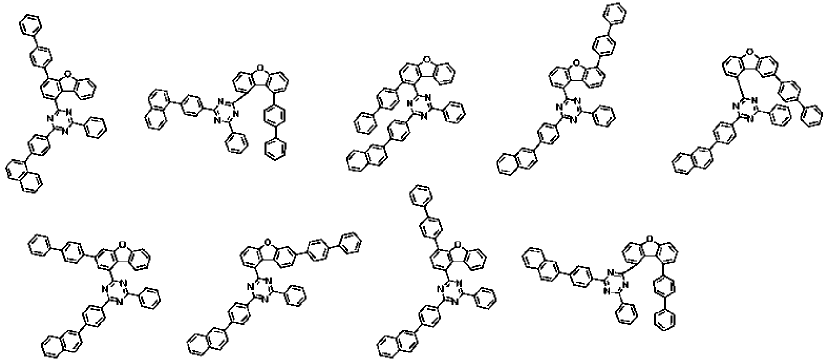

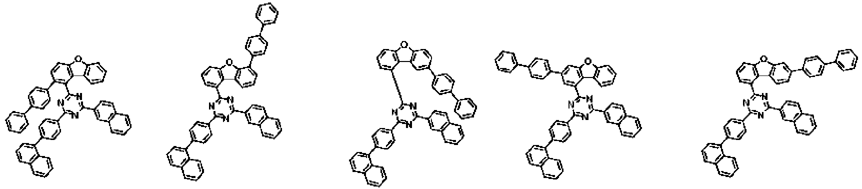

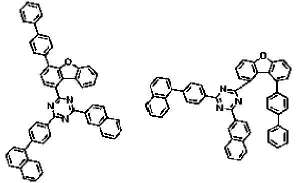

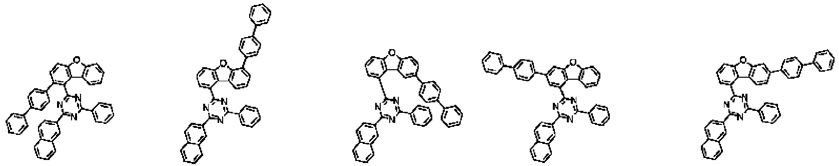

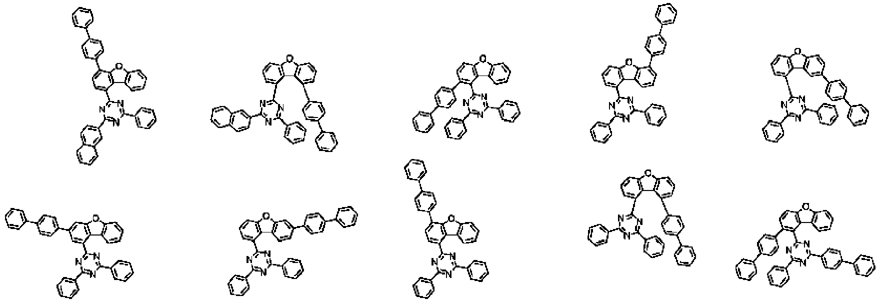

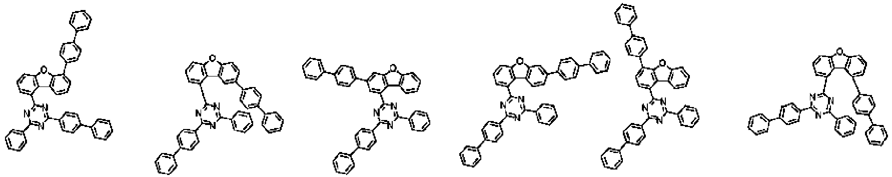

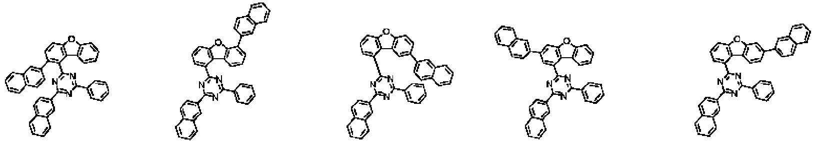

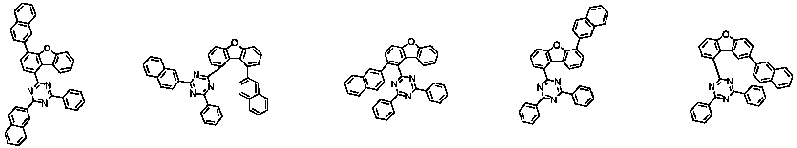

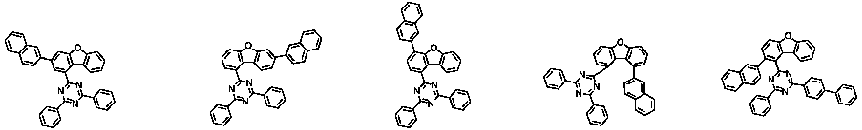

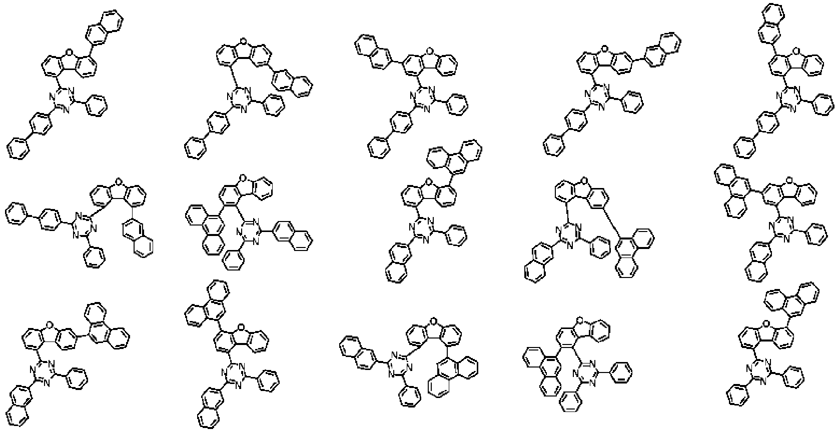

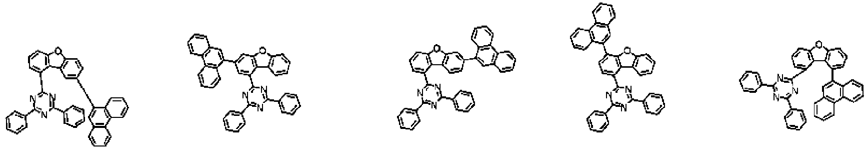

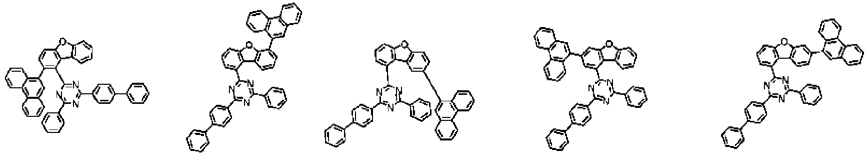

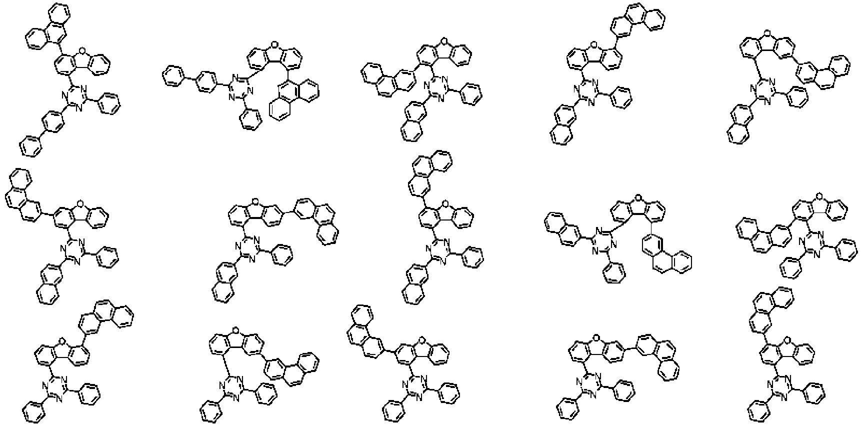

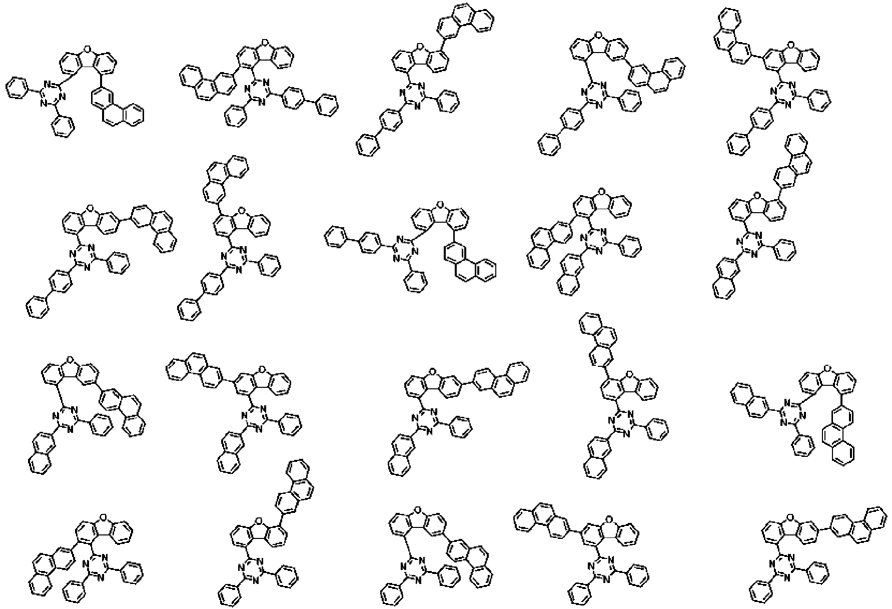

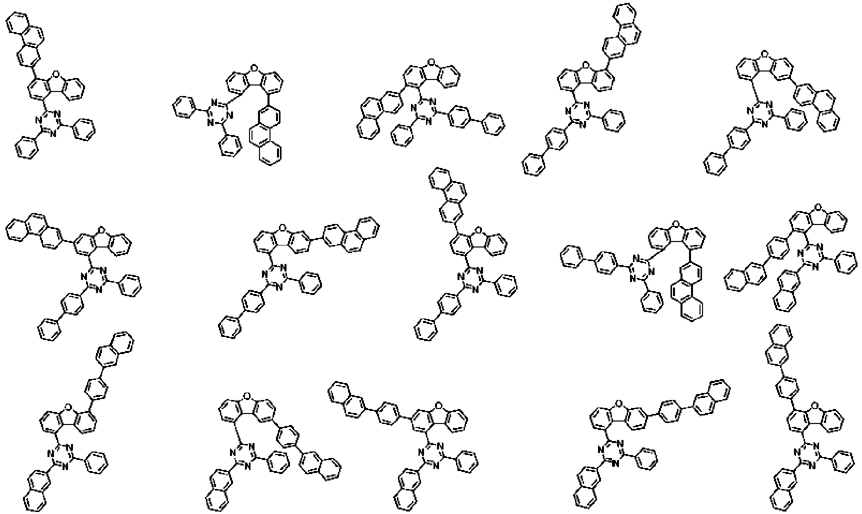

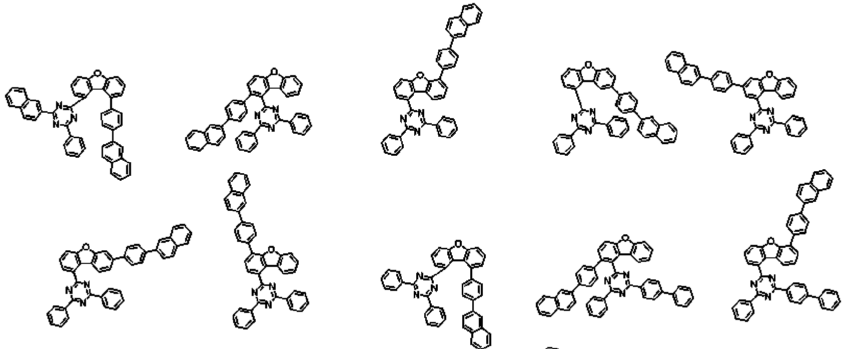

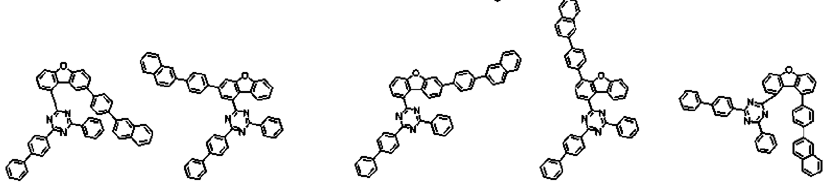

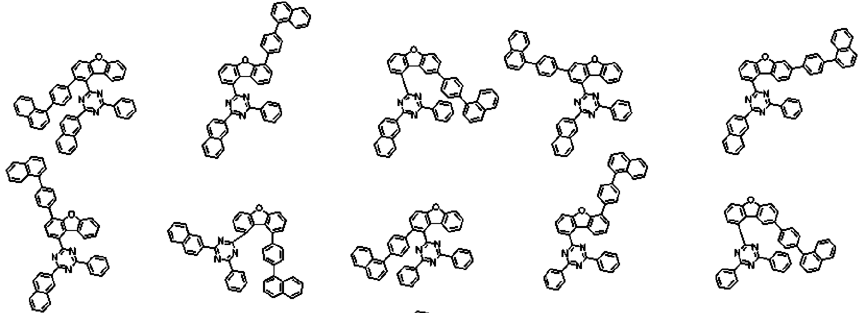

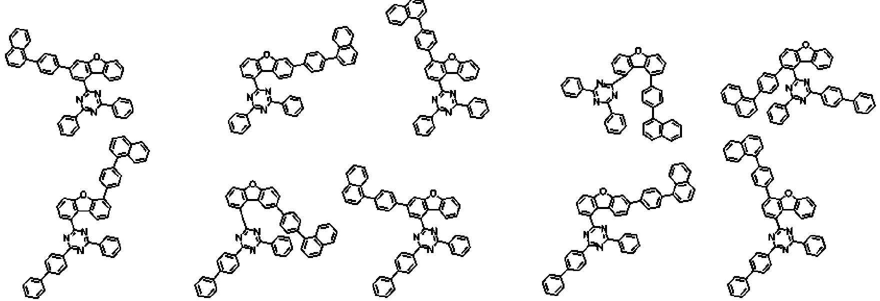

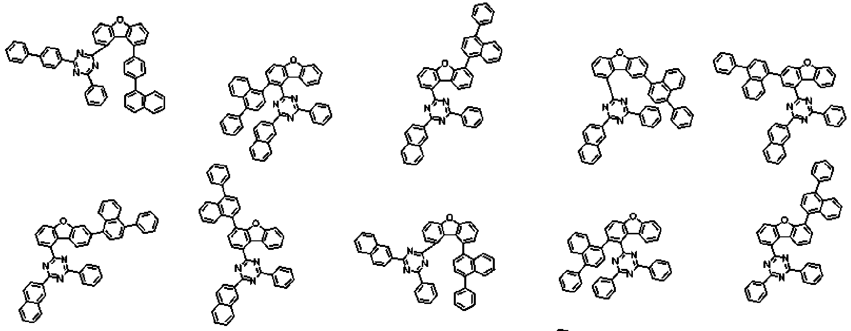

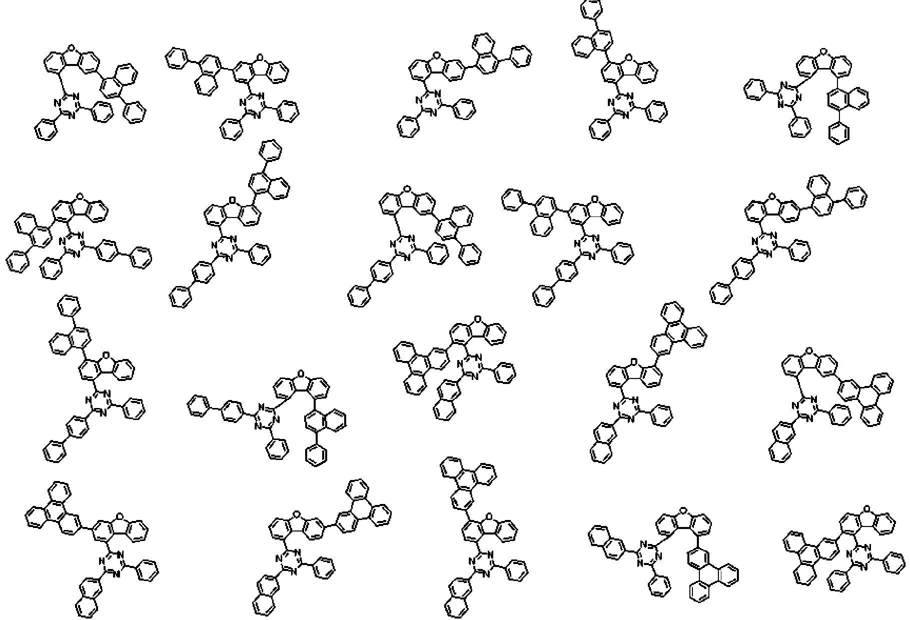

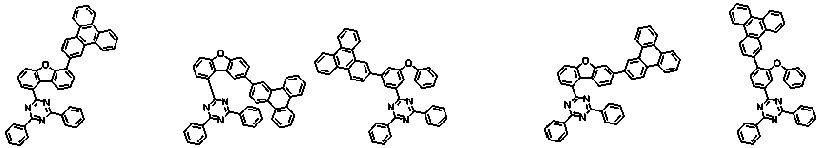

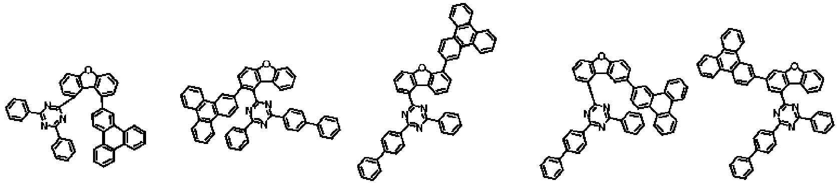

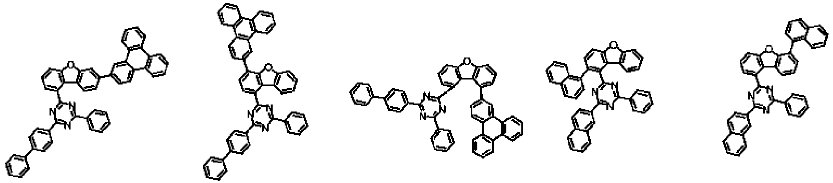

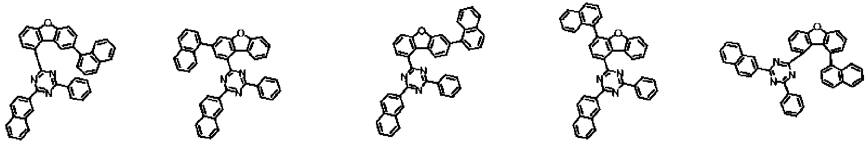

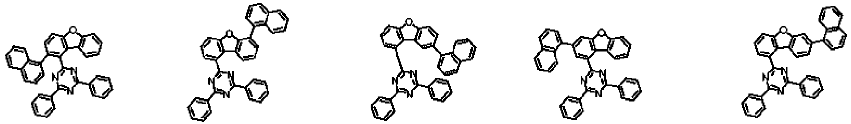

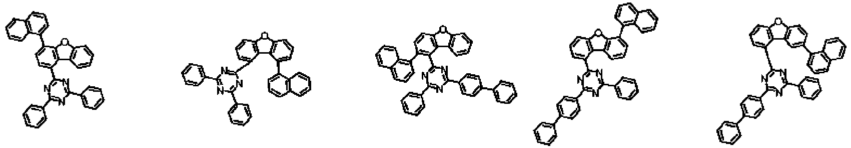

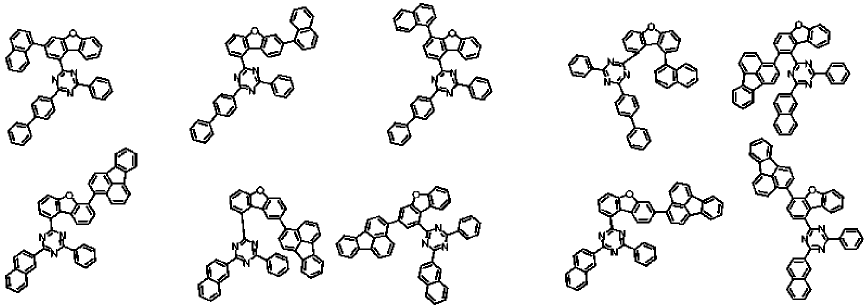

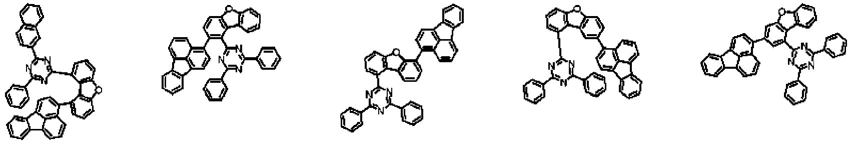

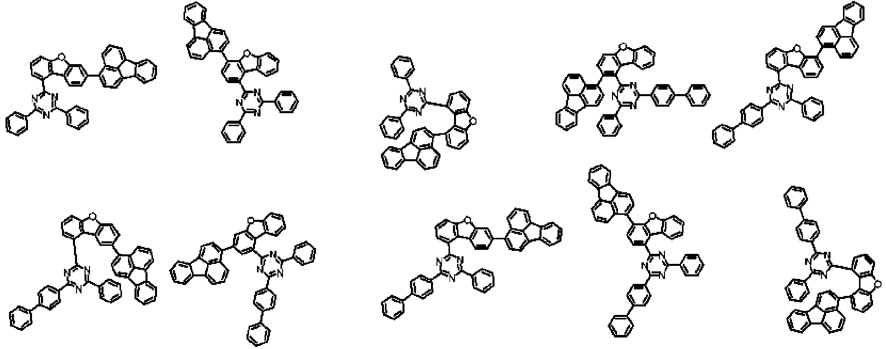

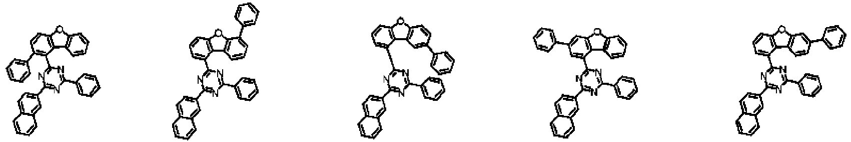

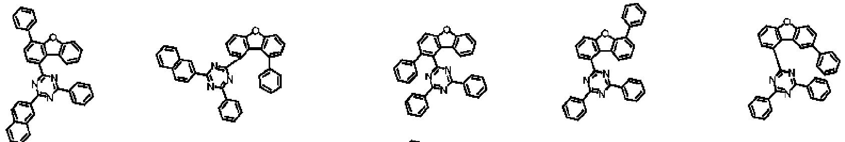

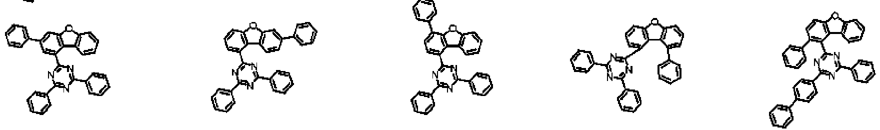

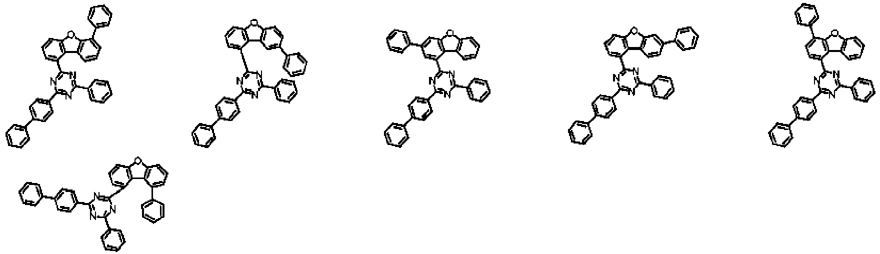

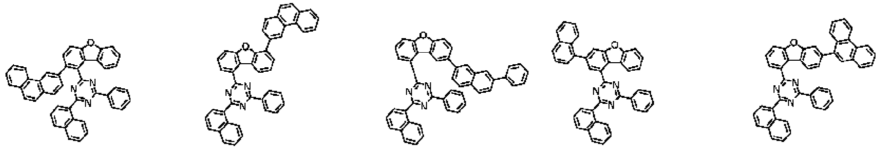

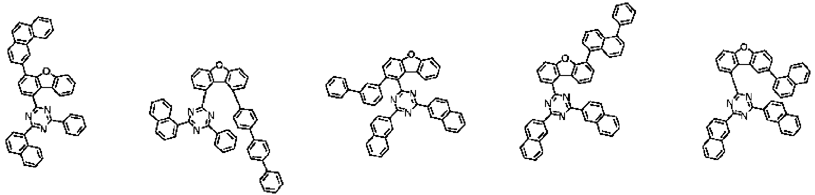

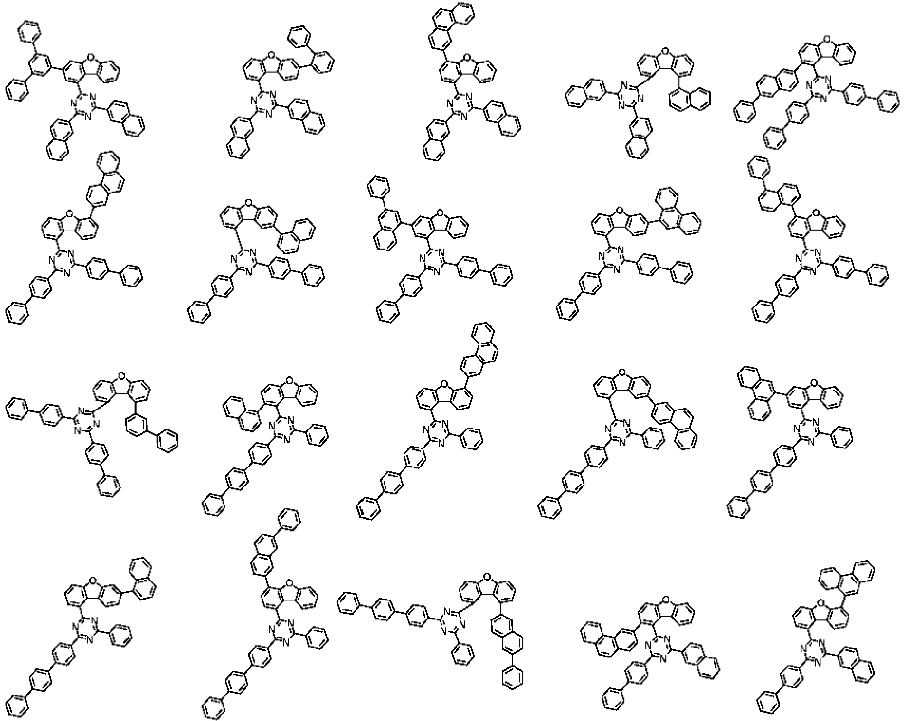

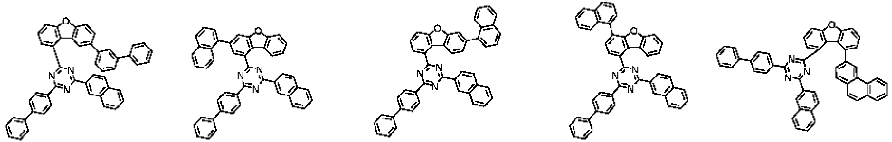

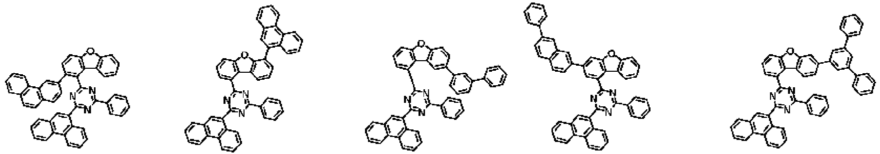

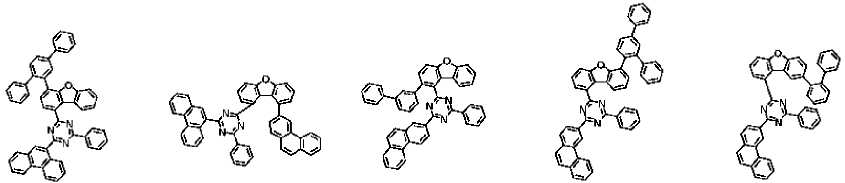

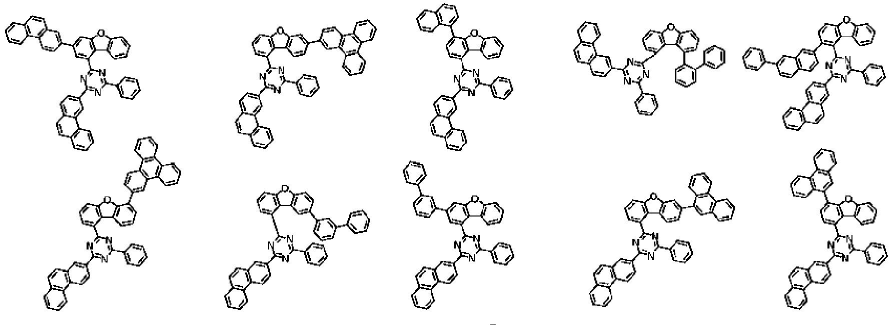

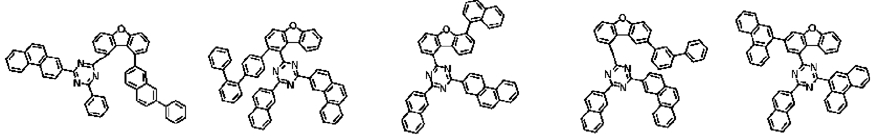

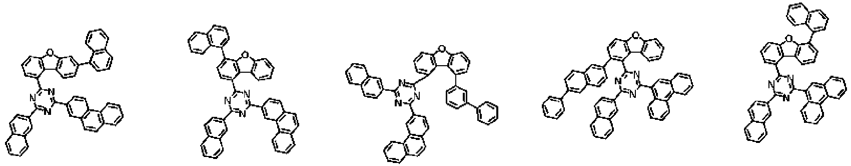

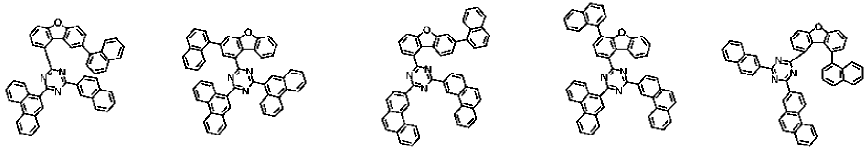

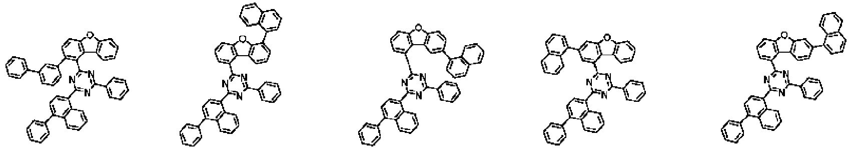

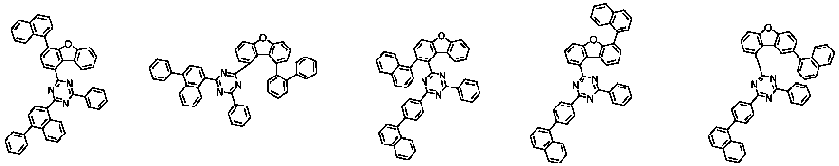

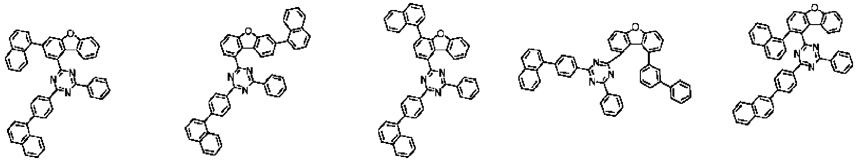

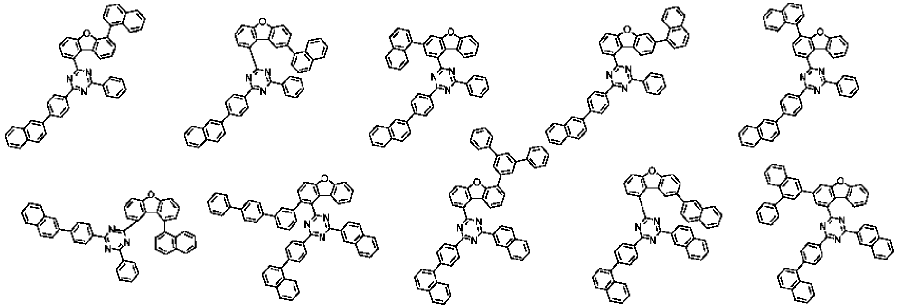

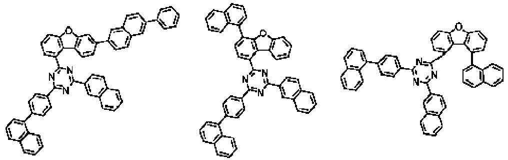

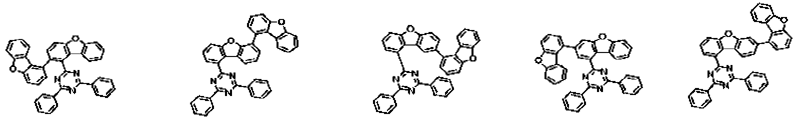

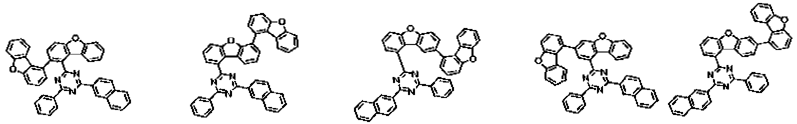

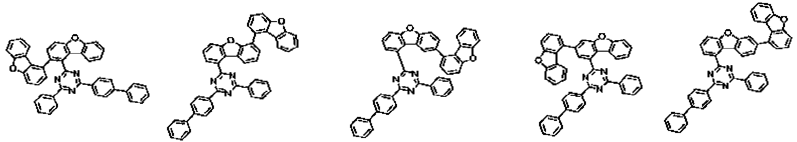

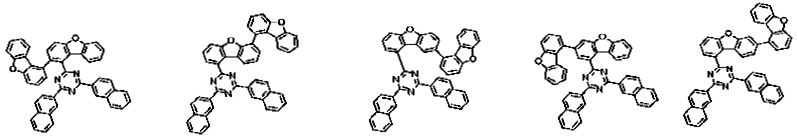

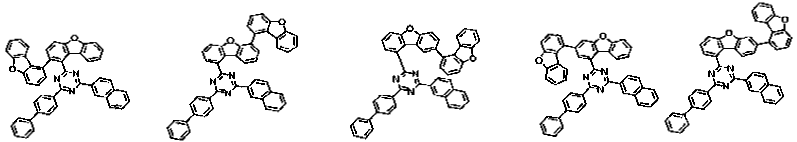

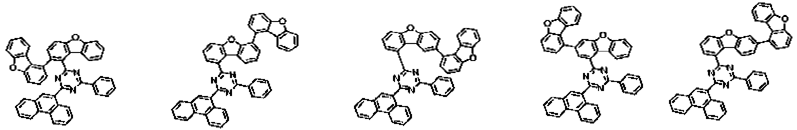

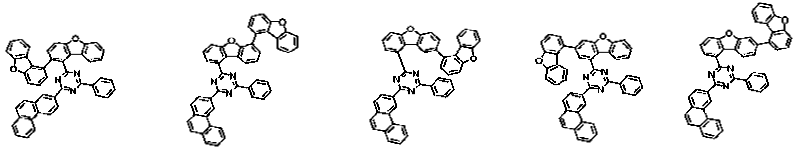

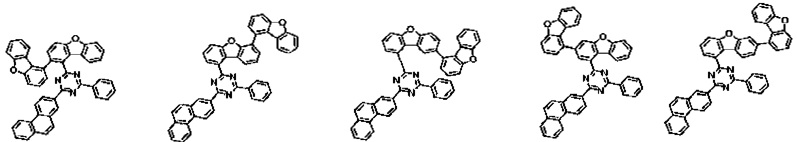

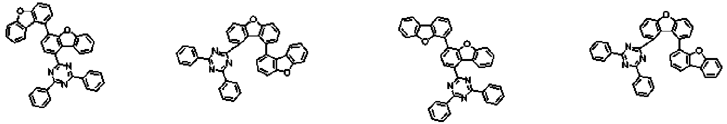

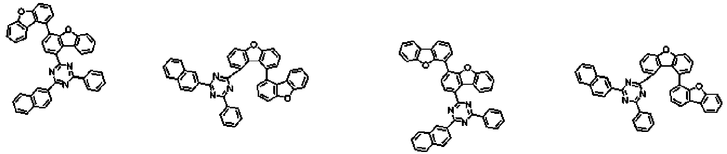

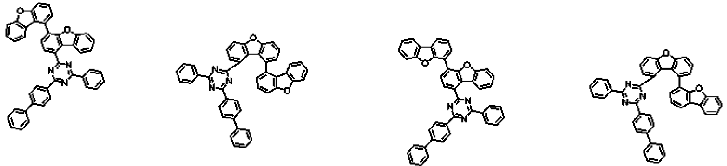

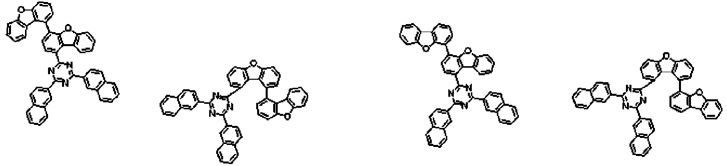

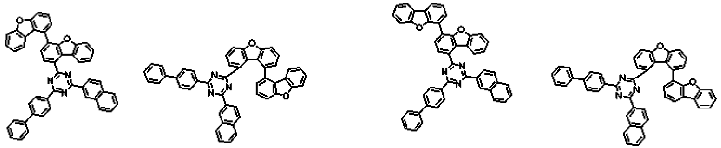

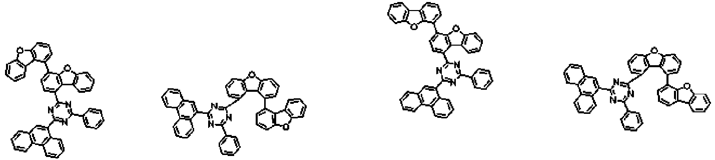

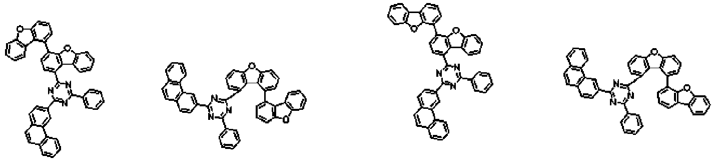

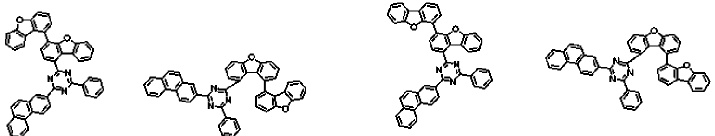

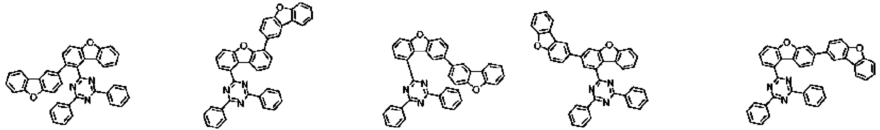

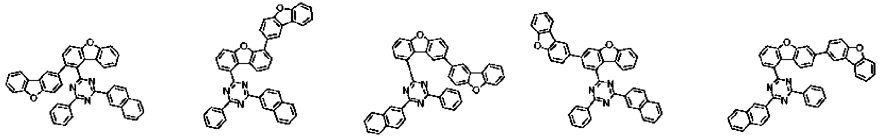

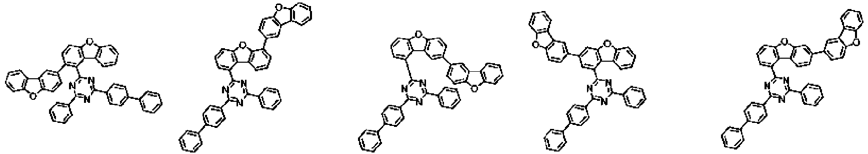

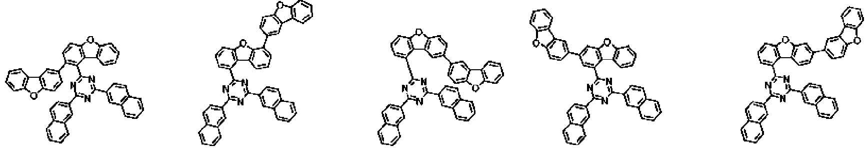

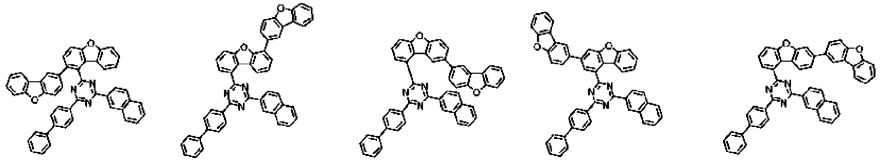

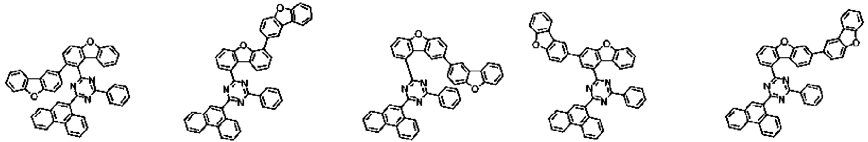

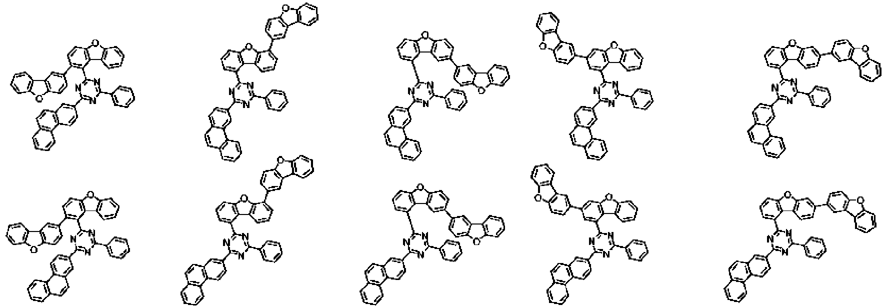

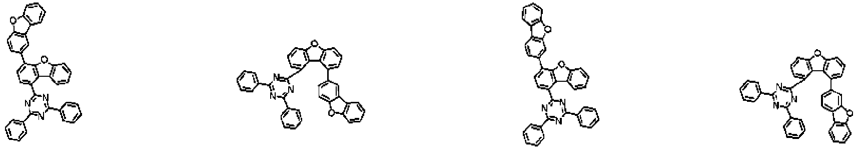

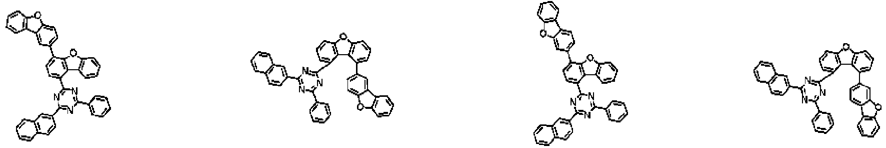

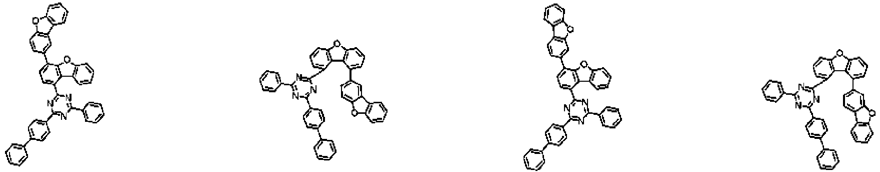

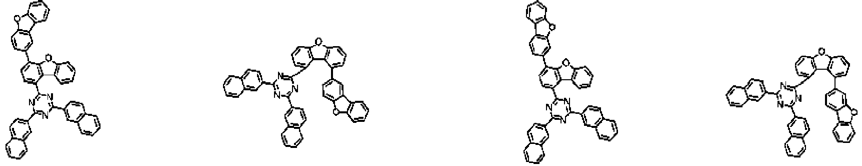

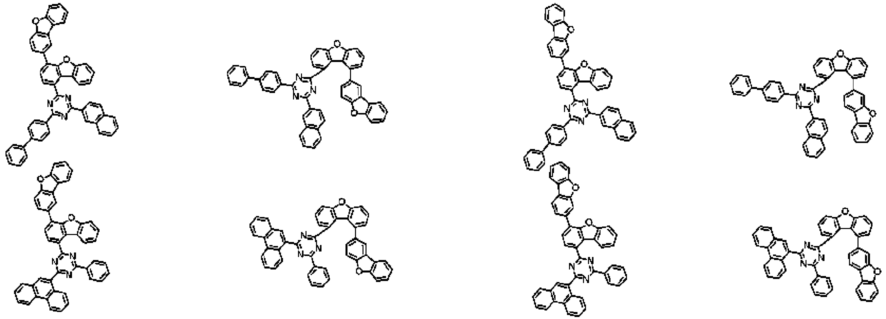

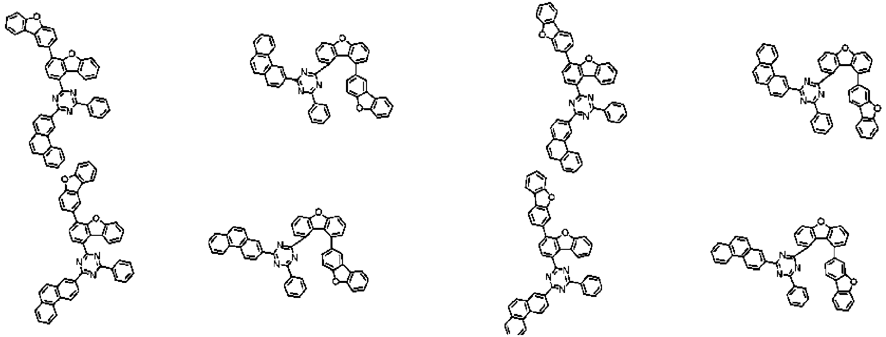

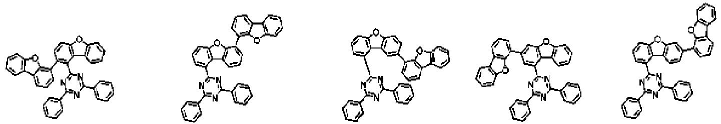

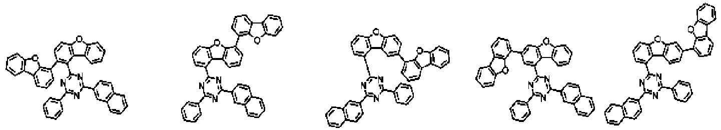

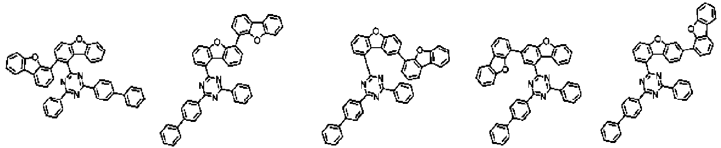

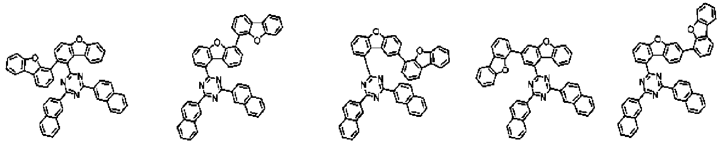

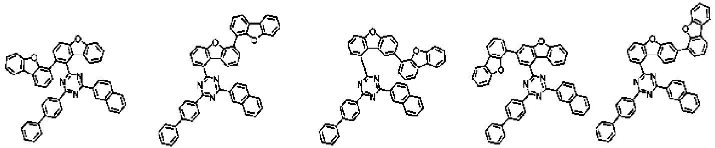

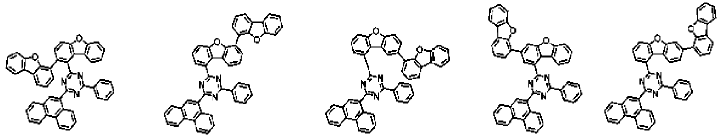

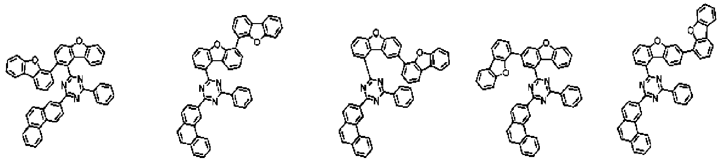

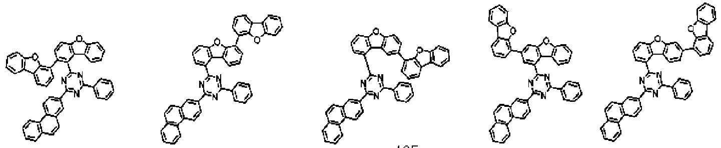

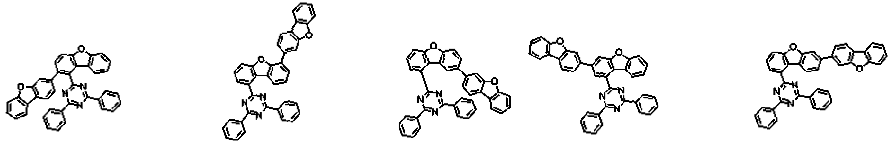

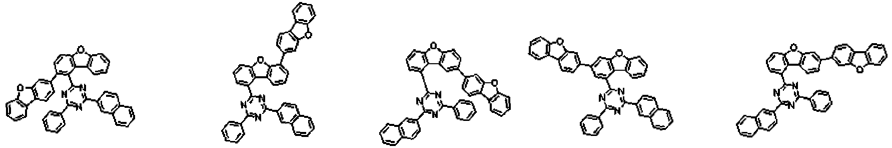

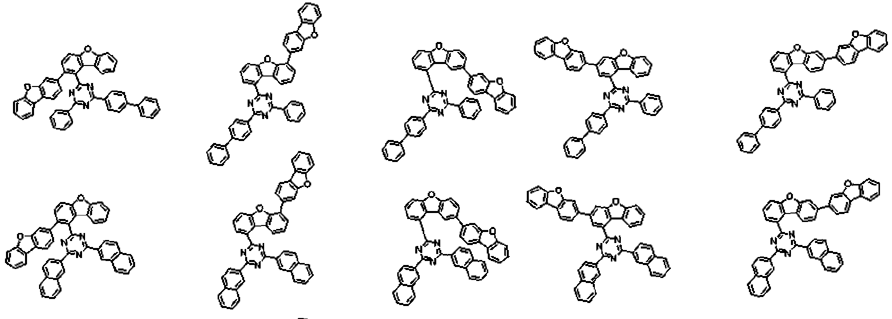

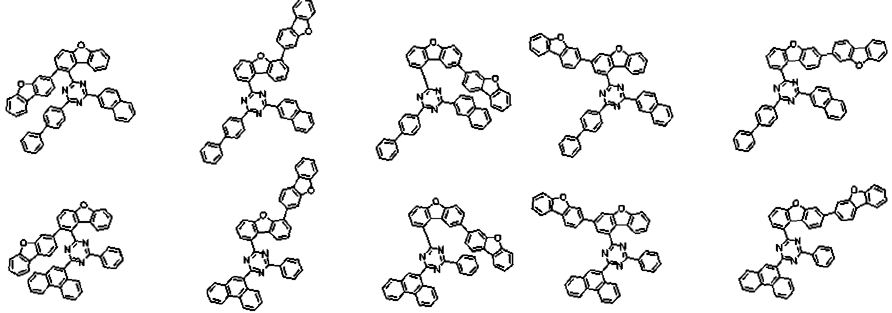

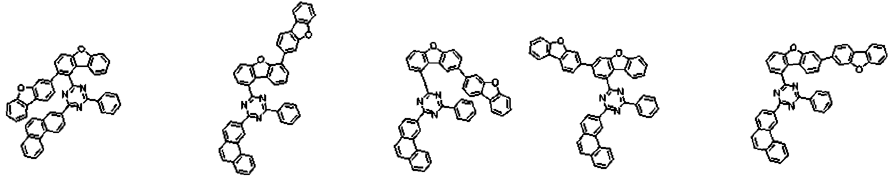

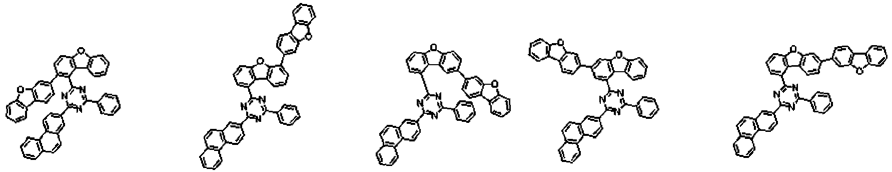

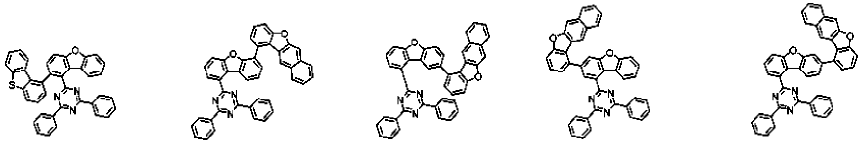

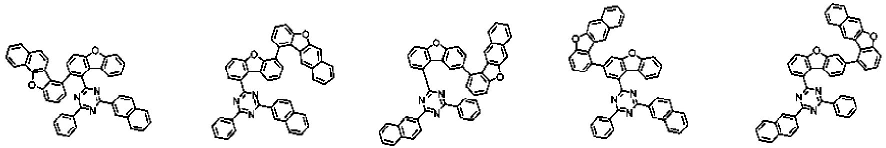

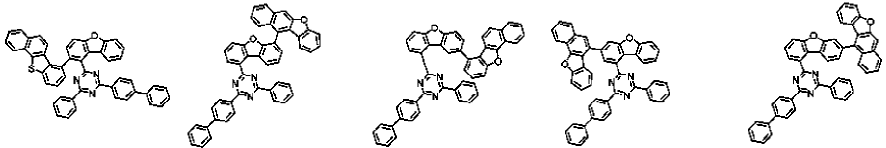

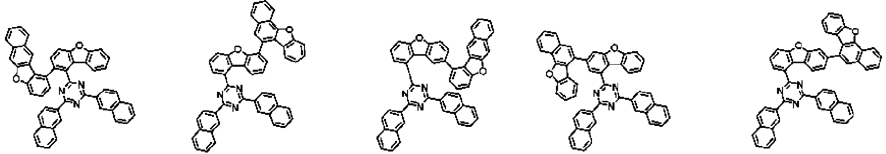

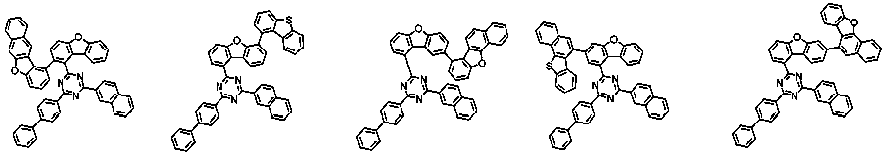

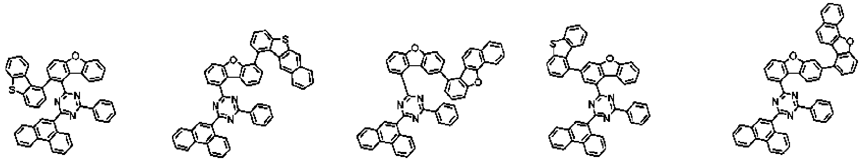

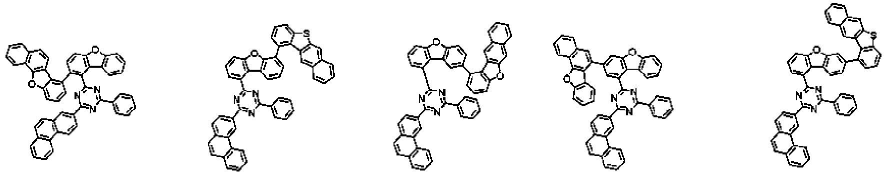

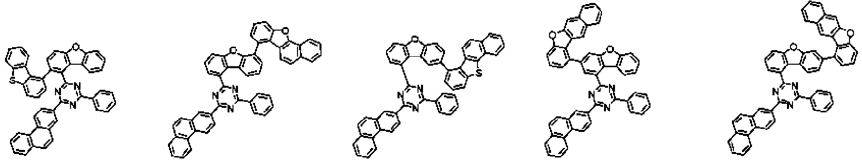

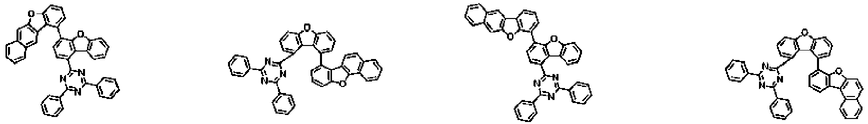

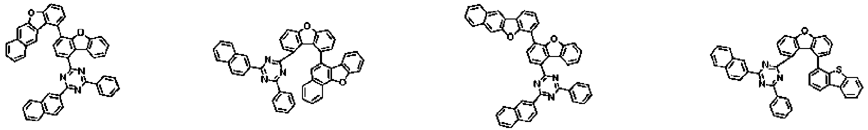

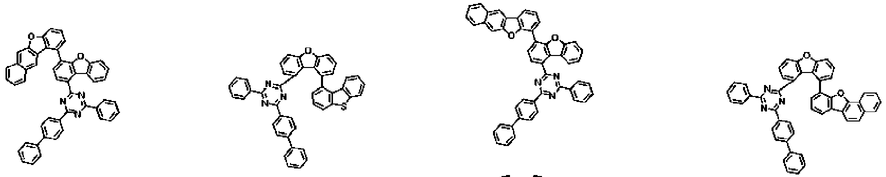

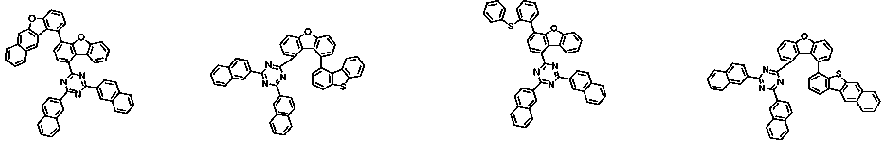

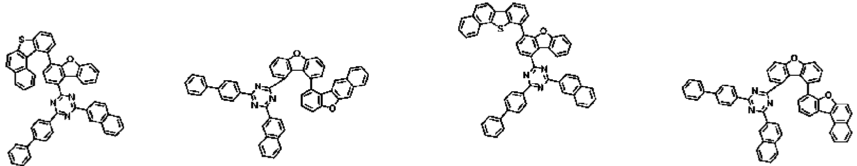

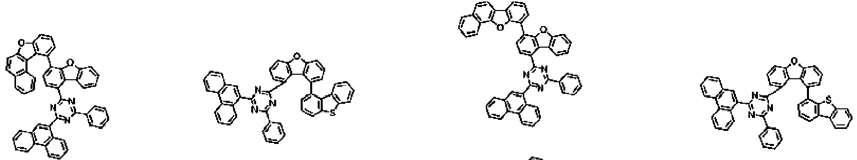

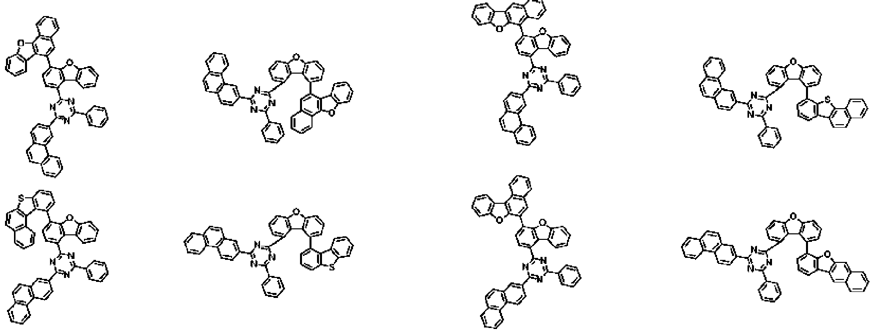

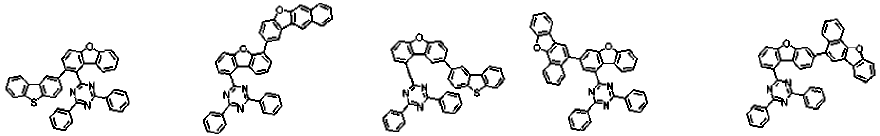

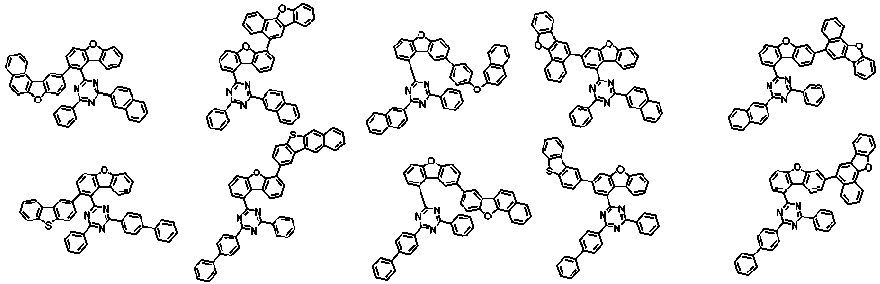

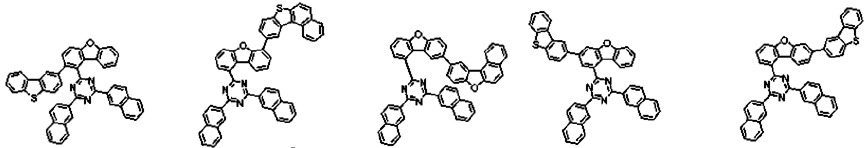

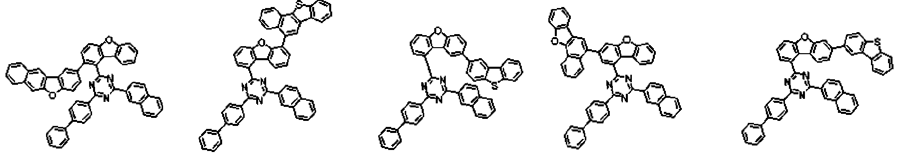

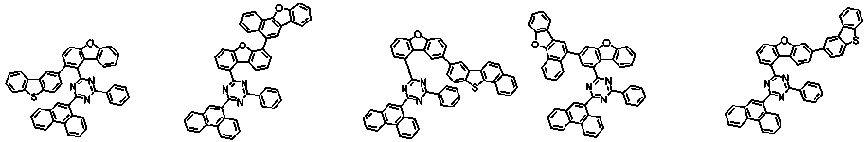

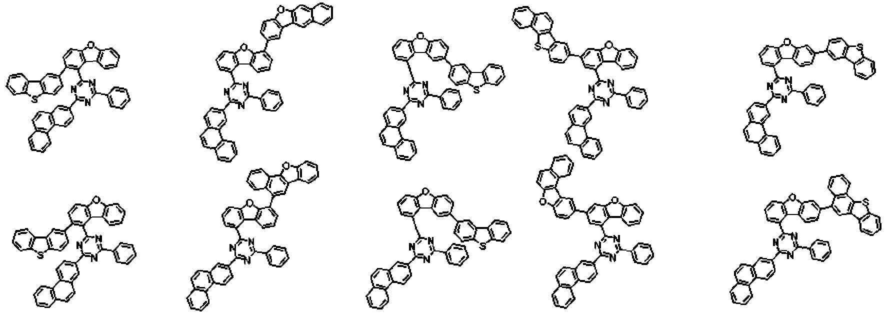

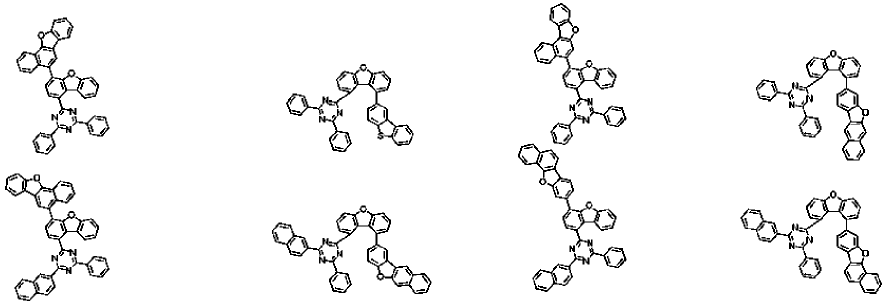

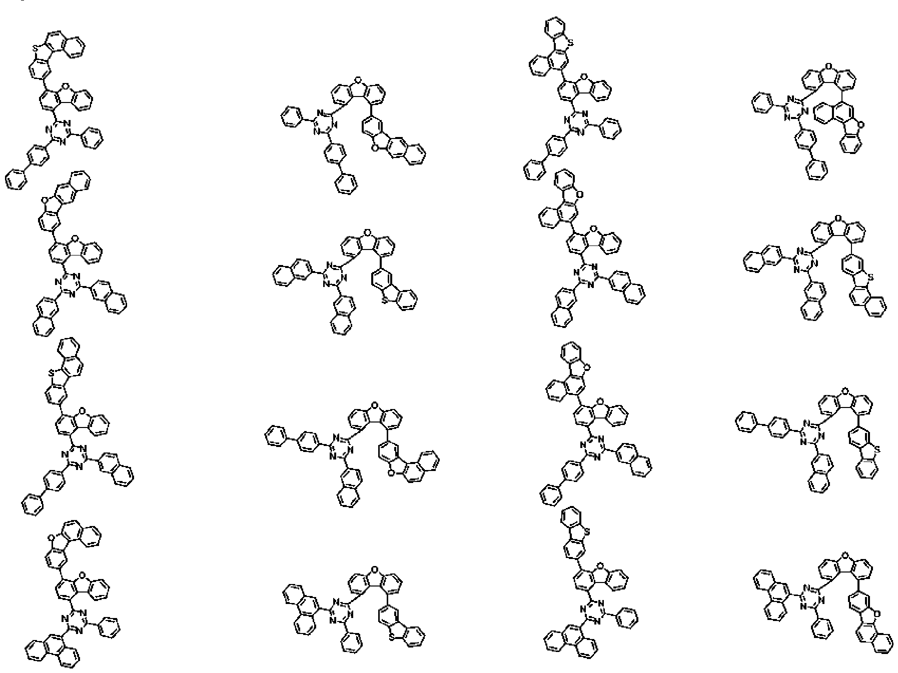

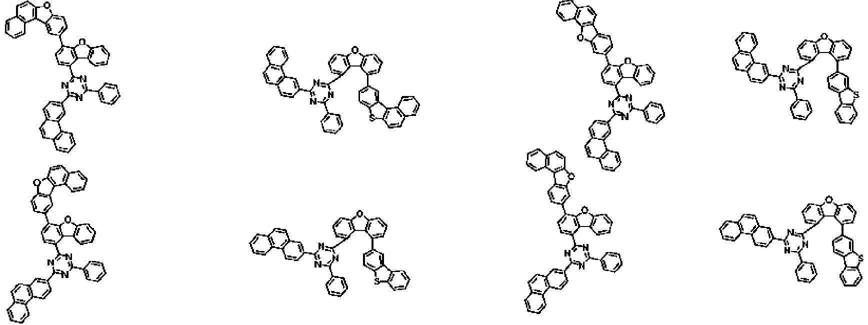

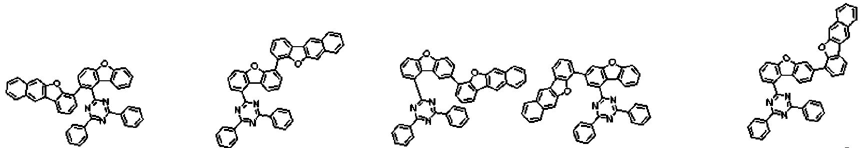

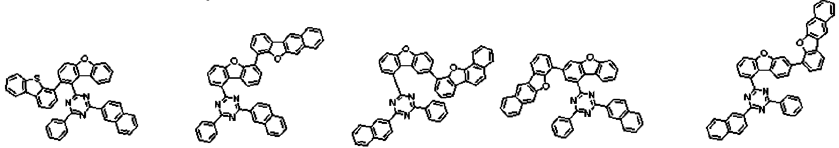

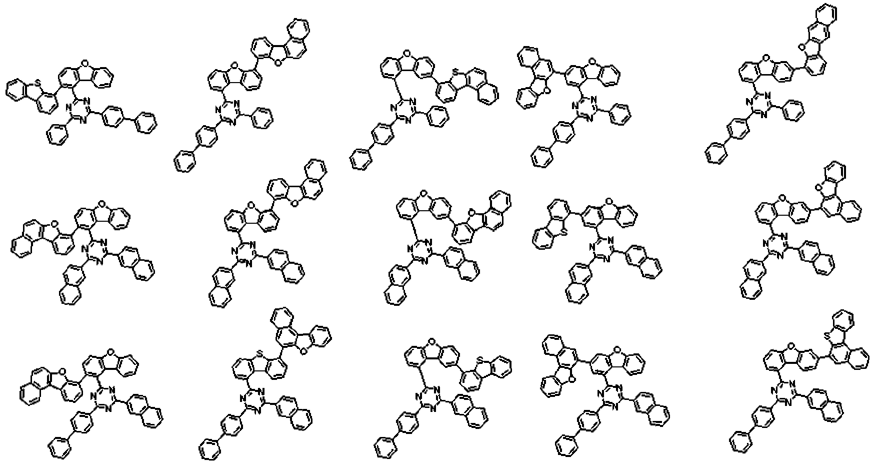

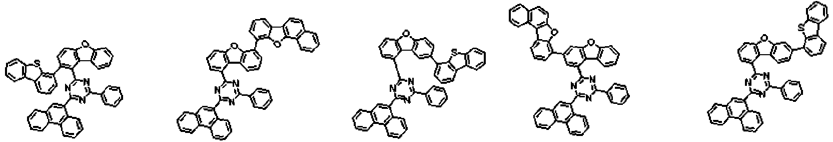

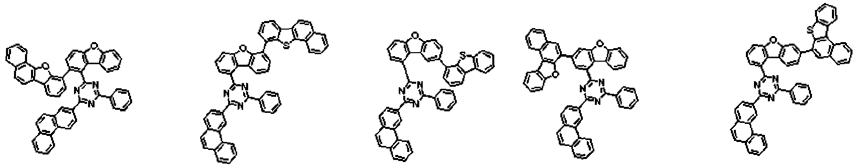

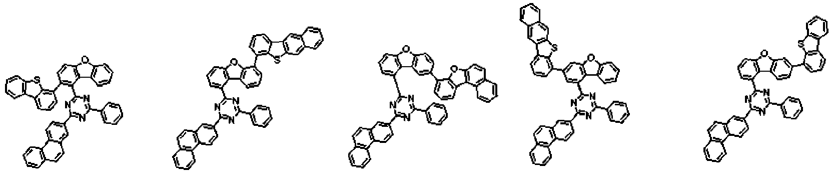

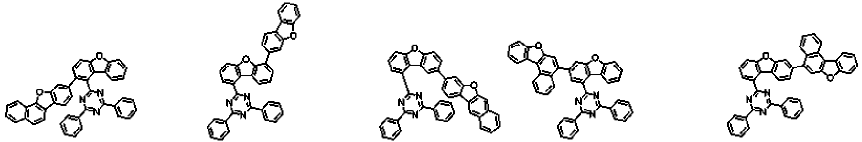

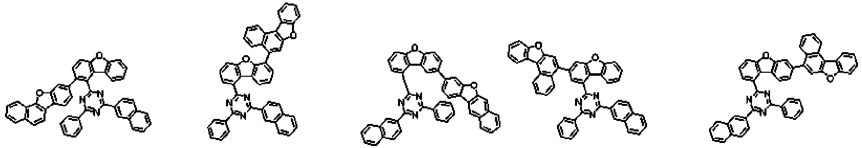

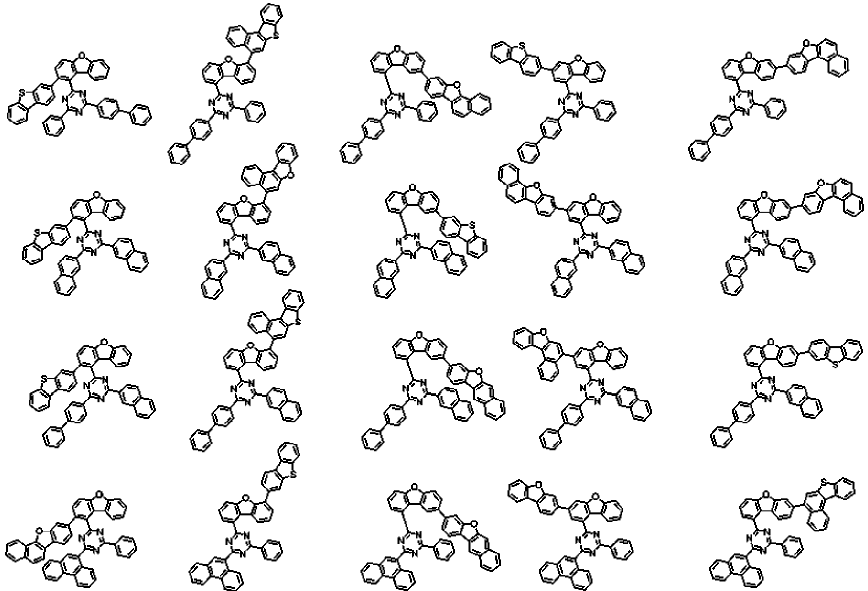

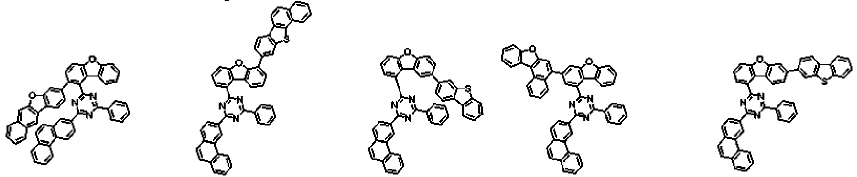

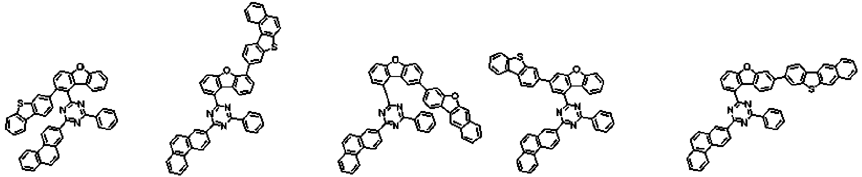

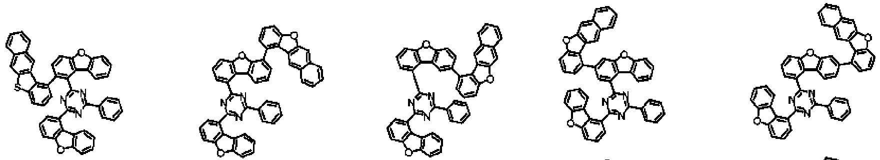

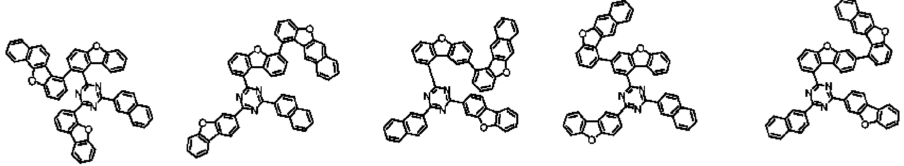

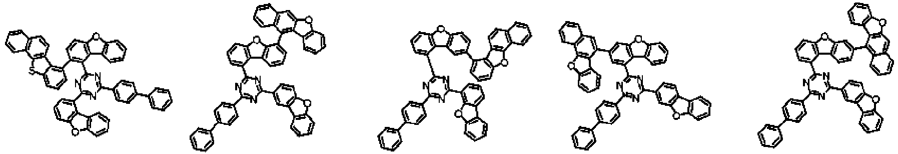

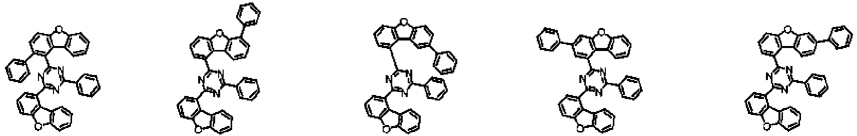

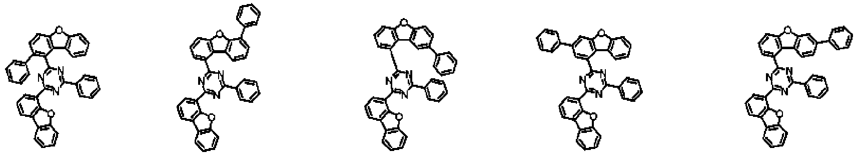

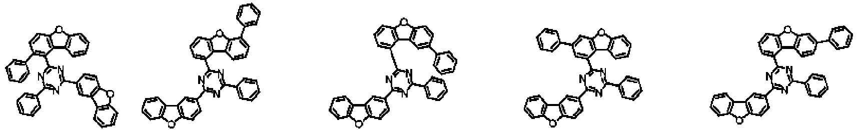

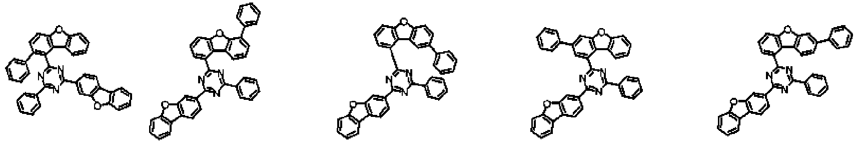

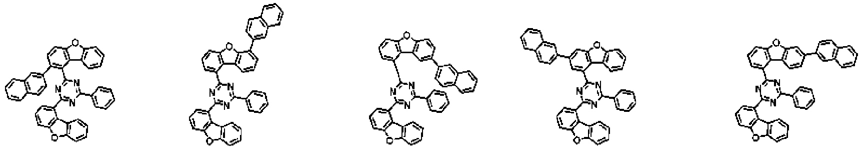

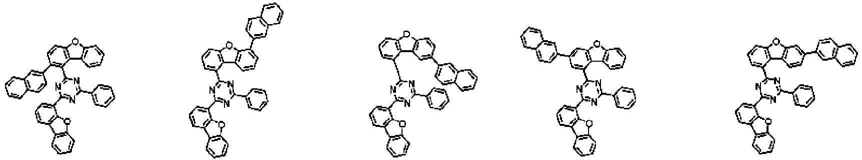

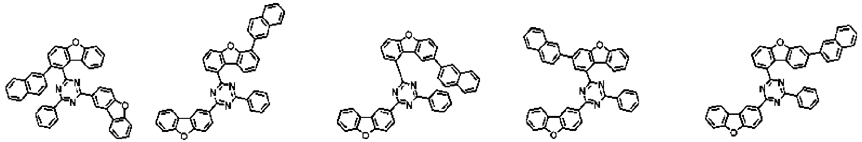

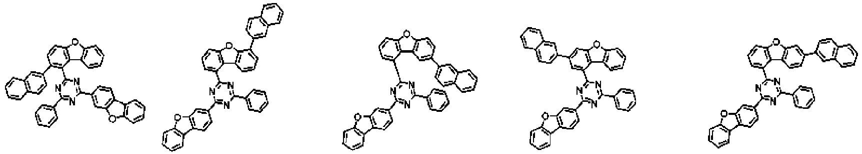

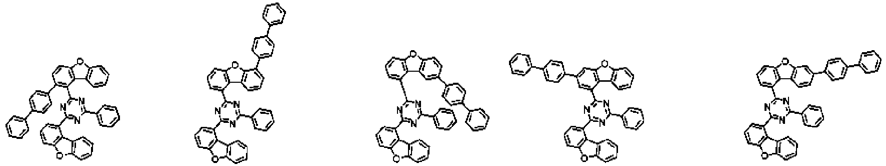

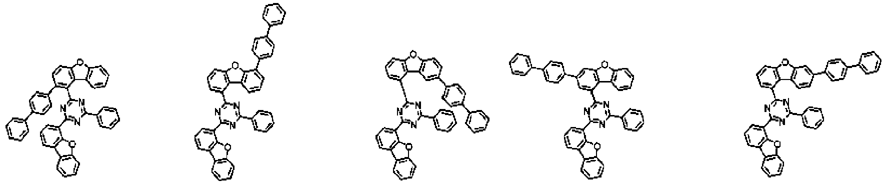

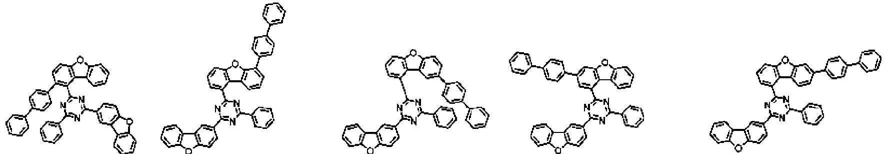

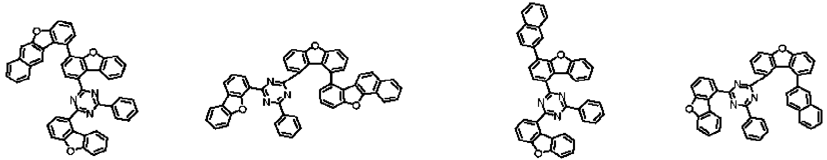

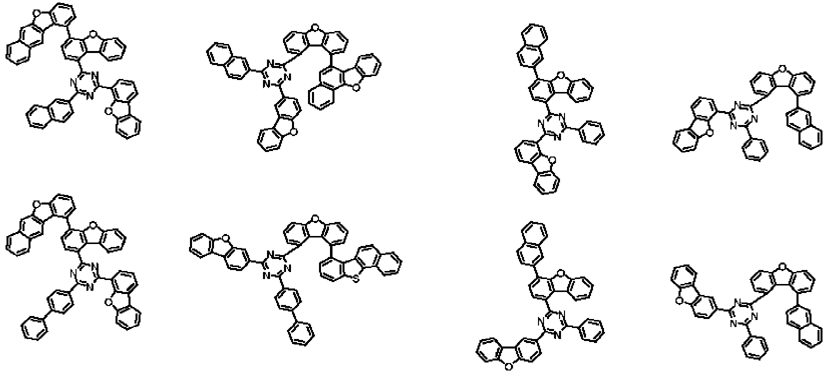

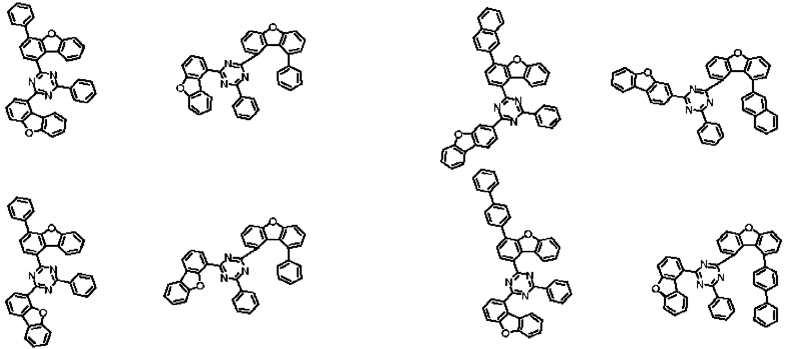

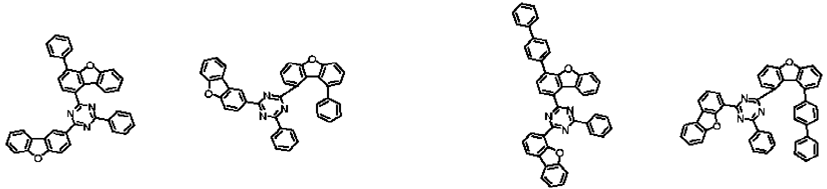

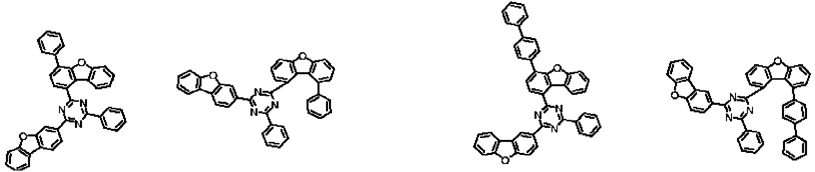

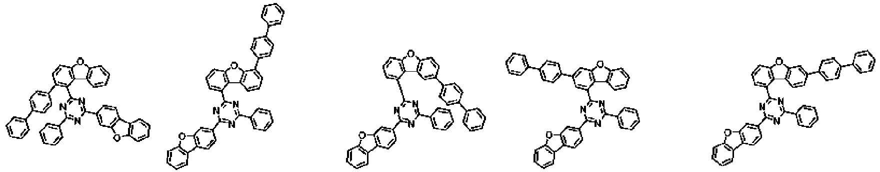

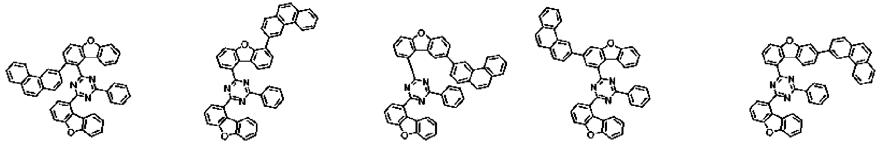

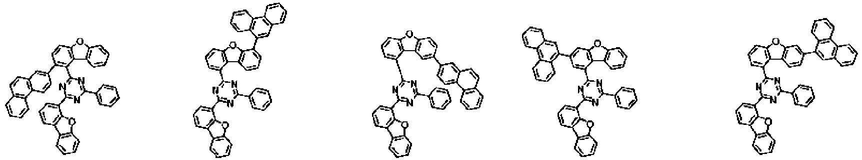

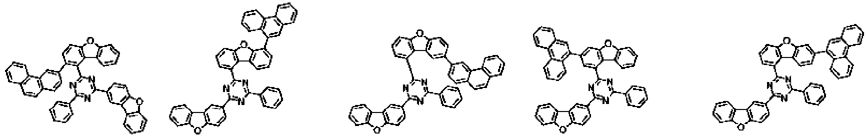

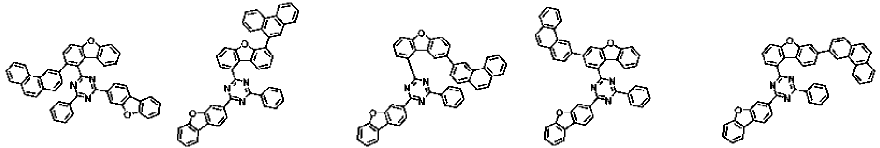

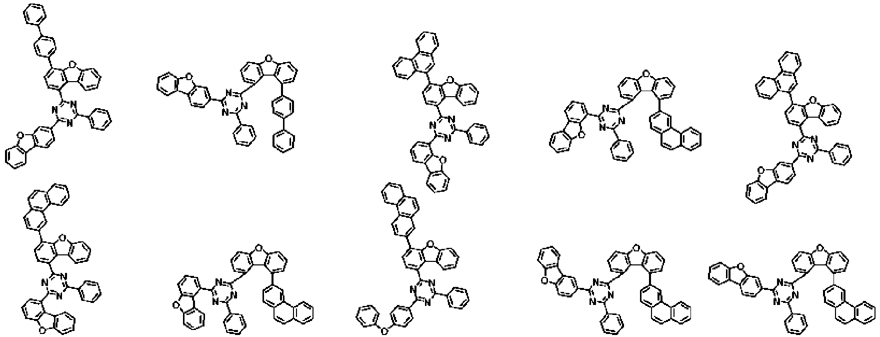

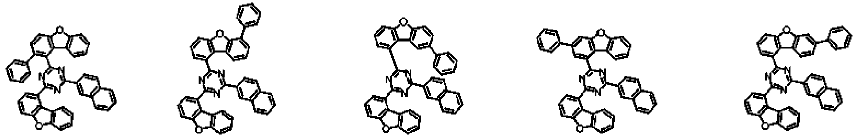

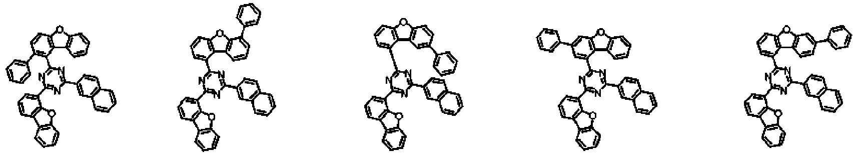

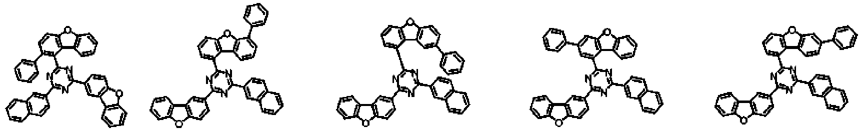

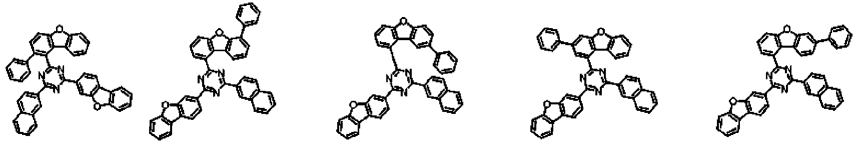

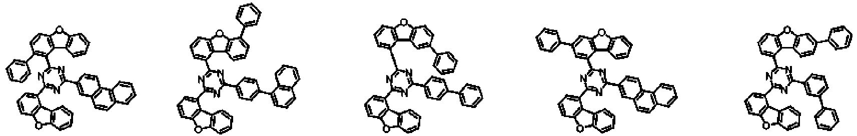

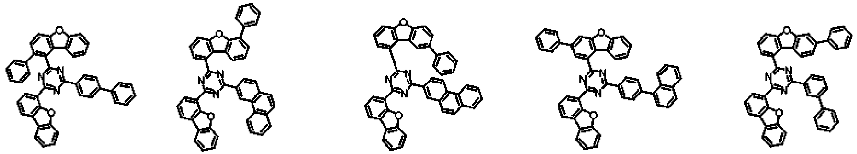

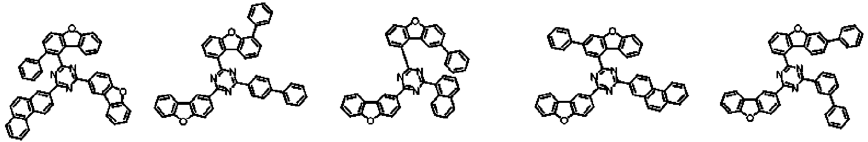

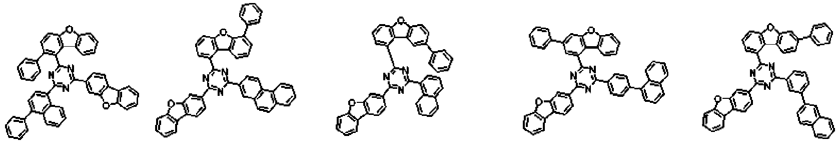

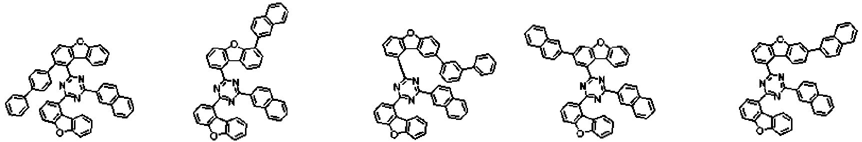

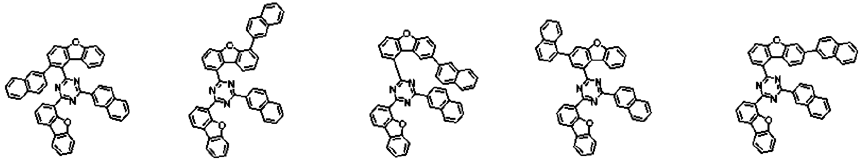

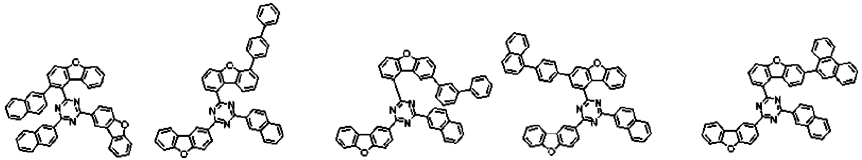

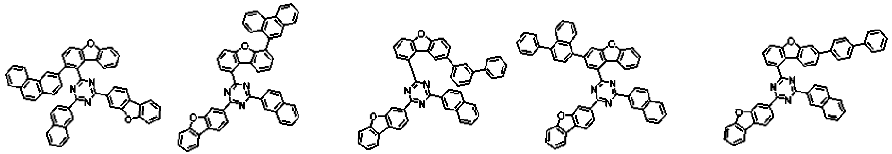

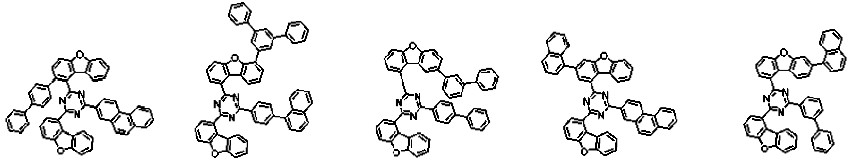

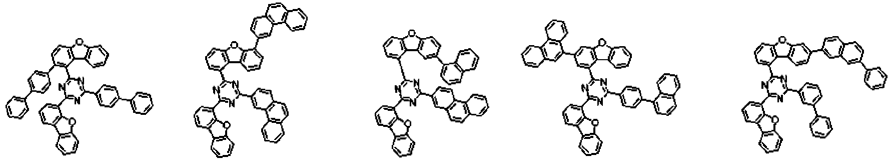

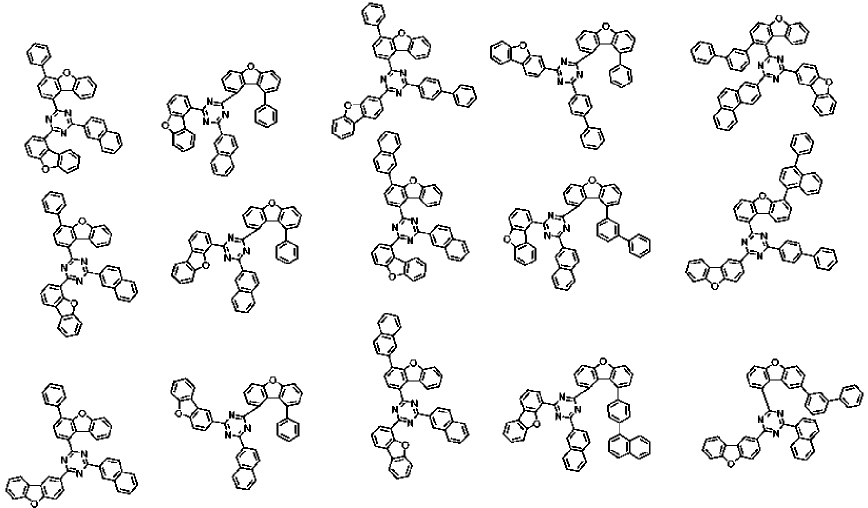

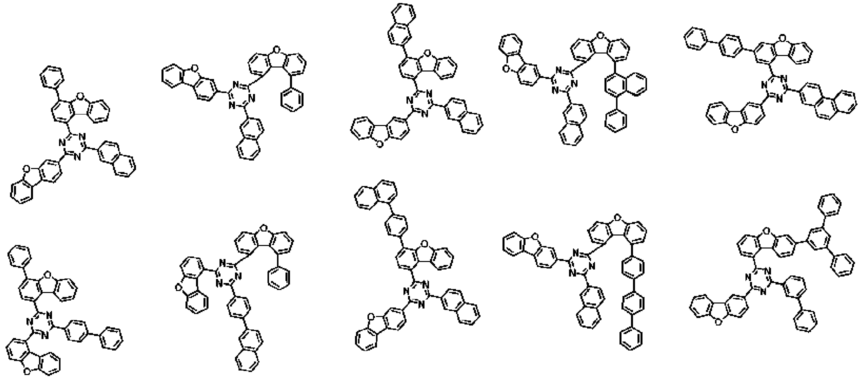

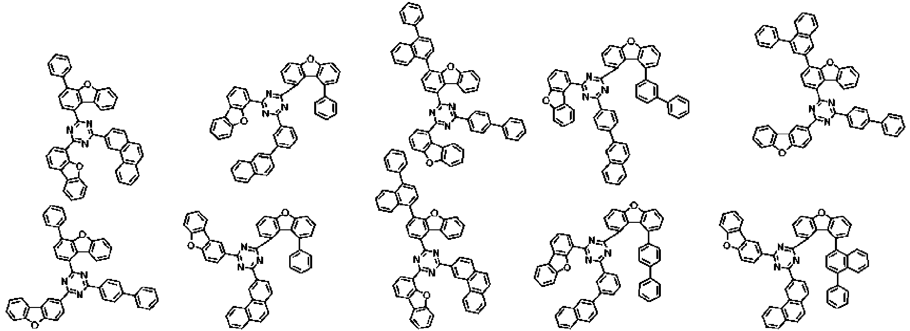

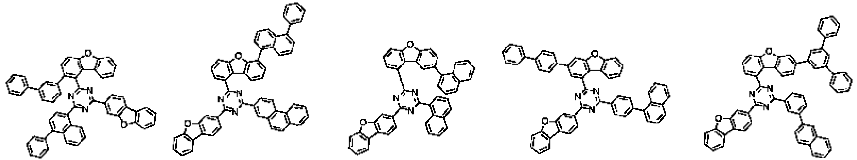

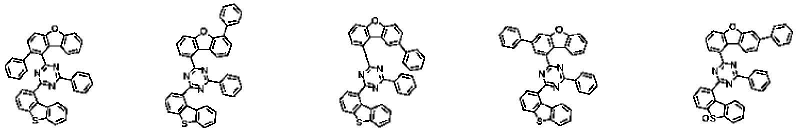

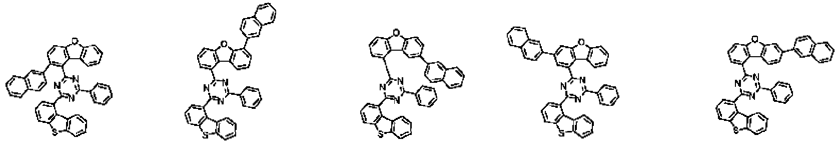

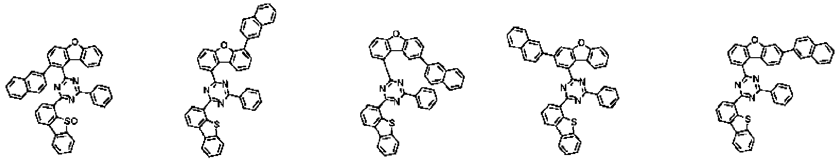

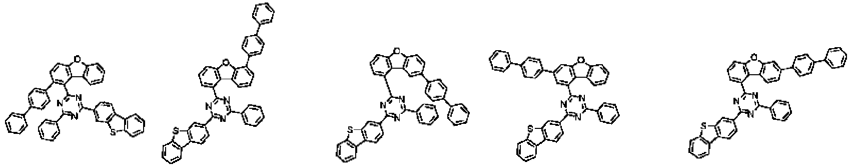

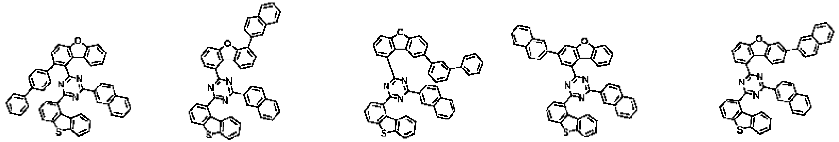

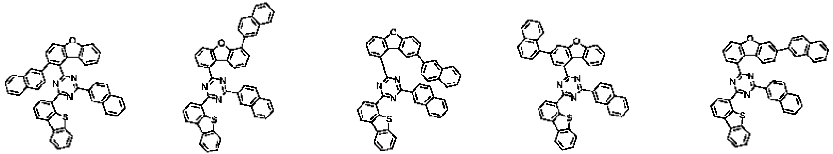

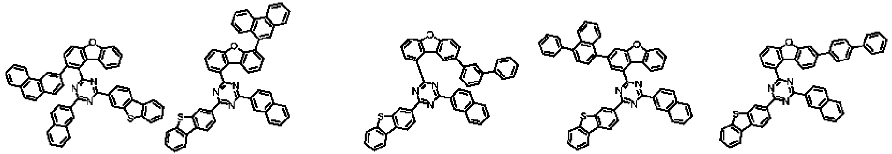

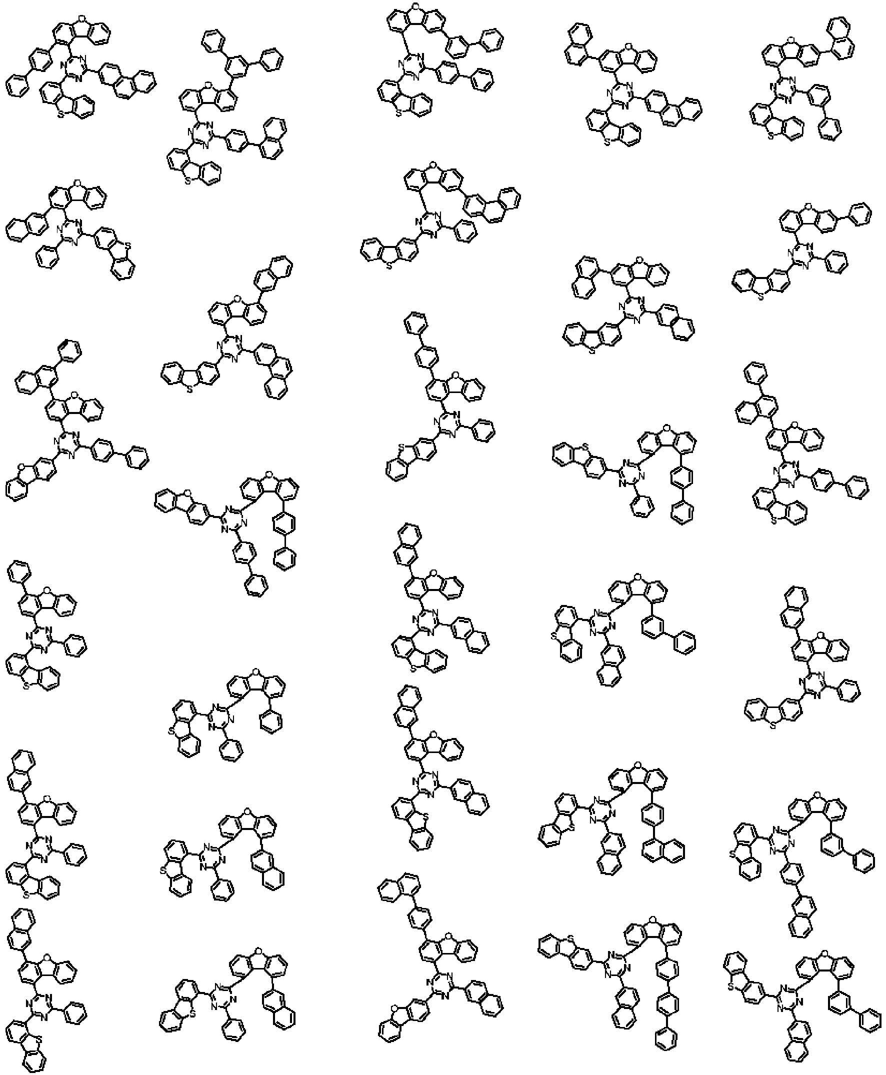

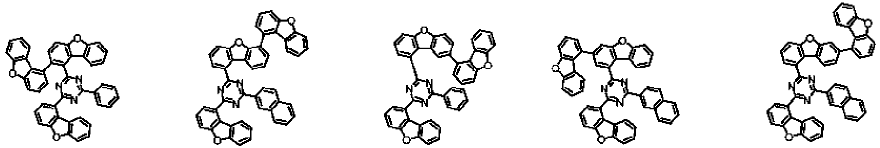

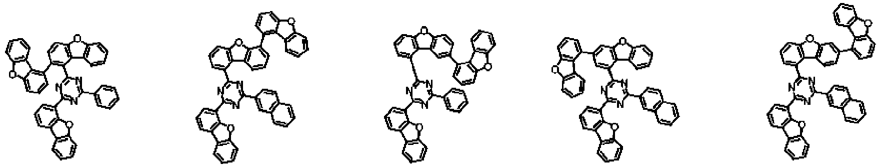

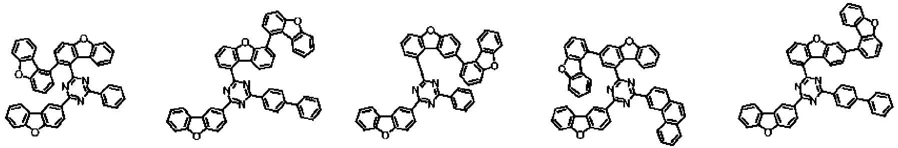

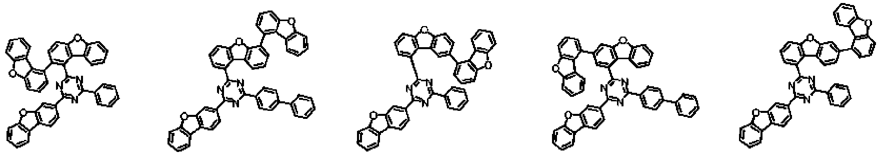

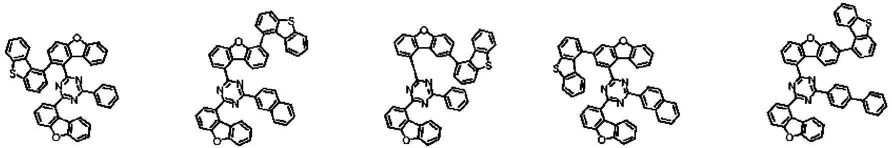

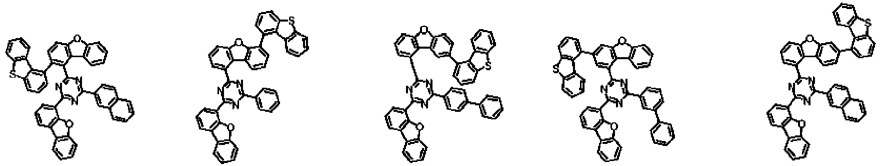

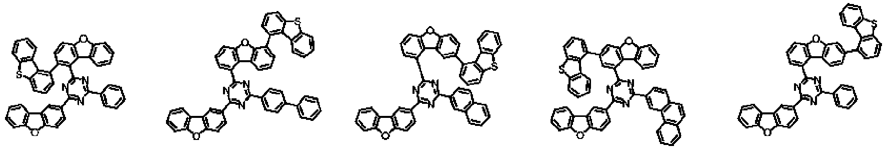

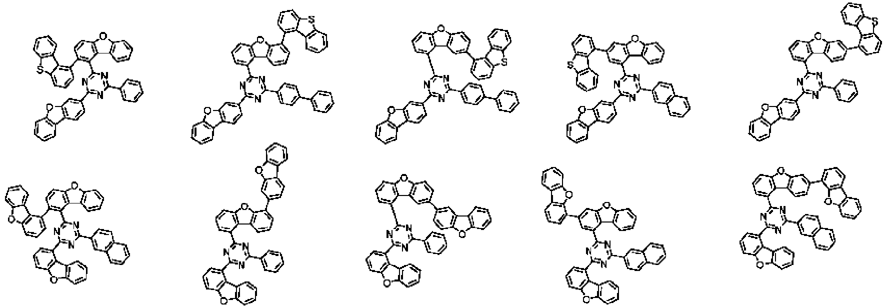

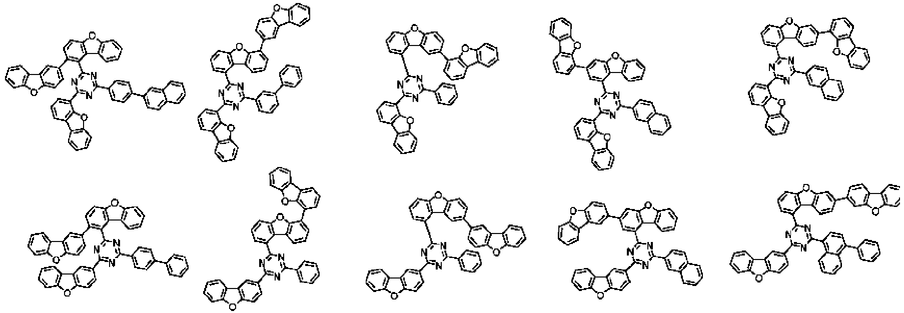

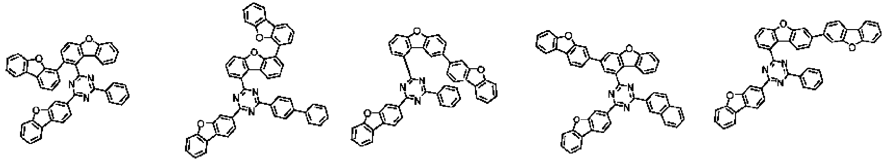

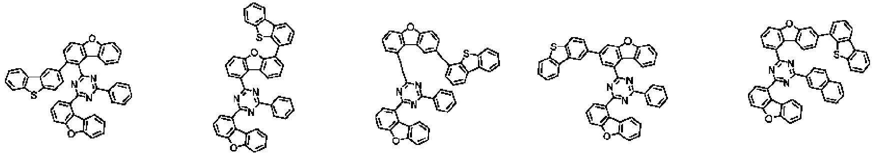

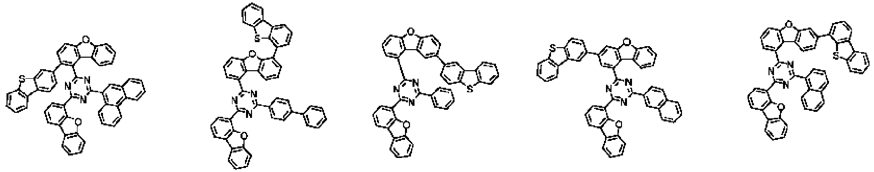

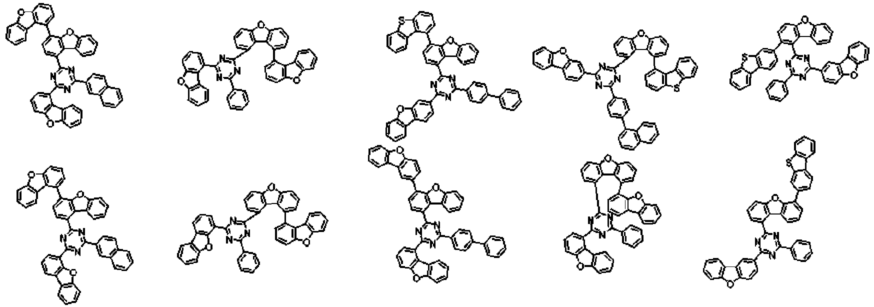

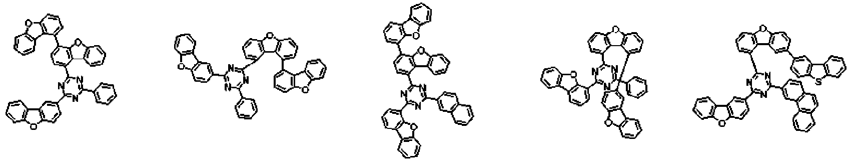

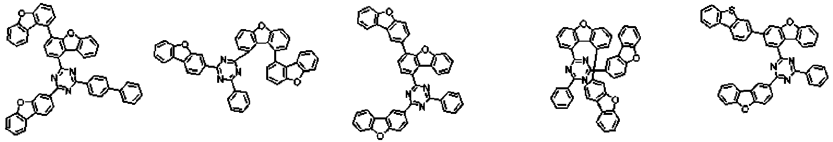

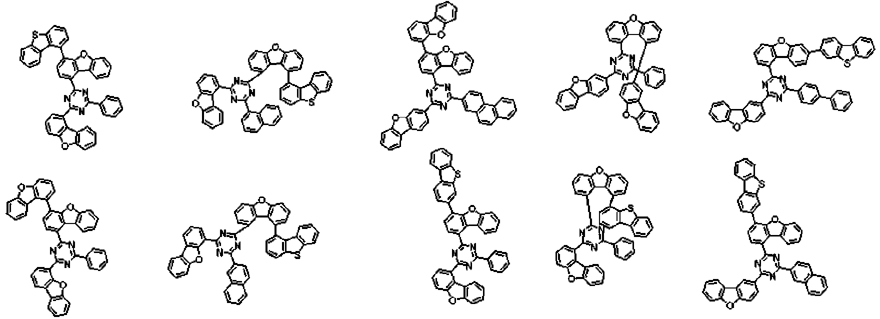

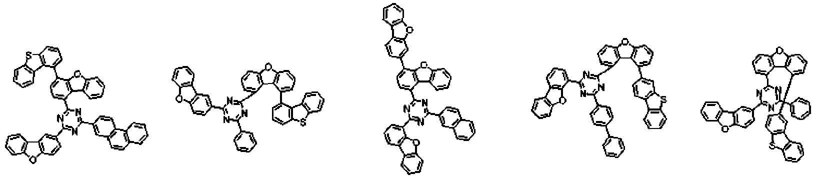

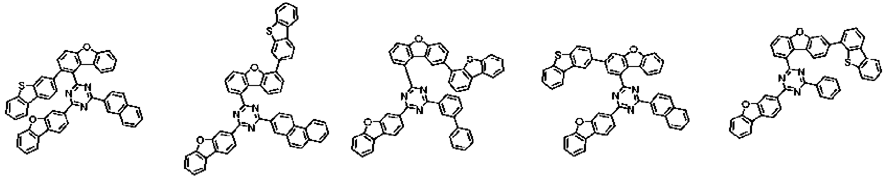

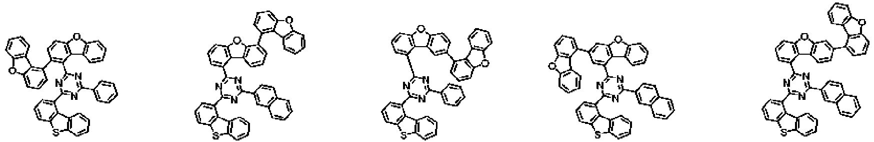

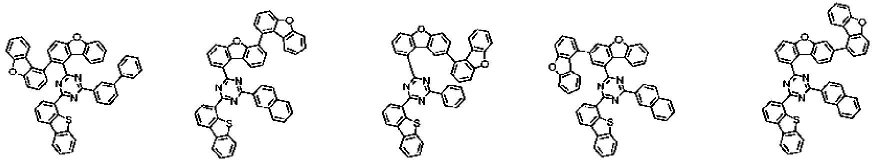

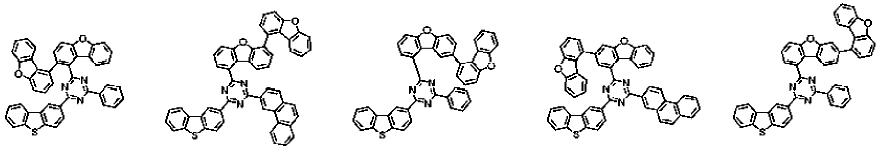

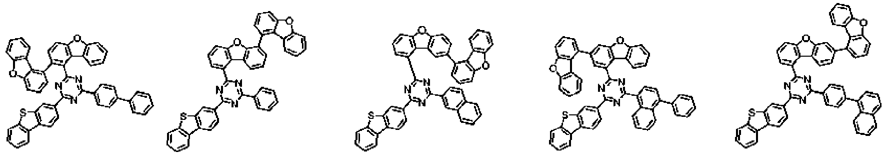

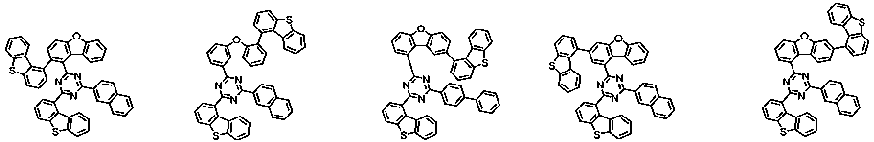

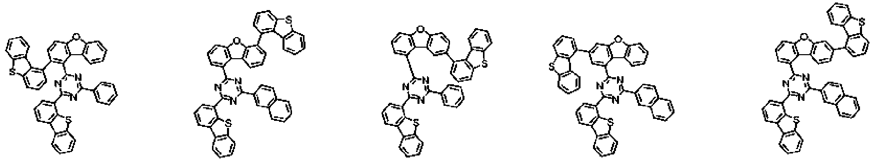

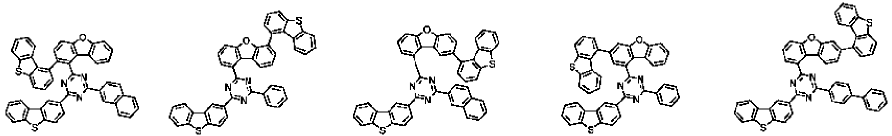

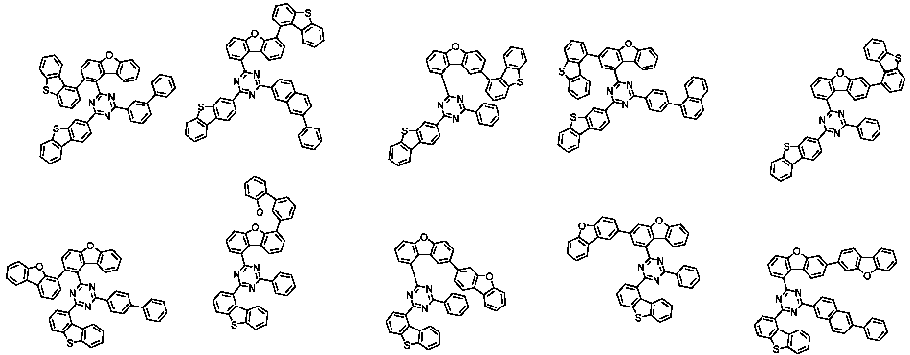

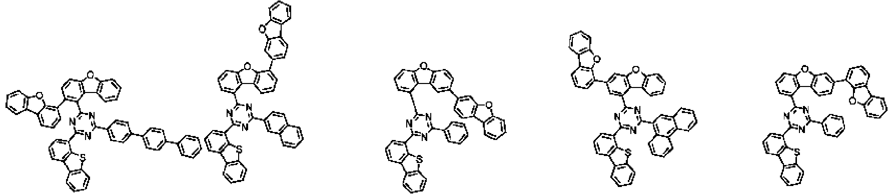

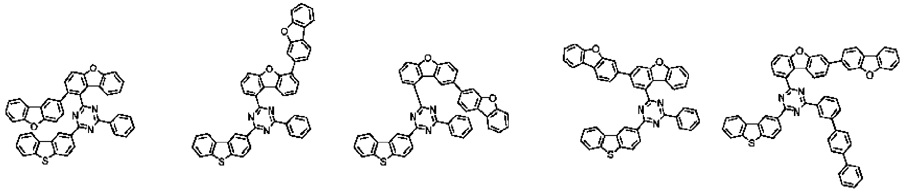

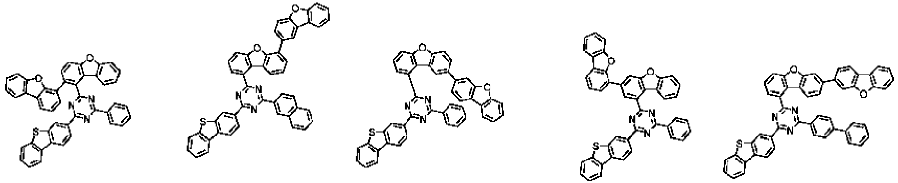

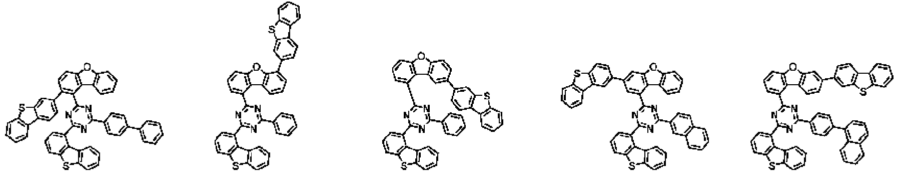

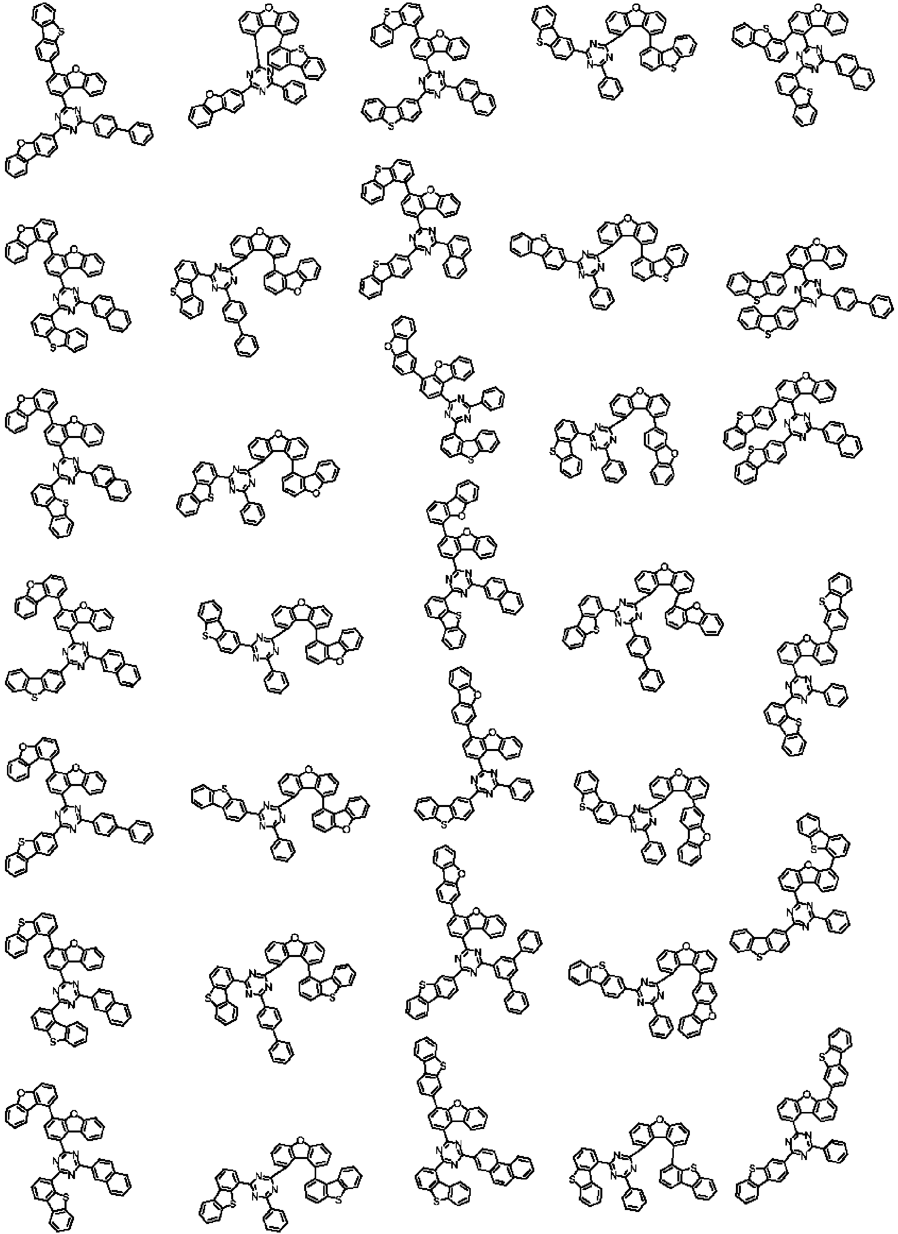

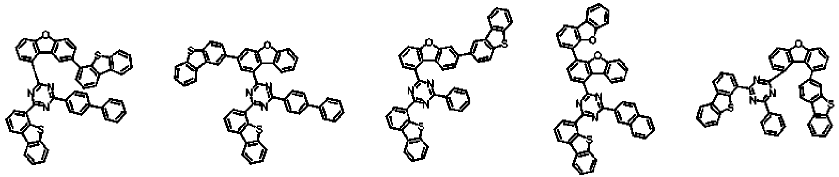

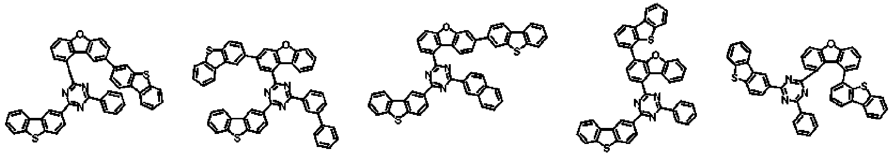

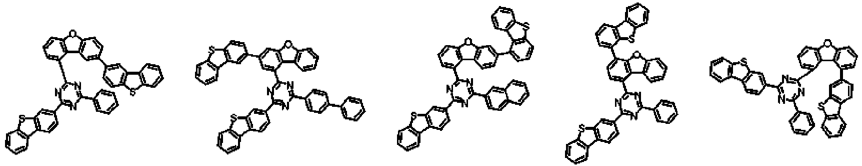

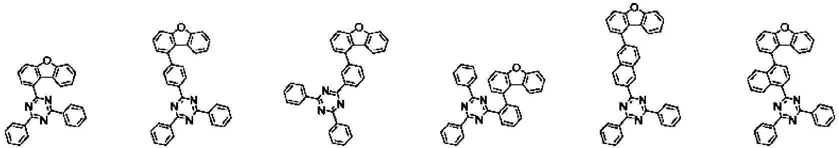

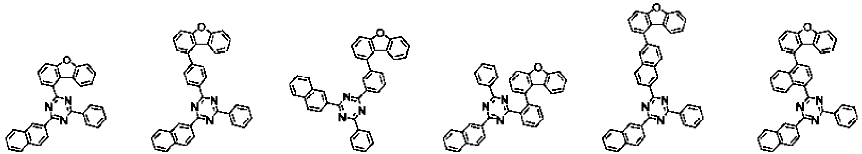

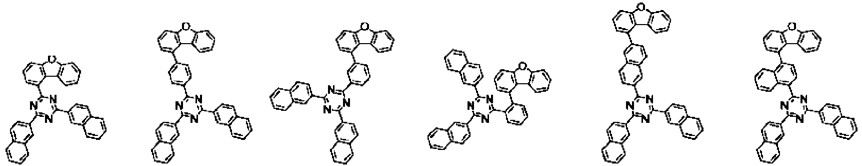

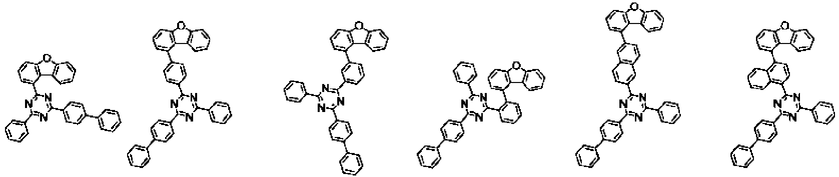

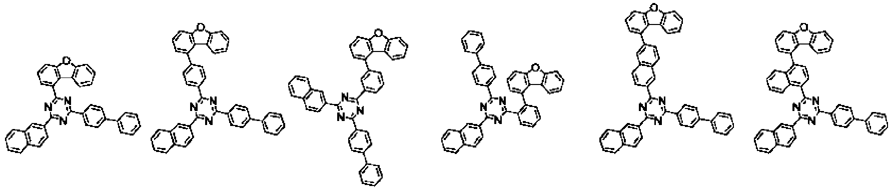

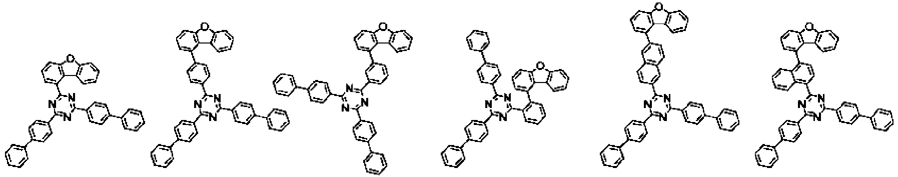

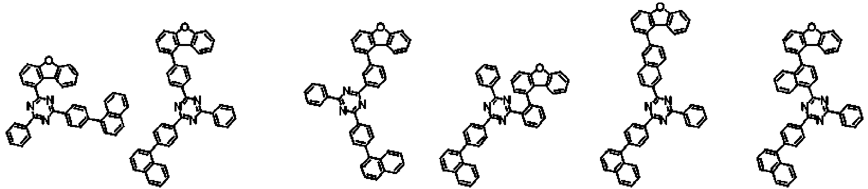

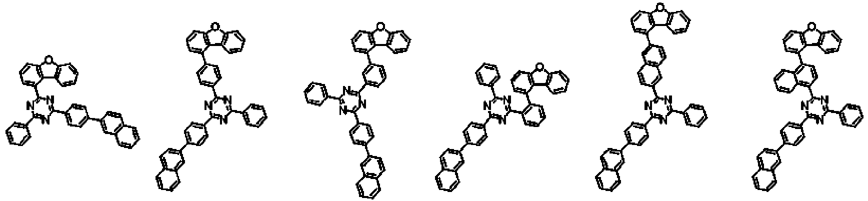

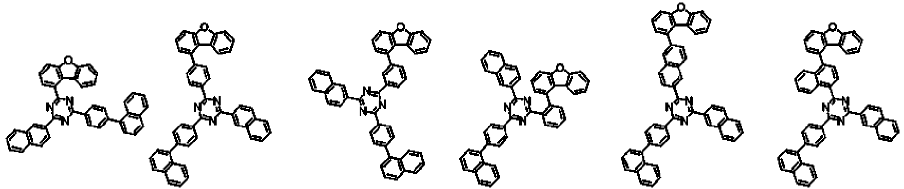

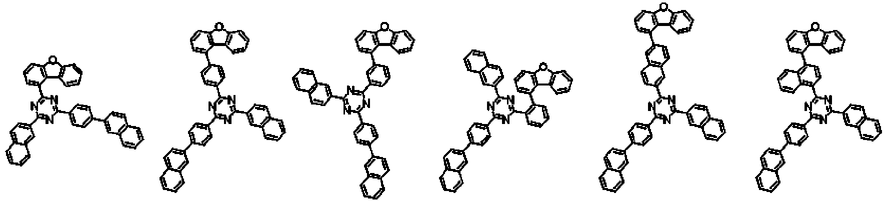

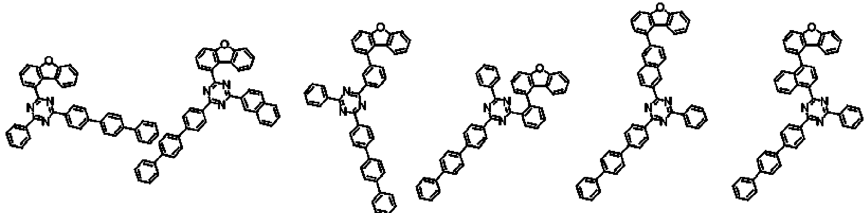

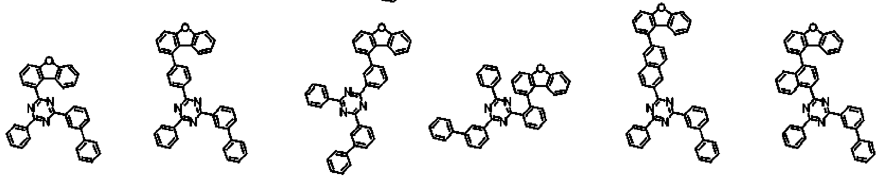

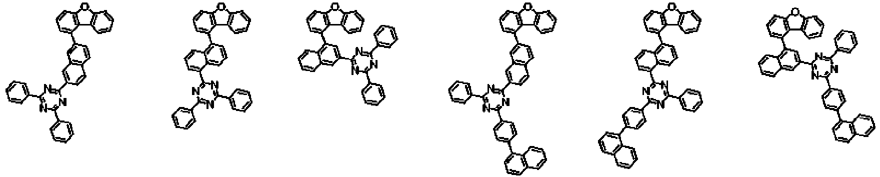

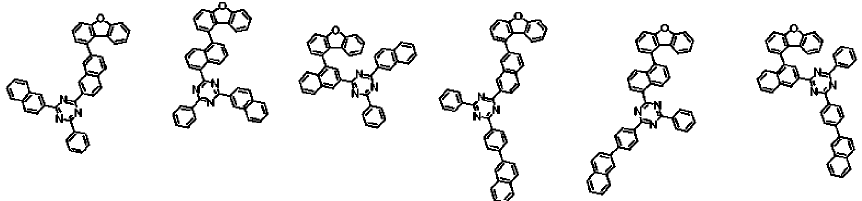

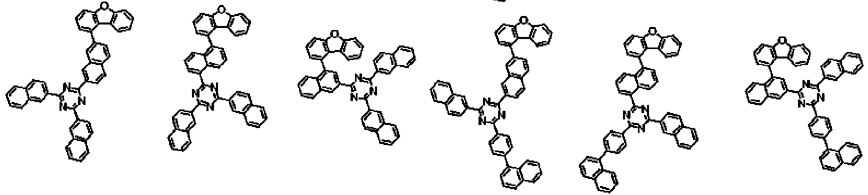

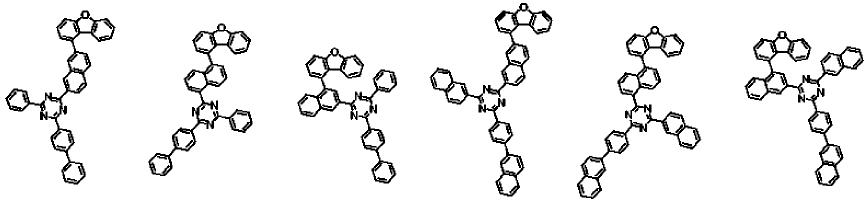

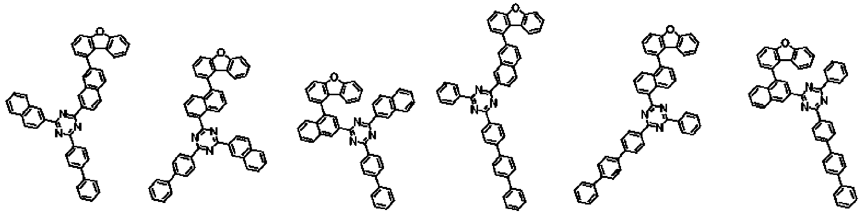

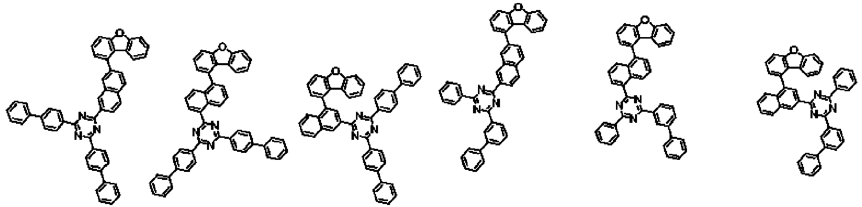

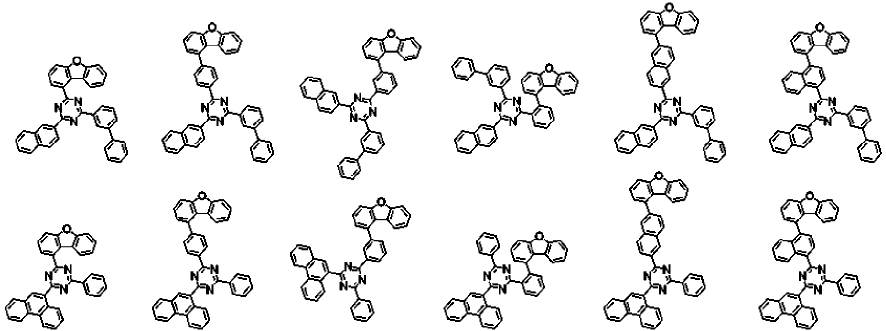

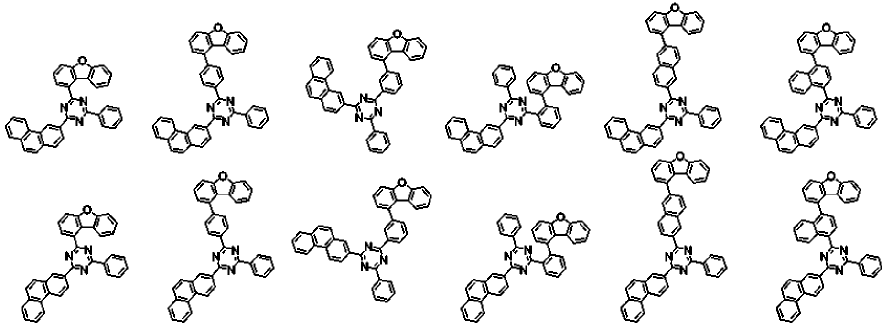

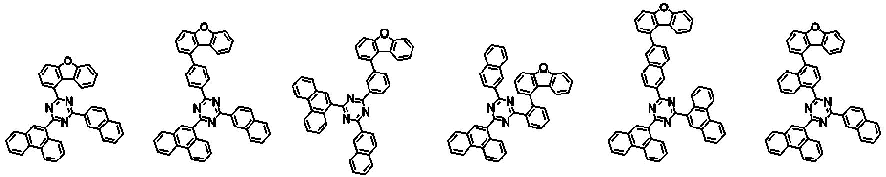

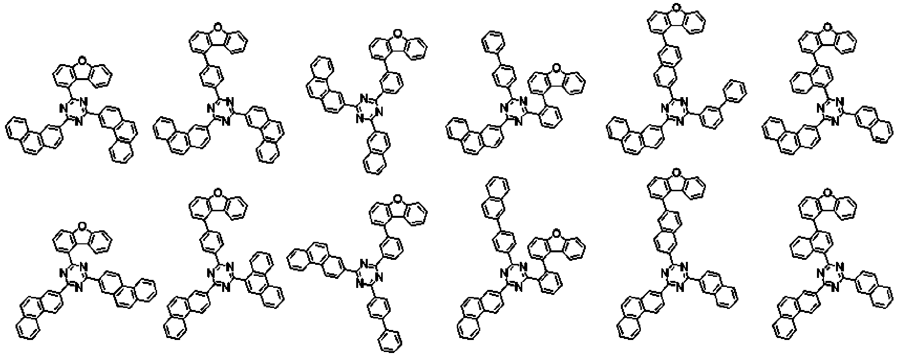

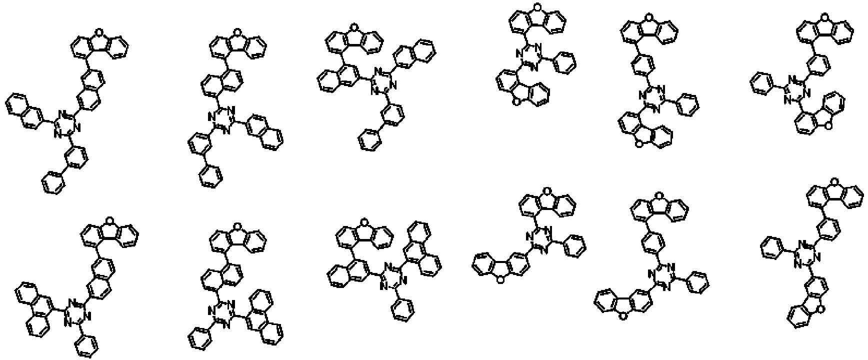

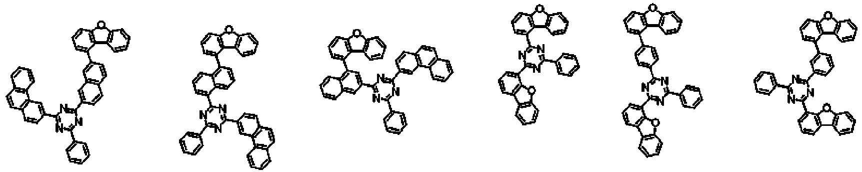

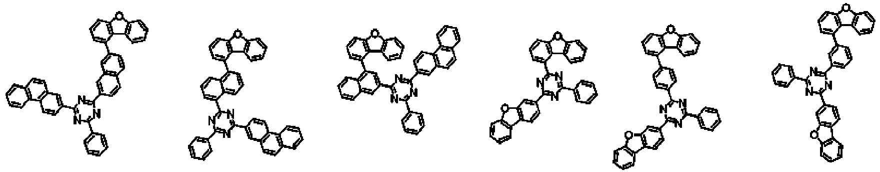

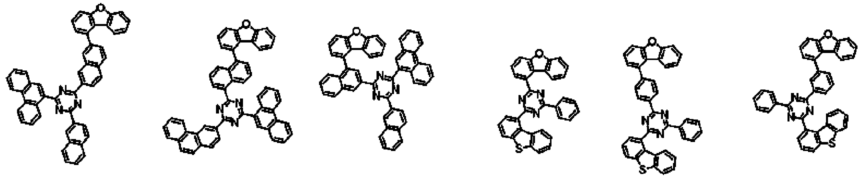

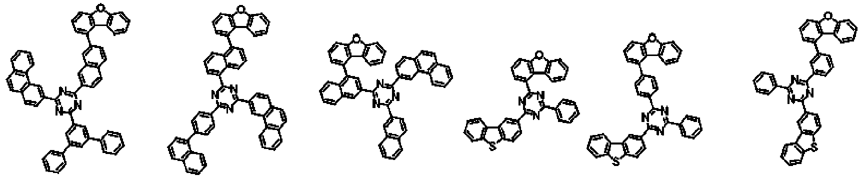

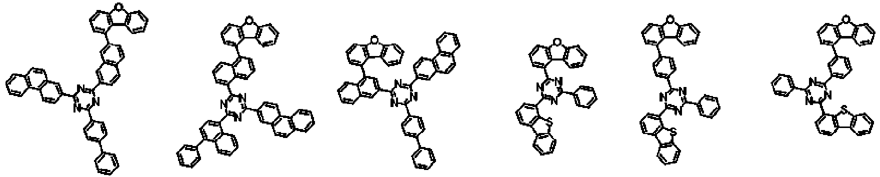

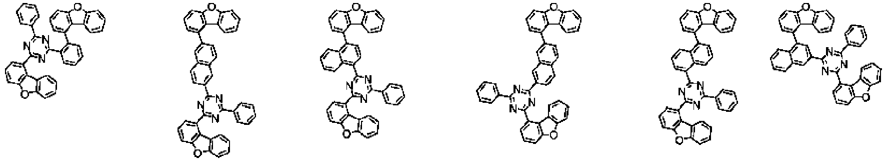

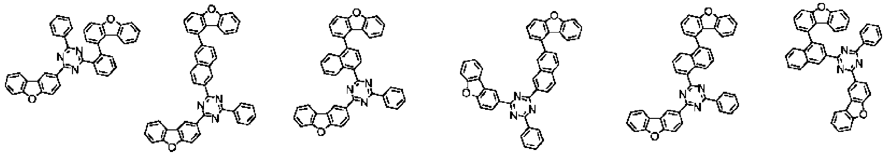

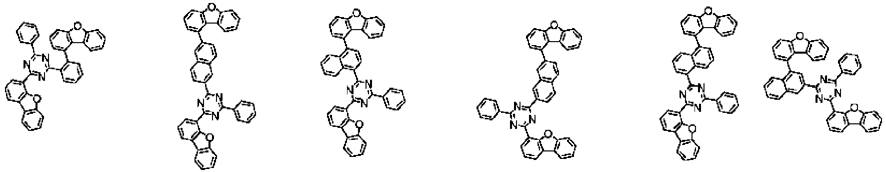

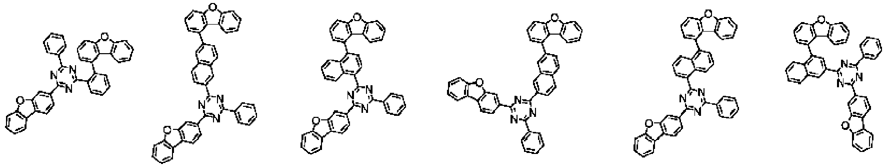

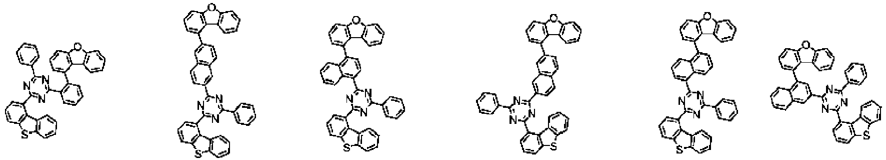

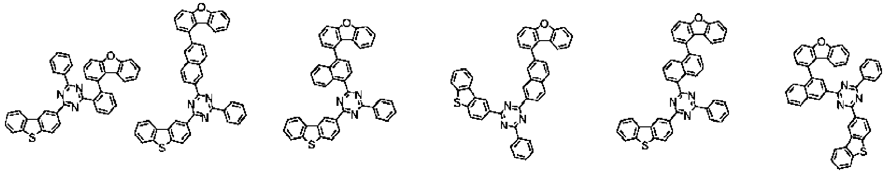

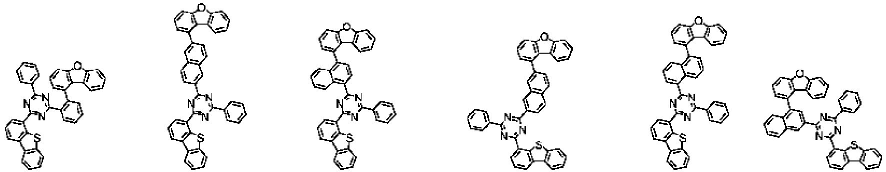

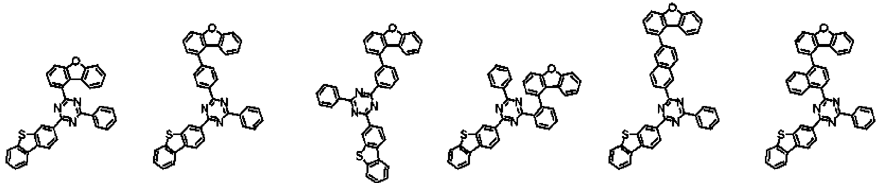

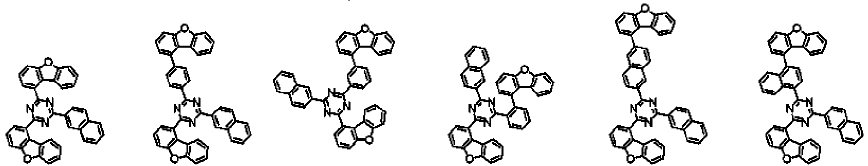

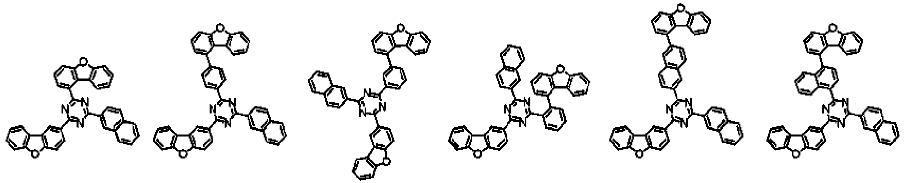

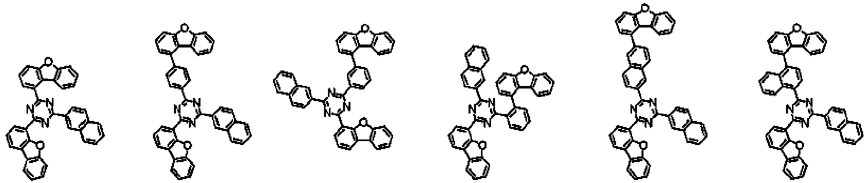

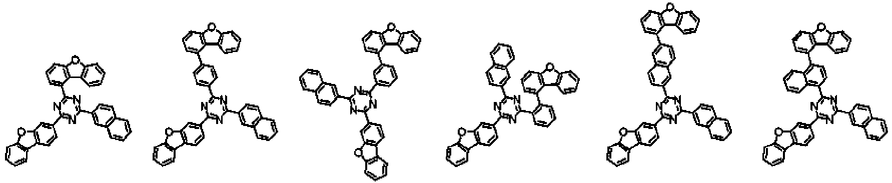

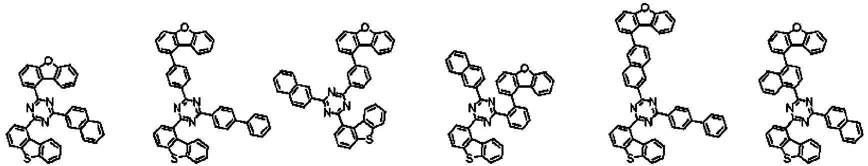

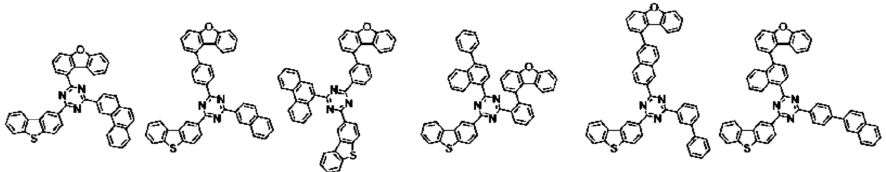

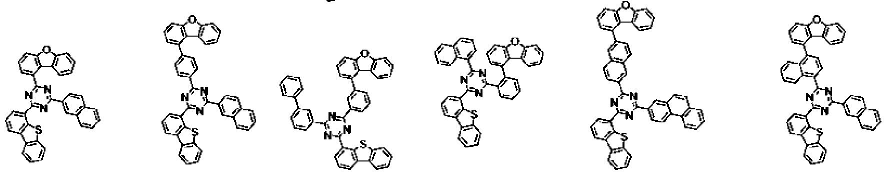

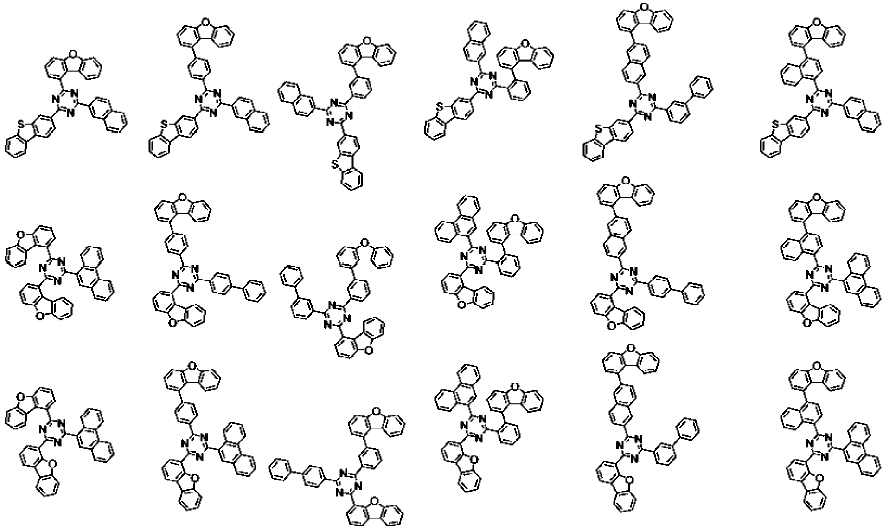

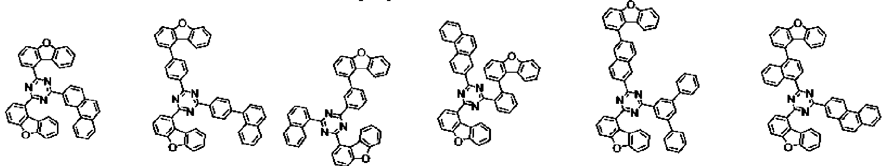

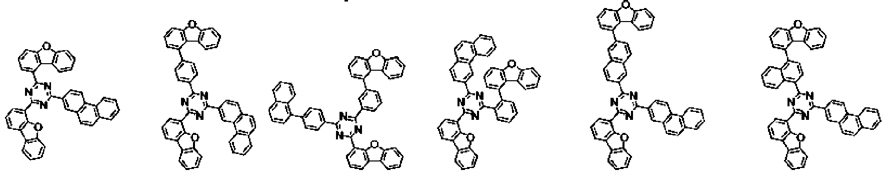

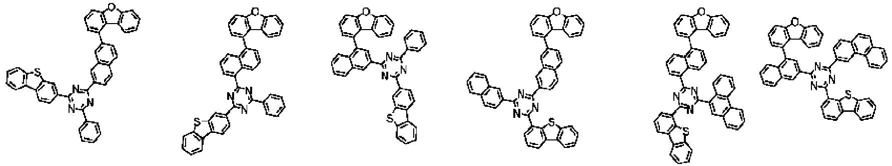

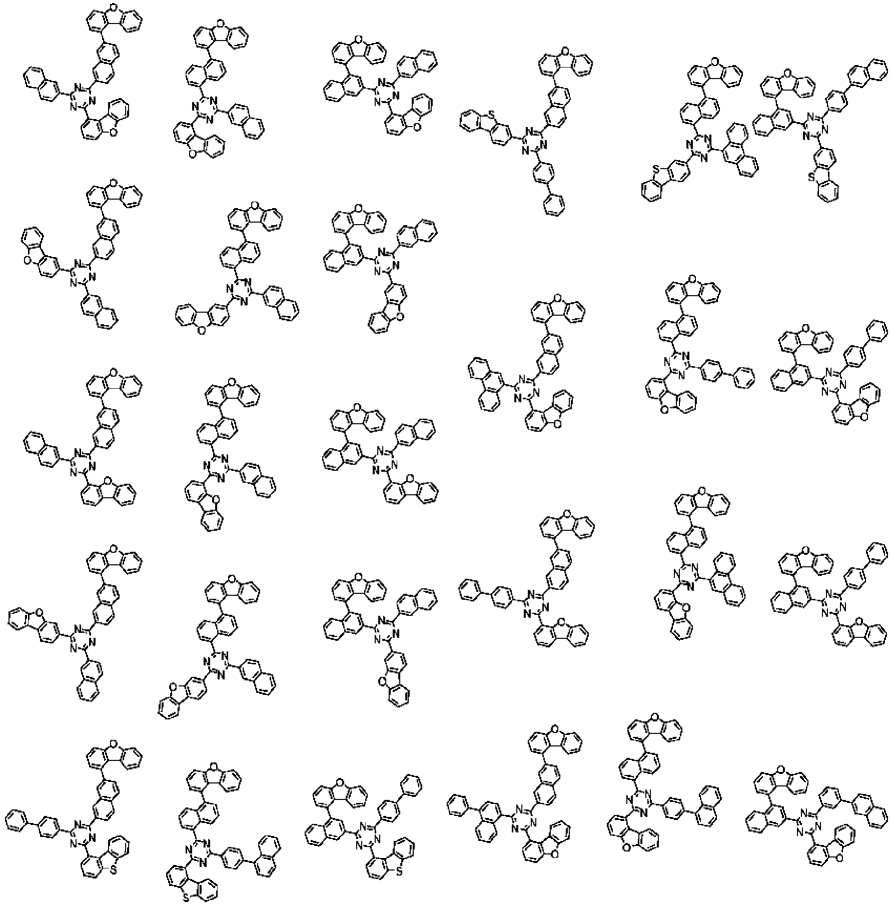

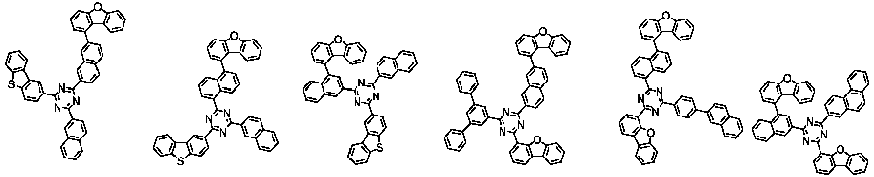

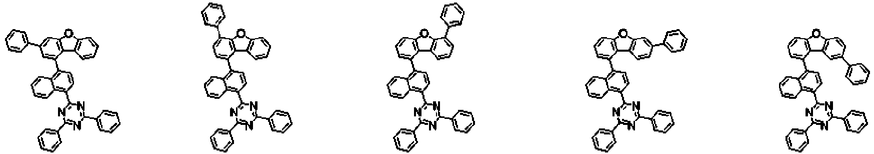

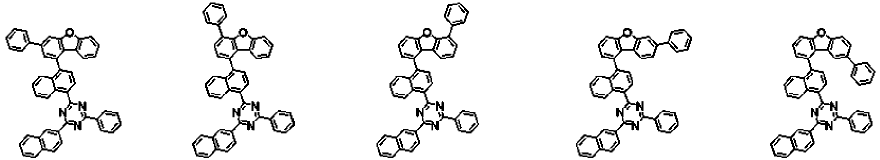

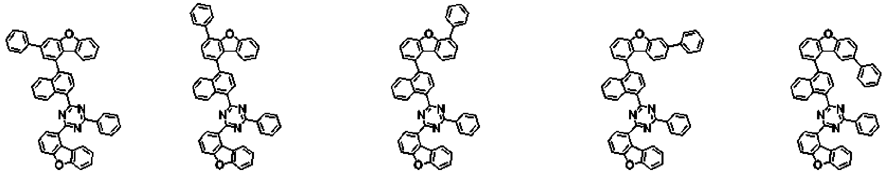

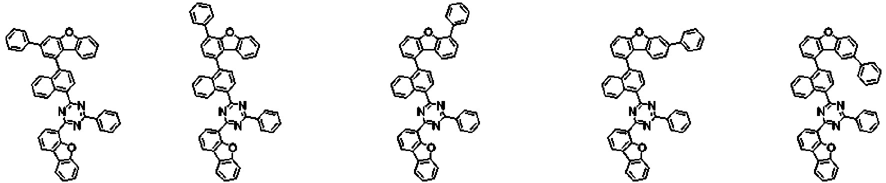

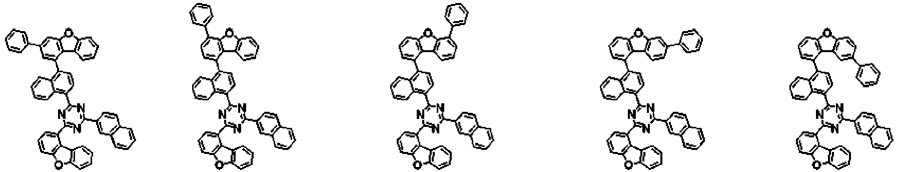

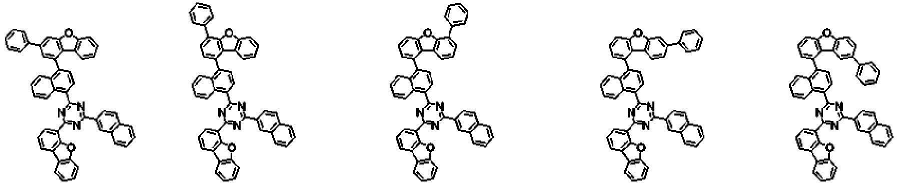

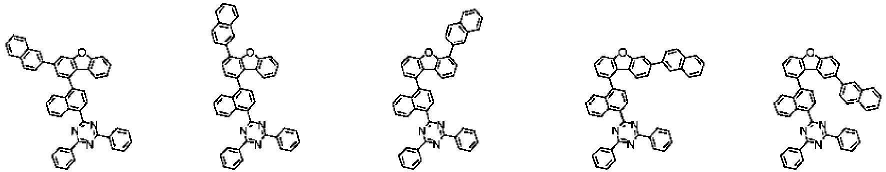

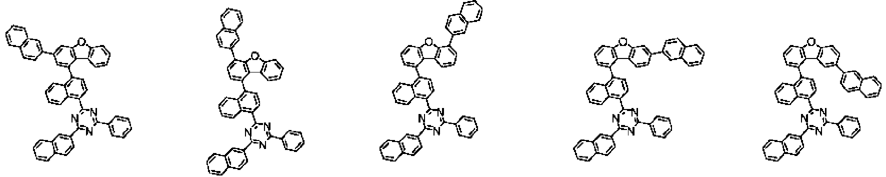

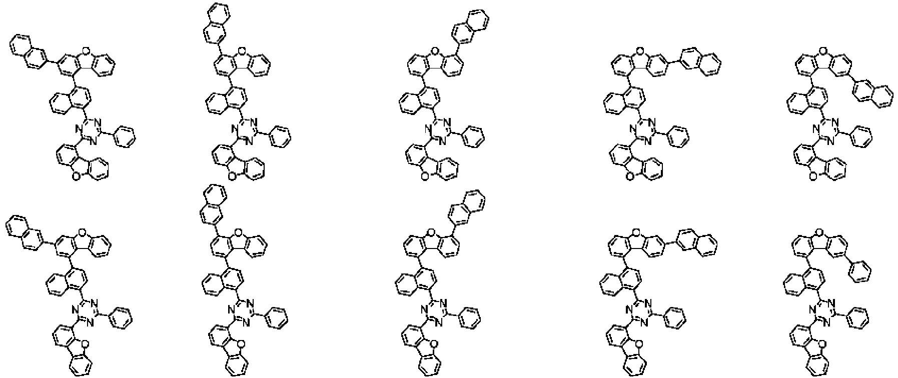

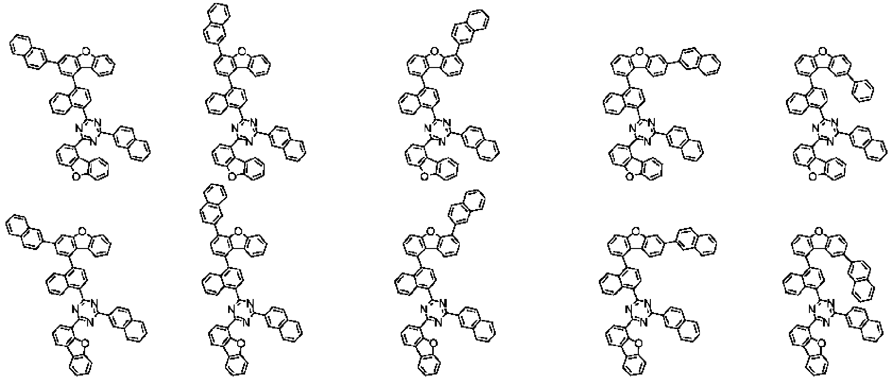

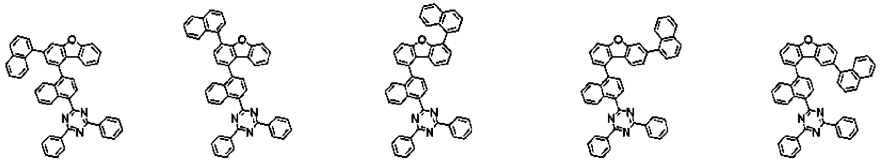

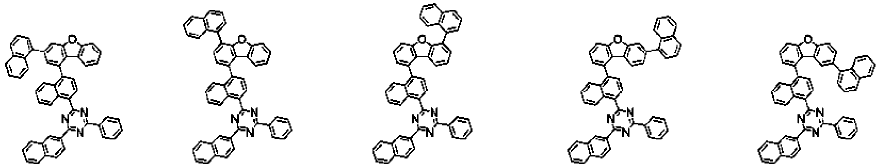

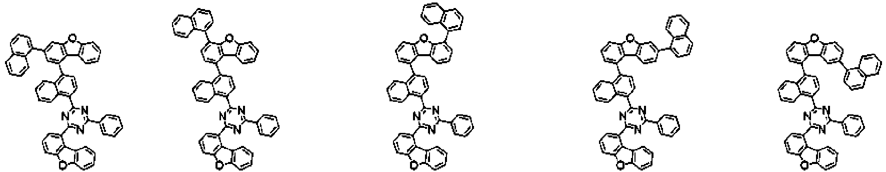

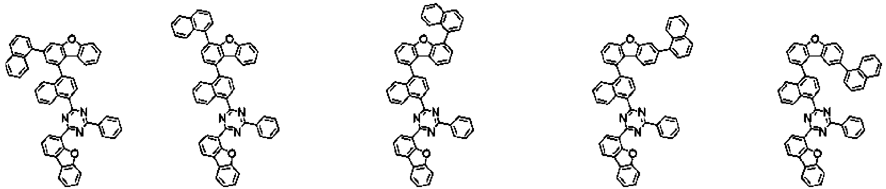

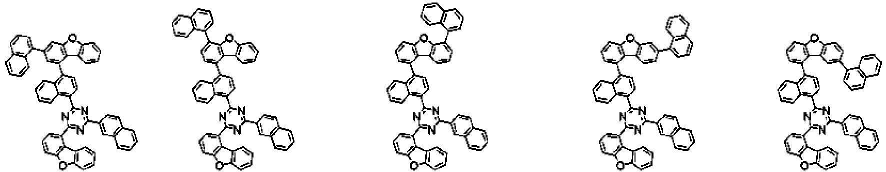

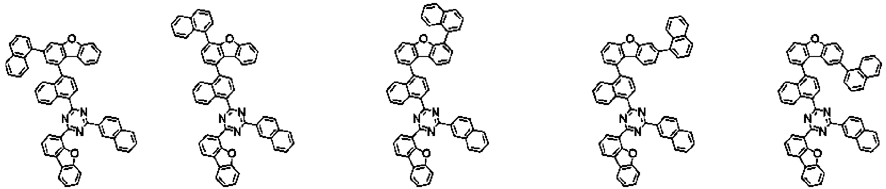

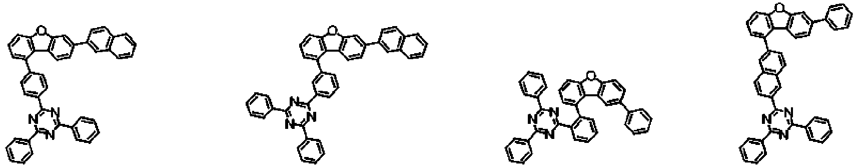

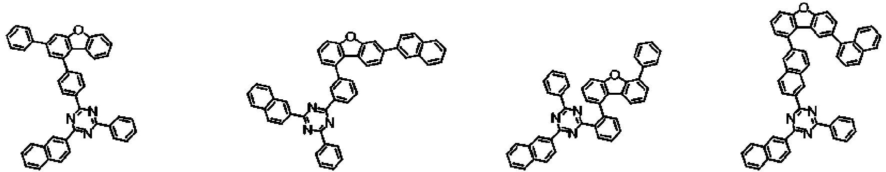

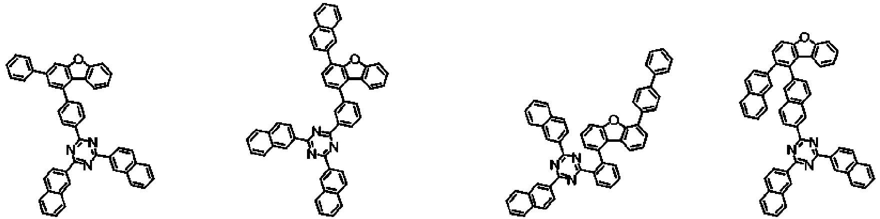

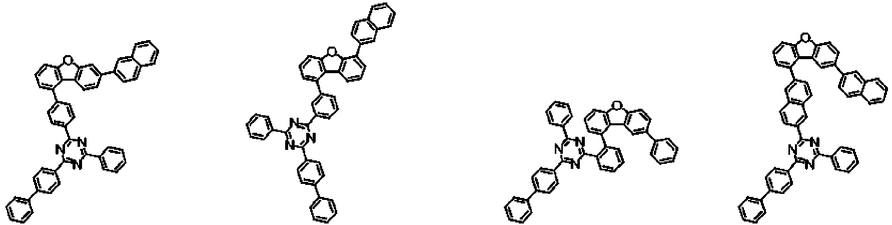

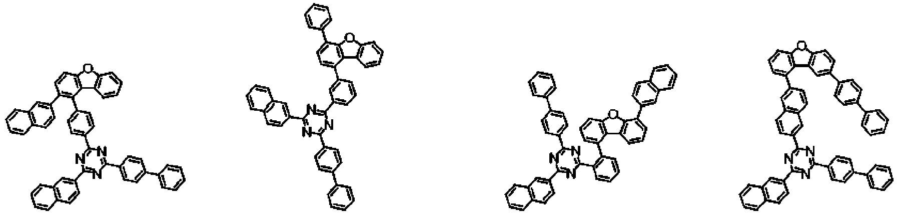

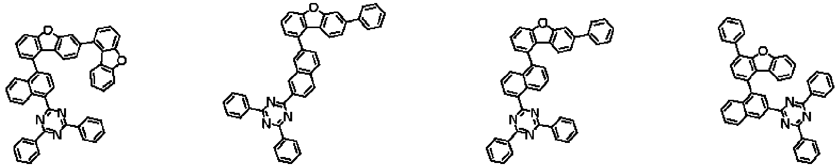

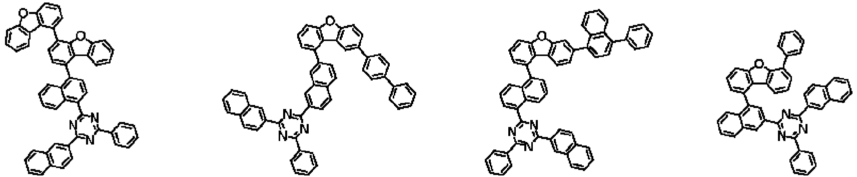

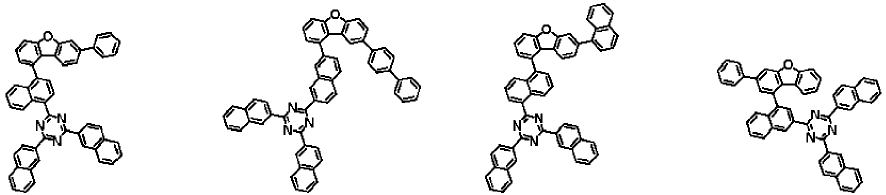

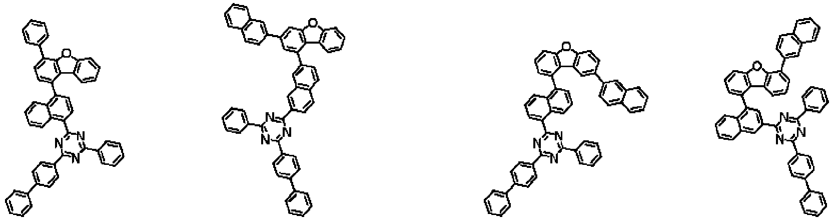

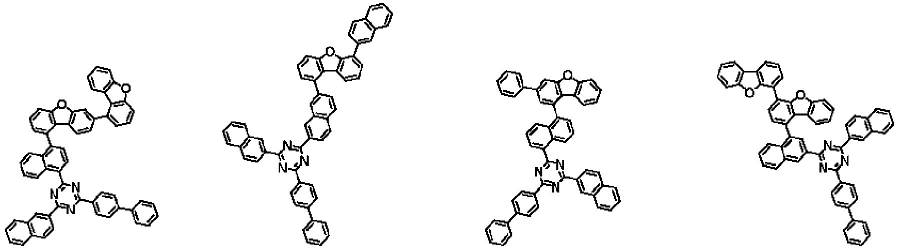

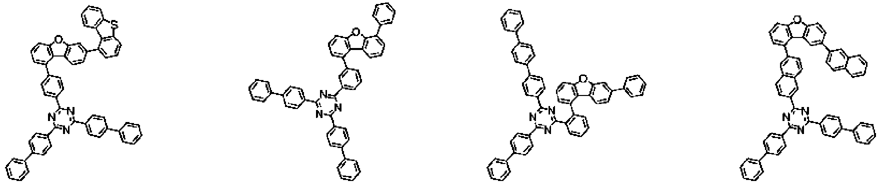

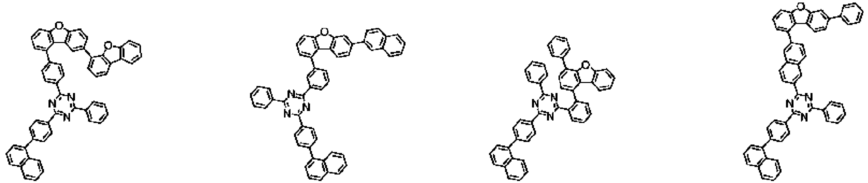

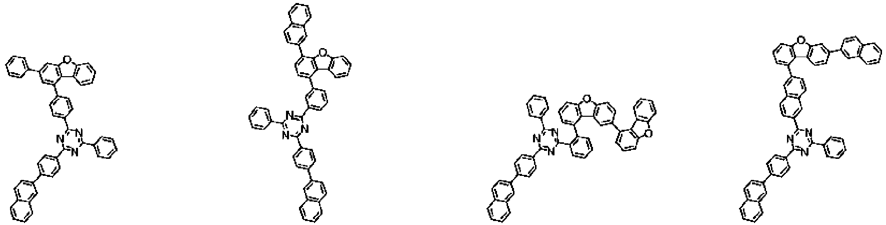

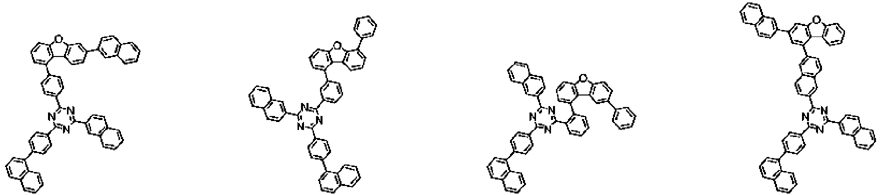

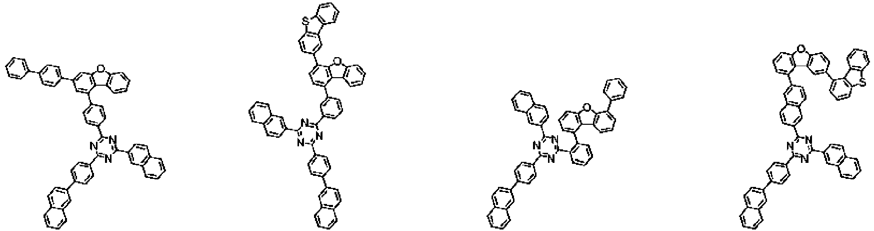

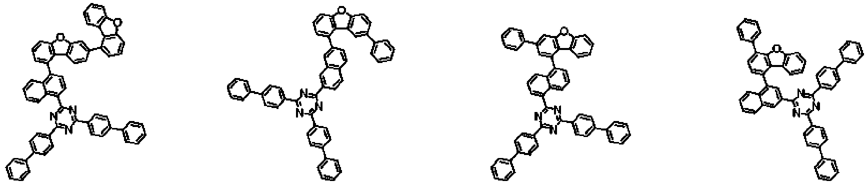

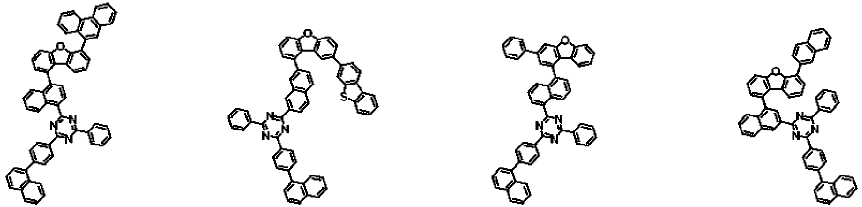

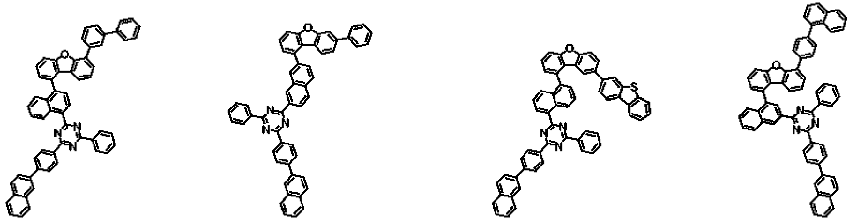

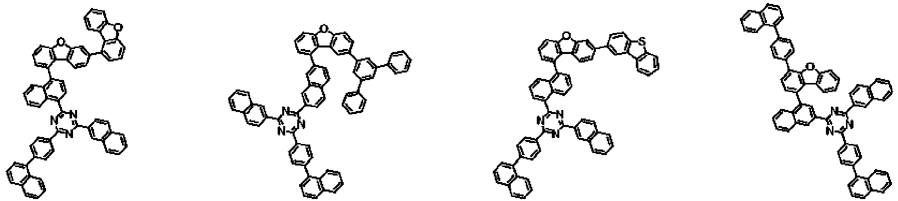

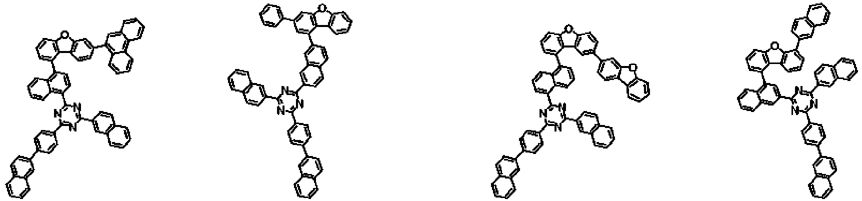

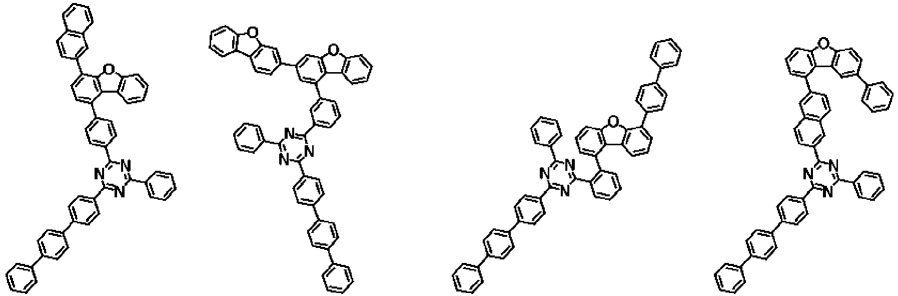

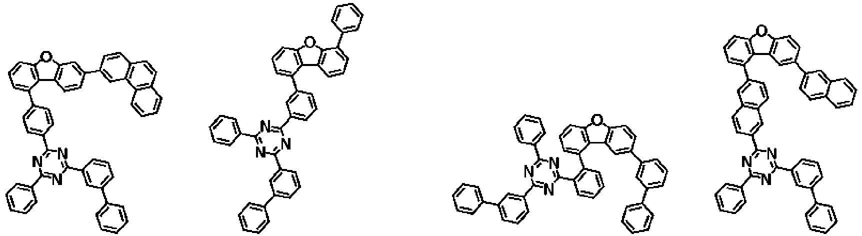

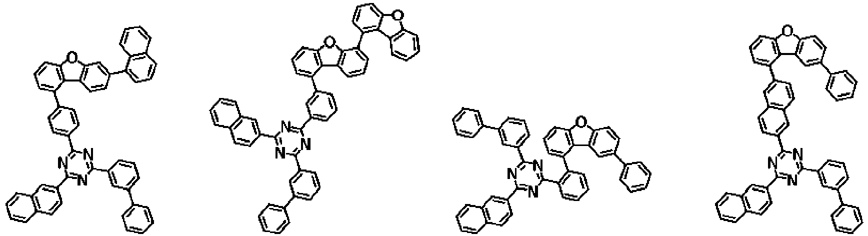

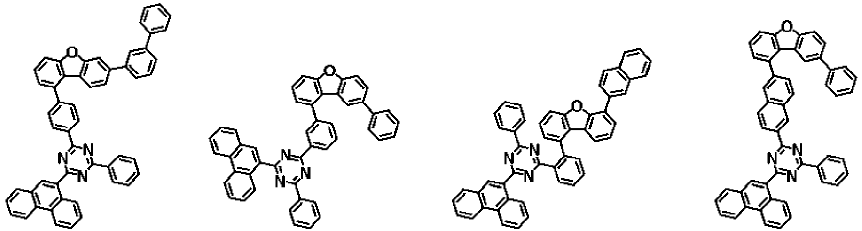

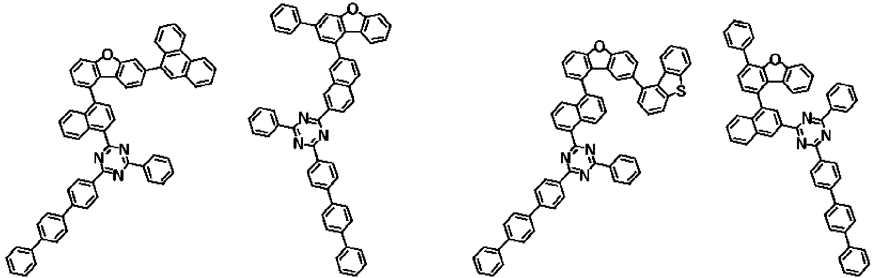

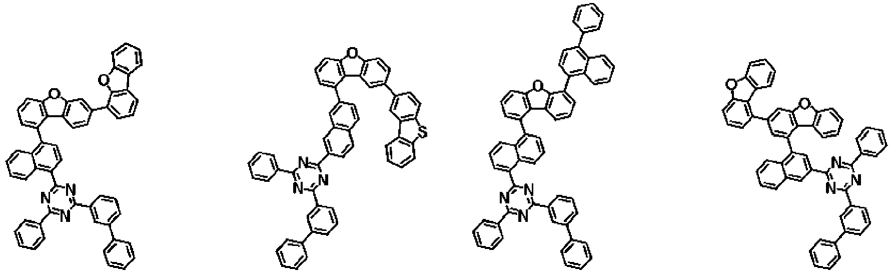

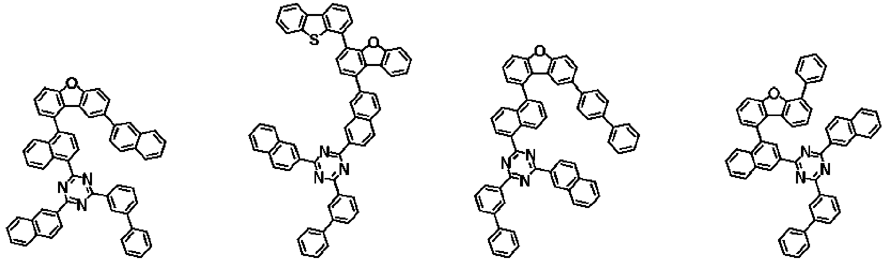

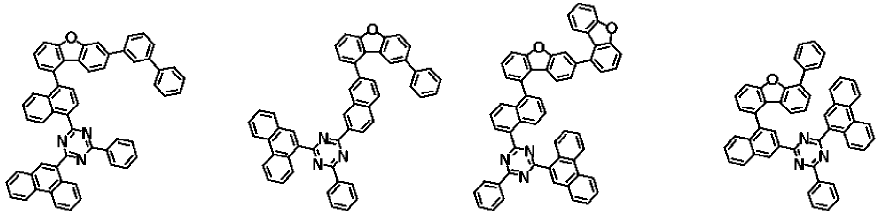

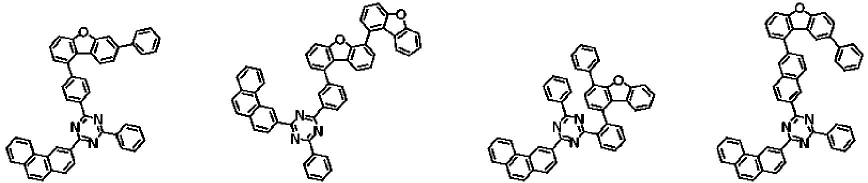

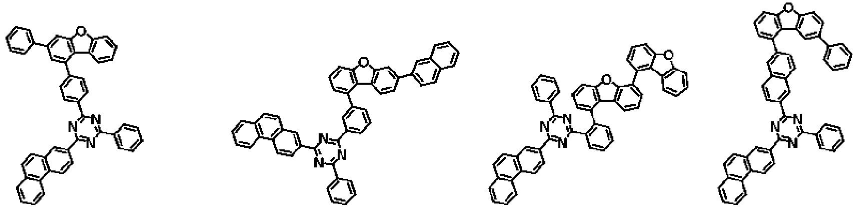

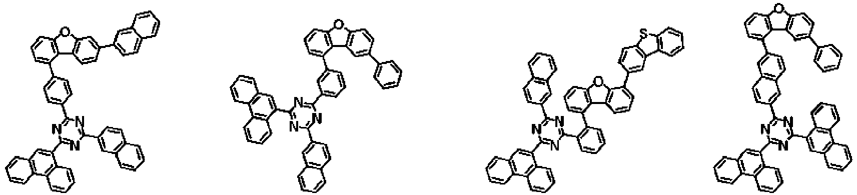

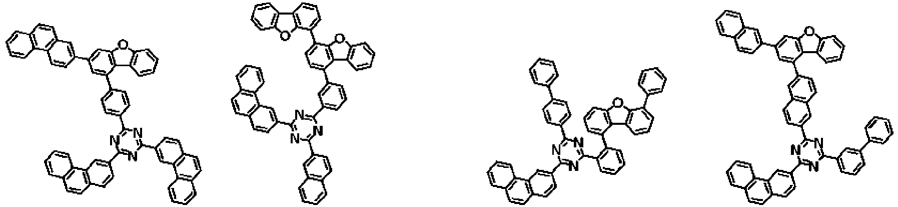

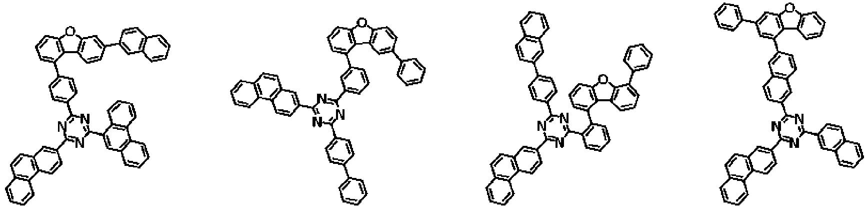

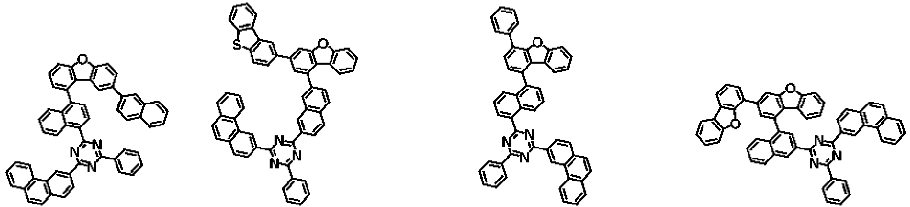

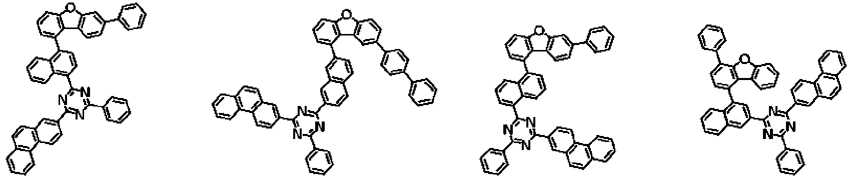

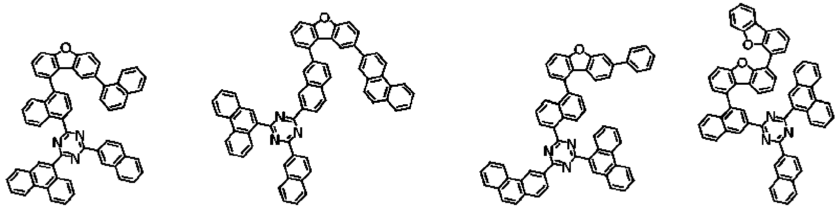

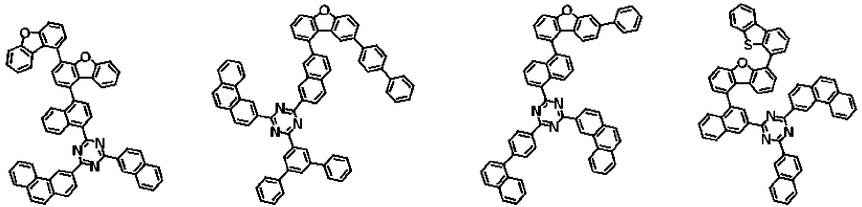

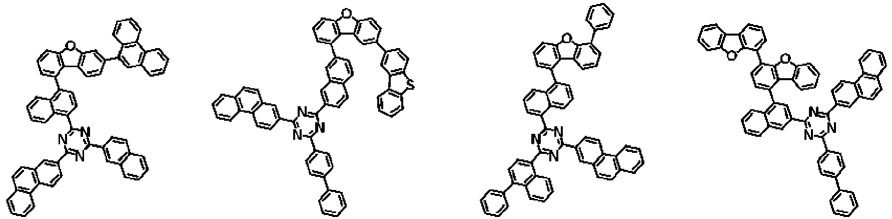

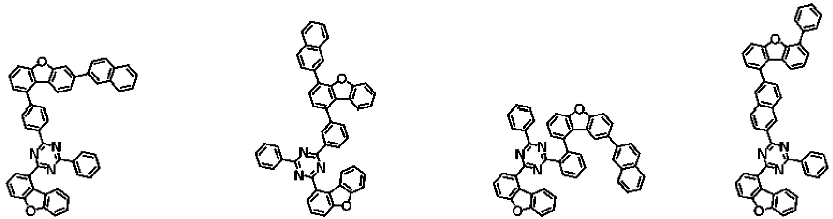

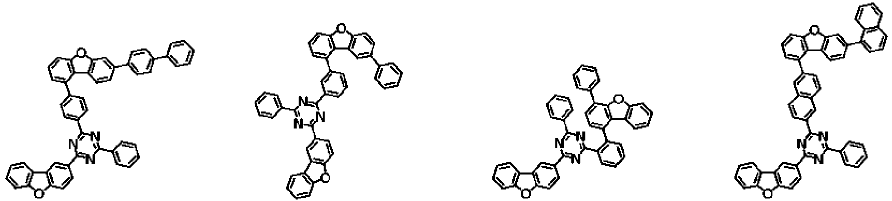

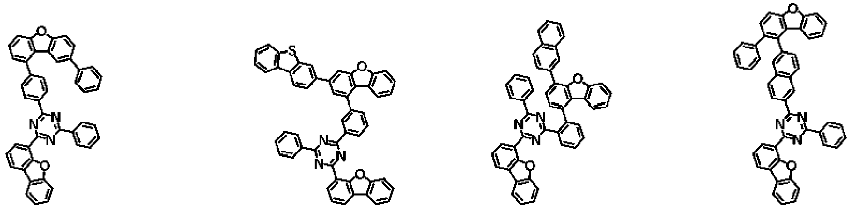

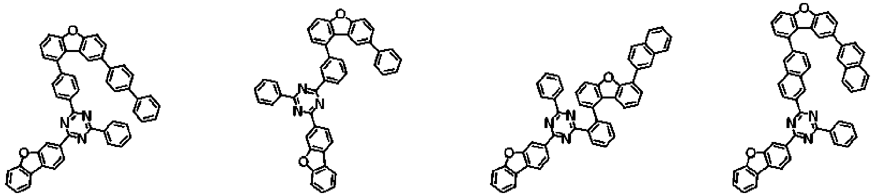

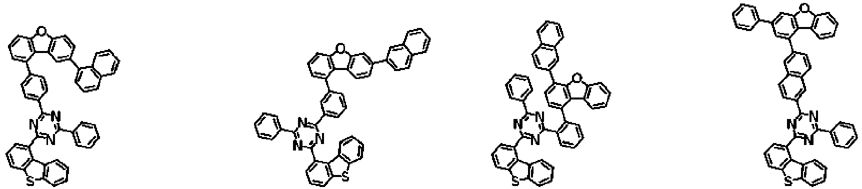

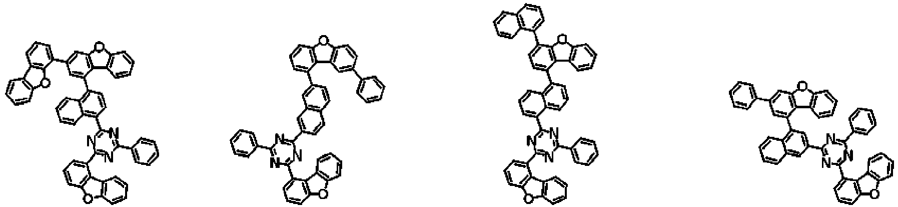

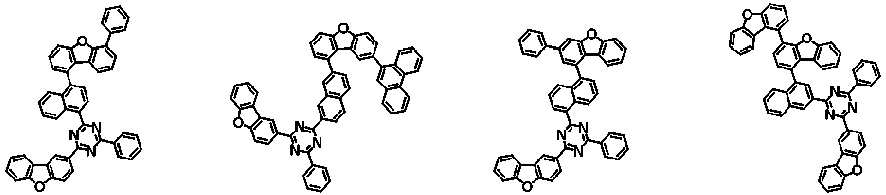

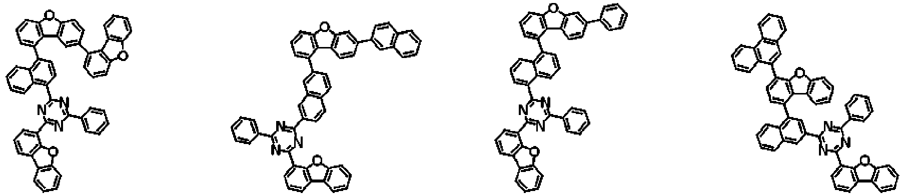

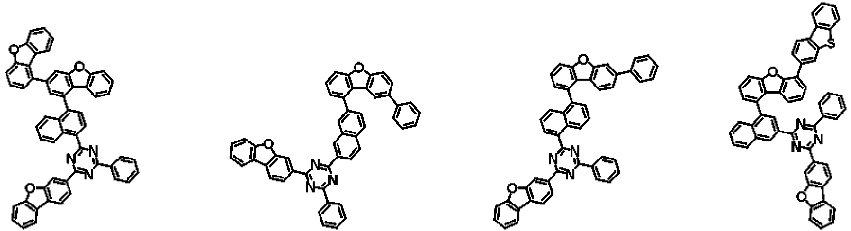

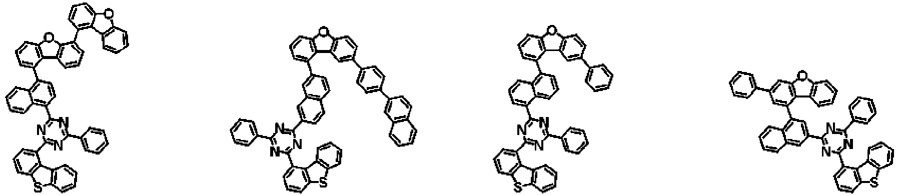

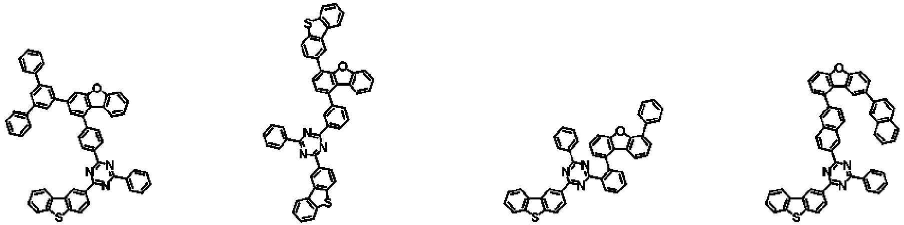

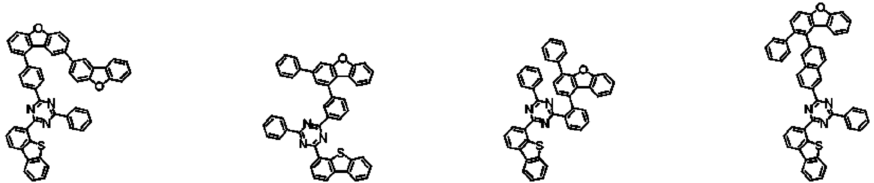

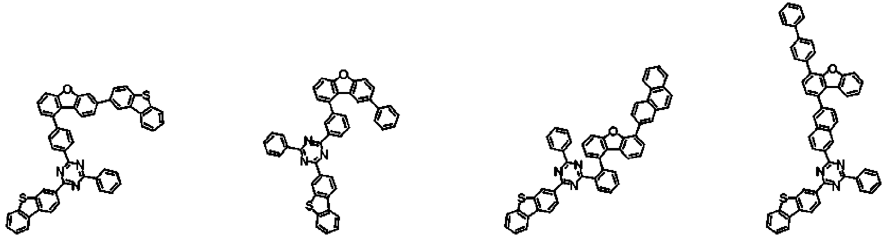

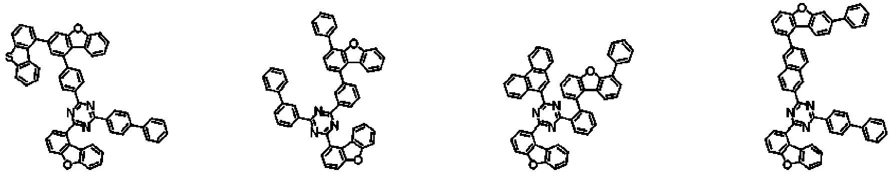

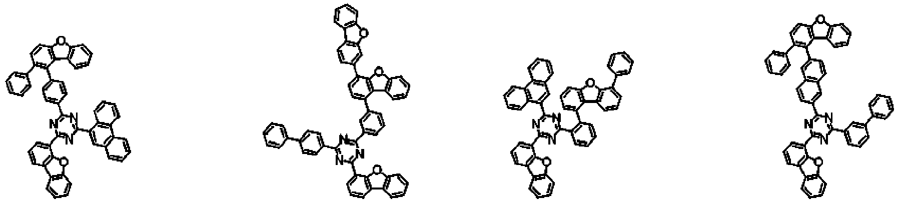

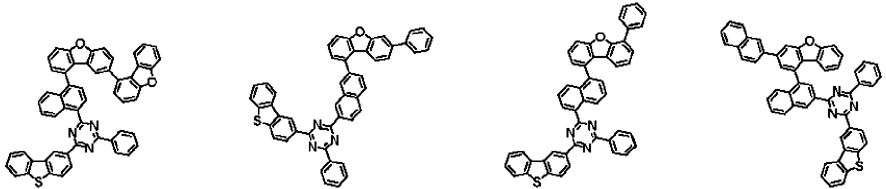

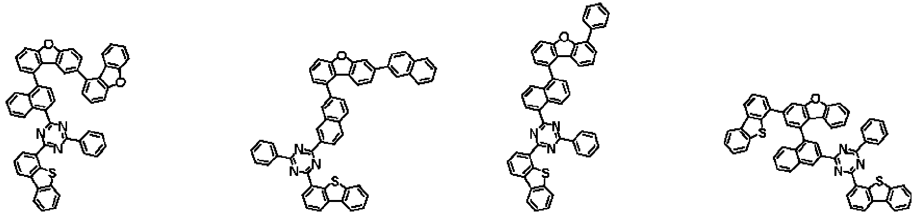

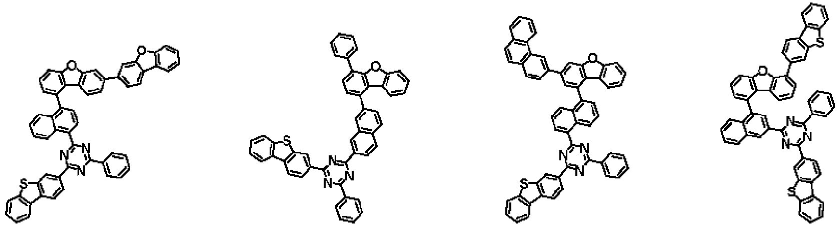

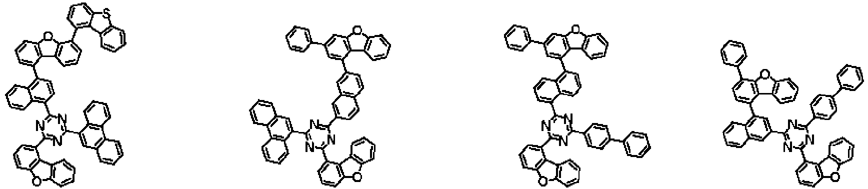

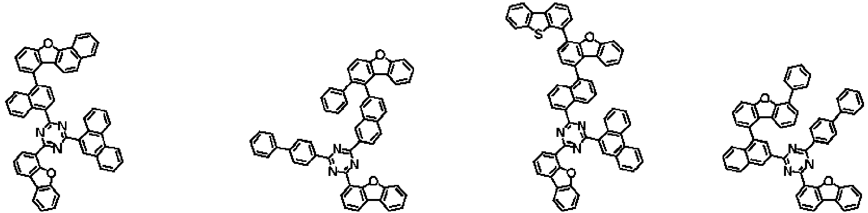

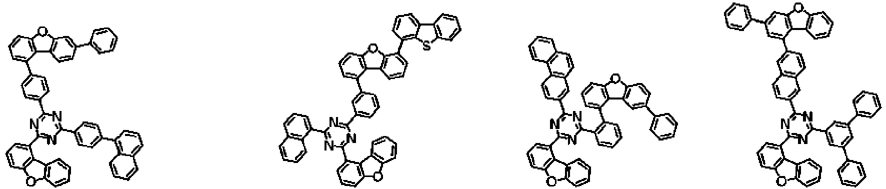

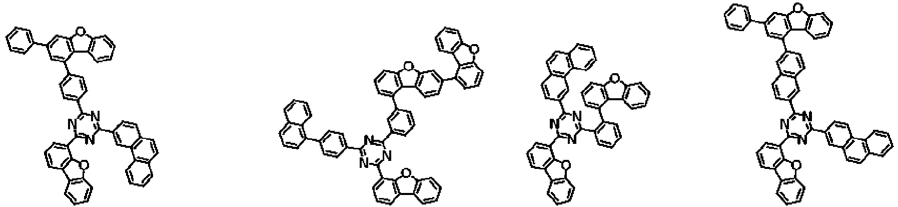

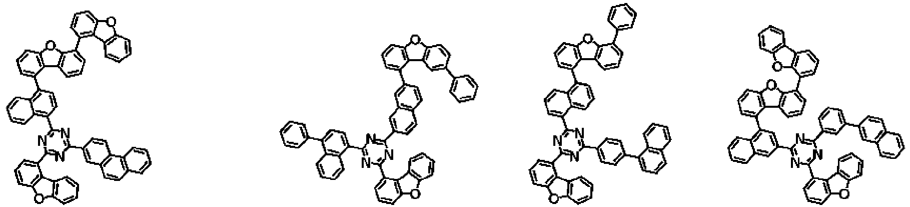

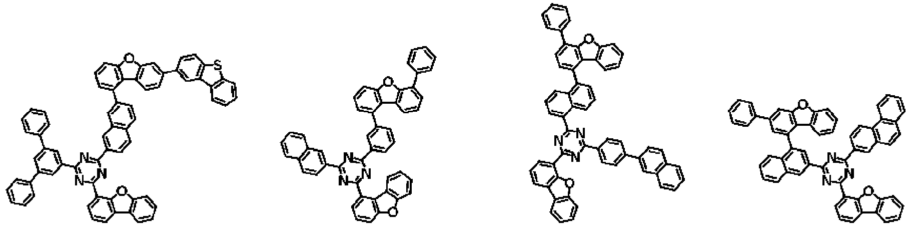

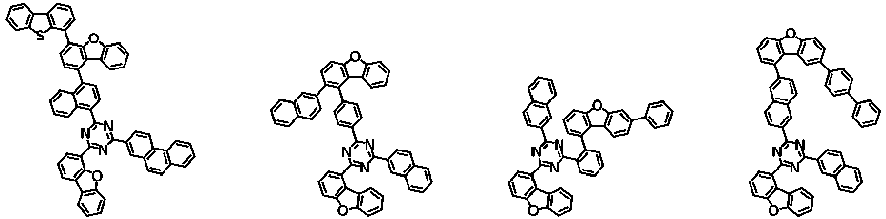

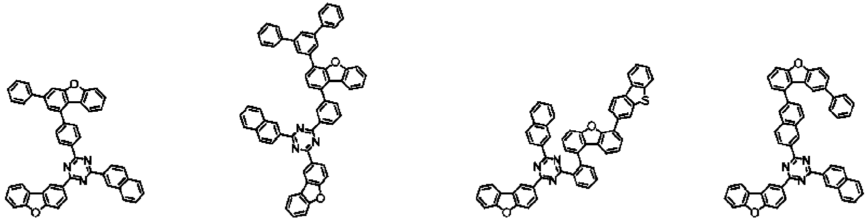

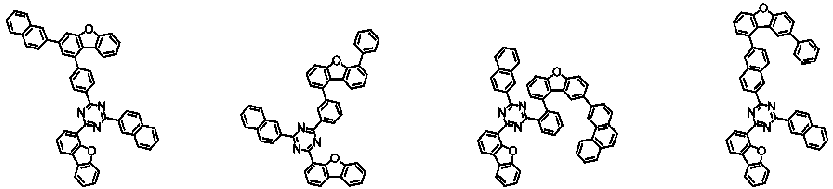

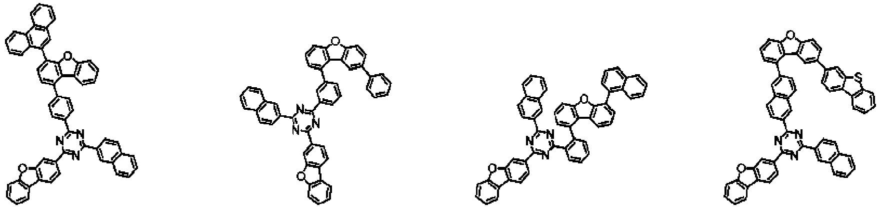

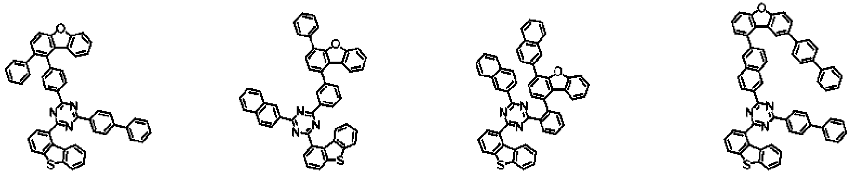

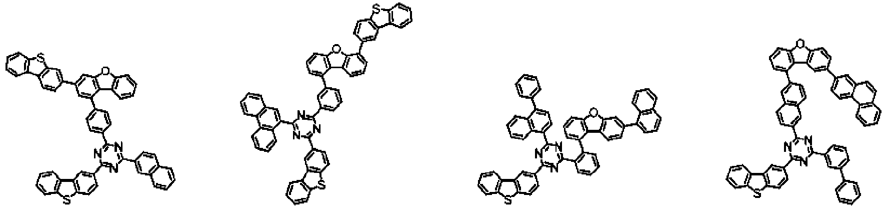

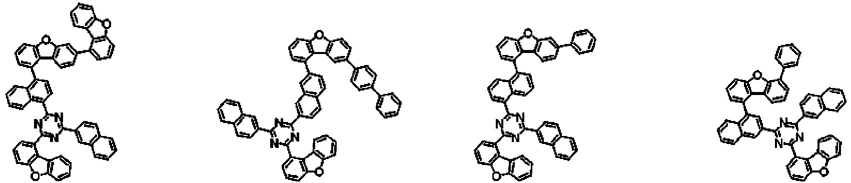

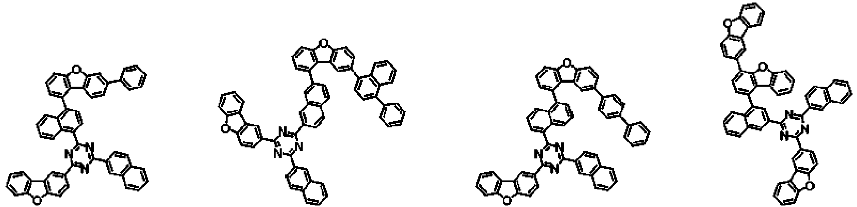

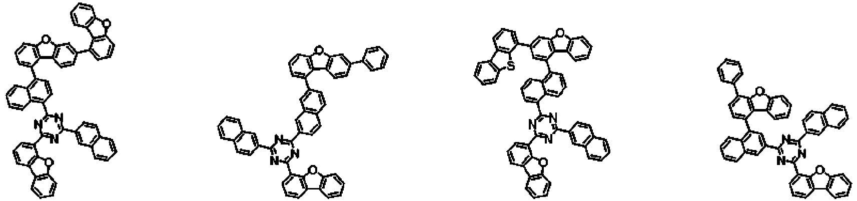

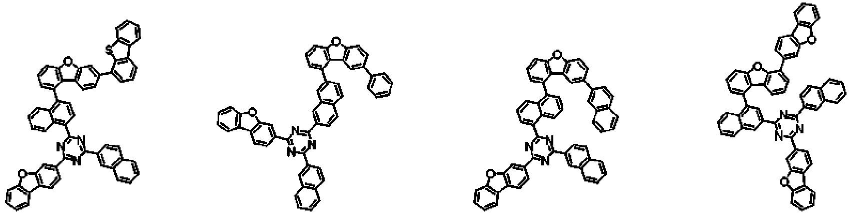

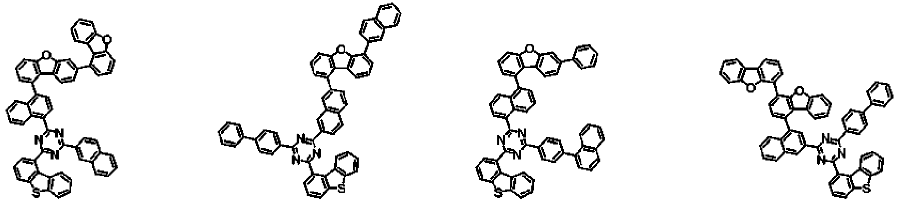

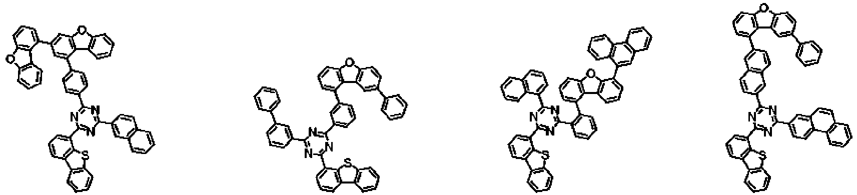

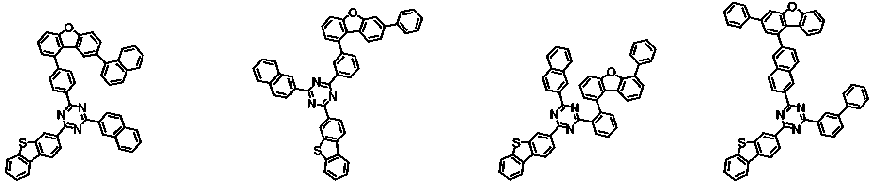

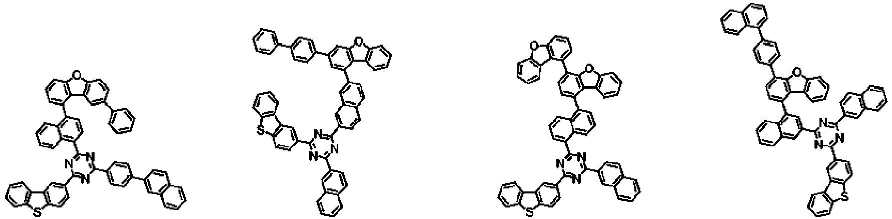

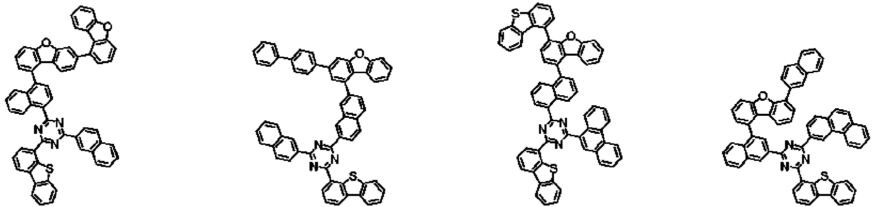

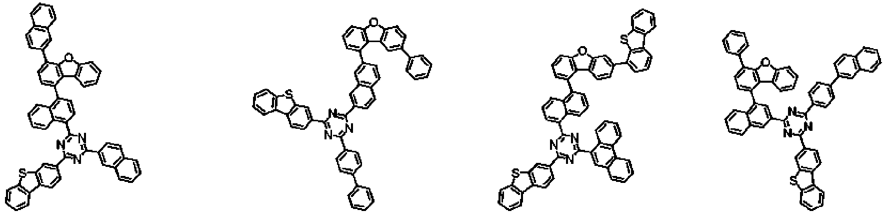

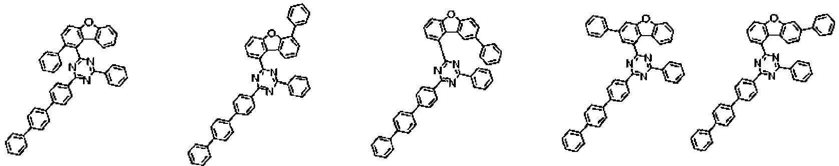

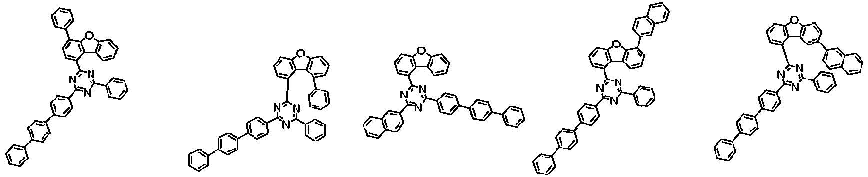

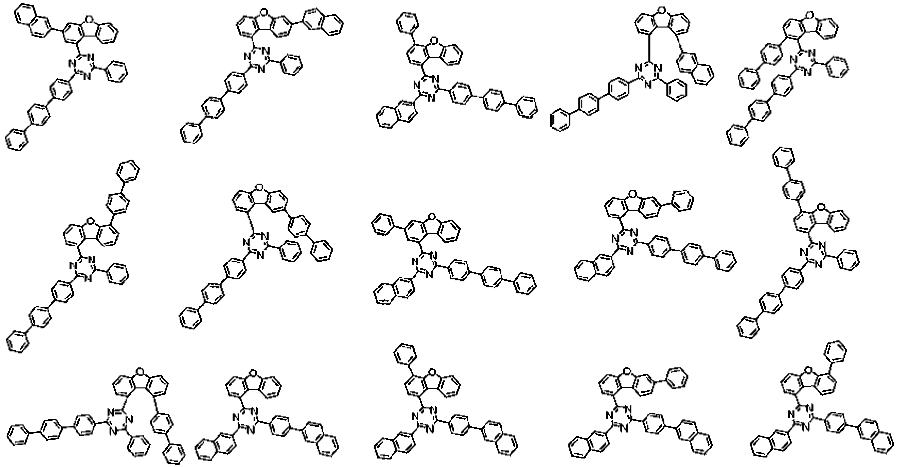

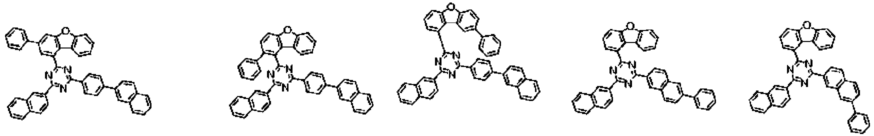

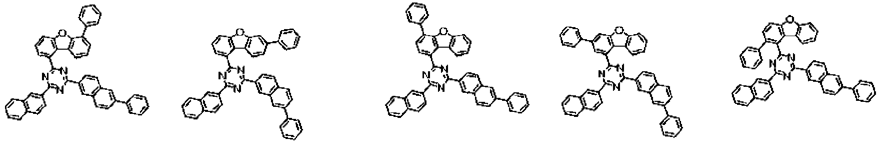

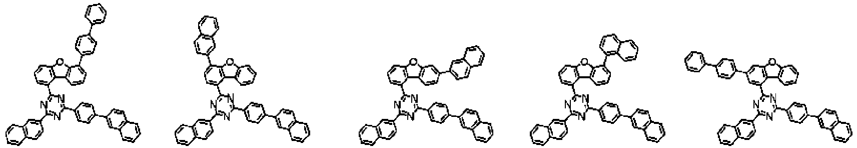

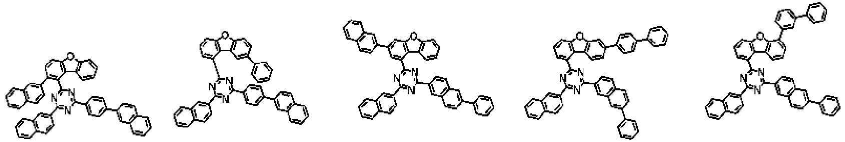

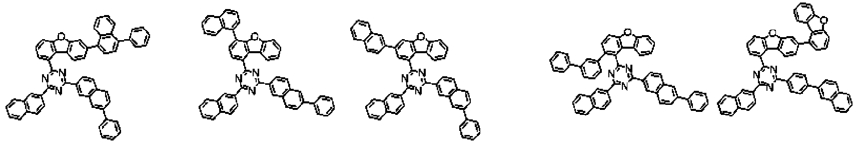

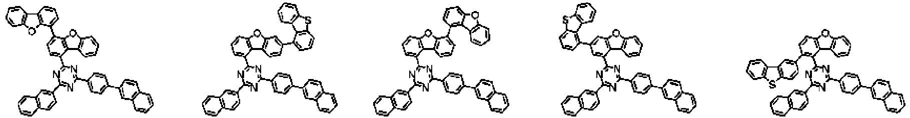

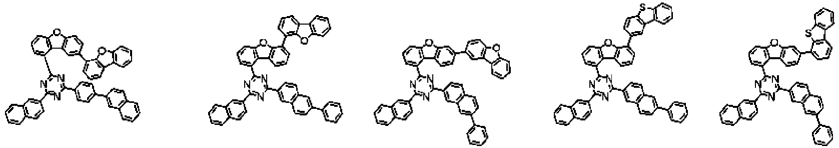

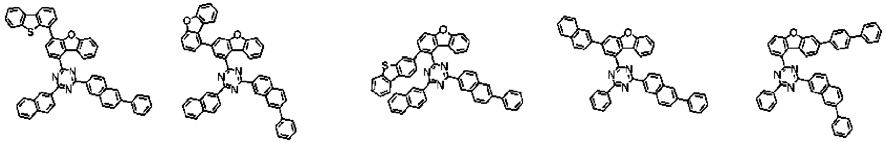

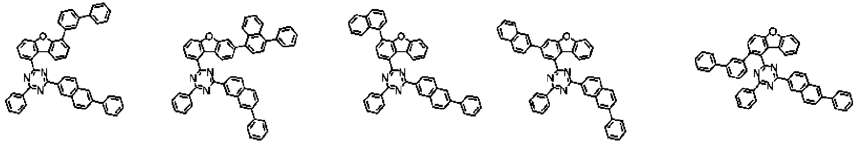

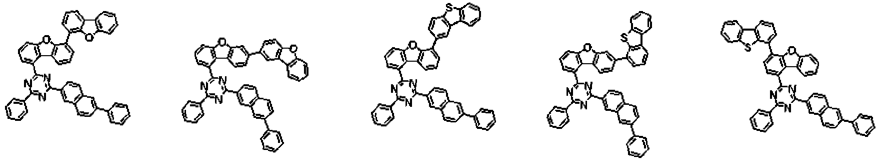

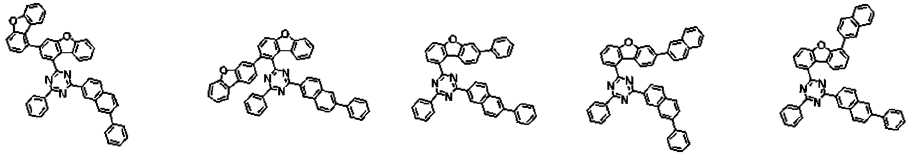

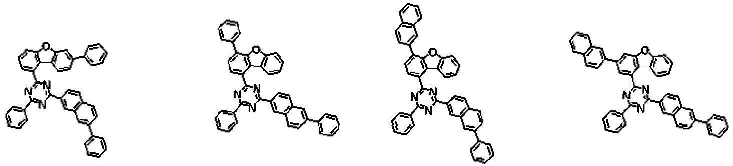

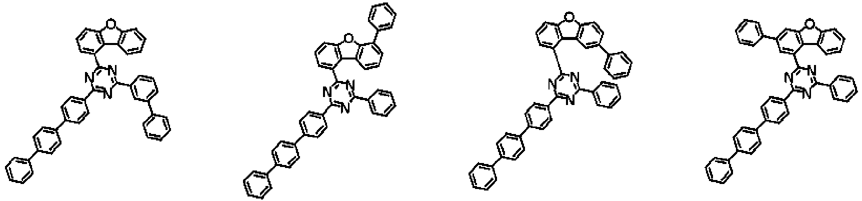

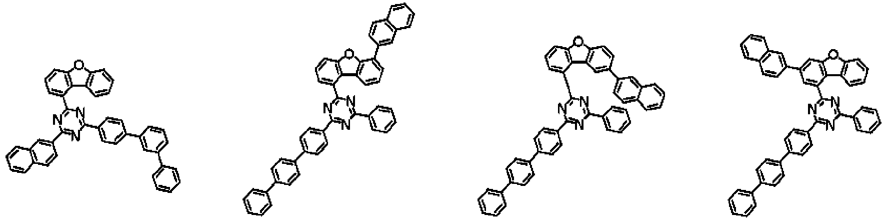

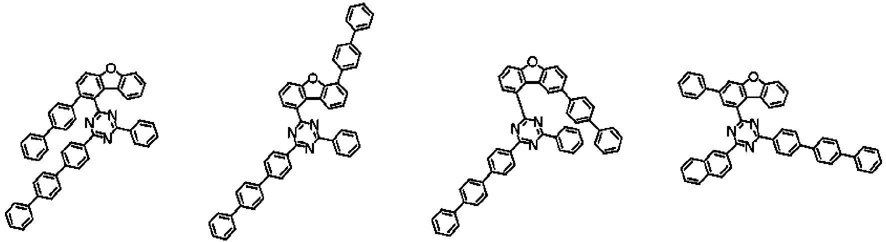

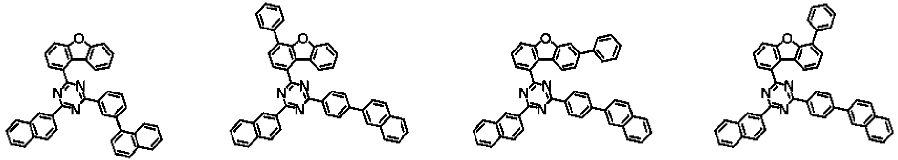

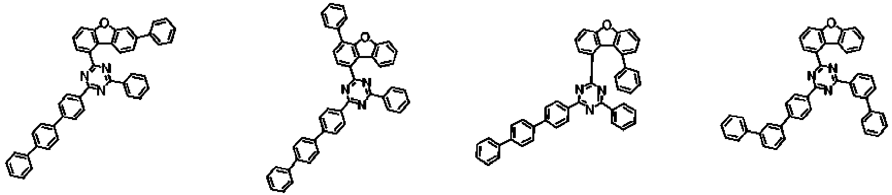

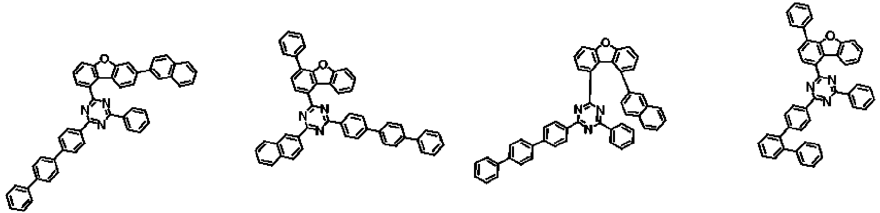

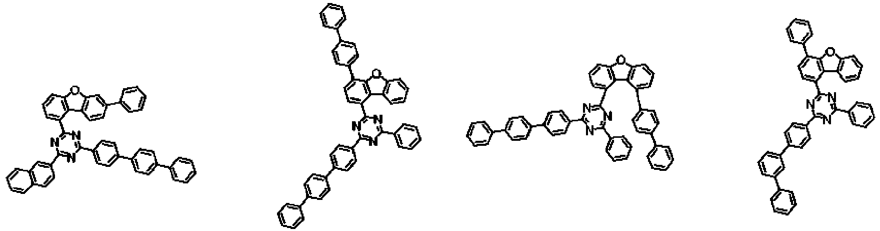

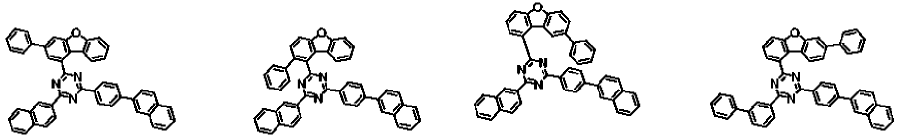

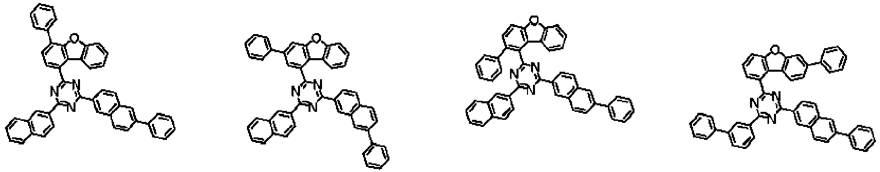

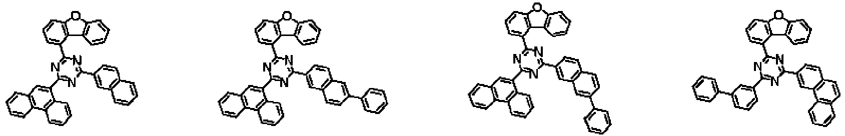

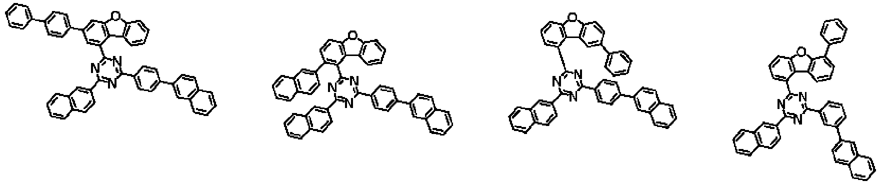

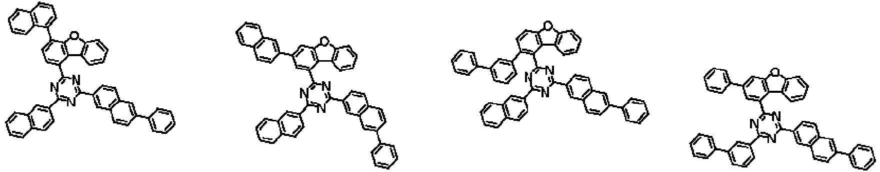

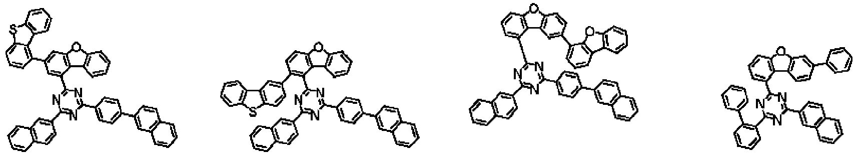

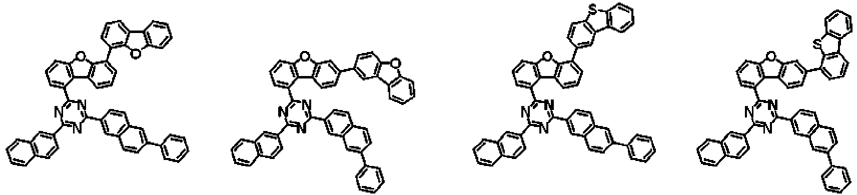

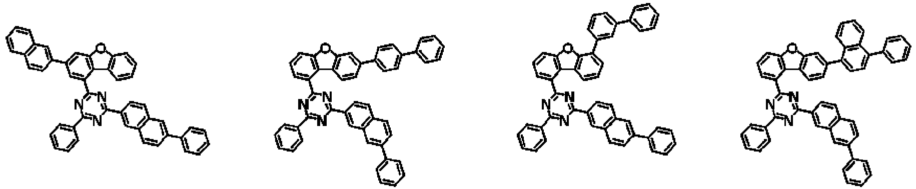

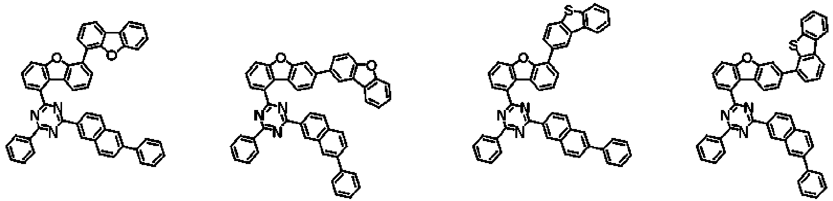

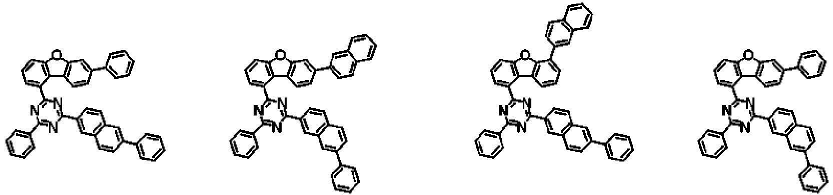

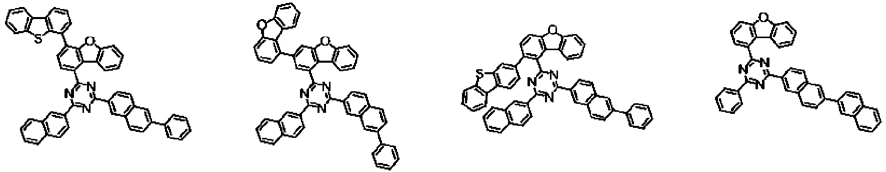

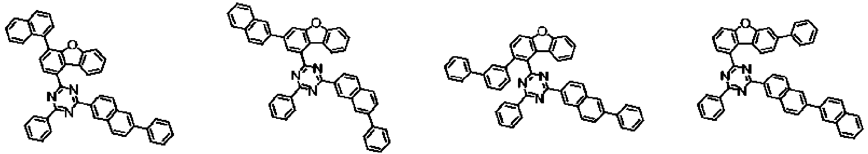

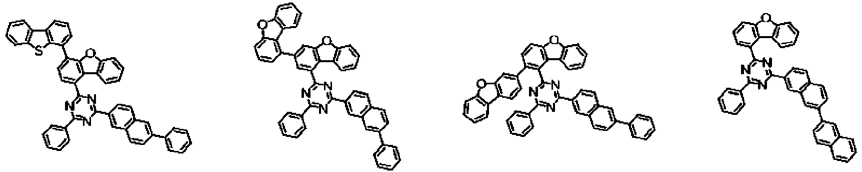

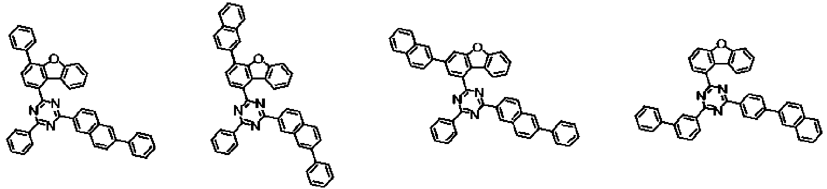

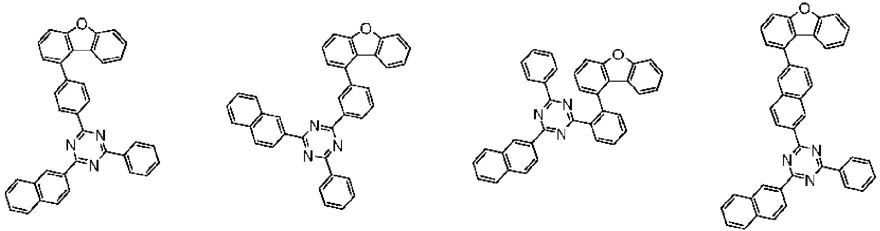

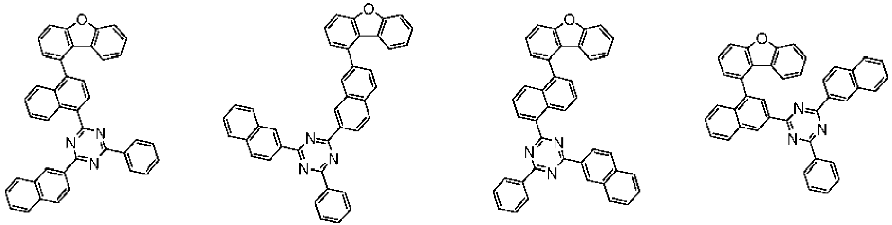

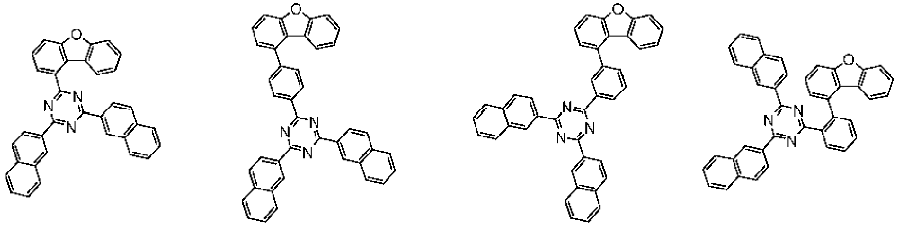

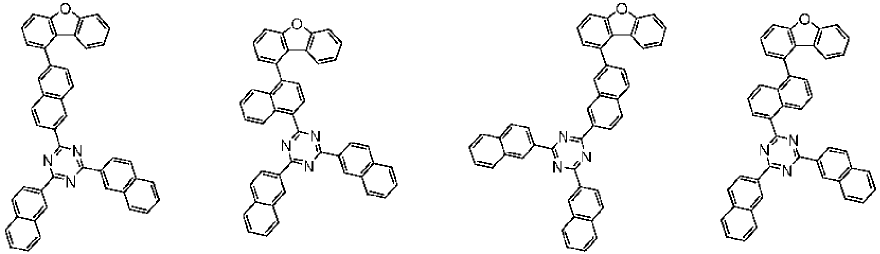

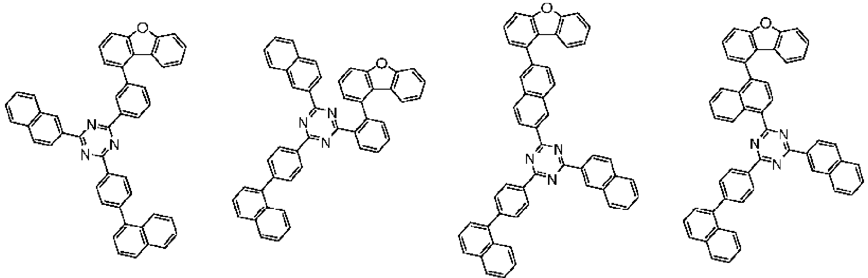

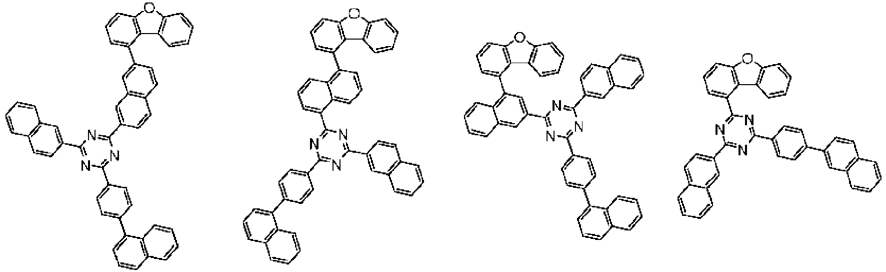

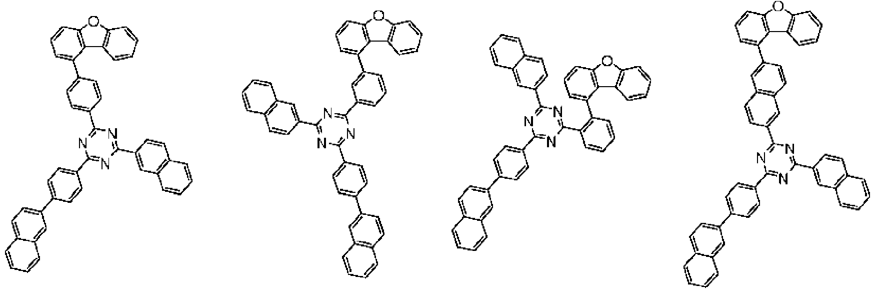

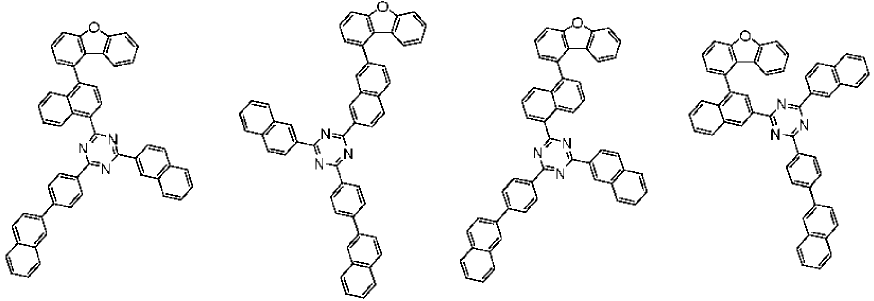

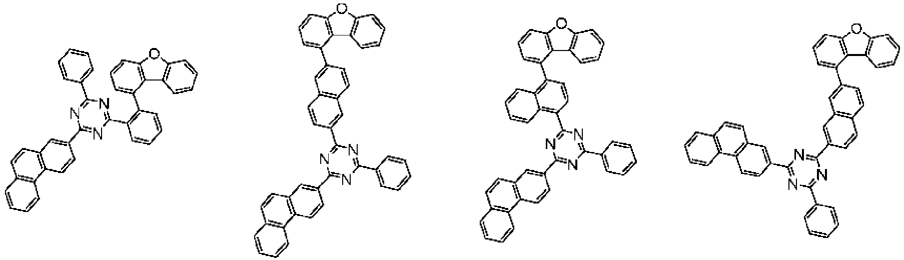

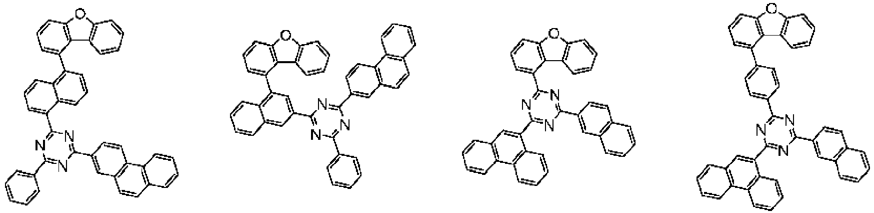

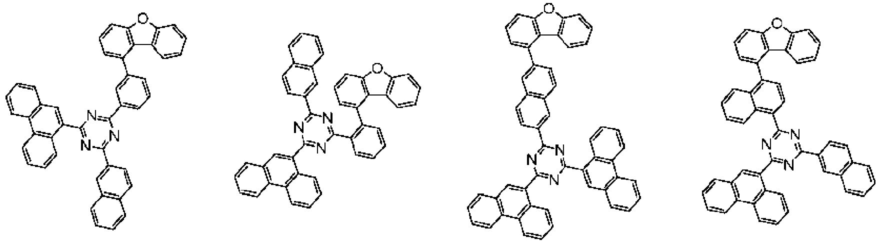

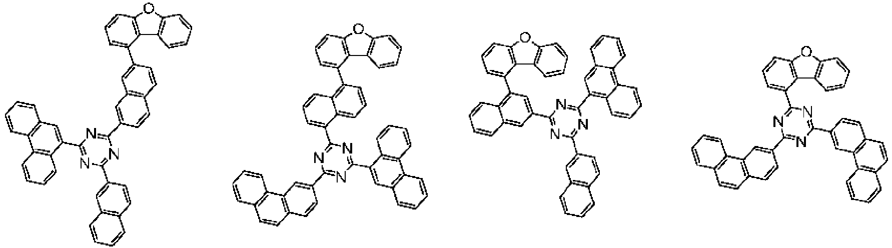

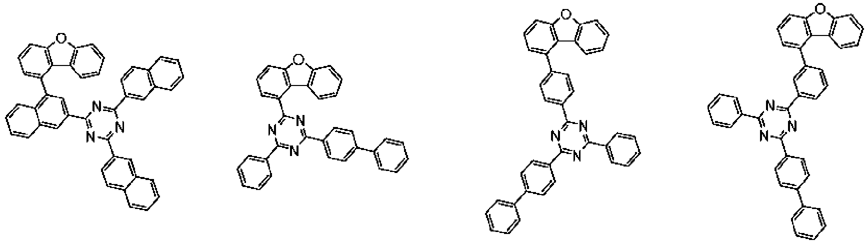

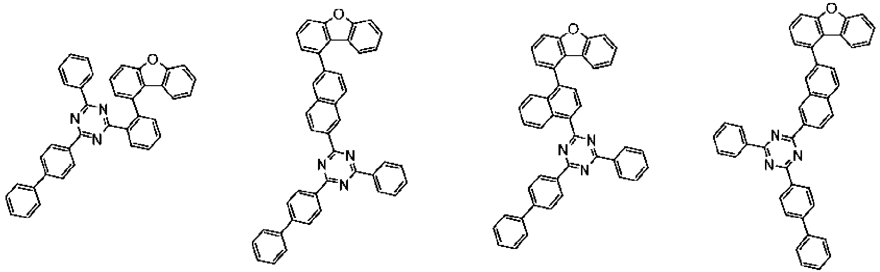

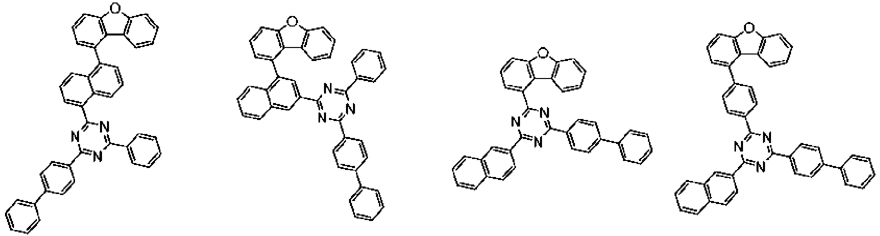

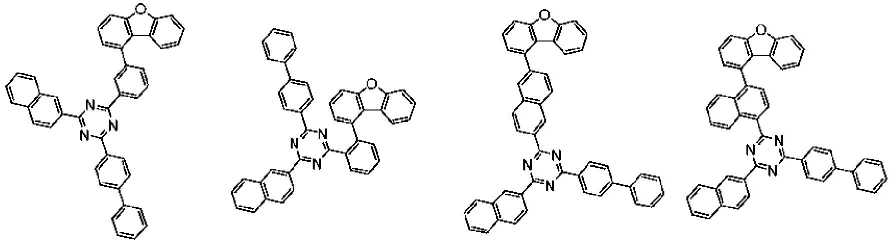

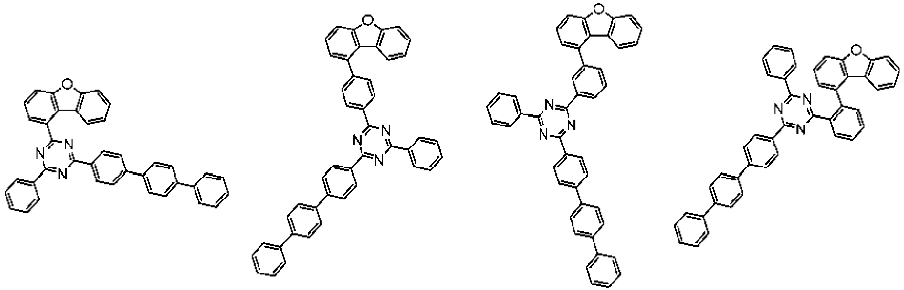

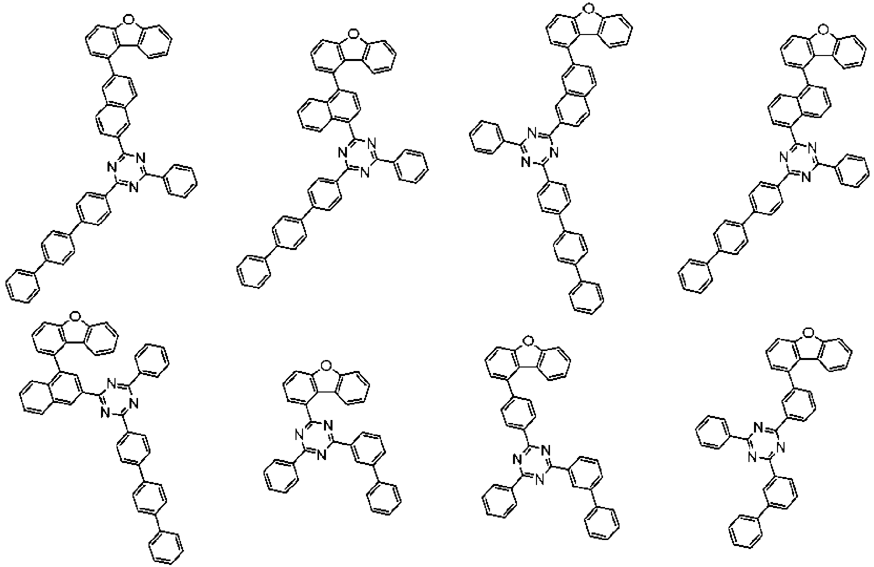

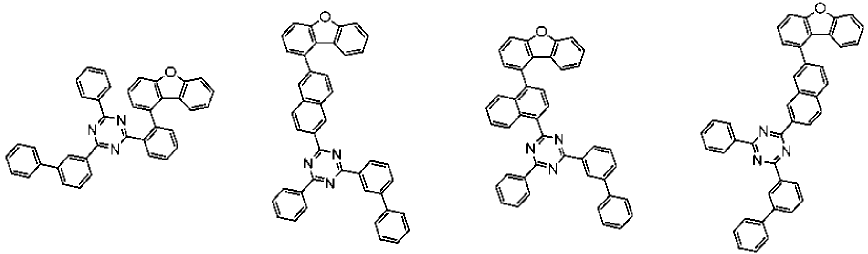

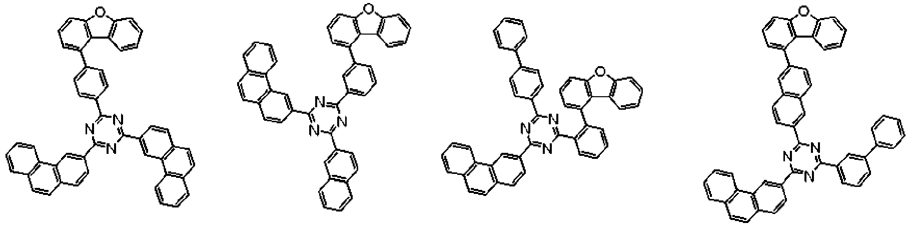

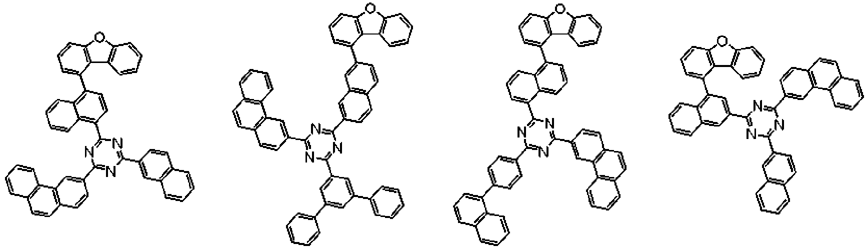

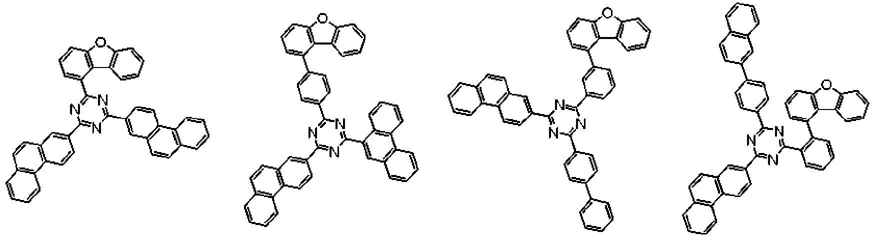

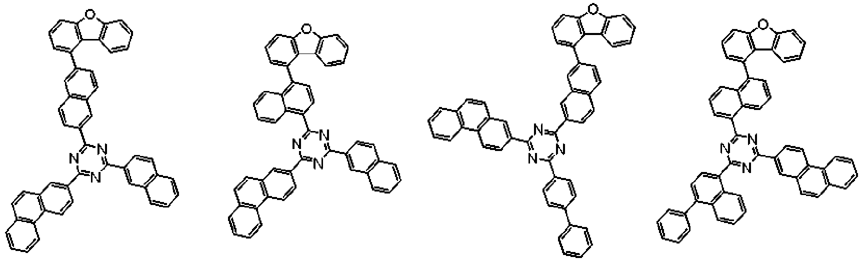

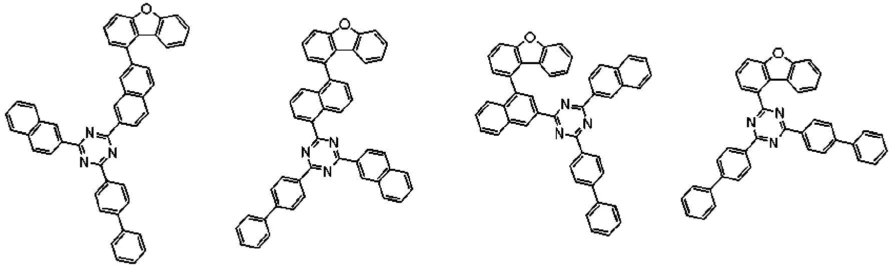

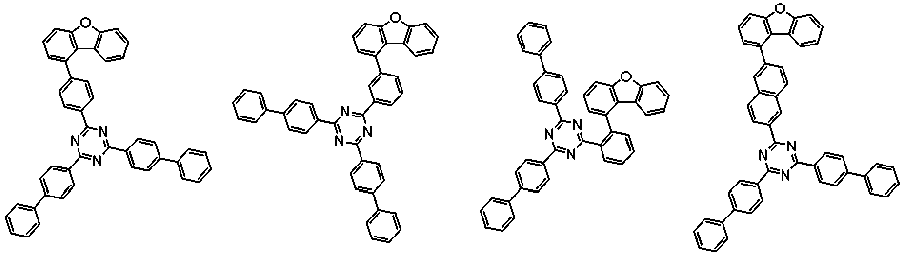

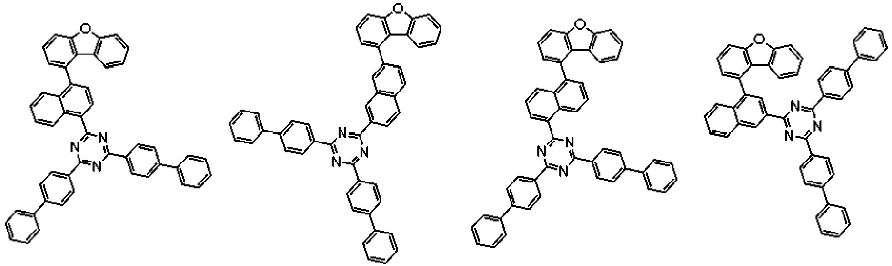

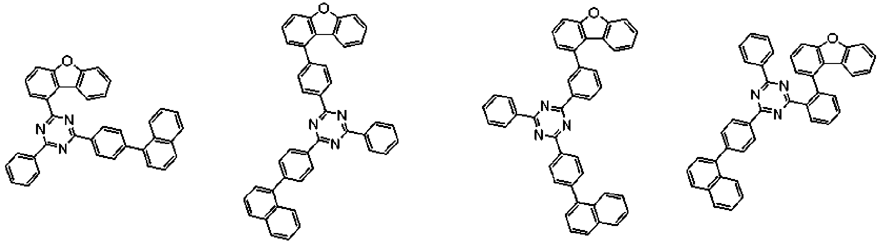

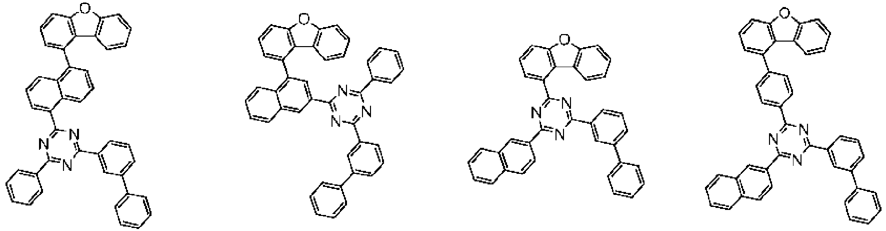

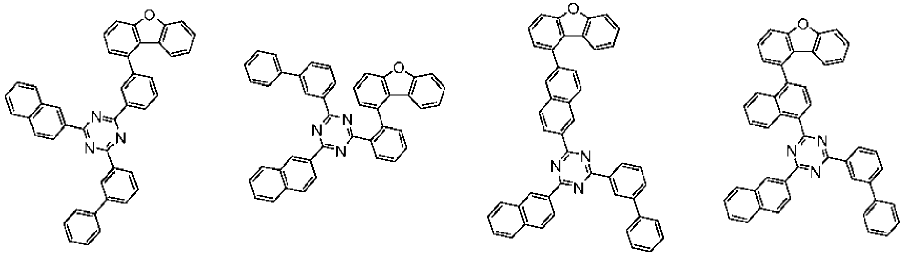

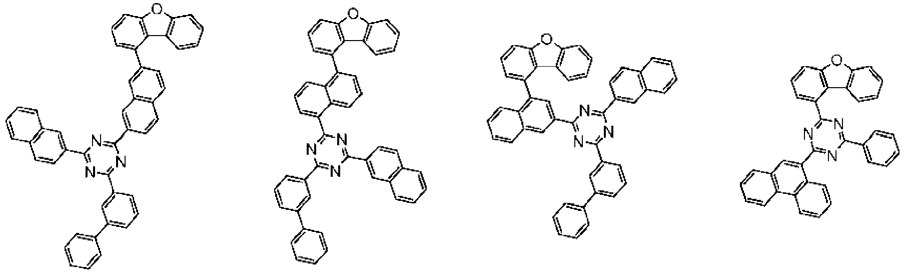

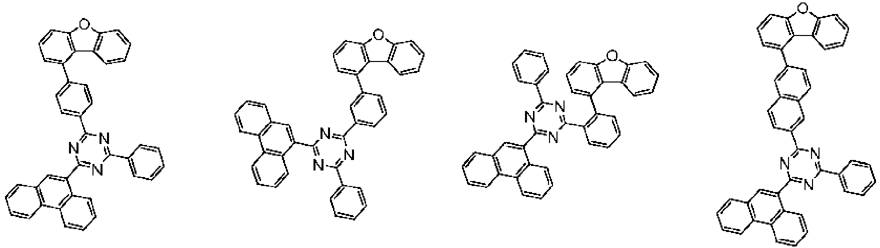

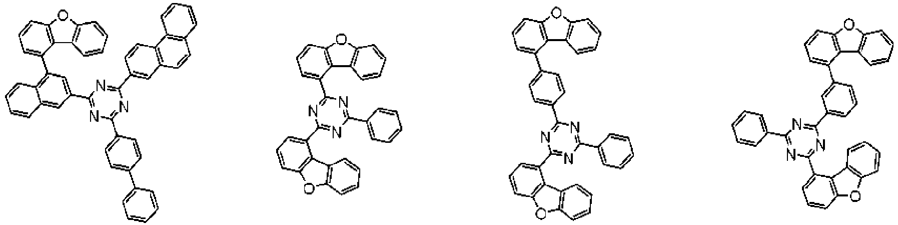

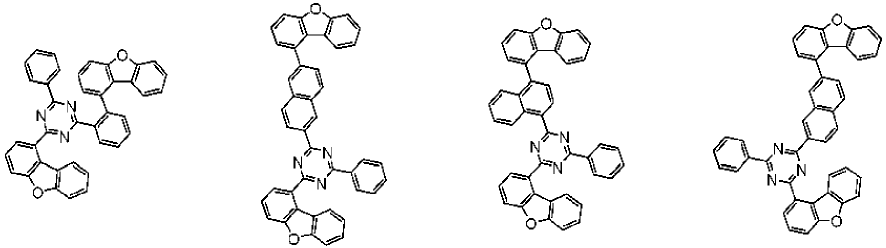

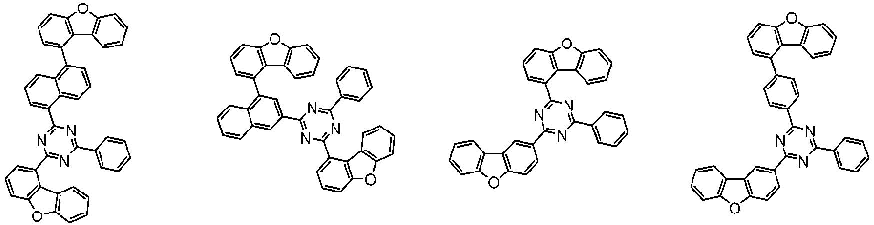

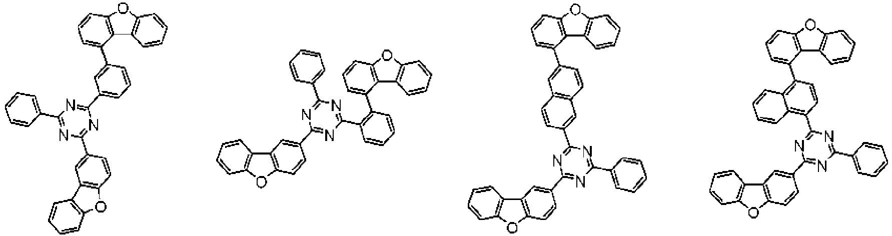

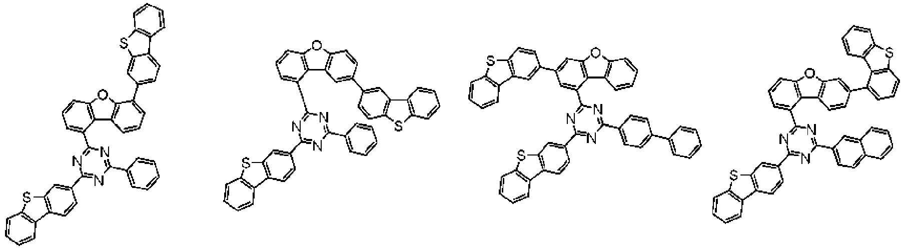

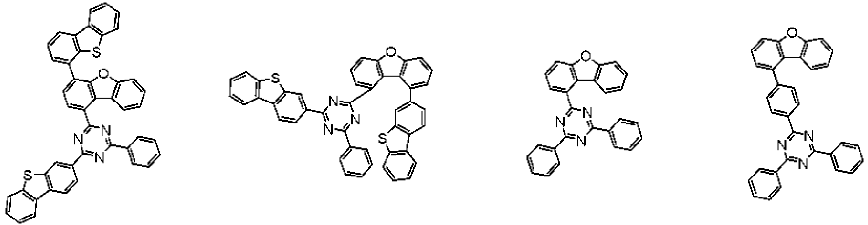

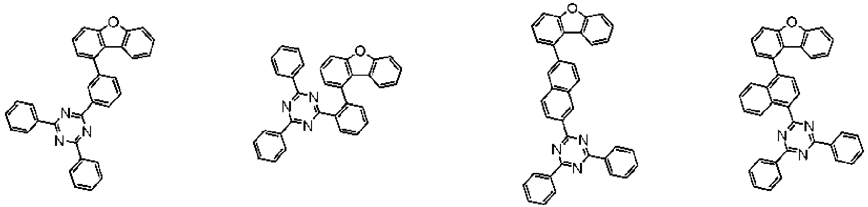

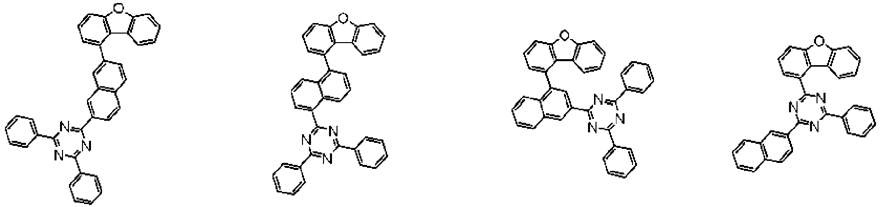

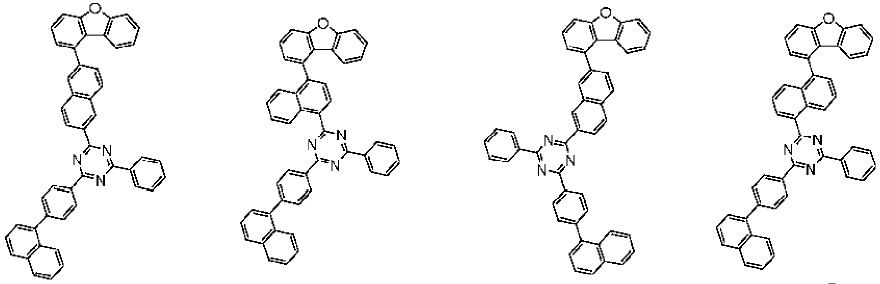

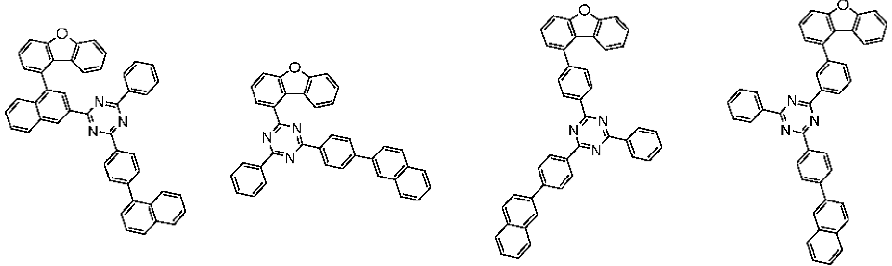

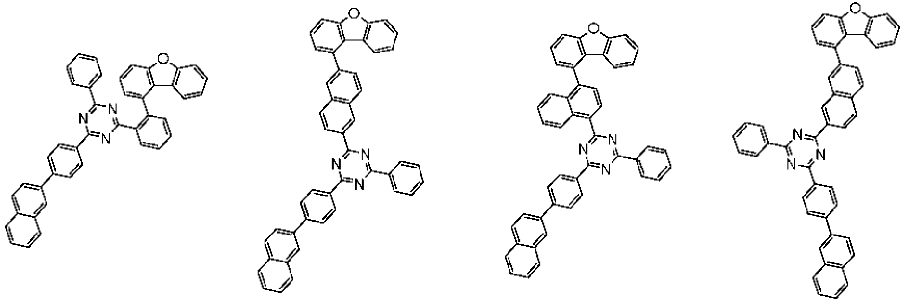

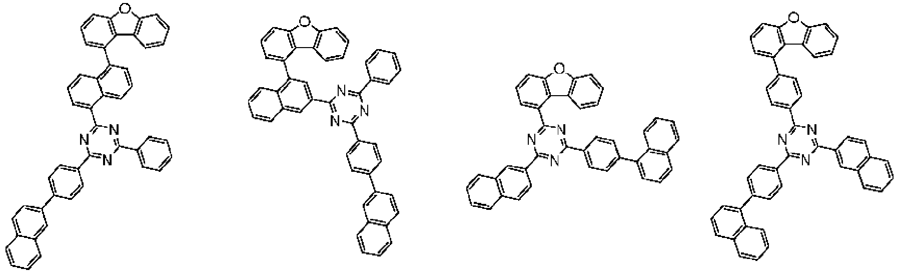

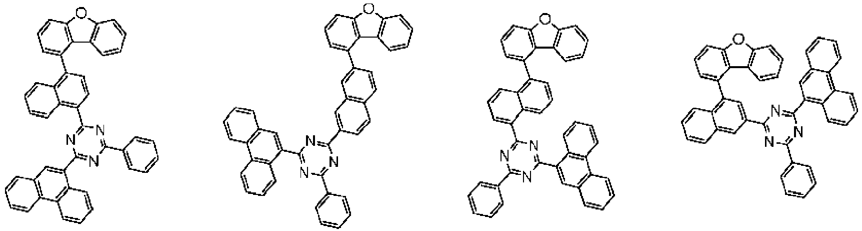

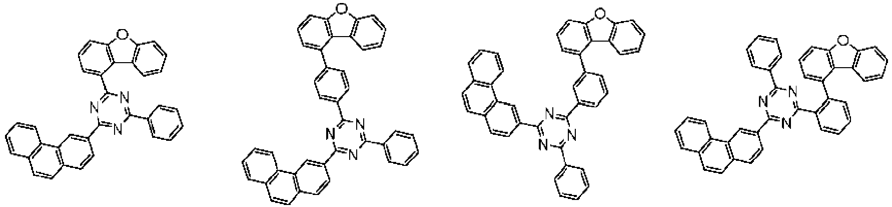

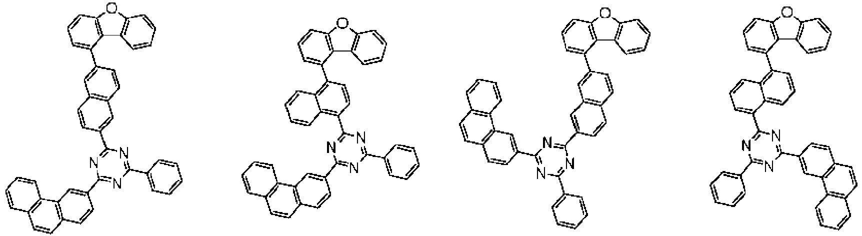

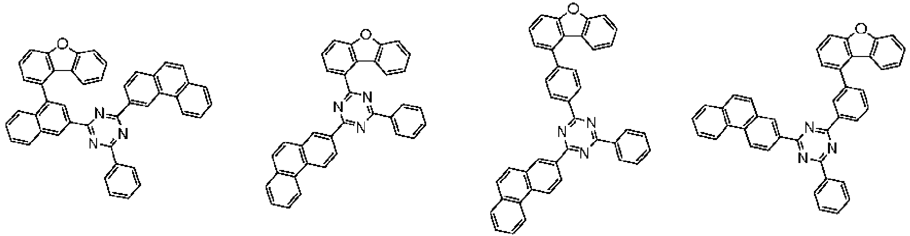

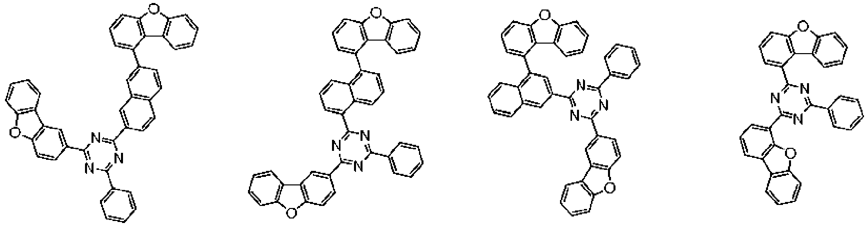

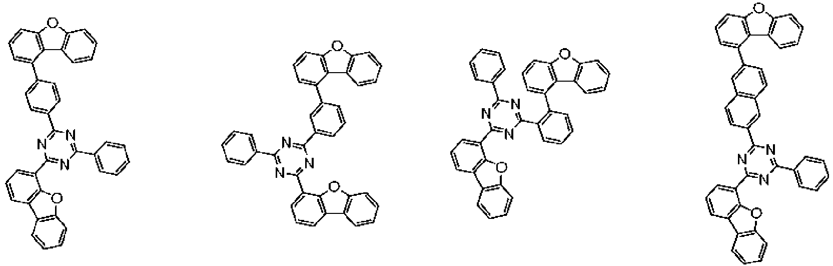

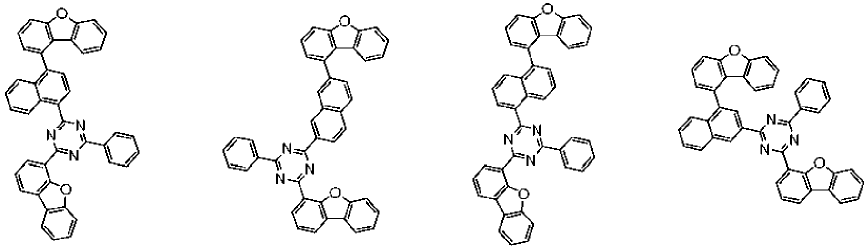

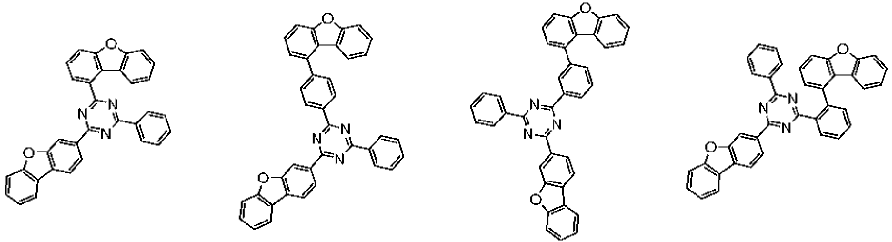

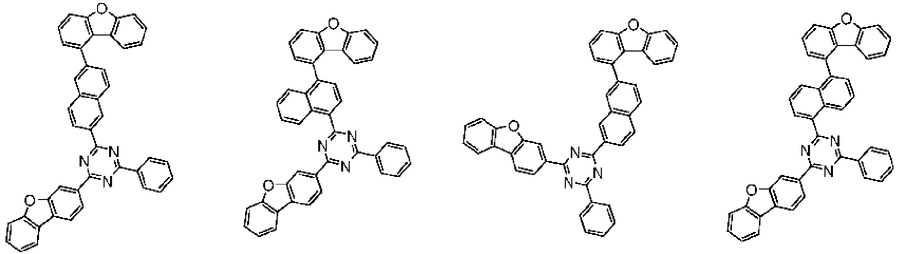

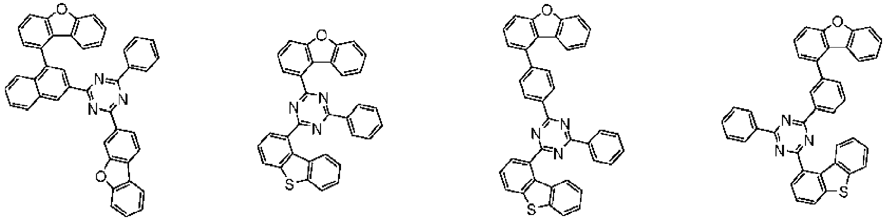

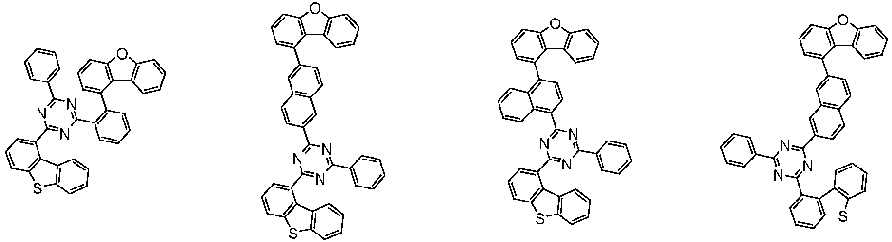

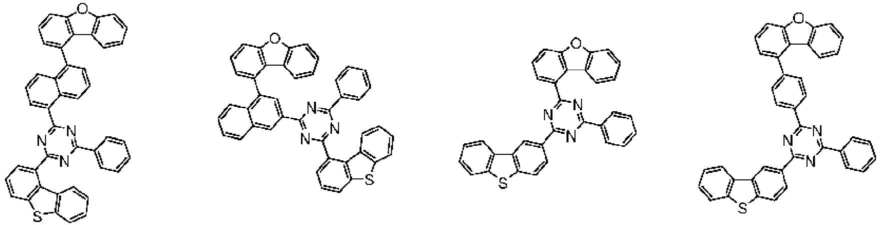

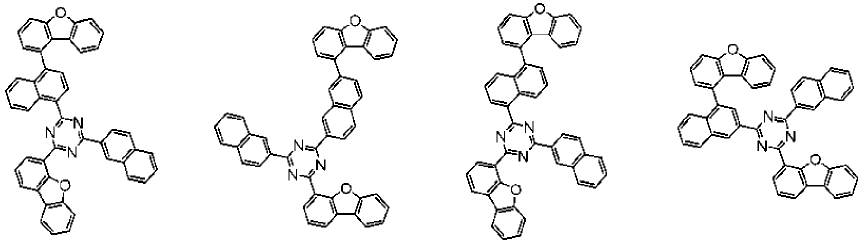

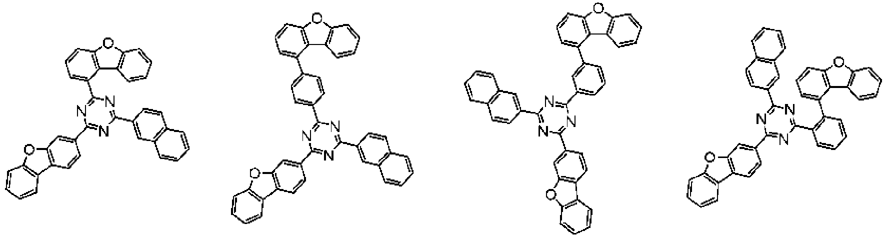

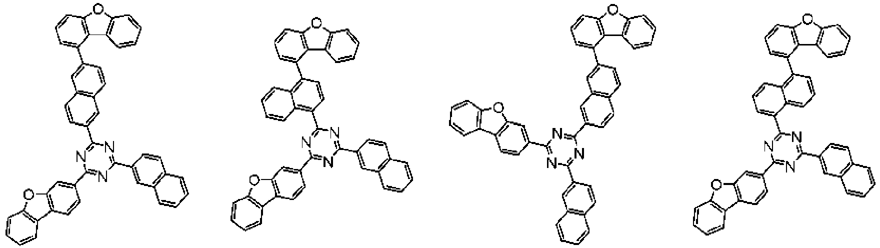

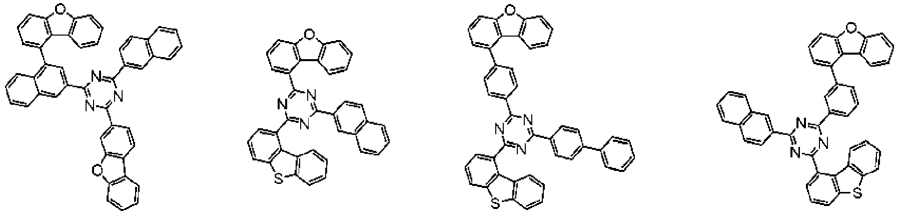

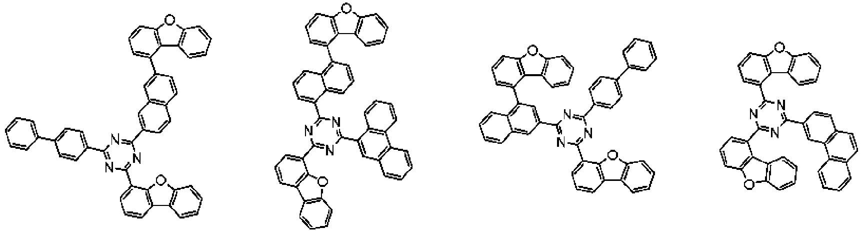

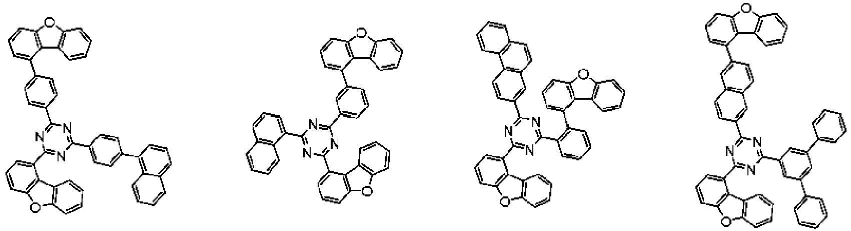

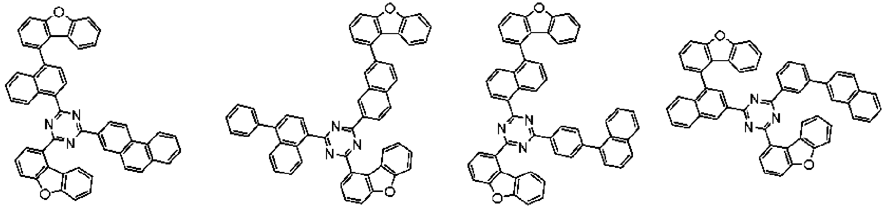

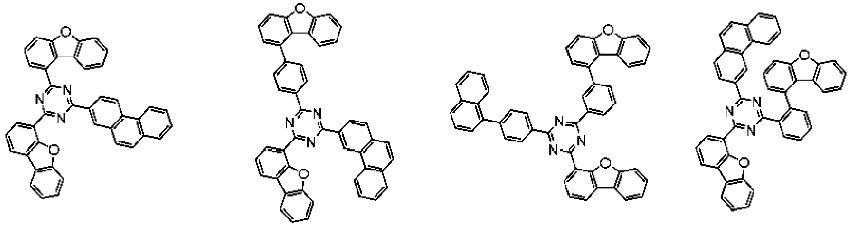

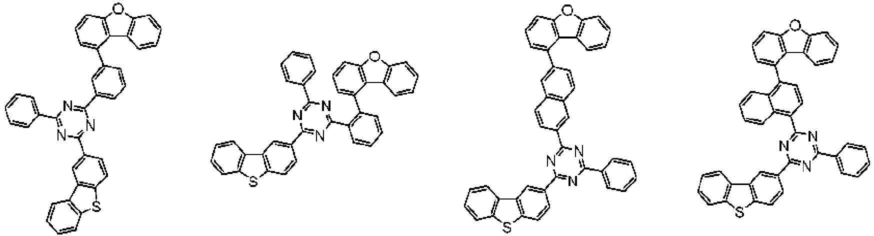

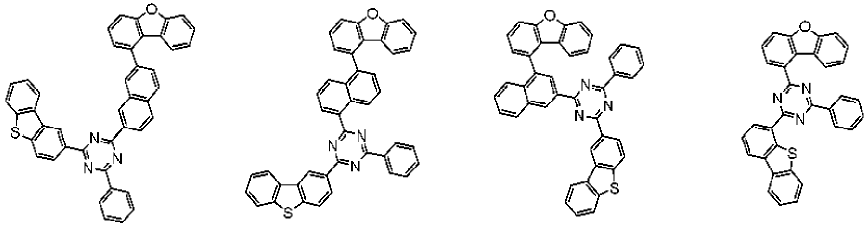

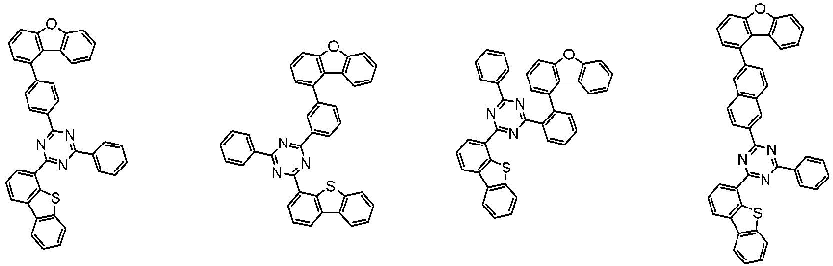

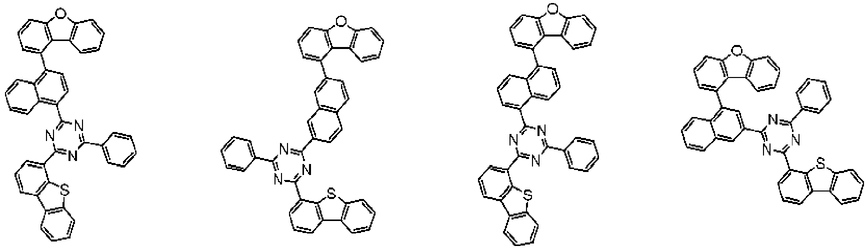

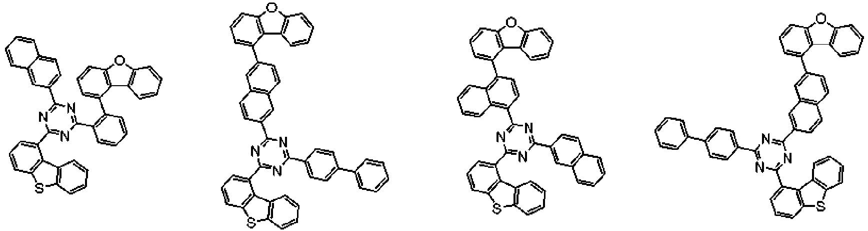

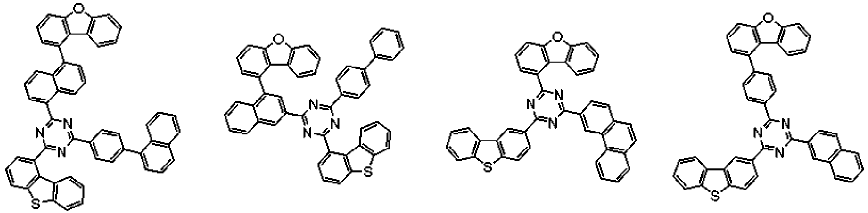

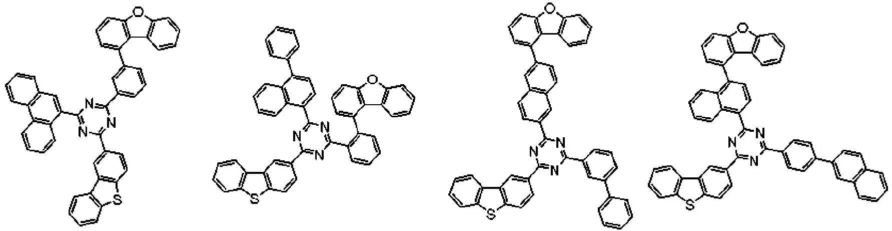

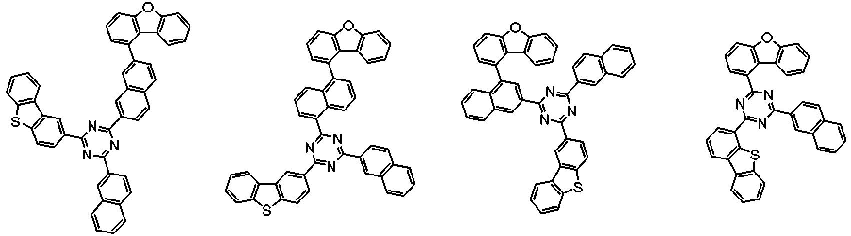

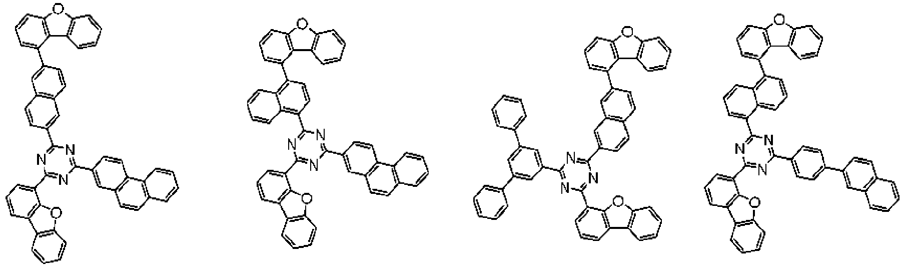

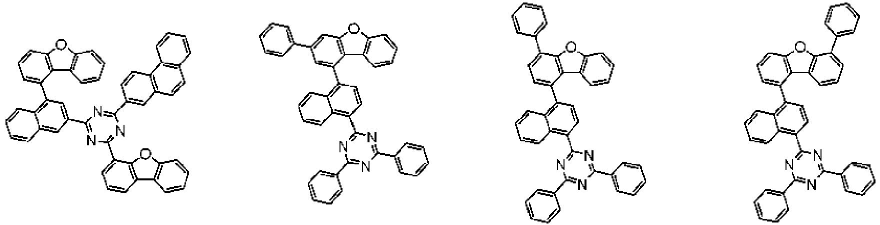

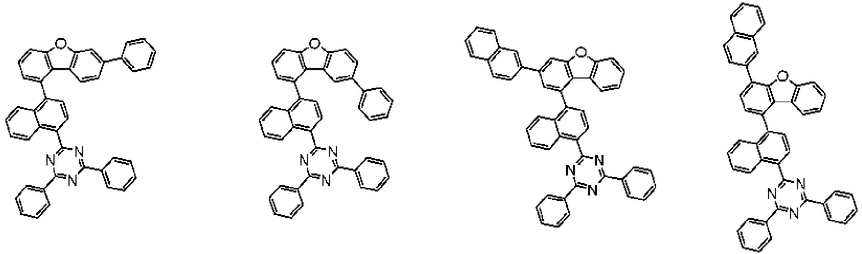

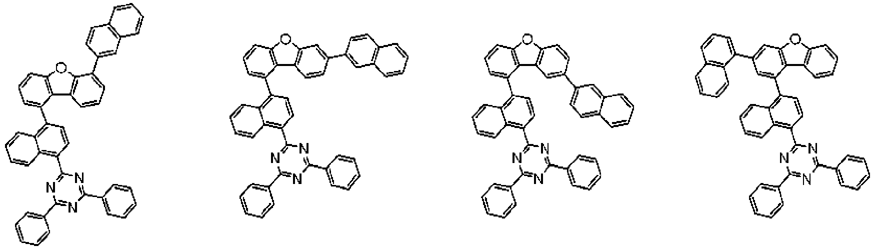

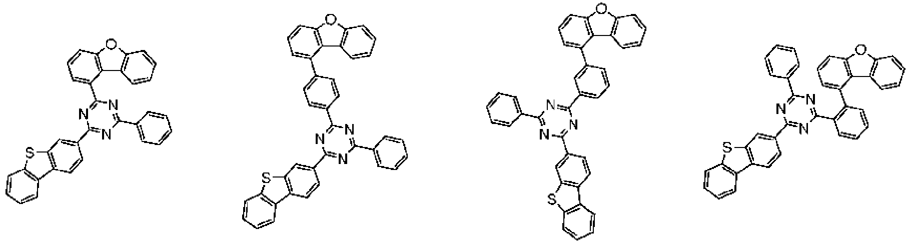

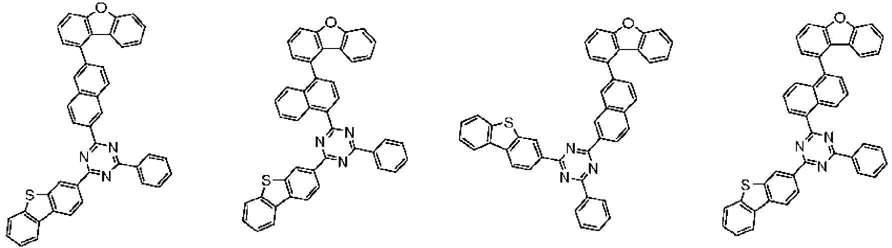

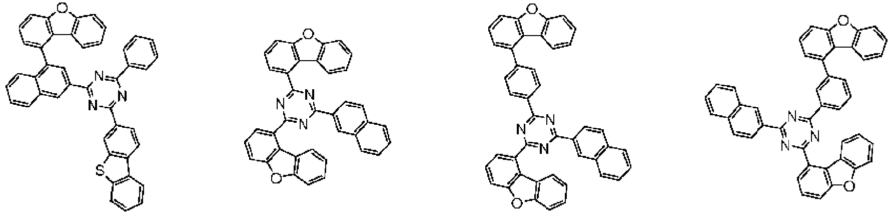

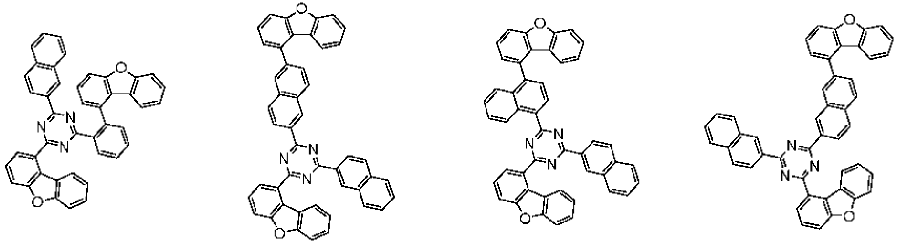

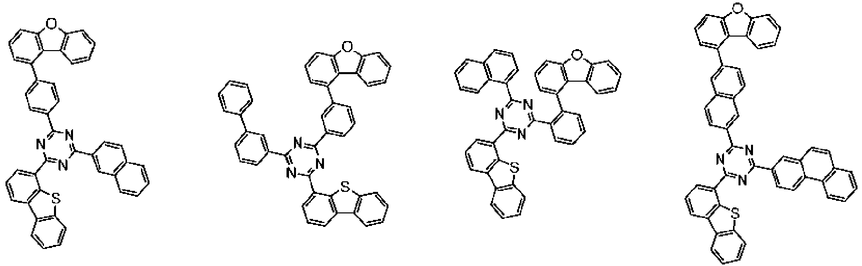

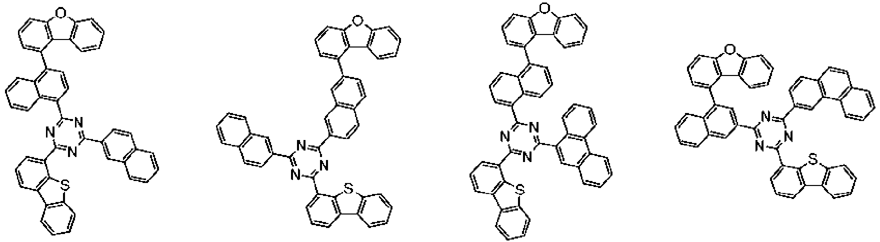

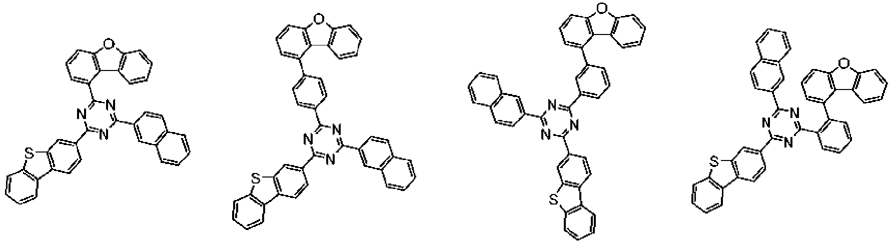

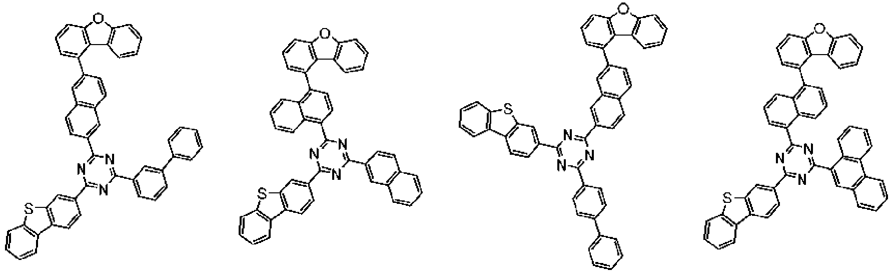

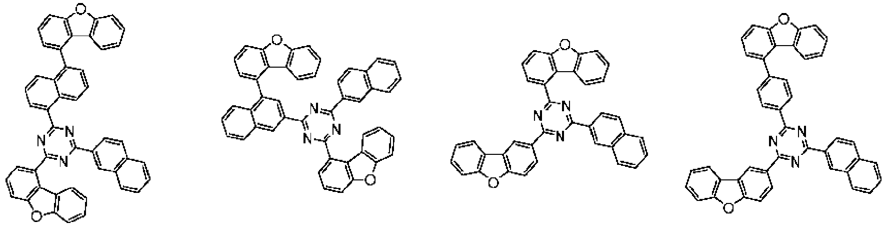

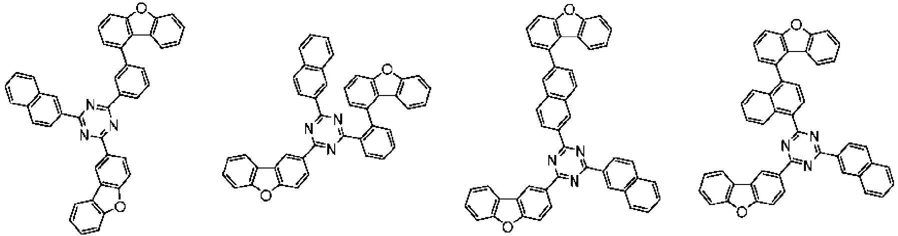

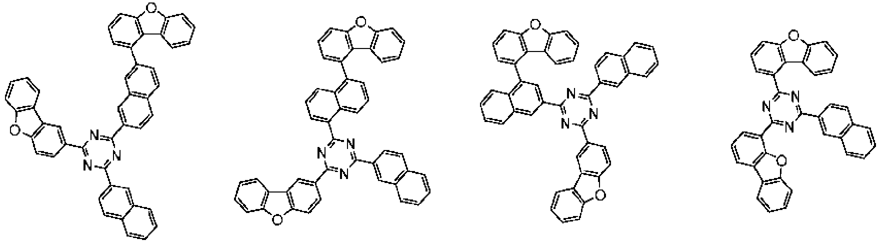

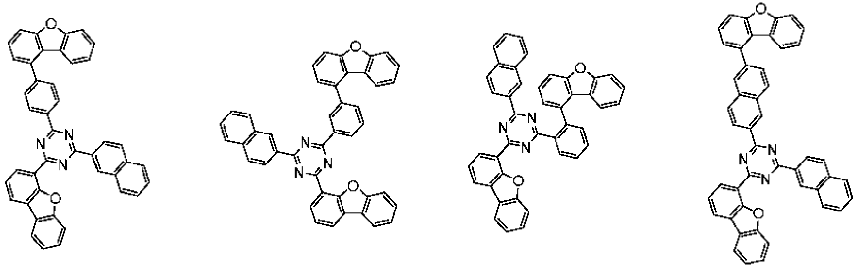

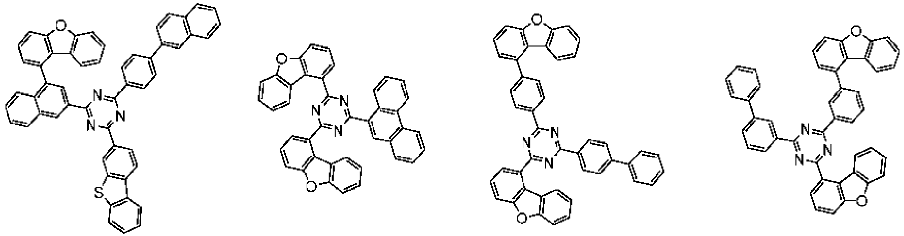

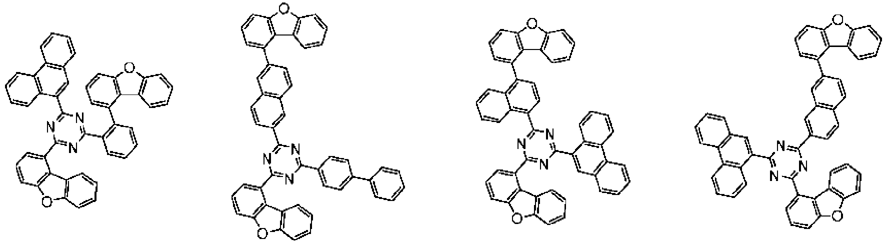

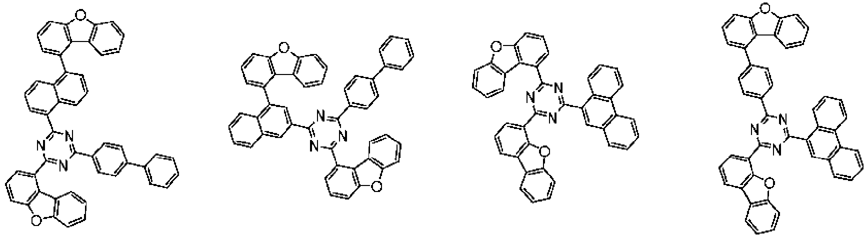

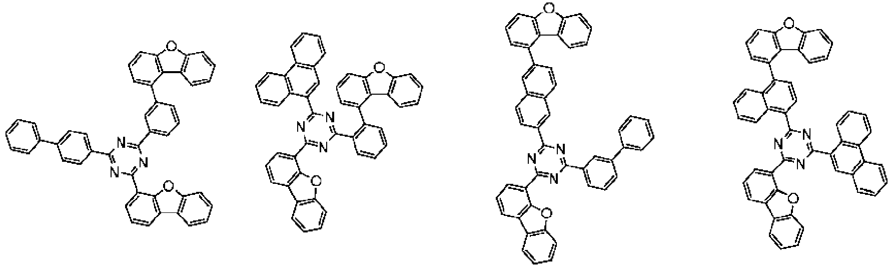

7. Dispositif électroluminescent organique selon la revendication 1,
dans lequel la Formule chimique 2 est représentée par l'une quelconque des Formules chimiques 2-1 à 2-4 suivantes : 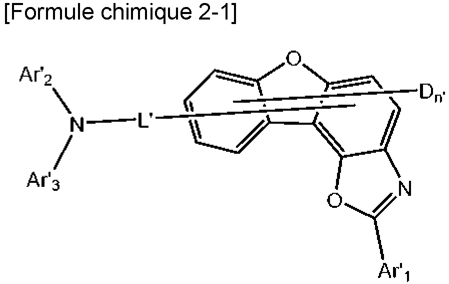 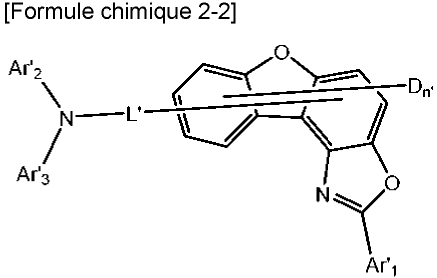 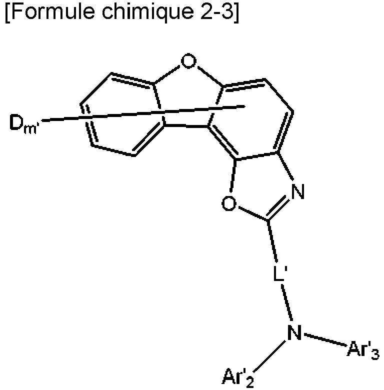 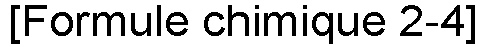 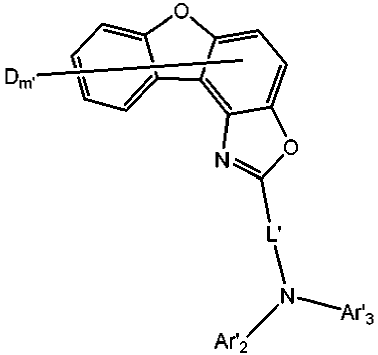 dans les Formules chimiques 2-1 à 2-4,
L', Ar'₁ à Ar'₃, D, et n' sont tels que définis dans la revendication 1, et m' est un nombre entier de 0 à 6.

8. Dispositif électroluminescent organique selon la revendication 1,
dans lequel L' est une liaison simple ; un phénylène ; ou un biphényldiyle.

9. Dispositif électroluminescent organique selon la revendication 1,
dans lequel Ar'₁ est un phényle.

10. Dispositif électroluminescent organique selon la revendication 1,
dans lequel Ar'₂ et Ar'₃ sont chacun indépendamment un phényle ; un biphénylyle ; un terphénylyle ; un naphtyle ; un (naphtyl)phényle ; un (phényl)naphtyle ; un (naphtyl)biphénylyle ; un (naphtyl)naphtyle ; un [(phényl)naphtyl]phényle ; un dibenzofuranyle ; un dibenzothiophényle ; un (dibenzofuranyl)phényle ; un (dibenzothiophényl)phényle ; un phénanthrényle ; un (phénanthrényl)phényle ; un 9,9-diméthylfluorényle ; ou un 9-phénylcarbazolyle.

11. Dispositif électroluminescent organique selon la revendication 1,
dans lequel le composé représenté par la Formule chimique 2 est l'un quelconque sélectionné parmi le groupe consistant en :
